(19) Europäisches Patentamt
European Patent Office
Office européen des brevets

(11) **EP 1 760 766 A2**

## EUROPEAN PATENT APPLICATION

(12)

(43) Date of publication:
**07.03.2007 Bulletin 2007/10**

(51) Int Cl.:
**H01L 21/027** (2006.01)   **G03F 7/09** (2006.01)

(21) Application number: **06119942.8**

(22) Date of filing: **31.08.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **06.09.2005 JP 2005257626**
**15.02.2006 JP 2006092240**

(71) Applicant: **SONY CORPORATION**
**Tokyo 141-0001 (JP)**

(72) Inventors:
• **Matsuzawa, Nobuyuki**
**Sony Corporation**
**Tokyo**
**141-0001 (JP)**

• **Watanabe, Yoko**
**Sony Corporation**
**Tokyo**
**141-0001 (JP)**
• **Thunnakart, Boontarika**
**Sony Corporation**
**Tokyo**
**141-0001 (JP)**
• **Ozawa, Ken**
**Sony Corporation**
**Tokyo**
**141-0001 (JP)**

(74) Representative: **Müller - Hoffmann & Partner**
**Patentanwälte,**
**Innere Wiener Strasse 17**
**81667 München (DE)**

(54) **Antireflective film and exposure method**

(57) An antireflective film is provided between a resist layer and a silicon oxide layer formed on a surface of a silicon substrate, for exposure of the resist layer in an exposure system having a wavelength of 190 nm to 195 nm and a numerical aperture NA of 0.93 to 1.2. Assuming that the complex refractive indexes of upper and lower layers constituting the antireflective film are $N_1$ (= $n_1$ - $k_1 i$) and $N_2$ (= $n_2$ - $k_2 i$), respectively, and the thicknesses of both layers are $d_1$ and $d_2$, when a predetermined combination of values of [$n_{10}$, $k_{10}$, $d_{10}$, $n_{20}$, $k_{20}$, $d_{20}$] is selected, $n_1$, $k_1$, $d_1$, $n_2$, $k_2$, and $d_2$ satisfy the relational expression

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1.$$

EP 1 760 766 A2

**Description**

CROSS REFERENCES TO RELATED APPLICATIONS

The present invention contains subject matter related to Japanese Patent Application JP 2005-257626 filed in the Japanese Patent Office on September 6, 2005 and Japanese Patent Application JP 2006-092240 filed in the Japanese Patent Office on February 15, 2006, the entire contents of which are incorporated herein by reference.

BACKGROUND OF THE INVENTION

1. Field of the Invention

The present invention relates to an antireflective film used for exposure of a resist layer in a process for manufacturing a semiconductor device, and an exposure method using the antireflective film.

2. Description of the Related Art

In the field of semiconductor devices, it has been urgent to establish a new process technique permitting processing of submicron patterns of, for example, 65 nm or less. A so-called photolithographic technique may be required for processing submicron patterns, and an argon-fluoride (ArF) excimer laser at a wavelength of 193 nm is currently used as an exposure light source in order to improve optical resolution and comply with submicron processing by shortening the wavelength of exposure light (illuminating light).
A silicon semiconductor substrate is patterned using a photosensitive resist layer which is formed by applying on a surface of the silicon semiconductor substrate coated with an oxide film. However, when exposure light (illuminating light) has high reflectance at an interface between the resist layer and the silicon oxide film used as an underling layer, a stationary wave is significantly induced in the resist layer. As a result, the sides of the resist layer patterned by development have irregularity according to the shape of the stationary wave, thereby causing the problem of failing to form a satisfactory rectangular pattern in the resist layer. The pattern formed in the resist layer may be referred to as a "resist pattern". For example, when a resist layer having a refractive index of 1.70 is provided on a silicon oxide film of 100 nm in thickness formed on a surface of a silicon semiconductor substrate, the reflectance of exposure light at a wavelength of 193 nm is as high as about 70% in vertical incidence of the exposure light.
In order to resolve the above-mentioned problem, in a photolithographic technique using usual exposure light at a wavelength of 193 nm, a single-layer antireflective film is formed between a silicon semiconductor substrate and a resist layer. For example, when a resist layer having a refractive index of 1.70 is formed on an antireflective film having a thickness of 100 nm and a complex refractive index $N_0$ (= $n_o$ - $k_0$i wherein $n_o$ = 1.75 and $k_0$ = 0.30), which is formed on a silicon oxide film of 100 nm in thickness formed on a surface of a silicon semiconductor substrate, the reflectance at the interface between the resist layer and the antireflective film is greatly decreased to about 1% in vertical incidence of exposure light.

SUMMARY OF THE INVENTION

The limiting resolution of a photolithographic technique is about 0.3 times the wavelength of exposure light. Therefore, in a photolithographic technique using an ArF excimer laser at a wavelength of 193 nm as an exposure light source, the limiting resolution is about 60 nm.
As a technique for forming a finer pattern of less than about 60 nm on a silicon semiconductor substrate, there has been advanced the development of an immersion lithographic technique in which a space between an exposure system (illumination system) and a resist layer is filled with a medium (e.g., an aqueous immersion light) having a higher refractive index than that of air to realize higher resolution.
Exposure through an immersion liquid is capable of achieving higher resolving performance because the effective wavelength of exposure light is a value obtained by dividing the wavelength of exposure light in a vacuum by the refractive index of the immersion liquid. For example, in the use of an ArF excimer laser at a wavelength of 193 nm as a exposure light source and water (refractive index of 1.44 at 193 nm) as the immersion liquid, the effective wavelength is about 134 nm, and the limiting resolution is 0.3 times the effective wavelength, i.e., about 40 nm. In other words, the immersion lithographic technique using water is capable of forming a micro pattern of less than about 60 nm on a silicon semiconductor substrate.
A focus tolerance (DOF) in exposure is given by the following equation:

$$\mathrm{DOF} \; = \; n_{\mathrm{Liq}} \cdot K_2 \; \cdot \lambda / \mathrm{NA}^2$$

wherein $n_{\mathrm{Liq}}$ is the refractive index of the immersion liquid, $K_2$ is a constant depending on the process, $\lambda$ is the wavelength of exposure light (illuminating light) in a vacuum, and NA is the numerical aperture of an exposure system (illumination system).

Therefore, when the numerical aperture NA is constant, the focus tolerance DOF in immersion lithography is $n_{\mathrm{Liq}}$ times as large as in usual lithography by exposure in the air. Namely, immersion lithography using water as the immersion liquid has a focus tolerance DOF of 1.44 times and thus permits the construction of a mass production process with a higher tolerance.

However, such an immersion lithographic technique has the problem that a general single-layer antireflective film does not effectively function.

Exposure light is transmitted through an incident medium, incident on a resist layer, and further incident on an antireflective film. The exposure light satisfies the equation below in which $\theta_{\mathrm{in}}$ is the angle of incidence of the exposure light from the incident medium to the resist layer, $n_{\mathrm{in}}$ is the refractive index of the incident medium, $\theta_{\mathrm{IF}}$ is the angle of incidence of the exposure light from the resist layer to the silicon semiconductor substrate or the antireflective film, and $n_{\mathrm{Res}}$ is the refractive index of a resist material constituting the resist layer. Since, in a usual photolithographic technique, the incident medium is air, $n_{\mathrm{in}} = 1$, while in an immersion lithographic technique using, for example, water as the immersion liquid, $n_{\mathrm{in}} = 1.44$ because the incident medium is water.

$$\mathrm{NA} \; = \; n_{\mathrm{in}} \cdot \sin(\theta_{\mathrm{in}}) \; = \; n_{\mathrm{Res}} \cdot \sin(\theta_{\mathrm{IF}})$$

This equation indicates that at constant $\theta_{\mathrm{in}}$, the numerical aperture NA in the immersion lithographic technique is $n_{\mathrm{Liq}}$ times as large as in a general photolithographic technique ($\theta_{\mathrm{in}} = 1.0$). That is, when the refractive index $n_{\mathrm{Res}}$ of the resist material constituting the resist layer is constant, $\sin(\theta_{\mathrm{IF}})$ is increased. This means that in the immersion lithographic technique, $\theta_{\mathrm{IF}}$ is increased. In other words, in the immersion lithographic technique, the exposure light is incident more obliquely, as compared with a general photolithographic technique.

On the other hand, the use of a single-layer antireflective film may sufficiently decrease the reflectance of exposure light in vertical incidence but has the problem of failing to sufficiently decrease the reflectance in oblique incidence.

When an antireflective film having a thickness of 100 nm and a complex refractive index $N_0$ in which $n_0$ and $k_0$ values are 1.75 and 0.30, respectively is formed on a silicon oxide film of 100 nm in thickness formed on a surface of a silicon semiconductor substrate, and a resist layer having a refractive index of 1.70 is formed on the antireflective film, the reflectance at the interface between the resist layer and the antireflective film is greatly decreased to about 1% in vertical incidence of the exposure light (i.e., incidence angle $\theta_{\mathrm{IF}} = 0°$). However, the reflectance of s waves is greatly increased to about 6% at an incidence angle $\theta_{\mathrm{IF}}$ of about 65°.

On the other hand, the maximum permissible value of reflectance at the interface between a resist layer and a silicon oxide film formed on a surface of a silicon semiconductor substrate yearly decreases with development of micronization. In particular, the maximum permissible value of reflectance in the micron generation to which the immersion lithographic technique is applied is as very small as 0.4% in a line-and-space pattern (Boontarika, Ozawa, Someya, Extended Abstracts of the 65th meeting of the Japan Society of Applied Physics, 2p-R-9).

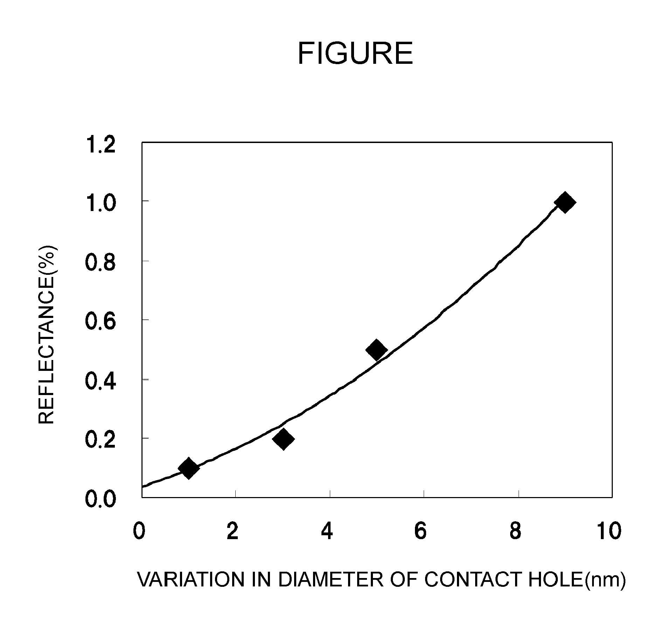

In the 45-nm generation to which immersion lithography may be applied, the size of contact holes to be formed is assumed to be about 90 nm (pitch 140 nm). Fig. 1 shows the results of computation, under this condition, of the reflectance dependency of variation in the diameter of contact holes relative to the shape of a stationary wave using optical profile computing software Prolith Ver. 8.1 manufactured by KLA-Tencor Corp. on the assumption that the numerical aperture NA was 1.05 corresponding to immersion lithography.

It is desirable to suppress the variation in diameter of 90 nm contact holes to 5 nm or less. Fig. 1 indicates that the reflectance is preferably controlled to about 0.4% or less for controlling the variation to 5 nm or less.

Namely, in both a line-and-space pattern and a contact hole pattern, the reflectance is preferably suppressed to 0.4% or less.

However, in the immersion lithographic technique, exposure light may be incident obliquely on a single-layer antireflective film used in a general photolithographic technique, thereby failing to sufficiently decrease reflectance. Since the reflectance is not sufficiently decreased, a stationary wave significantly appears in the resist layer, and thus it may be impossible to resolve the problem of failing to form a satisfactory rectangular pattern in the resist layer.

Accordingly, it is desirable to provide an antireflective film capable of sufficiently decreasing the reflectance at an interface between a resist layer and a silicon oxide film formed on a surface of a silicon semiconductor substrate even in more oblique incidence of exposure light (illuminating light) on the resist layer in a photolithographic technique for achieving a higher focus tolerance by increasing the numerical aperture of an exposure system, for example, in an immersion lithographic technique, and also provide an exposure method using the antireflective film.

In accordance with a first embodiment of the invention, an antireflective film has a two-layer structure and is used in a process for manufacturing a semiconductor device by being provided between a resist layer and a silicon oxide layer formed on a surface of a silicon semiconductor substrate and having a thickness T (unit: nm) described below, for exposure of the resist layer in an exposure system having a wavelength of 190 nm to 195 nm and a numerical aperture NA of $0.93 \leq NA \leq 1.0$. In accordance with the first embodiment of the invention, an exposure method is used in a process for manufacturing a semiconductor device and includes providing an antireflective film having a two-layer structure between a resist layer and a silicon oxide layer formed on a surface of a silicon semiconductor substrate and having a thickness T (unit: nm) described below, and exposing the resist layer in an exposure system having a wavelength of 190 nm to 195 nm and a numerical aperture NA of $0.93 \leq NA \leq 1.0$.

The antireflective film or the antireflective film used in the exposure method according to the first embodiment of the invention includes an upper layer having a complex refractive index $N_1$ and a lower layer having a complex refractive index $N_2$, the complex refractive indexes $N_1$ and $N_2$ being represented by the following equations:

$$N_1 = n_1 - k_1 i$$

$$N_2 = n_2 - k_2 i$$

Assuming that the thickness of the upper layer is $d_1$ (unit: nm) and the thickness of the lower layer is $d_2$ (unit: nm), when any one of the combinations of values of [$n_{10}$, $k_{10}$, $d_{10}$, $n_{20}$, $k_{20}$, $d_{20}$] described below is selected depending on the thickness T of the silicon oxide film, $n_1$, $k_1$, $d_1$, $n_2$, $k_2$, and $d_2$ satisfy the following relational expression:

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1$$

However, a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$. In the tables below, in the line of "When $n_1 \geq n_{10}$, $n_{1m} =$", each value in the right columns is "$n_{1m} - n_{10}$"; in the line of "When $n_1 < n_{10}$, $n_{1m} =$", each value in the right columns is "$n_{10} - n_{1m}$"; in the line of "When $k_1 \geq k_{10}$, $k_{1m} =$", each value in the right columns is "$k_{1m} - k_{10}$"; in the line of "When $k_1 < k_{10}$, $k_{1m} =$", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m} =$", each value in the right columns is "$n_{2m} - n_{20}$"; in the line of "When $n_2 < n_{20}$, $n_{2m} =$", each value in the right columns is "$n_{20} - n_{2m}$"; in the line of "When $k_2 \geq k_{20}$, $k_{2m} =$", each value in the right columns is "$k_{2m} - k_{20}$"; in the line of "When $k_2 < k_{20}$, $k_{2m} =$", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

$0.93 \leq NA \leq 1.0$

$2 \leq T \leq 15$

| Case | 1-01 | 1-02 | 1-03 | 1-04 | 1-05 |
|---|---|---|---|---|---|
| $n_{10}$ | 2.0730 | 1.8547 | 1.8612 | 1.8596 | 1.7706 |
| $k_{10}$ | 0.1156 | 0.1676 | 0.1279 | 0.0953 | 0.0916 |
| $d_{10}$ (nm) | 23.93 | 29.84 | 20.21 | 19.98 | 91.02 |
| $n_{20}$ | 2.6749 | 2.1886 | 1.8193 | 1.8569 | 1.9614 |
| $k_{20}$ | 1.5696 | 0.6118 | 0.4029 | 0.3274 | 0.4555 |
| $d_{20}$ (nm) | 9.886 | 59.76 | 139.99 | 190.30 | 69.22 |

| | | 1-01 | 1-02 | 1-03 | 1-04 | 1-05 |
|---|---|---|---|---|---|---|
| When $n_1 \geq n_{10}$, | $n_{1m}=$ | 0.0910 | 0.0882 | 0.0964 | 0.0950 | 0.0763 |
| When $n_1 < n_{10}$, | $n_{1m}=$ | 0.0872 | 0.0704 | 0.0762 | 0.0765 | 0.0467 |
| When $k_1 \geq k_{10}$, | $k_{1m}=$ | 0.0819 | 0.0750 | 0.0869 | 0.0875 | 0.0772 |
| When $k_1 < k_{10}$, | $k_{1m}=$ | 0.0960 | 0.0840 | 0.0907 | 0.0915 | 0.0546 |
| When $d_1 \geq d_{10}$, | $d_{1m}$ (nm) $=$ | 4.108 | 7.919 | 8.786 | 9.587 | 17.28 |
| When $d_1 < d_{10}$, | $d_{1m}$ (nm) $=$ | 3.280 | 5.652 | 6.074 | 6.698 | 8.396 |
| When $n_2 \geq n_{20}$, | $n_{2m}=$ | 0.2209 | 0.1796 | 0.1515 | 0.1552 | 0.1445 |
| When $n_2 < n_{20}$, | $n_{2m}=$ | 0.2126 | 0.1920 | 0.1780 | 0.1777 | 0.1565 |
| When $k_2 \geq k_{20}$, | $k_{2m}=$ | 0.2324 | 0.2171 | 0.1921 | 0.1983 | 0.1809 |
| When $k_2 < k_{20}$, | $k_{2m}=$ | 0.1960 | 0.1512 | 0.1220 | 0.1107 | 0.1235 |
| When $d_2 \geq d_{20}$, | $d_{2m}$ (nm) $=$ | 1.715 | 13.99 | $\infty$ | $\infty$ | 9.907 |
| When $d_2 < d_{20}$, | $d_{2m}$ (nm) $=$ | 1.606 | 9.166 | 63.12 | 76.29 | 9.171 |

$0.93 < NA \leq 1.0$

$2 \leq T \leq 15$

| Case | 1-06 | 1-07 | 1-08 | 1-09 | 1-10 |
|---|---|---|---|---|---|
| $n_{10}$ | 1.7660 | 1.7540 | 1.7206 | 1.7312 | 1.7318 |
| $k_{10}$ | 0.0861 | 0.0810 | 0.0766 | 0.0743 | 0.0746 |
| $d_{10}$ (nm) | 89.67 | 89.26 | 163.7 | 158.4 | 156.0 |
| $n_{20}$ | 1.8683 | 1.7976 | 2.0073 | 1.9328 | 1.8226 |
| $k_{20}$ | 0.3142 | 0.2441 | 0.9100 | 0.4029 | 0.2736 |
| $d_{20}$ (nm) | 129.4 | 193.6 | 15.11 | 69.39 | 132.3 |

| | | 1-06 | 1-07 | 1-08 | 1-09 | 1-10 |
|---|---|---|---|---|---|---|
| When $n_1 \geq n_{10}$, | $n_{1m}=$ | 0.0725061 | 0.0712122 | 0.0876196 | 0.0743347 | 0.0699963 |
| When $n_1 < n_{10}$, | $n_{1m}=$ | 0.0454077 | 0.0429834 | 0.0318030 | 0.0375427 | 0.0339148 |
| When $k_1 \geq k_{10}$, | $k_{1m}=$ | 0.0772620 | 0.0743579 | 0.0711646 | 0.0773767 | 0.0733899 |
| When $k_1 < k_{10}$, | $k_{1m}=$ | 0.0551843 | 0.0575049 | 0.0410327 | 0.0412244 | 0.0408972 |
| When $d_1 \geq d_{10}$, | $d_{1m}$ (nm) $=$ | 18.782 | 23.348 | 40.469 | 35.317 | 38.161 |
| When $d_1 < d_{10}$, | $d_{1m}$ (nm) $=$ | 8.456 | 8.860 | 9.958 | 10.432 | 9.052 |
| When $n_2 \geq n_{20}$, | $n_{2m}=$ | 0.1498401 | 0.1584961 | 0.1682336 | 0.1348816 | 0.1376196 |
| When $n_2 < n_{20}$, | $n_{2m}=$ | 0.1510144 | 0.1511060 | 0.2304688 | 0.1582874 | 0.1516028 |
| When $k_2 \geq k_{20}$, | $k_{2m}=$ | 0.2049341 | 0.2252979 | 0.1710974 | 0.1537598 | 0.1868274 |
| When $k_2 < k_{20}$, | $k_{2m}=$ | 0.0962390 | 0.0820935 | 0.1771240 | 0.1169067 | 0.0881860 |
| When $d_2 \geq d_{20}$, | $d_{2m}$ (nm) $=$ | $\infty$ | $\infty$ | 3.180 | 8.501 | $\infty$ |
| When $d_2 < d_{20}$, | $d_{2m}$ (nm) $=$ | 17.963 | 68.303 | 3.157 | 8.798 | 14.016 |

$$0.93 \leq NA \leq 1.0$$
$$2 \leq T \leq 15$$

| Case | 1-11 | 1-12 | 1-13 | 1-14 | 1-15 |
|---|---|---|---|---|---|
| $n_{10}$ | 1.7235310 | 1.7093992 | 1.7192548 | 1.7183512 | 1.7097773 |
| $k_{10}$ | 0.0712769 | 0.0595462 | 0.0668813 | 0.0690717 | 0.0638868 |
| $d_{10}$ (nm) | 155.759 | 237.275 | 223.222 | 220.755 | 221.916 |
| $n_{20}$ | 1.7500411 | 5.0249130 | 1.9244861 | 1.7884626 | 1.7175992 |
| $k_{20}$ | 0.2147794 | 2.4786958 | 0.3767470 | 0.2530536 | 0.2031308 |
| $d_{20}$ (nm) | 197.972 | 1.776 | 68.925 | 134.430 | 199.649 |

| | | 1-11 | 1-12 | 1-13 | 1-14 | 1-15 |
|---|---|---|---|---|---|---|
| When $n_1 \geq n_{10}$, | $n_{1m} =$ | 0.0687000 | 0.1022864 | 0.0758325 | 0.0727087 | 0.0697119 |
| When $n_1 < n_{10}$, | $n_{1m} =$ | 0.0322229 | 0.0397070 | 0.0389722 | 0.0346118 | 0.0564209 |
| When $k_1 \geq k_{10}$, | $k_{1m} =$ | 0.0698975 | 0.0795508 | 0.0762329 | 0.0700171 | 0.0722595 |
| When $k_1 < k_{10}$, | $k_{1m} =$ | 0.0415723 | 0.0393457 | 0.0338635 | 0.0308765 | 0.0321350 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 9.616 | 78.998 | 12.815 | 10.464 | 72.402 |
| When $n_2 \geq n_{20}$, | $n_{2m} =$ | 0.1855957 | 0.5207629 | 0.1343335 | 0.1358569 | 0.2333704 |
| When $n_2 < n_{20}$, | $n_{2m} =$ | 0.1501331 | 0.6523560 | 0.1703552 | 0.1672083 | 0.1693542 |
| When $k_2 \geq k_{20}$, | $k_{2m} =$ | 0.2047339 | 0.5424048 | 0.1363831 | 0.1710950 | 0.1947412 |
| When $k_2 < k_{20}$, | $k_{2m} =$ | 0.0758948 | 0.5487781 | 0.1192529 | 0.0892212 | 0.0778406 |
| When $d_2 \geq d_{20}$, | $d_{2m}$ (nm) $=$ | ∞ | 0.325 | 8.509 | ∞ | ∞ |
| When $d_2 < d_{20}$, | $d_{2m}$ (nm) $=$ | 29.087 | 0.351 | 7.511 | 11.451 | 31.610 |

$$0.93 \leq NA \leq 1.0$$
$$15 < T \leq 25$$

| Case | 2-01 | 2-02 | 2-03 | 2-04 | 2-05 |
|---|---|---|---|---|---|
| $n_{10}$ | 1.8890717 | 1.8040788 | 1.8569330 | 1.8246631 | 1.8713633 |
| $k_{10}$ | 0.2231211 | 0.2224671 | 0.1887211 | 0.1852786 | 0.1359350 |
| $d_{10}$ (nm) | 31.297 | 38.783 | 31.358 | 29.866 | 20.765 |
| $n_{20}$ | 2.2536461 | 3.4285504 | 2.3482559 | 2.0267942 | 1.8449284 |
| $k_{20}$ | 1.9138327 | 0.7115044 | 0.7139401 | 0.6589875 | 0.4410677 |
| $d_{20}$ (nm) | 8.426 | 30.090 | 49.395 | 61.419 | 129.533 |

| | | 2-01 | 2-02 | 2-03 | 2-04 | 2-05 |
|---|---|---|---|---|---|---|
| When $n_1 \geq n_{10}$, | $n_{1m} =$ | 0.0874390 | 0.0895227 | 0.0867871 | 0.0862964 | 0.0944556 |
| When $n_1 < n_{10}$, | $n_{1m} =$ | 0.0734485 | 0.0679480 | 0.0711365 | 0.0665735 | 0.0748743 |
| When $k_1 \geq k_{10}$, | $k_{1m} =$ | 0.0762256 | 0.0781921 | 0.0754639 | 0.0735010 | 0.0845789 |
| When $k_1 < k_{10}$, | $k_{1m} =$ | 0.0847852 | 0.0785486 | 0.0835657 | 0.0812061 | 0.0905493 |
| When $d_1 \geq d_{10}$, | $d_{1m}$ (nm) $=$ | 5.734 | 7.070 | 7.156 | 8.156 | 8.180 |
| When $d_1 < d_{10}$, | $d_{1m}$ (nm) $=$ | 4.509 | 5.331 | 5.325 | 5.713 | 5.655 |
| When $n_2 \geq n_{20}$, | $n_{2m} =$ | 0.3151672 | 0.1904419 | 0.1878015 | 0.1893945 | 0.1561475 |
| When $n_2 < n_{20}$, | $n_{2m} =$ | 0.3095313 | 0.2189575 | 0.2044202 | 0.1933459 | 0.1801416 |
| When $k_2 \geq k_{20}$, | $k_{2m} =$ | 0.3390149 | 0.2463513 | 0.2322900 | 0.2311047 | 0.2037732 |
| When $k_2 < k_{20}$, | $k_{2m} =$ | 0.3041187 | 0.1774133 | 0.1676416 | 0.1568945 | 0.1265381 |
| When $d_2 \geq d_{20}$, | $d_{2m}$ (nm) $=$ | 1.987 | 2.182 | 8.431 | ∞ | ∞ |
| When $d_2 < d_{20}$, | $d_{2m}$ (nm) $=$ | 1.727 | 2.068 | 6.571 | 10.427 | 56.577 |

$0.93 \leq NA \leq 1.0$

$15 < T \leq 25$

| Case | 2-06 | 2-07 | 2-08 | 2-09 | 2-10 |
|---|---|---|---|---|---|
| $n_{10}$ | 1.8537764 | 1.8773918 | 1.7913209 | 1.7961812 | 1.7719309 |
| $k_{10}$ | 0.1095380 | 0.0811836 | 0.1069315 | 0.0967122 | 0.0907051 |
| $d_{10}$ (nm) | 19.190 | 15.072 | 93.104 | 91.592 | 89.644 |
| $n_{20}$ | 1.8083352 | 1.7885130 | 2.1120296 | 2.2985234 | 1.8982310 |
| $k_{20}$ | 0.3385915 | 0.2812935 | 1.5705728 | 0.5621108 | 0.3437292 |
| $d_{20}$ (nm) | 190.096 | 250.952 | 8.709 | 49.876 | 119.550 |

| | | 2-06 | 2-07 | 2-08 | 2-09 | 2-10 |
|---|---|---|---|---|---|---|
| When $n_1 \geq n_{10}$, | $n_{1m} =$ | 0.0970691 | 0.1116003 | 0.0785193 | 0.0746387 | 0.0710254 |
| When $n_1 < n_{10}$, | $n_{1m} =$ | 0.0765894 | 0.0899463 | 0.0387744 | 0.0446472 | 0.0434424 |
| When $k_1 \geq k_{10}$, | $k_{1m} =$ | 0.0900769 | 0.1037891 | 0.0704041 | 0.0743225 | 0.0753088 |
| When $k_1 < k_{10}$, | $k_{1m} =$ | 0.0922754 | 0.0811836 | 0.0518481 | 0.0540869 | 0.0544885 |
| When $d_1 \geq d_{10}$, | $d_{1m}$ (nm) $=$ | 9.442 | 8.843 | 12.610 | 13.182 | 16.111 |
| When $d_1 < d_{10}$, | $d_{1m}$ (nm) $=$ | 6.479 | 6.242 | 5.884 | 6.895 | 7.619 |
| When $n_2 \geq n_{20}$, | $n_{2m} =$ | 0.1545007 | 0.1511414 | 0.2353479 | 0.1499768 | 0.1563330 |
| When $n_2 < n_{20}$, | $n_{2m} =$ | 0.1780847 | 0.1773486 | 0.2901843 | 0.1659082 | 0.1527185 |
| When $k_2 \geq k_{20}$, | $k_{2m} =$ | 0.1867920 | 0.1671802 | 0.2909924 | 0.1840894 | 0.2027185 |
| When $k_2 < k_{20}$, | $k_{2m} =$ | 0.1126624 | 0.1034778 | 0.2557275 | 0.1387183 | 0.1013330 |
| When $d_2 \geq d_{20}$, | $d_{2m}$ (nm) $=$ | $\infty$ | $\infty$ | 1.972 | 5.095 | $\infty$ |
| When $d_2 < d_{20}$, | $d_{2m}$ (nm) $=$ | 76.056 | 121.855 | 1.716 | 4.880 | 15.622 |

$0.93 \leq NA \leq 1.0$

$15 < T \leq 25$

| Case | 2-11 | 2-12 | 2-13 | 2-14 | 2-15 |
|---|---|---|---|---|---|
| $n_{10}$ | 1.7573553 | 1.7321027 | 1.7251448 | 1.7347815 | 1.7337052 |
| $k_{10}$ | 0.0844391 | 0.0771807 | 0.0782108 | 0.0789970 | 0.0782079 |
| $d_{10}$ (nm) | 89.273 | 89.432 | 166.474 | 158.854 | 156.164 |
| $n_{20}$ | 1.8090385 | 1.7181480 | 2.6560327 | 2.0166404 | 1.8413069 |
| $k_{20}$ | 0.2599016 | 0.2108133 | 2.0752579 | 0.4697089 | 0.2975845 |
| $d_{20}$ (nm) | 184.203 | 254.601 | 4.495 | 58.957 | 122.955 |

| | | 2-11 | 2-12 | 2-13 | 2-14 | 2-15 |
|---|---|---|---|---|---|---|
| When $n_1 \geq n_{10}$, | $n_{1m} =$ | 0.0699780 | 0.0690137 | 0.0832959 | 0.0721558 | 0.0683105 |
| When $n_1 < n_{10}$, | $n_{1m} =$ | 0.0410315 | 0.0429553 | 0.0305981 | 0.0341260 | 0.0308228 |
| When $k_1 \geq k_{10}$, | $k_{1m} =$ | 0.0723608 | 0.0738831 | 0.0729456 | 0.0742798 | 0.0703467 |
| When $k_1 < k_{10}$, | $k_{1m} =$ | 0.0569189 | 0.0588879 | 0.0382764 | 0.0397253 | 0.0396069 |
| When $d_1 \geq d_{10}$, | $d_{1m}$ (nm) $=$ | 21.648 | 30.736 | 32.939 | 31.041 | 34.229 |
| When $d_1 < d_{10}$, | $d_{1m}$ (nm) $=$ | 8.068 | 11.084 | 9.096 | 8.972 | 7.917 |
| When $n_2 \geq n_{20}$, | $n_{2m} =$ | 0.1631897 | 0.1805151 | 0.3419739 | 0.1438672 | 0.1358447 |
| When $n_2 < n_{20}$, | $n_{2m} =$ | 0.1518018 | 0.1480249 | 0.4228455 | 0.1667273 | 0.1539514 |
| When $k_2 \geq k_{20}$, | $k_{2m} =$ | 0.2316443 | 0.1895435 | 0.3584204 | 0.1604712 | 0.1864905 |
| When $k_2 < k_{20}$, | $k_{2m} =$ | 0.0850049 | 0.0772852 | 0.3668774 | 0.1323413 | 0.0930493 |
| When $d_2 \geq d_{20}$, | $d_{2m}$ (nm) $=$ | $\infty$ | $\infty$ | 0.935 | 6.683 | 16.067 |
| When $d_2 < d_{20}$, | $d_{2m}$ (nm) $=$ | 28.321 | 80.547 | 0.940 | 6.845 | 12.170 |

0. 9 3 ≤ N A ≤ 1. 0
1 5 < T ≤ 2 5

| Case | 2–16 | 2–17 | 2–18 | 2–19 | 2–20 |
|---|---|---|---|---|---|
| $n_{10}$ | 1.7245076 | 1.7100620 | 1.7130788 | 1.7208745 | 1.7192161 |
| $k_{10}$ | 0.0739010 | 0.0639207 | 0.0658962 | 0.0708686 | 0.0720786 |
| $d_{10}$ (nm) | 155.712 | 155.553 | 233.281 | 223.560 | 220.745 |
| $n_{20}$ | 1.7533528 | 1.6863114 | 3.3653368 | 1.9877972 | 1.7983405 |
| $k_{20}$ | 0.2275719 | 0.1891021 | 2.7431658 | 0.4366658 | 0.2740582 |
| $d_{20}$ (nm) | 189.273 | 256.528 | 2.501 | 59.393 | 125.643 |

| | | 2–16 | 2–17 | 2–18 | 2–19 | 2–20 |
|---|---|---|---|---|---|---|
| When $n_1 \geq n_{10}$, | $n_{1m} =$ | 0.0671997 | 0.0648059 | 0.0864783 | 0.0735278 | 0.0707983 |
| When $n_1 < n_{10}$, | $n_{1m} =$ | 0.0293323 | 0.0484583 | 0.0327734 | 0.0316724 | 0.0279663 |
| When $k_1 \geq k_{10}$, | $k_{1m} =$ | 0.0671045 | 0.0758130 | 0.0759729 | 0.0721252 | 0.0662109 |
| When $k_1 < k_{10}$, | $k_{1m} =$ | 0.0403235 | 0.0462146 | 0.0340283 | 0.0320007 | 0.0290771 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 8.393 | 77.190 | 14.014 | 10.040 | 8.344 |
| When $n_2 \geq n_{20}$, | $n_{2m} =$ | 0.1922314 | 0.2150586 | 0.5377722 | 0.1455798 | 0.1365283 |
| When $n_2 < n_{20}$, | $n_{2m} =$ | 0.1495129 | 0.1388159 | 0.5848816 | 0.1787549 | 0.1689587 |
| When $k_2 \geq k_{20}$, | $k_{2m} =$ | 0.2035803 | 0.1600281 | 0.4555420 | 0.1361926 | 0.1635962 |
| When $k_2 < k_{20}$, | $k_{2m} =$ | 0.0785095 | 0.0698242 | 0.5466174 | 0.1332434 | 0.0942200 |
| When $d_2 \geq d_{20}$, | $d_{2m}$ (nm) $=$ | ∞ | ∞ | 0.540 | 6.979 | ∞ |
| When $d_2 < d_{20}$, | $d_{2m}$ (nm) $=$ | 26.645 | 77.267 | 0.568 | 6.255 | 9.480 |

0. 9 3 ≤ N A ≤ 1. 0
1 5 < T ≤ 2 5

| Case | 2–21 | 2–22 |
|---|---|---|
| $n_{10}$ | 1.7100814 | 1.7028062 |
| $k_{10}$ | 0.0661341 | 0.0572529 |
| $d_{10}$ (nm) | 221.783 | 219.613 |
| $n_{20}$ | 1.7179584 | 1.6741304 |
| $k_{20}$ | 0.2146738 | 0.1784680 |
| $d_{20}$ (nm) | 191.114 | 256.090 |

| | | 2–21 | 2–22 |
|---|---|---|---|
| When $n_1 \geq n_{10}$, | $n_{1m} =$ | 0.0687488 | 0.0693079 |
| When $n_1 < n_{10}$, | $n_{1m} =$ | 0.0502954 | 0.0688196 |
| When $k_1 \geq k_{10}$, | $k_{1m} =$ | 0.0691418 | 0.0820508 |
| When $k_1 < k_{10}$, | $k_{1m} =$ | 0.0305945 | 0.0409924 |
| When $d_1 \geq d_{10}$, | $d_{1m}$ (nm) $=$ | ∞ | ∞ |
| When $d_1 < d_{10}$, | $d_{1m}$ (nm) $=$ | 70.999 | 88.114 |
| When $n_2 \geq n_{20}$, | $n_{2m} =$ | 0.2426611 | 0.2482605 |
| When $n_2 < n_{20}$, | $n_{2m} =$ | 0.1649829 | 0.1563098 |
| When $k_2 \geq k_{20}$, | $k_{2m} =$ | 0.1903906 | 0.1488330 |
| When $k_2 < k_{20}$, | $k_{2m} =$ | 0.0805981 | 0.0682654 |
| When $d_2 \geq d_{20}$, | $d_{2m}$ (nm) $=$ | ∞ | ∞ |
| When $d_2 < d_{20}$, | $d_{2m}$ (nm) $=$ | 28.403 | 77.092 |

$0.93 \leq NA \leq 1.0$
$25 < T \leq 35$

| Case | 3-01 | 3-02 | 3-03 | 3-04 | 3-05 |
|---|---|---|---|---|---|
| $n_{10}$ | 1.7462297 | 1.7852920 | 1.8064124 | 1.8761841 | 1.8732427 |
| $k_{10}$ | 0.2650661 | 0.2379686 | 0.2063789 | 0.1465026 | 0.1107685 |
| $d_{10}$ (nm) | 38.584 | 38.995 | 31.400 | 22.050 | 18.888 |
| $n_{20}$ | 1.8811342 | 3.2453891 | 2.0415396 | 1.8871554 | 1.8328297 |
| $k_{20}$ | 2.5474890 | 0.8215227 | 0.7493942 | 0.4863835 | 0.3644393 |
| $d_{20}$ (nm) | 6.719 | 29.990 | 55.163 | 118.487 | 179.928 |

| | | 3-01 | 3-02 | 3-03 | 3-04 | 3-05 |
|---|---|---|---|---|---|---|
| When $n_1 \geq n_{10}$, | $n_{1m} =$ | 0.0769434 | 0.0851318 | 0.0833228 | 0.0906799 | 0.0968079 |
| When $n_1 < n_{10}$, | $n_{1m} =$ | 0.0572766 | 0.0631555 | 0.0636389 | 0.0722144 | 0.0767554 |
| When $k_1 \geq k_{10}$, | $k_{1m} =$ | 0.0723669 | 0.0784412 | 0.0735730 | 0.0819336 | 0.0896667 |
| When $k_1 < k_{10}$, | $k_{1m} =$ | 0.0683887 | 0.0725391 | 0.0776208 | 0.0882788 | 0.0940442 |
| When $d_1 \geq d_{10}$, | $d_{1m}$ (nm) $=$ | 6.007 | 6.642 | 7.652 | 7.684 | 8.502 |
| When $d_1 < d_{10}$, | $d_{1m}$ (nm) $=$ | 4.614 | 4.982 | 5.411 | 5.323 | 5.843 |
| When $n_2 \geq n_{20}$, | $n_{2m} =$ | 0.4302271 | 0.2240894 | 0.2116187 | 0.1663196 | 0.1573621 |
| When $n_2 < n_{20}$, | $n_{2m} =$ | 0.3679468 | 0.2518726 | 0.2012903 | 0.1828064 | 0.1779138 |
| When $k_2 \geq k_{20}$, | $k_{2m} =$ | 0.4458606 | 0.2938757 | 0.2488452 | 0.2239661 | 0.1924353 |
| When $k_2 < k_{20}$, | $k_{2m} =$ | 0.4071558 | 0.2090601 | 0.1700916 | 0.1317957 | 0.1155774 |
| When $d_2 \geq d_{20}$, | $d_{2m}$ (nm) $=$ | 1.849 | 2.793 | ∞ | ∞ | ∞ |
| When $d_2 < d_{20}$, | $d_{2m}$ (nm) $=$ | 1.467 | 2.486 | 8.980 | 27.259 | 71.144 |

$0.93 \leq NA \leq 1.0$
$25 < T \leq 35$

| Case | 3-06 | 3-07 | 3-08 | 3-09 | 3-10 |
|---|---|---|---|---|---|
| $n_{10}$ | 1.8809997 | 1.8353407 | 1.8107063 | 1.7800259 | 1.7589519 |
| $k_{10}$ | 0.0844859 | 0.1336488 | 0.1074834 | 0.0966903 | 0.0885227 |
| $d_{10}$ (nm) | 15.636 | 86.851 | 91.200 | 89.638 | 89.033 |
| $n_{20}$ | 1.8003278 | 1.6000470 | 2.5616901 | 1.9474319 | 1.8081258 |
| $k_{20}$ | 0.2965881 | 1.7695220 | 0.6655713 | 0.3779800 | 0.2753975 |
| $d_{20}$ (nm) | 241.202 | 10.059 | 40.111 | 109.424 | 177.335 |

| | | 3-06 | 3-07 | 3-08 | 3-09 | 3-10 |
|---|---|---|---|---|---|---|
| When $n_1 \geq n_{10}$, | $n_{1m} =$ | 0.1079370 | 0.0607556 | 0.0690979 | 0.0686230 | 0.0682776 |
| When $n_1 < n_{10}$, | $n_{1m} =$ | 0.0864404 | 0.0389355 | 0.0418872 | 0.0404956 | 0.0386047 |
| When $k_1 \geq k_{10}$, | $k_{1m} =$ | 0.0999365 | 0.0690637 | 0.0736157 | 0.0727942 | 0.0702844 |
| When $k_1 < k_{10}$, | $k_{1m} =$ | 0.0844859 | 0.0492517 | 0.0507898 | 0.0531238 | 0.0559766 |
| When $d_1 \geq d_{10}$, | $d_{1m}$ (nm) $=$ | 8.565 | 8.192 | 11.124 | 13.835 | 18.997 |
| When $d_1 < d_{10}$, | $d_{1m}$ (nm) $=$ | 5.996 | 4.465 | 5.820 | 6.603 | 7.278 |
| When $n_2 \geq n_{20}$, | $n_{2m} =$ | 0.1541260 | 0.2930249 | 0.1702905 | 0.1595251 | 0.1700037 |
| When $n_2 < n_{20}$, | $n_{2m} =$ | 0.1764270 | 0.2694421 | 0.1785315 | 0.1557800 | 0.1515491 |
| When $k_2 \geq k_{20}$, | $k_{2m} =$ | 0.1720203 | 0.3061462 | 0.2081555 | 0.2039343 | 0.2313416 |
| When $k_2 < k_{20}$, | $k_{2m} =$ | 0.1058716 | 0.3107410 | 0.1597290 | 0.1070007 | 0.0874585 |
| When $d_2 \geq d_{20}$, | $d_{2m}$ (nm) $=$ | ∞ | 2.242 | 3.729 | 17.032 | ∞ |
| When $d_2 < d_{20}$, | $d_{2m}$ (nm) $=$ | 115.662 | 2.067 | 3.416 | 13.482 | 26.550 |

$0.93 \leq NA \leq 1.0$
$25 < T \leq 35$

| Case | 3-11 | 3-12 | 3-13 | 3-14 | 3-15 |
|---|---|---|---|---|---|
| $n_{10}$ | 1.7385561 | 1.7392392 | 1.7355979 | 1.7252169 | 1.7185486 |
| $k_{10}$ | 0.0961686 | 0.0859424 | 0.0828161 | 0.0770491 | 0.0788457 |
| $d_{10}$ (nm) | 161.111 | 158.474 | 155.982 | 155.656 | 229.847 |
| $n_{20}$ | 1.8448216 | 2.1008270 | 1.8545146 | 1.7550901 | 3.2610273 |
| $k_{20}$ | 2.2148249 | 0.5469970 | 0.3232472 | 0.2413910 | 4.4183916 |
| $d_{20}$ (nm) | 5.861 | 50.862 | 115.179 | 181.353 | 1.558 |

| | | 3-11 | 3-12 | 3-13 | 3-14 | 3-15 |
|---|---|---|---|---|---|---|
| When $n_1 \geq n_{10}$, | $n_{1m} =$ | 0.0629041 | 0.0674426 | 0.0657153 | 0.0649670 | 0.0703149 |
| When $n_1 < n_{10}$, | $n_{1m} =$ | 0.0253882 | 0.0295728 | 0.0268335 | 0.0256165 | 0.0220850 |
| When $k_1 \geq k_{10}$, | $k_{1m} =$ | 0.0668323 | 0.0703247 | 0.0663293 | 0.0632434 | 0.0659778 |
| When $k_1 < k_{10}$, | $k_{1m} =$ | 0.0332373 | 0.0369910 | 0.0375085 | 0.0384131 | 0.0277441 |
| When $d_1 \geq d_{10}$, | $d_{1m}$ (nm) $=$ | 20.469 | 26.314 | 30.753 | 47.147 | 42.683 |
| When $d_1 < d_{10}$, | $d_{1m}$ (nm) $=$ | 5.969 | 7.197 | 6.584 | 7.042 | 7.213 |
| When $n_2 \geq n_{20}$, | $n_{2m} =$ | 0.3836914 | 0.1608313 | 0.1425024 | 0.2021899 | 0.7624707 |
| When $n_2 < n_{20}$, | $n_{2m} =$ | 0.3601526 | 0.1749219 | 0.1554919 | 0.1482849 | 0.7156897 |
| When $k_2 \geq k_{20}$, | $k_{2m} =$ | 0.3156946 | 0.1638635 | 0.1816882 | 0.2013940 | 0.5159863 |
| When $k_2 < k_{20}$, | $k_{2m} =$ | 0.4014783 | 0.1464551 | 0.0974072 | 0.0811682 | 0.8313574 |
| When $d_2 \geq d_{20}$, | $d_{2m}$ (nm) $=$ | 1.291 | 5.616 | 13.990 | $\infty$ | 0.296 |
| When $d_2 < d_{20}$, | $d_{2m}$ (nm) $=$ | 1.319 | 5.535 | 10.236 | 24.868 | 0.387 |

$0.93 \leq NA \leq 1.0$
$25 < T \leq 35$

| Case | 3-16 | 3-17 | 3-18 |
|---|---|---|---|
| $n_{10}$ | 1.7228369 | 1.7199449 | 1.7101979 |
| $k_{10}$ | 0.0769315 | 0.0760859 | 0.0687675 |
| $d_{10}$ (nm) | 222.858 | 220.491 | 221.639 |
| $n_{20}$ | 2.0210736 | 1.8037789 | 1.7165312 |
| $k_{20}$ | 0.5011654 | 0.2965908 | 0.2274377 |
| $d_{20}$ (nm) | 52.892 | 118.134 | 183.246 |

| | | 3-16 | 3-17 | 3-18 |
|---|---|---|---|---|
| When $n_1 \geq n_{10}$, | $n_{1m} =$ | 0.0694470 | 0.0680798 | 0.0669543 |
| When $n_1 < n_{10}$, | $n_{1m} =$ | 0.0241309 | 0.0211279 | 0.0442908 |
| When $k_1 \geq k_{10}$, | $k_{1m} =$ | 0.0659106 | 0.0606384 | 0.0650562 |
| When $k_1 < k_{10}$, | $k_{1m} =$ | 0.0287354 | 0.0259912 | 0.0284460 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 7.193 | 6.146 | 69.475 |
| When $n_2 \geq n_{20}$, | $n_{2m} =$ | 0.1641553 | 0.1445947 | 0.2568982 |
| When $n_2 < n_{20}$, | $n_{2m} =$ | 0.1866541 | 0.1696143 | 0.1583826 |
| When $k_2 \geq k_{20}$, | $k_{2m} =$ | 0.1286877 | 0.1503394 | 0.1843665 |
| When $k_2 < k_{20}$, | $k_{2m} =$ | 0.1457922 | 0.0990405 | 0.0813123 |
| When $d_2 \geq d_{20}$, | $d_{2m}$ (nm) $=$ | 6.290 | 17.763 | $\infty$ |
| When $d_2 < d_{20}$, | $d_{2m}$ (nm) $=$ | 5.002 | 7.323 | 26.072 |

$0. 93 \leq NA \leq 1. 0$
$35 < T \leq 45$

| Case | 4-01 | 4-02 | 4-03 | 4-04 | 4-05 |
|---|---|---|---|---|---|
| $n_{10}$ | 1.8047095 | 1.8098021 | 1.8915289 | 1.8869810 | 1.8679863 |
| $k_{10}$ | 0.2694194 | 0.2379756 | 0.1677232 | 0.1583242 | 0.1633407 |
| $d_{10}$ (nm) | 36.421 | 31.711 | 26.420 | 22.598 | 22.571 |
| $n_{20}$ | 2.9911125 | 2.1295160 | 2.1348336 | 1.9270572 | 1.8682373 |
| $k_{20}$ | 1.0218786 | 0.9059492 | 0.5678980 | 0.5352831 | 0.5190358 |
| $d_{20}$ (nm) | 30.087 | 46.199 | 93.459 | 108.068 | 112.596 |

| | | 4-01 | 4-02 | 4-03 | 4-04 | 4-05 |
|---|---|---|---|---|---|---|
| When $n_1 \geq n_{10}$, | $n_{1m} =$ | 0.0783740 | 0.0796436 | 0.0844666 | 0.0882751 | 0.0886218 |
| When $n_1 < n_{10}$, | $n_{1m} =$ | 0.0596716 | 0.0601453 | 0.0678638 | 0.0698572 | 0.0685303 |
| When $k_1 \geq k_{10}$, | $k_{1m} =$ | 0.0745129 | 0.0734180 | 0.0774060 | 0.0809473 | 0.0815564 |
| When $k_1 < k_{10}$, | $k_{1m} =$ | 0.0737073 | 0.0756104 | 0.0846094 | 0.0871533 | 0.0855286 |
| When $d_1 \geq d_{10}$, | $d_{1m}$ (nm) $=$ | 5.498 | 6.440 | 6.660 | 7.044 | 7.454 |
| When $d_1 < d_{10}$, | $d_{1m}$ (nm) $=$ | 4.112 | 4.536 | 4.657 | 4.822 | 5.013 |
| When $n_2 \geq n_{20}$, | $n_{2m} =$ | 0.2827258 | 0.2488782 | 0.2107483 | 0.1777197 | 0.1733423 |
| When $n_2 < n_{20}$, | $n_{2m} =$ | 0.2979187 | 0.2268945 | 0.2048547 | 0.1904834 | 0.1888538 |
| When $k_2 \geq k_{20}$, | $k_{2m} =$ | 0.3686462 | 0.2854443 | 0.2568164 | 0.2416882 | 0.2270508 |
| When $k_2 < k_{20}$, | $k_{2m} =$ | 0.2566187 | 0.1919458 | 0.1493335 | 0.1371973 | 0.1348743 |
| When $d_2 \geq d_{20}$, | $d_{2m}$ (nm) $=$ | 4.536 | ∞ | ∞ | ∞ | ∞ |
| When $d_2 < d_{20}$, | $d_{2m}$ (nm) $=$ | 3.441 | 7.549 | 17.368 | 24.447 | 26.666 |

$0. 93 \leq NA \leq 1. 0$
$35 < T \leq 45$

| Case | 4-06 | 4-07 | 4-08 | 4-09 | 4-10 |
|---|---|---|---|---|---|
| $n_{10}$ | 1.8894047 | 1.9013640 | 1.7974174 | 1.7778270 | 1.7589001 |
| $k_{10}$ | 0.1134244 | 0.0821095 | 0.1211843 | 0.1038067 | 0.0931193 |
| $d_{10}$ (nm) | 18.623 | 14.880 | 88.331 | 88.747 | 88.775 |
| $n_{20}$ | 1.8513003 | 1.8106171 | 2.0615819 | 1.9023003 | 1.8006679 |
| $k_{20}$ | 0.3877744 | 0.3102506 | 0.7049601 | 0.4013081 | 0.2880356 |
| $d_{20}$ (nm) | 170.528 | 232.433 | 48.141 | 106.512 | 170.885 |

| | | 4-06 | 4-07 | 4-08 | 4-09 | 4-10 |
|---|---|---|---|---|---|---|
| When $n_1 \geq n_{10}$, | $n_{1m} =$ | 0.0963379 | 0.1102368 | 0.0634644 | 0.0662390 | 0.0666211 |
| When $n_1 < n_{10}$, | $n_{1m} =$ | 0.0760864 | 0.0881848 | 0.0372961 | 0.0368457 | 0.0352515 |
| When $k_1 \geq k_{10}$, | $k_{1m} =$ | 0.0891541 | 0.1015222 | 0.0717737 | 0.0709473 | 0.0673779 |
| When $k_1 < k_{10}$, | $k_{1m} =$ | 0.0954272 | 0.0821095 | 0.0478455 | 0.0509119 | 0.0546045 |
| When $d_1 \geq d_{10}$, | $d_{1m}$ (nm) $=$ | 7.796 | 7.721 | 10.517 | 12.746 | 16.898 |
| When $d_1 < d_{10}$, | $d_{1m}$ (nm) $=$ | 5.302 | 5.383 | 5.078 | 5.794 | 6.421 |
| When $n_2 \geq n_{20}$, | $n_{2m} =$ | 0.1607617 | 0.1549121 | 0.2063647 | 0.1805920 | 0.1791541 |
| When $n_2 < n_{20}$, | $n_{2m} =$ | 0.1802881 | 0.1767310 | 0.1869873 | 0.1622900 | 0.1552356 |
| When $k_2 \geq k_{20}$, | $k_{2m} =$ | 0.1971570 | 0.1718066 | 0.1998254 | 0.2205994 | 0.2284485 |
| When $k_2 < k_{20}$, | $k_{2m} =$ | 0.1177856 | 0.1071863 | 0.1537903 | 0.1082654 | 0.0890710 |
| When $d_2 \geq d_{20}$, | $d_{2m}$ (nm) $=$ | ∞ | ∞ | 7.208 | ∞ | ∞ |
| When $d_2 < d_{20}$, | $d_{2m}$ (nm) $=$ | 68.041 | 110.260 | 5.967 | 13.288 | 26.909 |

$0. 9 3 \leq NA \leq 1. 0$
$3 5 < T \leq 4 5$

| Case | 4-11 | 4-12 | 4-13 | 4-14 | 4-15 |
|---|---|---|---|---|---|
| $n_{10}$ | 1.7310401 | 1.7404520 | 1.7353985 | 1.7244370 | 1.7094852 |
| $k_{10}$ | 0.0827558 | 0.0960720 | 0.0882239 | 0.0802890 | 0.0677575 |
| $d_{10}$ (nm) | 89.146 | 155.339 | 154.960 | 155.397 | 155.056 |
| $n_{20}$ | 1.7041670 | 1.9461112 | 1.8293633 | 1.7457172 | 1.6751093 |
| $k_{20}$ | 0.2282102 | 0.5942640 | 0.3421815 | 0.2519901 | 0.2044537 |
| $d_{20}$ (nm) | 240.157 | 50.887 | 110.529 | 174.646 | 241.084 |

| | | 4-11 | 4-12 | 4-13 | 4-14 | 4-15 |
|---|---|---|---|---|---|---|
| When $n_1 \geq n_{10}$, | $n_{1m} =$ | 0.0658081 | 0.0609131 | 0.0631018 | 0.0626184 | 0.0606677 |
| When $n_1 < n_{10}$, | $n_{1m} =$ | 0.0392627 | 0.0232361 | 0.0219373 | 0.0213806 | 0.0433704 |
| When $k_1 \geq k_{10}$, | $k_{1m} =$ | 0.0703406 | 0.0642554 | 0.0612463 | 0.0585852 | 0.0715100 |
| When $k_1 < k_{10}$, | $k_{1m} =$ | 0.0569983 | 0.0328662 | 0.0342212 | 0.0355737 | 0.0444800 |
| When $d_1 \geq d_{10}$, | $d_{1m}$ (nm) $=$ | 25.085 | 16.735 | 27.723 | 38.964 | $\infty$ |
| When $d_1 < d_{10}$, | $d_{1m}$ (nm) $=$ | 9.551 | 5.135 | 5.136 | 5.707 | 18.661 |
| When $n_2 \geq n_{20}$, | $n_{2m} =$ | 0.1952173 | 0.1934106 | 0.1684375 | 0.2170105 | 0.2364917 |
| When $n_2 < n_{20}$, | $n_{2m} =$ | 0.1461670 | 0.1873682 | 0.1611987 | 0.1494055 | 0.1341663 |
| When $k_2 \geq k_{20}$, | $k_{2m} =$ | 0.1811243 | 0.1365161 | 0.1602917 | 0.1917432 | 0.1477625 |
| When $k_2 < k_{20}$, | $k_{2m} =$ | 0.0805774 | 0.1412585 | 0.0980115 | 0.0826819 | 0.0722742 |
| When $d_2 \geq d_{20}$, | $d_{2m}$ (nm) $=$ | $\infty$ | 6.877 | 15.552 | $\infty$ | $\infty$ |
| When $d_2 < d_{20}$, | $d_{2m}$ (nm) $=$ | 77.061 | 5.982 | 8.340 | 24.666 | 73.559 |

$0. 9 3 \leq NA \leq 1. 0$
$3 5 < T \leq 4 5$

| Case | 4-16 | 4-17 | 4-18 | 4-19 | 4-20 |
|---|---|---|---|---|---|
| $n_{10}$ | 1.7305468 | 1.7234847 | 1.7196555 | 1.7094719 | 1.7026367 |
| $k_{10}$ | 0.1083688 | 0.0859582 | 0.0809985 | 0.0713058 | 0.0605694 |
| $d_{10}$ (nm) | 224.105 | 219.529 | 219.492 | 221.454 | 219.016 |
| $n_{20}$ | 3.7612310 | 1.8940064 | 1.7865237 | 1.7085534 | 1.6670562 |
| $k_{20}$ | 9.7520181 | 0.5381566 | 0.3130643 | 0.2375210 | 0.1929642 |
| $d_{20}$ (nm) | 0.557 | 52.122 | 112.555 | 175.858 | 239.742 |

| | | 4-16 | 4-17 | 4-18 | 4-19 | 4-20 |
|---|---|---|---|---|---|---|
| When $n_1 \geq n_{10}$, | $n_{1m} =$ | 0.0498926 | 0.0642505 | 0.0656738 | 0.0636218 | 0.0649512 |
| When $n_1 < n_{10}$, | $n_{1m} =$ | 0.0031824 | 0.0153259 | 0.0138647 | 0.0294287 | 0.0615662 |
| When $k_1 \geq k_{10}$, | $k_{1m} =$ | 0.0271924 | 0.0553479 | 0.0526111 | 0.0605078 | 0.0781384 |
| When $k_1 < k_{10}$, | $k_{1m} =$ | 0.0108813 | 0.0230212 | 0.0207922 | 0.0257751 | 0.0395862 |
| When $d_1 \geq d_{10}$, | $d_{1m}$ (nm) $=$ | 12.324 | 42.526 | $\infty$ | $\infty$ | $\infty$ |
| When $d_1 < d_{10}$, | $d_{1m}$ (nm) $=$ | 0.823 | 4.181 | 3.891 | 14.979 | 80.387 |
| When $n_2 \geq n_{20}$, | $n_{2m} =$ | 0.4580664 | 0.1955493 | 0.1665735 | 0.2757410 | 0.2666089 |
| When $n_2 < n_{20}$, | $n_{2m} =$ | 1.0705701 | 0.1254541 | 0.1755249 | 0.1566431 | 0.1466138 |
| When $k_2 \geq k_{20}$, | $k_{2m} =$ | 0.1823242 | 0.0953308 | 0.1233594 | 0.1752612 | 0.1390967 |
| When $k_2 < k_{20}$, | $k_{2m} =$ | 1.8675439 | 0.1410535 | 0.1010315 | 0.0760974 | 0.0711597 |
| When $d_2 \geq d_{20}$, | $d_{2m}$ (nm) $=$ | 0.019 | 7.428 | $\infty$ | $\infty$ | $\infty$ |
| When $d_2 < d_{20}$, | $d_{2m}$ (nm) $=$ | 0.155 | 3.724 | 4.890 | 25.232 | 73.082 |

$0.93 \leq NA \leq 1.0$

$45 < T \leq 55$

| Case | 5-01 | 5-02 | 5-03 | 5-04 | 5-05 |
|---|---|---|---|---|---|
| $n_{10}$ | 1.7952075 | 1.8907711 | 1.9054716 | 1.9347861 | 1.9562331 |
| $k_{10}$ | 0.2631488 | 0.1709411 | 0.1139096 | 0.0660701 | 0.1018371 |
| $d_{10}$ (nm) | 28.407 | 22.060 | 18.051 | 14.149 | 10.504 |
| $n_{20}$ | 1.7975159 | 1.9054700 | 1.8637077 | 1.8512928 | 1.7371318 |
| $k_{20}$ | 0.9080589 | 0.5625340 | 0.4032117 | 0.3248351 | 0.3049135 |
| $d_{20}$ (nm) | 49.215 | 101.512 | 161.182 | 218.499 | 238.789 |

| | | 5-01 | 5-02 | 5-03 | 5-04 | 5-05 |
|---|---|---|---|---|---|---|
| When $n_1 \geq n_{10}$, | $n_{1m} =$ | 0.0796008 | 0.0882104 | 0.0968323 | 0.1120276 | 0.1430420 |
| When $n_1 < n_{10}$, | $n_{1m} =$ | 0.0558337 | 0.0676855 | 0.0756775 | 0.0900916 | 0.1115369 |
| When $k_1 \geq k_{10}$, | $k_{1m} =$ | 0.0737183 | 0.0824512 | 0.0899622 | 0.1015723 | 0.1322839 |
| When $k_1 < k_{10}$, | $k_{1m} =$ | 0.0714771 | 0.0859058 | 0.0970459 | 0.0660701 | 0.1018371 |
| When $d_1 \geq d_{10}$, | $d_{1m}$ (nm) $=$ | 6.136 | 6.696 | 7.231 | 6.738 | 5.941 |
| When $d_1 < d_{10}$, | $d_{1m}$ (nm) $=$ | 3.959 | 4.421 | 4.830 | 4.663 | 4.082 |
| When $n_2 \geq n_{20}$, | $n_{2m} =$ | 0.2206628 | 0.1836475 | 0.1640088 | 0.1560229 | 0.1493176 |
| When $n_2 < n_{20}$, | $n_{2m} =$ | 0.2514893 | 0.2026611 | 0.1850330 | 0.1781982 | 0.1793958 |
| When $k_2 \geq k_{20}$, | $k_{2m} =$ | 0.2648120 | 0.2363086 | 0.1980701 | 0.1765576 | 0.1456726 |
| When $k_2 < k_{20}$, | $k_{2m} =$ | 0.1661694 | 0.1390979 | 0.1188672 | 0.1083618 | 0.1075342 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 11.142 | 25.966 | 67.131 | 101.947 | 116.324 |

$0.93 \leq NA \leq 1.0$

$45 < T \leq 55$

| Case | 5-06 | 5-07 | 5-08 | 5-09 | 5-10 |
|---|---|---|---|---|---|
| $n_{10}$ | 1.7844085 | 1.7702622 | 1.7541370 | 1.7279592 | 1.7375980 |
| $k_{10}$ | 0.1367381 | 0.1105738 | 0.0973387 | 0.0846136 | 0.1054836 |
| $d_{10}$ (nm) | 84.299 | 87.211 | 88.132 | 88.943 | 150.710 |
| $n_{20}$ | 1.7096132 | 1.8115599 | 1.7670571 | 1.6883751 | 1.7055974 |
| $k_{20}$ | 0.6495191 | 0.4022198 | 0.2903421 | 0.2308596 | 0.5608974 |
| $d_{20}$ (nm) | 54.242 | 106.122 | 167.020 | 233.281 | 53.799 |

| | | 5-06 | 5-07 | 5-08 | 5-09 | 5-10 |
|---|---|---|---|---|---|---|
| When $n_1 \geq n_{10}$, | $n_{1m} =$ | 0.0647021 | 0.0659351 | 0.0664050 | 0.0646069 | 0.0607947 |
| When $n_1 < n_{10}$, | $n_{1m} =$ | 0.0336169 | 0.0333887 | 0.0319458 | 0.0381165 | 0.0178674 |
| When $k_1 \geq k_{10}$, | $k_{1m} =$ | 0.0728796 | 0.0707520 | 0.0653967 | 0.0692603 | 0.0616235 |
| When $k_1 < k_{10}$, | $k_{1m} =$ | 0.0421851 | 0.0477087 | 0.0524451 | 0.0553516 | 0.0270422 |
| When $d_1 \geq d_{10}$, | $d_{1m}$ (nm) $=$ | 9.564 | 12.156 | 16.406 | 23.344 | 13.595 |
| When $d_1 < d_{10}$, | $d_{1m}$ (nm) $=$ | 4.227 | 5.119 | 5.747 | 9.303 | 3.589 |
| When $n_2 \geq n_{20}$, | $n_{2m} =$ | 0.2254211 | 0.1928967 | 0.1889099 | 0.2061182 | 0.2563867 |
| When $n_2 < n_{20}$, | $n_{2m} =$ | 0.1907227 | 0.1764453 | 0.1616943 | 0.1463477 | 0.1201587 |
| When $k_2 \geq k_{20}$, | $k_{2m} =$ | 0.1398059 | 0.1815479 | 0.2086975 | 0.1714539 | 0.0974426 |
| When $k_2 < k_{20}$, | $k_{2m} =$ | 0.1320325 | 0.1038733 | 0.0888391 | 0.0812170 | 0.1216650 |
| When $d_2 \geq d_{20}$, | $d_{2m}$ (nm) $=$ | 14.246 | $\infty$ | $\infty$ | $\infty$ | 10.184 |
| When $d_2 < d_{20}$, | $d_{2m}$ (nm) $=$ | 7.856 | 11.965 | 30.548 | 77.806 | 4.856 |

$0.93 \leq NA \leq 1.0$
$45 < T \leq 55$

| Case | 5-11 | 5-12 | 5-13 | 5-14 | 5-15 |
|---|---|---|---|---|---|
| $n_{10}$ | 1.7329681 | 1.7221048 | 1.7083331 | 1.7220084 | 1.7182277 |
| $k_{10}$ | 0.0932680 | 0.0829100 | 0.0687145 | 0.0940320 | 0.0857940 |
| $d_{10}$ (nm) | 153.145 | 154.966 | 154.712 | 214.741 | 217.589 |
| $n_{20}$ | 1.7707311 | 1.7249696 | 1.6656993 | 1.7051250 | 1.7452872 |
| $k_{20}$ | 0.3436851 | 0.2554267 | 0.2071468 | 0.5097600 | 0.3145186 |
| $d_{20}$ (nm) | 107.979 | 168.643 | 233.037 | 53.504 | 108.615 |

| | | 5-11 | 5-12 | 5-13 | 5-14 | 5-15 |
|---|---|---|---|---|---|---|
| When $n_1 \geq n_{10}$, | $n_{1m} =$ | 0.0625659 | 0.0612402 | 0.0592444 | 0.0643567 | 0.0658276 |
| When $n_1 < n_{10}$, | $n_{1m} =$ | 0.0170984 | 0.0172632 | 0.0416833 | 0.0078064 | 0.0068054 |
| When $k_1 \geq k_{10}$, | $k_{1m} =$ | 0.0565161 | 0.0540405 | 0.0705188 | 0.0454688 | 0.0426636 |
| When $k_1 < k_{10}$, | $k_{1m} =$ | 0.0297095 | 0.0318542 | 0.0432507 | 0.0149841 | 0.0129956 |
| When $d_1 \geq d_{10}$, | $d_{1m}$ (nm) $=$ | 26.425 | 34.880 | ∞ | 35.694 | ∞ |
| When $d_1 < d_{10}$, | $d_{1m}$ (nm) $=$ | 3.834 | 4.536 | 17.051 | 1.969 | 1.835 |
| When $n_2 \geq n_{20}$, | $n_{2m} =$ | 0.2299866 | 0.2362512 | 0.2473572 | 0.2585364 | 0.2705701 |
| When $n_2 < n_{20}$, | $n_{2m} =$ | 0.1752441 | 0.1521826 | 0.1336328 | 0.0467419 | 0.0530518 |
| When $k_2 \geq k_{20}$, | $k_{2m} =$ | 0.1260229 | 0.1759094 | 0.1395569 | 0.0560938 | 0.0808508 |
| When $k_2 < k_{20}$, | $k_{2m} =$ | 0.0941040 | 0.0829492 | 0.0726111 | 0.1239917 | 0.0993604 |
| When $d_2 \geq d_{20}$, | $d_{2m}$ (nm) $=$ | ∞ | ∞ | ∞ | 10.256 | ∞ |
| When $d_2 < d_{20}$, | $d_{2m}$ (nm) $=$ | 6.312 | 26.413 | 73.432 | 2.024 | 2.346 |

$0.93 \leq NA \leq 1.0$
$45 < T \leq 55$

| Case | 5-16 | 5-17 |
|---|---|---|
| $n_{10}$ | 1.7079026 | 1.7021324 |
| $k_{10}$ | 0.0731017 | 0.0613637 |
| $d_{10}$ (nm) | 221.285 | 218.642 |
| $n_{20}$ | 1.6934483 | 1.6620357 |
| $k_{20}$ | 0.2412999 | 0.1957858 |
| $d_{20}$ (nm) | 168.585 | 230.920 |

| | | 5-16 | 5-17 |
|---|---|---|---|
| When $n_1 \geq n_{10}$, | $n_{1m} =$ | 0.0611572 | 0.0632739 |
| When $n_1 < n_{10}$, | $n_{1m} =$ | 0.0235156 | 0.0581824 |
| When $k_1 \geq k_{10}$, | $k_{1m} =$ | 0.0566406 | 0.0776050 |
| When $k_1 < k_{10}$, | $k_{1m} =$ | 0.0230566 | 0.0386719 |
| When $d_1 \geq d_{10}$, | $d_{1m}$ (nm) $=$ | ∞ | ∞ |
| When $d_1 < d_{10}$, | $d_{1m}$ (nm) $=$ | 8.641 | 78.699 |
| When $n_2 \geq n_{20}$, | $n_{2m} =$ | 0.2946387 | 0.2760742 |
| When $n_2 < n_{20}$, | $n_{2m} =$ | 0.1554272 | 0.1463647 |
| When $k_2 \geq k_{20}$, | $k_{2m} =$ | 0.1654895 | 0.1344739 |
| When $k_2 < k_{20}$, | $k_{2m} =$ | 0.0676013 | 0.0719324 |
| When $d_2 \geq d_{20}$, | $d_{2m}$ (nm) $=$ | ∞ | ∞ |
| When $d_2 < d_{20}$, | $d_{2m}$ (nm) $=$ | 26.199 | 53.085 |

0. 9 3 ≤ N A ≤ 1. 0
5 5 < T ≤ 6 5

| Case | 6-01 | 6-02 | 6-03 | 6-04 | 6-05 |
|---|---|---|---|---|---|
| $n_{10}$ | 1.7605068 | 1.8816347 | 1.9020430 | 1.9458467 | 1.9584022 |
| $k_{10}$ | 0.2771672 | 0.1829378 | 0.1268282 | 0.0703715 | 0.1032605 |
| $d_{10}$ (nm) | 28.706 | 20.725 | 16.538 | 13.048 | 10.534 |
| $n_{20}$ | 1.6786286 | 1.8151288 | 1.7976518 | 1.8275971 | 1.7382432 |
| $k_{20}$ | 0.9008770 | 0.5496963 | 0.3935708 | 0.3251874 | 0.3086817 |
| $d_{20}$ (nm) | 43.735 | 99.755 | 160.685 | 213.311 | 229.129 |

| | | 6-01 | 6-02 | 6-03 | 6-04 | 6-05 |
|---|---|---|---|---|---|---|
| When $n_1 \geq n_{10}$, | $n_{1m} =$ | 0.0840430 | 0.0931677 | 0.1035986 | 0.1192371 | 0.1431311 |
| When $n_1 < n_{10}$, | $n_{1m} =$ | 0.0576428 | 0.0681458 | 0.0779578 | 0.0939172 | 0.1097058 |
| When $k_1 \geq k_{10}$, | $k_{1m} =$ | 0.0662097 | 0.0857654 | 0.0958630 | 0.1068726 | 0.1305750 |
| When $k_1 < k_{10}$, | $k_{1m} =$ | 0.0706262 | 0.0861902 | 0.1004041 | 0.0703715 | 0.1032605 |
| When $d_1 \geq d_{10}$, | $d_{1m}$ (nm) $=$ | 6.461 | 6.864 | 7.218 | 6.428 | 5.908 |
| When $d_1 < d_{10}$, | $d_{1m}$ (nm) $=$ | 4.241 | 4.337 | 4.665 | 4.365 | 3.988 |
| When $n_2 \geq n_{20}$, | $n_{2m} =$ | 0.2053870 | 0.1760388 | 0.1592407 | 0.1556714 | 0.1505713 |
| When $n_2 < n_{20}$, | $n_{2m} =$ | 0.2197400 | 0.2099182 | 0.1887061 | 0.1809558 | 0.1813904 |
| When $k_2 \geq k_{20}$, | $k_{2m} =$ | 0.2532373 | 0.2078381 | 0.1779785 | 0.1687073 | 0.1458105 |
| When $k_2 < k_{20}$, | $k_{2m} =$ | 0.1729968 | 0.1382983 | 0.1186841 | 0.1101477 | 0.1094250 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 9.750 | 24.367 | 71.258 | 104.445 | 116.852 |

0. 9 3 ≤ N A ≤ 1. 0
5 5 < T ≤ 6 5

| Case | 6-06 | 6-07 | 6-08 | 6-09 | 6-10 |
|---|---|---|---|---|---|
| $n_{10}$ | 1.7915017 | 1.7682864 | 1.7517777 | 1.7257399 | 1.7391311 |
| $k_{10}$ | 0.1460711 | 0.1152280 | 0.1000283 | 0.0854213 | 0.1111219 |
| $d_{10}$ (nm) | 82.108 | 86.246 | 87.803 | 88.823 | 148.271 |
| $n_{20}$ | 1.6599684 | 1.7730752 | 1.7495420 | 1.6774661 | 1.6415570 |
| $k_{20}$ | 0.6598461 | 0.3999868 | 0.2902721 | 0.2313191 | 0.5493559 |
| $d_{20}$ (nm) | 47.036 | 100.473 | 159.986 | 224.881 | 47.977 |

| | | 6-06 | 6-07 | 6-08 | 6-09 | 6-10 |
|---|---|---|---|---|---|---|
| When $n_1 \geq n_{10}$, | $n_{1m} =$ | 0.0707507 | 0.0678174 | 0.0671436 | 0.0642444 | 0.0613611 |
| When $n_1 < n_{10}$, | $n_{1m} =$ | 0.0347034 | 0.0316797 | 0.0297241 | 0.0379114 | 0.0170081 |
| When $k_1 \geq k_{10}$, | $k_{1m} =$ | 0.0716638 | 0.0707349 | 0.0637610 | 0.0688733 | 0.0614063 |
| When $k_1 < k_{10}$, | $k_{1m} =$ | 0.0419373 | 0.0459045 | 0.0509448 | 0.0544250 | 0.0258569 |
| When $d_1 \geq d_{10}$, | $d_{1m}$ (nm) $=$ | 8.814 | 11.596 | 15.946 | 22.736 | 12.264 |
| When $d_1 < d_{10}$, | $d_{1m}$ (nm) $=$ | 3.999 | 4.706 | 5.289 | 9.347 | 3.219 |
| When $n_2 \geq n_{20}$, | $n_{2m} =$ | 0.2110352 | 0.2040027 | 0.1980566 | 0.2150256 | 0.2303101 |
| When $n_2 < n_{20}$, | $n_{2m} =$ | 0.1684949 | 0.1890479 | 0.1666223 | 0.1461719 | 0.0970691 |
| When $k_2 \geq k_{20}$, | $k_{2m} =$ | 0.1438293 | 0.1667627 | 0.2003491 | 0.1648621 | 0.0994629 |
| When $k_2 < k_{20}$, | $k_{2m} =$ | 0.1447302 | 0.1052173 | 0.0896777 | 0.0819421 | 0.1292871 |
| When $d_2 \geq d_{20}$, | $d_{2m}$ (nm) $=$ | 15.339 | ∞ | ∞ | ∞ | 12.574 |
| When $d_2 < d_{20}$, | $d_{2m}$ (nm) $=$ | 6.489 | 10.552 | 32.474 | 78.570 | 4.088 |

$0.93 \leq NA \leq 1.0$

$55 < T \leq 65$

| Case | 6-11 | 6-12 | 6-13 | 6-14 | 6-15 |
|---|---|---|---|---|---|
| $n_{10}$ | 1.7320844 | 1.7076855 | 1.7203924 | 1.7223192 | 1.7173463 |
| $k_{10}$ | 0.0968192 | 0.0689521 | 0.0842770 | 0.0985051 | 0.0890019 |
| $d_{10}$ (nm) | 152.055 | 154.586 | 154.911 | 212.081 | 216.420 |
| $n_{20}$ | 1.7411899 | 1.6612710 | 1.7118542 | 1.6387426 | 1.7205682 |
| $k_{20}$ | 0.3409343 | 0.2081961 | 0.2561923 | 0.4904233 | 0.3116849 |
| $d_{20}$ (nm) | 101.751 | 223.547 | 160.544 | 48.284 | 102.035 |

| | | 6-11 | 6-12 | 6-13 | 6-14 | 6-15 |
|---|---|---|---|---|---|---|
| When $n_1 \geq n_{10}$, | $n_{1m}=$ | 0.0640808 | 0.0590295 | 0.0609424 | 0.0598975 | 0.0677930 |
| When $n_1 < n_{10}$, | $n_{1m}=$ | 0.0141614 | 0.0412158 | 0.0147046 | 0.0053711 | 0.0022900 |
| When $k_1 \geq k_{10}$, | $k_{1m}=$ | 0.0532275 | 0.0702893 | 0.0510400 | 0.0410706 | 0.0340332 |
| When $k_1 < k_{10}$, | $k_{1m}=$ | 0.0265625 | 0.0427490 | 0.0291602 | 0.0117297 | 0.0056226 |
| When $d_1 \geq d_{10}$, | $d_{1m}$ (nm) $=$ | 25.992 | ∞ | 33.192 | 33.998 | 50.996 |
| When $d_1 < d_{10}$, | $d_{1m}$ (nm) $=$ | 3.082 | 16.525 | 3.853 | 1.301 | 0.604 |
| When $n_2 \geq n_{20}$, | $n_{2m}=$ | 0.2268713 | 0.2531177 | 0.2476831 | 0.2556775 | 0.2704236 |
| When $n_2 < n_{20}$, | $n_{2m}=$ | 0.1878772 | 0.1338721 | 0.1536694 | 0.0287537 | 0.0146338 |
| When $k_2 \geq k_{20}$, | $k_{2m}=$ | 0.1099695 | 0.1355603 | 0.1692993 | 0.0485706 | 0.0433569 |
| When $k_2 < k_{20}$, | $k_{2m}=$ | 0.0948242 | 0.0734631 | 0.0770691 | 0.1286780 | 0.0774121 |
| When $d_2 \geq d_{20}$, | $d_{2m}$ (nm) $=$ | ∞ | ∞ | ∞ | 12.209 | ∞ |
| When $d_2 < d_{20}$, | $d_{2m}$ (nm) $=$ | 4.972 | 56.744 | 27.273 | 1.327 | 0.772 |

$0.93 \leq NA \leq 1.0$

$55 < T \leq 65$

| Case | 6-16 | 6-17 |
|---|---|---|
| $n_{10}$ | 1.7068337 | 1.7019545 |
| $k_{10}$ | 0.0738736 | 0.0615388 |
| $d_{10}$ (nm) | 221.446 | 218.498 |
| $n_{20}$ | 1.6845656 | 1.6606500 |
| $k_{20}$ | 0.2425094 | 0.1970435 |
| $d_{20}$ (nm) | 159.621 | 220.941 |

| | | 6-16 | 6-17 |
|---|---|---|---|
| When $n_1 \geq n_{10}$, | $n_{1m}=$ | 0.0603540 | 0.0631677 |
| When $n_1 < n_{10}$, | $n_{1m}=$ | 0.0209692 | 0.0568018 |
| When $k_1 \geq k_{10}$, | $k_{1m}=$ | 0.0545837 | 0.0777637 |
| When $k_1 < k_{10}$, | $k_{1m}=$ | 0.0216589 | 0.0384106 |
| When $d_1 \geq d_{10}$, | $d_{1m}$ (nm) $=$ | ∞ | ∞ |
| When $d_1 < d_{10}$, | $d_{1m}$ (nm) $=$ | 7.750 | 78.234 |
| When $n_2 \geq n_{20}$, | $n_{2m}=$ | 0.3057288 | 0.2826660 |
| When $n_2 < n_{20}$, | $n_{2m}=$ | 0.1553943 | 0.1472412 |
| When $k_2 \geq k_{20}$, | $k_{2m}=$ | 0.1625220 | 0.1326501 |
| When $k_2 < k_{20}$, | $k_{2m}=$ | 0.0624280 | 0.0731104 |
| When $d_2 \geq d_{20}$, | $d_{2m}$ (nm) $=$ | ∞ | ∞ |
| When $d_2 < d_{20}$, | $d_{2m}$ (nm) $=$ | 26.805 | 48.201 |

$0.93 \leq NA \leq 1.0$

$65 < T \leq 75$

| Case | 7-01 | 7-02 | 7-03 | 7-04 | 7-05 |
|---|---|---|---|---|---|
| $n_{10}$ | 1.7659038 | 1.8645399 | 1.8986420 | 1.9431410 | 1.8260230 |
| $k_{10}$ | 0.3040912 | 0.1945245 | 0.1330684 | 0.1068639 | 0.1610409 |
| $d_{10}$ (nm) | 29.683 | 22.504 | 17.099 | 11.420 | 82.141 |
| $n_{20}$ | 1.6951746 | 1.8232494 | 1.7981378 | 1.7406778 | 1.8123655 |
| $k_{20}$ | 1.0159152 | 0.5745287 | 0.4053118 | 0.3159076 | 0.8416018 |
| $d_{20}$ (nm) | 32.660 | 88.735 | 150.314 | 217.432 | 29.750 |

| | | 7-01 | 7-02 | 7-03 | 7-04 | 7-05 |
|---|---|---|---|---|---|---|
| When $n_1 \geq n_{10}$, | $n_{1m} =$ | 0.0851306 | 0.0913562 | 0.1021387 | 0.1343896 | 0.0697156 |
| When $n_1 < n_{10}$, | $n_{1m} =$ | 0.0579541 | 0.0649255 | 0.0759912 | 0.1029980 | 0.0329614 |
| When $k_1 \geq k_{10}$, | $k_{1m} =$ | 0.0588293 | 0.0796277 | 0.0923560 | 0.1221460 | 0.0674365 |
| When $k_1 < k_{10}$, | $k_{1m} =$ | 0.0718896 | 0.0854541 | 0.0996875 | 0.1068639 | 0.0435559 |
| When $d_1 \geq d_{10}$, | $d_{1m}$ (nm) $=$ | 5.966 | 7.118 | 7.275 | 6.222 | 7.298 |
| When $d_1 < d_{10}$, | $d_{1m}$ (nm) $=$ | 4.222 | 4.395 | 4.641 | 4.200 | 3.443 |
| When $n_2 \geq n_{20}$, | $n_{2m} =$ | 0.2227673 | 0.1853540 | 0.1622253 | 0.1538269 | 0.2762463 |
| When $n_2 < n_{20}$, | $n_{2m} =$ | 0.2074731 | 0.2178162 | 0.1908838 | 0.1813525 | 0.2757544 |
| When $k_2 \geq k_{20}$, | $k_{2m} =$ | 0.3106860 | 0.2340100 | 0.1838708 | 0.1497839 | 0.2030774 |
| When $k_2 < k_{20}$, | $k_{2m} =$ | 0.2037939 | 0.1485229 | 0.1235767 | 0.1116138 | 0.1923645 |
| When $d_2 \geq d_{20}$, | $d_{2m}$ (nm) $=$ | ∞ | ∞ | ∞ | ∞ | 12.449 |
| When $d_2 < d_{20}$, | $d_{2m}$ (nm) $=$ | 7.750 | 24.931 | 70.207 | 113.565 | 5.408 |

$0.93 \leq NA \leq 1.0$

$65 < T \leq 75$

| Case | 7-06 | 7-07 | 7-08 | 7-09 | 7-10 |
|---|---|---|---|---|---|
| $n_{10}$ | 1.7771488 | 1.7544343 | 1.7270080 | 1.7474077 | 1.7344421 |
| $k_{10}$ | 0.1183021 | 0.1010010 | 0.0859818 | 0.1187907 | 0.0986199 |
| $d_{10}$ (nm) | 86.874 | 88.257 | 88.900 | 148.872 | 153.031 |
| $n_{20}$ | 1.8193233 | 1.7618403 | 1.6808707 | 1.6925268 | 1.7617910 |
| $k_{20}$ | 0.4301648 | 0.3008540 | 0.2360835 | 0.6251022 | 0.3597954 |
| $d_{20}$ (nm) | 86.325 | 147.888 | 214.142 | 34.244 | 89.143 |

| | | 7-06 | 7-07 | 7-08 | 7-09 | 7-10 |
|---|---|---|---|---|---|---|
| When $n_1 \geq n_{10}$, | $n_{1m} =$ | 0.0673694 | 0.0664294 | 0.0644080 | 0.0590649 | 0.0632410 |
| When $n_1 < n_{10}$, | $n_{1m} =$ | 0.0307617 | 0.0294727 | 0.0379211 | 0.0149548 | 0.0133545 |
| When $k_1 \geq k_{10}$, | $k_{1m} =$ | 0.0672144 | 0.0623938 | 0.0685620 | 0.0548840 | 0.0510083 |
| When $k_1 < k_{10}$, | $k_{1m} =$ | 0.0467444 | 0.0514600 | 0.0549805 | 0.0255261 | 0.0262878 |
| When $d_1 \geq d_{10}$, | $d_{1m}$ (nm) $=$ | 10.761 | 15.121 | 22.543 | 10.466 | 24.985 |
| When $d_1 < d_{10}$, | $d_{1m}$ (nm) $=$ | 4.433 | 5.189 | 9.219 | 2.761 | 2.901 |
| When $n_2 \geq n_{20}$, | $n_{2m} =$ | 0.2196216 | 0.2049475 | 0.2147473 | 0.2786914 | 0.2464575 |
| When $n_2 < n_{20}$, | $n_{2m} =$ | 0.1907739 | 0.1643323 | 0.1459814 | 0.1244519 | 0.1858276 |
| When $k_2 \geq k_{20}$, | $k_{2m} =$ | 0.1969482 | 0.2144763 | 0.1668457 | 0.1106995 | 0.1237866 |
| When $k_2 < k_{20}$, | $k_{2m} =$ | 0.1161511 | 0.0943396 | 0.0836194 | 0.1556311 | 0.1032104 |
| When $d_2 \geq d_{20}$, | $d_{2m}$ (nm) $=$ | ∞ | ∞ | ∞ | 9.505 | ∞ |
| When $d_2 < d_{20}$, | $d_{2m}$ (nm) $=$ | 10.265 | 27.730 | 76.727 | 3.667 | 4.914 |

$0.93 \leq NA \leq 1.0$
$65 < T \leq 75$

| Case | 7-11 | 7-12 | 7-13 | 7-14 | 7-15 |
|---|---|---|---|---|---|
| $n_{10}$ | 1.7082851 | 1.7212227 | 1.7256274 | 1.7180408 | 1.7074443 |
| $k_{10}$ | 0.0693971 | 0.0845898 | 0.1038247 | 0.0895343 | 0.0742263 |
| $d_{10}$ (nm) | 154.668 | 155.411 | 212.824 | 218.202 | 221.707 |
| $n_{20}$ | 1.6632564 | 1.7183974 | 1.6530934 | 1.7315716 | 1.6896767 |
| $k_{20}$ | 0.2120421 | 0.2642962 | 0.5317369 | 0.3280557 | 0.2496384 |
| $d_{20}$ (nm) | 213.175 | 149.129 | 36.133 | 89.506 | 148.627 |

| | | 7-11 | 7-12 | 7-13 | 7-14 | 7-15 |
|---|---|---|---|---|---|---|
| When $n_1 \geq n_{10}$, | $n_{1m}=$ | 0.0593945 | 0.0606384 | 0.0541980 | 0.0647742 | 0.0609387 |
| When $n_1 < n_{10}$, | $n_{1m}=$ | 0.0413879 | 0.0149182 | 0.0029968 | 0.0021960 | 0.0208508 |
| When $k_1 \geq k_{10}$, | $k_{1m}=$ | 0.0699487 | 0.0507495 | 0.0335364 | 0.0342871 | 0.0542102 |
| When $k_1 < k_{10}$, | $k_{1m}=$ | 0.0433142 | 0.0298535 | 0.0082080 | 0.0055542 | 0.0221802 |
| When $d_1 \geq d_{10}$, | $d_{1m}$ (nm) $=$ | $\infty$ | 32.689 | 15.980 | 48.365 | $\infty$ |
| When $d_1 < d_{10}$, | $d_{1m}$ (nm) $=$ | 16.649 | 3.913 | 0.723 | 0.594 | 7.641 |
| When $n_2 \geq n_{20}$, | $n_{2m}=$ | 0.2553577 | 0.2564221 | 0.2715186 | 0.1988367 | 0.3137769 |
| When $n_2 < n_{20}$, | $n_{2m}=$ | 0.1341199 | 0.1522119 | 0.0214917 | 0.0208643 | 0.1570667 |
| When $k_2 \geq k_{20}$, | $k_{2m}=$ | 0.1361841 | 0.1775061 | 0.0327844 | 0.0526038 | 0.1632751 |
| When $k_2 < k_{20}$, | $k_{2m}=$ | 0.0749841 | 0.0809204 | 0.1462024 | 0.0801404 | 0.0667383 |
| When $d_2 \geq d_{20}$, | $d_{2m}$ (nm) $=$ | $\infty$ | $\infty$ | 9.604 | $\infty$ | $\infty$ |
| When $d_2 < d_{20}$, | $d_{2m}$ (nm) $=$ | 57.367 | 24.447 | 0.813 | 0.826 | 24.310 |

$0.93 \leq NA \leq 1.0$
$65 < T \leq 75$

| Case | 7-16 |
|---|---|
| $n_{10}$ | 1.7023147 |
| $k_{10}$ | 0.0619030 |
| $d_{10}$ (nm) | 218.598 |
| $n_{20}$ | 1.6620389 |
| $k_{20}$ | 0.2005572 |
| $d_{20}$ (nm) | 210.752 |

| | | 7-16 |
|---|---|---|
| When $n_1 \geq n_{10}$, | $n_{1m}=$ | 0.0637036 |
| When $n_1 < n_{10}$, | $n_{1m}=$ | 0.0577161 |
| When $k_1 \geq k_{10}$, | $k_{1m}=$ | 0.0772327 |
| When $k_1 < k_{10}$, | $k_{1m}=$ | 0.0389124 |
| When $d_1 \geq d_{10}$, | $d_{1m}$ (nm) $=$ | $\infty$ |
| When $d_1 < d_{10}$, | $d_{1m}$ (nm) $=$ | 78.427 |
| When $n_2 \geq n_{20}$, | $n_{2m}=$ | 0.2845728 |
| When $n_2 < n_{20}$, | $n_{2m}=$ | 0.1478259 |
| When $k_2 \geq k_{20}$, | $k_{2m}=$ | 0.1321912 |
| When $k_2 < k_{20}$, | $k_{2m}=$ | 0.0745581 |
| When $d_2 \geq d_{20}$, | $d_{2m}$ (nm) $=$ | $\infty$ |
| When $d_2 < d_{20}$, | $d_{2m}$ (nm) $=$ | 48.632 |

$0.93 \leq NA \leq 1.0$
$75 < T \leq 85$

| Case | 8-01 | 8-02 | 8-03 | 8-04 | 8-05 |
|---|---|---|---|---|---|
| $n_{10}$ | 1.7563588 | 1.8511230 | 1.8843188 | 1.9287462 | 1.8353218 |
| $k_{10}$ | 0.3324096 | 0.2092311 | 0.1443736 | 0.1105115 | 0.1759033 |
| $d_{10}$ (nm) | 35.374 | 25.991 | 18.736 | 12.655 | 87.389 |
| $n_{20}$ | 1.9274523 | 1.9063465 | 1.8018968 | 1.7494498 | 2.1171648 |
| $k_{20}$ | 1.4642575 | 0.6506745 | 0.4300566 | 0.3311673 | 1.3140425 |
| $d_{20}$ (nm) | 17.251 | 73.686 | 139.851 | 205.772 | 13.979 |

| | | 8-01 | 8-02 | 8-03 | 8-04 | 8-05 |
|---|---|---|---|---|---|---|
| When $n_1 \geq n_{10}$, | $n_{1m} =$ | 0.0785156 | 0.0867322 | 0.0972815 | 0.1243994 | 0.0679163 |
| When $n_1 < n_{10}$, | $n_{1m} =$ | 0.0545728 | 0.0619702 | 0.0719873 | 0.0956885 | 0.0326843 |
| When $k_1 \geq k_{10}$, | $k_{1m} =$ | 0.0474365 | 0.0710938 | 0.0861206 | 0.1128003 | 0.0573657 |
| When $k_1 < k_{10}$, | $k_{1m} =$ | 0.0515906 | 0.0859790 | 0.0958850 | 0.1105115 | 0.0462488 |
| When $d_1 \geq d_{10}$, | $d_{1m}$ (nm) $=$ | 5.195 | 7.048 | 7.475 | 6.554 | 6.786 |
| When $d_1 < d_{10}$, | $d_{1m}$ (nm) $=$ | 4.054 | 4.401 | 4.771 | 4.433 | 3.439 |
| When $n_2 \geq n_{20}$, | $n_{2m} =$ | 0.3717346 | 0.2089124 | 0.1658667 | 0.1550732 | 0.3935315 |
| When $n_2 < n_{20}$, | $n_{2m} =$ | 0.2566504 | 0.2226855 | 0.1899609 | 0.1803442 | 0.3930750 |
| When $k_2 \geq k_{20}$, | $k_{2m} =$ | 0.3327271 | 0.2900549 | 0.1962512 | 0.1555261 | 0.4058423 |
| When $k_2 < k_{20}$, | $k_{2m} =$ | 0.2814465 | 0.1644043 | 0.1285254 | 0.1140686 | 0.2980408 |
| When $d_2 \geq d_{20}$, | $d_{2m}$ (nm) $=$ | 7.242 | ∞ | ∞ | ∞ | 4.246 |
| When $d_2 < d_{20}$, | $d_{2m}$ (nm) $=$ | 5.453 | 18.064 | 63.635 | 86.244 | 4.110 |

$0.93 \leq NA \leq 1.0$
$75 < T \leq 85$

| Case | 8-06 | 8-07 | 8-08 | 8-09 | 8-10 |
|---|---|---|---|---|---|
| $n_{10}$ | 1.7950810 | 1.7627960 | 1.7313791 | 1.7608801 | 1.7394221 |
| $k_{10}$ | 0.1221034 | 0.1022278 | 0.0877850 | 0.1266208 | 0.0996664 |
| $d_{10}$ (nm) | 88.670 | 88.862 | 88.999 | 153.509 | 155.305 |
| $n_{20}$ | 1.9787137 | 1.8048095 | 1.6945552 | 1.9275665 | 1.8479873 |
| $k_{20}$ | 0.5126318 | 0.3274205 | 0.2478313 | 0.9887124 | 0.4176577 |
| $d_{20}$ (nm) | 67.257 | 133.479 | 202.902 | 15.987 | 72.839 |

| | | 8-06 | 8-07 | 8-08 | 8-09 | 8-10 |
|---|---|---|---|---|---|---|
| When $n_1 \geq n_{10}$, | $n_{1m} =$ | 0.0661450 | 0.0654504 | 0.0644836 | 0.0595581 | 0.0618579 |
| When $n_1 < n_{10}$, | $n_{1m} =$ | 0.0313049 | 0.0305920 | 0.0369946 | 0.0131787 | 0.0145801 |
| When $k_1 \geq k_{10}$, | $k_{1m} =$ | 0.0629285 | 0.0615845 | 0.0676172 | 0.0466980 | 0.0504663 |
| When $k_1 < k_{10}$, | $k_{1m} =$ | 0.0495715 | 0.0531104 | 0.0563220 | 0.0260303 | 0.0287866 |
| When $d_1 \geq d_{10}$, | $d_{1m}$ (nm) $=$ | 9.764 | 13.747 | 21.746 | 9.118 | 15.633 |
| When $d_1 < d_{10}$, | $d_{1m}$ (nm) $=$ | 4.261 | 5.184 | 8.521 | 2.425 | 3.180 |
| When $n_2 \geq n_{20}$, | $n_{2m} =$ | 0.1949426 | 0.2017102 | 0.2072998 | 0.3193018 | 0.1671875 |
| When $n_2 < n_{20}$, | $n_{2m} =$ | 0.1905188 | 0.1606116 | 0.1458716 | 0.3499829 | 0.1826196 |
| When $k_2 \geq k_{20}$, | $k_{2m} =$ | 0.2324365 | 0.2397180 | 0.1749133 | 0.1658679 | 0.1587329 |
| When $k_2 < k_{20}$, | $k_{2m} =$ | 0.1375964 | 0.1005615 | 0.0861584 | 0.2502869 | 0.1212964 |
| When $d_2 \geq d_{20}$, | $d_{2m}$ (nm) $=$ | 11.495 | ∞ | ∞ | 4.383 | 10.247 |
| When $d_2 < d_{20}$, | $d_{2m}$ (nm) $=$ | 10.836 | 22.009 | 72.908 | 4.573 | 5.928 |

$0.93 \leq NA \leq 1.0$

$75 < T \leq 85$

| Case | 8-11 | 8-12 | 8-13 | 8-14 | 8-15 |
|---|---|---|---|---|---|
| $n_{10}$ | 1.7245671 | 1.7098549 | 1.7314445 | 1.7204815 | 1.7093097 |
| $k_{10}$ | 0.0857616 | 0.0711157 | 0.1087664 | 0.0894136 | 0.0755678 |
| $d_{10}$ (nm) | 155.774 | 154.844 | 218.242 | 220.453 | 221.580 |
| $n_{20}$ | 1.7414131 | 1.6689951 | 1.7862714 | 1.7885409 | 1.7021793 |
| $k_{20}$ | 0.2835597 | 0.2212317 | 0.7962122 | 0.3769446 | 0.2655853 |
| $d_{20}$ (nm) | 136.971 | 203.148 | 18.394 | 74.763 | 137.968 |

| | | 8-11 | 8-12 | 8-13 | 8-14 | 8-15 |
|---|---|---|---|---|---|---|
| When $n_1 \geq n_{10}$, | $n_{1m} =$ | 0.0606116 | 0.0594177 | 0.0511572 | 0.0630383 | 0.0616895 |
| When $n_1 < n_{10}$, | $n_{1m} =$ | 0.0160718 | 0.0405298 | 0.0015906 | 0.0046008 | 0.0190027 |
| When $k_1 \geq k_{10}$, | $k_{1m} =$ | 0.0512000 | 0.0681555 | 0.0265222 | 0.0380334 | 0.0531970 |
| When $k_1 < k_{10}$, | $k_{1m} =$ | 0.0318042 | 0.0441748 | 0.0055811 | 0.0106726 | 0.0222839 |
| When $d_1 \geq d_{10}$, | $d_{1m}$ (nm) $=$ | 31.466 | ∞ | 12.528 | 43.958 | ∞ |
| When $d_1 < d_{10}$, | $d_{1m}$ (nm) $=$ | 4.121 | 15.106 | 0.395 | 1.266 | 6.425 |
| When $n_2 \geq n_{20}$, | $n_{2m} =$ | 0.2472620 | 0.2537585 | 0.2927209 | 0.1651587 | 0.3131763 |
| When $n_2 < n_{20}$, | $n_{2m} =$ | 0.1515137 | 0.1338916 | 0.0324463 | 0.1927209 | 0.1573535 |
| When $k_2 \geq k_{20}$, | $k_{2m} =$ | 0.1857507 | 0.1391650 | 0.0225110 | 0.0800281 | 0.1575110 |
| When $k_2 < k_{20}$, | $k_{2m} =$ | 0.0929626 | 0.0771277 | 0.2211072 | 0.1242517 | 0.0780078 |
| When $d_2 \geq d_{20}$, | $d_{2m}$ (nm) $=$ | ∞ | ∞ | 5.339 | 11.602 | ∞ |
| When $d_2 < d_{20}$, | $d_{2m}$ (nm) $=$ | 20.462 | 30.027 | 0.679 | 1.920 | 20.783 |

$0.93 \leq NA \leq 1.0$

$75 < T \leq 85$

| Case | 8-16 |
|---|---|
| $n_{10}$ | 1.7029357 |
| $k_{10}$ | 0.0634027 |
| $d_{10}$ (nm) | 218.717 |
| $n_{20}$ | 1.6626290 |
| $k_{20}$ | 0.2083407 |
| $d_{20}$ (nm) | 201.624 |

| | | 8-16 |
|---|---|---|
| When $n_1 \geq n_{10}$, | $n_{1m} =$ | 0.0636414 |
| When $n_1 < n_{10}$, | $n_{1m} =$ | 0.0583008 |
| When $k_1 \geq k_{10}$, | $k_{1m} =$ | 0.0748706 |
| When $k_1 < k_{10}$, | $k_{1m} =$ | 0.0393835 |
| When $d_1 \geq d_{10}$, | $d_{1m}$ (nm) $=$ | ∞ |
| When $d_1 < d_{10}$, | $d_{1m}$ (nm) $=$ | 77.927 |
| When $n_2 \geq n_{20}$, | $n_{2m} =$ | 0.2855005 |
| When $n_2 < n_{20}$, | $n_{2m} =$ | 0.1457190 |
| When $k_2 \geq k_{20}$, | $k_{2m} =$ | 0.1308728 |
| When $k_2 < k_{20}$, | $k_{2m} =$ | 0.0761951 |
| When $d_2 \geq d_{20}$, | $d_{2m}$ (nm) $=$ | ∞ |
| When $d_2 < d_{20}$, | $d_{2m}$ (nm) $=$ | 30.691 |

0. 9 3 ≤ N A ≤ 1. 0
8 5 < T ≤ 9 5

| Case | 9-01 | 9-02 | 9-03 | 9-04 | 9-05 |
|---|---|---|---|---|---|
| $n_{10}$ | 1.7289685 | 1.8452520 | 1.8988873 | 1.8877112 | 1.9267904 |
| $k_{10}$ | 0.3314086 | 0.2255929 | 0.1475831 | 0.1535471 | 0.0947520 |
| $d_{10}$ (nm) | 44.247 | 26.855 | 20.944 | 19.669 | 15.612 |
| $n_{20}$ | 5.1412592 | 1.9037614 | 1.8997324 | 1.8220692 | 1.8437835 |
| $k_{20}$ | 5.4454539 | 0.7221490 | 0.4893775 | 0.4687151 | 0.3693724 |
| $d_{20}$ (nm) | 1.484 | 66.898 | 122.094 | 129.650 | 183.529 |

| | | 9-01 | 9-02 | 9-03 | 9-04 | 9-05 |
|---|---|---|---|---|---|---|
| When $n_1 \geq n_{10}$, | $n_{1m} =$ | 0.0720642 | 0.0846375 | 0.0908557 | 0.0941199 | 0.1057788 |
| When $n_1 < n_{10}$, | $n_{1m} =$ | 0.0586633 | 0.0599194 | 0.0695422 | 0.0700256 | 0.0833301 |
| When $k_1 \geq k_{10}$, | $k_{1m} =$ | 0.0476758 | 0.0671912 | 0.0784241 | 0.0821533 | 0.0936853 |
| When $k_1 < k_{10}$, | $k_{1m} =$ | 0.0453955 | 0.0846301 | 0.0932227 | 0.0950391 | 0.0947520 |
| When $d_1 \geq d_{10}$, | $d_{1m}$ (nm) $=$ | 4.793 | 6.632 | 6.977 | 7.158 | 6.784 |
| When $d_1 < d_{10}$, | $d_{1m}$ (nm) $=$ | 4.550 | 4.181 | 4.538 | 4.591 | 4.595 |
| When $n_2 \geq n_{20}$, | $n_{2m} =$ | 1.1337476 | 0.2089880 | 0.1771472 | 0.1681067 | 0.1597327 |
| When $n_2 < n_{20}$, | $n_{2m} =$ | 1.1352368 | 0.2210583 | 0.1914734 | 0.1898022 | 0.1792920 |
| When $k_2 \geq k_{20}$, | $k_{2m} =$ | 0.8630298 | 0.2922070 | 0.2387195 | 0.2089600 | 0.1845532 |
| When $k_2 < k_{20}$, | $k_{2m} =$ | 1.0641260 | 0.1706519 | 0.1365454 | 0.1328516 | 0.1184924 |
| When $d_2 \geq d_{20}$, | $d_{2m}$ (nm) $=$ | 0.527 | ∞ | ∞ | ∞ | ∞ |
| When $d_2 < d_{20}$, | $d_{2m}$ (nm) $=$ | 0.379 | 14.827 | 35.595 | 55.475 | 73.593 |

0. 9 3 ≤ N A ≤ 1. 0
8 5 < T ≤ 9 5

| Case | 9-06 | 9-07 | 9-08 | 9-09 | 9-10 |
|---|---|---|---|---|---|
| $n_{10}$ | 1.9311024 | 1.9377300 | 1.8321358 | 1.8340055 | 1.7711711 |
| $k_{10}$ | 0.1132645 | 0.0882760 | 0.1783607 | 0.1409526 | 0.1059247 |
| $d_{10}$ (nm) | 13.318 | 11.094 | 92.959 | 90.549 | 89.053 |
| $n_{20}$ | 1.7624681 | 1.7478213 | 3.8484718 | 2.7003837 | 1.8505388 |
| $k_{20}$ | 0.3523973 | 0.2927773 | 3.7040697 | 0.6754163 | 0.3612112 |
| $d_{20}$ (nm) | 195.472 | 252.908 | 2.442 | 40.010 | 121.432 |

| | | 9-06 | 9-07 | 9-08 | 9-09 | 9-10 |
|---|---|---|---|---|---|---|
| When $n_1 \geq n_{10}$, | $n_{1m} =$ | 0.1192212 | 0.1370740 | 0.0646143 | 0.0640906 | 0.0642236 |
| When $n_1 < n_{10}$, | $n_{1m} =$ | 0.0917322 | 0.1105750 | 0.0342749 | 0.0314893 | 0.0302832 |
| When $k_1 \geq k_{10}$, | $k_{1m} =$ | 0.1074902 | 0.1261145 | 0.0537451 | 0.0578040 | 0.0599036 |
| When $k_1 < k_{10}$, | $k_{1m} =$ | 0.1132645 | 0.0882760 | 0.0424707 | 0.0518921 | 0.0535962 |
| When $d_1 \geq d_{10}$, | $d_{1m}$ (nm) $=$ | 6.457 | 6.373 | 6.914 | 7.622 | 12.267 |
| When $d_1 < d_{10}$, | $d_{1m}$ (nm) $=$ | 4.357 | 4.610 | 3.684 | 3.553 | 4.848 |
| When $n_2 \geq n_{20}$, | $n_{2m} =$ | 0.1546643 | 0.1575439 | 0.8768713 | 0.1918994 | 0.1964832 |
| When $n_2 < n_{20}$, | $n_{2m} =$ | 0.1796094 | 0.1753381 | 0.8006409 | 0.2240674 | 0.1600745 |
| When $k_2 \geq k_{20}$, | $k_{2m} =$ | 0.1600171 | 0.1481116 | 0.9241052 | 0.2582642 | 0.2396375 |
| When $k_2 < k_{20}$, | $k_{2m} =$ | 0.1162842 | 0.1079150 | 0.8229163 | 0.1769763 | 0.1063232 |
| When $d_2 \geq d_{20}$, | $d_{2m}$ (nm) $=$ | ∞ | ∞ | 0.854 | 4.088 | ∞ |
| When $d_2 < d_{20}$, | $d_{2m}$ (nm) $=$ | 79.416 | 123.401 | 0.636 | 4.130 | 18.235 |

0. 93 ≦ N A ≦ 1. 0
8 5 < T ≦ 9 5

| Case | 9-11 | 9-12 | 9-13 | 9-14 | 9-15 |
|---|---|---|---|---|---|
| $n_{10}$ | 1.7360863 | 1.7197908 | 1.7660895 | 1.7439719 | 1.7279356 |
| $k_{10}$ | 0.0911204 | 0.0799131 | 0.1278221 | 0.1032091 | 0.0888807 |
| $d_{10}$ (nm) | 88.900 | 88.028 | 159.319 | 156.425 | 155.640 |
| $n_{20}$ | 1.7067614 | 1.6618119 | 4.3535883 | 1.9650733 | 1.7635448 |
| $k_{20}$ | 0.2637604 | 0.2120965 | 4.0919379 | 0.4980866 | 0.3088945 |
| $d_{20}$ (nm) | 192.941 | 257.777 | 1.526 | 59.654 | 126.749 |

| | | 9-11 | 9-12 | 9-13 | 9-14 | 9-15 |
|---|---|---|---|---|---|---|
| When $n_1 \geq n_{10}$, | $n_{1m}=$ | 0.0638330 | 0.0656592 | 0.0584094 | 0.0605725 | 0.0597937 |
| When $n_1 < n_{10}$, | $n_{1m}=$ | 0.0350525 | 0.0511377 | 0.0141675 | 0.0144019 | 0.0151697 |
| When $k_1 \geq k_{10}$, | $k_{1m}=$ | 0.0655725 | 0.0796582 | 0.0444238 | 0.0479309 | 0.0488806 |
| When $k_1 < k_{10}$, | $k_{1m}=$ | 0.0571082 | 0.0562439 | 0.0291333 | 0.0298792 | 0.0316455 |
| When $d_1 \geq d_{10}$, | $d_{1m}$ (nm) = | 20.203 | 29.484 | 8.864 | 13.240 | 29.427 |
| When $d_1 < d_{10}$, | $d_{1m}$ (nm) = | 7.546 | 13.995 | 2.626 | 3.070 | 3.728 |
| When $n_2 \geq n_{20}$, | $n_{2m}=$ | 0.2021118 | 0.1991125 | 0.8787561 | 0.1681836 | 0.2119507 |
| When $n_2 < n_{20}$, | $n_{2m}=$ | 0.1462866 | 0.1442920 | 0.9231299 | 0.1869897 | 0.1520459 |
| When $k_2 \geq k_{20}$, | $k_{2m}=$ | 0.1808130 | 0.1431189 | 0.6934375 | 0.1601843 | 0.1789355 |
| When $k_2 < k_{20}$, | $k_{2m}=$ | 0.0887085 | 0.0763562 | 1.0372803 | 0.1399158 | 0.0974194 |
| When $d_2 \geq d_{20}$, | $d_{2m}$ (nm) = | ∞ | ∞ | 0.372 | 7.404 | ∞ |
| When $d_2 < d_{20}$, | $d_{2m}$ (nm) = | 33.573 | 81.452 | 0.412 | 5.841 | 17.631 |

0. 93 ≦ N A ≦ 1. 0
8 5 < T ≦ 9 5

| Case | 9-16 | 9-17 | 9-18 | 9-19 | 9-20 |
|---|---|---|---|---|---|
| $n_{10}$ | 1.7114085 | 1.7070625 | 1.7347333 | 1.7230132 | 1.7111302 |
| $k_{10}$ | 0.0740744 | 0.0641745 | 0.1100034 | 0.0920219 | 0.0786417 |
| $d_{10}$ (nm) | 154.740 | 153.245 | 225.621 | 220.898 | 221.002 |
| $n_{20}$ | 1.6716288 | 1.6634512 | 4.2666617 | 1.8597675 | 1.7127614 |
| $k_{20}$ | 0.2338686 | 0.1921909 | 4.0109081 | 0.4430799 | 0.2870105 |
| $d_{20}$ (nm) | 194.347 | 254.410 | 1.346 | 63.229 | 128.848 |

| | | 9-16 | 9-17 | 9-18 | 9-19 | 9-20 |
|---|---|---|---|---|---|---|
| When $n_1 \geq n_{10}$, | $n_{1m}=$ | 0.0584460 | 0.0617004 | 0.0476050 | 0.0625842 | 0.0612109 |
| When $n_1 < n_{10}$, | $n_{1m}=$ | 0.0344641 | 0.0580713 | 0.0023816 | 0.0042908 | 0.0142651 |
| When $k_1 \geq k_{10}$, | $k_{1m}=$ | 0.0648608 | 0.0822974 | 0.0260010 | 0.0346094 | 0.0487000 |
| When $k_1 < k_{10}$, | $k_{1m}=$ | 0.0443103 | 0.0454309 | 0.0085535 | 0.0110950 | 0.0198962 |
| When $d_1 \geq d_{10}$, | $d_{1m}$ (nm) = | ∞ | ∞ | 11.896 | 40.249 | ∞ |
| When $d_1 < d_{10}$, | $d_{1m}$ (nm) = | 12.619 | 28.388 | 0.607 | 1.162 | 4.464 |
| When $n_2 \geq n_{20}$, | $n_{2m}=$ | 0.2496582 | 0.2459351 | 0.6243091 | 0.1726245 | 0.1878369 |
| When $n_2 < n_{20}$, | $n_{2m}=$ | 0.1333875 | 0.1351294 | 0.9687061 | 0.0992944 | 0.1569519 |
| When $k_2 \geq k_{20}$, | $k_{2m}=$ | 0.1378833 | 0.1234607 | 0.1299146 | 0.0597583 | 0.1385217 |
| When $k_2 < k_{20}$, | $k_{2m}=$ | 0.0791492 | 0.0682422 | 1.1651697 | 0.1405090 | 0.0853906 |
| When $d_2 \geq d_{20}$, | $d_{2m}$ (nm) = | ∞ | ∞ | 0.085 | 8.765 | ∞ |
| When $d_2 < d_{20}$, | $d_{2m}$ (nm) = | 27.415 | 76.157 | 0.398 | 1.778 | 18.221 |

$$0.93 \leq NA \leq 1.0$$
$$85 < T \leq 95$$

| Case | 9-21 | 9-22 | 9-23 |
|---|---|---|---|
| $n_{10}$ | 1.7035342 | 1.7027484 | 1.7001226 |
| $k_{10}$ | 0.0659797 | 0.0572097 | 0.0542621 |
| $d_{10}$ (nm) | 218.617 | 216.627 | 277.695 |
| $n_{20}$ | 1.6615801 | 1.6695991 | 1.6762439 |
| $k_{20}$ | 0.2195726 | 0.1821496 | 0.1770375 |
| $d_{20}$ (nm) | 193.289 | 251.116 | 248.521 |

| | | 9-21 | 9-22 | 9-23 |
|---|---|---|---|---|
| When $n_1 \geq n_{10}$, | $n_{1m} =$ | 0.0623376 | 0.0678125 | 0.0799658 |
| When $n_1 < n_{10}$, | $n_{1m} =$ | 0.0535010 | 0.0686682 | 0.1014282 |
| When $k_1 \geq k_{10}$, | $k_{1m} =$ | 0.0710327 | 0.0861914 | 0.0881311 |
| When $k_1 < k_{10}$, | $k_{1m} =$ | 0.0393738 | 0.0410693 | 0.0390344 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 76.543 | 86.880 | 145.024 |
| When $n_2 \geq n_{20}$, | $n_{2m} =$ | 0.2919910 | 0.2682678 | 0.2949561 |
| When $n_2 < n_{20}$, | $n_{2m} =$ | 0.1427539 | 0.1485803 | 0.2037488 |
| When $k_2 \geq k_{20}$, | $k_{2m} =$ | 0.1267480 | 0.1253760 | 0.1874854 |
| When $k_2 < k_{20}$, | $k_{2m} =$ | 0.0781458 | 0.0670801 | 0.0719922 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 27.736 | 75.187 | 78.004 |

$0.93 \leq NA \leq 1.0$

$95 < T \leq 105$

| Case | 10-01 | 10-02 | 10-03 | 10-04 | 10-05 |
|---|---|---|---|---|---|
| $n_{10}$ | 1.8593145 | 1.9010800 | 1.9204218 | 1.9438629 | 1.8201241 |
| $k_{10}$ | 0.2496127 | 0.1636004 | 0.1149718 | 0.1088618 | 0.1437532 |
| $d_{10}$ (nm) | 26.535 | 19.815 | 15.218 | 10.610 | 89.353 |
| $n_{20}$ | 1.9155767 | 1.8411706 | 1.7975616 | 1.7190727 | 2.3681639 |
| $k_{20}$ | 0.8329906 | 0.5121692 | 0.3794158 | 0.2999844 | 0.7410526 |
| $d_{20}$ (nm) | 59.684 | 120.535 | 182.059 | 250.015 | 43.212 |

| | | 10-01 | 10-02 | 10-03 | 10-04 | 10-05 |
|---|---|---|---|---|---|---|
| When $n_1 \geq n_{10}$, | $n_{1m} =$ | 0.0816284 | 0.0922021 | 0.1074707 | 0.1413159 | 0.0582056 |
| When $n_1 < n_{10}$, | $n_{1m} =$ | 0.0571204 | 0.0681042 | 0.0820581 | 0.1125684 | 0.0261719 |
| When $k_1 \geq k_{10}$, | $k_{1m} =$ | 0.0635767 | 0.0796045 | 0.0956897 | 0.1313098 | 0.0522705 |
| When $k_1 < k_{10}$, | $k_{1m} =$ | 0.0810986 | 0.0930249 | 0.1101465 | 0.1088618 | 0.0503638 |
| When $d_1 \geq d_{10}$, | $d_{1m}$ (nm) $=$ | 5.728 | 6.581 | 6.674 | 6.005 | 7.527 |
| When $d_1 < d_{10}$, | $d_{1m}$ (nm) $=$ | 3.587 | 4.159 | 4.431 | 4.306 | 3.047 |
| When $n_2 \geq n_{20}$, | $n_{2m} =$ | 0.2110999 | 0.1699976 | 0.1589343 | 0.1579346 | 0.2155920 |
| When $n_2 < n_{20}$, | $n_{2m} =$ | 0.2273865 | 0.1928259 | 0.1800378 | 0.1714307 | 0.2110571 |
| When $k_2 \geq k_{20}$, | $k_{2m} =$ | 0.3068860 | 0.2171289 | 0.1741077 | 0.1426062 | 0.2751843 |
| When $k_2 < k_{20}$, | $k_{2m} =$ | 0.1756396 | 0.1352295 | 0.1186548 | 0.1082129 | 0.1794531 |
| When $d_2 \geq d_{20}$, | $d_{2m}$ (nm) $=$ | ∞ | ∞ | ∞ | ∞ | 5.764 |
| When $d_2 < d_{20}$, | $d_{2m}$ (nm) $=$ | 12.732 | 34.057 | 73.872 | 121.675 | 5.150 |

0．93 ≦ N A ≦ 1．0
95 < T ≦ 105

| Case | 10-06 | 10-07 | 10-08 | 10-09 | 10-10 |
|---|---|---|---|---|---|
| $n_{10}$ | 1.7719135 | 1.7372876 | 1.7204595 | 1.7445424 | 1.7286821 |
| $k_{10}$ | 0.1119845 | 0.0953951 | 0.0830085 | 0.1106490 | 0.0936244 |
| $d_{10}$ (nm) | 88.526 | 88.555 | 87.798 | 155.347 | 154.936 |
| $n_{20}$ | 1.8420973 | 1.7021944 | 1.6574450 | 1.9643384 | 1.7602486 |
| $k_{20}$ | 0.3885265 | 0.2779787 | 0.2209480 | 0.5665503 | 0.3317476 |
| $d_{20}$ (nm) | 115.256 | 185.353 | 249.744 | 53.939 | 119.649 |

| | | 10-06 | 10-07 | 10-08 | 10-09 | 10-10 |
|---|---|---|---|---|---|---|
| When $n_1 \geq n_{10}$, | $n_{1m} =$ | 0.0621143 | 0.0621887 | 0.0641711 | 0.0553430 | 0.0576575 |
| When $n_1 < n_{10}$, | $n_{1m} =$ | 0.0270313 | 0.0323645 | 0.0489441 | 0.0092163 | 0.0110840 |
| When $k_1 \geq k_{10}$, | $k_{1m} =$ | 0.0562158 | 0.0627490 | 0.0779517 | 0.0376074 | 0.0417603 |
| When $k_1 < k_{10}$, | $k_{1m} =$ | 0.0520581 | 0.0564075 | 0.0555945 | 0.0251758 | 0.0276855 |
| When $d_1 \geq d_{10}$, | $d_{1m}$ (nm) $=$ | 11.132 | 18.518 | 24.475 | 10.852 | 25.311 |
| When $d_1 < d_{10}$, | $d_{1m}$ (nm) $=$ | 4.165 | 6.637 | 12.657 | 1.885 | 2.611 |
| When $n_2 \geq n_{20}$, | $n_{2m} =$ | 0.1959729 | 0.2028772 | 0.1967151 | 0.1949902 | 0.2380078 |
| When $n_2 < n_{20}$, | $n_{2m} =$ | 0.1629126 | 0.1469397 | 0.1441541 | 0.1889697 | 0.1549414 |
| When $k_2 \geq k_{20}$, | $k_{2m} =$ | 0.2347974 | 0.1750098 | 0.1399744 | 0.1001758 | 0.1456445 |
| When $k_2 < k_{20}$, | $k_{2m} =$ | 0.1074329 | 0.0897974 | 0.0774023 | 0.1436816 | 0.0981848 |
| When $d_2 \geq d_{20}$, | $d_{2m}$ (nm) $=$ | ∞ | ∞ | ∞ | 7.077 | ∞ |
| When $d_2 < d_{20}$, | $d_{2m}$ (nm) $=$ | 17.579 | 32.188 | 79.555 | 4.014 | 9.652 |

0．93 ≦ N A ≦ 1．0
95 < T ≦ 105

| Case | 10-11 | 10-12 | 10-13 | 10-14 | 10-15 |
|---|---|---|---|---|---|
| $n_{10}$ | 1.7117780 | 1.7072616 | 1.7114074 | 1.7035514 | 1.7027912 |
| $k_{10}$ | 0.0773392 | 0.0664543 | 0.0830146 | 0.0688006 | 0.0591414 |
| $d_{10}$ (nm) | 154.355 | 152.987 | 220.011 | 218.183 | 216.340 |
| $n_{20}$ | 1.6664488 | 1.6597858 | 1.7075466 | 1.6565327 | 1.6669294 |
| $k_{20}$ | 0.2460450 | 0.2000883 | 0.3068810 | 0.2307053 | 0.1896158 |
| $d_{20}$ (nm) | 186.501 | 246.239 | 121.613 | 185.316 | 242.803 |

| | | 10-11 | 10-12 | 10-13 | 10-14 | 10-15 |
|---|---|---|---|---|---|---|
| When $n_1 \geq n_{10}$, | $n_{1m} =$ | 0.0563684 | 0.0596582 | 0.0593091 | 0.0598755 | 0.0652673 |
| When $n_1 < n_{10}$, | $n_{1m} =$ | 0.0298474 | 0.0556995 | 0.0074023 | 0.0481897 | 0.0654077 |
| When $k_1 \geq k_{10}$, | $k_{1m} =$ | 0.0607349 | 0.0799170 | 0.0390686 | 0.0670154 | 0.0838220 |
| When $k_1 < k_{10}$, | $k_{1m} =$ | 0.0430676 | 0.0448303 | 0.0134863 | 0.0384473 | 0.0405530 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 9.756 | 23.688 | 2.192 | 28.661 | 83.384 |
| When $n_2 \geq n_{20}$, | $n_{2m} =$ | 0.2552490 | 0.2502368 | 0.2301306 | 0.3057727 | 0.2764221 |
| When $n_2 < n_{20}$, | $n_{2m} =$ | 0.1325989 | 0.1345728 | 0.1592334 | 0.1419543 | 0.1480603 |
| When $k_2 \geq k_{20}$, | $k_{2m} =$ | 0.1285986 | 0.1190894 | 0.0974548 | 0.1182935 | 0.1218213 |
| When $k_2 < k_{20}$, | $k_{2m} =$ | 0.0799036 | 0.0691528 | 0.0735474 | 0.0793201 | 0.0682898 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 26.413 | 74.134 | 17.074 | 26.587 | 73.152 |

$0.93 \leq NA \leq 1.0$
$105 < T \leq 115$

| Case | 11-01 | 11-02 | 11-03 | 11-04 | 11-05 |
|---|---|---|---|---|---|
| $n_{10}$ | 1.8881577 | 1.9218914 | 1.9458883 | 1.9409291 | 1.7882093 |
| $k_{10}$ | 0.2795127 | 0.1797398 | 0.1322078 | 0.1179060 | 0.1515662 |
| $d_{10}$ (nm) | 22.871 | 17.442 | 13.080 | 10.849 | 85.800 |
| $n_{20}$ | 1.7550786 | 1.7746647 | 1.7478516 | 1.7108849 | 1.7933752 |
| $k_{20}$ | 0.8705815 | 0.5227186 | 0.3833699 | 0.3088835 | 0.6703287 |
| $d_{20}$ (nm) | 60.032 | 119.813 | 181.809 | 241.776 | 55.966 |

| | | 11-01 | 11-02 | 11-03 | 11-04 | 11-05 |
|---|---|---|---|---|---|---|
| When $n_1 \geq n_{10}$, | $n_{1m} =$ | 0.0826208 | 0.0977563 | 0.1186780 | 0.1376917 | 0.0543359 |
| When $n_1 < n_{10}$, | $n_{1m} =$ | 0.0520789 | 0.0682861 | 0.0872974 | 0.1088391 | 0.0162500 |
| When $k_1 \geq k_{10}$, | $k_{1m} =$ | 0.0630823 | 0.0841675 | 0.1052368 | 0.1278345 | 0.0453015 |
| When $k_1 < k_{10}$, | $k_{1m} =$ | 0.0771240 | 0.0966394 | 0.1209399 | 0.1179060 | 0.0399414 |
| When $d_1 \geq d_{10}$, | $d_{1m}$ (nm) $=$ | 4.844 | 5.864 | 5.837 | 5.925 | 7.044 |
| When $d_1 < d_{10}$, | $d_{1m}$ (nm) $=$ | 2.746 | 3.528 | 3.770 | 4.232 | 1.998 |
| When $n_2 \geq n_{20}$, | $n_{2m} =$ | 0.1779102 | 0.1610864 | 0.1553113 | 0.1599890 | 0.1976709 |
| When $n_2 < n_{20}$, | $n_{2m} =$ | 0.2409973 | 0.1978687 | 0.1825439 | 0.1715320 | 0.2140332 |
| When $k_2 \geq k_{20}$, | $k_{2m} =$ | 0.2513745 | 0.1848108 | 0.1557214 | 0.1414282 | 0.1190186 |
| When $k_2 < k_{20}$, | $k_{2m} =$ | 0.1529724 | 0.1289783 | 0.1162878 | 0.1089014 | 0.1251477 |
| When $d_2 \geq d_{20}$, | $d_{2m}$ (nm) $=$ | ∞ | ∞ | ∞ | ∞ | 22.520 |
| When $d_2 < d_{20}$, | $d_{2m}$ (nm) $=$ | 14.459 | 47.581 | 76.951 | 118.169 | 7.215 |

$0.93 \leq NA \leq 1.0$
$105 < T \leq 115$

| Case | 11-06 | 11-07 | 11-08 | 11-09 | 11-10 |
|---|---|---|---|---|---|
| $n_{10}$ | 1.7649059 | 1.7337710 | 1.7199633 | 1.7259527 | 1.7103936 |
| $k_{10}$ | 0.1193411 | 0.0996522 | 0.0855558 | 0.0989978 | 0.0800216 |
| $d_{10}$ (nm) | 87.339 | 88.039 | 87.477 | 153.714 | 153.726 |
| $n_{20}$ | 1.7745734 | 1.6760618 | 1.6497564 | 1.7204930 | 1.6497935 |
| $k_{20}$ | 0.3964773 | 0.2847568 | 0.2267213 | 0.3415865 | 0.2528816 |
| $d_{20}$ (nm) | 113.800 | 179.842 | 241.489 | 115.571 | 179.482 |

| | | 11-06 | 11-07 | 11-08 | 11-09 | 11-10 |
|---|---|---|---|---|---|---|
| When $n_1 \geq n_{10}$, | $n_{1m} =$ | 0.0601648 | 0.0599890 | 0.0628394 | 0.0551172 | 0.0538281 |
| When $n_1 < n_{10}$, | $n_{1m} =$ | 0.0211145 | 0.0296448 | 0.0487646 | 0.0042871 | 0.0282654 |
| When $k_1 \geq k_{10}$, | $k_{1m} =$ | 0.0504663 | 0.0599475 | 0.0772742 | 0.0278052 | 0.0572974 |
| When $k_1 < k_{10}$, | $k_{1m} =$ | 0.0475183 | 0.0544922 | 0.0541711 | 0.0166541 | 0.0416528 |
| When $d_1 \geq d_{10}$, | $d_{1m}$ (nm) $=$ | 10.266 | 16.506 | 22.112 | 22.094 | 29.214 |
| When $d_1 < d_{10}$, | $d_{1m}$ (nm) $=$ | 3.195 | 5.968 | 12.188 | 0.978 | 9.029 |
| When $n_2 \geq n_{20}$, | $n_{2m} =$ | 0.1995813 | 0.2097351 | 0.1798193 | 0.2563574 | 0.2736133 |
| When $n_2 < n_{20}$, | $n_{2m} =$ | 0.1736548 | 0.1494116 | 0.1464758 | 0.1632507 | 0.1337610 |
| When $k_2 \geq k_{20}$, | $k_{2m} =$ | 0.1791345 | 0.1568970 | 0.1341675 | 0.0805750 | 0.1130872 |
| When $k_2 < k_{20}$, | $k_{2m} =$ | 0.1012146 | 0.0889111 | 0.0780908 | 0.0849402 | 0.0789160 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 14.312 | 35.616 | 79.447 | 3.314 | 27.322 |

$0. 9 3 \leq N A \leq 1. 0$

$1 0 5 < T \leq 1 1 5$

| Case | 11-11 | 11-12 | 11-13 |
|---|---|---|---|
| $n_{10}$ | 1.7070930 | 1.7028018 | 1.7027432 |
| $k_{10}$ | 0.0681638 | 0.0710148 | 0.0605235 |
| $d_{10}$ (nm) | 152.585 | 217.506 | 215.929 |
| $n_{20}$ | 1.6551703 | 1.6456663 | 1.6646615 |
| $k_{20}$ | 0.2055639 | 0.2376270 | 0.1950188 |
| $d_{20}$ (nm) | 237.501 | 177.429 | 233.713 |

| | | 11-11 | 11-12 | 11-13 |
|---|---|---|---|---|
| When $n_1 \geq n_{10}$, | $n_{1m} =$ | 0.0578955 | 0.0572009 | 0.0625354 |
| When $n_1 < n_{10}$, | $n_{1m} =$ | 0.0537671 | 0.0422668 | 0.0608704 |
| When $k_1 \geq k_{10}$, | $k_{1m} =$ | 0.0790588 | 0.0645129 | 0.0827734 |
| When $k_1 < k_{10}$, | $k_{1m} =$ | 0.0435974 | 0.0363208 | 0.0394031 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 20.858 | 18.787 | 80.567 |
| When $n_2 \geq n_{20}$, | $n_{2m} =$ | 0.1279260 | 0.3212610 | 0.2872583 |
| When $n_2 < n_{20}$, | $n_{2m} =$ | 0.1371912 | 0.1436340 | 0.1515588 |
| When $k_2 \geq k_{20}$, | $k_{2m} =$ | 0.1138037 | 0.1091870 | 0.1188855 |
| When $k_2 < k_{20}$, | $k_{2m} =$ | 0.0699854 | 0.0793604 | 0.0696228 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 73.529 | 27.402 | 72.558 |

$0.93 \leq NA \leq 1.0$

$115 < T \leq 125$

| Case | 12-01 | 12-02 | 12-03 | 12-04 | 12-05 |
|---|---|---|---|---|---|
| $n_{10}$ | 1.8909431 | 1.9524263 | 1.9741784 | 1.9011191 | 1.7812655 |
| $k_{10}$ | 0.3085424 | 0.1909748 | 0.1389140 | 0.1449022 | 0.1647646 |
| $d_{10}$ (nm) | 20.418 | 15.444 | 11.832 | 11.795 | 82.868 |
| $n_{20}$ | 1.5964478 | 1.7414925 | 1.7353816 | 1.6673230 | 1.6154117 |
| $k_{20}$ | 0.8353138 | 0.5288169 | 0.3892797 | 0.3043383 | 0.6141968 |
| $d_{20}$ (nm) | 60.909 | 116.361 | 176.360 | 237.538 | 58.066 |

| | | 12-01 | 12-02 | 12-03 | 12-04 | 12-05 |
|---|---|---|---|---|---|---|
| When $n_1 \geq n_{10}$, | $n_{1m}=$ | 0.0896326 | 0.1058130 | 0.1273743 | 0.1294861 | 0.0526233 |
| When $n_1 < n_{10}$, | $n_{1m}=$ | 0.0482068 | 0.0693359 | 0.0898755 | 0.1018958 | 0.0089111 |
| When $k_1 \geq k_{10}$, | $k_{1m}=$ | 0.0687769 | 0.0897180 | 0.1101831 | 0.1230750 | 0.0397290 |
| When $k_1 < k_{10}$, | $k_{1m}=$ | 0.0788684 | 0.1029199 | 0.1292102 | 0.1244238 | 0.0264612 |
| When $d_1 \geq d_{10}$, | $d_{1m}$ (nm) $=$ | 4.348 | 5.029 | 5.176 | 6.485 | 6.077 |
| When $d_1 < d_{10}$, | $d_{1m}$ (nm) $=$ | 2.275 | 2.981 | 3.260 | 4.641 | 1.033 |
| When $n_2 \geq n_{20}$, | $n_{2m}=$ | 0.1653235 | 0.1570801 | 0.1545581 | 0.1637158 | 0.2122083 |
| When $n_2 < n_{20}$, | $n_{2m}=$ | 0.1924231 | 0.2075879 | 0.1868823 | 0.1636792 | 0.1151331 |
| When $k_2 \geq k_{20}$, | $k_{2m}=$ | 0.1706042 | 0.1628406 | 0.1476868 | 0.1368591 | 0.0534973 |
| When $k_2 < k_{20}$, | $k_{2m}=$ | 0.1411853 | 0.1262378 | 0.1172034 | 0.1087061 | 0.1078625 |
| When $d_2 \geq d_{20}$, | $d_{2m}$ (nm) $=$ | $\infty$ | $\infty$ | $\infty$ | $\infty$ | 22.263 |
| When $d_2 < d_{20}$, | $d_{2m}$ (nm) $=$ | 15.932 | 41.005 | 77.327 | 119.056 | 3.631 |

0. 9 3 ≤ N A ≤ 1. 0
1 1 5 < T ≤ 1 2 5

| Case | 12-06 | 12-07 | 12-08 | 12-09 | 12-10 |
|---|---|---|---|---|---|
| $n_{10}$ | 1.7599364 | 1.7294022 | 1.7193592 | 1.7088052 | 1.7070991 |
| $k_{10}$ | 0.1268761 | 0.1028924 | 0.0869972 | 0.0815889 | 0.0689994 |
| $d_{10}$ (nm) | 86.158 | 87.627 | 87.259 | 153.347 | 152.325 |
| $n_{20}$ | 1.7200975 | 1.6470339 | 1.6442041 | 1.6346844 | 1.6535493 |
| $k_{20}$ | 0.3928633 | 0.2862372 | 0.2301394 | 0.2563356 | 0.2091466 |
| $d_{20}$ (nm) | 111.244 | 173.600 | 231.990 | 171.193 | 227.454 |

| | | 12-06 | 12-07 | 12-08 | 12-09 | 12-10 |
|---|---|---|---|---|---|---|
| When $n_1 \geq n_{10}$, | $n_{1m} =$ | 0.0606738 | 0.0583850 | 0.0624988 | 0.0517444 | 0.0574902 |
| When $n_1 < n_{10}$, | $n_{1m} =$ | 0.0144922 | 0.0280668 | 0.0507288 | 0.0284387 | 0.0507019 |
| When $k_1 \geq k_{10}$, | $k_{1m} =$ | 0.0425989 | 0.0573376 | 0.0776721 | 0.0554700 | 0.0798230 |
| When $k_1 < k_{10}$, | $k_{1m} =$ | 0.0406250 | 0.0512256 | 0.0527991 | 0.0388428 | 0.0424304 |
| When $d_1 \geq d_{10}$, | $d_{1m}$ (nm) = | 9.315 | 15.226 | 20.570 | 23.760 | ∞ |
| When $d_1 < d_{10}$, | $d_{1m}$ (nm) = | 2.129 | 5.657 | 12.499 | 8.630 | 19.101 |
| When $n_2 \geq n_{20}$, | $n_{2m} =$ | 0.2113904 | 0.2168030 | 0.1303113 | 0.0779236 | 0.1123853 |
| When $n_2 < n_{20}$, | $n_{2m} =$ | 0.1965198 | 0.1502832 | 0.1490173 | 0.1347925 | 0.1407104 |
| When $k_2 \geq k_{20}$, | $k_{2m} =$ | 0.1312354 | 0.1404419 | 0.1299280 | 0.1034583 | 0.1115356 |
| When $k_2 < k_{20}$, | $k_{2m} =$ | 0.0975891 | 0.0892358 | 0.0798267 | 0.0797656 | 0.0721289 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 8.212 | 56.813 | 80.756 | 28.524 | 74.263 |

0. 9 3 ≤ N A ≤ 1. 0
1 1 5 < T ≤ 1 2 5

| Case | 12-11 | 12-12 |
|---|---|---|
| $n_{10}$ | 1.7021164 | 1.7030336 |
| $k_{10}$ | 0.0722203 | 0.0611451 |
| $d_{10}$ (nm) | 217.158 | 215.722 |
| $n_{20}$ | 1.6379690 | 1.6657846 |
| $k_{20}$ | 0.2419462 | 0.1987136 |
| $d_{20}$ (nm) | 168.107 | 223.276 |

| | | 12-11 | 12-12 |
|---|---|---|---|
| When $n_1 \geq n_{10}$, | $n_{1m} =$ | 0.0559460 | 0.0616492 |
| When $n_1 < n_{10}$, | $n_{1m} =$ | 0.0369629 | 0.0571216 |
| When $k_1 \geq k_{10}$, | $k_{1m} =$ | 0.0643591 | 0.0831226 |
| When $k_1 < k_{10}$, | $k_{1m} =$ | 0.0338867 | 0.0383716 |
| When $d_1 \geq d_{10}$, | $d_{1m}$ (nm) = | ∞ | ∞ |
| When $d_1 < d_{10}$, | $d_{1m}$ (nm) = | 15.623 | 78.766 |
| When $n_2 \geq n_{20}$, | $n_{2m} =$ | 0.1071765 | 0.1574146 |
| When $n_2 < n_{20}$, | $n_{2m} =$ | 0.1467676 | 0.1563452 |
| When $k_2 \geq k_{20}$, | $k_{2m} =$ | 0.1072412 | 0.1188721 |
| When $k_2 < k_{20}$, | $k_{2m} =$ | 0.0815015 | 0.0722400 |
| When $d_2 \geq d_{20}$, | $d_{2m}$ (nm) = | ∞ | ∞ |
| When $d_2 < d_{20}$, | $d_{2m}$ (nm) = | 28.758 | 73.194 |

0. 9 3 ≤ N A ≤ 1. 0
1 2 5 < T ≤ 1 3 5

| Case | 13-01 | 13-02 | 13-03 | 13-04 | 13-05 |
|---|---|---|---|---|---|
| $n_{10}$ | 1.8737564 | 1.9697383 | 1.9916260 | 1.9141720 | 1.7868889 |
| $k_{10}$ | 0.3367363 | 0.2020294 | 0.1477036 | 0.1461879 | 0.1795709 |
| $d_{10}$ (nm) | 20.276 | 14.764 | 11.315 | 11.459 | 80.605 |
| $n_{20}$ | 1.5133470 | 1.7299638 | 1.7257470 | 1.6683491 | 1.5409994 |
| $k_{20}$ | 0.8454522 | 0.5429087 | 0.3987910 | 0.3122132 | 0.6011754 |
| $d_{20}$ (nm) | 55.480 | 109.268 | 168.578 | 226.037 | 53.925 |

| | | 13-01 | 13-02 | 13-03 | 13-04 | 13-05 |
|---|---|---|---|---|---|---|
| When $n_1 \geq n_{10}$, | $n_{1m}=$ | 0.0919055 | 0.1108435 | 0.1324426 | 0.1321936 | 0.0477332 |
| When $n_1 < n_{10}$, | $n_{1m}=$ | 0.0465112 | 0.0677783 | 0.0890894 | 0.1050525 | 0.0054248 |
| When $k_1 \geq k_{10}$, | $k_{1m}=$ | 0.0634827 | 0.0913306 | 0.1103125 | 0.1242993 | 0.0376343 |
| When $k_1 < k_{10}$, | $k_{1m}=$ | 0.0777942 | 0.1046863 | 0.1330994 | 0.1263855 | 0.0172180 |
| When $d_1 \geq d_{10}$, | $d_{1m}$ (nm) = | 4.127 | 4.585 | 4.757 | 6.157 | 5.240 |
| When $d_1 < d_{10}$, | $d_{1m}$ (nm) = | 2.100 | 2.651 | 2.937 | 4.469 | 0.576 |
| When $n_2 \geq n_{20}$, | $n_{2m}=$ | 0.1485144 | 0.1609766 | 0.1572363 | 0.1614685 | 0.1647119 |
| When $n_2 < n_{20}$, | $n_{2m}=$ | 0.1669641 | 0.2206506 | 0.1915698 | 0.1618420 | 0.0427734 |
| When $k_2 \geq k_{20}$, | $k_{2m}=$ | 0.1498572 | 0.1556653 | 0.1444165 | 0.1361792 | 0.0323462 |
| When $k_2 < k_{20}$, | $k_{2m}=$ | 0.1523499 | 0.1322424 | 0.1219958 | 0.1118262 | 0.1188306 |
| When $d_2 \geq d_{20}$, | $d_{2m}$ (nm) = | ∞ | ∞ | ∞ | ∞ | 20.169 |
| When $d_2 < d_{20}$, | $d_{2m}$ (nm) = | 11.040 | 31.054 | 70.606 | 112.796 | 1.698 |

0. 9 3 ≤ N A ≤ 1. 0
1 2 5 < T ≤ 1 3 5

| Case | 13-06 | 13-07 | 13-08 | 13-09 | 13-10 |
|---|---|---|---|---|---|
| $n_{10}$ | 1.7600620 | 1.7276490 | 1.7199953 | 1.7084320 | 1.7077870 |
| $k_{10}$ | 0.1342170 | 0.1044918 | 0.0874837 | 0.0820944 | 0.0691595 |
| $d_{10}$ (nm) | 85.615 | 87.663 | 87.278 | 153.448 | 152.438 |
| $n_{20}$ | 1.6974715 | 1.6338870 | 1.6452183 | 1.6304269 | 1.6574806 |
| $k_{20}$ | 0.3980869 | 0.2915200 | 0.2346970 | 0.2625567 | 0.2137196 |
| $d_{20}$ (nm) | 104.529 | 164.129 | 221.092 | 160.685 | 216.250 |

| | | 13-06 | 13-07 | 13-08 | 13-09 | 13-10 |
|---|---|---|---|---|---|---|
| When $n_1 \geq n_{10}$, | $n_{1m}=$ | 0.0556421 | 0.0573047 | 0.0630432 | 0.0509070 | 0.0582422 |
| When $n_1 < n_{10}$, | $n_{1m}=$ | 0.0086938 | 0.0280566 | 0.0524658 | 0.0272729 | 0.0496997 |
| When $k_1 \geq k_{10}$, | $k_{1m}=$ | 0.0327625 | 0.0552051 | 0.0782056 | 0.0552515 | 0.0808813 |
| When $k_1 < k_{10}$, | $k_{1m}=$ | 0.0328357 | 0.0492957 | 0.0525903 | 0.0375085 | 0.0423645 |
| When $d_1 \geq d_{10}$, | $d_{1m}$ (nm) = | 8.316 | 14.598 | 20.258 | 22.646 | ∞ |
| When $d_1 < d_{10}$, | $d_{1m}$ (nm) = | 1.229 | 5.725 | 12.785 | 8.439 | 18.783 |
| When $n_2 \geq n_{20}$, | $n_{2m}=$ | 0.2312317 | 0.1156555 | 0.1151941 | 0.0670740 | 0.1089307 |
| When $n_2 < n_{20}$, | $n_{2m}=$ | 0.2128992 | 0.1481116 | 0.1498755 | 0.1344946 | 0.1425024 |
| When $k_2 \geq k_{20}$, | $k_{2m}=$ | 0.1020886 | 0.1348413 | 0.1299255 | 0.1027795 | 0.1131628 |
| When $k_2 < k_{20}$, | $k_{2m}=$ | 0.1027185 | 0.0927148 | 0.0827966 | 0.0840479 | 0.0754407 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 4.085 | 34.120 | 79.786 | 26.736 | 37.465 |

$0.93 \leq NA \leq 1.0$
$125 < T \leq 135$

| Case | 13-11 | 13-12 |
|---|---|---|
| $n_{10}$ | 1.7022055 | 1.7036940 |
| $k_{10}$ | 0.0725208 | 0.0612465 |
| $d_{10}$ (nm) | 217.368 | 215.927 |
| $n_{20}$ | 1.6389178 | 1.6705104 |
| $k_{20}$ | 0.2487144 | 0.2029113 |
| $d_{20}$ (nm) | 157.041 | 212.129 |

| | | 13-11 | 13-12 |
|---|---|---|---|
| When $n_1 \geq n_{10}$, | $n_{1m} =$ | 0.0559827 | 0.0624561 |
| When $n_1 < n_{10}$, | $n_{1m} =$ | 0.0346814 | 0.0563831 |
| When $k_1 \geq k_{10}$, | $k_{1m} =$ | 0.0655139 | 0.0838672 |
| When $k_1 < k_{10}$, | $k_{1m} =$ | 0.0329700 | 0.0384436 |
| When $d_1 \geq d_{10}$, | $d_{1m}$ (nm) $=$ | $\infty$ | $\infty$ |
| When $d_1 < d_{10}$, | $d_{1m}$ (nm) $=$ | 14.691 | 78.542 |
| When $n_2 \geq n_{20}$, | $n_{2m} =$ | 0.0987000 | 0.1459375 |
| When $n_2 < n_{20}$, | $n_{2m} =$ | 0.1477222 | 0.1585510 |
| When $k_2 \geq k_{20}$, | $k_{2m} =$ | 0.1107947 | 0.1206909 |
| When $k_2 < k_{20}$, | $k_{2m} =$ | 0.0868396 | 0.0754724 |
| When $d_2 \geq d_{20}$, | $d_{2m}$ (nm) $=$ | $\infty$ | $\infty$ |
| When $d_2 < d_{20}$, | $d_{2m}$ (nm) $=$ | 26.886 | 30.205 |

$0.93 \leq NA \leq 1.0$

$135 < T \leq 145$

| Case | 14-01 | 14-02 | 14-03 | 14-04 | 14-05 |
|---|---|---|---|---|---|
| $n_{10}$ | 1.8402862 | 1.9646387 | 1.9624104 | 1.9059084 | 1.8166660 |
| $k_{10}$ | 0.3700261 | 0.2123233 | 0.1584699 | 0.1473615 | 0.1977639 |
| $d_{10}$ (nm) | 23.403 | 16.447 | 12.893 | 12.089 | 79.798 |
| $n_{20}$ | 1.4966418 | 1.7618069 | 1.7211612 | 1.6694213 | 1.5572201 |
| $k_{20}$ | 1.0039549 | 0.5971846 | 0.4176484 | 0.3203376 | 0.7204992 |
| $d_{20}$ (nm) | 41.463 | 94.995 | 156.173 | 216.011 | 40.224 |

| | | 14-01 | 14-02 | 14-03 | 14-04 | 14-05 |
|---|---|---|---|---|---|---|
| When $n_1 \geq n_{10}$, | $n_{1m}=$ | 0.0906067 | 0.1022083 | 0.1191650 | 0.1272498 | 0.0481567 |
| When $n_1 < n_{10}$, | $n_{1m}=$ | 0.0460486 | 0.0622925 | 0.0801978 | 0.1004968 | 0.0053052 |
| When $k_1 \geq k_{10}$, | $k_{1m}=$ | 0.0548682 | 0.0821582 | 0.0987952 | 0.1188953 | 0.0360181 |
| When $k_1 < k_{10}$, | $k_{1m}=$ | 0.0585999 | 0.0953162 | 0.1207214 | 0.1220581 | 0.0169287 |
| When $d_1 \geq d_{10}$, | $d_{1m}$ (nm) $=$ | 4.196 | 4.611 | 5.209 | 6.343 | 4.539 |
| When $d_1 < d_{10}$, | $d_{1m}$ (nm) $=$ | 2.216 | 2.591 | 3.134 | 4.582 | 0.509 |
| When $n_2 \geq n_{20}$, | $n_{2m}=$ | 0.1766626 | 0.1806128 | 0.1668896 | 0.1603455 | 0.2142871 |
| When $n_2 < n_{20}$, | $n_{2m}=$ | 0.1712292 | 0.2330798 | 0.1905432 | 0.1645447 | 0.0564514 |
| When $k_2 \geq k_{20}$, | $k_{2m}=$ | 0.2110498 | 0.1844238 | 0.1540930 | 0.1380908 | 0.0433691 |
| When $k_2 < k_{20}$, | $k_{2m}=$ | 0.1916614 | 0.1446765 | 0.1279346 | 0.1140405 | 0.1534607 |
| When $d_2 \geq d_{20}$, | $d_{2m}$ (nm) $=$ | $\infty$ | $\infty$ | $\infty$ | $\infty$ | 18.289 |
| When $d_2 < d_{20}$, | $d_{2m}$ (nm) $=$ | 8.143 | 21.467 | 66.145 | 96.079 | 1.264 |

$0.93 \leq NA \leq 1.0$
$135 < T \leq 145$

| Case | 14-06 | 14-07 | 14-08 | 14-09 | 14-10 |
|---|---|---|---|---|---|
| $n_{10}$ | 1.7655719 | 1.7293285 | 1.7214396 | 1.7092770 | 1.7085071 |
| $k_{10}$ | 0.1384976 | 0.1055583 | 0.0882507 | 0.0826318 | 0.0697446 |
| $d_{10}$ (nm) | 86.596 | 87.952 | 87.451 | 153.805 | 152.663 |
| $n_{20}$ | 1.7129955 | 1.6364176 | 1.6482275 | 1.6322979 | 1.6592624 |
| $k_{20}$ | 0.4320226 | 0.3040668 | 0.2416232 | 0.2733763 | 0.2197085 |
| $d_{20}$ (nm) | 91.539 | 153.339 | 210.993 | 150.296 | 206.543 |

| | | 14-06 | 14-07 | 14-08 | 14-09 | 14-10 |
|---|---|---|---|---|---|---|
| When $n_1 \geq n_{10}$, | $n_{1m} =$ | 0.0570667 | 0.0566760 | 0.0630505 | 0.0509021 | 0.0584448 |
| When $n_1 < n_{10}$, | $n_{1m} =$ | 0.0070447 | 0.0278870 | 0.0524426 | 0.0272241 | 0.0508081 |
| When $k_1 \geq k_{10}$, | $k_{1m} =$ | 0.0284875 | 0.0544165 | 0.0773682 | 0.0546399 | 0.0801599 |
| When $k_1 < k_{10}$, | $k_{1m} =$ | 0.0304980 | 0.0499133 | 0.0532507 | 0.0383374 | 0.0431470 |
| When $d_1 \geq d_{10}$, | $d_{1m}$ (nm) $=$ | 7.855 | 14.249 | 20.142 | 22.873 | ∞ |
| When $d_1 < d_{10}$, | $d_{1m}$ (nm) $=$ | 0.972 | 5.625 | 12.498 | 8.268 | 18.904 |
| When $n_2 \geq n_{20}$, | $n_{2m} =$ | 0.2760107 | 0.1009705 | 0.1137622 | 0.0657813 | 0.1088953 |
| When $n_2 < n_{20}$, | $n_{2m} =$ | 0.1995349 | 0.1448511 | 0.1471863 | 0.1316589 | 0.1395239 |
| When $k_2 \geq k_{20}$, | $k_{2m} =$ | 0.1305078 | 0.1378174 | 0.1321667 | 0.1037769 | 0.1143506 |
| When $k_2 < k_{20}$, | $k_{2m} =$ | 0.1154834 | 0.0970654 | 0.0846460 | 0.0880420 | 0.0769495 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 3.137 | 27.699 | 76.164 | 22.775 | 33.816 |

$0.93 \leq NA \leq 1.0$
$135 < T \leq 145$

| Case | 14-11 | 14-12 |
|---|---|---|
| $n_{10}$ | 1.7027802 | 1.7041709 |
| $k_{10}$ | 0.0728517 | 0.0617202 |
| $d_{10}$ (nm) | 217.779 | 216.194 |
| $n_{20}$ | 1.6405373 | 1.6719897 |
| $k_{20}$ | 0.2588103 | 0.2085423 |
| $d_{20}$ (nm) | 146.936 | 202.593 |

| | | 14-11 | 14-12 |
|---|---|---|---|
| When $n_1 \geq n_{10}$, | $n_{1m} =$ | 0.0566504 | 0.0631152 |
| When $n_1 < n_{10}$, | $n_{1m} =$ | 0.0353162 | 0.0583606 |
| When $k_1 \geq k_{10}$, | $k_{1m} =$ | 0.0649280 | 0.0832544 |
| When $k_1 < k_{10}$, | $k_{1m} =$ | 0.0337988 | 0.0392310 |
| When $d_1 \geq d_{10}$, | $d_{1m}$ (nm) $=$ | ∞ | ∞ |
| When $d_1 < d_{10}$, | $d_{1m}$ (nm) $=$ | 15.495 | 79.231 |
| When $n_2 \geq n_{20}$, | $n_{2m} =$ | 0.0962402 | 0.1448450 |
| When $n_2 < n_{20}$, | $n_{2m} =$ | 0.1459131 | 0.1542615 |
| When $k_2 \geq k_{20}$, | $k_{2m} =$ | 0.1100769 | 0.1205054 |
| When $k_2 < k_{20}$, | $k_{2m} =$ | 0.0901184 | 0.0767920 |
| When $d_2 \geq d_{20}$, | $d_{2m}$ (nm) $=$ | ∞ | ∞ |
| When $d_2 < d_{20}$, | $d_{2m}$ (nm) $=$ | 22.790 | 28.928 |

$0. 9 3 \leq NA \leq 1. 0$

$1 4 5 < T \leq 1 5 5$

| Case | 15-01 | 15-02 | 15-03 | 15-04 | 15-05 |
|---|---|---|---|---|---|
| $n_{10}$ | 1.8199816 | 1.9318464 | 1.9476580 | 1.9400781 | 1.9152409 |
| $k_{10}$ | 0.4068444 | 0.2280177 | 0.1546474 | 0.1580344 | 0.1421080 |
| $d_{10}$ (nm) | 29.022 | 20.237 | 15.042 | 15.180 | 12.506 |
| $n_{20}$ | 1.5974175 | 1.8212470 | 1.7660961 | 1.7558824 | 1.6892699 |
| $k_{20}$ | 1.4701111 | 0.6871951 | 0.4559575 | 0.4525330 | 0.3391765 |
| $d_{20}$ (nm) | 24.558 | 79.181 | 140.877 | 141.749 | 204.998 |

| | | 15-01 | 15-02 | 15-03 | 15-04 | 15-05 |
|---|---|---|---|---|---|---|
| When $n_1 \geq n_{10}$, | $n_{1m} =$ | 0.0783313 | 0.0902905 | 0.1062402 | 0.1057410 | 0.1233240 |
| When $n_1 < n_{10}$, | $n_{1m} =$ | 0.0485986 | 0.0576099 | 0.0737439 | 0.0730676 | 0.0958533 |
| When $k_1 \geq k_{10}$, | $k_{1m} =$ | 0.0424463 | 0.0706348 | 0.0877539 | 0.0877856 | 0.1136047 |
| When $k_1 < k_{10}$, | $k_{1m} =$ | 0.0340247 | 0.0852002 | 0.1066162 | 0.1062646 | 0.1201245 |
| When $d_1 \geq d_{10}$, | $d_{1m}$ (nm) $=$ | 3.673 | 5.078 | 5.535 | 5.630 | 6.208 |
| When $d_1 < d_{10}$, | $d_{1m}$ (nm) $=$ | 2.651 | 2.819 | 3.357 | 3.413 | 4.390 |
| When $n_2 \geq n_{20}$, | $n_{2m} =$ | 0.2911646 | 0.2069556 | 0.1703650 | 0.1705981 | 0.1609875 |
| When $n_2 < n_{20}$, | $n_{2m} =$ | 0.1897607 | 0.2328674 | 0.1899780 | 0.1895239 | 0.1746619 |
| When $k_2 \geq k_{20}$, | $k_{2m} =$ | 0.2661255 | 0.2545776 | 0.1755676 | 0.1739502 | 0.1429504 |
| When $k_2 < k_{20}$, | $k_{2m} =$ | 0.2599438 | 0.1612646 | 0.1333740 | 0.1331494 | 0.1167700 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 5.427 | 21.100 | 63.576 | 64.042 | 84.536 |

$0. 9 3 \leq NA \leq 1. 0$

$1 4 5 < T \leq 1 5 5$

| Case | 15-06 | 15-07 | 15-08 | 15-09 | 15-10 |
|---|---|---|---|---|---|
| $n_{10}$ | 1.8773964 | 1.7792899 | 1.7347668 | 1.7234258 | 1.7112569 |
| $k_{10}$ | 0.2151408 | 0.1408151 | 0.1082989 | 0.0907869 | 0.0850611 |
| $d_{10}$ (nm) | 81.211 | 87.880 | 88.119 | 87.442 | 153.930 |
| $n_{20}$ | 1.7568637 | 1.7944868 | 1.6522930 | 1.6482492 | 1.6361524 |
| $k_{20}$ | 1.2210655 | 0.5090378 | 0.3260600 | 0.2516544 | 0.2898839 |
| $d_{20}$ (nm) | 20.666 | 75.457 | 142.664 | 202.556 | 141.116 |

| | | 15-06 | 15-07 | 15-08 | 15-09 | 15-10 |
|---|---|---|---|---|---|---|
| When $n_1 \geq n_{10}$, | $n_{1m} =$ | 0.0535974 | 0.0567944 | 0.0566736 | 0.0621204 | 0.0507385 |
| When $n_1 < n_{10}$, | $n_{1m} =$ | 0.0100415 | 0.0103674 | 0.0259888 | 0.0480981 | 0.0259363 |
| When $k_1 \geq k_{10}$, | $k_{1m} =$ | 0.0386597 | 0.0332520 | 0.0534692 | 0.0749170 | 0.0514124 |
| When $k_1 < k_{10}$, | $k_{1m} =$ | 0.0268323 | 0.0369287 | 0.0521716 | 0.0541968 | 0.0401160 |
| When $d_1 \geq d_{10}$, | $d_{1m}$ (nm) $=$ | 4.095 | 7.577 | 13.934 | 19.192 | 22.547 |
| When $d_1 < d_{10}$, | $d_{1m}$ (nm) $=$ | 0.855 | 1.369 | 4.946 | 11.117 | 7.637 |
| When $n_2 \geq n_{20}$, | $n_{2m} =$ | 0.4215723 | 0.2684375 | 0.1205920 | 0.1204028 | 0.0675806 |
| When $n_2 < n_{20}$, | $n_{2m} =$ | 0.3791321 | 0.1854980 | 0.1442749 | 0.1439111 | 0.1298389 |
| When $k_2 \geq k_{20}$, | $k_{2m} =$ | 0.1639099 | 0.2106580 | 0.1452100 | 0.1328479 | 0.0998340 |
| When $k_2 < k_{20}$, | $k_{2m} =$ | 0.2423328 | 0.1335254 | 0.1007751 | 0.0850952 | 0.0900806 |
| When $d_2 \geq d_{20}$, | $d_{2m}$ (nm) $=$ | 5.052 | 14.783 | ∞ | ∞ | ∞ |
| When $d_2 < d_{20}$, | $d_{2m}$ (nm) $=$ | 1.977 | 4.929 | 23.591 | 72.330 | 19.479 |

$0.93 \leq NA \leq 1.0$
$145 < T \leq 155$

| Case | 15-11 | 15-12 | 15-13 |
|---|---|---|---|
| $n_{10}$ | 1.7092054 | 1.7036310 | 1.7042855 |
| $k_{10}$ | 0.0717413 | 0.0749476 | 0.0635030 |
| $d_{10}$ (nm) | 152.725 | 217.788 | 216.233 |
| $n_{20}$ | 1.6572540 | 1.6384900 | 1.6687346 |
| $k_{20}$ | 0.2283199 | 0.2727185 | 0.2164860 |
| $d_{20}$ (nm) | 198.410 | 138.609 | 194.709 |

| | | 15-11 | 15-12 | 15-13 |
|---|---|---|---|---|
| When $n_1 \geq n_{10}$, | $n_{1m} =$ | 0.0574158 | 0.0563904 | 0.0624048 |
| When $n_1 < n_{10}$, | $n_{1m} =$ | 0.0505359 | 0.0361853 | 0.0601721 |
| When $k_1 \geq k_{10}$, | $k_{1m} =$ | 0.0766162 | 0.0604248 | 0.0800598 |
| When $k_1 < k_{10}$, | $k_{1m} =$ | 0.0439771 | 0.0350879 | 0.0400427 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 17.754 | 14.415 | 78.936 |
| When $n_2 \geq n_{20}$, | $n_{2m} =$ | 0.1103052 | 0.0951196 | 0.1487622 |
| When $n_2 < n_{20}$, | $n_{2m} =$ | 0.1349475 | 0.1401550 | 0.1481909 |
| When $k_2 \geq k_{20}$, | $k_{2m} =$ | 0.1121790 | 0.1001306 | 0.1166199 |
| When $k_2 < k_{20}$, | $k_{2m} =$ | 0.0769556 | 0.0916321 | 0.0768066 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 28.953 | 19.518 | 28.644 |

$0.93 \leq NA \leq 1.0$

$155 < T \leq 165$

| Case | 16-01 | 16-02 | 16-03 | 16-04 | 16-05 |
|---|---|---|---|---|---|
| $n_{10}$ | 1.8175791 | 1.9193642 | 1.9516445 | 1.9419697 | 1.9282358 |
| $k_{10}$ | 0.4385823 | 0.2501320 | 0.1607715 | 0.1648951 | 0.1504554 |
| $d_{10}$ (nm) | 37.187 | 21.908 | 15.944 | 16.094 | 12.282 |
| $n_{20}$ | 2.9488620 | 1.8321620 | 1.7911399 | 1.7764317 | 1.6857745 |
| $k_{20}$ | 3.6605721 | 0.7789298 | 0.4964603 | 0.4910919 | 0.3551730 |
| $d_{20}$ (nm) | 5.671 | 69.456 | 129.934 | 131.139 | 198.143 |

| | | 16-01 | 16-02 | 16-03 | 16-04 | 16-05 |
|---|---|---|---|---|---|---|
| When $n_1 \geq n_{10}$, | $n_{1m} =$ | 0.0604736 | 0.0852295 | 0.1013757 | 0.1010083 | 0.1240356 |
| When $n_1 < n_{10}$, | $n_{1m} =$ | 0.0333899 | 0.0547046 | 0.0713342 | 0.0704993 | 0.0944006 |
| When $k_1 \geq k_{10}$, | $k_{1m} =$ | 0.0318896 | 0.0632361 | 0.0833032 | 0.0834521 | 0.1140308 |
| When $k_1 < k_{10}$, | $k_{1m} =$ | 0.0127527 | 0.0803174 | 0.1011133 | 0.1007434 | 0.1227710 |
| When $d_1 \geq d_{10}$, | $d_{1m}$ (nm) $=$ | 2.684 | 4.937 | 5.403 | 5.524 | 5.825 |
| When $d_1 < d_{10}$, | $d_{1m}$ (nm) $=$ | 1.056 | 2.746 | 3.284 | 3.349 | 4.015 |
| When $n_2 \geq n_{20}$, | $n_{2m} =$ | 0.8885571 | 0.1992395 | 0.1663013 | 0.1663708 | 0.1592810 |
| When $n_2 < n_{20}$, | $n_{2m} =$ | 0.4338977 | 0.2305408 | 0.1904468 | 0.1899951 | 0.1750964 |
| When $k_2 \geq k_{20}$, | $k_{2m} =$ | 0.2239417 | 0.2871423 | 0.1858569 | 0.1831470 | 0.1419360 |
| When $k_2 < k_{20}$, | $k_{2m} =$ | 0.5593811 | 0.1675525 | 0.1346912 | 0.1341003 | 0.1171777 |
| When $d_2 \geq d_{20}$, | $d_{2m}$ (nm) $=$ | 2.121 | ∞ | ∞ | ∞ | ∞ |
| When $d_2 < d_{20}$, | $d_{2m}$ (nm) $=$ | 1.497 | 16.789 | 53.787 | 54.606 | 81.510 |

0. 9 3 ≤ N A ≤ 1. 0
1 5 5 < T ≤ 1 6 5

| Case | 16-06 | 16-07 | 16-08 | 16-09 | 16-10 |
|---|---|---|---|---|---|
| $n_{10}$ | 1.8704725 | 1.7960814 | 1.7418606 | 1.7257176 | 1.7136245 |
| $k_{10}$ | 0.2299368 | 0.1479091 | 0.1134159 | 0.0948039 | 0.0896483 |
| $d_{10}$ (nm) | 88.746 | 88.347 | 87.888 | 87.264 | 153.565 |
| $n_{20}$ | 2.8158519 | 1.9330235 | 1.6717189 | 1.6472351 | 1.6392609 |
| $k_{20}$ | 3.0739838 | 0.6225271 | 0.3550776 | 0.2650084 | 0.3111392 |
| $d_{20}$ (nm) | 4.992 | 60.492 | 132.384 | 194.269 | 132.434 |

| | | 16-06 | 16-07 | 16-08 | 16-09 | 16-10 |
|---|---|---|---|---|---|---|
| When $n_1 \geq n_{10}$, | $n_{1m}=$ | 0.0496790 | 0.0539771 | 0.0559290 | 0.0605103 | 0.0493213 |
| When $n_1 < n_{10}$, | $n_{1m}=$ | 0.0158618 | 0.0116589 | 0.0229565 | 0.0427002 | 0.0176343 |
| When $k_1 \geq k_{10}$, | $k_{1m}=$ | 0.0339600 | 0.0324597 | 0.0502661 | 0.0714246 | 0.0448999 |
| When $k_1 < k_{10}$, | $k_{1m}=$ | 0.0196045 | 0.0413477 | 0.0524426 | 0.0547058 | 0.0377209 |
| When $d_1 \geq d_{10}$, | $d_{1m}$ (nm) = | 4.203 | 6.741 | 12.890 | 17.512 | 20.755 |
| When $d_1 < d_{10}$, | $d_{1m}$ (nm) = | 1.412 | 1.425 | 4.045 | 9.285 | 4.775 |
| When $n_2 \geq n_{20}$, | $n_{2m}=$ | 0.7568213 | 0.2080432 | 0.1385022 | 0.1276587 | 0.0653149 |
| When $n_2 < n_{20}$, | $n_{2m}=$ | 0.6339124 | 0.1864246 | 0.1456726 | 0.1431897 | 0.1296729 |
| When $k_2 \geq k_{20}$, | $k_{2m}=$ | 0.5784314 | 0.2482080 | 0.1472144 | 0.1310840 | 0.0863611 |
| When $k_2 < k_{20}$, | $k_{2m}=$ | 0.6241199 | 0.1496924 | 0.1027478 | 0.0854395 | 0.0904016 |
| When $d_2 \geq d_{20}$, | $d_{2m}$ (nm) = | 1.695 | 9.818 | ∞ | ∞ | ∞ |
| When $d_2 < d_{20}$, | $d_{2m}$ (nm) = | 1.276 | 6.130 | 21.225 | 35.287 | 17.454 |

0. 9 3 ≤ N A ≤ 1. 0
1 5 5 < T ≤ 1 6 5

| Case | 16-11 | 16-12 | 16-13 | 16-14 |
|---|---|---|---|---|
| $n_{10}$ | 1.7097149 | 1.7044725 | 1.7041849 | 1.7061658 |
| $k_{10}$ | 0.0750113 | 0.0790614 | 0.0664191 | 0.0592006 |
| $d_{10}$ (nm) | 152.537 | 217.265 | 215.910 | 215.675 |
| $n_{20}$ | 1.6527377 | 1.6350180 | 1.6625759 | 1.6951633 |
| $k_{20}$ | 0.2392317 | 0.2903973 | 0.2261823 | 0.1893046 |
| $d_{20}$ (nm) | 190.639 | 130.687 | 187.261 | 240.772 |

| | | 16-11 | 16-12 | 16-13 | 16-14 |
|---|---|---|---|---|---|
| When $n_1 \geq n_{10}$, | $n_{1m}=$ | 0.0553772 | 0.0545740 | 0.0600366 | 0.0676270 |
| When $n_1 < n_{10}$, | $n_{1m}=$ | 0.0477368 | 0.0344788 | 0.0568494 | 0.0690149 |
| When $k_1 \geq k_{10}$, | $k_{1m}=$ | 0.0715491 | 0.0525977 | 0.0752148 | 0.0835681 |
| When $k_1 < k_{10}$, | $k_{1m}=$ | 0.0443665 | 0.0337817 | 0.0404053 | 0.0425281 |
| When $d_1 \geq d_{10}$, | $d_{1m}$ (nm) = | ∞ | ∞ | ∞ | ∞ |
| When $d_1 < d_{10}$, | $d_{1m}$ (nm) = | 16.235 | 12.121 | 77.039 | 86.324 |
| When $n_2 \geq n_{20}$, | $n_{2m}=$ | 0.1116882 | 0.0916113 | 0.1582788 | 0.1718628 |
| When $n_2 < n_{20}$, | $n_{2m}=$ | 0.1331189 | 0.1411133 | 0.1443433 | 0.1614490 |
| When $k_2 \geq k_{20}$, | $k_{2m}=$ | 0.1061816 | 0.0827698 | 0.1097974 | 0.1248706 |
| When $k_2 < k_{20}$, | $k_{2m}=$ | 0.0766345 | 0.0918372 | 0.0766272 | 0.0699548 |
| When $d_2 \geq d_{20}$, | $d_{2m}$ (nm) = | ∞ | ∞ | ∞ | ∞ |
| When $d_2 < d_{20}$, | $d_{2m}$ (nm) = | 27.428 | 17.505 | 27.098 | 73.085 |

$0.93 \le NA \le 1.0$
$165 < T \le 175$

| Case | 17-01 | 17-02 | 17-03 | 17-04 | 17-05 |
|---|---|---|---|---|---|
| $n_{10}$ | 1.9650460 | 1.9384951 | 1.9139584 | 1.7857662 | 1.7433983 |
| $k_{10}$ | 0.1748342 | 0.1550287 | 0.1299465 | 0.1574086 | 0.1202381 |
| $d_{10}$ (nm) | 15.368 | 12.323 | 11.343 | 86.539 | 87.036 |
| $n_{20}$ | 1.7719438 | 1.6895811 | 1.6883766 | 1.7907030 | 1.6559011 |
| $k_{20}$ | 0.5219218 | 0.3734128 | 0.3007198 | 0.6497694 | 0.3733381 |
| $d_{20}$ (nm) | 124.100 | 189.293 | 246.427 | 59.718 | 125.629 |

| | | 17-01 | 17-02 | 17-03 | 17-04 | 17-05 |
|---|---|---|---|---|---|---|
| When $n_1 \ge n_{10}$, | $n_{1m} =$ | 0.1023816 | 0.1220520 | 0.1341687 | 0.0495288 | 0.0535669 |
| When $n_1 < n_{10}$, | $n_{1m} =$ | 0.0697961 | 0.0912976 | 0.1083984 | 0.0051111 | 0.0188965 |
| When $k_1 \ge k_{10}$, | $k_{1m} =$ | 0.0830420 | 0.1112122 | 0.1288184 | 0.0186707 | 0.0452673 |
| When $k_1 < k_{10}$, | $k_{1m} =$ | 0.1016052 | 0.1222986 | 0.1299465 | 0.0330212 | 0.0491577 |
| When $d_1 \ge d_{10}$, | $d_{1m}$ (nm) $=$ | 5.001 | 5.526 | 6.413 | 5.954 | 11.233 |
| When $d_1 < d_{10}$, | $d_{1m}$ (nm) $=$ | 2.956 | 3.739 | 4.697 | 0.624 | 3.144 |
| When $n_2 \ge n_{20}$, | $n_{2m} =$ | 0.1581653 | 0.1572925 | 0.1540161 | 0.0858301 | 0.1199121 |
| When $n_2 < n_{20}$, | $n_{2m} =$ | 0.1927075 | 0.1754407 | 0.1685632 | 0.1889197 | 0.1519067 |
| When $k_2 \ge k_{20}$, | $k_{2m} =$ | 0.1753381 | 0.1419458 | 0.1368945 | 0.0730774 | 0.1241467 |
| When $k_2 < k_{20}$, | $k_{2m} =$ | 0.1306897 | 0.1171997 | 0.1067334 | 0.1258240 | 0.0983862 |
| When $d_2 \ge d_{20}$, | $d_{2m}$ (nm) $=$ | ∞ | ∞ | ∞ | ∞ | ∞ |
| When $d_2 < d_{20}$, | $d_{2m}$ (nm) $=$ | 51.895 | 79.651 | 119.351 | 3.741 | 21.467 |

$0.93 \le NA \le 1.0$
$165 < T \le 175$

| Case | 17-06 | 17-07 | 17-08 | 17-09 | 17-10 |
|---|---|---|---|---|---|
| $n_{10}$ | 1.7262549 | 1.7236673 | 1.7140199 | 1.7096017 | 1.7107217 |
| $k_{10}$ | 0.0993784 | 0.0842645 | 0.0949670 | 0.0783956 | 0.0680252 |
| $d_{10}$ (nm) | 86.812 | 87.109 | 152.601 | 152.026 | 152.100 |
| $n_{20}$ | 1.6373093 | 1.6685549 | 1.6238426 | 1.6437329 | 1.6799600 |
| $k_{20}$ | 0.2753256 | 0.2274459 | 0.3258368 | 0.2483227 | 0.2063397 |
| $d_{20}$ (nm) | 186.729 | 241.120 | 125.450 | 182.921 | 236.403 |

| | | 17-06 | 17-07 | 17-08 | 17-09 | 17-10 |
|---|---|---|---|---|---|---|
| When $n_1 \ge n_{10}$, | $n_{1m} =$ | 0.0583655 | 0.0638147 | 0.0459595 | 0.0526709 | 0.0601990 |
| When $n_1 < n_{10}$, | $n_{1m} =$ | 0.0389001 | 0.0503784 | 0.0111768 | 0.0448047 | 0.0600891 |
| When $k_1 \ge k_{10}$, | $k_{1m} =$ | 0.0685583 | 0.0805896 | 0.0359302 | 0.0672742 | 0.0800940 |
| When $k_1 < k_{10}$, | $k_{1m} =$ | 0.0538513 | 0.0560901 | 0.0310425 | 0.0434424 | 0.0457349 |
| When $d_1 \ge d_{10}$, | $d_{1m}$ (nm) $=$ | 15.725 | 22.939 | 17.229 | ∞ | ∞ |
| When $d_1 < d_{10}$, | $d_{1m}$ (nm) $=$ | 8.012 | 11.976 | 2.824 | 14.351 | 24.120 |
| When $n_2 \ge n_{20}$, | $n_{2m} =$ | 0.1242969 | 0.1275708 | 0.0486890 | 0.1084961 | 0.1263135 |
| When $n_2 < n_{20}$, | $n_{2m} =$ | 0.1456055 | 0.1521838 | 0.1337903 | 0.1356079 | 0.1464233 |
| When $k_2 \ge k_{20}$, | $k_{2m} =$ | 0.1234131 | 0.1338855 | 0.0591821 | 0.0969312 | 0.1151416 |
| When $k_2 < k_{20}$, | $k_{2m} =$ | 0.0846008 | 0.0776428 | 0.0858325 | 0.0756372 | 0.0703125 |
| When $d_2 \ge d_{20}$, | $d_{2m}$ (nm) $=$ | ∞ | ∞ | ∞ | ∞ | ∞ |
| When $d_2 < d_{20}$, | $d_{2m}$ (nm) $=$ | 66.105 | 78.842 | 17.102 | 28.470 | 72.561 |

$0.93 \leq NA \leq 1.0$

$165 < T \leq 175$

| Case | 17-11 | 17-12 | 17-13 |
|---|---|---|---|
| $n_{10}$ | 1.7042582 | 1.7037677 | 1.7056779 |
| $k_{10}$ | 0.0836625 | 0.0692974 | 0.0609868 |
| $d_{10}$ (nm) | 216.186 | 215.313 | 215.198 |
| $n_{20}$ | 1.6202806 | 1.6544674 | 1.6903958 |
| $k_{20}$ | 0.3033538 | 0.2346728 | 0.1952987 |
| $d_{20}$ (nm) | 123.599 | 179.446 | 232.683 |

| | | 17-11 | 17-12 | 17-13 |
|---|---|---|---|---|
| When $n_1 \geq n_{10}$, | $n_{1m} =$ | 0.0501758 | 0.0567249 | 0.0651611 |
| When $n_1 < n_{10}$, | $n_{1m} =$ | 0.0271130 | 0.0522852 | 0.0658081 |
| When $k_1 \geq k_{10}$, | $k_{1m} =$ | 0.0439600 | 0.0710352 | 0.0811584 |
| When $k_1 < k_{10}$, | $k_{1m} =$ | 0.0300366 | 0.0394434 | 0.0413635 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 9.341 | 23.552 | 82.870 |
| When $n_2 \geq n_{20}$, | $n_{2m} =$ | 0.0785254 | 0.1613647 | 0.1758447 |
| When $n_2 < n_{20}$, | $n_{2m} =$ | 0.1457166 | 0.1478357 | 0.1648547 |
| When $k_2 \geq k_{20}$, | $k_{2m} =$ | 0.0611975 | 0.1025415 | 0.1200317 |
| When $k_2 < k_{20}$, | $k_{2m} =$ | 0.0887231 | 0.0762732 | 0.0707166 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 17.421 | 28.206 | 71.908 |

$0.93 \leq NA \leq 1.0$

$175 < T \leq 185$

| Case | 18-01 | 18-02 | 18-03 | 18-04 | 18-05 |
|---|---|---|---|---|---|
| $n_{10}$ | 1.9750220 | 1.9943589 | 1.9365478 | 1.8874503 | 1.7406539 |
| $k_{10}$ | 0.3055970 | 0.1905841 | 0.1715491 | 0.1503402 | 0.1271964 |
| $d_{10}$ (nm) | 17.312 | 13.627 | 12.200 | 12.006 | 86.109 |
| $n_{20}$ | 1.6357631 | 1.7309349 | 1.6649916 | 1.6561886 | 1.6157675 |
| $k_{20}$ | 0.8207912 | 0.5263943 | 0.3790440 | 0.2991899 | 0.3771605 |
| $d_{20}$ (nm) | 66.973 | 122.033 | 183.216 | 242.151 | 120.682 |

| | | 18-01 | 18-02 | 18-03 | 18-04 | 18-05 |
|---|---|---|---|---|---|---|
| When $n_1 \geq n_{10}$, | $n_{1m} =$ | 0.0935791 | 0.1114148 | 0.1215747 | 0.1285913 | 0.0513330 |
| When $n_1 < n_{10}$, | $n_{1m} =$ | 0.0459473 | 0.0702148 | 0.0894250 | 0.1026367 | 0.0144434 |
| When $k_1 \geq k_{10}$, | $k_{1m} =$ | 0.0590857 | 0.0871582 | 0.1112146 | 0.1261365 | 0.0386914 |
| When $k_1 < k_{10}$, | $k_{1m} =$ | 0.0823853 | 0.1098083 | 0.1208740 | 0.1243677 | 0.0453528 |
| When $d_1 \geq d_{10}$, | $d_{1m}$ (nm) $=$ | 3.436 | 4.283 | 5.306 | 6.728 | 10.132 |
| When $d_1 < d_{10}$, | $d_{1m}$ (nm) $=$ | 1.707 | 2.491 | 3.559 | 4.870 | 2.323 |
| When $n_2 \geq n_{20}$, | $n_{2m} =$ | 0.1368286 | 0.1494128 | 0.1559277 | 0.1523608 | 0.0829712 |
| When $n_2 < n_{20}$, | $n_{2m} =$ | 0.2106677 | 0.1994727 | 0.1768091 | 0.1649011 | 0.1612537 |
| When $k_2 \geq k_{20}$, | $k_{2m} =$ | 0.1566431 | 0.1521973 | 0.1368372 | 0.1332068 | 0.0933081 |
| When $k_2 < k_{20}$, | $k_{2m} =$ | 0.1361353 | 0.1253687 | 0.1152344 | 0.1052795 | 0.0942554 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 18.814 | 47.829 | 81.274 | 118.000 | 24.527 |

$0.93 \leq NA \leq 1.0$
$175 < T \leq 185$

| Case | 18-06 | 18-07 | 18-08 | 18-09 | 18-10 |
|---|---|---|---|---|---|
| $n_{10}$ | 1.7253418 | 1.7237735 | 1.7126639 | 1.7091592 | 1.7108527 |
| $k_{10}$ | 0.1032843 | 0.0864157 | 0.0996282 | 0.0809109 | 0.0696108 |
| $d_{10}$ (nm) | 86.339 | 86.885 | 151.701 | 151.551 | 151.827 |
| $n_{20}$ | 1.6224018 | 1.6650124 | 1.5953952 | 1.6344497 | 1.6784072 |
| $k_{20}$ | 0.2809650 | 0.2327133 | 0.3310599 | 0.2545275 | 0.2111338 |
| $d_{20}$ (nm) | 178.956 | 231.784 | 118.977 | 174.271 | 226.839 |

| | | 18-06 | 18-07 | 18-08 | 18-09 | 18-10 |
|---|---|---|---|---|---|---|
| When $n_1 \geq n_{10}$, | $n_{1m} =$ | 0.0565039 | 0.0626416 | 0.0424548 | 0.0505127 | 0.0583557 |
| When $n_1 < n_{10}$, | $n_{1m} =$ | 0.0377893 | 0.0495728 | 0.0068591 | 0.0425964 | 0.0570093 |
| When $k_1 \geq k_{10}$, | $k_{1m} =$ | 0.0671277 | 0.0801477 | 0.0264331 | 0.0654321 | 0.0790332 |
| When $k_1 < k_{10}$, | $k_{1m} =$ | 0.0514600 | 0.0546265 | 0.0262610 | 0.0409290 | 0.0440662 |
| When $d_1 \geq d_{10}$, | $d_{1m}$ (nm) $=$ | 14.314 | 20.851 | 14.034 | 22.266 | $\infty$ |
| When $d_1 < d_{10}$, | $d_{1m}$ (nm) $=$ | 7.519 | 11.390 | 1.678 | 12.457 | 21.354 |
| When $n_2 \geq n_{20}$, | $n_{2m} =$ | 0.1133289 | 0.1230408 | 0.0286230 | 0.1046033 | 0.1258447 |
| When $n_2 < n_{20}$, | $n_{2m} =$ | 0.1506311 | 0.1572058 | 0.1416589 | 0.1413440 | 0.1529517 |
| When $k_2 \geq k_{20}$, | $k_{2m} =$ | 0.1148096 | 0.1304126 | 0.0346130 | 0.0907129 | 0.1118689 |
| When $k_2 < k_{20}$, | $k_{2m} =$ | 0.0848999 | 0.0792493 | 0.0817810 | 0.0764514 | 0.0721448 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 64.642 | 80.544 | 18.599 | 31.028 | 73.232 |

$0.93 \leq NA \leq 1.0$
$175 < T \leq 185$

| Case | 18-11 | 18-12 | 18-13 |
|---|---|---|---|
| $n_{10}$ | 1.7032995 | 1.7035257 | 1.7058486 |
| $k_{10}$ | 0.0874338 | 0.0712651 | 0.0623526 |
| $d_{10}$ (nm) | 215.388 | 214.888 | 214.924 |
| $n_{20}$ | 1.6000078 | 1.6490638 | 1.6902455 |
| $k_{20}$ | 0.3100603 | 0.2413259 | 0.1999123 |
| $d_{20}$ (nm) | 116.088 | 170.219 | 222.958 |

| | | 18-11 | 18-12 | 18-13 |
|---|---|---|---|---|
| When $n_1 \geq n_{10}$, | $n_{1m} =$ | 0.0459119 | 0.0540906 | 0.0637158 |
| When $n_1 < n_{10}$, | $n_{1m} =$ | 0.0201135 | 0.0472498 | 0.0624988 |
| When $k_1 \geq k_{10}$, | $k_{1m} =$ | 0.0380823 | 0.0692078 | 0.0795654 |
| When $k_1 < k_{10}$, | $k_{1m} =$ | 0.0261584 | 0.0371997 | 0.0400098 |
| When $d_1 \geq d_{10}$, | $d_{1m}$ (nm) $=$ | 25.691 | $\infty$ | $\infty$ |
| When $d_1 < d_{10}$, | $d_{1m}$ (nm) $=$ | 6.401 | 18.086 | 80.109 |
| When $n_2 \geq n_{20}$, | $n_{2m} =$ | 0.0666833 | 0.1564661 | 0.1701733 |
| When $n_2 < n_{20}$, | $n_{2m} =$ | 0.1555847 | 0.1549194 | 0.1734229 |
| When $k_2 \geq k_{20}$, | $k_{2m} =$ | 0.0497668 | 0.0999182 | 0.1182764 |
| When $k_2 < k_{20}$, | $k_{2m} =$ | 0.0866650 | 0.0781360 | 0.0731396 |
| When $d_2 \geq d_{20}$, | $d_{2m}$ (nm) $=$ | 13.606 | $\infty$ | $\infty$ |
| When $d_2 < d_{20}$, | $d_{2m}$ (nm) $=$ | 18.924 | 29.474 | 72.740 |

0. 9 3 ≤ N A ≤ 1. 0
1 8 5 < T ≤ 1 9 5

| Case | 19-01 | 19-02 | 19-03 | 19-04 | 19-05 |
|---|---|---|---|---|---|
| $n_{10}$ | 2.0157422 | 1.9298641 | 1.9158213 | 1.9035507 | 1.7387191 |
| $k_{10}$ | 0.3310994 | 0.1874025 | 0.1413868 | 0.0919796 | 0.1333266 |
| $d_{10}$ (nm) | 15.233 | 12.335 | 11.496 | 11.593 | 85.772 |
| $n_{20}$ | 1.5732193 | 1.6401635 | 1.6782430 | 1.7330388 | 1.5838112 |
| $k_{20}$ | 0.8191417 | 0.3856200 | 0.3150440 | 0.2716233 | 0.3839989 |
| $d_{20}$ (nm) | 66.313 | 174.874 | 226.685 | 274.138 | 113.170 |

| | | 19-01 | 19-02 | 19-03 | 19-04 | 19-05 |
|---|---|---|---|---|---|---|
| When $n_1 \geq n_{10}$, | $n_{1m} =$ | 0.0908862 | 0.1198010 | 0.1318933 | 0.1353418 | 0.0494861 |
| When $n_1 < n_{10}$, | $n_{1m} =$ | 0.0435144 | 0.0881482 | 0.1071143 | 0.1119397 | 0.0110315 |
| When $k_1 \geq k_{10}$, | $k_{1m} =$ | 0.0607654 | 0.1097412 | 0.1276587 | 0.1301843 | 0.0306482 |
| When $k_1 < k_{10}$, | $k_{1m} =$ | 0.0886279 | 0.1159265 | 0.1266907 | 0.0919796 | 0.0445325 |
| When $d_1 \geq d_{10}$, | $d_{1m}$ (nm) $=$ | 2.825 | 5.183 | 6.173 | 7.339 | 9.205 |
| When $d_1 < d_{10}$, | $d_{1m}$ (nm) $=$ | 1.353 | 3.517 | 4.556 | 5.508 | 1.748 |
| When $n_2 \geq n_{20}$, | $n_{2m} =$ | 0.1250940 | 0.1513354 | 0.1454334 | 0.1421106 | 0.0499280 |
| When $n_2 < n_{20}$, | $n_{2m} =$ | 0.1772742 | 0.1779919 | 0.1691821 | 0.1744556 | 0.1654175 |
| When $k_2 \geq k_{20}$, | $k_{2m} =$ | 0.1164954 | 0.1335864 | 0.1351135 | 0.1421582 | 0.0743848 |
| When $k_2 < k_{20}$, | $k_{2m} =$ | 0.1392041 | 0.1184119 | 0.1117639 | 0.1051697 | 0.0978845 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 17.571 | 78.501 | 112.763 | 138.595 | 25.987 |

0. 9 3 ≤ N A ≤ 1. 0
1 8 5 < T ≤ 1 9 5

| Case | 19-06 | 19-07 | 19-08 | 19-09 | 19-10 |
|---|---|---|---|---|---|
| $n_{10}$ | 1.7256246 | 1.7253546 | 1.7287042 | 1.7096582 | 1.7121643 |
| $k_{10}$ | 0.1055723 | 0.0874820 | 0.0760165 | 0.0821714 | 0.0705329 |
| $d_{10}$ (nm) | 86.279 | 86.928 | 87.515 | 151.624 | 152.001 |
| $n_{20}$ | 1.6177137 | 1.6696157 | 1.7081188 | 1.6358848 | 1.6853812 |
| $k_{20}$ | 0.2895611 | 0.2389730 | 0.2041866 | 0.2635969 | 0.2167566 |
| $d_{20}$ (nm) | 168.375 | 220.361 | 272.150 | 162.984 | 215.233 |

| | | 19-06 | 19-07 | 19-08 | 19-09 | 19-10 |
|---|---|---|---|---|---|---|
| When $n_1 \geq n_{10}$, | $n_{1m} =$ | 0.0562903 | 0.0628687 | 0.0679712 | 0.0505103 | 0.0586621 |
| When $n_1 < n_{10}$, | $n_{1m} =$ | 0.0396094 | 0.0498669 | 0.0509912 | 0.0389160 | 0.0543164 |
| When $k_1 \geq k_{10}$, | $k_{1m} =$ | 0.0670349 | 0.0806128 | 0.0832776 | 0.0662488 | 0.0789514 |
| When $k_1 < k_{10}$, | $k_{1m} =$ | 0.0491772 | 0.0538904 | 0.0576746 | 0.0390271 | 0.0434973 |
| When $d_1 \geq d_{10}$, | $d_{1m}$ (nm) $=$ | 13.425 | 20.169 | 39.294 | 20.568 | ∞ |
| When $d_1 < d_{10}$, | $d_{1m}$ (nm) $=$ | 7.774 | 11.144 | 12.836 | 11.141 | 20.056 |
| When $n_2 \geq n_{20}$, | $n_{2m} =$ | 0.1053076 | 0.1213562 | 0.1287134 | 0.1062195 | 0.1257849 |
| When $n_2 < n_{20}$, | $n_{2m} =$ | 0.1536951 | 0.1604126 | 0.1670996 | 0.1450281 | 0.1574817 |
| When $k_2 \geq k_{20}$, | $k_{2m} =$ | 0.1136377 | 0.1320007 | 0.1531152 | 0.0931067 | 0.1145862 |
| When $k_2 < k_{20}$, | $k_{2m} =$ | 0.0898669 | 0.0840454 | 0.0776611 | 0.0825256 | 0.0770361 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 45.429 | 80.918 | 110.597 | 30.017 | 74.310 |

$0.93 \leq NA \leq 1.0$

$185 < T \leq 195$

| Case | 19-11 | 19-12 | 19-13 | 19-14 | 19-15 |
|---|---|---|---|---|---|
| $n_{10}$ | 1.7151566 | 1.7029318 | 1.7041956 | 1.7070069 | 1.7080920 |
| $k_{10}$ | 0.0645755 | 0.0900998 | 0.0721897 | 0.0633145 | 0.0595697 |
| $d_{10}$ (nm) | 152.412 | 215.656 | 215.114 | 215.207 | 215.250 |
| $n_{20}$ | 1.7135234 | 1.5920483 | 1.6533659 | 1.6971996 | 1.7125257 |
| $k_{20}$ | 0.1842756 | 0.3226491 | 0.2502000 | 0.2048445 | 0.1741269 |
| $d_{20}$ (nm) | 268.692 | 105.543 | 158.704 | 211.558 | 267.229 |

| | | 19-11 | 19-12 | 19-13 | 19-14 | 19-15 |
|---|---|---|---|---|---|---|
| When $n_1 \geq n_{10}$, | $n_{1m} =$ | 0.0656799 | 0.0437866 | 0.0537561 | 0.0639758 | 0.0752185 |
| When $n_1 < n_{10}$, | $n_{1m} =$ | 0.0585193 | 0.0130481 | 0.0437659 | 0.0602637 | 0.0712415 |
| When $k_1 \geq k_{10}$, | $k_{1m} =$ | 0.0803796 | 0.0379236 | 0.0696973 | 0.0785339 | 0.0793298 |
| When $k_1 < k_{10}$, | $k_{1m} =$ | 0.0475867 | 0.0209644 | 0.0354407 | 0.0397900 | 0.0383728 |
| When $d_1 \geq d_{10}$, | $d_{1m}$ (nm) $=$ | $\infty$ | 20.412 | $\infty$ | $\infty$ | $\infty$ |
| When $d_1 < d_{10}$, | $d_{1m}$ (nm) $=$ | 76.169 | 3.912 | 15.725 | 78.897 | 136.900 |
| When $n_2 \geq n_{20}$, | $n_{2m} =$ | 0.1359851 | 0.0436487 | 0.1238757 | 0.1440674 | 0.1618445 |
| When $n_2 < n_{20}$, | $n_{2m} =$ | 0.1709363 | 0.1590417 | 0.1491174 | 0.1814563 | 0.2117529 |
| When $k_2 \geq k_{20}$, | $k_{2m} =$ | 0.1377368 | 0.0580493 | 0.1037561 | 0.1202234 | 0.1371057 |
| When $k_2 < k_{20}$, | $k_{2m} =$ | 0.0711096 | 0.0823193 | 0.0849219 | 0.0779297 | 0.0717078 |
| When $d_2 \geq d_{20}$, | $d_{2m}$ (nm) $=$ | $\infty$ | 9.984 | $\infty$ | $\infty$ | $\infty$ |
| When $d_2 < d_{20}$, | $d_{2m}$ (nm) $=$ | 82.771 | 19.617 | 23.813 | 73.684 | 77.607 |

$0.93 \leq NA \leq 1.0$
$195 < T \leq 205$

| Case | 20-01 | 20-02 | 20-03 | 20-04 | 20-05 |
|---|---|---|---|---|---|
| $n_{10}$ | 1.9115074 | 1.9153788 | 1.8712999 | 1.7275221 | 1.7279210 |
| $k_{10}$ | 0.1960527 | 0.1490337 | 0.0897979 | 0.1065695 | 0.0881248 |
| $d_{10}$ (nm) | 13.258 | 11.515 | 14.536 | 86.590 | 87.122 |
| $n_{20}$ | 1.6255021 | 1.6682692 | 1.7614462 | 1.6227655 | 1.6778177 |
| $k_{20}$ | 0.3984556 | 0.3197853 | 0.2821612 | 0.3041284 | 0.2471127 |
| $d_{20}$ (nm) | 164.068 | 218.507 | 257.799 | 156.467 | 209.069 |

| | | 20-01 | 20-02 | 20-03 | 20-04 | 20-05 |
|---|---|---|---|---|---|---|
| When $n_1 \geq n_{10}$, | $n_{1m} =$ | 0.1142444 | 0.1325989 | 0.1158582 | 0.0562817 | 0.0637024 |
| When $n_1 < n_{10}$, | $n_{1m} =$ | 0.0852515 | 0.1080505 | 0.0942114 | 0.0426550 | 0.0501379 |
| When $k_1 \geq k_{10}$, | $k_{1m} =$ | 0.1044482 | 0.1295020 | 0.1096521 | 0.0681348 | 0.0804810 |
| When $k_1 < k_{10}$, | $k_{1m} =$ | 0.1084790 | 0.1269031 | 0.0897979 | 0.0488770 | 0.0543994 |
| When $d_1 \geq d_{10}$, | $d_{1m}$ (nm) $=$ | 5.346 | 6.134 | 8.659 | 13.270 | 20.006 |
| When $d_1 < d_{10}$, | $d_{1m}$ (nm) $=$ | 3.730 | 4.524 | 6.443 | 8.305 | 10.905 |
| When $n_2 \geq n_{20}$, | $n_{2m} =$ | 0.1424097 | 0.1416443 | 0.1412390 | 0.1051294 | 0.1236353 |
| When $n_2 < n_{20}$, | $n_{2m} =$ | 0.1779224 | 0.1667200 | 0.1823743 | 0.1526196 | 0.1593042 |
| When $k_2 \geq k_{20}$, | $k_{2m} =$ | 0.1351575 | 0.1341370 | 0.1542419 | 0.1188623 | 0.1364233 |
| When $k_2 < k_{20}$, | $k_{2m} =$ | 0.1244714 | 0.1144324 | 0.1102271 | 0.0976929 | 0.0887854 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 70.107 | 105.511 | 128.903 | 31.502 | 77.053 |

$0.93 \leq NA \leq 1.0$
$195 < T \leq 205$

| Case | | 20-06 | 20-07 | 20-08 | 20-09 | 20-10 |
|---|---|---|---|---|---|---|
| $n_{10}$ | | 1.7316602 | 1.7109076 | 1.7140510 | 1.7169074 | 1.7034522 |
| $k_{10}$ | | 0.0769958 | 0.0825870 | 0.0712311 | 0.0659464 | 0.0912009 |
| $d_{10}$ (nm) | | 87.563 | 152.078 | 152.368 | 152.739 | 216.873 |
| $n_{20}$ | | 1.7153560 | 1.6429824 | 1.6947912 | 1.7201685 | 1.5969711 |
| $k_{20}$ | | 0.2092703 | 0.2767726 | 0.2239389 | 0.1888883 | 0.3506487 |
| $d_{20}$ (nm) | | 261.518 | 151.325 | 204.003 | 258.117 | 92.838 |

| When $n_1 \geq n_{10}$, | $n_{1m}=$ | 0.0685693 | 0.0512622 | 0.0601404 | 0.0671716 | 0.0436548 |
|---|---|---|---|---|---|---|
| When $n_1 < n_{10}$, | $n_{1m}=$ | 0.0495715 | 0.0375720 | 0.0532251 | 0.0484131 | 0.0089709 |
| When $k_1 \geq k_{10}$, | $k_{1m}=$ | 0.0827515 | 0.0683850 | 0.0790723 | 0.0783716 | 0.0369128 |
| When $k_1 < k_{10}$, | $k_{1m}=$ | 0.0588892 | 0.0391077 | 0.0446033 | 0.0456335 | 0.0165588 |
| When $d_1 \geq d_{10}$, | $d_{1m}$ (nm) $=$ | 35.460 | 20.848 | ∞ | ∞ | 19.781 |
| When $d_1 < d_{10}$, | $d_{1m}$ (nm) $=$ | 11.967 | 10.711 | 16.311 | 17.445 | 2.680 |
| When $n_2 \geq n_{20}$, | $n_{2m}=$ | 0.1321082 | 0.1010400 | 0.1225134 | 0.1362366 | 0.0345703 |
| When $n_2 < n_{20}$, | $n_{2m}=$ | 0.1646814 | 0.1448950 | 0.1569727 | 0.1688831 | 0.1562476 |
| When $k_2 \geq k_{20}$, | $k_{2m}=$ | 0.1585754 | 0.0998694 | 0.1194824 | 0.1443347 | 0.0797021 |
| When $k_2 < k_{20}$, | $k_{2m}=$ | 0.0798230 | 0.0905042 | 0.0814771 | 0.0735376 | 0.0638440 |
| When $d_2 \geq d_{20}$, | $d_{2m}$ (nm) $=$ | ∞ | ∞ | ∞ | ∞ | 10.032 |
| When $d_2 < d_{20}$, | $d_{2m}$ (nm) $=$ | 87.011 | 25.146 | 71.899 | 78.182 | 16.775 |

$0.93 \leq NA \leq 1.0$
$195 < T \leq 205$

| Case | | 20-11 | 20-12 | 20-13 |
|---|---|---|---|---|
| $n_{10}$ | | 1.7053294 | 1.7084550 | 1.7088490 |
| $k_{10}$ | | 0.0723641 | 0.0642090 | 0.0611230 |
| $d_{10}$ (nm) | | 215.802 | 215.782 | 215.750 |
| $n_{20}$ | | 1.6624125 | 1.7063284 | 1.7155496 |
| $k_{20}$ | | 0.2625944 | 0.2112603 | 0.1784523 |
| $d_{20}$ (nm) | | 147.133 | 200.541 | 257.296 |

| When $n_1 \geq n_{10}$, | $n_{1m}=$ | 0.0548254 | 0.0651489 | 0.0765845 |
|---|---|---|---|---|
| When $n_1 < n_{10}$, | $n_{1m}=$ | 0.0418201 | 0.0593726 | 0.0732715 |
| When $k_1 \geq k_{10}$, | $k_{1m}=$ | 0.0710583 | 0.0775024 | 0.0765796 |
| When $k_1 < k_{10}$, | $k_{1m}=$ | 0.0355750 | 0.0411511 | 0.0355579 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 15.640 | 79.525 | 76.637 |
| When $n_2 \geq n_{20}$, | $n_{2m}=$ | 0.1192065 | 0.1417981 | 0.1626379 |
| When $n_2 < n_{20}$, | $n_{2m}=$ | 0.1432642 | 0.1798657 | 0.2073511 |
| When $k_2 \geq k_{20}$, | $k_{2m}=$ | 0.1091699 | 0.1229614 | 0.1404065 |
| When $k_2 < k_{20}$, | $k_{2m}=$ | 0.0923608 | 0.0791760 | 0.0746033 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 19.545 | 71.258 | 73.210 |

In accordance with a third embodiment of the invention, an antireflective film has a two-layer structure and is used in a process for manufacturing a semiconductor device by being provided between a resist layer and a silicon oxide layer formed on a surface of a silicon semiconductor substrate and having a thickness T (unit: nm) described below, for exposure of the resist layer in an exposure system having a wavelength of 190 nm to 195 nm and a numerical aperture NA of $1.0 < NA \leq 1.1$ In accordance with the third embodiment of the invention, an exposure method is used in a process for manufacturing a semiconductor device and includes providing an antireflective film having a two-layer structure between a resist layer and a silicon oxide layer formed on a surface of a silicon semiconductor substrate and having a thickness T (unit: nm) described below, and exposing the resist layer in an exposure system having a wavelength of 190 nm to 195 nm and a numerical aperture NA of $1.0 < NA \leq 1.1$

The antireflective film or the antireflective film used in the exposure method according to the third embodiment of the invention includes an upper layer having a complex refractive index $N_1$ and a lower layer having a complex refractive index $N_2$, the complex refractive indexes $N_1$ and $N_2$ being represented by the following equations:

$$N_1 = n_1 - k_1 i$$

$$N_2 = n_2 - k_2 i$$

Assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1$, $k_1$, $d_1$, $n_2$, $k_2$, and $d_2$ satisfy the following relational expression:

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1$$

However, a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$. In the tables below, in the line of "When $n_1 \geq n_{10}$, $n_{1m} =$", each value in the right columns is "$n_{1m} - n_{10}$"; in the line of "When $n_1 < n_{10}$, $n_{1m} =$", each value in the right columns is "$n_{10} - n_{1m}$"; in the line of "When $k_1 \geq k_{10}$, $k_{1m} =$", each value in the right columns is "$k_{1m} - k_{10}$"; in the line of "When $k_1 < k_{10}$, $k_{1m} =$", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m} =$", each value in the right columns is "$n_{2m} - n_{20}$"; in the line of "When $n_2 < n_{20}$, $n_{2m} =$", each value in the right columns is "$n_{20} - n_{2m}$"; in the line of "When $k_2 \geq k_{20}$, $k_{2m} =$", each value in the right columns is "$k_{2m} - k_{20}$"; in the line of "When $k_2 < k_{20}$, $k_{2m} =$", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

1.  0 < N A ≤ 1. 1

2 ≤ T ≤ 1 5

| Case | 1-01 | 1-02 | 1-03 | 1-04 | 1-05 |
|---|---|---|---|---|---|
| $n_{10}$ | 2.1002530 | 1.9014716 | 1.8817545 | 1.8713707 | 1.8894555 |
| $k_{10}$ | 0.0458360 | 0.1897321 | 0.1528631 | 0.1131033 | 0.1025295 |
| $d_{10}$ (nm) | 25.245 | 35.107 | 29.787 | 20.680 | 13.808 |
| $n_{20}$ | 3.6613926 | 3.6832791 | 2.2496615 | 1.8471360 | 1.7319643 |
| $k_{20}$ | 2.0917723 | 0.6232721 | 0.5909670 | 0.3799287 | 0.2879285 |
| $d_{20}$ (nm) | 4.980 | 30.030 | 58.673 | 139.609 | 214.126 |

| | | 1-01 | 1-02 | 1-03 | 1-04 | 1-05 |
|---|---|---|---|---|---|---|
| When $n_1 \geq n_{10}$, | $n_{1m} =$ | 0.0805884 | 0.0768188 | 0.0754700 | 0.0824719 | 0.1060120 |
| When $n_1 < n_{10}$, | $n_{1m} =$ | 0.0800293 | 0.0653833 | 0.0584985 | 0.0566113 | 0.0706006 |
| When $k_1 \geq k_{10}$, | $k_{1m} =$ | 0.0719092 | 0.0582312 | 0.0563574 | 0.0660449 | 0.0898218 |
| When $k_1 < k_{10}$, | $k_{1m} =$ | 0.0458360 | 0.0865906 | 0.0835730 | 0.0866101 | 0.1025295 |
| When $d_1 \geq d_{10}$, | $d_{1m}$ (nm) = | 3.502 | 5.628 | 6.909 | 7.972 | 7.080 |
| When $d_1 < d_{10}$, | $d_{1m}$ (nm) = | 2.843 | 4.121 | 4.441 | 4.574 | 4.198 |
| When $n_2 \geq n_{20}$, | $n_{2m} =$ | 0.2511194 | 0.1375208 | 0.1500757 | 0.1234998 | 0.1256079 |
| When $n_2 < n_{20}$, | $n_{2m} =$ | 0.2478674 | 0.1642285 | 0.1673572 | 0.1560254 | 0.1556494 |
| When $k_2 \geq k_{20}$, | $k_{2m} =$ | 0.2675171 | 0.1813342 | 0.1899841 | 0.1681030 | 0.1175488 |
| When $k_2 < k_{20}$, | $k_{2m} =$ | 0.2241895 | 0.1363525 | 0.1337048 | 0.1033130 | 0.0926782 |
| When $d_2 \geq d_{20}$, | $d_{2m}$ (nm) = | 0.668 | 1.453 | 8.618 | ∞ | ∞ |
| When $d_2 < d_{20}$, | $d_{2m}$ (nm) = | 0.632 | 1.466 | 7.778 | 59.745 | 82.499 |

1.  0 < N A ≤ 1. 1

2 ≤ T ≤ 1 5

| Case | 1-06 | 1-07 | 1-08 | 1-09 | 1-10 |
|---|---|---|---|---|---|
| $n_{10}$ | 1.8919474 | 1.8730447 | 1.7734811 | 1.7581396 | 1.7209511 |
| $k_{10}$ | 0.0886250 | 0.0995044 | 0.0942049 | 0.0894114 | 0.0778149 |
| $d_{10}$ (nm) | 14.825 | 12.107 | 96.210 | 94.485 | 94.005 |
| $n_{20}$ | 1.7713589 | 1.6971361 | 2.0242448 | 1.8216770 | 1.6746822 |
| $k_{20}$ | 0.2959415 | 0.2384266 | 0.4293783 | 0.2841737 | 0.2144041 |
| $d_{20}$ (nm) | 207.437 | 276.341 | 66.416 | 135.446 | 211.729 |

| | | 1-06 | 1-07 | 1-08 | 1-09 | 1-10 |
|---|---|---|---|---|---|---|
| When $n_1 \geq n_{10}$, | $n_{1m} =$ | 0.1001855 | 0.1196069 | 0.0579333 | 0.0504431 | 0.0487988 |
| When $n_1 < n_{10}$, | $n_{1m} =$ | 0.0678418 | 0.0862451 | 0.0202832 | 0.0122217 | 0.0195996 |
| When $k_1 \geq k_{10}$, | $k_{1m} =$ | 0.0828455 | 0.1086084 | 0.0429993 | 0.0327991 | 0.0449207 |
| When $k_1 < k_{10}$, | $k_{1m} =$ | 0.0886250 | 0.0995044 | 0.0440173 | 0.0383289 | 0.0441089 |
| When $d_1 \geq d_{10}$, | $d_{1m}$ (nm) = | 7.253 | 7.622 | 12.574 | 14.854 | 20.756 |
| When $d_1 < d_{10}$, | $d_{1m}$ (nm) = | 4.294 | 5.017 | 3.736 | 2.430 | 5.594 |
| When $n_2 \geq n_{20}$, | $n_{2m} =$ | 0.1250818 | 0.1274023 | 0.1038489 | 0.1178979 | 0.0654700 |
| When $n_2 < n_{20}$, | $n_{2m} =$ | 0.1542432 | 0.1390320 | 0.1236121 | 0.1075012 | 0.0984851 |
| When $k_2 \geq k_{20}$, | $k_{2m} =$ | 0.1281506 | 0.1059973 | 0.1023560 | 0.1052271 | 0.0726978 |
| When $k_2 < k_{20}$, | $k_{2m} =$ | 0.0937659 | 0.0853320 | 0.1026587 | 0.0735156 | 0.0618335 |
| When $d_2 \geq d_{20}$, | $d_{2m}$ (nm) = | ∞ | ∞ | 5.946 | 13.526 | ∞ |
| When $d_2 < d_{20}$, | $d_{2m}$ (nm) = | 79.532 | 130.356 | 6.729 | 7.895 | 26.663 |

1. 0 < N A ≤ 1. 1
2 ≤ T ≤ 1 5

| Case | 1-11 | 1-12 | 1-13 | 1-14 | 1-15 |
|---|---|---|---|---|---|
| $n_{10}$ | 1.7166765 | 1.7166130 | 1.7322234 | 1.7049421 | 1.7064564 |
| $k_{10}$ | 0.0677623 | 0.0755230 | 0.0835200 | 0.0655754 | 0.0573750 |
| $d_{10}$ (nm) | 92.667 | 182.689 | 166.765 | 163.194 | 160.636 |
| $n_{20}$ | 1.6766991 | 6.5634515 | 1.9262925 | 1.6664527 | 1.6879767 |
| $k_{20}$ | 0.1797231 | 3.2079655 | 0.3700807 | 0.1954874 | 0.1655431 |
| $d_{20}$ (nm) | 270.198 | 1.017 | 69.546 | 208.736 | 264.028 |

| | | 1-11 | 1-12 | 1-13 | 1-14 | 1-15 |
|---|---|---|---|---|---|---|
| When $n_1 \geq n_{10}$, | $n_{1m} =$ | 0.0538269 | 0.0791455 | 0.0502930 | 0.0463574 | 0.0530786 |
| When $n_1 < n_{10}$, | $n_{1m} =$ | 0.0365198 | 0.0150903 | 0.0019495 | 0.0298389 | 0.0507080 |
| When $k_1 \geq k_{10}$, | $k_{1m} =$ | 0.0633020 | 0.0382202 | 0.0176428 | 0.0426367 | 0.0606909 |
| When $k_1 < k_{10}$, | $k_{1m} =$ | 0.0490027 | 0.0352063 | 0.0101367 | 0.0363086 | 0.0412036 |
| When $d_1 \geq d_{10}$, | $d_{1m}$ (nm) = | ∞ | 44.970 | 29.513 | ∞ | ∞ |
| When $d_1 < d_{10}$, | $d_{1m}$ (nm) = | 11.921 | 5.503 | 0.534 | 14.465 | 82.763 |
| When $n_2 \geq n_{20}$, | $n_{2m} =$ | 0.0746594 | 0.3760779 | 0.0943127 | 0.0451807 | 0.0846008 |
| When $n_2 < n_{20}$, | $n_{2m} =$ | 0.1088159 | 0.6761377 | 0.0252344 | 0.0894604 | 0.1080103 |
| When $k_2 \geq k_{20}$, | $k_{2m} =$ | 0.0728833 | 0.4281982 | 0.0109839 | 0.0413684 | 0.0543652 |
| When $k_2 < k_{20}$, | $k_{2m} =$ | 0.0561267 | 0.6156824 | 0.0921399 | 0.0546765 | 0.0510388 |
| When $d_2 \geq d_{20}$, | $d_{2m}$ (nm) = | ∞ | 0.095 | 5.760 | ∞ | ∞ |
| When $d_2 < d_{20}$, | $d_{2m}$ (nm) = | 76.266 | 0.159 | 0.905 | 22.049 | 32.675 |

1. 0 < N A ≤ 1. 1
2 ≤ T ≤ 1 5

| Case | 1-16 | 1-17 | 1-18 | 1-19 | 1-20 |
|---|---|---|---|---|---|
| $n_{10}$ | 1.6929499 | 1.6905856 | 1.6919500 | 1.6995270 | 1.6946661 |
| $k_{10}$ | 0.0758677 | 0.0724871 | 0.0673580 | 0.0541447 | 0.0598692 |
| $d_{10}$ (nm) | 218.538 | 210.998 | 207.119 | 221.890 | 292.769 |
| $n_{20}$ | 1.7888879 | 1.7113381 | 1.6973679 | 1.6914313 | 5.7902895 |
| $k_{20}$ | 0.3373861 | 0.2424201 | 0.1951159 | 0.1602785 | 2.6464640 |
| $d_{20}$ (nm) | 83.914 | 155.877 | 222.394 | 261.841 | 1.370 |

| | | 1-16 | 1-17 | 1-18 | 1-19 | 1-20 |
|---|---|---|---|---|---|---|
| When $n_1 \geq n_{10}$, | $n_{1m} =$ | 0.0154590 | 0.0284326 | 0.0459937 | 0.0695007 | 0.0688428 |
| When $n_1 < n_{10}$, | $n_{1m} =$ | 0.0644519 | 0.0618115 | 0.0647253 | 0.0614612 | 0.0576074 |
| When $k_1 \geq k_{10}$, | $k_{1m} =$ | 0.0296802 | 0.0451062 | 0.0571143 | 0.0607031 | 0.0650110 |
| When $k_1 < k_{10}$, | $k_{1m} =$ | 0.0222290 | 0.0323779 | 0.0391223 | 0.0380823 | 0.0345483 |
| When $d_1 \geq d_{10}$, | $d_{1m}$ (nm) = | 8.212 | ∞ | ∞ | ∞ | ∞ |
| When $d_1 < d_{10}$, | $d_{1m}$ (nm) = | 25.706 | 29.733 | 39.073 | 91.262 | 43.839 |
| When $n_2 \geq n_{20}$, | $n_{2m} =$ | 0.1222742 | 0.1267554 | 0.1643848 | 0.2245898 | 0.7013342 |
| When $n_2 < n_{20}$, | $n_{2m} =$ | 0.0248633 | 0.0660693 | 0.1720679 | 0.1025806 | 0.7193848 |
| When $k_2 \geq k_{20}$, | $k_{2m} =$ | 0.0580225 | 0.0965234 | 0.1267737 | 0.1053369 | 0.5239075 |
| When $k_2 < k_{20}$, | $k_{2m} =$ | 0.0934216 | 0.0846191 | 0.0756384 | 0.0566919 | 0.6531299 |
| When $d_2 \geq d_{20}$, | $d_{2m}$ (nm) = | 16.998 | ∞ | ∞ | ∞ | 0.304 |
| When $d_2 < d_{20}$, | $d_{2m}$ (nm) = | 2.716 | 12.405 | 72.248 | 75.278 | 0.354 |

## 1. 0 < NA ≤ 1. 1
### 2 ≤ T ≤ 15

| Case | 1-21 | 1-22 | 1-23 | 1-24 |
|---|---|---|---|---|
| $n_{10}$ | 1.6927273 | 1.6938682 | 1.6959215 | 1.6965163 |
| $k_{10}$ | 0.0641185 | 0.0632641 | 0.0601626 | 0.0560943 |
| $d_{10}$ (nm) | 275.960 | 269.814 | 266.236 | 263.874 |
| $n_{20}$ | 1.7993913 | 1.7248410 | 1.7076727 | 1.6984359 |
| $k_{20}$ | 0.3510467 | 0.2487428 | 0.2009217 | 0.1709410 |
| $d_{20}$ (nm) | 81.101 | 150.052 | 214.823 | 277.894 |

| | | 1-21 | 1-22 | 1-23 | 1-24 |
|---|---|---|---|---|---|
| When $n_1 \geq n_{10}$, | $n_{1m} =$ | 0.0462292 | 0.0536658 | 0.0656104 | 0.0800903 |
| When $n_1 < n_{10}$, | $n_{1m} =$ | 0.0484851 | 0.0418225 | 0.0432129 | 0.0552332 |
| When $k_1 \geq k_{10}$, | $k_{1m} =$ | 0.0620630 | 0.0619458 | 0.0615613 | 0.0629382 |
| When $k_1 < k_{10}$, | $k_{1m} =$ | 0.0362708 | 0.0377515 | 0.0406262 | 0.0422571 |
| When $d_1 \geq d_{10}$, | $d_{1m}$ (nm) $=$ | ∞ | ∞ | ∞ | ∞ |
| When $d_1 < d_{10}$, | $d_{1m}$ (nm) $=$ | 29.467 | 27.448 | 97.485 | 175.134 |
| When $n_2 \geq n_{20}$, | $n_{2m} =$ | 0.1596558 | 0.1810303 | 0.3970593 | 0.3365332 |
| When $n_2 < n_{20}$, | $n_{2m} =$ | 0.1100391 | 0.2908167 | 0.2424414 | 0.2178503 |
| When $k_2 \geq k_{20}$, | $k_{2m} =$ | 0.1557141 | 0.1886804 | 0.2145630 | 0.2194727 |
| When $k_2 < k_{20}$, | $k_{2m} =$ | 0.1210901 | 0.1012720 | 0.0897449 | 0.0805957 |
| When $d_2 \geq d_{20}$, | $d_{2m}$ (nm) $=$ | 25.591 | ∞ | ∞ | ∞ |
| When $d_2 < d_{20}$, | $d_{2m}$ (nm) $=$ | 9.432 | 27.332 | 78.495 | 131.894 |

## 1. 0 < NA ≤ 1. 1
### 15 ≤ T ≤ 25

| Case | 2-01 | 2-02 | 2-03 | 2-04 | 2-05 |
|---|---|---|---|---|---|
| $n_{10}$ | 1.8588603 | 1.8671897 | 1.8793061 | 1.8953035 | 1.8743725 |
| $k_{10}$ | 0.2152026 | 0.2000001 | 0.1213485 | 0.0980077 | 0.1084578 |
| $d_{10}$ (nm) | 37.726 | 35.681 | 21.414 | 14.908 | 12.201 |
| $n_{20}$ | 5.0977045 | 3.0932325 | 1.8727645 | 1.7635602 | 1.6884757 |
| $k_{20}$ | 0.6974562 | 0.7063642 | 0.4149520 | 0.3109442 | 0.2470663 |
| $d_{20}$ (nm) | 19.647 | 34.687 | 129.308 | 200.446 | 269.437 |

| | | 2-01 | 2-02 | 2-03 | 2-04 | 2-05 |
|---|---|---|---|---|---|---|
| When $n_1 \geq n_{10}$, | $n_{1m} =$ | 0.0758728 | 0.0747766 | 0.0798340 | 0.0988049 | 0.1178149 |
| When $n_1 < n_{10}$, | $n_{1m} =$ | 0.0592542 | 0.0589661 | 0.0549634 | 0.0658325 | 0.0841418 |
| When $k_1 \geq k_{10}$, | $k_{1m} =$ | 0.0598401 | 0.0578650 | 0.0632202 | 0.0814417 | 0.1076917 |
| When $k_1 < k_{10}$, | $k_{1m} =$ | 0.0788342 | 0.0811694 | 0.0865027 | 0.0980077 | 0.1084578 |
| When $d_1 \geq d_{10}$, | $d_{1m}$ (nm) $=$ | 5.593 | 5.891 | 7.449 | 6.933 | 7.359 |
| When $d_1 < d_{10}$, | $d_{1m}$ (nm) $=$ | 4.233 | 4.238 | 4.249 | 4.053 | 4.794 |
| When $n_2 \geq n_{20}$, | $n_{2m} =$ | 0.1534875 | 0.1581152 | 0.1275403 | 0.1254932 | 0.1262524 |
| When $n_2 < n_{20}$, | $n_{2m} =$ | 0.1697559 | 0.1894849 | 0.1565967 | 0.1540796 | 0.1389709 |
| When $k_2 \geq k_{20}$, | $k_{2m} =$ | 0.1955396 | 0.2168408 | 0.1812842 | 0.1267053 | 0.1044556 |
| When $k_2 < k_{20}$, | $k_{2m} =$ | 0.1505579 | 0.1602844 | 0.1066724 | 0.0950110 | 0.0860864 |
| When $d_2 \geq d_{20}$, | $d_{2m}$ (nm) $=$ | 0.659 | 2.512 | ∞ | ∞ | ∞ |
| When $d_2 < d_{20}$, | $d_{2m}$ (nm) $=$ | 0.674 | 2.526 | 26.047 | 76.118 | 126.536 |

1. 0 < N A ≤ 1. 1
1 5 < T ≤ 2 5

| Case | 2-06 | 2-07 | 2-08 | 2-09 | 2-10 |
|---|---|---|---|---|---|
| $n_{10}$ | 1.7693190 | 1.8089249 | 1.7628339 | 1.7223442 | 1.7176215 |
| $k_{10}$ | 0.1013402 | 0.1064114 | 0.0939832 | 0.0810686 | 0.0701007 |
| $d_{10}$ (nm) | 103.520 | 98.052 | 94.416 | 93.840 | 92.613 |
| $n_{20}$ | 3.2583829 | 3.5132584 | 1.8414170 | 1.6728089 | 1.6759231 |
| $k_{20}$ | 2.5781374 | 0.5501157 | 0.3092618 | 0.2260423 | 0.1876577 |
| $d_{20}$ (nm) | 3.121 | 29.615 | 125.923 | 203.086 | 261.422 |

| | | 2-06 | 2-07 | 2-08 | 2-09 | 2-10 |
|---|---|---|---|---|---|---|
| When $n_1 \geq n_{10}$, | $n_{1m} =$ | 0.0673926 | 0.0573926 | 0.0482458 | 0.0469287 | 0.0525317 |
| When $n_1 < n_{10}$, | $n_{1m} =$ | 0.0182031 | 0.0185083 | 0.0097595 | 0.0170142 | 0.0338733 |
| When $k_1 \geq k_{10}$, | $k_{1m} =$ | 0.0401636 | 0.0390552 | 0.0281750 | 0.0413513 | 0.0608655 |
| When $k_1 < k_{10}$, | $k_{1m} =$ | 0.0427917 | 0.0434326 | 0.0360242 | 0.0422778 | 0.0485864 |
| When $d_1 \geq d_{10}$, | $d_{1m}$ (nm) = | 13.610 | 8.991 | 12.525 | 18.295 | 32.066 |
| When $d_1 < d_{10}$, | $d_{1m}$ (nm) = | 3.396 | 2.738 | 1.840 | 4.621 | 10.547 |
| When $n_2 \geq n_{20}$, | $n_{2m} =$ | 0.2210974 | 0.0961951 | 0.1120178 | 0.0558118 | 0.0724255 |
| When $n_2 < n_{20}$, | $n_{2m} =$ | 0.3992041 | 0.1262915 | 0.1064856 | 0.0968689 | 0.1070728 |
| When $k_2 \geq k_{20}$, | $k_{2m} =$ | 0.3438342 | 0.0862598 | 0.0939502 | 0.0666077 | 0.0700989 |
| When $k_2 < k_{20}$, | $k_{2m} =$ | 0.3502100 | 0.1067542 | 0.0758923 | 0.0625208 | 0.0568274 |
| When $d_2 \geq d_{20}$, | $d_{2m}$ (nm) = | 0.375 | 0.986 | 11.083 | ∞ | ∞ |
| When $d_2 < d_{20}$, | $d_{2m}$ (nm) = | 0.497 | 1.167 | 5.972 | 24.056 | 73.630 |

1. 0 < N A ≤ 1. 1
1 5 < T ≤ 2 5

| Case | 2-11 | 2-12 | 2-13 | 2-14 | 2-15 |
|---|---|---|---|---|---|
| $n_{10}$ | 1.7053748 | 1.7067869 | 1.7234396 | 1.7309823 | 1.6924662 |
| $k_{10}$ | 0.0681661 | 0.0592936 | 0.0819972 | 0.0887627 | 0.0804140 |
| $d_{10}$ (nm) | 163.030 | 160.569 | 177.819 | 175.110 | 219.254 |
| $n_{20}$ | 1.6640911 | 1.6873274 | 5.0800961 | 9.5526510 | 1.8031504 |
| $k_{20}$ | 0.2056957 | 0.1726858 | 4.2173316 | 0.4602806 | 0.3794202 |
| $d_{20}$ (nm) | 200.113 | 255.377 | 1.054 | 10.232 | 74.951 |

| | | 2-11 | 2-12 | 2-13 | 2-14 | 2-15 |
|---|---|---|---|---|---|---|
| When $n_1 \geq n_{10}$, | $n_{1m} =$ | 0.0438354 | 0.0515637 | 0.0646301 | 0.0589197 | 0.0054749 |
| When $n_1 < n_{10}$, | $n_{1m} =$ | 0.0254907 | 0.0493457 | 0.0095056 | 0.0049573 | 0.0624841 |
| When $k_1 \geq k_{10}$, | $k_{1m} =$ | 0.0375134 | 0.0575159 | 0.0321326 | 0.0226172 | 0.0163196 |
| When $k_1 < k_{10}$, | $k_{1m} =$ | 0.0331799 | 0.0410168 | 0.0264954 | 0.0199707 | 0.0128040 |
| When $d_1 \geq d_{10}$, | $d_{1m}$ (nm) = | ∞ | ∞ | 31.849 | 25.868 | 2.747 |
| When $d_1 < d_{10}$, | $d_{1m}$ (nm) = | 12.067 | 30.487 | 3.026 | 1.416 | 23.308 |
| When $n_2 \geq n_{20}$, | $n_{2m} =$ | 0.0383606 | 0.0825500 | 0.3294275 | 0.0929846 | 0.1306152 |
| When $n_2 < n_{20}$, | $n_{2m} =$ | 0.0871460 | 0.1052795 | 0.6618042 | 0.0695691 | 0.0087109 |
| When $k_2 \geq k_{20}$, | $k_{2m} =$ | 0.0339417 | 0.0505530 | 0.2910742 | 0.0198328 | 0.0299487 |
| When $k_2 < k_{20}$, | $k_{2m} =$ | 0.0549512 | 0.0515552 | 0.6908167 | 0.0870068 | 0.0872510 |
| When $d_2 \geq d_{20}$, | $d_{2m}$ (nm) = | ∞ | ∞ | 0.079 | 0.102 | 14.451 |
| When $d_2 < d_{20}$, | $d_{2m}$ (nm) = | 19.637 | 29.589 | 0.186 | 0.076 | 0.824 |

1. 0 < N A ≤ 1. 1
1 5 < T ≤ 2 5

| Case | 2-16 | 2-17 | 2-18 | 2-19 | 2-20 |
|---|---|---|---|---|---|
| $n_{10}$ | 1.6899914 | 1.6915311 | 1.6993450 | 1.6920076 | 1.6934597 |
| $k_{10}$ | 0.0755734 | 0.0696615 | 0.0558443 | 0.0677866 | 0.0658489 |
| $d_{10}$ (nm) | 211.286 | 207.258 | 221.722 | 276.645 | 270.093 |
| $n_{20}$ | 1.7113670 | 1.6964473 | 1.6905618 | 1.8143335 | 1.7261499 |
| $k_{20}$ | 0.2592681 | 0.2049428 | 0.1670525 | 0.3967808 | 0.2668883 |
| $d_{20}$ (nm) | 147.090 | 213.635 | 253.347 | 72.378 | 141.360 |

| | | 2-16 | 2-17 | 2-18 | 2-19 | 2-20 |
|---|---|---|---|---|---|---|
| When $n_1 \geq n_{10}$, | $n_{1m} =$ | 0.0235022 | 0.0424463 | 0.0685596 | 0.0429663 | 0.0523279 |
| When $n_1 < n_{10}$, | $n_{1m} =$ | 0.0594971 | 0.0645703 | 0.0572424 | 0.0479932 | 0.0410938 |
| When $k_1 \geq k_{10}$, | $k_{1m} =$ | 0.0403162 | 0.0547461 | 0.0583691 | 0.0593103 | 0.0600049 |
| When $k_1 < k_{10}$, | $k_{1m} =$ | 0.0289734 | 0.0380127 | 0.0376013 | 0.0355176 | 0.0379749 |
| When $d_1 \geq d_{10}$, | $d_{1m}$ (nm) $=$ | 18.036 | ∞ | ∞ | ∞ | ∞ |
| When $d_1 < d_{10}$, | $d_{1m}$ (nm) $=$ | 26.582 | 37.673 | 84.779 | 28.006 | 25.642 |
| When $n_2 \geq n_{20}$, | $n_{2m} =$ | 0.1259094 | 0.1555469 | 0.2302234 | 0.1717712 | 0.1831995 |
| When $n_2 < n_{20}$, | $n_{2m} =$ | 0.0501526 | 0.1747144 | 0.0944592 | 0.1059167 | 0.2850769 |
| When $k_2 \geq k_{20}$, | $k_{2m} =$ | 0.0866736 | 0.1221960 | 0.1032471 | 0.1537634 | 0.1870032 |
| When $k_2 < k_{20}$, | $k_{2m} =$ | 0.0848877 | 0.0779785 | 0.0578296 | 0.1330688 | 0.1069617 |
| When $d_2 \geq d_{20}$, | $d_{2m}$ (nm) $=$ | ∞ | ∞ | ∞ | 19.935 | ∞ |
| When $d_2 < d_{20}$, | $d_{2m}$ (nm) $=$ | 9.771 | 69.780 | 73.090 | 7.607 | 20.837 |

1. 0 < N A ≤ 1. 1
1 5 < T ≤ 2 5

| Case | 2-21 | 2-22 |
|---|---|---|
| $n_{10}$ | 1.6956703 | 1.6963391 |
| $k_{10}$ | 0.0621151 | 0.0576411 |
| $d_{10}$ (nm) | 266.327 | 263.935 |
| $n_{20}$ | 1.7069279 | 1.6975975 |
| $k_{20}$ | 0.2113995 | 0.1780179 |
| $d_{20}$ (nm) | 206.262 | 269.259 |

| | | 2-21 | 2-22 |
|---|---|---|---|
| When $n_1 \geq n_{10}$, | $n_{1m} =$ | 0.0646936 | 0.0790869 |
| When $n_1 < n_{10}$, | $n_{1m} =$ | 0.0423181 | 0.0536755 |
| When $k_1 \geq k_{10}$, | $k_{1m} =$ | 0.0600012 | 0.0616785 |
| When $k_1 < k_{10}$, | $k_{1m} =$ | 0.0403015 | 0.0417126 |
| When $d_1 \geq d_{10}$, | $d_{1m}$ (nm) $=$ | ∞ | ∞ |
| When $d_1 < d_{10}$, | $d_{1m}$ (nm) $=$ | 96.199 | 173.391 |
| When $n_2 \geq n_{20}$, | $n_{2m} =$ | 0.4184778 | 0.3488293 |
| When $n_2 < n_{20}$, | $n_{2m} =$ | 0.2491736 | 0.2216455 |
| When $k_2 \geq k_{20}$, | $k_{2m} =$ | 0.2142920 | 0.2197681 |
| When $k_2 < k_{20}$, | $k_{2m} =$ | 0.0934741 | 0.0831250 |
| When $d_2 \geq d_{20}$, | $d_{2m}$ (nm) $=$ | ∞ | ∞ |
| When $d_2 < d_{20}$, | $d_{2m}$ (nm) $=$ | 76.168 | 129.228 |

1. 0 < N A ≤ 1. 1
25 < T ≤ 35

| Case | 3-01 | 3-02 | 3-03 | 3-04 | 3-05 |
|---|---|---|---|---|---|
| $n_{10}$ | 1.8231304 | 1.8934062 | 1.9014262 | 1.8787814 | 1.8198973 |
| $k_{10}$ | 0.2426967 | 0.1289044 | 0.1029443 | 0.1135143 | 0.1197953 |
| $d_{10}$ (nm) | 38.982 | 22.067 | 15.306 | 12.334 | 96.975 |
| $n_{20}$ | 4.7825941 | 1.9169501 | 1.7714781 | 1.6867670 | 4.7572984 |
| $k_{20}$ | 0.7852430 | 0.4577317 | 0.3309508 | 0.2583639 | 0.6218490 |
| $d_{20}$ (nm) | 19.992 | 118.684 | 191.572 | 261.269 | 20.274 |

| | | 3-01 | 3-02 | 3-03 | 3-04 | 3-05 |
|---|---|---|---|---|---|---|
| When $n_1 \geq n_{10}$, | $n_{1m} =$ | 0.0699695 | 0.0767236 | 0.0951282 | 0.1154443 | 0.0479663 |
| When $n_1 < n_{10}$, | $n_{1m} =$ | 0.0498486 | 0.0532642 | 0.0626563 | 0.0817676 | 0.0146021 |
| When $k_1 \geq k_{10}$, | $k_{1m} =$ | 0.0588489 | 0.0605774 | 0.0772998 | 0.1052600 | 0.0370215 |
| When $k_1 < k_{10}$, | $k_{1m} =$ | 0.0707385 | 0.0857886 | 0.1011462 | 0.1135143 | 0.0364331 |
| When $d_1 \geq d_{10}$, | $d_{1m}$ (nm) $=$ | 5.137 | 6.730 | 6.574 | 7.047 | 7.725 |
| When $d_1 < d_{10}$, | $d_{1m}$ (nm) $=$ | 3.775 | 3.826 | 3.782 | 4.562 | 2.005 |
| When $n_2 \geq n_{20}$, | $n_{2m} =$ | 0.1872302 | 0.1343799 | 0.1259058 | 0.1236719 | 0.1156909 |
| When $n_2 < n_{20}$, | $n_{2m} =$ | 0.2029309 | 0.1567590 | 0.1523523 | 0.1408569 | 0.1282800 |
| When $k_2 \geq k_{20}$, | $k_{2m} =$ | 0.2449841 | 0.2003137 | 0.1294177 | 0.1036865 | 0.0748242 |
| When $k_2 < k_{20}$, | $k_{2m} =$ | 0.1832959 | 0.1099609 | 0.0962476 | 0.0870068 | 0.1199268 |
| When $d_2 \geq d_{20}$, | $d_{2m}$ (nm) $=$ | 0.864 | ∞ | ∞ | ∞ | 0.532 |
| When $d_2 < d_{20}$, | $d_{2m}$ (nm) $=$ | 0.839 | 21.916 | 71.881 | 121.487 | 0.552 |

1. 0 < N A ≤ 1. 1
25 < T ≤ 35

| Case | 3-06 | 3-07 | 3-08 | 3-09 | 3-10 |
|---|---|---|---|---|---|
| $n_{10}$ | 1.7669399 | 1.7235821 | 1.7188964 | 1.7058208 | 1.7073313 |
| $k_{10}$ | 0.0997580 | 0.0847397 | 0.0726255 | 0.0710513 | 0.0613671 |
| $d_{10}$ (nm) | 94.208 | 93.618 | 92.505 | 162.764 | 160.462 |
| $n_{20}$ | 1.8558060 | 1.6692590 | 1.6760484 | 1.6616172 | 1.6880654 |
| $k_{20}$ | 0.3364471 | 0.2394056 | 0.1967286 | 0.2176394 | 0.1807904 |
| $d_{20}$ (nm) | 117.969 | 195.006 | 252.779 | 191.801 | 246.769 |

| | | 3-06 | 3-07 | 3-08 | 3-09 | 3-10 |
|---|---|---|---|---|---|---|
| When $n_1 \geq n_{10}$, | $n_{1m} =$ | 0.0449036 | 0.0442456 | 0.0506409 | 0.0405530 | 0.0497949 |
| When $n_1 < n_{10}$, | $n_{1m} =$ | 0.0058435 | 0.0142969 | 0.0314514 | 0.0176917 | 0.0472620 |
| When $k_1 \geq k_{10}$, | $k_{1m} =$ | 0.0200403 | 0.0369336 | 0.0583228 | 0.0316150 | 0.0541370 |
| When $k_1 < k_{10}$, | $k_{1m} =$ | 0.0309863 | 0.0404504 | 0.0477759 | 0.0303076 | 0.0405200 |
| When $d_1 \geq d_{10}$, | $d_{1m}$ (nm) $=$ | 10.713 | 16.167 | 24.298 | ∞ | ∞ |
| When $d_1 < d_{10}$, | $d_{1m}$ (nm) $=$ | 1.043 | 3.709 | 9.337 | 7.078 | 23.845 |
| When $n_2 \geq n_{20}$, | $n_{2m} =$ | 0.1063135 | 0.0450122 | 0.0699963 | 0.0309314 | 0.0781641 |
| When $n_2 < n_{20}$, | $n_{2m} =$ | 0.1037158 | 0.0932996 | 0.1043005 | 0.0818408 | 0.1014221 |
| When $k_2 \geq k_{20}$, | $k_{2m} =$ | 0.0686243 | 0.0581018 | 0.0668628 | 0.0258777 | 0.0465137 |
| When $k_2 < k_{20}$, | $k_{2m} =$ | 0.0768091 | 0.0625977 | 0.0574854 | 0.0546838 | 0.0521045 |
| When $d_2 \geq d_{20}$, | $d_{2m}$ (nm) $=$ | 9.637 | ∞ | ∞ | 13.452 | ∞ |
| When $d_2 < d_{20}$, | $d_{2m}$ (nm) $=$ | 3.465 | 21.705 | 32.653 | 17.168 | 25.940 |

1. 0 < N A ≤ 1. 1
2 5 < T ≤ 3 5

| Case | 3-11 | 3-12 | 3-13 | 3-14 | 3-15 |
|---|---|---|---|---|---|
| $n_{10}$ | 1.6893950 | 1.6912149 | 1.6993872 | 1.6931110 | 1.6955537 |
| $k_{10}$ | 0.0792587 | 0.0722082 | 0.0576769 | 0.0689939 | 0.0643335 |
| $d_{10}$ (nm) | 211.356 | 207.241 | 221.603 | 270.168 | 266.333 |
| $n_{20}$ | 1.7121469 | 1.6964479 | 1.6911809 | 1.7281714 | 1.7074500 |
| $k_{20}$ | 0.2795726 | 0.2163033 | 0.1749036 | 0.2885226 | 0.2235939 |
| $d_{20}$ (nm) | 139.203 | 205.754 | 244.825 | 133.446 | 198.195 |

| | | 3-11 | 3-12 | 3-13 | 3-14 | 3-15 |
|---|---|---|---|---|---|---|
| When $n_1 \geq n_{10}$, | $n_{1m} =$ | 0.0187524 | 0.0389221 | 0.0673108 | 0.0502356 | 0.0624109 |
| When $n_1 < n_{10}$, | $n_{1m} =$ | 0.0561719 | 0.0620898 | 0.0525073 | 0.0397852 | 0.0411060 |
| When $k_1 \geq k_{10}$, | $k_{1m} =$ | 0.0323267 | 0.0510889 | 0.0557678 | 0.0576538 | 0.0581616 |
| When $k_1 < k_{10}$, | $k_{1m} =$ | 0.0242261 | 0.0363989 | 0.0368542 | 0.0366370 | 0.0397400 |
| When $d_1 \geq d_{10}$, | $d_{1m}$ (nm) $=$ | 9.539 | ∞ | ∞ | ∞ | ∞ |
| When $d_1 < d_{10}$, | $d_{1m}$ (nm) $=$ | 23.792 | 36.062 | 80.743 | 23.618 | 94.755 |
| When $n_2 \geq n_{20}$, | $n_{2m} =$ | 0.1258521 | 0.1531580 | 0.2394678 | 0.1860962 | 0.4430444 |
| When $n_2 < n_{20}$, | $n_{2m} =$ | 0.0334863 | 0.1783936 | 0.0871167 | 0.1489648 | 0.2583777 |
| When $k_2 \geq k_{20}$, | $k_{2m} =$ | 0.0734656 | 0.1167761 | 0.1010718 | 0.1855286 | 0.2138647 |
| When $k_2 < k_{20}$, | $k_{2m} =$ | 0.0783704 | 0.0804089 | 0.0594067 | 0.1140149 | 0.0979895 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 6.823 | 66.025 | 33.786 | 17.363 | 72.201 |

1. 0 < N A ≤ 1. 1
2 5 < T ≤ 3 5

| Case | 3-16 |
|---|---|
| $n_{10}$ | 1.6962507 |
| $k_{10}$ | 0.0593120 |
| $d_{10}$ (nm) | 263.960 |
| $n_{20}$ | 1.6977843 |
| $k_{20}$ | 0.1860709 |
| $d_{20}$ (nm) | 261.024 |

| | | 3-16 |
|---|---|---|
| When $n_1 \geq n_{10}$, | $n_{1m} =$ | 0.0782690 |
| When $n_1 < n_{10}$, | $n_{1m} =$ | 0.0522693 |
| When $k_1 \geq k_{10}$, | $k_{1m} =$ | 0.0602515 |
| When $k_1 < k_{10}$, | $k_{1m} =$ | 0.0408899 |
| When $d_1 \geq d_{10}$, | $d_{1m}$ (nm) $=$ | ∞ |
| When $d_1 < d_{10}$, | $d_{1m}$ (nm) $=$ | 119.700 |
| When $n_2 \geq n_{20}$, | $n_{2m} =$ | 0.3636609 |
| When $n_2 < n_{20}$, | $n_{2m} =$ | 0.2256018 |
| When $k_2 \geq k_{20}$, | $k_{2m} =$ | 0.2198901 |
| When $k_2 < k_{20}$, | $k_{2m} =$ | 0.0864600 |
| When $d_2 \geq d_{20}$, | $d_{2m}$ (nm) $=$ | ∞ |
| When $d_2 < d_{20}$, | $d_{2m}$ (nm) $=$ | 97.445 |

1. 0 < N A ≤ 1. 1
3 5 < T ≤ 4 5

| Case | 4-01 | 4-02 | 4-03 | 4-04 | 4-05 |
|---|---|---|---|---|---|
| $n_{10}$ | 1.8741027 | 1.9162345 | 1.9099224 | 1.8839284 | 1.7973698 |
| $k_{10}$ | 0.2292405 | 0.1358555 | 0.1141224 | 0.1193744 | 0.1226911 |
| $d_{10}$ (nm) | 31.502 | 21.455 | 14.789 | 12.268 | 93.176 |
| $n_{20}$ | 2.4589695 | 1.9418040 | 1.7536831 | 1.6821215 | 2.1323779 |
| $k_{20}$ | 0.9273915 | 0.4998799 | 0.3442834 | 0.2672652 | 0.6525391 |
| $d_{20}$ (nm) | 39.688 | 110.373 | 186.067 | 253.238 | 46.828 |

| | | 4-01 | 4-02 | 4-03 | 4-04 | 4-05 |
|---|---|---|---|---|---|---|
| When $n_1 \geq n_{10}$, | $n_{1m} =$ | 0.0646472 | 0.0749023 | 0.0953894 | 0.1145032 | 0.0393335 |
| When $n_1 < n_{10}$, | $n_{1m} =$ | 0.0466125 | 0.0512402 | 0.0611060 | 0.0810242 | 0.0058411 |
| When $k_1 \geq k_{10}$, | $k_{1m} =$ | 0.0535095 | 0.0588599 | 0.0769971 | 0.1049219 | 0.0222083 |
| When $k_1 < k_{10}$, | $k_{1m} =$ | 0.0782300 | 0.0839917 | 0.1022253 | 0.1138464 | 0.0267273 |
| When $d_1 \geq d_{10}$, | $d_{1m}$ (nm) = | 4.763 | 5.873 | 6.052 | 6.690 | 7.237 |
| When $d_1 < d_{10}$, | $d_{1m}$ (nm) = | 3.092 | 3.244 | 3.414 | 4.349 | 0.847 |
| When $n_2 \geq n_{20}$, | $n_{2m} =$ | 0.2061353 | 0.1383777 | 0.1254065 | 0.1201538 | 0.0908765 |
| When $n_2 < n_{20}$, | $n_{2m} =$ | 0.1985669 | 0.1593604 | 0.1521448 | 0.1405737 | 0.1202173 |
| When $k_2 \geq k_{20}$, | $k_{2m} =$ | 0.2506677 | 0.2047961 | 0.1231897 | 0.1019714 | 0.0402307 |
| When $k_2 < k_{20}$, | $k_{2m} =$ | 0.1792896 | 0.1103943 | 0.0960205 | 0.0872583 | 0.1042542 |
| When $d_2 \geq d_{20}$, | $d_{2m}$ (nm) = | 6.142 | ∞ | ∞ | ∞ | 4.028 |
| When $d_2 < d_{20}$, | $d_{2m}$ (nm) = | 4.657 | 20.982 | 70.019 | 92.164 | 2.915 |

1. 0 < N A ≤ 1. 1
3 5 < T ≤ 4 5

| Case | 4-06 | 4-07 | 4-08 | 4-09 | 4-10 |
|---|---|---|---|---|---|
| $n_{10}$ | 1.7231751 | 1.7198225 | 1.7057007 | 1.7079030 | 1.6886446 |
| $k_{10}$ | 0.0881939 | 0.0748307 | 0.0735111 | 0.0631371 | 0.0826816 |
| $d_{10}$ (nm) | 93.194 | 92.273 | 162.218 | 160.241 | 210.810 |
| $n_{20}$ | 1.6583398 | 1.6753837 | 1.6560667 | 1.6895692 | 1.7077667 |
| $k_{20}$ | 0.2493789 | 0.2040438 | 0.2270715 | 0.1875698 | 0.2975930 |
| $d_{20}$ (nm) | 187.627 | 244.025 | 183.673 | 237.741 | 132.542 |

| | | 4-06 | 4-07 | 4-08 | 4-09 | 4-10 |
|---|---|---|---|---|---|---|
| When $n_1 \geq n_{10}$, | $n_{1m} =$ | 0.0413782 | 0.0488660 | 0.0374475 | 0.0482141 | 0.0106323 |
| When $n_1 < n_{10}$, | $n_{1m} =$ | 0.0123999 | 0.0300476 | 0.0153528 | 0.0446057 | 0.0519153 |
| When $k_1 \geq k_{10}$, | $k_{1m} =$ | 0.0333630 | 0.0568799 | 0.0277051 | 0.0515784 | 0.0235608 |
| When $k_1 < k_{10}$, | $k_{1m} =$ | 0.0393298 | 0.0467004 | 0.0300195 | 0.0397412 | 0.0190234 |
| When $d_1 \geq d_{10}$, | $d_{1m}$ (nm) = | 13.894 | 20.818 | 24.657 | ∞ | 6.948 |
| When $d_1 < d_{10}$, | $d_{1m}$ (nm) = | 3.123 | 8.547 | 5.758 | 21.149 | 21.403 |
| When $n_2 \geq n_{20}$, | $n_{2m} =$ | 0.0360730 | 0.0689490 | 0.0276392 | 0.0753564 | 0.1220337 |
| When $n_2 < n_{20}$, | $n_{2m} =$ | 0.0901636 | 0.1032593 | 0.0781885 | 0.0941541 | 0.0190320 |
| When $k_2 \geq k_{20}$, | $k_{2m} =$ | 0.0474146 | 0.0634253 | 0.0205627 | 0.0433423 | 0.0612073 |
| When $k_2 < k_{20}$, | $k_{2m} =$ | 0.0610718 | 0.0577832 | 0.0533984 | 0.0526196 | 0.0606079 |
| When $d_2 \geq d_{20}$, | $d_{2m}$ (nm) = | ∞ | ∞ | 8.473 | ∞ | ∞ |
| When $d_2 < d_{20}$, | $d_{2m}$ (nm) = | 20.321 | 31.703 | 15.881 | 21.519 | 3.543 |

1. 0 < N A ≤ 1. 1

3 5 < T ≤ 4 5

| Case | 4-11 | 4-12 | 4-13 | 4-14 |
|---|---|---|---|---|
| $n_{10}$ | 1.6995870 | 1.6927517 | 1.6954892 | 1.6961809 |
| $k_{10}$ | 0.0592337 | 0.0720967 | 0.0662812 | 0.0606151 |
| $d_{10}$ (nm) | 221.497 | 269.568 | 265.955 | 263.663 |
| $n_{20}$ | 1.6927290 | 1.7225076 | 1.7055518 | 1.6966094 |
| $k_{20}$ | 0.1818275 | 0.3075740 | 0.2340649 | 0.1927366 |
| $d_{20}$ (nm) | 235.781 | 126.653 | 190.864 | 253.572 |

| | | 4-11 | 4-12 | 4-13 | 4-14 |
|---|---|---|---|---|---|
| When $n_1 \geq n_{10}$, | $n_{1m}=$ | 0.0661182 | 0.0430298 | 0.0571948 | 0.0777271 |
| When $n_1 < n_{10}$, | $n_{1m}=$ | 0.0480371 | 0.0376990 | 0.0396948 | 0.0514954 |
| When $k_1 \geq k_{10}$, | $k_{1m}=$ | 0.0532056 | 0.0552930 | 0.0563965 | 0.0590613 |
| When $k_1 < k_{10}$, | $k_{1m}=$ | 0.0358557 | 0.0353455 | 0.0387683 | 0.0400696 |
| When $d_1 \geq d_{10}$, | $d_{1m}$ (nm) = | ∞ | ∞ | ∞ | ∞ |
| When $d_1 < d_{10}$, | $d_{1m}$ (nm) = | 78.174 | 21.398 | 89.629 | 112.221 |
| When $n_2 \geq n_{20}$, | $n_{2m}=$ | 0.2507446 | 0.1898645 | 0.4617859 | 0.3498169 |
| When $n_2 < n_{20}$, | $n_{2m}=$ | 0.0793469 | 0.1193628 | 0.2673291 | 0.2271130 |
| When $k_2 \geq k_{20}$, | $k_{2m}=$ | 0.0998633 | 0.1866309 | 0.2129163 | 0.2195020 |
| When $k_2 < k_{20}$, | $k_{2m}=$ | 0.0613184 | 0.1217163 | 0.1026648 | 0.0902368 |
| When $d_2 \geq d_{20}$, | $d_{2m}$ (nm) = | ∞ | ∞ | ∞ | ∞ |
| When $d_2 < d_{20}$, | $d_{2m}$ (nm) = | 33.021 | 15.026 | 69.134 | 84.327 |

1. 0 < N A ≤ 1. 1

4 5 < T ≤ 5 5

| Case | 5-01 | 5-02 | 5-03 | 5-04 | 5-05 |
|---|---|---|---|---|---|
| $n_{10}$ | 1.8808544 | 1.9316654 | 1.9082705 | 1.8785232 | 1.7211644 |
| $k_{10}$ | 0.2454152 | 0.1473610 | 0.1322705 | 0.1271526 | 0.0906139 |
| $d_{10}$ (nm) | 24.855 | 18.765 | 14.189 | 12.435 | 92.694 |
| $n_{20}$ | 1.8495394 | 1.8569906 | 1.7144055 | 1.6714546 | 1.6423304 |
| $k_{20}$ | 0.8565648 | 0.5034890 | 0.3458924 | 0.2699971 | 0.2528050 |
| $d_{20}$ (nm) | 51.788 | 110.667 | 182.182 | 245.412 | 180.257 |

| | | 5-01 | 5-02 | 5-03 | 5-04 | 5-05 |
|---|---|---|---|---|---|---|
| When $n_1 \geq n_{10}$, | $n_{1m}=$ | 0.0633093 | 0.0784436 | 0.0967798 | 0.1127563 | 0.0394434 |
| When $n_1 < n_{10}$, | $n_{1m}=$ | 0.0379272 | 0.0483252 | 0.0593640 | 0.0800098 | 0.0123450 |
| When $k_1 \geq k_{10}$, | $k_{1m}=$ | 0.0520349 | 0.0606396 | 0.0782654 | 0.1046387 | 0.0323718 |
| When $k_1 < k_{10}$, | $k_{1m}=$ | 0.0704724 | 0.0844775 | 0.1016626 | 0.1111450 | 0.0404236 |
| When $d_1 \geq d_{10}$, | $d_{1m}$ (nm) = | 4.463 | 5.359 | 5.721 | 6.653 | 12.460 |
| When $d_1 < d_{10}$, | $d_{1m}$ (nm) = | 2.319 | 2.677 | 3.157 | 4.357 | 3.091 |
| When $n_2 \geq n_{20}$, | $n_{2m}=$ | 0.1530676 | 0.1305420 | 0.1246069 | 0.1153186 | 0.0322009 |
| When $n_2 < n_{20}$, | $n_{2m}=$ | 0.1897241 | 0.1692273 | 0.1526025 | 0.1380359 | 0.0893225 |
| When $k_2 \geq k_{20}$, | $k_{2m}=$ | 0.1919946 | 0.1591870 | 0.1122729 | 0.0997217 | 0.0401709 |
| When $k_2 < k_{20}$, | $k_{2m}=$ | 0.1170728 | 0.1032434 | 0.0948108 | 0.0869653 | 0.0592017 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 9.182 | 23.164 | 70.833 | 93.569 | 20.376 |

1. 0＜NA≦1.1
45＜T≦55

| Case | 5-06 | 5-07 | 5-08 | 5-09 | 5-10 |
|---|---|---|---|---|---|
| $n_{10}$ | 1.7204079 | 1.7050622 | 1.7085349 | 1.6878153 | 1.6980473 |
| $k_{10}$ | 0.0761160 | 0.0748972 | 0.0642166 | 0.0847734 | 0.0703784 |
| $d_{10}$ (nm) | 92.018 | 161.630 | 160.005 | 209.683 | 224.445 |
| $n_{20}$ | 1.6751968 | 1.6489715 | 1.6919631 | 1.6959203 | 1.6616204 |
| $k_{20}$ | 0.2080809 | 0.2315625 | 0.1914882 | 0.3070669 | 0.2238826 |
| $d_{20}$ (nm) | 234.537 | 175.108 | 227.913 | 127.092 | 171.370 |

| | | 5-06 | 5-07 | 5-08 | 5-09 | 5-10 |
|---|---|---|---|---|---|---|
| When $n_1 \geq n_{10}$, | $n_{1m} =$ | 0.0481116 | 0.0356750 | 0.0469714 | 0.0053320 | 0.0535730 |
| When $n_1 < n_{10}$, | $n_{1m} =$ | 0.0302478 | 0.0193359 | 0.0419556 | 0.0458972 | 0.0248047 |
| When $k_1 \geq k_{10}$, | $k_{1m} =$ | 0.0572302 | 0.0287097 | 0.0507117 | 0.0169995 | 0.0427319 |
| When $k_1 < k_{10}$, | $k_{1m} =$ | 0.0456555 | 0.0334753 | 0.0389539 | 0.0159290 | 0.0235608 |
| When $d_1 \geq d_{10}$, | $d_{1m}$ (nm) $=$ | 19.317 | 21.414 | ∞ | 2.347 | ∞ |
| When $d_1 < d_{10}$, | $d_{1m}$ (nm) $=$ | 8.336 | 7.128 | 19.272 | 19.688 | 12.738 |
| When $n_2 \geq n_{20}$, | $n_{2m} =$ | 0.0703723 | 0.0326379 | 0.0750854 | 0.1108911 | 0.0566052 |
| When $n_2 < n_{20}$, | $n_{2m} =$ | 0.1049292 | 0.0778333 | 0.0787329 | 0.0108118 | 0.0780139 |
| When $k_2 \geq k_{20}$, | $k_{2m} =$ | 0.0616284 | 0.0216638 | 0.0424329 | 0.0606311 | 0.0720593 |
| When $k_2 < k_{20}$, | $k_{2m} =$ | 0.0584753 | 0.0525964 | 0.0537231 | 0.0383350 | 0.0623987 |
| When $d_2 \geq d_{20}$, | $d_{2m}$ (nm) $=$ | ∞ | 8.070 | ∞ | 32.807 | ∞ |
| When $d_2 < d_{20}$, | $d_{2m}$ (nm) $=$ | 32.758 | 15.758 | 17.351 | 1.915 | 21.521 |

1. 0＜NA≦1.1
45＜T≦55

| Case | 5-11 | 5-12 | 5-13 | 5-14 |
|---|---|---|---|---|
| $n_{10}$ | 1.6999707 | 1.6924126 | 1.6955002 | 1.6961000 |
| $k_{10}$ | 0.0601951 | 0.0742318 | 0.0674212 | 0.0611797 |
| $d_{10}$ (nm) | 221.512 | 268.357 | 265.225 | 263.146 |
| $n_{20}$ | 1.6952970 | 1.7068352 | 1.7004174 | 1.6940899 |
| $k_{20}$ | 0.1862586 | 0.3173492 | 0.2397614 | 0.1962440 |
| $d_{20}$ (nm) | 225.852 | 120.697 | 183.997 | 246.462 |

| | | 5-11 | 5-12 | 5-13 | 5-14 |
|---|---|---|---|---|---|
| When $n_1 \geq n_{10}$, | $n_{1m} =$ | 0.0654663 | 0.0386316 | 0.0536462 | 0.0776611 |
| When $n_1 < n_{10}$, | $n_{1m} =$ | 0.0445935 | 0.0350720 | 0.0381848 | 0.0515515 |
| When $k_1 \geq k_{10}$, | $k_{1m} =$ | 0.0509546 | 0.0537524 | 0.0551721 | 0.0583948 |
| When $k_1 < k_{10}$, | $k_{1m} =$ | 0.0349414 | 0.0344934 | 0.0383105 | 0.0394385 |
| When $d_1 \geq d_{10}$, | $d_{1m}$ (nm) $=$ | ∞ | ∞ | ∞ | ∞ |
| When $d_1 < d_{10}$, | $d_{1m}$ (nm) $=$ | 76.496 | 19.128 | 37.283 | 109.648 |
| When $n_2 \geq n_{20}$, | $n_{2m} =$ | 0.1168579 | 0.1905981 | 0.3934021 | 0.3400916 |
| When $n_2 < n_{20}$, | $n_{2m} =$ | 0.0700696 | 0.1027393 | 0.2743970 | 0.2283606 |
| When $k_2 \geq k_{20}$, | $k_{2m} =$ | 0.1002319 | 0.1933838 | 0.2120459 | 0.2188281 |
| When $k_2 < k_{20}$, | $k_{2m} =$ | 0.0624707 | 0.1168652 | 0.1050110 | 0.0926550 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 28.597 | 13.909 | 67.541 | 81.764 |

1. 0 < N A ≤ 1. 1
5 5 < T ≤ 6 5

| Case | 6-01 | 6-02 | 6-03 | 6-04 | 6-05 |
|---|---|---|---|---|---|
| $n_{10}$ | 1.8609133 | 1.9462238 | 1.9002376 | 1.8750233 | 1.8816918 |
| $k_{10}$ | 0.2699154 | 0.1588548 | 0.1498745 | 0.1302055 | 0.0811209 |
| $d_{10}$ (nm) | 23.275 | 16.938 | 13.880 | 12.592 | 12.084 |
| $n_{20}$ | 1.6780954 | 1.8061043 | 1.6764313 | 1.6672162 | 1.7277101 |
| $k_{20}$ | 0.8091000 | 0.4989592 | 0.3420875 | 0.2718902 | 0.2394028 |
| $d_{20}$ (nm) | 51.309 | 107.791 | 176.900 | 235.718 | 282.393 |

| | | 6-01 | 6-02 | 6-03 | 6-04 | 6-05 |
|---|---|---|---|---|---|---|
| When $n_1 \geq n_{10}$, | $n_{1m} =$ | 0.0700366 | 0.0847327 | 0.0979871 | 0.1121912 | 0.1205115 |
| When $n_1 < n_{10}$, | $n_{1m} =$ | 0.0352271 | 0.0459912 | 0.0579346 | 0.0799817 | 0.0890784 |
| When $k_1 \geq k_{10}$, | $k_{1m} =$ | 0.0520923 | 0.0625745 | 0.0794043 | 0.1043726 | 0.1106958 |
| When $k_1 < k_{10}$, | $k_{1m} =$ | 0.0664282 | 0.0874719 | 0.0997217 | 0.1093811 | 0.0811209 |
| When $d_1 \geq d_{10}$, | $d_{1m}$ (nm) = | 4.496 | 4.952 | 5.583 | 6.704 | 7.616 |
| When $d_1 < d_{10}$, | $d_{1m}$ (nm) = | 2.084 | 2.260 | 3.039 | 4.426 | 5.147 |
| When $n_2 \geq n_{20}$, | $n_{2m} =$ | 0.1454468 | 0.1290356 | 0.1219507 | 0.1104688 | 0.1083423 |
| When $n_2 < n_{20}$, | $n_{2m} =$ | 0.1338672 | 0.1849402 | 0.1524817 | 0.1364417 | 0.1532007 |
| When $k_2 \geq k_{20}$, | $k_{2m} =$ | 0.1326758 | 0.1316541 | 0.1033948 | 0.0988464 | 0.1079004 |
| When $k_2 < k_{20}$, | $k_{2m} =$ | 0.1106470 | 0.1010791 | 0.0949341 | 0.0882678 | 0.0854614 |
| When $d_2 \geq d_{20}$, | $d_{2m}$ (nm) = | 18.182 | ∞ | ∞ | ∞ | ∞ |
| When $d_2 < d_{20}$, | $d_{2m}$ (nm) = | 8.638 | 17.532 | 68.073 | 94.482 | 130.723 |

1. 0 < N A ≤ 1. 1
5 5 < T ≤ 6 5

| Case | 6-06 | 6-07 | 6-08 | 6-09 | 6-10 |
|---|---|---|---|---|---|
| $n_{10}$ | 1.7196449 | 1.7211216 | 1.7282121 | 1.7047574 | 1.7094298 |
| $k_{10}$ | 0.0916508 | 0.0765241 | 0.0683348 | 0.0753118 | 0.0647325 |
| $d_{10}$ (nm) | 92.440 | 91.942 | 92.298 | 161.355 | 159.970 |
| $n_{20}$ | 1.6323282 | 1.6777604 | 1.7222619 | 1.6462273 | 1.6962571 |
| $k_{20}$ | 0.2539653 | 0.2105462 | 0.1825246 | 0.2341241 | 0.1938378 |
| $d_{20}$ (nm) | 171.320 | 223.941 | 274.062 | 165.232 | 217.150 |

| | | 6-06 | 6-07 | 6-08 | 6-09 | 6-10 |
|---|---|---|---|---|---|---|
| When $n_1 \geq n_{10}$, | $n_{1m} =$ | 0.0390417 | 0.0485681 | 0.0546460 | 0.0358069 | 0.0474683 |
| When $n_1 < n_{10}$, | $n_{1m} =$ | 0.0139282 | 0.0313391 | 0.0292078 | 0.0174304 | 0.0407373 |
| When $k_1 \geq k_{10}$, | $k_{1m} =$ | 0.0333240 | 0.0585132 | 0.0578357 | 0.0324670 | 0.0508789 |
| When $k_1 < k_{10}$, | $k_{1m} =$ | 0.0406140 | 0.0454041 | 0.0481470 | 0.0321411 | 0.0389600 |
| When $d_1 \geq d_{10}$, | $d_{1m}$ (nm) = | 12.043 | 19.132 | 42.010 | 19.174 | ∞ |
| When $d_1 < d_{10}$, | $d_{1m}$ (nm) = | 3.525 | 8.472 | 8.190 | 6.358 | 18.590 |
| When $n_2 \geq n_{20}$, | $n_{2m} =$ | 0.0324304 | 0.0734375 | 0.0906226 | 0.0327905 | 0.0764417 |
| When $n_2 < n_{20}$, | $n_{2m} =$ | 0.0896448 | 0.1073743 | 0.1223853 | 0.0797839 | 0.0702637 |
| When $k_2 \geq k_{20}$, | $k_{2m} =$ | 0.0391357 | 0.0623755 | 0.0817871 | 0.0268372 | 0.0433899 |
| When $k_2 < k_{20}$, | $k_{2m} =$ | 0.0597375 | 0.0603992 | 0.0593811 | 0.0545007 | 0.0559253 |
| When $d_2 \geq d_{20}$, | $d_{2m}$ (nm) = | ∞ | ∞ | ∞ | 9.153 | ∞ |
| When $d_2 < d_{20}$, | $d_{2m}$ (nm) = | 20.788 | 29.764 | 77.892 | 16.109 | 14.325 |

1. 0 < N A ≦ 1. 1
5 5 < T ≦ 6 5

| Case | 6-11 | 6-12 | 6-13 | 6-14 | 6-15 |
|---|---|---|---|---|---|
| $n_{10}$ | 1.6870964 | 1.6986314 | 1.7003667 | 1.6951156 | 1.6955653 |
| $k_{10}$ | 0.0858972 | 0.0705958 | 0.0607285 | 0.0571177 | 0.0680298 |
| $d_{10}$ (nm) | 208.556 | 224.893 | 221.557 | 215.781 | 264.644 |
| $n_{20}$ | 1.6830399 | 1.6622291 | 1.6983916 | 1.6957463 | 1.6953987 |
| $k_{20}$ | 0.3090553 | 0.2274423 | 0.1887213 | 0.1617780 | 0.2417239 |
| $d_{20}$ (nm) | 121.249 | 160.831 | 215.383 | 277.216 | 176.078 |

| | 6-11 | 6-12 | 6-13 | 6-14 | 6-15 |
|---|---|---|---|---|---|
| When $n_1 \geq n_{10}$, $n_{1m}=$ | 0.0051123 | 0.0520032 | 0.0662122 | 0.0842517 | 0.0515662 |
| When $n_1 < n_{10}$, $n_{1m}=$ | 0.0418372 | 0.0227649 | 0.0435059 | 0.0645801 | 0.0369092 |
| When $k_1 \geq k_{10}$, $k_{1m}=$ | 0.0150793 | 0.0436267 | 0.0489954 | 0.0563855 | 0.0542810 |
| When $k_1 < k_{10}$, $k_{1m}=$ | 0.0179541 | 0.0228833 | 0.0348535 | 0.0371240 | 0.0381006 |
| When $d_1 \geq d_{10}$, $d_{1m}$ (nm) $=$ | 2.247 | ∞ | ∞ | ∞ | ∞ |
| When $d_1 < d_{10}$, $d_{1m}$ (nm) $=$ | 18.385 | 11.933 | 75.920 | 58.822 | 33.649 |
| When $n_2 \geq n_{20}$, $n_{2m}=$ | 0.1010083 | 0.0477234 | 0.1065527 | 0.2254480 | 0.3829150 |
| When $n_2 < n_{20}$, $n_{2m}=$ | 0.0100110 | 0.0759302 | 0.0611096 | 0.1540564 | 0.2775842 |
| When $k_2 \geq k_{20}$, $k_{2m}=$ | 0.0726611 | 0.0766821 | 0.1015344 | 0.1236780 | 0.2119995 |
| When $k_2 < k_{20}$, $k_{2m}=$ | 0.0309253 | 0.0590527 | 0.0616418 | 0.0602039 | 0.1044287 |
| When $d_2 \geq d_{20}$, $d_{2m}$ (nm) $=$ | 25.845 | 22.079 | ∞ | ∞ | ∞ |
| When $d_2 < d_{20}$, $d_{2m}$ (nm) $=$ | 1.717 | 20.127 | 24.695 | 81.257 | 67.124 |

1. 0 < N A ≦ 1. 1
5 5 < T ≦ 6 5

| Case | 6-16 |
|---|---|
| $n_{10}$ | 1.6958377 |
| $k_{10}$ | 0.0528303 |
| $d_{10}$ (nm) | 274.984 |
| $n_{20}$ | 1.6882898 |
| $k_{20}$ | 0.1657751 |
| $d_{20}$ (nm) | 275.044 |

| | 6-16 |
|---|---|
| When $n_1 \geq n_{10}$, $n_{1m}=$ | 0.0590991 |
| When $n_1 < n_{10}$, $n_{1m}=$ | 0.0581189 |
| When $k_1 \geq k_{10}$, $k_{1m}=$ | 0.0684131 |
| When $k_1 < k_{10}$, $k_{1m}=$ | 0.0375098 |
| When $d_1 \geq d_{10}$, $d_{1m}$ (nm) $=$ | ∞ |
| When $d_1 < d_{10}$, $d_{1m}$ (nm) $=$ | 113.219 |
| When $n_2 \geq n_{20}$, $n_{2m}=$ | 0.2789856 |
| When $n_2 < n_{20}$, $n_{2m}=$ | 0.2219617 |
| When $k_2 \geq k_{20}$, $k_{2m}=$ | 0.1981201 |
| When $k_2 < k_{20}$, $k_{2m}=$ | 0.0735400 |
| When $d_2 \geq d_{20}$, $d_{2m}$ (nm) $=$ | ∞ |
| When $d_2 < d_{20}$, $d_{2m}$ (nm) $=$ | 97.500 |

1. 0 < N A ≤ 1. 1
6 5 < T ≤ 7 5

| Case | 7-01 | 7-02 | 7-03 | 7-04 | 7-05 |
|---|---|---|---|---|---|
| $n_{10}$ | 1.8339628 | 1.9445237 | 1.8939902 | 1.8811858 | 1.7203230 |
| $k_{10}$ | 0.2973905 | 0.1726202 | 0.1563846 | 0.0833966 | 0.0922740 |
| $d_{10}$ (nm) | 24.925 | 17.287 | 14.253 | 12.228 | 92.527 |
| $n_{20}$ | 1.6419965 | 1.7953047 | 1.6659458 | 1.7269957 | 1.6328842 |
| $k_{20}$ | 0.8698975 | 0.5162004 | 0.3485215 | 0.2426363 | 0.2599948 |
| $d_{20}$ (nm) | 41.723 | 98.907 | 167.112 | 272.914 | 160.703 |

| | | 7-01 | 7-02 | 7-03 | 7-04 | 7-05 |
|---|---|---|---|---|---|---|
| When $n_1 \geq n_{10}$, | $n_{1m} =$ | 0.0734924 | 0.0853552 | 0.0964307 | 0.1197986 | 0.0394055 |
| When $n_1 < n_{10}$, | $n_{1m} =$ | 0.0377722 | 0.0427490 | 0.0559692 | 0.0877673 | 0.0144592 |
| When $k_1 \geq k_{10}$, | $k_{1m} =$ | 0.0448938 | 0.0589941 | 0.0770850 | 0.1096667 | 0.0331616 |
| When $k_1 < k_{10}$, | $k_{1m} =$ | 0.0453357 | 0.0848169 | 0.0975195 | 0.0833966 | 0.0410388 |
| When $d_1 \geq d_{10}$, | $d_{1m}$ (nm) = | 4.571 | 4.784 | 5.590 | 7.648 | 12.091 |
| When $d_1 < d_{10}$, | $d_{1m}$ (nm) = | 2.315 | 2.092 | 3.027 | 5.109 | 3.655 |
| When $n_2 \geq n_{20}$, | $n_{2m} =$ | 0.1366638 | 0.1348682 | 0.1167786 | 0.1080664 | 0.0326196 |
| When $n_2 < n_{20}$, | $n_{2m} =$ | 0.1076978 | 0.1944104 | 0.1524536 | 0.1545313 | 0.0900854 |
| When $k_2 \geq k_{20}$, | $k_{2m} =$ | 0.1648022 | 0.1338904 | 0.1021130 | 0.1080652 | 0.0396484 |
| When $k_2 < k_{20}$, | $k_{2m} =$ | 0.1324670 | 0.1078918 | 0.0977759 | 0.0865271 | 0.0625085 |
| When $d_2 \geq d_{20}$, | $d_{2m}$ (nm) = | 12.499 | ∞ | ∞ | ∞ | ∞ |
| When $d_2 < d_{20}$, | $d_{2m}$ (nm) = | 5.747 | 14.376 | 64.164 | 128.680 | 19.557 |

1. 0 < N A ≤ 1. 1
6 5 < T ≤ 7 5

| Case | 7-06 | 7-07 | 7-08 | 7-09 | 7-10 |
|---|---|---|---|---|---|
| $n_{10}$ | 1.7224265 | 1.7294779 | 1.7053201 | 1.7102741 | 1.7133466 |
| $k_{10}$ | 0.0770592 | 0.0692299 | 0.0757255 | 0.0654045 | 0.0629386 |
| $d_{10}$ (nm) | 92.053 | 92.385 | 161.452 | 160.136 | 160.381 |
| $n_{20}$ | 1.6819841 | 1.7252879 | 1.6485370 | 1.7000507 | 1.7220503 |
| $k_{20}$ | 0.2150120 | 0.1858377 | 0.2399747 | 0.1977447 | 0.1698335 |
| $d_{20}$ (nm) | 213.162 | 263.723 | 154.588 | 206.614 | 260.757 |

| | | 7-06 | 7-07 | 7-08 | 7-09 | 7-10 |
|---|---|---|---|---|---|---|
| When $n_1 \geq n_{10}$, | $n_{1m} =$ | 0.0490625 | 0.0548535 | 0.0366443 | 0.0483020 | 0.0569666 |
| When $n_1 < n_{10}$, | $n_{1m} =$ | 0.0311902 | 0.0280200 | 0.0173645 | 0.0416309 | 0.0190027 |
| When $k_1 \geq k_{10}$, | $k_{1m} =$ | 0.0581604 | 0.0565332 | 0.0330920 | 0.0498926 | 0.0402344 |
| When $k_1 < k_{10}$, | $k_{1m} =$ | 0.0461389 | 0.0475879 | 0.0324707 | 0.0390747 | 0.0240051 |
| When $d_1 \geq d_{10}$, | $d_{1m}$ (nm) = | 19.214 | 40.761 | 19.902 | ∞ | ∞ |
| When $d_1 < d_{10}$, | $d_{1m}$ (nm) = | 8.328 | 7.705 | 6.285 | 18.989 | 5.694 |
| When $n_2 \geq n_{20}$, | $n_{2m} =$ | 0.0747375 | 0.0917908 | 0.0322156 | 0.0769946 | 0.1011584 |
| When $n_2 < n_{20}$, | $n_{2m} =$ | 0.1078540 | 0.1217822 | 0.0813562 | 0.0689685 | 0.1343567 |
| When $k_2 \geq k_{20}$, | $k_{2m} =$ | 0.0634705 | 0.0827625 | 0.0283752 | 0.0430542 | 0.0435730 |
| When $k_2 < k_{20}$, | $k_{2m} =$ | 0.0623401 | 0.0604163 | 0.0573535 | 0.0576453 | 0.0570081 |
| When $d_2 \geq d_{20}$, | $d_{2m}$ (nm) = | ∞ | ∞ | 9.136 | 38.239 | ∞ |
| When $d_2 < d_{20}$, | $d_{2m}$ (nm) = | 27.810 | 75.918 | 15.379 | 13.085 | 10.847 |

1. 0 < N A ≤ 1. 1

6 5 < T ≤ 7 5

| Case | 7–11 | 7–12 | 7–13 | 7–14 | 7–15 |
|---|---|---|---|---|---|
| $n_{10}$ | 1.6861768 | 1.6990769 | 1.7003759 | 1.6946436 | 1.6954303 |
| $k_{10}$ | 0.0881028 | 0.0709373 | 0.0613969 | 0.0577579 | 0.0690806 |
| $d_{10}$ (nm) | 208.148 | 225.005 | 221.468 | 215.315 | 264.876 |
| $n_{20}$ | 1.6733849 | 1.6647354 | 1.6998938 | 1.6946016 | 1.6937197 |
| $k_{20}$ | 0.3136681 | 0.2329033 | 0.1918751 | 0.1634050 | 0.2458138 |
| $d_{20}$ (nm) | 112.385 | 150.349 | 205.497 | 268.128 | 165.269 |

| | | 7–11 | 7–12 | 7–13 | 7–14 | 7–15 |
|---|---|---|---|---|---|---|
| When $n_1 \geq n_{10}$, | $n_{1m} =$ | 0.0025806 | 0.0529590 | 0.0676086 | 0.0859229 | 0.0516138 |
| When $n_1 < n_{10}$, | $n_{1m} =$ | 0.0409998 | 0.0231177 | 0.0444312 | 0.0666504 | 0.0367175 |
| When $k_1 \geq k_{10}$, | $k_{1m} =$ | 0.0094263 | 0.0435510 | 0.0474890 | 0.0560022 | 0.0529260 |
| When $k_1 < k_{10}$, | $k_{1m} =$ | 0.0156848 | 0.0234912 | 0.0355322 | 0.0372656 | 0.0371912 |
| When $d_1 \geq d_{10}$, | $d_{1m}$ (nm) $=$ | 1.037 | ∞ | ∞ | ∞ | ∞ |
| When $d_1 < d_{10}$, | $d_{1m}$ (nm) $=$ | 17.094 | 12.289 | 76.126 | 56.280 | 33.058 |
| When $n_2 \geq n_{20}$, | $n_{2m} =$ | 0.1039172 | 0.0468506 | 0.1077234 | 0.2240735 | 0.4022729 |
| When $n_2 < n_{20}$, | $n_{2m} =$ | 0.0058093 | 0.0753308 | 0.0576575 | 0.1556287 | 0.2760486 |
| When $k_2 \geq k_{20}$, | $k_{2m} =$ | 0.0664124 | 0.0758972 | 0.1012000 | 0.1249744 | 0.2123950 |
| When $k_2 < k_{20}$, | $k_{2m} =$ | 0.0178174 | 0.0630115 | 0.0645288 | 0.0620288 | 0.1063135 |
| When $d_2 \geq d_{20}$, | $d_{2m}$ (nm) $=$ | 26.367 | 19.187 | ∞ | ∞ | ∞ |
| When $d_2 < d_{20}$, | $d_{2m}$ (nm) $=$ | 1.017 | 18.602 | 23.769 | 80.847 | 66.469 |

1. 0 < N A ≤ 1. 1

6 5 < T ≤ 7 5

| Case | 7–16 |
|---|---|
| $n_{10}$ | 1.6957423 |
| $k_{10}$ | 0.0532811 |
| $d_{10}$ (nm) | 274.848 |
| $n_{20}$ | 1.6878755 |
| $k_{20}$ | 0.1674492 |
| $d_{20}$ (nm) | 265.685 |

| | | 7–16 |
|---|---|---|
| When $n_1 \geq n_{10}$, | $n_{1m} =$ | 0.0588110 |
| When $n_1 < n_{10}$, | $n_{1m} =$ | 0.0575696 |
| When $k_1 \geq k_{10}$, | $k_{1m} =$ | 0.0681641 |
| When $k_1 < k_{10}$, | $k_{1m} =$ | 0.0379443 |
| When $d_1 \geq d_{10}$, | $d_{1m}$ (nm) $=$ | ∞ |
| When $d_1 < d_{10}$, | $d_{1m}$ (nm) $=$ | 112.076 |
| When $n_2 \geq n_{20}$, | $n_{2m} =$ | 0.2806909 |
| When $n_2 < n_{20}$, | $n_{2m} =$ | 0.2229114 |
| When $k_2 \geq k_{20}$, | $k_{2m} =$ | 0.1986609 |
| When $k_2 < k_{20}$, | $k_{2m} =$ | 0.0745801 |
| When $d_2 \geq d_{20}$, | $d_{2m}$ (nm) $=$ | ∞ |
| When $d_2 < d_{20}$, | $d_{2m}$ (nm) $=$ | 89.270 |

1. $0 < NA \leq 1.1$
$75 < T \leq 85$

| Case | 8-01 | 8-02 | 8-03 | 8-04 | 8-05 |
|---|---|---|---|---|---|
| $n_{10}$ | 1.9187259 | 1.8967518 | 1.8757876 | 1.8806788 | 1.7234296 |
| $k_{10}$ | 0.1881900 | 0.1527475 | 0.1318014 | 0.0899399 | 0.0945092 |
| $d_{10}$ (nm) | 20.509 | 15.221 | 13.247 | 12.412 | 92.722 |
| $n_{20}$ | 1.8283337 | 1.6893708 | 1.6726776 | 1.7211162 | 1.6393014 |
| $k_{20}$ | 0.5739613 | 0.3734166 | 0.2883472 | 0.2492460 | 0.2743485 |
| $d_{20}$ (nm) | 84.746 | 154.221 | 215.129 | 265.394 | 150.270 |

| When $n_1 \geq n_{10}$, $n_{1m} =$ | 0.0766943 | 0.0922229 | 0.1080322 | 0.1177502 | 0.0391516 |
|---|---|---|---|---|---|
| When $n_1 < n_{10}$, $n_{1m} =$ | 0.0399988 | 0.0530884 | 0.0750195 | 0.0852625 | 0.0112524 |
| When $k_1 \geq k_{10}$, $k_{1m} =$ | 0.0507166 | 0.0712622 | 0.0980225 | 0.1073047 | 0.0289392 |
| When $k_1 < k_{10}$, $k_{1m} =$ | 0.0771802 | 0.0964258 | 0.1069458 | 0.0899399 | 0.0412610 |
| When $d_1 \geq d_{10}$, $d_{1m}$ (nm) = | 5.195 | 5.640 | 6.681 | 7.548 | 11.825 |
| When $d_1 < d_{10}$, $d_{1m}$ (nm) = | 2.249 | 2.987 | 4.301 | 4.972 | 2.719 |
| When $n_2 \geq n_{20}$, $n_{2m} =$ | 0.1444995 | 0.1155615 | 0.1091333 | 0.1093396 | 0.0288635 |
| When $n_2 < n_{20}$, $n_{2m} =$ | 0.1897876 | 0.1532776 | 0.1435217 | 0.1541382 | 0.0890479 |
| When $k_2 \geq k_{20}$, $k_{2m} =$ | 0.1811243 | 0.1099194 | 0.1006726 | 0.1075403 | 0.0356238 |
| When $k_2 < k_{20}$, $k_{2m} =$ | 0.1194946 | 0.1025110 | 0.0922131 | 0.0871228 | 0.0649683 |
| When $d_2 \geq d_{20}$, $d_{2m}$ (nm) = | ∞ | ∞ | ∞ | ∞ | ∞ |
| When $d_2 < d_{20}$, $d_{2m}$ (nm) = | 15.313 | 64.664 | 82.555 | 124.472 | 16.892 |

1. $0 < NA \leq 1.1$
$75 < T \leq 85$

| Case | 8-06 | 8-07 | 8-08 | 8-09 | 8-10 |
|---|---|---|---|---|---|
| $n_{10}$ | 1.7235983 | 1.7294254 | 1.7064538 | 1.7103862 | 1.7133072 |
| $k_{10}$ | 0.0790587 | 0.0706491 | 0.0777504 | 0.0670250 | 0.0637197 |
| $d_{10}$ (nm) | 92.129 | 92.482 | 161.668 | 160.278 | 160.467 |
| $n_{20}$ | 1.6815454 | 1.7233644 | 1.6498826 | 1.6983722 | 1.7219131 |
| $k_{20}$ | 0.2228770 | 0.1918670 | 0.2514894 | 0.2047961 | 0.1752501 |
| $d_{20}$ (nm) | 204.187 | 255.172 | 145.038 | 197.922 | 251.781 |

| When $n_1 \geq n_{10}$, $n_{1m} =$ | 0.0481958 | 0.0539050 | 0.0362122 | 0.0474792 | 0.0556775 |
|---|---|---|---|---|---|
| When $n_1 < n_{10}$, $n_{1m} =$ | 0.0281580 | 0.0270288 | 0.0158582 | 0.0428101 | 0.0187244 |
| When $k_1 \geq k_{10}$, $k_{1m} =$ | 0.0546558 | 0.0547986 | 0.0255066 | 0.0459753 | 0.0391089 |
| When $k_1 < k_{10}$, $k_{1m} =$ | 0.0470496 | 0.0476624 | 0.0330371 | 0.0375122 | 0.0244470 |
| When $d_1 \geq d_{10}$, $d_{1m}$ (nm) = | 18.433 | 40.484 | 19.881 | ∞ | ∞ |
| When $d_1 < d_{10}$, $d_{1m}$ (nm) = | 7.376 | 7.380 | 6.011 | 13.737 | 5.649 |
| When $n_2 \geq n_{20}$, $n_{2m} =$ | 0.0719336 | 0.0903259 | 0.0311267 | 0.0755847 | 0.1032422 |
| When $n_2 < n_{20}$, $n_{2m} =$ | 0.1049182 | 0.1183936 | 0.0789893 | 0.0715295 | 0.1268079 |
| When $k_2 \geq k_{20}$, $k_{2m} =$ | 0.0610889 | 0.0802148 | 0.0194653 | 0.0384314 | 0.0401990 |
| When $k_2 < k_{20}$, $k_{2m} =$ | 0.0626282 | 0.0606787 | 0.0584229 | 0.0575549 | 0.0569128 |
| When $d_2 \geq d_{20}$, $d_{2m}$ (nm) = | ∞ | ∞ | 6.414 | 35.522 | ∞ |
| When $d_2 < d_{20}$, $d_{2m}$ (nm) = | 26.455 | 72.823 | 13.152 | 13.515 | 11.677 |

1．0＜ＮＡ≦1．1
75＜Ｔ≦85

| Case | 8-11 | 8-12 | 8-13 | 8-14 | 8-15 |
|---|---|---|---|---|---|
| $n_{10}$ | 1.6987335 | 1.6895310 | 1.6997408 | 1.6947661 | 1.6915645 |
| $k_{10}$ | 0.0728489 | 0.0798395 | 0.0628030 | 0.0583146 | 0.0796327 |
| $d_{10}$ (nm) | 224.384 | 207.056 | 221.189 | 215.749 | 269.434 |
| $n_{20}$ | 1.6635130 | 1.6873868 | 1.6972371 | 1.6943199 | 1.7013553 |
| $k_{20}$ | 0.2423517 | 0.2464201 | 0.1976117 | 0.1671130 | 0.3520060 |
| $d_{20}$ (nm) | 141.699 | 160.447 | 197.186 | 258.789 | 90.540 |

| | | 8-11 | 8-12 | 8-13 | 8-14 | 8-15 |
|---|---|---|---|---|---|---|
| When $n_1 \geq n_{10}$, | $n_{1m}=$ | 0.0550525 | 0.0211743 | 0.0680066 | 0.0840710 | 0.0339661 |
| When $n_1 < n_{10}$, | $n_{1m}=$ | 0.0214722 | 0.0563281 | 0.0446484 | 0.0653711 | 0.0319580 |
| When $k_1 \geq k_{10}$, | $k_{1m}=$ | 0.0399634 | 0.0394690 | 0.0462439 | 0.0552136 | 0.0498462 |
| When $k_1 < k_{10}$, | $k_{1m}=$ | 0.0230286 | 0.0247534 | 0.0358582 | 0.0373328 | 0.0319092 |
| When $d_1 \geq d_{10}$, | $d_{1m}$ (nm) $=$ | ∞ | 18.382 | ∞ | ∞ | 29.764 |
| When $d_1 < d_{10}$, | $d_{1m}$ (nm) $=$ | 12.181 | 26.345 | 75.416 | 56.560 | 16.533 |
| When $n_2 \geq n_{20}$, | $n_{2m}=$ | 0.0460742 | 0.1451038 | 0.1164050 | 0.2251794 | 0.2068530 |
| When $n_2 < n_{20}$, | $n_{2m}=$ | 0.0736353 | 0.0531665 | 0.0615222 | 0.1544678 | 0.0982214 |
| When $k_2 \geq k_{20}$, | $k_{2m}=$ | 0.0651685 | 0.0979858 | 0.0980493 | 0.1211584 | 0.1840808 |
| When $k_2 < k_{20}$, | $k_{2m}=$ | 0.0709375 | 0.0696692 | 0.0675049 | 0.0632251 | 0.1287793 |
| When $d_2 \geq d_{20}$, | $d_{2m}$ (nm) $=$ | 17.326 | ∞ | ∞ | ∞ | ∞ |
| When $d_2 < d_{20}$, | $d_{2m}$ (nm) $=$ | 17.676 | 13.280 | 25.586 | 81.223 | 11.833 |

1．0＜ＮＡ≦1．1
75＜Ｔ≦85

| Case | 8-16 | 8-17 |
|---|---|---|
| $n_{10}$ | 1.6950499 | 1.6956172 |
| $k_{10}$ | 0.0706693 | 0.0541668 |
| $d_{10}$ (nm) | 266.123 | 274.905 |
| $n_{20}$ | 1.6983222 | 1.6860233 |
| $k_{20}$ | 0.2573177 | 0.1712439 |
| $d_{20}$ (nm) | 152.851 | 257.337 |

| | | 8-16 | 8-17 |
|---|---|---|---|
| When $n_1 \geq n_{10}$, | $n_{1m}=$ | 0.0524487 | 0.0590308 |
| When $n_1 < n_{10}$, | $n_{1m}=$ | 0.0375452 | 0.0580872 |
| When $k_1 \geq k_{10}$, | $k_{1m}=$ | 0.0517285 | 0.0672278 |
| When $k_1 < k_{10}$, | $k_{1m}=$ | 0.0352881 | 0.0380591 |
| When $d_1 \geq d_{10}$, | $d_{1m}$ (nm) $=$ | ∞ | ∞ |
| When $d_1 < d_{10}$, | $d_{1m}$ (nm) $=$ | 33.771 | 112.404 |
| When $n_2 \geq n_{20}$, | $n_{2m}=$ | 0.2704944 | 0.2806836 |
| When $n_2 < n_{20}$, | $n_{2m}=$ | 0.2755872 | 0.2222266 |
| When $k_2 \geq k_{20}$, | $k_{2m}=$ | 0.2121143 | 0.1985229 |
| When $k_2 < k_{20}$, | $k_{2m}=$ | 0.1128918 | 0.0743774 |
| When $d_2 \geq d_{20}$, | $d_{2m}$ (nm) $=$ | ∞ | ∞ |
| When $d_2 < d_{20}$, | $d_{2m}$ (nm) $=$ | 65.292 | 85.089 |

1. $0 < NA \leq 1.1$
$85 < T \leq 95$

| Case | 9-01 | 9-02 | 9-03 | 9-04 | 9-05 |
|---|---|---|---|---|---|
| $n_{10}$ | 1.8980776 | 1.9078109 | 1.8887573 | 1.8863613 | 1.7283563 |
| $k_{10}$ | 0.2063094 | 0.1489982 | 0.1336370 | 0.0963846 | 0.0991844 |
| $d_{10}$ (nm) | 23.234 | 16.351 | 13.295 | 12.395 | 92.796 |
| $n_{20}$ | 1.8542997 | 1.7325536 | 1.6803356 | 1.7165602 | 1.6494143 |
| $k_{20}$ | 0.6486453 | 0.4126982 | 0.3065809 | 0.2596921 | 0.2975623 |
| $d_{20}$ (nm) | 73.732 | 141.036 | 205.639 | 258.147 | 140.358 |

| | | 9-01 | 9-02 | 9-03 | 9-04 | 9-05 |
|---|---|---|---|---|---|---|
| When $n_1 \geq n_{10}$, | $n_{1m} =$ | 0.0711987 | 0.0870154 | 0.1059106 | 0.1162891 | 0.0375220 |
| When $n_1 < n_{10}$, | $n_{1m} =$ | 0.0384509 | 0.0501709 | 0.0716760 | 0.0832544 | 0.0056213 |
| When $k_1 \geq k_{10}$, | $k_{1m} =$ | 0.0445569 | 0.0643555 | 0.0939661 | 0.1053198 | 0.0189441 |
| When $k_1 < k_{10}$, | $k_{1m} =$ | 0.0730103 | 0.0941223 | 0.1072681 | 0.0963846 | 0.0324854 |
| When $d_1 \geq d_{10}$, | $d_{1m}$ (nm) $=$ | 5.225 | 5.526 | 6.240 | 7.169 | 10.895 |
| When $d_1 < d_{10}$, | $d_{1m}$ (nm) $=$ | 2.347 | 2.839 | 3.908 | 4.670 | 1.261 |
| When $n_2 \geq n_{20}$, | $n_{2m} =$ | 0.1402551 | 0.1159338 | 0.1109766 | 0.1105359 | 0.0179150 |
| When $n_2 < n_{20}$, | $n_{2m} =$ | 0.1828406 | 0.1543176 | 0.1513220 | 0.1539343 | 0.0865198 |
| When $k_2 \geq k_{20}$, | $k_{2m} =$ | 0.2259802 | 0.1235034 | 0.1018750 | 0.1065100 | 0.0230737 |
| When $k_2 < k_{20}$, | $k_{2m} =$ | 0.1284644 | 0.1059631 | 0.0936096 | 0.0878577 | 0.0660486 |
| When $d_2 \geq d_{20}$, | $d_{2m}$ (nm) $=$ | $\infty$ | $\infty$ | $\infty$ | $\infty$ | 14.635 |
| When $d_2 < d_{20}$, | $d_{2m}$ (nm) $=$ | 14.747 | 31.656 | 77.584 | 118.336 | 14.252 |

1. $0 < NA \leq 1.1$
$85 < T \leq 95$

| Case | 9-06 | 9-07 | 9-08 | 9-09 | 9-10 |
|---|---|---|---|---|---|
| $n_{10}$ | 1.7247011 | 1.7288637 | 1.7100270 | 1.7129082 | 1.6894084 |
| $k_{10}$ | 0.0825295 | 0.0727638 | 0.0697395 | 0.0648353 | 0.0825836 |
| $d_{10}$ (nm) | 92.134 | 92.409 | 160.277 | 160.281 | 208.412 |
| $n_{20}$ | 1.6784446 | 1.7181265 | 1.6932584 | 1.7202855 | 1.6911413 |
| $k_{20}$ | 0.2345042 | 0.1997137 | 0.2147807 | 0.1822190 | 0.2636300 |
| $d_{20}$ (nm) | 196.220 | 247.866 | 190.362 | 243.795 | 148.443 |

| | | 9-06 | 9-07 | 9-08 | 9-09 | 9-10 |
|---|---|---|---|---|---|---|
| When $n_1 \geq n_{10}$, | $n_{1m} =$ | 0.0458069 | 0.0520715 | 0.0445874 | 0.0530676 | 0.0168896 |
| When $n_1 < n_{10}$, | $n_{1m} =$ | 0.0231628 | 0.0254517 | 0.0291443 | 0.0189783 | 0.0564331 |
| When $k_1 \geq k_{10}$, | $k_{1m} =$ | 0.0487341 | 0.0524194 | 0.0390308 | 0.0374463 | 0.0317554 |
| When $k_1 < k_{10}$, | $k_{1m} =$ | 0.0471680 | 0.0474573 | 0.0341357 | 0.0249304 | 0.0174866 |
| When $d_1 \geq d_{10}$, | $d_{1m}$ (nm) $=$ | 16.768 | 28.342 | $\infty$ | $\infty$ | 8.653 |
| When $d_1 < d_{10}$, | $d_{1m}$ (nm) $=$ | 5.875 | 6.859 | 8.481 | 5.666 | 22.933 |
| When $n_2 \geq n_{20}$, | $n_{2m} =$ | 0.0654785 | 0.0851550 | 0.0721350 | 0.0992358 | 0.1489941 |
| When $n_2 < n_{20}$, | $n_{2m} =$ | 0.0999084 | 0.1129846 | 0.0702051 | 0.1184961 | 0.0323828 |
| When $k_2 \geq k_{20}$, | $k_{2m} =$ | 0.0550916 | 0.0742688 | 0.0299036 | 0.0348145 | 0.0701428 |
| When $k_2 < k_{20}$, | $k_{2m} =$ | 0.0621350 | 0.0605774 | 0.0564990 | 0.0562878 | 0.0653857 |
| When $d_2 \geq d_{20}$, | $d_{2m}$ (nm) $=$ | $\infty$ | $\infty$ | 30.126 | $\infty$ | $\infty$ |
| When $d_2 < d_{20}$, | $d_{2m}$ (nm) $=$ | 23.369 | 34.214 | 13.997 | 12.255 | 9.630 |

1. $0 < NA \leq 1.1$
$85 < T \leq 95$

| Case | 9-11 | 9-12 | 9-13 | 9-14 | 9-15 |
|---|---|---|---|---|---|
| $n_{10}$ | 1.6987536 | 1.6951804 | 1.6947043 | 1.6953534 | 1.6955317 |
| $k_{10}$ | 0.0651428 | 0.0592977 | 0.0728049 | 0.0654850 | 0.0555447 |
| $d_{10}$ (nm) | 220.679 | 216.421 | 267.049 | 264.587 | 274.968 |
| $n_{20}$ | 1.6918669 | 1.6944812 | 1.7045529 | 1.6939885 | 1.6840742 |
| $k_{20}$ | 0.2062686 | 0.1733276 | 0.2758626 | 0.2171518 | 0.1777252 |
| $d_{20}$ (nm) | 189.869 | 249.686 | 142.407 | 204.731 | 249.243 |

| | | 9-11 | 9-12 | 9-13 | 9-14 | 9-15 |
|---|---|---|---|---|---|---|
| When $n_1 \geq n_{10}$, | $n_{1m} =$ | 0.0676538 | 0.0804553 | 0.0514111 | 0.0772083 | 0.0594299 |
| When $n_1 < n_{10}$, | $n_{1m} =$ | 0.0423462 | 0.0620581 | 0.0375159 | 0.0498364 | 0.0587244 |
| When $k_1 \geq k_{10}$, | $k_{1m} =$ | 0.0442505 | 0.0538220 | 0.0506982 | 0.0550830 | 0.0658191 |
| When $k_1 < k_{10}$, | $k_{1m} =$ | 0.0341040 | 0.0375916 | 0.0340894 | 0.0384644 | 0.0372644 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 72.990 | 57.440 | 26.805 | 108.871 | 112.765 |
| When $n_2 \geq n_{20}$, | $n_{2m} =$ | 0.1307581 | 0.2319055 | 0.2365918 | 0.3979211 | 0.2850439 |
| When $n_2 < n_{20}$, | $n_{2m} =$ | 0.0673376 | 0.1520984 | 0.2827087 | 0.2359326 | 0.2177148 |
| When $k_2 \geq k_{20}$, | $k_{2m} =$ | 0.0940100 | 0.1156787 | 0.2079443 | 0.2187415 | 0.1980774 |
| When $k_2 < k_{20}$, | $k_{2m} =$ | 0.0673755 | 0.0629675 | 0.1183691 | 0.0982336 | 0.0755945 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 25.557 | 76.954 | 64.091 | 75.273 | 81.971 |

1. $0 < NA \leq 1.1$
$95 < T \leq 105$

| Case | 10-01 | 10-02 | 10-03 | 10-04 | 10-05 |
|---|---|---|---|---|---|
| $n_{10}$ | 1.9059589 | 1.9224042 | 1.8961620 | 1.8922593 | 1.7254583 |
| $k_{10}$ | 0.2274286 | 0.1550778 | 0.1385328 | 0.1041345 | 0.0865833 |
| $d_{10}$ (nm) | 23.462 | 16.599 | 13.501 | 12.282 | 91.876 |
| $n_{20}$ | 1.8553331 | 1.7510181 | 1.6829419 | 1.7097147 | 1.6727903 |
| $k_{20}$ | 0.7355051 | 0.4490690 | 0.3248659 | 0.2697702 | 0.2465542 |
| $d_{20}$ (nm) | 66.090 | 131.424 | 196.767 | 251.116 | 188.519 |

| | | 10-01 | 10-02 | 10-03 | 10-04 | 10-05 |
|---|---|---|---|---|---|---|
| When $n_1 \geq n_{10}$, | $n_{1m} =$ | 0.0671912 | 0.0841919 | 0.1023767 | 0.1153796 | 0.0426331 |
| When $n_1 < n_{10}$, | $n_{1m} =$ | 0.0345654 | 0.0474304 | 0.0675305 | 0.0814563 | 0.0184045 |
| When $k_1 \geq k_{10}$, | $k_{1m} =$ | 0.0380615 | 0.0598425 | 0.0894568 | 0.1045068 | 0.0426917 |
| When $k_1 < k_{10}$, | $k_{1m} =$ | 0.0683374 | 0.0902014 | 0.1054456 | 0.1041345 | 0.0441687 |
| When $d_1 \geq d_{10}$, | $d_{1m}$ (nm) $=$ | 4.558 | 5.118 | 5.874 | 6.783 | 14.297 |
| When $d_1 < d_{10}$, | $d_{1m}$ (nm) $=$ | 1.985 | 2.531 | 3.589 | 4.355 | 4.476 |
| When $n_2 \geq n_{20}$, | $n_{2m} =$ | 0.1216980 | 0.1117603 | 0.1100940 | 0.1104114 | 0.0579919 |
| When $n_2 < n_{20}$, | $n_{2m} =$ | 0.1802991 | 0.1554016 | 0.1498889 | 0.1534180 | 0.0956348 |
| When $k_2 \geq k_{20}$, | $k_{2m} =$ | 0.2165979 | 0.1264526 | 0.1015808 | 0.1042908 | 0.0462366 |
| When $k_2 < k_{20}$, | $k_{2m} =$ | 0.1276270 | 0.1054065 | 0.0937561 | 0.0879675 | 0.0605090 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 11.858 | 29.189 | 73.755 | 91.689 | 21.669 |

1. 0 < N A ≤ 1. 1
9 5 < T ≤ 1 0 5

| Case | 10–06 | 10–07 | 10–08 | 10–09 | 10–10 |
|---|---|---|---|---|---|
| $n_{10}$ | 1.7286512 | 1.7096319 | 1.7125109 | 1.6891198 | 1.6979687 |
| $k_{10}$ | 0.0752622 | 0.0728333 | 0.0665034 | 0.0853163 | 0.0677690 |
| $d_{10}$ (nm) | 92.185 | 159.923 | 159.852 | 208.173 | 220.140 |
| $n_{20}$ | 1.7137581 | 1.6877059 | 1.7181911 | 1.6918411 | 1.6871092 |
| $k_{20}$ | 0.2076205 | 0.2252670 | 0.1890952 | 0.2826173 | 0.2165239 |
| $d_{20}$ (nm) | 240.302 | 182.766 | 235.934 | 141.112 | 182.186 |

| | | 10–06 | 10–07 | 10–08 | 10–09 | 10–10 |
|---|---|---|---|---|---|---|
| When $n_1 \geq n_{10}$, | $n_{1m}=$ | 0.0500330 | 0.0406897 | 0.0503772 | 0.0132690 | 0.0644641 |
| When $n_1 < n_{10}$, | $n_{1m}=$ | 0.0231873 | 0.0169287 | 0.0155139 | 0.0507471 | 0.0375525 |
| When $k_1 \geq k_{10}$, | $k_{1m}=$ | 0.0495398 | 0.0307520 | 0.0335327 | 0.0250305 | 0.0414893 |
| When $k_1 < k_{10}$, | $k_{1m}=$ | 0.0465039 | 0.0291895 | 0.0230286 | 0.0142859 | 0.0317957 |
| When $d_1 \geq d_{10}$, | $d_{1m}$ (nm) $=$ | 22.149 | ∞ | ∞ | 5.803 | ∞ |
| When $d_1 < d_{10}$, | $d_{1m}$ (nm) $=$ | 6.093 | 5.010 | 4.544 | 20.171 | 66.095 |
| When $n_2 \geq n_{20}$, | $n_{2m}=$ | 0.0807422 | 0.0673730 | 0.0968713 | 0.1414526 | 0.1231934 |
| When $n_2 < n_{20}$, | $n_{2m}=$ | 0.1109875 | 0.0569836 | 0.1140344 | 0.0176575 | 0.0690576 |
| When $k_2 \geq k_{20}$, | $k_{2m}=$ | 0.0671313 | 0.0201965 | 0.0272949 | 0.0516113 | 0.0909106 |
| When $k_2 < k_{20}$, | $k_{2m}=$ | 0.0601733 | 0.0546924 | 0.0555640 | 0.0644128 | 0.0681702 |
| When $d_2 \geq d_{20}$, | $d_{2m}$ (nm) $=$ | ∞ | 22.678 | ∞ | ∞ | ∞ |
| When $d_2 < d_{20}$, | $d_{2m}$ (nm) $=$ | 33.234 | 12.401 | 9.751 | 3.545 | 24.752 |

1. 0 < N A ≤ 1. 1
9 5 < T ≤ 1 0 5

| Case | 10–11 | 10–12 | 10–13 |
|---|---|---|---|
| $n_{10}$ | 1.6953920 | 1.6945041 | 1.6957904 |
| $k_{10}$ | 0.0607310 | 0.0754015 | 0.0613078 |
| $d_{10}$ (nm) | 216.694 | 266.879 | 263.111 |
| $n_{20}$ | 1.6943518 | 1.7053190 | 1.6921380 |
| $k_{20}$ | 0.1805507 | 0.2962459 | 0.1886276 |
| $d_{20}$ (nm) | 240.824 | 134.581 | 257.166 |

| | | 10–11 | 10–12 | 10–13 |
|---|---|---|---|---|
| When $n_1 \geq n_{10}$, | $n_{1m}=$ | 0.0773376 | 0.0489661 | 0.0744116 |
| When $n_1 < n_{10}$, | $n_{1m}=$ | 0.0532397 | 0.0362244 | 0.0544775 |
| When $k_1 \geq k_{10}$, | $k_{1m}=$ | 0.0520667 | 0.0490686 | 0.0595886 |
| When $k_1 < k_{10}$, | $k_{1m}=$ | 0.0373279 | 0.0329797 | 0.0399255 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 56.748 | 22.698 | 144.280 |
| When $n_2 \geq n_{20}$, | $n_{2m}=$ | 0.2401196 | 0.2258960 | 0.3617542 |
| When $n_2 < n_{20}$, | $n_{2m}=$ | 0.1505750 | 0.2863916 | 0.2146826 |
| When $k_2 \geq k_{20}$, | $k_{2m}=$ | 0.1118237 | 0.2042285 | 0.2258594 |
| When $k_2 < k_{20}$, | $k_{2m}=$ | 0.0641272 | 0.1247363 | 0.0874829 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 74.466 | 22.579 | 121.018 |

1. $0 < NA \leq 1.1$
$105 < T \leq 115$

| Case | 11-01 | 11-02 | 11-03 | 11-04 | 11-05 |
|---|---|---|---|---|---|
| $n_{10}$ | 1.9374125 | 1.9018997 | 1.8965439 | 1.7253637 | 1.7289764 |
| $k_{10}$ | 0.1704110 | 0.1487976 | 0.1142225 | 0.0900184 | 0.0775142 |
| $d_{10}$ (nm) | 15.669 | 13.285 | 11.973 | 91.432 | 91.877 |
| $n_{20}$ | 1.7248980 | 1.6713435 | 1.6970963 | 1.6651786 | 1.7120256 |
| $k_{20}$ | 0.4663738 | 0.3352808 | 0.2748315 | 0.2549499 | 0.2134557 |
| $d_{20}$ (nm) | 126.299 | 189.496 | 244.759 | 180.505 | 231.728 |

| | | 11-01 | 11-02 | 11-03 | 11-04 | 11-05 |
|---|---|---|---|---|---|---|
| When $n_1 \geq n_{10}$, | $n_{1m} =$ | 0.0844495 | 0.1011877 | 0.1161206 | 0.0397363 | 0.0483887 |
| When $n_1 < n_{10}$, | $n_{1m} =$ | 0.0440234 | 0.0656897 | 0.0810999 | 0.0155029 | 0.0208545 |
| When $k_1 \geq k_{10}$, | $k_{1m} =$ | 0.0577478 | 0.0888123 | 0.1065247 | 0.0388269 | 0.0469031 |
| When $k_1 < k_{10}$, | $k_{1m} =$ | 0.0914417 | 0.1045447 | 0.1142225 | 0.0417639 | 0.0449243 |
| When $d_1 \geq d_{10}$, | $d_{1m}$ (nm) $=$ | 4.564 | 5.473 | 6.423 | 12.314 | 18.889 |
| When $d_1 < d_{10}$, | $d_{1m}$ (nm) $=$ | 2.111 | 3.313 | 4.088 | 3.639 | 5.309 |
| When $n_2 \geq n_{20}$, | $n_{2m} =$ | 0.1026855 | 0.1066711 | 0.1092859 | 0.0538538 | 0.0798657 |
| When $n_2 < n_{20}$, | $n_{2m} =$ | 0.1573315 | 0.1496814 | 0.1507874 | 0.0957056 | 0.1124231 |
| When $k_2 \geq k_{20}$, | $k_{2m} =$ | 0.1109265 | 0.0973877 | 0.1006897 | 0.0382251 | 0.0609106 |
| When $k_2 < k_{20}$, | $k_{2m} =$ | 0.0995313 | 0.0917126 | 0.0869214 | 0.0582397 | 0.0599487 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 32.204 | 71.551 | 94.669 | 21.979 | 35.901 |

1. $0 < NA \leq 1.1$
$105 < T \leq 115$

| Case | 11-06 | 11-07 | 11-08 | 11-09 | 11-10 |
|---|---|---|---|---|---|
| $n_{10}$ | 1.7092919 | 1.7124011 | 1.6891266 | 1.6977739 | 1.6952347 |
| $k_{10}$ | 0.0753499 | 0.0683625 | 0.0867081 | 0.0698574 | 0.0623107 |
| $d_{10}$ (nm) | 159.318 | 159.365 | 206.818 | 219.869 | 216.627 |
| $n_{20}$ | 1.6830351 | 1.7169838 | 1.6858604 | 1.6842611 | 1.6937881 |
| $k_{20}$ | 0.2331189 | 0.1941891 | 0.2953498 | 0.2258219 | 0.1869159 |
| $d_{20}$ (nm) | 174.468 | 227.412 | 138.155 | 173.345 | 231.738 |

| | | 11-06 | 11-07 | 11-08 | 11-09 | 11-10 |
|---|---|---|---|---|---|---|
| When $n_1 \geq n_{10}$, | $n_{1m} =$ | 0.0373157 | 0.0484546 | 0.0121899 | 0.0603870 | 0.0758545 |
| When $n_1 < n_{10}$, | $n_{1m} =$ | 0.0105005 | 0.0089343 | 0.0409204 | 0.0315625 | 0.0474512 |
| When $k_1 \geq k_{10}$, | $k_{1m} =$ | 0.0240833 | 0.0270752 | 0.0251843 | 0.0382471 | 0.0501941 |
| When $k_1 < k_{10}$, | $k_{1m} =$ | 0.0246826 | 0.0176978 | 0.0193188 | 0.0296948 | 0.0358765 |
| When $d_1 \geq d_{10}$, | $d_{1m}$ (nm) $=$ | 22.059 | ∞ | 5.261 | ∞ | ∞ |
| When $d_1 < d_{10}$, | $d_{1m}$ (nm) $=$ | 3.023 | 2.568 | 16.255 | 17.363 | 54.608 |
| When $n_2 \geq n_{20}$, | $n_{2m} =$ | 0.0659399 | 0.0944360 | 0.1154346 | 0.0831506 | 0.2493335 |
| When $n_2 < n_{20}$, | $n_{2m} =$ | 0.0371252 | 0.1164661 | 0.0185925 | 0.0632410 | 0.1310596 |
| When $k_2 \geq k_{20}$, | $k_{2m} =$ | 0.0133044 | 0.0180847 | 0.0609753 | 0.0891687 | 0.1103210 |
| When $k_2 < k_{20}$, | $k_{2m} =$ | 0.0529578 | 0.0555518 | 0.0785950 | 0.0680151 | 0.0652307 |
| When $d_2 \geq d_{20}$, | $d_{2m}$ (nm) $=$ | 18.030 | ∞ | ∞ | ∞ | ∞ |
| When $d_2 < d_{20}$, | $d_{2m}$ (nm) $=$ | 8.732 | 5.378 | 3.627 | 23.361 | 52.894 |

1. 0 < NA ≤ 1. 1
105 < T ≤ 115

| Case | 11-11 | 11-12 |
|---|---|---|
| $n_{10}$ | 1.6944699 | 1.6958800 |
| $k_{10}$ | 0.0775933 | 0.0528961 |
| $d_{10}$ (nm) | 265.762 | 273.317 |
| $n_{20}$ | 1.6967397 | 1.6915993 |
| $k_{20}$ | 0.3115846 | 0.1649138 |
| $d_{20}$ (nm) | 129.093 | 288.010 |

| | | 11-11 | 11-12 |
|---|---|---|---|
| When $n_1 \geq n_{10}$, | $n_{1m} =$ | 0.0466345 | 0.0703040 |
| When $n_1 < n_{10}$, | $n_{1m} =$ | 0.0341467 | 0.0549121 |
| When $k_1 \geq k_{10}$, | $k_{1m} =$ | 0.0473621 | 0.0679175 |
| When $k_1 < k_{10}$, | $k_{1m} =$ | 0.0320862 | 0.0389246 |
| When $d_1 \geq d_{10}$, | $d_{1m}$ (nm) = | ∞ | ∞ |
| When $d_1 < d_{10}$, | $d_{1m}$ (nm) = | 20.031 | 180.011 |
| When $n_2 \geq n_{20}$, | $n_{2m} =$ | 0.2202100 | 0.2749866 |
| When $n_2 < n_{20}$, | $n_{2m} =$ | 0.1339246 | 0.2056653 |
| When $k_2 \geq k_{20}$, | $k_{2m} =$ | 0.2018127 | 0.2031665 |
| When $k_2 < k_{20}$, | $k_{2m} =$ | 0.1244751 | 0.0729272 |
| When $d_2 \geq d_{20}$, | $d_{2m}$ (nm) = | ∞ | ∞ |
| When $d_2 < d_{20}$, | $d_{2m}$ (nm) = | 18.618 | 105.982 |

1. 0 < NA ≤ 1. 1
115 < T ≤ 125

| Case | 12-01 | 12-02 | 12-03 | 12-04 | 12-05 |
|---|---|---|---|---|---|
| $n_{10}$ | 1.9729972 | 1.9456051 | 1.9005953 | 1.8972956 | 1.7255330 |
| $k_{10}$ | 0.2768129 | 0.1915481 | 0.1591490 | 0.1121564 | 0.0922673 |
| $d_{10}$ (nm) | 17.524 | 14.612 | 13.217 | 12.290 | 91.102 |
| $n_{20}$ | 1.6663342 | 1.6781309 | 1.6561276 | 1.7051607 | 1.6614760 |
| $k_{20}$ | 0.7544777 | 0.4665054 | 0.3399716 | 0.2822449 | 0.2607016 |
| $d_{20}$ (nm) | 64.842 | 122.845 | 181.593 | 233.141 | 171.070 |

| | | 12-01 | 12-02 | 12-03 | 12-04 | 12-05 |
|---|---|---|---|---|---|---|
| When $n_1 \geq n_{10}$, | $n_{1m} =$ | 0.0730835 | 0.0862573 | 0.1002148 | 0.1132361 | 0.0385791 |
| When $n_1 < n_{10}$, | $n_{1m} =$ | 0.0179053 | 0.0397437 | 0.0650696 | 0.0790137 | 0.0152405 |
| When $k_1 \geq k_{10}$, | $k_{1m} =$ | 0.0247314 | 0.0556897 | 0.0891748 | 0.1035071 | 0.0386047 |
| When $k_1 < k_{10}$, | $k_{1m} =$ | 0.0592480 | 0.0960681 | 0.1016016 | 0.1121564 | 0.0414185 |
| When $d_1 \geq d_{10}$, | $d_{1m}$ (nm) = | 2.961 | 4.145 | 5.266 | 6.373 | 11.328 |
| When $d_1 < d_{10}$, | $d_{1m}$ (nm) = | 0.729 | 1.739 | 3.220 | 4.072 | 3.483 |
| When $n_2 \geq n_{20}$, | $n_{2m} =$ | 0.0585083 | 0.0918945 | 0.1020654 | 0.1070825 | 0.0573608 |
| When $n_2 < n_{20}$, | $n_{2m} =$ | 0.1382239 | 0.1611719 | 0.1504858 | 0.1560303 | 0.0993860 |
| When $k_2 \geq k_{20}$, | $k_{2m} =$ | 0.0616943 | 0.0914514 | 0.0935474 | 0.1016602 | 0.0359058 |
| When $k_2 < k_{20}$, | $k_{2m} =$ | 0.0899731 | 0.0957678 | 0.0910632 | 0.0886353 | 0.0590588 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 11.368 | 38.474 | 71.143 | 98.322 | 22.477 |

1. 0 < N A ≤ 1. 1
1 1 5 < T ≤ 1 2 5

| Case | 12–06 | 12–07 | 12–08 | 12–09 | 12–10 |
|---|---|---|---|---|---|
| $n_{10}$ | 1.7304964 | 1.7097843 | 1.7129025 | 1.7059734 | 1.6983193 |
| $k_{10}$ | 0.0792452 | 0.0770210 | 0.0702809 | 0.0642321 | 0.0712405 |
| $d_{10}$ (nm) | 91.709 | 159.025 | 159.249 | 159.600 | 220.143 |
| $n_{20}$ | 1.7154952 | 1.6841289 | 1.7178163 | 1.6898319 | 1.6860819 |
| $k_{20}$ | 0.2175998 | 0.2392980 | 0.1978132 | 0.1677546 | 0.2336364 |
| $d_{20}$ (nm) | 221.560 | 164.463 | 217.770 | 279.371 | 162.903 |

| | | 12–06 | 12–07 | 12–08 | 12–09 | 12–10 |
|---|---|---|---|---|---|---|
| When $n_1 \geq n_{10}$, | $n_{1m} =$ | 0.0478430 | 0.0358972 | 0.0479553 | 0.0552173 | 0.0579871 |
| When $n_1 < n_{10}$, | $n_{1m} =$ | 0.0188013 | 0.0078589 | 0.0015247 | 0.0299426 | 0.0264917 |
| When $k_1 \geq k_{10}$, | $k_{1m} =$ | 0.0447290 | 0.0214099 | 0.0152087 | 0.0363110 | 0.0340515 |
| When $k_1 < k_{10}$, | $k_{1m} =$ | 0.0430518 | 0.0224402 | 0.0060950 | 0.0278772 | 0.0279150 |
| When $d_1 \geq d_{10}$, | $d_{1m}$ (nm) $=$ | 17.323 | 17.500 | ∞ | ∞ | ∞ |
| When $d_1 < d_{10}$, | $d_{1m}$ (nm) $=$ | 4.626 | 2.208 | 0.436 | 70.406 | 11.462 |
| When $n_2 \geq n_{20}$, | $n_{2m} =$ | 0.0842468 | 0.0631323 | 0.0959070 | 0.1382263 | 0.0682983 |
| When $n_2 < n_{20}$, | $n_{2m} =$ | 0.1172522 | 0.0247583 | 0.0076807 | 0.1296057 | 0.0493762 |
| When $k_2 \geq k_{20}$, | $k_{2m} =$ | 0.0583887 | 0.0111536 | 0.0046545 | 0.0357849 | 0.0882227 |
| When $k_2 < k_{20}$, | $k_{2m} =$ | 0.0618323 | 0.0547961 | 0.0579968 | 0.0540967 | 0.0613330 |
| When $d_2 \geq d_{20}$, | $d_{2m}$ (nm) $=$ | ∞ | 18.428 | ∞ | ∞ | ∞ |
| When $d_2 < d_{20}$, | $d_{2m}$ (nm) $=$ | 65.102 | 5.436 | 0.894 | 57.180 | 18.177 |

1. 0 < N A ≤ 1. 1
1 1 5 < T ≤ 1 2 5

| Case | 12–11 | 12–12 | 12–13 |
|---|---|---|---|
| $n_{10}$ | 1.6946755 | 1.6955425 | 1.6956989 |
| $k_{10}$ | 0.0639503 | 0.0535782 | 0.0539885 |
| $d_{10}$ (nm) | 216.344 | 213.248 | 272.929 |
| $n_{20}$ | 1.6931001 | 1.6937343 | 1.6917939 |
| $k_{20}$ | 0.1919118 | 0.1415462 | 0.1683287 |
| $d_{20}$ (nm) | 222.331 | 338.947 | 278.327 |

| | | 12–11 | 12–12 | 12–13 |
|---|---|---|---|---|
| When $n_1 \geq n_{10}$, | $n_{1m} =$ | 0.0359900 | 0.0869177 | 0.0714185 |
| When $n_1 < n_{10}$, | $n_{1m} =$ | 0.0437024 | 0.0750378 | 0.0538635 |
| When $k_1 \geq k_{10}$, | $k_{1m} =$ | 0.0485352 | 0.0653857 | 0.0669263 |
| When $k_1 < k_{10}$, | $k_{1m} =$ | 0.0346851 | 0.0370959 | 0.0388916 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 51.791 | 132.178 | 120.018 |
| When $n_2 \geq n_{20}$, | $n_{2m} =$ | 0.1409949 | 0.2291467 | 0.2819873 |
| When $n_2 < n_{20}$, | $n_{2m} =$ | 0.1060889 | 0.1273120 | 0.2087952 |
| When $k_2 \geq k_{20}$, | $k_{2m} =$ | 0.1109827 | 0.1363989 | 0.2069556 |
| When $k_2 < k_{20}$, | $k_{2m} =$ | 0.0639978 | 0.0571204 | 0.0743250 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 35.182 | 107.512 | 95.030 |

1. 0 < N A ≤ 1. 1

1 2 5 < T ≤ 1 3 5

| Case | 13-01 | 13-02 | 13-03 | 13-04 | 13-05 |
|---|---|---|---|---|---|
| $n_{10}$ | 1.8993435 | 1.9080238 | 1.7276770 | 1.7338076 | 1.7236449 |
| $k_{10}$ | 0.1093669 | 0.0778133 | 0.0934541 | 0.0808022 | 0.0736298 |
| $d_{10}$ (nm) | 12.638 | 11.189 | 91.210 | 91.869 | 92.640 |
| $n_{20}$ | 1.7156529 | 1.7380285 | 1.6689251 | 1.7256843 | 1.7007078 |
| $k_{20}$ | 0.2903108 | 0.2474831 | 0.2700133 | 0.2232282 | 0.1887087 |
| $d_{20}$ (nm) | 220.942 | 275.866 | 159.348 | 209.944 | 271.148 |

| | | 13-01 | 13-02 | 13-03 | 13-04 | 13-05 |
|---|---|---|---|---|---|---|
| When $n_1 \geq n_{10}$, | $n_{1m} =$ | 0.1116663 | 0.1266492 | 0.0395422 | 0.0484558 | 0.0522583 |
| When $n_1 < n_{10}$, | $n_{1m} =$ | 0.0773999 | 0.0872168 | 0.0167297 | 0.0166711 | 0.0180103 |
| When $k_1 \geq k_{10}$, | $k_{1m} =$ | 0.1011877 | 0.1103088 | 0.0409973 | 0.0422058 | 0.0417761 |
| When $k_1 < k_{10}$, | $k_{1m} =$ | 0.1093669 | 0.0778133 | 0.0410583 | 0.0409119 | 0.0443518 |
| When $d_1 \geq d_{10}$, | $d_{1m}$ (nm) $=$ | 6.392 | 6.737 | 11.272 | 16.895 | 38.105 |
| When $d_1 < d_{10}$, | $d_{1m}$ (nm) $=$ | 4.063 | 4.214 | 3.733 | 3.952 | 5.177 |
| When $n_2 \geq n_{20}$, | $n_{2m} =$ | 0.1069678 | 0.1140796 | 0.0675769 | 0.0924780 | 0.1134937 |
| When $n_2 < n_{20}$, | $n_{2m} =$ | 0.1606714 | 0.1563965 | 0.1033667 | 0.1197949 | 0.1230200 |
| When $k_2 \geq k_{20}$, | $k_{2m} =$ | 0.1040991 | 0.1083496 | 0.0397278 | 0.0600330 | 0.0739392 |
| When $k_2 < k_{20}$, | $k_{2m} =$ | 0.0926990 | 0.0882825 | 0.0652539 | 0.0659766 | 0.0617065 |
| When $d_2 \geq d_{20}$, | $d_{2m}$ (nm) $=$ | ∞ | ∞ | 29.488 | ∞ | ∞ |
| When $d_2 < d_{20}$, | $d_{2m}$ (nm) $=$ | 90.398 | 130.978 | 17.688 | 16.714 | 72.265 |

1. 0 < N A ≤ 1. 1

1 2 5 < T ≤ 1 3 5

| Case | 13-06 | 13-07 | 13-08 | 13-09 | 13-10 |
|---|---|---|---|---|---|
| $n_{10}$ | 1.7117973 | 1.7052523 | 1.6990979 | 1.6936455 | 1.6937228 |
| $k_{10}$ | 0.0782334 | 0.0648564 | 0.0723627 | 0.0657466 | 0.0602088 |
| $d_{10}$ (nm) | 159.412 | 160.141 | 220.761 | 215.539 | 212.854 |
| $n_{20}$ | 1.6949465 | 1.6847092 | 1.6931390 | 1.6916565 | 1.6917935 |
| $k_{20}$ | 0.2480962 | 0.1699839 | 0.2421156 | 0.1962143 | 0.1651159 |
| $d_{20}$ (nm) | 152.577 | 269.827 | 151.650 | 213.597 | 273.449 |

| | | 13-06 | 13-07 | 13-08 | 13-09 | 13-10 |
|---|---|---|---|---|---|---|
| When $n_1 \geq n_{10}$, | $n_{1m} =$ | 0.0367346 | 0.0551233 | 0.0594092 | 0.0311401 | 0.0698511 |
| When $n_1 < n_{10}$, | $n_{1m} =$ | 0.0058984 | 0.0239478 | 0.0244397 | 0.0431714 | 0.0693030 |
| When $k_1 \geq k_{10}$, | $k_{1m} =$ | 0.0206287 | 0.0370862 | 0.0278687 | 0.0476123 | 0.0598901 |
| When $k_1 < k_{10}$, | $k_{1m} =$ | 0.0197803 | 0.0307031 | 0.0272107 | 0.0341650 | 0.0364880 |
| When $d_1 \geq d_{10}$, | $d_{1m}$ (nm) $=$ | 17.175 | ∞ | ∞ | ∞ | ∞ |
| When $d_1 < d_{10}$, | $d_{1m}$ (nm) $=$ | 1.642 | 10.322 | 10.135 | 48.593 | 59.568 |
| When $n_2 \geq n_{20}$, | $n_{2m} =$ | 0.0634509 | 0.0441370 | 0.0646301 | 0.1417163 | 0.2349500 |
| When $n_2 < n_{20}$, | $n_{2m} =$ | 0.0185107 | 0.1268359 | 0.0304773 | 0.0878235 | 0.1413928 |
| When $k_2 \geq k_{20}$, | $k_{2m} =$ | 0.0106982 | 0.0374109 | 0.0871985 | 0.1142444 | 0.1311609 |
| When $k_2 < k_{20}$, | $k_{2m} =$ | 0.0614368 | 0.0554883 | 0.0573535 | 0.0648792 | 0.0616370 |
| When $d_2 \geq d_{20}$, | $d_{2m}$ (nm) $=$ | 20.867 | ∞ | ∞ | ∞ | ∞ |
| When $d_2 < d_{20}$, | $d_{2m}$ (nm) $=$ | 3.236 | 51.950 | 7.977 | 23.183 | 75.250 |

1. $0 < NA \leq 1.1$

$125 < T \leq 135$

| Case | 13-11 |
|---|---|
| $n_{10}$ | 1.6954835 |
| $k_{10}$ | 0.0549286 |
| $d_{10}$ (nm) | 272.481 |
| $n_{20}$ | 1.6920522 |
| $k_{20}$ | 0.1709440 |
| $d_{20}$ (nm) | 269.018 |

| | | 13-11 |
|---|---|---|
| When $n_1 \geq n_{10}$, | $n_{1m} =$ | 0.0732507 |
| When $n_1 < n_{10}$, | $n_{1m} =$ | 0.0527002 |
| When $k_1 \geq k_{10}$, | $k_{1m} =$ | 0.0659570 |
| When $k_1 < k_{10}$, | $k_{1m} =$ | 0.0396948 |
| When $d_1 \geq d_{10}$, | $d_{1m}$ (nm) $=$ | $\infty$ |
| When $d_1 < d_{10}$, | $d_{1m}$ (nm) $=$ | 115.848 |
| When $n_2 \geq n_{20}$, | $n_{2m} =$ | 0.2876270 |
| When $n_2 < n_{20}$, | $n_{2m} =$ | 0.2123071 |
| When $k_2 \geq k_{20}$, | $k_{2m} =$ | 0.2114355 |
| When $k_2 < k_{20}$, | $k_{2m} =$ | 0.0767078 |
| When $d_2 \geq d_{20}$, | $d_{2m}$ (nm) $=$ | $\infty$ |
| When $d_2 < d_{20}$, | $d_{2m}$ (nm) $=$ | 91.957 |

1. $0 < NA \leq 1.1$

$135 < T \leq 145$

| Case | 14-01 | 14-02 | 14-03 | 14-04 | 14-05 |
|---|---|---|---|---|---|
| $n_{10}$ | 1.9117383 | 1.8981283 | 1.9112943 | 1.7312914 | 1.7377087 |
| $k_{10}$ | 0.2302052 | 0.1070787 | 0.0649623 | 0.0945058 | 0.0827928 |
| $d_{10}$ (nm) | 15.980 | 13.384 | 12.163 | 91.544 | 92.151 |
| $n_{20}$ | 1.5953517 | 1.7296497 | 1.7710787 | 1.6819509 | 1.7372931 |
| $k_{20}$ | 0.4940730 | 0.3022759 | 0.2605013 | 0.2846338 | 0.2321492 |
| $d_{20}$ (nm) | 105.368 | 209.053 | 259.824 | 147.702 | 198.983 |

| | | 14-01 | 14-02 | 14-03 | 14-04 | 14-05 |
|---|---|---|---|---|---|---|
| When $n_1 \geq n_{10}$, | $n_{1m} =$ | 0.0781360 | 0.1075745 | 0.1181738 | 0.0408386 | 0.0487402 |
| When $n_1 < n_{10}$, | $n_{1m} =$ | 0.0319177 | 0.0739868 | 0.0809961 | 0.0177930 | 0.0144653 |
| When $k_1 \geq k_{10}$, | $k_{1m} =$ | 0.0436902 | 0.0964282 | 0.0995044 | 0.0430859 | 0.0389966 |
| When $k_1 < k_{10}$, | $k_{1m} =$ | 0.0819202 | 0.1070787 | 0.0649623 | 0.0421533 | 0.0388171 |
| When $d_1 \geq d_{10}$, | $d_{1m}$ (nm) $=$ | 3.898 | 6.524 | 6.747 | 11.475 | 16.758 |
| When $d_1 < d_{10}$, | $d_{1m}$ (nm) $=$ | 1.590 | 4.095 | 4.185 | 3.862 | 3.299 |
| When $n_2 \geq n_{20}$, | $n_{2m} =$ | 0.0627563 | 0.1085400 | 0.1152271 | 0.0712305 | 0.0983997 |
| When $n_2 < n_{20}$, | $n_{2m} =$ | 0.1565955 | 0.1599133 | 0.1627686 | 0.1038867 | 0.1174939 |
| When $k_2 \geq k_{20}$, | $k_{2m} =$ | 0.0810010 | 0.1085132 | 0.1160754 | 0.0447900 | 0.0617737 |
| When $k_2 < k_{20}$, | $k_{2m} =$ | 0.1061572 | 0.0966113 | 0.0915161 | 0.0720264 | 0.0692358 |
| When $d_2 \geq d_{20}$, | $d_{2m}$ (nm) $=$ | $\infty$ | $\infty$ | $\infty$ | 26.800 | $\infty$ |
| When $d_2 < d_{20}$, | $d_{2m}$ (nm) $=$ | 27.538 | 81.885 | 123.147 | 14.572 | 12.208 |

1. 0 < N A ≤ 1. 1
1 3 5 < T ≤ 1 4 5

| Case | 14−06 | 14−07 | 14−08 | 14−09 | 14−10 |
|---|---|---|---|---|---|
| $n_{10}$ | 1.7228203 | 1.7144911 | 1.7050797 | 1.6925663 | 1.6991742 |
| $k_{10}$ | 0.0749158 | 0.0796518 | 0.0657099 | 0.0675694 | 0.0739382 |
| $d_{10}$ (nm) | 92.874 | 160.015 | 160.534 | 214.049 | 220.936 |
| $n_{20}$ | 1.6951594 | 1.7090445 | 1.6817729 | 1.6900690 | 1.6992675 |
| $k_{20}$ | 0.1935801 | 0.2610315 | 0.1743389 | 0.2005073 | 0.2525134 |
| $d_{20}$ (nm) | 262.590 | 141.223 | 260.739 | 206.287 | 141.832 |

| | | 14−06 | 14−07 | 14−08 | 14−09 | 14−10 |
|---|---|---|---|---|---|---|
| When $n_1 \geq n_{10}$, | $n_{1m} =$ | 0.0517419 | 0.0380176 | 0.0550000 | 0.0300269 | 0.0099573 |
| When $n_1 < n_{10}$, | $n_{1m} =$ | 0.0171826 | 0.0033435 | 0.0205762 | 0.0461255 | 0.0255640 |
| When $k_1 \geq k_{10}$, | $k_{1m} =$ | 0.0402747 | 0.0176941 | 0.0369080 | 0.0452966 | 0.0196790 |
| When $k_1 < k_{10}$, | $k_{1m} =$ | 0.0440662 | 0.0145313 | 0.0289917 | 0.0339844 | 0.0188269 |
| When $d_1 \geq d_{10}$, | $d_{1m}$ (nm) $=$ | 34.339 | 18.702 | ∞ | ∞ | ∞ |
| When $d_1 < d_{10}$, | $d_{1m}$ (nm) $=$ | 4.946 | 0.924 | 8.433 | 45.536 | 10.412 |
| When $n_2 \geq n_{20}$, | $n_{2m} =$ | 0.1089246 | 0.0638684 | 0.0364478 | 0.1628357 | 0.0605127 |
| When $n_2 < n_{20}$, | $n_{2m} =$ | 0.1178552 | 0.0117664 | 0.1214197 | 0.0809363 | 0.0143933 |
| When $k_2 \geq k_{20}$, | $k_{2m} =$ | 0.0721460 | 0.0078210 | 0.0372485 | 0.1200403 | 0.0864673 |
| When $k_2 < k_{20}$, | $k_{2m} =$ | 0.0629919 | 0.0624194 | 0.0562036 | 0.0635217 | 0.0436145 |
| When $d_2 \geq d_{20}$, | $d_{2m}$ (nm) $=$ | ∞ | 21.562 | ∞ | ∞ | 25.612 |
| When $d_2 < d_{20}$, | $d_{2m}$ (nm) $=$ | 67.089 | 1.645 | 48.128 | 21.535 | 3.107 |

1. 0 < N A ≤ 1. 1
1 3 5 < T ≤ 1 4 5

| Case | 14−11 | 14−12 |
|---|---|---|
| $n_{10}$ | 1.6955775 | 1.6953573 |
| $k_{10}$ | 0.0548747 | 0.0556511 |
| $d_{10}$ (nm) | 213.500 | 272.231 |
| $n_{20}$ | 1.6934763 | 1.6917841 |
| $k_{20}$ | 0.1457299 | 0.1736649 |
| $d_{20}$ (nm) | 319.743 | 260.476 |

| | | 14−11 | 14−12 |
|---|---|---|---|
| When $n_1 \geq n_{10}$, | $n_{1m} =$ | 0.0884082 | 0.0714819 |
| When $n_1 < n_{10}$, | $n_{1m} =$ | 0.0760022 | 0.0518335 |
| When $k_1 \geq k_{10}$, | $k_{1m} =$ | 0.0634009 | 0.0652063 |
| When $k_1 < k_{10}$, | $k_{1m} =$ | 0.0349133 | 0.0395740 |
| When $d_1 \geq d_{10}$, | $d_{1m}$ (nm) $=$ | ∞ | ∞ |
| When $d_1 < d_{10}$, | $d_{1m}$ (nm) $=$ | 128.996 | 113.518 |
| When $n_2 \geq n_{20}$, | $n_{2m} =$ | 0.2359680 | 0.2895325 |
| When $n_2 < n_{20}$, | $n_{2m} =$ | 0.1212769 | 0.2158911 |
| When $k_2 \geq k_{20}$, | $k_{2m} =$ | 0.1345789 | 0.2124060 |
| When $k_2 < k_{20}$, | $k_{2m} =$ | 0.0582837 | 0.0793396 |
| When $d_2 \geq d_{20}$, | $d_{2m}$ (nm) $=$ | ∞ | ∞ |
| When $d_2 < d_{20}$, | $d_{2m}$ (nm) $=$ | 94.216 | 91.728 |

1. 0 < NA ≤ 1. 1
145 < T ≤ 155

| Case | 15-01 | 15-02 | 15-03 | 15-04 | 15-05 |
|---|---|---|---|---|---|
| $n_{10}$ | 1.8842999 | 1.9020060 | 1.9176161 | 1.7347347 | 1.7402087 |
| $k_{10}$ | 0.1660082 | 0.1078045 | 0.0733974 | 0.0970436 | 0.0854812 |
| $d_{10}$ (nm) | 15.542 | 13.884 | 11.927 | 91.613 | 92.221 |
| $n_{20}$ | 1.6642092 | 1.7406676 | 1.7608162 | 1.6897518 | 1.7427648 |
| $k_{20}$ | 0.3881866 | 0.3180988 | 0.2687301 | 0.3028107 | 0.2437105 |
| $d_{20}$ (nm) | 148.595 | 199.025 | 254.127 | 138.166 | 190.058 |

| | | 15-01 | 15-02 | 15-03 | 15-04 | 15-05 |
|---|---|---|---|---|---|---|
| When $n_1 \geq n_{10}$, | $n_{1m} =$ | 0.0902356 | 0.1039673 | 0.1191321 | 0.0403284 | 0.0477295 |
| When $n_1 < n_{10}$, | $n_{1m} =$ | 0.0608057 | 0.0712415 | 0.0806982 | 0.0168616 | 0.0123145 |
| When $k_1 \geq k_{10}$, | $k_{1m} =$ | 0.0796985 | 0.0922314 | 0.1003394 | 0.0414099 | 0.0352649 |
| When $k_1 < k_{10}$, | $k_{1m} =$ | 0.0913672 | 0.1040308 | 0.0733974 | 0.0415906 | 0.0369519 |
| When $d_1 \geq d_{10}$, | $d_{1m}$ (nm) $=$ | 5.569 | 6.401 | 6.478 | 11.141 | 16.036 |
| When $d_1 < d_{10}$, | $d_{1m}$ (nm) $=$ | 3.524 | 3.984 | 3.954 | 3.546 | 2.715 |
| When $n_2 \geq n_{20}$, | $n_{2m} =$ | 0.0975891 | 0.1093347 | 0.1166919 | 0.0721533 | 0.0993201 |
| When $n_2 < n_{20}$, | $n_{2m} =$ | 0.1510022 | 0.1570532 | 0.1613013 | 0.0996582 | 0.1116626 |
| When $k_2 \geq k_{20}$, | $k_{2m} =$ | 0.1021082 | 0.1115308 | 0.1139111 | 0.0446167 | 0.0576575 |
| When $k_2 < k_{20}$, | $k_{2m} =$ | 0.1042151 | 0.0981909 | 0.0922217 | 0.0735095 | 0.0699536 |
| When $d_2 \geq d_{20}$, | $d_{2m}$ (nm) $=$ | ∞ | ∞ | ∞ | 23.089 | ∞ |
| When $d_2 < d_{20}$, | $d_{2m}$ (nm) $=$ | 36.178 | 75.817 | 118.717 | 13.060 | 9.872 |

1. 0 < NA ≤ 1. 1
145 < T ≤ 155

| Case | 15-06 | 15-07 | 15-08 | 15-09 | 15-10 |
|---|---|---|---|---|---|
| $n_{10}$ | 1.7232674 | 1.7163169 | 1.7052425 | 1.6979604 | 1.6919325 |
| $k_{10}$ | 0.0768076 | 0.0822242 | 0.0670983 | 0.0765182 | 0.0693101 |
| $d_{10}$ (nm) | 92.842 | 160.121 | 160.367 | 219.964 | 212.895 |
| $n_{20}$ | 1.6931409 | 1.7162208 | 1.6808978 | 1.6978817 | 1.6886216 |
| $k_{20}$ | 0.2010537 | 0.2770503 | 0.1806066 | 0.2641846 | 0.2063377 |
| $d_{20}$ (nm) | 254.319 | 132.120 | 252.327 | 134.431 | 199.162 |

| | | 15-06 | 15-07 | 15-08 | 15-09 | 15-10 |
|---|---|---|---|---|---|---|
| When $n_1 \geq n_{10}$, | $n_{1m} =$ | 0.0505859 | 0.0375513 | 0.0535669 | 0.0055981 | 0.0297021 |
| When $n_1 < n_{10}$, | $n_{1m} =$ | 0.0155139 | 0.0002051 | 0.0181250 | 0.0232141 | 0.0494775 |
| When $k_1 \geq k_{10}$, | $k_{1m} =$ | 0.0378564 | 0.0051208 | 0.0335376 | 0.0146118 | 0.0441443 |
| When $k_1 < k_{10}$, | $k_{1m} =$ | 0.0427637 | 0.0032507 | 0.0275378 | 0.0178613 | 0.0327478 |
| When $d_1 \geq d_{10}$, | $d_{1m}$ (nm) $=$ | 33.581 | 19.229 | ∞ | 4.817 | ∞ |
| When $d_1 < d_{10}$, | $d_{1m}$ (nm) $=$ | 4.347 | 0.056 | 6.999 | 10.286 | 43.553 |
| When $n_2 \geq n_{20}$, | $n_{2m} =$ | 0.0760803 | 0.0599353 | 0.0299109 | 0.0539575 | 0.2378027 |
| When $n_2 < n_{20}$, | $n_{2m} =$ | 0.1135510 | 0.0008435 | 0.1135376 | 0.0106042 | 0.0839368 |
| When $k_2 \geq k_{20}$, | $k_{2m} =$ | 0.0671289 | 0.0005420 | 0.0313745 | 0.0886438 | 0.1159473 |
| When $k_2 < k_{20}$, | $k_{2m} =$ | 0.0634387 | 0.0680176 | 0.0561853 | 0.0306653 | 0.0671289 |
| When $d_2 \geq d_{20}$, | $d_{2m}$ (nm) $=$ | ∞ | 12.405 | ∞ | 21.650 | ∞ |
| When $d_2 < d_{20}$, | $d_{2m}$ (nm) $=$ | 64.219 | 0.105 | 32.640 | 2.145 | 24.441 |

1. $0 < NA \leq 1.1$
$145 < T \leq 155$

| Case | 15-11 | 15-12 |
|---|---|---|
| $n_{10}$ | 1.6933082 | 1.6953110 |
| $k_{10}$ | 0.0619759 | 0.0563706 |
| $d_{10}$ (nm) | 212.839 | 272.392 |
| $n_{20}$ | 1.6904544 | 1.6905212 |
| $k_{20}$ | 0.1723582 | 0.1778331 |
| $d_{20}$ (nm) | 255.647 | 252.170 |

| | | 15-11 | 15-12 |
|---|---|---|---|
| When $n_1 \geq n_{10}$, | $n_{1m} =$ | 0.0645605 | 0.0686462 |
| When $n_1 < n_{10}$, | $n_{1m} =$ | 0.0718213 | 0.0516125 |
| When $k_1 \geq k_{10}$, | $k_{1m} =$ | 0.0578125 | 0.0646021 |
| When $k_1 < k_{10}$, | $k_{1m} =$ | 0.0349402 | 0.0400220 |
| When $d_1 \geq d_{10}$, | $d_{1m}$ (nm) $=$ | ∞ | ∞ |
| When $d_1 < d_{10}$, | $d_{1m}$ (nm) $=$ | 54.857 | 112.777 |
| When $n_2 \geq n_{20}$, | $n_{2m} =$ | 0.2345605 | 0.2885852 |
| When $n_2 < n_{20}$, | $n_{2m} =$ | 0.1388916 | 0.2180322 |
| When $k_2 \geq k_{20}$, | $k_{2m} =$ | 0.1280078 | 0.2117786 |
| When $k_2 < k_{20}$, | $k_{2m} =$ | 0.0658081 | 0.0782971 |
| When $d_2 \geq d_{20}$, | $d_{2m}$ (nm) $=$ | ∞ | ∞ |
| When $d_2 < d_{20}$, | $d_{2m}$ (nm) $=$ | 73.297 | 86.154 |

1. $0 < NA \leq 1.1$
$155 < T \leq 165$

| Case | 16-01 | 16-02 | 16-03 | 16-04 | 16-05 |
|---|---|---|---|---|---|
| $n_{10}$ | 1.9162825 | 1.8960663 | 1.9085468 | 1.9232010 | 1.7368663 |
| $k_{10}$ | 0.2485644 | 0.1719364 | 0.1144956 | 0.0848488 | 0.1019026 |
| $d_{10}$ (nm) | 18.297 | 15.704 | 13.923 | 11.624 | 91.322 |
| $n_{20}$ | 1.6104232 | 1.6708316 | 1.7385514 | 1.7455678 | 1.6869885 |
| $k_{20}$ | 0.6165991 | 0.4169686 | 0.3337318 | 0.2771185 | 0.3224919 |
| $d_{20}$ (nm) | 83.442 | 139.520 | 191.444 | 248.983 | 130.342 |

| | | 16-01 | 16-02 | 16-03 | 16-04 | 16-05 |
|---|---|---|---|---|---|---|
| When $n_1 \geq n_{10}$, | $n_{1m} =$ | 0.0684412 | 0.0871606 | 0.1018298 | 0.1200745 | 0.0372510 |
| When $n_1 < n_{10}$, | $n_{1m} =$ | 0.0186816 | 0.0568530 | 0.0690649 | 0.0803638 | 0.0125696 |
| When $k_1 \geq k_{10}$, | $k_{1m} =$ | 0.0233801 | 0.0734265 | 0.0893420 | 0.1020142 | 0.0332275 |
| When $k_1 < k_{10}$, | $k_{1m} =$ | 0.0710925 | 0.0921472 | 0.1049048 | 0.0848488 | 0.0396851 |
| When $d_1 \geq d_{10}$, | $d_{1m}$ (nm) $=$ | 3.544 | 5.170 | 6.051 | 6.159 | 10.019 |
| When $d_1 < d_{10}$, | $d_{1m}$ (nm) $=$ | 0.960 | 3.162 | 3.726 | 3.719 | 2.554 |
| When $n_2 \geq n_{20}$, | $n_{2m} =$ | 0.0392468 | 0.0938416 | 0.1080847 | 0.1165613 | 0.0639832 |
| When $n_2 < n_{20}$, | $n_{2m} =$ | 0.1557959 | 0.1481714 | 0.1540210 | 0.1601440 | 0.0923059 |
| When $k_2 \geq k_{20}$, | $k_{2m} =$ | 0.0796021 | 0.1023108 | 0.1103064 | 0.1095667 | 0.0344885 |
| When $k_2 < k_{20}$, | $k_{2m} =$ | 0.1143958 | 0.1026965 | 0.0973987 | 0.0917590 | 0.0690210 |
| When $d_2 \geq d_{20}$, | $d_{2m}$ (nm) $=$ | ∞ | ∞ | ∞ | ∞ | 16.255 |
| When $d_2 < d_{20}$, | $d_{2m}$ (nm) $=$ | 16.079 | 31.215 | 71.737 | 92.392 | 12.361 |

1. 0 < N A ≦ 1. 1
1 5 5 < T ≦ 1 6 5

| Case | 16-06 | 16-07 | 16-08 | 16-09 | 16-10 |
|---|---|---|---|---|---|
| $n_{10}$ | 1.7401611 | 1.7243481 | 1.7054586 | 1.6959475 | 1.6918299 |
| $k_{10}$ | 0.0886217 | 0.0791015 | 0.0688139 | 0.0801582 | 0.0707672 |
| $d_{10}$ (nm) | 92.017 | 92.538 | 159.721 | 218.084 | 213.401 |
| $n_{20}$ | 1.7381402 | 1.6930588 | 1.6812702 | 1.6891859 | 1.6865968 |
| $k_{20}$ | 0.2555882 | 0.2092609 | 0.1871719 | 0.2763746 | 0.2143676 |
| $d_{20}$ (nm) | 182.755 | 245.988 | 244.029 | 128.431 | 190.286 |

| | | 16-06 | 16-07 | 16-08 | 16-09 | 16-10 |
|---|---|---|---|---|---|---|
| When $n_1 \geq n_{10}$, | $n_{1m}=$ | 0.0455261 | 0.0488196 | 0.0509851 | 0.0098682 | 0.0278625 |
| When $n_1 < n_{10}$, | $n_{1m}=$ | 0.0098901 | 0.0131677 | 0.0163489 | 0.0140930 | 0.0421411 |
| When $k_1 \geq k_{10}$, | $k_{1m}=$ | 0.0306140 | 0.0345203 | 0.0271167 | 0.0171570 | 0.0425635 |
| When $k_1 < k_{10}$, | $k_{1m}=$ | 0.0347180 | 0.0404199 | 0.0257288 | 0.0171082 | 0.0318542 |
| When $d_1 \geq d_{10}$, | $d_{1m}$ (nm) $=$ | 14.632 | 33.648 | ∞ | 8.318 | ∞ |
| When $d_1 < d_{10}$, | $d_{1m}$ (nm) $=$ | 2.133 | 3.535 | 5.969 | 6.525 | 43.306 |
| When $n_2 \geq n_{20}$, | $n_{2m}=$ | 0.0895227 | 0.0573254 | 0.0211304 | 0.0441309 | 0.2430603 |
| When $n_2 < n_{20}$, | $n_{2m}=$ | 0.1067090 | 0.1098926 | 0.1107275 | 0.0233423 | 0.0869226 |
| When $k_2 \geq k_{20}$, | $k_{2m}=$ | 0.0460217 | 0.0587354 | 0.0210486 | 0.0642297 | 0.1089050 |
| When $k_2 < k_{20}$, | $k_{2m}=$ | 0.0680432 | 0.0628845 | 0.0551514 | 0.0464880 | 0.0738831 |
| When $d_2 \geq d_{20}$, | $d_{2m}$ (nm) $=$ | ∞ | ∞ | ∞ | 19.572 | ∞ |
| When $d_2 < d_{20}$, | $d_{2m}$ (nm) $=$ | 8.553 | 37.425 | 30.745 | 5.059 | 27.273 |

1. 0 < N A ≦ 1. 1
1 5 5 < T ≦ 1 6 5

| Case | 16-11 | 16-12 |
|---|---|---|
| $n_{10}$ | 1.6935501 | 1.6953216 |
| $k_{10}$ | 0.0625258 | 0.0573372 |
| $d_{10}$ (nm) | 213.666 | 272.694 |
| $n_{20}$ | 1.6897170 | 1.6885432 |
| $k_{20}$ | 0.1780108 | 0.1839003 |
| $d_{20}$ (nm) | 246.097 | 243.579 |

| | | 16-11 | 16-12 |
|---|---|---|---|
| When $n_1 \geq n_{10}$, | $n_{1m}=$ | 0.0658508 | 0.0696008 |
| When $n_1 < n_{10}$, | $n_{1m}=$ | 0.0609790 | 0.0519751 |
| When $k_1 \geq k_{10}$, | $k_{1m}=$ | 0.0564087 | 0.0639087 |
| When $k_1 < k_{10}$, | $k_{1m}=$ | 0.0340259 | 0.0390979 |
| When $d_1 \geq d_{10}$, | $d_{1m}$ (nm) $=$ | ∞ | ∞ |
| When $d_1 < d_{10}$, | $d_{1m}$ (nm) $=$ | 55.431 | 113.126 |
| When $n_2 \geq n_{20}$, | $n_{2m}=$ | 0.2425122 | 0.2917029 |
| When $n_2 < n_{20}$, | $n_{2m}=$ | 0.1355713 | 0.2189172 |
| When $k_2 \geq k_{20}$, | $k_{2m}=$ | 0.1230981 | 0.2089771 |
| When $k_2 < k_{20}$, | $k_{2m}=$ | 0.0647131 | 0.0785583 |
| When $d_2 \geq d_{20}$, | $d_{2m}$ (nm) $=$ | ∞ | ∞ |
| When $d_2 < d_{20}$, | $d_{2m}$ (nm) $=$ | 74.519 | 83.205 |

1. 0 < N A ≤ 1. 1
165 < T ≤ 175

| Case | 17-01 | 17-02 | 17-03 | 17-04 | 17-05 |
|---|---|---|---|---|---|
| $n_{10}$ | 1.9620125 | 1.9138120 | 1.9194872 | 1.9263431 | 1.7366416 |
| $k_{10}$ | 0.2671830 | 0.1838008 | 0.1265886 | 0.0918160 | 0.1083929 |
| $d_{10}$ (nm) | 17.281 | 15.160 | 13.286 | 11.575 | 90.600 |
| $n_{20}$ | 1.6251877 | 1.6631095 | 1.7204546 | 1.7389610 | 1.6676220 |
| $k_{20}$ | 0.6875073 | 0.4399257 | 0.3440475 | 0.2853240 | 0.3363185 |
| $d_{20}$ (nm) | 75.420 | 132.541 | 186.036 | 241.421 | 124.136 |

| | | 17-01 | 17-02 | 17-03 | 17-04 | 17-05 |
|---|---|---|---|---|---|---|
| When $n_1 \geq n_{10}$, | $n_{1m} =$ | 0.0681287 | 0.0852625 | 0.1025696 | 0.1184741 | 0.0323010 |
| When $n_1 < n_{10}$, | $n_{1m} =$ | 0.0103625 | 0.0516760 | 0.0678894 | 0.0788623 | 0.0048279 |
| When $k_1 \geq k_{10}$, | $k_{1m} =$ | 0.0130603 | 0.0684912 | 0.0894849 | 0.1012756 | 0.0174634 |
| When $k_1 < k_{10}$, | $k_{1m} =$ | 0.0671069 | 0.0945691 | 0.1086621 | 0.0918160 | 0.0305151 |
| When $d_1 \geq d_{10}$, | $d_{1m}$ (nm) $=$ | 3.029 | 4.576 | 5.503 | 5.915 | 7.890 |
| When $d_1 < d_{10}$, | $d_{1m}$ (nm) $=$ | 0.441 | 2.597 | 3.327 | 3.560 | 0.944 |
| When $n_2 \geq n_{20}$, | $n_{2m} =$ | 0.0235046 | 0.0887256 | 0.1055566 | 0.1147229 | 0.0355994 |
| When $n_2 < n_{20}$, | $n_{2m} =$ | 0.1565857 | 0.1459790 | 0.1532703 | 0.1591589 | 0.0840686 |
| When $k_2 \geq k_{20}$, | $k_{2m} =$ | 0.0495569 | 0.0950366 | 0.1036096 | 0.1065601 | 0.0135376 |
| When $k_2 < k_{20}$, | $k_{2m} =$ | 0.1038318 | 0.0972864 | 0.0941003 | 0.0904578 | 0.0586487 |
| When $d_2 \geq d_{20}$, | $d_{2m}$ (nm) $=$ | ∞ | ∞ | ∞ | ∞ | 9.834 |
| When $d_2 < d_{20}$, | $d_{2m}$ (nm) $=$ | 13.490 | 32.564 | 69.289 | 94.292 | 9.844 |

1. 0 < N A ≤ 1. 1
165 < T ≤ 175

| Case | 17-06 | 17-07 | 17-08 | 17-09 | 17-10 |
|---|---|---|---|---|---|
| $n_{10}$ | 1.7377165 | 1.7250070 | 1.7054487 | 1.6921136 | 1.6937452 |
| $k_{10}$ | 0.0918810 | 0.0812670 | 0.0704565 | 0.0719896 | 0.0634118 |
| $d_{10}$ (nm) | 91.516 | 92.096 | 158.889 | 214.506 | 214.086 |
| $n_{20}$ | 1.7225143 | 1.6922454 | 1.6815182 | 1.6833735 | 1.6893106 |
| $k_{20}$ | 0.2640565 | 0.2155950 | 0.1921887 | 0.2231205 | 0.1840166 |
| $d_{20}$ (nm) | 176.484 | 237.445 | 235.428 | 180.418 | 236.602 |

| | | 17-06 | 17-07 | 17-08 | 17-09 | 17-10 |
|---|---|---|---|---|---|---|
| When $n_1 \geq n_{10}$, | $n_{1m} =$ | 0.0420569 | 0.0467627 | 0.0482849 | 0.0256970 | 0.0615491 |
| When $n_1 < n_{10}$, | $n_{1m} =$ | 0.0067480 | 0.0110010 | 0.0145544 | 0.0346619 | 0.0533179 |
| When $k_1 \geq k_{10}$, | $k_{1m} =$ | 0.0242395 | 0.0311426 | 0.0191064 | 0.0402332 | 0.0548975 |
| When $k_1 < k_{10}$, | $k_{1m} =$ | 0.0306030 | 0.0379785 | 0.0179834 | 0.0315259 | 0.0339990 |
| When $d_1 \geq d_{10}$, | $d_{1m}$ (nm) $=$ | 13.053 | 20.074 | ∞ | ∞ | ∞ |
| When $d_1 < d_{10}$, | $d_{1m}$ (nm) $=$ | 1.437 | 2.846 | 5.076 | 44.014 | 52.355 |
| When $n_2 \geq n_{20}$, | $n_{2m} =$ | 0.0699756 | 0.0474695 | 0.0119531 | 0.2616345 | 0.2513293 |
| When $n_2 < n_{20}$, | $n_{2m} =$ | 0.1027979 | 0.1100684 | 0.1104504 | 0.0766565 | 0.1353430 |
| When $k_2 \geq k_{20}$, | $k_{2m} =$ | 0.0294397 | 0.0490112 | 0.0106458 | 0.1033704 | 0.1166565 |
| When $k_2 < k_{20}$, | $k_{2m} =$ | 0.0637073 | 0.0613086 | 0.0537012 | 0.0738440 | 0.0656140 |
| When $d_2 \geq d_{20}$, | $d_{2m}$ (nm) $=$ | ∞ | ∞ | 5.139 | ∞ | ∞ |
| When $d_2 < d_{20}$, | $d_{2m}$ (nm) $=$ | 7.091 | 63.320 | 32.177 | 24.892 | 75.277 |

1. 0 < N A ≤ 1. 1
165 < T ≤ 175

| Case | 17-11 | 17-12 |
|---|---|---|
| $n_{10}$ | 1.6937402 | 1.6958036 |
| $k_{10}$ | 0.0634247 | 0.0530688 |
| $d_{10}$ (nm) | 214.067 | 271.703 |
| $n_{20}$ | 1.6892020 | 1.6918593 |
| $k_{20}$ | 0.1839903 | 0.1637010 |
| $d_{20}$ (nm) | 236.644 | 291.452 |

| | | 17-11 | 17-12 |
|---|---|---|---|
| When $n_1 \geq n_{10}$, | $n_{1m} =$ | 0.0614392 | 0.0799048 |
| When $n_1 < n_{10}$, | $n_{1m} =$ | 0.0533545 | 0.0613391 |
| When $k_1 \geq k_{10}$, | $k_{1m} =$ | 0.0548865 | 0.0657874 |
| When $k_1 < k_{10}$, | $k_{1m} =$ | 0.0340295 | 0.0406555 |
| When $d_1 \geq d_{10}$, | $d_{1m}$ (nm) $=$ | ∞ | ∞ |
| When $d_1 < d_{10}$, | $d_{1m}$ (nm) $=$ | 52.349 | 186.337 |
| When $n_2 \geq n_{20}$, | $n_{2m} =$ | 0.2512048 | 0.2852795 |
| When $n_2 < n_{20}$, | $n_{2m} =$ | 0.1353552 | 0.2060364 |
| When $k_2 \geq k_{20}$, | $k_{2m} =$ | 0.1167688 | 0.2088965 |
| When $k_2 < k_{20}$, | $k_{2m} =$ | 0.0656104 | 0.0720715 |
| When $d_2 \geq d_{20}$, | $d_{2m}$ (nm) $=$ | ∞ | ∞ |
| When $d_2 < d_{20}$, | $d_{2m}$ (nm) $=$ | 75.294 | 119.308 |

1. 0 < N A ≤ 1. 1
175 < T ≤ 185

| Case | 18-01 | 18-02 | 18-03 | 18-04 | 18-05 |
|---|---|---|---|---|---|
| $n_{10}$ | 2.0247974 | 1.9282935 | 1.9213955 | 1.9262173 | 1.7355101 |
| $k_{10}$ | 0.2830183 | 0.1992550 | 0.1387890 | 0.1063571 | 0.0947091 |
| $d_{10}$ (nm) | 15.097 | 14.428 | 13.062 | 11.253 | 91.033 |
| $n_{20}$ | 1.6266898 | 1.6428403 | 1.7027750 | 1.7173021 | 1.7079959 |
| $k_{20}$ | 0.7191283 | 0.4517072 | 0.3507816 | 0.2869739 | 0.2693832 |
| $d_{20}$ (nm) | 71.681 | 126.823 | 179.475 | 236.027 | 169.192 |

| | | 18-01 | 18-02 | 18-03 | 18-04 | 18-05 |
|---|---|---|---|---|---|---|
| When $n_1 \geq n_{10}$, | $n_{1m} =$ | 0.0749963 | 0.0847278 | 0.1010168 | 0.1197595 | 0.0387598 |
| When $n_1 < n_{10}$, | $n_{1m} =$ | 0.0029248 | 0.0471021 | 0.0652051 | 0.0785376 | 0.0037976 |
| When $k_1 \geq k_{10}$, | $k_{1m} =$ | 0.0038599 | 0.0655127 | 0.0884351 | 0.1039075 | 0.0170227 |
| When $k_1 < k_{10}$, | $k_{1m} =$ | 0.0706714 | 0.0951611 | 0.1067810 | 0.1063571 | 0.0250378 |
| When $d_1 \geq d_{10}$, | $d_{1m}$ (nm) $=$ | 2.365 | 4.047 | 5.170 | 5.710 | 10.979 |
| When $d_1 < d_{10}$, | $d_{1m}$ (nm) $=$ | 0.098 | 2.142 | 3.074 | 3.403 | 0.799 |
| When $n_2 \geq n_{20}$, | $n_{2m} =$ | 0.0068848 | 0.0841113 | 0.1036328 | 0.1139966 | 0.0477551 |
| When $n_2 < n_{20}$, | $n_{2m} =$ | 0.1606787 | 0.1462891 | 0.1534180 | 0.1596240 | 0.1042908 |
| When $k_2 \geq k_{20}$, | $k_{2m} =$ | 0.0111658 | 0.0845300 | 0.0979260 | 0.1010864 | 0.0158423 |
| When $k_2 < k_{20}$, | $k_{2m} =$ | 0.0939917 | 0.0914209 | 0.0916113 | 0.0894141 | 0.0611707 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 3.000 | 39.175 | 67.597 | 105.537 | 4.807 |

1. $0 < NA \leq 1.1$
$175 < T \leq 185$

| Case | 18-06 | 18-07 | 18-08 | 18-09 | 18-10 |
|---|---|---|---|---|---|
| $n_{10}$ | 1.7251933 | 1.7054174 | 1.6937830 | 1.6952847 | 1.6957027 |
| $k_{10}$ | 0.0829804 | 0.0718367 | 0.0647049 | 0.0582261 | 0.0542195 |
| $d_{10}$ (nm) | 91.728 | 158.389 | 214.330 | 213.359 | 271.586 |
| $n_{20}$ | 1.6903561 | 1.6812041 | 1.6889835 | 1.6934588 | 1.6918383 |
| $k_{20}$ | 0.2192539 | 0.1954390 | 0.1894046 | 0.1611341 | 0.1679902 |
| $d_{20}$ (nm) | 228.367 | 226.084 | 226.812 | 284.005 | 281.728 |

| | | 18-06 | 18-07 | 18-08 | 18-09 | 18-10 |
|---|---|---|---|---|---|---|
| When $n_1 \geq n_{10}$, | $n_{1m} =$ | 0.0450793 | 0.0463184 | 0.0575061 | 0.0820801 | 0.0778577 |
| When $n_1 < n_{10}$, | $n_{1m} =$ | 0.0094861 | 0.0044336 | 0.0478479 | 0.0612256 | 0.0602185 |
| When $k_1 \geq k_{10}$, | $k_{1m} =$ | 0.0283801 | 0.0117395 | 0.0529968 | 0.0602039 | 0.0649841 |
| When $k_1 < k_{10}$, | $k_{1m} =$ | 0.0362878 | 0.0115625 | 0.0337854 | 0.0347266 | 0.0400525 |
| When $d_1 \geq d_{10}$, | $d_{1m}$ (nm) $=$ | 16.774 | ∞ | ∞ | ∞ | ∞ |
| When $d_1 < d_{10}$, | $d_{1m}$ (nm) $=$ | 2.397 | 1.386 | 50.875 | 126.709 | 185.173 |
| When $n_2 \geq n_{20}$, | $n_{2m} =$ | 0.0407971 | 0.0052539 | 0.2620386 | 0.2460583 | 0.2888794 |
| When $n_2 < n_{20}$, | $n_{2m} =$ | 0.1134692 | 0.1157361 | 0.1359692 | 0.1267810 | 0.2086084 |
| When $k_2 \geq k_{20}$, | $k_{2m} =$ | 0.0417627 | 0.0042761 | 0.1123547 | 0.1276489 | 0.2100842 |
| When $k_2 < k_{20}$, | $k_{2m} =$ | 0.0604272 | 0.0538147 | 0.0667053 | 0.0613220 | 0.0762817 |
| When $d_2 \geq d_{20}$, | $d_{2m}$ (nm) $=$ | ∞ | 1.973 | ∞ | ∞ | ∞ |
| When $d_2 < d_{20}$, | $d_{2m}$ (nm) $=$ | 63.259 | 35.408 | 73.536 | 81.916 | 101.090 |

1. $0 < NA \leq 1.1$
$185 < T \leq 195$

| Case | 19-01 | 19-02 | 19-03 | 19-04 | 19-05 |
|---|---|---|---|---|---|
| $n_{10}$ | 1.9316549 | 1.9193011 | 1.9209840 | 1.9114684 | 1.7364379 |
| $k_{10}$ | 0.2158025 | 0.1476126 | 0.1061325 | 0.1024475 | 0.0969838 |
| $d_{10}$ (nm) | 14.297 | 13.272 | 11.842 | 10.224 | 91.033 |
| $n_{20}$ | 1.6202378 | 1.6935029 | 1.7241227 | 1.6976483 | 1.7085420 |
| $k_{20}$ | 0.4645248 | 0.3598725 | 0.2946413 | 0.2438294 | 0.2774318 |
| $d_{20}$ (nm) | 119.165 | 170.049 | 224.030 | 285.021 | 158.680 |

| | | 19-01 | 19-02 | 19-03 | 19-04 | 19-05 |
|---|---|---|---|---|---|---|
| When $n_1 \geq n_{10}$, | $n_{1m} =$ | 0.0819873 | 0.0986853 | 0.1146375 | 0.1344971 | 0.0375342 |
| When $n_1 < n_{10}$, | $n_{1m} =$ | 0.0431250 | 0.0625305 | 0.0746716 | 0.0933276 | 0.0023010 |
| When $k_1 \geq k_{10}$, | $k_{1m} =$ | 0.0616553 | 0.0860156 | 0.0981763 | 0.1190894 | 0.0118958 |
| When $k_1 < k_{10}$, | $k_{1m} =$ | 0.0896899 | 0.1016528 | 0.1061325 | 0.1024475 | 0.0218677 |
| When $d_1 \geq d_{10}$, | $d_{1m}$ (nm) $=$ | 3.700 | 5.023 | 5.787 | 6.264 | 9.942 |
| When $d_1 < d_{10}$, | $d_{1m}$ (nm) $=$ | 1.892 | 2.963 | 3.440 | 3.984 | 0.476 |
| When $n_2 \geq n_{20}$, | $n_{2m} =$ | 0.0797485 | 0.1030664 | 0.1135645 | 0.1221387 | 0.0340320 |
| When $n_2 < n_{20}$, | $n_{2m} =$ | 0.1493750 | 0.1566296 | 0.1631348 | 0.1387097 | 0.1094446 |
| When $k_2 \geq k_{20}$, | $k_{2m} =$ | 0.0775891 | 0.0962708 | 0.1030847 | 0.0998328 | 0.0100928 |
| When $k_2 < k_{20}$, | $k_{2m} =$ | 0.0909656 | 0.0941418 | 0.0920776 | 0.0860498 | 0.0649939 |
| When $d_2 \geq d_{20}$, | $d_{2m}$ (nm) $=$ | ∞ | ∞ | ∞ | ∞ | 42.778 |
| When $d_2 < d_{20}$, | $d_{2m}$ (nm) $=$ | 39.461 | 66.761 | 95.735 | 134.721 | 2.964 |

1. 0 < N A ≤ 1. 1
1 8 5 < T ≤ 1 9 5

| Case | 19-06 | 19-07 | 19-08 | 19-09 | 19-10 |
|---|---|---|---|---|---|
| $n_{10}$ | 1.7258494 | 1.7176246 | 1.7057732 | 1.7053832 | 1.6928552 |
| $k_{10}$ | 0.0843222 | 0.0727056 | 0.0731106 | 0.0633918 | 0.0748243 |
| $d_{10}$ (nm) | 91.766 | 91.617 | 158.709 | 158.181 | 216.444 |
| $n_{20}$ | 1.6907525 | 1.6784161 | 1.6805392 | 1.6859880 | 1.6825267 |
| $k_{20}$ | 0.2229229 | 0.1842107 | 0.1989479 | 0.1669818 | 0.2415835 |
| $d_{20}$ (nm) | 218.067 | 277.206 | 215.842 | 272.384 | 158.548 |

| | | 19-06 | 19-07 | 19-08 | 19-09 | 19-10 |
|---|---|---|---|---|---|---|
| When $n_1 \geq n_{10}$, | $n_{1m}=$ | 0.0445569 | 0.0497937 | 0.0455957 | 0.0532361 | 0.0209436 |
| When $n_1 < n_{10}$, | $n_{1m}=$ | 0.0086951 | 0.0298450 | 0.0022034 | 0.0367859 | 0.0248157 |
| When $k_1 \geq k_{10}$, | $k_{1m}=$ | 0.0263611 | 0.0534119 | 0.0080444 | 0.0507507 | 0.0311414 |
| When $k_1 < k_{10}$, | $k_{1m}=$ | 0.0359253 | 0.0504663 | 0.0097656 | 0.0393250 | 0.0256995 |
| When $d_1 \geq d_{10}$, | $d_{1m}$ (nm) $=$ | 15.734 | 41.766 | ∞ | ∞ | 12.676 |
| When $d_1 < d_{10}$, | $d_{1m}$ (nm) $=$ | 2.168 | 9.272 | 0.695 | 75.025 | 12.180 |
| When $n_2 \geq n_{20}$, | $n_{2m}=$ | 0.0361047 | 0.0638184 | 0.0029834 | 0.0794446 | 0.0872498 |
| When $n_2 < n_{20}$, | $n_{2m}=$ | 0.1156152 | 0.1202979 | 0.1187366 | 0.1037524 | 0.0413367 |
| When $k_2 \geq k_{20}$, | $k_{2m}=$ | 0.0400842 | 0.0626270 | 0.0025122 | 0.0450354 | 0.0876147 |
| When $k_2 < k_{20}$, | $k_{2m}=$ | 0.0626514 | 0.0561853 | 0.0563074 | 0.0506238 | 0.0672510 |
| When $d_2 \geq d_{20}$, | $d_{2m}$ (nm) $=$ | ∞ | ∞ | 1.098 | ∞ | ∞ |
| When $d_2 < d_{20}$, | $d_{2m}$ (nm) $=$ | 62.415 | 80.313 | 33.556 | 35.245 | 14.500 |

1. 0 < N A ≤ 1. 1
1 8 5 < T ≤ 1 9 5

| Case | 19-11 | 19-12 | 19-13 |
|---|---|---|---|
| $n_{10}$ | 1.6935473 | 1.6950516 | 1.6954923 |
| $k_{10}$ | 0.0663823 | 0.0596605 | 0.0554795 |
| $d_{10}$ (nm) | 214.407 | 213.429 | 271.226 |
| $n_{20}$ | 1.6888366 | 1.6925794 | 1.6917166 |
| $k_{20}$ | 0.1945007 | 0.1643538 | 0.1716832 |
| $d_{20}$ (nm) | 217.060 | 274.430 | 272.356 |

| | | 19-11 | 19-12 | 19-13 |
|---|---|---|---|---|
| When $n_1 \geq n_{10}$, | $n_{1m}=$ | 0.0539099 | 0.0837012 | 0.0771448 |
| When $n_1 < n_{10}$, | $n_{1m}=$ | 0.0450378 | 0.0604199 | 0.0593555 |
| When $k_1 \geq k_{10}$, | $k_{1m}=$ | 0.0507373 | 0.0587012 | 0.0639185 |
| When $k_1 < k_{10}$, | $k_{1m}=$ | 0.0306738 | 0.0334839 | 0.0392737 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 49.334 | 125.965 | 183.474 |
| When $n_2 \geq n_{20}$, | $n_{2m}=$ | 0.1392200 | 0.1753748 | 0.2943286 |
| When $n_2 < n_{20}$, | $n_{2m}=$ | 0.1378223 | 0.1262683 | 0.2110303 |
| When $k_2 \geq k_{20}$, | $k_{2m}=$ | 0.1089429 | 0.1267468 | 0.2119958 |
| When $k_2 < k_{20}$, | $k_{2m}=$ | 0.0654358 | 0.0611353 | 0.0788904 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 37.875 | 75.613 | 93.291 |

1. 0 < N A ≦ 1. 1
1 9 5 < T ≦ 2 0 5

| Case | 20-01 | 20-02 | 20-03 | 20-04 | 20-05 |
|---|---|---|---|---|---|
| $n_{10}$ | 1.9124203 | 1.9240615 | 1.9069086 | 1.7409810 | 1.7270720 |
| $k_{10}$ | 0.1489422 | 0.1092971 | 0.1015424 | 0.0988730 | 0.0857435 |
| $d_{10}$ (nm) | 14.330 | 12.001 | 10.748 | 91.533 | 92.142 |
| $n_{20}$ | 1.7039618 | 1.7245262 | 1.7018591 | 1.7256420 | 1.6923707 |
| $k_{20}$ | 0.3787231 | 0.3026113 | 0.2499950 | 0.2922591 | 0.2292874 |
| $d_{20}$ (nm) | 157.291 | 214.201 | 273.963 | 146.253 | 207.814 |

| | | 20-01 | 20-02 | 20-03 | 20-04 | 20-05 |
|---|---|---|---|---|---|---|
| When $n_1 \geq n_{10}$, | $n_{1m}=$ | 0.0947424 | 0.1140125 | 0.1293140 | 0.0383984 | 0.0447009 |
| When $n_1 < n_{10}$, | $n_{1m}=$ | 0.0592273 | 0.0732715 | 0.0895557 | 0.0020898 | 0.0081226 |
| When $k_1 \geq k_{10}$, | $k_{1m}=$ | 0.0804358 | 0.0961365 | 0.1132190 | 0.0106335 | 0.0246362 |
| When $k_1 < k_{10}$, | $k_{1m}=$ | 0.0954272 | 0.1092971 | 0.1015424 | 0.0220923 | 0.0359277 |
| When $d_1 \geq d_{10}$, | $d_{1m}$ (nm) $=$ | 5.168 | 5.724 | 6.406 | 9.801 | 15.595 |
| When $d_1 < d_{10}$, | $d_{1m}$ (nm) $=$ | 3.029 | 3.355 | 4.072 | 0.420 | 2.001 |
| When $n_2 \geq n_{20}$, | $n_{2m}=$ | 0.1047864 | 0.1153137 | 0.1226477 | 0.0347485 | 0.0318494 |
| When $n_2 < n_{20}$, | $n_{2m}=$ | 0.1598962 | 0.1638757 | 0.1417261 | 0.1115564 | 0.1129541 |
| When $k_2 \geq k_{20}$, | $k_{2m}=$ | 0.1020288 | 0.1044775 | 0.1018286 | 0.0106042 | 0.0415295 |
| When $k_2 < k_{20}$, | $k_{2m}=$ | 0.1029260 | 0.0959216 | 0.0891724 | 0.0737659 | 0.0663513 |
| When $d_2 \geq d_{20}$, | $d_{2m}$ (nm) $=$ | ∞ | ∞ | ∞ | 37.674 | ∞ |
| When $d_2 < d_{20}$, | $d_{2m}$ (nm) $=$ | 61.016 | 86.078 | 130.875 | 2.293 | 32.252 |

1. 0 < N A ≦ 1. 1
1 9 5 < T ≦ 2 0 5

| Case | 20-06 | 20-07 | 20-08 | 20-09 | 20-10 |
|---|---|---|---|---|---|
| $n_{10}$ | 1.7180387 | 1.7063746 | 1.7058520 | 1.6924739 | 1.6928977 |
| $k_{10}$ | 0.0734703 | 0.0744769 | 0.0640895 | 0.0767908 | 0.0684401 |
| $d_{10}$ (nm) | 91.877 | 159.624 | 158.885 | 216.680 | 213.761 |
| $n_{20}$ | 1.6777924 | 1.6791348 | 1.6855365 | 1.6850078 | 1.6885850 |
| $k_{20}$ | 0.1881130 | 0.2047799 | 0.1710983 | 0.2520629 | 0.1999527 |
| $d_{20}$ (nm) | 267.481 | 205.830 | 262.479 | 148.712 | 208.689 |

| | | 20-06 | 20-07 | 20-08 | 20-09 | 20-10 |
|---|---|---|---|---|---|---|
| When $n_1 \geq n_{10}$, | $n_{1m}=$ | 0.0499475 | 0.0454993 | 0.0542188 | 0.0126501 | 0.0501160 |
| When $n_1 < n_{10}$, | $n_{1m}=$ | 0.0300122 | 0.0018469 | 0.0331775 | 0.0226819 | 0.0449377 |
| When $k_1 \geq k_{10}$, | $k_{1m}=$ | 0.0534277 | 0.0070447 | 0.0503931 | 0.0235315 | 0.0487341 |
| When $k_1 < k_{10}$, | $k_{1m}=$ | 0.0493896 | 0.0111902 | 0.0386401 | 0.0180737 | 0.0270740 |
| When $d_1 \geq d_{10}$, | $d_{1m}$ (nm) $=$ | 33.063 | ∞ | ∞ | 10.064 | ∞ |
| When $d_1 < d_{10}$, | $d_{1m}$ (nm) $=$ | 9.229 | 0.603 | 19.062 | 10.036 | 46.531 |
| When $n_2 \geq n_{20}$, | $n_{2m}=$ | 0.0633008 | 0.0027478 | 0.0774658 | 0.0675293 | 0.1390137 |
| When $n_2 < n_{20}$, | $n_{2m}=$ | 0.1171533 | 0.1127539 | 0.1100610 | 0.0218616 | 0.1442749 |
| When $k_2 \geq k_{20}$, | $k_{2m}=$ | 0.0639148 | 0.0025830 | 0.0457581 | 0.0823975 | 0.1098364 |
| When $k_2 < k_{20}$, | $k_{2m}=$ | 0.0580542 | 0.0529590 | 0.0524817 | 0.0502942 | 0.0628650 |
| When $d_2 \geq d_{20}$, | $d_{2m}$ (nm) $=$ | ∞ | 1.007 | ∞ | ∞ | ∞ |
| When $d_2 < d_{20}$, | $d_{2m}$ (nm) $=$ | 77.001 | 28.132 | 32.836 | 6.408 | 22.345 |

1. $0 < NA \leq 1.1$

$195 < T \leq 205$

| Case | 20-11 | 20-12 |
|---|---|---|
| $n_{10}$ | 1.6947635 | 1.6952371 |
| $k_{10}$ | 0.0610999 | 0.0566636 |
| $d_{10}$ (nm) | 213.366 | 270.653 |
| $n_{20}$ | 1.6918971 | 1.6914186 |
| $k_{20}$ | 0.1679521 | 0.1751623 |
| $d_{20}$ (nm) | 265.388 | 263.994 |

| | | 20-11 | 20-12 |
|---|---|---|---|
| When $n_1 \geq n_{10}$, | $n_{1m} =$ | 0.0863086 | 0.0772644 |
| When $n_1 < n_{10}$, | $n_{1m} =$ | 0.0626501 | 0.0586890 |
| When $k_1 \geq k_{10}$, | $k_{1m} =$ | 0.0572302 | 0.0627917 |
| When $k_1 < k_{10}$, | $k_{1m} =$ | 0.0322180 | 0.0382104 |
| When $d_1 \geq d_{10}$, | $d_{1m}$ (nm) $=$ | $\infty$ | $\infty$ |
| When $d_1 < d_{10}$, | $d_{1m}$ (nm) $=$ | 124.819 | 121.330 |
| When $n_2 \geq n_{20}$, | $n_{2m} =$ | 0.1702917 | 0.3021582 |
| When $n_2 < n_{20}$, | $n_{2m} =$ | 0.1249365 | 0.2142798 |
| When $k_2 \geq k_{20}$, | $k_{2m} =$ | 0.1249084 | 0.2136462 |
| When $k_2 < k_{20}$, | $k_{2m} =$ | 0.0643469 | 0.0826477 |
| When $d_2 \geq d_{20}$, | $d_{2m}$ (nm) $=$ | $\infty$ | $\infty$ |
| When $d_2 < d_{20}$, | $d_{2m}$ (nm) $=$ | 66.113 | 91.025 |

In accordance with a third embodiment of the invention, an antireflective film has a two-layer structure and is used in a process for manufacturing a semiconductor device by being provided between a resist layer and a silicon oxide layer formed on a surface of a silicon semiconductor substrate and having a thickness T (unit: nm) described below, for exposure of the resist layer in an exposure system having a wavelength of 190 nm to 195 nm and a numerical aperture NA of $1.1 < NA \leq 1.2$. In accordance with the third embodiment of the invention, an exposure method is used in a process for manufacturing a semiconductor device and includes providing an antireflective film having a two-layer structure between a resist layer and a silicon oxide layer formed on a surface of a silicon semiconductor substrate and having a thickness T (unit: nm) described below, and exposing the resist layer in an exposure system having a wavelength of 190 nm to 195 nm and a numerical aperture NA of $1.1 < NA \leq 1.2$.

The antireflective film or the antireflective film used in the exposure method according to the third embodiment of the invention includes an upper layer having a complex refractive index $N_1$ and a lower layer having a complex refractive index $N_2$, the complex refractive indexes $N_1$ and $N_2$ being represented by the following equations:

$$N_1 = n_1 - k_1 i$$

$$N_2 = n_2 - k_2 i$$

Assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1$, $k_1$, $d_1$, $n_2$, $k_2$, and $d_2$ satisfy the following relational expression:

$$\{(n_1 - n_{10})/(n_{1m} - n_{10})\}^2 + \{(k_1 - k_{10})/(k_{1m} - k_{10})\}^2 + \{(d_1$$

$$- d_{10})/(d_{1m} - d_{10})\}^2 + \{(n_2 - n_{20})/(n_{2m} - n_{20})\}^2 + \{(k_2 - k_{20})/(k_{2m}$$

$$- k_{20})\}^2 + \{(d_2 - d_{20})/(d_{2m} - d_{20})\}^2 \leq 1$$

However, a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$. In the tables below, in the line of "When $n_1 \geq n_{10}$, $n_{1m} =$", each value in the right columns is "$n_{1m} - n_{10}$"; in the line of "When $n_1 < n_{10}$, $n_{1m} =$", each value in the right columns is "$n_{10} - n_{1m}$"; in the line of "When $k_1 \geq k_{10}$, $k_{1m} =$", each value in the right columns is "$k_{1m} - k_{10}$"; in the line of "When $k_1 < k_{10}$, $k_{1m} =$", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m} =$", each value in the right columns is "$n_{2m} - n_{20}$"; in the line of "When $n_2 < n_{20}$, $n_{2m} =$", each value in the right columns is "$n_{20} - n_{2m}$"; in the line of "When $k_2 \geq k_{20}$, $k_{2m} =$", each value in the right columns is "$k_{2m} - k_{20}$"; in the line of "When $k_2 < k_{20}$, $k_{2m} =$", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

1. 1 < N A ≤ 1. 2
2 ≤ T ≤ 1 5

| Case | 1-01 | 1-02 | 1-03 | 1-04 | 1-05 |
|---|---|---|---|---|---|
| $n_{10}$ | 2.0940641 | 1.9168406 | 1.8970115 | 1.8805879 | 1.8778358 |
| $k_{10}$ | 0.0325844 | 0.1807255 | 0.1529573 | 0.1098415 | 0.1082679 |
| $d_{10}$ (nm) | 26.090 | 35.662 | 31.182 | 13.577 | 19.930 |
| $n_{20}$ | 4.2290158 | 5.4932306 | 2.4318401 | 1.7032895 | 1.8340760 |
| $k_{20}$ | 2.3935124 | 0.6123354 | 0.5958382 | 0.2751108 | 0.3677230 |
| $d_{20}$ (nm) | 3.632 | 19.087 | 52.406 | 218.193 | 142.226 |

| | | 1-01 | 1-02 | 1-03 | 1-04 | 1-05 |
|---|---|---|---|---|---|---|
| When $n_1 \geq n_{10}$, | $n_{1m}=$ | 0.0779846 | 0.0720874 | 0.0701013 | 0.1012354 | 0.0784314 |
| When $n_1 < n_{10}$, | $n_{1m}=$ | 0.0750281 | 0.0636047 | 0.0555591 | 0.0635571 | 0.0497058 |
| When $k_1 \geq k_{10}$, | $k_{1m}=$ | 0.0672229 | 0.0527649 | 0.0494641 | 0.0853247 | 0.0590771 |
| When $k_1 < k_{10}$, | $k_{1m}=$ | 0.0325844 | 0.0849731 | 0.0840393 | 0.1029980 | 0.0867822 |
| When $d_1 \geq d_{10}$, | $d_{1m}$ (nm) $=$ | 3.416 | 5.199 | 6.198 | 6.716 | 7.382 |
| When $d_1 < d_{10}$, | $d_{1m}$ (nm) $=$ | 2.721 | 3.845 | 3.923 | 3.853 | 3.873 |
| When $n_2 \geq n_{20}$, | $n_{2m}=$ | 0.2775293 | 0.1187439 | 0.1333862 | 0.1147803 | 0.1115393 |
| When $n_2 < n_{20}$, | $n_{2m}=$ | 0.2711597 | 0.1202087 | 0.1603455 | 0.1449023 | 0.1457849 |
| When $k_2 \geq k_{20}$, | $k_{2m}=$ | 0.2845105 | 0.1470557 | 0.1794812 | 0.0967163 | 0.1467151 |
| When $k_2 < k_{20}$, | $k_{2m}=$ | 0.2499512 | 0.1180896 | 0.1302063 | 0.0855334 | 0.0954285 |
| When $d_2 \geq d_{20}$, | $d_{2m}$ (nm) $=$ | 0.458 | 0.467 | 5.440 | ∞ | ∞ |
| When $d_2 < d_{20}$, | $d_{2m}$ (nm) $=$ | 0.433 | 0.450 | 5.242 | 81.747 | 30.656 |

1. 1 < N A ≤ 1. 2
2 ≤ T ≤ 1 5

| Case | 1-06 | 1-07 | 1-08 | 1-09 | 1-10 |
|---|---|---|---|---|---|
| $n_{10}$ | 1.8663312 | 1.7888608 | 1.7735009 | 1.7175310 | 1.7199475 |
| $k_{10}$ | 0.0978132 | 0.1060865 | 0.0957437 | 0.0751352 | 0.0655065 |
| $d_{10}$ (nm) | 12.232 | 103.503 | 98.181 | 95.409 | 94.621 |
| $n_{20}$ | 1.6938400 | 4.4234099 | 2.0208865 | 1.6658936 | 1.6963762 |
| $k_{20}$ | 0.2288643 | 0.4526804 | 0.4158741 | 0.2054797 | 0.1762614 |
| $d_{20}$ (nm) | 277.705 | 24.164 | 66.693 | 212.937 | 266.043 |

| | | 1-06 | 1-07 | 1-08 | 1-09 | 1-10 |
|---|---|---|---|---|---|---|
| When $n_1 \geq n_{10}$, | $n_{1m}=$ | 0.1143909 | 0.0588428 | 0.0489270 | 0.0419214 | 0.0484180 |
| When $n_1 < n_{10}$, | $n_{1m}=$ | 0.0786536 | 0.0104822 | 0.0094507 | 0.0157727 | 0.0265735 |
| When $k_1 \geq k_{10}$, | $k_{1m}=$ | 0.1033447 | 0.0215918 | 0.0249109 | 0.0382361 | 0.0520056 |
| When $k_1 < k_{10}$, | $k_{1m}=$ | 0.0978132 | 0.0439624 | 0.0358655 | 0.0399121 | 0.0459387 |
| When $d_1 \geq d_{10}$, | $d_{1m}$ (nm) $=$ | 7.609 | 9.370 | 10.912 | 18.272 | 51.841 |
| When $d_1 < d_{10}$, | $d_{1m}$ (nm) $=$ | 4.794 | 1.739 | 1.766 | 4.805 | 8.596 |
| When $n_2 \geq n_{20}$, | $n_{2m}=$ | 0.1069263 | 0.0468066 | 0.0740674 | 0.0384924 | 0.0631091 |
| When $n_2 < n_{20}$, | $n_{2m}=$ | 0.1302808 | 0.1036670 | 0.1052673 | 0.0829468 | 0.0987561 |
| When $k_2 \geq k_{20}$, | $k_{2m}=$ | 0.0918579 | 0.0409717 | 0.0495154 | 0.0385596 | 0.0522119 |
| When $k_2 < k_{20}$, | $k_{2m}=$ | 0.0786169 | 0.0807788 | 0.0903577 | 0.0528296 | 0.0515430 |
| When $d_2 \geq d_{20}$, | $d_{2m}$ (nm) $=$ | ∞ | 0.296 | 4.999 | ∞ | ∞ |
| When $d_2 < d_{20}$, | $d_{2m}$ (nm) $=$ | 128.233 | 0.621 | 5.371 | 23.038 | 34.154 |

1. 1 < N A ≤ 1. 2
2 ≤ T ≤ 1 5

| Case | 1-11 | 1-12 | 1-13 | 1-14 | 1-15 |
|---|---|---|---|---|---|
| $n_{10}$ | 1.7156729 | 1.7043499 | 1.7082412 | 1.6926126 | 1.6890888 |
| $k_{10}$ | 0.0770168 | 0.0644952 | 0.0577629 | 0.0683906 | 0.0745003 |
| $d_{10}$ (nm) | 188.315 | 165.315 | 163.169 | 237.184 | 217.718 |
| $n_{20}$ | 6.9620048 | 1.6731418 | 1.7075031 | 6.7859369 | 1.7770504 |
| $k_{20}$ | 3.4231449 | 0.1899705 | 0.1626792 | 2.9992529 | 0.3401503 |
| $d_{20}$ (nm) | 0.879 | 207.250 | 259.766 | 0.993 | 84.925 |

| | | 1-11 | 1-12 | 1-13 | 1-14 | 1-15 |
|---|---|---|---|---|---|---|
| When $n_1 \geq n_{10}$, | $n_{1m} =$ | 0.0649841 | 0.0417419 | 0.0509473 | 0.0348376 | 0.0194055 |
| When $n_1 < n_{10}$, | $n_{1m} =$ | 0.0083154 | 0.0317078 | 0.0477380 | 0.0764368 | 0.0607605 |
| When $k_1 \geq k_{10}$, | $k_{1m} =$ | 0.0257251 | 0.0333704 | 0.0433435 | 0.0403589 | 0.0329480 |
| When $k_1 < k_{10}$, | $k_{1m} =$ | 0.0275232 | 0.0338538 | 0.0333484 | 0.0319214 | 0.0242554 |
| When $d_1 \geq d_{10}$, | $d_{1m}$ (nm) $=$ | 38.959 | ∞ | ∞ | 19.483 | 9.981 |
| When $d_1 < d_{10}$, | $d_{1m}$ (nm) $=$ | 3.134 | 16.146 | 77.216 | 43.463 | 24.681 |
| When $n_2 \geq n_{20}$, | $n_{2m} =$ | 0.2971887 | 0.0474377 | 0.0745630 | 0.5633252 | 0.1177502 |
| When $n_2 < n_{20}$, | $n_{2m} =$ | 0.6091602 | 0.0721411 | 0.0651379 | 0.4300269 | 0.0317639 |
| When $k_2 \geq k_{20}$, | $k_{2m} =$ | 0.2827808 | 0.0222888 | 0.0325830 | 0.2436438 | 0.0560791 |
| When $k_2 < k_{20}$, | $k_{2m} =$ | 0.6937878 | 0.0478259 | 0.0479700 | 0.5647217 | 0.0980969 |
| When $d_2 \geq d_{20}$, | $d_{2m}$ (nm) $=$ | 0.055 | 16.772 | ∞ | 0.120 | 16.691 |
| When $d_2 < d_{20}$, | $d_{2m}$ (nm) $=$ | 0.135 | 19.208 | 16.504 | 0.176 | 3.670 |

1. 1 < N A ≤ 1. 2
2 ≤ T ≤ 1 5

| Case | 1-16 | 1-17 | 1-18 | 1-19 |
|---|---|---|---|---|
| $n_{10}$ | 1.6903292 | 1.6921355 | 1.6951475 | 1.7004017 |
| $k_{10}$ | 0.0721915 | 0.0670288 | 0.0546351 | 0.0599028 |
| $d_{10}$ (nm) | 210.963 | 207.063 | 219.259 | 265.986 |
| $n_{20}$ | 1.7111030 | 1.6978167 | 1.6889102 | 1.7029410 |
| $k_{20}$ | 0.2426612 | 0.1954345 | 0.1606659 | 0.1992607 |
| $d_{20}$ (nm) | 155.846 | 222.387 | 263.728 | 214.965 |

| | | 1-16 | 1-17 | 1-18 | 1-19 |
|---|---|---|---|---|---|
| When $n_1 \geq n_{10}$, | $n_{1m} =$ | 0.0284180 | 0.0456091 | 0.0773694 | 0.0612244 |
| When $n_1 < n_{10}$, | $n_{1m} =$ | 0.0510327 | 0.0467078 | 0.0619885 | 0.0410486 |
| When $k_1 \geq k_{10}$, | $k_{1m} =$ | 0.0455554 | 0.0511133 | 0.0524768 | 0.0499927 |
| When $k_1 < k_{10}$, | $k_{1m} =$ | 0.0320984 | 0.0388074 | 0.0353687 | 0.0377380 |
| When $d_1 \geq d_{10}$, | $d_{1m}$ (nm) $=$ | 23.770 | ∞ | ∞ | ∞ |
| When $d_1 < d_{10}$, | $d_{1m}$ (nm) $=$ | 28.472 | 31.416 | 128.164 | 94.534 |
| When $n_2 \geq n_{20}$, | $n_{2m} =$ | 0.1260327 | 0.1631665 | 0.2120154 | 0.2674829 |
| When $n_2 < n_{20}$, | $n_{2m} =$ | 0.0663647 | 0.1722144 | 0.1079456 | 0.2316101 |
| When $k_2 \geq k_{20}$, | $k_{2m} =$ | 0.0960291 | 0.1259009 | 0.1121619 | 0.2074023 |
| When $k_2 < k_{20}$, | $k_{2m} =$ | 0.0846741 | 0.0757690 | 0.0591858 | 0.0894751 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 12.288 | 72.281 | 78.597 | 77.855 |

1. 1 ＜ N A ≦ 1. 2
1 5 ＜ T ≦ 2 5

| Case | 2−01 | 2−02 | 2−03 | 2−04 | 2−05 |
|---|---|---|---|---|---|
| $n_{10}$ | 1.8738578 | 1.8839217 | 1.8842367 | 1.8705650 | 1.7997475 |
| $k_{10}$ | 0.2051029 | 0.1169859 | 0.1130268 | 0.1010320 | 0.1076402 |
| $d_{10}$ (nm) | 37.506 | 20.540 | 14.059 | 12.433 | 101.817 |
| $n_{20}$ | 6.9151921 | 1.8488520 | 1.7087850 | 1.6946915 | 5.7702673 |
| $k_{20}$ | 0.6847654 | 0.3990514 | 0.2917115 | 0.2394813 | 0.5312541 |
| $d_{20}$ (nm) | 14.288 | 132.865 | 208.377 | 268.610 | 17.283 |

| | | 2−01 | 2−02 | 2−03 | 2−04 | 2−05 |
|---|---|---|---|---|---|---|
| When $n_1 \geq n_{10}$, | $n_{1m} =$ | 0.0713965 | 0.0757019 | 0.0971472 | 0.1115784 | 0.0520068 |
| When $n_1 < n_{10}$, | $n_{1m} =$ | 0.0555054 | 0.0476453 | 0.0599609 | 0.0759399 | 0.0098120 |
| When $k_1 \geq k_{10}$, | $k_{1m} =$ | 0.0541125 | 0.0561304 | 0.0804553 | 0.1002258 | 0.0237036 |
| When $k_1 < k_{10}$, | $k_{1m} =$ | 0.0773486 | 0.0843945 | 0.1004919 | 0.1010320 | 0.0377808 |
| When $d_1 \geq d_{10}$, | $d_{1m}$ (nm) $=$ | 5.211 | 6.923 | 6.482 | 7.316 | 8.566 |
| When $d_1 < d_{10}$, | $d_{1m}$ (nm) $=$ | 3.920 | 3.580 | 3.648 | 4.569 | 1.552 |
| When $n_2 \geq n_{20}$, | $n_{2m} =$ | 0.1375024 | 0.1133521 | 0.1126624 | 0.1051160 | 0.0578821 |
| When $n_2 < n_{20}$, | $n_{2m} =$ | 0.1468335 | 0.1457764 | 0.1432654 | 0.1327966 | 0.1020337 |
| When $k_2 \geq k_{20}$, | $k_{2m} =$ | 0.1698267 | 0.1546228 | 0.0978870 | 0.0916199 | 0.0398865 |
| When $k_2 < k_{20}$, | $k_{2m} =$ | 0.1355151 | 0.0979541 | 0.0869165 | 0.0797766 | 0.0850256 |
| When $d_2 \geq d_{20}$, | $d_{2m}$ (nm) $=$ | 0.302 | ∞ | ∞ | ∞ | 0.186 |
| When $d_2 < d_{20}$, | $d_{2m}$ (nm) $=$ | 0.308 | 25.359 | 77.278 | 123.573 | 0.315 |

1. 1 ＜ N A ≦ 1. 2
1 5 ＜ T ≦ 2 5

| Case | 2−06 | 2−07 | 2−08 | 2−09 | 2−10 |
|---|---|---|---|---|---|
| $n_{10}$ | 1.7189014 | 1.7208712 | 1.7236639 | 1.7047019 | 1.7084293 |
| $k_{10}$ | 0.0782837 | 0.0678223 | 0.0843652 | 0.0670962 | 0.0597123 |
| $d_{10}$ (nm) | 95.289 | 94.558 | 181.922 | 165.192 | 163.108 |
| $n_{20}$ | 1.6643388 | 1.6960341 | 5.6387216 | 1.6715149 | 1.7074208 |
| $k_{20}$ | 0.2165956 | 0.1841027 | 4.7363270 | 0.1999125 | 0.1697699 |
| $d_{20}$ (nm) | 204.139 | 257.386 | 0.821 | 198.564 | 251.199 |

| | | 2−06 | 2−07 | 2−08 | 2−09 | 2−10 |
|---|---|---|---|---|---|---|
| When $n_1 \geq n_{10}$, | $n_{1m} =$ | 0.0400110 | 0.0468091 | 0.0526855 | 0.0398865 | 0.0490320 |
| When $n_1 < n_{10}$, | $n_{1m} =$ | 0.0126721 | 0.0238684 | 0.0001306 | 0.0279565 | 0.0460034 |
| When $k_1 \geq k_{10}$, | $k_{1m} =$ | 0.0335376 | 0.0489734 | 0.0020081 | 0.0268384 | 0.0389331 |
| When $k_1 < k_{10}$, | $k_{1m} =$ | 0.0373218 | 0.0446973 | 0.0057251 | 0.0295178 | 0.0306982 |
| When $d_1 \geq d_{10}$, | $d_{1m}$ (nm) $=$ | 16.137 | 28.984 | 27.528 | ∞ | ∞ |
| When $d_1 < d_{10}$, | $d_{1m}$ (nm) $=$ | 3.682 | 7.422 | 0.042 | 13.795 | 27.544 |
| When $n_2 \geq n_{20}$, | $n_{2m} =$ | 0.0331177 | 0.0610901 | 0.0075977 | 0.0397839 | 0.0734460 |
| When $n_2 < n_{20}$, | $n_{2m} =$ | 0.0802783 | 0.0961804 | 0.6135461 | 0.0646704 | 0.0518091 |
| When $k_2 \geq k_{20}$, | $k_{2m} =$ | 0.0326062 | 0.0485974 | 0.0047754 | 0.0159570 | 0.0275537 |
| When $k_2 < k_{20}$, | $k_{2m} =$ | 0.0528589 | 0.0519092 | 0.7998767 | 0.0474854 | 0.0482410 |
| When $d_2 \geq d_{20}$, | $d_{2m}$ (nm) $=$ | ∞ | ∞ | 0.001 | 11.667 | ∞ |
| When $d_2 < d_{20}$, | $d_{2m}$ (nm) $=$ | 20.507 | 30.742 | 0.141 | 16.953 | 13.761 |

1. $1 < NA \leq 1.2$

$15 < T \leq 25$

| Case | 2-11 | 2-12 | 2-13 | 2-14 | 2-15 |
|---|---|---|---|---|---|
| $n_{10}$ | 1.6912240 | 1.6881032 | 1.6896993 | 1.6917374 | 1.6948846 |
| $k_{10}$ | 0.0750717 | 0.0788193 | 0.0752193 | 0.0692921 | 0.0562662 |
| $d_{10}$ (nm) | 235.933 | 218.423 | 211.247 | 207.206 | 219.172 |
| $n_{20}$ | 5.6089359 | 1.7881557 | 1.7110684 | 1.6970724 | 1.6877325 |
| $k_{20}$ | 4.1789938 | 0.3823123 | 0.2595743 | 0.2053429 | 0.1673191 |
| $d_{20}$ (nm) | 0.921 | 76.059 | 147.061 | 213.576 | 255.276 |

| | 2-11 | 2-12 | 2-13 | 2-14 | 2-15 |
|---|---|---|---|---|---|
| When $n_1 \geq n_{10}$, $n_{1m} =$ | 0.0197583 | 0.0081677 | 0.0235974 | 0.0421069 | 0.0510120 |
| When $n_1 < n_{10}$, $n_{1m} =$ | 0.0774451 | 0.0583032 | 0.0505896 | 0.0462817 | 0.0590515 |
| When $k_1 \geq k_{10}$, $k_{1m} =$ | 0.0246448 | 0.0223682 | 0.0406641 | 0.0495398 | 0.0510083 |
| When $k_1 < k_{10}$, $k_{1m} =$ | 0.0218396 | 0.0175671 | 0.0286658 | 0.0376331 | 0.0343799 |
| When $d_1 \geq d_{10}$, $d_{1m}$ (nm) $=$ | 6.504 | 3.634 | 18.131 | ∞ | ∞ |
| When $d_1 < d_{10}$, $d_{1m}$ (nm) $=$ | 42.587 | 22.206 | 26.432 | 29.901 | 81.491 |
| When $n_2 \geq n_{20}$, $n_{2m} =$ | 0.6544434 | 0.1247424 | 0.1252808 | 0.1545593 | 0.2162573 |
| When $n_2 < n_{20}$, $n_{2m} =$ | 0.2325012 | 0.0171619 | 0.0503735 | 0.1749207 | 0.1048962 |
| When $k_2 \geq k_{20}$, $k_{2m} =$ | 0.1484387 | 0.0366235 | 0.0860120 | 0.1212268 | 0.1092822 |
| When $k_2 < k_{20}$, $k_{2m} =$ | 0.6595715 | 0.1036670 | 0.0844458 | 0.0781323 | 0.0604700 |
| When $d_2 \geq d_{20}$, $d_{2m}$ (nm) $=$ | 0.071 | 14.060 | ∞ | ∞ | ∞ |
| When $d_2 < d_{20}$, $d_{2m}$ (nm) $=$ | 0.195 | 1.711 | 9.636 | 69.774 | 76.197 |

1. $1 < NA \leq 1.2$

$15 < T \leq 25$

| Case | 2-16 | 2-17 |
|---|---|---|
| $n_{10}$ | 1.7002883 | 1.6987256 |
| $k_{10}$ | 0.0618224 | 0.0572006 |
| $d_{10}$ (nm) | 266.113 | 264.952 |
| $n_{20}$ | 1.7025341 | 1.6934905 |
| $k_{20}$ | 0.2096252 | 0.1744162 |
| $d_{20}$ (nm) | 206.193 | 266.771 |

| | 2-16 | 2-17 |
|---|---|---|
| When $n_1 \geq n_{10}$, $n_{1m} =$ | 0.0602454 | 0.0764587 |
| When $n_1 < n_{10}$, $n_{1m} =$ | 0.0381921 | 0.0594568 |
| When $k_1 \geq k_{10}$, $k_{1m} =$ | 0.0482422 | 0.0536096 |
| When $k_1 < k_{10}$, $k_{1m} =$ | 0.0371497 | 0.0384741 |
| When $d_1 \geq d_{10}$, $d_{1m}$ (nm) $=$ | ∞ | ∞ |
| When $d_1 < d_{10}$, $d_{1m}$ (nm) $=$ | 92.805 | 173.726 |
| When $n_2 \geq n_{20}$, $n_{2m} =$ | 0.2779004 | 0.2751611 |
| When $n_2 < n_{20}$, $n_{2m} =$ | 0.2377234 | 0.2053577 |
| When $k_2 \geq k_{20}$, $k_{2m} =$ | 0.2066309 | 0.2211816 |
| When $k_2 < k_{20}$, $k_{2m} =$ | 0.0931018 | 0.0797998 |
| When $d_2 \geq d_{20}$, $d_{2m}$ (nm) $=$ | ∞ | ∞ |
| When $d_2 < d_{20}$, $d_{2m}$ (nm) $=$ | 73.805 | 125.295 |

1. 1 $<$ N A $\leq$ 1. 2
2 5 $<$ T $\leq$ 3 5

| Case | 3-01 | 3-02 | 3-03 | 3-04 | 3-05 |
|---|---|---|---|---|---|
| $n_{10}$ | 1.8384852 | 1.8997218 | 1.8867733 | 1.8774399 | 1.8168537 |
| $k_{10}$ | 0.2367471 | 0.1227276 | 0.1201944 | 0.1030917 | 0.1206742 |
| $d_{10}$ (nm) | 38.632 | 21.226 | 14.426 | 12.555 | 98.976 |
| $n_{20}$ | 4.7928214 | 1.8945709 | 1.7066853 | 1.6978346 | 5.6725781 |
| $k_{20}$ | 0.7766058 | 0.4412749 | 0.3085187 | 0.2515853 | 0.5943855 |
| $d_{20}$ (nm) | 20.034 | 121.762 | 200.277 | 259.495 | 16.950 |

| | | 3-01 | 3-02 | 3-03 | 3-04 | 3-05 |
|---|---|---|---|---|---|---|
| When $n_1 \geq n_{10}$, | $n_{1m}=$ | 0.0640527 | 0.0719128 | 0.0931812 | 0.1089819 | 0.0387244 |
| When $n_1 < n_{10}$, | $n_{1m}=$ | 0.0455762 | 0.0458093 | 0.0565320 | 0.0737622 | 0.0048828 |
| When $k_1 \geq k_{10}$, | $k_{1m}=$ | 0.0510876 | 0.0524744 | 0.0764050 | 0.0973877 | 0.0168860 |
| When $k_1 < k_{10}$, | $k_{1m}=$ | 0.0717981 | 0.0817957 | 0.0981750 | 0.1030917 | 0.0269836 |
| When $d_1 \geq d_{10}$, | $d_{1m}$ (nm) $=$ | 4.733 | 6.228 | 6.172 | 6.944 | 6.776 |
| When $d_1 < d_{10}$, | $d_{1m}$ (nm) $=$ | 3.444 | 3.186 | 3.418 | 4.320 | 0.695 |
| When $n_2 \geq n_{20}$, | $n_{2m}=$ | 0.1712317 | 0.1175342 | 0.1094324 | 0.1025208 | 0.0610400 |
| When $n_2 < n_{20}$, | $n_{2m}=$ | 0.1852917 | 0.1447205 | 0.1408899 | 0.1358679 | 0.1030127 |
| When $k_2 \geq k_{20}$, | $k_{2m}=$ | 0.2079944 | 0.1727771 | 0.0971545 | 0.0913745 | 0.0239368 |
| When $k_2 < k_{20}$, | $k_{2m}=$ | 0.1709546 | 0.1005322 | 0.0873328 | 0.0807227 | 0.0995679 |
| When $d_2 \geq d_{20}$, | $d_{2m}$ (nm) $=$ | 0.789 | ∞ | ∞ | ∞ | 0.191 |
| When $d_2 < d_{20}$, | $d_{2m}$ (nm) $=$ | 0.773 | 21.526 | 73.345 | 89.127 | 0.308 |

1. 1 $<$ N A $\leq$ 1. 2
2 5 $<$ T $\leq$ 3 5

| Case | 3-06 | 3-07 | 3-08 | 3-09 | 3-10 |
|---|---|---|---|---|---|
| $n_{10}$ | 1.7203847 | 1.7222308 | 1.7051744 | 1.7089344 | 1.6891179 |
| $k_{10}$ | 0.0818178 | 0.0703272 | 0.0699535 | 0.0618729 | 0.0788518 |
| $d_{10}$ (nm) | 95.097 | 94.450 | 164.924 | 162.999 | 211.328 |
| $n_{20}$ | 1.6625491 | 1.6972414 | 1.6707295 | 1.7091982 | 1.7121044 |
| $k_{20}$ | 0.2295920 | 0.1929579 | 0.2115581 | 0.1777196 | 0.2799946 |
| $d_{20}$ (nm) | 195.706 | 248.789 | 190.095 | 242.642 | 139.125 |

| | | 3-06 | 3-07 | 3-08 | 3-09 | 3-10 |
|---|---|---|---|---|---|---|
| When $n_1 \geq n_{10}$, | $n_{1m}=$ | 0.0370166 | 0.0449036 | 0.0362634 | 0.0468103 | 0.0189148 |
| When $n_1 < n_{10}$, | $n_{1m}=$ | 0.0096326 | 0.0211206 | 0.0148706 | 0.0438916 | 0.0495532 |
| When $k_1 \geq k_{10}$, | $k_{1m}=$ | 0.0279895 | 0.0455884 | 0.0190686 | 0.0333899 | 0.0327563 |
| When $k_1 < k_{10}$, | $k_{1m}=$ | 0.0346558 | 0.0433374 | 0.0247266 | 0.0269507 | 0.0238696 |
| When $d_1 \geq d_{10}$, | $d_{1m}$ (nm) $=$ | 14.187 | 22.312 | ∞ | ∞ | 9.561 |
| When $d_1 < d_{10}$, | $d_{1m}$ (nm) $=$ | 2.673 | 6.291 | 5.065 | 24.312 | 23.646 |
| When $n_2 \geq n_{20}$, | $n_{2m}=$ | 0.0267200 | 0.0590454 | 0.0307410 | 0.0721521 | 0.1253455 |
| When $n_2 < n_{20}$, | $n_{2m}=$ | 0.0766724 | 0.0932019 | 0.0523315 | 0.0386328 | 0.0336450 |
| When $k_2 \geq k_{20}$, | $k_{2m}=$ | 0.0255017 | 0.0445288 | 0.0095300 | 0.0215259 | 0.0725635 |
| When $k_2 < k_{20}$, | $k_{2m}=$ | 0.0521814 | 0.0521948 | 0.0465356 | 0.0485632 | 0.0779358 |
| When $d_2 \geq d_{20}$, | $d_{2m}$ (nm) $=$ | ∞ | ∞ | 7.007 | 43.167 | ∞ |
| When $d_2 < d_{20}$, | $d_{2m}$ (nm) $=$ | 18.077 | 28.239 | 14.543 | 10.181 | 6.908 |

1. $1 < NA \leq 1.2$
$25 < T \leq 35$

| Case | 3-11 | 3-12 | 3-13 | 3-14 |
|---|---|---|---|---|
| $n_{10}$ | 1.6914863 | 1.6947006 | 1.7002933 | 1.6987290 |
| $k_{10}$ | 0.0717884 | 0.0580661 | 0.0640004 | 0.0588877 |
| $d_{10}$ (nm) | 207.154 | 219.137 | 266.055 | 264.992 |
| $n_{20}$ | 1.6970451 | 1.6875442 | 1.7022941 | 1.6933668 |
| $k_{20}$ | 0.2167627 | 0.1751428 | 0.2216801 | 0.1822428 |
| $d_{20}$ (nm) | 205.768 | 246.865 | 198.139 | 258.415 |

| | | 3-11 | 3-12 | 3-13 | 3-14 |
|---|---|---|---|---|---|
| When $n_1 \geq n_{10}$, | $n_{1m}=$ | 0.0385889 | 0.0449475 | 0.0561011 | 0.0760583 |
| When $n_1 < n_{10}$, | $n_{1m}=$ | 0.0454712 | 0.0531458 | 0.0356934 | 0.0583093 |
| When $k_1 \geq k_{10}$, | $k_{1m}=$ | 0.0478943 | 0.0493811 | 0.0460974 | 0.0520996 |
| When $k_1 < k_{10}$, | $k_{1m}=$ | 0.0361658 | 0.0330811 | 0.0363293 | 0.0375061 |
| When $d_1 \geq d_{10}$, | $d_{1m}$ (nm) $=$ | ∞ | ∞ | ∞ | ∞ |
| When $d_1 < d_{10}$, | $d_{1m}$ (nm) $=$ | 28.219 | 77.448 | 91.180 | 121.680 |
| When $n_2 \geq n_{20}$, | $n_{2m}=$ | 0.1522107 | 0.2230298 | 0.2904858 | 0.2858545 |
| When $n_2 < n_{20}$, | $n_{2m}=$ | 0.1781921 | 0.1009351 | 0.2457825 | 0.2068896 |
| When $k_2 \geq k_{20}$, | $k_{2m}=$ | 0.1157642 | 0.1063892 | 0.2056812 | 0.2216101 |
| When $k_2 < k_{20}$, | $k_{2m}=$ | 0.0805957 | 0.0617065 | 0.0977039 | 0.0829004 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 66.127 | 48.464 | 70.211 | 121.644 |

1. $1 < NA \leq 1.2$
$35 < T \leq 45$

| Case | 4-01 | 4-02 | 4-03 | 4-04 | 4-05 |
|---|---|---|---|---|---|
| $n_{10}$ | 1.8909619 | 1.9211597 | 1.8908364 | 1.8788634 | 1.7209142 |
| $k_{10}$ | 0.2198688 | 0.1299283 | 0.1293290 | 0.1089981 | 0.0850231 |
| $d_{10}$ (nm) | 30.886 | 20.325 | 14.409 | 12.666 | 94.685 |
| $n_{20}$ | 2.4457650 | 1.8999891 | 1.6971949 | 1.6934061 | 1.6569532 |
| $k_{20}$ | 0.9042920 | 0.4762728 | 0.3219355 | 0.2597468 | 0.2398462 |
| $d_{20}$ (nm) | 40.480 | 114.977 | 192.850 | 251.595 | 187.582 |

| | | 4-01 | 4-02 | 4-03 | 4-04 | 4-05 |
|---|---|---|---|---|---|---|
| When $n_1 \geq n_{10}$, | $n_{1m}=$ | 0.0581348 | 0.0702795 | 0.0908240 | 0.1067529 | 0.0340771 |
| When $n_1 < n_{10}$, | $n_{1m}=$ | 0.0408777 | 0.0430811 | 0.0541882 | 0.0719214 | 0.0077319 |
| When $k_1 \geq k_{10}$, | $k_{1m}=$ | 0.0449243 | 0.0499243 | 0.0741248 | 0.0961597 | 0.0239465 |
| When $k_1 < k_{10}$, | $k_{1m}=$ | 0.0797229 | 0.0798120 | 0.0963696 | 0.1066907 | 0.0329150 |
| When $d_1 \geq d_{10}$, | $d_{1m}$ (nm) $=$ | 4.322 | 5.448 | 5.786 | 6.719 | 11.856 |
| When $d_1 < d_{10}$, | $d_{1m}$ (nm) $=$ | 2.642 | 2.634 | 3.166 | 4.161 | 2.071 |
| When $n_2 \geq n_{20}$, | $n_{2m}=$ | 0.1853430 | 0.1162805 | 0.1041772 | 0.0995618 | 0.0224622 |
| When $n_2 < n_{20}$, | $n_{2m}=$ | 0.1757385 | 0.1461218 | 0.1390881 | 0.1365247 | 0.0731372 |
| When $k_2 \geq k_{20}$, | $k_{2m}=$ | 0.2033411 | 0.1671118 | 0.0936316 | 0.0897620 | 0.0193579 |
| When $k_2 < k_{20}$, | $k_{2m}=$ | 0.1615027 | 0.0988000 | 0.0865491 | 0.0806287 | 0.0502966 |
| When $d_2 \geq d_{20}$, | $d_{2m}$ (nm) $=$ | 5.473 | ∞ | ∞ | ∞ | 13.590 |
| When $d_2 < d_{20}$, | $d_{2m}$ (nm) $=$ | 4.339 | 20.871 | 70.442 | 87.096 | 16.661 |

1. 1 $<$ N A $\leq$ 1. 2
3 5 $<$ T $\leq$ 4 5

| Case | 4-06 | 4-07 | 4-08 | 4-09 | 4-10 |
|---|---|---|---|---|---|
| $n_{10}$ | 1.7236493 | 1.7053690 | 1.7096103 | 1.6884398 | 1.6913141 |
| $k_{10}$ | 0.0725136 | 0.0723352 | 0.0638708 | 0.0822671 | 0.0737244 |
| $d_{10}$ (nm) | 94.253 | 164.385 | 162.799 | 210.788 | 206.649 |
| $n_{20}$ | 1.6994520 | 1.6690598 | 1.7121782 | 1.7077650 | 1.6954335 |
| $k_{20}$ | 0.2004026 | 0.2212238 | 0.1844639 | 0.2979850 | 0.2262249 |
| $d_{20}$ (nm) | 239.752 | 181.544 | 233.616 | 132.459 | 199.430 |
| | | | | | |
| When $n_1 \geq n_{10}$, $n_{1m} =$ | 0.0432617 | 0.0328076 | 0.0449390 | 0.0103259 | 0.0357813 |
| When $n_1 < n_{10}$, $n_{1m} =$ | 0.0189111 | 0.0081836 | 0.0418201 | 0.0476318 | 0.0441882 |
| When $k_1 \geq k_{10}$, $k_{1m} =$ | 0.0428613 | 0.0134167 | 0.0270105 | 0.0240100 | 0.0467419 |
| When $k_1 < k_{10}$, $k_{1m} =$ | 0.0419373 | 0.0221985 | 0.0217126 | 0.0186353 | 0.0353625 |
| When $d_1 \geq d_{10}$, $d_{1m}$ (nm) $=$ | 19.395 | 21.834 | $\infty$ | 7.013 | $\infty$ |
| When $d_1 < d_{10}$, $d_{1m}$ (nm) $=$ | 5.406 | 2.666 | 6.246 | 21.283 | 26.527 |
| When $n_2 \geq n_{20}$, $n_{2m} =$ | 0.0587073 | 0.0279724 | 0.0684412 | 0.1217639 | 0.1437500 |
| When $n_2 < n_{20}$, $n_{2m} =$ | 0.0913135 | 0.0359949 | 0.0242969 | 0.0190967 | 0.1057874 |
| When $k_2 \geq k_{20}$, $k_{2m} =$ | 0.0407703 | 0.0058350 | 0.0150317 | 0.0602039 | 0.1122632 |
| When $k_2 < k_{20}$, $k_{2m} =$ | 0.0523291 | 0.0449670 | 0.0490210 | 0.0601965 | 0.0826379 |
| When $d_2 \geq d_{20}$, $d_{2m}$ (nm) $=$ | $\infty$ | 4.683 | 36.767 | $\infty$ | $\infty$ |
| When $d_2 < d_{20}$, $d_{2m}$ (nm) $=$ | 25.916 | 13.275 | 6.151 | 3.566 | 25.291 |

1. 1 $<$ N A $\leq$ 1. 2
3 5 $<$ T $\leq$ 4 5

| Case | 4-11 | 4-12 | 4-13 |
|---|---|---|---|
| $n_{10}$ | 1.6945163 | 1.7002615 | 1.6987767 |
| $k_{10}$ | 0.0596605 | 0.0658973 | 0.0602453 |
| $d_{10}$ (nm) | 219.093 | 265.562 | 264.538 |
| $n_{20}$ | 1.6879518 | 1.6991117 | 1.6924357 |
| $k_{20}$ | 0.1823501 | 0.2320843 | 0.1888152 |
| $d_{20}$ (nm) | 237.943 | 190.875 | 250.808 |

| When $n_1 \geq n_{10}$, $n_{1m} =$ | 0.0400159 | 0.0514929 | 0.0760449 |
|---|---|---|---|
| When $n_1 < n_{10}$, $n_{1m} =$ | 0.0454590 | 0.0339758 | 0.0578162 |
| When $k_1 \geq k_{10}$, $k_{1m} =$ | 0.0478894 | 0.0439832 | 0.0508728 |
| When $k_1 < k_{10}$, $k_{1m} =$ | 0.0318921 | 0.0347144 | 0.0365662 |
| When $d_1 \geq d_{10}$, $d_{1m}$ (nm) $=$ | $\infty$ | $\infty$ | $\infty$ |
| When $d_1 < d_{10}$, $d_{1m}$ (nm) $=$ | 53.950 | 89.870 | 117.603 |
| When $n_2 \geq n_{20}$, $n_{2m} =$ | 0.2316992 | 0.3028357 | 0.2948633 |
| When $n_2 < n_{20}$, $n_{2m} =$ | 0.0956519 | 0.2532336 | 0.2085193 |
| When $k_2 \geq k_{20}$, $k_{2m} =$ | 0.1045911 | 0.2056006 | 0.2209802 |
| When $k_2 < k_{20}$, $k_{2m} =$ | 0.0612427 | 0.1002246 | 0.0860327 |
| When $d_2 \geq d_{20}$, $d_{2m}$ (nm) $=$ | $\infty$ | $\infty$ | $\infty$ |
| When $d_2 < d_{20}$, $d_{2m}$ (nm) $=$ | 40.957 | 67.613 | 80.377 |

1. $1 < NA \leq 1.2$
$45 < T \leq 55$

| Case | 5-01 | 5-02 | 5-03 | 5-04 | 5-05 |
|---|---|---|---|---|---|
| $n_{10}$ | 1.9413239 | 1.8877645 | 1.8798429 | 1.7202563 | 1.7249517 |
| $k_{10}$ | 0.1405566 | 0.1445306 | 0.1135692 | 0.0870823 | 0.0739360 |
| $d_{10}$ (nm) | 18.043 | 14.095 | 12.637 | 94.214 | 94.041 |
| $n_{20}$ | 1.8442891 | 1.6688638 | 1.6888514 | 1.6489031 | 1.7027050 |
| $k_{20}$ | 0.4845639 | 0.3235014 | 0.2638544 | 0.2445724 | 0.2047377 |
| $d_{20}$ (nm) | 113.109 | 187.292 | 243.053 | 179.182 | 229.905 |

| | | 5-01 | 5-02 | 5-03 | 5-04 | 5-05 |
|---|---|---|---|---|---|---|
| When $n_1 \geq n_{10}$, | $n_{1m}=$ | 0.0724768 | 0.0904346 | 0.1062329 | 0.0324084 | 0.0425623 |
| When $n_1 < n_{10}$, | $n_{1m}=$ | 0.0387427 | 0.0534119 | 0.0716968 | 0.0082080 | 0.0177209 |
| When $k_1 \geq k_{10}$, | $k_{1m}=$ | 0.0483630 | 0.0753357 | 0.0968298 | 0.0243140 | 0.0418030 |
| When $k_1 < k_{10}$, | $k_{1m}=$ | 0.0803040 | 0.0945715 | 0.1060376 | 0.0343469 | 0.0406653 |
| When $d_1 \geq d_{10}$, | $d_{1m}$ (nm) $=$ | 4.823 | 5.486 | 6.573 | 10.670 | 17.560 |
| When $d_1 < d_{10}$, | $d_{1m}$ (nm) $=$ | 2.042 | 3.025 | 4.077 | 2.161 | 4.892 |
| When $n_2 \geq n_{20}$, | $n_{2m}=$ | 0.1074292 | 0.0972339 | 0.0967822 | 0.0242322 | 0.0621313 |
| When $n_2 < n_{20}$, | $n_{2m}=$ | 0.1555688 | 0.1383643 | 0.1358411 | 0.0727905 | 0.0930249 |
| When $k_2 \geq k_{20}$, | $k_{2m}=$ | 0.1308459 | 0.0862097 | 0.0881348 | 0.0180859 | 0.0388489 |
| When $k_2 < k_{20}$, | $k_{2m}=$ | 0.0911877 | 0.0843787 | 0.0806641 | 0.0488940 | 0.0530957 |
| When $d_2 \geq d_{20}$, | $d_{2m}$ (nm) $=$ | ∞ | ∞ | ∞ | 10.287 | ∞ |
| When $d_2 < d_{20}$, | $d_{2m}$ (nm) $=$ | 20.712 | 69.838 | 88.098 | 16.560 | 20.064 |

1. $1 < NA \leq 1.2$
$45 < T \leq 55$

| Case | 5-06 | 5-07 | 5-08 | 5-09 | 5-10 |
|---|---|---|---|---|---|
| $n_{10}$ | 1.7053831 | 1.7104785 | 1.6877471 | 1.6915115 | 1.6941672 |
| $k_{10}$ | 0.0736370 | 0.0654156 | 0.0844092 | 0.0739491 | 0.0608347 |
| $d_{10}$ (nm) | 163.843 | 162.671 | 209.661 | 205.513 | 218.889 |
| $n_{20}$ | 1.6671854 | 1.7160090 | 1.6959640 | 1.6904122 | 1.6879018 |
| $k_{20}$ | 0.2267475 | 0.1885946 | 0.3073448 | 0.2298496 | 0.1872431 |
| $d_{20}$ (nm) | 172.382 | 223.774 | 127.018 | 196.556 | 228.501 |

| | | 5-06 | 5-07 | 5-08 | 5-09 | 5-10 |
|---|---|---|---|---|---|---|
| When $n_1 \geq n_{10}$, | $n_{1m}=$ | 0.0309619 | 0.0440515 | 0.0051978 | 0.0335425 | 0.0357227 |
| When $n_1 < n_{10}$, | $n_{1m}=$ | 0.0112268 | 0.0078247 | 0.0453333 | 0.0430493 | 0.0410388 |
| When $k_1 \geq k_{10}$, | $k_{1m}=$ | 0.0149072 | 0.0196375 | 0.0173291 | 0.0473206 | 0.0467871 |
| When $k_1 < k_{10}$, | $k_{1m}=$ | 0.0262830 | 0.0141846 | 0.0154602 | 0.0372058 | 0.0305029 |
| When $d_1 \geq d_{10}$, | $d_{1m}$ (nm) $=$ | 19.247 | ∞ | 2.276 | ∞ | ∞ |
| When $d_1 < d_{10}$, | $d_{1m}$ (nm) $=$ | 3.447 | 2.046 | 19.587 | 24.997 | 50.391 |
| When $n_2 \geq n_{20}$, | $n_{2m}=$ | 0.0348413 | 0.0672729 | 0.1107800 | 0.1391333 | 0.2394653 |
| When $n_2 < n_{20}$, | $n_{2m}=$ | 0.0292676 | 0.0106921 | 0.0107263 | 0.0732312 | 0.0890649 |
| When $k_2 \geq k_{20}$, | $k_{2m}=$ | 0.0073389 | 0.0081616 | 0.0597644 | 0.1152246 | 0.1047815 |
| When $k_2 < k_{20}$, | $k_{2m}=$ | 0.0445459 | 0.0504346 | 0.0379138 | 0.0797473 | 0.0602527 |
| When $d_2 \geq d_{20}$, | $d_{2m}$ (nm) $=$ | 6.326 | 35.781 | 32.689 | ∞ | ∞ |
| When $d_2 < d_{20}$, | $d_{2m}$ (nm) $=$ | 11.802 | 2.505 | 1.901 | 20.558 | 36.515 |

1. $1 < NA \leq 1.2$
$45 < T \leq 55$

| Case | 5-11 | 5-12 | 5-13 |
|---|---|---|---|
| $n_{10}$ | 1.6941096 | 1.7000691 | 1.6987341 |
| $k_{10}$ | 0.0560046 | 0.0669711 | 0.0608862 |
| $d_{10}$ (nm) | 215.482 | 264.757 | 263.855 |
| $n_{20}$ | 1.6938988 | 1.6924460 | 1.6911373 |
| $k_{20}$ | 0.1599964 | 0.2378630 | 0.1924284 |
| $d_{20}$ (nm) | 287.470 | 184.028 | 243.250 |

| | | 5-11 | 5-12 | 5-13 |
|---|---|---|---|---|
| When $n_1 \geq n_{10}$, | $n_{1m} =$ | 0.0468335 | 0.0484424 | 0.0766663 |
| When $n_1 < n_{10}$, | $n_{1m} =$ | 0.0625427 | 0.0333350 | 0.0582520 |
| When $k_1 \geq k_{10}$, | $k_{1m} =$ | 0.0574133 | 0.0424146 | 0.0503235 |
| When $k_1 < k_{10}$, | $k_{1m} =$ | 0.0373425 | 0.0336023 | 0.0357239 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 47.031 | 45.336 | 115.043 |
| When $n_2 \geq n_{20}$, | $n_{2m} =$ | 0.2184277 | 0.3156848 | 0.3032751 |
| When $n_2 < n_{20}$, | $n_{2m} =$ | 0.1528296 | 0.2586377 | 0.2107019 |
| When $k_2 \geq k_{20}$, | $k_{2m} =$ | 0.1238171 | 0.2073083 | 0.2191870 |
| When $k_2 < k_{20}$, | $k_{2m} =$ | 0.0588196 | 0.0981323 | 0.0862329 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 85.352 | 66.135 | 78.131 |

1. $1 < NA \leq 1.2$
$55 < T \leq 65$

| Case | 6-01 | 6-02 | 6-03 | 6-04 | 6-05 |
|---|---|---|---|---|---|
| $n_{10}$ | 1.8998120 | 1.9599431 | 1.8792360 | 1.8920036 | 1.7198405 |
| $k_{10}$ | 0.2622743 | 0.1538418 | 0.1119058 | 0.0671877 | 0.0878543 |
| $d_{10}$ (nm) | 21.573 | 15.993 | 12.895 | 11.926 | 93.971 |
| $n_{20}$ | 1.6944131 | 1.7907917 | 1.6940206 | 1.7462722 | 1.6452515 |
| $k_{20}$ | 0.7809017 | 0.4780154 | 0.2681658 | 0.2347435 | 0.2473168 |
| $d_{20}$ (nm) | 53.320 | 111.028 | 231.714 | 280.522 | 169.419 |

| | | 6-01 | 6-02 | 6-03 | 6-04 | 6-05 |
|---|---|---|---|---|---|---|
| When $n_1 \geq n_{10}$, | $n_{1m} =$ | 0.0603137 | 0.0799158 | 0.1051331 | 0.1164221 | 0.0325574 |
| When $n_1 < n_{10}$, | $n_{1m} =$ | 0.0246228 | 0.0339001 | 0.0713818 | 0.0790796 | 0.0109656 |
| When $k_1 \geq k_{10}$, | $k_{1m} =$ | 0.0436731 | 0.0463733 | 0.0957117 | 0.1011499 | 0.0282458 |
| When $k_1 < k_{10}$, | $k_{1m} =$ | 0.0527222 | 0.0842969 | 0.1045093 | 0.0671877 | 0.0383301 |
| When $d_1 \geq d_{10}$, | $d_{1m}$ (nm) $=$ | 3.630 | 4.315 | 6.630 | 7.111 | 10.486 |
| When $d_1 < d_{10}$, | $d_{1m}$ (nm) $=$ | 1.338 | 1.548 | 4.149 | 4.416 | 2.879 |
| When $n_2 \geq n_{20}$, | $n_{2m} =$ | 0.1220337 | 0.0996899 | 0.0944202 | 0.0992114 | 0.0312585 |
| When $n_2 < n_{20}$, | $n_{2m} =$ | 0.0963342 | 0.1728088 | 0.1384424 | 0.1517053 | 0.0751245 |
| When $k_2 \geq k_{20}$, | $k_{2m} =$ | 0.0896167 | 0.0986731 | 0.0889478 | 0.0981226 | 0.0215662 |
| When $k_2 < k_{20}$, | $k_{2m} =$ | 0.0868945 | 0.0892566 | 0.0826782 | 0.0802551 | 0.0503503 |
| When $d_2 \geq d_{20}$, | $d_{2m}$ (nm) $=$ | 14.581 | $\infty$ | $\infty$ | $\infty$ | 10.833 |
| When $d_2 < d_{20}$, | $d_{2m}$ (nm) $=$ | 7.202 | 14.530 | 88.193 | 126.095 | 17.275 |

1. $1 < NA \leq 1.2$
$55 < T \leq 65$

| Case | 6-06 | 6-07 | 6-08 | 6-09 | 6-10 |
|---|---|---|---|---|---|
| $n_{10}$ | 1.7267515 | 1.7286377 | 1.7058235 | 1.6871196 | 1.6936372 |
| $k_{10}$ | 0.0746914 | 0.0697592 | 0.0740364 | 0.0856014 | 0.0616799 |
| $d_{10}$ (nm) | 93.982 | 94.711 | 163.674 | 208.540 | 218.466 |
| $n_{20}$ | 1.7088385 | 1.7257237 | 1.6690540 | 1.6832134 | 1.6877720 |
| $k_{20}$ | 0.2076415 | 0.1796886 | 0.2306007 | 0.3092532 | 0.1900717 |
| $d_{20}$ (nm) | 218.911 | 273.487 | 161.946 | 121.170 | 218.772 |

| | | 6-06 | 6-07 | 6-08 | 6-09 | 6-10 |
|---|---|---|---|---|---|---|
| When $n_1 \geq n_{10}$, | $n_{1m} =$ | 0.0431396 | 0.0483069 | 0.0312061 | 0.0049573 | 0.0327710 |
| When $n_1 < n_{10}$, | $n_{1m} =$ | 0.0172424 | 0.0116125 | 0.0175793 | 0.0417786 | 0.0401648 |
| When $k_1 \geq k_{10}$, | $k_{1m} =$ | 0.0418896 | 0.0318958 | 0.0202844 | 0.0152393 | 0.0462805 |
| When $k_1 < k_{10}$, | $k_{1m} =$ | 0.0396252 | 0.0362695 | 0.0328467 | 0.0174036 | 0.0298352 |
| When $d_1 \geq d_{10}$, | $d_{1m}$ (nm) $=$ | 17.247 | 40.127 | 17.394 | 2.172 | $\infty$ |
| When $d_1 < d_{10}$, | $d_{1m}$ (nm) $=$ | 4.621 | 3.300 | 5.870 | 18.309 | 47.643 |
| When $n_2 \geq n_{20}$, | $n_{2m} =$ | 0.0684570 | 0.0868091 | 0.0312744 | 0.1009155 | 0.2431030 |
| When $n_2 < n_{20}$, | $n_{2m} =$ | 0.0962207 | 0.1095422 | 0.0318677 | 0.0098169 | 0.0838513 |
| When $k_2 \geq k_{20}$, | $k_{2m} =$ | 0.0394080 | 0.0515259 | 0.0123767 | 0.0719922 | 0.1060815 |
| When $k_2 < k_{20}$, | $k_{2m} =$ | 0.0553357 | 0.0549243 | 0.0471436 | 0.0304236 | 0.0607056 |
| When $d_2 \geq d_{20}$, | $d_{2m}$ (nm) $=$ | $\infty$ | $\infty$ | 9.995 | 25.676 | $\infty$ |
| When $d_2 < d_{20}$, | $d_{2m}$ (nm) $=$ | 15.791 | 73.815 | 10.017 | 1.682 | 28.435 |

1. $1 < NA \leq 1.2$
$55 < T \leq 65$

| Case | 6-11 | 6-12 |
|---|---|---|
| $n_{10}$ | 1.6996002 | 1.6985143 |
| $k_{10}$ | 0.0674630 | 0.0611760 |
| $d_{10}$ (nm) | 264.231 | 263.586 |
| $n_{20}$ | 1.6851097 | 1.6903246 |
| $k_{20}$ | 0.2396601 | 0.1936289 |
| $d_{20}$ (nm) | 175.944 | 234.054 |

| | | 6-11 | 6-12 |
|---|---|---|---|
| When $n_1 \geq n_{10}$, | $n_{1m} =$ | 0.0469604 | 0.0772302 |
| When $n_1 < n_{10}$, | $n_{1m} =$ | 0.0345850 | 0.0600415 |
| When $k_1 \geq k_{10}$, | $k_{1m} =$ | 0.0413989 | 0.0503625 |
| When $k_1 < k_{10}$, | $k_{1m} =$ | 0.0326746 | 0.0352795 |
| When $d_1 \geq d_{10}$, | $d_{1m}$ (nm) $=$ | $\infty$ | $\infty$ |
| When $d_1 < d_{10}$, | $d_{1m}$ (nm) $=$ | 35.789 | 113.370 |
| When $n_2 \geq n_{20}$, | $n_{2m} =$ | 0.3361853 | 0.3175012 |
| When $n_2 < n_{20}$, | $n_{2m} =$ | 0.2595898 | 0.2115027 |
| When $k_2 \geq k_{20}$, | $k_{2m} =$ | 0.2087170 | 0.2189661 |
| When $k_2 < k_{20}$, | $k_{2m} =$ | 0.0954248 | 0.0859949 |
| When $d_2 \geq d_{20}$, | $d_{2m}$ (nm) $=$ | $\infty$ | $\infty$ |
| When $d_2 < d_{20}$, | $d_{2m}$ (nm) $=$ | 64.780 | 74.733 |

1. 1 < N A ≤ 1. 2
6 5 < T ≤ 7 5

| Case | 7-01 | 7-02 | 7-03 | 7-04 | 7-05 |
|---|---|---|---|---|---|
| $n_{10}$ | 1.8814830 | 1.9657443 | 1.8787154 | 1.8913468 | 1.7209187 |
| $k_{10}$ | 0.2936564 | 0.1688741 | 0.1109169 | 0.0695388 | 0.0883668 |
| $d_{10}$ (nm) | 22.098 | 15.852 | 13.263 | 12.162 | 94.055 |
| $n_{20}$ | 1.6321609 | 1.7726563 | 1.6996278 | 1.7469121 | 1.6482914 |
| $k_{20}$ | 0.8097385 | 0.4923001 | 0.2745566 | 0.2387131 | 0.2540527 |
| $d_{20}$ (nm) | 46.190 | 103.170 | 220.404 | 270.807 | 158.511 |

| | | 7-01 | 7-02 | 7-03 | 7-04 | 7-05 |
|---|---|---|---|---|---|---|
| When $n_1 \geq n_{10}$, | $n_{1m} =$ | 0.0656360 | 0.0817346 | 0.1037085 | 0.1149512 | 0.0333252 |
| When $n_1 < n_{10}$, | $n_{1m} =$ | 0.0241089 | 0.0282544 | 0.0702112 | 0.0769897 | 0.0127490 |
| When $k_1 \geq k_{10}$, | $k_{1m} =$ | 0.0378577 | 0.0400220 | 0.0934888 | 0.0991272 | 0.0301257 |
| When $k_1 < k_{10}$, | $k_{1m} =$ | 0.0323035 | 0.0824512 | 0.1025916 | 0.0695388 | 0.0388867 |
| When $d_1 \geq d_{10}$, | $d_{1m}$ (nm) $=$ | 3.610 | 3.980 | 6.711 | 7.159 | 10.691 |
| When $d_1 < d_{10}$, | $d_{1m}$ (nm) $=$ | 1.297 | 1.237 | 4.191 | 4.366 | 3.330 |
| When $n_2 \geq n_{20}$, | $n_{2m} =$ | 0.1024585 | 0.0947095 | 0.0935791 | 0.1004138 | 0.0355066 |
| When $n_2 < n_{20}$, | $n_{2m} =$ | 0.0645630 | 0.1828857 | 0.1422339 | 0.1540833 | 0.0767798 |
| When $k_2 \geq k_{20}$, | $k_{2m} =$ | 0.0898303 | 0.0894482 | 0.0904114 | 0.0989551 | 0.0244946 |
| When $k_2 < k_{20}$, | $k_{2m} =$ | 0.1003796 | 0.0949036 | 0.0851941 | 0.0816284 | 0.0535193 |
| When $d_2 \geq d_{20}$, | $d_{2m}$ (nm) $=$ | 11.613 | ∞ | ∞ | ∞ | 11.010 |
| When $d_2 < d_{20}$, | $d_{2m}$ (nm) $=$ | 4.416 | 10.112 | 84.053 | 124.915 | 16.505 |

1. 1 < N A ≤ 1. 2
6 5 < T ≤ 7 5

| Case | 7-06 | 7-07 | 7-08 | 7-09 | 7-10 |
|---|---|---|---|---|---|
| $n_{10}$ | 1.7288665 | 1.7286370 | 1.7068032 | 1.6862856 | 1.6931399 |
| $k_{10}$ | 0.0756184 | 0.0709992 | 0.0744994 | 0.0878163 | 0.0624918 |
| $d_{10}$ (nm) | 94.090 | 94.923 | 163.814 | 208.124 | 217.968 |
| $n_{20}$ | 1.7153723 | 1.7241262 | 1.6739446 | 1.6736237 | 1.6872372 |
| $k_{20}$ | 0.2125971 | 0.1831189 | 0.2371534 | 0.3138657 | 0.1926334 |
| $d_{20}$ (nm) | 207.924 | 263.961 | 151.052 | 112.320 | 209.546 |

| | | 7-06 | 7-07 | 7-08 | 7-09 | 7-10 |
|---|---|---|---|---|---|---|
| When $n_1 \geq n_{10}$, | $n_{1m} =$ | 0.0437573 | 0.0483350 | 0.0322754 | 0.0025049 | 0.0316833 |
| When $n_1 < n_{10}$, | $n_{1m} =$ | 0.0164966 | 0.0099878 | 0.0175537 | 0.0409570 | 0.0419177 |
| When $k_1 \geq k_{10}$, | $k_{1m} =$ | 0.0410425 | 0.0291785 | 0.0221094 | 0.0095605 | 0.0459827 |
| When $k_1 < k_{10}$, | $k_{1m} =$ | 0.0388428 | 0.0344531 | 0.0333215 | 0.0151172 | 0.0300720 |
| When $d_1 \geq d_{10}$, | $d_{1m}$ (nm) $=$ | 17.329 | 38.775 | 18.851 | 1.009 | ∞ |
| When $d_1 < d_{10}$, | $d_{1m}$ (nm) $=$ | 4.318 | 2.813 | 6.154 | 17.032 | 45.887 |
| When $n_2 \geq n_{20}$, | $n_{2m} =$ | 0.0710437 | 0.0893457 | 0.0302136 | 0.1037878 | 0.2406421 |
| When $n_2 < n_{20}$, | $n_{2m} =$ | 0.0969080 | 0.1083484 | 0.0331750 | 0.0056763 | 0.0830054 |
| When $k_2 \geq k_{20}$, | $k_{2m} =$ | 0.0400586 | 0.0500842 | 0.0147241 | 0.0658289 | 0.1059290 |
| When $k_2 < k_{20}$, | $k_{2m} =$ | 0.0574512 | 0.0562378 | 0.0506323 | 0.0175342 | 0.0630762 |
| When $d_2 \geq d_{20}$, | $d_{2m}$ (nm) $=$ | ∞ | ∞ | 10.293 | 26.205 | ∞ |
| When $d_2 < d_{20}$, | $d_{2m}$ (nm) $=$ | 13.701 | 72.849 | 8.984 | 0.992 | 28.220 |

1. 1 < N A ≤ 1. 2
6 5 < T ≤ 7 5

| Case | 7-11 | 7-12 | 7-13 |
|---|---|---|---|
| $n_{10}$ | 1.6935780 | 1.6987845 | 1.6982075 |
| $k_{10}$ | 0.0575917 | 0.0682876 | 0.0620058 |
| $d_{10}$ (nm) | 214.501 | 264.829 | 264.409 |
| $n_{20}$ | 1.6927449 | 1.6826884 | 1.6907687 |
| $k_{20}$ | 0.1631490 | 0.2430960 | 0.1959423 |
| $d_{20}$ (nm) | 269.036 | 164.540 | 222.065 |

| | | 7-11 | 7-12 | 7-13 |
|---|---|---|---|---|
| When $n_1 \geq n_{10}$, | $n_{1m} =$ | 0.0479456 | 0.0478223 | 0.0756042 |
| When $n_1 < n_{10}$, | $n_{1m} =$ | 0.0597888 | 0.0375256 | 0.0523840 |
| When $k_1 \geq k_{10}$, | $k_{1m} =$ | 0.0567029 | 0.0406042 | 0.0502747 |
| When $k_1 < k_{10}$, | $k_{1m} =$ | 0.0379382 | 0.0306238 | 0.0354358 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 42.775 | 36.115 | 105.289 |
| When $n_2 \geq n_{20}$, | $n_{2m} =$ | 0.2180396 | 0.3702002 | 0.3412915 |
| When $n_2 < n_{20}$, | $n_{2m} =$ | 0.1575122 | 0.2565369 | 0.2093115 |
| When $k_2 \geq k_{20}$, | $k_{2m} =$ | 0.1278589 | 0.2070850 | 0.2215063 |
| When $k_2 < k_{20}$, | $k_{2m} =$ | 0.0614197 | 0.0951270 | 0.0864294 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 81.766 | 63.144 | 76.945 |

1. 1 < N A ≤ 1. 2
7 5 < T ≤ 8 5

| Case | 8-01 | 8-02 | 8-03 | 8-04 | 8-05 |
|---|---|---|---|---|---|
| $n_{10}$ | 1.8508920 | 1.9432602 | 1.8788012 | 1.8809660 | 1.8914032 |
| $k_{10}$ | 0.3299462 | 0.1828608 | 0.1571474 | 0.1122948 | 0.0691945 |
| $d_{10}$ (nm) | 26.713 | 18.534 | 15.200 | 13.670 | 12.762 |
| $n_{20}$ | 1.6561984 | 1.7922587 | 1.6553949 | 1.7045069 | 1.7559855 |
| $k_{20}$ | 1.0215947 | 0.5435792 | 0.3498651 | 0.2862016 | 0.2487147 |
| $d_{20}$ (nm) | 31.481 | 89.452 | 157.519 | 210.391 | 259.753 |

| | | 8-01 | 8-02 | 8-03 | 8-04 | 8-05 |
|---|---|---|---|---|---|---|
| When $n_1 \geq n_{10}$, | $n_{1m} =$ | 0.0584900 | 0.0721143 | 0.0859290 | 0.1006885 | 0.1098987 |
| When $n_1 < n_{10}$, | $n_{1m} =$ | 0.0118384 | 0.0258594 | 0.0490076 | 0.0672168 | 0.0736646 |
| When $k_1 \geq k_{10}$, | $k_{1m} =$ | 0.0281628 | 0.0341772 | 0.0681653 | 0.0888281 | 0.0935315 |
| When $k_1 < k_{10}$, | $k_{1m} =$ | 0.0027112 | 0.0735254 | 0.0892920 | 0.1016174 | 0.0691945 |
| When $d_1 \geq d_{10}$, | $d_{1m}$ (nm) $=$ | 3.227 | 4.317 | 5.436 | 6.605 | 7.111 |
| When $d_1 < d_{10}$, | $d_{1m}$ (nm) $=$ | 0.304 | 1.291 | 2.967 | 4.063 | 4.341 |
| When $n_2 \geq n_{20}$, | $n_{2m} =$ | 0.1267358 | 0.0961279 | 0.0835156 | 0.0933350 | 0.1000793 |
| When $n_2 < n_{20}$, | $n_{2m} =$ | 0.0093018 | 0.1747852 | 0.1389221 | 0.1466003 | 0.1520386 |
| When $k_2 \geq k_{20}$, | $k_{2m} =$ | 0.0170300 | 0.1198535 | 0.0846472 | 0.0918018 | 0.1012305 |
| When $k_2 < k_{20}$, | $k_{2m} =$ | 0.1219019 | 0.1040369 | 0.0912122 | 0.0867468 | 0.0829492 |
| When $d_2 \geq d_{20}$, | $d_{2m}$ (nm) $=$ | 8.195 | ∞ | ∞ | ∞ | ∞ |
| When $d_2 < d_{20}$, | $d_{2m}$ (nm) $=$ | 0.369 | 9.559 | 36.990 | 78.480 | 119.640 |

1. $1 < NA \leq 1.2$
$75 < T \leq 85$

| Case | 8-06 | 8-07 | 8-08 | 8-09 | 8-10 |
|---|---|---|---|---|---|
| $n_{10}$ | 1.7233184 | 1.7297992 | 1.7292921 | 1.7076375 | 1.6902915 |
| $k_{10}$ | 0.0905387 | 0.0774990 | 0.0722395 | 0.0765186 | 0.0790058 |
| $d_{10}$ (nm) | 94.254 | 94.232 | 94.957 | 163.992 | 206.654 |
| $n_{20}$ | 1.6520214 | 1.7157415 | 1.7247476 | 1.6752795 | 1.6879680 |
| $k_{20}$ | 0.2670378 | 0.2209454 | 0.1892941 | 0.2482558 | 0.2475793 |
| $d_{20}$ (nm) | 148.504 | 198.899 | 254.857 | 141.650 | 161.284 |

| | | 8-06 | 8-07 | 8-08 | 8-09 | 8-10 |
|---|---|---|---|---|---|---|
| When $n_1 \geq n_{10}$, | $n_{1m} =$ | 0.0327246 | 0.0427734 | 0.0473462 | 0.0318115 | 0.0212964 |
| When $n_1 < n_{10}$, | $n_{1m} =$ | 0.0093958 | 0.0147302 | 0.0094299 | 0.0087695 | 0.0407813 |
| When $k_1 \geq k_{10}$, | $k_{1m} =$ | 0.0245129 | 0.0376636 | 0.0278931 | 0.0137170 | 0.0408545 |
| When $k_1 < k_{10}$, | $k_{1m} =$ | 0.0384680 | 0.0381934 | 0.0341284 | 0.0285461 | 0.0259851 |
| When $d_1 \geq d_{10}$, | $d_{1m}$ (nm) $=$ | 10.366 | 16.607 | 38.446 | 19.131 | 18.064 |
| When $d_1 < d_{10}$, | $d_{1m}$ (nm) $=$ | 2.389 | 3.804 | 2.614 | 2.661 | 24.299 |
| When $n_2 \geq n_{20}$, | $n_{2m} =$ | 0.0285376 | 0.0673352 | 0.0815320 | 0.0313904 | 0.1426208 |
| When $n_2 < n_{20}$, | $n_{2m} =$ | 0.0743250 | 0.0929968 | 0.1051160 | 0.0237683 | 0.0535938 |
| When $k_2 \geq k_{20}$, | $k_{2m} =$ | 0.0198962 | 0.0371387 | 0.0465576 | 0.0076379 | 0.0976270 |
| When $k_2 < k_{20}$, | $k_{2m} =$ | 0.0547290 | 0.0576892 | 0.0565930 | 0.0508740 | 0.0749768 |
| When $d_2 \geq d_{20}$, | $d_{2m}$ (nm) $=$ | 8.585 | ∞ | ∞ | 6.981 | ∞ |
| When $d_2 < d_{20}$, | $d_{2m}$ (nm) $=$ | 13.959 | 13.822 | 33.284 | 7.469 | 13.904 |

1. $1 < NA \leq 1.2$
$75 < T \leq 85$

| Case | 8-11 | 8-12 | 8-13 | 8-14 | 8-15 |
|---|---|---|---|---|---|
| $n_{10}$ | 1.6929156 | 1.6935338 | 1.6984313 | 1.6980068 | 1.6970347 |
| $k_{10}$ | 0.0637318 | 0.0581307 | 0.0697413 | 0.0633264 | 0.0530849 |
| $d_{10}$ (nm) | 217.693 | 214.870 | 266.256 | 265.782 | 275.682 |
| $n_{20}$ | 1.6856131 | 1.6920922 | 1.6871666 | 1.6912942 | 1.6884244 |
| $k_{20}$ | 0.1973081 | 0.1667488 | 0.2538157 | 0.2022310 | 0.1714348 |
| $d_{20}$ (nm) | 201.188 | 259.776 | 152.235 | 210.360 | 256.304 |

| | | 8-11 | 8-12 | 8-13 | 8-14 | 8-15 |
|---|---|---|---|---|---|---|
| When $n_1 \geq n_{10}$, | $n_{1m} =$ | 0.0321716 | 0.0471802 | 0.0486719 | 0.0738318 | 0.0569543 |
| When $n_1 < n_{10}$, | $n_{1m} =$ | 0.0414331 | 0.0603931 | 0.0363989 | 0.0470300 | 0.0427893 |
| When $k_1 \geq k_{10}$, | $k_{1m} =$ | 0.0451428 | 0.0559961 | 0.0398804 | 0.0494763 | 0.0598206 |
| When $k_1 < k_{10}$, | $k_{1m} =$ | 0.0289417 | 0.0378210 | 0.0291638 | 0.0345105 | 0.0376172 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 45.410 | 42.667 | 37.515 | 100.900 | 104.445 |
| When $n_2 \geq n_{20}$, | $n_{2m} =$ | 0.2377576 | 0.2179382 | 0.2594739 | 0.3590393 | 0.2768311 |
| When $n_2 < n_{20}$, | $n_{2m} =$ | 0.0859351 | 0.1565027 | 0.2556433 | 0.2089795 | 0.2197266 |
| When $k_2 \geq k_{20}$, | $k_{2m} =$ | 0.1024292 | 0.1246008 | 0.1994592 | 0.2211169 | 0.1929004 |
| When $k_2 < k_{20}$, | $k_{2m} =$ | 0.0656946 | 0.0632471 | 0.1014087 | 0.0895886 | 0.0738538 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 33.167 | 82.155 | 62.366 | 73.160 | 83.598 |

1. $1 < NA \leq 1.2$
$85 < T \leq 95$

| Case | | 9-01 | 9-02 | 9-03 | 9-04 | 9-05 |
|---|---|---|---|---|---|---|
| $n_{10}$ | | 1.9192397 | 1.8910111 | 1.8874292 | 1.8928956 | 1.7266669 |
| $k_{10}$ | | 0.1987767 | 0.1570861 | 0.1170062 | 0.0800147 | 0.0953661 |
| $d_{10}$ (nm) | | 21.654 | 15.844 | 13.907 | 12.695 | 94.323 |
| $n_{20}$ | | 1.8264016 | 1.6782576 | 1.7063011 | 1.7424852 | 1.6542284 |
| $k_{20}$ | | 0.6189774 | 0.3828036 | 0.3024107 | 0.2571531 | 0.2869718 |
| $d_{20}$ (nm) | | 76.882 | 146.288 | 201.867 | 254.323 | 139.595 |

| | | 9-01 | 9-02 | 9-03 | 9-04 | 9-05 |
|---|---|---|---|---|---|---|
| When $n_1 \geq n_{10}$, | $n_{1m} =$ | 0.0649170 | 0.0821021 | 0.0973254 | 0.1089844 | 0.0299609 |
| When $n_1 < n_{10}$, | $n_{1m} =$ | 0.0262927 | 0.0442981 | 0.0631677 | 0.0721631 | 0.0018164 |
| When $k_1 \geq k_{10}$, | $k_{1m} =$ | 0.0313647 | 0.0611023 | 0.0836865 | 0.0928955 | 0.0075598 |
| When $k_1 < k_{10}$, | $k_{1m} =$ | 0.0678699 | 0.0898816 | 0.1010254 | 0.0800147 | 0.0251917 |
| When $d_1 \geq d_{10}$, | $d_{1m}$ (nm) $=$ | 4.482 | 5.181 | 6.239 | 6.859 | 9.178 |
| When $d_1 < d_{10}$, | $d_{1m}$ (nm) $=$ | 1.480 | 2.625 | 3.732 | 4.138 | 0.436 |
| When $n_2 \geq n_{20}$, | $n_{2m} =$ | 0.0987671 | 0.0845752 | 0.0932324 | 0.0997229 | 0.0068860 |
| When $n_2 < n_{20}$, | $n_{2m} =$ | 0.1650610 | 0.1381567 | 0.1431714 | 0.1501294 | 0.0677319 |
| When $k_2 \geq k_{20}$, | $k_{2m} =$ | 0.1657446 | 0.0892700 | 0.0918542 | 0.0980688 | 0.0046692 |
| When $k_2 < k_{20}$, | $k_{2m} =$ | 0.1121045 | 0.0937854 | 0.0873950 | 0.0830798 | 0.0530042 |
| When $d_2 \geq d_{20}$, | $d_{2m}$ (nm) $=$ | $\infty$ | $\infty$ | $\infty$ | $\infty$ | 2.101 |
| When $d_2 < d_{20}$, | $d_{2m}$ (nm) $=$ | 12.789 | 29.518 | 73.873 | 87.951 | 11.267 |

1. $1 < NA \leq 1.2$
$85 < T \leq 95$

| Case | | 9-06 | 9-07 | 9-08 | 9-09 | 9-10 |
|---|---|---|---|---|---|---|
| $n_{10}$ | | 1.7296393 | 1.7299249 | 1.6899362 | 1.6928826 | 1.6935628 |
| $k_{10}$ | | 0.0805906 | 0.0737621 | 0.0817785 | 0.0657282 | 0.0590519 |
| $d_{10}$ (nm) | | 94.242 | 94.784 | 208.164 | 217.665 | 215.464 |
| $n_{20}$ | | 1.7097783 | 1.7252153 | 1.6924320 | 1.6832004 | 1.6914497 |
| $k_{20}$ | | 0.2319224 | 0.1970612 | 0.2651701 | 0.2055611 | 0.1728158 |
| $d_{20}$ (nm) | | 191.543 | 246.491 | 148.618 | 193.166 | 250.826 |

| | | 9-06 | 9-07 | 9-08 | 9-09 | 9-10 |
|---|---|---|---|---|---|---|
| When $n_1 \geq n_{10}$, | $n_{1m} =$ | 0.0403186 | 0.0454016 | 0.0167883 | 0.0332178 | 0.0456592 |
| When $n_1 < n_{10}$, | $n_{1m} =$ | 0.0112720 | 0.0089185 | 0.0424597 | 0.0374463 | 0.0611377 |
| When $k_1 \geq k_{10}$, | $k_{1m} =$ | 0.0312561 | 0.0265295 | 0.0332300 | 0.0436560 | 0.0547620 |
| When $k_1 < k_{10}$, | $k_{1m} =$ | 0.0359937 | 0.0340186 | 0.0176221 | 0.0271997 | 0.0369495 |
| When $d_1 \geq d_{10}$, | $d_{1m}$ (nm) $=$ | 14.915 | 25.988 | 8.734 | $\infty$ | $\infty$ |
| When $d_1 < d_{10}$, | $d_{1m}$ (nm) $=$ | 2.867 | 2.423 | 22.681 | 45.245 | 43.081 |
| When $n_2 \geq n_{20}$, | $n_{2m} =$ | 0.0542737 | 0.0673303 | 0.1469031 | 0.2426758 | 0.2225391 |
| When $n_2 < n_{20}$, | $n_{2m} =$ | 0.0873267 | 0.0993994 | 0.0330542 | 0.0887622 | 0.1544177 |
| When $k_2 \geq k_{20}$, | $k_{2m} =$ | 0.0292090 | 0.0400476 | 0.0700159 | 0.0962317 | 0.1187769 |
| When $k_2 < k_{20}$, | $k_{2m} =$ | 0.0563428 | 0.0561450 | 0.0687061 | 0.0675110 | 0.0629883 |
| When $d_2 \geq d_{20}$, | $d_{2m}$ (nm) $=$ | 39.648 | $\infty$ | $\infty$ | $\infty$ | $\infty$ |
| When $d_2 < d_{20}$, | $d_{2m}$ (nm) $=$ | 14.552 | 29.955 | 9.727 | 29.747 | 77.934 |

## 1. 1$^<$ N A $\leq$ 1. 2
## 8 5 $^<$ T $\leq$ 9 5

| Case | 9-11 | 9-12 | 9-13 |
|---|---|---|---|
| $n_{10}$ | 1.6988269 | 1.6981501 | 1.6968464 |
| $k_{10}$ | 0.0719884 | 0.0650380 | 0.0544760 |
| $d_{10}$ (nm) | 266.949 | 266.102 | 275.663 |
| $n_{20}$ | 1.6930572 | 1.6910453 | 1.6860880 |
| $k_{20}$ | 0.2717519 | 0.2123559 | 0.1778694 |
| $d_{20}$ (nm) | 142.233 | 201.439 | 248.323 |

| | | 9-11 | 9-12 | 9-13 |
|---|---|---|---|---|
| When $n_1 \geq n_{10}$, | $n_{1m}=$ | 0.0467688 | 0.0728052 | 0.0574890 |
| When $n_1 < n_{10}$, | $n_{1m}=$ | 0.0315735 | 0.0440601 | 0.0431165 |
| When $k_1 \geq k_{10}$, | $k_{1m}=$ | 0.0383911 | 0.0476294 | 0.0587781 |
| When $k_1 < k_{10}$, | $k_{1m}=$ | 0.0284839 | 0.0337549 | 0.0370691 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 35.571 | 98.568 | 104.018 |
| When $n_2 \geq n_{20}$, | $n_{2m}=$ | 0.2475818 | 0.3536121 | 0.2819006 |
| When $n_2 < n_{20}$, | $n_{2m}=$ | 0.2616077 | 0.2147424 | 0.2120007 |
| When $k_2 \geq k_{20}$, | $k_{2m}=$ | 0.1929529 | 0.2177991 | 0.1925061 |
| When $k_2 < k_{20}$, | $k_{2m}=$ | 0.1103821 | 0.0937061 | 0.0749585 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 61.377 | 69.390 | 80.535 |

## 1. 1$^<$ N A $\leq$ 1. 2
## 9 5 $^<$ T $\leq$ 1 0 5

| Case | 10-01 | 10-02 | 10-03 | 10-04 | 10-05 |
|---|---|---|---|---|---|
| $n_{10}$ | 1.9207610 | 1.9093240 | 1.8948938 | 1.8966282 | 1.7293323 |
| $k_{10}$ | 0.2195112 | 0.1610220 | 0.1257399 | 0.0900141 | 0.0843251 |
| $d_{10}$ (nm) | 22.312 | 16.027 | 13.855 | 12.530 | 93.974 |
| $n_{20}$ | 1.8258536 | 1.6981498 | 1.7003095 | 1.7305926 | 1.7018671 |
| $k_{20}$ | 0.6986358 | 0.4189775 | 0.3177305 | 0.2658040 | 0.2432029 |
| $d_{20}$ (nm) | 68.737 | 136.163 | 194.613 | 248.346 | 184.391 |

| | | 10-01 | 10-02 | 10-03 | 10-04 | 10-05 |
|---|---|---|---|---|---|---|
| When $n_1 \geq n_{10}$, | $n_{1m}=$ | 0.0601465 | 0.0788086 | 0.0949231 | 0.1082007 | 0.0364734 |
| When $n_1 < n_{10}$, | $n_{1m}=$ | 0.0227283 | 0.0400269 | 0.0595679 | 0.0706311 | 0.0069092 |
| When $k_1 \geq k_{10}$, | $k_{1m}=$ | 0.0253723 | 0.0545032 | 0.0804407 | 0.0926099 | 0.0227478 |
| When $k_1 < k_{10}$, | $k_{1m}=$ | 0.0628345 | 0.0889185 | 0.1005603 | 0.0900141 | 0.0311768 |
| When $d_1 \geq d_{10}$, | $d_{1m}$ (nm) $=$ | 3.994 | 4.715 | 5.765 | 6.514 | 12.891 |
| When $d_1 < d_{10}$, | $d_{1m}$ (nm) $=$ | 1.248 | 2.209 | 3.348 | 3.879 | 1.711 |
| When $n_2 \geq n_{20}$, | $n_{2m}=$ | 0.0792419 | 0.0821826 | 0.0922205 | 0.0989185 | 0.0380920 |
| When $n_2 < n_{20}$, | $n_{2m}=$ | 0.1602795 | 0.1375000 | 0.1411267 | 0.1492065 | 0.0806519 |
| When $k_2 \geq k_{20}$, | $k_{2m}=$ | 0.1589185 | 0.0905359 | 0.0891418 | 0.0944934 | 0.0182117 |
| When $k_2 < k_{20}$, | $k_{2m}=$ | 0.1093127 | 0.0931641 | 0.0864453 | 0.0826196 | 0.0535706 |
| When $d_2 \geq d_{20}$, | $d_{2m}$ (nm) $=$ | $\infty$ | $\infty$ | $\infty$ | $\infty$ | 26.631 |
| When $d_2 < d_{20}$, | $d_{2m}$ (nm) $=$ | 11.170 | 27.297 | 70.361 | 86.529 | 13.056 |

1. $1 < NA \leq 1.2$
$95 < T \leq 105$

| Case | 10-06 | 10-07 | 10-08 | 10-09 | 10-10 |
|---|---|---|---|---|---|
| $n_{10}$ | 1.7301568 | 1.6896128 | 1.6928686 | 1.6935394 | 1.6995193 |
| $k_{10}$ | 0.0757850 | 0.0845530 | 0.0680057 | 0.0604311 | 0.0747728 |
| $d_{10}$ (nm) | 94.458 | 207.994 | 217.789 | 215.751 | 266.467 |
| $n_{20}$ | 1.7237225 | 1.6930315 | 1.6806392 | 1.6908086 | 1.6953349 |
| $k_{20}$ | 0.2045935 | 0.2839311 | 0.2160083 | 0.1799717 | 0.2921202 |
| $d_{20}$ (nm) | 238.500 | 141.193 | 184.741 | 242.024 | 134.479 |

| | | 10-06 | 10-07 | 10-08 | 10-09 | 10-10 |
|---|---|---|---|---|---|---|
| When $n_1 \geq n_{10}$, | $n_{1m} =$ | 0.0430542 | 0.0132361 | 0.0331689 | 0.0442139 | 0.0436938 |
| When $n_1 < n_{10}$, | $n_{1m} =$ | 0.0073706 | 0.0419458 | 0.0316418 | 0.0535156 | 0.0268311 |
| When $k_1 \geq k_{10}$, | $k_{1m} =$ | 0.0232617 | 0.0264368 | 0.0418604 | 0.0531323 | 0.0358801 |
| When $k_1 < k_{10}$, | $k_{1m} =$ | 0.0323706 | 0.0142944 | 0.0250220 | 0.0355676 | 0.0274768 |
| When $d_1 \geq d_{10}$, | $d_{1m}$ (nm) $=$ | 19.826 | 5.860 | ∞ | ∞ | ∞ |
| When $d_1 < d_{10}$, | $d_{1m}$ (nm) $=$ | 1.955 | 19.840 | 44.604 | 42.829 | 18.631 |
| When $n_2 \geq n_{20}$, | $n_{2m} =$ | 0.0534583 | 0.1398230 | 0.2538293 | 0.2308789 | 0.2386206 |
| When $n_2 < n_{20}$, | $n_{2m} =$ | 0.0961475 | 0.0183801 | 0.0879700 | 0.1305579 | 0.2731067 |
| When $k_2 \geq k_{20}$, | $k_{2m} =$ | 0.0309888 | 0.0515918 | 0.0900964 | 0.1145776 | 0.1883105 |
| When $k_2 < k_{20}$, | $k_{2m} =$ | 0.0550842 | 0.0676599 | 0.0668372 | 0.0642163 | 0.1153723 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 28.701 | 3.697 | 28.484 | 75.626 | 22.552 |

1. $1 < NA \leq 1.2$
$95 < T \leq 105$

| Case | 10-11 | 10-12 |
|---|---|---|
| $n_{10}$ | 1.6986281 | 1.6967467 |
| $k_{10}$ | 0.0669339 | 0.0559821 |
| $d_{10}$ (nm) | 265.290 | 275.562 |
| $n_{20}$ | 1.6902923 | 1.6844237 |
| $k_{20}$ | 0.2238725 | 0.1853984 |
| $d_{20}$ (nm) | 194.429 | 239.846 |

| | | 10-11 | 10-12 |
|---|---|---|---|
| When $n_1 \geq n_{10}$, | $n_{1m} =$ | 0.0728162 | 0.0573596 |
| When $n_1 < n_{10}$, | $n_{1m} =$ | 0.0413391 | 0.0430261 |
| When $k_1 \geq k_{10}$, | $k_{1m} =$ | 0.0452283 | 0.0576135 |
| When $k_1 < k_{10}$, | $k_{1m} =$ | 0.0327722 | 0.0361206 |
| When $d_1 \geq d_{10}$, | $d_{1m}$ (nm) $=$ | ∞ | ∞ |
| When $d_1 < d_{10}$, | $d_{1m}$ (nm) $=$ | 90.187 | 103.212 |
| When $n_2 \geq n_{20}$, | $n_{2m} =$ | 0.3400000 | 0.2868152 |
| When $n_2 < n_{20}$, | $n_{2m} =$ | 0.2235767 | 0.2105566 |
| When $k_2 \geq k_{20}$, | $k_{2m} =$ | 0.2178235 | 0.1919788 |
| When $k_2 < k_{20}$, | $k_{2m} =$ | 0.0973718 | 0.0774072 |
| When $d_2 \geq d_{20}$, | $d_{2m}$ (nm) $=$ | ∞ | ∞ |
| When $d_2 < d_{20}$, | $d_{2m}$ (nm) $=$ | 66.928 | 79.000 |

1. 1 $<$ N A $\leq$ 1. 2
1 0 5 $<$ T $\leq$ 1 1 5

| Case | 11-01 | 11-02 | 11-03 | 11-04 | 11-05 |
|---|---|---|---|---|---|
| $n_{10}$ | 1.9214172 | 1.9009993 | 1.8999222 | 1.7289797 | 1.7301397 |
| $k_{10}$ | 0.1753360 | 0.1351301 | 0.0954510 | 0.0876375 | 0.0779683 |
| $d_{10}$ (nm) | 15.452 | 13.611 | 12.469 | 93.472 | 94.062 |
| $n_{20}$ | 1.6804411 | 1.6899586 | 1.7262130 | 1.6943958 | 1.7208177 |
| $k_{20}$ | 0.4367098 | 0.3280314 | 0.2728992 | 0.2513033 | 0.2098777 |
| $d_{20}$ (nm) | 129.893 | 187.370 | 240.318 | 176.630 | 230.281 |

| | | 11-01 | 11-02 | 11-03 | 11-04 | 11-05 |
|---|---|---|---|---|---|---|
| When $n_1 \geq n_{10}$, | $n_{1m}=$ | 0.0769006 | 0.0933704 | 0.1067993 | 0.0330078 | 0.0410352 |
| When $n_1 < n_{10}$, | $n_{1m}=$ | 0.0358716 | 0.0572852 | 0.0688867 | 0.0032751 | 0.0048413 |
| When $k_1 \geq k_{10}$, | $k_{1m}=$ | 0.0508276 | 0.0793042 | 0.0916321 | 0.0140979 | 0.0177686 |
| When $k_1 < k_{10}$, | $k_{1m}=$ | 0.0888501 | 0.0996167 | 0.0954510 | 0.0244348 | 0.0282959 |
| When $d_1 \geq d_{10}$, | $d_{1m}$ (nm) $=$ | 4.190 | 5.335 | 6.248 | 10.623 | 16.723 |
| When $d_1 < d_{10}$, | $d_{1m}$ (nm) $=$ | 1.818 | 3.051 | 3.681 | 0.787 | 1.251 |
| When $n_2 \geq n_{20}$, | $n_{2m}=$ | 0.0746777 | 0.0897961 | 0.0977148 | 0.0241113 | 0.0398962 |
| When $n_2 < n_{20}$, | $n_{2m}=$ | 0.1378662 | 0.1400989 | 0.1490454 | 0.0784241 | 0.0968872 |
| When $k_2 \geq k_{20}$, | $k_{2m}=$ | 0.0793188 | 0.0846436 | 0.0920837 | 0.0085193 | 0.0207715 |
| When $k_2 < k_{20}$, | $k_{2m}=$ | 0.0870862 | 0.0841199 | 0.0819739 | 0.0504102 | 0.0538818 |
| When $d_2 \geq d_{20}$, | $d_{2m}$ (nm) $=$ | $\infty$ | $\infty$ | $\infty$ | 17.196 | $\infty$ |
| When $d_2 < d_{20}$, | $d_{2m}$ (nm) $=$ | 28.725 | 67.570 | 87.835 | 8.245 | 10.621 |

1. 1 $<$ N A $\leq$ 1. 2
1 0 5 $<$ T $\leq$ 1 1 5

| Case | 11-06 | 11-07 | 11-08 | 11-09 |
|---|---|---|---|---|
| $n_{10}$ | 1.6897075 | 1.6928599 | 1.6933895 | 1.6967442 |
| $k_{10}$ | 0.0859154 | 0.0698704 | 0.0619572 | 0.0572224 |
| $d_{10}$ (nm) | 206.600 | 218.100 | 215.832 | 275.439 |
| $n_{20}$ | 1.6860653 | 1.6784557 | 1.6904996 | 1.6838077 |
| $k_{20}$ | 0.2958058 | 0.2260347 | 0.1864736 | 0.1920294 |
| $d_{20}$ (nm) | 138.770 | 175.355 | 232.785 | 230.401 |

| | | 11-06 | 11-07 | 11-08 | 11-09 |
|---|---|---|---|---|---|
| When $n_1 \geq n_{10}$, | $n_{1m}=$ | 0.0125659 | 0.0312329 | 0.0432227 | 0.0564172 |
| When $n_1 < n_{10}$, | $n_{1m}=$ | 0.0403125 | 0.0252893 | 0.0462402 | 0.0423401 |
| When $k_1 \geq k_{10}$, | $k_{1m}=$ | 0.0275024 | 0.0399890 | 0.0513623 | 0.0566272 |
| When $k_1 < k_{10}$, | $k_{1m}=$ | 0.0207617 | 0.0230298 | 0.0339783 | 0.0347253 |
| When $d_1 \geq d_{10}$, | $d_{1m}$ (nm) $=$ | 5.565 | $\infty$ | $\infty$ | $\infty$ |
| When $d_1 < d_{10}$, | $d_{1m}$ (nm) $=$ | 15.751 | 15.335 | 41.797 | 102.062 |
| When $n_2 \geq n_{20}$, | $n_{2m}=$ | 0.1134778 | 0.0778406 | 0.2416541 | 0.2945471 |
| When $n_2 < n_{20}$, | $n_{2m}=$ | 0.0212585 | 0.0821313 | 0.1144373 | 0.2197937 |
| When $k_2 \geq k_{20}$, | $k_{2m}=$ | 0.0640356 | 0.0874658 | 0.1126599 | 0.1918506 |
| When $k_2 < k_{20}$, | $k_{2m}=$ | 0.0823962 | 0.0630994 | 0.0642725 | 0.0810107 |
| When $d_2 \geq d_{20}$, | $d_{2m}$ (nm) $=$ | $\infty$ | $\infty$ | $\infty$ | $\infty$ |
| When $d_2 < d_{20}$, | $d_{2m}$ (nm) $=$ | 4.190 | 25.396 | 50.058 | 79.342 |

1. 1 < N A ≤ 1. 2
1 1 5 < T ≤ 1 2 5

| Case | 12-01 | 12-02 | 12-03 | 12-04 | 12-05 |
|---|---|---|---|---|---|
| $n_{10}$ | 1.9907624 | 1.9229056 | 1.9003143 | 1.9049048 | 1.7296380 |
| $k_{10}$ | 0.2658843 | 0.1943367 | 0.1434936 | 0.0972823 | 0.0899801 |
| $d_{10}$ (nm) | 16.877 | 14.896 | 13.590 | 12.362 | 93.128 |
| $n_{20}$ | 1.6777634 | 1.6435696 | 1.6791032 | 1.7269066 | 1.6935089 |
| $k_{20}$ | 0.7245088 | 0.4392836 | 0.3336019 | 0.2779612 | 0.2572784 |
| $d_{20}$ (nm) | 66.041 | 124.711 | 179.139 | 230.763 | 167.093 |

| | 12-01 | 12-02 | 12-03 | 12-04 | 12-05 |
|---|---|---|---|---|---|
| When $n_1 \geq n_{10}$, $n_{1n}=$ | 0.0641870 | 0.0750415 | 0.0917773 | 0.1066382 | 0.0315833 |
| When $n_1 < n_{10}$, $n_{1n}=$ | 0.0020520 | 0.0319995 | 0.0559583 | 0.0680188 | 0.0015344 |
| When $k_1 \geq k_{10}$, $k_{1n}=$ | 0.0028235 | 0.0481201 | 0.0790771 | 0.0912170 | 0.0085083 |
| When $k_1 < k_{10}$, $k_{1n}=$ | 0.0445386 | 0.0882983 | 0.0964502 | 0.0972823 | 0.0192114 |
| When $d_1 \geq d_{10}$, $d_{1n}$ (nm) $=$ | 2.498 | 3.792 | 5.133 | 6.031 | 9.518 |
| When $d_1 < d_{10}$, $d_{1n}$ (nm) $=$ | 0.080 | 1.544 | 2.939 | 3.522 | 0.359 |
| When $n_2 \geq n_{20}$, $n_{2n}=$ | 0.0064478 | 0.0655054 | 0.0877441 | 0.0975110 | 0.0182434 |
| When $n_2 < n_{20}$, $n_{2n}=$ | 0.1131567 | 0.1382288 | 0.1415613 | 0.1512451 | 0.0817859 |
| When $k_2 \geq k_{20}$, $k_{2n}=$ | 0.0073132 | 0.0658899 | 0.0812854 | 0.0911096 | 0.0040100 |
| When $k_2 < k_{20}$, $k_{2n}=$ | 0.0730591 | 0.0825134 | 0.0835315 | 0.0828308 | 0.0509155 |
| When $d_2 \geq d_{20}$, $d_{2n}$ (nm) $=$ | 10.610 | ∞ | ∞ | ∞ | 14.228 |
| When $d_2 < d_{20}$, $d_{2n}$ (nm) $=$ | 2.901 | 33.267 | 66.014 | 90.382 | 3.593 |

1. 1 < N A ≤ 1. 2
1 1 5 < T ≤ 1 2 5

| Case | 12-06 | 12-07 | 12-08 | 12-09 | 12-10 |
|---|---|---|---|---|---|
| $n_{10}$ | 1.7305285 | 1.6927568 | 1.6930586 | 1.6939267 | 1.6970265 |
| $k_{10}$ | 0.0799609 | 0.0712762 | 0.0635805 | 0.0583165 | 0.0526106 |
| $d_{10}$ (nm) | 93.907 | 218.499 | 215.646 | 213.162 | 273.430 |
| $n_{20}$ | 1.7196209 | 1.6781695 | 1.6903056 | 1.6934648 | 1.6908020 |
| $k_{20}$ | 0.2133806 | 0.2348207 | 0.1916344 | 0.1626221 | 0.1682270 |
| $d_{20}$ (nm) | 220.978 | 164.929 | 223.237 | 282.414 | 277.869 |

| | 12-06 | 12-07 | 12-08 | 12-09 | 12-10 |
|---|---|---|---|---|---|
| When $n_1 \geq n_{10}$, $n_{1n}=$ | 0.0401038 | 0.0280627 | 0.0367090 | 0.0617249 | 0.0695837 |
| When $n_1 < n_{10}$, $n_{1n}=$ | 0.0020569 | 0.0197937 | 0.0422595 | 0.0578455 | 0.0506836 |
| When $k_1 \geq k_{10}$, $k_{1n}=$ | 0.0099243 | 0.0365027 | 0.0497717 | 0.0551318 | 0.0584485 |
| When $k_1 < k_{10}$, $k_{1n}=$ | 0.0219006 | 0.0215491 | 0.0327808 | 0.0369946 | 0.0381665 |
| When $d_1 \geq d_{10}$, $d_{1n}$ (nm) $=$ | 15.192 | ∞ | ∞ | ∞ | ∞ |
| When $d_1 < d_{10}$, $d_{1n}$ (nm) $=$ | 0.519 | 8.747 | 40.119 | 117.750 | 120.098 |
| When $n_2 \geq n_{20}$, $n_{2n}=$ | 0.0185596 | 0.0673242 | 0.2516089 | 0.2302490 | 0.2819116 |
| When $n_2 < n_{20}$, $n_{2n}=$ | 0.1000403 | 0.0715613 | 0.0981323 | 0.1425830 | 0.2021863 |
| When $k_2 \geq k_{20}$, $k_{2n}=$ | 0.0105981 | 0.0901270 | 0.1132849 | 0.1293579 | 0.1967712 |
| When $k_2 < k_{20}$, $k_{2n}=$ | 0.0546692 | 0.0589612 | 0.0634204 | 0.0595032 | 0.0741577 |
| When $d_2 \geq d_{20}$, $d_{2n}$ (nm) $=$ | ∞ | ∞ | ∞ | ∞ | ∞ |
| When $d_2 < d_{20}$, $d_{2n}$ (nm) $=$ | 3.602 | 19.014 | 34.397 | 79.670 | 93.763 |

1. 1 < N A ≤ 1. 2
1 2 5 < T ≤ 1 3 5

| Case | 13-01 | 13-02 | 13-03 | 13-04 | 13-05 |
|---|---|---|---|---|---|
| $n_{10}$ | 1.8968086 | 1.9070303 | 1.9016797 | 1.7329805 | 1.7161015 |
| $k_{10}$ | 0.1457981 | 0.0954881 | 0.0905797 | 0.0916823 | 0.0708259 |
| $d_{10}$ (nm) | 14.128 | 12.717 | 10.946 | 93.296 | 94.224 |
| $n_{20}$ | 1.6815336 | 1.7369802 | 1.7110902 | 1.7056329 | 1.6780965 |
| $k_{20}$ | 0.3444919 | 0.2856144 | 0.2381911 | 0.2670261 | 0.1788543 |
| $d_{20}$ (nm) | 167.613 | 218.968 | 280.601 | 155.076 | 274.399 |

| | | 13-01 | 13-02 | 13-03 | 13-04 | 13-05 |
|---|---|---|---|---|---|---|
| When $n_1 \geq n_{10}$, | $n_{1m}=$ | 0.0900439 | 0.1048657 | 0.1226746 | 0.0324280 | 0.0442737 |
| When $n_1 < n_{10}$, | $n_{1m}=$ | 0.0549670 | 0.0656934 | 0.0785547 | 0.0012561 | 0.0190796 |
| When $k_1 \geq k_{10}$, | $k_{1m}=$ | 0.0772925 | 0.0877979 | 0.1031616 | 0.0075342 | 0.0396033 |
| When $k_1 < k_{10}$, | $k_{1m}=$ | 0.0920227 | 0.0954881 | 0.0905797 | 0.0177710 | 0.0448962 |
| When $d_1 \geq d_{10}$, | $d_{1m}$ (nm) $=$ | 5.183 | 6.019 | 6.438 | 9.368 | 34.945 |
| When $d_1 < d_{10}$, | $d_{1m}$ (nm) $=$ | 2.993 | 3.453 | 3.787 | 0.285 | 6.328 |
| When $n_2 \geq n_{20}$, | $n_{2m}=$ | 0.0877783 | 0.0991382 | 0.1111206 | 0.0250049 | 0.0400305 |
| When $n_2 < n_{20}$, | $n_{2m}=$ | 0.1446509 | 0.1532288 | 0.1362280 | 0.0542139 | 0.1016638 |
| When $k_2 \geq k_{20}$, | $k_{2m}=$ | 0.0828516 | 0.0936658 | 0.0912720 | 0.0036011 | 0.0409863 |
| When $k_2 < k_{20}$, | $k_{2m}=$ | 0.0884485 | 0.0865161 | 0.0819922 | 0.0570435 | 0.0508105 |
| When $d_2 \geq d_{20}$, | $d_{2m}$ (nm) $=$ | ∞ | ∞ | ∞ | 16.698 | ∞ |
| When $d_2 < d_{20}$, | $d_{2m}$ (nm) $=$ | 63.831 | 86.162 | 129.598 | 1.884 | 53.218 |

1. 1 < N A ≤ 1. 2
1 2 5 < T ≤ 1 3 5

| Case | 13-06 | 13-07 | 13-08 | 13-09 |
|---|---|---|---|---|
| $n_{10}$ | 1.6922053 | 1.6924923 | 1.6935584 | 1.6967916 |
| $k_{10}$ | 0.0726320 | 0.0653867 | 0.0598502 | 0.0533770 |
| $d_{10}$ (nm) | 218.650 | 214.871 | 212.072 | 273.133 |
| $n_{20}$ | 1.6800076 | 1.6897434 | 1.6927128 | 1.6904661 |
| $k_{20}$ | 0.2436881 | 0.1959626 | 0.1654173 | 0.1709158 |
| $d_{20}$ (nm) | 154.426 | 214.392 | 274.211 | 268.389 |

| | | 13-06 | 13-07 | 13-08 | 13-09 |
|---|---|---|---|---|---|
| When $n_1 \geq n_{10}$, | $n_{1m}=$ | 0.0253528 | 0.0324316 | 0.0605591 | 0.0715686 |
| When $n_1 < n_{10}$, | $n_{1m}=$ | 0.0165808 | 0.0420508 | 0.0560315 | 0.0516870 |
| When $k_1 \geq k_{10}$, | $k_{1m}=$ | 0.0318250 | 0.0487207 | 0.0537805 | 0.0575159 |
| When $k_1 < k_{10}$, | $k_{1m}=$ | 0.0192969 | 0.0323987 | 0.0370093 | 0.0369739 |
| When $d_1 \geq d_{10}$, | $d_{1m}$ (nm) $=$ | 16.057 | ∞ | ∞ | ∞ |
| When $d_1 < d_{10}$, | $d_{1m}$ (nm) $=$ | 7.067 | 37.738 | 59.298 | 116.516 |
| When $n_2 \geq n_{20}$, | $n_{2m}=$ | 0.0399280 | 0.1505237 | 0.2298792 | 0.2878638 |
| When $n_2 < n_{20}$, | $n_{2m}=$ | 0.0570007 | 0.0843848 | 0.1463525 | 0.2044592 |
| When $k_2 \geq k_{20}$, | $k_{2m}=$ | 0.0949915 | 0.1174060 | 0.1308350 | 0.1989417 |
| When $k_2 < k_{20}$, | $k_{2m}=$ | 0.0566089 | 0.0642029 | 0.0608850 | 0.0765625 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 13.778 | 24.202 | 76.110 | 90.681 |

1. $1 < NA \leq 1.2$
$135 < T \leq 145$

| Case | 14-01 | 14-02 | 14-03 | 14-04 | 14-05 |
|---|---|---|---|---|---|
| $n_{10}$ | 1.8931613 | 1.9086798 | 1.8957546 | 1.7383088 | 1.7163304 |
| $k_{10}$ | 0.1437464 | 0.0925277 | 0.1021679 | 0.0935643 | 0.0717315 |
| $d_{10}$ (nm) | 15.228 | 13.463 | 11.154 | 93.735 | 94.330 |
| $n_{20}$ | 1.6981871 | 1.7547782 | 1.6965397 | 1.7255584 | 1.6763108 |
| $k_{20}$ | 0.3648670 | 0.2987738 | 0.2414267 | 0.2828024 | 0.1832109 |
| $d_{20}$ (nm) | 154.635 | 206.696 | 273.752 | 142.972 | 265.207 |

| | | 14-01 | 14-02 | 14-03 | 14-04 | 14-05 |
|---|---|---|---|---|---|---|
| When $n_1 \geq n_{10}$, | $n_{1m} =$ | 0.0870447 | 0.1008179 | 0.1206177 | 0.0337476 | 0.0440930 |
| When $n_1 < n_{10}$, | $n_{1m} =$ | 0.0533362 | 0.0620862 | 0.0768750 | 0.0007715 | 0.0201111 |
| When $k_1 \geq k_{10}$, | $k_{1m} =$ | 0.0736633 | 0.0819543 | 0.1022961 | 0.0054871 | 0.0403162 |
| When $k_1 < k_{10}$, | $k_{1m} =$ | 0.0884546 | 0.0925277 | 0.1021679 | 0.0149585 | 0.0433484 |
| When $d_1 \geq d_{10}$, | $d_{1m}$ (nm) $=$ | 5.366 | 6.051 | 6.474 | 9.539 | 32.676 |
| When $d_1 < d_{10}$, | $d_{1m}$ (nm) $=$ | 3.110 | 3.392 | 3.792 | 0.168 | 6.615 |
| When $n_2 \geq n_{20}$, | $n_{2m} =$ | 0.0905371 | 0.1017932 | 0.1131152 | 0.0305115 | 0.0401709 |
| When $n_2 < n_{20}$, | $n_{2m} =$ | 0.1457471 | 0.1521191 | 0.1323865 | 0.0291541 | 0.0974780 |
| When $k_2 \geq k_{20}$, | $k_{2m} =$ | 0.0891467 | 0.0990112 | 0.0895691 | 0.0025757 | 0.0411877 |
| When $k_2 < k_{20}$, | $k_{2m} =$ | 0.0964551 | 0.0905688 | 0.0826367 | 0.0641370 | 0.0518066 |
| When $d_2 \geq d_{20}$, | $d_{2m}$ (nm) $=$ | ∞ | ∞ | ∞ | 18.295 | ∞ |
| When $d_2 < d_{20}$, | $d_{2m}$ (nm) $=$ | 52.833 | 78.923 | 127.644 | 0.825 | 36.894 |

1. $1 < NA \leq 1.2$
$135 < T \leq 145$

| Case | 14-06 | 14-07 | 14-08 | 14-09 | 14-10 |
|---|---|---|---|---|---|
| $n_{10}$ | 1.7036586 | 1.6919166 | 1.6911838 | 1.6942185 | 1.6965335 |
| $k_{10}$ | 0.0640636 | 0.0672926 | 0.0743991 | 0.0545821 | 0.0539924 |
| $d_{10}$ (nm) | 161.836 | 213.353 | 218.060 | 211.644 | 273.036 |
| $n_{20}$ | 1.6842842 | 1.6889376 | 1.6805827 | 1.6930391 | 1.6894839 |
| $k_{20}$ | 0.1670348 | 0.2002175 | 0.2524809 | 0.1466022 | 0.1738185 |
| $d_{20}$ (nm) | 260.021 | 207.074 | 145.761 | 321.654 | 259.712 |

| | | 14-06 | 14-07 | 14-08 | 14-09 | 14-10 |
|---|---|---|---|---|---|---|
| When $n_1 \geq n_{10}$, | $n_{1m} =$ | 0.0516992 | 0.0312610 | 0.0190637 | 0.0570044 | 0.0731799 |
| When $n_1 < n_{10}$, | $n_{1m} =$ | 0.0203174 | 0.0465454 | 0.0159326 | 0.0625537 | 0.0527673 |
| When $k_1 \geq k_{10}$, | $k_{1m} =$ | 0.0380640 | 0.0462256 | 0.0279297 | 0.0552405 | 0.0568201 |
| When $k_1 < k_{10}$, | $k_{1m} =$ | 0.0285486 | 0.0325867 | 0.0168274 | 0.0356702 | 0.0362610 |
| When $d_1 \geq d_{10}$, | $d_{1m}$ (nm) $=$ | ∞ | ∞ | 14.138 | ∞ | ∞ |
| When $d_1 < d_{10}$, | $d_{1m}$ (nm) $=$ | 9.049 | 34.771 | 6.640 | 127.140 | 114.401 |
| When $n_2 \geq n_{20}$, | $n_{2m} =$ | 0.0375000 | 0.2427722 | 0.0321863 | 0.2263916 | 0.2897119 |
| When $n_2 < n_{20}$, | $n_{2m} =$ | 0.0655225 | 0.0802039 | 0.0495178 | 0.1240515 | 0.2069202 |
| When $k_2 \geq k_{20}$, | $k_{2m} =$ | 0.0303979 | 0.1193311 | 0.0877856 | 0.1337305 | 0.1994678 |
| When $k_2 < k_{20}$, | $k_{2m} =$ | 0.0483228 | 0.0645337 | 0.0566711 | 0.0596594 | 0.0781824 |
| When $d_2 \geq d_{20}$, | $d_{2m}$ (nm) $=$ | 29.338 | ∞ | 15.130 | ∞ | ∞ |
| When $d_2 < d_{20}$, | $d_{2m}$ (nm) $=$ | 27.139 | 22.617 | 11.351 | 93.024 | 88.496 |

1. $1 < NA \leq 1.2$

$145 < T \leq 155$

| Case | | 15-01 | 15-02 | 15-03 | 15-04 | 15-05 |
|---|---|---|---|---|---|---|
| $n_{10}$ | | 1.8962402 | 1.9162756 | 1.8972293 | 1.7171631 | 1.7039366 |
| $k_{10}$ | | 0.1446868 | 0.0920008 | 0.1039493 | 0.0735355 | 0.0654419 |
| $d_{10}$ (nm) | | 16.058 | 13.917 | 11.503 | 94.241 | 161.496 |
| $n_{20}$ | | 1.7149739 | 1.7705409 | 1.6986687 | 1.6756859 | 1.6849902 |
| $k_{20}$ | | 0.3909951 | 0.3160160 | 0.2516185 | 0.1901883 | 0.1728826 |
| $d_{20}$ (nm) | | 143.691 | 196.340 | 264.437 | 256.660 | 251.490 |

| | | | | | | |
|---|---|---|---|---|---|---|
| When $n_1 \geq n_{10}$, | $n_{1m} =$ | 0.0837915 | 0.0974329 | 0.1166235 | 0.0430017 | 0.0505029 |
| When $n_1 < n_{10}$, | $n_{1m} =$ | 0.0514441 | 0.0592371 | 0.0737268 | 0.0188135 | 0.0178369 |
| When $k_1 \geq k_{10}$, | $k_{1m} =$ | 0.0700403 | 0.0772290 | 0.0977893 | 0.0384546 | 0.0357764 |
| When $k_1 < k_{10}$, | $k_{1m} =$ | 0.0875134 | 0.0920008 | 0.1039493 | 0.0432324 | 0.0268848 |
| When $d_1 \geq d_{10}$, | $d_{1m}$ (nm) $=$ | 5.323 | 5.852 | 6.362 | 32.246 | ∞ |
| When $d_1 < d_{10}$, | $d_{1m}$ (nm) $=$ | 3.062 | 3.205 | 3.699 | 5.981 | 7.380 |
| When $n_2 \geq n_{20}$, | $n_{2m} =$ | 0.0928162 | 0.1031079 | 0.1115686 | 0.0381177 | 0.0304712 |
| When $n_2 < n_{20}$, | $n_{2m} =$ | 0.1435938 | 0.1490808 | 0.1351062 | 0.0929431 | 0.0597266 |
| When $k_2 \geq k_{20}$, | $k_{2m} =$ | 0.0944385 | 0.1027820 | 0.0897864 | 0.0382104 | 0.0277966 |
| When $k_2 < k_{20}$, | $k_{2m} =$ | 0.0995911 | 0.0924023 | 0.0838245 | 0.0518921 | 0.0482678 |
| When $d_2 \geq d_{20}$, | $d_{2m}$ (nm) $=$ | ∞ | ∞ | ∞ | ∞ | 23.493 |
| When $d_2 < d_{20}$, | $d_{2m}$ (nm) $=$ | 30.912 | 72.930 | 96.188 | 31.536 | 23.876 |

1. $1 < NA \leq 1.2$

$145 < T \leq 155$

| Case | | 15-06 | 15-07 | 15-08 | 15-09 |
|---|---|---|---|---|---|
| $n_{10}$ | | 1.6903081 | 1.6915399 | 1.6931731 | 1.6963857 |
| $k_{10}$ | | 0.0771344 | 0.0690906 | 0.0615887 | 0.0546855 |
| $d_{10}$ (nm) | | 216.305 | 212.338 | 211.917 | 273.170 |
| $n_{20}$ | | 1.6786590 | 1.6881028 | 1.6918937 | 1.6879125 |
| $k_{20}$ | | 0.2613948 | 0.2062149 | 0.1729009 | 0.1780863 |
| $d_{20}$ (nm) | | 139.207 | 199.770 | 256.415 | 251.444 |

| | | | | | |
|---|---|---|---|---|---|
| When $n_1 \geq n_{10}$, | $n_{1m} =$ | 0.0195569 | 0.0307166 | 0.0591064 | 0.0699243 |
| When $n_1 < n_{10}$, | $n_{1m} =$ | 0.0132800 | 0.0523120 | 0.0554614 | 0.0530347 |
| When $k_1 \geq k_{10}$, | $k_{1m} =$ | 0.0269897 | 0.0450159 | 0.0517236 | 0.0562524 |
| When $k_1 < k_{10}$, | $k_{1m} =$ | 0.0101050 | 0.0313696 | 0.0355261 | 0.0367395 |
| When $d_1 \geq d_{10}$, | $d_{1m}$ (nm) $=$ | 14.222 | ∞ | ∞ | ∞ |
| When $d_1 < d_{10}$, | $d_{1m}$ (nm) $=$ | 6.108 | 32.462 | 54.157 | 113.606 |
| When $n_2 \geq n_{20}$, | $n_{2m} =$ | 0.0246814 | 0.2330432 | 0.2286047 | 0.2890198 |
| When $n_2 < n_{20}$, | $n_{2m} =$ | 0.0598340 | 0.0841870 | 0.1451465 | 0.2088098 |
| When $k_2 \geq k_{20}$, | $k_{2m} =$ | 0.0678235 | 0.1160620 | 0.1277832 | 0.1979041 |
| When $k_2 < k_{20}$, | $k_{2m} =$ | 0.0514465 | 0.0682922 | 0.0664624 | 0.0771411 |
| When $d_2 \geq d_{20}$, | $d_{2m}$ (nm) $=$ | 11.437 | ∞ | ∞ | ∞ |
| When $d_2 < d_{20}$, | $d_{2m}$ (nm) $=$ | 12.498 | 26.276 | 74.225 | 84.013 |

1. $1 < NA \leq 1.2$
$155 < T \leq 165$

| Case | 16-01 | 16-02 | 16-03 | 16-04 | 16-05 |
|------|-------|-------|-------|-------|-------|
| $n_{10}$ | 1.9078860 | 1.9270939 | 1.9009914 | 1.7182026 | 1.7037276 |
| $k_{10}$ | 0.1508452 | 0.0963716 | 0.1079582 | 0.0759211 | 0.0670447 |
| $d_{10}$ (nm) | 16.208 | 13.863 | 11.657 | 93.910 | 160.452 |
| $n_{20}$ | 1.7232027 | 1.7738090 | 1.6981472 | 1.6754262 | 1.6860603 |
| $k_{20}$ | 0.4201511 | 0.3331580 | 0.2622250 | 0.1979303 | 0.1785858 |
| $d_{20}$ (nm) | 134.826 | 188.374 | 256.036 | 248.261 | 243.357 |

| | | 16-01 | 16-02 | 16-03 | 16-04 | 16-05 |
|---|---|---|---|---|---|---|
| When $n_1 \geq n_{10}$, | $n_{1m} =$ | 0.0807556 | 0.0955676 | 0.1136938 | 0.0410315 | 0.0482739 |
| When $n_1 < n_{10}$, | $n_{1m} =$ | 0.0492212 | 0.0570374 | 0.0706995 | 0.0157471 | 0.0155554 |
| When $k_1 \geq k_{10}$, | $k_{1m} =$ | 0.0660083 | 0.0745215 | 0.0946643 | 0.0342603 | 0.0302344 |
| When $k_1 < k_{10}$, | $k_{1m} =$ | 0.0885791 | 0.0963716 | 0.1079582 | 0.0433301 | 0.0248120 |
| When $d_1 \geq d_{10}$, | $d_{1m}$ (nm) $=$ | 4.938 | 5.477 | 6.133 | 23.554 | $\infty$ |
| When $d_1 < d_{10}$, | $d_{1m}$ (nm) $=$ | 2.790 | 2.920 | 3.507 | 4.784 | 6.051 |
| When $n_2 \geq n_{20}$, | $n_{2m} =$ | 0.0912793 | 0.1022461 | 0.1087073 | 0.0334387 | 0.0216223 |
| When $n_2 < n_{20}$, | $n_{2m} =$ | 0.1401233 | 0.1468384 | 0.1373413 | 0.0900842 | 0.0519312 |
| When $k_2 \geq k_{20}$, | $k_{2m} =$ | 0.0948535 | 0.1014905 | 0.0883215 | 0.0321790 | 0.0239026 |
| When $k_2 < k_{20}$, | $k_{2m} =$ | 0.0976477 | 0.0917578 | 0.0837280 | 0.0507922 | 0.0474658 |
| When $d_2 \geq d_{20}$, | $d_{2m}$ (nm) $=$ | $\infty$ | $\infty$ | $\infty$ | $\infty$ | 19.461 |
| When $d_2 < d_{20}$, | $d_{2m}$ (nm) $=$ | 27.641 | 68.596 | 90.537 | 29.710 | 21.259 |

1. $1 < NA \leq 1.2$
$155 < T \leq 165$

| Case | 16-06 | 16-07 | 16-08 | 16-09 |
|------|-------|-------|-------|-------|
| $n_{10}$ | 1.6914048 | 1.6932944 | 1.6971949 | 1.6963748 |
| $k_{10}$ | 0.0705280 | 0.0619823 | 0.0758678 | 0.0557064 |
| $d_{10}$ (nm) | 212.904 | 213.027 | 268.193 | 273.316 |
| $n_{20}$ | 1.6862460 | 1.6912789 | 1.6840809 | 1.6860970 |
| $k_{20}$ | 0.2142065 | 0.1784688 | 0.2789945 | 0.1841499 |
| $d_{20}$ (nm) | 190.804 | 246.475 | 135.240 | 242.973 |

| | | 16-06 | 16-07 | 16-08 | 16-09 |
|---|---|---|---|---|---|
| When $n_1 \geq n_{10}$, | $n_{1m} =$ | 0.0288806 | 0.0598267 | 0.0616260 | 0.0706445 |
| When $n_1 < n_{10}$, | $n_{1m} =$ | 0.0419739 | 0.0573401 | 0.0320642 | 0.0521814 |
| When $k_1 \geq k_{10}$, | $k_{1m} =$ | 0.0434460 | 0.0510059 | 0.0409424 | 0.0555554 |
| When $k_1 < k_{10}$, | $k_{1m} =$ | 0.0304883 | 0.0343054 | 0.0217456 | 0.0379871 |
| When $d_1 \geq d_{10}$, | $d_{1m}$ (nm) $=$ | $\infty$ | $\infty$ | $\infty$ | $\infty$ |
| When $d_1 < d_{10}$, | $d_{1m}$ (nm) $=$ | 31.951 | 51.898 | 19.489 | 113.780 |
| When $n_2 \geq n_{20}$, | $n_{2m} =$ | 0.2364844 | 0.2370337 | 0.2474512 | 0.2927136 |
| When $n_2 < n_{20}$, | $n_{2m} =$ | 0.0869409 | 0.1403040 | 0.2270129 | 0.2100537 |
| When $k_2 \geq k_{20}$, | $k_{2m} =$ | 0.1087354 | 0.1223047 | 0.1872974 | 0.1959326 |
| When $k_2 < k_{20}$, | $k_{2m} =$ | 0.0726953 | 0.0652295 | 0.1039441 | 0.0773071 |
| When $d_2 \geq d_{20}$, | $d_{2m}$ (nm) $=$ | $\infty$ | $\infty$ | $\infty$ | $\infty$ |
| When $d_2 < d_{20}$, | $d_{2m}$ (nm) $=$ | 34.355 | 75.037 | 36.050 | 81.214 |

$1.\ 1 < NA \leq 1.\ 2$
$165 < T \leq 175$

| Case | 17-01 | 17-02 | 17-03 | 17-04 | 17-05 |
|---|---|---|---|---|---|
| $n_{10}$ | 1.9345747 | 1.9100928 | 1.9218874 | 1.7188695 | 1.7031385 |
| $k_{10}$ | 0.1082213 | 0.1149883 | 0.1634556 | 0.0782891 | 0.0685384 |
| $d_{10}$ (nm) | 13.373 | 11.317 | 15.608 | 93.463 | 159.293 |
| $n_{20}$ | 1.7554016 | 1.6916658 | 1.7091703 | 1.6745648 | 1.6866422 |
| $k_{20}$ | 0.3434593 | 0.2694423 | 0.4402763 | 0.2040549 | 0.1829170 |
| $d_{20}$ (nm) | 183.042 | 248.707 | 128.647 | 239.614 | 234.977 |

| | | 17-01 | 17-02 | 17-03 | 17-04 | 17-05 |
|---|---|---|---|---|---|---|
| When $n_1 \geq n_{10}$, | $n_{1m} =$ | 0.0953882 | 0.1140894 | 0.0784595 | 0.0386694 | 0.0460681 |
| When $n_1 < n_{10}$, | $n_{1m} =$ | 0.0550098 | 0.0698865 | 0.0459766 | 0.0121814 | 0.0133398 |
| When $k_1 \geq k_{10}$, | $k_{1m} =$ | 0.0742224 | 0.0954895 | 0.0620923 | 0.0290149 | 0.0227319 |
| When $k_1 < k_{10}$, | $k_{1m} =$ | 0.1051392 | 0.1149883 | 0.0878528 | 0.0413110 | 0.0203333 |
| When $d_1 \geq d_{10}$, | $d_{1m}$ (nm) $=$ | 5.105 | 5.733 | 4.388 | 16.599 | $\infty$ |
| When $d_1 < d_{10}$, | $d_{1m}$ (nm) $=$ | 2.628 | 3.226 | 2.376 | 3.551 | 4.956 |
| When $n_2 \geq n_{20}$, | $n_{2m} =$ | 0.0995532 | 0.1061743 | 0.0849316 | 0.0275488 | 0.0132971 |
| When $n_2 < n_{20}$, | $n_{2m} =$ | 0.1453674 | 0.1364294 | 0.1372107 | 0.0877344 | 0.0449780 |
| When $k_2 \geq k_{20}$, | $k_{2m} =$ | 0.0936926 | 0.0848206 | 0.0864539 | 0.0249731 | 0.0152673 |
| When $k_2 < k_{20}$, | $k_{2m} =$ | 0.0884937 | 0.0821777 | 0.0909717 | 0.0487439 | 0.0459656 |
| When $d_2 \geq d_{20}$, | $d_{2m}$ (nm) $=$ | $\infty$ | $\infty$ | $\infty$ | $\infty$ | 6.034 |
| When $d_2 < d_{20}$, | $d_{2m}$ (nm) $=$ | 65.841 | 91.823 | 28.009 | 30.737 | 19.612 |

$1.\ 1 < NA \leq 1.\ 2$
$165 < T \leq 175$

| Case | 17-06 | 17-07 | 17-08 | 17-09 |
|---|---|---|---|---|
| $n_{10}$ | 1.6934237 | 1.6934242 | 1.6985617 | 1.6963947 |
| $k_{10}$ | 0.0627890 | 0.0627998 | 0.0777714 | 0.0569261 |
| $d_{10}$ (nm) | 213.592 | 213.572 | 264.836 | 273.344 |
| $n_{20}$ | 1.6908665 | 1.6907829 | 1.6854326 | 1.6845211 |
| $k_{20}$ | 0.1844160 | 0.1843934 | 0.2962369 | 0.1907955 |
| $d_{20}$ (nm) | 236.853 | 236.891 | 131.733 | 233.824 |

| | | 17-06 | 17-07 | 17-08 | 17-09 |
|---|---|---|---|---|---|
| When $n_1 \geq n_{10}$, | $n_{1m} =$ | 0.0574976 | 0.0574353 | 0.0522168 | 0.0698511 |
| When $n_1 < n_{10}$, | $n_{1m} =$ | 0.0521313 | 0.0521704 | 0.0296216 | 0.0506372 |
| When $k_1 \geq k_{10}$, | $k_{1m} =$ | 0.0502954 | 0.0502856 | 0.0369763 | 0.0547412 |
| When $k_1 < k_{10}$, | $k_{1m} =$ | 0.0341577 | 0.0341846 | 0.0234509 | 0.0368408 |
| When $d_1 \geq d_{10}$, | $d_{1m}$ (nm) $=$ | $\infty$ | $\infty$ | $\infty$ | $\infty$ |
| When $d_1 < d_{10}$, | $d_{1m}$ (nm) $=$ | 50.284 | 50.272 | 18.034 | 113.943 |
| When $n_2 \geq n_{20}$, | $n_{2m} =$ | 0.2442261 | 0.2441003 | 0.2108032 | 0.3045251 |
| When $n_2 < n_{20}$, | $n_{2m} =$ | 0.1394958 | 0.1395251 | 0.2567761 | 0.2115186 |
| When $k_2 \geq k_{20}$, | $k_{2m} =$ | 0.1187415 | 0.1187610 | 0.1954675 | 0.1950378 |
| When $k_2 < k_{20}$, | $k_{2m} =$ | 0.0660913 | 0.0660889 | 0.1128296 | 0.0795361 |
| When $d_2 \geq d_{20}$, | $d_{2m}$ (nm) $=$ | $\infty$ | $\infty$ | $\infty$ | $\infty$ |
| When $d_2 < d_{20}$, | $d_{2m}$ (nm) $=$ | 75.634 | 75.652 | 33.470 | 80.767 |

1. 1 < N A ≤ 1. 2
1 7 5 < T ≤ 1 8 5

| Case | | 18-01 | 18-02 | 18-03 | 18-04 | 18-05 |
|---|---|---|---|---|---|---|
| $n_{10}$ | | 1.9329388 | 1.9368237 | 1.9141366 | 1.7191879 | 1.7029035 |
| $k_{10}$ | | 0.1795701 | 0.1224596 | 0.1196035 | 0.0801581 | 0.0699625 |
| $d_{10}$ (nm) | | 14.789 | 12.921 | 11.206 | 93.133 | 158.805 |
| $n_{20}$ | | 1.6812994 | 1.7305084 | 1.6882344 | 1.6734445 | 1.6865116 |
| $k_{20}$ | | 0.4483886 | 0.3477304 | 0.2744889 | 0.2077092 | 0.1862225 |
| $d_{20}$ (nm) | | 123.825 | 177.704 | 240.000 | 230.286 | 225.674 |

| When $n_1 \geq n_{10}$, | $n_{1m}=$ | 0.0768433 | 0.0949634 | 0.1131592 | 0.0367419 | 0.0441357 |
|---|---|---|---|---|---|---|
| When $n_1 < n_{10}$, | $n_{1m}=$ | 0.0412451 | 0.0529919 | 0.0684998 | 0.0095679 | 0.0109912 |
| When $k_1 \geq k_{10}$, | $k_{1m}=$ | 0.0578772 | 0.0744714 | 0.0949390 | 0.0247339 | 0.0167639 |
| When $k_1 < k_{10}$, | $k_{1m}=$ | 0.0896887 | 0.1065430 | 0.1185388 | 0.0386743 | 0.0152380 |
| When $d_1 \geq d_{10}$, | $d_{1m}$ (nm) $=$ | 3.840 | 4.794 | 5.495 | 14.453 | ∞ |
| When $d_1 < d_{10}$, | $d_{1m}$ (nm) $=$ | 1.946 | 2.409 | 3.066 | 2.710 | 3.941 |
| When $n_2 \geq n_{20}$, | $n_{2m}=$ | 0.0764294 | 0.0962097 | 0.1038733 | 0.0230908 | 0.0081592 |
| When $n_2 < n_{20}$, | $n_{2m}=$ | 0.1359412 | 0.1466211 | 0.1367029 | 0.0895520 | 0.0398572 |
| When $k_2 \geq k_{20}$, | $k_{2m}=$ | 0.0734753 | 0.0852112 | 0.0825085 | 0.0197388 | 0.0086536 |
| When $k_2 < k_{20}$, | $k_{2m}=$ | 0.0828125 | 0.0854419 | 0.0815332 | 0.0475061 | 0.0463342 |
| When $d_2 \geq d_{20}$, | $d_{2m}$ (nm) $=$ | ∞ | ∞ | ∞ | 20.793 | 3.280 |
| When $d_2 < d_{20}$, | $d_{2m}$ (nm) $=$ | 32.854 | 63.574 | 95.894 | 33.693 | 18.574 |

1. 1 < N A ≤ 1. 2
1 7 5 < T ≤ 1 8 5

| Case | | 18-06 | 18-07 | 18-08 |
|---|---|---|---|---|
| $n_{10}$ | | 1.6933701 | 1.6939475 | 1.6969386 |
| $k_{10}$ | | 0.0640425 | 0.0576888 | 0.0533290 |
| $d_{10}$ (nm) | | 213.864 | 212.435 | 271.986 |
| $n_{20}$ | | 1.6904005 | 1.6925921 | 1.6924288 |
| $k_{20}$ | | 0.1898312 | 0.1618810 | 0.1673219 |
| $d_{20}$ (nm) | | 227.117 | 285.048 | 281.091 |

| When $n_1 \geq n_{10}$, | $n_{1m}=$ | 0.0547229 | 0.0510974 | 0.0676453 |
|---|---|---|---|---|
| When $n_1 < n_{10}$, | $n_{1m}=$ | 0.0462109 | 0.0603149 | 0.0497070 |
| When $k_1 \geq k_{10}$, | $k_{1m}=$ | 0.0493457 | 0.0532312 | 0.0592920 |
| When $k_1 < k_{10}$, | $k_{1m}=$ | 0.0339734 | 0.0351465 | 0.0390295 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 49.384 | 120.643 | 177.975 |
| When $n_2 \geq n_{20}$, | $n_{2m}=$ | 0.2555811 | 0.2373071 | 0.2892273 |
| When $n_2 < n_{20}$, | $n_{2m}=$ | 0.1402515 | 0.1279663 | 0.2010315 |
| When $k_2 \geq k_{20}$, | $k_{2m}=$ | 0.1146326 | 0.1254919 | 0.2051270 |
| When $k_2 < k_{20}$, | $k_{2m}=$ | 0.0655762 | 0.0607678 | 0.0750598 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 70.972 | 82.029 | 98.942 |

1. 1 < N A ≤ 1. 2
1 8 5 < T ≤ 1 9 5

| Case | 19–01 | 19–02 | 19–03 | 19–04 | 19–05 |
|---|---|---|---|---|---|
| $n_{10}$ | 1.9315873 | 1.9153217 | 1.8972445 | 1.7198506 | 1.7209927 |
| $k_{10}$ | 0.1333486 | 0.1206110 | 0.1001874 | 0.0813984 | 0.0705203 |
| $d_{10}$ (nm) | 13.169 | 11.351 | 10.604 | 93.215 | 93.408 |
| $n_{20}$ | 1.7169625 | 1.6899751 | 1.6952918 | 1.6740113 | 1.6975541 |
| $k_{20}$ | 0.3552140 | 0.2797802 | 0.2334251 | 0.2110946 | 0.1793898 |
| $d_{20}$ (nm) | 168.729 | 229.265 | 285.679 | 219.867 | 273.456 |

| | 19–01 | 19–02 | 19–03 | 19–04 | 19–05 |
|---|---|---|---|---|---|
| When $n_1 \geq n_{10}$, $n_{1m} =$ | 0.0918945 | 0.1114490 | 0.1257397 | 0.0361377 | 0.0445178 |
| When $n_1 < n_{10}$, $n_{1m} =$ | 0.0499878 | 0.0671436 | 0.0846338 | 0.0086279 | 0.0205615 |
| When $k_1 \geq k_{10}$, $k_{1m} =$ | 0.0714844 | 0.0926733 | 0.1116675 | 0.0228809 | 0.0433899 |
| When $k_1 < k_{10}$, $k_{1m} =$ | 0.1000085 | 0.1179578 | 0.1001874 | 0.0379150 | 0.0444836 |
| When $d_1 \geq d_{10}$, $d_{1m}$ (nm) = | 4.647 | 5.413 | 6.402 | 13.674 | 40.701 |
| When $d_1 < d_{10}$, $d_{1m}$ (nm) = | 2.318 | 3.021 | 3.978 | 2.409 | 6.133 |
| When $n_2 \geq n_{20}$, $n_{2m} =$ | 0.0938611 | 0.1021985 | 0.1009766 | 0.0217163 | 0.0601978 |
| When $n_2 < n_{20}$, $n_{2m} =$ | 0.1488745 | 0.1392834 | 0.1303809 | 0.0916943 | 0.1077124 |
| When $k_2 \geq k_{20}$, $k_{2m} =$ | 0.0821570 | 0.0826257 | 0.0865845 | 0.0185046 | 0.0416394 |
| When $k_2 < k_{20}$, $k_{2m} =$ | 0.0869946 | 0.0832629 | 0.0782239 | 0.0491125 | 0.0501843 |
| When $d_2 \geq d_{20}$, $d_{2m}$ (nm) = | ∞ | ∞ | ∞ | 19.431 | ∞ |
| When $d_2 < d_{20}$, $d_{2m}$ (nm) = | 61.773 | 92.529 | 127.146 | 32.148 | 73.073 |

1. 1 < N A ≤ 1. 2
1 8 5 < T ≤ 1 9 5

| Case | 19–06 | 19–07 | 19–08 | 19–09 | 19–10 |
|---|---|---|---|---|---|
| $n_{10}$ | 1.7035608 | 1.6916743 | 1.6930483 | 1.6936984 | 1.6968810 |
| $k_{10}$ | 0.0713918 | 0.0742011 | 0.0657083 | 0.0591625 | 0.0544417 |
| $d_{10}$ (nm) | 159.462 | 216.137 | 213.861 | 212.273 | 271.786 |
| $n_{20}$ | 1.6857491 | 1.6815589 | 1.6902271 | 1.6918699 | 1.6922876 |
| $k_{20}$ | 0.1901066 | 0.2413942 | 0.1951191 | 0.1652801 | 0.1708476 |
| $d_{20}$ (nm) | 215.251 | 158.897 | 217.477 | 275.792 | 271.501 |

| | 19–06 | 19–07 | 19–08 | 19–09 | 19–10 |
|---|---|---|---|---|---|
| When $n_1 \geq n_{10}$, $n_{1m} =$ | 0.0427405 | 0.0223779 | 0.0519324 | 0.0514441 | 0.0684033 |
| When $n_1 < n_{10}$, $n_{1m} =$ | 0.0090222 | 0.0227649 | 0.0431079 | 0.0594763 | 0.0491284 |
| When $k_1 \geq k_{10}$, $k_{1m} =$ | 0.0150232 | 0.0325586 | 0.0481873 | 0.0521765 | 0.0581763 |
| When $k_1 < k_{10}$, $k_{1m} =$ | 0.0160400 | 0.0253345 | 0.0315527 | 0.0340894 | 0.0370996 |
| When $d_1 \geq d_{10}$, $d_{1m}$ (nm) = | ∞ | 13.469 | ∞ | ∞ | ∞ |
| When $d_1 < d_{10}$, $d_{1m}$ (nm) = | 3.174 | 10.839 | 47.894 | 119.682 | 177.263 |
| When $n_2 \geq n_{20}$, $n_{2m} =$ | 0.0074805 | 0.0854517 | 0.1377869 | 0.2440918 | 0.2955884 |
| When $n_2 < n_{20}$, $n_{2m} =$ | 0.0361890 | 0.0461035 | 0.1429895 | 0.1282532 | 0.2018481 |
| When $k_2 \geq k_{20}$, $k_{2m} =$ | 0.0083386 | 0.0888440 | 0.1120801 | 0.1247546 | 0.2080872 |
| When $k_2 < k_{20}$, $k_{2m} =$ | 0.0485754 | 0.0635596 | 0.0642932 | 0.0606433 | 0.0779761 |
| When $d_2 \geq d_{20}$, $d_{2m}$ (nm) = | 3.092 | ∞ | ∞ | ∞ | ∞ |
| When $d_2 < d_{20}$, $d_{2m}$ (nm) = | 17.439 | 14.439 | 35.904 | 75.946 | 92.429 |

1. $1 < NA \leq 1.2$
$195 < T \leq 205$

| Case | 20-01 | 20-02 | 20-03 | 20-04 | 20-05 |
|---|---|---|---|---|---|
| $n_{10}$ | 1.9249373 | 1.9134695 | 1.8970797 | 1.7208445 | 1.7215107 |
| $k_{10}$ | 0.1361664 | 0.1202777 | 0.0999072 | 0.0825059 | 0.0711590 |
| $d_{10}$ (nm) | 14.155 | 11.822 | 10.899 | 93.633 | 93.747 |
| $n_{20}$ | 1.7251855 | 1.6947701 | 1.6978665 | 1.6746972 | 1.6977852 |
| $k_{20}$ | 0.3723543 | 0.2878755 | 0.2388400 | 0.2167421 | 0.1834377 |
| $d_{20}$ (nm) | 156.237 | 218.180 | 275.054 | 209.700 | 263.540 |

| | | 20-01 | 20-02 | 20-03 | 20-04 | 20-05 |
|---|---|---|---|---|---|---|
| When $n_1 \geq n_{10}$, | $n_{1m} =$ | 0.0879163 | 0.1083789 | 0.1230811 | 0.0362378 | 0.0448303 |
| When $n_1 < n_{10}$, | $n_{1m} =$ | 0.0472876 | 0.0648938 | 0.0826709 | 0.0083032 | 0.0200745 |
| When $k_1 \geq k_{10}$, | $k_{1m} =$ | 0.0660645 | 0.0884607 | 0.1084424 | 0.0221863 | 0.0429114 |
| When $k_1 < k_{10}$, | $k_{1m} =$ | 0.0933167 | 0.1148511 | 0.0999072 | 0.0377161 | 0.0440771 |
| When $d_1 \geq d_{10}$, | $d_{1m}$ (nm) $=$ | 4.725 | 5.477 | 6.424 | 13.579 | 31.897 |
| When $d_1 < d_{10}$, | $d_{1m}$ (nm) $=$ | 2.353 | 3.040 | 3.984 | 2.294 | 5.957 |
| When $n_2 \geq n_{20}$, | $n_{2m} =$ | 0.0937048 | 0.1017651 | 0.1009302 | 0.0215295 | 0.0601208 |
| When $n_2 < n_{20}$, | $n_{2m} =$ | 0.1501685 | 0.1443250 | 0.1325146 | 0.0892346 | 0.1044958 |
| When $k_2 \geq k_{20}$, | $k_{2m} =$ | 0.0870276 | 0.0848474 | 0.0878162 | 0.0191504 | 0.0424573 |
| When $k_2 < k_{20}$, | $k_{2m} =$ | 0.0940491 | 0.0866907 | 0.0808813 | 0.0520386 | 0.0521252 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 59.976 | 84.859 | 127.060 | 27.072 | 71.102 |

1. $1 < NA \leq 1.2$
$195 < T \leq 205$

| Case | 20-06 | 20-07 | 20-08 | 20-09 | 20-10 |
|---|---|---|---|---|---|
| $n_{10}$ | 1.7046380 | 1.7071945 | 1.6911424 | 1.6924731 | 1.6944113 |
| $k_{10}$ | 0.0728087 | 0.0643745 | 0.0761042 | 0.0678273 | 0.0547711 |
| $d_{10}$ (nm) | 160.840 | 160.796 | 216.237 | 212.933 | 211.610 |
| $n_{20}$ | 1.6842748 | 1.7036838 | 1.6835271 | 1.6899027 | 1.6931553 |
| $k_{20}$ | 0.1961079 | 0.1674255 | 0.2518702 | 0.2006809 | 0.1468072 |
| $d_{20}$ (nm) | 204.946 | 259.158 | 149.208 | 209.434 | 323.528 |

| | | 20-06 | 20-07 | 20-08 | 20-09 | 20-10 |
|---|---|---|---|---|---|---|
| When $n_1 \geq n_{10}$, | $n_{1m} =$ | 0.0417468 | 0.0534717 | 0.0144385 | 0.0489441 | 0.0528149 |
| When $n_1 < n_{10}$, | $n_{1m} =$ | 0.0080798 | 0.0311902 | 0.0202490 | 0.0431433 | 0.0592456 |
| When $k_1 \geq k_{10}$, | $k_{1m} =$ | 0.0160498 | 0.0272644 | 0.0259192 | 0.0470654 | 0.0582300 |
| When $k_1 < k_{10}$, | $k_{1m} =$ | 0.0189954 | 0.0257520 | 0.0204919 | 0.0289844 | 0.0354419 |
| When $d_1 \geq d_{10}$, | $d_{1m}$ (nm) $=$ | ∞ | ∞ | 11.042 | ∞ | ∞ |
| When $d_1 < d_{10}$, | $d_{1m}$ (nm) $=$ | 2.830 | 21.473 | 8.826 | 44.978 | 116.569 |
| When $n_2 \geq n_{20}$, | $n_{2m} =$ | 0.0092676 | 0.0660242 | 0.0583154 | 0.1383105 | 0.2397107 |
| When $n_2 < n_{20}$, | $n_{2m} =$ | 0.0345349 | 0.0284167 | 0.0279346 | 0.1133557 | 0.1358362 |
| When $k_2 \geq k_{20}$, | $k_{2m} =$ | 0.0098743 | 0.0192883 | 0.0839758 | 0.1160754 | 0.1327747 |
| When $k_2 < k_{20}$, | $k_{2m} =$ | 0.0439319 | 0.0493506 | 0.0539001 | 0.0650562 | 0.0582056 |
| When $d_2 \geq d_{20}$, | $d_{2m}$ (nm) $=$ | 4.069 | ∞ | ∞ | ∞ | ∞ |
| When $d_2 < d_{20}$, | $d_{2m}$ (nm) $=$ | 16.537 | 9.202 | 10.084 | 22.297 | 94.005 |

$1. 1 < NA \leq 1. 2$

$195 < T \leq 205$

| Case | 20-11 |
|---|---|
| $n_{10}$ | 1.6967389 |
| $k_{10}$ | 0.0554960 |
| $d_{10}$ (nm) | 271.524 |
| $n_{20}$ | 1.6919127 |
| $k_{20}$ | 0.1743507 |
| $d_{20}$ (nm) | 262.739 |

| | | |
|---|---|---|
| When $n_1 \geq n_{10}$, | $n_{1m} =$ | 0.0690857 |
| When $n_1 < n_{10}$, | $n_{1m} =$ | 0.0487012 |
| When $k_1 \geq k_{10}$, | $k_{1m} =$ | 0.0571155 |
| When $k_1 < k_{10}$, | $k_{1m} =$ | 0.0354016 |
| When $d_1 \geq d_{10}$, | $d_{1m}$ (nm) $=$ | $\infty$ |
| When $d_1 < d_{10}$, | $d_{1m}$ (nm) $=$ | 122.531 |
| When $n_2 \geq n_{20}$, | $n_{2m} =$ | 0.3042639 |
| When $n_2 < n_{20}$, | $n_{2m} =$ | 0.2009363 |
| When $k_2 \geq k_{20}$, | $k_{2m} =$ | 0.2111316 |
| When $k_2 < k_{20}$, | $k_{2m} =$ | 0.0800171 |
| When $d_2 \geq d_{20}$, | $d_{2m}$ (nm) $=$ | $\infty$ |
| When $d_2 < d_{20}$, | $d_{2m}$ (nm) $=$ | 82.974 |

In accordance with a fourth embodiment of the invention, an antireflective film has a two-layer structure and is used in a process for manufacturing a semiconductor device by being provided between a resist layer and a silicon oxide layer formed on a surface of a silicon semiconductor substrate and having a thickness T (unit: nm) described below, for exposure of the resist layer in an exposure system having a wavelength of 190 nm to 195 nm and a numerical aperture NA of 1.2 < NA ≤ 1.3. In accordance with the fourth embodiment of the invention, an exposure method is used in a process for manufacturing a semiconductor device and includes providing an antireflective film having a two-layer structure between a resist layer and a silicon oxide layer formed on a surface of a silicon semiconductor substrate having a thickness T (unit: nm) described below, and exposing the resist layer in an exposure system having a wavelength of 190 nm to 195 nm and a numerical aperture NA of 1.2 < NA ≤ 1.3.

The antireflective film or the antireflective film used in the exposure method according to the fourth embodiment of the invention includes an upper layer having a complex refractive index $N_1$ and a lower layer having a complex refractive index $N_2$, the complex refractive indexes $N_1$ and $N_2$ being represented by the following equations:

$$N_1 = n_1 - k_1 i$$

$$N_2 = n_2 - k_2 i$$

Assuming that the thickness of the upper layer is $d_1$ (unit: nm) and the thickness of the lower layer is $d_2$ (unit: nm), when any one of the combinations of values of [$n_{10}$, $k_{10}$, $d_{10}$, $n_{20}$, $k_{20}$, $d_{20}$] described below is selected depending on the thickness T of the silicon oxide film, $n_1$, $k_1$, $d_1$, $n_2$, $k_2$, and $d_2$ satisfy the following relational expression:

$$\{(n_1 - n_{10}) / (n_{1m} - n_{10})\}^2 + \{(k_1 - k_{10}) / (k_{1m} - k_{10})\}^2 + \{(d_1 - d_{10}) / (d_{1m} - d_{10})\}^2 + \{(n_2 - n_{20}) / (n_{2m} - n_{2C})\}^2 + \{(k_2 - k_{20}) / (k_{2m} - k_{20})\}^2 + \{(d_2 - d_{20}) / (d_{2m} - d_{20})\}^2 \leq 1$$

However, a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$. In the tables below, in the line of "When $n_1 \geq n_{10}$, $n_{1m} =$", each value in the right columns is "$n_{1m} - n_{10}$"; in the line of "When $n_1 < n_{10}$, $n_{1m} =$", each value in the right columns is "$n_{10} - n_{1m}$"; in the line of "When $k_1 \geq k_{10}$, $k_{1m} =$", each value in the right columns is "$k_{1m} - k_{10}$"; in the line of "When $k_1 < k_{10}$, $k_{1m} =$", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m} =$", each value in the right columns is "$n_{2m} - n_{20}$"; in the line of "When $n_2 < n_{20}$, $n_{2m} =$", each value in the right columns is "$n_{20} - n_{2m}$"; in the line of "When $k_2 \geq k_{20}$, $k_{2m} =$", each value in the right columns is "$k_{2m} - k_{20}$"; in the line of "When $k_2 < k_{20}$, $k_{2m} =$", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

## 1. 2 < N A ≤ 1. 3
## 2 ≤ T ≤ 1 5

| Case | 1-01 | 1-02 | 1-03 | 1-04 | 1-05 |
|---|---|---|---|---|---|
| $n_{10}$ | 2.070 | 1.955 | 1.895 | 1.875 | 1.870 |
| $k_{10}$ | 0.020 | 0.138 | 0.133 | 0.110 | 0.101 |
| $d_{10}$ (nm) | 27.974 | 34.826 | 29.218 | 17.990 | 13.959 |
| $n_{20}$ | 5.553 | 9.284 | 2.177 | 1.753 | 1.700 |
| $k_{20}$ | 3.053 | 0.606 | 0.543 | 0.330 | 0.255 |
| $d_{20}$ (nm) | 2.024 | 10.907 | 63.407 | 152.930 | 218.765 |

| | 1-01 | 1-02 | 1-03 | 1-04 | 1-05 |
|---|---|---|---|---|---|
| When $n_1 \geq n_{10}$, $n_{1m} =$ | 2.141 | 2.017 | 1.952 | 1.943 | 1.957 |
| When $n_1 < n_{10}$, $n_{1m} =$ | 2.006 | 1.896 | 1.854 | 1.843 | 1.821 |
| When $k_1 \geq k_{10}$, $k_{1m} =$ | 0.075 | 0.180 | 0.166 | 0.155 | 0.171 |
| When $k_1 < k_{10}$, $k_{1m} =$ | 0.000 | 0.061 | 0.055 | 0.028 | 0.009 |
| When $d_1 \geq d_{10}$, $d_{1m}$ (nm) $=$ | 31.254 | 39.247 | 35.017 | 23.926 | 20.211 |
| When $d_1 < d_{10}$, $d_{1m}$ (nm) $=$ | 25.519 | 31.618 | 26.178 | 15.560 | 10.679 |
| When $n_2 \geq n_{20}$, $n_{2m} =$ | 5.876 | 9.377 | 2.281 | 1.832 | 1.773 |
| When $n_2 < n_{20}$, $n_{2m} =$ | 5.233 | 9.207 | 2.051 | 1.635 | 1.577 |
| When $k_2 \geq k_{20}$, $k_{2m} =$ | 3.362 | 0.715 | 0.699 | 0.412 | 0.320 |
| When $k_2 < k_{20}$, $k_{2m} =$ | 2.751 | 0.513 | 0.439 | 0.253 | 0.185 |
| When $d_2 \geq d_{20}$, $d_{2m}$ (nm) $=$ | 2.251 | 11.023 | 70.023 | ∞ | ∞ |
| When $d_2 < d_{20}$, $d_{2m}$ (nm) $=$ | 1.807 | 10.812 | 58.076 | 125.396 | 142.606 |

## 1. 2 < N A ≤ 1. 3
## 2 ≤ T ≤ 1 5

| Case | 1-06 | 1-07 | 1-08 | 1-09 | 1-10 |
|---|---|---|---|---|---|
| $n_{10}$ | 1.867 | 1.699 | 1.693 | 1.692 | 1.694 |
| $k_{10}$ | 0.070 | 0.063 | 0.058 | 0.069 | 0.074 |
| $d_{10}$ (nm) | 13.235 | 165.016 | 157.920 | 236.756 | 217.672 |
| $n_{20}$ | 1.732 | 1.698 | 1.698 | 6.942 | 1.788 |
| $k_{20}$ | 0.221 | 0.180 | 0.154 | 3.076 | 0.339 |
| $d_{20}$ (nm) | 270.745 | 204.222 | 265.886 | 0.950 | 84.006 |

| | 1-06 | 1-07 | 1-08 | 1-09 | 1-10 |
|---|---|---|---|---|---|
| When $n_1 \geq n_{10}$, $n_{1m} =$ | 1.964 | 1.701 | 1.708 | 1.727 | 1.710 |
| When $n_1 < n_{10}$, $n_{1m} =$ | 1.810 | 1.683 | 1.664 | 1.662 | 1.674 |
| When $k_1 \geq k_{10}$, $k_{1m} =$ | 0.149 | 0.068 | 0.084 | 0.108 | 0.106 |
| When $k_1 < k_{10}$, $k_{1m} =$ | 0.000 | 0.043 | 0.031 | 0.039 | 0.053 |
| When $d_1 \geq d_{10}$, $d_{1m}$ (nm) $=$ | 20.519 | 166.410 | 170.845 | 255.389 | 226.062 |
| When $d_1 < d_{10}$, $d_{1m}$ (nm) $=$ | 9.259 | 155.941 | 111.504 | 217.630 | 206.257 |
| When $n_2 \geq n_{20}$, $n_{2m} =$ | 1.809 | 1.721 | 1.754 | 7.503 | 1.909 |
| When $n_2 < n_{20}$, $n_{2m} =$ | 1.603 | 1.694 | 1.667 | 6.491 | 1.763 |
| When $k_2 \geq k_{20}$, $k_{2m} =$ | 0.293 | 0.188 | 0.194 | 3.321 | 0.395 |
| When $k_2 < k_{20}$, $k_{2m} =$ | 0.152 | 0.139 | 0.113 | 2.487 | 0.243 |
| When $d_2 \geq d_{20}$, $d_{2m}$ (nm) $=$ | ∞ | 217.552 | ∞ | 1.062 | 100.609 |
| When $d_2 < d_{20}$, $d_{2m}$ (nm) $=$ | 182.495 | 202.082 | 249.694 | 0.781 | 81.237 |

1.2 < N A ≤ 1.3

2 ≤ T ≤ 15

| Case | 1-11 | 1-12 | 1-13 |
|---|---|---|---|
| $n_{10}$ | 1.699 | 1.698 | 1.695 |
| $k_{10}$ | 0.071 | 0.065 | 0.054 |
| $d_{10}$ (nm) | 210.274 | 207.280 | 219.181 |
| $n_{20}$ | 1.718 | 1.695 | 1.688 |
| $k_{20}$ | 0.242 | 0.194 | 0.161 |
| $d_{20}$ (nm) | 154.667 | 219.490 | 263.755 |

| | | 1-11 | 1-12 | 1-13 |
|---|---|---|---|---|
| When $n_1 \geq n_{10}$, | $n_{1m} =$ | 1.720 | 1.737 | 1.738 |
| When $n_1 < n_{10}$, | $n_{1m} =$ | 1.683 | 1.675 | 1.660 |
| When $k_1 \geq k_{10}$, | $k_{1m} =$ | 0.099 | 0.097 | 0.100 |
| When $k_1 < k_{10}$, | $k_{1m} =$ | 0.045 | 0.035 | 0.019 |
| When $d_1 \geq d_{10}$, | $d_{1m}$ (nm) $=$ | 229.005 | $\infty$ | $\infty$ |
| When $d_1 < d_{10}$, | $d_{1m}$ (nm) $=$ | 200.369 | 189.200 | 189.609 |
| When $n_2 \geq n_{20}$, | $n_{2m} =$ | 1.849 | 1.855 | 1.900 |
| When $n_2 < n_{20}$, | $n_{2m} =$ | 1.670 | 1.540 | 1.583 |
| When $k_2 \geq k_{20}$, | $k_{2m} =$ | 0.332 | 0.307 | 0.271 |
| When $k_2 < k_{20}$, | $k_{2m} =$ | 0.164 | 0.122 | 0.102 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 143.819 | 154.002 | 185.363 |

1. 2 < NA ≤ 1. 3
15 < T ≤ 25

| Case | 2-01 | 2-02 | 2-03 | 2-04 | 2-05 |
|---|---|---|---|---|---|
| $n_{10}$ | 1.894 | 1.881 | 1.874 | 1.872 | 1.693 |
| $k_{10}$ | 0.182 | 0.116 | 0.105 | 0.074 | 0.060 |
| $d_{10}$ (nm) | 37.493 | 18.625 | 14.298 | 13.408 | 158.097 |
| $n_{20}$ | 9.246 | 1.766 | 1.701 | 1.733 | 1.697 |
| $k_{20}$ | 0.662 | 0.358 | 0.269 | 0.231 | 0.160 |
| $d_{20}$ (nm) | 10.628 | 142.939 | 209.610 | 261.989 | 257.142 |

| | 2-01 | 2-02 | 2-03 | 2-04 | 2-05 |
|---|---|---|---|---|---|
| When $n_1 \geq n_{10}$, $n_{1m} =$ | 1.954 | 1.946 | 1.957 | 1.966 | 1.703 |
| When $n_1 < n_{10}$, $n_{1m} =$ | 1.847 | 1.852 | 1.828 | 1.817 | 1.667 |
| When $k_1 \geq k_{10}$, $k_{1m} =$ | 0.222 | 0.156 | 0.171 | 0.149 | 0.081 |
| When $k_1 < k_{10}$, $k_{1m} =$ | 0.111 | 0.037 | 0.015 | 0.000 | 0.035 |
| When $d_1 \geq d_{10}$, $d_{1m}$ (nm) $=$ | 41.975 | 24.164 | 20.222 | 20.345 | 165.590 |
| When $d_1 < d_{10}$, $d_{1m}$ (nm) $=$ | 34.168 | 16.466 | 11.264 | 9.664 | 137.726 |
| When $n_2 \geq n_{20}$, $n_{2m} =$ | 9.356 | 1.841 | 1.772 | 1.809 | 1.744 |
| When $n_2 < n_{20}$, $n_{2m} =$ | 9.153 | 1.650 | 1.579 | 1.602 | 1.674 |
| When $k_2 \geq k_{20}$, $k_{2m} =$ | 0.784 | 0.442 | 0.334 | 0.302 | 0.195 |
| When $k_2 < k_{20}$, $k_{2m} =$ | 0.549 | 0.280 | 0.198 | 0.162 | 0.120 |
| When $d_2 \geq d_{20}$, $d_{2m}$ (nm) $=$ | 10.759 | ∞ | ∞ | ∞ | ∞ |
| When $d_2 < d_{20}$, $d_{2m}$ (nm) $=$ | 10.519 | 119.178 | 137.341 | 178.243 | 243.996 |

1. 2 < NA ≤ 1. 3
15 < T ≤ 25

| Case | 2-06 | 2-07 | 2-08 | 2-09 | 2-10 |
|---|---|---|---|---|---|
| $n_{10}$ | 1.690 | 1.693 | 1.699 | 1.698 | 1.695 |
| $k_{10}$ | 0.074 | 0.078 | 0.074 | 0.067 | 0.055 |
| $d_{10}$ (nm) | 235.203 | 218.334 | 210.503 | 207.468 | 219.130 |
| $n_{20}$ | 5.632 | 1.803 | 1.719 | 1.694 | 1.687 |
| $k_{20}$ | 4.204 | 0.382 | 0.259 | 0.203 | 0.167 |
| $d_{20}$ (nm) | 0.919 | 74.994 | 145.797 | 210.546 | 255.274 |

| | 2-06 | 2-07 | 2-08 | 2-09 | 2-10 |
|---|---|---|---|---|---|
| When $n_1 \geq n_{10}$, $n_{1m} =$ | 1.708 | 1.699 | 1.715 | 1.733 | 1.737 |
| When $n_1 < n_{10}$, $n_{1m} =$ | 1.661 | 1.675 | 1.684 | 1.676 | 1.661 |
| When $k_1 \geq k_{10}$, $k_{1m} =$ | 0.102 | 0.098 | 0.100 | 0.097 | 0.100 |
| When $k_1 < k_{10}$, $k_{1m} =$ | 0.051 | 0.067 | 0.052 | 0.039 | 0.022 |
| When $d_1 \geq d_{10}$, $d_{1m}$ (nm) $=$ | 241.533 | 220.890 | 225.049 | ∞ | ∞ |
| When $d_1 < d_{10}$, $d_{1m}$ (nm) $=$ | 217.317 | 207.766 | 201.595 | 191.244 | 190.979 |
| When $n_2 \geq n_{20}$, $n_{2m} =$ | 6.262 | 1.931 | 1.852 | 1.853 | 1.902 |
| When $n_2 < n_{20}$, $n_{2m} =$ | 5.366 | 1.793 | 1.684 | 1.538 | 1.584 |
| When $k_2 \geq k_{20}$, $k_{2m} =$ | 4.338 | 0.416 | 0.339 | 0.310 | 0.275 |
| When $k_2 < k_{20}$, $k_{2m} =$ | 3.555 | 0.288 | 0.182 | 0.132 | 0.107 |
| When $d_2 \geq d_{20}$, $d_{2m}$ (nm) $=$ | 0.986 | 89.025 | ∞ | ∞ | ∞ |
| When $d_2 < d_{20}$, $d_{2m}$ (nm) $=$ | 0.720 | 74.083 | 139.178 | 147.776 | 179.334 |

1．2＜ＮＡ≦1．3
25＜Ｔ≦35

| Case | 3-01 | 3-02 | 3-03 | 3-04 | 3-05 |
|---|---|---|---|---|---|
| $n_{10}$ | 1.855 | 1.894 | 1.879 | 1.879 | 1.692 |
| $k_{10}$ | 0.222 | 0.121 | 0.110 | 0.076 | 0.062 |
| $d_{10}$ (nm) | 38.795 | 19.092 | 14.598 | 13.458 | 158.198 |
| $n_{20}$ | 9.554 | 1.787 | 1.702 | 1.736 | 1.697 |
| $k_{20}$ | 0.714 | 0.392 | 0.285 | 0.242 | 0.168 |
| $d_{20}$ (nm) | 10.003 | 133.195 | 201.011 | 253.439 | 248.709 |

| | 3-01 | 3-02 | 3-03 | 3-04 | 3-05 |
|---|---|---|---|---|---|
| When $n_1 \geq n_{10}$, $n_{1m} =$ | 1.905 | 1.955 | 1.958 | 1.971 | 1.699 |
| When $n_1 < n_{10}$, $n_{1m} =$ | 1.821 | 1.868 | 1.836 | 1.826 | 1.670 |
| When $k_1 \geq k_{10}$, $k_{1m} =$ | 0.258 | 0.156 | 0.172 | 0.149 | 0.078 |
| When $k_1 < k_{10}$, $k_{1m} =$ | 0.159 | 0.047 | 0.022 | 0.000 | 0.041 |
| When $d_1 \geq d_{10}$, $d_{1m}$ (nm) $=$ | 42.560 | 24.067 | 20.129 | 19.949 | 161.711 |
| When $d_1 < d_{10}$, $d_{1m}$ (nm) $=$ | 36.125 | 17.295 | 11.822 | 9.987 | 144.941 |
| When $n_2 \geq n_{20}$, $n_{2m} =$ | 9.681 | 1.856 | 1.769 | 1.811 | 1.737 |
| When $n_2 < n_{20}$, $n_{2m} =$ | 9.446 | 1.674 | 1.584 | 1.608 | 1.683 |
| When $k_2 \geq k_{20}$, $k_{2m} =$ | 0.829 | 0.479 | 0.348 | 0.313 | 0.196 |
| When $k_2 < k_{20}$, $k_{2m} =$ | 0.587 | 0.314 | 0.215 | 0.173 | 0.129 |
| When $d_2 \geq d_{20}$, $d_{2m}$ (nm) $=$ | 10.138 | ∞ | ∞ | ∞ | ∞ |
| When $d_2 < d_{20}$, $d_{2m}$ (nm) $=$ | 9.892 | 112.716 | 132.762 | 173.492 | 239.168 |

1．2＜ＮＡ≦1．3
25＜Ｔ≦35

| Case | 3-06 | 3-07 | 3-08 |
|---|---|---|---|
| $n_{10}$ | 1.699 | 1.698 | 1.695 |
| $k_{10}$ | 0.078 | 0.070 | 0.057 |
| $d_{10}$ (nm) | 210.437 | 207.381 | 219.158 |
| $n_{20}$ | 1.720 | 1.693 | 1.687 |
| $k_{20}$ | 0.280 | 0.215 | 0.175 |
| $d_{20}$ (nm) | 137.855 | 202.487 | 246.765 |

| | 3-06 | 3-07 | 3-08 |
|---|---|---|---|
| When $n_1 \geq n_{10}$, $n_{1m} =$ | 1.710 | 1.730 | 1.737 |
| When $n_1 < n_{10}$, $n_{1m} =$ | 1.686 | 1.678 | 1.661 |
| When $k_1 \geq k_{10}$, $k_{1m} =$ | 0.100 | 0.097 | 0.101 |
| When $k_1 < k_{10}$, $k_{1m} =$ | 0.063 | 0.046 | 0.025 |
| When $d_1 \geq d_{10}$, $d_{1m}$ (nm) $=$ | 216.379 | ∞ | ∞ |
| When $d_1 < d_{10}$, $d_{1m}$ (nm) $=$ | 202.875 | 193.042 | 192.539 |
| When $n_2 \geq n_{20}$, $n_{2m} =$ | 1.855 | 1.841 | 1.910 |
| When $n_2 < n_{20}$, $n_{2m} =$ | 1.702 | 1.535 | 1.588 |
| When $k_2 \geq k_{20}$, $k_{2m} =$ | 0.336 | 0.312 | 0.280 |
| When $k_2 < k_{20}$, $k_{2m} =$ | 0.208 | 0.146 | 0.114 |
| When $d_2 \geq d_{20}$, $d_{2m}$ (nm) $=$ | ∞ | ∞ | ∞ |
| When $d_2 < d_{20}$, $d_{2m}$ (nm) $=$ | 134.716 | 142.289 | 200.270 |

1. 2 < N A ≤ 1. 3
3 5 < T ≤ 4 5

| Case | | 4-01 | 4-02 | 4-03 | 4-04 | 4-05 |
|---|---|---|---|---|---|---|
| $n_{10}$ | | 1.921 | 1.907 | 1.883 | 1.885 | 1.692 |
| $k_{10}$ | | 0.198 | 0.132 | 0.117 | 0.078 | 0.064 |
| $d_{10}$ (nm) | | 29.852 | 18.597 | 14.666 | 13.425 | 158.019 |
| $n_{20}$ | | 2.410 | 1.779 | 1.698 | 1.738 | 1.697 |
| $k_{20}$ | | 0.850 | 0.418 | 0.298 | 0.251 | 0.174 |
| $d_{20}$ (nm) | | 42.336 | 126.566 | 192.788 | 244.904 | 240.368 |

| | | 4-01 | 4-02 | 4-03 | 4-04 | 4-05 |
|---|---|---|---|---|---|---|
| When $n_1 \geq n_{10}$, | $n_{1m} =$ | 1.964 | 1.964 | 1.959 | 1.975 | 1.694 |
| When $n_1 < n_{10}$, | $n_{1m} =$ | 1.894 | 1.886 | 1.843 | 1.834 | 1.673 |
| When $k_1 \geq k_{10}$, | $k_{1m} =$ | 0.224 | 0.160 | 0.175 | 0.149 | 0.073 |
| When $k_1 < k_{10}$, | $k_{1m} =$ | 0.152 | 0.061 | 0.031 | 0.000 | 0.048 |
| When $d_1 \geq d_{10}$, | $d_{1m}$ (nm) $=$ | 33.127 | 22.917 | 19.812 | 19.537 | 159.270 |
| When $d_1 < d_{10}$, | $d_{1m}$ (nm) $=$ | 28.245 | 17.267 | 12.114 | 10.202 | 147.983 |
| When $n_2 \geq n_{20}$, | $n_{2m} =$ | 2.530 | 1.833 | 1.762 | 1.812 | 1.732 |
| When $n_2 < n_{20}$, | $n_{2m} =$ | 2.288 | 1.667 | 1.583 | 1.611 | 1.691 |
| When $k_2 \geq k_{20}$, | $k_{2m} =$ | 0.928 | 0.492 | 0.359 | 0.320 | 0.195 |
| When $k_2 < k_{20}$, | $k_{2m} =$ | 0.730 | 0.344 | 0.229 | 0.182 | 0.145 |
| When $d_2 \geq d_{20}$, | $d_{2m}$ (nm) $=$ | 46.411 | ∞ | ∞ | ∞ | 274.107 |
| When $d_2 < d_{20}$, | $d_{2m}$ (nm) $=$ | 39.931 | 107.536 | 154.271 | 167.375 | 234.670 |

1. 2 < N A ≤ 1. 3
3 5 < T ≤ 4 5

| Case | | 4-06 | 4-07 | 4-08 | 4-09 |
|---|---|---|---|---|---|
| $n_{10}$ | | 1.700 | 1.698 | 1.695 | 1.705 |
| $k_{10}$ | | 0.081 | 0.072 | 0.059 | 0.053 |
| $d_{10}$ (nm) | | 209.560 | 206.609 | 219.174 | 283.412 |
| $n_{20}$ | | 1.716 | 1.692 | 1.688 | 1.691 |
| $k_{20}$ | | 0.298 | 0.225 | 0.183 | 0.185 |
| $d_{20}$ (nm) | | 131.419 | 195.862 | 237.750 | 233.362 |

| | | 4-06 | 4-07 | 4-08 | 4-09 |
|---|---|---|---|---|---|
| When $n_1 \geq n_{10}$, | $n_{1m} =$ | 1.701 | 1.721 | 1.734 | 1.751 |
| When $n_1 < n_{10}$, | $n_{1m} =$ | 1.689 | 1.680 | 1.662 | 1.675 |
| When $k_1 \geq k_{10}$, | $k_{1m} =$ | 0.099 | 0.097 | 0.101 | 0.092 |
| When $k_1 < k_{10}$, | $k_{1m} =$ | 0.076 | 0.050 | 0.027 | 0.024 |
| When $d_1 \geq d_{10}$, | $d_{1m}$ (nm) $=$ | 210.753 | ∞ | ∞ | ∞ |
| When $d_1 < d_{10}$, | $d_{1m}$ (nm) $=$ | 203.620 | 194.085 | 194.045 | 189.814 |
| When $n_2 \geq n_{20}$, | $n_{2m} =$ | 1.846 | 1.812 | 1.920 | 1.889 |
| When $n_2 < n_{20}$, | $n_{2m} =$ | 1.712 | 1.528 | 1.594 | 1.515 |
| When $k_2 \geq k_{20}$, | $k_{2m} =$ | 0.319 | 0.315 | 0.285 | 0.358 |
| When $k_2 < k_{20}$, | $k_{2m} =$ | 0.257 | 0.159 | 0.121 | 0.115 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 130.894 | 179.580 | 197.417 | 162.566 |

1. 2 < N A ≤ 1. 3

4 5 < T ≤ 5 5

| Case | 5-01 | 5-02 | 5-03 | 5-04 | 5-05 |
|---|---|---|---|---|---|
| $n_{10}$ | 1.943 | 1.907 | 1.884 | 1.891 | 1.691 |
| $k_{10}$ | 0.213 | 0.153 | 0.123 | 0.078 | 0.066 |
| $d_{10}$ (nm) | 22.907 | 17.372 | 14.585 | 13.392 | 157.377 |
| $n_{20}$ | 1.902 | 1.716 | 1.691 | 1.743 | 1.696 |
| $k_{20}$ | 0.785 | 0.418 | 0.305 | 0.257 | 0.178 |
| $d_{20}$ (nm) | 53.731 | 124.143 | 184.536 | 235.129 | 232.195 |

| | | 5-01 | 5-02 | 5-03 | 5-04 | 5-05 |
|---|---|---|---|---|---|---|
| When $n_1 \geq n_{10}$, | $n_{1m} =$ | 1.979 | 1.963 | 1.959 | 1.980 | 1.692 |
| When $n_1 < n_{10}$, | $n_{1m} =$ | 1.934 | 1.892 | 1.845 | 1.841 | 1.676 |
| When $k_1 \geq k_{10}$, | $k_{1m} =$ | 0.223 | 0.175 | 0.181 | 0.148 | 0.067 |
| When $k_1 < k_{10}$, | $k_{1m} =$ | 0.198 | 0.080 | 0.039 | 0.000 | 0.057 |
| When $d_1 \geq d_{10}$, | $d_{1m}$ (nm) $=$ | 25.447 | 21.108 | 19.487 | 19.257 | 157.441 |
| When $d_1 < d_{10}$, | $d_{1m}$ (nm) $=$ | 22.431 | 16.482 | 12.133 | 10.346 | 149.670 |
| When $n_2 \geq n_{20}$, | $n_{2m} =$ | 1.937 | 1.752 | 1.753 | 1.817 | 1.727 |
| When $n_2 < n_{20}$, | $n_{2m} =$ | 1.871 | 1.605 | 1.576 | 1.616 | 1.695 |
| When $k_2 \geq k_{20}$, | $k_{2m} =$ | 0.813 | 0.464 | 0.362 | 0.326 | 0.187 |
| When $k_2 < k_{20}$, | $k_{2m} =$ | 0.724 | 0.351 | 0.237 | 0.188 | 0.173 |
| When $d_2 \geq d_{20}$, | $d_{2m}$ (nm) $=$ | 58.954 | ∞ | ∞ | ∞ | 254.885 |
| When $d_2 < d_{20}$, | $d_{2m}$ (nm) $=$ | 51.905 | 103.951 | 122.545 | 158.102 | 231.812 |

1. 2 < N A ≤ 1. 3

4 5 < T ≤ 5 5

| Case | 5-06 | 5-07 | 5-08 |
|---|---|---|---|
| $n_{10}$ | 1.699 | 1.695 | 1.704 |
| $k_{10}$ | 0.072 | 0.060 | 0.054 |
| $d_{10}$ (nm) | 204.994 | 219.095 | 283.255 |
| $n_{20}$ | 1.688 | 1.689 | 1.689 |
| $k_{20}$ | 0.231 | 0.188 | 0.189 |
| $d_{20}$ (nm) | 192.230 | 228.102 | 224.255 |

| | | 5-06 | 5-07 | 5-08 |
|---|---|---|---|---|
| When $n_1 \geq n_{10}$, | $n_{1m} =$ | 1.718 | 1.729 | 1.749 |
| When $n_1 < n_{10}$, | $n_{1m} =$ | 1.682 | 1.663 | 1.676 |
| When $k_1 \geq k_{10}$, | $k_{1m} =$ | 0.096 | 0.102 | 0.091 |
| When $k_1 < k_{10}$, | $k_{1m} =$ | 0.048 | 0.030 | 0.025 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 194.149 | 195.371 | 190.682 |
| When $n_2 \geq n_{20}$, | $n_{2m} =$ | 1.788 | 1.929 | 1.898 |
| When $n_2 < n_{20}$, | $n_{2m} =$ | 1.641 | 1.601 | 1.530 |
| When $k_2 \geq k_{20}$, | $k_{2m} =$ | 0.326 | 0.290 | 0.362 |
| When $k_2 < k_{20}$, | $k_{2m} =$ | 0.165 | 0.127 | 0.117 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 176.978 | 195.845 | 153.544 |

1．2＜ＮＡ≦1．3
55＜Ｔ≦65

| Case | 6-01 | 6-02 | 6-03 | 6-04 | 6-05 |
|---|---|---|---|---|---|
| $n_{10}$ | 1.895 | 1.882 | 1.690 | 1.701 | 1.693 |
| $k_{10}$ | 0.076 | 0.126 | 0.068 | 0.084 | 0.070 |
| $d_{10}$ (nm) | 13.537 | 14.752 | 155.845 | 206.275 | 221.382 |
| $n_{20}$ | 1.753 | 1.688 | 1.693 | 1.686 | 1.667 |
| $k_{20}$ | 0.262 | 0.309 | 0.181 | 0.310 | 0.231 |
| $d_{20}$ (nm) | 223.848 | 174.672 | 224.616 | 122.505 | 161.928 |

| | | 6-01 | 6-02 | 6-03 | 6-04 | 6-05 |
|---|---|---|---|---|---|---|
| When $n_1 \geq n_{10}$, | $n_{1m} =$ | 1.983 | 1.956 | 1.691 | 1.703 | 1.726 |
| When $n_1 < n_{10}$, | $n_{1m} =$ | 1.846 | 1.842 | 1.680 | 1.695 | 1.686 |
| When $k_1 \geq k_{10}$, | $k_{1m} =$ | 0.143 | 0.185 | 0.071 | 0.096 | 0.105 |
| When $k_1 < k_{10}$, | $k_{1m} =$ | 0.000 | 0.045 | 0.054 | 0.076 | 0.063 |
| When $d_1 \geq d_{10}$, | $d_{1m}$ (nm) $=$ | 19.333 | 19.661 | 156.188 | 207.561 | 253.974 |
| When $d_1 < d_{10}$, | $d_{1m}$ (nm) $=$ | 10.604 | 12.234 | 149.873 | 203.306 | 217.847 |
| When $n_2 \geq n_{20}$, | $n_{2m} =$ | 1.828 | 1.751 | 1.713 | 1.791 | 1.691 |
| When $n_2 < n_{20}$, | $n_{2m} =$ | 1.623 | 1.571 | 1.692 | 1.682 | 1.585 |
| When $k_2 \geq k_{20}$, | $k_{2m} =$ | 0.332 | 0.365 | 0.184 | 0.352 | 0.284 |
| When $k_2 < k_{20}$, | $k_{2m} =$ | 0.191 | 0.239 | 0.171 | 0.280 | 0.201 |
| When $d_2 \geq d_{20}$, | $d_{2m}$ (nm) $=$ | ∞ | ∞ | 244.114 | 149.549 | 170.132 |
| When $d_2 < d_{20}$, | $d_{2m}$ (nm) $=$ | 146.194 | 124.203 | 224.269 | 121.948 | 139.231 |

1．2＜ＮＡ≦1．3
55＜Ｔ≦65

| Case | 6-06 | 6-07 | 6-08 |
|---|---|---|---|
| $n_{10}$ | 1.695 | 1.695 | 1.703 |
| $k_{10}$ | 0.060 | 0.055 | 0.049 |
| $d_{10}$ (nm) | 218.851 | 215.764 | 278.302 |
| $n_{20}$ | 1.689 | 1.693 | 1.691 |
| $k_{20}$ | 0.190 | 0.162 | 0.159 |
| $d_{20}$ (nm) | 218.129 | 277.062 | 273.241 |

| | | 6-06 | 6-07 | 6-08 |
|---|---|---|---|---|
| When $n_1 \geq n_{10}$, | $n_{1m} =$ | 1.726 | 1.740 | 1.751 |
| When $n_1 < n_{10}$, | $n_{1m} =$ | 1.665 | 1.662 | 1.653 |
| When $k_1 \geq k_{10}$, | $k_{1m} =$ | 0.102 | 0.097 | 0.092 |
| When $k_1 < k_{10}$, | $k_{1m} =$ | 0.031 | 0.021 | 0.015 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 196.531 | 170.235 | 166.884 |
| When $n_2 \geq n_{20}$, | $n_{2m} =$ | 1.935 | 1.919 | 1.925 |
| When $n_2 < n_{20}$, | $n_{2m} =$ | 1.606 | 1.543 | 1.498 |
| When $k_2 \geq k_{20}$, | $k_{2m} =$ | 0.294 | 0.280 | 0.278 |
| When $k_2 < k_{20}$, | $k_{2m} =$ | 0.130 | 0.102 | 0.095 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 191.652 | 197.142 | 190.724 |

1. 2 < N A ≤ 1. 3
6 5 < T ≤ 7 5

| Case | 7-01 | 7-02 | 7-03 | 7-04 | 7-05 |
|---|---|---|---|---|---|
| $n_{10}$ | 1.881 | 1.879 | 1.898 | 1.873 | 1.715 |
| $k_{10}$ | 0.189 | 0.125 | 0.073 | 0.092 | 0.067 |
| $d_{10}$ (nm) | 17.242 | 15.444 | 14.029 | 12.003 | 99.925 |
| $n_{20}$ | 1.617 | 1.697 | 1.767 | 1.696 | 1.686 |
| $k_{20}$ | 0.409 | 0.320 | 0.271 | 0.218 | 0.167 |
| $d_{20}$ (nm) | 111.921 | 162.536 | 211.582 | 280.785 | 269.056 |

| | | 7-01 | 7-02 | 7-03 | 7-04 | 7-05 |
|---|---|---|---|---|---|---|
| When $n_1 \geq n_{10}$, | $n_{1m} =$ | 1.933 | 1.953 | 1.985 | 1.975 | 1.746 |
| When $n_1 < n_{10}$, | $n_{1m} =$ | 1.873 | 1.839 | 1.852 | 1.816 | 1.710 |
| When $k_1 \geq k_{10}$, | $k_{1m} =$ | 0.202 | 0.184 | 0.136 | 0.174 | 0.081 |
| When $k_1 < k_{10}$, | $k_{1m} =$ | 0.122 | 0.046 | 0.000 | 0.000 | 0.037 |
| When $d_1 \geq d_{10}$, | $d_{1m}$ (nm) $=$ | 20.550 | 20.523 | 19.818 | 18.551 | 136.285 |
| When $d_1 < d_{10}$, | $d_{1m}$ (nm) $=$ | 16.700 | 12.791 | 11.204 | 8.554 | 98.008 |
| When $n_2 \geq n_{20}$, | $n_{2m} =$ | 1.633 | 1.761 | 1.845 | 1.780 | 1.699 |
| When $n_2 < n_{20}$, | $n_{2m} =$ | 1.511 | 1.579 | 1.638 | 1.585 | 1.620 |
| When $k_2 \geq k_{20}$, | $k_{2m} =$ | 0.430 | 0.380 | 0.344 | 0.283 | 0.175 |
| When $k_2 < k_{20}$, | $k_{2m} =$ | 0.344 | 0.246 | 0.196 | 0.150 | 0.131 |
| When $d_2 \geq d_{20}$, | $d_{2m}$ (nm) $=$ | ∞ | ∞ | ∞ | ∞ | 278.211 |
| When $d_2 < d_{20}$, | $d_{2m}$ (nm) $=$ | 91.266 | 127.980 | 136.666 | 158.294 | 243.285 |

1. 2 < N A ≤ 1. 3
6 5 < T ≤ 7 5

| Case | 7-06 | 7-07 | 7-08 |
|---|---|---|---|
| $n_{10}$ | 1.693 | 1.695 | 1.695 |
| $k_{10}$ | 0.070 | 0.061 | 0.055 |
| $d_{10}$ (nm) | 221.230 | 218.569 | 215.552 |
| $n_{20}$ | 1.668 | 1.689 | 1.692 |
| $k_{20}$ | 0.236 | 0.193 | 0.164 |
| $d_{20}$ (nm) | 151.884 | 208.598 | 267.637 |

| | | 7-06 | 7-07 | 7-08 |
|---|---|---|---|---|
| When $n_1 \geq n_{10}$, | $n_{1m} =$ | 1.724 | 1.724 | 1.741 |
| When $n_1 < n_{10}$, | $n_{1m} =$ | 1.686 | 1.666 | 1.661 |
| When $k_1 \geq k_{10}$, | $k_{1m} =$ | 0.105 | 0.101 | 0.097 |
| When $k_1 < k_{10}$, | $k_{1m} =$ | 0.064 | 0.031 | 0.021 |
| When $d_1 \geq d_{10}$, | $d_{1m}$ (nm) $=$ | 247.645 | ∞ | ∞ |
| When $d_1 < d_{10}$, | $d_{1m}$ (nm) $=$ | 218.101 | 197.493 | 171.385 |
| When $n_2 \geq n_{20}$, | $n_{2m} =$ | 1.689 | 1.934 | 1.918 |
| When $n_2 < n_{20}$, | $n_{2m} =$ | 1.586 | 1.609 | 1.542 |
| When $k_2 \geq k_{20}$, | $k_{2m} =$ | 0.286 | 0.296 | 0.281 |
| When $k_2 < k_{20}$, | $k_{2m} =$ | 0.205 | 0.130 | 0.101 |
| When $d_2 \geq d_{20}$, | $d_{2m}$ (nm) $=$ | 159.193 | ∞ | ∞ |
| When $d_2 < d_{20}$, | $d_{2m}$ (nm) $=$ | 130.698 | 183.027 | 188.504 |

1. 2 < N A ≦ 1. 3
7 5 < T ≦ 8 5

| Case | 8-01 | 8-02 | 8-03 | 8-04 | 8-05 |
|---|---|---|---|---|---|
| $n_{10}$ | 1.880 | 1.901 | 1.874 | 1.716 | 1.692 |
| $k_{10}$ | 0.126 | 0.074 | 0.095 | 0.068 | 0.072 |
| $d_{10}$ (nm) | 16.279 | 14.624 | 12.218 | 99.848 | 220.366 |
| $n_{20}$ | 1.709 | 1.778 | 1.694 | 1.687 | 1.668 |
| $k_{20}$ | 0.340 | 0.284 | 0.225 | 0.173 | 0.244 |
| $d_{20}$ (nm) | 151.148 | 201.087 | 271.916 | 259.863 | 143.647 |

| | | 8-01 | 8-02 | 8-03 | 8-04 | 8-05 |
|---|---|---|---|---|---|---|
| When $n_1 \geq n_{10}$, | $n_{1m} =$ | 1.951 | 1.984 | 1.974 | 1.746 | 1.725 |
| When $n_1 < n_{10}$, | $n_{1m} =$ | 1.842 | 1.857 | 1.818 | 1.712 | 1.688 |
| When $k_1 \geq k_{10}$, | $k_{1m} =$ | 0.181 | 0.134 | 0.175 | 0.079 | 0.106 |
| When $k_1 < k_{10}$, | $k_{1m} =$ | 0.048 | 0.000 | 0.000 | 0.042 | 0.068 |
| When $d_1 \geq d_{10}$, | $d_{1m}$ (nm) $=$ | 21.358 | 20.311 | 18.650 | 135.917 | 245.491 |
| When $d_1 < d_{10}$, | $d_{1m}$ (nm) $=$ | 13.627 | 11.922 | 8.869 | 98.660 | 218.637 |
| When $n_2 \geq n_{20}$, | $n_{2m} =$ | 1.774 | 1.856 | 1.776 | 1.696 | 1.688 |
| When $n_2 < n_{20}$, | $n_{2m} =$ | 1.592 | 1.651 | 1.582 | 1.624 | 1.581 |
| When $k_2 \geq k_{20}$, | $k_{2m} =$ | 0.403 | 0.360 | 0.289 | 0.178 | 0.280 |
| When $k_2 < k_{20}$, | $k_{2m} =$ | 0.263 | 0.208 | 0.157 | 0.137 | 0.214 |
| When $d_2 \geq d_{20}$, | $d_{2m}$ (nm) $=$ | ∞ | ∞ | ∞ | 265.927 | 149.336 |
| When $d_2 < d_{20}$, | $d_{2m}$ (nm) $=$ | 123.537 | 130.884 | 183.486 | 237.438 | 121.404 |

1. 2 < N A ≦ 1. 3
7 5 < T ≦ 8 5

| Case | 8-06 | 8-07 |
|---|---|---|
| $n_{10}$ | 1.695 | 1.695 |
| $k_{10}$ | 0.062 | 0.056 |
| $d_{10}$ (nm) | 218.447 | 215.754 |
| $n_{20}$ | 1.688 | 1.691 |
| $k_{20}$ | 0.198 | 0.167 |
| $d_{20}$ (nm) | 200.044 | 258.621 |

| | | 8-06 | 8-07 |
|---|---|---|---|
| When $n_1 \geq n_{10}$, | $n_{1m} =$ | 1.724 | 1.740 |
| When $n_1 < n_{10}$, | $n_{1m} =$ | 1.667 | 1.661 |
| When $k_1 \geq k_{10}$, | $k_{1m} =$ | 0.102 | 0.097 |
| When $k_1 < k_{10}$, | $k_{1m} =$ | 0.033 | 0.022 |
| When $d_1 \geq d_{10}$, | $d_{1m}$ (nm) $=$ | ∞ | ∞ |
| When $d_1 < d_{10}$, | $d_{1m}$ (nm) $=$ | 198.178 | 171.868 |
| When $n_2 \geq n_{20}$, | $n_{2m} =$ | 1.931 | 1.916 |
| When $n_2 < n_{20}$, | $n_{2m} =$ | 1.605 | 1.542 |
| When $k_2 \geq k_{20}$, | $k_{2m} =$ | 0.296 | 0.282 |
| When $k_2 < k_{20}$, | $k_{2m} =$ | 0.132 | 0.105 |
| When $d_2 \geq d_{20}$, | $d_{2m}$ (nm) $=$ | ∞ | ∞ |
| When $d_2 < d_{20}$, | $d_{2m}$ (nm) $=$ | 172.147 | 178.623 |

1 . 2 < N A ≦ 1 . 3

8 5 < T ≦ 9 5

| Case | 9-01 | 9-02 | 9-03 | 9-04 | 9-05 |
|---|---|---|---|---|---|
| $n_{10}$ | 1.888 | 1.903 | 1.880 | 1.693 | 1.695 |
| $k_{10}$ | 0.130 | 0.081 | 0.095 | 0.063 | 0.064 |
| $d_{10}$ (nm) | 16.763 | 14.911 | 12.432 | 156.037 | 218.418 |
| $n_{20}$ | 1.718 | 1.775 | 1.700 | 1.696 | 1.685 |
| $k_{20}$ | 0.366 | 0.299 | 0.236 | 0.165 | 0.207 |
| $d_{20}$ (nm) | 141.793 | 193.492 | 262.434 | 252.531 | 192.031 |

| | | | | | | |
|---|---|---|---|---|---|---|
| When $n_1 \geq n_{10}$, | $n_{1m} =$ | 1.955 | 1.983 | 1.976 | 1.693 | 1.725 |
| When $n_1 < n_{10}$, | $n_{1m} =$ | 1.853 | 1.862 | 1.827 | 1.659 | 1.667 |
| When $k_1 \geq k_{10}$, | $k_{1m} =$ | 0.178 | 0.137 | 0.171 | 0.071 | 0.102 |
| When $k_1 < k_{10}$, | $k_{1m} =$ | 0.053 | 0.000 | 0.000 | 0.062 | 0.036 |
| When $d_1 \geq d_{10}$, | $d_{1m}$ (nm) $=$ | 21.482 | 20.338 | 18.582 | 156.116 | 252.664 |
| When $d_1 < d_{10}$, | $d_{1m}$ (nm) $=$ | 14.427 | 12.369 | 9.315 | 108.678 | 198.579 |
| When $n_2 \geq n_{20}$, | $n_{2m} =$ | 1.777 | 1.851 | 1.779 | 1.766 | 1.934 |
| When $n_2 < n_{20}$, | $n_{2m} =$ | 1.605 | 1.653 | 1.583 | 1.688 | 1.600 |
| When $k_2 \geq k_{20}$, | $k_{2m} =$ | 0.429 | 0.373 | 0.299 | 0.166 | 0.298 |
| When $k_2 < k_{20}$, | $k_{2m} =$ | 0.289 | 0.223 | 0.167 | 0.129 | 0.138 |
| When $d_2 \geq d_{20}$, | $d_{2m}$ (nm) $=$ | ∞ | ∞ | ∞ | 252.906 | ∞ |
| When $d_2 < d_{20}$, | $d_{2m}$ (nm) $=$ | 118.585 | 127.262 | 178.673 | 249.872 | 164.058 |

1 . 2 < N A ≦ 1 . 3

8 5 < T ≦ 9 5

| Case | 9-06 | 9-07 |
|---|---|---|
| $n_{10}$ | 1.695 | 1.704 |
| $k_{10}$ | 0.057 | 0.051 |
| $d_{10}$ (nm) | 216.093 | 278.289 |
| $n_{20}$ | 1.691 | 1.691 |
| $k_{20}$ | 0.173 | 0.173 |
| $d_{20}$ (nm) | 249.945 | 246.105 |

| | | | |
|---|---|---|---|
| When $n_1 \geq n_{10}$, | $n_{1m} =$ | 1.738 | 1.752 |
| When $n_1 < n_{10}$, | $n_{1m} =$ | 1.662 | 1.653 |
| When $k_1 \geq k_{10}$, | $k_{1m} =$ | 0.098 | 0.092 |
| When $k_1 < k_{10}$, | $k_{1m} =$ | 0.022 | 0.016 |
| When $d_1 \geq d_{10}$, | $d_{1m}$ (nm) $=$ | ∞ | ∞ |
| When $d_1 < d_{10}$, | $d_{1m}$ (nm) $=$ | 175.267 | 172.533 |
| When $n_2 \geq n_{20}$, | $n_{2m} =$ | 1.919 | 1.830 |
| When $n_2 < n_{20}$, | $n_{2m} =$ | 1.543 | 1.507 |
| When $k_2 \geq k_{20}$, | $k_{2m} =$ | 0.284 | 0.291 |
| When $k_2 < k_{20}$, | $k_{2m} =$ | 0.111 | 0.108 |
| When $d_2 \geq d_{20}$, | $d_{2m}$ (nm) $=$ | ∞ | ∞ |
| When $d_2 < d_{20}$, | $d_{2m}$ (nm) $=$ | 173.633 | 172.262 |

1．2＜ＮＡ≦1．3
95＜Ｔ≦105

| Case | 10-01 | 10-02 | 10-03 | 10-04 | 10-05 |
|---|---|---|---|---|---|
| $n_{10}$ | 1.902 | 1.906 | 1.888 | 1.694 | 1.695 |
| $k_{10}$ | 0.140 | 0.093 | 0.096 | 0.066 | 0.059 |
| $d_{10}$ (nm) | 16.621 | 14.821 | 12.503 | 218.392 | 216.276 |
| $n_{20}$ | 1.717 | 1.761 | 1.706 | 1.682 | 1.691 |
| $k_{20}$ | 0.393 | 0.312 | 0.247 | 0.217 | 0.180 |
| $d_{20}$ (nm) | 134.110 | 187.587 | 253.021 | 183.765 | 241.184 |

| | | 10-01 | 10-02 | 10-03 | 10-04 | 10-05 |
|---|---|---|---|---|---|---|
| When $n_1 \geq n_{10}$, | $n_{1m} =$ | 1.964 | 1.983 | 1.982 | 1.725 | 1.737 |
| When $n_1 < n_{10}$, | $n_{1m} =$ | 1.874 | 1.867 | 1.838 | 1.666 | 1.663 |
| When $k_1 \geq k_{10}$, | $k_{1m} =$ | 0.179 | 0.146 | 0.168 | 0.103 | 0.098 |
| When $k_1 < k_{10}$, | $k_{1m} =$ | 0.062 | 0.004 | 0.000 | 0.041 | 0.024 |
| When $d_1 \geq d_{10}$, | $d_{1m}$ (nm) $=$ | 20.729 | 19.885 | 18.297 | 250.100 | ∞ |
| When $d_1 < d_{10}$, | $d_{1m}$ (nm) $=$ | 14.862 | 12.520 | 9.652 | 198.830 | 185.832 |
| When $n_2 \geq n_{20}$, | $n_{2m} =$ | 1.767 | 1.831 | 1.783 | 1.944 | 1.927 |
| When $n_2 < n_{20}$, | $n_{2m} =$ | 1.609 | 1.641 | 1.584 | 1.598 | 1.559 |
| When $k_2 \geq k_{20}$, | $k_{2m} =$ | 0.449 | 0.380 | 0.309 | 0.303 | 0.288 |
| When $k_2 < k_{20}$, | $k_{2m} =$ | 0.320 | 0.238 | 0.178 | 0.149 | 0.117 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 113.506 | 124.690 | 172.558 | 157.077 | 167.184 |

1．2＜ＮＡ≦1．3
95＜Ｔ≦105

| Case | 10-06 |
|---|---|
| $n_{10}$ | 1.704 |
| $k_{10}$ | 0.052 |
| $d_{10}$ (nm) | 278.098 |
| $n_{20}$ | 1.689 |
| $k_{20}$ | 0.180 |
| $d_{20}$ (nm) | 237.690 |

| | | 10-06 |
|---|---|---|
| When $n_1 \geq n_{10}$, | $n_{1m} =$ | 1.752 |
| When $n_1 < n_{10}$, | $n_{1m} =$ | 1.658 |
| When $k_1 \geq k_{10}$, | $k_{1m} =$ | 0.091 |
| When $k_1 < k_{10}$, | $k_{1m} =$ | 0.019 |
| When $d_1 \geq d_{10}$, | $d_{1m}$ (nm) $=$ | ∞ |
| When $d_1 < d_{10}$, | $d_{1m}$ (nm) $=$ | 180.136 |
| When $n_2 \geq n_{20}$, | $n_{2m} =$ | 1.847 |
| When $n_2 < n_{20}$, | $n_{2m} =$ | 1.512 |
| When $k_2 \geq k_{20}$, | $k_{2m} =$ | 0.296 |
| When $k_2 < k_{20}$, | $k_{2m} =$ | 0.113 |
| When $d_2 \geq d_{20}$, | $d_{2m}$ (nm) $=$ | ∞ |
| When $d_2 < d_{20}$, | $d_{2m}$ (nm) $=$ | 165.978 |

1. 2 < N A ≦ 1. 3
1 0 5 < T ≦ 1 1 5

| Case | 11-01 | 11-02 | 11-03 | 11-04 | 11-05 |
|---|---|---|---|---|---|
| $n_{10}$ | 1.915 | 1.908 | 1.895 | 1.692 | 1.694 |
| $k_{10}$ | 0.153 | 0.105 | 0.097 | 0.060 | 0.068 |
| $d_{10}$ (nm) | 15.972 | 14.452 | 12.386 | 153.833 | 218.491 |
| $n_{20}$ | 1.700 | 1.741 | 1.708 | 1.696 | 1.679 |
| $k_{20}$ | 0.410 | 0.319 | 0.254 | 0.152 | 0.227 |
| $d_{20}$ (nm) | 128.035 | 181.864 | 244.026 | 294.292 | 174.638 |

| | | 11-01 | 11-02 | 11-03 | 11-04 | 11-05 |
|---|---|---|---|---|---|---|
| When $n_1 \geq n_{10}$, | $n_{1m} =$ | 1.973 | 1.983 | 1.987 | 1.719 | 1.723 |
| When $n_1 < n_{10}$, | $n_{1m} =$ | 1.893 | 1.872 | 1.847 | 1.655 | 1.669 |
| When $k_1 \geq k_{10}$, | $k_{1m} =$ | 0.185 | 0.156 | 0.167 | 0.093 | 0.104 |
| When $k_1 < k_{10}$, | $k_{1m} =$ | 0.078 | 0.017 | 0.000 | 0.039 | 0.045 |
| When $d_1 \geq d_{10}$, | $d_{1m}$ (nm) $=$ | 19.455 | 19.144 | 17.845 | ∞ | 247.764 |
| When $d_1 < d_{10}$, | $d_{1m}$ (nm) $=$ | 14.744 | 12.421 | 9.756 | 107.765 | 205.861 |
| When $n_2 \geq n_{20}$, | $n_{2m} =$ | 1.741 | 1.806 | 1.782 | 1.782 | 1.753 |
| When $n_2 < n_{20}$, | $n_{2m} =$ | 1.596 | 1.623 | 1.583 | 1.640 | 1.603 |
| When $k_2 \geq k_{20}$, | $k_{2m} =$ | 0.453 | 0.379 | 0.315 | 0.185 | 0.311 |
| When $k_2 < k_{20}$, | $k_{2m} =$ | 0.345 | 0.249 | 0.187 | 0.106 | 0.163 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 107.965 | 122.284 | 164.682 | 240.729 | 150.727 |

1. 2 < N A ≦ 1. 3
1 0 5 < T ≦ 1 1 5

| Case | 11-06 | 11-07 |
|---|---|---|
| $n_{10}$ | 1.695 | 1.705 |
| $k_{10}$ | 0.060 | 0.054 |
| $d_{10}$ (nm) | 216.291 | 277.828 |
| $n_{20}$ | 1.691 | 1.688 |
| $k_{20}$ | 0.187 | 0.185 |
| $d_{20}$ (nm) | 231.949 | 228.622 |

| | | 11-06 | 11-07 |
|---|---|---|---|
| When $n_1 \geq n_{10}$, | $n_{1m} =$ | 1.736 | 1.751 |
| When $n_1 < n_{10}$, | $n_{1m} =$ | 1.664 | 1.660 |
| When $k_1 \geq k_{10}$, | $k_{1m} =$ | 0.099 | 0.091 |
| When $k_1 < k_{10}$, | $k_{1m} =$ | 0.026 | 0.021 |
| When $d_1 \geq d_{10}$, | $d_{1m}$ (nm) $=$ | ∞ | ∞ |
| When $d_1 < d_{10}$, | $d_{1m}$ (nm) $=$ | 188.964 | 182.620 |
| When $n_2 \geq n_{20}$, | $n_{2m} =$ | 1.938 | 1.860 |
| When $n_2 < n_{20}$, | $n_{2m} =$ | 1.577 | 1.505 |
| When $k_2 \geq k_{20}$, | $k_{2m} =$ | 0.293 | 0.298 |
| When $k_2 < k_{20}$, | $k_{2m} =$ | 0.122 | 0.117 |
| When $d_2 \geq d_{20}$, | $d_{2m}$ (nm) $=$ | ∞ | ∞ |
| When $d_2 < d_{20}$, | $d_{2m}$ (nm) $=$ | 190.206 | 157.223 |

1. 2 < N A ≤ 1. 3
1 1 5 < T ≤ 1 2 5

| Case | 12-01 | 12-02 | 12-03 | 12-04 | 12-05 |
|---|---|---|---|---|---|
| $n_{10}$ | 1.919 | 1.909 | 1.897 | 1.692 | 1.694 |
| $k_{10}$ | 0.168 | 0.114 | 0.102 | 0.061 | 0.069 |
| $d_{10}$ (nm) | 15.470 | 14.219 | 12.252 | 153.490 | 218.807 |
| $n_{20}$ | 1.675 | 1.728 | 1.703 | 1.695 | 1.679 |
| $k_{20}$ | 0.416 | 0.323 | 0.257 | 0.154 | 0.236 |
| $d_{20}$ (nm) | 121.998 | 174.431 | 235.332 | 285.775 | 164.294 |

| | | 12-01 | 12-02 | 12-03 | 12-04 | 12-05 |
|---|---|---|---|---|---|---|
| When $n_1 \geq n_{10}$, | $n_{1m} =$ | 1.974 | 1.983 | 1.989 | 1.719 | 1.720 |
| When $n_1 < n_{10}$, | $n_{1m} =$ | 1.903 | 1.876 | 1.851 | 1.657 | 1.674 |
| When $k_1 \geq k_{10}$, | $k_{1m} =$ | 0.194 | 0.163 | 0.171 | 0.093 | 0.104 |
| When $k_1 < k_{10}$, | $k_{1m} =$ | 0.095 | 0.028 | 0.000 | 0.043 | 0.048 |
| When $d_1 \geq d_{10}$, | $d_{1m}$ (nm) $=$ | 18.537 | 18.641 | 17.506 | 176.125 | 245.819 |
| When $d_1 < d_{10}$, | $d_{1m}$ (nm) $=$ | 14.577 | 12.379 | 9.747 | 108.056 | 210.037 |
| When $n_2 \geq n_{20}$, | $n_{2m} =$ | 1.708 | 1.790 | 1.776 | 1.773 | 1.745 |
| When $n_2 < n_{20}$, | $n_{2m} =$ | 1.572 | 1.608 | 1.579 | 1.640 | 1.616 |
| When $k_2 \geq k_{20}$, | $k_{2m} =$ | 0.448 | 0.378 | 0.316 | 0.184 | 0.323 |
| When $k_2 < k_{20}$, | $k_{2m} =$ | 0.357 | 0.255 | 0.190 | 0.115 | 0.176 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 99.374 | 118.240 | 154.295 | 239.447 | 146.164 |

1. 2 < N A ≤ 1. 3
1 1 5 < T ≤ 1 2 5

| Case | 12-06 | 12-07 | 12-08 |
|---|---|---|---|
| $n_{10}$ | 1.695 | 1.696 | 1.706 |
| $k_{10}$ | 0.061 | 0.056 | 0.051 |
| $d_{10}$ (nm) | 216.166 | 214.076 | 276.333 |
| $n_{20}$ | 1.690 | 1.694 | 1.706 |
| $k_{20}$ | 0.192 | 0.163 | 0.162 |
| $d_{20}$ (nm) | 222.296 | 280.805 | 273.925 |

| | | 12-06 | 12-07 | 12-08 |
|---|---|---|---|---|
| When $n_1 \geq n_{10}$, | $n_{1m} =$ | 1.728 | 1.750 | 1.770 |
| When $n_1 < n_{10}$, | $n_{1m} =$ | 1.664 | 1.664 | 1.647 |
| When $k_1 \geq k_{10}$, | $k_{1m} =$ | 0.099 | 0.099 | 0.090 |
| When $k_1 < k_{10}$, | $k_{1m} =$ | 0.029 | 0.023 | 0.020 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 190.492 | 185.642 | 181.694 |
| When $n_2 \geq n_{20}$, | $n_{2m} =$ | 1.826 | 1.931 | 1.851 |
| When $n_2 < n_{20}$, | $n_{2m} =$ | 1.594 | 1.560 | 1.519 |
| When $k_2 \geq k_{20}$, | $k_{2m} =$ | 0.297 | 0.283 | 0.279 |
| When $k_2 < k_{20}$, | $k_{2m} =$ | 0.128 | 0.103 | 0.095 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 188.671 | 203.385 | 188.718 |

1. 2 < N A ≤ 1. 3
1 2 5 < T ≤ 1 3 5

| Case | 13-01 | 13-02 | 13-03 | 13-04 | 13-05 |
|---|---|---|---|---|---|
| $n_{10}$ | 1.909 | 1.895 | 1.879 | 1.694 | 1.695 |
| $k_{10}$ | 0.116 | 0.106 | 0.083 | 0.071 | 0.063 |
| $d_{10}$ (nm) | 14.671 | 12.483 | 11.828 | 219.020 | 215.746 |
| $n_{20}$ | 1.733 | 1.700 | 1.710 | 1.682 | 1.690 |
| $k_{20}$ | 0.334 | 0.261 | 0.220 | 0.245 | 0.197 |
| $d_{20}$ (nm) | 163.102 | 225.249 | 280.433 | 153.670 | 212.983 |

| | | 13-01 | 13-02 | 13-03 | 13-04 | 13-05 |
|---|---|---|---|---|---|---|
| When $n_1 \geq n_{10}$, | $n_{1m} =$ | 1.981 | 1.985 | 1.982 | 1.717 | 1.723 |
| When $n_1 < n_{10}$, | $n_{1m} =$ | 1.878 | 1.850 | 1.819 | 1.677 | 1.665 |
| When $k_1 \geq k_{10}$, | $k_{1m} =$ | 0.162 | 0.173 | 0.169 | 0.103 | 0.099 |
| When $k_1 < k_{10}$, | $k_{1m} =$ | 0.035 | 0.004 | 0.000 | 0.051 | 0.034 |
| When $d_1 \geq d_{10}$, | $d_{1m}$ (nm) = | 19.040 | 17.738 | 18.242 | 233.783 | ∞ |
| When $d_1 < d_{10}$, | $d_{1m}$ (nm) = | 12.910 | 9.987 | 8.329 | 211.731 | 191.269 |
| When $n_2 \geq n_{20}$, | $n_{2m} =$ | 1.795 | 1.771 | 1.785 | 1.724 | 1.797 |
| When $n_2 < n_{20}$, | $n_{2m} =$ | 1.610 | 1.575 | 1.592 | 1.634 | 1.609 |
| When $k_2 \geq k_{20}$, | $k_{2m} =$ | 0.389 | 0.319 | 0.285 | 0.337 | 0.302 |
| When $k_2 < k_{20}$, | $k_{2m} =$ | 0.261 | 0.192 | 0.153 | 0.187 | 0.133 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 109.327 | 144.773 | 164.318 | 140.585 | 192.523 |

1. 2 < N A ≤ 1. 3
1 2 5 < T ≤ 1 3 5

| Case | 13-06 | 13-07 |
|---|---|---|
| $n_{10}$ | 1.696 | 1.706 |
| $k_{10}$ | 0.057 | 0.052 |
| $d_{10}$ (nm) | 213.723 | 276.363 |
| $n_{20}$ | 1.693 | 1.706 |
| $k_{20}$ | 0.165 | 0.164 |
| $d_{20}$ (nm) | 271.596 | 264.087 |

| | | 13-06 | 13-07 |
|---|---|---|---|
| When $n_1 \geq n_{10}$, | $n_{1m} =$ | 1.749 | 1.772 |
| When $n_1 < n_{10}$, | $n_{1m} =$ | 1.664 | 1.645 |
| When $k_1 \geq k_{10}$, | $k_{1m} =$ | 0.099 | 0.090 |
| When $k_1 < k_{10}$, | $k_{1m} =$ | 0.026 | 0.022 |
| When $d_1 \geq d_{10}$, | $d_{1m}$ (nm) = | ∞ | ∞ |
| When $d_1 < d_{10}$, | $d_{1m}$ (nm) = | 186.782 | 182.830 |
| When $n_2 \geq n_{20}$, | $n_{2m} =$ | 1.934 | 1.851 |
| When $n_2 < n_{20}$, | $n_{2m} =$ | 1.561 | 1.521 |
| When $k_2 \geq k_{20}$, | $k_{2m} =$ | 0.285 | 0.282 |
| When $k_2 < k_{20}$, | $k_{2m} =$ | 0.104 | 0.097 |
| When $d_2 \geq d_{20}$, | $d_{2m}$ (nm) = | ∞ | ∞ |
| When $d_2 < d_{20}$, | $d_{2m}$ (nm) = | 198.444 | 183.298 |

1 . 2 < N A ≦ 1 . 3
1 3 5 < T ≦ 1 4 5

| Case | 14-01 | 14-02 | 14-03 | 14-04 | 14-05 |
|---|---|---|---|---|---|
| $n_{10}$ | 1.910 | 1.892 | 1.879 | 1.694 | 1.694 |
| $k_{10}$ | 0.115 | 0.109 | 0.084 | 0.072 | 0.064 |
| $d_{10}$ (nm) | 15.725 | 12.960 | 12.187 | 218.706 | 215.091 |
| $n_{20}$ | 1.755 | 1.698 | 1.712 | 1.684 | 1.689 |
| $k_{20}$ | 0.355 | 0.268 | 0.226 | 0.254 | 0.201 |
| $d_{20}$ (nm) | 150.207 | 215.505 | 270.397 | 144.577 | 204.614 |

| | | 14-01 | 14-02 | 14-03 | 14-04 | 14-05 |
|---|---|---|---|---|---|---|
| When $n_1 \geq n_{10}$, | $n_{1m} =$ | 1.980 | 1.980 | 1.979 | 1.708 | 1.720 |
| When $n_1 < n_{10}$, | $n_{1m} =$ | 1.881 | 1.848 | 1.820 | 1.676 | 1.666 |
| When $k_1 \geq k_{10}$, | $k_{1m} =$ | 0.157 | 0.174 | 0.167 | 0.100 | 0.099 |
| When $k_1 < k_{10}$, | $k_{1m} =$ | 0.036 | 0.011 | 0.000 | 0.054 | 0.038 |
| When $d_1 \geq d_{10}$, | $d_{1m}$ (nm) $=$ | 20.158 | 18.254 | 18.627 | 231.071 | ∞ |
| When $d_1 < d_{10}$, | $d_{1m}$ (nm) $=$ | 14.003 | 10.450 | 8.694 | 211.497 | 191.698 |
| When $n_2 \geq n_{20}$, | $n_{2m} =$ | 1.818 | 1.767 | 1.787 | 1.721 | 1.802 |
| When $n_2 < n_{20}$, | $n_{2m} =$ | 1.632 | 1.571 | 1.592 | 1.649 | 1.619 |
| When $k_2 \geq k_{20}$, | $k_{2m} =$ | 0.415 | 0.327 | 0.291 | 0.345 | 0.308 |
| When $k_2 < k_{20}$, | $k_{2m} =$ | 0.275 | 0.197 | 0.157 | 0.200 | 0.145 |
| When $d_2 \geq d_{20}$, | $d_{2m}$ (nm) $=$ | ∞ | ∞ | ∞ | 160.527 | ∞ |
| When $d_2 < d_{20}$, | $d_{2m}$ (nm) $=$ | 119.641 | 139.482 | 181.534 | 134.106 | 186.758 |

1 . 2 < N A ≦ 1 . 3
1 3 5 < T ≦ 1 4 5

| Case | 14-06 | 14-07 |
|---|---|---|
| $n_{10}$ | 1.696 | 1.706 |
| $k_{10}$ | 0.058 | 0.052 |
| $d_{10}$ (nm) | 213.482 | 276.472 |
| $n_{20}$ | 1.692 | 1.707 |
| $k_{20}$ | 0.169 | 0.168 |
| $d_{20}$ (nm) | 262.678 | 254.823 |

| | | 14-06 | 14-07 |
|---|---|---|---|
| When $n_1 \geq n_{10}$, | $n_{1m} =$ | 1.748 | 1.771 |
| When $n_1 < n_{10}$, | $n_{1m} =$ | 1.665 | 1.644 |
| When $k_1 \geq k_{10}$, | $k_{1m} =$ | 0.100 | 0.090 |
| When $k_1 < k_{10}$, | $k_{1m} =$ | 0.028 | 0.024 |
| When $d_1 \geq d_{10}$, | $d_{1m}$ (nm) $=$ | ∞ | ∞ |
| When $d_1 < d_{10}$, | $d_{1m}$ (nm) $=$ | 188.144 | 184.314 |
| When $n_2 \geq n_{20}$, | $n_{2m} =$ | 1.933 | 1.854 |
| When $n_2 < n_{20}$, | $n_{2m} =$ | 1.561 | 1.522 |
| When $k_2 \geq k_{20}$, | $k_{2m} =$ | 0.288 | 0.286 |
| When $k_2 < k_{20}$, | $k_{2m} =$ | 0.109 | 0.100 |
| When $d_2 \geq d_{20}$, | $d_{2m}$ (nm) $=$ | ∞ | ∞ |
| When $d_2 < d_{20}$, | $d_{2m}$ (nm) $=$ | 191.540 | 174.816 |

1. 2 < N A ≦ 1. 3
1 4 5 < T ≦ 1 5 5

| Case | 15-01 | 15-02 | 15-03 | 15-04 | 15-05 |
|---|---|---|---|---|---|
| $n_{10}$ | 1.919 | 1.893 | 1.882 | 1.694 | 1.694 |
| $k_{10}$ | 0.115 | 0.113 | 0.085 | 0.074 | 0.065 |
| $d_{10}$ (nm) | 16.638 | 13.413 | 12.438 | 217.741 | 214.737 |
| $n_{20}$ | 1.785 | 1.697 | 1.715 | 1.683 | 1.687 |
| $k_{20}$ | 0.385 | 0.281 | 0.235 | 0.264 | 0.207 |
| $d_{20}$ (nm) | 138.580 | 206.656 | 261.237 | 137.032 | 196.488 |

| | | 15-01 | 15-02 | 15-03 | 15-04 | 15-05 |
|---|---|---|---|---|---|---|
| When $n_1 \geq n_{10}$, | $n_{1m} =$ | 1.986 | 1.976 | 1.980 | 1.705 | 1.718 |
| When $n_1 < n_{10}$, | $n_{1m} =$ | 1.892 | 1.851 | 1.826 | 1.676 | 1.666 |
| When $k_1 \geq k_{10}$, | $k_{1m} =$ | 0.151 | 0.174 | 0.165 | 0.099 | 0.100 |
| When $k_1 < k_{10}$, | $k_{1m} =$ | 0.037 | 0.018 | 0.000 | 0.060 | 0.040 |
| When $d_1 \geq d_{10}$, | $d_{1m}$ (nm) $=$ | 20.946 | 18.588 | 18.692 | 227.547 | ∞ |
| When $d_1 < d_{10}$, | $d_{1m}$ (nm) $=$ | 15.073 | 10.996 | 9.087 | 210.480 | 192.120 |
| When $n_2 \geq n_{20}$, | $n_{2m} =$ | 1.846 | 1.763 | 1.789 | 1.722 | 1.834 |
| When $n_2 < n_{20}$, | $n_{2m} =$ | 1.665 | 1.571 | 1.591 | 1.652 | 1.629 |
| When $k_2 \geq k_{20}$, | $k_{2m} =$ | 0.451 | 0.339 | 0.301 | 0.337 | 0.312 |
| When $k_2 < k_{20}$, | $k_{2m} =$ | 0.301 | 0.209 | 0.166 | 0.217 | 0.151 |
| When $d_2 \geq d_{20}$, | $d_{2m}$ (nm) $=$ | ∞ | ∞ | ∞ | 149.574 | ∞ |
| When $d_2 < d_{20}$, | $d_{2m}$ (nm) $=$ | 113.921 | 135.398 | 177.745 | 128.876 | 178.069 |

1. 2 < N A ≦ 1. 3
1 4 5 < T ≦ 1 5 5

| Case | 15-06 | 15-07 |
|---|---|---|
| $n_{10}$ | 1.695 | 1.707 |
| $k_{10}$ | 0.059 | 0.053 |
| $d_{10}$ (nm) | 213.710 | 276.548 |
| $n_{20}$ | 1.692 | 1.707 |
| $k_{20}$ | 0.173 | 0.174 |
| $d_{20}$ (nm) | 253.675 | 246.168 |

| | | 15-06 | 15-07 |
|---|---|---|---|
| When $n_1 \geq n_{10}$, | $n_{1m} =$ | 1.747 | 1.770 |
| When $n_1 < n_{10}$, | $n_{1m} =$ | 1.665 | 1.645 |
| When $k_1 \geq k_{10}$, | $k_{1m} =$ | 0.100 | 0.089 |
| When $k_1 < k_{10}$, | $k_{1m} =$ | 0.029 | 0.025 |
| When $d_1 \geq d_{10}$, | $d_{1m}$ (nm) $=$ | ∞ | ∞ |
| When $d_1 < d_{10}$, | $d_{1m}$ (nm) $=$ | 189.864 | 185.926 |
| When $n_2 \geq n_{20}$, | $n_{2m} =$ | 1.910 | 1.858 |
| When $n_2 < n_{20}$, | $n_{2m} =$ | 1.562 | 1.520 |
| When $k_2 \geq k_{20}$, | $k_{2m} =$ | 0.289 | 0.291 |
| When $k_2 < k_{20}$, | $k_{2m} =$ | 0.109 | 0.103 |
| When $d_2 \geq d_{20}$, | $d_{2m}$ (nm) $=$ | ∞ | ∞ |
| When $d_2 < d_{20}$, | $d_{2m}$ (nm) $=$ | 189.584 | 169.414 |

1. 2 < N A ≦ 1. 3
1 5 5 < T ≦ 1 6 5

| Case | 16-01 | 16-02 | 16-03 | 16-04 | 16-05 |
|---|---|---|---|---|---|
| $n_{10}$ | 1.937 | 1.898 | 1.890 | 1.694 | 1.694 |
| $k_{10}$ | 0.118 | 0.119 | 0.087 | 0.077 | 0.067 |
| $d_{10}$ (nm) | 16.771 | 13.576 | 12.460 | 216.630 | 214.866 |
| $n_{20}$ | 1.806 | 1.695 | 1.718 | 1.679 | 1.684 |
| $k_{20}$ | 0.418 | 0.295 | 0.246 | 0.277 | 0.215 |
| $d_{20}$ (nm) | 129.251 | 198.434 | 252.589 | 129.875 | 188.027 |

| | | 16-01 | 16-02 | 16-03 | 16-04 | 16-05 |
|---|---|---|---|---|---|---|
| When $n_1 \geq n_{10}$, | $n_{1m} =$ | 2.001 | 1.978 | 1.985 | 1.707 | 1.716 |
| When $n_1 < n_{10}$, | $n_{1m} =$ | 1.914 | 1.859 | 1.836 | 1.685 | 1.666 |
| When $k_1 \geq k_{10}$, | $k_{1m} =$ | 0.148 | 0.176 | 0.164 | 0.101 | 0.100 |
| When $k_1 < k_{10}$, | $k_{1m} =$ | 0.045 | 0.025 | 0.000 | 0.067 | 0.040 |
| When $d_1 \geq d_{10}$, | $d_{1m}$ (nm) = | 20.691 | 18.424 | 18.356 | 225.238 | 231.093 |
| When $d_1 < d_{10}$, | $d_{1m}$ (nm) = | 15.556 | 11.376 | 9.363 | 212.673 | 192.697 |
| When $n_2 \geq n_{20}$, | $n_{2m} =$ | 1.861 | 1.756 | 1.791 | 1.715 | 1.840 |
| When $n_2 < n_{20}$, | $n_{2m} =$ | 1.690 | 1.574 | 1.591 | 1.643 | 1.628 |
| When $k_2 \geq k_{20}$, | $k_{2m} =$ | 0.481 | 0.351 | 0.310 | 0.328 | 0.314 |
| When $k_2 < k_{20}$, | $k_{2m} =$ | 0.336 | 0.225 | 0.176 | 0.223 | 0.151 |
| When $d_2 \geq d_{20}$, | $d_{2m}$ (nm) = | ∞ | ∞ | ∞ | 139.199 | ∞ |
| When $d_2 < d_{20}$, | $d_{2m}$ (nm) = | 109.768 | 131.712 | 172.718 | 120.241 | 167.595 |

1. 2 < N A ≦ 1. 3
1 5 5 < T ≦ 1 6 5

| Case | 16-06 | 16-07 |
|---|---|---|
| $n_{10}$ | 1.695 | 1.707 |
| $k_{10}$ | 0.060 | 0.054 |
| $d_{10}$ (nm) | 214.034 | 276.376 |
| $n_{20}$ | 1.692 | 1.707 |
| $k_{20}$ | 0.179 | 0.181 |
| $d_{20}$ (nm) | 244.657 | 237.806 |

| | | 16-06 | 16-07 |
|---|---|---|---|
| When $n_1 \geq n_{10}$, | $n_{1m} =$ | 1.745 | 1.770 |
| When $n_1 < n_{10}$, | $n_{1m} =$ | 1.666 | 1.653 |
| When $k_1 \geq k_{10}$, | $k_{1m} =$ | 0.101 | 0.089 |
| When $k_1 < k_{10}$, | $k_{1m} =$ | 0.030 | 0.027 |
| When $d_1 \geq d_{10}$, | $d_{1m}$ (nm) = | ∞ | ∞ |
| When $d_1 < d_{10}$, | $d_{1m}$ (nm) = | 191.630 | 187.468 |
| When $n_2 \geq n_{20}$, | $n_{2m} =$ | 1.889 | 1.864 |
| When $n_2 < n_{20}$, | $n_{2m} =$ | 1.562 | 1.515 |
| When $k_2 \geq k_{20}$, | $k_{2m} =$ | 0.290 | 0.295 |
| When $k_2 < k_{20}$, | $k_{2m} =$ | 0.115 | 0.110 |
| When $d_2 \geq d_{20}$, | $d_{2m}$ (nm) = | ∞ | ∞ |
| When $d_2 < d_{20}$, | $d_{2m}$ (nm) = | 179.119 | 164.223 |

1. 2 < N A ≤ 1. 3
165 < T ≤ 175

| Case | 17-01 | 17-02 | 17-03 | 17-04 | 17-05 |
|---|---|---|---|---|---|
| $n_{10}$ | 1.958 | 1.903 | 1.898 | 1.694 | 1.694 |
| $k_{10}$ | 0.128 | 0.127 | 0.090 | 0.080 | 0.068 |
| $d_{10}$ (nm) | 15.815 | 13.420 | 12.296 | 215.821 | 215.165 |
| $n_{20}$ | 1.794 | 1.688 | 1.719 | 1.668 | 1.681 |
| $k_{20}$ | 0.439 | 0.307 | 0.254 | 0.290 | 0.224 |
| $d_{20}$ (nm) | 123.830 | 190.984 | 244.231 | 122.663 | 179.093 |

| | | 17-01 | 17-02 | 17-03 | 17-04 | 17-05 |
|---|---|---|---|---|---|---|
| When $n_1 \geq n_{10}$, | $n_{1m} =$ | 2.020 | 1.981 | 1.991 | 1.707 | 1.716 |
| When $n_1 < n_{10}$, | $n_{1m} =$ | 1.942 | 1.867 | 1.846 | 1.692 | 1.665 |
| When $k_1 \geq k_{10}$, | $k_{1m} =$ | 0.150 | 0.182 | 0.165 | 0.103 | 0.101 |
| When $k_1 < k_{10}$, | $k_{1m} =$ | 0.058 | 0.033 | 0.000 | 0.077 | 0.041 |
| When $d_1 \geq d_{10}$, | $d_{1m}$ (nm) $=$ | 19.257 | 17.848 | 17.802 | 223.701 | 230.268 |
| When $d_1 < d_{10}$, | $d_{1m}$ (nm) $=$ | 15.087 | 11.461 | 9.465 | 215.120 | 195.890 |
| When $n_2 \geq n_{20}$, | $n_{2m} =$ | 1.832 | 1.743 | 1.790 | 1.677 | 1.826 |
| When $n_2 < n_{20}$, | $n_{2m} =$ | 1.680 | 1.570 | 1.590 | 1.625 | 1.625 |
| When $k_2 \geq k_{20}$, | $k_{2m} =$ | 0.483 | 0.357 | 0.316 | 0.321 | 0.315 |
| When $k_2 < k_{20}$, | $k_{2m} =$ | 0.365 | 0.239 | 0.186 | 0.252 | 0.151 |
| When $d_2 \geq d_{20}$, | $d_{2m}$ (nm) $=$ | ∞ | ∞ | ∞ | 127.631 | ∞ |
| When $d_2 < d_{20}$, | $d_{2m}$ (nm) $=$ | 111.992 | 128.672 | 166.465 | 109.461 | 158.121 |

1. 2 < N A ≤ 1. 3
165 < T ≤ 175

| Case | 17-06 | 17-07 |
|---|---|---|
| $n_{10}$ | 1.696 | 1.707 |
| $k_{10}$ | 0.061 | 0.056 |
| $d_{10}$ (nm) | 214.210 | 275.996 |
| $n_{20}$ | 1.692 | 1.705 |
| $k_{20}$ | 0.185 | 0.187 |
| $d_{20}$ (nm) | 235.479 | 229.352 |

| | | 17-06 | 17-07 |
|---|---|---|---|
| When $n_1 \geq n_{10}$, | $n_{1m} =$ | 1.744 | 1.770 |
| When $n_1 < n_{10}$, | $n_{1m} =$ | 1.667 | 1.657 |
| When $k_1 \geq k_{10}$, | $k_{1m} =$ | 0.101 | 0.088 |
| When $k_1 < k_{10}$, | $k_{1m} =$ | 0.031 | 0.030 |
| When $d_1 \geq d_{10}$, | $d_{1m}$ (nm) $=$ | ∞ | ∞ |
| When $d_1 < d_{10}$, | $d_{1m}$ (nm) $=$ | 193.216 | 188.863 |
| When $n_2 \geq n_{20}$, | $n_{2m} =$ | 1.887 | 1.872 |
| When $n_2 < n_{20}$, | $n_{2m} =$ | 1.561 | 1.509 |
| When $k_2 \geq k_{20}$, | $k_{2m} =$ | 0.292 | 0.295 |
| When $k_2 < k_{20}$, | $k_{2m} =$ | 0.120 | 0.115 |
| When $d_2 \geq d_{20}$, | $d_{2m}$ (nm) $=$ | ∞ | ∞ |
| When $d_2 < d_{20}$, | $d_{2m}$ (nm) $=$ | 161.210 | 156.975 |

1. 2 < N A ≦ 1. 3
1 7 5 < T ≦ 1 8 5

| Case | 18-01 | 18-02 | 18-03 | 18-04 | 18-05 |
|---|---|---|---|---|---|
| $n_{10}$ | 1.907 | 1.904 | 1.694 | 1.696 | 1.704 |
| $k_{10}$ | 0.135 | 0.092 | 0.070 | 0.062 | 0.051 |
| $d_{10}$ (nm) | 13.188 | 12.121 | 215.718 | 214.371 | 274.345 |
| $n_{20}$ | 1.679 | 1.720 | 1.679 | 1.692 | 1.687 |
| $k_{20}$ | 0.313 | 0.260 | 0.233 | 0.190 | 0.159 |
| $d_{20}$ (nm) | 183.151 | 235.214 | 169.072 | 225.802 | 280.556 |

| | | 18-01 | 18-02 | 18-03 | 18-04 | 18-05 |
|---|---|---|---|---|---|---|
| When $n_1 \geq n_{10}$, | $n_{1m} =$ | 1.982 | 1.997 | 1.715 | 1.743 | 1.760 |
| When $n_1 < n_{10}$, | $n_{1m} =$ | 1.873 | 1.854 | 1.666 | 1.668 | 1.658 |
| When $k_1 \geq k_{10}$, | $k_{1m} =$ | 0.188 | 0.166 | 0.102 | 0.102 | 0.090 |
| When $k_1 < k_{10}$, | $k_{1m} =$ | 0.044 | 0.000 | 0.044 | 0.032 | 0.018 |
| When $d_1 \geq d_{10}$, | $d_{1m}$ (nm) $=$ | 17.244 | 17.308 | 229.740 | ∞ | ∞ |
| When $d_1 < d_{10}$, | $d_{1m}$ (nm) $=$ | 11.395 | 9.486 | 201.461 | 194.630 | 174.558 |
| When $n_2 \geq n_{20}$, | $n_{2m} =$ | 1.730 | 1.790 | 1.771 | 1.836 | 1.900 |
| When $n_2 < n_{20}$, | $n_{2m} =$ | 1.562 | 1.589 | 1.630 | 1.559 | 1.518 |
| When $k_2 \geq k_{20}$, | $k_{2m} =$ | 0.359 | 0.319 | 0.318 | 0.293 | 0.259 |
| When $k_2 < k_{20}$, | $k_{2m} =$ | 0.249 | 0.193 | 0.159 | 0.124 | 0.097 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 128.127 | 156.903 | 151.088 | 157.464 | 192.992 |

1. 2 < N A ≤ 1. 3
1 8 5 < T ≤ 1 9 5

| Case | 19-01 | 19-02 | 19-03 | 19-04 | 19-05 |
|---|---|---|---|---|---|
| $n_{10}$ | 1.908 | 1.906 | 1.889 | 1.693 | 1.696 |
| $k_{10}$ | 0.140 | 0.092 | 0.087 | 0.071 | 0.064 |
| $d_{10}$ (nm) | 13.288 | 12.370 | 11.418 | 216.427 | 214.510 |
| $n_{20}$ | 1.676 | 1.726 | 1.707 | 1.681 | 1.692 |
| $k_{20}$ | 0.321 | 0.266 | 0.223 | 0.243 | 0.195 |
| $d_{20}$ (nm) | 172.696 | 223.910 | 283.898 | 158.126 | 215.938 |

| | | 19-01 | 19-02 | 19-03 | 19-04 | 19-05 |
|---|---|---|---|---|---|---|
| When $n_1 \geq n_{10}$, | $n_{1m} =$ | 1.981 | 1.996 | 1.994 | 1.713 | 1.742 |
| When $n_1 < n_{10}$, | $n_{1m} =$ | 1.875 | 1.857 | 1.834 | 1.670 | 1.669 |
| When $k_1 \geq k_{10}$, | $k_{1m} =$ | 0.190 | 0.163 | 0.168 | 0.103 | 0.102 |
| When $k_1 < k_{10}$, | $k_{1m} =$ | 0.055 | 0.000 | 0.000 | 0.051 | 0.037 |
| When $d_1 \geq d_{10}$, | $d_{1m}$ (nm) $=$ | 17.148 | 17.446 | 17.407 | 228.093 | ∞ |
| When $d_1 < d_{10}$, | $d_{1m}$ (nm) $=$ | 11.532 | 9.791 | 8.458 | 205.012 | 195.805 |
| When $n_2 \geq n_{20}$, | $n_{2m} =$ | 1.725 | 1.797 | 1.791 | 1.767 | 1.825 |
| When $n_2 < n_{20}$, | $n_{2m} =$ | 1.558 | 1.592 | 1.590 | 1.647 | 1.558 |
| When $k_2 \geq k_{20}$, | $k_{2m} =$ | 0.365 | 0.327 | 0.286 | 0.323 | 0.294 |
| When $k_2 < k_{20}$, | $k_{2m} =$ | 0.256 | 0.198 | 0.157 | 0.178 | 0.130 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 125.060 | 143.864 | 171.207 | 144.997 | 180.034 |

1. 2 < N A ≤ 1. 3
1 8 5 < T ≤ 1 9 5

| Case | 19-06 | 19-07 |
|---|---|---|
| $n_{10}$ | 1.696 | 1.704 |
| $k_{10}$ | 0.057 | 0.052 |
| $d_{10}$ (nm) | 213.492 | 274.677 |
| $n_{20}$ | 1.691 | 1.687 |
| $k_{20}$ | 0.166 | 0.162 |
| $d_{20}$ (nm) | 273.809 | 270.432 |

| | | 19-06 | 19-07 |
|---|---|---|---|
| When $n_1 \geq n_{10}$, | $n_{1m} =$ | 1.742 | 1.760 |
| When $n_1 < n_{10}$, | $n_{1m} =$ | 1.666 | 1.659 |
| When $k_1 \geq k_{10}$, | $k_{1m} =$ | 0.097 | 0.090 |
| When $k_1 < k_{10}$, | $k_{1m} =$ | 0.026 | 0.022 |
| When $d_1 \geq d_{10}$, | $d_{1m}$ (nm) $=$ | ∞ | ∞ |
| When $d_1 < d_{10}$, | $d_{1m}$ (nm) $=$ | 178.602 | 175.003 |
| When $n_2 \geq n_{20}$, | $n_{2m} =$ | 1.857 | 1.904 |
| When $n_2 < n_{20}$, | $n_{2m} =$ | 1.570 | 1.518 |
| When $k_2 \geq k_{20}$, | $k_{2m} =$ | 0.281 | 0.262 |
| When $k_2 < k_{20}$, | $k_{2m} =$ | 0.104 | 0.096 |
| When $d_2 \geq d_{20}$, | $d_{2m}$ (nm) $=$ | ∞ | ∞ |
| When $d_2 < d_{20}$, | $d_{2m}$ (nm) $=$ | 199.693 | 186.949 |

1．2＜ＮＡ≦1．3
195＜Ｔ≦205

| Case | 20-01 | 20-02 | 20-03 | 20-04 | 20-05 |
|---|---|---|---|---|---|
| $n_{10}$ | 1.907 | 1.904 | 1.887 | 1.693 | 1.696 |
| $k_{10}$ | 0.139 | 0.091 | 0.088 | 0.073 | 0.065 |
| $d_{10}$ (nm) | 13.915 | 13.010 | 11.752 | 216.656 | 214.259 |
| $n_{20}$ | 1.684 | 1.734 | 1.707 | 1.683 | 1.692 |
| $k_{20}$ | 0.334 | 0.275 | 0.227 | 0.253 | 0.201 |
| $d_{20}$ (nm) | 160.500 | 212.141 | 273.737 | 148.279 | 206.980 |

| | | 20-01 | 20-02 | 20-03 | 20-04 | 20-05 |
|---|---|---|---|---|---|---|
| When $n_1 \geq n_{10}$, | $n_{1m} =$ | 1.978 | 1.992 | 1.990 | 1.700 | 1.743 |
| When $n_1 < n_{10}$, | $n_{1m} =$ | 1.874 | 1.857 | 1.833 | 1.671 | 1.670 |
| When $k_1 \geq k_{10}$, | $k_{1m} =$ | 0.186 | 0.158 | 0.167 | 0.098 | 0.102 |
| When $k_1 < k_{10}$, | $k_{1m} =$ | 0.059 | 0.000 | 0.000 | 0.062 | 0.044 |
| When $d_1 \geq d_{10}$, | $d_{1m}$ (nm) $=$ | 17.817 | 18.151 | 17.811 | 226.068 | 265.367 |
| When $d_1 < d_{10}$, | $d_{1m}$ (nm) $=$ | 12.124 | 10.391 | 8.783 | 207.088 | 196.420 |
| When $n_2 \geq n_{20}$, | $n_{2m} =$ | 1.731 | 1.806 | 1.791 | 1.746 | 1.815 |
| When $n_2 < n_{20}$, | $n_{2m} =$ | 1.564 | 1.602 | 1.588 | 1.669 | 1.556 |
| When $k_2 \geq k_{20}$, | $k_{2m} =$ | 0.381 | 0.338 | 0.291 | 0.321 | 0.294 |
| When $k_2 < k_{20}$, | $k_{2m} =$ | 0.265 | 0.202 | 0.159 | 0.212 | 0.142 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 125.465 | 136.447 | 180.411 | 144.423 | 187.001 |

1．2＜ＮＡ≦1．3
195＜Ｔ≦205

| Case | 20-06 | 20-07 |
|---|---|---|
| $n_{10}$ | 1.696 | 1.704 |
| $k_{10}$ | 0.058 | 0.053 |
| $d_{10}$ (nm) | 213.637 | 275.120 |
| $n_{20}$ | 1.690 | 1.687 |
| $k_{20}$ | 0.169 | 0.165 |
| $d_{20}$ (nm) | 264.528 | 260.887 |

| | | 20-06 | 20-07 |
|---|---|---|---|
| When $n_1 \geq n_{10}$, | $n_{1m} =$ | 1.742 | 1.760 |
| When $n_1 < n_{10}$, | $n_{1m} =$ | 1.666 | 1.661 |
| When $k_1 \geq k_{10}$, | $k_{1m} =$ | 0.097 | 0.090 |
| When $k_1 < k_{10}$, | $k_{1m} =$ | 0.030 | 0.025 |
| When $d_1 \geq d_{10}$, | $d_{1m}$ (nm) $=$ | $\infty$ | $\infty$ |
| When $d_1 < d_{10}$, | $d_{1m}$ (nm) $=$ | 183.526 | 175.348 |
| When $n_2 \geq n_{20}$, | $n_{2m} =$ | 1.856 | 1.912 |
| When $n_2 < n_{20}$, | $n_{2m} =$ | 1.571 | 1.519 |
| When $k_2 \geq k_{20}$, | $k_{2m} =$ | 0.282 | 0.268 |
| When $k_2 < k_{20}$, | $k_{2m} =$ | 0.108 | 0.102 |
| When $d_2 \geq d_{20}$, | $d_{2m}$ (nm) $=$ | $\infty$ | $\infty$ |
| When $d_2 < d_{20}$, | $d_{2m}$ (nm) $=$ | 202.896 | 181.779 |

In accordance with a fifth embodiment of the invention, an antireflective film has a two-layer structure and is used in a process for manufacturing a semiconductor device by being provided between a resist layer and a silicon oxide layer formed on a surface of a silicon semiconductor substrate and having a thickness T (unit: nm) described below, for exposure of the resist layer in an exposure system having a wavelength of 190 nm to 195 nm and a numerical aperture NA of $1.3 < NA \leq 1.4$. In accordance with the fifth embodiment of the invention, an exposure method used in a process for manufacturing a semiconductor device and includes providing an antireflective film having a two-layer structure between a resist layer and a silicon oxide layer formed on a surface of a silicon semiconductor substrate and having a thickness T (unit: nm) described below, and exposing the resist layer in an exposure system having a wavelength of 190 nm to 195 nm and a numerical aperture NA of $1.3 < NA \leq 1.4$.

The antireflective film or the antireflective film used in the exposure method according to the fifth embodiment of the invention includes an upper layer having a complex refractive index $N_1$ and a lower layer having a complex refractive index $N_2$, the complex refractive indexes $N_1$ and $N_2$ being represented by the following equations:

$$N_1 = n_1 - k_1 i$$

$$N_2 = n_2 - k_2 i$$

Assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1, k_1, d_1, n_2, k_2,$ and $d_2$ satisfy the following relational expression:

$$\{(n_1 - n_{10})/(n_{1m} - n_{10})\}^2 + \{(k_1 - k_{10})/(k_{1m} - k_{1C})\}^2 + \{(d_1 - d_{1C})/(d_{1m} - d_{10})\}^2 + \{(n_2 - n_{20})/(n_{2m} - n_{20})\}^2 + \{(k_2 - k_{20})/(k_{2m} - k_{2C})\}^2 + \{(d_2 - d_{20})/(d_{2m} - d_{20})\}^2 \leq 1$$

However, a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$. In the tables below, in the line of "When $n_1 \geq n_{10}, n_{1m} =$", each value in the right columns is "$n_{1m} - n_{10}$"; in the line of "When $n_1 < n_{10}, n_{1m} =$", each value in the right columns is "$n_{10} - n_{1m}$"; in the line of "When $k_1 \geq k_{10}, k_{1m} =$", each value in the right columns is "$k_{1m} - k_{10}$"; in the line of "When $k_1 < k_{10}, k_{1m} =$", each value in the right columns is "$k_{10} - k_{1m}$"; in the line of "When $d_1 \geq d_{10}, d_{1m}$ (nm) =", each value (unit: nm) in the right columns is "$d_{1m} - d_{10}$"; in the line of "When $d_1 < d_{10}, d_{1m}$ (nm) =", each value (unit: nm) in the right columns is "$d_{10} - d_{1m}$"; in the line of "When $n_2 \geq n_{20}, n_{2m} =$", each value in the right columns is "$n_{2m} - n_{20}$"; in the line of "When $n_2 < n_{20}, n_{2m} =$", each value in the right columns is "$n_{20} - n_{2m}$"; in the line of "When $k_2 \geq k_{20}, k_{2m} =$", each value in the right columns is "$k_{2m} - k_{20}$"; in the line of "When $k_2 < k_{20}, k_{2m} =$", each value in the right columns is "$k_{20} - k_{2m}$"; in the line of "When $d_2 \geq d_{20}, d_{2m}$ (nm) =", each value (unit: nm) in the right columns is "$d_{2m} - d_{20}$"; and in the line of "When $d_2 < d_{20}, d_{2m}$ (nm) =", each value (unit: nm) in the right columns is "$d_{20} - d_{2m}$".

1. 3 < N A ≤ 1. 4

2 ≤ T ≤ 1 5

| Case | 1-01 | 1-02 | 1-03 | 1-04 | 1-05 |
|---|---|---|---|---|---|
| $n_{10}$ | 2.047 | 1.887 | 1.871 | 1.868 | 1.862 |
| $k_{10}$ | 0.012 | 0.120 | 0.106 | 0.075 | 0.065 |
| $d_{10}$ (nm) | 29.751 | 26.980 | 17.106 | 15.339 | 13.830 |
| $n_{20}$ | 6.274 | 1.973 | 1.713 | 1.738 | 1.730 |
| $k_{20}$ | 3.305 | 0.477 | 0.298 | 0.245 | 0.208 |
| $d_{20}$ (nm) | 1.566 | 76.285 | 158.161 | 212.612 | 271.884 |

| | 1-01 | 1-02 | 1-03 | 1-04 | 1-05 |
|---|---|---|---|---|---|
| When $n_1 \geq n_{10}$, $n_{1m} =$ | 2.109 | 1.929 | 1.924 | 1.935 | 1.940 |
| When $n_1 < n_{10}$, $n_{1m} =$ | 1.990 | 1.877 | 1.852 | 1.835 | 1.823 |
| When $k_1 \geq k_{10}$, $k_{1m} =$ | 0.055 | 0.138 | 0.136 | 0.123 | 0.124 |
| When $k_1 < k_{10}$, $k_{1m} =$ | 0.000 | 0.089 | 0.036 | 0.000 | 0.000 |
| When $d_1 \geq d_{10}$, $d_{1m}$ (nm) $=$ | 32.767 | 31.708 | 21.551 | 20.868 | 20.183 |
| When $d_1 < d_{10}$, $d_{1m}$ (nm) $=$ | 27.509 | 26.309 | 15.640 | 12.771 | 10.913 |
| When $n_2 \geq n_{20}$, $n_{2m} =$ | 6.594 | 2.028 | 1.750 | 1.789 | 1.793 |
| When $n_2 < n_{20}$, $n_{2m} =$ | 5.978 | 1.933 | 1.627 | 1.639 | 1.618 |
| When $k_2 \geq k_{20}$, $k_{2m} =$ | 3.556 | 0.507 | 0.335 | 0.292 | 0.258 |
| When $k_2 < k_{20}$, $k_{2m} =$ | 3.013 | 0.403 | 0.242 | 0.188 | 0.152 |
| When $d_2 \geq d_{20}$, $d_{2m}$ (nm) $=$ | 1.715 | 83.056 | ∞ | ∞ | ∞ |
| When $d_2 < d_{20}$, $d_{2m}$ (nm) $=$ | 1.418 | 75.266 | 136.202 | 175.723 | 191.206 |

1. 3 < N A ≤ 1. 4

2 ≤ T ≤ 1 5

| Case | 1-06 | 1-07 | 1-08 | 1-09 | 1-10 |
|---|---|---|---|---|---|
| $n_{10}$ | 1.691 | 1.692 | 1.711 | 1.704 | 1.705 |
| $k_{10}$ | 0.062 | 0.057 | 0.070 | 0.057 | 0.050 |
| $d_{10}$ (nm) | 161.852 | 157.460 | 239.891 | 226.155 | 221.451 |
| $n_{20}$ | 1.688 | 1.697 | 7.420 | 1.689 | 1.695 |
| $k_{20}$ | 0.179 | 0.154 | 3.291 | 0.187 | 0.158 |
| $d_{20}$ (nm) | 207.262 | 266.043 | 0.810 | 202.908 | 261.182 |

| | 1-06 | 1-07 | 1-08 | 1-09 | 1-10 |
|---|---|---|---|---|---|
| When $n_1 \geq n_{10}$, $n_{1m} =$ | 1.703 | 1.707 | 1.725 | 1.738 | 1.736 |
| When $n_1 < n_{10}$, $n_{1m} =$ | 1.685 | 1.664 | 1.704 | 1.690 | 1.688 |
| When $k_1 \geq k_{10}$, $k_{1m} =$ | 0.080 | 0.084 | 0.082 | 0.082 | 0.079 |
| When $k_1 < k_{10}$, $k_{1m} =$ | 0.051 | 0.029 | 0.049 | 0.029 | 0.022 |
| When $d_1 \geq d_{10}$, $d_{1m}$ (nm) $=$ | 169.125 | 171.143 | 250.745 | ∞ | ∞ |
| When $d_1 < d_{10}$, $d_{1m}$ (nm) $=$ | 157.974 | 129.944 | 235.697 | 215.124 | 204.319 |
| When $n_2 \geq n_{20}$, $n_{2m} =$ | 1.696 | 1.748 | 7.849 | 1.818 | 1.809 |
| When $n_2 < n_{20}$, $n_{2m} =$ | 1.666 | 1.665 | 7.185 | 1.613 | 1.611 |
| When $k_2 \geq k_{20}$, $k_{2m} =$ | 0.202 | 0.195 | 3.465 | 0.264 | 0.246 |
| When $k_2 < k_{20}$, $k_{2m} =$ | 0.150 | 0.115 | 2.625 | 0.129 | 0.105 |
| When $d_2 \geq d_{20}$, $d_{2m}$ (nm) $=$ | 213.501 | ∞ | 0.893 | ∞ | ∞ |
| When $d_2 < d_{20}$, $d_{2m}$ (nm) $=$ | 194.001 | 249.665 | 0.721 | 179.167 | 225.188 |

$1.3 < NA \leq 1.4$

$2 \leq T \leq 15$

| Case | 1-11 |
|------|------|
| $n_{10}$ | 1.695 |
| $k_{10}$ | 0.054 |
| $d_{10}$ (nm) | 267.286 |
| $n_{20}$ | 1.705 |
| $k_{20}$ | 0.184 |
| $d_{20}$ (nm) | 212.751 |

| | | |
|---|---|---|
| When $n_1 \geq n_{10}$, | $n_{1m} =$ | 1.731 |
| When $n_1 < n_{10}$, | $n_{1m} =$ | 1.655 |
| When $k_1 \geq k_{10}$, | $k_{1m} =$ | 0.080 |
| When $k_1 < k_{10}$, | $k_{1m} =$ | 0.025 |
| When $d_1 \geq d_{10}$, | $d_{1m}$ (nm) $=$ | $\infty$ |
| When $d_1 < d_{10}$, | $d_{1m}$ (nm) $=$ | 220.771 |
| When $n_2 \geq n_{20}$, | $n_{2m} =$ | 1.808 |
| When $n_2 < n_{20}$, | $n_{2m} =$ | 1.623 |
| When $k_2 \geq k_{20}$, | $k_{2m} =$ | 0.237 |
| When $k_2 < k_{20}$, | $k_{2m} =$ | 0.115 |
| When $d_2 \geq d_{20}$, | $d_{2m}$ (nm) $=$ | $\infty$ |
| When $d_2 < d_{20}$, | $d_{2m}$ (nm) $=$ | 175.645 |

$1.3 < NA \leq 1.4$

$15 < T \leq 25$

| Case | 2-01 | 2-02 | 2-03 | 2-04 | 2-05 |
|---|---|---|---|---|---|
| $n_{10}$ | 1.943 | 1.876 | 1.873 | 1.866 | 1.691 |
| $k_{10}$ | 0.121 | 0.112 | 0.080 | 0.068 | 0.064 |
| $d_{10}$ (nm) | 34.905 | 17.699 | 15.588 | 14.042 | 161.844 |
| $n_{20}$ | 6.149 | 1.719 | 1.739 | 1.732 | 1.687 |
| $k_{20}$ | 4.965 | 0.321 | 0.258 | 0.217 | 0.188 |
| $d_{20}$ (nm) | 1.046 | 148.502 | 203.950 | 262.757 | 198.716 |

| | | 2-01 | 2-02 | 2-03 | 2-04 | 2-05 |
|---|---|---|---|---|---|---|
| When $n_1 \geq n_{10}$, | $n_{1m} =$ | 1.997 | 1.925 | 1.936 | 1.942 | 1.700 |
| When $n_1 < n_{10}$, | $n_{1m} =$ | 1.902 | 1.861 | 1.842 | 1.830 | 1.690 |
| When $k_1 \geq k_{10}$, | $k_{1m} =$ | 0.155 | 0.135 | 0.124 | 0.122 | 0.079 |
| When $k_1 < k_{10}$, | $k_{1m} =$ | 0.064 | 0.044 | 0.004 | 0.000 | 0.061 |
| When $d_1 \geq d_{10}$, | $d_{1m}$ (nm) $=$ | 38.478 | 21.745 | 20.735 | 20.064 | 166.973 |
| When $d_1 < d_{10}$, | $d_{1m}$ (nm) $=$ | 32.365 | 16.569 | 13.305 | 11.354 | 161.165 |
| When $n_2 \geq n_{20}$, | $n_{2m} =$ | 6.640 | 1.749 | 1.787 | 1.793 | 1.688 |
| When $n_2 < n_{20}$, | $n_{2m} =$ | 5.695 | 1.636 | 1.643 | 1.623 | 1.668 |
| When $k_2 \geq k_{20}$, | $k_{2m} =$ | 5.267 | 0.354 | 0.304 | 0.266 | 0.197 |
| When $k_2 < k_{20}$, | $k_{2m} =$ | 4.500 | 0.266 | 0.202 | 0.162 | 0.165 |
| When $d_2 \geq d_{20}$, | $d_{2m}$ (nm) $=$ | 1.189 | ∞ | ∞ | ∞ | 199.493 |
| When $d_2 < d_{20}$, | $d_{2m}$ (nm) $=$ | 0.912 | 129.925 | 173.046 | 186.094 | 188.055 |

$1.3 < NA \leq 1.4$

$15 < T \leq 25$

| Case | 2-06 | 2-07 | 2-08 | 2-09 | 2-10 |
|---|---|---|---|---|---|
| $n_{10}$ | 1.692 | 1.706 | 1.711 | 1.704 | 1.695 |
| $k_{10}$ | 0.059 | 0.052 | 0.075 | 0.059 | 0.056 |
| $d_{10}$ (nm) | 157.652 | 221.303 | 235.815 | 225.762 | 267.452 |
| $n_{20}$ | 1.696 | 1.695 | 6.235 | 1.687 | 1.705 |
| $k_{20}$ | 0.161 | 0.165 | 4.691 | 0.197 | 0.194 |
| $d_{20}$ (nm) | 257.279 | 252.591 | 0.724 | 194.502 | 204.028 |

| | | 2-06 | 2-07 | 2-08 | 2-09 | 2-10 |
|---|---|---|---|---|---|---|
| When $n_1 \geq n_{10}$, | $n_{1m} =$ | 1.703 | 1.736 | 1.711 | 1.737 | 1.730 |
| When $n_1 < n_{10}$, | $n_{1m} =$ | 1.667 | 1.690 | 1.709 | 1.692 | 1.658 |
| When $k_1 \geq k_{10}$, | $k_{1m} =$ | 0.082 | 0.079 | 0.079 | 0.082 | 0.080 |
| When $k_1 < k_{10}$, | $k_{1m} =$ | 0.033 | 0.024 | 0.074 | 0.033 | 0.029 |
| When $d_1 \geq d_{10}$, | $d_{1m}$ (nm) $=$ | 165.499 | ∞ | 235.852 | ∞ | ∞ |
| When $d_1 < d_{10}$, | $d_{1m}$ (nm) $=$ | 138.474 | 207.206 | 234.721 | 216.211 | 222.458 |
| When $n_2 \geq n_{20}$, | $n_{2m} =$ | 1.740 | 1.797 | 6.407 | 1.814 | 1.798 |
| When $n_2 < n_{20}$, | $n_{2m} =$ | 1.670 | 1.616 | 6.233 | 1.613 | 1.629 |
| When $k_2 \geq k_{20}$, | $k_{2m} =$ | 0.196 | 0.249 | 4.693 | 0.270 | 0.240 |
| When $k_2 < k_{20}$, | $k_{2m} =$ | 0.121 | 0.111 | 3.940 | 0.138 | 0.122 |
| When $d_2 \geq d_{20}$, | $d_{2m}$ (nm) $=$ | ∞ | ∞ | 0.732 | ∞ | ∞ |
| When $d_2 < d_{20}$, | $d_{2m}$ (nm) $=$ | 244.077 | 220.690 | 0.720 | 173.495 | 171.776 |

1. 3 < N A ≤ 1. 4
2 5 < T ≤ 3 5

| Case | 3-01 | 3-02 | 3-03 | 3-04 | 3-05 |
|---|---|---|---|---|---|
| $n_{10}$ | 1.883 | 1.879 | 1.872 | 1.692 | 1.705 |
| $k_{10}$ | 0.119 | 0.084 | 0.069 | 0.061 | 0.061 |
| $d_{10}$ (nm) | 18.157 | 15.746 | 14.214 | 157.790 | 225.478 |
| $n_{20}$ | 1.723 | 1.741 | 1.737 | 1.697 | 1.687 |
| $k_{20}$ | 0.349 | 0.274 | 0.228 | 0.168 | 0.209 |
| $d_{20}$ (nm) | 139.788 | 195.542 | 253.893 | 248.784 | 186.105 |

| | | 3-01 | 3-02 | 3-03 | 3-04 | 3-05 |
|---|---|---|---|---|---|---|
| When $n_1 \geq n_{10}$, | $n_{1m} =$ | 1.927 | 1.939 | 1.945 | 1.699 | 1.735 |
| When $n_1 < n_{10}$, | $n_{1m} =$ | 1.873 | 1.852 | 1.839 | 1.671 | 1.694 |
| When $k_1 \geq k_{10}$, | $k_{1m} =$ | 0.135 | 0.123 | 0.119 | 0.079 | 0.082 |
| When $k_1 < k_{10}$, | $k_{1m} =$ | 0.055 | 0.011 | 0.000 | 0.039 | 0.038 |
| When $d_1 \geq d_{10}$, | $d_{1m}$ (nm) $=$ | 21.683 | 20.446 | 19.836 | 161.921 | 270.295 |
| When $d_1 < d_{10}$, | $d_{1m}$ (nm) $=$ | 17.423 | 13.775 | 11.786 | 145.560 | 217.505 |
| When $n_2 \geq n_{20}$, | $n_{2m} =$ | 1.744 | 1.786 | 1.794 | 1.735 | 1.754 |
| When $n_2 < n_{20}$, | $n_{2m} =$ | 1.647 | 1.650 | 1.632 | 1.679 | 1.615 |
| When $k_2 \geq k_{20}$, | $k_{2m} =$ | 0.374 | 0.316 | 0.276 | 0.196 | 0.276 |
| When $k_2 < k_{20}$, | $k_{2m} =$ | 0.295 | 0.218 | 0.173 | 0.130 | 0.149 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 124.317 | 167.810 | 181.193 | 239.270 | 167.329 |

1. 3 < N A ≤ 1. 4
2 5 < T ≤ 3 5

| Case | 3-06 |
|---|---|
| $n_{10}$ | 1.706 |
| $k_{10}$ | 0.054 |
| $d_{10}$ (nm) | 221.123 |
| $n_{20}$ | 1.695 |
| $k_{20}$ | 0.173 |
| $d_{20}$ (nm) | 244.149 |

| | | 3-06 |
|---|---|---|
| When $n_1 \geq n_{10}$, | $n_{1m} =$ | 1.735 |
| When $n_1 < n_{10}$, | $n_{1m} =$ | 1.692 |
| When $k_1 \geq k_{10}$, | $k_{1m} =$ | 0.078 |
| When $k_1 < k_{10}$, | $k_{1m} =$ | 0.026 |
| When $d_1 \geq d_{10}$, | $d_{1m}$ (nm) $=$ | ∞ |
| When $d_1 < d_{10}$, | $d_{1m}$ (nm) $=$ | 209.346 |
| When $n_2 \geq n_{20}$, | $n_{2m} =$ | 1.781 |
| When $n_2 < n_{20}$, | $n_{2m} =$ | 1.622 |
| When $k_2 \geq k_{20}$, | $k_{2m} =$ | 0.252 |
| When $k_2 < k_{20}$, | $k_{2m} =$ | 0.118 |
| When $d_2 \geq d_{20}$, | $d_{2m}$ (nm) $=$ | ∞ |
| When $d_2 < d_{20}$, | $d_{2m}$ (nm) $=$ | 214.946 |

1. 3 < N A ≤ 1. 4
3 5 < T ≤ 4 5

| Case | 4-01 | 4-02 | 4-03 | 4-04 | 4-05 |
|---|---|---|---|---|---|
| $n_{10}$ | 1.890 | 1.886 | 1.877 | 1.692 | 1.705 |
| $k_{10}$ | 0.130 | 0.088 | 0.073 | 0.062 | 0.063 |
| $d_{10}$ (nm) | 18.083 | 15.723 | 14.196 | 157.690 | 225.284 |
| $n_{20}$ | 1.714 | 1.743 | 1.736 | 1.697 | 1.687 |
| $k_{20}$ | 0.371 | 0.287 | 0.236 | 0.175 | 0.220 |
| $d_{20}$ (nm) | 132.495 | 187.112 | 245.779 | 240.328 | 177.345 |

| | | 4-01 | 4-02 | 4-03 | 4-04 | 4-05 |
|---|---|---|---|---|---|---|
| When $n_1 \geq n_{10}$, | $n_{1m} =$ | 1.928 | 1.943 | 1.947 | 1.695 | 1.732 |
| When $n_1 < n_{10}$, | $n_{1m} =$ | 1.886 | 1.862 | 1.846 | 1.674 | 1.696 |
| When $k_1 \geq k_{10}$, | $k_{1m} =$ | 0.137 | 0.123 | 0.120 | 0.075 | 0.081 |
| When $k_1 < k_{10}$, | $k_{1m} =$ | 0.069 | 0.018 | 0.000 | 0.046 | 0.042 |
| When $d_1 \geq d_{10}$, | $d_{1m}$ (nm) $=$ | 21.026 | 19.960 | 19.411 | 159.493 | 266.580 |
| When $d_1 < d_{10}$, | $d_{1m}$ (nm) $=$ | 17.768 | 14.046 | 12.019 | 148.447 | 218.746 |
| When $n_2 \geq n_{20}$, | $n_{2m} =$ | 1.723 | 1.784 | 1.789 | 1.731 | 1.745 |
| When $n_2 < n_{20}$, | $n_{2m} =$ | 1.643 | 1.655 | 1.634 | 1.687 | 1.620 |
| When $k_2 \geq k_{20}$, | $k_{2m} =$ | 0.382 | 0.326 | 0.281 | 0.195 | 0.283 |
| When $k_2 < k_{20}$, | $k_{2m} =$ | 0.323 | 0.234 | 0.182 | 0.141 | 0.159 |
| When $d_2 \geq d_{20}$, | $d_{2m}$ (nm) $=$ | ∞ | ∞ | ∞ | 273.632 | ∞ |
| When $d_2 < d_{20}$, | $d_{2m}$ (nm) $=$ | 119.322 | 160.895 | 176.028 | 234.699 | 160.070 |

1. 3 < N A ≤ 1. 4
3 5 < T ≤ 4 5

| Case | 4-06 | 4-07 |
|---|---|---|
| $n_{10}$ | 1.706 | 1.695 |
| $k_{10}$ | 0.055 | 0.055 |
| $d_{10}$ (nm) | 220.863 | 262.917 |
| $n_{20}$ | 1.695 | 1.705 |
| $k_{20}$ | 0.180 | 0.178 |
| $d_{20}$ (nm) | 235.453 | 255.408 |

| | | 4-06 | 4-07 |
|---|---|---|---|
| When $n_1 \geq n_{10}$, | $n_{1m} =$ | 1.734 | 1.723 |
| When $n_1 < n_{10}$, | $n_{1m} =$ | 1.693 | 1.660 |
| When $k_1 \geq k_{10}$, | $k_{1m} =$ | 0.078 | 0.082 |
| When $k_1 < k_{10}$, | $k_{1m} =$ | 0.027 | 0.031 |
| When $d_1 \geq d_{10}$, | $d_{1m}$ (nm) $=$ | ∞ | ∞ |
| When $d_1 < d_{10}$, | $d_{1m}$ (nm) $=$ | 210.617 | 221.552 |
| When $n_2 \geq n_{20}$, | $n_{2m} =$ | 1.767 | 1.832 |
| When $n_2 < n_{20}$, | $n_{2m} =$ | 1.630 | 1.613 |
| When $k_2 \geq k_{20}$, | $k_{2m} =$ | 0.252 | 0.241 |
| When $k_2 < k_{20}$, | $k_{2m} =$ | 0.123 | 0.108 |
| When $d_2 \geq d_{20}$, | $d_{2m}$ (nm) $=$ | ∞ | ∞ |
| When $d_2 < d_{20}$, | $d_{2m}$ (nm) $=$ | 206.982 | 177.439 |

1. 3 < N A ≤ 1. 4

45 < T ≤ 55

| Case | 5-01 | 5-02 | 5-03 | 5-04 | 5-05 |
|---|---|---|---|---|---|
| $n_{10}$ | 1.891 | 1.892 | 1.878 | 1.691 | 1.705 |
| $k_{10}$ | 0.144 | 0.091 | 0.079 | 0.064 | 0.064 |
| $d_{10}$ (nm) | 17.530 | 15.545 | 14.050 | 157.168 | 225.395 |
| $n_{20}$ | 1.686 | 1.744 | 1.728 | 1.696 | 1.686 |
| $k_{20}$ | 0.376 | 0.296 | 0.240 | 0.179 | 0.227 |
| $d_{20}$ (nm) | 126.586 | 178.253 | 238.151 | 231.953 | 167.881 |

| | | 5-01 | 5-02 | 5-03 | 5-04 | 5-05 |
|---|---|---|---|---|---|---|
| When $n_1 \geq n_{10}$, | $n_{1m} =$ | 1.925 | 1.947 | 1.947 | 1.692 | 1.729 |
| When $n_1 < n_{10}$, | $n_{1m} =$ | 1.891 | 1.870 | 1.849 | 1.677 | 1.698 |
| When $k_1 \geq k_{10}$, | $k_{1m} =$ | 0.144 | 0.124 | 0.124 | 0.069 | 0.080 |
| When $k_1 < k_{10}$, | $k_{1m} =$ | 0.087 | 0.024 | 0.000 | 0.054 | 0.044 |
| When $d_1 \geq d_{10}$, | $d_{1m}$ (nm) $=$ | 19.955 | 19.462 | 18.998 | 157.553 | 251.532 |
| When $d_1 < d_{10}$, | $d_{1m}$ (nm) $=$ | 17.523 | 14.081 | 12.045 | 150.032 | 219.912 |
| When $n_2 \geq n_{20}$, | $n_{2m} =$ | 1.686 | 1.783 | 1.778 | 1.727 | 1.728 |
| When $n_2 < n_{20}$, | $n_{2m} =$ | 1.619 | 1.656 | 1.625 | 1.693 | 1.628 |
| When $k_2 \geq k_{20}$, | $k_{2m} =$ | 0.377 | 0.330 | 0.281 | 0.190 | 0.292 |
| When $k_2 < k_{20}$, | $k_{2m} =$ | 0.336 | 0.244 | 0.186 | 0.164 | 0.167 |
| When $d_2 \geq d_{20}$, | $d_{2m}$ (nm) $=$ | 127.104 | ∞ | ∞ | 253.769 | ∞ |
| When $d_2 < d_{20}$, | $d_{2m}$ (nm) $=$ | 114.397 | 150.903 | 169.614 | 229.862 | 150.571 |

1. 3 < N A ≤ 1. 4

45 < T ≤ 55

| Case | 5-06 | 5-07 |
|---|---|---|
| $n_{10}$ | 1.706 | 1.697 |
| $k_{10}$ | 0.056 | 0.047 |
| $d_{10}$ (nm) | 220.607 | 278.691 |
| $n_{20}$ | 1.694 | 1.700 |
| $k_{20}$ | 0.184 | 0.152 |
| $d_{20}$ (nm) | 226.210 | 281.986 |

| | | 5-06 | 5-07 |
|---|---|---|---|
| When $n_1 \geq n_{10}$, | $n_{1m} =$ | 1.728 | 1.753 |
| When $n_1 < n_{10}$, | $n_{1m} =$ | 1.694 | 1.654 |
| When $k_1 \geq k_{10}$, | $k_{1m} =$ | 0.077 | 0.078 |
| When $k_1 < k_{10}$, | $k_{1m} =$ | 0.029 | 0.021 |
| When $d_1 \geq d_{10}$, | $d_{1m}$ (nm) $=$ | ∞ | ∞ |
| When $d_1 < d_{10}$, | $d_{1m}$ (nm) $=$ | 210.961 | 211.857 |
| When $n_2 \geq n_{20}$, | $n_{2m} =$ | 1.757 | 1.912 |
| When $n_2 < n_{20}$, | $n_{2m} =$ | 1.639 | 1.611 |
| When $k_2 \geq k_{20}$, | $k_{2m} =$ | 0.250 | 0.220 |
| When $k_2 < k_{20}$, | $k_{2m} =$ | 0.125 | 0.096 |
| When $d_2 \geq d_{20}$, | $d_{2m}$ (nm) $=$ | ∞ | ∞ |
| When $d_2 < d_{20}$, | $d_{2m}$ (nm) $=$ | 199.775 | 202.106 |

## 1. 3 < NA ≤ 1. 4
## 5 5 < T ≤ 6 5

| Case | 6-01 | 6-02 | 6-03 | 6-04 | 6-05 |
|---|---|---|---|---|---|
| $n_{10}$ | 1.896 | 1.875 | 1.705 | 1.705 | 1.708 |
| $k_{10}$ | 0.091 | 0.087 | 0.064 | 0.057 | 0.053 |
| $d_{10}$ (nm) | 15.652 | 14.019 | 225.606 | 220.354 | 218.289 |
| $n_{20}$ | 1.752 | 1.715 | 1.687 | 1.694 | 1.707 |
| $k_{20}$ | 0.303 | 0.239 | 0.232 | 0.186 | 0.158 |
| $d_{20}$ (nm) | 167.408 | 230.256 | 157.678 | 216.433 | 272.538 |

| | | 6-01 | 6-02 | 6-03 | 6-04 | 6-05 |
|---|---|---|---|---|---|---|
| When $n_1 \geq n_{10}$, | $n_{1m} =$ | 1.950 | 1.943 | 1.724 | 1.723 | 1.740 |
| When $n_1 < n_{10}$, | $n_{1m} =$ | 1.875 | 1.846 | 1.699 | 1.693 | 1.693 |
| When $k_1 \geq k_{10}$, | $k_{1m} =$ | 0.122 | 0.132 | 0.079 | 0.077 | 0.077 |
| When $k_1 < k_{10}$, | $k_{1m} =$ | 0.025 | 0.004 | 0.045 | 0.033 | 0.030 |
| When $d_1 \geq d_{10}$, | $d_{1m}$ (nm) $=$ | 19.494 | 18.898 | 247.964 | ∞ | ∞ |
| When $d_1 < d_{10}$, | $d_{1m}$ (nm) $=$ | 14.295 | 12.042 | 221.101 | 210.599 | 206.669 |
| When $n_2 \geq n_{20}$, | $n_{2m} =$ | 1.792 | 1.763 | 1.721 | 1.752 | 1.799 |
| When $n_2 < n_{20}$, | $n_{2m} =$ | 1.662 | 1.612 | 1.638 | 1.648 | 1.579 |
| When $k_2 \geq k_{20}$, | $k_{2m} =$ | 0.337 | 0.279 | 0.301 | 0.247 | 0.230 |
| When $k_2 < k_{20}$, | $k_{2m} =$ | 0.249 | 0.186 | 0.176 | 0.128 | 0.106 |
| When $d_2 \geq d_{20}$, | $d_{2m}$ (nm) $=$ | ∞ | ∞ | 172.085 | ∞ | ∞ |
| When $d_2 < d_{20}$, | $d_{2m}$ (nm) $=$ | 138.575 | 161.008 | 143.974 | 199.200 | 203.487 |

## 1. 3 < NA ≤ 1. 4
## 5 5 < T ≤ 6 5

| Case | 6-06 |
|---|---|
| $n_{10}$ | 1.697 |
| $k_{10}$ | 0.047 |
| $d_{10}$ (nm) | 278.413 |
| $n_{20}$ | 1.701 |
| $k_{20}$ | 0.154 |
| $d_{20}$ (nm) | 271.867 |

| | | 6-06 |
|---|---|---|
| When $n_1 \geq n_{10}$, | $n_{1m} =$ | 1.750 |
| When $n_1 < n_{10}$, | $n_{1m} =$ | 1.656 |
| When $k_1 \geq k_{10}$, | $k_{1m} =$ | 0.078 |
| When $k_1 < k_{10}$, | $k_{1m} =$ | 0.022 |
| When $d_1 \geq d_{10}$, | $d_{1m}$ (nm) $=$ | ∞ |
| When $d_1 < d_{10}$, | $d_{1m}$ (nm) $=$ | 213.947 |
| When $n_2 \geq n_{20}$, | $n_{2m} =$ | 1.923 |
| When $n_2 < n_{20}$, | $n_{2m} =$ | 1.614 |
| When $k_2 \geq k_{20}$, | $k_{2m} =$ | 0.223 |
| When $k_2 < k_{20}$, | $k_{2m} =$ | 0.097 |
| When $d_2 \geq d_{20}$, | $d_{2m}$ (nm) $=$ | ∞ |
| When $d_2 < d_{20}$, | $d_{2m}$ (nm) $=$ | 191.019 |

1．3＜ＮＡ≦1．4

65＜Ｔ≦75

| Case | 7-01 | 7-02 | 7-03 | 7-04 | 7-05 |
|---|---|---|---|---|---|
| $n_{10}$ | 1.901 | 1.871 | 1.866 | 1.706 | 1.705 |
| $k_{10}$ | 0.088 | 0.093 | 0.067 | 0.065 | 0.057 |
| $d_{10}$ (nm) | 16.388 | 14.267 | 13.172 | 225.317 | 220.112 |
| $n_{20}$ | 1.774 | 1.706 | 1.724 | 1.687 | 1.694 |
| $k_{20}$ | 0.318 | 0.241 | 0.206 | 0.238 | 0.188 |
| $d_{20}$ (nm) | 154.194 | 221.319 | 275.098 | 147.740 | 206.685 |

| | | 7-01 | 7-02 | 7-03 | 7-04 | 7-05 |
|---|---|---|---|---|---|---|
| When $n_1 \geq n_{10}$, | $n_{1m} =$ | 1.955 | 1.937 | 1.947 | 1.721 | 1.721 |
| When $n_1 < n_{10}$, | $n_{1m} =$ | 1.881 | 1.842 | 1.823 | 1.701 | 1.693 |
| When $k_1 \geq k_{10}$, | $k_{1m} =$ | 0.116 | 0.138 | 0.131 | 0.077 | 0.077 |
| When $k_1 < k_{10}$, | $k_{1m} =$ | 0.024 | 0.011 | 0.000 | 0.045 | 0.035 |
| When $d_1 \geq d_{10}$, | $d_{1m}$ (nm) $=$ | 20.279 | 19.161 | 19.228 | 239.263 | 245.793 |
| When $d_1 < d_{10}$, | $d_{1m}$ (nm) $=$ | 15.118 | 12.240 | 10.142 | 222.197 | 210.312 |
| When $n_2 \geq n_{20}$, | $n_{2m} =$ | 1.816 | 1.751 | 1.783 | 1.720 | 1.752 |
| When $n_2 < n_{20}$, | $n_{2m} =$ | 1.683 | 1.603 | 1.616 | 1.644 | 1.651 |
| When $k_2 \geq k_{20}$, | $k_{2m} =$ | 0.355 | 0.280 | 0.254 | 0.305 | 0.246 |
| When $k_2 < k_{20}$, | $k_{2m} =$ | 0.259 | 0.188 | 0.151 | 0.177 | 0.133 |
| When $d_2 \geq d_{20}$, | $d_{2m}$ (nm) $=$ | $\infty$ | $\infty$ | $\infty$ | 161.062 | $\infty$ |
| When $d_2 < d_{20}$, | $d_{2m}$ (nm) $=$ | 132.898 | 152.054 | 192.936 | 136.808 | 191.952 |

1．3＜ＮＡ≦1．4

65＜Ｔ≦75

| Case | 7-06 | 7-07 |
|---|---|---|
| $n_{10}$ | 1.708 | 1.697 |
| $k_{10}$ | 0.053 | 0.047 |
| $d_{10}$ (nm) | 218.342 | 278.070 |
| $n_{20}$ | 1.707 | 1.702 |
| $k_{20}$ | 0.161 | 0.156 |
| $d_{20}$ (nm) | 262.805 | 262.294 |

| | | 7-06 | 7-07 |
|---|---|---|---|
| When $n_1 \geq n_{10}$, | $n_{1m} =$ | 1.740 | 1.735 |
| When $n_1 < n_{10}$, | $n_{1m} =$ | 1.695 | 1.657 |
| When $k_1 \geq k_{10}$, | $k_{1m} =$ | 0.077 | 0.077 |
| When $k_1 < k_{10}$, | $k_{1m} =$ | 0.032 | 0.024 |
| When $d_1 \geq d_{10}$, | $d_{1m}$ (nm) $=$ | $\infty$ | $\infty$ |
| When $d_1 < d_{10}$, | $d_{1m}$ (nm) $=$ | 208.328 | 215.902 |
| When $n_2 \geq n_{20}$, | $n_{2m} =$ | 1.805 | 1.806 |
| When $n_2 < n_{20}$, | $n_{2m} =$ | 1.580 | 1.618 |
| When $k_2 \geq k_{20}$, | $k_{2m} =$ | 0.232 | 0.224 |
| When $k_2 < k_{20}$, | $k_{2m} =$ | 0.108 | 0.097 |
| When $d_2 \geq d_{20}$, | $d_{2m}$ (nm) $=$ | $\infty$ | $\infty$ |
| When $d_2 < d_{20}$, | $d_{2m}$ (nm) $=$ | 195.570 | 182.960 |

1．3＜NA≦1．4
75＜T≦85

| Case | 8-01 | 8-02 | 8-03 | 8-04 | 8-05 |
|---|---|---|---|---|---|
| $n_{10}$ | 1.908 | 1.871 | 1.869 | 1.706 | 1.705 |
| $k_{10}$ | 0.087 | 0.097 | 0.067 | 0.067 | 0.058 |
| $d_{10}$ (nm) | 17.362 | 14.654 | 13.479 | 224.641 | 220.026 |
| $n_{20}$ | 1.802 | 1.704 | 1.729 | 1.684 | 1.694 |
| $k_{20}$ | 0.342 | 0.250 | 0.214 | 0.248 | 0.194 |
| $d_{20}$ (nm) | 141.959 | 212.121 | 265.153 | 139.263 | 197.616 |

| | | 8-01 | 8-02 | 8-03 | 8-04 | 8-05 |
|---|---|---|---|---|---|---|
| When $n_1 \geq n_{10}$, | $n_{1m} =$ | 1.960 | 1.935 | 1.947 | 1.720 | 1.721 |
| When $n_1 < n_{10}$, | $n_{1m} =$ | 1.891 | 1.843 | 1.828 | 1.704 | 1.694 |
| When $k_1 \geq k_{10}$, | $k_{1m} =$ | 0.111 | 0.140 | 0.128 | 0.074 | 0.078 |
| When $k_1 < k_{10}$, | $k_{1m} =$ | 0.023 | 0.016 | 0.000 | 0.049 | 0.035 |
| When $d_1 \geq d_{10}$, | $d_{1m}$ (nm) $=$ | 21.165 | 19.437 | 19.380 | 236.042 | 243.446 |
| When $d_1 < d_{10}$, | $d_{1m}$ (nm) $=$ | 16.261 | 12.685 | 10.599 | 223.100 | 210.844 |
| When $n_2 \geq n_{20}$, | $n_{2m} =$ | 1.843 | 1.746 | 1.787 | 1.711 | 1.754 |
| When $n_2 < n_{20}$, | $n_{2m} =$ | 1.713 | 1.604 | 1.618 | 1.641 | 1.649 |
| When $k_2 \geq k_{20}$, | $k_{2m} =$ | 0.382 | 0.288 | 0.262 | 0.299 | 0.249 |
| When $k_2 < k_{20}$, | $k_{2m} =$ | 0.279 | 0.196 | 0.159 | 0.184 | 0.134 |
| When $d_2 \geq d_{20}$, | $d_{2m}$ (nm) $=$ | $\infty$ | $\infty$ | $\infty$ | 151.104 | $\infty$ |
| When $d_2 < d_{20}$, | $d_{2m}$ (nm) $=$ | 126.652 | 177.678 | 187.664 | 128.169 | 181.064 |

1．3＜NA≦1．4
75＜T≦85

| Case | 8-06 | 8-07 |
|---|---|---|
| $n_{10}$ | 1.708 | 1.697 |
| $k_{10}$ | 0.054 | 0.048 |
| $d_{10}$ (nm) | 218.429 | 277.999 |
| $n_{20}$ | 1.707 | 1.702 |
| $k_{20}$ | 0.165 | 0.160 |
| $d_{20}$ (nm) | 253.768 | 253.663 |

| | | 8-06 | 8-07 |
|---|---|---|---|
| When $n_1 \geq n_{10}$, | $n_{1m} =$ | 1.739 | 1.730 |
| When $n_1 < n_{10}$, | $n_{1m} =$ | 1.697 | 1.656 |
| When $k_1 \geq k_{10}$, | $k_{1m} =$ | 0.076 | 0.076 |
| When $k_1 < k_{10}$, | $k_{1m} =$ | 0.032 | 0.027 |
| When $d_1 \geq d_{10}$, | $d_{1m}$ (nm) $=$ | $\infty$ | $\infty$ |
| When $d_1 < d_{10}$, | $d_{1m}$ (nm) $=$ | 209.931 | 217.650 |
| When $n_2 \geq n_{20}$, | $n_{2m} =$ | 1.810 | 1.804 |
| When $n_2 < n_{20}$, | $n_{2m} =$ | 1.580 | 1.625 |
| When $k_2 \geq k_{20}$, | $k_{2m} =$ | 0.235 | 0.225 |
| When $k_2 < k_{20}$, | $k_{2m} =$ | 0.109 | 0.100 |
| When $d_2 \geq d_{20}$, | $d_{2m}$ (nm) $=$ | $\infty$ | $\infty$ |
| When $d_2 < d_{20}$, | $d_{2m}$ (nm) $=$ | 216.664 | 177.272 |

1. 3 < N A ≤ 1. 4
8 5 < T ≤ 9 5

| Case | 9-01 | 9-02 | 9-03 | 9-04 | 9-05 |
|---|---|---|---|---|---|
| $n_{10}$ | 1.918 | 1.876 | 1.874 | 1.706 | 1.709 |
| $k_{10}$ | 0.092 | 0.100 | 0.069 | 0.060 | 0.055 |
| $d_{10}$ (nm) | 17.977 | 14.944 | 13.674 | 219.996 | 218.382 |
| $n_{20}$ | 1.822 | 1.706 | 1.733 | 1.694 | 1.707 |
| $k_{20}$ | 0.371 | 0.265 | 0.224 | 0.203 | 0.172 |
| $d_{20}$ (nm) | 132.466 | 203.140 | 256.300 | 189.146 | 245.309 |

| | | 9-01 | 9-02 | 9-03 | 9-04 | 9-05 |
|---|---|---|---|---|---|---|
| When $n_1 \geq n_{10}$, | $n_{1m} =$ | 1.966 | 1.936 | 1.950 | 1.723 | 1.738 |
| When $n_1 < n_{10}$, | $n_{1m} =$ | 1.905 | 1.851 | 1.836 | 1.696 | 1.699 |
| When $k_1 \geq k_{10}$, | $k_{1m} =$ | 0.109 | 0.138 | 0.126 | 0.078 | 0.075 |
| When $k_1 < k_{10}$, | $k_{1m} =$ | 0.028 | 0.021 | 0.000 | 0.035 | 0.032 |
| When $d_1 \geq d_{10}$, | $d_{1m}$ (nm) $=$ | 21.461 | 19.418 | 19.237 | 242.566 | ∞ |
| When $d_1 < d_{10}$, | $d_{1m}$ (nm) $=$ | 17.167 | 13.206 | 11.040 | 212.120 | 211.373 |
| When $n_2 \geq n_{20}$, | $n_{2m} =$ | 1.855 | 1.745 | 1.789 | 1.754 | 1.811 |
| When $n_2 < n_{20}$, | $n_{2m} =$ | 1.737 | 1.611 | 1.626 | 1.644 | 1.579 |
| When $k_2 \geq k_{20}$, | $k_{2m} =$ | 0.407 | 0.300 | 0.271 | 0.255 | 0.237 |
| When $k_2 < k_{20}$, | $k_{2m} =$ | 0.308 | 0.211 | 0.169 | 0.143 | 0.115 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 121.537 | 173.052 | 183.002 | 168.954 | 213.072 |

1. 3 < N A ≤ 1. 4
8 5 < T ≤ 9 5

| Case | 9-06 |
|---|---|
| $n_{10}$ | 1.697 |
| $k_{10}$ | 0.050 |
| $d_{10}$ (nm) | 278.074 |
| $n_{20}$ | 1.701 |
| $k_{20}$ | 0.166 |
| $d_{20}$ (nm) | 245.468 |

| | | 9-06 |
|---|---|---|
| When $n_1 \geq n_{10}$, | $n_{1m} =$ | 1.728 |
| When $n_1 < n_{10}$, | $n_{1m} =$ | 1.655 |
| When $k_1 \geq k_{10}$, | $k_{1m} =$ | 0.075 |
| When $k_1 < k_{10}$, | $k_{1m} =$ | 0.029 |
| When $d_1 \geq d_{10}$, | $d_{1m}$ (nm) $=$ | ∞ |
| When $d_1 < d_{10}$, | $d_{1m}$ (nm) $=$ | 219.101 |
| When $n_2 \geq n_{20}$, | $n_{2m} =$ | 1.805 |
| When $n_2 < n_{20}$, | $n_{2m} =$ | 1.636 |
| When $k_2 \geq k_{20}$, | $k_{2m} =$ | 0.226 |
| When $k_2 < k_{20}$, | $k_{2m} =$ | 0.106 |
| When $d_2 \geq d_{20}$, | $d_{2m}$ (nm) $=$ | ∞ |
| When $d_2 < d_{20}$, | $d_{2m}$ (nm) $=$ | 172.052 |

1. 3 < NA ≤ 1.4
95 < T ≤ 105

| Case | 10-01 | 10-02 | 10-03 | 10-04 | 10-05 |
|---|---|---|---|---|---|
| $n_{10}$ | 1.929 | 1.883 | 1.880 | 1.707 | 1.709 |
| $k_{10}$ | 0.101 | 0.103 | 0.071 | 0.062 | 0.057 |
| $d_{10}$ (nm) | 17.864 | 14.973 | 13.709 | 219.774 | 218.071 |
| $n_{20}$ | 1.821 | 1.709 | 1.736 | 1.693 | 1.706 |
| $k_{20}$ | 0.398 | 0.279 | 0.234 | 0.214 | 0.179 |
| $d_{20}$ (nm) | 125.532 | 194.479 | 247.823 | 180.753 | 237.020 |

| | | 10-01 | 10-02 | 10-03 | 10-04 | 10-05 |
|---|---|---|---|---|---|---|
| When $n_1 \geq n_{10}$, | $n_{1m}=$ | 1.973 | 1.940 | 1.953 | 1.724 | 1.737 |
| When $n_1 < n_{10}$, | $n_{1m}=$ | 1.922 | 1.863 | 1.845 | 1.698 | 1.701 |
| When $k_1 \geq k_{10}$, | $k_{1m}=$ | 0.111 | 0.136 | 0.124 | 0.077 | 0.074 |
| When $k_1 < k_{10}$, | $k_{1m}=$ | 0.042 | 0.027 | 0.000 | 0.035 | 0.034 |
| When $d_1 \geq d_{10}$, | $d_{1m}$ (nm) $=$ | 20.839 | 19.023 | 18.857 | 241.722 | ∞ |
| When $d_1 < d_{10}$, | $d_{1m}$ (nm) $=$ | 17.465 | 13.566 | 11.352 | 213.515 | 212.546 |
| When $n_2 \geq n_{20}$, | $n_{2m}=$ | 1.840 | 1.742 | 1.789 | 1.751 | 1.807 |
| When $n_2 < n_{20}$, | $n_{2m}=$ | 1.743 | 1.619 | 1.632 | 1.642 | 1.577 |
| When $k_2 \geq k_{20}$, | $k_{2m}=$ | 0.418 | 0.310 | 0.278 | 0.260 | 0.236 |
| When $k_2 < k_{20}$, | $k_{2m}=$ | 0.340 | 0.227 | 0.180 | 0.155 | 0.122 |
| When $d_2 \geq d_{20}$, | $d_{2m}$ (nm) $=$ | 161.544 | ∞ | ∞ | ∞ | ∞ |
| When $d_2 < d_{20}$, | $d_{2m}$ (nm) $=$ | 119.422 | 166.497 | 178.361 | 161.067 | 205.891 |

1. 3 < NA ≤ 1.4
95 < T ≤ 105

| Case | 10-06 |
|---|---|
| $n_{10}$ | 1.697 |
| $k_{10}$ | 0.047 |
| $d_{10}$ (nm) | 275.083 |
| $n_{20}$ | 1.700 |
| $k_{20}$ | 0.148 |
| $d_{20}$ (nm) | 295.680 |

| | | 10-06 |
|---|---|---|
| When $n_1 \geq n_{10}$, | $n_{1m}=$ | 1.768 |
| When $n_1 < n_{10}$, | $n_{1m}=$ | 1.650 |
| When $k_1 \geq k_{10}$, | $k_{1m}=$ | 0.079 |
| When $k_1 < k_{10}$, | $k_{1m}=$ | 0.023 |
| When $d_1 \geq d_{10}$, | $d_{1m}$ (nm) $=$ | ∞ |
| When $d_1 < d_{10}$, | $d_{1m}$ (nm) $=$ | 200.276 |
| When $n_2 \geq n_{20}$, | $n_{2m}=$ | 1.849 |
| When $n_2 < n_{20}$, | $n_{2m}=$ | 1.604 |
| When $k_2 \geq k_{20}$, | $k_{2m}=$ | 0.227 |
| When $k_2 < k_{20}$, | $k_{2m}=$ | 0.093 |
| When $d_2 \geq d_{20}$, | $d_{2m}$ (nm) $=$ | ∞ |
| When $d_2 < d_{20}$, | $d_{2m}$ (nm) $=$ | 212.971 |

143

$1 . 3 < NA \leqq 1 . 4$

$1 0 5 < T \leqq 1 1 5$

| Case | 11–01 | 11–02 | 11–03 | 11–04 | 11–05 |
|---|---|---|---|---|---|
| $n_{10}$ | 1.891 | 1.885 | 1.707 | 1.709 | 1.697 |
| $k_{10}$ | 0.108 | 0.074 | 0.064 | 0.058 | 0.048 |
| $d_{10}$ (nm) | 14.702 | 13.594 | 219.485 | 217.678 | 275.043 |
| $n_{20}$ | 1.707 | 1.735 | 1.692 | 1.705 | 1.701 |
| $k_{20}$ | 0.289 | 0.241 | 0.223 | 0.184 | 0.152 |
| $d_{20}$ (nm) | 186.368 | 239.426 | 171.867 | 228.411 | 286.426 |

| | | 11–01 | 11–02 | 11–03 | 11–04 | 11–05 |
|---|---|---|---|---|---|---|
| When $n_1 \geqq n_{10}$, | $n_{1m} =$ | 1.944 | 1.955 | 1.723 | 1.736 | 1.767 |
| When $n_1 < n_{10}$, | $n_{1m} =$ | 1.874 | 1.853 | 1.700 | 1.703 | 1.650 |
| When $k_1 \geqq k_{10}$, | $k_{1m} =$ | 0.135 | 0.124 | 0.077 | 0.073 | 0.078 |
| When $k_1 < k_{10}$, | $k_{1m} =$ | 0.035 | 0.000 | 0.037 | 0.036 | 0.023 |
| When $d_1 \geqq d_{10}$, | $d_{1m}$ (nm) $=$ | 18.320 | 18.363 | 240.271 | ∞ | ∞ |
| When $d_1 < d_{10}$, | $d_{1m}$ (nm) $=$ | 13.618 | 11.476 | 214.658 | 213.396 | 201.239 |
| When $n_2 \geqq n_{20}$, | $n_{2m} =$ | 1.733 | 1.786 | 1.744 | 1.797 | 1.850 |
| When $n_2 < n_{20}$, | $n_{2m} =$ | 1.620 | 1.632 | 1.646 | 1.574 | 1.606 |
| When $k_2 \geqq k_{20}$, | $k_{2m} =$ | 0.314 | 0.282 | 0.261 | 0.232 | 0.229 |
| When $k_2 < k_{20}$, | $k_{2m} =$ | 0.241 | 0.188 | 0.163 | 0.126 | 0.094 |
| When $d_2 \geqq d_{20}$, | $d_{2m}$ (nm) $=$ | ∞ | ∞ | ∞ | ∞ | ∞ |
| When $d_2 < d_{20}$, | $d_{2m}$ (nm) $=$ | 157.397 | 173.024 | 156.390 | 195.169 | 202.551 |

1. 3 < N A ≤ 1. 4
1 1 5 < T ≤ 1 2 5

| Case | 12-01 | 12-02 | 12-03 | 12-04 | 12-05 |
|---|---|---|---|---|---|
| $n_{10}$ | 1.896 | 1.887 | 1.692 | 1.707 | 1.709 |
| $k_{10}$ | 0.113 | 0.078 | 0.059 | 0.065 | 0.059 |
| $d_{10}$ (nm) | 14.435 | 13.577 | 153.772 | 219.581 | 217.561 |
| $n_{20}$ | 1.703 | 1.733 | 1.694 | 1.692 | 1.702 |
| $k_{20}$ | 0.295 | 0.244 | 0.154 | 0.231 | 0.188 |
| $d_{20}$ (nm) | 177.615 | 230.253 | 284.837 | 161.904 | 219.131 |

| | | 12-01 | 12-02 | 12-03 | 12-04 | 12-05 |
|---|---|---|---|---|---|---|
| When $n_1 \geq n_{10}$, | $n_{1m}=$ | 1.947 | 1.955 | 1.718 | 1.720 | 1.728 |
| When $n_1 < n_{10}$, | $n_{1m}=$ | 1.882 | 1.856 | 1.664 | 1.701 | 1.703 |
| When $k_1 \geq k_{10}$, | $k_{1m}=$ | 0.136 | 0.126 | 0.090 | 0.076 | 0.072 |
| When $k_1 < k_{10}$, | $k_{1m}=$ | 0.044 | 0.000 | 0.044 | 0.041 | 0.040 |
| When $d_1 \geq d_{10}$, | $d_{1m}$ (nm) $=$ | 17.718 | 18.125 | 175.199 | 231.299 | ∞ |
| When $d_1 < d_{10}$, | $d_{1m}$ (nm) $=$ | 13.578 | 11.595 | 128.388 | 215.799 | 214.049 |
| When $n_2 \geq n_{20}$, | $n_{2m}=$ | 1.725 | 1.783 | 1.772 | 1.738 | 1.784 |
| When $n_2 < n_{20}$, | $n_{2m}=$ | 1.617 | 1.629 | 1.642 | 1.658 | 1.629 |
| When $k_2 \geq k_{20}$, | $k_{2m}=$ | 0.315 | 0.284 | 0.182 | 0.262 | 0.229 |
| When $k_2 < k_{20}$, | $k_{2m}=$ | 0.249 | 0.192 | 0.119 | 0.174 | 0.128 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 145.196 | 165.335 | 240.440 | 152.266 | 193.496 |

1. 3 < N A ≤ 1. 4
1 1 5 < T ≤ 1 2 5

| Case | 12-06 | 12-07 |
|---|---|---|
| $n_{10}$ | 1.707 | 1.697 |
| $k_{10}$ | 0.053 | 0.048 |
| $d_{10}$ (nm) | 216.484 | 274.812 |
| $n_{20}$ | 1.695 | 1.701 |
| $k_{20}$ | 0.157 | 0.154 |
| $d_{20}$ (nm) | 278.062 | 276.656 |

| | | 12-06 | 12-07 |
|---|---|---|---|
| When $n_1 \geq n_{10}$, | $n_{1m}=$ | 1.748 | 1.768 |
| When $n_1 < n_{10}$, | $n_{1m}=$ | 1.689 | 1.651 |
| When $k_1 \geq k_{10}$, | $k_{1m}=$ | 0.077 | 0.078 |
| When $k_1 < k_{10}$, | $k_{1m}=$ | 0.030 | 0.024 |
| When $d_1 \geq d_{10}$, | $d_{1m}$ (nm) $=$ | ∞ | ∞ |
| When $d_1 < d_{10}$, | $d_{1m}$ (nm) $=$ | 199.849 | 201.932 |
| When $n_2 \geq n_{20}$, | $n_{2m}=$ | 1.761 | 1.850 |
| When $n_2 < n_{20}$, | $n_{2m}=$ | 1.583 | 1.607 |
| When $k_2 \geq k_{20}$, | $k_{2m}=$ | 0.215 | 0.229 |
| When $k_2 < k_{20}$, | $k_{2m}=$ | 0.104 | 0.098 |
| When $d_2 \geq d_{20}$, | $d_{2m}$ (nm) $=$ | ∞ | ∞ |
| When $d_2 < d_{20}$, | $d_{2m}$ (nm) $=$ | 212.463 | 192.106 |

1. 3 < N A ≤ 1. 4
1 2 5 < T ≤ 1 3 5

| Case | 13-01 | 13-02 | 13-03 | 13-04 | 13-05 |
|---|---|---|---|---|---|
| $n_{10}$ | 1.898 | 1.885 | 1.868 | 1.707 | 1.708 |
| $k_{10}$ | 0.115 | 0.081 | 0.075 | 0.067 | 0.060 |
| $d_{10}$ (nm) | 14.632 | 13.917 | 12.752 | 219.938 | 217.756 |
| $n_{20}$ | 1.705 | 1.732 | 1.713 | 1.695 | 1.701 |
| $k_{20}$ | 0.303 | 0.248 | 0.206 | 0.239 | 0.192 |
| $d_{20}$ (nm) | 166.646 | 219.851 | 279.921 | 151.390 | 209.457 |

| | | 13-01 | 13-02 | 13-03 | 13-04 | 13-05 |
|---|---|---|---|---|---|---|
| When $n_1 \geq n_{10}$, | $n_{1m}=$ | 1.949 | 1.951 | 1.949 | 1.716 | 1.721 |
| When $n_1 < n_{10}$, | $n_{1m}=$ | 1.886 | 1.855 | 1.830 | 1.703 | 1.704 |
| When $k_1 \geq k_{10}$, | $k_{1m}=$ | 0.135 | 0.127 | 0.135 | 0.075 | 0.072 |
| When $k_1 < k_{10}$, | $k_{1m}=$ | 0.050 | 0.002 | 0.000 | 0.050 | 0.045 |
| When $d_1 \geq d_{10}$, | $d_{1m}$ (nm) = | 17.809 | 18.468 | 18.469 | 226.140 | ∞ |
| When $d_1 < d_{10}$, | $d_{1m}$ (nm) = | 13.869 | 11.960 | 10.161 | 217.246 | 214.692 |
| When $n_2 \geq n_{20}$, | $n_{2m}=$ | 1.725 | 1.781 | 1.771 | 1.731 | 1.769 |
| When $n_2 < n_{20}$, | $n_{2m}=$ | 1.618 | 1.628 | 1.611 | 1.678 | 1.659 |
| When $k_2 \geq k_{20}$, | $k_{2m}=$ | 0.322 | 0.288 | 0.250 | 0.263 | 0.228 |
| When $k_2 < k_{20}$, | $k_{2m}=$ | 0.256 | 0.194 | 0.153 | 0.185 | 0.138 |
| When $d_2 \geq d_{20}$, | $d_{2m}$ (nm) = | ∞ | ∞ | ∞ | 179.041 | ∞ |
| When $d_2 < d_{20}$, | $d_{2m}$ (nm) = | 136.370 | 153.796 | 194.427 | 147.510 | 199.403 |

1. 3 < N A ≤ 1. 4
1 2 5 < T ≤ 1 3 5

| Case | 13-06 | 13-07 |
|---|---|---|
| $n_{10}$ | 1.706 | 1.696 |
| $k_{10}$ | 0.054 | 0.049 |
| $d_{10}$ (nm) | 217.065 | 274.075 |
| $n_{20}$ | 1.694 | 1.702 |
| $k_{20}$ | 0.160 | 0.157 |
| $d_{20}$ (nm) | 268.021 | 267.366 |

| | | 13-06 | 13-07 |
|---|---|---|---|
| When $n_1 \geq n_{10}$, | $n_{1m}=$ | 1.746 | 1.770 |
| When $n_1 < n_{10}$, | $n_{1m}=$ | 1.690 | 1.651 |
| When $k_1 \geq k_{10}$, | $k_{1m}=$ | 0.077 | 0.078 |
| When $k_1 < k_{10}$, | $k_{1m}=$ | 0.033 | 0.026 |
| When $d_1 \geq d_{10}$, | $d_{1m}$ (nm) = | ∞ | ∞ |
| When $d_1 < d_{10}$, | $d_{1m}$ (nm) = | 202.380 | 202.716 |
| When $n_2 \geq n_{20}$, | $n_{2m}=$ | 1.761 | 1.853 |
| When $n_2 < n_{20}$, | $n_{2m}=$ | 1.586 | 1.608 |
| When $k_2 \geq k_{20}$, | $k_{2m}=$ | 0.219 | 0.227 |
| When $k_2 < k_{20}$, | $k_{2m}=$ | 0.106 | 0.099 |
| When $d_2 \geq d_{20}$, | $d_{2m}$ (nm) = | ∞ | ∞ |
| When $d_2 < d_{20}$, | $d_{2m}$ (nm) = | 208.129 | 186.947 |

1．3＜ＮＡ≦1．4
135＜Ｔ≦145

| Case | 14-01 | 14-02 | 14-03 | 14-04 | 14-05 |
|---|---|---|---|---|---|
| $n_{10}$ | 1.899 | 1.882 | 1.870 | 1.708 | 1.707 |
| $k_{10}$ | 0.115 | 0.083 | 0.074 | 0.062 | 0.055 |
| $d_{10}$ (nm) | 15.367 | 14.477 | 13.063 | 217.887 | 217.378 |
| $n_{20}$ | 1.714 | 1.732 | 1.717 | 1.700 | 1.693 |
| $k_{20}$ | 0.318 | 0.256 | 0.212 | 0.197 | 0.164 |
| $d_{20}$ (nm) | 155.141 | 209.893 | 269.637 | 200.272 | 258.646 |

| | 14-01 | 14-02 | 14-03 | 14-04 | 14-05 |
|---|---|---|---|---|---|
| When $n_1 \geq n_{10}$, $n_{1m}=$ | 1.949 | 1.947 | 1.949 | 1.716 | 1.744 |
| When $n_1 < n_{10}$, $n_{1m}=$ | 1.888 | 1.854 | 1.833 | 1.704 | 1.691 |
| When $k_1 \geq k_{10}$, $k_{1m}=$ | 0.132 | 0.127 | 0.132 | 0.071 | 0.077 |
| When $k_1 < k_{10}$, $k_{1m}=$ | 0.051 | 0.006 | 0.000 | 0.050 | 0.036 |
| When $d_1 \geq d_{10}$, $d_{1m}$ (nm) $=$ | 18.581 | 19.085 | 18.767 | ∞ | ∞ |
| When $d_1 < d_{10}$, $d_{1m}$ (nm) $=$ | 14.660 | 12.539 | 10.533 | 215.374 | 204.778 |
| When $n_2 \geq n_{20}$, $n_{2m}=$ | 1.733 | 1.780 | 1.774 | 1.754 | 1.760 |
| When $n_2 < n_{20}$, $n_{2m}=$ | 1.627 | 1.630 | 1.611 | 1.677 | 1.592 |
| When $k_2 \geq k_{20}$, $k_{2m}=$ | 0.337 | 0.296 | 0.256 | 0.228 | 0.223 |
| When $k_2 < k_{20}$, $k_{2m}=$ | 0.266 | 0.200 | 0.157 | 0.152 | 0.109 |
| When $d_2 \geq d_{20}$, $d_{2m}$ (nm) $=$ | ∞ | ∞ | ∞ | ∞ | ∞ |
| When $d_2 < d_{20}$, $d_{2m}$ (nm) $=$ | 131.038 | 171.650 | 189.575 | 195.166 | 202.001 |

1．3＜ＮＡ≦1．4
135＜Ｔ≦145

| Case | 14-06 |
|---|---|
| $n_{10}$ | 1.696 |
| $k_{10}$ | 0.050 |
| $d_{10}$ (nm) | 273.384 |
| $n_{20}$ | 1.702 |
| $k_{20}$ | 0.160 |
| $d_{20}$ (nm) | 258.714 |

| | 14-06 |
|---|---|
| When $n_1 \geq n_{10}$, $n_{1m}=$ | 1.741 |
| When $n_1 < n_{10}$, $n_{1m}=$ | 1.652 |
| When $k_1 \geq k_{10}$, $k_{1m}=$ | 0.078 |
| When $k_1 < k_{10}$, $k_{1m}=$ | 0.028 |
| When $d_1 \geq d_{10}$, $d_{1m}$ (nm) $=$ | ∞ |
| When $d_1 < d_{10}$, $d_{1m}$ (nm) $=$ | 209.881 |
| When $n_2 \geq n_{20}$, $n_{2m}=$ | 1.859 |
| When $n_2 < n_{20}$, $n_{2m}=$ | 1.608 |
| When $k_2 \geq k_{20}$, $k_{2m}=$ | 0.226 |
| When $k_2 < k_{20}$, $k_{2m}=$ | 0.098 |
| When $d_2 \geq d_{20}$, $d_{2m}$ (nm) $=$ | ∞ |
| When $d_2 < d_{20}$, $d_{2m}$ (nm) $=$ | 178.700 |

1. 3 < N A ≤ 1. 4
145< T ≤ 155

| Case | 15-01 | 15-02 | 15-03 | 15-04 | 15-05 |
|---|---|---|---|---|---|
| $n_{10}$ | 1.903 | 1.884 | 1.874 | 1.708 | 1.707 |
| $k_{10}$ | 0.118 | 0.087 | 0.075 | 0.063 | 0.056 |
| $d_{10}$ (nm) | 16.130 | 14.896 | 13.357 | 217.693 | 217.044 |
| $n_{20}$ | 1.723 | 1.733 | 1.722 | 1.700 | 1.694 |
| $k_{20}$ | 0.340 | 0.268 | 0.221 | 0.205 | 0.169 |
| $d_{20}$ (nm) | 145.164 | 201.113 | 260.240 | 191.744 | 250.083 |

| | | 15-01 | 15-02 | 15-03 | 15-04 | 15-05 |
|---|---|---|---|---|---|---|
| When $n_1 \geq n_{10}$, | $n_{1m} =$ | 1.950 | 1.946 | 1.951 | 1.714 | 1.742 |
| When $n_1 < n_{10}$, | $n_{1m} =$ | 1.895 | 1.858 | 1.839 | 1.706 | 1.694 |
| When $k_1 \geq k_{10}$, | $k_{1m} =$ | 0.130 | 0.127 | 0.128 | 0.070 | 0.076 |
| When $k_1 < k_{10}$, | $k_{1m} =$ | 0.053 | 0.010 | 0.000 | 0.053 | 0.038 |
| When $d_1 \geq d_{10}$, | $d_{1m}$ (nm) = | 19.240 | 19.361 | 18.857 | 222.035 | ∞ |
| When $d_1 < d_{10}$, | $d_{1m}$ (nm) = | 15.619 | 13.105 | 10.992 | 216.109 | 206.771 |
| When $n_2 \geq n_{20}$, | $n_{2m} =$ | 1.737 | 1.779 | 1.777 | 1.735 | 1.755 |
| When $n_2 < n_{20}$, | $n_{2m} =$ | 1.641 | 1.636 | 1.612 | 1.682 | 1.595 |
| When $k_2 \geq k_{20}$, | $k_{2m} =$ | 0.356 | 0.307 | 0.265 | 0.225 | 0.223 |
| When $k_2 < k_{20}$, | $k_{2m} =$ | 0.286 | 0.211 | 0.166 | 0.161 | 0.114 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 126.286 | 170.199 | 185.156 | 187.971 | 215.684 |

1. 3 < N A ≤ 1. 4
145 < T ≤ 155

| Case | 15-06 |
|---|---|
| $n_{10}$ | 1.696 |
| $k_{10}$ | 0.051 |
| $d_{10}$ (nm) | 273.493 |
| $n_{20}$ | 1.702 |
| $k_{20}$ | 0.165 |
| $d_{20}$ (nm) | 250.180 |

| | | 15-06 |
|---|---|---|
| When $n_1 \geq n_{10}$, | $n_{1m} =$ | 1.738 |
| When $n_1 < n_{10}$, | $n_{1m} =$ | 1.652 |
| When $k_1 \geq k_{10}$, | $k_{1m} =$ | 0.078 |
| When $k_1 < k_{10}$, | $k_{1m} =$ | 0.031 |
| When $d_1 \geq d_{10}$, | $d_{1m}$ (nm) = | ∞ |
| When $d_1 < d_{10}$, | $d_{1m}$ (nm) = | 213.326 |
| When $n_2 \geq n_{20}$, | $n_{2m} =$ | 1.839 |
| When $n_2 < n_{20}$, | $n_{2m} =$ | 1.609 |
| When $k_2 \geq k_{20}$, | $k_{2m} =$ | 0.227 |
| When $k_2 < k_{20}$, | $k_{2m} =$ | 0.102 |
| When $d_2 \geq d_{20}$, | $d_{2m}$ (nm) = | ∞ |
| When $d_2 < d_{20}$, | $d_{2m}$ (nm) = | 171.738 |

1. 3 < N A ≤ 1. 4
1 5 5 < T ≤ 1 6 5

| Case | 16-01 | 16-02 | 16-03 | 16-04 | 16-05 |
|---|---|---|---|---|---|
| $n_{10}$ | 1.913 | 1.891 | 1.879 | 1.709 | 1.708 |
| $k_{10}$ | 0.125 | 0.091 | 0.077 | 0.064 | 0.057 |
| $d_{10}$ (nm) | 16.406 | 14.954 | 13.440 | 217.197 | 216.333 |
| $n_{20}$ | 1.727 | 1.734 | 1.724 | 1.700 | 1.694 |
| $k_{20}$ | 0.366 | 0.282 | 0.231 | 0.214 | 0.175 |
| $d_{20}$ (nm) | 136.777 | 193.024 | 251.802 | 183.446 | 241.739 |

| | | 16-01 | 16-02 | 16-03 | 16-04 | 16-05 |
|---|---|---|---|---|---|---|
| When $n_1 \geq n_{10}$, | $n_{1m} =$ | 1.955 | 1.950 | 1.953 | 1.714 | 1.742 |
| When $n_1 < n_{10}$, | $n_{1m} =$ | 1.910 | 1.868 | 1.847 | 1.708 | 1.697 |
| When $k_1 \geq k_{10}$, | $k_{1m} =$ | 0.129 | 0.127 | 0.127 | 0.066 | 0.075 |
| When $k_1 < k_{10}$, | $k_{1m} =$ | 0.064 | 0.016 | 0.000 | 0.055 | 0.039 |
| When $d_1 \geq d_{10}$, | $d_{1m}$ (nm) = | 19.185 | 19.061 | 18.574 | 220.596 | ∞ |
| When $d_1 < d_{10}$, | $d_{1m}$ (nm) = | 16.268 | 13.452 | 11.329 | 216.874 | 208.223 |
| When $n_2 \geq n_{20}$, | $n_{2m} =$ | 1.731 | 1.774 | 1.776 | 1.707 | 1.748 |
| When $n_2 < n_{20}$, | $n_{2m} =$ | 1.651 | 1.642 | 1.618 | 1.678 | 1.595 |
| When $k_2 \geq k_{20}$, | $k_{2m} =$ | 0.371 | 0.317 | 0.273 | 0.218 | 0.220 |
| When $k_2 < k_{20}$, | $k_{2m} =$ | 0.314 | 0.227 | 0.177 | 0.165 | 0.120 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 121.662 | 164.818 | 180.821 | 179.468 | 209.260 |

1. 3 < N A ≤ 1. 4
1 5 5 < T ≤ 1 6 5

| Case | 16-06 |
|---|---|
| $n_{10}$ | 1.696 |
| $k_{10}$ | 0.052 |
| $d_{10}$ (nm) | 274.035 |
| $n_{20}$ | 1.700 |
| $k_{20}$ | 0.171 |
| $d_{20}$ (nm) | 241.498 |

| | | 16-06 |
|---|---|---|
| When $n_1 \geq n_{10}$, | $n_{1m} =$ | 1.735 |
| When $n_1 < n_{10}$, | $n_{1m} =$ | 1.651 |
| When $k_1 \geq k_{10}$, | $k_{1m} =$ | 0.077 |
| When $k_1 < k_{10}$, | $k_{1m} =$ | 0.034 |
| When $d_1 \geq d_{10}$, | $d_{1m}$ (nm) = | ∞ |
| When $d_1 < d_{10}$, | $d_{1m}$ (nm) = | 215.451 |
| When $n_2 \geq n_{20}$, | $n_{2m} =$ | 1.840 |
| When $n_2 < n_{20}$, | $n_{2m} =$ | 1.612 |
| When $k_2 \geq k_{20}$, | $k_{2m} =$ | 0.229 |
| When $k_2 < k_{20}$, | $k_{2m} =$ | 0.108 |
| When $d_2 \geq d_{20}$, | $d_{2m}$ (nm) = | ∞ |
| When $d_2 < d_{20}$, | $d_{2m}$ (nm) = | 166.208 |

1．3＜ＮＡ≦1．4

165＜Ｔ≦175

| Case | 17-01 | 17-02 | 17-03 | 17-04 |
|---|---|---|---|---|
| $n_{10}$ | 1.900 | 1.885 | 1.708 | 1.697 |
| $k_{10}$ | 0.097 | 0.082 | 0.058 | 0.048 |
| $d_{10}$ (nm) | 14.674 | 13.311 | 215.615 | 273.453 |
| $n_{20}$ | 1.732 | 1.722 | 1.694 | 1.699 |
| $k_{20}$ | 0.294 | 0.239 | 0.180 | 0.151 |
| $d_{20}$ (nm) | 185.336 | 243.911 | 233.152 | 289.720 |

| | | 17-01 | 17-02 | 17-03 | 17-04 |
|---|---|---|---|---|---|
| When $n_1 \geq n_{10}$, | $n_{1m}=$ | 1.955 | 1.956 | 1.741 | 1.736 |
| When $n_1 < n_{10}$, | $n_{1m}=$ | 1.881 | 1.856 | 1.699 | 1.650 |
| When $k_1 \geq k_{10}$, | $k_{1m}=$ | 0.126 | 0.128 | 0.074 | 0.080 |
| When $k_1 < k_{10}$, | $k_{1m}=$ | 0.023 | 0.000 | 0.039 | 0.020 |
| When $d_1 \geq d_{10}$, | $d_{1m}$ (nm) $=$ | 18.346 | 18.029 | ∞ | ∞ |
| When $d_1 < d_{10}$, | $d_{1m}$ (nm) $=$ | 13.519 | 11.467 | 209.091 | 211.222 |
| When $n_2 \geq n_{20}$, | $n_{2m}=$ | 1.767 | 1.769 | 1.740 | 1.868 |
| When $n_2 < n_{20}$, | $n_{2m}=$ | 1.645 | 1.618 | 1.591 | 1.614 |
| When $k_2 \geq k_{20}$, | $k_{2m}=$ | 0.322 | 0.277 | 0.217 | 0.224 |
| When $k_2 < k_{20}$, | $k_{2m}=$ | 0.243 | 0.187 | 0.126 | 0.094 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 156.774 | 176.585 | 198.961 | 204.980 |

1．3＜ＮＡ≦1．4
175＜Ｔ≦185

| Case | 18-01 | 18-02 | 18-03 | 18-04 | 18-05 |
|---|---|---|---|---|---|
| $n_{10}$ | 1.908 | 1.888 | 1.708 | 1.709 | 1.697 |
| $k_{10}$ | 0.102 | 0.088 | 0.059 | 0.054 | 0.049 |
| $d_{10}$ (nm) | 14.316 | 13.163 | 215.377 | 215.137 | 273.522 |
| $n_{20}$ | 1.730 | 1.716 | 1.693 | 1.702 | 1.700 |
| $k_{20}$ | 0.303 | 0.243 | 0.185 | 0.158 | 0.154 |
| $d_{20}$ (nm) | 177.238 | 235.819 | 223.802 | 279.418 | 279.960 |

| | | 18-01 | 18-02 | 18-03 | 18-04 | 18-05 |
|---|---|---|---|---|---|---|
| When $n_1 \geq n_{10}$, | $n_{1m} =$ | 1.960 | 1.956 | 1.740 | 1.745 | 1.734 |
| When $n_1 < n_{10}$, | $n_{1m} =$ | 1.893 | 1.861 | 1.700 | 1.696 | 1.657 |
| When $k_1 \geq k_{10}$, | $k_{1m} =$ | 0.126 | 0.131 | 0.073 | 0.075 | 0.079 |
| When $k_1 < k_{10}$, | $k_{1m} =$ | 0.031 | 0.002 | 0.041 | 0.028 | 0.020 |
| When $d_1 \geq d_{10}$, | $d_{1m}$ (nm) $=$ | 17.569 | 17.540 | ∞ | ∞ | ∞ |
| When $d_1 < d_{10}$, | $d_{1m}$ (nm) $=$ | 13.467 | 11.504 | 209.546 | 205.939 | 213.387 |
| When $n_2 \geq n_{20}$, | $n_{2m} =$ | 1.759 | 1.759 | 1.736 | 1.790 | 1.874 |
| When $n_2 < n_{20}$, | $n_{2m} =$ | 1.644 | 1.611 | 1.587 | 1.604 | 1.617 |
| When $k_2 \geq k_{20}$, | $k_{2m} =$ | 0.325 | 0.278 | 0.217 | 0.211 | 0.226 |
| When $k_2 < k_{20}$, | $k_{2m} =$ | 0.256 | 0.193 | 0.129 | 0.105 | 0.095 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 143.259 | 171.381 | 185.714 | 201.921 | 193.505 |

1．3＜ＮＡ≦1．4
185＜Ｔ≦195

| Case | 19-01 | 19-02 | 19-03 | 19-04 | 19-05 |
|---|---|---|---|---|---|
| $n_{10}$ | 1.914 | 1.886 | 1.873 | 1.692 | 1.708 |
| $k_{10}$ | 0.104 | 0.093 | 0.070 | 0.060 | 0.060 |
| $d_{10}$ (nm) | 14.390 | 13.299 | 12.581 | 152.854 | 215.913 |
| $n_{20}$ | 1.735 | 1.710 | 1.721 | 1.693 | 1.692 |
| $k_{20}$ | 0.314 | 0.247 | 0.208 | 0.157 | 0.189 |
| $d_{20}$ (nm) | 166.400 | 226.131 | 280.628 | 278.359 | 213.567 |

| | | 19-01 | 19-02 | 19-03 | 19-04 | 19-05 |
|---|---|---|---|---|---|---|
| When $n_1 \geq n_{10}$, | $n_{1m}=$ | 1.964 | 1.952 | 1.955 | 1.709 | 1.739 |
| When $n_1 < n_{10}$, | $n_{1m}=$ | 1.903 | 1.860 | 1.833 | 1.664 | 1.699 |
| When $k_1 \geq k_{10}$, | $k_{1m}=$ | 0.123 | 0.135 | 0.133 | 0.092 | 0.074 |
| When $k_1 < k_{10}$, | $k_{1m}=$ | 0.040 | 0.012 | 0.000 | 0.042 | 0.044 |
| When $d_1 \geq d_{10}$, | $d_{1m}$ (nm) $=$ | 17.353 | 17.539 | 18.087 | 163.046 | ∞ |
| When $d_1 < d_{10}$, | $d_{1m}$ (nm) $=$ | 13.759 | 11.668 | 9.947 | 129.659 | 210.046 |
| When $n_2 \geq n_{20}$, | $n_{2m}=$ | 1.759 | 1.750 | 1.778 | 1.784 | 1.739 |
| When $n_2 < n_{20}$, | $n_{2m}=$ | 1.648 | 1.604 | 1.614 | 1.659 | 1.586 |
| When $k_2 \geq k_{20}$, | $k_{2m}=$ | 0.331 | 0.280 | 0.252 | 0.196 | 0.222 |
| When $k_2 < k_{20}$, | $k_{2m}=$ | 0.267 | 0.196 | 0.156 | 0.120 | 0.129 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 144.756 | 162.922 | 193.262 | 243.485 | 177.669 |

1．3＜ＮＡ≦1．4
185＜Ｔ≦195

| Case | 19-06 | 19-07 |
|---|---|---|
| $n_{10}$ | 1.708 | 1.697 |
| $k_{10}$ | 0.054 | 0.050 |
| $d_{10}$ (nm) | 215.905 | 273.350 |
| $n_{20}$ | 1.701 | 1.701 |
| $k_{20}$ | 0.161 | 0.157 |
| $d_{20}$ (nm) | 269.362 | 270.178 |

| | | 19-06 | 19-07 |
|---|---|---|---|
| When $n_1 \geq n_{10}$, | $n_{1m}=$ | 1.744 | 1.732 |
| When $n_1 < n_{10}$, | $n_{1m}=$ | 1.697 | 1.658 |
| When $k_1 \geq k_{10}$, | $k_{1m}=$ | 0.075 | 0.078 |
| When $k_1 < k_{10}$, | $k_{1m}=$ | 0.029 | 0.021 |
| When $d_1 \geq d_{10}$, | $d_{1m}$ (nm) $=$ | ∞ | ∞ |
| When $d_1 < d_{10}$, | $d_{1m}$ (nm) $=$ | 207.633 | 215.326 |
| When $n_2 \geq n_{20}$, | $n_{2m}=$ | 1.795 | 1.877 |
| When $n_2 < n_{20}$, | $n_{2m}=$ | 1.605 | 1.619 |
| When $k_2 \geq k_{20}$, | $k_{2m}=$ | 0.216 | 0.228 |
| When $k_2 < k_{20}$, | $k_{2m}=$ | 0.105 | 0.098 |
| When $d_2 \geq d_{20}$, | $d_{2m}$ (nm) $=$ | ∞ | ∞ |
| When $d_2 < d_{20}$, | $d_{2m}$ (nm) $=$ | 205.481 | 189.945 |

$1.3 < NA \leq 1.4$

$195 < T \leq 205$

| Case | 20-01 | 20-02 | 20-03 | 20-04 | 20-05 |
|---|---|---|---|---|---|
| $n_{10}$ | 1.918 | 1.883 | 1.874 | 1.707 | 1.708 |
| $k_{10}$ | 0.103 | 0.095 | 0.068 | 0.061 | 0.055 |
| $d_{10}$ (nm) | 15.177 | 13.742 | 12.955 | 216.749 | 216.874 |
| $n_{20}$ | 1.753 | 1.708 | 1.728 | 1.693 | 1.699 |
| $k_{20}$ | 0.331 | 0.252 | 0.214 | 0.194 | 0.165 |
| $d_{20}$ (nm) | 153.467 | 215.835 | 269.400 | 203.628 | 259.716 |

| | 20-01 | 20-02 | 20-03 | 20-04 | 20-05 |
|---|---|---|---|---|---|
| When $n_1 \geq n_{10}$, $n_{1m} =$ | 1.966 | 1.948 | 1.955 | 1.739 | 1.743 |
| When $n_1 < n_{10}$, $n_{1m} =$ | 1.909 | 1.857 | 1.835 | 1.699 | 1.698 |
| When $k_1 \geq k_{10}$, $k_{1m} =$ | 0.117 | 0.137 | 0.128 | 0.075 | 0.075 |
| When $k_1 < k_{10}$, $k_{1m} =$ | 0.043 | 0.016 | 0.000 | 0.048 | 0.030 |
| When $d_1 \geq d_{10}$, $d_{1m}$ (nm) = | 18.089 | 18.051 | 18.523 | 256.743 | ∞ |
| When $d_1 < d_{10}$, $d_{1m}$ (nm) = | 14.663 | 12.041 | 10.348 | 210.937 | 209.294 |
| When $n_2 \geq n_{20}$, $n_{2m} =$ | 1.773 | 1.748 | 1.785 | 1.744 | 1.800 |
| When $n_2 < n_{20}$, $n_{2m} =$ | 1.665 | 1.604 | 1.616 | 1.589 | 1.608 |
| When $k_2 \geq k_{20}$, $k_{2m} =$ | 0.348 | 0.285 | 0.259 | 0.230 | 0.223 |
| When $k_2 < k_{20}$, $k_{2m} =$ | 0.278 | 0.199 | 0.159 | 0.145 | 0.109 |
| When $d_2 \geq d_{20}$, $d_{2m}$ (nm) = | ∞ | ∞ | ∞ | ∞ | ∞ |
| When $d_2 < d_{20}$, $d_{2m}$ (nm) = | 140.260 | 150.984 | 188.160 | 180.549 | 200.943 |

$1.3 < NA \leq 1.4$

$195 < T \leq 205$

| Case | 20-06 |
|---|---|
| $n_{10}$ | 1.697 |
| $k_{10}$ | 0.050 |
| $d_{10}$ (nm) | 272.522 |
| $n_{20}$ | 1.701 |
| $k_{20}$ | 0.160 |
| $d_{20}$ (nm) | 261.468 |

| | 20-06 |
|---|---|
| When $n_1 \geq n_{10}$, $n_{1m} =$ | 1.731 |
| When $n_1 < n_{10}$, $n_{1m} =$ | 1.652 |
| When $k_1 \geq k_{10}$, $k_{1m} =$ | 0.078 |
| When $k_1 < k_{10}$, $k_{1m} =$ | 0.022 |
| When $d_1 \geq d_{10}$, $d_{1m}$ (nm) = | ∞ |
| When $d_1 < d_{10}$, $d_{1m}$ (nm) = | 217.122 |
| When $n_2 \geq n_{20}$, $n_{2m} =$ | 1.874 |
| When $n_2 < n_{20}$, $n_{2m} =$ | 1.620 |
| When $k_2 \geq k_{20}$, $k_{2m} =$ | 0.227 |
| When $k_2 < k_{20}$, $k_{2m} =$ | 0.100 |
| When $d_2 \geq d_{20}$, $d_{2m}$ (nm) = | ∞ |
| When $d_2 < d_{20}$, $d_{2m}$ (nm) = | 184.530 |

The exposure method according to any one of the first to fifth embodiments of the invention is applied to, for example, submicron patterning in a semiconductor device. Specifically, the exposure method includes the steps of forming the antireflective film according to any one of the embodiments of the invention on a silicon oxide film formed on a surface of the silicon semiconductor substrate, applying a resist layer having a sensitive function on the antireflective film, selectively exposing the resist layer to exposure light (ultraviolet light), and developing the resist layer to form a predetermined resist pattern.

In the antireflective film or the exposure method according to any one of the first to fifth embodiments of the invention (may be simply generically named "the invention" hereinafter), the exposure light (ultraviolet light) has a wavelength of 190 nm to 195 nm and preferably 192 nm to 194 nm. More specifically, an ArF excimer laser at a wavelength of 193nm is more preferably used as an exposure light source.

Furthermore, the relations $d_1 \leq 250$ and $d_2 \leq 250$ are satisfied. In other words, the thicknesses of the upper and lower layers of the antireflective film preferably are smaller than 250 nm. When the thickness of the upper layer or the lower layer exceeds 250 nm, in the step of etching the silicon semiconductor substrate using the resist layer as an etching mask after the exposure of the resist layer to the exposure light and the development thereof, a so-called processing conversion difference (referred to as a "dimensional conversion amount" or "dimensional shift") which represents a difference between the resist pattern dimensions of the resist layer and the actual etching dimensions of the silicon semiconductor substrate is excessively increased, thereby failing to obtain a pattern having a desired shape or size on the silicon semiconductor substrate.

In addition, the refractive index of the resist layer is preferably 1.60 to 1.80. In the use of the resist layer composed of a resist material having a refractive index outside this range, even when the antireflective film satisfies any one of the above-described conditions of the combination ($n_1$, $k_1$, $d_1$, $n_2$, $k_2$, $d_2$), it is difficult to control the reflectance at the interface between the resist layer and the silicon oxide film formed on a surface of the silicon semiconductor substrate to 0.4% or less over the entire region from the incidence angle (maximum incidence angle $\theta_{in-max}$) of exposure light corresponding to a corresponding numerical aperture to vertical incidence (minimum incidence angle $\theta_{in-min}$, specifically 0°), thereby failing to obtain an excellent resist pattern.

Furthermore, the space between the resist layer and the exposure system is preferably filled with a medium having a refractive index of 1.44 $\pm$0.02. Namely, the medium having a refractive index of 1.44 $\pm$0.02 is preferably used as an immersion liquid, and water is more preferably used as the medium. When the refractive index greatly deviates from this value, even if the antireflective index satisfies any one of the conditions of the combination ($n_1$, $k_1$, $d_1$, $n_2$, $k_2$, $d_2$), it is difficult to control the reflectance at the interface between the resist layer and the silicon oxide film formed on a surface of the silicon semiconductor substrate to 0.4% or less over the entire region from the incidence angle (maximum incidence angle $\theta_{in-max}$) of exposure light corresponding to the corresponding numerical aperture to vertical incidence (minimum incidence angle $\theta_{in-min}$, specifically 0°), thereby failing to obtain an excellent resist pattern.

Furthermore, in the exposure method according to any one of the first to fifth embodiments of the invention, a topcoat layer is preferably formed on the resist layer (specifically, on the upper layer). Without the topcoat layer, it may be impossible to suppress the occurrence of an interaction between the resist layer and the immersion liquid (for example, the phenomenon of producing defects in the resist layer due to contact between the resist layer and the immersion liquid), thereby failing to obtain a desirable resist pattern. The topcoat layer may be composed of a material, such as an organic or inorganic material, e.g., polyvinyl alcohol, amorphous fluoropolymer, or NaCl.

In the present invention, the entire region from the incidence angle (maximum incidence angle $\theta_{in-max}$) of exposure light corresponding to a corresponding numerical aperture to vertical incidence (minimum incidence angle $\theta_{in-min}$, specifically 0°) may be referred to as the "entire incidence angle region corresponding to the numerical aperture NA of the corresponding exposure system" or simply referred to as the "entire incidence angle region".

The thickness of the resist layer is preferably 2 times to 5 times as large as the minimum size of the resist pattern to be formed. When the thickness of the resist layer is less than 2 times as large as the minimum size of the resist pattern, it may be possible to pattern the resist layer to a predetermined pattern, but the silicon semiconductor substrate is not satisfactorily etched after patterning of the resist layer. In addition, the number of defects in the resist layer may be increased. On the other hand, when the thickness of the resist layer exceeds 5 times as large as the minimum size of the resist pattern, the patterned resist layer may be broken, thereby failing to satisfactorily pattern the silicon semiconductor substrate.

As the material constituting the upper and lower layers of the antireflective film, any material satisfying any one of the conditions of the combination ($n_1$, $k_1$, $d_1$, $n_2$, $k_2$, $d_2$) may be used. Examples of the material constituting the upper and lower layers of the antireflective film include polymer materials, inorganic oxide materials, metal materials, and hybrid materials thereof. Specific examples of the material include polyimide, SiCH films, SiCHN films, SiCOH films, epoxy thermosetting resins, acrylic thermosetting resins, epoxy ultraviolet curable resins, and acrylic ultraviolet curable resins.

In order to improve the adhesion between the antireflective film and the resist layer formed on the antireflective film, the surface of the upper layer constituting the antireflective film may be subjected to surface medication treatment such as silane coupling treatment or the like.

In the use of a single-layer antireflective film, even when the thickness and complex refractive index are changed to any values, it may be generally impossible to control the reflectance to 0.4% or less over the entire incidence angle region corresponding to the numerical aperture NA of the corresponding exposure system. When the antireflective film has an excessively large thickness, the problem of a processing conversion difference occurs in the step of etching the silicon semiconductor substrate after exposure of the resist layer to the exposure light and the development thereof.

On the other hand, in the present invention, the two-layer structure antireflective film having a thickness and complex refractive index in the respective predetermined ranges is formed between the resist and the silicon oxide film formed on a surface of the silicon semiconductor substrate. Therefore, it may be possible to control the reflectance to 0.4% or less over the entire incidence angle region corresponding to the numerical aperture NA of the corresponding exposure system and obtain a resist pattern having a more excellent shape, thereby permitting more submicron processing. In other words, when the numerical aperture NA of the exposure system is each of $0.93 \leq NA \leq 1.0$, $1.0 < NA \leq 1.1$, $1.1 < NA \leq 1.2$, $1.2 < NA \leq 1.3$, and $1.3 < NA \leq 1.4$, by using the two-layer structure antireflective film satisfying the above-described conditions of the thickness and the complex refractive index, it may be possible to control the reflectance to 0.4% or less over the entire region from the incidence angle of exposure light corresponding to the corresponding numerical aperture NA to vertical incidence, thereby obtaining an excellent resist pattern and minimizing the processing conversion difference.

BRIEF DESCRIPTION OF THE DRAWINGS

Figure is a graph showing the result of computation of the reflectance dependence of variation in the diameter of contact holes.

DESCRIPTION OF THE PREFERRED EMBODIMENTS

Although embodiments of the present invention will be described with reference to the drawings, description will be first made of the reasons why the reflectance is 0.4% or less over the entire incidence angle region corresponding to the numerical aperture NA of a corresponding exposure system (the entire region from the incidence angle of exposure light corresponding to the numerical aperture of a corresponding exposure system to vertical incidence) according to the embodiments of the invention.

First, a simulation of optimizing the complex refractive indexes $N_1$ and $N_2$ of upper and lower layer of an antireflective film was carried out for minimizing the reflectance over the region from the incidence angle (maximum incidence angle $\theta_{in\text{-}max}$) of most oblique incidence corresponding to a numerical aperture NA to vertical incidence (minimum incidence angle $\theta_{in\text{-}min}$), i.e., the entire incidence angle region. In this simulation, the thicknesses $d_1$ and $d_2$ of the upper and lower layer of the antireflective film were changed from 10 nm to 200 nm in 10 nm increments, and the simulation was carried out in each combination of the thicknesses $d_1$ and $d_2$ using a silicon oxide film having a thickness of 2 nm to 205 nm. Furthermore, the numerical aperture NA of an exposure system was set to each of $0.93 \leq NA \leq 1.0$ (specifically, 1.0), $1.0 < NA \leq 1.1$ (specifically, 1.1), $1.1 < NA \leq 1.2$ (specifically, 1.2), $1.2 < NA \leq 1.3$ (specifically, 1.3), and $1.3 < NA \leq 1.4$ (specifically, 1.4).

In this computation, the reflectance of the two-layer antireflective film was calculated by a calculation method for the Fresnel coefficient of each layer (refer to "Basic Theory of Optical Thin Film" written by Mitsunobu Kobiyama, 2003, issued by Optronics Inc.). The complex refractive indexes of the upper and lower layers were optimized by the Fletcher-Reeves optimization method (refer to "Nonlinear Optimization Problems" written by J. Kowalik, M. R. Osborn, translated by Yoshiyuki Yamamoto and Takeo Koyama, 1970, issued by Baifukan).

In the optimization, when the numerical aperture NA was 1.0, the entire incident angle region was divided into 20 equal parts; when the numerical aperture NA was 1.1, the entire incidence angle region was divided into 22 equal parts; when the numerical aperture NA was 1.2, the entire incidence angle region was divided into 24 equal parts; when the numerical aperture NA was 1.3, the entire incidence angle region was divided into 26 equal parts; and when the numerical aperture NA was 1.4, the entire incidence angle region was divided into 28 equal parts. The reflectance at each incidence angle was calculated, and the square sum of the reflectances at the incidence angles was minimized.

In this way, the numerical aperture NA of the exposure system was set to each of 1.0, 1.1, 1.2, 1.3, and 1.4, and the thicknesses $d_1$ and $d_2$ of the upper and lower layers were changed from 10 nm to 250 nm in 10 nm increments. In each of the cases, the complex refractive indexes of the upper and lower layers were optimized by the above-described method to obtain the optimum complex refractive indexes $N_1$ and $N_2$ of the upper and lower layers.

The reason why computation was not carried out for a thickness above 250 nm was that with a thickness over this value, a processing conversion difference in the etching step is increased, thereby failing to satisfactorily process the silicon semiconductor substrate.

Then, in each of the cases in which the numerical aperture NA of the exposure system was set to each of 1.0, 1.1, 1.2, 1.3, and 1.4, and the thicknesses $d_1$ and $d_2$ of the upper and lower layers were changed from 10 nm to 250 nm in 10 nm increments, the thickness conditions for minimizing the square sum of the reflectances, which was an evaluation function for optimization after the optimization of the complex refractive indexes of the upper and lower layers, were determined on the basis of the results of the above-described computation.

Each of the thicknesses $d_1$ and $d_2$ of the upper and lower layers was further finely divided on the basis of the thickness conditions, and the most preferable complex refractive indexes of the upper and lower layers corresponding to the thickness conditions were determined in detail.

As a result, the most preferable combinations of complex refractive indexes and thicknesses were obtained. Namely, assuming that the complex refractive index $N_1$ of the upper layer (disposed far from the surface of the silicon semiconductor substrate having the silicon oxide film formed on the surface thereof) in the two-layer antireflective film, and the complex refractive index $N_2$ of the lower layer (disposed nearer to the surface of the silicon semiconductor substrate having the silicon oxide film formed on the surface thereof) are defined as follows:

$$N_1 = n_{10} - k_{10}i$$

$$N_2 = n_{20} - k_{20}i$$

and assuming that $d_{10}$ is the thickness (unit: nm) of the upper layer, and $d_{20}$ is the thickness (unit : nm) of the lower layer, the more preferred combinations of $[n_{10}, n_{20}, k_{10}, k_{20}, d_{10}, d_{20}]$ are shown in Tables 1-A to 1-T (numerical aperture NA: $0.93 \leq NA \leq 1.0$), Tables 2-A to 2-T (numerical aperture NA: $1.0 < NA \leq 1.1$), Tables 3-A to 3-T (numerical aperture NA: $1.1 < NA \leq 1.2$), Tables 4-A to 4-T (numerical aperture NA: $1.2 < NA \leq 1.3$), and Tables 5-A to 5-T (numerical aperture NA: $1.3 < NA \leq 1.4$). In other words, with these combinations, the minimum reflectance is achieved.

In Case A-01 to Case A-15 of Table 1-A or Table 11-A which will be described below, each value was obtained with the silicon oxide film having a thickness of 2 nm to 15 nm. In Case B-01 to Case B-22 of Table 1-B or Table 11-B which will be described below, each value was obtained with the silicon oxide film having a thickness of more than 15 nm to 25 nm. In Case C-01 to Case C-18 of Table 1-C or Table 11-C which will be described below, each value was obtained with the silicon oxide film having a thickness of more than 25 nm to 35 nm. In Case D-01 to Case D-20 of Table 1-D or Table 11-D which will be described below, each value was obtained with the silicon oxide film having a thickness of more than 35 nm to 45 nm. In Case E-01 to Case E-17 of Table 1-E or Table 11-E which will be described below, each value was obtained with the silicon oxide film having a thickness of more than 45 nm to 55 nm. In Case F-01 to Case F-17 of Table 1-F or Table 11-F which will be described below, each value was obtained with the silicon oxide film having a thickness of more than 55 nm to 65 nm. In Case G-01 to Case G-16 of Table 1-G or Table 11-G which will be described below, each value was obtained with the silicon oxide film having a thickness of more than 65 nm to 75 nm. In Case H-01 to Case H-16 of Table 1-H or Table 11-H which will be described below, each value was obtained with the silicon oxide film having a thickness of more than 75 nm to 85 nm. In Case I-01 to Case I-23 of Table 1-I or Table 11-I which will be described below, each value was obtained with the silicon oxide film having a thickness of more than 85 nm to 95 nm. In Case J-01 to Case J-15 of Table 1-J or Table 11-J which will be described below, each value was obtained with the silicon oxide film having a thickness of more than 95 nm to 105 nm. In Case K-01 to Case K-13 of Table 1-K or Table 11-K which will be described below, each value was obtained with the silicon oxide film having a thickness of more than 105 nm to 115 nm. In Case L-01 to Case L-12 of Table 1-L or Table 11-L which will be described below, each value was obtained with the silicon oxide film having a thickness of more than 115 nm to 125 nm. In Case M-01 to Case M-12 of Table 1-M or Table 11-M which will be described below, each value was obtained with the silicon oxide film having a thickness of more than 125 nm to 135 nm. In Case N-01 to Case N-12 of Table 1-N or Table 11-N which will be described below, each value was obtained with the silicon oxide film having a thickness of more than 135 nm to 145 nm. In Case O-01 to Case O-13 of Table 1-O or Table 11-O which will be described below, each value was obtained with the silicon oxide film having a thickness of more than 145 nm to 155 nm. In Case P-01 to Case P-14 of Table 1-P or Table 11-P which will be described below, each value was obtained with the silicon oxide film having a thickness of more than 155 nm to 165 nm. In Case Q-01 to Case Q-13 of Table 1-Q or Table 11-Q which will be described below, each value was obtained with the silicon oxide film having a thickness of more than 165 nm to 175 nm. In Case R-01 to Case R-13 of Table 1-R or Table 11-R which will be described below, each value was obtained with the silicon oxide film having a thickness of more than 175 nm to 185 nm. In Case S-01 to Case S-15 of Table 1-S or Table 11-S which will be described below, each value was obtained with the silicon oxide film having a thickness of more than 185 nm to 195 nm. In Case T-01 to Case T-13 of Table 1-T or Table 11-T which will be described below, each value was obtained with the silicon oxide film having a thickness of more than 195 nm to 205 nm.

In Case A-01 to Case A-24 of Table 2-A or Table 12-A which will be described below, each value was obtained with the silicon oxide film having a thickness of 2 nm to 15 nm. In Case B-01 to Case B-22 of Table 2-B or Table 12-B which will be described below, each value was obtained with the silicon oxide film having a thickness of more than 15 nm to 25 nm. In Case C-01 to Case C-16 of Table 2-C or Table 12-C which will be described below, each value was obtained with the silicon oxide film having a thickness of more than 25 nm to 35 nm. In Case D-01 to Case D-14 of Table 2-D or Table 12-D which will be described below, each value was obtained with the silicon oxide film having a thickness of more than 35 nm to 45 nm. In Case E-01 to Case E-14 of Table 2-E or Table 12-E which will be described below, each value was obtained with the silicon oxide film having a thickness of more than 45 nm to 55 nm. In Case F-01 to Case F-16 of Table 2-F or Table 12-F which will be described below, each value was obtained with the silicon oxide film having a thickness of more than 55 nm to 65 nm. In Case G-01 to Case G-16 of Table 2-G or Table 12-G which will be described below, each value was obtained with the silicon oxide film having a thickness of more than 65 nm to 75 nm. In Case H-01 to Case H-17 of Table 2-H or Table 12-H which will be described below, each value was obtained with the silicon oxide film having a thickness of more than 75 nm to 85 nm. In Case I-01 to Case I-15 of Table 2-I or Table 12-I which will be described below, each value was obtained with the silicon oxide film having a thickness of more than 85 nm to 95 nm. In Case J-01 to Case J-13 of Table 2-J or Table 12-J which will be described below, each value was obtained with the silicon oxide film having a thickness of more than 95 nm to 105 nm. In Case K-01 to Case K-12 of Table 2-K or Table 12-K which will be described below, each value was obtained with the silicon oxide film having a thickness of more than 105 nm to 115 nm. In Case L-01 to Case L-13 of Table 2-L or Table 12-L which will be described below, each value was obtained with the silicon oxide film having a thickness of more than 115 nm to 125 nm. In Case M-01 to Case M-11 of Table 2-M or Table 12-M which will be described below, each value was obtained with the silicon oxide film having a thickness of more than 125 nm to 135 nm. In Case N-01 to Case N-12 of Table 2-N or Table 12-N which will be described below, each value was obtained with the silicon oxide film having a thickness of more than 135 nm to 145 nm. In Case O-01 to Case O-12 of Table 2-O or Table 12-O which will be described below, each value was obtained with the silicon oxide film having a thickness of more than 145 nm to 155 nm. In Case P-01 to Case P-12 of Table 2-P or Table 12-P which will be described below, each value was obtained with the silicon oxide film having a thickness of more than 155 nm to 165 nm. In Case Q-01 to Case Q-12 of Table 2-Q or Table 12-Q which will be described below, each value was obtained with the silicon oxide film having a thickness of more than 165 nm to 175 nm. In Case R-01 to Case R-10 of Table 2-R or Table 12-R which will be described below, each value was obtained with the silicon oxide film having a thickness of more than 175 nm to 185 nm. In Case S-01 to Case S-13 of Table 2-S or Table 12-S which will be described below, each value was obtained with the silicon oxide film having a thickness of more than 185 nm to 195 nm. In Case T-01 to Case T-12 of Table 2-T or Table 12-T which will be described below, each value was obtained with the silicon oxide film having a thickness of more than 195 nm to 205 nm.

In Case A-01 to Case A-19 of Table 3-A or Table 13-A which will be described below, each value was obtained with the silicon oxide film having a thickness of 2 nm to 15 nm. In Case B-01 to Case B-17 of Table 3-B or Table 13-B which will be described below, each value was obtained with the silicon oxide film having a thickness of more than 15 nm to 25 nm. In Case C-01 to Case C-14 of Table 3-C or Table 13-C which will be described below, each value was obtained with the silicon oxide film having a thickness of more than 25 nm to 35 nm. In Case D-01 to Case D-13 of Table 3-D or Table 13-D which will be described below, each value was obtained with the silicon oxide film having a thickness of more than 35 nm to 45 nm. In Case E-01 to Case E-13 of Table 3-E or Table 13-E which will be described below, each value was obtained with the silicon oxide film having a thickness of more than 45 nm to 55 nm. In Case F-01 to Case F-12 of Table 3-F or Table 13-F which will be described below, each value was obtained with the silicon oxide film having a thickness of more than 55 nm to 65 nm. In Case G-01 to Case G-13 of Table 3-G or Table 13-G which will be described below, each value was obtained with the silicon oxide film having a thickness of more than 65 nm to 75 nm. In Case H-01 to Case H-15 of Table 3-H or Table 13-H which will be described below, each value was obtained with the silicon oxide film having a thickness of more than 75 nm to 85 nm. In Case I-01 to Case I-13 of Table 3-I or Table 13-I which will be described below, each value was obtained with the silicon oxide film having a thickness of more than 85 nm to 95 nm. In Case J-01 to Case J-12 of Table 3-J or Table 13-J which will be described below, each value was obtained with the silicon oxide film having a thickness of more than 95 nm to 105 nm. In Case K-01 to Case K-09 of Table 3-K or Table 13-K which will be described below, each value was obtained with the silicon oxide film having a thickness of more than 105 nm to 115 nm. In Case L-01 to Case L-10 of Table 3-L or Table 13-L which will be described below, each value was obtained with the silicon oxide film having a thickness of more than 115 nm to 125 nm. In Case M-01 to Case M-09 of Table 3-M or Table 13-M which will be described below, each value was obtained with the silicon oxide film having a thickness of more than 125 nm to 135 nm. In Case N-01 to Case N-10 of Table 3-N or Table 13-N which will be described below, each value was obtained with the silicon oxide film having a thickness of more than 135 nm to 145 nm. In Case O-01 to Case O-09 of Table 3-O or Table 13-O which will be described below, each value was obtained with the silicon oxide film having a thickness of more than 145 nm to 155 nm. In Case P-01 to Case P-09 of Table 3-P or Table 13-P which will be described below, each value was obtained with the silicon oxide film having a thickness of more than 155 nm to 165 nm. In Case Q-01 to Case Q-09 of Table 3-Q or Table 13-Q which will be described below, each value was obtained with the silicon oxide film having a thickness of more than 165 nm to 175 nm. In Case R-01 to Case R-08 of Table 3-R or Table 13-R which will be described below, each value was obtained with the silicon oxide film having a thickness of more than 175 nm to 185 nm. In Case S-01 to Case S-10 of Table 3-S or Table 13-S which will be described below, each value was obtained with the silicon oxide film having a thickness of more than 185 nm to 195 nm. In Case T-01 to Case T-11 of Table 3-T or Table 13-T which will be described below, each value was obtained with the silicon oxide film having a thickness of more than 195 nm to 205 nm.

In Case A-01 to Case A-13 of Table 4-A or Table 14-A which will be described below, each value was obtained with the silicon oxide film having a thickness of 2 nm to 15 nm. In Case B-01 to Case B-10 of Table 4-B or Table 14-B which will be described below, each value was obtained with the silicon oxide film having a thickness of more than 15 nm to 25 nm. In Case C-01 to Case C-08 of Table 4-C or Table 14-C which will be described below, each value was obtained with the silicon oxide film having a thickness of more than 25 nm to 35 nm. In Case D-01 to Case D-09 of Table 4-D or Table 14-D which will be described below, each value was obtained with the silicon oxide film having a thickness of more than 35 nm to 45 nm. In Case E-01 to Case E-08 of Table 4-E or Table 14-E which will be described below, each value was obtained with the silicon oxide film having a thickness of more than 45 nm to 55 nm. In Case F-01 to Case F-08 of Table 4-F or Table 14-F which will be described below, each value was obtained with the silicon oxide film having a thickness of more than 55 nm to 65 nm. In Case G-01 to Case G-08 of Table 4-G or Table 14-G which will be described below, each value was obtained with the silicon oxide film having a thickness of more than 65 nm to 75 nm. In Case H-01 to Case H-07 of Table 4-H or Table 14-H which will be described below, each value was obtained with the silicon oxide film having a thickness of more than 75 nm to 85 nm. In Case I-01 to Case I-07 of Table 4-I or Table 14-I which will be described below, each value was obtained with the silicon oxide film having a thickness of more than 85 nm to 95 nm. In Case J-01 to Case J-06 of Table 4-J or Table 14-J which will be described below, each value was obtained with the silicon oxide film having a thickness of more than 95 nm to 105 nm. In Case K-01 to Case K-07 of Table 4-K or Table 14-K which will be described below, each value was obtained with the silicon oxide film having a thickness of more than 105 nm to 115 nm. In Case L-01 to Case L-08 of Table 4-L or Table 14-L which will be described below, each value was obtained with the silicon oxide film having a thickness of more than 115 nm to 125 nm. In Case M-01 to Case M-07 of Table 4-M or Table 14-M which will be described below, each value was obtained with the silicon oxide film having a thickness of more than 125 nm to 135 nm. In Case N-01 to Case N-07 of Table 4-N or Table 14-N which will be described below, each value was obtained with the silicon oxide film having a thickness of more than 135 nm to 145 nm. In Case O-01 to Case O-07 of Table 4-O or Table 14-O which will be described below, each value was obtained with the silicon oxide film having a thickness of more than 145 nm to 155 nm. In Case P-01 to Case P-07 of Table 4-P or Table 14-P which will be described below, each value was obtained with the silicon oxide film having a thickness of more than 155 nm to 165 nm. In Case Q-01 to Case Q-07 of Table 4-Q or Table 14-Q which will be described below, each value was obtained with the silicon oxide film having a thickness of more than 165 nm to 175 nm. In Case R-01 to Case R-05 of Table 4-R or Table 14-R which will be described below, each value was obtained with the silicon oxide film having a thickness of more than 175 nm to 185 nm. In Case S-01 to Case S-07 of Table 4-S or Table 14-S which will be described below, each value was obtained with the silicon oxide film having a thickness of more than 185 nm to 195 nm. In Case T-01 to Case T-07 of Table 4-T or Table 14-T which will be described below, each value was obtained with the silicon oxide film having a thickness of more than 195 nm to 205 nm.

In Case A-01 to Case A-11 of Table 5-A or Table 15-A which will be described below, each value was obtained with the silicon oxide film having a thickness of 2 nm to 15 nm. In Case B-01 to Case B-10 of Table 5-B or Table 15-B which will be described below, each value was obtained with the silicon oxide film having a thickness of more than 15 nm to 25 nm. In Case C-01 to Case C-06 of Table 5-C or Table 15-C which will be described below, each value was obtained with the silicon oxide film having a thickness of more than 25 nm to 35 nm. In Case D-01 to Case D-07 of Table 5-D or Table 15-D which will be described below, each value was obtained with the silicon oxide film having a thickness of more than 35 nm to 45 nm. In Case E-01 to Case E-07 of Table 5-E or Table 15-E which will be described below, each value was obtained with the silicon oxide film having a thickness of more than 45 nm to 55 nm. In Case F-01 to Case F-06 of Table 5-F or Table 15-F which will be described below, each value was obtained with the silicon oxide film having a thickness of more than 55 nm to 65 nm. In Case G-01 to Case G-07 of Table 5-G or Table 15-G which will be described below, each value was obtained with the silicon oxide film having a thickness of more than 65 nm to 75 nm. In Case H-01 to Case H-07 of Table 5-H or Table 15-H which will be described below, each value was obtained with the silicon oxide film having a thickness of more than 75 nm to 85 nm. In Case I-01 to Case I-06 of Table 5-I or Table 15-I which will be described below, each value was obtained with the silicon oxide film having a thickness of more than 85 nm to 95 nm. In Case J-01 to Case J-06 of Table 5-J or Table 15-J which will be described below, each value was obtained with the silicon oxide film having a thickness of more than 95 nm to 105 nm. In Case K-01 to Case K-05 of Table 5-K or Table 15-K which will be described below, each value was obtained with the silicon oxide film having a thickness of more than 105 nm to 115 nm. In Case L-01 to Case L-07 of Table 5-L or Table 15-L which will be described below, each value was obtained with the silicon oxide film having a thickness of more than 115 nm to 125 nm. In Case M-01 to Case M-07 of Table 5-M or Table 15-M which will be described below, each value was obtained with the silicon oxide film having a thickness of more than 125 nm to 135 nm. In Case N-01 to Case N-06 of Table 5-N or Table 15-N which will be described below, each value was obtained with the silicon oxide film having a thickness of more than 135 nm to 145 nm. In Case O-01 to Case O-06 of Table 5-O or Table 15-O which will be described below, each value was obtained with the silicon oxide film having a thickness of more than 145 nm to 155 nm. In Case P-01 to Case P-06 of Table 5-P or Table 15-P which will be described below, each value was obtained with the silicon oxide film having a thickness of more than 155 nm to 165 nm. In Case Q-01 to Case Q-04 of Table 5-Q or Table 15-Q which will be described below, each value was obtained with the silicon oxide film having a thickness of more than 165 nm to 175 nm. In Case R-01 to Case R-05 of Table 5-R or Table 15-R which will be described below, each value was obtained with the silicon oxide film having a thickness of more than 175 nm to 185 nm. In Case S-01 to Case S-07 of Table 5-S or Table 15-S which will be described below, each value was obtained with the silicon oxide film having a thickness of more than 185 nm to 195 nm. In Case T-01 to Case T-06 of Table 5-T or Table 15-T which will be described below, each value was obtained with the silicon oxide film having a thickness of more than 195 nm to 205 nm.

In other words, under the above-mentioned conditions, when the numerical aperture NA is $0.93 \leq NA \leq 1.0$, the minimum reflectance can be obtained at 15 points (15 combinations of $[n_{10}, n_{20}, k_{10}, k_{20}, d_{10}, d_{20}]$) with the silicon oxide film having a thickness of 2 nm to 15 nm; the minimum reflectance can be obtained at 22 points (22 combinations of $[n_{10}, n_{20}, k_{10}, k_{20}, d_{10}, d_{20}]$) with the silicon oxide film having a thickness of more than 15 nm to 25 nm; the minimum reflectance can be obtained at 18 points (18 combinations of $[n_{10}, n_{20}, k_{10}, k_{20}, d_{10}, d_{20}]$) with the silicon oxide film having a thickness of more than 25 nm to 35 nm; the minimum reflectance can be obtained at 20 points (20 combinations of $[n_{10}, n_{20}, k_{10}, k_{20}, d_{10}, d_{20}]$) with the silicon oxide film having a thickness of more than 35 nm to 45 nm; the minimum reflectance can be obtained at 17 points (17 combinations of $[n_{10}, n_{20}, k_{10}, k_{20}, d_{10}, d_{20}]$) with the silicon oxide film having a thickness of more than 45 nm to 55 nm; the minimum reflectance can be obtained at 17 points (17 combinations of $[n_{10}, n_{20}, k_{10}, k_{20}, d_{10}, d_{20}]$) with the silicon oxide film having a thickness of more than 55 nm to 65 nm; the minimum reflectance can be obtained at 16 points (16 combinations of $[n_{10}, n_{20}, k_{10}, k_{20}, d_{10}, d_{20}]$) with the silicon oxide film having a thickness of more than 65 nm to 75 nm; the minimum reflectance can be obtained at 16 points (15 combinations of $[n_{10}, n_{20}, k_{10}, k_{20}, d_{10}, d_{20}]$) with the silicon oxide film having a thickness of more than 75 nm to 85 nm; the minimum reflectance can be obtained at 23 points (23 combinations of $[n_{10}, n_{20}, k_{10}, k_{20}, d_{10}, d_{20}]$) with the silicon oxide film having a thickness of more than 85 nm to 95 nm; the minimum reflectance can be obtained at 15 points (15 combinations of $[n_{10}, n_{20}, k_{10}, k_{20}, d_{10}, d_{20}]$) with the silicon oxide film having a thickness of more than 95 nm to 105 nm; the minimum reflectance can be obtained at 13 points (13 combinations of $[n_{10}, n_{20}, k_{10}, k_{20}, d_{10}, d_{20}]$) with the silicon oxide film having a thickness of more than 105 nm to 115 nm; the minimum reflectance can be obtained at 12 points (12 combinations of $[n_{10}, n_{20}, k_{10}, k_{20}, d_{10}, d_{20}]$) with the silicon oxide film having a thickness of more than 115 nm to 125 nm; the minimum reflectance can be obtained at 12 points (12 combinations of $[n_{10}, n_{20}, k_{10}, k_{20}, d_{10}, d_{20}]$) with the silicon oxide film having a thickness of more than 125 nm to 135 nm; the minimum reflectance can be obtained at 12 points (12 combinations of $[n_{10}, n_{20}, k_{10}, k_{20}, d_{10}, d_{20}]$) with the silicon oxide film having a thickness of more than 135 nm to 145 nm; the minimum reflectance can be obtained at 13 points (13 combinations of $[n_{10}, n_{20}, k_{10}, k_{20}, d_{10}, d_{20}]$) with the silicon oxide film having a thickness of more than 145 nm to 155 nm; the minimum reflectance can be obtained at 14 points (14 combinations of $[n_{10}, n_{20}, k_{10}, k_{20}, d_{10}, d_{20}]$) with the silicon oxide film having a thickness of more than 155 nm to 165 nm; the minimum reflectance can be obtained at 13 points (13 combinations of $[n_{10}, n_{20}, k_{10}, k_{20}, d_{10}, d_{20}]$) with the silicon oxide film having a thickness of more than 165 nm to 175 nm; the minimum reflectance can be obtained at 13 points (13 combinations of $[n_{10}, n_{20}, k_{10}, k_{20}, d_{10}, d_{20}]$) with the silicon oxide film having a thickness of more than 175 nm to 185 nm; the minimum reflectance can be obtained at 15 points (15 combinations of $[n_{10}, n_{20}, k_{10}, k_{20}, d_{10}, d_{20}]$) with the silicon oxide film having a thickness of more than 185 nm to 195 nm; and the minimum reflectance can be obtained at 13 points (13 combinations of $[n_{10}, n_{20}, k_{10}, k_{20}, d_{10}, d_{20}]$) with the silicon oxide film having a thickness of more than 195 nm to 205 nm.

Furthermore, under the above-mentioned conditions, when the numerical aperture NA is $1.0 < NA \leq 1.1$, the minimum reflectance can be obtained at 24 points (24 combinations of $[n_{10}, n_{20}, k_{10}, k_{20}, d_{10}, d_{20}]$) with the silicon oxide film having a thickness of 2 nm to 15 nm; the minimum reflectance can be obtained at 22 points (22 combinations of $[n_{10}, n_{20}, k_{10}, k_{20}, d_{10}, d_{20}]$) with the silicon oxide film having a thickness of more than 15 nm to 25 nm; the minimum reflectance can be obtained at 16 points (16 combinations of $[n_{10}, n_{20}, k_{10}, k_{20}, d_{10}, d_{20}]$) with the silicon oxide film having a thickness of more than 25 nm to 35 nm; the minimum reflectance can be obtained at 14 points (14 combinations of $[n_{10}, n_{20}, k_{10}, k_{20}, d_{10}, d_{20}]$) with the silicon oxide film having a thickness of more than 35 nm to 45 nm; the minimum reflectance can be obtained at 14 points (14 combinations of $[n_{10}, n_{20}, k_{10}, k_{20}, d_{10}, d_{20}]$) with the silicon oxide film having a thickness of more than 45 nm to 55 nm; the minimum reflectance can be obtained at 16 points (16 combinations of $[n_{10}, n_{20}, k_{10}, k_{20}, d_{10}, d_{20}]$) with the silicon oxide film having a thickness of more than 55 nm to 65 nm; the minimum reflectance can be obtained at 16 points (16 combinations of $[n_{10}, n_{20}, k_{10}, k_{20}, d_{10}, d_{20}]$) with the silicon oxide film having a thickness of more than 65 nm to 75 nm; the minimum reflectance can be obtained at 17 points (17 combinations of $[n_{10}, n_{20}, k_{10}, k_{20}, d_{10}, d_{20}]$) with the silicon oxide film having a thickness of more than 75 nm to 85 nm; the minimum reflectance can be obtained at 15 points (15 combinations of $[n_{10}, n_{20}, k_{10}, k_{20}, d_{10}, d_{20}]$) with the silicon oxide film having a thickness of more than 85 nm to 95 nm; the minimum reflectance can be obtained at 13 points (13 combinations of $[n_{10}, n_{20}, k_{10}, k_{20}, d_{10}, d_{20}]$) with the silicon oxide film having a thickness of more than 95 nm to 105 nm; the minimum reflectance can be obtained at 12 points (12 combinations of $[n_{10}, n_{20}, k_{10}, k_{20}, d_{10}, d_{20}]$) with the silicon oxide film having a thickness of more than 105 nm to 115 nm; the minimum reflectance can be obtained at 13 points (13 combinations of $[n_{10}, n_{20}, k_{10}, k_{20}, d_{10}, d_{20}]$) with the silicon oxide film having a thickness of more than 115 nm to 125 nm; the minimum reflectance can be obtained at 11 points (11 combinations of $[n_{10}, n_{20}, k_{10}, k_{20}, d_{10}, d_{20}]$) with the silicon oxide film having a thickness of more than 125 nm to 135 nm; the minimum reflectance can be obtained at 12 points (12 combinations of $[n_{10}, n_{20}, k_{10}, k_{20}, d_{10}, d_{20}]$) with the silicon oxide film having a thickness of more than 135 nm to 145 nm; the minimum reflectance can be obtained at 12 points (12 combinations of $[n_{10}, n_{20}, k_{10}, k_{20}, d_{10}, d_{20}]$) with the silicon oxide film having a thickness of more than 145 nm to 155 nm; the minimum reflectance can be obtained at 12 points (12 combinations of $[n_{10}, n_{20}, k_{10}, k_{20}, d_{10}, d_{20}]$) with the silicon oxide film having a thickness of more than 155 nm to 165 nm; the minimum reflectance can be obtained at 12 points (12 combinations of $[n_{10}, n_{20}, k_{10}, k_{20}, d_{10}, d_{20}]$) with the silicon oxide film having a thickness of more than 165 nm to 175 nm; the minimum reflectance can be obtained at 10 points (10 combinations of $[n_{10}, n_{20}, k_{10}, k_{20}, d_{10}, d_{20}]$) with the silicon oxide film having a thickness of more than 175 nm to 185 nm; the minimum reflectance can be obtained at 13 points (13 combinations of $[n_{10}, n_{20}, k_{10}, k_{20}, d_{10}, d_{20}]$) with the silicon oxide film having a thickness of more than 185 nm to 195 nm; and the minimum reflectance can be obtained at 12 points (12 combinations of $[n_{10}, n_{20}, k_{10}, k_{20}, d_{10}, d_{20}]$) with the silicon oxide film having a thickness of more than 195 nm to 205 nm.

Furthermore, under the above-mentioned conditions, when the numerical aperture NA is $1.1 < NA \leq 1.2$, the minimum reflectance can be obtained at 19 points (19 combinations of $[n_{10}, n_{20}, k_{10}, k_{20}, d_{10}, d_{20}]$) with the silicon oxide film having a thickness of 2 nm to 15 nm; the minimum reflectance can be obtained at 17 points (17 combinations of $[n_{10}, n_{20}, k_{10}, k_{20}, d_{10}, d_{20}]$) with the silicon oxide film having a thickness of more than 15 nm to 25 nm; the minimum reflectance can be obtained at 14 points (14 combinations of $[n_{10}, n_{20}, k_{10}, k_{20}, d_{10}, d_{20}]$) with the silicon oxide film having a thickness of more than 25 nm to 35 nm; the minimum reflectance can be obtained at 13 points (13 combinations of $[n_{10}, n_{20}, k_{10}, k_{20}, d_{10}, d_{20}]$) with the silicon oxide film having a thickness of more than 35 nm to 45 nm; the minimum reflectance can be obtained at 13 points (13 combinations of $[n_{10}, n_{20}, k_{10}, k_{20}, d_{10}, d_{20}]$) with the silicon oxide film having a thickness of more than 45 nm to 55 nm; the minimum reflectance can be obtained at 12 points (12 combinations of $[n_{10}, n_{20}, k_{10}, k_{20}, d_{10}, d_{20}]$) with the silicon oxide film having a thickness of more than 55 nm to 65 nm; the minimum reflectance can be obtained at 13 points (13 combinations of $[n_{10}, n_{20}, k_{10}, k_{20}, d_{10}, d_{20}]$) with the silicon oxide film having a thickness of more than 65 nm to 75 nm; the minimum reflectance can be obtained at 15 points (15 combinations of $[n_{10}, n_{20}, k_{10}, k_{20}, d_{10}, d_{20}]$) with the silicon oxide film having a thickness of more than 75 nm to 85 nm; the minimum reflectance can be obtained at 13 points (13 combinations of $[n_{10}, n_{20}, k_{10}, k_{20}, d_{10}, d_{20}]$) with the silicon oxide film having a thickness of more than 85 nm to 95 nm; the minimum reflectance can be obtained at 12 points (12 combinations of $[n_{10}, n_{20}, k_{10}, k_{20}, d_{10}, d_{20}]$) with the silicon oxide film having a thickness of more than 95 nm to 105 nm; the minimum reflectance can be obtained at 9 points (9 combinations of $[n_{10}, n_{20}, k_{10}, k_{20}, d_{10}, d_{20}]$) with the silicon oxide film having a thickness of more than 105 nm to 115 nm; the minimum reflectance can be obtained at 10 points (10 combinations of $[n_{10}, n_{20}, k_{10}, k_{20}, d_{10}, d_{20}]$) with the silicon oxide film having a thickness of more than 115 nm to 125 nm; the minimum reflectance can be obtained at 9 points (9 combinations of $[n_{10}, n_{20}, k_{10}, k_{20}, d_{10}, d_{20}]$) with the silicon oxide film having a thickness of more than 125 nm to 135 nm; the minimum reflectance can be obtained at 10 points (10 combinations of $[n_{10}, n_{20}, k_{10}, k_{20}, d_{10}, d_{20}]$) with the silicon oxide film having a thickness of more than 135 nm to 145 nm; the minimum reflectance can be obtained at 9 points (9 combinations of $[n_{10}, n_{20}, k_{10}, k_{20}, d_{10}, d_{20}]$) with the silicon oxide film having a thickness of more than 145 nm to 155 nm; the minimum reflectance can be obtained at 9 points (9 combinations of $[n_{10}, n_{20}, k_{10}, k_{20}, d_{10}, d_{20}]$) with the silicon oxide film having a thickness of more than 155 nm to 165 nm; the minimum reflectance can be obtained at 9 points (9 combinations of $[n_{10}, n_{20}, k_{10}, k_{20}, d_{10}, d_{20}]$) with the silicon oxide film having a thickness of more than 165 nm to 175 nm; the minimum reflectance can be obtained at 8 points (8 combinations of $[n_{10}, n_{20}, k_{10}, k_{20}, d_{10}, d_{20}]$) with the silicon oxide film having a thickness of more than 175 nm to 185 nm; the minimum reflectance can be obtained at 10 points (10 combinations of $[n_{10}, n_{20}, k_{10}, k_{20}, d_{10}, d_{20}]$) with the silicon oxide film having a thickness of more than 185 nm to 195 nm; and the minimum reflectance can be obtained at 11 points (11 combinations of $[n_{10}, n_{20}, k_{10}, k_{20}, d_{10}, d_{20}]$) with the silicon oxide film having a thickness of more than 195 nm to 205 nm.

In addition, under the above-mentioned conditions, when the numerical aperture NA is $1.2 < NA \leq 1.3$, the minimum reflectance can be obtained at 13 points (13 combinations of $[n_{10}, n_{20}, k_{10}, k_{20}, d_{10}, d_{20}]$) with the silicon oxide film having a thickness of 2 nm to 15 nm; the minimum reflectance can be obtained at 10 points (10 combinations of $[n_{10}, n_{20}, k_{10}, k_{20}, d_{10}, d_{20}]$) with the silicon oxide film having a thickness of more than 15 nm to 25 nm; the minimum reflectance can be obtained at 8 points (8 combinations of $[n_{10}, n_{20}, k_{10}, k_{20}, d_{10}, d_{20}]$) with the silicon oxide film having a thickness of more than 25 nm to 35 nm; the minimum reflectance can be obtained at 9 points (9 combinations of $[n_{10}, n_{20}, k_{10}, k_{20}, d_{10}, d_{20}]$) with the silicon oxide film having a thickness of more than 35 nm to 45 nm; the minimum reflectance can be obtained at 8 points (8 combinations of $[n_{10}, n_{20}, k_{10}, k_{20}, d_{10}, d_{20}]$) with the silicon oxide film having a thickness of more than 45 nm to 55 nm; the minimum reflectance can be obtained at 8 points (8 combinations of $[n_{10}, n_{20}, k_{10}, k_{20}, d_{10}, d_{20}]$) with the silicon oxide film having a thickness of more than 55 nm to 65 nm; the minimum reflectance can be obtained at 8 points (8 combinations of $[n_{10}, n_{20}, k_{10}, k_{20}, d_{10}, d_{20}]$) with the silicon oxide film having a thickness of more than 65 nm to 75 nm; the minimum reflectance can be obtained at 7 points (7 combinations of $[n_{10}, n_{20}, k_{10}, k_{20}, d_{10}, d_{20}]$) with the silicon oxide film having a thickness of more than 75 nm to 85 nm; the minimum reflectance can be obtained at 7 points (7 combinations of $[n_{10}, n_{20}, k_{10}, k_{20}, d_{10}, d_{20}]$) with the silicon oxide film having a thickness of more than 85 nm to 95 nm; the minimum reflectance can be obtained at 6 points (6 combinations of $[n_{10}, n_{20}, k_{10}, k_{20}, d_{10}, d_{20}]$) with the silicon oxide film having a thickness of more than 95 nm to 105 nm; the minimum reflectance can be obtained at 7 points (7 combinations of $[n_{10}, n_{20}, k_{10}, k_{20}, d_{10}, d_{20}]$) with the silicon oxide film having a thickness of more than 105 nm to 115 nm; the minimum reflectance can be obtained at 8 points (8 combinations of $[n_{10}, n_{20}, k_{10}, k_{20}, d_{10}, d_{20}]$) with the silicon oxide film having a thickness of more than 115 nm to 125 nm; the minimum reflectance can be obtained at 7 points (7 combinations of $[n_{10}, n_{20}, k_{10}, k_{20}, d_{10}, d_{20}]$) with the silicon oxide film having a thickness of more than 125 nm to 135 nm; the minimum reflectance can be obtained at 7 points (7 combinations of $[n_{10}, n_{20}, k_{10}, k_{20}, d_{10}, d_{20}]$) with the silicon oxide film having a thickness of more than 135 nm to 145 nm; the minimum reflectance can be obtained at 7 points (7 combinations of $[n_{10}, n_{20}, k_{10}, k_{20}, d_{10}, d_{20}]$) with the silicon oxide film having a thickness of more than 145 nm to 155 nm; the minimum reflectance can be obtained at 7 points (7 combinations of $[n_{10}, n_{20}, k_{10}, k_{20}, d_{10}, d_{20}]$) with the silicon oxide film having a thickness of more than 155 nm to 165 nm; the minimum reflectance can be obtained at 7 points (7 combinations of $[n_{10}, n_{20}, k_{10}, k_{20}, d_{10}, d_{20}]$) with the silicon oxide film having a thickness of more than 165 nm to 175 nm; the minimum reflectance can be obtained at 5 points (5 combinations of $[n_{10}, n_{20}, k_{10}, k_{20}, d_{10}, d_{20}]$) with the silicon oxide film having a thickness of more than 175 nm to 185 nm; the minimum reflectance can be obtained at 7 points (7 combinations of $[n_{10}, n_{20}, k_{10}, k_{20}, d_{10}, d_{20}]$) with the silicon oxide film having a thickness of more than 185 nm to 195 nm; and the minimum reflectance can be obtained at 7 points (7 combinations of $[n_{10}, n_{20}, k_{10}, k_{20}, d_{10}, d_{20}]$) with the silicon oxide film having a thickness of more than 195 nm to 205 nm.

Furthermore, under the above-mentioned conditions, when the numerical aperture NA is $1.3 < NA \leq 1.4$, the minimum reflectance can be obtained at 11 points (11 combinations of $[n_{10}, n_{20}, k_{10}, k_{20}, d_{10}, d_{20}]$) with the silicon oxide film having a thickness of 2 nm to 15 nm; the minimum reflectance can be obtained at 10 points (10 combinations of $[n_{10}, n_{20}, k_{10}, k_{20}, d_{10}, d_{20}]$) with the silicon oxide film having a thickness of more than 15 nm to 25 nm; the minimum reflectance can be obtained at 6 points (6 combinations of $[n_{10}, n_{20}, k_{10}, k_{20}, d_{10}, d_{20}]$) with the silicon oxide film having a thickness of more than 25 nm to 35 nm; the minimum reflectance can be obtained at 7 points (7 combinations of $[n_{10}, n_{20}, k_{10}, k_{20}, d_{10}, d_{20}]$) with the silicon oxide film having a thickness of more than 35 nm to 45 nm; the minimum reflectance can be obtained at 7 points (7 combinations of $[n_{10}, n_{20}, k_{10}, k_{20}, d_{10}, d_{20}]$) with the silicon oxide film having a thickness of more than 45 nm to 55 nm; the minimum reflectance can be obtained at 6 points (6 combinations of $[n_{10}, n_{20}, k_{10}, k_{20}, d_{10}, d_{20}]$) with the silicon oxide film having a thickness of more than 55 nm to 65 nm; the minimum reflectance can be obtained at 7 points (7 combinations of $[n_{10}, n_{20}, k_{10}, k_{20}, d_{10}, d_{20}]$) with the silicon oxide film having a thickness of more than 65 nm to 75 nm; the minimum reflectance can be obtained at 7 points (7 combinations of $[n_{10}, n_{20}, k_{10}, k_{20}, d_{10}, d_{20}]$) with the silicon oxide film having a thickness of more than 75 nm to 85 nm; the minimum reflectance can be obtained at 6 points (6 combinations of $[n_{10}, n_{20}, k_{10}, k_{20}, d_{10}, d_{20}]$) with the silicon oxide film having a thickness of more than 85 nm to 95 nm; the minimum reflectance can be obtained at 6 points (6 combinations of $[n_{10}, n_{20}, k_{10}, k_{20}, d_{10}, d_{20}]$) with the silicon oxide film having a thickness of more than 95 nm to 105 nm; the minimum reflectance can be obtained at 5 points (5 combinations of $[n_{10}, n_{20}, k_{10}, k_{20}, d_{10}, d_{20}]$) with the silicon oxide film having a thickness of more than 105 nm to 115 nm; the minimum reflectance can be obtained at 7 points (7 combinations of $[n_{10}, n_{20}, k_{10}, k_{20}, d_{10}, d_{20}]$) with the silicon oxide film having a thickness of more than 115 nm to 125 nm; the minimum reflectance can be obtained at 7 points (7 combinations of $[n_{10}, n_{20}, k_{10}, k_{20}, d_{10}, d_{20}]$) with the silicon oxide film having a thickness of more than 125 nm to 135 nm; the minimum reflectance can be obtained at 6 points (6 combinations of $[n_{10}, n_{20}, k_{10}, k_{20}, d_{10}, d_{20}]$) with the silicon oxide film having a thickness of more than 135 nm to 145 nm; the minimum reflectance can be obtained at 6 points (6 combinations of $[n_{10}, n_{20}, k_{10}, k_{20}, d_{10}, d_{20}]$) with the silicon oxide film having a thickness of more than 145 nm to 155 nm; the minimum reflectance can be obtained at 6 points (6 combinations of $[n_{10}, n_{20}, k_{10}, k_{20}, d_{10}, d_{20}]$) with the silicon oxide film having a thickness of more than 155 nm to 165 nm; the minimum reflectance can be obtained at 4 points (4 combinations of $[n_{10}, n_{20}, k_{10}, k_{20}, d_{10}, d_{20}]$) with the silicon oxide film having a thickness of more than 165 nm to 175 nm; the minimum reflectance can be obtained at 5 points (5 combinations of $[n_{10}, n_{20}, k_{10}, k_{20}, d_{10}, d_{20}]$) with the silicon oxide film having a thickness of more than 175 nm to 185 nm; the minimum reflectance can be obtained at 7 points (7 combinations of $[n_{10}, n_{20}, k_{10}, k_{20}, d_{10}, d_{20}]$) with the silicon oxide film having a thickness of more than 185 nm to 195 nm; and the minimum reflectance can be obtained at 6 points (6 combinations of $[n_{10}, n_{20}, k_{10}, k_{20}, d_{10}, d_{20}]$) with the silicon oxide film having a thickness of more than 195 nm to 205 nm.

Table1-A

| Case | $n_{10}$ | $k_{10}$ | $d_{10}$ | $n_{20}$ | $k_{20}$ | $d_{20}$ |
|------|----------|----------|----------|----------|----------|----------|
| A-01 | 2.0730313 | 0.1156327 | 23.933 | 2.6749484 | 1.5695754 | 9.886 |

(continued)

| Case | $n_{10}$ | $k_{10}$ | $d_{10}$ | $n_{20}$ | $k_{20}$ | $d_{20}$ |
|------|----------|----------|----------|----------|----------|----------|
| A-02 | 1.8546637 | 0.1676093 | 29.838 | 2.1886012 | 0.6118019 | 59.764 |
| A-03 | 1.8612247 | 0.1278895 | 20.208 | 1.8193379 | 0.4029416 | 139.994 |
| A-04 | 1.8595613 | 0.0953387 | 19.978 | 1.8569207 | 0.3273808 | 190.296 |
| A-05 | 1.7706199 | 0.0916054 | 91.022 | 1.9614270 | 0.4555299 | 69.218 |
| A-06 | 1.7659509 | 0.0861113 | 89.673 | 1.8683083 | 0.3142437 | 129.384 |
| A-07 | 1.7540284 | 0.0810034 | 89.258 | 1.7976000 | 0.2440877 | 193.603 |
| A-08 | 1.7206295 | 0.0765846 | 163.688 | 2.0072987 | 0.9099501 | 15.109 |
| A-09 | 1.7312076 | 0.0743303 | 158.443 | 1.9328063 | 0.4029485 | 69.389 |
| A-10 | 1.7317652 | 0.0746087 | 156.047 | 1.8225538 | 0.2736014 | 132.296 |
| A-11 | 1.7235310 | 0.0712769 | 155.759 | 1.7500411 | 0.2147794 | 197.972 |
| A-12 | 1.7093992 | 0.0595462 | 237.275 | 5.0249130 | 2.4786958 | 1.776 |
| A-13 | 1.7192548 | 0.0668813 | 223.222 | 1.9244861 | 0.3767470 | 68.925 |
| A-14 | 1.7183512 | 0.0690717 | 220.755 | 1.7884626 | 0.2530536 | 134.430 |
| A-15 | 1.7097773 | 0.0638868 | 221.916 | 1.7175992 | 0.2031308 | 199.649 |

Table1-B

| Case | $n_{10}$ | $k_{10}$ | $d_{10}$ | $n_{20}$ | $k_{20}$ | $d_{20}$ |
|------|----------|----------|----------|----------|----------|----------|
| B-01 | 1.8890717 | 0.2231211 | 31.297 | 2.2536461 | 1.9138327 | 8.426 |
| B-02 | 1.8040788 | 0.2224671 | 38.783 | 3.4285504 | 0.7115044 | 30.090 |
| B-03 | 1.8569330 | 0.1887211 | 31.358 | 2.3482559 | 0.7139401 | 49.395 |
| B-04 | 1.8246631 | 0.1852786 | 29.866 | 2.0267942 | 0.6589875 | 61.419 |
| B-05 | 1.8713633 | 0.1359350 | 20.765 | 1.8449284 | 0.4410677 | 129.533 |
| B-06 | 1.8537764 | 0.1095380 | 19.190 | 1.8083352 | 0.3385915 | 190.096 |
| B-07 | 1.8773918 | 0.0811836 | 15.072 | 1.7885130 | 0.2812935 | 250.952 |
| B-08 | 1.7913209 | 0.1069315 | 93.104 | 2.1120296 | 1.5705728 | 8.709 |
| B-09 | 1.7961812 | 0.0967122 | 91.592 | 2.2985234 | 0.5621108 | 49.876 |
| B-10 | 1.7719309 | 0.0907051 | 89.644 | 1.8982310 | 0.3437292 | 119.550 |
| B-11 | 1.7573553 | 0.0844391 | 89.273 | 1.8090385 | 0.2599016 | 184.203 |
| B-12 | 1.7321027 | 0.0771807 | 89.432 | 1.7181480 | 0.2108133 | 254.601 |
| B-13 | 1.7251448 | 0.0782108 | 166.474 | 2.6560327 | 2.0752579 | 4.495 |
| B-14 | 1.7347815 | 0.0789970 | 158.854 | 2.0166404 | 0.4697089 | 58.957 |
| B-15 | 1.7337052 | 0.0782079 | 156.164 | 1.8413069 | 0.2975845 | 122.955 |
| B-16 | 1.7245076 | 0.0739010 | 155.712 | 1.7533528 | 0.2275719 | 189.273 |
| B-17 | 1.7100620 | 0.0639207 | 155.553 | 1.6863114 | 0.1891021 | 256.528 |
| B-18 | 1.7130788 | 0.0658962 | 233.281 | 3.3653368 | 2.7431658 | 2.501 |
| B-19 | 1.7208745 | 0.0708686 | 223.560 | 1.9877972 | 0.4366658 | 59.393 |
| B-20 | 1.7192161 | 0.0720786 | 220.745 | 1.7983405 | 0.2740582 | 125.643 |
| B-21 | 1.7100814 | 0.0661341 | 221.783 | 1.7179584 | 0.2146738 | 191.114 |
| B-22 | 1.7028062 | 0.0572529 | 219.613 | 1.6741304 | 0.1784680 | 256.090 |

Table1-C

| Case | $n_{10}$ | $k_{10}$ | $d_{10}$ | $n_{20}$ | $k_{20}$ | $d_{20}$ |
|------|----------|----------|----------|----------|----------|----------|
| C-01 | 1.7462297 | 0.2650661 | 38.584 | 1.8811342 | 2.5474890 | 6.719 |
| C-02 | 1.7852920 | 0.2379686 | 38.995 | 3.2453891 | 0.8215227 | 29.990 |
| C-03 | 1.8064124 | 0.2063789 | 31.400 | 2.0415396 | 0.7493942 | 55.163 |
| C-04 | 1.8761841 | 0.1465026 | 22.050 | 1.8871554 | 0.4863835 | 118.487 |

(continued)

| Case | $n_{10}$ | $k_{10}$ | $d_{10}$ | $n_{20}$ | $k_{20}$ | $d_{20}$ |
|---|---|---|---|---|---|---|
| C-05 | 1.8732427 | 0.1107685 | 18.888 | 1.8328297 | 0.3644393 | 179.928 |
| C-06 | 1.8809997 | 0.0844859 | 15.636 | 1.8003278 | 0.2965881 | 241.202 |
| C-07 | 1.8353407 | 0.1336488 | 86.851 | 1.6000470 | 1.7695220 | 10.059 |
| C-08 | 1.8107063 | 0.1074834 | 91.200 | 2.5616901 | 0.6655713 | 40.111 |
| C-09 | 1.7800259 | 0.0966903 | 89.638 | 1.9474319 | 0.3779800 | 109.424 |
| C-10 | 1.7589519 | 0.0885227 | 89.033 | 1.8081258 | 0.2753975 | 177.335 |
| C-11 | 1.7385561 | 0.0961686 | 161.111 | 1.8448216 | 2.2148249 | 5.861 |
| C-12 | 1.7392392 | 0.0859424 | 158.474 | 2.1008270 | 0.5469970 | 50.862 |
| C-13 | 1.7355979 | 0.0828161 | 155.982 | 1.8545146 | 0.3232472 | 115.179 |
| C-14 | 1.7252169 | 0.0770491 | 155.656 | 1.7550901 | 0.2413910 | 181.353 |
| C-15 | 1.7185486 | 0.0788457 | 229.847 | 3.2610273 | 4.4183916 | 1.558 |
| C-16 | 1.7228369 | 0.0769315 | 222.858 | 2.0210736 | 0.5011654 | 52.892 |
| C-17 | 1.7199449 | 0.0760859 | 220.491 | 1.8037789 | 0.2965908 | 118.134 |
| C-18 | 1.7101979 | 0.0687675 | 221.639 | 1.7165312 | 0.2274377 | 183.246 |

Table1-D

| Case | $n_{10}$ | $k_{10}$ | $d_{10}$ | $n_{20}$ | $k_{20}$ | $d_{20}$ |
|---|---|---|---|---|---|---|
| D-01 | 1.8047095 | 0.2694194 | 36.421 | 2.9911125 | 1.0218786 | 30.087 |
| D-02 | 1.8098021 | 0.2379756 | 31.711 | 2.1295160 | 0.9059492 | 46.199 |
| D-03 | 1.8915289 | 0.1677232 | 26.420 | 2.1348336 | 0.5678980 | 93.459 |
| D-04 | 1.8869810 | 0.1583242 | 22.598 | 1.9270572 | 0.5352831 | 108.068 |
| D-05 | 1.8679863 | 0.1633407 | 22.571 | 1.8682373 | 0.5190358 | 112.596 |
| D-06 | 1.8894047 | 0.1134244 | 18.623 | 1.8513003 | 0.3877744 | 170.528 |
| D-07 | 1.9013640 | 0.0821095 | 14.880 | 1.8106171 | 0.3102506 | 232.433 |
| D-08 | 1.7974174 | 0.1211843 | 88.331 | 2.0615819 | 0.7049601 | 48.141 |
| D-09 | 1.7778270 | 0.1038067 | 88.747 | 1.9023003 | 0.4013081 | 106.512 |
| D-10 | 1.7589001 | 0.0931193 | 88.775 | 1.8006679 | 0.2880356 | 170.885 |
| D-11 | 1.7310401 | 0.0827558 | 89.146 | 1.7041670 | 0.2282102 | 240.157 |
| D-12 | 1.7404520 | 0.0960720 | 155.339 | 1.9461112 | 0.5942640 | 50.887 |
| D-13 | 1.7353985 | 0.0882239 | 154.960 | 1.8293633 | 0.3421815 | 110.529 |
| D-14 | 1.7244370 | 0.0802890 | 155.397 | 1.7457172 | 0.2519901 | 174.646 |
| D-15 | 1.7094852 | 0.0677575 | 155.056 | 1.6751093 | 0.2044537 | 241.084 |
| D-16 | 1.7305468 | 0.1083688 | 224.105 | 3.7612310 | 9.7520181 | 0.557 |
| D-17 | 1.7234847 | 0.0859582 | 219.529 | 1.8940064 | 0.5381566 | 52.122 |
| D-18 | 1.7196555 | 0.0809985 | 219.492 | 1.7865237 | 0.3130643 | 112.555 |
| D-19 | 1.7094719 | 0.0713058 | 221.454 | 1.7085534 | 0.2375210 | 175.858 |
| D-20 | 1.7026367 | 0.0605694 | 219.016 | 1.6670562 | 0.1929642 | 239.742 |

Table1-E

| Case | $n_{10}$ | $k_{10}$ | $d_{10}$ | $n_{20}$ | $k_{20}$ | $d_{20}$ |
|---|---|---|---|---|---|---|
| E-01 | 1.7952075 | 0.2631488 | 28.407 | 1.7975159 | 0.9080589 | 49.215 |
| E-02 | 1.8907711 | 0.1709411 | 22.060 | 1.9054700 | 0.5625340 | 101.512 |
| E-03 | 1.9054716 | 0.1139096 | 18.051 | 1.8637077 | 0.4032117 | 161.182 |
| E-04 | 1.9347861 | 0.0660701 | 14.149 | 1.8512928 | 0.3248351 | 218.499 |
| E-05 | 1.9562331 | 0.1018371 | 10.504 | 1.7371318 | 0.3049135 | 238.789 |
| E-06 | 1.7844085 | 0.1367381 | 84.299 | 1.7096132 | 0.6495191 | 54.242 |

(continued)

| Case | $n_{10}$ | $k_{10}$ | $d_{10}$ | $n_{20}$ | $k_{20}$ | $d_{20}$ |
|---|---|---|---|---|---|---|
| E-07 | 1.7702622 | 0.1105738 | 87.211 | 1.8115599 | 0.4022198 | 106.122 |
| E-08 | 1.7541370 | 0.0973387 | 88.132 | 1.7670571 | 0.2903421 | 167.020 |
| E-09 | 1.7279592 | 0.0846136 | 88.943 | 1.6883751 | 0.2308596 | 233.281 |
| E-10 | 1.7375980 | 0.1054836 | 150.710 | 1.7055974 | 0.5608974 | 53.799 |
| E-11 | 1.7329681 | 0.0932680 | 153.145 | 1.7707311 | 0.3436851 | 107.979 |
| E-12 | 1.7221048 | 0.0829100 | 154.966 | 1.7249696 | 0.2554267 | 168.643 |
| E-13 | 1.7083331 | 0.0687145 | 154.712 | 1.6656993 | 0.2071468 | 233.037 |
| E-14 | 1.7220084 | 0.0940320 | 214.741 | 1.7051250 | 0.5097600 | 53.504 |
| E-15 | 1.7182277 | 0.0857940 | 217.589 | 1.7452872 | 0.3145186 | 108.615 |
| E-16 | 1.7079026 | 0.0731017 | 221.285 | 1.6934483 | 0.2412999 | 168.585 |
| E-17 | 1.7021324 | 0.0613637 | 218.642 | 1.6620357 | 0.1957858 | 230.920 |

Table1-F

| Case | $n_{10}$ | $k_{10}$ | $d_{10}$ | $n_{20}$ | $k_{20}$ | $d_{20}$ |
|---|---|---|---|---|---|---|
| F-01 | 1.7605068 | 0.2771672 | 28.706 | 1.6786286 | 0.9008770 | 43.735 |
| F-02 | 1.8816347 | 0.1829378 | 20.725 | 1.8151288 | 0.5496963 | 99.755 |
| F-03 | 1.9020430 | 0.1268282 | 16.538 | 1.7976518 | 0.3935708 | 160.685 |
| F-04 | 1.9458467 | 0.0703715 | 13.048 | 1.8275971 | 0.3251874 | 213.311 |
| F-05 | 1.9584022 | 0.1032605 | 10.534 | 1.7382432 | 0.3086817 | 229.129 |
| F-06 | 1.7915017 | 0.1460711 | 82.108 | 1.6599684 | 0.6598461 | 47.036 |
| F-07 | 1.7682864 | 0.1152280 | 86.246 | 1.7730752 | 0.3999868 | 100.473 |
| F-08 | 1.7517777 | 0.1000283 | 87.803 | 1.7495420 | 0.2902721 | 159.986 |
| F-09 | 1.7257399 | 0.0854213 | 88.823 | 1.6774661 | 0.2313191 | 224.881 |
| F-10 | 1.7391311 | 0.1111219 | 148.271 | 1.6415570 | 0.5493559 | 47.977 |
| F-11 | 1.7320844 | 0.0968192 | 152.055 | 1.7411899 | 0.3409343 | 101.751 |
| F-12 | 1.7076855 | 0.0689521 | 154.586 | 1.6612710 | 0.2081961 | 223.547 |
| F-13 | 1.7203924 | 0.0842770 | 154.911 | 1.7118542 | 0.2561923 | 160.544 |
| F-14 | 1.7223192 | 0.0985051 | 212.081 | 1.6387426 | 0.4904233 | 48.284 |
| F-15 | 1.7173463 | 0.0890019 | 216.420 | 1.7205682 | 0.3116849 | 102.035 |
| F-16 | 1.7068337 | 0.0738736 | 221.446 | 1.6845656 | 0.2425094 | 159.621 |
| F-17 | 1.7019545 | 0.0615388 | 218.498 | 1.6606500 | 0.1970435 | 220.941 |

Table 1-G

| Case | $n_{10}$ | $k_{10}$ | $d_{10}$ | $n_{20}$ | $k_{20}$ | $d_{20}$ |
|---|---|---|---|---|---|---|
| G-01 | 1.7659038 | 0.3040912 | 29.683 | 1.6951746 | 1.0159152 | 32.660 |
| G-02 | 1.8645399 | 0.1945245 | 22.504 | 1.8232494 | 0.5745287 | 88.735 |
| G-03 | 1.8986420 | 0.1330684 | 17.099 | 1.7981378 | 0.4053118 | 150.314 |
| G-04 | 1.9431410 | 0.1068639 | 11.420 | 1.7406778 | 0.3159076 | 217.432 |
| G-05 | 1.8260230 | 0.1610409 | 82.141 | 1.8123655 | 0.8416018 | 29.750 |
| G-06 | 1.7771488 | 0.1183021 | 86.874 | 1.8193233 | 0.4301648 | 86.325 |
| G-07 | 1.7544343 | 0.1010010 | 88.257 | 1.7618403 | 0.3008540 | 147.888 |
| G-08 | 1.7270080 | 0.0859818 | 88.900 | 1.6808707 | 0.2360835 | 214.142 |
| G-09 | 1.7474077 | 0.1187907 | 148.872 | 1.6925268 | 0.6251022 | 34.244 |
| G-10 | 1.7344421 | 0.0986199 | 153.031 | 1.7617910 | 0.3597954 | 89.143 |
| G-11 | 1.7082851 | 0.0693971 | 154.668 | 1.6632564 | 0.2120421 | 213.175 |
| G-12 | 1.7212227 | 0.0845898 | 155.411 | 1.7183974 | 0.2642962 | 149.129 |

(continued)

| Case | $n_{10}$ | $k_{10}$ | $d_{10}$ | $n_{20}$ | $k_{20}$ | $d_{20}$ |
|---|---|---|---|---|---|---|
| G-13 | 1.7256274 | 0.1038247 | 212.824 | 1.6530934 | 0.5317369 | 36.133 |
| G-14 | 1.7180408 | 0.0895343 | 218.202 | 1.7315716 | 0.3280557 | 89.506 |
| G-15 | 1.7074443 | 0.0742263 | 221.707 | 1.6896767 | 0.2496384 | 148.627 |
| G-16 | 1.7023147 | 0.0619030 | 218.598 | 1.6620389 | 0.2005572 | 210.752 |

Table1-H

| Case | $n_{10}$ | $k_{10}$ | $d_{10}$ | $n_{20}$ | $k_{20}$ | $d_{20}$ |
|---|---|---|---|---|---|---|
| H-01 | 1.7563588 | 0.3324096 | 35.374 | 1.9274523 | 1.4642575 | 17.251 |
| H-02 | 1.8511230 | 0.2092311 | 25.991 | 1.9063465 | 0.6506745 | 73.686 |
| H-03 | 1.8843188 | 0.1443736 | 18.736 | 1.8018968 | 0.4300566 | 139.851 |
| H-04 | 1.9287462 | 0.1105115 | 12.655 | 1.7494498 | 0.3311673 | 205.772 |
| H-05 | 1.8353218 | 0.1759033 | 87.389 | 2.1171648 | 1.3140425 | 13.979 |
| H-06 | 1.7950810 | 0.1221034 | 88.670 | 1.9787137 | 0.5126318 | 67.257 |
| H-07 | 1.7627960 | 0.1022278 | 88.862 | 1.8048095 | 0.3274205 | 133.479 |
| H-08 | 1.7313791 | 0.0877850 | 88.999 | 1.6945552 | 0.2478313 | 202.902 |
| H-09 | 1.7608801 | 0.1266208 | 153.509 | 1.9275665 | 0.9887124 | 15.987 |
| H-10 | 1.7394221 | 0.0996664 | 155.305 | 1.8479873 | 0.4176577 | 72.839 |
| H-11 | 1.7245671 | 0.0857616 | 155.774 | 1.7414131 | 0.2835597 | 136.971 |
| H-12 | 1.7098549 | 0.0711157 | 154.844 | 1.6689951 | 0.2212317 | 203.148 |
| H-13 | 1.7314445 | 0.1087664 | 218.242 | 1.7862714 | 0.7962122 | 18.394 |
| H-14 | 1.7204815 | 0.0894136 | 220.453 | 1.7885409 | 0.3769446 | 74.763 |
| H-15 | 1.7093097 | 0.0755678 | 221.580 | 1.7021793 | 0.2655853 | 137.968 |
| H-16 | 1.7029357 | 0.0634027 | 218.717 | 1.6626290 | 0.2083407 | 201.624 |

Table1-I

| Case | $n_{10}$ | $k_{10}$ | $d_{10}$ | $n_{20}$ | $k_{20}$ | $d_{20}$ |
|---|---|---|---|---|---|---|
| I-01 | 1.7289685 | 0.3314086 | 44.247 | 5.1412592 | 5.4454539 | 1.484 |
| I-02 | 1.8452520 | 0.2255929 | 26.855 | 1.9037614 | 0.7221490 | 66.898 |
| I-03 | 1.8988873 | 0.1475831 | 20.944 | 1.8997324 | 0.4893775 | 122.094 |
| I-04 | 1.8877112 | 0.1535471 | 19.669 | 1.8220692 | 0.4687151 | 129.650 |
| I-05 | 1.9267904 | 0.0947520 | 15.612 | 1.8437835 | 0.3693724 | 183.529 |
| I-06 | 1.9311024 | 0.1132645 | 13.318 | 1.7624681 | 0.3523973 | 195.472 |
| I-07 | 1.9377300 | 0.0882760 | 11.094 | 1.7478213 | 0.2927773 | 252.908 |
| I-08 | 1.8321358 | 0.1783607 | 92.959 | 3.8484718 | 3.7040697 | 2.442 |
| I-09 | 1.8340055 | 0.1409526 | 90.549 | 2.7003837 | 0.6754163 | 40.010 |
| I-10 | 1.7711711 | 0.1059247 | 89.053 | 1.8505388 | 0.3612112 | 121.432 |
| I-11 | 1.7360863 | 0.0911204 | 88.900 | 1.7067614 | 0.2637604 | 192.941 |
| I-12 | 1.7197908 | 0.0799131 | 88.028 | 1.6618119 | 0.2120965 | 257.777 |
| I-13 | 1.7660895 | 0.1278221 | 159.319 | 4.3535883 | 4.0919379 | 1.526 |
| I-14 | 1.7439719 | 0.1032091 | 156.425 | 1.9650733 | 0.4980866 | 59.654 |
| I-15 | 1.7279356 | 0.0888807 | 155.640 | 1.7635448 | 0.3088945 | 126.749 |
| I-16 | 1.7114085 | 0.0740744 | 154.740 | 1.6716288 | 0.2338686 | 194.347 |
| I-17 | 1.7070625 | 0.0641745 | 153.245 | 1.6634512 | 0.1921909 | 254.410 |
| I-18 | 1.7347333 | 0.1100034 | 225.621 | 4.2666617 | 4.0109081 | 1.346 |
| I-19 | 1.7230132 | 0.0920219 | 220.898 | 1.8597675 | 0.4430799 | 63.229 |
| 1-20 | 1.7111302 | 0.0786417 | 221.002 | 1.7127614 | 0.2870105 | 128.848 |

# EP 1 760 766 A2

(continued)

| Case | $n_{10}$ | $k_{10}$ | $d_{10}$ | $n_{20}$ | $k_{20}$ | $d_{20}$ |
|---|---|---|---|---|---|---|
| 1-21 | 1.7035342 | 0.0659797 | 218.617 | 1.6615801 | 0.2195726 | 193.289 |
| 1-22 | 1.7027484 | 0.0572097 | 216.627 | 1.6695991 | 0.1821496 | 251.116 |
| 1-23 | 1.7001226 | 0.0542621 | 277.695 | 1.6762439 | 0.1770375 | 248.521 |

Table1-J

| Case | $n_{10}$ | $k_{10}$ | $d_{10}$ | $n_{20}$ | $k_{20}$ | $d_{20}$ |
|---|---|---|---|---|---|---|
| J-01 | 1.8593145 | 0.2496127 | 26.535 | 1.9155767 | 0.8329906 | 59.684 |
| J-02 | 1.9010800 | 0.1636004 | 19.815 | 1.8411706 | 0.5121692 | 120.535 |
| J-03 | 1.9204218 | 0.1149718 | 15.218 | 1.7975616 | 0.3794158 | 182.059 |
| J-04 | 1.9438629 | 0.1088618 | 10.610 | 1.7190727 | 0.2999844 | 250.015 |
| J-05 | 1.8201241 | 0.1437532 | 89.353 | 2.3681639 | 0.7410526 | 43.212 |
| J-06 | 1.7719135 | 0.1119845 | 88.526 | 1.8420973 | 0.3885265 | 115.256 |
| J-07 | 1.7372876 | 0.0953951 | 88.555 | 1.7021944 | 0.2779787 | 185.353 |
| J-08 | 1.7204595 | 0.0830085 | 87.798 | 1.6574450 | 0.2209480 | 249.744 |
| J-09 | 1.7445424 | 0.1106490 | 155.347 | 1.9643384 | 0.5665503 | 53.939 |
| J-10 | 1.7286821 | 0.0936244 | 154.936 | 1.7602486 | 0.3317476 | 119.649 |
| J-11 | 1.7117780 | 0.0773392 | 154.355 | 1.6664488 | 0.2460450 | 186.501 |
| J-12 | 1.7072616 | 0.0664543 | 152.987 | 1.6597858 | 0.2000883 | 246.239 |
| J-13 | 1.7114074 | 0.0830146 | 220.011 | 1.7075466 | 0.3068810 | 121.613 |
| J-14 | 1.7035514 | 0.0688006 | 218.183 | 1.6565327 | 0.2307053 | 185.316 |
| J-15 | 1.7027912 | 0.0591414 | 216.340 | 1.6669294 | 0.1896158 | 242.803 |

Table1-K

| Case | $n_{10}$ | $k_{10}$ | $d_{10}$ | $n_{20}$ | $k_{20}$ | $d_{20}$ |
|---|---|---|---|---|---|---|
| K-01 | 1.8881577 | 0.2795127 | 22.871 | 1.7550786 | 0.8705815 | 60.032 |
| K-02 | 1.9218914 | 0.1797398 | 17.442 | 1.7746647 | 0.5227186 | 119.813 |
| K-03 | 1.9458883 | 0.1322078 | 13.080 | 1.7478516 | 0.3833699 | 181.809 |
| K-04 | 1.9409291 | 0.1179060 | 10.849 | 1.7108849 | 0.3088835 | 241.776 |
| K-05 | 1.7882093 | 0.1515662 | 85.800 | 1.7933752 | 0.6703287 | 55.966 |
| K-06 | 1.7649059 | 0.1193411 | 87.339 | 1.7745734 | 0.3964773 | 113.800 |
| K-07 | 1.7337710 | 0.0996522 | 88.039 | 1.6760618 | 0.2847568 | 179.842 |
| K-08 | 1.7199633 | 0.0855558 | 87.477 | 1.6497564 | 0.2267213 | 241.489 |
| K-09 | 1.7259527 | 0.0989978 | 153.714 | 1.7204930 | 0.3415865 | 115.571 |
| K-10 | 1.7103936 | 0.0800216 | 153.726 | 1.6497935 | 0.2528816 | 179.482 |
| K-11 | 1.7070930 | 0.0681638 | 152.585 | 1.6551703 | 0.2055639 | 237.501 |
| K-12 | 1.7028018 | 0.0710148 | 217.506 | 1.6456663 | 0.2376270 | 177.429 |
| K-13 | 1.7027432 | 0.0605235 | 215.929 | 1.6646615 | 0.1950188 | 233.713 |

Table1-L

| Case | $n_{10}$ | $k_{10}$ | $d_{10}$ | $n_{20}$ | $k_{20}$ | $d_{20}$ |
|---|---|---|---|---|---|---|
| L-01 | 1.8909431 | 0.3085424 | 20.418 | 1.5964478 | 0.8353138 | 60.909 |
| L-02 | 1.9524263 | 0.1909748 | 15.444 | 1.7414925 | 0.5288169 | 116.361 |
| L-03 | 1.9741784 | 0.1389140 | 11.832 | 1.7353816 | 0.3892797 | 176.360 |
| L-04 | 1.9011191 | 0.1449022 | 11.795 | 1.6673230 | 0.3043383 | 237.538 |
| L-05 | 1.7812655 | 0.1647646 | 82.868 | 1.6154117 | 0.6141968 | 58.066 |

(continued)

| Case | $n_{10}$ | $k_{10}$ | $d_{10}$ | $n_{20}$ | $k_{20}$ | $d_{20}$ |
|---|---|---|---|---|---|---|
| L-06 | 1.7599364 | 0.1268761 | 86.158 | 1.7200975 | 0.3928633 | 111.244 |
| L-07 | 1.7294022 | 0.1028924 | 87.627 | 1.6470339 | 0.2862372 | 173.600 |
| L-08 | 1.7193592 | 0.0869972 | 87.259 | 1.6442041 | 0.2301394 | 231.990 |
| L-09 | 1.7088052 | 0.0815889 | 153.347 | 1.6346844 | 0.2563356 | 171.193 |
| L-10 | 1.7070991 | 0.0689994 | 152.325 | 1.6535493 | 0.2091466 | 227.454 |
| L-11 | 1.7021164 | 0.0722203 | 217.158 | 1.6379690 | 0.2419462 | 168.107 |
| L-12 | 1.7030336 | 0.0611451 | 215.722 | 1.6657846 | 0.1987136 | 223.276 |

Table1-M

| Case | $n_{10}$ | $k_{10}$ | $d_{10}$ | $n_{20}$ | $k_{20}$ | $d_{20}$ |
|---|---|---|---|---|---|---|
| M-01 | 1.8737564 | 0.3367363 | 20.276 | 1.5133470 | 0.8454522 | 55.480 |
| M-02 | 1.9697383 | 0.2020294 | 14.764 | 1.7299638 | 0.5429087 | 109.268 |
| M-03 | 1.9916260 | 0.1477036 | 11.315 | 1.7257470 | 0.3987910 | 168.578 |
| M-04 | 1.9141720 | 0.1461879 | 11.459 | 1.6683491 | 0.3122132 | 226.037 |
| M-05 | 1.7868889 | 0.1795709 | 80.605 | 1.5409994 | 0.6011754 | 53.925 |
| M-06 | 1.7600620 | 0.1342170 | 85.615 | 1.6974715 | 0.3980869 | 104.529 |
| M-07 | 1.7276490 | 0.1044918 | 87.663 | 1.6338870 | 0.2915200 | 164.129 |
| M-08 | 1.7199953 | 0.0874837 | 87.278 | 1.6452183 | 0.2346970 | 221.092 |
| M-09 | 1.7084320 | 0.0820944 | 153.448 | 1.6304269 | 0.2625567 | 160.685 |
| M-10 | 1.7077870 | 0.0691595 | 152.438 | 1.6574806 | 0.2137196 | 216.250 |
| M-11 | 1.7022055 | 0.0725208 | 217.368 | 1.6389178 | 0.2487144 | 157.041 |
| M-12 | 1.7036940 | 0.0612465 | 215.927 | 1.6705104 | 0.2029113 | 212.129 |

Table 1-N

| Case | $n_{10}$ | $k_{10}$ | $d_{10}$ | $n_{20}$ | $k_{20}$ | $d_{20}$ |
|---|---|---|---|---|---|---|
| N-01 | 1.8402862 | 0.3700261 | 23.403 | 1.4966418 | 1.0039549 | 41.463 |
| N-02 | 1.9646387 | 0.2123233 | 16.447 | 1.7618069 | 0.5971846 | 94.995 |
| N-03 | 1.9624104 | 0.1584699 | 12.893 | 1.7211612 | 0.4176484 | 156.173 |
| N-04 | 1.9059084 | 0.1473615 | 12.089 | 1.6694213 | 0.3203376 | 216.011 |
| N-05 | 1.8166660 | 0.1977639 | 79.798 | 1.5572201 | 0.7204992 | 40.224 |
| N-06 | 1.7655719 | 0.1384976 | 86.596 | 1.7129955 | 0.4320226 | 91.539 |
| N-07 | 1.7293285 | 0.1055583 | 87.952 | 1.6364176 | 0.3040668 | 153.339 |
| N-08 | 1.7214396 | 0.0882507 | 87.451 | 1.6482275 | 0.2416232 | 210.993 |
| N-09 | 1.7092770 | 0.0826318 | 153.805 | 1.6322979 | 0.2733763 | 150.296 |
| N-10 | 1.7085071 | 0.0697446 | 152.663 | 1.6592624 | 0.2197085 | 206.543 |
| N-11 | 1.7027802 | 0.0728517 | 217.779 | 1.6405373 | 0.2588103 | 146.936 |
| N-12 | 1.7041709 | 0.0617202 | 216.194 | 1.6719897 | 0.2085423 | 202.593 |

Table1-O

| Case | $n_{10}$ | $k_{10}$ | $d_{10}$ | $n_{20}$ | $k_{20}$ | $d_{20}$ |
|---|---|---|---|---|---|---|
| O-01 | 1.8199816 | 0.4068444 | 29.022 | 1.5974175 | 1.4701111 | 24.558 |
| O-02 | 1.9318464 | 0.2280177 | 20.237 | 1.8212470 | 0.6871951 | 79.181 |
| O-03 | 1.9476580 | 0.1546474 | 15.042 | 1.7660961 | 0.4559575 | 140.877 |
| O-04 | 1.9400781 | 0.1580344 | 15.180 | 1.7558824 | 0.4525330 | 141.749 |
| O-05 | 1.9152409 | 0.1421080 | 12.506 | 1.6892699 | 0.3391765 | 204.998 |

(continued)

| | | | | | | |
|------|-----------|-----------|---------|-----------|-----------|---------|
| O-06 | 1.8773964 | 0.2151408 | 81.211  | 1.7568637 | 1.2210655 | 20.666  |
| O-07 | 1.7792899 | 0.1408151 | 87.880  | 1.7944868 | 0.5090378 | 75.457  |
| O-08 | 1.7347668 | 0.1082989 | 88.119  | 1.6522930 | 0.3260600 | 142.664 |
| O-09 | 1.7234258 | 0.0907869 | 87.442  | 1.6482492 | 0.2516544 | 202.556 |
| O-10 | 1.7112569 | 0.0850611 | 153.930 | 1.6361524 | 0.2898839 | 141.116 |
| O-11 | 1.7092054 | 0.0717413 | 152.725 | 1.6572540 | 0.2283199 | 198.410 |
| O-12 | 1.7036310 | 0.0749476 | 217.788 | 1.6384900 | 0.2727185 | 138.609 |
| O-13 | 1.7042855 | 0.0635030 | 216.233 | 1.6687346 | 0.2164860 | 194.709 |

Table1-P

| Case | $n_{10}$ | $k_{10}$ | $d_{10}$ | $n_{20}$ | $k_{20}$ | $d_{20}$ |
|------|-----------|-----------|---------|-----------|-----------|---------|
| P-01 | 1.8175791 | 0.4385823 | 37.187  | 2.9488620 | 3.6605721 | 5.671   |
| P-02 | 1.9193642 | 0.2501320 | 21.908  | 1.8321620 | 0.7789298 | 69.456  |
| P-03 | 1.9516445 | 0.1607715 | 15.944  | 1.7911399 | 0.4964603 | 129.934 |
| P-04 | 1.9419697 | 0.1648951 | 16.094  | 1.7764317 | 0.4910919 | 131.139 |
| P-05 | 1.9282358 | 0.1504554 | 12.282  | 1.6857745 | 0.3551730 | 198.143 |
| P-06 | 1.8704725 | 0.2299368 | 88.746  | 2.8158519 | 3.0739838 | 4.992   |
| P-07 | 1.7960814 | 0.1479091 | 88.347  | 1.9330235 | 0.6225271 | 60.492  |
| P-08 | 1.7418606 | 0.1134159 | 87.888  | 1.6717189 | 0.3550776 | 132.384 |
| P-09 | 1.7257176 | 0.0948039 | 87.264  | 1.6472351 | 0.2650084 | 194.269 |
| P-10 | 1.7136245 | 0.0896483 | 153.565 | 1.6392609 | 0.3111392 | 132.434 |
| P-11 | 1.7097149 | 0.0750113 | 152.537 | 1.6527377 | 0.2392317 | 190.639 |
| P-12 | 1.7044725 | 0.0790614 | 217.265 | 1.6350180 | 0.2903973 | 130.687 |
| P-13 | 1.7041849 | 0.0664191 | 215.910 | 1.6625759 | 0.2261823 | 187.261 |
| P-14 | 1.7061658 | 0.0592006 | 215.675 | 1.6951633 | 0.1893046 | 240.772 |

Table1-Q

| Case | $n_{10}$ | $k_{10}$ | $d_{10}$ | $n_{20}$ | $k_{20}$ | $d_{20}$ |
|------|-----------|-----------|---------|-----------|-----------|---------|
| Q-01 | 1.9650460 | 0.1748342 | 15.368  | 1.7719438 | 0.5219218 | 124.100 |
| Q-02 | 1.9384951 | 0.1550287 | 12.323  | 1.6895811 | 0.3734128 | 189.293 |
| Q-03 | 1.9139584 | 0.1299465 | 11.343  | 1.6883766 | 0.3007198 | 246.427 |
| Q-04 | 1.7857662 | 0.1574086 | 86.539  | 1.7907030 | 0.6497694 | 59.718  |
| Q-05 | 1.7433983 | 0.1202381 | 87.036  | 1.6559011 | 0.3733381 | 125.629 |
| Q-06 | 1.7262549 | 0.0993784 | 86.812  | 1.6373093 | 0.2753256 | 186.729 |
| Q-07 | 1.7236673 | 0.0842645 | 87.109  | 1.6685549 | 0.2274459 | 241.120 |
| Q-08 | 1.7140199 | 0.0949670 | 152.601 | 1.6238426 | 0.3258368 | 125.450 |
| Q-09 | 1.7096017 | 0.0783956 | 152.026 | 1.6437329 | 0.2483227 | 182.921 |
| Q-10 | 1.7107217 | 0.0680252 | 152.100 | 1.6799600 | 0.2063397 | 236.403 |
| Q-11 | 1.7042582 | 0.0836625 | 216.186 | 1.6202806 | 0.3033538 | 123.599 |
| Q-12 | 1.7037677 | 0.0692974 | 215.313 | 1.6544674 | 0.2346728 | 179.446 |
| Q-13 | 1.7056779 | 0.0609868 | 215.198 | 1.6903958 | 0.1952987 | 232.683 |

Table1-R

| Case | $n_{10}$ | $k_{10}$ | $d_{10}$ | $n_{20}$ | $k_{20}$ | $d_{20}$ |
|------|-----------|-----------|---------|-----------|-----------|---------|
| R-01 | 1.9750220 | 0.3055970 | 17.312  | 1.6357631 | 0.8207912 | 66.973  |
| R-02 | 1.9943589 | 0.1905841 | 13.627  | 1.7309349 | 0.5263943 | 122.033 |

(continued)

| Case | $n_{10}$ | $k_{10}$ | $d_{10}$ | $n_{20}$ | $k_{20}$ | $d_{20}$ |
|------|----------|----------|----------|----------|----------|----------|
| R-03 | 1.9365478 | 0.1715491 | 12.200 | 1.6649916 | 0.3790440 | 183.216 |
| R-04 | 1.8874503 | 0.1503402 | 12.006 | 1.6561886 | 0.2991899 | 242.151 |
| R-05 | 1.7406539 | 0.1271964 | 86.109 | 1.6157675 | 0.3771605 | 120.682 |
| R-06 | 1.7253418 | 0.1032843 | 86.339 | 1.6224018 | 0.2809650 | 178.956 |
| R-07 | 1.7237735 | 0.0864157 | 86.885 | 1.6650124 | 0.2327133 | 231.784 |
| R-08 | 1.7126639 | 0.0996282 | 151.701 | 1.5953952 | 0.3310599 | 118.977 |
| R-09 | 1.7091592 | 0.0809109 | 151.551 | 1.6344497 | 0.2545275 | 174.271 |
| R-10 | 1.7108527 | 0.0696108 | 151.827 | 1.6784072 | 0.2111338 | 226.839 |
| R-11 | 1.7032995 | 0.0874338 | 215.388 | 1.6000078 | 0.3100603 | 116.088 |
| R-12 | 1.7035257 | 0.0712651 | 214.888 | 1.6490638 | 0.2413259 | 170.219 |
| R-13 | 1.7058486 | 0.0623526 | 214.924 | 1.6902455 | 0.1999123 | 222.958 |

Table1-S

| Case | $n_{10}$ | $k_{10}$ | $d_{10}$ | $n_{20}$ | $k_{20}$ | $d_{20}$ |
|------|----------|----------|----------|----------|----------|----------|
| S-01 | 2.0157422 | 0.3310994 | 15.233 | 1.5732193 | 0.8191417 | 66.313 |
| S-02 | 1.9298641 | 0.1874025 | 12.335 | 1.6401635 | 0.3856200 | 174.874 |
| S-03 | 1.9158213 | 0.1413868 | 11.496 | 1.6782430 | 0.3150440 | 226.685 |
| S-04 | 1.9035507 | 0.0919796 | 11.593 | 1.7330388 | 0.2716233 | 274.138 |
| S-05 | 1.7387191 | 0.1333266 | 85.772 | 1.5838112 | 0.3839989 | 113.170 |
| S-06 | 1.7256246 | 0.1055723 | 86.279 | 1.6177137 | 0.2895611 | 168.375 |
| S-07 | 1.7253546 | 0.0874820 | 86.928 | 1.6696157 | 0.2389730 | 220.361 |
| S-08 | 1.7287042 | 0.0760165 | 87.515 | 1.7081188 | 0.2041866 | 272.150 |
| S-09 | 1.7096582 | 0.0821714 | 151.624 | 1.6358848 | 0.2635969 | 162.984 |
| S-10 | 1.7121643 | 0.0705329 | 152.001 | 1.6853812 | 0.2167566 | 215.233 |
| S-11 | 1.7151566 | 0.0645755 | 152.412 | 1.7135234 | 0.1842756 | 268.692 |
| S-12 | 1.7029318 | 0.0900998 | 215.656 | 1.5920483 | 0.3226491 | 105.543 |
| S-13 | 1.7041956 | 0.0721897 | 215.114 | 1.6533659 | 0.2502000 | 158.704 |
| S-14 | 1.7070069 | 0.0633145 | 215.207 | 1.6971996 | 0.2048445 | 211.558 |
| S-15 | 1.7080920 | 0.0595697 | 215.250 | 1.7125257 | 0.1741269 | 267.229 |

Table1-T

| Case | $n_{10}$ | $k_{10}$ | $d_{10}$ | $n_{20}$ | $k_{20}$ | $d_{20}$ |
|------|----------|----------|----------|----------|----------|----------|
| T-01 | 1.9115074 | 0.1960527 | 13.258 | 1.6255021 | 0.3984556 | 164.068 |
| T-02 | 1.9153788 | 0.1490337 | 11.515 | 1.6682692 | 0.3197853 | 218.507 |
| T-03 | 1.8712999 | 0.0897979 | 14.536 | 1.7614462 | 0.2821612 | 257.799 |
| T-04 | 1.7275221 | 0.1065695 | 86.590 | 1.6227655 | 0.3041284 | 156.467 |
| T-05 | 1.7279210 | 0.0881248 | 87.122 | 1.6778177 | 0.2471127 | 209.069 |
| T-06 | 1.7316602 | 0.0769958 | 87.563 | 1.7153560 | 0.2092703 | 261.518 |
| T-07 | 1.7109076 | 0.0825870 | 152.078 | 1.6429824 | 0.2767726 | 151.325 |
| T-08 | 1.7140510 | 0.0712311 | 152.368 | 1.6947912 | 0.2239389 | 204.003 |
| T-09 | 1.7169074 | 0.0659464 | 152.739 | 1.7201685 | 0.1888883 | 258.117 |
| T-10 | 1.7034522 | 0.0912009 | 216.873 | 1.5969711 | 0.3506487 | 92.838 |
| T-11 | 1.7053294 | 0.0723641 | 215.802 | 1.6624125 | 0.2625944 | 147.133 |

(continued)

| Case | $n_{10}$ | $k_{10}$ | $d_{10}$ | $n_{20}$ | $k_{20}$ | $d_{20}$ |
|------|----------|----------|----------|----------|----------|----------|
| T-12 | 1.7084550 | 0.0642090 | 215.782 | 1.7063284 | 0.2112603 | 200.541 |
| T-13 | 1.7088490 | 0.0611230 | 215.750 | 1.7155496 | 0.1784523 | 257.296 |

Table2-A

| Case | $n_{10}$ | $k_{10}$ | $d_{10}$ | $n_{20}$ | $k_{20}$ | $d_{20}$ |
|------|----------|----------|----------|----------|----------|----------|
| A-01 | 2.1002530 | 0.0458360 | 25.245 | 3.6613926 | 2.0917723 | 4.980 |
| A-02 | 1.9014716 | 0.1897321 | 35.107 | 3.6832791 | 0.6232721 | 30.030 |
| A-03 | 1.8817545 | 0.1528631 | 29.787 | 2.2496615 | 0.5909670 | 58.673 |
| A-04 | 1.8713707 | 0.1131033 | 20.680 | 1.8471360 | 0.3799287 | 139.609 |
| A-05 | 1.8894555 | 0.1025295 | 13.808 | 1.7319643 | 0.2879285 | 214.126 |
| A-06 | 1.8919474 | 0.0886250 | 14.825 | 1.7713589 | 0.2959415 | 207.437 |
| A-07 | 1.8730447 | 0.0995044 | 12.107 | 1.6971361 | 0.2384266 | 276.341 |
| A-08 | 1.7734811 | 0.0942049 | 96.210 | 2.0242448 | 0.4293783 | 66.416 |
| A-09 | 1.7581396 | 0.0894114 | 94.485 | 1.8216770 | 0.2841737 | 135.446 |
| A-10 | 1.7209511 | 0.0778149 | 94.005 | 1.6746822 | 0.2144041 | 211.729 |
| A-11 | 1.7166765 | 0.0677623 | 92.667 | 1.6766991 | 0.1797231 | 270.198 |
| A-12 | 1.7166130 | 0.0755230 | 182.689 | 6.5634515 | 3.2079655 | 1.017 |
| A-13 | 1.7322234 | 0.0835200 | 166.765 | 1.9262925 | 0.3700807 | 69.546 |
| A-14 | 1.7049421 | 0.0655754 | 163.194 | 1.6664527 | 0.1954874 | 208.736 |
| A-15 | 1.7064564 | 0.0573750 | 160.636 | 1.6879767 | 0.1655431 | 264.028 |
| A-16 | 1.6929499 | 0.0758677 | 218.538 | 1.7888879 | 0.3373861 | 83.914 |
| A-17 | 1.6905856 | 0.0724871 | 210.998 | 1.7113381 | 0.2424201 | 155.877 |
| A-18 | 1.6919500 | 0.0673580 | 207.119 | 1.6973679 | 0.1951159 | 222.394 |
| A-19 | 1.6995270 | 0.0541447 | 221.890 | 1.6914313 | 0.1602785 | 261.841 |
| A-20 | 1.6946661 | 0.0598692 | 292.769 | 5.7902895 | 2.6464640 | 1.370 |
| A-21 | 1.6927273 | 0.0641185 | 275.960 | 1.7993913 | 0.3510467 | 81.101 |
| A-22 | 1.6938682 | 0.0632641 | 269.814 | 1.7248410 | 0.2487428 | 150.052 |
| A-23 | 1.6959215 | 0.0601626 | 266.236 | 1.7076727 | 0.2009217 | 214.823 |
| A-24 | 1.6965163 | 0.0560943 | 263.874 | 1.6984359 | 0.1709410 | 277.894 |

Table2-B

| Case | $n_{10}$ | $k_{10}$ | $d_{10}$ | $n_{20}$ | $k_{20}$ | $d_{20}$ |
|------|----------|----------|----------|----------|----------|----------|
| B-01 | 1.8588603 | 0.2152026 | 37.726 | 5.0977045 | 0.6974562 | 19.647 |
| B-02 | 1.8671897 | 0.2000001 | 35.681 | 3.0932325 | 0.7063642 | 34.687 |
| B-03 | 1.8793061 | 0.1213485 | 21.414 | 1.8727645 | 0.4149520 | 129.308 |
| B-04 | 1.8953035 | 0.0980077 | 14.908 | 1.7635602 | 0.3109442 | 200.446 |
| B-05 | 1.8743725 | 0.1084578 | 12.201 | 1.6884757 | 0.2470663 | 269.437 |
| B-06 | 1.7693190 | 0.1013402 | 103.520 | 3.2583829 | 2.5781374 | 3.121 |
| B-07 | 1.8089249 | 0.1064114 | 98.052 | 3.5132584 | 0.5501157 | 29.615 |
| B-08 | 1.7628339 | 0.0939832 | 94.416 | 1.8414170 | 0.3092618 | 125.923 |
| B-09 | 1.7223442 | 0.0810686 | 93.840 | 1.6728089 | 0.2260423 | 203.086 |
| 8-10 | 1.7176215 | 0.0701007 | 92.613 | 1.6759231 | 0.1876577 | 261.422 |
| B-11 | 1.7053748 | 0.0681661 | 163.030 | 1.6640911 | 0.2056957 | 200.113 |
| B-12 | 1.7067869 | 0.0592936 | 160.569 | 1.6873274 | 0.1726858 | 255.377 |
| B-13 | 1.7234396 | 0.0819972 | 177.819 | 5.0800961 | 4.2173316 | 1.054 |
| B-14 | 1.7309823 | 0.0887627 | 175.110 | 9.5526510 | 0.4602806 | 10.232 |

(continued)

| Case | $n_{10}$ | $k_{10}$ | $d_{10}$ | $n_{20}$ | $k_{20}$ | $d_{20}$ |
|------|----------|----------|----------|----------|----------|----------|
| B-15 | 1.6924662 | 0.0804140 | 219.254 | 1.8031504 | 0.3794202 | 74.951 |
| B-16 | 1.6899914 | 0.0755734 | 211.286 | 1.7113670 | 0.2592681 | 147.090 |
| B-17 | 1.6915311 | 0.0696615 | 207.258 | 1.6964473 | 0.2049428 | 213.635 |
| B-18 | 1.6993450 | 0.0558443 | 221.722 | 1.6905618 | 0.1670525 | 253.347 |
| B-19 | 1.6920076 | 0.0677866 | 276.645 | 1.8143335 | 0.3967808 | 72.378 |
| B-20 | 1.6934597 | 0.0658489 | 270.093 | 1.7261499 | 0.2668883 | 141.360 |
| B-21 | 1.6956703 | 0.0621151 | 266.327 | 1.7069279 | 0.2113995 | 206.262 |
| B-22 | 1.6963391 | 0.0576411 | 263.935 | 1.6975975 | 0.1780179 | 269.259 |

Table2-C

| Case | $n_{10}$ | $k_{10}$ | $d_{10}$ | $n_{20}$ | $k_{20}$ | $d_{20}$ |
|------|----------|----------|----------|----------|----------|----------|
| C-01 | 1.8231304 | 0.2426967 | 38.982 | 4.7825941 | 0.7852430 | 19.992 |
| C-02 | 1.8934062 | 0.1289044 | 22.067 | 1.9169501 | 0.4577317 | 118.684 |
| C-03 | 1.9014262 | 0.1029443 | 15.306 | 1.7714781 | 0.3309508 | 191.572 |
| C-04 | 1.8787814 | 0.1135143 | 12.334 | 1.6867670 | 0.2583639 | 261.269 |
| C-05 | 1.8198973 | 0.1197953 | 96.975 | 4.7572984 | 0.6218490 | 20.274 |
| C-06 | 1.7669399 | 0.0997580 | 94.208 | 1.8558060 | 0.3364471 | 117.969 |
| C-07 | 1.7235821 | 0.0847397 | 93.618 | 1.6692590 | 0.2394056 | 195.006 |
| C-08 | 1.7188964 | 0.0726255 | 92.505 | 1.6760484 | 0.1967286 | 252.779 |
| C-09 | 1.7058208 | 0.0710513 | 162.764 | 1.6616172 | 0.2176394 | 191.801 |
| C-10 | 1.7073313 | 0.0613671 | 160.462 | 1.6880654 | 0.1807904 | 246.769 |
| C-11 | 1.6893950 | 0.0792587 | 211.356 | 1.7121469 | 0.2795726 | 139.203 |
| C-12 | 1.6912149 | 0.0722082 | 207.241 | 1.6964479 | 0.2163033 | 205.754 |
| C-13 | 1.6993872 | 0.0576769 | 221.603 | 1.6911809 | 0.1749036 | 244.825 |
| C-14 | 1.6931110 | 0.0689939 | 270.168 | 1.7281714 | 0.2885226 | 133.446 |
| C-15 | 1.6955537 | 0.0643335 | 266.333 | 1.7074500 | 0.2235939 | 198.195 |
| C-16 | 1.6962507 | 0.0593120 | 263.960 | 1.6977843 | 0.1860709 | 261.024 |

Table2-D

| Case | $n_{10}$ | $k_{10}$ | $d_{10}$ | $n_{20}$ | $k_{20}$ | $d_{20}$ |
|------|----------|----------|----------|----------|----------|----------|
| D-01 | 1.8741027 | 0.2292405 | 31.502 | 2.4589695 | 0.9273915 | 39.688 |
| D-02 | 1.9162345 | 0.1358555 | 21.455 | 1.9418040 | 0.4998799 | 110.373 |
| D-03 | 1.9099224 | 0.1141224 | 14.789 | 1.7536831 | 0.3442834 | 186.067 |
| D-04 | 1.8839284 | 0.1193744 | 12.268 | 1.6821215 | 0.2672652 | 253.238 |
| D-05 | 1.7973698 | 0.1226911 | 93.176 | 2.1323779 | 0.6525391 | 46.828 |
| D-06 | 1.7231751 | 0.0881939 | 93.194 | 1.6583398 | 0.2493789 | 187.627 |
| D-07 | 1.7198225 | 0.0748307 | 92.273 | 1.6753837 | 0.2040438 | 244.025 |
| D-08 | 1.7057007 | 0.0735111 | 162.218 | 1.6560667 | 0.2270715 | 183.673 |
| D-09 | 1.7079030 | 0.0631371 | 160.241 | 1.6895692 | 0.1875698 | 237.741 |
| D-10 | 1.6886446 | 0.0826816 | 210.810 | 1.7077667 | 0.2975930 | 132.542 |
| D-11 | 1.6995870 | 0.0592337 | 221.497 | 1.6927290 | 0.1818275 | 235.781 |
| D-12 | 1.6927517 | 0.0720967 | 269.568 | 1.7225076 | 0.3075740 | 126.653 |
| D-13 | 1.6954892 | 0.0662812 | 265.955 | 1.7055518 | 0.2340649 | 190.864 |
| D-14 | 1.6961809 | 0.0606151 | 263.663 | 1.6966094 | 0.1927366 | 253.572 |

Table2-E

| Case | $n_{10}$ | $k_{10}$ | $d_{10}$ | $n_{20}$ | $k_{20}$ | $d_{20}$ |
|------|----------|----------|----------|----------|----------|----------|
| E-01 | 1.8808544 | 0.2454152 | 24.855 | 1.8495394 | 0.8565648 | 51.788 |
| E-02 | 1.9316654 | 0.1473610 | 18.765 | 1.8569906 | 0.5034890 | 110.667 |
| E-03 | 1.9082705 | 0.1322705 | 14.189 | 1.7144055 | 0.3458924 | 182.182 |
| E-04 | 1.8785232 | 0.1271526 | 12.435 | 1.6714546 | 0.2699971 | 245.412 |
| E-05 | 1.7211644 | 0.0906139 | 92.694 | 1.6423304 | 0.2528050 | 180.257 |
| E-06 | 1.7204079 | 0.0761160 | 92.018 | 1.6751968 | 0.2080809 | 234.537 |
| E-07 | 1.7050622 | 0.0748972 | 161.630 | 1.6489715 | 0.2315625 | 175.108 |
| E-08 | 1.7085349 | 0.0642166 | 160.005 | 1.6919631 | 0.1914882 | 227.913 |
| E-09 | 1.6878153 | 0.0847734 | 209.683 | 1.6959203 | 0.3070669 | 127.092 |
| E-10 | 1.6980473 | 0.0703784 | 224.445 | 1.6616204 | 0.2238826 | 171.370 |
| E-11 | 1.6999707 | 0.0601951 | 221.512 | 1.6952970 | 0.1862586 | 225.852 |
| E-12 | 1.6924126 | 0.0742318 | 268.357 | 1.7068352 | 0.3173492 | 120.697 |
| E-13 | 1.6955002 | 0.0674212 | 265.225 | 1.7004174 | 0.2397614 | 183.997 |
| E-14 | 1.6961000 | 0.0611797 | 263.146 | 1.6940899 | 0.1962440 | 246.462 |

Table2-F

| Case | $n_{10}$ | $k_{10}$ | $d_{10}$ | $n_{20}$ | $k_{20}$ | $d_{20}$ |
|------|----------|----------|----------|----------|----------|----------|
| F-01 | 1.8609133 | 0.2699154 | 23.275 | 1.6780954 | 0.8091000 | 51.309 |
| F-02 | 1.9462238 | 0.1588548 | 16.938 | 1.8061043 | 0.4989592 | 107.791 |
| F-03 | 1.9002376 | 0.1498745 | 13.880 | 1.6764313 | 0.3420875 | 176.900 |
| F-04 | 1.8750233 | 0.1302055 | 12.592 | 1.6672162 | 0.2718902 | 235.718 |
| F-05 | 1.8816918 | 0.0811209 | 12.084 | 1.7277101 | 0.2394028 | 282.393 |
| F-06 | 1.7196449 | 0.0916508 | 92.440 | 1.6323282 | 0.2539653 | 171.320 |
| F-07 | 1.7211216 | 0.0765241 | 91.942 | 1.6777604 | 0.2105462 | 223.941 |
| F-08 | 1.7282121 | 0.0683348 | 92.298 | 1.7222619 | 0.1825246 | 274.062 |
| F-09 | 1.7047574 | 0.0753118 | 161.355 | 1.6462273 | 0.2341241 | 165.232 |
| F-10 | 1.7094298 | 0.0647325 | 159.970 | 1.6962571 | 0.1938378 | 217.150 |
| F-11 | 1.6870964 | 0.0858972 | 208.556 | 1.6830399 | 0.3090553 | 121.249 |
| F-12 | 1.6986314 | 0.0705958 | 224.893 | 1.6622291 | 0.2274423 | 160.831 |
| F-13 | 1.7003667 | 0.0607285 | 221.557 | 1.6983916 | 0.1887213 | 215.383 |
| F-14 | 1.6951156 | 0.0571177 | 215.781 | 1.6957463 | 0.1617780 | 277.216 |
| F-15 | 1.6955653 | 0.0680298 | 264.644 | 1.6953987 | 0.2417239 | 176.078 |
| F-16 | 1.6958377 | 0.0528303 | 274.984 | 1.6882898 | 0.1657751 | 275.044 |

Table2-G

| Case | $n_{10}$ | $k_{10}$ | $d_{10}$ | $n_{20}$ | $k_{20}$ | $d_{20}$ |
|------|----------|----------|----------|----------|----------|----------|
| G-01 | 1.8339628 | 0.2973905 | 24.925 | 1.6419965 | 0.8698975 | 41.723 |
| G-02 | 1.9445237 | 0.1726202 | 17.287 | 1.7953047 | 0.5162004 | 98.907 |
| G-03 | 1.8939902 | 0.1563846 | 14.253 | 1.6659458 | 0.3485215 | 167.112 |
| G-04 | 1.8811858 | 0.0833966 | 12.228 | 1.7269957 | 0.2426363 | 272.914 |
| G-05 | 1.7203230 | 0.0922740 | 92.527 | 1.6328842 | 0.2599948 | 160.703 |
| G-06 | 1.7224265 | 0.0770592 | 92.053 | 1.6819841 | 0.2150120 | 213.162 |
| G-07 | 1.7294779 | 0.0692299 | 92.385 | 1.7252879 | 0.1858377 | 263.723 |
| G-08 | 1.7053201 | 0.0757255 | 161.452 | 1.6485370 | 0.2399747 | 154.588 |
| G-09 | 1.7102741 | 0.0654045 | 160.136 | 1.7000507 | 0.1977447 | 206.614 |

(continued)

| Case | $n_{10}$ | $k_{10}$ | $d_{10}$ | $n_{20}$ | $k_{20}$ | $d_{20}$ |
|------|----------|----------|----------|----------|----------|----------|
| G-10 | 1.7133466 | 0.0629386 | 160.381 | 1.7220503 | 0.1698335 | 260.757 |
| G-11 | 1.6861768 | 0.0881028 | 208.148 | 1.6733849 | 0.3136681 | 112.385 |
| G-12 | 1.6990769 | 0.0709373 | 225.005 | 1.6647354 | 0.2329033 | 150.349 |
| G-13 | 1.7003759 | 0.0613969 | 221.468 | 1.6998938 | 0.1918751 | 205.497 |
| G-14 | 1.6946436 | 0.0577579 | 215.315 | 1.6946016 | 0.1634050 | 268.128 |
| G-15 | 1.6954303 | 0.0690806 | 264.876 | 1.6937197 | 0.2458138 | 165.269 |
| G-16 | 1.6957423 | 0.0532811 | 274.848 | 1.6878755 | 0.1674492 | 265.685 |

Table2-H

| Case | $n_{10}$ | $k_{10}$ | $d_{10}$ | $n_{20}$ | $k_{20}$ | $d_{20}$ |
|------|----------|----------|----------|----------|----------|----------|
| H-01 | 1.9187259 | 0.1881900 | 20.509 | 1.8283337 | 0.5739613 | 84.746 |
| H-02 | 1.8967518 | 0.1527475 | 15.221 | 1.6893708 | 0.3734166 | 154.221 |
| H-03 | 1.8757876 | 0.1318014 | 13.247 | 1.6726776 | 0.2883472 | 215.129 |
| H-04 | 1.8806788 | 0.0899399 | 12.412 | 1.7211162 | 0.2492460 | 265.394 |
| H-05 | 1.7234296 | 0.0945092 | 92.722 | 1.6393014 | 0.2743485 | 150.270 |
| H-06 | 1.7235983 | 0.0790587 | 92.129 | 1.6815454 | 0.2228770 | 204.187 |
| H-07 | 1.7294254 | 0.0706491 | 92.482 | 1.7233644 | 0.1918670 | 255.172 |
| H-08 | 1.7064538 | 0.0777504 | 161.668 | 1.6498826 | 0.2514894 | 145.038 |
| H-09 | 1.7103862 | 0.0670250 | 160.278 | 1.6983722 | 0.2047961 | 197.922 |
| H-10 | 1.7133072 | 0.0637197 | 160.467 | 1.7219131 | 0.1752501 | 251.781 |
| H-11 | 1.6987335 | 0.0728489 | 224.384 | 1.6635130 | 0.2423517 | 141.699 |
| H-12 | 1.6895310 | 0.0798395 | 207.056 | 1.6873868 | 0.2464201 | 160.447 |
| H-13 | 1.6997408 | 0.0628030 | 221.189 | 1.6972371 | 0.1976117 | 197.186 |
| H-14 | 1.6947661 | 0.0583146 | 215.749 | 1.6943199 | 0.1671130 | 258.789 |
| H-15 | 1.6915645 | 0.0796327 | 269.434 | 1.7013553 | 0.3520060 | 90.540 |
| H-16 | 1.6950499 | 0.0706693 | 266.123 | 1.6983222 | 0.2573177 | 152.851 |
| H-17 | 1.6956172 | 0.0541668 | 274.905 | 1.6860233 | 0.1712439 | 257.337 |

Table2-I

| Case | $n_{10}$ | $k_{10}$ | $d_{10}$ | $n_{20}$ | $k_{20}$ | $d_{20}$ |
|------|----------|----------|----------|----------|----------|----------|
| I-01 | 1.8980776 | 0.2063094 | 23.234 | 1.8542997 | 0.6486453 | 73.732 |
| I-02 | 1.9078109 | 0.1489982 | 16.351 | 1.7325536 | 0.4126982 | 141.036 |
| I-03 | 1.8887573 | 0.1336370 | 13.295 | 1.6803356 | 0.3065809 | 205.639 |
| I-04 | 1.8863613 | 0.0963846 | 12.395 | 1.7165602 | 0.2596921 | 258.147 |
| I-05 | 1.7283563 | 0.0991844 | 92.796 | 1.6494143 | 0.2975623 | 140.358 |
| I-06 | 1.7247011 | 0.0825295 | 92.134 | 1.6784446 | 0.2345042 | 196.220 |
| I-07 | 1.7288637 | 0.0727638 | 92.409 | 1.7181265 | 0.1997137 | 247.866 |
| I-08 | 1.7100270 | 0.0697395 | 160.277 | 1.6932584 | 0.2147807 | 190.362 |
| I-09 | 1.7129082 | 0.0648353 | 160.281 | 1.7202855 | 0.1822190 | 243.795 |
| I-10 | 1.6894084 | 0.0825836 | 208.412 | 1.6911413 | 0.2636300 | 148.443 |
| I-11 | 1.6987536 | 0.0651428 | 220.679 | 1.6918669 | 0.2062686 | 189.869 |
| I-12 | 1.6951804 | 0.0592977 | 216.421 | 1.6944812 | 0.1733276 | 249.686 |
| I-13 | 1.6947043 | 0.0728049 | 267.049 | 1.7045529 | 0.2758626 | 142.407 |
| I-14 | 1.6953534 | 0.0654850 | 264.587 | 1.6939885 | 0.2171518 | 204.731 |
| I-15 | 1.6955317 | 0.0555447 | 274.968 | 1.6840742 | 0.1777252 | 249.243 |

Table2-J

| Case | $n_{10}$ | $k_{10}$ | $d_{10}$ | $n_{20}$ | $k_{20}$ | $d_{20}$ |
|------|----------|----------|----------|----------|----------|----------|
| J-01 | 1.9059589 | 0.2274286 | 23.462 | 1.8553331 | 0.7355051 | 66.090 |
| J-02 | 1.9224042 | 0.1550778 | 16.599 | 1.7510181 | 0.4490690 | 131.424 |
| J-03 | 1.8961620 | 0.1385328 | 13.501 | 1.6829419 | 0.3248659 | 196.767 |
| J-04 | 1.8922593 | 0.1041345 | 12.282 | 1.7097147 | 0.2697702 | 251.116 |
| J-05 | 1.7254583 | 0.0865833 | 91.876 | 1.6727903 | 0.2465542 | 188.519 |
| J-06 | 1.7286512 | 0.0752622 | 92.185 | 1.7137581 | 0.2076205 | 240.302 |
| J-07 | 1.7096319 | 0.0728333 | 159.923 | 1.6877059 | 0.2252670 | 182.766 |
| J-08 | 1.7125109 | 0.0665034 | 159.852 | 1.7181911 | 0.1890952 | 235.934 |
| J-09 | 1.6891198 | 0.0853163 | 208.173 | 1.6918411 | 0.2826173 | 141.112 |
| J-10 | 1.6979687 | 0.0677690 | 220.140 | 1.6871092 | 0.2165239 | 182.186 |
| J-11 | 1.6953920 | 0.0607310 | 216.694 | 1.6943518 | 0.1805507 | 240.824 |
| J-12 | 1.6945041 | 0.0754015 | 266.879 | 1.7053190 | 0.2962459 | 134.581 |
| J-13 | 1.6957904 | 0.0613078 | 263.111 | 1.6921380 | 0.1886276 | 257.166 |

Table2-K

| Case | $n_{10}$ | $k_{10}$ | $d_{10}$ | $n_{20}$ | $k_{20}$ | $d_{20}$ |
|------|----------|----------|----------|----------|----------|----------|
| K-01 | 1.9374125 | 0.1704110 | 15.669 | 1.7248980 | 0.4663738 | 126.299 |
| K-02 | 1.9018997 | 0.1487976 | 13.285 | 1.6713435 | 0.3352808 | 189.496 |
| K-03 | 1.8965439 | 0.1142225 | 11.973 | 1.6970963 | 0.2748315 | 244.759 |
| K-04 | 1.7253637 | 0.0900184 | 91.432 | 1.6651786 | 0.2549499 | 180.505 |
| K-05 | 1.7289764 | 0.0775142 | 91.877 | 1.7120256 | 0.2134557 | 231.728 |
| K-06 | 1.7092919 | 0.0753499 | 159.318 | 1.6830351 | 0.2331189 | 174.468 |
| K-07 | 1.7124011 | 0.0683625 | 159.365 | 1.7169838 | 0.1941891 | 227.412 |
| K-08 | 1.6891266 | 0.0867081 | 206.818 | 1.6858604 | 0.2953498 | 138.155 |
| K-09 | 1.6977739 | 0.0698574 | 219.869 | 1.6842611 | 0.2258219 | 173.345 |
| K-10 | 1.6952347 | 0.0623107 | 216.627 | 1.6937881 | 0.1869159 | 231.738 |
| K-11 | 1.6944699 | 0.0775933 | 265.762 | 1.6967397 | 0.3115846 | 129.093 |
| K-12 | 1.6958800 | 0.0528961 | 273.317 | 1.6915993 | 0.1649138 | 288.010 |

Table2-L

| Case | $n_{10}$ | $k_{10}$ | $d_{10}$ | $n_{20}$ | $k_{20}$ | $d_{20}$ |
|------|----------|----------|----------|----------|----------|----------|
| L-01 | 1.9729972 | 0.2768129 | 17.524 | 1.6663342 | 0.7544777 | 64.842 |
| L-02 | 1.9456051 | 0.1915481 | 14.612 | 1.6781309 | 0.4665054 | 122.845 |
| L-03 | 1.9005953 | 0.1591490 | 13.217 | 1.6561276 | 0.3399716 | 181.593 |
| L-04 | 1.8972956 | 0.1121564 | 12.290 | 1.7051607 | 0.2822449 | 233.141 |
| L-05 | 1.7255330 | 0.0922673 | 91.102 | 1.6614760 | 0.2607016 | 171.070 |
| L-06 | 1.7304964 | 0.0792452 | 91.709 | 1.7154952 | 0.2175998 | 221.560 |
| L-07 | 1.7097843 | 0.0770210 | 159.025 | 1.6841289 | 0.2392980 | 164.463 |
| L-08 | 1.7129025 | 0.0702809 | 159.249 | 1.7178163 | 0.1978132 | 217.770 |
| L-09 | 1.7059734 | 0.0642321 | 159.600 | 1.6898319 | 0.1677546 | 279.371 |
| L-10 | 1.6983193 | 0.0712405 | 220.143 | 1.6860819 | 0.2336364 | 162.903 |
| L-11 | 1.6946755 | 0.0639503 | 216.344 | 1.6931001 | 0.1919118 | 222.331 |
| L-12 | 1.6955425 | 0.0535782 | 213.248 | 1.6937343 | 0.1415462 | 338.947 |
| L-13 | 1.6956989 | 0.0539885 | 272.929 | 1.6917939 | 0.1683287 | 278.327 |

Table2-M

| Case | $n_{10}$ | $k_{10}$ | $d_{10}$ | $n_{20}$ | $k_{20}$ | $d_{20}$ |
|------|----------|----------|----------|----------|----------|----------|
| M-01 | 1.8993435 | 0.1093669 | 12.638 | 1.7156529 | 0.2903108 | 220.942 |
| M-02 | 1.9080238 | 0.0778133 | 11.189 | 1.7380285 | 0.2474831 | 275.866 |
| M-03 | 1.7276770 | 0.0934541 | 91.210 | 1.6689251 | 0.2700133 | 159.348 |
| M-04 | 1.7338076 | 0.0808022 | 91.869 | 1.7256843 | 0.2232282 | 209.944 |
| M-05 | 1.7236449 | 0.0736298 | 92.640 | 1.7007078 | 0.1887087 | 271.148 |
| M-06 | 1.7117973 | 0.0782334 | 159.412 | 1.6949465 | 0.2480962 | 152.577 |
| M-07 | 1.7052523 | 0.0648564 | 160.141 | 1.6847092 | 0.1699839 | 269.827 |
| M-08 | 1.6990979 | 0.0723627 | 220.761 | 1.6931390 | 0.2421156 | 151.650 |
| M-09 | 1.6936455 | 0.0657466 | 215.539 | 1.6916565 | 0.1962143 | 213.597 |
| M-10 | 1.6937228 | 0.0602088 | 212.854 | 1.6917935 | 0.1651159 | 273.449 |
| M-11 | 1.6954835 | 0.0549286 | 272.481 | 1.6920522 | 0.1709440 | 269.018 |

Table2-N

| Case | $n_{10}$ | $k_{10}$ | $d_{10}$ | $n_{20}$ | $k_{20}$ | $d_{20}$ |
|------|----------|----------|----------|----------|----------|----------|
| N-01 | 1.9117383 | 0.2302052 | 15.980 | 1.5953517 | 0.4940730 | 105.368 |
| N-02 | 1.8981283 | 0.1070787 | 13.384 | 1.7296497 | 0.3022759 | 209.053 |
| N-03 | 1.9112943 | 0.0649623 | 12.163 | 1.7710787 | 0.2605013 | 259.824 |
| N-04 | 1.7312914 | 0.0945058 | 91.544 | 1.6819509 | 0.2846338 | 147.702 |
| N-05 | 1.7377087 | 0.0827928 | 92.151 | 1.7372931 | 0.2321492 | 198.983 |
| N-06 | 1.7228203 | 0.0749158 | 92.874 | 1.6951594 | 0.1935801 | 262.590 |
| N-07 | 1.7144911 | 0.0796518 | 160.015 | 1.7090445 | 0.2610315 | 141.223 |
| N-08 | 1.7050797 | 0.0657099 | 160.534 | 1.6817729 | 0.1743389 | 260.739 |
| N-09 | 1.6925663 | 0.0675694 | 214.049 | 1.6900690 | 0.2005073 | 206.287 |
| N-10 | 1.6991742 | 0.0739382 | 220.936 | 1.6992675 | 0.2525134 | 141.832 |
| N-11 | 1.6955775 | 0.0548747 | 213.500 | 1.6934763 | 0.1457299 | 319.743 |
| N-12 | 1.6953573 | 0.0556511 | 272.231 | 1.6917841 | 0.1736649 | 260.476 |

Table2-O

| Case | $n_{10}$ | $k_{10}$ | $d_{10}$ | $n_{20}$ | $k_{20}$ | $d_{20}$ |
|------|----------|----------|----------|----------|----------|----------|
| O-01 | 1.8842999 | 0.1660082 | 15.542 | 1.6642092 | 0.3881866 | 148.595 |
| O-02 | 1.9020060 | 0.1078045 | 13.884 | 1.7406676 | 0.3180988 | 199.025 |
| O-03 | 1.9176161 | 0.0733974 | 11.927 | 1.7608162 | 0.2687301 | 254.127 |
| O-04 | 1.7347347 | 0.0970436 | 91.613 | 1.6897518 | 0.3028107 | 138.166 |
| O-05 | 1.7402087 | 0.0854812 | 92.221 | 1.7427648 | 0.2437105 | 190.058 |
| O-06 | 1.7232674 | 0.0768076 | 92.842 | 1.6931409 | 0.2010537 | 254.319 |
| O-07 | 1.7163169 | 0.0822242 | 160.121 | 1.7162208 | 0.2770503 | 132.120 |
| O-08 | 1.7052425 | 0.0670983 | 160.367 | 1.6808978 | 0.1806066 | 252.327 |
| O-09 | 1.6979604 | 0.0765182 | 219.964 | 1.6978817 | 0.2641846 | 134.431 |
| O-10 | 1.6919325 | 0.0693101 | 212.895 | 1.6886216 | 0.2063377 | 199.162 |
| O-11 | 1.6933082 | 0.0619759 | 212.839 | 1.6904544 | 0.1723582 | 255.647 |
| O-12 | 1.6953110 | 0.0563706 | 272.392 | 1.6905212 | 0.1778331 | 252.170 |

Table2-P

| Case | $n_{10}$ | $k_{10}$ | $d_{10}$ | $n_{20}$ | $k_{20}$ | $d_{20}$ |
|------|----------|----------|----------|----------|----------|----------|
| P-01 | 1.9162825 | 0.2485644 | 18.297 | 1.6104232 | 0.6165991 | 83.442 |
| P-02 | 1.8960663 | 0.1719364 | 15.704 | 1.6708316 | 0.4169686 | 139.520 |
| P-03 | 1.9085468 | 0.1144956 | 13.923 | 1.7385514 | 0.3337318 | 191.444 |
| P-04 | 1.9232010 | 0.0848488 | 11.624 | 1.7455678 | 0.2771185 | 248.983 |
| P-05 | 1.7368663 | 0.1019026 | 91.322 | 1.6869885 | 0.3224919 | 130.342 |
| P-06 | 1.7401611 | 0.0886217 | 92.017 | 1.7381402 | 0.2555882 | 182.755 |
| P-07 | 1.7243481 | 0.0791015 | 92.538 | 1.6930588 | 0.2092609 | 245.988 |
| P-08 | 1.7054586 | 0.0688139 | 159.721 | 1.6812702 | 0.1871719 | 244.029 |
| P-09 | 1.6959475 | 0.0801582 | 218.084 | 1.6891859 | 0.2763746 | 128.431 |
| P-10 | 1.6918299 | 0.0707672 | 213.401 | 1.6865968 | 0.2143676 | 190.286 |
| P-11 | 1.6935501 | 0.0625258 | 213.666 | 1.6897170 | 0.1780108 | 246.097 |
| P-12 | 1.6953216 | 0.0573372 | 272.694 | 1.6885432 | 0.1839003 | 243.579 |

Table2-Q

| Case | $n_{10}$ | $k_{10}$ | $d_{10}$ | $n_{20}$ | $k_{20}$ | $d_{20}$ |
|------|----------|----------|----------|----------|----------|----------|
| Q-01 | 1.9620125 | 0.2671830 | 17.281 | 1.6251877 | 0.6875073 | 75.420 |
| Q-02 | 1.9138120 | 0.1838008 | 15.160 | 1.6631095 | 0.4399257 | 132.541 |
| Q-03 | 1.9194872 | 0.1265886 | 13.286 | 1.7204546 | 0.3440475 | 186.036 |
| Q-04 | 1.9263431 | 0.0918160 | 11.575 | 1.7389610 | 0.2853240 | 241.421 |
| Q-05 | 1.7366416 | 0.1083929 | 90.600 | 1.6676220 | 0.3363185 | 124.136 |
| Q-06 | 1.7377165 | 0.0918810 | 91.516 | 1.7225143 | 0.2640565 | 176.484 |
| Q-07 | 1.7250070 | 0.0812670 | 92.096 | 1.6922454 | 0.2155950 | 237.445 |
| Q-08 | 1.7054487 | 0.0704565 | 158.889 | 1.6815182 | 0.1921887 | 235.428 |
| Q-09 | 1.6921136 | 0.0719896 | 214.506 | 1.6833735 | 0.2231205 | 180.418 |
| Q-10 | 1.6937452 | 0.0634118 | 214.086 | 1.6893106 | 0.1840166 | 236.602 |
| Q-11 | 1.6937402 | 0.0634247 | 214.067 | 1.6892020 | 0.1839903 | 236.644 |
| Q-12 | 1.6958036 | 0.0530688 | 271.703 | 1.6918593 | 0.1637010 | 291.452 |

Table2-R

| Case | $n_{10}$ | $k_{10}$ | $d_{10}$ | $n_{20}$ | $k_{20}$ | $d_{20}$ |
|------|----------|----------|----------|----------|----------|----------|
| R-01 | 2.0247974 | 0.2830183 | 15.097 | 1.6266898 | 0.7191283 | 71.681 |
| R-02 | 1.9282935 | 0.1992550 | 14.428 | 1.6428403 | 0.4517072 | 126.823 |
| R-03 | 1.9213955 | 0.1387890 | 13.062 | 1.7027750 | 0.3507816 | 179.475 |
| R-04 | 1.9262173 | 0.1063571 | 11.253 | 1.7173021 | 0.2869739 | 236.027 |
| R-05 | 1.7355101 | 0.0947091 | 91.033 | 1.7079959 | 0.2693832 | 169.192 |
| R-06 | 1.7251933 | 0.0829804 | 91.728 | 1.6903561 | 0.2192539 | 228.367 |
| R-07 | 1.7054174 | 0.0718367 | 158.389 | 1.6812041 | 0.1954390 | 226.084 |
| R-08 | 1.6937830 | 0.0647049 | 214.330 | 1.6889835 | 0.1894046 | 226.812 |
| R-09 | 1.6952847 | 0.0582261 | 213.359 | 1.6934588 | 0.1611341 | 284.005 |
| R-10 | 1.6957027 | 0.0542195 | 271.586 | 1.6918383 | 0.1679902 | 281.728 |

Table2-S

| Case | $n_{10}$ | $k_{10}$ | $d_{10}$ | $n_{20}$ | $k_{20}$ | $d_{20}$ |
|------|----------|----------|----------|----------|----------|----------|
| S-01 | 1.9316549 | 0.2158025 | 14.297 | 1.6202378 | 0.4645248 | 119.165 |

(continued)

| Case | $n_{10}$ | $k_{10}$ | $d_{10}$ | $n_{20}$ | $k_{20}$ | $d_{20}$ |
|---|---|---|---|---|---|---|
| S-02 | 1.9193011 | 0.1476126 | 13.272 | 1.6935029 | 0.3598725 | 170.049 |
| S-03 | 1.9209840 | 0.1061325 | 11.842 | 1.7241227 | 0.2946413 | 224.030 |
| S-04 | 1.9114684 | 0.1024475 | 10.224 | 1.6976483 | 0.2438294 | 285.021 |
| S-05 | 1.7364379 | 0.0969838 | 91.033 | 1.7085420 | 0.2774318 | 158.680 |
| S-06 | 1.7258494 | 0.0843222 | 91.766 | 1.6907525 | 0.2229229 | 218.067 |
| S-07 | 1.7176246 | 0.0727056 | 91.617 | 1.6784161 | 0.1842107 | 277.206 |
| S-08 | 1.7057732 | 0.0731106 | 158.709 | 1.6805392 | 0.1989479 | 215.842 |
| S-09 | 1.7053832 | 0.0633918 | 158.181 | 1.6859880 | 0.1669818 | 272.384 |
| S-10 | 1.6928552 | 0.0748243 | 216.444 | 1.6825267 | 0.2415835 | 158.548 |
| S-11 | 1.6935473 | 0.0663823 | 214.407 | 1.6888366 | 0.1945007 | 217.060 |
| S-12 | 1.6950516 | 0.0596605 | 213.429 | 1.6925794 | 0.1643538 | 274.430 |
| S-13 | 1.6954923 | 0.0554795 | 271.226 | 1.6917166 | 0.1716832 | 272.356 |

Table2-T

| Case | $n_{10}$ | $k_{10}$ | $d_{10}$ | $n_{20}$ | $k_{20}$ | $d_{20}$ |
|---|---|---|---|---|---|---|
| T-01 | 1.9124203 | 0.1489422 | 14.330 | 1.7039618 | 0.3787231 | 157.291 |
| T-02 | 1.9240615 | 0.1092971 | 12.001 | 1.7245262 | 0.3026113 | 214.201 |
| T-03 | 1.9069086 | 0.1015424 | 10.748 | 1.7018591 | 0.2499950 | 273.963 |
| T-04 | 1.7409810 | 0.0988730 | 91.533 | 1.7256420 | 0.2922591 | 146.253 |
| T-05 | 1.7270720 | 0.0857435 | 92.142 | 1.6923707 | 0.2292874 | 207.814 |
| T-06 | 1.7180387 | 0.0734703 | 91.877 | 1.6777924 | 0.1881130 | 267.481 |
| T-07 | 1.7063746 | 0.0744769 | 159.624 | 1.6791348 | 0.2047799 | 205.830 |
| T-08 | 1.7058520 | 0.0640895 | 158.885 | 1.6855365 | 0.1710983 | 262.479 |
| T-09 | 1.6924739 | 0.0767908 | 216.680 | 1.6850078 | 0.2520629 | 148.712 |
| T-10 | 1.6928977 | 0.0684401 | 213.761 | 1.6885850 | 0.1999527 | 208.689 |
| T-11 | 1.6947635 | 0.0610999 | 213.366 | 1.6918971 | 0.1679521 | 265.388 |
| T-12 | 1.6952371 | 0.0566636 | 270.653 | 1.6914186 | 0.1751623 | 263.994 |

Table3-A

| Case | $n_{10}$ | $k_{10}$ | $d_{10}$ | $n_{20}$ | $k_{20}$ | $d_{20}$ |
|---|---|---|---|---|---|---|
| A-01 | 2.0940641 | 0.0325844 | 26.090 | 4.2290158 | 2.3935124 | 3.632 |
| A-02 | 1.9168406 | 0.1807255 | 35.662 | 5.4932306 | 0.6123354 | 19.087 |
| A-03 | 1.8970115 | 0.1529573 | 31.182 | 2.4318401 | 0.5958382 | 52.406 |
| A-04 | 1.8805879 | 0.1098415 | 13.577 | 1.7032895 | 0.2751108 | 218.193 |
| A-05 | 1.8778358 | 0.1082679 | 19.930 | 1.8340760 | 0.3677230 | 142.226 |
| A-06 | 1.8663312 | 0.0978132 | 12.232 | 1.6938400 | 0.2288643 | 277.705 |
| A-07 | 1.7888608 | 0.1060865 | 103.503 | 4.4234099 | 0.4526804 | 24.164 |
| A-08 | 1.7735009 | 0.0957437 | 98.181 | 2.0208865 | 0.4158741 | 66.693 |
| A-09 | 1.7175310 | 0.0751352 | 95.409 | 1.6658936 | 0.2054797 | 212.937 |
| A-10 | 1.7199475 | 0.0655065 | 94.621 | 1.6963762 | 0.1762614 | 266.043 |
| A-11 | 1.7156729 | 0.0770168 | 188.315 | 6.9620048 | 3.4231449 | 0.879 |
| A-12 | 1.7043499 | 0.0644952 | 165.315 | 1.6731418 | 0.1899705 | 207.250 |
| A-13 | 1.7082412 | 0.0577629 | 163.169 | 1.7075031 | 0.1626792 | 259.766 |
| A-14 | 1.6926126 | 0.0683906 | 237.184 | 6.7859369 | 2.9992529 | 0.993 |
| A-15 | 1.6890888 | 0.0745003 | 217.718 | 1.7770504 | 0.3401503 | 84.925 |
| A-16 | 1.6903292 | 0.0721915 | 210.963 | 1.7111030 | 0.2426612 | 155.846 |

(continued)

| Case | $n_{10}$ | $k_{10}$ | $d_{10}$ | $n_{20}$ | $k_{20}$ | $d_{20}$ |
|------|----------|----------|----------|----------|----------|----------|
| A-17 | 1.6921355 | 0.0670288 | 207.063 | 1.6978167 | 0.1954345 | 222.387 |
| A-18 | 1.6951475 | 0.0546351 | 219.259 | 1.6889102 | 0.1606659 | 263.728 |
| A-19 | 1.7004017 | 0.0599028 | 265.986 | 1.7029410 | 0.1992607 | 214.965 |

Table3-B

| Case | $n_{10}$ | $k_{10}$ | $d_{10}$ | $n_{20}$ | $k_{20}$ | $d_{20}$ |
|------|----------|----------|----------|----------|----------|----------|
| B-01 | 1.8738578 | 0.2051029 | 37.506 | 6.9151921 | 0.6847654 | 14.288 |
| B-02 | 1.8839217 | 0.1169859 | 20.540 | 1.8488520 | 0.3990514 | 132.865 |
| B-03 | 1.8842367 | 0.1130268 | 14.059 | 1.7087850 | 0.2917115 | 208.377 |
| B-04 | 1.8705650 | 0.1010320 | 12.433 | 1.6946915 | 0.2394813 | 268.610 |
| B-05 | 1.7997475 | 0.1076402 | 101.817 | 5.7702673 | 0.5312541 | 17.283 |
| B-06 | 1.7189014 | 0.0782837 | 95.289 | 1.6643388 | 0.2165956 | 204.139 |
| B-07 | 1.7208712 | 0.0678223 | 94.558 | 1.6960341 | 0.1841027 | 257.386 |
| B-08 | 1.7236639 | 0.0843652 | 181.922 | 5.6387216 | 4.7363270 | 0.821 |
| B-09 | 1.7047019 | 0.0670962 | 165.192 | 1.6715149 | 0.1999125 | 198.564 |
| B-10 | 1.7084293 | 0.0597123 | 163.108 | 1.7074208 | 0.1697699 | 251.199 |
| B-11 | 1.6912240 | 0.0750717 | 235.933 | 5.6089359 | 4.1789938 | 0.921 |
| B-12 | 1.6881032 | 0.0788193 | 218.423 | 1.7881557 | 0.3823123 | 76.059 |
| B-13 | 1.6896993 | 0.0752193 | 211.247 | 1.7110684 | 0.2595743 | 147.061 |
| B-14 | 1.6917374 | 0.0692921 | 207.206 | 1.6970724 | 0.2053429 | 213.576 |
| B-15 | 1.6948846 | 0.0562662 | 219.172 | 1.6877325 | 0.1673191 | 255.276 |
| B-16 | 1.7002883 | 0.0618224 | 266.113 | 1.7025341 | 0.2096252 | 206.193 |
| B-17 | 1.6987256 | 0.0572006 | 264.952 | 1.6934905 | 0.1744162 | 266.771 |

Table3-C

| Case | $n_{10}$ | $k_{10}$ | $d_{10}$ | $n_{20}$ | $k_{20}$ | $d_{20}$ |
|------|----------|----------|----------|----------|----------|----------|
| C-01 | 1.8384852 | 0.2367471 | 38.632 | 4.7928214 | 0.7766058 | 20.034 |
| C-02 | 1.8997218 | 0.1227276 | 21.226 | 1.8945709 | 0.4412749 | 121.762 |
| C-03 | 1.8867733 | 0.1201944 | 14.426 | 1.7066853 | 0.3085187 | 200.277 |
| C-04 | 1.8774399 | 0.1030917 | 12.555 | 1.6978346 | 0.2515853 | 259.495 |
| C-05 | 1.8168537 | 0.1206742 | 98.976 | 5.6725781 | 0.5943855 | 16.950 |
| C-06 | 1.7203847 | 0.0818178 | 95.097 | 1.6625491 | 0.2295920 | 195.706 |
| C-07 | 1.7222308 | 0.0703272 | 94.450 | 1.6972414 | 0.1929579 | 248.789 |
| C-08 | 1.7051744 | 0.0699535 | 164.924 | 1.6707295 | 0.2115581 | 190.095 |
| C-09 | 1.7089344 | 0.0618729 | 162.999 | 1.7091982 | 0.1777196 | 242.642 |
| C-10 | 1.6891179 | 0.0788518 | 211.328 | 1.7121044 | 0.2799946 | 139.125 |
| C-11 | 1.6914863 | 0.0717884 | 207.154 | 1.6970451 | 0.2167627 | 205.768 |
| C-12 | 1.6947006 | 0.0580661 | 219.137 | 1.6875442 | 0.1751428 | 246.865 |
| C-13 | 1.7002933 | 0.0640004 | 266.055 | 1.7022941 | 0.2216801 | 198.139 |
| C-14 | 1.6987290 | 0.0588877 | 264.992 | 1.6933668 | 0.1822428 | 258.415 |

Table3-D

| Case | $n_{10}$ | $k_{10}$ | $d_{10}$ | $n_{20}$ | $k_{20}$ | $d_{20}$ |
|------|----------|----------|----------|----------|----------|----------|
| D-01 | 1.8909619 | 0.2198688 | 30.886 | 2.4457650 | 0.9042920 | 40.480 |
| D-02 | 1.9211597 | 0.1299283 | 20.325 | 1.8999891 | 0.4762728 | 114.977 |

(continued)

| Case | $n_{10}$ | $k_{10}$ | $d_{10}$ | $n_{20}$ | $k_{20}$ | $d_{20}$ |
|---|---|---|---|---|---|---|
| D-03 | 1.8908364 | 0.1293290 | 14.409 | 1.6971949 | 0.3219355 | 192.850 |
| D-04 | 1.8788634 | 0.1089981 | 12.666 | 1.6934061 | 0.2597468 | 251.595 |
| D-05 | 1.7209142 | 0.0850231 | 94.685 | 1.6569532 | 0.2398462 | 187.582 |
| D-06 | 1.7236493 | 0.0725136 | 94.253 | 1.6994520 | 0.2004026 | 239.752 |
| D-07 | 1.7053690 | 0.0723352 | 164.385 | 1.6690598 | 0.2212238 | 181.544 |
| D-08 | 1.7096103 | 0.0638708 | 162.799 | 1.7121782 | 0.1844639 | 233.616 |
| D-09 | 1.6884398 | 0.0822671 | 210.788 | 1.7077650 | 0.2979850 | 132.459 |
| D-10 | 1.6913141 | 0.0737244 | 206.649 | 1.6954335 | 0.2262249 | 199.430 |
| D-11 | 1.6945163 | 0.0596605 | 219.093 | 1.6879518 | 0.1823501 | 237.943 |
| D-12 | 1.7002615 | 0.0658973 | 265.562 | 1.6991117 | 0.2320843 | 190.875 |
| D-13 | 1.6987767 | 0.0602453 | 264.538 | 1.6924357 | 0.1888152 | 250.808 |

Table3-E

| Case | $n_{10}$ | $k_{10}$ | $d_{10}$ | $n_{20}$ | $k_{20}$ | $d_{20}$ |
|---|---|---|---|---|---|---|
| E-01 | 1.9413239 | 0.1405566 | 18.043 | 1.8442891 | 0.4845639 | 113.109 |
| E-02 | 1.8877645 | 0.1445306 | 14.095 | 1.6688638 | 0.3235014 | 187.292 |
| E-03 | 1.8798429 | 0.1135692 | 12.637 | 1.6888514 | 0.2638544 | 243.053 |
| E-04 | 1.7202563 | 0.0870823 | 94.214 | 1.6489031 | 0.2445724 | 179.182 |
| E-05 | 1.7249517 | 0.0739360 | 94.041 | 1.7027050 | 0.2047377 | 229.905 |
| E-06 | 1.7053831 | 0.0736370 | 163.843 | 1.6671854 | 0.2267475 | 172.382 |
| E-07 | 1.7104785 | 0.0654156 | 162.671 | 1.7160090 | 0.1885946 | 223.774 |
| E-08 | 1.6877471 | 0.0844092 | 209.661 | 1.6959640 | 0.3073448 | 127.018 |
| E-09 | 1.6915115 | 0.0739491 | 205.513 | 1.6904122 | 0.2298496 | 196.556 |
| E-10 | 1.6941672 | 0.0608347 | 218.889 | 1.6879018 | 0.1872431 | 228.501 |
| E-11 | 1.6941096 | 0.0560046 | 215.482 | 1.6938988 | 0.1599964 | 287.470 |
| E-12 | 1.7000691 | 0.0669711 | 264.757 | 1.6924460 | 0.2378630 | 184.028 |
| E-13 | 1.6987341 | 0.0608862 | 263.855 | 1.6911373 | 0.1924284 | 243.250 |

Table3-F

| Case | $n_{10}$ | $k_{10}$ | $d_{10}$ | $n_{20}$ | $k_{20}$ | $d_{20}$ |
|---|---|---|---|---|---|---|
| F-01 | 1.8998120 | 0.2622743 | 21.573 | 1.6944131 | 0.7809017 | 53.320 |
| F-02 | 1.9599431 | 0.1538418 | 15.993 | 1.7907917 | 0.4780154 | 111.028 |
| F-03 | 1.8792360 | 0.1119058 | 12.895 | 1.6940206 | 0.2681658 | 231.714 |
| F-04 | 1.8920036 | 0.0671877 | 11.926 | 1.7462722 | 0.2347435 | 280.522 |
| F-05 | 1.7198405 | 0.0878543 | 93.971 | 1.6452515 | 0.2473168 | 169.419 |
| F-06 | 1.7267515 | 0.0746914 | 93.982 | 1.7088385 | 0.2076415 | 218.911 |
| F-07 | 1.7286377 | 0.0697592 | 94.711 | 1.7257237 | 0.1796886 | 273.487 |
| F-08 | 1.7058235 | 0.0740364 | 163.674 | 1.6690540 | 0.2306007 | 161.946 |
| F-09 | 1.6871196 | 0.0856014 | 208.540 | 1.6832134 | 0.3092532 | 121.170 |
| F-10 | 1.6936372 | 0.0616799 | 218.466 | 1.6877720 | 0.1900717 | 218.772 |
| F-11 | 1.6996002 | 0.0674630 | 264.231 | 1.6851097 | 0.2396601 | 175.944 |
| F-12 | 1.6985143 | 0.0611760 | 263.586 | 1.6903246 | 0.1936289 | 234.054 |

Table3-G

| Case | $n_{10}$ | $k_{10}$ | $d_{10}$ | $n_{20}$ | $k_{20}$ | $d_{20}$ |
|------|----------|----------|----------|----------|----------|----------|
| G-01 | 1.8814830 | 0.2936564 | 22.098 | 1.6321609 | 0.8097385 | 46.190 |
| G-02 | 1.9657443 | 0.1688741 | 15.852 | 1.7726563 | 0.4923001 | 103.170 |
| G-03 | 1.8787154 | 0.1109169 | 13.263 | 1.6996278 | 0.2745566 | 220.404 |
| G-04 | 1.8913468 | 0.0695388 | 12.162 | 1.7469121 | 0.2387131 | 270.807 |
| G-05 | 1.7209187 | 0.0883668 | 94.055 | 1.6482914 | 0.2540527 | 158.511 |
| G-06 | 1.7288665 | 0.0756184 | 94.090 | 1.7153723 | 0.2125971 | 207.924 |
| G-07 | 1.7286370 | 0.0709992 | 94.923 | 1.7241262 | 0.1831189 | 263.961 |
| G-08 | 1.7068032 | 0.0744994 | 163.814 | 1.6739446 | 0.2371534 | 151.052 |
| G-09 | 1.6862856 | 0.0878163 | 208.124 | 1.6736237 | 0.3138657 | 112.320 |
| G-10 | 1.6931399 | 0.0624918 | 217.968 | 1.6872372 | 0.1926334 | 209.546 |
| G-11 | 1.6935780 | 0.0575917 | 214.501 | 1.6927449 | 0.1631490 | 269.036 |
| G-12 | 1.6987845 | 0.0682876 | 264.829 | 1.6826884 | 0.2430960 | 164.540 |
| G-13 | 1.6982075 | 0.0620058 | 264.409 | 1.6907687 | 0.1959423 | 222.065 |

Table3-H

| Case | $n_{10}$ | $k_{10}$ | $d_{10}$ | $n_{20}$ | $k_{20}$ | $d_{20}$ |
|------|----------|----------|----------|----------|----------|----------|
| H-01 | 1.8508920 | 0.3299462 | 26.713 | 1.6561984 | 1.0215947 | 31.481 |
| H-02 | 1.9432602 | 0.1828608 | 18.534 | 1.7922587 | 0.5435792 | 89.452 |
| H-03 | 1.8788012 | 0.1571474 | 15.200 | 1.6553949 | 0.3498651 | 157.519 |
| H-04 | 1.8809660 | 0.1122948 | 13.670 | 1.7045069 | 0.2862016 | 210.391 |
| H-05 | 1.8914032 | 0.0691945 | 12.762 | 1.7559855 | 0.2487147 | 259.753 |
| H-06 | 1.7233184 | 0.0905387 | 94.254 | 1.6520214 | 0.2670378 | 148.504 |
| H-07 | 1.7297992 | 0.0774990 | 94.232 | 1.7157415 | 0.2209454 | 198.899 |
| H-08 | 1.7292921 | 0.0722395 | 94.957 | 1.7247476 | 0.1892941 | 254.857 |
| H-09 | 1.7076375 | 0.0765186 | 163.992 | 1.6752795 | 0.2482558 | 141.650 |
| H-10 | 1.6902915 | 0.0790058 | 206.654 | 1.6879680 | 0.2475793 | 161.284 |
| H-11 | 1.6929156 | 0.0637318 | 217.693 | 1.6856131 | 0.1973081 | 201.188 |
| H-12 | 1.6935338 | 0.0581307 | 214.870 | 1.6920922 | 0.1667488 | 259.776 |
| H-13 | 1.6984313 | 0.0697413 | 266.256 | 1.6871666 | 0.2538157 | 152.235 |
| H-14 | 1.6980068 | 0.0633264 | 265.782 | 1.6912942 | 0.2022310 | 210.360 |
| H-15 | 1.6970347 | 0.0530849 | 275.682 | 1.6884244 | 0.1714348 | 256.304 |

Table3-I

| Case | $n_{10}$ | $k_{10}$ | $d_{10}$ | $n_{20}$ | $k_{20}$ | $d_{20}$ |
|------|----------|----------|----------|----------|----------|----------|
| 1-01 | 1.9192397 | 0.1987767 | 21.654 | 1.8264016 | 0.6189774 | 76.882 |
| 1-02 | 1.8910111 | 0.1570861 | 15.844 | 1.6782576 | 0.3828036 | 146.288 |
| I-03 | 1.8874292 | 0.1170062 | 13.907 | 1.7063011 | 0.3024107 | 201.867 |
| 1-04 | 1.8928956 | 0.0800147 | 12.695 | 1.7424852 | 0.2571531 | 254.323 |
| 1-05 | 1.7266669 | 0.0953661 | 94.323 | 1.6542284 | 0.2869718 | 139.595 |
| 1-06 | 1.7296393 | 0.0805906 | 94.242 | 1.7097783 | 0.2319224 | 191.543 |
| 1-07 | 1.7299249 | 0.0737621 | 94.784 | 1.7252153 | 0.1970612 | 246.491 |
| 1-08 | 1.6899362 | 0.0817785 | 208.164 | 1.6924320 | 0.2651701 | 148.618 |
| 1-09 | 1.6928826 | 0.0657282 | 217.665 | 1.6832004 | 0.2055611 | 193.166 |
| I-10 | 1.6935628 | 0.0590519 | 215.464 | 1.6914497 | 0.1728158 | 250.826 |
| I-11 | 1.6988269 | 0.0719884 | 266.949 | 1.6930572 | 0.2717519 | 142.233 |
| I-12 | 1.6981501 | 0.0650380 | 266.102 | 1.6910453 | 0.2123559 | 201.439 |

(continued)

| Case | $n_{10}$ | $k_{10}$ | $d_{10}$ | $n_{20}$ | $k_{20}$ | $d_{20}$ |
|------|----------|----------|----------|----------|----------|----------|
| I-13 | 1.6968464 | 0.0544760 | 275.663 | 1.6860880 | 0.1778694 | 248.323 |

Table3-J

| Case | $n_{10}$ | $k_{10}$ | $d_{10}$ | $n_{20}$ | $k_{20}$ | $d_{20}$ |
|------|----------|----------|----------|----------|----------|----------|
| J-01 | 1.9207610 | 0.2195112 | 22.312 | 1.8258536 | 0.6986358 | 68.737 |
| J-02 | 1.9093240 | 0.1610220 | 16.027 | 1.6981498 | 0.4189775 | 136.163 |
| J-03 | 1.8948938 | 0.1257399 | 13.855 | 1.7003095 | 0.3177305 | 194.613 |
| J-04 | 1.8966282 | 0.0900141 | 12.530 | 1.7305926 | 0.2658040 | 248.346 |
| J-05 | 1.7293323 | 0.0843251 | 93.974 | 1.7018671 | 0.2432029 | 184.391 |
| J-06 | 1.7301568 | 0.0757850 | 94.458 | 1.7237225 | 0.2045935 | 238.500 |
| J-07 | 1.6896128 | 0.0845530 | 207.994 | 1.6930315 | 0.2839311 | 141.193 |
| J-08 | 1.6928686 | 0.0680057 | 217.789 | 1.6806392 | 0.2160083 | 184.741 |
| J-09 | 1.6935394 | 0.0604311 | 215.751 | 1.6908086 | 0.1799717 | 242.024 |
| J-10 | 1.6995193 | 0.0747728 | 266.467 | 1.6953349 | 0.2921202 | 134.479 |
| J-11 | 1.6986281 | 0.0669339 | 265.290 | 1.6902923 | 0.2238725 | 194.429 |
| J-12 | 1.6967467 | 0.0559821 | 275.562 | 1.6844237 | 0.1853984 | 239.846 |

Table3-K

| Case | $n_{10}$ | $k_{10}$ | $d_{10}$ | $n_{20}$ | $k_{20}$ | $d_{20}$ |
|------|----------|----------|----------|----------|----------|----------|
| K-01 | 1.9214172 | 0.1753360 | 15.452 | 1.6804411 | 0.4367098 | 129.893 |
| K-02 | 1.9009993 | 0.1351301 | 13.611 | 1.6899586 | 0.3280314 | 187.370 |
| K-03 | 1.8999222 | 0.0954510 | 12.469 | 1.7262130 | 0.2728992 | 240.318 |
| K-04 | 1.7289797 | 0.0876375 | 93.472 | 1.6943958 | 0.2513033 | 176.630 |
| K-05 | 1.7301397 | 0.0779683 | 94.062 | 1.7208177 | 0.2098777 | 230.281 |
| K-06 | 1.6897075 | 0.0859154 | 206.600 | 1.6860653 | 0.2958058 | 138.770 |
| K-07 | 1.6928599 | 0.0698704 | 218.100 | 1.6784557 | 0.2260347 | 175.355 |
| K-08 | 1.6933895 | 0.0619572 | 215.832 | 1.6904996 | 0.1864736 | 232.785 |
| K-09 | 1.6967442 | 0.0572224 | 275.439 | 1.6838077 | 0.1920294 | 230.401 |

Table3-L

| Case | $n_{10}$ | $k_{10}$ | $d_{10}$ | $n_{20}$ | $k_{20}$ | $d_{20}$ |
|------|----------|----------|----------|----------|----------|----------|
| L-01 | 1.9907624 | 0.2658843 | 16.877 | 1.6777634 | 0.7245088 | 66.041 |
| L-02 | 1.9229056 | 0.1943367 | 14.896 | 1.6435696 | 0.4392836 | 124.711 |
| L-03 | 1.9003143 | 0.1434936 | 13.590 | 1.6791032 | 0.3336019 | 179.139 |
| L-04 | 1.9049048 | 0.0972823 | 12.362 | 1.7269066 | 0.2779612 | 230.763 |
| L-05 | 1.7296380 | 0.0899801 | 93.128 | 1.6935089 | 0.2572784 | 167.093 |
| L-06 | 1.7305285 | 0.0799609 | 93.907 | 1.7196209 | 0.2133806 | 220.978 |
| L-07 | 1.6927568 | 0.0712762 | 218.499 | 1.6781695 | 0.2348207 | 164.929 |
| L-08 | 1.6930586 | 0.0635805 | 215.646 | 1.6903056 | 0.1916344 | 223.237 |
| L-09 | 1.6939267 | 0.0583165 | 213.162 | 1.6934648 | 0.1626221 | 282.414 |
| L-10 | 1.6970265 | 0.0526106 | 273.430 | 1.6908020 | 0.1682270 | 277.869 |

Table3-M

| Case | $n_{10}$ | $k_{10}$ | $d_{10}$ | $n_{20}$ | $k_{20}$ | $d_{20}$ |
|------|----------|----------|----------|----------|----------|----------|
| M-01 | 1.8968086 | 0.1457981 | 14.128 | 1.6815336 | 0.3444919 | 167.613 |
| M-02 | 1.9070303 | 0.0954881 | 12.717 | 1.7369802 | 0.2856144 | 218.968 |
| M-03 | 1.9016797 | 0.0905797 | 10.946 | 1.7110902 | 0.2381911 | 280.601 |
| M-04 | 1.7329805 | 0.0916823 | 93.296 | 1.7056329 | 0.2670261 | 155.076 |
| M-05 | 1.7161015 | 0.0708259 | 94.224 | 1.6780965 | 0.1788543 | 274.399 |
| M-06 | 1.6922053 | 0.0726320 | 218.650 | 1.6800076 | 0.2436881 | 154.426 |
| M-07 | 1.6924923 | 0.0653867 | 214.871 | 1.6897434 | 0.1959626 | 214.392 |
| M-08 | 1.6935584 | 0.0598502 | 212.072 | 1.6927128 | 0.1654173 | 274.211 |
| M-09 | 1.6967916 | 0.0533770 | 273.133 | 1.6904661 | 0.1709158 | 268.389 |

Table3-N

| Case | $n_{10}$ | $k_{10}$ | $d_{10}$ | $n_{20}$ | $k_{20}$ | $d_{20}$ |
|------|----------|----------|----------|----------|----------|----------|
| N-01 | 1.8931613 | 0.1437464 | 15.228 | 1.6981871 | 0.3648670 | 154.635 |
| N-02 | 1.9086798 | 0.0925277 | 13.463 | 1.7547782 | 0.2987738 | 206.696 |
| N-03 | 1.8957546 | 0.1021679 | 11.154 | 1.6965397 | 0.2414267 | 273.752 |
| N-04 | 1.7383088 | 0.0935643 | 93.735 | 1.7255584 | 0.2828024 | 142.972 |
| N-05 | 1.7163304 | 0.0717315 | 94.330 | 1.6763108 | 0.1832109 | 265.207 |
| N-06 | 1.7036586 | 0.0640636 | 161.836 | 1.6842842 | 0.1670348 | 260.021 |
| N-07 | 1.6919166 | 0.0672926 | 213.353 | 1.6889376 | 0.2002175 | 207.074 |
| N-08 | 1.6911838 | 0.0743991 | 218.060 | 1.6805827 | 0.2524809 | 145.761 |
| N-09 | 1.6942185 | 0.0545821 | 211.644 | 1.6930391 | 0.1466022 | 321.654 |
| N-10 | 1.6965335 | 0.0539924 | 273.036 | 1.6894839 | 0.1738185 | 259.712 |

Table 3-O

| Case | $n_{10}$ | $k_{10}$ | $d_{10}$ | $n_{20}$ | $k_{20}$ | $d_{20}$ |
|------|----------|----------|----------|----------|----------|----------|
| O-01 | 1.8962402 | 0.1446868 | 16.058 | 1.7149739 | 0.3909951 | 143.691 |
| O-02 | 1.9162756 | 0.0920008 | 13.917 | 1.7705409 | 0.3160160 | 196.340 |
| O-03 | 1.8972293 | 0.1039493 | 11.503 | 1.6986687 | 0.2516185 | 264.437 |
| O-04 | 1.7171631 | 0.0735355 | 94.241 | 1.6756859 | 0.1901883 | 256.660 |
| O-05 | 1.7039366 | 0.0654419 | 161.496 | 1.6849902 | 0.1728826 | 251.490 |
| O-06 | 1.6903081 | 0.0771344 | 216.305 | 1.6786590 | 0.2613948 | 139.207 |
| O-07 | 1.6915399 | 0.0690906 | 212.338 | 1.6881028 | 0.2062149 | 199.770 |
| O-08 | 1.6931731 | 0.0615887 | 211.917 | 1.6918937 | 0.1729009 | 256.415 |
| O-09 | 1.6963857 | 0.0546855 | 273.170 | 1.6879125 | 0.1780863 | 251.444 |

Table3-P

| Case | $n_{10}$ | $k_{10}$ | $d_{10}$ | $n_{20}$ | $k_{20}$ | $d_{20}$ |
|------|----------|----------|----------|----------|----------|----------|
| P-01 | 1.9078860 | 0.1508452 | 16.208 | 1.7232027 | 0.4201511 | 134.826 |
| P-02 | 1.9270939 | 0.0963716 | 13.863 | 1.7738090 | 0.3331580 | 188.374 |
| P-03 | 1.9009914 | 0.1079582 | 11.657 | 1.6981472 | 0.2622250 | 256.036 |
| P-04 | 1.7182026 | 0.0759211 | 93.910 | 1.6754262 | 0.1979303 | 248.261 |
| P-05 | 1.7037276 | 0.0670447 | 160.452 | 1.6860603 | 0.1785858 | 243.357 |
| P-06 | 1.6914048 | 0.0705280 | 212.904 | 1.6862460 | 0.2142065 | 190.804 |
| P-07 | 1.6932944 | 0.0619823 | 213.027 | 1.6912789 | 0.1784688 | 246.475 |

(continued)

| Case | $n_{10}$ | $k_{10}$ | $d_{10}$ | $n_{20}$ | $k_{20}$ | $d_{20}$ |
|------|----------|----------|----------|----------|----------|----------|
| P-08 | 1.6971949 | 0.0758678 | 268.193 | 1.6840809 | 0.2789945 | 135.240 |
| P-09 | 1.6963748 | 0.0557064 | 273.316 | 1.6860970 | 0.1841499 | 242.973 |

Table3-Q

| Case | $n_{10}$ | $k_{10}$ | $d_{10}$ | $n_{20}$ | $k_{20}$ | $d_{20}$ |
|------|----------|----------|----------|----------|----------|----------|
| Q-01 | 1.9345747 | 0.1082213 | 13.373 | 1.7554016 | 0.3434593 | 183.042 |
| Q-02 | 1.9100928 | 0.1149883 | 11.317 | 1.6916658 | 0.2694423 | 248.707 |
| Q-03 | 1.9218874 | 0.1634556 | 15.608 | 1.7091703 | 0.4402763 | 128.647 |
| Q-04 | 1.7188695 | 0.0782891 | 93.463 | 1.6745648 | 0.2040549 | 239.614 |
| Q-05 | 1.7031385 | 0.0685384 | 159.293 | 1.6866422 | 0.1829170 | 234.977 |
| Q-06 | 1.6934237 | 0.0627890 | 213.592 | 1.6908665 | 0.1844160 | 236.853 |
| Q-07 | 1.6934242 | 0.0627998 | 213.572 | 1.6907829 | 0.1843934 | 236.891 |
| Q-08 | 1.6985617 | 0.0777714 | 264.836 | 1.6854326 | 0.2962369 | 131.733 |
| Q-09 | 1.6963947 | 0.0569261 | 273.344 | 1.6845211 | 0.1907955 | 233.824 |

Table3-R

| Case | $n_{10}$ | $k_{10}$ | $d_{10}$ | $n_{20}$ | $k_{20}$ | $d_{20}$ |
|------|----------|----------|----------|----------|----------|----------|
| R-01 | 1.9329388 | 0.1795701 | 14.789 | 1.6812994 | 0.4483886 | 123.825 |
| R-02 | 1.9368237 | 0.1224596 | 12.921 | 1.7305084 | 0.3477304 | 177.704 |
| R-03 | 1.9141366 | 0.1196035 | 11.206 | 1.6882344 | 0.2744889 | 240.000 |
| R-04 | 1.7191879 | 0.0801581 | 93.133 | 1.6734445 | 0.2077092 | 230.286 |
| R-05 | 1.7029035 | 0.0699625 | 158.805 | 1.6865116 | 0.1862225 | 225.674 |
| R-06 | 1.6933701 | 0.0640425 | 213.864 | 1.6904005 | 0.1898312 | 227.117 |
| R-07 | 1.6939475 | 0.0576888 | 212.435 | 1.6925921 | 0.1618810 | 285.048 |
| R-08 | 1.6969386 | 0.0533290 | 271.986 | 1.6924288 | 0.1673219 | 281.091 |

Table3-S

| Case | $n_{10}$ | $k_{10}$ | $d_{10}$ | $n_{20}$ | $k_{20}$ | $d_{20}$ |
|------|----------|----------|----------|----------|----------|----------|
| S-01 | 1.9315873 | 0.1333486 | 13.169 | 1.7169625 | 0.3552140 | 168.729 |
| S-02 | 1.9153217 | 0.1206110 | 11.351 | 1.6899751 | 0.2797802 | 229.265 |
| S-03 | 1.8972445 | 0.1001874 | 10.604 | 1.6952918 | 0.2334251 | 285.679 |
| S-04 | 1.7198506 | 0.0813984 | 93.215 | 1.6740113 | 0.2110946 | 219.867 |
| S-05 | 1.7209927 | 0.0705203 | 93.408 | 1.6975541 | 0.1793898 | 273.456 |
| S-06 | 1.7035608 | 0.0713918 | 159.462 | 1.6857491 | 0.1901066 | 215.251 |
| S-07 | 1.6916743 | 0.0742011 | 216.137 | 1.6815589 | 0.2413942 | 158.897 |
| S-08 | 1.6930483 | 0.0657083 | 213.861 | 1.6902271 | 0.1951191 | 217.477 |
| S-09 | 1.6936984 | 0.0591625 | 212.273 | 1.6918699 | 0.1652801 | 275.792 |
| S-10 | 1.6968810 | 0.0544417 | 271.786 | 1.6922876 | 0.1708476 | 271.501 |

Table3-T

| Case | $n_{10}$ | $k_{10}$ | $d_{10}$ | $n_{20}$ | $k_{20}$ | $d_{20}$ |
|------|----------|----------|----------|----------|----------|----------|
| T-01 | 1.9249373 | 0.1361664 | 14.155 | 1.7251855 | 0.3723543 | 156.237 |
| T-02 | 1.9134695 | 0.1202777 | 11.822 | 1.6947701 | 0.2878755 | 218.180 |

(continued)

| Case | $n_{10}$ | $k_{10}$ | $d_{10}$ | $n_{20}$ | $k_{20}$ | $d_{20}$ |
|------|----------|----------|----------|----------|----------|----------|
| T-03 | 1.8970797 | 0.0999072 | 10.899 | 1.6978665 | 0.2388400 | 275.054 |
| T-04 | 1.7208445 | 0.0825059 | 93.633 | 1.6746972 | 0.2167421 | 209.700 |
| T-05 | 1.7215107 | 0.0711590 | 93.747 | 1.6977852 | 0.1834377 | 263.540 |
| T-06 | 1.7046380 | 0.0728087 | 160.840 | 1.6842748 | 0.1961079 | 204.946 |
| T-07 | 1.7071945 | 0.0643745 | 160.796 | 1.7036838 | 0.1674255 | 259.158 |
| T-08 | 1.6911424 | 0.0761042 | 216.237 | 1.6835271 | 0.2518702 | 149.208 |
| T-09 | 1.6924731 | 0.0678273 | 212.933 | 1.6899027 | 0.2006809 | 209.434 |
| T-10 | 1.6944113 | 0.0547711 | 211.610 | 1.6931553 | 0.1468072 | 323.528 |
| T-11 | 1.6967389 | 0.0554960 | 271.524 | 1.6919127 | 0.1743507 | 262.739 |

Table4-A

| Case | $n_{10}$ | $k_{10}$ | $d_{10}$ | $n_{20}$ | $k_{20}$ | $d_{20}$ |
|------|----------|----------|----------|----------|----------|----------|
| A-01 | 2.070 | 0.020 | 27.974 | 5.553 | 3.053 | 2.024 |
| A-02 | 1.955 | 0.138 | 34.826 | 9.284 | 0.606 | 10.907 |
| A-03 | 1.895 | 0.133 | 29.218 | 2.177 | 0.543 | 63.407 |
| A-04 | 1.875 | 0.110 | 17.990 | 1.753 | 0.330 | 152.930 |
| A-05 | 1.870 | 0.101 | 13.959 | 1.700 | 0.255 | 218.765 |
| A-06 | 1.867 | 0.070 | 13.235 | 1.732 | 0.221 | 270.745 |
| A-07 | 1.699 | 0.063 | 165.016 | 1.698 | 0.180 | 204.222 |
| A-08 | 1.693 | 0.058 | 157.920 | 1.698 | 0.154 | 265.886 |
| A-09 | 1.692 | 0.069 | 236.756 | 6.942 | 3.076 | 0.950 |
| A-10 | 1.694 | 0.074 | 217.672 | 1.788 | 0.339 | 84.006 |
| A-11 | 1.699 | 0.071 | 210.274 | 1.718 | 0.242 | 154.667 |
| A-12 | 1.698 | 0.065 | 207.280 | 1.695 | 0.194 | 219.490 |
| A-13 | 1.695 | 0.054 | 219.181 | 1.688 | 0.161 | 263.755 |

Table4-B

| Case | $n_{10}$ | $k_{10}$ | $d_{10}$ | $n_{20}$ | $k_{20}$ | $d_{20}$ |
|------|----------|----------|----------|----------|----------|----------|
| B-01 | 1.894 | 0.182 | 37.493 | 9.246 | 0.662 | 10.628 |
| B-02 | 1.881 | 0.116 | 18.625 | 1.766 | 0.358 | 142.939 |
| B-03 | 1.874 | 0.105 | 14.298 | 1.701 | 0.269 | 209.610 |
| B-04 | 1.872 | 0.074 | 13.408 | 1.733 | 0.231 | 261.989 |
| B-05 | 1.693 | 0.060 | 158.097 | 1.697 | 0.160 | 257.142 |
| B-06 | 1.690 | 0.074 | 235.203 | 5.632 | 4.204 | 0.919 |
| B-07 | 1.693 | 0.078 | 218.334 | 1.803 | 0.382 | 74.994 |
| B-08 | 1.699 | 0.074 | 210.503 | 1.719 | 0.259 | 145.797 |
| B-09 | 1.698 | 0.067 | 207.468 | 1.694 | 0.203 | 210.546 |
| B-10 | 1.695 | 0.055 | 219.130 | 1.687 | 0.167 | 255.274 |

Table4-C

| Case | $n_{10}$ | $k_{10}$ | $d_{10}$ | $n_{20}$ | $k_{20}$ | $d_{20}$ |
|------|----------|----------|----------|----------|----------|----------|
| C-01 | 1.855 | 0.222 | 38.795 | 9.554 | 0.714 | 10.003 |
| C-02 | 1.894 | 0.121 | 19.092 | 1.787 | 0.392 | 133.195 |
| C-03 | 1.879 | 0.110 | 14.598 | 1.702 | 0.285 | 201.011 |
| C-04 | 1.879 | 0.076 | 13.458 | 1.736 | 0.242 | 253.439 |

(continued)

| Case | $n_{10}$ | $k_{10}$ | $d_{10}$ | $n_{20}$ | $k_{20}$ | $d_{20}$ |
|------|------|------|---------|------|------|---------|
| C-05 | 1.692 | 0.062 | 158.198 | 1.697 | 0.168 | 248.709 |
| C-06 | 1.699 | 0.078 | 210.437 | 1.720 | 0.280 | 137.855 |
| C-07 | 1.698 | 0.070 | 207.381 | 1.693 | 0.215 | 202.487 |
| C-08 | 1.695 | 0.057 | 219.158 | 1.687 | 0.175 | 246.765 |

Table4-D

| Case | $n_{10}$ | $k_{10}$ | $d_{10}$ | $n_{20}$ | $k_{20}$ | $d_{20}$ |
|------|------|------|---------|------|------|---------|
| D-01 | 1.921 | 0.198 | 29.852 | 2.410 | 0.850 | 42.336 |
| D-02 | 1.907 | 0.132 | 18.597 | 1.779 | 0.418 | 126.566 |
| D-03 | 1.883 | 0.117 | 14.666 | 1.698 | 0.298 | 192.788 |
| D-04 | 1.885 | 0.078 | 13.425 | 1.738 | 0.251 | 244.904 |
| D-05 | 1.692 | 0.064 | 158.019 | 1.697 | 0.174 | 240.368 |
| D-06 | 1.700 | 0.081 | 209.560 | 1.716 | 0.298 | 131.419 |
| D-07 | 1.698 | 0.072 | 206.609 | 1.692 | 0.225 | 195.862 |
| D-08 | 1.695 | 0.059 | 219.174 | 1.688 | 0.183 | 237.750 |
| D-09 | 1.705 | 0.053 | 283.412 | 1.691 | 0.185 | 233.362 |

Table4-E

| Case | $n_{10}$ | $k_{10}$ | $d_{10}$ | $n_{20}$ | $k_{20}$ | $d_{20}$ |
|------|------|------|---------|------|------|---------|
| E-01 | 1.943 | 0.213 | 22.907 | 1.902 | 0.785 | 53.731 |
| E-02 | 1.907 | 0.153 | 17.372 | 1.716 | 0.418 | 124.143 |
| E-03 | 1.884 | 0.123 | 14.585 | 1.691 | 0.305 | 184.536 |
| E-04 | 1.891 | 0.078 | 13.392 | 1.743 | 0.257 | 235.129 |
| E-05 | 1.691 | 0.066 | 157.377 | 1.696 | 0.178 | 232.195 |
| E-06 | 1.699 | 0.072 | 204.994 | 1.688 | 0.231 | 192.230 |
| E-07 | 1.695 | 0.060 | 219.095 | 1.689 | 0.188 | 228.102 |
| E-08 | 1.704 | 0.054 | 283.255 | 1.689 | 0.189 | 224.255 |

Table4-F

| Case | $n_{10}$ | $k_{10}$ | $d_{10}$ | $n_{20}$ | $k_{20}$ | $d_{20}$ |
|------|------|------|---------|------|------|---------|
| F-01 | 1.895 | 0.076 | 13.537 | 1.753 | 0.262 | 223.848 |
| F-02 | 1.882 | 0.126 | 14.752 | 1.688 | 0.309 | 174.672 |
| F-03 | 1.690 | 0.068 | 155.845 | 1.693 | 0.181 | 224.616 |
| F-04 | 1.701 | 0.084 | 206.275 | 1.686 | 0.310 | 122.505 |
| F-05 | 1.693 | 0.070 | 221.382 | 1.667 | 0.231 | 161.928 |
| F-06 | 1.695 | 0.060 | 218.851 | 1.689 | 0.190 | 218.129 |
| F-07 | 1.695 | 0.055 | 215.764 | 1.693 | 0.162 | 277.062 |
| F-08 | 1.703 | 0.049 | 278.302 | 1.691 | 0.159 | 273.241 |

Table4-G

| Case | $n_{10}$ | $k_{10}$ | $d_{10}$ | $n_{20}$ | $k_{20}$ | $d_{20}$ |
|------|------|------|--------|------|------|---------|
| G-01 | 1.881 | 0.189 | 17.242 | 1.617 | 0.409 | 111.921 |
| G-02 | 1.879 | 0.125 | 15.444 | 1.697 | 0.320 | 162.536 |

(continued)

| Case | $n_{10}$ | $k_{10}$ | $d_{10}$ | $n_{20}$ | $k_{20}$ | $d_{20}$ |
|------|------|------|------|------|------|------|
| G-03 | 1.898 | 0.073 | 14.029 | 1.767 | 0.271 | 211.582 |
| G-04 | 1.873 | 0.092 | 12.003 | 1.696 | 0.218 | 280.785 |
| G-05 | 1.715 | 0.067 | 99.925 | 1.686 | 0.167 | 269.056 |
| G-06 | 1.693 | 0.070 | 221.230 | 1.668 | 0.236 | 151.884 |
| G-07 | 1.695 | 0.061 | 218.569 | 1.689 | 0.193 | 208.598 |
| G-08 | 1.695 | 0.055 | 215.552 | 1.692 | 0.164 | 267.637 |

Table4-H

| Case | $n_{10}$ | $k_{10}$ | $d_{10}$ | $n_{20}$ | $k_{20}$ | $d_{20}$ |
|------|------|------|------|------|------|------|
| H-01 | 1.880 | 0.126 | 16.279 | 1.709 | 0.340 | 151.148 |
| H-02 | 1.901 | 0.074 | 14.624 | 1.778 | 0.284 | 201.087 |
| H-03 | 1.874 | 0.095 | 12.218 | 1.694 | 0.225 | 271.916 |
| H-04 | 1.716 | 0.068 | 99.848 | 1.687 | 0.173 | 259.863 |
| H-05 | 1.692 | 0.072 | 220.366 | 1.668 | 0.244 | 143.647 |
| H-06 | 1.695 | 0.062 | 218.447 | 1.688 | 0.198 | 200.044 |
| H-07 | 1.695 | 0.056 | 215.754 | 1.691 | 0.167 | 258.621 |

Table4-I

| Case | $n_{10}$ | $k_{10}$ | $d_{10}$ | $n_{20}$ | $k_{20}$ | $d_{20}$ |
|------|------|------|------|------|------|------|
| I-01 | 1.888 | 0.130 | 16.763 | 1.718 | 0.366 | 141.793 |
| I-02 | 1.903 | 0.081 | 14.911 | 1.775 | 0.299 | 193.492 |
| I-03 | 1.880 | 0.095 | 12.432 | 1.700 | 0.236 | 262.434 |
| I-04 | 1.693 | 0.063 | 156.037 | 1.696 | 0.165 | 252.531 |
| I-05 | 1.695 | 0.064 | 218.418 | 1.685 | 0.207 | 192.031 |
| I-06 | 1.695 | 0.057 | 216.093 | 1.691 | 0.173 | 249.945 |
| I-07 | 1.704 | 0.051 | 278.289 | 1.691 | 0.173 | 246.105 |

Table4-J

| Case | $n_{10}$ | $k_{10}$ | $d_{10}$ | $n_{20}$ | $k_{20}$ | $d_{20}$ |
|------|------|------|------|------|------|------|
| J-01 | 1.902 | 0.140 | 16.621 | 1.717 | 0.393 | 134.110 |
| J-02 | 1.906 | 0.093 | 14.821 | 1.761 | 0.312 | 187.587 |
| J-03 | 1.888 | 0.096 | 12.503 | 1.706 | 0.247 | 253.021 |
| J-04 | 1.694 | 0.066 | 218.392 | 1.682 | 0.217 | 183.765 |
| J-05 | 1.695 | 0.059 | 216.276 | 1.691 | 0.180 | 241.184 |
| J-06 | 1.704 | 0.052 | 278.098 | 1.689 | 0.180 | 237.690 |

Table4-K

| Case | $n_{10}$ | $k_{10}$ | $d_{10}$ | $n_{20}$ | $k_{20}$ | $d_{20}$ |
|------|------|------|------|------|------|------|
| K-01 | 1.915 | 0.153 | 15.972 | 1.700 | 0.410 | 128.035 |
| K-02 | 1.908 | 0.105 | 14.452 | 1.741 | 0.319 | 181.864 |
| K-03 | 1.895 | 0.097 | 12.386 | 1.708 | 0.254 | 244.026 |
| K-04 | 1.692 | 0.060 | 153.833 | 1.696 | 0.152 | 294.292 |
| K-05 | 1.694 | 0.068 | 218.491 | 1.679 | 0.227 | 174.638 |

(continued)

| Case | $n_{10}$ | $k_{10}$ | $d_{10}$ | $n_{20}$ | $k_{20}$ | $d_{20}$ |
|------|------|------|---------|------|------|---------|
| K-06 | 1.695 | 0.060 | 216.291 | 1.691 | 0.187 | 231.949 |
| K-07 | 1.705 | 0.054 | 277.828 | 1.688 | 0.185 | 228.622 |

Table4-L

| Case | $n_{10}$ | $k_{10}$ | $d_{10}$ | $n_{20}$ | $k_{20}$ | $d_{20}$ |
|------|------|------|---------|------|------|---------|
| L-01 | 1.919 | 0.168 | 15.470 | 1.675 | 0.416 | 121.998 |
| L-02 | 1.909 | 0.114 | 14.219 | 1.728 | 0.323 | 174.431 |
| L-03 | 1.897 | 0.102 | 12.252 | 1.703 | 0.257 | 235.332 |
| L-04 | 1.692 | 0.061 | 153.490 | 1.695 | 0.154 | 285.775 |
| L-05 | 1.694 | 0.069 | 218.807 | 1.679 | 0.236 | 164.294 |
| L-06 | 1.695 | 0.061 | 216.166 | 1.690 | 0.192 | 222.296 |
| L-07 | 1.696 | 0.056 | 214.076 | 1.694 | 0.163 | 280.805 |
| L-08 | 1.706 | 0.051 | 276.333 | 1.706 | 0.162 | 273.925 |

Table4-M

| Case | $n_{10}$ | $k_{10}$ | $d_{10}$ | $n_{20}$ | $k_{20}$ | $d_{20}$ |
|------|------|------|---------|------|------|---------|
| M-01 | 1.909 | 0.116 | 14.671 | 1.733 | 0.334 | 163.102 |
| M-02 | 1.895 | 0.106 | 12.483 | 1.700 | 0.261 | 225.249 |
| M-03 | 1.879 | 0.083 | 11.828 | 1.710 | 0.220 | 280.433 |
| M-04 | 1.694 | 0.071 | 219.020 | 1.682 | 0.245 | 153.670 |
| M-05 | 1.695 | 0.063 | 215.746 | 1.690 | 0.197 | 212.983 |
| M-06 | 1.696 | 0.057 | 213.723 | 1.693 | 0.165 | 271.596 |
| M-07 | 1.706 | 0.052 | 276.363 | 1.706 | 0.164 | 264.087 |

Table4-N

| Case | $n_{10}$ | $k_{10}$ | $d_{10}$ | $n_{20}$ | $k_{20}$ | $d_{20}$ |
|------|------|------|---------|------|------|---------|
| N-01 | 1.910 | 0.115 | 15.725 | 1.755 | 0.355 | 150.207 |
| N-02 | 1.892 | 0.109 | 12.960 | 1.698 | 0.268 | 215.505 |
| N-03 | 1.879 | 0.084 | 12.187 | 1.712 | 0.226 | 270.397 |
| N-04 | 1.694 | 0.072 | 218.706 | 1.684 | 0.254 | 144.577 |
| N-05 | 1.694 | 0.064 | 215.091 | 1.689 | 0.201 | 204.614 |
| N-06 | 1.696 | 0.058 | 213.482 | 1.692 | 0.169 | 262.678 |
| N-07 | 1.706 | 0.052 | 276.472 | 1.707 | 0.168 | 254.823 |

Table4-O

| Case | $n_{10}$ | $k_{10}$ | $d_{10}$ | $n_{20}$ | $k_{20}$ | $d_{20}$ |
|------|------|------|---------|------|------|---------|
| O-01 | 1.919 | 0.115 | 16.638 | 1.785 | 0.385 | 138.580 |
| O-02 | 1.893 | 0.113 | 13.413 | 1.697 | 0.281 | 206.656 |
| O-03 | 1.882 | 0.085 | 12.438 | 1.715 | 0.235 | 261.237 |
| O-04 | 1.694 | 0.074 | 217.741 | 1.683 | 0.264 | 137.032 |
| O-05 | 1.694 | 0.065 | 214.737 | 1.687 | 0.207 | 196.488 |
| O-06 | 1.695 | 0.059 | 213.710 | 1.692 | 0.173 | 253.675 |
| O-07 | 1.707 | 0.053 | 276.548 | 1.707 | 0.174 | 246.168 |

Table4-P

| Case | $n_{10}$ | $k_{10}$ | $d_{10}$ | $n_{20}$ | $k_{20}$ | $d_{20}$ |
|------|------|------|------|------|------|------|
| P-01 | 1.937 | 0.118 | 16.771 | 1.806 | 0.418 | 129.251 |
| P-02 | 1.898 | 0.119 | 13.576 | 1.695 | 0.295 | 198.434 |
| P-03 | 1.890 | 0.087 | 12.460 | 1.718 | 0.246 | 252.589 |
| P-04 | 1.694 | 0.077 | 216.630 | 1.679 | 0.277 | 129.875 |
| P-05 | 1.694 | 0.067 | 214.866 | 1.684 | 0.215 | 188.027 |
| P-06 | 1.695 | 0.060 | 214.034 | 1.692 | 0.179 | 244.657 |
| P-07 | 1.707 | 0.054 | 276.376 | 1.707 | 0.181 | 237.806 |

Table4-Q

| Case | $n_{10}$ | $k_{10}$ | $d_{10}$ | $n_{20}$ | $k_{20}$ | $d_{20}$ |
|------|------|------|------|------|------|------|
| Q-01 | 1.958 | 0.128 | 15.815 | 1.794 | 0.439 | 123.830 |
| Q-02 | 1.903 | 0.127 | 13.420 | 1.688 | 0.307 | 190.984 |
| Q-03 | 1.898 | 0.090 | 12.296 | 1.719 | 0.254 | 244.231 |
| Q-04 | 1.694 | 0.080 | 215.821 | 1.668 | 0.290 | 122.663 |
| Q-05 | 1.694 | 0.068 | 215.165 | 1.681 | 0.224 | 179.093 |
| Q-06 | 1.696 | 0.061 | 214.210 | 1.692 | 0.185 | 235.479 |
| Q-07 | 1.707 | 0.056 | 275.996 | 1.705 | 0.187 | 229.352 |

Table4-R

| Case | $n_{10}$ | $k_{10}$ | $d_{10}$ | $n_{20}$ | $k_{20}$ | $d_{20}$ |
|------|------|------|------|------|------|------|
| R-01 | 1.907 | 0.135 | 13.188 | 1.679 | 0.313 | 183.151 |
| R-02 | 1.904 | 0.092 | 12.121 | 1.720 | 0.260 | 235.214 |
| R-03 | 1.694 | 0.070 | 215.718 | 1.679 | 0.233 | 169.072 |
| R-04 | 1.696 | 0.062 | 214.371 | 1.692 | 0.190 | 225.802 |
| R-05 | 1.704 | 0.051 | 274.345 | 1.687 | 0.159 | 280.556 |

Table4-S

| Case | $n_{10}$ | $k_{10}$ | $d_{10}$ | $n_{20}$ | $k_{20}$ | $d_{20}$ |
|------|------|------|------|------|------|------|
| S-01 | 1.908 | 0.140 | 13.288 | 1.676 | 0.321 | 172.696 |
| S-02 | 1.906 | 0.092 | 12.370 | 1.726 | 0.266 | 223.910 |
| S-03 | 1.889 | 0.087 | 11.418 | 1.707 | 0.223 | 283.898 |
| S-04 | 1.693 | 0.071 | 216.427 | 1.681 | 0.243 | 158.126 |
| S-05 | 1.696 | 0.064 | 214.510 | 1.692 | 0.195 | 215.938 |
| S-06 | 1.696 | 0.057 | 213.492 | 1.691 | 0.166 | 273.809 |
| S-07 | 1.704 | 0.052 | 274.677 | 1.687 | 0.162 | 270.432 |

Table4-T

| Case | $n_{10}$ | $k_{10}$ | $d_{10}$ | $n_{20}$ | $k_{20}$ | $d_{20}$ |
|------|------|------|------|------|------|------|
| T-01 | 1.907 | 0.139 | 13.915 | 1.684 | 0.334 | 160.500 |
| T-02 | 1.904 | 0.091 | 13.010 | 1.734 | 0.275 | 212.141 |
| T-03 | 1.887 | 0.088 | 11.752 | 1.707 | 0.227 | 273.737 |
| T-04 | 1.693 | 0.073 | 216.656 | 1.683 | 0.253 | 148.279 |

(continued)

| Case | $n_{10}$ | $k_{10}$ | $d_{10}$ | $n_{20}$ | $k_{20}$ | $d_{20}$ |
|------|------|------|---------|-------|-------|---------|
| T-05 | 1.696 | 0.065 | 214.259 | 1.692 | 0.201 | 206.980 |
| T-06 | 1.696 | 0.058 | 213.637 | 1.690 | 0.169 | 264.528 |
| T-07 | 1.704 | 0.053 | 275.120 | 1.687 | 0.165 | 260.887 |

Table5-A

| Case | $n_{10}$ | $k_{10}$ | $d_{10}$ | $n_{20}$ | $k_{20}$ | $d_{20}$ |
|------|------|------|---------|-------|-------|---------|
| A-01 | 2.047 | 0.012 | 29.751 | 6.274 | 3.305 | 1.566 |
| A-02 | 1.887 | 0.120 | 26.980 | 1.973 | 0.477 | 76.285 |
| A-03 | 1.871 | 0.106 | 17.106 | 1.713 | 0.298 | 158.161 |
| A-04 | 1.868 | 0.075 | 15.339 | 1.738 | 0.245 | 212.612 |
| A-05 | 1.862 | 0.065 | 13.830 | 1.730 | 0.208 | 271.884 |
| A-06 | 1.691 | 0.062 | 161.852 | 1.688 | 0.179 | 207.262 |
| A-07 | 1.692 | 0.057 | 157.460 | 1.697 | 0.154 | 266.043 |
| A-08 | 1.711 | 0.070 | 239.891 | 7.420 | 3.291 | 0.810 |
| A-09 | 1.704 | 0.057 | 226.155 | 1.689 | 0.187 | 202.908 |
| A-10 | 1.705 | 0.050 | 221.451 | 1.695 | 0.158 | 261.182 |
| A-11 | 1.695 | 0.054 | 267.286 | 1.705 | 0.184 | 212.751 |

Table5-B

| Case | $n_{10}$ | $k_{10}$ | $d_{10}$ | $n_{20}$ | $k_{20}$ | $d_{20}$ |
|------|------|------|---------|-------|-------|---------|
| B-01 | 1.943 | 0.121 | 34.905 | 6.149 | 4.965 | 1.046 |
| B-02 | 1.876 | 0.112 | 17.699 | 1.719 | 0.321 | 148.502 |
| B-03 | 1.873 | 0.080 | 15.588 | 1.739 | 0.258 | 203.950 |
| B-04 | 1.866 | 0.068 | 14.042 | 1.732 | 0.217 | 262.757 |
| B-05 | 1.691 | 0.064 | 161.844 | 1.687 | 0.188 | 198.716 |
| B-06 | 1.692 | 0.059 | 157.652 | 1.696 | 0.161 | 257.279 |
| B-07 | 1.706 | 0.052 | 221.303 | 1.695 | 0.165 | 252.591 |
| B-08 | 1.711 | 0.075 | 235.815 | 6.235 | 4.691 | 0.724 |
| B-09 | 1.704 | 0.059 | 225.762 | 1.687 | 0.197 | 194.502 |
| B-10 | 1.695 | 0.056 | 267.452 | 1.705 | 0.194 | 204.028 |

Table5-C

| Case | $n_{10}$ | $k_{10}$ | $d_{10}$ | $n_{20}$ | $k_{20}$ | $d_{20}$ |
|------|------|------|---------|-------|-------|---------|
| C-01 | 1.883 | 0.119 | 18.157 | 1.723 | 0.349 | 139.788 |
| C-02 | 1.879 | 0.084 | 15.746 | 1.741 | 0.274 | 195.542 |
| C-03 | 1.872 | 0.069 | 14.214 | 1.737 | 0.228 | 253.893 |
| C-04 | 1.692 | 0.061 | 157.790 | 1.697 | 0.168 | 248.784 |
| C-05 | 1.705 | 0.061 | 225.478 | 1.687 | 0.209 | 186.105 |
| C-06 | 1.706 | 0.054 | 221.123 | 1.695 | 0.173 | 244.149 |

Table5-D

| Case | $n_{10}$ | $k_{10}$ | $d_{10}$ | $n_{20}$ | $k_{20}$ | $d_{20}$ |
|------|------|------|--------|-------|-------|---------|
| D-01 | 1.890 | 0.130 | 18.083 | 1.714 | 0.371 | 132.495 |

(continued)

| Case | $n_{10}$ | $k_{10}$ | $d_{10}$ | $n_{20}$ | $k_{20}$ | $d_{20}$ |
|------|------|------|--------|-------|-------|---------|
| D-02 | 1.886 | 0.088 | 15.723 | 1.743 | 0.287 | 187.112 |
| D-03 | 1.877 | 0.073 | 14.196 | 1.736 | 0.236 | 245.779 |
| D-04 | 1.692 | 0.062 | 157.690 | 1.697 | 0.175 | 240.328 |
| D-05 | 1.705 | 0.063 | 225.284 | 1.687 | 0.220 | 177.345 |
| D-06 | 1.706 | 0.055 | 220.863 | 1.695 | 0.180 | 235.453 |
| D-07 | 1.695 | 0.055 | 262.917 | 1.705 | 0.178 | 255.408 |

Table5-E

| Case | $n_{10}$ | $k_{10}$ | $d_{10}$ | $n_{20}$ | $k_{20}$ | $d_{20}$ |
|------|------|------|--------|-------|-------|---------|
| E-01 | 1.891 | 0.144 | 17.530 | 1.686 | 0.376 | 126.586 |
| E-02 | 1.892 | 0.091 | 15.545 | 1.744 | 0.296 | 178.253 |
| E-03 | 1.878 | 0.079 | 14.050 | 1.728 | 0.240 | 238.151 |
| E-04 | 1.691 | 0.064 | 157.168 | 1.696 | 0.179 | 231.953 |
| E-05 | 1.705 | 0.064 | 225.395 | 1.686 | 0.227 | 167.881 |
| E-06 | 1.706 | 0.056 | 220.607 | 1.694 | 0.184 | 226.210 |
| E-07 | 1.697 | 0.047 | 278.691 | 1.700 | 0.152 | 281.986 |

Table5-F

| Case | $n_{10}$ | $k_{10}$ | $d_{10}$ | $n_{20}$ | $k_{20}$ | $d_{20}$ |
|------|------|------|--------|-------|-------|---------|
| F-01 | 1.896 | 0.091 | 15.652 | 1.752 | 0.303 | 167.408 |
| F-02 | 1.875 | 0.087 | 14.019 | 1.715 | 0.239 | 230.256 |
| F-03 | 1.705 | 0.064 | 225.606 | 1.687 | 0.232 | 157.678 |
| F-04 | 1.705 | 0.057 | 220.354 | 1.694 | 0.186 | 216.433 |
| F-05 | 1.708 | 0.053 | 218.289 | 1.707 | 0.158 | 272.538 |
| F-06 | 1.697 | 0.047 | 278.413 | 1.701 | 0.154 | 271.867 |

Table5-G

| Case | $n_{10}$ | $k_{10}$ | $d_{10}$ | $n_{20}$ | $k_{20}$ | $d_{20}$ |
|------|------|------|--------|-------|-------|---------|
| G-01 | 1.901 | 0.088 | 16.388 | 1.774 | 0.318 | 154.194 |
| G-02 | 1.871 | 0.093 | 14.267 | 1.706 | 0.241 | 221.319 |
| G-03 | 1.866 | 0.067 | 13.172 | 1.724 | 0.206 | 275.098 |
| G-04 | 1.706 | 0.065 | 225.317 | 1.687 | 0.238 | 147.740 |
| G-05 | 1.705 | 0.057 | 220.112 | 1.694 | 0.188 | 206.685 |
| G-06 | 1.708 | 0.053 | 218.342 | 1.707 | 0.161 | 262.805 |
| G-07 | 1.697 | 0.047 | 278.070 | 1.702 | 0.156 | 262.294 |

Table5-H

| Case | $n_{10}$ | $k_{10}$ | $d_{10}$ | $n_{20}$ | $k_{20}$ | $d_{20}$ |
|------|------|------|--------|-------|-------|---------|
| H-01 | 1.908 | 0.087 | 17.362 | 1.802 | 0.342 | 141.959 |
| H-02 | 1.871 | 0.097 | 14.654 | 1.704 | 0.250 | 212.121 |
| H-03 | 1.869 | 0.067 | 13.479 | 1.729 | 0.214 | 265.153 |
| H-04 | 1.706 | 0.067 | 224.641 | 1.684 | 0.248 | 139.263 |
| H-05 | 1.705 | 0.058 | 220.026 | 1.694 | 0.194 | 197.616 |

(continued)

| Case | $n_{10}$ | $k_{10}$ | $d_{10}$ | $n_{20}$ | $k_{20}$ | $d_{20}$ |
|------|------|------|---------|-------|-------|---------|
| H-06 | 1.708 | 0.054 | 218.429 | 1.707 | 0.165 | 253.768 |
| H-07 | 1.697 | 0.048 | 277.999 | 1.702 | 0.160 | 253.663 |

Table 5-I

| case | $n_{10}$ | $k_{10}$ | $d_{10}$ | $n_{20}$ | $k_{20}$ | $d_{20}$ |
|------|------|------|---------|-------|-------|---------|
| I-01 | 1.918 | 0.092 | 17.977 | 1.822 | 0.371 | 132.466 |
| I-02 | 1.876 | 0.100 | 14.944 | 1.706 | 0.265 | 203.140 |
| I-03 | 1.874 | 0.069 | 13.674 | 1.733 | 0.224 | 256.300 |
| I-04 | 1.706 | 0.060 | 219.996 | 1.694 | 0.203 | 189.146 |
| I-05 | 1.709 | 0.055 | 218.382 | 1.707 | 0.172 | 245.309 |
| I-06 | 1.697 | 0.050 | 278.074 | 1.701 | 0.166 | 245.468 |

Table5-J

| Case | $n_{10}$ | $k_{10}$ | $d_{10}$ | $n_{20}$ | $k_{20}$ | $d_{20}$ |
|------|------|------|---------|-------|-------|---------|
| J-01 | 1.929 | 0.101 | 17.864 | 1.821 | 0.398 | 125.532 |
| J-02 | 1.883 | 0.103 | 14.973 | 1.709 | 0.279 | 194.479 |
| J-03 | 1.880 | 0.071 | 13.709 | 1.736 | 0.234 | 247.823 |
| J-04 | 1.707 | 0.062 | 219.774 | 1.693 | 0.214 | 180.753 |
| J-05 | 1.709 | 0.057 | 218.071 | 1.706 | 0.179 | 237.020 |
| J-06 | 1.697 | 0.047 | 275.083 | 1.700 | 0.148 | 295.680 |

Table5-K

| Case | $n_{10}$ | $k_{10}$ | $d_{10}$ | $n_{20}$ | $k_{20}$ | $d_{20}$ |
|------|------|------|---------|-------|-------|---------|
| K-01 | 1.891 | 0.108 | 14.702 | 1.707 | 0.289 | 186.368 |
| K-02 | 1.885 | 0.074 | 13.594 | 1.735 | 0.241 | 239.426 |
| K-03 | 1.707 | 0.064 | 219.485 | 1.692 | 0.223 | 171.867 |
| K-04 | 1.709 | 0.058 | 217.678 | 1.705 | 0.184 | 228.411 |
| K-05 | 1.697 | 0.048 | 275.043 | 1.701 | 0.152 | 286.426 |

Table5-L

| Case | $n_{10}$ | $k_{10}$ | $d_{10}$ | $n_{20}$ | $k_{20}$ | $d_{20}$ |
|------|------|------|---------|-------|-------|---------|
| L-01 | 1.896 | 0.113 | 14.435 | 1.703 | 0.295 | 177.615 |
| L-02 | 1.887 | 0.078 | 13.577 | 1.733 | 0.244 | 230.253 |
| L-03 | 1.692 | 0.059 | 153.772 | 1.694 | 0.154 | 284.837 |
| L-04 | 1.707 | 0.065 | 219.581 | 1.692 | 0.231 | 161.904 |
| L-05 | 1.709 | 0.059 | 217.561 | 1.702 | 0.188 | 219.131 |
| L-06 | 1.707 | 0.053 | 216.484 | 1.695 | 0.157 | 278.062 |
| L-07 | 1.697 | 0.048 | 274.812 | 1.701 | 0.154 | 276.656 |

Table5-M

| Case | $n_{10}$ | $k_{10}$ | $d_{10}$ | $n_{20}$ | $k_{20}$ | $d_{20}$ |
|------|------|------|--------|------|------|---------|
| M-01 | 1.898 | 0.115 | 14.632 | 1.705 | 0.303 | 166.646 |
| M-02 | 1.885 | 0.081 | 13.917 | 1.732 | 0.248 | 219.851 |
| M-03 | 1.868 | 0.075 | 12.752 | 1.713 | 0.206 | 279.921 |
| M-04 | 1.707 | 0.067 | 219.938 | 1.695 | 0.239 | 151.390 |
| M-05 | 1.708 | 0.060 | 217.756 | 1.701 | 0.192 | 209.457 |
| M-06 | 1.706 | 0.054 | 217.065 | 1.694 | 0.160 | 268.021 |
| M-07 | 1.696 | 0.049 | 274.075 | 1.702 | 0.157 | 267.366 |

Table5-N

| Case | $n_{10}$ | $k_{10}$ | $d_{10}$ | $n_{20}$ | $k_{20}$ | $d_{20}$ |
|------|------|------|--------|------|------|---------|
| N-01 | 1.899 | 0.115 | 15.367 | 1.714 | 0.318 | 155.141 |
| N-02 | 1.882 | 0.083 | 14.477 | 1.732 | 0.256 | 209.893 |
| N-03 | 1.870 | 0.074 | 13.063 | 1.717 | 0.212 | 269.637 |
| N-04 | 1.708 | 0.062 | 217.887 | 1.700 | 0.197 | 200.272 |
| N-05 | 1.707 | 0.055 | 217.378 | 1.693 | 0.164 | 258.646 |
| N-06 | 1.696 | 0.050 | 273.384 | 1.702 | 0.160 | 258.714 |

Table5-O

| Case | $n_{10}$ | $k_{10}$ | $d_{10}$ | $n_{20}$ | $k_{20}$ | $d_{20}$ |
|------|------|------|--------|------|------|---------|
| O-01 | 1.903 | 0.118 | 16.130 | 1.723 | 0.340 | 145.164 |
| O-02 | 1.884 | 0.087 | 14.896 | 1.733 | 0.268 | 201.113 |
| O-03 | 1.874 | 0.075 | 13.357 | 1.722 | 0.221 | 260.240 |
| O-04 | 1.708 | 0.063 | 217.693 | 1.700 | 0.205 | 191.744 |
| O-05 | 1.707 | 0.056 | 217.044 | 1.694 | 0.169 | 250.083 |
| O-06 | 1.696 | 0.051 | 273.493 | 1.702 | 0.165 | 250.180 |

Table5-P

| Case | $n_{10}$ | $k_{10}$ | $d_{10}$ | $n_{20}$ | $k_{20}$ | $d_{20}$ |
|------|------|------|--------|------|------|---------|
| P-01 | 1.913 | 0.125 | 16.406 | 1.727 | 0.366 | 136.777 |
| P-02 | 1.891 | 0.091 | 14.954 | 1.734 | 0.282 | 193.024 |
| P-03 | 1.879 | 0.077 | 13.440 | 1.724 | 0.231 | 251.802 |
| P-04 | 1.709 | 0.064 | 217.197 | 1.700 | 0.214 | 183.446 |
| P-05 | 1.708 | 0.057 | 216.333 | 1.694 | 0.175 | 241.739 |
| P-06 | 1.696 | 0.052 | 274.035 | 1.700 | 0.171 | 241.498 |

Table5-Q

| Case | $n_{10}$ | $k_{10}$ | $d_{10}$ | $n_{20}$ | $k_{20}$ | $d_{20}$ |
|------|------|------|--------|------|------|---------|
| Q-01 | 1.900 | 0.097 | 14.674 | 1.732 | 0.294 | 185.336 |
| Q-02 | 1.885 | 0.082 | 13.311 | 1.722 | 0.239 | 243.911 |
| Q-03 | 1.708 | 0.058 | 215.615 | 1.694 | 0.180 | 233.152 |
| Q-04 | 1.697 | 0.048 | 273.453 | 1.699 | 0.151 | 289.720 |

Table5-R

| Case | $n_{10}$ | $k_{10}$ | $d_{10}$ | $n_{20}$ | $k_{20}$ | $d_{20}$ |
|------|------|------|---------|------|------|---------|
| R-01 | 1.908 | 0.102 | 14.316 | 1.730 | 0.303 | 177.238 |
| R-02 | 1.888 | 0.088 | 13.163 | 1.716 | 0.243 | 235.819 |
| R-03 | 1.708 | 0.059 | 215.377 | 1.693 | 0.185 | 223.802 |
| R-04 | 1.709 | 0.054 | 215.137 | 1.702 | 0.158 | 279.418 |
| R-05 | 1.697 | 0.049 | 273.522 | 1.700 | 0.154 | 279.960 |

Table5-S

| Case | $n_{10}$ | $k_{10}$ | $d_{10}$ | $n_{20}$ | $k_{20}$ | $d_{20}$ |
|------|------|------|---------|------|------|---------|
| S-01 | 1.914 | 0.104 | 14.390 | 1.735 | 0.314 | 166.400 |
| S-02 | 1.886 | 0.093 | 13.299 | 1.710 | 0.247 | 226.131 |
| S-03 | 1.873 | 0.070 | 12.581 | 1.721 | 0.208 | 280.628 |
| S-04 | 1.692 | 0.060 | 152.854 | 1.693 | 0.157 | 278.359 |
| S-05 | 1.708 | 0.060 | 215.913 | 1.692 | 0.189 | 213.567 |
| S-06 | 1.708 | 0.054 | 215.905 | 1.701 | 0.161 | 269.362 |
| S-07 | 1.697 | 0.050 | 273.350 | 1.701 | 0.157 | 270.178 |

Table5-T

| Case | $n_{10}$ | $k_{10}$ | $d_{10}$ | $n_{20}$ | $k_{20}$ | $d_{20}$ |
|------|------|------|---------|------|------|---------|
| T-01 | 1.918 | 0.103 | 15.177 | 1.753 | 0.331 | 153.467 |
| T-02 | 1.883 | 0.095 | 13.742 | 1.708 | 0.252 | 215.835 |
| T-03 | 1.874 | 0.068 | 12.955 | 1.728 | 0.214 | 269.400 |
| T-04 | 1.707 | 0.061 | 216.749 | 1.693 | 0.194 | 203.628 |
| T-05 | 1.708 | 0.055 | 216.874 | 1.699 | 0.165 | 259.716 |
| T-06 | 1.697 | 0.050 | 272.522 | 1.701 | 0.160 | 261.468 |

By using the combinations of values of [$n_{10}$, $n_{20}$, $k_{10}$, $k_{20}$, $d_{10}$, $d_{20}$ with which the minimum reflectance is obtained, it may be possible to control the reflectance to 0.4% or less over the entire incidence angle region corresponding to the numerical aperture NA of a corresponding exposure system with each of the above-described silicon thicknesses. In other words, each of the combinations is effective from the viewpoint that the reflectance is controlled to 0.4% or less even when the numerical aperture NA is smaller than the corresponding numerical aperture NA.

A simulation was also carried out for determining how far one of the six variables in each of the combinations of values of [$n_{10}$, $n_{20}$, $k_{10}$, $k_{20}$, $d_{10}$, $d_{20}$] varies to produce a reflectance over 0.4%, with the other variables being fixed. The obtained permissible variation ranges are shown in Tables 11-A to 11-T (numerical aperture NA: $0.93 \leq NA \leq 1.0$), Table 12-A to 12-T (numerical aperture NA: $1.0 < NA \leq 1.1$), Tables 13-A to 13-T (numerical aperture NA: $1.1 < NA \leq 1.2$), Tables 14-A to 14-T (numerical aperture NA: $1.2 < NA \leq 1.3$), and Tables 15-A to 15-T (numerical aperture NA: $1.3 < NA \leq 1.4$).

In the tables below,

$n_{1-min}$: minimum $n_{10}$ when the reflectance does not exceed 0.4%
$n_{1-max}$: maximum $n_{10}$ when the reflectance does not exceed 0.4%
$k_{1-min}$: minimum $k_{10}$ when the reflectance does not exceed 0.4%
$k_{1-max}$: maximum $k_{10}$ when the reflectance does not exceed 0.4%
$d_{1-min}$: minimum $d_{10}$ when the reflectance does not exceed 0.4%
$d_{1-max}$: maximum $d_{10}$ when the reflectance does not exceed 0.4%
$n_{2-min}$: minimum $n_{20}$ when the reflectance does not exceed 0.4%
$n_{2-max}$: maximum $n_{20}$ when the reflectance does not exceed 0.4%
$k_{2-min}$: minimum $k_{20}$ when the reflectance does not exceed 0.4%

$k_{2-max}$: maximum $k_{20}$ when the reflectance does not exceed 0.4%
$d_{2-min}$: minimum $d_{20}$ when the reflectance does not exceed 0.4%
$d_{2-max}$: maximum $d_{20}$ when the reflectance does not exceed 0.4%

Table11-A

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| A-01 | 2.1640640 | 1.9857913 | 0.1974881 | 0.0196744 | 28.041 | 20.653 | 2.8958371 | 2.4623117 | 1.8020253 | 1.3735951 | 11.601 | 8.280 |
| A-02 | 1.9428363 | 1.7842939 | 0.2426142 | 0.0835896 | 37.757 | 24.186 | 2.3681593 | 1.9966090 | 0.8289455 | 0.4606508 | 73.757 | 50.598 |
| A-03 | 1.9576297 | 1.7850259 | 0.2148133 | 0.0371729 | 28.994 | 14.134 | 1.9707991 | 1.6413265 | 0.5950778 | 0.2809702 | ∞ | 76.872 |
| A-04 | 1.9545833 | 1.7830354 | 0.1828680 | 0.0038055 | 29.564 | 13.280 | 2.0120708 | 1.6792059 | 0.5256718 | 0.2166960 | ∞ | 114.006 |
| A-05 | 1.8469211 | 1.7238950 | 0.1688100 | 0.0370107 | 108.304 | 82.625 | 2.1059290 | 1.8049561 | 0.6364527 | 0.3320741 | 79.125 | 60.047 |
| A-06 | 1.8384570 | 1.7205432 | 0.1633733 | 0.0309270 | 108.455 | 81.217 | 2.0181484 | 1.7172939 | 0.5191778 | 0.2180047 | ∞ | 111.420 |
| A-07 | 1.8252406 | 1.7110450 | 0.1553613 | 0.0234985 | 112.606 | 80.398 | 1.9560961 | 1.6464941 | 0.4693856 | 0.1619942 | ∞ | 125.300 |
| A-08 | 1.8082491 | 1.6888265 | 0.1477492 | 0.0355519 | 204.157 | 153.730 | 2.1755323 | 1.7768299 | 1.0810475 | 0.7328260 | 18.289 | 11.953 |
| A-09 | 1.8055423 | 1.6936649 | 0.1517070 | 0.0331059 | 193.760 | 148.011 | 2.0676879 | 1.7745190 | 0.5567082 | 0.2860417 | 77.890 | 60.591 |
| A-10 | 1.8017615 | 1.6978504 | 0.1479986 | 0.0337115 | 194.207 | 146.995 | 1.9601734 | 1.6709510 | 0.4604288 | 0.1854154 | ∞ | 118.281 |
| A-11 | 1.7922310 | 1.6913081 | 0.1411744 | 0.0297047 | ∞ | 146.144 | 1.9356368 | 1.5999081 | 0.4195133 | 0.1388846 | ∞ | 168.885 |
| A-12 | 1.8116856 | 1.6696922 | 0.1390970 | 0.0202005 | ∞ | 158.277 | 5.5456759 | 4.3725570 | 3.0211006 | 1.9299177 | 2.102 | 1.426 |
| A-13 | 1.7950873 | 1.6802826 | 0.1431143 | 0.0330178 | ∞ | 210.408 | 2.0588196 | 1.7541309 | 0.5131301 | 0.2574941 | 77.434 | 61.414 |
| A-14 | 1.7910600 | 1.6837394 | 0.1390888 | 0.0381952 | ∞ | 210.291 | 1.9243195 | 1.6212543 | 0.4241486 | 0.1638324 | ∞ | 122.979 |
| A-15 | 1.7794892 | 1.6533564 | 0.1361463 | 0.0317518 | ∞ | 149.513 | 1.9509696 | 1.5482450 | 0.3978720 | 0.1252902 | ∞ | 168.040 |

Table11-B

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| B-01 | 1.9765106 | 1.8156232 | 0.2993467 | 0.1383360 | 37.031 | 26.788 | 2.5688133 | 1.9441148 | 2.2528476 | 1.6097141 | 10.412 | 6.699 |
| B-02 | 1.8936015 | 1.7361308 | 0.3006593 | 0.1439186 | 45.853 | 33.452 | 3.6189923 | 3.2095929 | 0.9578557 | 0.5340910 | 32.272 | 28.022 |
| B-03 | 1.9437201 | 1.7857966 | 0.2641850 | 0.1051554 | 38.514 | 26.033 | 2.5360575 | 2.1438358 | 0.9462301 | 0.5462985 | 57.826 | 42.823 |
| B-04 | 1.9109595 | 1.7580896 | 0.2587795 | 0.1040725 | 38.022 | 24.153 | 2.2161888 | 1.8334483 | 0.8900922 | 0.5020930 | ∞ | 50.992 |
| B-05 | 1.9658189 | 1.7964891 | 0.2205139 | 0.0453857 | 28.945 | 15.110 | 2.0010759 | 1.6647868 | 0.6448409 | 0.3145296 | ∞ | 72.956 |
| B-06 | 1.9508455 | 1.7771870 | 0.1996149 | 0.0172626 | 28.632 | 12.711 | 1.9628359 | 1.6302505 | 0.5253835 | 0.2259292 | ∞ | 114.040 |
| B-07 | 1.9889922 | 1.7874455 | 0.1849726 | 0.0000000 | 23.915 | 8.830 | 1.9396544 | 1.6111644 | 0.4484736 | 0.1778157 | ∞ | 129.097 |
| B-08 | 1.8698402 | 1.7525465 | 0.1773355 | 0.0550833 | 105.714 | 87.220 | 2.3473775 | 1.8218453 | 1.8615652 | 1.3148452 | 10.681 | 6.993 |
| B-09 | 1.8708198 | 1.7515339 | 0.1710347 | 0.0426253 | 104.773 | 84.697 | 2.4485002 | 2.1326152 | 0.7462001 | 0.4233925 | 54.972 | 44.997 |
| B-10 | 1.8429563 | 1.7284885 | 0.1660140 | 0.0362166 | 105.755 | 82.025 | 2.0545640 | 1.7455125 | 0.5464477 | 0.2423962 | ∞ | 103.928 |
| B-11 | 1.8273334 | 1.7163238 | 0.1568000 | 0.0275202 | 110.921 | 81.205 | 1.9722282 | 1.6572367 | 0.4915459 | 0.1748967 | ∞ | 155.882 |
| B-12 | 1.8011164 | 1.6891474 | 0.1510638 | 0.0182928 | 120.168 | 78.348 | 1.8986632 | 1.5701231 | 0.4003568 | 0.1335282 | ∞ | 174.053 |
| B-13 | 1.8084407 | 1.6945466 | 0.1511564 | 0.0399344 | 199.413 | 157.378 | 2.9980065 | 2.2331872 | 2.4336783 | 1.7083805 | 5.430 | 3.555 |
| B-14 | 1.8069373 | 1.7006556 | 0.1532768 | 0.0392717 | 189.895 | 149.881 | 2.1605076 | 1.8499131 | 0.6301800 | 0.3373675 | 65.640 | 52.112 |
| B-15 | 1.8020158 | 1.7028825 | 0.1485546 | 0.0386010 | 190.393 | 148.247 | 1.9771516 | 1.6873554 | 0.4840750 | 0.2045352 | 139.021 | 110.784 |
| B-16 | 1.7917073 | 1.6951753 | 0.1410054 | 0.0335775 | ∞ | 147.319 | 1.9455843 | 1.6038399 | 0.4311522 | 0.1490624 | ∞ | 162.629 |
| B-17 | 1.7748680 | 1.6616038 | 0.1397337 | 0.0177061 | ∞ | 78.362 | 1.9013700 | 1.5474955 | 0.3491302 | 0.1192779 | ∞ | 179.261 |
| B-18 | 1.7995571 | 1.6803054 | 0.1418691 | 0.0318679 | ∞ | 219.267 | 3.9031090 | 2.7804552 | 3.1987078 | 2.1965484 | 3.041 | 1.933 |
| B-19 | 1.7944023 | 1.6892021 | 0.1429939 | 0.0388679 | ∞ | 213.520 | 2.1333770 | 1.8090423 | 0.5728584 | 0.3034224 | 66.373 | 53.138 |
| B-20 | 1.7900144 | 1.6912498 | 0.1382895 | 0.0430014 | ∞ | 212.401 | 1.9348689 | 1.6293818 | 0.4376544 | 0.1798382 | ∞ | 116.162 |
| B-21 | 1.7788302 | 1.6597860 | 0.1352760 | 0.0355396 | ∞ | 150.783 | 1.9606195 | 1.5529755 | 0.4050644 | 0.1340756 | ∞ | 162.711 |
| B-22 | 1.7721141 | 1.6339867 | 0.1393037 | 0.0162605 | ∞ | 131.499 | 1.9223909 | 1.5178206 | 0.3273010 | 0.1102026 | ∞ | 178.998 |

Table11-C

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| C-01 | 1.8231731 | 1.6889531 | 0.3374331 | 0.1966774 | 44.591 | 33.970 | 2.3113613 | 1.5131875 | 2.9933496 | 2.1403332 | 8.568 | 5.252 |
| C-02 | 1.8704238 | 1.7221365 | 0.3164098 | 0.1654295 | 45.636 | 34.013 | 3.4694784 | 2.9935165 | 1.1153984 | 0.6124627 | 32.783 | 27.503 |
| C-03 | 1.8897351 | 1.7427735 | 0.2799519 | 0.1287580 | 39.053 | 25.989 | 2.2531582 | 1.8402493 | 0.9982394 | 0.5793026 | ∞ | 46.183 |
| C-04 | 1.9668640 | 1.8039697 | 0.2284362 | 0.0582238 | 29.734 | 16.727 | 2.0534750 | 1.7043490 | 0.7103495 | 0.3545878 | ∞ | 91.228 |
| C-05 | 1.9700505 | 1.7964873 | 0.2004352 | 0.0167243 | 27.390 | 13.045 | 1.9901918 | 1.6549159 | 0.5568746 | 0.2488619 | ∞ | 108.784 |
| C-06 | 1.9889367 | 1.7945592 | 0.1844224 | 0.0000000 | 24.201 | 9.640 | 1.9544538 | 1.6239008 | 0.4686083 | 0.1907165 | ∞ | 125.539 |
| C-07 | 1.8960963 | 1.7964051 | 0.2027126 | 0.0843971 | 95.043 | 82.386 | 1.8930719 | 1.3306048 | 2.0756683 | 1.4587811 | 12.301 | 7.991 |
| C-08 | 1.8798042 | 1.7688191 | 0.1810991 | 0.0566936 | 102.324 | 85.380 | 2.7319807 | 2.3831586 | 0.8737269 | 0.5058423 | 43.841 | 36.695 |
| C-09 | 1.8486490 | 1.7395303 | 0.1694845 | 0.0435666 | 103.473 | 83.035 | 2.1069571 | 1.7916519 | 0.5819143 | 0.2709792 | 126.455 | 95.942 |
| C-10 | 1.8272295 | 1.7203471 | 0.1588071 | 0.0325461 | 108.030 | 81.756 | 1.9781294 | 1.6565767 | 0.5067391 | 0.1879390 | ∞ | 150.786 |
| C-11 | 1.8014602 | 1.7131679 | 0.1630009 | 0.0629313 | 181.579 | 155.142 | 2.2285130 | 1.4846690 | 2.5305195 | 1.8133466 | 7.152 | 4.542 |
| C-12 | 1.8066818 | 1.7096664 | 0.1562671 | 0.0489514 | 184.788 | 151.277 | 2.2616583 | 1.9259051 | 0.7108605 | 0.4005419 | 56.477 | 45.327 |
| C-13 | 1.8013132 | 1.7087644 | 0.1491455 | 0.0453076 | 186.735 | 149.398 | 1.9970170 | 1.6990226 | 0.5049354 | 0.2258400 | 129.169 | 104.943 |
| C-14 | 1.7901840 | 1.6996005 | 0.1402926 | 0.0386361 | 202.803 | 148.613 | 1.9572801 | 1.6068052 | 0.4427851 | 0.1602228 | ∞ | 156.485 |
| C-15 | 1.7888636 | 1.6964637 | 0.1448234 | 0.0511015 | 272.529 | 222.634 | 4.0234980 | 2.5453376 | 4.9343779 | 3.5870341 | 1.854 | 1.171 |
| C-16 | 1.7922839 | 1.6987061 | 0.1428421 | 0.0481961 | ∞ | 215.666 | 2.1852289 | 1.8344195 | 0.6298531 | 0.3553731 | 59.183 | 47.891 |
| C-17 | 1.7880248 | 1.6988170 | 0.1367243 | 0.0500947 | ∞ | 214.345 | 1.9483736 | 1.6341647 | 0.4469301 | 0.1975503 | 135.897 | 110.811 |
| C-18 | 1.7771523 | 1.6659072 | 0.1338236 | 0.0403214 | ∞ | 152.164 | 1.9734293 | 1.5581486 | 0.4118041 | 0.1461254 | ∞ | 157.174 |

197

Table11-D

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| D-01 | 1.8830836 | 1.7450379 | 0.3439324 | 0.1957122 | 41.919 | 32.309 | 3.2738383 | 2.6931938 | 1.3905248 | 0.7652599 | 34.624 | 26.646 |
| D-02 | 1.8894456 | 1.7496568 | 0.3113935 | 0.1623652 | 38.151 | 27.175 | 2.3783942 | 1.9026215 | 1.1913935 | 0.7140034 | ∞ | 38.650 |
| D-03 | 1.9759954 | 1.8236651 | 0.2451292 | 0.0831138 | 33.080 | 21.762 | 2.3455819 | 1.9299789 | 0.8247144 | 0.4185645 | ∞ | 76.091 |
| D-04 | 1.9752561 | 1.8171238 | 0.2392715 | 0.0711709 | 29.642 | 17.776 | 2.1047769 | 1.7365738 | 0.7769713 | 0.3980858 | ∞ | 83.621 |
| D-05 | 1.9566081 | 1.7994560 | 0.2448971 | 0.0778121 | 30.025 | 17.558 | 2.0415795 | 1.6793835 | 0.7460866 | 0.3841615 | ∞ | 85.930 |
| D-06 | 1.9857426 | 1.8133183 | 0.2025784 | 0.0179971 | 26.419 | 13.320 | 2.0120620 | 1.6710122 | 0.5849314 | 0.2699888 | ∞ | 102.487 |
| D-07 | 2.0116008 | 1.8131792 | 0.1836318 | 0.0000000 | 22.601 | 9.497 | 1.9655292 | 1.6338862 | 0.4820573 | 0.2030644 | ∞ | 122.172 |
| D-08 | 1.8608817 | 1.7601212 | 0.1929580 | 0.0733389 | 98.847 | 83.253 | 2.2679467 | 1.8745946 | 0.9047855 | 0.5511698 | 55.349 | 42.174 |
| D-09 | 1.8440660 | 1.7409813 | 0.1747540 | 0.0528949 | 101.494 | 82.953 | 2.0828924 | 1.7400103 | 0.6219074 | 0.2930427 | ∞ | 93.224 |
| D-10 | 1.8255212 | 1.7236487 | 0.1604973 | 0.0385149 | 105.673 | 82.354 | 1.9798220 | 1.6454324 | 0.5164841 | 0.1989646 | ∞ | 143.976 |
| D-11 | 1.7968482 | 1.6917774 | 0.1530963 | 0.0257575 | 114.232 | 79.595 | 1.8993843 | 1.5580000 | 0.4093345 | 0.1476328 | ∞ | 163.096 |
| D-12 | 1.8013651 | 1.7172159 | 0.1603274 | 0.0632058 | 172.074 | 150.204 | 2.1395219 | 1.7587431 | 0.7307801 | 0.4530054 | 57.764 | 44.905 |
| D-13 | 1.7985003 | 1.7134612 | 0.1494702 | 0.0540027 | 182.684 | 149.824 | 1.9978008 | 1.6681646 | 0.5024732 | 0.2441700 | 126.081 | 102.188 |
| D-14 | 1.7870554 | 1.7030564 | 0.1388742 | 0.0447152 | 194.361 | 149.689 | 1.9627277 | 1.5963116 | 0.4437332 | 0.1693082 | ∞ | 149.980 |
| D-15 | 1.7701529 | 1.6661148 | 0.1392675 | 0.0232775 | ∞ | 136.395 | 1.9116010 | 1.5409431 | 0.3522162 | 0.1321796 | ∞ | 167.525 |
| D-16 | 1.7804394 | 1.7273645 | 0.1355612 | 0.0974874 | 236.430 | 223.282 | 4.2192974 | 2.6906610 | 9.9343423 | 7.8844741 | 0.575 | 0.402 |
| D-17 | 1.7877352 | 1.7081588 | 0.1413061 | 0.0629369 | 262.055 | 215.348 | 2.0895557 | 1.7685523 | 0.6334874 | 0.3971031 | 59.549 | 48.398 |
| D-18 | 1.7853294 | 1.7057908 | 0.1336096 | 0.0602063 | ∞ | 215.600 | 1.9530972 | 1.6109988 | 0.4364237 | 0.2120328 | ∞ | 107.664 |
| D-19 | 1.7730937 | 1.6800431 | 0.1318136 | 0.0455306 | ∞ | 206.475 | 1.9842943 | 1.5519103 | 0.4127823 | 0.1614236 | ∞ | 150.626 |
| D-20 | 1.7675878 | 1.6410705 | 0.1387078 | 0.0209832 | ∞ | 138.629 | 1.9336651 | 1.5204424 | 0.3320609 | 0.1218046 | ∞ | 166.659 |

Table 11-E

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| E-01 | 1.87480831 | 1.7393738 | 0.3368671 | 0.1916718 | 34.542 | 24.447 | 2.0181788 | 1.5460267 | 1.1728709 | 0.7418895 | $\infty$ | 38.073 |
| E-02 | 1.9789816 | 1.8230856 | 0.2533923 | 0.0850353 | 28.756 | 17.639 | 2.0891174 | 1.7028088 | 0.7988426 | 0.4234361 | $\infty$ | 75.545 |
| E-03 | 2.0023038 | 1.8297941 | 0.2038717 | 0.0168637 | 25.282 | 13.221 | 2.0277165 | 1.6786747 | 0.6012817 | 0.2843445 | $\infty$ | 94.052 |
| E-04 | 2.0468137 | 1.8446945 | 0.1676424 | 0.0000000 | 20.887 | 9.486 | 2.0073158 | 1.6730946 | 0.5013927 | 0.2164733 | $\infty$ | 116.551 |
| E-05 | 2.0992751 | 1.8446962 | 0.2341211 | 0.0000000 | 16.445 | 6.421 | 1.8864494 | 1.5577361 | 0.4505861 | 0.1973793 | $\infty$ | 122.465 |
| E-06 | 1.8491106 | 1.7507915 | 0.2096178 | 0.0945531 | 93.863 | 80.071 | 1.935034 | 1.5188906 | 0.7893250 | 0.5174866 | 68.488 | 46.386 |
| E-07 | 1.8361972 | 1.7368735 | 0.1813258 | 0.0628651 | 99.367 | 82.092 | 2.0044566 | 1.6351146 | 0.5837677 | 0.2983466 | $\infty$ | 94.158 |
| E-08 | 1.8205420 | 1.7221912 | 0.1627354 | 0.0448936 | 104.538 | 82.385 | 1.9559670 | 1.6053627 | 0.4990396 | 0.2015030 | $\infty$ | 136.472 |
| E-09 | 1.7925661 | 1.6898427 | 0.1538738 | 0.0292620 | 112.287 | 79.640 | 1.8944932 | 1.5420274 | 0.4023134 | 0.1496426 | $\infty$ | 155.476 |
| E-10 | 1.7983926 | 1.7197305 | 0.1671071 | 0.0784414 | 164.305 | 147.121 | 1.9619841 | 1.5854387 | 0.6583400 | 0.4392323 | 63.983 | 48.943 |
| E-11 | 1.7955340 | 1.7158697 | 0.1497842 | 0.0635586 | 179.571 | 149.311 | 2.0007177 | 1.5954870 | 0.4697081 | 0.2495811 | $\infty$ | 101.667 |
| E-12 | 1.7833451 | 1.7048416 | 0.1369505 | 0.0510557 | 189.846 | 150.429 | 1.9612209 | 1.5727870 | 0.4313362 | 0.1724775 | $\infty$ | 142.230 |
| E-13 | 1.7675774 | 1.6666497 | 0.1392333 | 0.0254638 | $\infty$ | 137.661 | 1.9130565 | 1.5320665 | 0.3467037 | 0.1345357 | $\infty$ | 159.605 |
| E-14 | 1.7863651 | 1.7142020 | 0.1395008 | 0.0790479 | 250.434 | 212.771 | 1.9636614 | 1.6583831 | 0.5658537 | 0.3857683 | 63.760 | 51.480 |
| E-15 | 1.7840553 | 1.7114223 | 0.1284575 | 0.0727984 | $\infty$ | 215.754 | 2.0158573 | 1.6922355 | 0.3953694 | 0.2151582 | $\infty$ | 106.269 |
| E-16 | 1.7690598 | 1.6843869 | 0.1297423 | 0.0500450 | $\infty$ | 212.645 | 1.9880870 | 1.5380211 | 0.4067894 | 0.1736986 | $\infty$ | 142.387 |
| E-17 | 1.7654064 | 1.6439501 | 0.1389686 | 0.0226918 | $\infty$ | 139.944 | 1.9381099 | 1.5156709 | 0.3302597 | 0.1238534 | $\infty$ | 177.835 |

Table11-F

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| F-01 | 1.8445498 | 1.7028640 | 0.3433769 | 0.2065410 | 35.166 | 24.465 | 1.8840155 | 1.4588886 | 1.1541143 | 0.7278801 | ∞ | 33.984 |
| F-02 | 1.9748025 | 1.8134890 | 0.2687031 | 0.0967476 | 27.589 | 16.388 | 1.9911676 | 1.6052106 | 0.7575345 | 0.4113980 | ∞ | 75.388 |
| F-03 | 2.0056416 | 1.8240852 | 0.2226912 | 0.0264241 | 23.756 | 11.873 | 1.9568925 | 1.6089457 | 0.5715493 | 0.2748867 | ∞ | 89.427 |
| F-04 | 2.0650838 | 1.8519295 | 0.1772441 | 0.0000000 | 19.476 | 8.682 | 1.9832685 | 1.6466413 | 0.4938946 | 0.2150397 | ∞ | 108.866 |
| F-05 | 2.1015333 | 1.8486964 | 0.2338354 | 0.0000000 | 16.441 | 6.545 | 1.8888145 | 1.5568528 | 0.4544922 | 0.1992566 | ∞ | 112.277 |
| F-06 | 1.8622524 | 1.7567983 | 0.2177349 | 0.1041338 | 90.922 | 78.110 | 1.8710036 | 1.4914735 | 0.8036755 | 0.5151159 | 62.376 | 40.547 |
| F-07 | 1.8361037 | 1.7366067 | 0.1859629 | 0.0693234 | 97.842 | 81.540 | 1.9770779 | 1.5840274 | 0.5667495 | 0.2947696 | ∞ | 89.920 |
| F-08 | 1.8189212 | 1.7220536 | 0.1637893 | 0.0490835 | 103.750 | 82.514 | 1.9475986 | 1.5829197 | 0.4906212 | 0.2005944 | ∞ | 127.512 |
| F-09 | 1.7899842 | 1.6878285 | 0.1542946 | 0.0309962 | 111.559 | 79.477 | 1.8924917 | 1.5312942 | 0.3961812 | 0.1493770 | ∞ | 146.311 |
| F-10 | 1.8004922 | 1.7221231 | 0.1725282 | 0.0852650 | 160.535 | 145.052 | 1.8718671 | 1.5444879 | 0.6488188 | 0.4200688 | 60.551 | 43.890 |
| F-11 | 1.7961652 | 1.7179231 | 0.1500467 | 0.0702567 | 178.047 | 148.974 | 1.9680612 | 1.5533127 | 0.4509038 | 0.2461101 | ∞ | 96.779 |
| F-12 | 1.7667150 | 1.6664697 | 0.1392414 | 0.0262031 | ∞ | 138.061 | 1.9143886 | 1.5273989 | 0.3437564 | 0.1347329 | ∞ | 166.803 |
| F-13 | 1.7813348 | 1.7056878 | 0.1353170 | 0.0551168 | 188.103 | 151.058 | 1.9595373 | 1.5581847 | 0.4254916 | 0.1791232 | ∞ | 133.271 |
| F-14 | 1.7822166 | 1.7169481 | 0.1395756 | 0.0867753 | 246.078 | 210.779 | 1.8944201 | 1.6099890 | 0.5389938 | 0.3617453 | 60.493 | 46.957 |
| F-15 | 1.7851393 | 1.7150563 | 0.1230351 | 0.0833794 | 267.416 | 215.816 | 1.9909918 | 1.7059344 | 0.3550419 | 0.2342728 | ∞ | 101.263 |
| F-16 | 1.7671877 | 1.6858645 | 0.1284573 | 0.0522146 | ∞ | 213.696 | 1.9902944 | 1.5291713 | 0.4050314 | 0.1800814 | ∞ | 132.816 |
| F-17 | 1.7651222 | 1.6451528 | 0.1393025 | 0.0231282 | ∞ | 140.264 | 1.9433160 | 1.5134088 | 0.3296937 | 0.1239332 | ∞ | 172.741 |

Table11-G

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| G-01 | 1.8510344 | 1.7079497 | 0.3629205 | 0.2322015 | 35.649 | 25.461 | 1.9179419 | 1.4877015 | 1.3266012 | 0.8121213 | $\infty$ | 24.910 |
| G-02 | 1.9558961 | 1.7996144 | 0.2741522 | 0.1090704 | 29.623 | 18.109 | 2.0086034 | 1.6054333 | 0.8085387 | 0.4260057 | $\infty$ | 63.805 |
| G-03 | 2.0007807 | 1.8226508 | 0.2254244 | 0.0333809 | 24.374 | 12.458 | 1.9603631 | 1.6072540 | 0.5891826 | 0.2817351 | $\infty$ | 80.107 |
| G-04 | 2.0775306 | 1.8401429 | 0.2290099 | 0.0000000 | 17.643 | 7.220 | 1.8945047 | 1.5593252 | 0.4656915 | 0.2042938 | $\infty$ | 103.866 |
| G-05 | 1.8957386 | 1.7930616 | 0.2284775 | 0.1174850 | 89.439 | 78.698 | 2.0886119 | 1.5366111 | 1.0446792 | 0.6492373 | 42.199 | 24.342 |
| G-06 | 1.8445182 | 1.7463871 | 0.1855165 | 0.0715577 | 97.635 | 82.441 | 2.0389449 | 1.6285494 | 0.6271130 | 0.3140137 | $\infty$ | 76.060 |
| G-07 | 1.8208637 | 1.7249616 | 0.1633948 | 0.0495411 | 103.378 | 83.068 | 1.9667878 | 1.5975080 | 0.5153303 | 0.2065144 | $\infty$ | 120.158 |
| G-08 | 1.7914160 | 1.6890869 | 0.1545438 | 0.0310014 | 111.442 | 79.681 | 1.8956181 | 1.5348893 | 0.4029292 | 0.1524641 | $\infty$ | 137.415 |
| G-09 | 1.8064727 | 1.7324529 | 0.1736747 | 0.0932645 | 159.337 | 146.111 | 1.9712182 | 1.5680749 | 0.7358016 | 0.4694711 | 43.749 | 30.577 |
| G-10 | 1.7976831 | 1.7210876 | 0.1496282 | 0.0723320 | 178.016 | 150.130 | 2.0082485 | 1.5759633 | 0.4835820 | 0.2565849 | $\infty$ | 84.229 |
| G-11 | 1.7676796 | 1.6668971 | 0.1393459 | 0.0260829 | $\infty$ | 138.020 | 1.9186141 | 1.5291365 | 0.3482262 | 0.1370580 | $\infty$ | 155.808 |
| G-12 | 1.7818611 | 1.7063045 | 0.1353393 | 0.0547363 | 188.100 | 151.498 | 1.9748195 | 1.5661855 | 0.4418024 | 0.1833758 | $\infty$ | 124.682 |
| G-13 | 1.7798254 | 1.7226306 | 0.1373611 | 0.0956167 | 228.804 | 212.101 | 1.9246120 | 1.6316017 | 0.5645213 | 0.3855345 | 45.737 | 35.320 |
| G-14 | 1.7828150 | 1.7158448 | 0.1238214 | 0.0839801 | 266.567 | 217.609 | 1.9304083 | 1.7107074 | 0.3806594 | 0.2479153 | $\infty$ | 88.680 |
| G-15 | 1.7683830 | 1.6865935 | 0.1284365 | 0.0520461 | $\infty$ | 214.066 | 2.0034536 | 1.5326101 | 0.4129136 | 0.1829001 | $\infty$ | 124.317 |
| G-16 | 1.7660183 | 1.6445986 | 0.1391357 | 0.0229907 | $\infty$ | 140.172 | 1.9466117 | 1.5142130 | 0.3327484 | 0.1259991 | $\infty$ | 162.119 |

Table11-H

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| H-01 | 1.8348744 | 1.7017860 | 0.3798462 | 0.2808191 | 40.569 | 31.320 | 2.2991869 | 1.6708019 | 1.7969846 | 1.1828110 | 24.492 | 11.798 |
| H-02 | 1.9378552 | 1.7891528 | 0.2803248 | 0.1232521 | 33.039 | 21.589 | 2.1152589 | 1.6836610 | 0.9407294 | 0.4862702 | ∞ | 55.622 |
| H-03 | 1.9816003 | 1.8123315 | 0.2304942 | 0.0484886 | 26.210 | 13.965 | 1.9677635 | 1.6119358 | 0.6263078 | 0.3015312 | ∞ | 76.216 |
| H-04 | 2.0531456 | 1.8330577 | 0.2233118 | 0.0000000 | 19.209 | 8.222 | 1.9045230 | 1.5691056 | 0.4866935 | 0.2170987 | ∞ | 119.528 |
| H-05 | 1.9032381 | 1.8026375 | 0.2332691 | 0.1296546 | 94.176 | 83.950 | 2.5106963 | 1.7240899 | 1.7198847 | 1.0160017 | 18.225 | 9.869 |
| H-06 | 1.8612260 | 1.7637761 | 0.1850318 | 0.0725318 | 98.433 | 84.409 | 2.1736563 | 1.7881949 | 0.7450683 | 0.3750354 | 78.752 | 56.421 |
| H-07 | 1.8282464 | 1.7322039 | 0.1638123 | 0.0491174 | 102.610 | 83.678 | 2.0065197 | 1.6441979 | 0.5671385 | 0.2268590 | ∞ | 111.470 |
| H-08 | 1.7958627 | 1.6943845 | 0.1554022 | 0.0314630 | 110.744 | 80.478 | 1.9018550 | 1.5486836 | 0.4227446 | 0.1616729 | ∞ | 129.994 |
| H-09 | 1.8204382 | 1.7477014 | 0.1733188 | 0.1005906 | 162.626 | 151.084 | 2.2468682 | 1.5775835 | 1.1545804 | 0.7384256 | 20.369 | 11.413 |
| H-10 | 1.8012800 | 1.7248420 | 0.1501327 | 0.0708798 | 170.938 | 152.125 | 2.0151748 | 1.6653676 | 0.5763906 | 0.2963613 | 83.086 | 66.911 |
| H-11 | 1.7851787 | 1.7084953 | 0.1369615 | 0.0539574 | 187.241 | 151.653 | 1.9886751 | 1.5898995 | 0.4693105 | 0.1905971 | ∞ | 116.509 |
| H-12 | 1.7692727 | 1.6693251 | 0.1392713 | 0.0269409 | ∞ | 139.738 | 1.9227537 | 1.5351035 | 0.3603968 | 0.1441040 | ∞ | 173.121 |
| H-13 | 1.7826017 | 1.7298539 | 0.1352886 | 0.1031853 | 230.770 | 217.847 | 2.0789924 | 1.7538251 | 0.8187232 | 0.5751050 | 23.733 | 17.715 |
| H-14 | 1.7835199 | 1.7158807 | 0.1274471 | 0.0787410 | 264.411 | 219.187 | 1.9536996 | 1.5958199 | 0.4569726 | 0.2526929 | 86.365 | 72.843 |
| H-15 | 1.7709992 | 1.6903070 | 0.1287648 | 0.0532839 | ∞ | 215.155 | 2.0153556 | 1.5448258 | 0.4230963 | 0.1875775 | ∞ | 117.185 |
| H-16 | 1.7665771 | 1.6446349 | 0.1382733 | 0.0240191 | ∞ | 140.790 | 1.9481295 | 1.5169100 | 0.3392135 | 0.1321456 | ∞ | 170.934 |

Table11-I

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| I-01 | 1.8010327 | 1.6703051 | 0.3790844 | 0.2860131 | 49.040 | 39.697 | 6.2750068 | 4.0060224 | 6.3084837 | 4.3813279 | 2.011 | 1.105 |
| I-02 | 1.9298895 | 1.7853326 | 0.2927841 | 0.1409628 | 33.486 | 22.674 | 2.1127495 | 1.6827031 | 1.0143560 | 0.5514972 | ∞ | 52.072 |
| I-03 | 1.9897430 | 1.8293451 | 0.2260071 | 0.0543604 | 27.922 | 16.406 | 2.0768797 | 1.7082590 | 0.7280970 | 0.3528321 | ∞ | 86.499 |
| I-04 | 1.9818310 | 1.8176855 | 0.2357004 | 0.0585080 | 26.827 | 15.078 | 1.9901759 | 1.6322669 | 0.6776751 | 0.3358636 | ∞ | 74.175 |
| I-05 | 2.0325692 | 1.8434603 | 0.1884373 | 0.0000000 | 22.396 | 11.017 | 2.0035162 | 1.6644915 | 0.5539257 | 0.2508800 | ∞ | 109.936 |
| I-06 | 2.0503236 | 1.8393702 | 0.2207547 | 0.0000000 | 19.774 | 8.961 | 1.9171324 | 1.5828588 | 0.5124144 | 0.2361131 | ∞ | 116.056 |
| I-07 | 2.0748040 | 1.8271550 | 0.2143905 | 0.0000000 | 17.468 | 6.484 | 1.9053653 | 1.5724832 | 0.4408889 | 0.1848623 | ∞ | 129.507 |
| I-08 | 1.8967501 | 1.7978609 | 0.2321058 | 0.1358900 | 99.873 | 89.276 | 4.7253432 | 3.0478309 | 4.6281749 | 2.8811534 | 3.296 | 1.805 |
| I-09 | 1.8980961 | 1.8025163 | 0.1987565 | 0.0890605 | 98.171 | 86.996 | 2.8922831 | 2.4763163 | 0.9336804 | 0.4984400 | 44.099 | 35.880 |
| I-10 | 1.8353948 | 1.7408879 | 0.1658283 | 0.0523285 | 101.320 | 84.205 | 2.0470219 | 1.6904643 | 0.6008487 | 0.2548880 | ∞ | 103.196I |
| I-11 | 1.7999193 | 1.7010338 | 0.1566929 | 0.0340123 | 109.103 | 81.354 | 1.9088732 | 1.5604748 | 0.4445734 | 0.1750519 | ∞ | 159.368 |
| I-12 | 1.7854499 | 1.6686531 | 0.1595713 | 0.0236692 | 117.512 | 74.034 | 1.8609244 | 1.5175199 | 0.3552154 | 0.1357403 | ∞ | 176.325 |
| I-13 | 1.8244989 | 1.7519220 | 0.1722459 | 0.0986888 | 168.183 | 156.692 | 5.2323444 | 3.4304584 | 4.7853754 | 3.0546576 | 1.899 | 1.115 |
| I-14 | 1.8045445 | 1.7295701 | 0.1511401 | 0.0733300 | 169.665 | 153.355 | 2.1332569 | 1.7780836 | 0.6582710 | 0.3581709 | 67.058 | 53.813 |
| I-15 | 1.7877293 | 1.7127660 | 0.1377613 | 0.0572352 | 185.067 | 151.912 | 1.9754955 | 1.6114989 | 0.4878301 | 0.2114751 | ∞ | 109.119 |
| I-16 | 1.7698545 | 1.6769443 | 0.1389352 | 0.0297641 | ∞ | 142.121 | 1.9212870 | 1.5382413 | 0.3717519 | 0.1547194 | ∞ | 166.932 |
| I-17 | 1.7687629 | 1.6489912 | 0.1464718 | 0.0187435 | ∞ | 124.857 | 1.9093862 | 1.5283218 | 0.3156516 | 0.1239487 | ∞ | 178.253 |
| I-18 | 1.7823383 | 1.7323517 | 0.1360043 | 0.1014499 | 237.517 | 225.014 | 4.8909707 | 3.2979556 | 4.1408226 | 2.8457384 | 1.432 | 0.948 |
| I-19 | 1.7855975 | 1.7187225 | 0.1266313 | 0.0809270 | 261.147 | 219.736 | 2.0323920 | 1.7604730 | 0.5028382 | 0.3025708 | 71.994 | 61.451 |
| I-20 | 1.7723412 | 1.6968651 | 0.1273417 | 0.0587455 | ∞ | 216.538 | 1.9005983 | 1.5558095 | 0.4255322 | 0.2016199 | ∞ | 110.627 |
| I-21 | 1.7658718 | 1.6500332 | 0.1370124 | 0.0266059 | ∞ | 142.074 | 1.9535710 | 1.5188262 | 0.3463206 | 0.1414268 | ∞ | 165.553 |
| I-22 | 1.7705609 | 1.6340802 | 0.1434011 | 0.0161403 | ∞ | 129.746 | 1.9378669 | 1.5210188 | 0.3075256 | 0.1150696 | ∞ | 175.929 |
| I-23 | 1.7800884 | 1.5986944 | 0.1423932 | 0.0152277 | ∞ | 132.671 | 1.9711999 | 1.4724951 | 0.3645229 | 0.1050453 | ∞ | 170.517 |

Table11-J

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| J-01 | 1.9409429 | 1.8021941 | 0.3131894 | 0.1685141 | 32.263 | 22.948 | 2.1266765 | 1.6881902 | 1.1398766 | 0.6573509 | ∞ | 46.952 |
| J-02 | 1.9932822 | 1.8329758 | 0.2432049 | 0.0705755 | 26.396 | 15.656 | 2.0111682 | 1.6483447 | 0.7292981 | 0.3769397 | ∞ | 86.478 |
| J-03 | 2.0278925 | 1.8383637 | 0.2106615 | 0.0048254 | 21.892 | 10.787 | 1.9564959 | 1.6175237 | 0.5535235 | 0.2607610 | ∞ | 108.187 |
| J-04 | 2.0851788 | 1.8312945 | 0.2401716 | 0.0000000 | 16.615 | 6.305 | 1.8770072 | 1.5476420 | 0.4425906 | 0.1917715 | ∞ | 128.340 |
| J-05 | 1.8783297 | 1.7939522 | 0.1960237 | 0.0933894 | 96.880 | 86.306 | 2.5837560 | 2.1571068 | 1.0162369 | 0.5615995 | 48.975 | 38.062 |
| J-06 | 1.8340278 | 1.7448822 | 0.1682003 | 0.0599264 | 99.658 | 84.361 | 2.0380702 | 1.6791847 | 0.6233239 | 0.2810937 | ∞ | 97.676 |
| J-07 | 1.7994764 | 1.7049231 | 0.1581441 | 0.0389876 | 107.073 | 81.918 | 1.9050716 | 1.5552547 | 0.4529885 | 0.1881814 | ∞ | 153.165 |
| J-08 | 1.7846306 | 1.6715154 | 0.1609601 | 0.0274140 | 112.273 | 75.140 | 1.8541601 | 1.5132909 | 0.3609224 | 0.1435457 | ∞ | 170.190 |
| J-09 | 1.7998854 | 1.7353261 | 0.1482564 | 0.0854732 | 166.198 | 153.461 | 2.1593286 | 1.7753687 | 0.6667261 | 0.4228687 | 61.016 | 49.925 |
| J-10 | 1.7863396 | 1.7175981 | 0.1353847 | 0.0659389 | 180.247 | 152.325 | 1.9982564 | 1.6053072 | 0.4773921 | 0.2335628 | ∞ | 109.997 |
| J-11 | 1.7681464 | 1.6819305 | 0.1380740 | 0.0342715 | ∞ | 144.598 | 1.9216978 | 1.5338499 | 0.3746436 | 0.1661414 | ∞ | 160.089 |
| J-12 | 1.7669198 | 1.6515622 | 0.1463713 | 0.0216239 | ∞ | 129.299 | 1.9100226 | 1.5252131 | 0.3191776 | 0.1309355 | ∞ | 172.105 |
| J-13 | 1.7707165 | 1.7040051 | 0.1220832 | 0.0695282 | ∞ | 217.819 | 1.9376772 | 1.5483132 | 0.4043358 | 0.2333336 | ∞ | 104.539 |
| J-14 | 1.7634269 | 1.6553617 | 0.1358159 | 0.0303533 | ∞ | 189.521 | 1.9623054 | 1.5145784 | 0.3489988 | 0.1513852 | ∞ | 158.729 |
| J-15 | 1.7680585 | 1.6373835 | 0.1429634 | 0.0185884 | ∞ | 132.956 | 1.9433515 | 1.5188691 | 0.3114371 | 0.1213260 | ∞ | 169.651 |

EP 1 760 766 A2

Table11-K

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| K-01 | 1.9707785 | 1.8360788 | 0.3425950 | 0.2023887 | 27.715 | 20.125 | 1.9329888 | 1.5140813 | 1.1219560 | 0.7176091 | $\infty$ | 45.573 |
| K-02 | 2.0196477 | 1.8536052 | 0.2639073 | 0.0831004 | 23.306 | 13.914 | 1.9357511 | 1.5767961 | 0.7075294 | 0.3937403 | $\infty$ | 72.232 |
| K-03 | 2.0645663 | 1.8585909 | 0.2374446 | 0.0112678 | 18.917 | 9.310 | 1.9031629 | 1.5653077 | 0.5390913 | 0.2670820 | $\infty$ | 104.858 |
| K-04 | 2.0786207 | 1.8320900 | 0.2457404 | 0.0000000 | 16.773 | 6.617 | 1.8708739 | 1.5393529 | 0.4503117 | 0.1999821 | $\infty$ | 123.607 |
| K-05 | 1.8425452 | 1.7719593 | 0.1968678 | 0.1116248 | 92.844 | 83.802 | 1.9910461 | 1.5793420 | 0.7893473 | 0.5451810 | 78.485 | 48.751 |
| K-06 | 1.8250707 | 1.7437914 | 0.1698075 | 0.0718228 | 97.605 | 84.143 | 1.9741547 | 1.6009187 | 0.5756118 | 0.2952627 | $\infty$ | 99.488 |
| K-07 | 1.7937600 | 1.7041262 | 0.1595997 | 0.0451600 | 104.545 | 82.071 | 1.8857969 | 1.5266501 | 0.4416537 | 0.1958456 | $\infty$ | 144.226 |
| K-08 | 1.7828027 | 1.6711987 | 0.1628300 | 0.0313846 | 109.589 | 75.289 | 1.8295758 | 1.5032806 | 0.3608888 | 0.1486305 | $\infty$ | 162.042 |
| K-09 | 1.7810699 | 1.7216656 | 0.1268030 | 0.0823438 | 175.807 | 152.735 | 1.9768505 | 1.5572423 | 0.4221615 | 0.2566463 | $\infty$ | 112.257 |
| K-10 | 1.7642217 | 1.6821282 | 0.1373190 | 0.0383688 | 182.940 | 144.697 | 1.9234068 | 1.5160325 | 0.3659687 | 0.1739655 | $\infty$ | 152.160 |
| K-11 | 1.7649885 | 1.6533259 | 0.1472226 | 0.0245664 | $\infty$ | 131.728 | 1.7830963 | 1.5179791 | 0.3193676 | 0.1355785 | $\infty$ | 163.972 |
| K-12 | 1.7600028 | 1.6605350 | 0.1355277 | 0.0346940 | $\infty$ | 198.719 | 1.9669273 | 1.5020323 | 0.3468141 | 0.1582667 | $\infty$ | 150.027 |
| K-13 | 1.7652786 | 1.6418728 | 0.1432970 | 0.0211204 | $\infty$ | 135.362 | 1.9519198 | 1.5131027 | 0.3139043 | 0.1253960 | $\infty$ | 161.156 |

Table11-L

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| L-01 | 1.9805757 | 1.8427363 | 0.3773193 | 0.2296740 | 24.766 | 18.143 | 1.7617713 | 1.4040247 | 1.0059180 | 0.6941285 | ∞ | 44.977 |
| L-02 | 2.0582393 | 1.8830904 | 0.2806928 | 0.0880549 | 20.473 | 12.463 | 1.8985725 | 1.5339046 | 0.6916574 | 0.4025791 | ∞ | 75.356 |
| L-03 | 2.1015526 | 1.8843029 | 0.2490971 | 0.0097038 | 17.008 | 8.572 | 1.8899397 | 1.5484993 | 0.5369665 | 0.2720763 | ∞ | 99.033 |
| L-04 | 2.0306052 | 1.7992233 | 0.2679772 | 0.0204784 | 18.280 | 7.154 | 1.8310388 | 1.5036438 | 0.4411974 | 0.15356323 | ∞ | 118.483 |
| L-05 | 1.8338888 | 1.7723544 | 0.2044936 | 0.1383034 | 88.945 | 81.835 | 1.8276199 | 1.5002786 | 0.6676941 | 0.5063342 | 80.329 | 54.435 |
| L-06 | 1.8206102 | 1.7454442 | 0.1694749 | 0.0862511 | 95.473 | 84.029 | 1.9314879 | 1.5235777 | 0.5240986 | 0.2952742 | ∞ | 103.032 |
| L-07 | 1.7877872 | 1.7013333 | 0.1602300 | 0.0516668 | 102.853 | 81.969 | 1.8638369 | 1.4967507 | 0.4266791 | 0.1970013 | ∞ | 116.786 |
| L-08 | 1.7818580 | 1.6686304 | 0.1646693 | 0.0341982 | 107.829 | 74.760 | 1.7745154 | 1.4951867 | 0.3600673 | 0.1503127 | ∞ | 151.233 |
| L-09 | 1.7605496 | 1.6803665 | 0.1370589 | 0.0427461 | 177.108 | 144.718 | 1.7126080 | 1.4998919 | 0.3597939 | 0.1765700 | ∞ | 142.669 |
| L-10 | 1.7645893 | 1.6563972 | 0.1488224 | 0.0265689 | ∞ | 133.224 | 1.7659346 | 1.5128389 | 0.3206823 | 0.1370177 | ∞ | 153.192 |
| L-11 | 1.7580624 | 1.6651535 | 0.1365795 | 0.0383336 | ∞ | 201.534 | 1.7451455 | 1.4912014 | 0.3491875 | 0.1604448 | ∞ | 139.349 |
| L-12 | 1.7646827 | 1.6459120 | 0.1442677 | 0.0227735 | ∞ | 136.956 | 1.8231992 | 1.5094394 | 0.3175857 | 0.1264736 | ∞ | 150.082 |

206

Table11-M

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| M-01 | 1.9656620 | 1.8272452 | 0.4002190 | 0.2589422 | 24.403 | 18.176 | 1.6618614 | 1.3463829 | 0.9953093 | 0.6931023 | ∞ | 44.440 |
| M-02 | 2.0805818 | 1.9019600 | 0.2933600 | 0.0973432 | 19.349 | 12.113 | 1.8909403 | 1.5093131 | 0.6985739 | 0.4106662 | ∞ | 78.214 |
| M-03 | 2.1240686 | 1.9025366 | 0.2580161 | 0.0146042 | 16.072 | 8.378 | 1.8829834 | 1.5341772 | 0.5432075 | 0.2767952 | ∞ | 97.972 |
| M-04 | 2.0463656 | 1.8091195 | 0.2704872 | 0.0198024 | 17.616 | 6.990 | 1.8298176 | 1.5065070 | 0.4483924 | 0.2003870 | ∞ | 113.241 |
| M-05 | 1.8346221 | 1.7814641 | 0.2172051 | 0.1623528 | 85.845 | 80.029 | 1.7057113 | 1.4982260 | 0.6335216 | 0.4823449 | 74.094 | 52.226 |
| M-06 | 1.8157041 | 1.7513682 | 0.1669795 | 0.1013813 | 93.932 | 84.386 | 1.9287032 | 1.4845723 | 0.5001755 | 0.2953684 | ∞ | 100.444 |
| M-07 | 1.7849537 | 1.6995924 | 0.1596969 | 0.0551962 | 102.261 | 81.938 | 1.7495426 | 1.4857755 | 0.4263613 | 0.1988052 | ∞ | 130.009 |
| M-08 | 1.7830385 | 1.6675295 | 0.1656893 | 0.0348934 | 107.536 | 74.493 | 1.7604124 | 1.4953428 | 0.3646225 | 0.1519004 | ∞ | 141.305 |
| M-09 | 1.7593389 | 1.6811590 | 0.1373458 | 0.0445858 | 176.094 | 145.009 | 1.6975009 | 1.4959323 | 0.3653363 | 0.1785089 | ∞ | 133.949 |
| M-10 | 1.7660292 | 1.6580873 | 0.1500408 | 0.0267950 | ∞ | 133.655 | 1.7664113 | 1.5149782 | 0.3268824 | 0.1382789 | ∞ | 178.785 |
| M-11 | 1.7581881 | 1.6675241 | 0.1380347 | 0.0395508 | ∞ | 202.677 | 1.7376177 | 1.4911956 | 0.3595090 | 0.1618748 | ∞ | 130.155 |
| M-12 | 1.7661501 | 1.6473109 | 0.1451137 | 0.0228029 | ∞ | 137.385 | 1.8164479 | 1.5119594 | 0.3236023 | 0.1274389 | ∞ | 181.924 |

Table 11-N

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| N-01 | 1.9308929 | 1.7942376 | 0.4248943 | 0.3114263 | 27.599 | 21.187 | 1.6733044 | 1.3254125 | 1.2150047 | 0.8122935 | ∞ | 33.320 |
| N-02 | 2.0668469 | 1.9023462 | 0.2944815 | 0.1170071 | 21.058 | 13.856 | 1.9424197 | 1.5287271 | 0.7816085 | 0.4525081 | ∞ | 73.527 |
| N-03 | 2.0815755 | 1.8822127 | 0.2572651 | 0.0377485 | 18.101 | 9.759 | 1.8880509 | 1.5306180 | 0.5717414 | 0.2897138 | ∞ | 90.028 |
| N-04 | 2.0331581 | 1.8054116 | 0.2662567 | 0.0253034 | 18.433 | 7.508 | 1.8297667 | 1.5048766 | 0.4584284 | 0.2062971 | ∞ | 119.932 |
| N-05 | 1.8648227 | 1.8113608 | 0.2337820 | 0.1808352 | 84.337 | 79.289 | 1.7715072 | 1.5007687 | 0.7638684 | 0.5670385 | 58.513 | 38.960 |
| N-06 | 1.8226386 | 1.7585272 | 0.1669851 | 0.1079995 | 94.451 | 85.625 | 1.9890062 | 1.5134605 | 0.5625304 | 0.3165392 | ∞ | 88.401 |
| N-07 | 1.7860045 | 1.7014415 | 0.1599748 | 0.0556450 | 102.201 | 82.327 | 1.7373881 | 1.4915665 | 0.4418842 | 0.2070014 | ∞ | 125.640 |
| N-08 | 1.7844901 | 1.6689970 | 0.1656189 | 0.0350000 | 107.593 | 74.953 | 1.7619897 | 1.5010412 | 0.3737899 | 0.1569772 | ∞ | 134.829 |
| N-09 | 1.7601791 | 1.6820529 | 0.1372717 | 0.0442944 | 176.678 | 145.537 | 1.6980791 | 1.5006390 | 0.3771531 | 0.1853343 | ∞ | 127.521 |
| N-10 | 1.7669520 | 1.6576990 | 0.1499045 | 0.0265976 | ∞ | 133.759 | 1.7681577 | 1.5197385 | 0.3340591 | 0.1427591 | ∞ | 172.727 |
| N-11 | 1.7594305 | 1.6674640 | 0.1377797 | 0.0390528 | ∞ | 202.284 | 1.7367775 | 1.4946242 | 0.3688872 | 0.11386918 | ∞ | 124.146 |
| N-12 | 1.7672862 | 1.6458103 | 0.1449746 | 0.0224892 | ∞ | 136.963 | 1.8168346 | 1.5177282 | 0.3290477 | 0.1317503 | ∞ | 173.664 |

Table11-O

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| O-01 | 1.8983129 | 1.7713829 | 0.4492907 | 0.3728197 | 32.695 | 26.370 | 1.8885821 | 1.4076568 | 1.7362366 | 1.2101672 | ∞ | 19.131 |
| O-02 | 2.0221369 | 1.8742366 | 0.2986525 | 0.1428175 | 25.315 | 17.418 | 2.0282026 | 1.5883796 | 0.9417727 | 0.5259305 | ∞ | 58.081 |
| O-03 | 2.0538982 | 1.8739141 | 0.2424013 | 0.0480312 | 20.577 | 11.685 | 1.9364611 | 1.5761180 | 0.6315251 | 0.3225835 | ∞ | 77.301 |
| O-04 | 2.0458191 | 1.8670105 | 0.2458201 | 0.0517698 | 20.811 | 11.767 | 1.9264805 | 1.5663584 | 0.6264832 | 0.3193835 | ∞ | 77.707 |
| O-05 | 2.0385649 | 1.8193877 | 0.2557128 | 0.0219835 | 18.714 | 8.116 | 1.8502574 | 1.5146080 | 0.4821269 | 0.2224065 | ∞ | 120.462 |
| O-06 | 1.9309938 | 1.8673549 | 0.2538005 | 0.1883086 | 85.306 | 80.356 | 2.1784360 | 1.3777316 | 1.3849754 | 0.9787327 | 25.718 | 18.689 |
| O-07 | 1.8360843 | 1.7689224 | 0.1740671 | 0.1038864 | 95.456 | 86.511 | 2.0629243 | 1.6089888 | 0.7196957 | 0.3755124 | 90.240 | 70.528 |
| O-08 | 1.7914404 | 1.7087781 | 0.1617681 | 0.0561273 | 102.053 | 83.173 | 1.7728850 | 1.5080181 | 0.4712700 | 0.2252849 | ∞ | 119.073 |
| O-09 | 1.7855461 | 1.6753276 | 0.1657039 | 0.0365901 | 106.634 | 76.325 | 1.7686520 | 1.5043380 | 0.3845023 | 0.1665592 | ∞ | 130.226 |
| O-10 | 1.7619954 | 1.6853206 | 0.1364735 | 0.0449452 | 176.477 | 146.293 | 1.7037330 | 1.5063136 | 0.3897179 | 0.1998033 | ∞ | 121.636 |
| O-11 | 1.7666212 | 1.6586696 | 0.1483575 | 0.0277643 | ∞ | 134.971 | 1.7675592 | 1.5223065 | 0.3404988 | 0.1513643 | ∞ | 169.458 |
| O-12 | 1.7600214 | 1.6674457 | 0.1353724 | 0.0398598 | ∞ | 203.372 | 1.7336096 | 1.4983350 | 0.3728491 | 0.1810864 | ∞ | 119.091 |
| O-13 | 1.7666902 | 1.6441133 | 0.1435628 | 0.0234603 | ∞ | 137.297 | 1.8174968 | 1.5205437 | 0.3331058 | 0.1396793 | ∞ | 166.065 |

Table 11-P

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| P-01 | 1.8780527 | 1.7841892 | 0.4704720 | 0.4258296 | 39.871 | 36.131 | 3.8374192 | 2.5149643 | 3.8845138 | 3.1011910 | 7.792 | 4.175 |
| P-02 | 2.0045937 | 1.8646596 | 0.3133681 | 0.1698146 | 26.845 | 19.161 | 2.0314015 | 1.6016212 | 1.0660721 | 0.6113773 | ∞ | 52.667 |
| P-03 | 2.0530202 | 1.8803103 | 0.2440748 | 0.0596583 | 21.347 | 12.660 | 1.9574412 | 1.6006931 | 0.6823172 | 0.3617691 | ∞ | 76.147 |
| P-04 | 2.0429780 | 1.8714704 | 0.2483473 | 0.0641517 | 21.618 | 12.745 | 1.9428026 | 1.5864366 | 0.6742389 | 0.3569916 | ∞ | 76.533 |
| P-05 | 2.0522715 | 1.8338352 | 0.2644862 | 0.0276844 | 18.107 | 8.267 | 1.8450555 | 1.5106780 | 0.4971090 | 0.2379952 | ∞ | 116.633 |
| P-06 | 1.9201515 | 1.8546107 | 0.2638968 | 0.2103323 | 92.949 | 87.333 | 3.5726732 | 2.1819396 | 3.6524152 | 2.4498639 | 6.687 | 3.716 |
| P-07 | 1.8500584 | 1.7844224 | 0.1803688 | 0.1065614 | 95.088 | 86.922 | 2.1410667 | 1.7465989 | 0.8707351 | 0.4728347 | 70.310 | 54.362 |
| P-08 | 1.7977896 | 1.7189041 | 0.1636820 | 0.0609733 | 100.778 | 83.843 | 1.8102211 | 1.5260463 | 0.5022919 | 0.2523298 | ∞ | 111.159 |
| P-09 | 1.7862279 | 1.6830174 | 0.1662284 | 0.0400981 | 104.776 | 77.979 | 1.7748938 | 1.5040454 | 0.3960924 | 0.1795690 | ∞ | 158.982 |
| P-10 | 1.7629458 | 1.6959903 | 0.1345482 | 0.0519274 | 174.320 | 148.790 | 1.7045759 | 1.5095881 | 0.3975003 | 0.2207376 | ∞ | 114.980 |
| P-11 | 1.7650921 | 1.6619781 | 0.1465604 | 0.0306449 | ∞ | 136.303 | 1.7644259 | 1.5196188 | 0.3454133 | 0.1625972 | ∞ | 163.210 |
| P-12 | 1.7590465 | 1.6699937 | 0.1316590 | 0.0452796 | ∞ | 205.144 | 1.7266293 | 1.4939047 | 0.3731671 | 0.1985602 | ∞ | 113.183 |
| P-13 | 1.7642216 | 1.6473356 | 0.1416339 | 0.0260138 | ∞ | 138.871 | 1.8208547 | 1.5182326 | 0.3359797 | 0.1495551 | ∞ | 160.163 |
| P-14 | 1.7737928 | 1.6371509 | 0.1427687 | 0.0166726 | ∞ | 129.351 | 1.8670261 | 1.5337143 | 0.3141753 | 0.1193498 | ∞ | 167.687 |

Table11-Q

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| Q-01 | 2.0674276 | 1.8952498 | 0.2578761 | 0.0732289 | 20.370 | 12.412 | 1.9301091 | 1.5792363 | 0.6972600 | 0.3912321 | $\infty$ | 72.205 |
| Q-02 | 2.0605471 | 1.8471975 | 0.2662409 | 0.0327302 | 17.849 | 8.584 | 1.8468736 | 1.5141404 | 0.5153586 | 0.2562131 | $\infty$ | 109.642 |
| Q-03 | 2.0481271 | 1.8055599 | 0.2587648 | 0.0000000 | 17.756 | 6.646 | 1.8423927 | 1.5198133 | 0.4376143 | 0.1939864 | $\infty$ | 127.076 |
| Q-04 | 1.8352950 | 1.7806551 | 0.1760792 | 0.1243874 | 92.494 | 85.916 | 1.8765331 | 1.6017833 | 0.7228468 | 0.5239454 | $\infty$ | 55.977 |
| Q-05 | 1.7969652 | 1.7245018 | 0.1655054 | 0.0710804 | 98.269 | 83.892 | 1.7758132 | 1.5039943 | 0.4974848 | 0.2749519 | $\infty$ | 104.163 |
| Q-06 | 1.7846203 | 1.6873547 | 0.1679367 | 0.0455271 | 102.537 | 78.800 | 1.7616062 | 1.4917039 | 0.3987387 | 0.1907248 | $\infty$ | 120.624 |
| Q-07 | 1.7874820 | 1.6732889 | 0.1648541 | 0.0281745 | 110.048 | 75.133 | 1.7961257 | 1.5163711 | 0.3613314 | 0.1498031 | $\infty$ | 162.278 |
| Q-08 | 1.7599794 | 1.7028432 | 0.1308972 | 0.0639246 | 169.831 | 149.777 | 1.6725316 | 1.4900523 | 0.3850189 | 0.2400043 | $\infty$ | 108.348 |
| Q-09 | 1.7622726 | 1.6647970 | 0.1456698 | 0.0349532 | $\infty$ | 137.674 | 1.7522289 | 1.5081249 | 0.3452538 | 0.1726854 | $\infty$ | 154.451 |
| Q-10 | 1.7709206 | 1.6506325 | 0.1481192 | 0.0222904 | $\infty$ | 127.980 | 1.8062734 | 1.5335366 | 0.3214813 | 0.1360272 | $\infty$ | 163.843 |
| Q-11 | 1.7544340 | 1.6771452 | 0.1276225 | 0.0536259 | $\infty$ | 206.845 | 1.6988060 | 1.4745640 | 0.3645513 | 0.2146306 | $\infty$ | 106.178 |
| Q-12 | 1.7604926 | 1.6514825 | 0.1403326 | 0.0298540 | $\infty$ | 191.762 | 1.8158322 | 1.5066317 | 0.3372143 | 0.1583996 | $\infty$ | 151.240 |
| Q-13 | 1.7708390 | 1.6398698 | 0.1421452 | 0.0196232 | $\infty$ | 132.328 | 1.8662406 | 1.5255411 | 0.3153304 | 0.1245821 | $\infty$ | 160.775 |

Table11-R

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| R-01 | 2.0686011 | 1.9290747 | 0.3646827 | 0.2232118 | 20.748 | 15.605 | 1.7725917 | 1.4250954 | 0.9774342 | 0.6846559 | $\infty$ | 48.159 |
| R-02 | 2.1057737 | 1.9241441 | 0.2777423 | 0.0807757 | 17.910 | 11.136 | 1.8803477 | 1.5314622 | 0.6785916 | 0.4010256 | $\infty$ | 74.204 |
| R-03 | 2.0581225 | 1.8471227 | 0.2827637 | 0.0506751 | 17.506 | 8.641 | 1.8209194 | 1.4881826 | 0.5158812 | 0.2638096 | $\infty$ | 101.942 |
| R-04 | 2.0160417 | 1.7848136 | 0.2764766 | 0.0259725 | 18.735 | 7.136 | 1.8085495 | 1.4912875 | 0.4323967 | 0.1939104 | $\infty$ | 124.151 |
| R-05 | 1.7919869 | 1.7262105 | 0.1658878 | 0.0818436 | 96.241 | 83.786 | 1.6987387 | 1.4545139 | 0.4704686 | 0.2829052 | $\infty$ | 96.155 |
| R-06 | 1.7818457 | 1.6875524 | 0.1704119 | 0.0518243 | 100.653 | 78.821 | 1.7357307 | 1.4717707 | 0.3957746 | 0.1960651 | $\infty$ | 114.313 |
| R-07 | 1.7864151 | 1.6742008 | 0.1665634 | 0.0317893 | 107.735 | 75.495 | 1.7880532 | 1.5078066 | 0.3631259 | 0.1534641 | $\infty$ | 151.241 |
| R-08 | 1.7551187 | 1.7058048 | 0.1260613 | 0.0733672 | 165.735 | 150.023 | 1.6240183 | 1.4537363 | 0.3656730 | 0.2492789 | $\infty$ | 100.378 |
| R-09 | 1.7596719 | 1.6665628 | 0.1463430 | 0.0399819 | 173.817 | 139.094 | 1.7390530 | 1.4931057 | 0.3452404 | 0.1780760 | $\infty$ | 143.243 |
| R-10 | 1.7692084 | 1.6538434 | 0.1486440 | 0.0255447 | $\infty$ | 130.472 | 1.8042519 | 1.5254556 | 0.3230027 | 0.1389890 | $\infty$ | 153.607 |
| R-11 | 1.7492113 | 1.6831859 | 0.1255161 | 0.0612754 | 241.079 | 208.986 | 1.6666911 | 1.4444231 | 0.3598271 | 0.2233952 | 129.694 | 97.164 |
| R-12 | 1.7576163 | 1.6562759 | 0.1404728 | 0.0340654 | $\infty$ | 196.802 | 1.8055298 | 1.4941443 | 0.3412442 | 0.1631900 | $\infty$ | 140.744 |
| R-13 | 1.7695645 | 1.6433499 | 0.1419181 | 0.0223429 | $\infty$ | 134.816 | 1.8604189 | 1.5168227 | 0.3181887 | 0.1267727 | $\infty$ | 150.217 |

Table11-S

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| S-01 | 2.1066284 | 1.9722278 | 0.3918647 | 0.2424714 | 18.058 | 13.880 | 1.6983133 | 1.3959451 | 0.9356371 | 0.6799376 | ∞ | 48.742 |
| S-02 | 2.0496651 | 1.8417159 | 0.2971437 | 0.0714760 | 17.518 | 8.817 | 1.7914989 | 1.4621715 | 0.5192064 | 0.2672081 | ∞ | 96.374 |
| S-03 | 2.0477146 | 1.8087071 | 0.2690455 | 0.0146962 | 17.668 | 6.939 | 1.8236763 | 1.5090608 | 0.4501576 | 0.2032801 | ∞ | 113.921 |
| S-04 | 2.0388925 | 1.7916110 | 0.2221639 | 0.0000000 | 18.932 | 6.085 | 1.8751494 | 1.5585832 | 0.4137815 | 0.1664536 | ∞ | 135.543 |
| S-05 | 1.7882051 | 1.7276876 | 0.1639748 | 0.0887941 | 94.977 | 84.024 | 1.6337392 | 1.4183937 | 0.4583837 | 0.2861144 | ∞ | 87.183 |
| S-06 | 1.7819149 | 1.6860152 | 0.1726072 | 0.0563951 | 99.704 | 78.505 | 1.7230213 | 1.4640186 | 0.4031988 | 0.1996941 | ∞ | 122.946 |
| S-07 | 1.7882233 | 1.6754877 | 0.1680948 | 0.0335916 | 107.097 | 75.784 | 1.7909719 | 1.5092031 | 0.3709737 | 0.1549276 | ∞ | 139.443 |
| S-08 | 1.7966754 | 1.6777130 | 0.1592941 | 0.0183420 | 126.810 | 74.679 | 1.8368322 | 1.5410192 | 0.3573019 | 0.1265255 | ∞ | 161.553 |
| S-09 | 1.7601684 | 1.6707422 | 0.1484202 | 0.0431443 | 172.192 | 140.483 | 1.7421043 | 1.4908567 | 0.3567036 | 0.1810713 | ∞ | 132.966 |
| S-10 | 1.7708264 | 1.6578479 | 0.1494843 | 0.0270356 | ∞ | 131.945 | 1.8111661 | 1.5278995 | 0.3313428 | 0.1397205 | ∞ | 140.924 |
| S-11 | 1.7808365 | 1.6566373 | 0.1449551 | 0.0169888 | ∞ | 76.243 | 1.8495085 | 1.5425871 | 0.3220124 | 0.1131660 | ∞ | 185.922 |
| S-12 | 1.7467185 | 1.6898837 | 0.1280234 | 0.0691355 | 236.068 | 211.744 | 1.6356970 | 1.4330066 | 0.3806984 | 0.2403298 | 115.527 | 85.926 |
| S-13 | 1.7579517 | 1.6604298 | 0.1418869 | 0.0367490 | ∞ | 199.389 | 1.7772417 | 1.5042485 | 0.3539561 | 0.1652781 | ∞ | 134.892 |
| S-14 | 1.7709827 | 1.6467432 | 0.1418484 | 0.0235245 | ∞ | 136.309 | 1.8412669 | 1.5157433 | 0.3250679 | 0.1269148 | ∞ | 137.874 |
| S-15 | 1.7833105 | 1.6368506 | 0.1388995 | 0.0211969 | ∞ | 78.351 | 1.8743702 | 1.5007728 | 0.3112326 | 0.1024191 | ∞ | 189.621 |

Table11-T

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| T-01 | 2.0257518 | 1.8262559 | 0.3005010 | 0.0875737 | 18.604 | 9.528 | 1.7679118 | 1.4475798 | 0.5336131 | 0.2739842 | ∞ | 93.961 |
| T-02 | 2.0479777 | 1.8073282 | 0.2785357 | 0.0221307 | 17.649 | 6.991 | 1.8099135 | 1.5015492 | 0.4539223 | 0.2053530 | ∞ | 112.996 |
| T-03 | 1.9871581 | 1.7770885 | 0.1994500 | 0.0000000 | 23.196 | 8.093 | 1.9026852 | 1.5790720 | 0.4364031 | 0.1719341 | ∞ | 128.896 |
| T-04 | 1.7838038 | 1.6848670 | 0.1747043 | 0.0576925 | 99.860 | 78.285 | 1.7278949 | 1.4701458 | 0.4229907 | 0.2064355 | ∞ | 124.965 |
| T-05 | 1.7916234 | 1.6777831 | 0.1686057 | 0.0337253 | 107.128 | 76.217 | 1.8014530 | 1.5185135 | 0.3835360 | 0.1583273 | ∞ | 132.016 |
| T-06 | 1.8002296 | 1.6820887 | 0.1597473 | 0.0181067 | 123.024 | 75.596 | 1.8474642 | 1.5506746 | 0.3678457 | 0.1294473 | ∞ | 174.507 |
| T-07 | 1.7621698 | 1.6733356 | 0.1509720 | 0.0434793 | 172.927 | 141.368 | 1.7440225 | 1.4980874 | 0.3766420 | 0.1862685 | ∞ | 126.179 |
| T-08 | 1.7741914 | 1.6608259 | 0.1503034 | 0.0266278 | ∞ | 136.057 | 1.8173046 | 1.5378185 | 0.3434213 | 0.1424618 | ∞ | 132.104 |
| T-09 | 1.7840790 | 1.6684943 | 0.1443180 | 0.0203129 | ∞ | 135.294 | 1.8564051 | 1.5512855 | 0.3332231 | 0.1153507 | ∞ | 179.935 |
| T-10 | 1.7471069 | 1.6944812 | 0.1281138 | 0.0746421 | 236.653 | 214.192 | 1.6315414 | 1.4407236 | 0.4303508 | 0.2868047 | 102.870 | 76.063 |
| T-11 | 1.7601548 | 1.6635093 | 0.1434224 | 0.0367891 | ∞ | 200.162 | 1.7816191 | 1.5191484 | 0.3717643 | 0.1702335 | ∞ | 127.588 |
| T-12 | 1.7736039 | 1.6490824 | 0.1417115 | 0.0230579 | ∞ | 136.257 | 1.8481265 | 1.5264627 | 0.3342218 | 0.1320843 | ∞ | 129.282 |
| T-13 | 1.7854335 | 1.6355775 | 0.1377026 | 0.0255652 | ∞ | 139.113 | 1.8781876 | 1.5081985 | 0.3188588 | 0.1038490 | ∞ | 184.086 |

Table12-A

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| A-01 | 2.1808414 | 2.0202237 | 0.1177452 | 0.0000000 | 28.747 | 22.402 | 3.9125119 | 3.4135251 | 2.3592894 | 1.8675829 | 5.648 | 4.347 |
| A-02 | 1.9782905 | 1.8360883 | 0.2479634 | 0.1031416 | 40.736 | 30.986 | 3.8207998 | 3.5190505 | 0.8046063 | 0.4869196 | 31.482 | 28.563 |
| A-03 | 1.9572245 | 1.8232560 | 0.2092205 | 0.0692901 | 36.696 | 25.347 | 2.3997372 | 2.0823043 | 0.7809511 | 0.4572622 | 67.290 | 50.894 |
| A-04 | 1.9538426 | 1.8147593 | 0.1791482 | 0.0264932 | 28.651 | 16.106 | 1.9706358 | 1.6911106 | 0.5480317 | 0.2766157 | ∞ | 79.863 |
| A-05 | 1.9954675 | 1.8188549 | 0.1923512 | 0.0000000 | 20.889 | 9.610 | 1.8575722 | 1.5763149 | 0.4054773 | 0.1952503 | ∞ | 131.627 |
| A-06 | 1.9921329 | 1.8241056 | 0.1714705 | 0.0000000 | 22.078 | 10.531 | 1.8964406 | 1.6171157 | 0.4240922 | 0.2021757 | ∞ | 127.905 |
| A-07 | 1.9926516 | 1.7867996 | 0.2081128 | 0.0000000 | 19.729 | 7.090 | 1.8245385 | 1.5581041 | 0.3444239 | 0.1530946 | ∞ | 145.985 |
| A-08 | 1.8314145 | 1.7531979 | 0.1372041 | 0.0501875 | 108.784 | 92.474 | 2.1280936 | 1.9006327 | 0.5317342 | 0.3267196 | 72.362 | 59.687 |
| A-09 | 1.8085827 | 1.7459179 | 0.1222105 | 0.0510825 | 109.339 | 92.055 | 1.9395749 | 1.7141758 | 0.3894007 | 0.2106581 | 148.972 | 127.551 |
| A-10 | 1.7697499 | 1.7013515 | 0.1227356 | 0.0337061 | 114.760 | 88.411 | 1.7401521 | 1.5761971 | 0.2871018 | 0.1525706 | ∞ | 185.066 |
| A-11 | 1.7705034 | 1.6801567 | 0.1310643 | 0.0187597 | ∞ | 80.747 | 1.7513585 | 1.5678832 | 0.2526064 | 0.1235964 | ∞ | 193.932 |
| A-12 | 1.7957585 | 1.7015227 | 0.1137432 | 0.0403167 | 227.660 | 177.186 | 6.9395294 | 5.8873138 | 3.6361637 | 2.5922831 | 1.111 | 0.858 |
| A-13 | 1.7825164 | 1.7302739 | 0.1011628 | 0.0733832 | 196.277 | 166.231 | 2.0206052 | 1.9010581 | 0.3810646 | 0.2779408 | 75.306 | 68.640 |
| A-14 | 1.7512995 | 1.6751032 | 0.1082121 | 0.0292668 | ∞ | 148.729 | 1.7116334 | 1.5769923 | 0.2368558 | 0.1408109 | ∞ | 186.687 |
| A-15 | 1.7595350 | 1.6557484 | 0.1180659 | 0.0161714 | ∞ | 77.873 | 1.7725776 | 1.5799665 | 0.2199083 | 0.1145043 | ∞ | 231.353 |
| A-16 | 1.7084088 | 1.6284980 | 0.1055479 | 0.0536387 | 226.749 | 192.832 | 1.9111620 | 1.7640246 | 0.3954086 | 0.2439645 | 100.912 | 81.198 |
| A-17 | 1.7190182 | 1.6287740 | 0.1175933 | 0.0401091 | ∞ | 181.265 | 1.8380935 | 1.6452688 | 0.3389435 | 0.1578009 | ∞ | 143.472 |
| A-18 | 1.7379437 | 1.6272247 | 0.1244722 | 0.0282357 | ∞ | 168.046 | 1.8617526 | 1.5253000 | 0.3218896 | 0.1194775 | ∞ | 150.146 |
| A-19 | 1.7690277 | 1.6380658 | 0.1148478 | 0.0160624 | ∞ | 130.628 | 1.9160211 | 1.5888507 | 0.2656154 | 0.1035866 | ∞ | 186.563 |
| A-20 | 1.7635089 | 1.6370587 | 0.1248802 | 0.0253209 | ∞ | 248.930 | 6.4916237 | 5.0709047 | 3.1703715 | 1.9933341 | 1.674 | 1.017 |
| A-21 | 1.7389565 | 1.6442422 | 0.1261815 | 0.0278478 | ∞ | 246.493 | 1.9590470 | 1.6893522 | 0.5067608 | 0.2299566 | 106.692 | 71.669 |
| A-22 | 1.7475340 | 1.6520457 | 0.1252099 | 0.0255127 | ∞ | 242.366 | 1.9058713 | 1.4340244 | 0.4374233 | 0.1474709 | ∞ | 122.720 |
| A-23 | 1.7615318 | 1.6527086 | 0.1217239 | 0.0195364 | ∞ | 168.752 | 2.1047320 | 1.4652313 | 0.4154847 | 0.1111768 | ∞ | 136.328 |
| A-24 | 1.7766067 | 1.6412832 | 0.1190326 | 0.0138373 | ∞ | 88.740 | 2.0349691 | 1.4805855 | 0.3904136 | 0.0903453 | ∞ | 146.000 |

Table12-B

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| B-01 | 1.9347331 | 1.7996062 | 0.2750426 | 0.1363683 | 43.318 | 33.493 | 5.2511921 | 4.9279487 | 0.8929957 | 0.5468983 | 20.307 | 18.973 |
| B-02 | 1.9419663 | 1.8082237 | 0.2578651 | 0.1188306 | 41.573 | 31.444 | 3.2513477 | 2.9037476 | 0.9232051 | 0.5460798 | 37.199 | 32.161 |
| B-03 | 1.9591401 | 1.8243427 | 0.1845688 | 0.0348459 | 28.863 | 17.166 | 2.0003048 | 1.7161678 | 0.5962361 | 0.3082796 | ∞ | 103.261 |
| B-04 | 1.9941085 | 1.8294710 | 0.1794493 | 0.0000000 | 21.841 | 10.855 | 1.8890534 | 1.6094807 | 0.4376496 | 0.2159333 | ∞ | 124.328 |
| B-05 | 1.9921874 | 1.7902306 | 0.2161495 | 0.0000000 | 19.560 | 7.407 | 1.8147281 | 1.5495047 | 0.3515218 | 0.1609798 | ∞ | 142.900 |
| B-06 | 1.8367116 | 1.7511159 | 0.1415038 | 0.0585485 | 117.130 | 100.124 | 3.4794803 | 2.8591788 | 2.9219716 | 2.2279274 | 3.496 | 2.624 |
| B-07 | 1.8663175 | 1.7904166 | 0.1454666 | 0.0629788 | 107.043 | 95.314 | 3.6094535 | 3.3869669 | 0.6363755 | 0.4433616 | 30.601 | 28.448 |
| B-08 | 1.8110797 | 1.7530743 | 0.1221582 | 0.0579590 | 106.940 | 92.576 | 1.9534348 | 1.7349314 | 0.4032119 | 0.2333694 | 137.006 | 119.951 |
| B-09 | 1.7692729 | 1.7053300 | 0.1224199 | 0.0387908 | 112.135 | 89.219 | 1.7286207 | 1.5759400 | 0.2926499 | 0.1635215 | ∞ | 179.030 |
| B-10 | 1.7701533 | 1.6837482 | 0.1309662 | 0.0215143 | 124.678 | 82.066 | 1.7483486 | 1.5688503 | 0.2577566 | 0.1308303 | ∞ | 187.792 |
| B-11 | 1.7492102 | 1.6798841 | 0.1056795 | 0.0349862 | ∞ | 150.963 | 1.7024517 | 11.5769451 | 0.2396374 | 0.1507445 | ∞ | 180.475 |
| B-12 | 1.7583506 | 1.6574412 | 0.1168094 | 0.0182767 | ∞ | 130.082 | 1.7698774 | 1.5820478 | 0.2232388 | 0.1211306 | ∞ | 225.787 |
| B-13 | 1.7880698 | 1.7139340 | 0.1141298 | 0.0555018 | 209.668 | 174.793 | 5.4095236 | 4.4182919 | 4.5084058 | 3.5265150 | 1.134 | 0.868 |
| B-14 | 1.7899020 | 1.7260251 | 0.1113799 | 0.0687920 | 200.978 | 173.694 | 9.6456356 | 9.4830819 | 0.4801134 | 0.3732738 | 10.334 | 10.156 |
| B-15 | 1.6979410 | 1.6299820 | 0.0967336 | 0.0676101 | 222.002 | 195.947 | 1.9337656 | 1.7944394 | 0.4093689 | 0.2921692 | 89.401 | 74.126 |
| B-16 | 1.7134936 | 1.6304943 | 0.1158895 | 0.0466000 | 229.322 | 184.704 | 1.8372765 | 1.6612144 | 0.3459416 | 0.1743804 | ∞ | 137.319 |
| B-17 | 1.7339774 | 1.6269608 | 0.1244076 | 0.0316488 | ∞ | 169.585 | 1.8519942 | 1.5217329 | 0.3271389 | 0.1269643 | ∞ | 143.855 |
| B-18 | 1.7679045 | 1.6421025 | 0.1142134 | 0.0182430 | ∞ | 136.942 | 1.9207852 | 1.5961025 | 0.2702996 | 0.1092229 | ∞ | 180.258 |
| B-19 | 1.7349739 | 1.6440145 | 0.1270969 | 0.0322690 | ∞ | 248.639 | 1.9861047 | 1.7084167 | 0.5505443 | 0.2637120 | 92.313 | 64.771 |
| B-20 | 1.7457875 | 1.6523659 | 0.1258538 | 0.0278741 | ∞ | 244.451 | 1.9093494 | 1.4410730 | 0.4538915 | 0.1599267 | ∞ | 120.523 |
| B-21 | 1.7603639 | 1.6533522 | 0.1221163 | 0.0218136 | ∞ | 170.127 | 2.1254057 | 1.4577543 | 0.4256915 | 0.1179254 | ∞ | 130.094 |
| B-22 | 1.7754260 | 1.6426635 | 0.1193196 | 0.0159285 | ∞ | 90.544 | 2.0464268 | 1.4759519 | 0.3977860 | 0.0948929 | ∞ | 140.032 |

Table 12-C

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| C-01 | 1.8930999 | 1.7732818 | 0.3015456 | 0.1719582 | 44.120 | 35.207 | 4.9698244 | 4.5796632 | 1.0302271 | 0.6019471 | 20.856 | 19.154 |
| C-02 | 1.9701299 | 1.8401421 | 0.1894818 | 0.0431159 | 28.796 | 18.240 | 2.0513300 | 1.7601911 | 0.6580454 | 0.3477707 | ∞ | 96.767 |
| C-03 | 1.9965543 | 1.8387699 | 0.1802441 | 0.0017981 | 21.880 | 11.525 | 1.8973838 | 1.6191258 | 0.4603685 | 0.2347033 | ∞ | 119.691 |
| C-04 | 1.9942257 | 1.7970138 | 0.2187743 | 0.0000000 | 19.381 | 7.773 | 1.8104389 | 1.5459101 | 0.3620504 | 0.1713571 | ∞ | 139.782 |
| C-05 | 1.8678636 | 1.8052953 | 0.1568168 | 0.0833622 | 104.700 | 94.970 | 4.8729893 | 4.6290184 | 0.6966732 | 0.5019222 | 20.806 | 19.723 |
| C-06 | 1.8118435 | 1.7610964 | 0.1197983 | 0.0687717 | 104.921 | 93.165 | 1.9621194 | 1.7520901 | 0.4050714 | 0.2596380 | 127.606 | 114.505 |
| C-07 | 1.7678278 | 1.7092853 | 0.1216732 | 0.0442892 | 109.785 | 89.909 | 1.7142712 | 1.5759594 | 0.2975075 | 0.1768080 | ∞ | 173.302 |
| C-08 | 1.7695373 | 1.6874450 | 0.1309482 | 0.0248496 | 116.803 | 83.168 | 1.7460448 | 1.5717479 | 0.2635914 | 0.1392432 | ∞ | 220.126 |
| C-09 | 1.7463738 | 1.6881292 | 0.1026663 | 0.0407437 | ∞ | 155.686 | 1.6925486 | 1.5797764 | 0.2435170 | 0.1629555 | 205.253 | 174.633 |
| C-10 | 1.7571263 | 1.6600694 | 0.1155040 | 0.0208471 | ∞ | 136.617 | 1.7662295 | 1.5866433 | 0.2273041 | 0.1286859 | ∞ | 220.829 |
| C-11 | 1.7081474 | 1.6332231 | 0.1115853 | 0.0550326 | 220.895 | 187.564 | 1.8379989 | 1.6786605 | 0.3530382 | 0.2012022 | ∞ | 132.380 |
| C-12 | 1.7301370 | 1.6291250 | 0.1232971 | 0.0358093 | ∞ | 171.179 | 1.8496058 | 1.5180543 | 0.3330794 | 0.1358944 | ∞ | 139.728 |
| C-13 | 1.7666980 | 1.6468799 | 0.1134447 | 0.0208227 | ∞ | 140.860 | 1.9306487 | 1.6040642 | 0.2759754 | 0.1154969 | ∞ | 211.039 |
| C-14 | 1.7433466 | 1.6533259 | 0.1266477 | 0.0323570 | ∞ | 246.551 | 1.9142676 | 1.5792065 | 0.4740512 | 0.1745078 | ∞ | 116.083 |
| C-15 | 1.7579646 | 1.6544478 | 0.1224951 | 0.0245935 | ∞ | 171.578 | 2.1504945 | 1.4490724 | 0.4374587 | 0.1256044 | ∞ | 125.994 |
| C-16 | 1.7745198 | 1.6439814 | 0.1195634 | 0.0184221 | ∞ | 144.260 | 2.0614452 | 1.4721825 | 0.4059610 | 0.0996109 | ∞ | 163.579 |

Table 12-D

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| D-01 | 1.9387499 | 1.8274901 | 0.2827500 | 0.1510105 | 36.265 | 28.410 | 2.6651047 | 2.2604026 | 1.1780592 | 0.7481019 | 45.830 | 35.031 |
| D-02 | 1.9911368 | 1.8649942 | 0.1947154 | 0.0518638 | 27.328 | 18.211 | 2.0801817 | 1.7824437 | 0.7046761 | 0.3894856 | ∞ | 89.391 |
| D-03 | 2.0053118 | 1.8488164 | 0.1911195 | 0.0118971 | 20.841 | 11.375 | 1.8790896 | 1.6015383 | 0.4674731 | 0.2482629 | ∞ | 116.048 |
| D-04 | 1.9984316 | 1.8029042 | 0.2242962 | 0.0055279 | 18.958 | 7.919 | 1.8022754 | 1.5415478 | 0.3692367 | 0.1800069 | ∞ | 161.074 |
| D-05 | 1.8367033 | 1.7915287 | 0.1448993 | 0.0959638 | 100.413 | 92.330 | 2.2232544 | 2.0121606 | 0.6927698 | 0.5482850 | 50.856 | 43.913 |
| D-06 | 1.7645533 | 1.7107752 | 0.1215570 | 0.0488641 | 107.088 | 90.071 | 1.6944128 | 1.5681762 | 0.2967935 | 0.1883071 | ∞ | 167.306 |
| D-07 | 1.7686885 | 1.6897749 | 0.1317105 | 0.0281302 | 113.091 | 83.726 | 1.7443327 | 1.5721245 | 0.2674691 | 0.1462606 | ∞ | 212.321 |
| D-08 | 1.7431482 | 1.6903479 | 0.1012162 | 0.0434916 | 186.875 | 156.460 | 1.6837059 | 1.5778783 | 0.2476342 | 0.1736730 | 192.146 | 167.792 |
| D-09 | 1.7561171 | 1.6632973 | 0.1147154 | 0.0233959 | ∞ | 139.092 | 1.7649256 | 1.5954151 | 0.2309121 | 0.1349502 | ∞ | 216.222 |
| D-10 | 1.6992769 | 1.6367293 | 0.1062424 | 0.0636582 | 217.758 | 189.407 | 1.8298004 | 1.6887347 | 0.3588003 | 0.2369851 | ∞ | 129.000 |
| D-11 | 1.7657052 | 1.6515499 | 0.1124392 | 0.0233779 | ∞ | 143.323 | 1.9434736 | 1.6133820 | 0.2816908 | 0.1205092 | ∞ | 202.760 |
| D-12 | 1.7357815 | 1.6550527 | 0.1273897 | 0.0367512 | ∞ | 248.170 | 1.9123721 | 1.6031448 | 0.4942049 | 0.1858577 | ∞ | 111.627 |
| D-13 | 1.7526840 | 1.6557943 | 0.1226776 | 0.0275128 | ∞ | 176.326 | 2.1673377 | 1.4382227 | 0.4469812 | 0.1314001 | ∞ | 121.730 |
| D-14 | 1.7739079 | 1.6446855 | 0.1196764 | 0.0205456 | ∞ | 151.443 | 2.0464263 | 1.4694964 | 0.4122386 | 0.1024998 | ∞ | 169.246 |

Table12-E

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|------|-----------|-----------|-----------|-----------|---------|---------|-----------|-----------|-----------|-----------|---------|---------|
| E-01 | 1.9441637 | 1.8429272 | 0.2974501 | 0.1749428 | 29.318 | 22.537 | 2.0026070 | 1.6598153 | 1.0485594 | 0.7394921 | ∞ | 42.606 |
| E-02 | 2.0101090 | 1.8833402 | 0.2080006 | 0.0628834 | 24.123 | 16.088 | 1.9875326 | 1.6877633 | 0.6626760 | 0.4002456 | ∞ | 87.502 |
| E-03 | 2.0050503 | 1.8489065 | 0.2105359 | 0.0306079 | 19.910 | 11.032 | 1.8390125 | 1.5618030 | 0.4581653 | 0.2510816 | ∞ | 111.349 |
| E-04 | 1.9912795 | 1.7985134 | 0.2317913 | 0.0160076 | 19.088 | 8.078 | 1.7867732 | 1.5334187 | 0.3697187 | 0.1830317 | ∞ | 151.843 |
| E-05 | 1.7606078 | 1.7088194 | 0.1229858 | 0.0501904 | 105.154 | 89.603 | 1.6745313 | 1.5530078 | 0.2929759 | 0.1936033 | ∞ | 159.881 |
| E-06 | 1.7685195 | 1.6901601 | 0.1333463 | 0.0304605 | 111.335 | 83.682 | 1.7455691 | 1.5702676 | 0.2697093 | 0.1496056 | ∞ | 201.778 |
| E-07 | 1.7407373 | 1.6857263 | 0.1036069 | 0.0414218 | 183.044 | 154.502 | 1.6816095 | 1.5711383 | 0.2532263 | 0.1789661 | 183.178 | 159.350 |
| E-08 | 1.7555063 | 1.6665793 | 0.1149283 | 0.0252627 | ∞ | 140.733 | 1.7670485 | 1.6132301 | 0.2339211 | 0.1377651 | ∞ | 210.561 |
| E-09 | 1.6931474 | 1.6419181 | 0.1017729 | 0.0688444 | 212.031 | 189.996 | 1.8068114 | 1.6851085 | 0.3676980 | 0.2687320 | 159.899 | 125.176 |
| E-10 | 1.7516203 | 1.6732426 | 0.1131103 | 0.0468176 | ∞ | 211.707 | 1.7182256 | 1.5836064 | 0.2959419 | 0.1614839 | ∞ | 149.849 |
| E-11 | 1.7654370 | 1.6553771 | 0.1111497 | 0.0252537 | ∞ | 145.016 | 1.8121549 | 1.6252275 | 0.2864905 | 0.1237879 | ∞ | 197.255 |
| E-12 | 1.7310442 | 1.6573405 | 0.1279842 | 0.0397384 | ∞ | 249.228 | 1.8974334 | 1.6040960 | 0.5107330 | 0.2004839 | ∞ | 106.788 |
| E-13 | 1.7491464 | 1.6573153 | 0.1225933 | 0.0291107 | ∞ | 227.942 | 2.0938195 | 1.4260205 | 0.4518073 | 0.1347504 | ∞ | 116.457 |
| E-14 | 1.7737611 | 1.6445485 | 0.1195745 | 0.0217412 | ∞ | 153.499 | 2.0341814 | 1.4657293 | 0.4150721 | 0.1035889 | ∞ | 164.698 |

Table12-F

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| F-01 | 1.9309499 | 1.8256862 | 0.3220077 | 0.2034871 | 27.771 | 21.191 | 1.8235422 | 1.5442282 | 0.9417758 | 0.6984530 | 69.490 | 42.671 |
| F-02 | 2.0309565 | 1.9002326 | 0.2214292 | 0.0713829 | 21.890 | 14.677 | 1.9351400 | 1.6211642 | 0.6306132 | 0.3978801 | ∞ | 90.258 |
| F-03 | 1.9982247 | 1.8423031 | 0.2292788 | 0.0501528 | 19.464 | 10.841 | 1.7983820 | 1.5239496 | 0.4454823 | 0.2471535 | ∞ | 108.827 |
| F-04 | 1.9872145 | 1.7950417 | 0.2345780 | 0.0208244 | 19.296 | 8.166 | 1.7776850 | 1.5307746 | 0.3707366 | 0.1836223 | ∞ | 141.236 |
| F-05 | 2.0022033 | 1.7926135 | 0.1918167 | 0.0000000 | 19.700 | 6.937 | 1.8360524 | 1.5745095 | 0.3473032 | 0.1539414 | ∞ | 151.670 |
| F-06 | 1.7586867 | 1.7057167 | 0.1249748 | 0.0510368 | 104.484 | 88.915 | 1.6647586 | 1.5426834 | 0.2931011 | 0.1942278 | ∞ | 150.532 |
| F-07 | 1.7696897 | 1.6897824 | 0.1350373 | 0.0311201 | 111.074 | 83.470 | 1.7511979 | 1.5703862 | 0.2729217 | 0.1501470 | ∞ | 194.177 |
| F-08 | 1.7828581 | 1.6990044 | 0.1261705 | 0.0201879 | 134.309 | 84.108 | 1.8128845 | 1.5998767 | 0.2643117 | 0.1231435 | ∞ | 196.169 |
| F-09 | 1.7405643 | 1.6873270 | 0.1077789 | 0.0431707 | 180.529 | 154.997 | 1.6790179 | 1.5664434 | 0.2609613 | 0.1796234 | 174.384 | 149.123 |
| F-10 | 1.7568981 | 1.6686925 | 0.1156114 | 0.0257725 | ∞ | 141.380 | 1.7726988 | 1.6259935 | 0.2372277 | 0.1379125 | ∞ | 202.825 |
| F-11 | 1.6922087 | 1.6452593 | 0.1009766 | 0.0679431 | 210.803 | 190.171 | 1.7840482 | 1.6730289 | 0.3817165 | 0.2781301 | 147.094 | 119.532 |
| F-12 | 1.7506346 | 1.6758665 | 0.1142225 | 0.0477125 | ∞ | 212.960 | 1.7099525 | 1.5862989 | 0.3041244 | 0.1683896 | 182.910 | 140.704 |
| F-13 | 1.7665789 | 1.6568609 | 0.1097239 | 0.0258750 | ∞ | 145.637 | 1.8049443 | 1.6372819 | 0.2902557 | 0.1270794 | ∞ | 190.688 |
| F-14 | 1.7793673 | 1.6305355 | 0.1135032 | 0.0199937 | ∞ | 156.959 | 1.9211943 | 1.5416899 | 0.2854559 | 0.1015741 | ∞ | 195.958 |
| F-15 | 1.7471315 | 1.6586561 | 0.1223108 | 0.0299292 | ∞ | 230.996 | 2.0783137 | 1.4178145 | 0.4537234 | 0.1372952 | ∞ | 108.954 |
| F-16 | 1.7549368 | 1.6377188 | 0.1212434 | 0.0153205 | ∞ | 161.765 | 1.9672754 | 1.4663281 | 0.3638952 | 0.0922351 | ∞ | 177.545 |

Table12-G

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| G-01 | 1.9074552 | 1.7961906 | 0.3422843 | 0.2520548 | 29.495 | 22.610 | 1.7786603 | 1.5342987 | 1.0346998 | 0.7374305 | 54.222 | 35.976 |
| G-02 | 2.0298789 | 1.9017747 | 0.2316143 | 0.0878033 | 22.071 | 15.195 | 1.9301729 | 1.6008943 | 0.6500908 | 0.4083086 | ∞ | 84.531 |
| G-03 | 1.9904209 | 1.8380210 | 0.2334696 | 0.0588651 | 19.842 | 11.226 | 1.7827243 | 1.5134922 | 0.4506346 | 0.2507456 | ∞ | 102.949 |
| G-04 | 2.0009844 | 1.7934185 | 0.1930633 | 0.0000000 | 19.876 | 7.119 | 1.8350621 | 1.5724645 | 0.3507015 | 0.1561092 | ∞ | 144.234 |
| G-05 | 1.7597286 | 1.7058638 | 0.1254356 | 0.0512351 | 104.617 | 88.871 | 1.6655039 | 1.5427988 | 0.2996432 | 0.1974863 | ∞ | 141.145 |
| G-06 | 1.7714890 | 1.6912364 | 0.1352196 | 0.0309203 | 111.267 | 83.725 | 1.7567216 | 1.5741301 | 0.2784825 | 0.1526719 | ∞ | 185.351 |
| G-07 | 1.7843314 | 1.7014579 | 0.1257631 | 0.0216420 | 133.146 | 84.680 | 1.8170787 | 1.6035057 | 0.2686002 | 0.1254215 | ∞ | 187.805 |
| G-08 | 1.7419644 | 1.6879556 | 0.1088176 | 0.0432548 | 181.354 | 155.167 | 1.6807525 | 1.5671808 | 0.2683500 | 0.1826212 | 163.724 | 139.209 |
| G-09 | 1.7585761 | 1.6686432 | 0.1152971 | 0.0263298 | ∞ | 141.147 | 1.7770454 | 1.6310822 | 0.2407989 | 0.1400994 | 244.852 | 193.529 |
| G-10 | 1.7703131 | 1.6943439 | 0.1031730 | 0.0389335 | ∞ | 154.687 | 1.8232087 | 1.5876936 | 0.2134065 | 0.1128255 | ∞ | 249.911 |
| G-11 | 1.6887573 | 1.6451770 | 0.0975290 | 0.0724180 | 209.185 | 191.053 | 1.7773022 | 1.6675756 | 0.3800804 | 0.2958507 | 138.752 | 111.368 |
| G-12 | 1.7520358 | 1.6759592 | 0.1144883 | 0.0474461 | ∞ | 212.716 | 1.7115860 | 1.5894046 | 0.3088005 | 0.1698918 | 169.537 | 131.748 |
| G-13 | 1.7679846 | 1.6559448 | 0.1088859 | 0.0258647 | ∞ | 145.342 | 1.8076172 | 1.6422363 | 0.2930750 | 0.1273462 | ∞ | 181.729 |
| G-14 | 1.7805664 | 1.6279932 | 0.1137601 | 0.0204922 | ∞ | 159.035 | 1.9186750 | 1.5389729 | 0.2883794 | 0.1013762 | ∞ | 187.281 |
| G-15 | 1.7470441 | 1.6587128 | 0.1220067 | 0.0318895 | ∞ | 231.817 | 2.0959926 | 1.4176711 | 0.4582089 | 0.1395004 | ∞ | 98.800 |
| G-16 | 1.7545533 | 1.6381727 | 0.1214452 | 0.0153368 | ∞ | 162.772 | 1.9685664 | 1.4649641 | 0.3661101 | 0.0928691 | ∞ | 176.415 |

Table12-H

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|------|------|------|------|------|------|------|------|------|------|------|------|
| H-01 | 1.9954203 | 1.8787272 | 0.2389065 | 0.1110098 | 25.704 | 18.260 | 1.9728332 | 1.6385461 | 0.7550855 | 0.4544666 | ∞ | 69.433 |
| H-02 | 1.9889747 | 1.8436634 | 0.2240097 | 0.0563217 | 20.861 | 12.234 | 1.8049323 | 1.5360932 | 0.4833361 | 0.2709057 | ∞ | 89.557 |
| H-03 | 1.9838198 | 1.8007681 | 0.2298239 | 0.0248556 | 19.928 | 8.947 | 1.7818109 | 1.5291559 | 0.3890198 | 0.1961341 | ∞ | 132.574 |
| H-04 | 1.9984290 | 1.7954163 | 0.1972446 | 0.0000000 | 19.960 | 7.439 | 1.8304558 | 1.5669780 | 0.3567863 | 0.1621232 | ∞ | 140.921 |
| H-05 | 1.7625812 | 1.7121771 | 0.1234484 | 0.0532482 | 104.547 | 90.003 | 1.6681649 | 1.5502535 | 0.3099723 | 0.2093803 | ∞ | 133.379 |
| H-06 | 1.7717941 | 1.6954404 | 0.1337145 | 0.0320092 | 110.562 | 84.753 | 1.7534790 | 1.5766272 | 0.2839659 | 0.1602488 | ∞ | 177.732 |
| H-07 | 1.7833304 | 1.7023965 | 0.1254477 | 0.0229868 | 132.965 | 85.102 | 1.8136903 | 1.6049709 | 0.2720818 | 0.1311882 | ∞ | 182.349 |
| H-08 | 1.7426659 | 1.6905956 | 0.1032570 | 0.0447133 | 181.549 | 155.657 | 1.6810093 | 1.5708933 | 0.2709547 | 0.1930666 | 151.452 | 131.886 |
| H-09 | 1.7578654 | 1.6675761 | 0.1130004 | 0.0295128 | ∞ | 146.541 | 1.7739569 | 1.6268427 | 0.2432275 | 0.1472412 | 233.444 | 184.408 |
| H-10 | 1.7689847 | 1.6945828 | 0.1028286 | 0.0392727 | ∞ | 154.818 | 1.8251553 | 1.5951052 | 0.2154490 | 0.1183372 | ∞ | 240.104 |
| H-11 | 1.7537859 | 1.6772613 | 0.1128123 | 0.0498203 | ∞ | 212.202 | 1.7095872 | 1.5898778 | 0.3075202 | 0.1714142 | 159.026 | 124.023 |
| H-12 | 1.7107053 | 1.6332028 | 0.1193085 | 0.0550861 | 225.437 | 180.711 | 1.8324906 | 1.6342203 | 0.3444059 | 0.1767509 | ∞ | 147.166 |
| H-13 | 1.7677474 | 1.6550924 | 0.1090469 | 0.0269449 | ∞ | 145.773 | 1.8136422 | 1.6357149 | 0.2956611 | 0.1301069 | ∞ | 171.600 |
| H-14 | 1.7788371 | 1.6293950 | 0.1135283 | 0.0209819 | ∞ | 159.189 | 1.9194994 | 1.5398521 | 0.2882715 | 0.1038879 | ∞ | 177.565 |
| H-15 | 1.7255306 | 1.6596065 | 0.1294789 | 0.0477235 | 299.198 | 252.902 | 1.9082083 | 1.6031338 | 0.5360868 | 0.2232267 | ∞ | 78.707 |
| H-16 | 1.7474986 | 1.6575047 | 0.1223978 | 0.0353812 | ∞ | 232.352 | 1.9688166 | 1.4227350 | 0.4694319 | 0.1444258 | ∞ | 87.559 |
| H-17 | 1.7546479 | 1.6375300 | 0.1213946 | 0.0161077 | ∞ | 162.500 | 1.9667069 | 1.4637968 | 0.3697669 | 0.0968665 | ∞ | 172.248 |

Table12-I

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| I-01 | 1.9692763 | 1.8596266 | 0.2508663 | 0.1332991 | 28.459 | 20.886 | 1.9945549 | 1.6714592 | 0.8746255 | 0.5201810 | ∞ | 58.984 |
| I-02 | 1.9948263 | 1.8576400 | 0.2133537 | 0.0548759 | 21.878 | 13.513 | 1.8484874 | 1.5782359 | 0.5362016 | 0.3067351 | ∞ | 109.380 |
| I-03 | 1.9946679 | 1.8170813 | 0.2276031 | 0.0263690 | 19.535 | 9.387 | 1.7913122 | 1.5290136 | 0.4084559 | 0.2129713 | ∞ | 128.054 |
| I-04 | 2.0026503 | 1.8031069 | 0.2017044 | 0.0000000 | 19.564 | 7.726 | 1.8270961 | 1.5626259 | 0.3662021 | 0.1718345 | ∞ | 139.811 |
| I-05 | 1.7658783 | 1.7227350 | 0.1181285 | 0.0666990 | 103.691 | 91.535 | 1.6673294 | 1.5628945 | 0.3206361 | 0.2315138 | 154.993 | 126.106 |
| I-06 | 1.7705080 | 1.7015382 | 0.1312636 | 0.0353615 | 108.903 | 86.260 | 1.7439231 | 1.5785362 | 0.2895958 | 0.1723692 | ∞ | 172.850 |
| I-07 | 1.7809352 | 1.7034120 | 0.1251832 | 0.0253065 | 120.751 | 85.550 | 1.8032815 | 1.6051419 | 0.2739825 | 0.1391363 | ∞ | 213.651 |
| I-08 | 1.7546144 | 1.6808827 | 0.1087703 | 0.0356038 | ∞ | 151.796 | 1.7653934 | 1.6230533 | 0.2446842 | 0.1582816 | 220.487 | 176.365 |
| I-09 | 1.7659758 | 1.6939299 | 0.1022816 | 0.0399049 | ∞ | 154.614 | 1.8195213 | 1.6017894 | 0.2170334 | 0.1259311 | ∞ | 231.541 |
| I-10 | 1.7062981 | 1.6329753 | 0.1143390 | 0.0650970 | 217.064 | 185.478 | 1.8401354 | 1.6587585 | 0.3337728 | 0.1982443 | ∞ | 138.813 |
| I-11 | 1.7664075 | 1.6564075 | 0.1093932 | 0.0310388 | ∞ | 147.689 | 1.8226250 | 1.6245293 | 0.3002786 | 0.1388931 | ∞ | 164.311 |
| I-12 | 1.7756357 | 1.6331223 | 0.1131198 | 0.0217062 | ∞ | 158.981 | 1.9263867 | 1.5423828 | 0.2890063 | 0.1103601 | ∞ | 172.733 |
| I-13 | 1.7461154 | 1.6571884 | 0.1235032 | 0.0387156 | ∞ | 240.244 | 1.9411447 | 1.4218442 | 0.4838070 | 0.1574935 | ∞ | 78.316 |
| I-14 | 1.7725616 | 1.6455170 | 0.1205680 | 0.0270206 | ∞ | 155.716 | 2.0919097 | 1.4580559 | 0.4358933 | 0.1189182 | ∞ | 129.458 |
| I-15 | 1.7549616 | 1.6368073 | 0.1213638 | 0.0182803 | ∞ | 162.204 | 1.9691181 | 1.4663593 | 0.3758026 | 0.1021307 | ∞ | 167.272 |

Table12-J

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| J-01 | 1.9731500 | 1.8713934 | 0.2654901 | 0.1590912 | 28.020 | 21.477 | 1.9770311 | 1.6750340 | 0.9521030 | 0.6078782 | $\infty$ | 54.233 |
| J-02 | 2.0065961 | 1.8749738 | 0.2149204 | 0.0648764 | 21.717 | 14.068 | 1.8627784 | 1.5956165 | 0.5755217 | 0.3436625 | $\infty$ | 102.235 |
| J-03 | 1.9985387 | 1.8286315 | 0.2279896 | 0.0330873 | 19.375 | 9.912 | 1.7930359 | 1.5330530 | 0.4264467 | 0.2311098 | $\infty$ | 123.013 |
| J-04 | 2.0076389 | 1.8108030 | 0.2086414 | 0.0000000 | 19.065 | 7.927 | 1.8201261 | 1.5562968 | 0.3740609 | 0.1818026 | $\infty$ | 159.427 |
| J-05 | 1.7680914 | 1.7070538 | 0.1292749 | 0.0424146 | 106.173 | 87.400 | 1.7307823 | 1.5771556 | 0.2927908 | 0.1860452 | $\infty$ | 166.850 |
| J-06 | 1.7786842 | 1.7054640 | 0.1248020 | 0.0287583 | 114.334 | 86.092 | 1.7945003 | 1.6027705 | 0.2747519 | 0.1474472 | $\infty$ | 207.069 |
| J-07 | 1.7503216 | 1.6927032 | 0.1035853 | 0.0436439 | $\infty$ | 154.913 | 1.7550789 | 1.6307222 | 0.2454636 | 0.1705746 | 205.444 | 170.365 |
| J-08 | 1.7628881 | 1.6969970 | 0.1000361 | 0.0434748 | $\infty$ | 155.309 | 1.8150625 | 1.6041567 | 0.2163902 | 0.1335313 | $\infty$ | 226.183 |
| J-09 | 1.7023888 | 1.6383727 | 0.1103469 | 0.0710305 | 213.976 | 188.002 | 1.8332938 | 1.6741837 | 0.3342286 | 0.2182044 | $\infty$ | 137.568 |
| J-10 | 1.7624328 | 1.6604162 | 0.1092583 | 0.0359734 | $\infty$ | 154.045 | 1.8103025 | 1.6180515 | 0.3074345 | 0.1483537 | $\infty$ | 157.434 |
| J-11 | 1.7727296 | 1.6421522 | 0.1127977 | 0.0234031 | $\infty$ | 159.947 | 1.9344715 | 1.5437769 | 0.2923744 | 0.1164235 | $\infty$ | 166.359 |
| J-12 | 1.7434701 | 1.6582797 | 0.1244701 | 0.0424218 | $\infty$ | 244.182 | 1.9312150 | 1.4189274 | 0.5004744 | 0.1715095 | $\infty$ | 112.002 |
| J-13 | 1.7702020 | 1.6413129 | 0.1208964 | 0.0213823 | $\infty$ | 118.831 | 2.0538922 | 1.4774554 | 0.4144870 | 0.1011447 | $\infty$ | 136.148 |

Table12-K

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|-------------|-------------|-------------|-------------|-------------|-------------|-------------|-------------|-------------|-------------|-------------|-------------|
| K-01 | 2.0218619 | 1.8933890 | 0.2281588 | 0.0789693 | 20.232 | 13.558 | 1.8275836 | 1.5675665 | 0.5773003 | 0.3668426 | $\infty$ | 94.095 |
| K-02 | 2.0030875 | 1.8362100 | 0.2376098 | 0.0442529 | 18.757 | 9.972 | 1.7780147 | 1.5216621 | 0.4326685 | 0.2435681 | $\infty$ | 117.945 |
| K-03 | 2.0126645 | 1.8154441 | 0.2207471 | 0.0000000 | 18.396 | 7.885 | 1.8063822 | 1.5463090 | 0.3755212 | 0.1879101 | $\infty$ | 150.090 |
| K-04 | 1.7651000 | 1.7098608 | 0.1288453 | 0.0482545 | 103.746 | 87.793 | 1.7190324 | 1.5694731 | 0.2931750 | 0.1967102 | $\infty$ | 158.526 |
| K-05 | 1.7773651 | 1.7081219 | 0.1244173 | 0.0325899 | 110.766 | 86.568 | 1.7918913 | 1.5996025 | 0.2743664 | 0.1535070 | $\infty$ | 195.827 |
| K-06 | 1.7466075 | 1.6987914 | 0.0994331 | 0.0506673 | 181.377 | 156.295 | 1.7489751 | 1.6459099 | 0.2464233 | 0.1801611 | 192.498 | 165.736 |
| K-07 | 1.7608557 | 1.7034668 | 0.0954377 | 0.0506647 | $\infty$ | 156.797 | 1.8114198 | 1.6005177 | 0.2122738 | 0.1386373 | $\infty$ | 222.034 |
| K-08 | 1.7013165 | 1.6482062 | 0.1118924 | 0.0673893 | 212.079 | 190.563 | 1.8012950 | 1.6672679 | 0.3563252 | 0.2167549 | $\infty$ | 134.528 |
| K-09 | 1.7581609 | 1.6662114 | 0.1081045 | 0.0401626 | $\infty$ | 202.507 | 1.7674118 | 1.6210202 | 0.3149906 | 0.1578068 | $\infty$ | 149.985 |
| K-10 | 1.7710892 | 1.6477835 | 0.1125048 | 0.0264342 | $\infty$ | 162.019 | 1.9431216 | 1.5627285 | 0.2972370 | 0.1216852 | $\infty$ | 178.844 |
| K-11 | 1.7411044 | 1.6603232 | 0.1249554 | 0.0455071 | $\infty$ | 245.731 | 1.9169497 | 1.5628151 | 0.5133974 | 0.1871095 | $\infty$ | 110.475 |
| K-12 | 1.7661840 | 1.6409679 | 0.1208136 | 0.0139715 | $\infty$ | 93.306 | 1.9665859 | 1.4859340 | 0.3680803 | 0.0919865 | $\infty$ | 182.028 |

Table12-L

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| L-01 | 2.0460807 | 1.9550919 | 0.3015443 | 0.2175648 | 20.485 | 16.796 | 1.7248425 | 1.5281103 | 0.8161721 | 0.6645046 | ∞ | 53.473 |
| L-02 | 2.0318624 | 1.9058614 | 0.2472378 | 0.0954800 | 18.757 | 12.872 | 1.7700254 | 1.5169590 | 0.5579569 | 0.3707376 | ∞ | 84.372 |
| L-03 | 2.0008101 | 1.8355257 | 0.2483238 | 0.0575474 | 18.482 | 9.997 | 1.7581930 | 1.5056417 | 0.4335189 | 0.2489083 | ∞ | 110.450 |
| L-04 | 2.0105317 | 1.8182819 | 0.2156634 | 0.0000000 | 18.663 | 8.218 | 1.8122432 | 1.5491304 | 0.3839051 | 0.1936096 | ∞ | 134.819 |
| L-05 | 1.7641121 | 1.7102925 | 0.1308720 | 0.0508488 | 102.429 | 87.618 | 1.7188369 | 1.5620900 | 0.2966073 | 0.2016427 | ∞ | 148.593 |
| L-06 | 1.7783394 | 1.7116952 | 0.1239742 | 0.0361934 | 109.032 | 87.083 | 1.7997420 | 1.5982430 | 0.2759885 | 0.1557675 | ∞ | 156.457 |
| L-07 | 1.7456815 | 1.7019254 | 0.0984309 | 0.0545808 | 176.526 | 156.817 | 1.7472612 | 1.6593706 | 0.2504515 | 0.1845018 | 182.891 | 159.027 |
| L-08 | 1.7608578 | 1.7113778 | 0.0854896 | 0.0641859 | ∞ | 158.813 | 1.8137233 | 1.7101357 | 0.2024677 | 0.1398163 | ∞ | 216.875 |
| L-09 | 1.7611906 | 1.6760307 | 0.1005431 | 0.0363549 | ∞ | 89.194 | 1.8280582 | 1.5602262 | 0.2035395 | 0.1136579 | ∞ | 222.191 |
| L-10 | 1.7563064 | 1.6718276 | 0.1052920 | 0.0433254 | ∞ | 208.681 | 1.7543803 | 1.6367057 | 0.3218591 | 0.1723034 | ∞ | 144.725 |
| L-11 | 1.7306655 | 1.6509731 | 0.1124854 | 0.0292652 | ∞ | 164.553 | 1.8340950 | 1.5870113 | 0.3028945 | 0.1279140 | ∞ | 187.149 |
| L-12 | 1.7824602 | 1.6205047 | 0.1189640 | 0.0164823 | ∞ | 81.070 | 1.9228810 | 1.5664223 | 0.2779451 | 0.0844258 | ∞ | 231.434 |
| L-13 | 1.7671173 | 1.6418353 | 0.1209148 | 0.0150969 | ∞ | 152.912 | 1.9737812 | 1.4829987 | 0.3752843 | 0.0940037 | ∞ | 183.297 |

Table12-M

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| M-01 | 2.0110098 | 1.8219436 | 0.2105546 | 0.0000000 | 19.030 | 8.575 | 1.8226207 | 1.5549815 | 0.3944100 | 0.1976119 | ∞ | 130.545 |
| M-02 | 2.0346730 | 1.8208070 | 0.1881221 | 0.0000000 | 17.927 | 6.976 | 1.8521081 | 1.5816320 | 0.3558327 | 0.1592007 | ∞ | 144.889 |
| M-03 | 1.7672192 | 1.7109472 | 0.1344514 | 0.0523958 | 102.482 | 87.478 | 1.7365020 | 1.5655584 | 0.3097410 | 0.2047594 | 188.837 | 141.660 |
| M-04 | 1.7822635 | 1.7171365 | 0.1230080 | 0.0398903 | 108.764 | 87.918 | 1.8181624 | 1.6058894 | 0.2832612 | 0.1572517 | ∞ | 193.231 |
| M-05 | 1.7759032 | 1.7056346 | 0.1154059 | 0.0292780 | 130.745 | 87.463 | 1.8142014 | 1.5776878 | 0.2626479 | 0.1270021 | ∞ | 198.882 |
| M-06 | 1.7485319 | 1.7058988 | 0.0988620 | 0.0584531 | 176.587 | 157.770 | 1.7583974 | 1.6764358 | 0.2587944 | 0.1866594 | 173.444 | 149.341 |
| M-07 | 1.7603756 | 1.6813045 | 0.1019426 | 0.0341533 | ∞ | 149.820 | 1.7288461 | 1.5578732 | 0.2073948 | 0.1144956 | ∞ | 217.877 |
| M-08 | 1.7585071 | 1.6746582 | 0.1002314 | 0.0451520 | ∞ | 210.626 | 1.7577692 | 1.6626617 | 0.3293141 | 0.1847620 | ∞ | 143.673 |
| M-09 | 1.7247856 | 1.6504741 | 0.1133589 | 0.0315816 | ∞ | 166.946 | 1.8333728 | 1.6038330 | 0.3104587 | 0.1313352 | ∞ | 190.414 |
| M-10 | 1.7635739 | 1.6244198 | 0.1200989 | 0.0237208 | ∞ | 153.287 | 1.9267434 | 1.5504007 | 0.2962768 | 0.1034789 | ∞ | 198.199 |
| M-11 | 1.7687343 | 1.6427834 | 0.1208856 | 0.0152338 | ∞ | 156.634 | 1.9796792 | 1.4797451 | 0.3823795 | 0.0942362 | ∞ | 177.061 |

Table 12-N

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|------|------|------|------|------|------|------|------|------|------|------|------|------|
| N-01 | 1.9898743 | 1.8798206 | 0.2738954 | 0.1482851 | 19.878 | 14.390 | 1.6581080 | 1.4387562 | 0.5750740 | 0.3879157 | ∞ | 77.830 |
| N-02 | 2.0057028 | 1.8241415 | 0.2035070 | 0.0000000 | 19.908 | 9.289 | 1.8381897 | 1.5697363 | 0.4107890 | 0.2056645 | ∞ | 127.168 |
| N-03 | 2.0294681 | 1.8302982 | 0.1644667 | 0.0000000 | 18.910 | 7.978 | 1.8863058 | 1.6083102 | 0.3765767 | 0.1689852 | ∞ | 136.677 |
| N-04 | 1.7721301 | 1.7134985 | 0.1375917 | 0.0523525 | 103.018 | 87.682 | 1.7531814 | 1.5780642 | 0.3294239 | 0.2126075 | 174.502 | 133.130 |
| N-05 | 1.7864489 | 1.7232433 | 0.1217894 | 0.0439756 | 108.908 | 88.852 | 1.8356927 | 1.6197992 | 0.2939229 | 0.1629134 | ∞ | 186.775 |
| N-06 | 1.7745623 | 1.7056377 | 0.1151904 | 0.0308496 | 127.213 | 87.928 | 1.8040840 | 1.5773042 | 0.2657261 | 0.1305882 | ∞ | 195.501 |
| N-07 | 1.7525086 | 1.7111476 | 0.0973459 | 0.0651206 | 178.717 | 159.090 | 1.7729129 | 1.6972781 | 0.2688526 | 0.1986121 | 162.784 | 139.577 |
| N-08 | 1.7600797 | 1.6845035 | 0.1026179 | 0.0367182 | ∞ | 152.101 | 1.7182206 | 1.5603532 | 0.2115874 | 0.1181353 | ∞ | 212.611 |
| N-09 | 1.7225932 | 1.6464408 | 0.1128660 | 0.0335850 | ∞ | 168.513 | 1.8529047 | 1.6091327 | 0.3205476 | 0.1369856 | ∞ | 184.752 |
| N-10 | 1.7091315 | 1.6736102 | 0.0936172 | 0.0551113 | ∞ | 210.524 | 1.7597802 | 1.6848742 | 0.3389807 | 0.2088989 | 167.444 | 138.726 |
| N-11 | 1.7839857 | 1.6195753 | 0.1182756 | 0.0199614 | ∞ | 84.504 | 1.9294443 | 1.5721994 | 0.2803088 | 0.0874462 | ∞ | 225.527 |
| N-12 | 1.7668392 | 1.6435238 | 0.1208574 | 0.0160771 | ∞ | 158.712 | 1.9813165 | 1.4758930 | 0.3860709 | 0.0943253 | ∞ | 168.748 |

Table 12-O

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| O-01 | 1.9745355 | 1.8234942 | 0.2457067 | 0.0746410 | 21.112 | 12.018 | 1.7617983 | 1.5132070 | 0.4902947 | 0.2839715 | ∞ | 112.417 |
| O-02 | 2.0059733 | 1.8307645 | 0.2000360 | 0.0037738 | 20.285 | 9.900 | 1.8500023 | 1.5836144 | 0.4296295 | 0.2199079 | ∞ | 123.209 |
| O-03 | 2.0367482 | 1.8369179 | 0.1737368 | 0.0000000 | 18.405 | 7.972 | 1.8775081 | 1.5995149 | 0.3826412 | 0.1765084 | ∞ | 135.410 |
| O-04 | 1.7750631 | 1.7178732 | 0.1384535 | 0.0554530 | 102.755 | 88.068 | 1.7619051 | 1.5900936 | 0.3474274 | 0.2293012 | 161.256 | 125.106 |
| O-05 | 1.7879382 | 1.7278942 | 0.1207460 | 0.0485292 | 108.257 | 89.506 | 1.8420848 | 1.6311022 | 0.3013680 | 0.1737569 | ∞ | 180.186 |
| O-06 | 1.7738533 | 1.7077535 | 0.1146640 | 0.0340439 | 126.423 | 88.494 | 1.7692212 | 1.5795898 | 0.2681826 | 0.1376150 | ∞ | 190.100 |
| O-07 | 1.7538681 | 1.7161118 | 0.0873451 | 0.0789735 | 179.349 | 160.065 | 1.7761562 | 1.7153773 | 0.2775923 | 0.2090328 | 144.525 | 132.014 |
| O-08 | 1.7588094 | 1.6871175 | 0.1006359 | 0.0395605 | ∞ | 153.368 | 1.7108087 | 1.5673602 | 0.2119811 | 0.1244213 | ∞ | 219.687 |
| O-09 | 1.7035585 | 1.6747463 | 0.0911300 | 0.0586569 | 224.781 | 209.678 | 1.7518392 | 1.6872775 | 0.3528284 | 0.2335193 | 156.082 | 132.286 |
| O-10 | 1.7216346 | 1.6424549 | 0.1134544 | 0.0365623 | ∞ | 169.343 | 1.9264243 | 1.6046848 | 0.3222850 | 0.1392088 | ∞ | 174.721 |
| O-11 | 1.7578687 | 1.6214869 | 0.1197884 | 0.0270357 | ∞ | 157.982 | 1.9250150 | 1.5515628 | 0.3003661 | 0.1065501 | ∞ | 182.350 |
| O-12 | 1.7639572 | 1.6436984 | 0.1209727 | 0.0163487 | ∞ | 159.615 | 1.9791064 | 1.4724890 | 0.3896116 | 0.0995359 | ∞ | 166.016 |

Table12-P

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| P-01 | 1.9847236 | 1.8976008 | 0.2719445 | 0.1774719 | 21.840 | 17.336 | 1.6496701 | 1.4546273 | 0.6962012 | 0.5022034 | ∞ | 67.364 |
| P-02 | 1.9832269 | 1.8392132 | 0.2453629 | 0.0797892 | 20.874 | 12.542 | 1.7646732 | 1.5226603 | 0.5192793 | 0.3142720 | ∞ | 108.306 |
| P-03 | 2.0103767 | 1.8394819 | 0.2038377 | 0.0095908 | 19.974 | 10.197 | 1.8466362 | 1.5845304 | 0.4440382 | 0.2363331 | ∞ | 119.706 |
| P-04 | 2.0432754 | 1.8428372 | 0.1868630 | 0.0000000 | 17.783 | 7.906 | 1.8621291 | 1.5854238 | 0.3866851 | 0.1853595 | ∞ | 156.590 |
| P-05 | 1.7741173 | 1.7242967 | 0.1351302 | 0.0622176 | 101.341 | 88.768 | 1.7509717 | 1.5946826 | 0.3569804 | 0.2534709 | 146.597 | 117.981 |
| P-06 | 1.7856872 | 1.7302709 | 0.1192358 | 0.0539037 | 106.649 | 89.884 | 1.8276629 | 1.6314312 | 0.3016099 | 0.1875450 | ∞ | 174.202 |
| P-07 | 1.7731677 | 1.7111804 | 0.1136218 | 0.0386816 | 126.186 | 89.003 | 1.7503842 | 1.5831662 | 0.2679962 | 0.1463764 | ∞ | 208.563 |
| P-08 | 1.7564437 | 1.6891097 | 0.0959306 | 0.0430851 | ∞ | 153.752 | 1.7024006 | 1.5705427 | 0.2082205 | 0.1320206 | ∞ | 213.283 |
| P-09 | 1.7058157 | 1.6818545 | 0.0973152 | 0.0630500 | 226.401 | 211.558 | 1.7333167 | 1.6658436 | 0.3406044 | 0.2298866 | 148.002 | 123.372 |
| P-10 | 1.7196925 | 1.6496888 | 0.1133306 | 0.0389129 | ∞ | 170.096 | 1.9296571 | 1.5996742 | 0.3232726 | 0.1404846 | ∞ | 163.013 |
| P-11 | 1.7594009 | 1.6325711 | 0.1189345 | 0.0285000 | ∞ | 158.234 | 1.9322292 | 1.5541457 | 0.3011090 | 0.1132977 | ∞ | 171.578 |
| P-12 | 1.7649224 | 1.6433465 | 0.1212459 | 0.0182393 | ∞ | 159.568 | 1.9802461 | 1.4696260 | 0.3928773 | 0.1053419 | ∞ | 160.374 |

Table 12-Q

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| Q-01 | 2.0301412 | 1.9516500 | 0.2802433 | 0.2000761 | 20.310 | 16.839 | 1.6486923 | 1.4686020 | 0.7370642 | 0.5836755 | ∞ | 61.930 |
| Q-02 | 1.9990744 | 1.8621359 | 0.2522920 | 0.0892317 | 19.736 | 12.562 | 1.7518351 | 1.5171305 | 0.5349623 | 0.3426393 | ∞ | 99.977 |
| Q-03 | 2.0220568 | 1.8515978 | 0.2160734 | 0.0179265 | 18.790 | 9.959 | 1.8260112 | 1.5671843 | 0.4476571 | 0.2499471 | ∞ | 116.748 |
| Q-04 | 2.0448172 | 1.8474808 | 0.1930916 | 0.0000000 | 17.491 | 8.015 | 1.8536839 | 1.5798021 | 0.3918840 | 0.1948662 | ∞ | 147.129 |
| Q-05 | 1.7689426 | 1.7318137 | 0.1258563 | 0.0778778 | 98.490 | 89.656 | 1.7032214 | 1.5835534 | 0.3498561 | 0.2776698 | 133.970 | 114.292 |
| Q-06 | 1.7797734 | 1.7309685 | 0.1161205 | 0.0612780 | 104.569 | 90.079 | 1.7924899 | 1.6197165 | 0.2934962 | 0.2003493 | ∞ | 169.394 |
| Q-07 | 1.7717697 | 1.7140060 | 0.1124096 | 0.0432885 | 112.170 | 89.250 | 1.7397149 | 1.5821770 | 0.2646063 | 0.1542864 | ∞ | 174.125 |
| Q-08 | 1.7537336 | 1.6908943 | 0.0895630 | 0.0524731 | ∞ | 153.813 | 1.6934713 | 1.5710677 | 0.2028344 | 0.1384875 | 240.566 | 203.250 |
| Q-09 | 1.7178106 | 1.6574518 | 0.1122228 | 0.0404637 | ∞ | 170.492 | 1.9450080 | 1.6067170 | 0.3264909 | 0.1492765 | ∞ | 155.526 |
| Q-10 | 1.7552943 | 1.6404274 | 0.1183093 | 0.0294128 | ∞ | 161.731 | 1.9406400 | 1.5539676 | 0.3006731 | 0.1184026 | ∞ | 161.325 |
| Q-11 | 1.7551794 | 1.6403857 | 0.1183112 | 0.0293952 | ∞ | 161.718 | 1.9404069 | 1.5538468 | 0.3007591 | 0.1183799 | ∞ | 161.350 |
| Q-12 | 1.7757084 | 1.6344645 | 0.1188561 | 0.0124133 | ∞ | 85.367 | 1.9771388 | 1.4858229 | 0.3725975 | 0.0916295 | ∞ | 172.144 |

Table12-R

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|---------|---------|---------|---------|---------|---------|---------|---------|---------|---------|---------|---------|
| R-01 | 2.0997937 | 2.0218726 | 0.2868782 | 0.2123469 | 17.462 | 15.000 | 1.6335746 | 1.4660111 | 0.7302940 | 0.6251366 | ∞ | 68.681 |
| R-02 | 2.0130213 | 1.8811914 | 0.2647677 | 0.1040938 | 18.475 | 12.286 | 1.7269517 | 1.4965513 | 0.5362372 | 0.3602863 | ∞ | 87.647 |
| R-03 | 2.0224123 | 1.8561904 | 0.2272240 | 0.0320080 | 18.232 | 9.988 | 1.8064078 | 1.5493570 | 0.4487076 | 0.2591703 | ∞ | 111.879 |
| R-04 | 2.0459768 | 1.8476797 | 0.2102645 | 0.0000000 | 16.964 | 7.851 | 1.8312987 | 1.5576781 | 0.3880603 | 0.1975598 | ∞ | 130.490 |
| R-05 | 1.7742699 | 1.7317125 | 0.1117318 | 0.0696713 | 102.013 | 90.234 | 1.7557510 | 1.6037051 | 0.2852255 | 0.2082125 | ∞ | 164.384 |
| R-06 | 1.7702726 | 1.7157072 | 0.1113605 | 0.0466925 | 108.502 | 89.331 | 1.7311532 | 1.5768868 | 0.2610166 | 0.1588267 | ∞ | 165.108 |
| R-07 | 1.7517357 | 1.7009838 | 0.0835762 | 0.0602742 | ∞ | 157.002 | 1.6864580 | 1.5654680 | 0.1997152 | 0.1416243 | 228.056 | 190.676 |
| R-08 | 1.7512891 | 1.6459351 | 0.1177017 | 0.0309195 | ∞ | 163.455 | 1.9510221 | 1.5530143 | 0.3017594 | 0.1226993 | ∞ | 153.276 |
| R-09 | 1.7773648 | 1.6340591 | 0.1184300 | 0.0234996 | ∞ | 86.650 | 1.9395171 | 1.5666778 | 0.2887830 | 0.0998121 | ∞ | 202.089 |
| R-10 | 1.7735603 | 1.6354841 | 0.1192036 | 0.0141670 | ∞ | 86.412 | 1.9807177 | 1.4832299 | 0.3780744 | 0.0917085 | ∞ | 180.638 |

Table12-S

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| S-01 | 2.0136422 | 1.8885299 | 0.2774577 | 0.1261125 | 17.997 | 12.405 | 1.6999863 | 1.4708628 | 0.5421139 | 0.3735593 | $\infty$ | 79.704 |
| S-02 | 2.0179864 | 1.8567706 | 0.2336282 | 0.0459598 | 18.296 | 10.310 | 1.7965693 | 1.5368732 | 0.4561433 | 0.2657307 | $\infty$ | 103.288 |
| S-03 | 2.0356214 | 1.8463124 | 0.2043087 | 0.0000000 | 17.630 | 8.402 | 1.8376872 | 1.5609879 | 0.3977260 | 0.2025636 | $\infty$ | 128.295 |
| S-04 | 2.0459655 | 1.8181408 | 0.2215369 | 0.0000000 | 16.489 | 6.240 | 1.8197869 | 1.5589385 | 0.3436622 | 0.1577796 | $\infty$ | 150.300 |
| S-05 | 1.7739721 | 1.7341369 | 0.1088796 | 0.0751162 | 100.976 | 90.557 | 1.7425740 | 1.5990974 | 0.2875246 | 0.2124379 | 201.458 | 155.716 |
| S-06 | 1.7704063 | 1.7171543 | 0.1106833 | 0.0483969 | 107.500 | 89.597 | 1.7268572 | 1.5751372 | 0.2630071 | 0.1602715 | $\infty$ | 155.652 |
| S-07 | 1.7674183 | 1.6877796 | 0.1261174 | 0.0222393 | 133.384 | 82.345 | 1.7422344 | 1.5581182 | 0.2468377 | 0.1280254 | $\infty$ | 196.893 |
| S-08 | 1.7513689 | 1.7035698 | 0.0811550 | 0.0633450 | $\infty$ | 158.014 | 1.6835226 | 1.5618026 | 0.2014601 | 0.1426405 | 216.940 | 182.286 |
| S-09 | 1.7586193 | 1.6685973 | 0.1141426 | 0.0240669 | $\infty$ | 83.157 | 1.7654326 | 1.5822356 | 0.2120172 | 0.1163580 | $\infty$ | 237.139 |
| S-10 | 1.7137988 | 1.6680395 | 0.1059657 | 0.0491249 | 229.119 | 204.263 | 1.7697765 | 1.6411901 | 0.3291982 | 0.1743325 | $\infty$ | 144.048 |
| S-11 | 1.7474572 | 1.6485095 | 0.1171196 | 0.0357085 | $\infty$ | 165.072 | 1.8280566 | 1.5510143 | 0.3034436 | 0.1290649 | $\infty$ | 179.186 |
| S-12 | 1.7787527 | 1.6346316 | 0.1183617 | 0.0261766 | $\infty$ | 87.463 | 1.8679541 | 1.5663111 | 0.2911006 | 0.1032185 | $\infty$ | 198.817 |
| S-13 | 1.7726370 | 1.6361368 | 0.1193980 | 0.0162059 | $\infty$ | 87.753 | 1.9860452 | 1.4806863 | 0.3836791 | 0.0927929 | $\infty$ | 179.065 |

Table12-T

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| T-01 | 2.0071627 | 1.8531930 | 0.2293780 | 0.0535149 | 19.498 | 11.301 | 1.8087482 | 1.5440656 | 0.4807519 | 0.2757971 | ∞ | 96.276 |
| T-02 | 2.0380740 | 1.8507900 | 0.2054336 | 0.0000000 | 17.725 | 8.646 | 1.8398399 | 1.5606505 | 0.4070889 | 0.2066897 | ∞ | 128.122 |
| T-03 | 2.0362226 | 1.8173530 | 0.2147614 | 0.0000000 | 17.154 | 6.676 | 1.8245068 | 1.5601331 | 0.3518237 | 0.1608227 | ∞ | 143.088 |
| T-04 | 1.7793794 | 1.7388911 | 0.1095065 | 0.0767807 | 101.335 | 91.113 | 1.7603905 | 1.6140856 | 0.3028634 | 0.2184932 | 183.927 | 143.961 |
| T-05 | 1.7717729 | 1.7189494 | 0.1103797 | 0.0498157 | 107.737 | 90.141 | 1.7242200 | 1.5794166 | 0.2708170 | 0.1629361 | ∞ | 175.561 |
| T-06 | 1.7679862 | 1.6880265 | 0.1268980 | 0.0240806 | 124.939 | 82.648 | 1.7410932 | 1.5606391 | 0.2520278 | 0.1300588 | ∞ | 190.480 |
| T-07 | 1.7518739 | 1.7045277 | 0.0815216 | 0.0632867 | ∞ | 159.022 | 1.6818826 | 1.5663809 | 0.2073629 | 0.1518209 | 206.838 | 177.698 |
| T-08 | 1.7600708 | 1.6726745 | 0.1144826 | 0.0254494 | ∞ | 139.823 | 1.7630023 | 1.5754755 | 0.2168563 | 0.1186166 | ∞ | 229.643 |
| T-09 | 1.7051240 | 1.6697920 | 0.1003223 | 0.0587171 | 226.744 | 206.645 | 1.7525371 | 1.6631462 | 0.3344603 | 0.2017687 | ∞ | 142.304 |
| T-10 | 1.7430137 | 1.6479600 | 0.1171742 | 0.0413661 | ∞ | 167.230 | 1.8275987 | 1.5443101 | 0.3097891 | 0.1370877 | ∞ | 186.344 |
| T-11 | 1.7810721 | 1.6321133 | 0.1183301 | 0.0288819 | ∞ | 88.546 | 1.8621889 | 1.5669606 | 0.2928605 | 0.1036052 | ∞ | 199.275 |
| T-12 | 1.7725015 | 1.6365482 | 0.1194554 | 0.0184532 | ∞ | 149.323 | 1.9935768 | 1.4771388 | 0.3888085 | 0.0925146 | ∞ | 172.969 |

Table13-A

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| A-01 | 2.1720487 | 2.0190360 | 0.0998073 | 0.0000000 | 29.506 | 23.369 | 4.5065450 | 3.9578561 | 2.13780229 | 2.1435612 | 4.090 | 3.199 |
| A-02 | 1.9889280 | 1.8532359 | 0.2334903 | 0.0957523 | 40.861 | 31.817 | 5.6119745 | 5.3730219 | 0.7593911 | 0.4942458 | 19.555 | 18.637 |
| A-03 | 1.9671128 | 1.8414524 | 0.2024214 | 0.0689180 | 37.381 | 27.259 | 2.5652264 | 2.2714947 | 0.7753194 | 0.4656319 | 57.845 | 47.163 |
| A-04 | 1.9818233 | 1.8170308 | 0.1951662 | 0.0068434 | 20.293 | 9.724 | 1.8180698 | 1.5583872 | 0.3718271 | 0.1895773 | ∞ | 136.446 |
| A-05 | 1.9562672 | 1.8281300 | 0.1673451 | 0.0214857 | 27.313 | 16.058 | 1.9456153 | 1.6882910 | 0.5144381 | 0.2722945 | ∞ | 111.570 |
| A-06 | 1.9807221 | 1.7876777 | 0.2011579 | 0.0000000 | 19.841 | 7.438 | 1.8007663 | 1.5635593 | 0.3207222 | 0.1502473 | ∞ | 149.473 |
| A-07 | 1.8477035 | 1.7783786 | 0.1276783 | 0.0621241 | 112.872 | 101.764 | 4.4702166 | 4.3197430 | 0.4936521 | 0.3719016 | 24.460 | 23.543 |
| A-08 | 1.8224279 | 1.7640502 | 0.1206546 | 0.0598782 | 109.093 | 96.415 | 2.0949539 | 1.9156192 | 0.4653894 | 0.3255164 | 71.691 | 61.322 |
| A-09 | 1.7594524 | 1.7017583 | 0.1133712 | 0.0352231 | 113.681 | 90.604 | 1.7043860 | 1.5829468 | 0.2440392 | 0.1526501 | ∞ | 189.898 |
| A-10 | 1.7683655 | 1.6933740 | 0.1175121 | 0.0195678 | 146.462 | 86.025 | 1.7594853 | 1.5976201 | 0.2284733 | 0.1247184 | ∞ | 231.889 |
| A-11 | 1.7806570 | 1.7073575 | 0.1027419 | 0.0494937 | 227.274 | 185.181 | 7.2591935 | 6.3528446 | 3.7059257 | 2.7293571 | 0.934 | 0.744 |
| A-12 | 1.7460918 | 1.6726421 | 0.0978655 | 0.0306414 | ∞ | 149.169 | 1.7205796 | 1.6010007 | 0.2122593 | 0.1421446 | 224.021 | 188.041 |
| A-13 | 1.7591885 | 1.6605032 | 0.1011064 | 0.0244145 | ∞ | 85.953 | 1.7820661 | 1.6423652 | 0.1952622 | 0.1147092 | ∞ | 243.262 |
| A-14 | 1.7274503 | 1.6161759 | 0.1087495 | 0.0364692 | 256.667 | 193.721 | 7.3492621 | 6.3559101 | 3.2428967 | 2.4345312 | 1.113 | 0.817 |
| A-15 | 1.7084944 | 1.6283283 | 0.1074482 | 0.0502449 | 227.699 | 193.038 | 1.8948007 | 1.7452865 | 0.3962294 | 0.2420534 | 101.616 | 81.255 |
| A-16 | 1.7187472 | 1.6392965 | 0.1177469 | 0.0400931 | 234.733 | 182.491 | 1.8371357 | 1.6447383 | 0.3386903 | 0.1579871 | ∞ | 143.559 |
| A-17 | 1.7377446 | 1.6454277 | 0.1181421 | 0.0282214 | ∞ | 175.647 | 1.8609832 | 1.5256023 | 0.3213354 | 0.1196655 | ∞ | 150.106 |
| A-18 | 1.7725168 | 1.6331589 | 0.1071119 | 0.0192664 | ∞ | 91.095 | 1.9009256 | 1.5809647 | 0.2728278 | 0.1014801 | ∞ | 185.131 |
| A-19 | 1.7616261 | 1.6593531 | 0.1098955 | 0.0221647 | ∞ | 171.453 | 1.9704240 | 1.4713309 | 0.4066631 | 0.1097856 | ∞ | 137.110 |

Table 13-B

| Case | $n_{1-max}$ | $n_{1-min}$ | $k_{1-max}$ | $k_{1-min}$ in | $d_{1-max}$ | $d_{1-min}$ | $n_{2-max}$ | $n_{2-min}$ | $k_{2-max}$ | $k_{2-min}$ in | $d_{2-max}$ | $d_{2-min}$ |
|---|---|---|---|---|---|---|---|---|---|---|---|---|
| B-01 | 1.9452543 | 1.8183525 | 0.2592155 | 0.1277543 | 42.717 | 33.586 | 7.0526945 | 6.7683586 | 0.8545920 | 0.5492502 | 14.590 | 13.980 |
| B-02 | 1.9596236 | 1.8362764 | 0.1731162 | 0.0325913 | 27.463 | 16.960 | 1.9622040 | 1.7030756 | 0.5536742 | 0.3010973 | ∞ | 107.506 |
| B-03 | 1.9813839 | 1.8242757 | 0.1934821 | 0.0125348 | 20.541 | 10.411 | 1.8214473 | 1.5655196 | 0.3895985 | 0.2047950 | ∞ | 131.100 |
| B-04 | 1.9821434 | 1.7946251 | 0.2012578 | 0.0000000 | 19.749 | 7.864 | 1.7998074 | 1.5618948 | 0.3311011 | 0.1597047 | ∞ | 145.037 |
| B-05 | 1.8517543 | 1.7899355 | 0.1313438 | 0.0698594 | 110.382 | 100.265 | 5.8281493 | 5.6682336 | 0.5711405 | 0.4462284 | 17.468 | 16.967 |
| B-06 | 1.7589124 | 1.7062293 | 0.1118213 | 0.0409619 | 111.426 | 91.607 | 1.6974565 | 1.5840605 | 0.2492018 | 0.1637367 | ∞ | 183.632 |
| B-07 | 1.7676802 | 1.6970027 | 0.1167957 | 0.0231251 | 123.542 | 87.137 | 1.7571242 | 1.5998537 | 0.2327001 | 0.1321935 | ∞ | 226.644 |
| B-08 | 1.7763495 | 1.7235333 | 0.0863733 | 0.0786401 | 209.450 | 181.880 | 5.6463193 | 5.0251755 | 4.7411024 | 3.9364503 | 0.821 | 0.680 |
| B-09 | 1.7445883 | 1.6767453 | 0.0939346 | 0.0375784 | ∞ | 151.396 | 1.7112989 | 1.6068445 | 0.2158696 | 0.1524272 | 210.231 | 181.611 |
| B-10 | 1.7574612 | 1.6624258 | 0.0986454 | 0.0290140 | ∞ | 135.564 | 1.7808669 | 1.6556117 | 0.1973236 | 0.1215289 | ∞ | 237.437 |
| B-11 | 1.7109823 | 1.6137790 | 0.0997165 | 0.0532321 | 242.436 | 193.346 | 6.2633792 | 5.3764346 | 4.3274325 | 3.5194222 | 0.991 | 0.726 |
| B-12 | 1.6962709 | 1.6298000 | 0.1011874 | 0.0612521 | 222.057 | 196.217 | 1.9128981 | 1.7709938 | 0.4189358 | 0.2786453 | 90.120 | 74.349 |
| B-13 | 1.7132967 | 1.6391097 | 0.1158834 | 0.0465535 | 229.378 | 184.815 | 1.8363492 | 1.6606949 | 0.3455863 | 0.1751285 | ∞ | 137.424 |
| B-14 | 1.7338443 | 1.6454556 | 0.1188319 | 0.0316590 | ∞ | 177.305 | 1.8516317 | 1.5221517 | 0.3265697 | 0.1272105 | ∞ | 143.802 |
| B-15 | 1.7458965 | 1.6358331 | 0.1072745 | 0.0218863 | ∞ | 137.681 | 1.9039898 | 1.5828362 | 0.2766013 | 0.1068491 | ∞ | 179.079 |
| B-16 | 1.7605337 | 1.6620962 | 0.1100645 | 0.0246727 | ∞ | 173.308 | 1.9804345 | 1.4648107 | 0.4162560 | 0.1165234 | ∞ | 132.389 |
| B-17 | 1.7751843 | 1.6392688 | 0.1108102 | 0.0187265 | ∞ | 91.227 | 1.9686516 | 1.4881328 | 0.3955979 | 0.0946164 | ∞ | 141.476 |

EP 1 760 766 A2

Table13-C

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| C-01 | 1.9025379 | 1.7929090 | 0.2878348 | 0.1649490 | 43.365 | 35.188 | 4.9640531 | 4.6075296 | 0.9846002 | 0.6056513 | 20.823 | 19.261 |
| C-02 | 1.9716347 | 1.8539125 | 0.1752020 | 0.0409320 | 27.454 | 18.040 | 2.0121051 | 1.7498504 | 0.6140520 | 0.3407427 | ∞ | 100.236 |
| C-03 | 1.9799544 | 1.8302413 | 0.1965994 | 0.0220193 | 20.598 | 11.008 | 1.8161176 | 1.5657954 | 0.4056733 | 0.2211860 | ∞ | 126.931 |
| C-04 | 1.9864218 | 1.8036777 | 0.2004793 | 0.0000000 | 19.499 | 8.235 | 1.8003554 | 1.5619667 | 0.3429599 | 0.1708627 | ∞ | 170.369 |
| C-05 | 1.8555780 | 1.8119708 | 0.1375602 | 0.0936905 | 105.753 | 98.281 | 5.7336181 | 5.5695654 | 0.6183223 | 0.4948176 | 17.141 | 16.642 |
| C-06 | 1.7574013 | 1.7107521 | 0.1098073 | 0.0471621 | 109.284 | 92.424 | 1.6892691 | 1.5858767 | 0.2550937 | 0.1774106 | ∞ | 177.629 |
| C-07 | 1.7671343 | 1.7011102 | 0.1159156 | 0.0269898 | 116.762 | 88.159 | 1.7562868 | 1.6040395 | 0.2374867 | 0.1407631 | ∞ | 220.550 |
| C-08 | 1.7414378 | 1.6903038 | 0.0890222 | 0.0452270 | ∞ | 159.859 | 1.7014705 | 1.6183980 | 0.2210881 | 0.1650225 | 197.102 | 175.552 |
| C-09 | 1.7557447 | 1.6650428 | 0.0952628 | 0.0349222 | ∞ | 138.687 | 1.7813503 | 1.6705654 | 0.1992455 | 0.1291564 | 285.808 | 232.461 |
| C-10 | 1.7080327 | 1.6395647 | 0.1116081 | 0.0549822 | 220.890 | 187.682 | 1.8374498 | 1.6784593 | 0.3525581 | 0.2020588 | ∞ | 132.217 |
| C-11 | 1.7300752 | 1.6460151 | 0.1196827 | 0.0356226 | ∞ | 178.935 | 1.8492558 | 1.5188530 | 0.3325269 | 0.1361670 | ∞ | 139.642 |
| C-12 | 1.7396481 | 1.6415548 | 0.1074472 | 0.0249850 | ∞ | 141.690 | 1.9105740 | 1.5866092 | 0.2815319 | 0.1134362 | ∞ | 198.401 |
| C-13 | 1.7563944 | 1.6646000 | 0.1100978 | 0.0276710 | ∞ | 174.875 | 1.9927799 | 1.4565116 | 0.4273612 | 0.1239762 | ∞ | 127.927 |
| C-14 | 1.7747873 | 1.6404196 | 0.1109873 | 0.0213816 | ∞ | 143.313 | 1.9792213 | 1.4864771 | 0.4038529 | 0.0993424 | ∞ | 136.771 |

Table13-D

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| D-01 | 1.9490966 | 1.8500842 | 0.2647931 | 0.1401459 | 35.207 | 28.244 | 2.6311080 | 2.2700265 | 1.1076331 | 0.7427894 | 45.953 | 36.141 |
| D-02 | 1.9914392 | 1.8780786 | 0.1798526 | 0.0501163 | 25.772 | 17.691 | 2.0162696 | 1.7538672 | 0.6433846 | 0.3774728 | ∞ | 94.106 |
| D-03 | 1.9816604 | 1.8366482 | 0.2034537 | 0.0329594 | 20.194 | 11.243 | 1.8013721 | 1.5581067 | 0.4155671 | 0.2353864 | ∞ | 122.408 |
| D-04 | 1.9856163 | 1.8069420 | 0.2051578 | 0.0023074 | 19.386 | 8.506 | 1.7929679 | 1.5568815 | 0.3495088 | 0.1791182 | ∞ | 164.498 |
| D-05 | 1.7549914 | 1.7131823 | 0.1089697 | 0.0521081 | 106.541 | 92.615 | 1.6794153 | 1.5838159 | 0.2592041 | 0.1895496 | 201.172 | 170.921 |
| D-06 | 1.7669110 | 1.7047382 | 0.1153749 | 0.0305763 | 113.648 | 88.847 | 1.7581593 | 1.6081385 | 0.2411728 | 0.1480734 | ∞ | 213.836 |
| D-07 | 1.7381767 | 1.6971854 | 0.0857519 | 0.0501367 | 186.218 | 161.719 | 1.6970322 | 1.6330649 | 0.2270587 | 0.1762567 | 186.228 | 168.269 |
| D-08 | 1.7545493 | 1.6677902 | 0.0908813 | 0.0421582 | ∞ | 156.552 | 1.7806194 | 1.6878813 | 0.1994956 | 0.1354429 | 270.383 | 227.465 |
| D-09 | 1.6987657 | 1.6408080 | 0.1062771 | 0.0636318 | 217.801 | 189.505 | 1.8295289 | 1.6886683 | 0.3581889 | 0.2377885 | ∞ | 128.894 |
| D-10 | 1.7270953 | 1.6471258 | 0.1204663 | 0.0383618 | ∞ | 180.122 | 1.8391835 | 1.5896461 | 0.3384880 | 0.1435869 | ∞ | 174.139 |
| D-11 | 1.7345322 | 1.6490573 | 0.1075499 | 0.0277684 | ∞ | 165.143 | 1.9196510 | 1.5922999 | 0.2869411 | 0.1211074 | ∞ | 196.987 |
| D-12 | 1.7517544 | 1.6662856 | 0.1098805 | 0.0311830 | ∞ | 175.693 | 2.0019474 | 1.4458781 | 0.4376849 | 0.1318597 | ∞ | 123.262 |
| D-13 | 1.7748217 | 1.6409606 | 0.1111181 | 0.0236791 | ∞ | 146.934 | 1.9872990 | 1.4839165 | 0.4097955 | 0.1027825 | ∞ | 170.430 |

Table13-E

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| E-01 | 2.0138007 | 1.9025812 | 0.1889196 | 0.0602526 | 22.865 | 16.001 | 1.9517183 | 1.6887202 | 0.6154098 | 0.3933761 | $\infty$ | 92.397 |
| E-02 | 1.9781991 | 1.8343526 | 0.2198663 | 0.0499591 | 19.581 | 11.070 | 1.7660977 | 1.5304996 | 0.4097111 | 0.2391227 | $\infty$ | 117.454 |
| E-03 | 1.9860758 | 1.8081461 | 0.2103990 | 0.0075316 | 19.209 | 8.559 | 1.7856337 | 1.5530104 | 0.3519891 | 0.1831903 | $\infty$ | 154.955 |
| E-04 | 1.7526647 | 1.7120483 | 0.1113963 | 0.0527354 | 104.884 | 92.053 | 1.6731353 | 1.5761126 | 0.2626584 | 0.1956784 | 189.469 | 162.622 |
| E-05 | 1.7675140 | 1.7072308 | 0.1157390 | 0.0332708 | 111.601 | 89.149 | 1.7648363 | 1.6096801 | 0.2435865 | 0.1516420 | $\infty$ | 209.841 |
| E-06 | 1.7363451 | 1.6941563 | 0.0885443 | 0.0473541 | 183.090 | 160.396 | 1.7020267 | 1.6379178 | 0.2340864 | 0.1822016 | 178.708 | 160.580 |
| E-07 | 1.7545300 | 1.7026538 | 0.0850531 | 0.0512311 | $\infty$ | 160.625 | 1.7832820 | 1.7053169 | 0.1967562 | 0.1381600 | 259.555 | 221.269 |
| E-08 | 1.6929448 | 1.6424138 | 0.1017383 | 0.0689490 | 211.936 | 190.074 | 1.8067440 | 1.6852377 | 0.3671092 | 0.2694310 | 159.707 | 125.117 |
| E-09 | 1.7250539 | 1.6484621 | 0.1212697 | 0.0367433 | $\infty$ | 180.516 | 1.8295455 | 1.6171810 | 0.3450742 | 0.1501022 | $\infty$ | 175.998 |
| E-10 | 1.7298898 | 1.6531284 | 0.1076218 | 0.0303317 | $\infty$ | 168.497 | 1.9273671 | 1.5988368 | 0.2920246 | 0.1269904 | $\infty$ | 191.986 |
| E-11 | 1.7409431 | 1.6315669 | 0.1134179 | 0.0186621 | $\infty$ | 168.451 | 1.9123265 | 1.5410692 | 0.2838135 | 0.1011768 | $\infty$ | 202.118 |
| E-12 | 1.7485114 | 1.6667341 | 0.1093856 | 0.0333688 | $\infty$ | 219.421 | 2.0081308 | 1.4338083 | 0.4451714 | 0.1397307 | $\infty$ | 117.893 |
| E-13 | 1.7754004 | 1.6404821 | 0.1112097 | 0.0251624 | $\infty$ | 148.812 | 1.9944125 | 1.4804354 | 0.4116154 | 0.1061955 | $\infty$ | 165.119 |

Table13-F

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| F-01 | 1.9601257 | 1.8751892 | 0.3059474 | 0.2095522 | 25.202 | 20.234 | 1.8164468 | 1.5980789 | 0.8705184 | 0.6940072 | 67.900 | 46.117 |
| F-02 | 2.0398589 | 1.9260429 | 0.2002151 | 0.0695450 | 20.308 | 14.445 | 1.8904816 | 1.6179829 | 0.5766885 | 0.3887588 | $\infty$ | 96.498 |
| F-03 | 1.9843691 | 1.8078542 | 0.2076175 | 0.0073966 | 19.525 | 8.746 | 1.7884408 | 1.5555782 | 0.3571135 | 0.1854875 | $\infty$ | 143.521 |
| F-04 | 2.0084257 | 1.8129240 | 0.1683376 | 0.0000000 | 19.037 | 7.510 | 1.8454836 | 1.5945668 | 0.3328661 | 0.1544884 | $\infty$ | 154.427 |
| F-05 | 1.7523979 | 1.7088750 | 0.1161001 | 0.0495242 | 104.457 | 91.092 | 1.6765101 | 1.5701270 | 0.2688829 | 0.1969664 | 180.251 | 152.144 |
| F-06 | 1.7698912 | 1.7095091 | 0.1165811 | 0.0350662 | 111.229 | 89.360 | 1.7772955 | 1.6126178 | 0.2470494 | 0.1523058 | $\infty$ | 203.120 |
| F-07 | 1.7769446 | 1.7170251 | 0.1016549 | 0.0334897 | 134.838 | 91.411 | 1.8125328 | 1.6161814 | 0.2312145 | 0.1247643 | $\infty$ | 199.671 |
| F-08 | 1.7370295 | 1.6882441 | 0.0943208 | 0.0411897 | 181.068 | 157.804 | 1.7003284 | 1.6371863 | 0.2429774 | 0.1834571 | 171.941 | 151.928 |
| F-09 | 1.6920769 | 1.6453411 | 0.1008406 | 0.0681978 | 210.713 | 190.231 | 1.7841289 | 1.6733965 | 0.3812454 | 0.2788296 | 146.846 | 119.488 |
| F-10 | 1.7264082 | 1.6534724 | 0.1079604 | 0.0318447 | $\infty$ | 170.823 | 1.9308751 | 1.6039207 | 0.2961533 | 0.1293661 | $\infty$ | 190.337 |
| F-11 | 1.7465606 | 1.6650152 | 0.1088619 | 0.0347884 | $\infty$ | 228.442 | 2.0212950 | 1.4255198 | 0.4483772 | 0.1442353 | $\infty$ | 111.164 |
| F-12 | 1.7757445 | 1.6384728 | 0.1115386 | 0.0258965 | $\infty$ | 150.216 | 2.0078258 | 1.4788219 | 0.4125950 | 0.1076340 | $\infty$ | 159.321 |

Table13-G

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| G-01 | 1.9471190 | 1.8573741 | 0.3315141 | 0.2613530 | 25.708 | 20.801 | 1.7346194 | 1.5675979 | 0.8995689 | 0.7093589 | 57.803 | 41.774 |
| G-02 | 2.0474789 | 1.9374899 | 0.2088960 | 0.0864229 | 19.832 | 14.615 | 1.8673658 | 1.5897706 | 0.5817484 | 0.3973966 | ∞ | 93.058 |
| G-03 | 1.9824239 | 1.8085042 | 0.2044057 | 0.0083254 | 19.974 | 9.072 | 1.7932069 | 1.5573939 | 0.3649680 | 0.1893626 | ∞ | 136.351 |
| G-04 | 2.0062979 | 1.8143570 | 0.1686660 | 0.0000000 | 19.321 | 7.796 | 1.8473259 | 1.5928289 | 0.3376682 | 0.1570847 | ∞ | 145.892 |
| G-05 | 1.7542439 | 1.7081697 | 0.1184925 | 0.0494801 | 104.746 | 90.724 | 1.6837980 | 1.5715116 | 0.2785474 | 0.2005334 | 169.521 | 142.006 |
| G-06 | 1.7726238 | 1.7123699 | 0.1166609 | 0.0367756 | 111.419 | 89.772 | 1.7864160 | 1.6184643 | 0.2526557 | 0.1551459 | ∞ | 194.224 |
| G-07 | 1.7769720 | 1.7186492 | 0.1001777 | 0.0365461 | 133.697 | 92.110 | 1.8134719 | 1.6157778 | 0.2332031 | 0.1268811 | ∞ | 191.112 |
| G-08 | 1.7390786 | 1.6892495 | 0.0966088 | 0.0411779 | 182.665 | 157.660 | 1.7041582 | 1.6407695 | 0.2518775 | 0.1865211 | 161.346 | 142.069 |
| G-09 | 1.6887905 | 1.6453286 | 0.0973769 | 0.0726992 | 209.133 | 191.092 | 1.7774116 | 1.6679475 | 0.3796946 | 0.25363316 | 138.525 | 111.328 |
| G-10 | 1.7248233 | 1.6512222 | 0.1084745 | 0.0324198 | ∞ | 172.081 | 1.9278793 | 1.6042319 | 0.2985623 | 0.1295572 | ∞ | 181.325 |
| G-11 | 1.7415236 | 1.6337892 | 0.1142946 | 0.0196535 | ∞ | 171.726 | 1.9107844 | 1.5352327 | 0.2910079 | 0.1017293 | ∞ | 187.270 |
| G-12 | 1.7466067 | 1.6612588 | 0.1088919 | 0.0376638 | ∞ | 228.714 | 2.0528886 | 1.4261516 | 0.4501809 | 0.1479690 | ∞ | 101.396 |
| G-13 | 1.7738118 | 1.6458235 | 0.1122805 | 0.0265700 | ∞ | 159.120 | 2.0320602 | 1.4814572 | 0.4174486 | 0.1095128 | ∞ | 145.121 |

Table13-H

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| H-01 | 1.9093820 | 1.8390537 | 0.3581090 | 0.3272350 | 29.940 | 26.410 | 1.7829342 | 1.6468966 | 1.0386247 | 0.8996928 | 39.677 | 31.112 |
| H-02 | 2.0153745 | 1.9174009 | 0.2170380 | 0.1093354 | 22.851 | 17.243 | 1.8883866 | 1.6174735 | 0.6634327 | 0.4395423 | ∞ | 79.893 |
| H-03 | 1.9647302 | 1.8297937 | 0.2253126 | 0.0678554 | 20.636 | 12.234 | 1.7389105 | 1.5164728 | 0.4345124 | 0.2586530 | ∞ | 120.529 |
| H-04 | 1.9816545 | 1.8137492 | 0.2011229 | 0.0106774 | 20.275 | 9.608 | 1.7978418 | 1.5579065 | 0.3780034 | 0.1994548 | ∞ | 131.911 |
| H-05 | 2.0013018 | 1.8177386 | 0.1627260 | 0.0000000 | 19.873 | 8.421 | 1.8560649 | 1.6039469 | 0.3499451 | 0.1657655 | ∞ | 140.113 |
| H-06 | 1.7560430 | 1.7139226 | 0.1150517 | 0.0520707 | 104.620 | 91.864 | 1.6805590 | 1.5776964 | 0.2869340 | 0.2123088 | 157.090 | 134.545 |
| H-07 | 1.7725726 | 1.7150690 | 0.1151625 | 0.0393056 | 110.839 | 90.428 | 1.7830767 | 1.6227447 | 0.2580841 | 0.1632562 | ∞ | 185.077 |
| H-08 | 1.7766383 | 1.7198621 | 0.1001326 | 0.0381111 | 133.403 | 92.343 | 1.8062796 | 1.6196317 | 0.2358518 | 0.1327011 | ∞ | 221.572 |
| H-09 | 1.7394490 | 1.6988680 | 0.0902356 | 0.0479724 | 183.123 | 161.331 | 1.7066699 | 1.6515112 | 0.2558938 | 0.1973818 | 148.631 | 134.181 |
| H-10 | 1.7115878 | 1.6495102 | 0.1198603 | 0.0530207 | 224.718 | 182.356 | 1.8305889 | 1.6343743 | 0.3452063 | 0.1726025 | ∞ | 147.380 |
| H-11 | 1.7250872 | 1.6514825 | 0.1088747 | 0.0347902 | ∞ | 172.283 | 1.9233707 | 1.5996781 | 0.2997373 | 0.1316136 | ∞ | 168.021 |
| H-12 | 1.7407140 | 1.6331408 | 0.1141268 | 0.0203096 | ∞ | 172.203 | 1.9100305 | 1.5355896 | 0.2913496 | 0.1035017 | ∞ | 177.622 |
| H-13 | 1.7471031 | 1.6620323 | 0.1096216 | 0.0405774 | ∞ | 228.740 | 1.9466405 | 1.4315233 | 0.4532749 | 0.1524070 | ∞ | 89.869 |
| H-14 | 1.7718386 | 1.6509768 | 0.1128027 | 0.0288159 | ∞ | 164.882 | 2.0503335 | 1.4823147 | 0.4233479 | 0.1126423 | ∞ | 137.200 |
| H-15 | 1.7539891 | 1.6542454 | 0.1129054 | 0.0154677 | ∞ | 171.237 | 1.9652554 | 1.4686978 | 0.3643352 | 0.0975810 | ∞ | 172.706 |

Table13-I

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| I-01 | 1.9841567 | 1.8929470 | 0.2301414 | 0.1309068 | 26.135 | 20.174 | 1.9251687 | 1.6613405 | 0.7847221 | 0.5068730 | $\infty$ | 64.093 |
| I-02 | 1.9731131 | 1.8467130 | 0.2181883 | 0.0672045 | 21.025 | 13.219 | 1.7628328 | 1.5401008 | 0.4720736 | 0.2890182 | $\infty$ | 116.770 |
| I-03 | 1.9847546 | 1.8242615 | 0.2006927 | 0.0159808 | 20.146 | 10.175 | 1.7995335 | 1.5631297 | 0.3942650 | 0.2150157 | $\infty$ | 127.993 |
| I-04 | 2.0018800 | 1.8207325 | 0.1729103 | 0.0000000 | 19.553 | 8.557 | 1.8422081 | 1.5923558 | 0.3552220 | 0.1740733 | $\infty$ | 166.372 |
| I-05 | 1.7566279 | 1.7248505 | 0.1029259 | 0.0701745 | 103.501 | 93.887 | 1.6611144 | 1.5864965 | 0.2916410 | 0.2339676 | 141.696 | 128.328 |
| I-06 | 1.7699579 | 1.7183673 | 0.1118467 | 0.0445969 | 109.157 | 91.375 | 1.7640520 | 1.6224517 | 0.2611314 | 0.1755796 | 231.191 | 176.991 |
| I-07 | 1.7753265 | 1.7210064 | 0.1002917 | 0.0397436 | 120.772 | 92.361 | 1.7925457 | 1.6258159 | 0.2371088 | 0.1409162 | $\infty$ | 216.536 |
| I-08 | 1.7067245 | 1.6474765 | 0.1150085 | 0.0641564 | 216.898 | 185.483 | 1.8393351 | 1.6593778 | 0.3351860 | 0.1964641 | $\infty$ | 138.890 |
| I-09 | 1.7261004 | 1.6554363 | 0.1093842 | 0.0385285 | $\infty$ | 172.421 | 1.9258761 | 1.5944381 | 0.3017928 | 0.1380501 | $\infty$ | 163.419 |
| I-10 | 1.7392219 | 1.6324251 | 0.1138139 | 0.0221025 | $\infty$ | 172.382 | 1.9139888 | 1.5370320 | 0.2915926 | 0.1098275 | $\infty$ | 172.892 |
| 1-11 | 1.7455957 | 1.66721535 | 0.1103795 | 0.0435045 | $\infty$ | 231.378 | 1.9406390 | 1.4314495 | 0.4647047 | 0.1613698 | $\infty$ | 80.857 |
| 1-12 | 1.7709553 | 1.65405301 | 0.1126674 | 0.0312832 | $\infty$ | 167.534 | 2.0446573 | 1.4763028 | 0.4301550 | 0.1186498 | $\infty$ | 132.049 |
| 1-13 | 1.7543354 | 1.6537299 | 0.1132541 | 0.0174070 | $\infty$ | 171.646 | 1.9679887 | 1.4740873 | 0.3703755 | 0.1029109 | $\infty$ | 167.788 |

Table13-J

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| J-01 | 1.9809075 | 1.8980328 | 0.2448835 | 0.1566767 | 26.306 | 21.064 | 1.9050955 | 1.6655740 | 0.8575543 | 0.5893231 | $\infty$ | 57.567 |
| J-02 | 1.9881326 | 1.8692972 | 0.2155252 | 0.0721035 | 20.742 | 13.818 | 1.7803324 | 1.5606498 | 0.5095133 | 0.3258134 | $\infty$ | 108.866 |
| J-03 | 1.9898169 | 1.8353260 | 0.2061805 | 0.0251796 | 19.620 | 10.507 | 1.7925299 | 1.5591828 | 0.4068723 | 0.2312852 | $\infty$ | 124.252 |
| J-04 | 2.0048289 | 1.8259971 | 0.1826240 | 0.0000000 | 19.044 | 8.651 | 1.8295110 | 1.5813860 | 0.3602975 | 0.1831844 | $\infty$ | 161.817 |
| J-05 | 1.7658057 | 1.7224231 | 0.1070729 | 0.0531483 | 106.864 | 92.263 | 1.7399591 | 1.6212152 | 0.2614146 | 0.1896323 | 211.022 | 171.335 |
| J-06 | 1.7732110 | 1.7227862 | 0.0990467 | 0.0434144 | 114.284 | 92.503 | 1.7771808 | 1.6275751 | 0.2355823 | 0.1495093 | $\infty$ | 209.798 |
| J-07 | 1.7028489 | 1.6476670 | 0.1109898 | 0.0702586 | 213.854 | 188.154 | 1.8328545 | 1.6746514 | 0.3355229 | 0.2162711 | $\infty$ | 137.496 |
| J-08 | 1.7260375 | 1.6612267 | 0.1098660 | 0.0429837 | $\infty$ | 173.185 | 1.9344686 | 1.5926693 | 0.3061048 | 0.1491712 | $\infty$ | 156.257 |
| J-09 | 1.7377532 | 1.6400237 | 0.1135634 | 0.0248634 | $\infty$ | 172.921 | 1.9216875 | 1.5602507 | 0.2945493 | 0.1157554 | $\infty$ | 166.398 |
| J-10 | 1.7432131 | 1.6726882 | 0.1106529 | 0.0472960 | $\infty$ | 247.837 | 1.9339555 | 1.4222282 | 0.4804307 | 0.1767479 | $\infty$ | 111.927 |
| J-11 | 1.7714442 | 1.6572890 | 0.1121622 | 0.0341617 | $\infty$ | 175.103 | 2.0302923 | 1.4667157 | 0.4416960 | 0.1265007 | $\infty$ | 127.501 |
| J-12 | 1.7541063 | 1.6537206 | 0.1135956 | 0.0198615 | $\infty$ | 172.350 | 1.9712389 | 1.4738671 | 0.3773772 | 0.1079912 | $\infty$ | 160.845 |

Table13-K

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| K-01 | 1.9983178 | 1.8855456 | 0.2261637 | 0.0864859 | 19.642 | 13.634 | 1.7551188 | 1.5425749 | 0.5160287 | 0.3496236 | $\infty$ | 101.168 |
| K-02 | 1.9943696 | 1.8437141 | 0.2144343 | 0.0355134 | 18.947 | 10.561 | 1.7797548 | 1.5498598 | 0.4126749 | 0.2439115 | $\infty$ | 119.800 |
| K-03 | 2.0067215 | 1.8310354 | 0.1870831 | 0.0000000 | 18.717 | 8.788 | 1.8239278 | 1.5771676 | 0.3649829 | 0.1909253 | $\infty$ | 152.483 |
| K-04 | 1.7619875 | 1.7257045 | 0.1017354 | 0.0632027 | 104.095 | 92.685 | 1.7185071 | 1.6159717 | 0.2598226 | 0.2008932 | 193.826 | 168.385 |
| K-05 | 1.7711748 | 1.7252984 | 0.0957368 | 0.0496724 | 110.785 | 92.811 | 1.7607140 | 1.6239305 | 0.2306492 | 0.1559959 | $\infty$ | 219.660 |
| K-06 | 1.7022734 | 1.6493950 | 0.1134178 | 0.0651537 | 212.165 | 190.849 | 1.7995431 | 1.6648067 | 0.3598415 | 0.2134096 | $\infty$ | 134.580 |
| K-07 | 1.7240928 | 1.6675706 | 0.1098594 | 0.0468406 | $\infty$ | 202.765 | 1.7562963 | 1.5963244 | 0.3135005 | 0.1629353 | $\infty$ | 149.959 |
| K-08 | 1.7366122 | 1.6471493 | 0.1133195 | 0.0279789 | $\infty$ | 174.035 | 1.9321537 | 1.5760624 | 0.2991336 | 0.1222012 | $\infty$ | 182.726 |
| K-09 | 1.7531614 | 1.6544041 | 0.1138496 | 0.0224971 | $\infty$ | 173.378 | 1.9783548 | 1.4640140 | 0.3838800 | 0.1110187 | $\infty$ | 151.059 |

Table13-L

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| L-01 | 2.0549494 | 1.9887104 | 0.2687077 | 0.2213457 | 19.375 | 16.797 | 1.6842111 | 1.5646066 | 0.7318220 | 0.6514497 | 76.651 | 63.140 |
| L-02 | 1.9979471 | 1.8909061 | 0.2424568 | 0.1060383 | 18.688 | 13.351 | 1.7090749 | 1.5053408 | 0.5051735 | 0.3567702 | $\infty$ | 91.445 |
| L-03 | 1.9920916 | 1.8443560 | 0.2225708 | 0.0470434 | 18.723 | 10.651 | 1.7668473 | 1.5375419 | 0.4148873 | 0.2500704 | $\infty$ | 113.125 |
| L-04 | 2.0115430 | 1.8368860 | 0.1884994 | 0.0000000 | 18.392 | 8.839 | 1.8244176 | 1.5756615 | 0.3690709 | 0.1951304 | $\infty$ | 140.380 |
| L-05 | 1.7612213 | 1.7281036 | 0.0984884 | 0.0707686 | 102.646 | 92.769 | 1.7117523 | 1.6117230 | 0.2612885 | 0.2063629 | 181321 | 163.500 |
| L-06 | 1.7706322 | 1.7284716 | 0.0898852 | 0.0580602 | 109.099 | 93.388 | 1.7381805 | 1.6195807 | 0.2239787 | 0.1587114 | $\infty$ | 217.375 |
| L-07 | 1.7208195 | 1.6729631 | 0.1077789 | 0.0497272 | $\infty$ | 209.751 | 1.7454937 | 1.6066082 | 0.3249477 | 0.1758596 | $\infty$ | 145.915 |
| L-08 | 1.7297676 | 1.6507991 | 0.1133522 | 0.0307998 | $\infty$ | 175.528 | 1.9419145 | 1.5921733 | 0.3049193 | 0.1282140 | $\infty$ | 188.840 |
| L-09 | 1.7556516 | 1.6360813 | 0.1134484 | 0.0213219 | $\infty$ | 95.412 | 1.9237138 | 1.5508817 | 0.2919800 | 0.1031189 | $\infty$ | 202.744 |
| L-10 | 1.7666102 | 1.6463429 | 0.1110591 | 0.0144441 | $\infty$ | 153.332 | 1.9727136 | 1.4886157 | 0.3649983 | 0.0940693 | $\infty$ | 184.106 |

Table13-M

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| M-01 | 1.9868525 | 1.8418415 | 0.2230906 | 0.0537754 | 19.310 | 11.134 | 1.7693119 | 1.5368827 | 0.4273434 | 0.2560434 | ∞ | 103.782 |
| M-02 | 2.0118960 | 1.8413370 | 0.1832860 | 0.0000000 | 18.736 | 9.264 | 1.8361184 | 1.5837515 | 0.3792802 | 0.1990983 | ∞ | 132.806 |
| M-03 | 2.0243543 | 1.8231250 | 0.1937413 | 0.0000000 | 17.384 | 7.159 | 1.8222108 | 1.5748622 | 0.3294630 | 0.1561989 | ∞ | 151.002 |
| M-04 | 1.7654084 | 1.7317244 | 0.0992165 | 0.0739113 | 102.664 | 93.011 | 1.7306377 | 1.6514190 | 0.2706272 | 0.2099826 | 171.773 | 153.191 |
| M-05 | 1.7603752 | 1.6970219 | 0.1104292 | 0.0259297 | 129.169 | 87.896 | 1.7181271 | 1.5764327 | 0.2198406 | 0.1280437 | ∞ | 221.182 |
| M-06 | 1.7175581 | 1.6756245 | 0.1044570 | 0.0533352 | 234.707 | 211.582 | 1.7199356 | 1.6230069 | 0.3386796 | 0.1870792 | ∞ | 140.648 |
| M-07 | 1.7249239 | 1.6504415 | 0.1141074 | 0.0329880 | ∞ | 177.133 | 1.8402671 | 1.6053586 | 0.3133686 | 0.1317597 | ∞ | 190.190 |
| M-08 | 1.7541175 | 1.6375269 | 0.1136307 | 0.0228409 | ∞ | 152.774 | 1.9225920 | 1.5463603 | 0.2962522 | 0.1045323 | ∞ | 198.101 |
| M-09 | 1.7683602 | 1.6451046 | 0.1108928 | 0.0164031 | ∞ | 156.618 | 1.9783298 | 1.4860068 | 0.3698574 | 0.0943533 | ∞ | 177.708 |

Table 13-N

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| N-01 | 1.9802060 | 1.8398252 | 0.2174098 | 0.0552918 | 20.594 | 12.118 | 1.7887242 | 1.5524401 | 0.4540138 | 0.2684120 | ∞ | 101.802 |
| N-02 | 2.0094977 | 1.8465936 | 0.1744820 | 0.0000000 | 19.514 | 10.070 | 1.8565714 | 1.6026591 | 0.3977850 | 0.2082049 | ∞ | 127.773 |
| N-03 | 2.0163723 | 1.8188796 | 0.2044640 | 0.0000000 | 17.628 | 7.361 | 1.8096550 | 1.5641533 | 0.3309958 | 0.1587900 | ∞ | 146.108 |
| N-04 | 1.7720564 | 1.7375373 | 0.0990513 | 0.0786058 | 103.274 | 93.567 | 1.7560699 | 1.6964043 | 0.2853780 | 0.2186654 | 161.266 | 142.146 |
| N-05 | 1.7604234 | 1.6962193 | 0.1120477 | 0.0283831 | 127.006 | 87.715 | 1.7164817 | 1.5788328 | 0.2243987 | 0.1314043 | ∞ | 228.314 |
| N-06 | 1.7553578 | 1.6833412 | 0.1021275 | 0.0355150 | ∞ | 152.787 | 1.7217842 | 1.6187618 | 0.1974327 | 0.1187120 | 289.359 | 232.882 |
| N-07 | 1.7231775 | 1.6453711 | 0.1135182 | 0.0347059 | ∞ | 178.582 | 1.9317098 | 1.6087338 | 0.3195486 | 0.1356838 | ∞ | 184.458 |
| N-08 | 1.7102476 | 1.6752512 | 0.1023288 | 0.0575717 | 232.198 | 211.420 | 1.7127689 | 1.6310648 | 0.3402666 | 0.1958098 | 160.891 | 134.410 |
| N-09 | 1.7512229 | 1.6316648 | 0.1098225 | 0.0189119 | ∞ | 84.503 | 1.9194307 | 1.5689876 | 0.2803327 | 0.0869428 | ∞ | 228.630 |
| N-10 | 1.7697135 | 1.6437662 | 0.1108125 | 0.0177314 | ∞ | 158.635 | 1.9791959 | 1.4825638 | 0.3732863 | 0.0956362 | ∞ | 171.216 |

Table13-O

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| O-01 | 1.9800317 | 1.8447961 | 0.2147271 | 0.0571734 | 21.381 | 12.997 | 1.8077900 | 1.5713801 | 0.4854336 | 0.2914040 | $\infty$ | 112.779 |
| 0-02 | 2.0137085 | 1.8570386 | 0.1692298 | 0.0000000 | 19.769 | 10.712 | 1.8736488 | 1.6214601 | 0.4187980 | 0.2236137 | $\infty$ | 123.410 |
| 0-03 | 2.0138528 | 1.8235025 | 0.2017386 | 0.0000000 | 17.865 | 7.804 | 1.8102373 | 1.5635625 | 0.3414049 | 0.1677940 | $\infty$ | 168.248 |
| O-04 | 1.7601648 | 1.6983496 | 0.1119901 | 0.0303031 | 126.487 | 88.260 | 1.7138036 | 1.5827428 | 0.2283988 | 0.1382962 | $\infty$ | 225.124 |
| 0-05 | 1.7544396 | 1.6860997 | 0.1012182 | 0.0385571 | $\infty$ | 154.116 | 1.7154614 | 1.6252636 | 0.2006792 | 0.1246148 | 274.983 | 227.613 |
| 0-06 | 1.7098650 | 1.6770281 | 0.1041241 | 0.0670294 | 230.527 | 210.197 | 1.7033404 | 1.6188250 | 0.3292182 | 0.2099482 | 150.644 | 126.709 |
| 0-07 | 1.7222565 | 1.6392279 | 0.1141065 | 0.0377210 | $\infty$ | 179.876 | 1.9211460 | 1.6039157 | 0.3222769 | 0.1379226 | $\infty$ | 173.494 |
| 0-08 | 1.7522796 | 1.6377117 | 0.1133124 | 0.0260626 | $\infty$ | 157.760 | 1.9204984 | 1.5467472 | 0.3006841 | 0.1064385 | $\infty$ | 182.190 |
| 0-09 | 1.7663100 | 1.6433510 | 0.1109379 | 0.0179460 | $\infty$ | 159.565 | 1.9769323 | 1.4791027 | 0.3759903 | 0.1009452 | $\infty$ | 167.431 |

Table13-P

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|------|------|------|------|------|------|------|------|------|------|------|------|------|
| P-01 | 1.9886417 | 1.8586649 | 0.2168535 | 0.0622660 | 21.146 | 13.418 | 1.8144820 | 1.5830794 | 0.5150047 | 0.3225034 | $\infty$ | 107.185 |
| P-02 | 2.0226615 | 1.8700565 | 0.1708931 | 0.0000000 | 19.341 | 10.943 | 1.8760551 | 1.6269706 | 0.4346485 | 0.2414002 | $\infty$ | 119.778 |
| P-03 | 2.0146852 | 1.8302919 | 0.2026225 | 0.0000000 | 17.790 | 8.150 | 1.8068544 | 1.5608059 | 0.3505465 | 0.1784969 | $\infty$ | 165.499 |
| P-04 | 1.7592341 | 1.7024556 | 0.1101813 | 0.0325910 | 117.465 | 89.126 | 1.7088649 | 1.5853419 | 0.2301093 | 0.1471381 | $\infty$ | 218.551 |
| P-05 | 1.7520015 | 1.6881722 | 0.0972790 | 0.0422326 | $\infty$ | 154.401 | 1.7076826 | 1.6341292 | 0.2024884 | 0.1311199 | 262.818 | 222.098 |
| P-06 | 1.7202854 | 1.6494310 | 0.1139740 | 0.0400397 | $\infty$ | 180.952 | 1.9227304 | 1.5993051 | 0.3229419 | 0.1415112 | $\infty$ | 156.449 |
| P-07 | 1.7531211 | 1.6359543 | 0.1129882 | 0.0276769 | $\infty$ | 161.129 | 1.9283125 | 1.5509749 | 0.3007735 | 0.1132394 | $\infty$ | 171.437 |
| P-08 | 1.7588209 | 1.6651307 | 0.1168101 | 0.0541222 | $\infty$ | 248.704 | 1.9315321 | 1.4570680 | 0.4662918 | 0.1750504 | $\infty$ | 99.190 |
| P-09 | 1.7670193 | 1.6441934 | 0.1112618 | 0.0177193 | $\infty$ | 159.536 | 1.9788106 | 1.4760433 | 0.3800825 | 0.1068427 | $\infty$ | 161.759 |

Table13-Q

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| Q-01 | 2.0299629 | 1.8795650 | 0.1824437 | 0.0030821 | 18.478 | 10.745 | 1.8549548 | 1.6100341 | 0.4371519 | 0.2549656 | ∞ | 117.201 |
| Q-02 | 2.0241822 | 1.8402063 | 0.2104778 | 0.0000000 | 17.050 | 8.091 | 1.7978402 | 1.5552364 | 0.3542628 | 0.1872645 | ∞ | 156.884 |
| Q-03 | 2.0003468 | 1.8759108 | 0.2255479 | 0.0756028 | 19.996 | 13.232 | 1.7941019 | 1.5719596 | 0.5267302 | 0.3493046 | ∞ | 100.638 |
| Q-04 | 1.7575390 | 1.7066881 | 0.1073040 | 0.0369781 | 110.062 | 89.912 | 1.7021137 | 1.5868305 | 0.2290280 | 0.1553110 | ∞ | 208.877 |
| Q-05 | 1.7492067 | 1.6897987 | 0.0912703 | 0.0482051 | ∞ | 154.337 | 1.6999394 | 1.6416642 | 0.1981843 | 0.1369514 | 241.011 | 215.366 |
| Q-06 | 1.7509212 | 1.6412923 | 0.1130844 | 0.0286313 | ∞ | 163.308 | 1.9350926 | 1.5513707 | 0.3031575 | 0.1183247 | ∞ | 161.219 |
| Q-07 | 1.7508595 | 1.6412538 | 0.1130854 | 0.0286152 | ∞ | 163.300 | 1.9348833 | 1.5512578 | 0.3031544 | 0.1183046 | ∞ | 161.239 |
| Q-08 | 1.7507785 | 1.6689401 | 0.1147477 | 0.0543205 | ∞ | 246.802 | 1.8962359 | 1.4286565 | 0.4917045 | 0.1834073 | ∞ | 98.263 |
| Q-09 | 1.7662458 | 1.6457575 | 0.1116673 | 0.0200852 | ∞ | 159.401 | 1.9890462 | 1.4730025 | 0.3858334 | 0.1112594 | ∞ | 153.058 |

Table13-R

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|------|-----------|-----------|-----------|-----------|---------|---------|-----------|-----------|-----------|-----------|---------|---------|
| R-01 | 2.0097821 | 1.8916937 | 0.2374473 | 0.0898814 | 18.630 | 12.843 | 1.7577288 | 1.5453582 | 0.5218639 | 0.3655761 | ∞ | 90.971 |
| R-02 | 2.0317871 | 1.8838318 | 0.1969310 | 0.0159166 | 17.716 | 10.512 | 1.8267181 | 1.5838873 | 0.4329416 | 0.2622885 | ∞ | 114.131 |
| R-03 | 2.0272958 | 1.8456368 | 0.2145425 | 0.0010647 | 16.701 | 8.140 | 1.7921077 | 1.5515315 | 0.3569974 | 0.1929557 | ∞ | 144.106 |
| R-04 | 1.7559299 | 1.7096201 | 0.1048919 | 0.0414837 | 107.586 | 90.423 | 1.6965353 | 1.5838925 | 0.2274480 | 0.1602031 | 251.078 | 196.592 |
| R-05 | 1.7470392 | 1.6919122 | 0.0867264 | 0.0547244 | ∞ | 154.865 | 1.6946707 | 1.6466544 | 0.1948761 | 0.1398883 | 228.954 | 207.100 |
| R-06 | 1.7480930 | 1.6471592 | 0.1133882 | 0.0300691 | ∞ | 164.480 | 1.9459815 | 1.5501490 | 0.3044638 | 0.1242550 | ∞ | 156.144 |
| R-07 | 1.7450449 | 1.6336325 | 0.1109200 | 0.0225424 | ∞ | 91.792 | 1.9298992 | 1.5646257 | 0.2873729 | 0.1011132 | ∞ | 203.019 |
| R-08 | 1.7645838 | 1.6472315 | 0.1126210 | 0.0142994 | ∞ | 94.011 | 1.9816561 | 1.4913973 | 0.3724489 | 0.0922621 | ∞ | 182.149 |

Table 13-S

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| S-01 | 2.0234818 | 1.8815995 | 0.2048329 | 0.0333400 | 17.816 | 10.851 | 1.8108235 | 1.5680879 | 0.4373710 | 0.2682193 | $\infty$ | 106.956 |
| S-02 | 2.0267707 | 1.8481781 | 0.2132843 | 0.0026532 | 16.764 | 8.330 | 1.7921736 | 1.5506917 | 0.3624059 | 0.1965173 | $\infty$ | 136.736 |
| S-03 | 2.0229843 | 1.8126107 | 0.2118548 | 0.0000000 | 17.006 | 6.626 | 1.7962684 | 1.5649109 | 0.3200096 | 0.1552012 | $\infty$ | 158.532 |
| S-04 | 1.7559883 | 1.7112226 | 0.1042793 | 0.0434834 | 106.889 | 90.807 | 1.6957276 | 1.5823169 | 0.2295992 | 0.1619821 | 239.298 | 187.719 |
| S-05 | 1.7655105 | 1.7004311 | 0.1139102 | 0.0260367 | 134.109 | 87.275 | 1.7577518 | 1.5898417 | 0.2210292 | 0.1292055 | $\infty$ | 200.383 |
| S-06 | 1.7463013 | 1.6945386 | 0.0864150 | 0.0553518 | $\infty$ | 156.288 | 1.6932296 | 1.6495601 | 0.1984453 | 0.1415312 | 218.344 | 197.813 |
| S-07 | 1.7140522 | 1.6689094 | 0.1067597 | 0.0488666 | 229.606 | 205.298 | 1.7670106 | 1.6354554 | 0.3302382 | 0.1778346 | $\infty$ | 144.458 |
| S-08 | 1.7449807 | 1.6499404 | 0.1138956 | 0.0341556 | $\infty$ | 165.967 | 1.8280140 | 1.5472376 | 0.3071992 | 0.1308259 | $\infty$ | 181.573 |
| S-09 | 1.7451425 | 1.6342221 | 0.1113390 | 0.0250732 | $\infty$ | 92.591 | 1.9359617 | 1.5636167 | 0.2900348 | 0.1046368 | $\infty$ | 199.846 |
| S-10 | 1.7652844 | 1.6477526 | 0.1126180 | 0.0173421 | $\infty$ | 94.523 | 1.9878760 | 1.4904395 | 0.3789348 | 0.0928715 | $\infty$ | 179.072 |

Table13-T

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| T-01 | 2.0128535 | 1.8776497 | 0.2022309 | 0.0428498 | 18.880 | 11.802 | 1.8188903 | 1.5750170 | 0.4593818 | 0.2783052 | ∞ | 96.261 |
| T-02 | 2.0218484 | 1.8485757 | 0.2087384 | 0.0054266 | 17.299 | 8.781 | 1.7965353 | 1.5504452 | 0.3727229 | 0.2011848 | ∞ | 133.321 |
| T-03 | 2.0201608 | 1.8144088 | 0.2083496 | 0.0000000 | 17.323 | 6.915 | 1.7987967 | 1.5653519 | 0.3266562 | 0.1579587 | ∞ | 147.994 |
| T-04 | 1.7570823 | 1.7125413 | 0.1046922 | 0.0447898 | 107.213 | 91.339 | 1.6962268 | 1.5854626 | 0.2358925 | 0.1647035 | ∞ | 182.628 |
| T-05 | 1.7663411 | 1.7014363 | 0.1140704 | 0.0270819 | 125.645 | 87.790 | 1.7579060 | 1.5932893 | 0.2258950 | 0.1313125 | ∞ | 192.437 |
| T-06 | 1.7463849 | 1.6965582 | 0.0888585 | 0.0538134 | ∞ | 158.010 | 1.6935424 | 1.6497399 | 0.2059822 | 0.1521760 | 209.015 | 188.409 |
| T-07 | 1.7606661 | 1.6760043 | 0.0916389 | 0.0386226 | ∞ | 139.323 | 1.7697079 | 1.6752670 | 0.1867139 | 0.1180749 | ∞ | 249.956 |
| T-08 | 1.7055809 | 1.6708934 | 0.1020233 | 0.0556122 | 227.279 | 207.411 | 1.7418425 | 1.6555925 | 0.3358460 | 0.1979701 | ∞ | 139.124 |
| T-09 | 1.7414172 | 1.6493298 | 0.1148927 | 0.0388429 | ∞ | 167.956 | 1.8282133 | 1.5765470 | 0.3167563 | 0.1356247 | ∞ | 187.138 |
| T-10 | 1.7472262 | 1.6351657 | 0.1130011 | 0.0193292 | ∞ | 95.042 | 1.9328660 | 1.5573191 | 0.2795818 | 0.0886016 | ∞ | 229.523 |
| T-11 | 1.7658246 | 1.6480377 | 0.1126115 | 0.0200944 | ∞ | 148.993 | 1.9961766 | 1.4909764 | 0.3854823 | 0.0943336 | ∞ | 179.765 |

Table 14-A

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| A-01 | 2.141 | 2.006 | 0.075 | 0.000 | 31.254 | 25.519 | 5.876 | 5.233 | 3.362 | 2.751 | 2.251 | 1.807 |
| A-02 | 2.017 | 1.896 | 0.180 | 0.061 | 39.247 | 31.618 | 9.377 | 9.207 | 0.715 | 0.513 | 11.023 | 10.812 |
| A-03 | 1.952 | 1.854 | 0.166 | 0.055 | 35.017 | 26.178 | 2.281 | 2.051 | 0.699 | 0.439 | 70.023 | 58.076 |
| A-04 | 1.943 | 1.843 | 0.155 | 0.028 | 23.926 | 15.560 | 1.832 | 1.635 | 0.412 | 0.253 | $\infty$ | 125.396 |
| A-05 | 1.957 | 1.821 | 0.171 | 0.009 | 20.211 | 10.679 | 1.773 | 1.577 | 0.320 | 0.185 | $\infty$ | 142.606 |
| A-06 | 1.964 | 1.310 | 0.149 | 0.000 | 20.519 | 9.259 | 1.809 | 1.603 | 0.293 | 0.152 | $\infty$ | 182.495 |
| A-07 | 1.701 | 1.683 | 0.068 | 0.043 | 166.410 | 155.941 | 1.721 | 1.694 | 0.188 | 0.139 | 217.552 | 202.082 |
| A-08 | 1.708 | 1.664 | 0.084 | 0.031 | 170.845 | 111.504 | 1.754 | 1.667 | 0.194 | 0.113 | $\infty$ | 249.694 |
| A-09 | 1.727 | 1.662 | 0.108 | 0.039 | 255.389 | 217.630 | 7.503 | 6.491 | 3.321 | 2.487 | 1.062 | 0.781 |
| A-10 | 1.710 | 1.674 | 0.106 | 0.053 | 226.062 | 206.257 | 1.909 | 1.763 | 0.395 | 0.243 | 100.609 | 81.237 |
| A-11 | 1.720 | 1.683 | 0.099 | 0.045 | 229.005 | 200.369 | 1.849 | 1.670 | 0.332 | 0.164 | $\infty$ | 143.819 |
| A-12 | 1.737 | 1.675 | 0.097 | 0.035 | $\infty$ | 189.200 | 1.855 | 1.540 | 0.307 | 0.122 | $\infty$ | 154.002 |
| A-13 | 1.738 | 1.660 | 0.100 | 0.019 | $\infty$ | 189.609 | 1.900 | 1.583 | 0.271 | 0.102 | $\infty$ | 185.363 |

Table14-B

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| B-01 | 1.954 | 1.847 | 0.222 | 0.111 | 41.975 | 34.168 | 9.356 | 9.153 | 0.784 | 0.549 | 10.759 | 10.519 |
| B-02 | 1.946 | 1.852 | 0.156 | 0.037 | 24.164 | 16.466 | 1.841 | 1.650 | 0.442 | 0.280 | $\infty$ | 119.178 |
| B-03 | 1.957 | 1.828 | 0.171 | 0.015 | 20.222 | 11.264 | 1.772 | 1.579 | 0.334 | 0.198 | $\infty$ | 137.341 |
| B-04 | 1.966 | 1.817 | 0.149 | 0.000 | 20.345 | 9.664 | 1.809 | 1.602 | 0.302 | 0.162 | $\infty$ | 178.243 |
| B-05 | 1.703 | 1.667 | 0.081 | 0.035 | 165.590 | 137.726 | 1.744 | 1.674 | 0.195 | 0.120 | $\infty$ | 243.996 |
| B-06 | 1.708 | 1.661 | 0.102 | 0.051 | 241.533 | 217.317 | 6.262 | 5.366 | 4.338 | 3.555 | 0.986 | 0.720 |
| B-07 | 1.699 | 1.675 | 0.098 | 0.067 | 220.890 | 207.766 | 1.931 | 1.793 | 0.416 | 0.288 | 89.025 | 74.083 |
| B-08 | 1.715 | 1.684 | 0.100 | 0.052 | 225.049 | 201.595 | 1.852 | 1.684 | 0.339 | 0.182 | $\infty$ | 139.178 |
| B-09 | 1.733 | 1.676 | 0.097 | 0.039 | $\infty$ | 191.244 | 1.853 | 1.538 | 0.310 | 0.132 | $\infty$ | 147.776 |
| B-10 | 1.737 | 1.661 | 0.100 | 0.022 | $\infty$ | 190.979 | 1.902 | 1.584 | 0.275 | 0.107 | $\infty$ | 179.334 |

Table14-C

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| C-01 | 1.905 | 1.821 | 0.258 | 0.159 | 42.560 | 36.125 | 9.681 | 9.446 | 0.829 | 0.587 | 10.138 | 9.892 |
| C-02 | 1.955 | 1.868 | 0.156 | 0.047 | 24.067 | 17.295 | 1.856 | 1.674 | 0.479 | 0.314 | $\infty$ | 112.716 |
| C-03 | 1.958 | 1.836 | 0.172 | 0.022 | 20.129 | 11.822 | 1.769 | 1.584 | 0.348 | 0.215 | $\infty$ | 132.762 |
| C-04 | 1.971 | 1.826 | 0.149 | 0.000 | 19.949 | 9.987 | 1.811 | 1.608 | 0.313 | 0.173 | $\infty$ | 173.492 |
| C-05 | 1.699 | 1.670 | 0.078 | 0.041 | 161.711 | 144.941 | 1.737 | 1.683 | 0.196 | 0.129 | $\infty$ | 239.168 |
| C-06 | 1.710 | 1.686 | 0.100 | 0.063 | 216.379 | 202.875 | 1.855 | 1.702 | 0.336 | 0.208 | $\infty$ | 134.716 |
| C-07 | 1.730 | 1.678 | 0.097 | 0.046 | $\infty$ | 193.042 | 1.841 | 1.535 | 0.312 | 0.146 | $\infty$ | 142.289 |
| C-08 | 1.737 | 1.661 | 0.101 | 0.025 | $\infty$ | 192.539 | 1.910 | 1.588 | 0.280 | 0.114 | $\infty$ | 200.270 |

Table14-D

| Case | n₁-max | n₁-min | k₁-max | k₁-min | d₁-max | d₁-min | n₂-max | n₂-min | k₂-max | k₂-min | d₂-max | d₂-min |
|------|--------|--------|--------|--------|--------|--------|--------|--------|--------|--------|--------|--------|
| D-01 | 1.964 | 1.894 | 0.224 | 0.152 | 33.127 | 28.245 | 2.530 | 2.288 | 0.928 | 0.730 | 46.411 | 39.931 |
| D-02 | 1.964 | 1.886 | 0.160 | 0.061 | 22.917 | 17.267 | 1.833 | 1.667 | 0.492 | 0.344 | ∞ | 107.536 |
| D-03 | 1.959 | 1.843 | 0.175 | 0.031 | 19.812 | 12.114 | 1.762 | 1.583 | 0.359 | 0.229 | ∞ | 154.271 |
| D-04 | 1.975 | 1.834 | 0.149 | 0.000 | 19.537 | 10.202 | 1.812 | 1.611 | 0.320 | 0.182 | ∞ | 167.375 |
| D-05 | 1.694 | 1.673 | 0.073 | 0.048 | 159.270 | 147.983 | 1.732 | 1.691 | 0.195 | 0.145 | 274.107 | 234.670 |
| D-06 | 1.701 | 1.689 | 0.099 | 0.076 | 210.753 | 203.620 | 1.846 | 1.712 | 0.319 | 0.257 | ∞ | 130.894 |
| D-07 | 1.721 | 1.680 | 0.097 | 0.050 | ∞ | 194.085 | 1.812 | 1.528 | 0.315 | 0.159 | ∞ | 179.580 |
| D-08 | 1.734 | 1.662 | 0.101 | 0.027 | ∞ | 194.045 | 1.920 | 1.594 | 0.285 | 0.121 | ∞ | 197.417 |
| D-09 | 1.751 | 1.675 | 0.092 | 0.024 | ∞ | 189.814 | 1.889 | 1.515 | 0.358 | 0.115 | ∞ | 162.566 |

Table14-E

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|-------|-------|-------|-------|---------|---------|-------|-------|-------|-------|---------|---------|
| E-01 | 1.979 | 1.934 | 0.223 | 0.198 | 25.447 | 22.431 | 1.937 | 1.871 | 0.813 | 0.724 | 58.954 | 51.905 |
| E-02 | 1.963 | 1.892 | 0.175 | 0.080 | 21.108 | 16.482 | 1.752 | 1.605 | 0.464 | 0.351 | $\infty$ | 103.951 |
| E-03 | 1.959 | 1.845 | 0.181 | 0.039 | 19.487 | 12.133 | 1.753 | 1.576 | 0.362 | 0.237 | $\infty$ | 122.545 |
| E-04 | 1.980 | 1.841 | 0.148 | 0.000 | 19.257 | 10.346 | 1.817 | 1.616 | 0.326 | 0.188 | $\infty$ | 158.102 |
| E-05 | 1.692 | 1.676 | 0.067 | 0.057 | 157.441 | 149.670 | 1.727 | 1.695 | 0.187 | 0.173 | 254.885 | 231.812 |
| E-06 | 1.718 | 1.682 | 0.096 | 0.048 | $\infty$ | 194.149 | 1.788 | 1.641 | 0.326 | 0.165 | $\infty$ | 176.978 |
| E-07 | 1.729 | 1.663 | 0.102 | 0.030 | $\infty$ | 195.371 | 1.929 | 1.601 | 0.290 | 0.127 | $\infty$ | 195.845 |
| E-08 | 1.749 | 1.676 | 0.091 | 0.025 | $\infty$ | 190.682 | 1.898 | 1.530 | 0.362 | 0.117 | $\infty$ | 153.544 |

Table 14-F

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| F-01 | 1.983 | 1.846 | 0.143 | 0.000 | 19.333 | 10.604 | 1.828 | 1.623 | 0.332 | 0.191 | $\infty$ | 146.194 |
| F-02 | 1.956 | 1.842 | 0.185 | 0.045 | 19.661 | 12.234 | 1.751 | 1.571 | 0.365 | 0.239 | $\infty$ | 124.203 |
| F-03 | 1.691 | 1.680 | 0.071 | 0.054 | 156.188 | 149.873 | 1.713 | 1.692 | 0.184 | 0.171 | 244.114 | 224.269 |
| F-04 | 1.703 | 1.695 | 0.096 | 0.076 | 207.561 | 203.306 | 1.791 | 1.682 | 0.352 | 0.280 | 149.549 | 121.948 |
| F-05 | 1.726 | 1.686 | 0.105 | 0.063 | 253.974 | 217.847 | 1.691 | 1.585 | 0.284 | 0.201 | 170.132 | 139.231 |
| F-06 | 1.726 | 1.665 | 0.102 | 0.031 | $\infty$ | 196.531 | 1.935 | 1.606 | 0.294 | 0.130 | $\infty$ | 191.652 |
| F-07 | 1.740 | 1.662 | 0.097 | 0.021 | $\infty$ | 170.235 | 1.919 | 1.543 | 0.280 | 0.102 | $\infty$ | 197.142 |
| F-08 | 1.751 | 1.653 | 0.092 | 0.015 | $\infty$ | 166.884 | 1.925 | 1.498 | 0.278 | 0.095 | $\infty$ | 190.724 |

Table14-F

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| G-01 | 1.933 | 1.873 | 0.202 | 0.122 | 20.550 | 16.700 | 1.633 | 1.511 | 0.430 | 0.344 | $\infty$ | 91.266 |
| G-02 | 1.953 | 1.839 | 0.184 | 0.046 | 20.523 | 12.791 | 1.761 | 1.579 | 0.380 | 0.246 | $\infty$ | 127.980 |
| G-03 | 1.985 | 1.852 | 0.136 | 0.000 | 19.818 | 11.204 | 1.845 | 1.638 | 0.344 | 0.196 | $\infty$ | 136.666 |
| G-04 | 1.975 | 1.816 | 0.174 | 0.000 | 18.551 | 8.554 | 1.780 | 1.585 | 0.283 | 0.150 | $\infty$ | 158.294 |
| G-05 | 1.746 | 1.710 | 0.081 | 0.037 | 136.285 | 98.008 | 1.699 | 1.620 | 0.175 | 0.131 | 278.211 | 243.285 |
| G-06 | 1.724 | 1.686 | 0.105 | 0.064 | 247.645 | 218.101 | 1.689 | 1.586 | 0.286 | 0.205 | 159.193 | 130.698 |
| G-07 | 1.724 | 1.666 | 0.101 | 0.031 | $\infty$ | 197.493 | 1.934 | 1.609 | 0.296 | 0.130 | $\infty$ | 183.027 |
| G-08 | 1.741 | 1.661 | 0.097 | 0.021 | $\infty$ | 171.385 | 1.918 | 1.542 | 0.281 | 0.101 | $\infty$ | 188.504 |

Table14-H

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| H-01 | 1.951 | 1.842 | 0.181 | 0.048 | 21.358 | 13.627 | 1.774 | 1.592 | 0.403 | 0.263 | $\infty$ | 123.537 |
| H-02 | 1.984 | 1.857 | 0.134 | 0.000 | 20.311 | 11.922 | 1.856 | 1.651 | 0.360 | 0.208 | $\infty$ | 130.884 |
| H-03 | 1.974 | 1.818 | 0.175 | 0.000 | 18.650 | 8.869 | 1.776 | 1.582 | 0.289 | 0.157 | $\infty$ | 183.486 |
| H-04 | 1.746 | 1.712 | 0.079 | 0.042 | 135.917 | 98.660 | 1.696 | 1.624 | 0.178 | 0.137 | 265.927 | 237.438 |
| H-05 | 1.725 | 1.688 | 0.106 | 0.068 | 245.491 | 218.637 | 1.688 | 1.581 | 0.280 | 0.214 | 149.336 | 121.404 |
| H-06 | 1.724 | 1.667 | 0.102 | 0.033 | $\infty$ 0. | 198.178 | 1.931 | 1.605 | 0.296 | 0.132 | $\infty$ | 172.147 |
| H-07 | 1.740 | 1.661 | 0.097 | 0.022 | $\infty$ | 171.868 | 1.916 | 1.542 | 0.282 | 0.105 | $\infty$ | 178.623 |

Table14-I

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| I-01 | 1.955 | 1.853 | 0.178 | 0.053 | 21.482 | 14.427 | 1.777 | 1.605 | 0.429 | 0.289 | $\infty$ | 118.585 |
| I-02 | 1.983 | 1.862 | 0.137 | 0.000 | 20.338 | 12.369 | 1.851 | 1.653 | 0.373 | 0.223 | $\infty$ | 127.262 |
| I-03 | 1.976 | 1.827 | 0.171 | 0.000 | 18.582 | 9.315 | 1.779 | 1.583 | 0.299 | 0.167 | $\infty$ | 178.673 |
| I-04 | 1.693 | 1.659 | 0.071 | 0.062 | 156.116 | 108.678 | 1.766 | 1.688 | 0.166 | 0.129 | 252.906 | 249.872 |
| I-05 | 1.725 | 1.667 | 0.102 | 0.036 | 252.664 | 198.579 | 1.934 | 1.600 | 0.298 | 0.138 | $\infty$ | 164.058 |
| I-06 | 1.738 | 1.662 | 0.098 | 0.022 | $\infty$ | 175.267 | 1.919 | 1.543 | 0.284 | 0.111 | $\infty$ | 173.633 |
| I-07 | 1.752 | 1.653 | 0.092 | 0.016 | $\infty$ | 172.533 | 1.830 | 1.507 | 0.291 | 0.108 | $\infty$ | 172.262 |

Table14-J

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| J-01 | 1.964 | 1.874 | 0.179 | 0.062 | 20.729 | 14.862 | 1.767 | 1.609 | 0.449 | 0.320 | $\infty$ | 113.506 |
| J-02 | 1.983 | 1.867 | 0.146 | 0.004 | 19.885 | 12.520 | 1.831 | 1.641 | 0.380 | 0.238 | $\infty$ | 124.690 |
| J-03 | 1.982 | 1.838 | 0.168 | 0.000 | 18.297 | 9.652 | 1.783 | 1.584 | 0.309 | 0.178 | $\infty$ | 172.558 |
| J-04 | 1.725 | 1.666 | 0.103 | 0.041 | 250.100 | 198.830 | 1.944 | 1.598 | 0.303 | 0.149 | $\infty$ | 157.077 |
| J-05 | 1.737 | 1.663 | 0.098 | 0.024 | $\infty$ | 185.832 | 1.927 | 1.559 | 0.288 | 0.117 | $\infty$ | 167.184 |
| J-06 | 1.752 | 1.658 | 0.091 | 0.019 | $\infty$ | 180.136 | 1.847 | 1.512 | 0.296 | 0.113 | $\infty$ | 165.978 |

Table14-K

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|------|------|------|------|------|------|------|------|------|------|------|------|
| K-01 | 1.973 | 1.893 | 0.185 | 0.078 | 19.455 | 14.744 | 1.741 | 1.596 | 0.453 | 0.345 | ∞ | 107.965 |
| K-02 | 1.983 | 1.872 | 0.156 | 0.017 | 19.144 | 12.421 | 1.806 | 1.623 | 0.379 | 0.249 | ∞ | 122.284 |
| K-03 | 1.987 | 1.847 | 0.167 | 0.000 | 17.845 | 9.756 | 1.782 | 1.583 | 0.315 | 0.187 | ∞ | 164.682 |
| K-04 | 1.719 | 1.655 | 0.093 | 0.039 | ∞ | 107.765 | 1.782 | 1.640 | 0.185 | 0.106 | ∞ | 240.729 |
| K-05 | 1.723 | 1.669 | 0.104 | 0.045 | 247.764 | 205.861 | 1.753 | 1.603 | 0.311 | 0.163 | ∞ | 150.727 |
| K-06 | 1.736 | 1.664 | 0.099 | 0.026 | ∞ | 188.964 | 1.938 | 1.577 | 0.293 | 0.122 | ∞ | 190.206 |
| K-07 | 1.751 | 1.660 | 0.091 | 0.021 | ∞ | 182.620 | 1.860 | 1.505 | 0.298 | 0.117 | ∞ | 157.223 |

Table14-L

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|--------|--------|--------|--------|---------|---------|--------|--------|--------|--------|----------|---------|
| L-01 | 1.974 | 1.903 | 0.194 | 0.095 | 18.537 | 14.577 | 1.708 | 1.572 | 0.448 | 0.357 | $\infty$ | 99.374 |
| L-02 | 1.983 | 1.876 | 0.163 | 0.028 | 18.641 | 12.379 | 1.790 | 1.608 | 0.378 | 0.255 | $\infty$ | 118.240 |
| L-03 | 1.989 | 1.851 | 0.171 | 0.000 | 17.506 | 9.747 | 1.776 | 1.579 | 0.316 | 0.190 | $\infty$ | 154.295 |
| L-04 | 1.719 | 1.657 | 0.093 | 0.043 | 176.125 | 108.056 | 1.773 | 1.640 | 0.184 | 0.115 | $\infty$ | 239.447 |
| L-05 | 1.720 | 1.674 | 0.104 | 0.048 | 245.819 | 210.037 | 1.745 | 1.616 | 0.323 | 0.176 | $\infty$ | 146.164 |
| L-06 | 1.728 | 1.664 | 0.099 | 0.029 | $\infty$ | 190.492 | 1.826 | 1.594 | 0.297 | 0.128 | $\infty$ | 188.671 |
| L-07 | 1.750 | 1.664 | 0.099 | 0.023 | $\infty$ | 185.642 | 1.931 | 1.560 | 0.283 | 0.103 | $\infty$ | 203.385 |
| L-08 | 1.770 | 1.647 | 0.090 | 0.020 | $\infty$ | 181.694 | 1.851 | 1.519 | 0.279 | 0.095 | $\infty$ | 188.718 |

Table14-M

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| M-01 | 1.981 | 1.878 | 0.162 | 0.035 | 19.040 | 12.910 | 1.795 | 1.610 | 0.389 | 0.261 | ∞ | 109.327 |
| M-02 | 1.985 | 1.850 | 0.173 | 0.004 | 17.738 | 9.987 | 1.771 | 1.575 | 0.319 | 0.192 | ∞ | 144.773 |
| M-03 | 1.982 | 1.819 | 0.169 | 0.000 | 18.242 | 8.329 | 1.785 | 1.592 | 0.285 | 0.153 | ∞ | 164.318 |
| M-04 | 1.717 | 1.677 | 0.103 | 0.051 | 233.783 | 211.731 | 1.724 | 1.634 | 0.337 | 0.187 | ∞ | 140.585 |
| M-05 | 1.723 | 1.665 | 0.099 | 0.034 | ∞ | 191.269 | 1.797 | 1.609 | 0.302 | 0.133 | ∞ | 192.523 |
| M-06 | 1.749 | 1.664 | 0.099 | 0.026 | ∞ | 186.782 | 1.934 | 1.561 | 0.285 | 0.104 | ∞ | 198.444 |
| M-07 | 1.772 | 1.645 | 0.090 | 0.022 | ∞ | 182.830 | 1.851 | 1.521 | 0.282 | 0.097 | ∞ | 183.298 |

Table14-N

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|--------|---------|------|------|------|------|--------|---------|
| N-01 | 1.980 | 1.881 | 0.157 | 0.036 | 20.158 | 14.003 | 1.818 | 1.632 | 0.415 | 0.275 | $\infty$ | 119.641 |
| N-02 | 1.980 | 1.848 | 0.174 | 0.011 | 18.254 | 10.450 | 1.767 | 1.571 | 0.327 | 0.197 | $\infty$ | 139.482 |
| N-03 | 1.979 | 1.820 | 0.167 | 0.000 | 18.627 | 8.694 | 1.787 | 1.592 | 0.291 | 0.157 | $\infty$ | 181.534 |
| N-04 | 1.708 | 1.676 | 0.100 | 0.054 | 231.071 | 211.497 | 1.721 | 1.649 | 0.345 | 0.200 | 160.527 | 134.106 |
| N-05 | 1.720 | 1.666 | 0.099 | 0.038 | $\infty$ | 191.698 | 1.802 | 1.619 | 0.308 | 0.145 | $\infty$ | 186.758 |
| N-06 | 1.748 | 1.665 | 0.100 | 0.028 | $\infty$ | 188.144 | 1.933 | 1.561 | 0.288 | 0.109 | $\infty$ | 191.540 |
| N-07 | 1.771 | 1.644 | 0.090 | 0.024 | $\infty$ | 184.314 | 1.854 | 1.522 | 0.286 | 0.100 | $\infty$ | 174.816 |

Table 14-O

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|------|------|------|------|------|------|------|------|------|------|------|------|
| O-01 | 1.986 | 1.892 | 0.151 | 0.037 | 20.946 | 15.073 | 1.846 | 1.665 | 0.451 | 0.301 | $\infty$ | 113.921 |
| O-02 | 1.976 | 1.851 | 0.174 | 0.018 | 18.588 | 10.996 | 1.763 | 1.571 | 0.339 | 0.209 | $\infty$ | 135.398 |
| O-03 | 1.980 | 1.826 | 0.165 | 0.000 | 18.692 | 9.087 | 1.789 | 1.591 | 0.301 | 0.166 | $\infty$ | 177.745 |
| O-04 | 1.705 | 1.676 | 0.099 | 0.060 | 227.547 | 210.480 | 1.722 | 1.652 | 0.337 | 0.217 | 149.574 | 128.876 |
| O-05 | 1.718 | 1.666 | 0.100 | 0.040 | $\infty$ | 192.120 | 1.834 | 1.629 | 0.312 | 0.151 | $\infty$ | 178.069 |
| O-06 | 1.747 | 1.665 | 0.100 | 0.029 | $\infty$ | 189.864 | 1.910 | 1.562 | 0.289 | 0.109 | $\infty$ | 189.584 |
| O-07 | 1.770 | 1.645 | 0.089 | 0.025 | $\infty$ | 185.926 | 1.858 | 1.520 | 0.291 | 0.103 | $\infty$ | 169.414 |

Table14-P

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| P-01 | 2.001 | 1.914 | 0.148 | 0.045 | 20.691 | 15.556 | 1.861 | 1.690 | 0.481 | 0.336 | $\infty$ | 109.768 |
| P-02 | 1.978 | 1.859 | 0.176 | 0.025 | 18.424 | 11.376 | 1.756 | 1.574 | 0.351 | 0.225 | $\infty$ | 131.712 |
| P-03 | 1.985 | 1.836 | 0.164 | 0.000 | 18.356 | 9.363 | 1.791 | 1.591 | 0.310 | 0.176 | $\infty$ | 172.718 |
| P-04 | 1.707 | 1.685 | 0.101 | 0.067 | 225.238 | 212.673 | 1.715 | 1.643 | 0.328 | 0.223 | 139.199 | 120.241 |
| P-05 | 1.716 | 1.666 | 0.100 | 0.040 | 231.093 | 192.697 | 1.840 | 1.628 | 0.314 | 0.151 | $\infty$ | 167.595 |
| P-06 | 1.745 | 1.666 | 0.101 | 0.030 | $\infty$ | 191.630 | 1.889 | 1.562 | 0.290 | 0.115 | $\infty$ | 179.119 |
| P-07 | 1.770 | 1.653 | 0.089 | 0.027 | $\infty$ | 187.468 | 1.864 | 1.515 | 0.295 | 0.110 | $\infty$ | 164.223 |

Table14-Q

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| Q-01 | 2.020 | 1.942 | 0.150 | 0.058 | 19.257 | 15.087 | 1.832 | 1.680 | 0.483 | 0.365 | ∞ | 111.992 |
| Q-02 | 1.981 | 1.867 | 0.182 | 0.033 | 17.848 | 11.461 | 1.743 | 1.570 | 0.357 | 0.239 | ∞ | 128.672 |
| Q-03 | 1.991 | 1.846 | 0.165 | 0.000 | 17.802 | 9.465 | 1.790 | 1.590 | 0.316 | 0.186 | ∞ | 166.465 |
| Q-04 | 1.707 | 1.692 | 0.103 | 0.077 | 223.701 | 215.120 | 1.677 | 1.625 | 0.321 | 0.252 | 127.631 | 109.461 |
| Q-05 | 1.716 | 1.665 | 0.101 | 0.041 | 230.268 | 195.890 | 1.826 | 1.625 | 0.315 | 0.151 | ∞ | 158.121 |
| Q-06 | 1.744 | 1.667 | 0.101 | 0.031 | ∞ | 193.216 | 1.887 | 1.561 | 0.292 | 0.120 | ∞ | 161.210 |
| Q-07 | 1.770 | 1.657 | 0.088 | 0.030 | ∞ | 188.863 | 1.872 | 1.509 | 0.295 | 0.115 | ∞ | 156.975 |

Table14-R

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|------|------|------|------|------|------|------|------|------|------|------|------|------|
| R-01 | 1.982 | 1.873 | 0.188 | 0.044 | 17.244 | 11.395 | 1.730 | 1.562 | 0.359 | 0.249 | $\infty$ | 128.127 |
| R-02 | 1.997 | 1.854 | 0.166 | 0.000 | 17.308 | 9.486 | 1.790 | 1.589 | 0.319 | 0.193 | $\infty$ | 156.903 |
| R-03 | 1.715 | 1.666 | 0.102 | 0.044 | 229.740 | 201.461 | 1.771 | 1.630 | 0.318 | 0.159 | $\infty$ | 151.088 |
| R-04 | 1.743 | 1.668 | 0.102 | 0.032 | $\infty$ | 194.630 | 1.836 | 1.559 | 0.293 | 0.124 | $\infty$ | 157.464 |
| R-05 | 1.760 | 1.658 | 0.090 | 0.018 | $\infty$ | 174.558 | 1.900 | 1.518 | 0.259 | 0.097 | $\infty$ | 192.992 |

Table14-S

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| S-01 | 1.981 | 1.875 | 0.190 | 0.055 | 17.148 | 11.532 | 1.725 | 1.558 | 0.365 | 0.256 | $\infty$ | 125.060 |
| S-02 | 1.996 | 1.857 | 0.163 | 0.000 | 17.446 | 9.791 | 1.797 | 1.592 | 0.327 | 0.198 | $\infty$ | 143.864 |
| S-03 | 1.994 | 1.834 | 0.168 | 0.000 | 17.407 | 8.458 | 1.791 | 1.590 | 0.286 | 0.157 | $\infty$ | 171.207 |
| S-04 | 1.713 | 1.670 | 0.103 | 0.051 | 228.093 | 205.012 | 1.767 | 1.647 | 0.323 | 0.178 | $\infty$ | 144.997 |
| S-05 | 1.742 | 1.669 | 0.102 | 0.037 | $\infty$ | 195.805 | 1.825 | 1.558 | 0.294 | 0.130 | $\infty$ | 180.034 |
| S-06 | 1.742 | 1.666 | 0.097 | 0.026 | $\infty$ | 178.602 | 1.857 | 1.570 | 0.281 | 0.104 | $\infty$ | 199.693 |
| S-07 | 1.760 | 1.659 | 0.090 | 0.022 | $\infty$ | 175.003 | 1.904 | 1.518 | 0.262 | 0.096 | $\infty$ | 186.949 |

Table 14-T

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| T-01 | 1.978 | 1.874 | 0.186 | 0.059 | 17.817 | 12.124 | 1.731 | 1.564 | 0.381 | 0.265 | $\infty$ | 125.465 |
| T-02 | 1.992 | 1.857 | 0.158 | 0.000 | 18.151 | 10.391 | 1.806 | 1.602 | 0.338 | 0.202 | $\infty$ | 136.447 |
| T-03 | 1.990 | 1.833 | 0.167 | 0.000 | 17.811 | 8.783 | 1.791 | 1.588 | 0.291 | 0.159 | $\infty$ | 180.411 |
| T-04 | 1.700 | 1.671 | 0.098 | 0.062 | 226.068 | 207.088 | 1.746 | 1.669 | 0.321 | 0.212 | $\infty$ | 144.423 |
| T-05 | 1.743 | 1.670 | 0.102 | 0.044 | 265.367 | 196.420 | 1.815 | 1.556 | 0.294 | 0.142 | $\infty$ | 187.001 |
| T-06 | 1.742 | 1.666 | 0.097 | 0.030 | $\infty$ | 183.526 | 1.856 | 1.571 | 0.282 | 0.108 | $\infty$ | 202.896 |
| T-07 | 1.760 | 1.661 | 0.090 | 0.025 | $\infty$ | 175.348 | 1.912 | 1.519 | 0.268 | 0.102 | $\infty$ | 181.779 |

274

Table15-A

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| A-01 | 2.109 | 1.990 | 0.055 | 0.000 | 32.767 | 27.509 | 6.594 | 5.978 | 3.556 | 3.013 | 1.715 | 1.418 |
| A-02 | 1.929 | 1.877 | 0.138 | 0.089 | 31.708 | 26.309 | 2.028 | 1.933 | 0.507 | 0.403 | 83.056 | 75.266 |
| A-03 | 1.924 | 1.852 | 0.136 | 0.036 | 21.551 | 15.640 | 1.750 | 1.627 | 0.335 | 0.242 | $\infty$ | 136.202 |
| A-04 | 1.935 | 1.835 | 0.123 | 0.000 | 20.868 | 12.771 | 1.789 | 1.639 | 0.292 | 0.188 | $\infty$ | 175.723 |
| A-05 | 1.940 | 1.823 | 0.124 | 0.000 | 20.183 | 10.913 | 1.793 | 1.618 | 0.258 | 0.152 | $\infty$ | 191.206 |
| A-06 | 1.703 | 1.685 | 0.080 | 0.051 | 169.125 | 157.974 | 1.696 | 1.666 | 0.202 | 0.150 | 213.501 | 194.001 |
| A-07 | 1.707 | 1.664 | 0.084 | 0.029 | 171.143 | 129.944 | 1.748 | 1.665 | 0.195 | 0.115 | $\infty$ | 249.665 |
| A-08 | 1.725 | 1.704 | 0.082 | 0.049 | 250.745 | 235.697 | 7.849 | 7.185 | 3.465 | 2.625 | 0.893 | 0.721 |
| A-09 | 1.738 | 1.690 | 0.082 | 0.029 | $\infty$ | 215.124 | 1.818 | 1.613 | 0.264 | 0.129 | $\infty$ | 179.167 |
| A-10 | 1.736 | 1.688 | 0.079 | 0.022 | $\infty$ | 204.319 | 1.809 | 1.611 | 0.246 | 0.105 | $\infty$ | 225.188 |
| A-11 | 1.731 | 1.655 | 0.080 | 0.025 | $\infty$ | 220.771 | 1.808 | 1.623 | 0.237 | 0.115 | $\infty$ | 175.645 |

Table 15-B

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| B-01 | 1.997 | 1.902 | 0.155 | 0.064 | 38.478 | 32.365 | 6.640 | 5.695 | 5.267 | 4.500 | 1.189 | 0.912 |
| B-02 | 1.925 | 1.861 | 0.135 | 0.044 | 21.745 | 16.569 | 1.749 | 1.636 | 0.354 | 0.266 | $\infty$ | 129.925 |
| B-03 | 1.936 | 1.842 | 0.124 | 0.004 | 20.735 | 13.305 | 1.787 | 1.643 | 0.304 | 0.202 | $\infty$ | 173.046 |
| B-04 | 1.942 | 1.830 | 0.122 | 0.000 | 20.064 | 11.354 | 1.793 | 1.623 | 0.266 | 0.162 | $\infty$ | 186.094 |
| B-05 | 1.700 | 1.690 | 0.079 | 0.061 | 166.973 | 161.165 | 1.688 | 1.668 | 0.197 | 0.165 | 199.493 | 188.055 |
| B-06 | 1.703 | 1.667 | 0.082 | 0.033 | 165.499 | 138.474 | 1.740 | 1.670 | 0.196 | 0.121 | $\infty$ | 244.077 |
| B-07 | 1.736 | 1.690 | 0.079 | 0.024 | $\infty$ | 207.206 | 1.797 | 1.616 | 0.249 | 0.111 | $\infty$ | 220.690 |
| B-08 | 1.711 | 1.709 | 0.079 | 0.074 | 235.852 | 234.721 | 6.407 | 6.233 | 4.693 | 3.940 | 0.732 | 0.720 |
| B-09 | 1.737 | 1.692 | 0.082 | 0.033 | $\infty$ | 216.211 | 1.814 | 1.613 | 0.270 | 0.138 | $\infty$ | 173.495 |
| B-10 | 1.730 | 1.658 | 0.080 | 0.029 | $\infty$ | 222.458 | 1.798 | 1.629 | 0.240 | 0.122 | $\infty$ | 171.776 |

Table15-C

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|------|--------|--------|--------|--------|---------|---------|--------|--------|--------|--------|--------|---------|
| C-01 | 1.927 | 1.873 | 0.135 | 0.055 | 21.683 | 17.423 | 1.744 | 1.647 | 0.374 | 0.295 | $\infty$ | 124.317 |
| C-02 | 1.939 | 1.852 | 0.123 | 0.011 | 20.446 | 13.775 | 1.786 | 1.650 | 0.316 | 0.218 | $\infty$ | 167.810 |
| C-03 | 1.945 | 1.839 | 0.119 | 0.000 | 19.836 | 11.786 | 1.794 | 1.632 | 0.276 | 0.173 | $\infty$ | 181.193 |
| C-04 | 1.699 | 1.671 | 0.079 | 0.039 | 161.921 | 145.560 | 1.735 | 1.679 | 0.196 | 0.130 | $\infty$ | 239.270 |
| C-05 | 1.735 | 1.694 | 0.082 | 0.038 | 270.295 | 217.505 | 1.754 | 1.615 | 0.276 | 0.149 | $\infty$ | 167.329 |
| C-06 | 1.735 | 1.692 | 0.078 | 0.026 | $\infty$ | 209.346 | 1.781 | 1.622 | 0.252 | 0.118 | $\infty$ | 214.946 |

Table15-D

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| D-01 | 1.928 | 1.886 | 0.137 | 0.069 | 21.026 | 17.768 | 1.723 | 1.643 | 0.382 | 0.323 | ∞ | 119.322 |
| D-02 | 1.943 | 1.862 | 0.123 | 0.018 | 19.960 | 14.046 | 1.784 | 1.655 | 0.326 | 0.234 | ∞ | 160.895 |
| D-03 | 1.947 | 1.846 | 0.120 | 0.000 | 19.411 | 12.019 | 1.789 | 1.634 | 0.281 | 0.182 | ∞ | 176.028 |
| D-04 | 1.695 | 1.674 | 0.075 | 0.046 | 159.493 | 148.447 | 1.731 | 1.687 | 0.195 | 0.141 | 273.632 | 234.699 |
| D-05 | 1.732 | 1.696 | 0.081 | 0.042 | 266.580 | 218.746 | 1.745 | 1.620 | 0.283 | 0.159 | ∞ | 160.070 |
| D-06 | 1.734 | 1.693 | 0.078 | 0.027 | ∞ | 210.617 | 1.767 | 1.630 | 0.252 | 0.123 | ∞ | 206.982 |
| D-07 | 1.723 | 1.660 | 0.082 | 0.031 | ∞ | 221.552 | 1.832 | 1.613 | 0.241 | 0.108 | ∞ | 177.439 |

Table15-E

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|------|------|------|------|------|------|------|------|------|------|------|------|------|
| E-01 | 1.925 | 1.891 | 0.144 | 0.087 | 19.955 | 17.523 | 1.686 | 1.619 | 0.377 | 0.336 | 127.104 | 114.397 |
| E-02 | 1.947 | 1.870 | 0.124 | 0.024 | 19.462 | 14.081 | 1.783 | 1.656 | 0.330 | 0.244 | ∞ | 150.903 |
| E-03 | 1.947 | 1.849 | 0.124 | 0.000 | 18.998 | 12.045 | 1.778 | 1.625 | 0.281 | 0.186 | ∞ | 169.614 |
| E-04 | 1.692 | 1.677 | 0.069 | 0.054 | 157.553 | 150.032 | 1.727 | 1.693 | 0.190 | 0.164 | 253.769 | 229.862 |
| E-05 | 1.729 | 1.698 | 0.080 | 0.044 | 251.532 | 219.912 | 1.728 | 1.628 | 0.292 | 0.167 | ∞ | 150.571 |
| E-06 | 1.728 | 1.694 | 0.077 | 0.029 | ∞ | 210.961 | 1.757 | 1.639 | 0.250 | 0.125 | ∞ | 199.775 |
| E-07 | 1.753 | 1.654 | 0.078 | 0.021 | ∞ | 211.857 | 1.912 | 1.611 | 0.220 | 0.096 | ∞ | 202.106 |

Table15-F

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|-------|-------|-------|-------|---------|---------|-------|-------|-------|-------|---------|---------|
| F-01 | 1.950 | 1.875 | 0.122 | 0.025 | 19.494 | 14.295 | 1.792 | 1.662 | 0.337 | 0.249 | $\infty$ | 138.575 |
| F-02 | 1.943 | 1.846 | 0.132 | 0.004 | 18.898 | 12.042 | 1.763 | 1.612 | 0.279 | 0.186 | $\infty$ | 161.008 |
| F-03 | 1.724 | 1.699 | 0.079 | 0.045 | 247.964 | 221.101 | 1.721 | 1.638 | 0.301 | 0.176 | 172.085 | 143.974 |
| F-04 | 1.723 | 1.693 | 0.077 | 0.033 | $\infty$ | 210.599 | 1.752 | 1.648 | 0.247 | 0.128 | $\infty$ | 199.200 |
| F-05 | 1.740 | 1.693 | 0.077 | 0.030 | $\infty$ | 206.669 | 1.799 | 1.579 | 0.230 | 0.106 | $\infty$ | 203.487 |
| F-06 | 1.750 | 1.656 | 0.078 | 0.022 | $\infty$ | 213.947 | 1.923 | 1.614 | 0.223 | 0.097 | $\infty$ | 191.019 |

Table 15-G

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| G-01 | 1.955 | 1.881 | 0.116 | 0.024 | 20.279 | 15.118 | 1.816 | 1.683 | 0.355 | 0.259 | ∞ | 132.898 |
| G-02 | 1.937 | 1.842 | 0.138 | 0.011 | 19.161 | 12.240 | 1.751 | 1.603 | 0.280 | 0.188 | ∞ | 152.054 |
| G-03 | 1.947 | 1.823 | 0.131 | 0.000 | 19.228 | 10.142 | 1.783 | 1.616 | 0.254 | 0.151 | ∞ | 192.936 |
| G-04 | 1.721 | 1.701 | 0.077 | 0.045 | 239.263 | 222.197 | 1.720 | 1.644 | 0.305 | 0.177 | 161.062 | 136.808 |
| G-05 | 1.721 | 1.693 | 0.077 | 0.035 | 245.793 | 210.312 | 1.752 | 1.651 | 0.246 | 0.133 | ∞ | 191.952 |
| G-06 | 1.740 | 1.695 | 0.077 | 0.032 | ∞ | 208.328 | 1.805 | 1.580 | 0.232 | 0.108 | ∞ | 195.570 |
| G-07 | 1.735 | 1.657 | 0.077 | 0.024 | | 215.902 | 1.806 | 1.618 | 0.224 | 0.097 | ∞ | 182.960 |

Table15-H

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|------|------|------|------|------|------|------|------|------|------|------|------|
| H-01 | 1.960 | 1.891 | 0.111 | 0.023 | 21.165 | 16.261 | 1.843 | 1.713 | 0.382 | 0.279 | $\infty$ | 126.652 |
| H-02 | 1.935 | 1.843 | 0.140 | 0.016 | 19.437 | 12.685 | 1.746 | 1.604 | 0.288 | 0.196 | $\infty$ | 177.678 |
| H-03 | 1.947 | 1.828 | 0.128 | 0.000 | 19.380 | 10.599 | 1.787 | 1.618 | 0.262 | 0.159 | $\infty$ | 187.664 |
| H-04 | 1.720 | 1.704 | 0.074 | 0.049 | 236.042 | 223.100 | 1.711 | 1.641 | 0.299 | 0.184 | 151.104 | 128.169 |
| H-05 | 1.721 | 1.694 | 0.078 | 0.035 | 243.446 | 210.844 | 1.754 | 1.649 | 0.249 | 0.134 | $\infty$ | 181.064 |
| H-06 | 1.739 | 1.697 | 0.076 | 0.032 | $\infty$ | 209.931 | 1.810 | 1.580 | 0.235 | 0.109 | $\infty$ | 216.664 |
| H-07 | 1.730 | 1.656 | 0.076 | 0.027 | $\infty$ | 217.650 | 1.804 | 1.625 | 0.225 | 0.100 | $\infty$ | 177.272 |

Table15-I

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| I-01 | 1.966 | 1.905 | 0.109 | 0.028 | 21.461 | 17.167 | 1.855 | 1.737 | 0.407 | 0.308 | $\infty$ | 121.537 |
| I-02 | 1.936 | 1.851 | 0.138 | 0.021 | 19.418 | 13.206 | 1.745 | 1.611 | 0.300 | 0.211 | $\infty$ | 173.052 |
| I-03 | 1.950 | 1.836 | 0.126 | 0.000 | 19.237 | 11.040 | 1.789 | 1.626 | 0.271 | 0.169 | $\infty$ | 183.002 |
| I-04 | 1.723 | 1.696 | 0.078 | 0.035 | 242.566 | 212.120 | 1.754 | 1.644 | 0.255 | 0.143 | $\infty$ | 168.954 |
| I-05 | 1.738 | 1.699 | 0.075 | 0.032 | $\infty$ | 211.373 | 1.811 | 1.579 | 0.237 | 0.115 | $\infty$ | 213.072 |
| I-06 | 1.728 | 1.655 | 0.075 | 0.029 | $\infty$ | 219.101 | 1.805 | 1.636 | 0.226 | 0.106 | $\infty$ | 172.052 |

Table15-J

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| J-01 | 1.973 | 1.922 | 0.111 | 0.042 | 20.839 | 17.465 | 1.840 | 1.743 | 0.418 | 0.340 | 161.544 | 119.422 |
| J-02 | 1.940 | 1.863 | 0.136 | 0.027 | 19.023 | 13.566 | 1.742 | 1.619 | 0.310 | 0.227 | $\infty$ | 166.497 |
| J-03 | 1.953 | 1.845 | 0.124 | 0.000 | 18.857 | 11.352 | 1.789 | 1.632 | 0.278 | 0.180 | $\infty$ | 178.361 |
| J-04 | 1.724 | 1.698 | 0.077 | 0.035 | 241.722 | 213.515 | 1.751 | 1.642 | 0.260 | 0.155 | $\infty$ | 161.067 |
| J-05 | 1.737 | 1.701 | 0.074 | 0.034 | $\infty$ | 212.546 | 1.807 | 1.577 | 0.236 | 0.122 | $\infty$ | 205.891 |
| J-06 | 1.768 | 1.650 | 0.079 | 0.023 | $\infty$ | 200.276 | 1.849 | 1.604 | 0.227 | 0.093 | $\infty$ | 212.971 |

Table15-K

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|---|---|---|---|---|---|---|---|---|---|---|---|---|
| K-01 | 1.944 | 1.874 | 0.135 | 0.035 | 18.320 | 13.618 | 1.733 | 1.620 | 0.314 | 0.241 | $\infty$ | 157.397 |
| K-02 | 1.955 | 1.853 | 0.124 | 0.000 | 18.363 | 11.476 | 1.786 | 1.632 | 0.282 | 0.188 | $\infty$ | 173.024 |
| K-03 | 1.723 | 1.700 | 0.077 | 0.037 | 240.271 | 214.658 | 1.744 | 1.646 | 0.261 | 0.163 | $\infty$ | 156.390 |
| K-04 | 1.736 | 1.703 | 0.073 | 0.036 | $\infty$ | 213.396 | 1.797 | 1.574 | 0.232 | 0.126 | $\infty$ | 195.169 |
| K-05 | 1.767 | 1.650 | 0.078 | 0.023 | $\infty$ | 201.239 | 1.850 | 1.606 | 0.229 | 0.094 | $\infty$ | 202.551 |

Table15-L

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| L-01 | 1.947 | 1.882 | 0.136 | 0.044 | 17.718 | 13.578 | 1.725 | 1.617 | 0.315 | 0.249 | $\infty$ | 145.196 |
| L-02 | 1.955 | 1.856 | 0.126 | 0.000 | 18.125 | 11.595 | 1.783 | 1.629 | 0.284 | 0.192 | $\infty$ | 165.335 |
| L-03 | 1.718 | 1.664 | 0.090 | 0.044 | 175.199 | 128.388 | 1.772 | 1.642 | 0.182 | 0.119 | $\infty$ | 240.440 |
| L-04 | 1.720 | 1.701 | 0.076 | 0.041 | 231.299 | 215.799 | 1.738 | 1.658 | 0.262 | 0.174 | $\infty$ | 152.266 |
| L-05 | 1.728 | 1.703 | 0.072 | 0.040 | $\infty$ | 214.049 | 1.784 | 1.629 | 0.229 | 0.128 | $\infty$ | 193.496 |
| L-06 | 1.748 | 1.689 | 0.077 | 0.030 | $\infty$ | 199.849 | 1.761 | 1.583 | 0.215 | 0.104 | $\infty$ | 212.463 |
| L-07 | 1.768 | 1.651 | 0.078 | 0.024 | $\infty$ | 201.932 | 1.850 | 1.607 | 0.229 | 0.098 | $\infty$ | 192.106 |

Table15-M

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|-------|-------|-------|-------|---------|---------|-------|-------|-------|-------|----------|---------|
| M-01 | 1.949 | 1.886 | 0.135 | 0.050 | 17.809  | 13.869  | 1.725 | 1.618 | 0.322 | 0.256 | $\infty$ | 136.370 |
| M-02 | 1.951 | 1.855 | 0.127 | 0.002 | 18.468  | 11.960  | 1.781 | 1.628 | 0.288 | 0.194 | $\infty$ | 153.796 |
| M-03 | 1.949 | 1.830 | 0.135 | 0.000 | 18.469  | 10.161  | 1.771 | 1.611 | 0.250 | 0.153 | $\infty$ | 194.427 |
| M-04 | 1.716 | 1.703 | 0.075 | 0.050 | 226.140 | 217.246 | 1.731 | 1.678 | 0.263 | 0.185 | 179.041  | 147.510 |
| M-05 | 1.721 | 1.704 | 0.072 | 0.045 | $\infty$ | 214.692 | 1.769 | 1.659 | 0.228 | 0.138 | $\infty$ | 199.403 |
| M-06 | 1.746 | 1.690 | 0.077 | 0.033 | $\infty$ | 202.380 | 1.761 | 1.586 | 0.219 | 0.106 | $\infty$ | 208.129 |
| M-07 | 1.770 | 1.651 | 0.078 | 0.026 | $\infty$ | 202.716 | 1.853 | 1.608 | 0.227 | 0.099 | $\infty$ | 186.947 |

Table15-N

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| N-01 | 1.949 | 1.888 | 0.132 | 0.051 | 18.581 | 14.660 | 1.733 | 1.627 | 0.337 | 0.266 | $\infty$ | 131.038 |
| N-02 | 1.947 | 1.854 | 0.127 | 0.006 | 19.085 | 12.539 | 1.780 | 1.630 | 0.296 | 0.200 | $\infty$ | 171.650 |
| N-03 | 1.949 | 1.833 | 0.132 | 0.000 | 18.767 | 10.533 | 1.774 | 1.611 | 0.256 | 0.157 | $\infty$ | 189.575 |
| N-04 | 1.716 | 1.704 | 0.071 | 0.050 | $\infty$ | 215.374 | 1.754 | 1.677 | 0.228 | 0.152 | $\infty$ | 195.166 |
| N-05 | 1.744 | 1.691 | 0.077 | 0.036 | $\infty$ | 204.778 | 1.760 | 1.592 | 0.223 | 0.109 | $\infty$ | 202.001 |
| N-06 | 1.741 | 1.652 | 0.078 | 0.028 | $\infty$ | 209.881 | 1.859 | 1.608 | 0.226 | 0.098 | $\infty$ | 178.700 |

Table15-O

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|-------------|-------------|-------------|-------------|-------------|-------------|-------------|-------------|-------------|-------------|-------------|-------------|
| O-01 | 1.950 | 1.895 | 0.130 | 0.053 | 19.240 | 15.619 | 1.737 | 1.641 | 0.356 | 0.286 | $\infty$ | 126.286 |
| O-02 | 1.946 | 1.858 | 0.127 | 0.010 | 19.361 | 13.105 | 1.779 | 1.636 | 0.307 | 0.211 | $\infty$ | 170.199 |
| O-03 | 1.951 | 1.839 | 0.128 | 0.000 | 18.857 | 10.992 | 1.777 | 1.612 | 0.265 | 0.166 | $\infty$ | 185.156 |
| O-04 | 1.714 | 1.706 | 0.070 | 0.053 | 222.035 | 216.109 | 1.735 | 1.682 | 0.225 | 0.161 | $\infty$ | 187.971 |
| O-05 | 1.742 | 1.694 | 0.076 | 0.038 | $\infty$ | 206.771 | 1.755 | 1.595 | 0.223 | 0.114 | $\infty$ | 215.684 |
| O-06 | 1.738 | 1.652 | 0.078 | 0.031 | $\infty$ | 213.326 | 1.839 | 1.609 | 0.227 | 0.102 | $\infty$ | 171.738 |

Table 15-P

| Case | $n_{1\text{-max}}$ | $n_{1\text{-min}}$ | $k_{1\text{-max}}$ | $k_{1\text{-min}}$ | $d_{1\text{-max}}$ | $d_{1\text{-min}}$ | $n_{2\text{-max}}$ | $n_{2\text{-min}}$ | $k_{2\text{-max}}$ | $k_{2\text{-min}}$ | $d_{2\text{-max}}$ | $d_{2\text{-min}}$ |
|------|------|------|------|------|------|------|------|------|------|------|------|------|
| P-01 | 1.955 | 1.910 | 0.129 | 0.064 | 19.185 | 16.268 | 1.731 | 1.651 | 0.371 | 0.314 | $\infty$ | 121.662 |
| P-02 | 1.950 | 1.868 | 0.127 | 0.016 | 19.061 | 13.452 | 1.774 | 1.642 | 0.317 | 0.227 | $\infty$ | 164.818 |
| P-03 | 1.953 | 1.847 | 0.127 | 0.000 | 18.574 | 11.329 | 1.776 | 1.618 | 0.273 | 0.177 | $\infty$ | 180.821 |
| P-04 | 1.714 | 1.708 | 0.066 | 0.055 | 220.596 | 216.874 | 1.707 | 1.678 | 0.218 | 0.165 | $\infty$ | 179.468 |
| P-05 | 1.742 | 1.697 | 0.075 | 0.039 | $\infty$ | 208.223 | 1.748 | 1.595 | 0.220 | 0.120 | $\infty$ | 209.260 |
| P-06 | 1.735 | 1.651 | 0.077 | 0.034 | $\infty$ | 215.451 | 1.840 | 1.612 | 0.229 | 0.108 | $\infty$ | 166.208 |

Table15-Q

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|---|---|---|---|---|---|---|---|---|---|---|---|---|
| Q-01 | 1.955 | 1.881 | 0.126 | 0.023 | 18.346 | 13.519 | 1.767 | 1.645 | 0.322 | 0.243 | $\infty$ | 156.774 |
| Q-02 | 1.956 | 1.856 | 0.128 | 0.000 | 18.029 | 11.467 | 1.769 | 1.618 | 0.277 | 0.187 | $\infty$ | 176.585 |
| Q-03 | 1.741 | 1.699 | 0.074 | 0.039 | $\infty$ | 209.091 | 1.740 | 1.591 | 0.217 | 0.126 | $\infty$ | 198.961 |
| Q-04 | 1.736 | 1.650 | 0.080 | 0.020 | $\infty$ | 211.222 | 1.868 | 1.614 | 0.224 | 0.094 | $\infty$ | 204.980 |

Table15-R

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|------|------|------|------|------|------|------|------|------|------|------|------|
| R-01 | 1.960 | 1.893 | 0.126 | 0.031 | 17.569 | 13.467 | 1.759 | 1.644 | 0.325 | 0.256 | $\infty$ | 143.259 |
| R-02 | 1.956 | 1.861 | 0.131 | 0.002 | 17.540 | 11.504 | 1.759 | 1.611 | 0.278 | 0.193 | $\infty$ | 171.381 |
| R-03 | 1.740 | 1.700 | 0.073 | 0.041 | $\infty$ | 209.546 | 1.736 | 1.587 | 0.217 | 0.129 | $\infty$ | 185.714 |
| R-04 | 1.745 | 1.696 | 0.075 | 0.028 | $\infty$ | 205.939 | 1.790 | 1.604 | 0.211 | 0.105 | $\infty$ | 201.921 |
| R-05 | 1.734 | 1.657 | 0.079 | 0.020 | $\infty$ | 213.387 | 1.874 | 1.617 | 0.226 | 0.095 | $\infty$ | 193.505 |

Table15-S

| Case | $n_{1\text{-}max}$ | $n_{1\text{-}min}$ | $k_{1\text{-}max}$ | $k_{1\text{-}min}$ | $d_{1\text{-}max}$ | $d_{1\text{-}min}$ | $n_{2\text{-}max}$ | $n_{2\text{-}min}$ | $k_{2\text{-}max}$ | $k_{2\text{-}min}$ | $d_{2\text{-}max}$ | $d_{2\text{-}min}$ |
|---|---|---|---|---|---|---|---|---|---|---|---|---|
| S-01 | 1.964 | 1.903 | 0.123 | 0.040 | 17.353 | 13.759 | 1.759 | 1.648 | 0.331 | 0.267 | $\infty$ | 144.756 |
| S-02 | 1.952 | 1.860 | 0.135 | 0.012 | 17.539 | 11.668 | 1.750 | 1.604 | 0.280 | 0.196 | $\infty$ | 162.922 |
| S-03 | 1.955 | 1.833 | 0.133 | 0.000 | 18.087 | 9.947 | 1.778 | 1.614 | 0.252 | 0.156 | $\infty$ | 193.262 |
| S-04 | 1.709 | 1.664 | 0.092 | 0.042 | 163.046 | 129.659 | 1.784 | 1.659 | 0.196 | 0.120 | $\infty$ | 243.485 |
| S-05 | 1.739 | 1.699 | 0.074 | 0.044 | $\infty$ | 210.046 | 1.739 | 1.586 | 0.222 | 0.129 | $\infty$ | 177.669 |
| S-06 | 1.744 | 1.697 | 0.075 | 0.029 | $\infty$ | 207.633 | 1.795 | 1.605 | 0.216 | 0.105 | $\infty$ | 205.481 |
| S-07 | 1.732 | 1.658 | 0.078 | 0.021 | $\infty$ | 215.326 | 1.877 | 1.619 | 0.228 | 0.098 | $\infty$ | 189.945 |

Table 15-T

| Case | $n_{1-max}$ | $n_{1-min}$ | $k_{1-max}$ | $k_{1-min}$ | $d_{1-max}$ | $d_{1-min}$ | $n_{2-max}$ | $n_{2-min}$ | $k_{2-max}$ | $k_{2-min}$ | $d_{2-max}$ | $d_{2-min}$ |
|------|-------|-------|-------|-------|---------|---------|-------|-------|-------|-------|-------|---------|
| T-01 | 1.966 | 1.909 | 0.117 | 0.043 | 18.089 | 14.663 | 1.773 | 1.665 | 0.348 | 0.278 | $\infty$ | 140.260 |
| T-02 | 1.948 | 1.857 | 0.137 | 0.016 | 18.051 | 12.041 | 1.748 | 1.604 | 0.285 | 0.199 | $\infty$ | 150.984 |
| T-03 | 1.955 | 1.835 | 0.128 | 0.000 | 18.523 | 10.348 | 1.785 | 1.616 | 0.259 | 0.159 | $\infty$ | 188.160 |
| T-04 | 1.739 | 1.699 | 0.075 | 0.048 | 256.743 | 210.937 | 1.744 | 1.589 | 0.230 | 0.145 | $\infty$ | 180.549 |
| T-05 | 1.743 | 1.698 | 0.075 | 0.030 | $\infty$ | 209.294 | 1.800 | 1.608 | 0.223 | 0.109 | $\infty$ | 200.943 |
| T-06 | 1.731 | 1.652 | 0.078 | 0.022 | $\infty$ | 217.122 | 1.874 | 1.620 | 0.227 | 0.100 | $\infty$ | 184.530 |

The combinations of values of $[n_{10}, n_{20}, k_{10}, k_{20}, d_{10}, d_{20}]$ are adapted for minimizing the reflectance over the entire incidence angle region corresponding to the numerical aperture NA of a corresponding exposure system. In other words, assuming an evaluation function f for minimization, the evaluation function f is a function of $n_{10}, n_{20}, k_{10}, k_{20}, d_{10}$, and $d_{20}$, and the above-described combinations of values of $[n_{10}, n_{20}, k_{10}, k_{20}, d_{10}, d_{20}]$ are combinations for minimizing $f(n_{10}, n_{20}, k_{10}, k_{20}, d_{10}, d_{20})$. Namely, the evaluation function f is minimized by the above-descried combinations of values of $[n_{10}, n_{20}, k_{10}, k_{20}, d_{10}, d_{20}]$.

When multivariable function $f(x_i)$ (i = 0, 1, 2, ... n) is minimized at $x_i = x_{1-min}$, the function $f(x_i)$ near the minimum value may be expressed by the following equation (1). Namely, the function may be approximated by a quadratic function. In the equation (1), symbol "Σ" represents the sum of i = 0, 1, 2, ... n. This applies to equation (2).

$$f(x_i) = \Sigma a_i (x_i - x_{1-min})^2 + b \qquad (1)$$

In this case, a condition for setting $f(x_i)$ to be a certain constant c larger than b may be expressed by the elliptic function expression (2) wherein $x_{1-c}$ is a value of $x_i$ at $f(x_i) = c$ when only $x_i$ is varied with all other variables being fixed.

$$\Sigma (x_i - x_{1-min})^2 / (x_{i-c} - x_{i-min})^2 \leq 1 \qquad (2)$$

Therefore, by using the values of $n_{i-max}, n_{i-min}, k_{i-max}, k_{i-min}, d_{i-max}, d_{i-min}, n_{2-max}, n_{2-min}, k_{2-max}, k_{2-min}, d_{2-max}$, and $d_{2-min}$, with each of which the reflectance is 0.4% when one of the variables is changed with the other being fixed, the reflectance may be controlled to below 0.4% by utilizing $n_{10}, n_{20}, k_{10}, k_{20}, d_{10}$, and $d_{20}$ satisfying the following expression (3) :

$$\{(n_1 - n_{10})/(n_{1m} - n_{10})\}^2 + \{(k_1 - k_{10})/(k_{1m} - k_{10})\}^2 + \{(d_1$$
$$- d_{10})/(d_{1m} - d_{10})\}^2 + \{(n_2 - n_{20})/(n_{2m} - n_{20})\}^2 + \{(k_2 - k_{20})/(k_{2m}$$
$$- k_{20})\}^2 + \{(d_2 - d_{20})/(d_{2m} - d_{20})\}^2 \leq 1 \qquad (3)$$

However, $n_{1m}, n_{2m}, k_{1m}, k_{2m}, d_{1m}$, and $d_{2m}$ take the following values:

$n_{1m}$: $n_{1-max}$ when $n_1 \geq n_{10}$ and $n_{1-min}$ when $n_1 < n_{10}$
$k_{1m}$: $k_{1-max}$ when $k_1 \geq k_{10}$ and $k_{1-min}$ when $k_1 < k_{10}$
$d_{1m}$: $d_{1-max}$ when $d_1 \geq d_{10}$ and $d_{1-min}$ when $d_1 < d_{10}$
$n_{2m}$: $n_{2-max}$ when $n_2 \geq n_{20}$ and $n_{2-min}$ when $n_2 < n_{20}$
$k_{2m}$: $k_{2-max}$ when $k_2 \geq k_{20}$ and $k_{2-min}$ when $k_2 < k_{20}$
$d_{2m}$: $d_{2-max}$ when $d_2 \geq d_{20}$ and $d_{2-min}$ when $d_2 < d_{20}$

The reason for distinguishing the values of $n_{1m}, n_{2m}, k_{1m}, k_{2m}, d_{1m}$, and $d_{2m}$ according to the magnitude relations between $n_1, n_2, k_1, k_2, d_1$, and $d_2$ and $n_{10}, n_{20}, k_{10}, k_{20}, d_{10}$, and $d_{20}$, respectively, is that since the following conditions are not exactly satisfied,

$$n_{1-max} - n_{10} = n_{10} - n_{1-min}$$

$$k_{1-max} - k_{10} = k_{10} - k_{1-min}$$

$$d_{1-max} - d_{10} = d_{10} - d_{1-min}$$

EP 1 760 766 A2

$$n_{2-max} - n_{20} = n_{20} - n_{2-min}$$

$$k_{2-max} - k_{20} = k_{20} - k_{2-min}$$

$$d_{2-max} - d_{20} = d_{20} - d_{2-min}$$

definitions of the diameter of an ellipsoid specified by expression (2) are distinguished according to the magnitude relations between $n_1$, $n_2$, $k_1$, $k_2$, $d_1$, and $d_2$ and $n_{10}$, $n_{20}$, $k_{10}$, $k_{20}$, $d_{10}$, and $d_{20}$, respectively. In other words, for example, the curvature of the ellipsoid at $n_1 \geq n_{10}$ is different from that at $n_1 < n_{10}$. This applies to $k_{10}$, $d_{10}$, $n_{20}$, $k_{20}$, and $d_{20}$.

When the numerical aperture NA is $0.93 \leq NA \leq 1.0$, a reflectance below 0.4% is secured by selecting any one of the following combinations of values of [$n_{10}$, $n_{20}$, $k_{10}$, $k_{20}$, $d_{10}$, $d_{20}$] :

Case A-01 to Case A-15 with 2 (nm) $\leq T \leq$ 15 (nm)
Case B-01 to Case B-22 with 15 (nm) < T $\leq$ 25 (nm)
Case C-01 to Case C-18 with 25 (nm) < T $\leq$ 35 (nm)
Case D-01 to Case D-20 with 35 (nm) < T $\leq$ 45 (nm)
Case E-01 to Case E-17 with 45 (nm) < T $\leq$ 55 (nm)
Case F-01 to Case F-17 with 55 (nm) < T $\leq$ 65 (nm)
Case G-01 to Case G-16 with 65 (nm) < T $\leq$ 75 (nm)
Case H-01 to Case H-16 with 75 (nm) < T $\leq$ 85 (nm)
Case I-01 to Case 1-23 with 85 (nm) < T $\leq$ 95 (nm)
Case J-01 to Case J-15 with 95 (nm) < T $\leq$ 105 (nm)
Case K-01 to Case K-13 with 105 (nm) < T $\leq$ 115 (nm)
Case L-01 to Case L-12 with 115 (nm) < T $\leq$ 125 (nm)
Case M-01 to Case M-12 with 125 (nm) < T $\leq$ 135 (nm)
Case N-01 to Case N-12 with 135 (nm) < T $\leq$ 145 (nm)
Case O-01 to Case O-13 with 145 (nm) < T $\leq$ 155 (nm)
Case P-01 to Case P-14 with 155 (nm) < T $\leq$ 165 (nm)
Case Q-01 to Case Q-13 with 165 (nm) < T $\leq$ 175 (nm)
Case R-01 to Case R-13 with 175 (nm) < T $\leq$ 185 (nm)
Case S-01 to Case S-15 with 185 (nm) < T $\leq$ 195 (nm)
Case T-01 to Case T-13 with 195 (nm) < T $\leq$ 205 (nm)

In addition, when $n_1$ is in the range of the maximum ($n_{1-max}$) to the minimum ($n_{1-min}$) of $n_{1m}$ in a corresponding case, $k_1$ is in the range of the maximum ($k_{1-max}$) to the minimum ($k_{1-min}$) of $k_{1m}$ in a corresponding case, $d_1$ is in the range of the maximum ($d_{1-max}$) to the minimum ($d_{1-min}$) of $d_{1m}$ in a corresponding case, $n_2$ is in the range of the maximum ($n_{2-max}$) to the minimum ($n_{2-min}$) of $n_{2m}$ in a corresponding case, $k_2$ is in the range of the maximum ($k_{2-max}$) to the minimum ($k_{2-min}$) of $k_{2m}$ in a corresponding case, and $d_2$ is in the range of the maximum ($d_{2-max}$) to the minimum ($d_{2-min}$) of $d_{2m}$ in a corresponding case, it is secured that the reflectance of the antireflective film from the silicon semiconductor substrate does not exceed 0.4% using a value of $n_{1m}$ in a corresponding case on the basis of the magnitude relation between $n_1$ and $n_{10}$, a value of $k_{1m}$ in a corresponding case on the basis of the magnitude relation between $k_1$ and $k_{10}$, a value of $d_{1m}$ in a corresponding case on the basis of the magnitude relation between $d_1$ and $d_{10}$, a value of $n_{2m}$ in a corresponding case on the basis of the magnitude relation between $n_2$ and $n_{20}$, a value of $k_{2m}$ in a corresponding case on the basis of the magnitude relation between $k_2$ and $k_{20}$, and a value of $d_{2m}$ in a corresponding case on the basis of the magnitude relation between $d_2$ and $d_{20}$. As a result, an excellent resist pattern is obtained.

When the numerical aperture NA is $1.0 < NA \leq 1.1$, a reflectance below 0.4% is secured by selecting any one of the following combinations of values of [$n_{10}$, $n_{20}$, $k_{10}$, $k_{20}$, $d_{10}$, $d_{20}$] :

Case A-01 to Case A-24 with 2 (nm) $\leq T \leq$ 15 (nm)
Case B-01 to Case B-22 with 15 (nm) < T $\leq$ 25 (nm)
Case C-01 to Case C-16 with 25 (nm) < T $\leq$ 35 (nm)
Case D-01 to Case D-14 with 35 (nm) < T $\leq$ 45 (nm)

296

Case E-01 to Case E-14 with 45 (nm) < T ≤ 55 (nm)
Case F-01 to Case F-16 with 55 (nm) < T ≤ 65 (nm)
Case G-01 to Case G-16 with 65 (nm) < T ≤ 75 (nm)
Case H-01 to Case H-17 with 75 (nm) < T ≤ 85 (nm)
Case I-01 to Case I-15 with 85 (nm) < T ≤ 95 (nm)
Case J-01 to Case J-13 with 95 (nm) < T ≤ 105 (nm)
Case K-01 to Case K-12 with 105 (nm) < T ≤ 115 (nm)
Case L-01 to Case L-13 with 115 (nm) < T ≤ 125 (nm)
Case M-01 to Case M-11 with 125 (nm) < T ≤ 135 (nm)
Case N-01 to Case N-12 with 135 (nm) < T ≤ 145 (nm)
Case O-01 to Case O-12 with 145 (nm) < T ≤ 155 (nm)
Case P-01 to Case P-12 with 155 (nm) < T ≤ 165 (nm)
Case Q-01 to Case Q-12 with 165 (nm) < T ≤ 175 (nm)
Case R-01 to Case R-10 with 175 (nm) < T ≤ 185 (nm)
Case S-01 to Case S-13 with 185 (nm) < T ≤ 195 (nm)
Case T-01 to Case T-12 with 195 (nm) < T ≤ 205 (nm)

In addition, when $n_1$ is in the range of the maximum ($n_{1\text{-max}}$) to the minimum ($n_{1\text{-min}}$) of $n_{1m}$ in a corresponding case, $k_1$ is in the range of the maximum ($k_{1\text{-max}}$) to the minimum ($k_{1\text{-min}}$) of $k_{1m}$ in a corresponding case, $d_1$ is in the range of the maximum ($d_{1\text{-max}}$) to the minimum ($d_{1\text{-min}}$) of $d_{1m}$ in a corresponding case, $n_2$ is in the range of the maximum ($n_{2\text{-max}}$) to the minimum ($n_{2\text{-min}}$) of $n_{2m}$ in a corresponding case, $k_2$ is in the range of the maximum ($k_{2\text{-max}}$) to the minimum ($k_{2\text{-min}}$) of $k_{2m}$ in a corresponding case, and $d_2$ is in the range of the maximum ($d_{2\text{-max}}$) to the minimum ($d_{2\text{-min}}$) of $d_{2m}$ in a corresponding case, it is secured that the reflectance of the antireflective film from the silicon semiconductor substrate does not exceed 0.4% using a value of $n_{1m}$ in a corresponding case on the basis of the magnitude relation between $n_1$ and $n_{10}$, a value of $k_{1m}$ in a corresponding case on the basis of the magnitude relation between $k_1$ and $k_{10}$, a value of $d_{1m}$ in a corresponding case on the basis of the magnitude relation between $d_1$ and $d_{10}$, a value of $n_{2m}$ in a corresponding case on the basis of the magnitude relation between $n_2$ and $n_{20}$, a value of $k_{2m}$ in a corresponding case on the basis of the magnitude relation between $k_2$ and $k_{20}$, and a value of $d_{2m}$ in a corresponding case on the basis of the magnitude relation between $d_2$ and $d_{20}$. As a result, an excellent resist pattern is obtained.

Furthermore, when the numerical aperture NA is $1.1 \leq NA \leq 1.2$, a reflectance below 0.4% is secured by selecting any one of the following combinations of values of $[n_{10}, n_{20}, k_{10}, k_{20}, d_{10}, d_{20}]$ :

Case A-01 to Case A-19 with 2 (nm) ≤ T ≤ 15 (nm)
Case B-01 to Case B-17 with 15 (nm) < T ≤ 25 (nm)
Case C-01 to Case C-14 with 25 (nm) < T ≤ 35 (nm)
Case D-01 to Case D-13 with 35 (nm) < T ≤ 45 (nm)
Case E-01 to Case E-13 with 45 (nm) < T ≤ 55 (nm)
Case F-01 to Case F-12 with 55 (nm) < T ≤ 65 (nm)
Case G-01 to Case G-13 with 65 (nm) < T ≤ 75 (nm)
Case H-01 to Case H-15 with 75 (nm) < T ≤ 85 (nm)
Case I-01 to Case I-13 with 85 (nm) < T ≤ 95 (nm)
Case J-01 to Case J-12 with 95 (nm) < T ≤ 105 (nm)
Case K-01 to Case K-09 with 105 (nm) < T ≤ 115 (nm)
Case L-01 to Case L-10 with 115 (nm) < T ≤ 125 (nm)
Case M-01 to Case M-09 with 125 (nm) < T ≤ 135 (nm)
Case N-01 to Case N-10 with 135 (nm) < T ≤ 145 (nm)
Case O-01 to Case O-09 with 145 (nm) < T ≤ 155 (nm)
Case P-01 to Case P-09 with 155 (nm) < T ≤ 165 (nm)
Case Q-01 to Case Q-09 with 165 (nm) < T ≤ 175 (nm)
Case R-01 to Case R-08 with 175 (nm) < T ≤ 185 (nm)
Case S-01 to Case S-10 with 185 (nm) < T ≤ 195 (nm)
Case T-01 to Case T-11 with 195 (nm) < T ≤ 205 (nm)

In addition when $n_1$ is in the range of the maximum ($n_{1\text{-max}}$) to the minimum ($n_{1\text{-min}}$) of $n_{1m}$ in a corresponding case, $k_1$ is in the range of the maximum ($k_{1\text{-max}}$) to the minimum ($k_{1\text{-min}}$) of $k_{1m}$ in a corresponding case, $d_1$ is in the range of the maximum ($d_{1\text{-max}}$) to the minimum ($d_{1\text{-min}}$) of $d_{1m}$ in a corresponding case, $n_2$ is in the range of the maximum ($n_{2\text{-max}}$) to the minimum ($n_{2\text{-min}}$) of $n_{2m}$ in a corresponding case, $k_2$ is in the range of the maximum ($k_{2\text{-max}}$) to the minimum ($k_{2\text{-min}}$) of $k_{2m}$ in a corresponding case, and $d_2$ is in the range of the maximum ($d_{2\text{-max}}$) to the minimum ($d_{2\text{-min}}$) of $d_{2m}$

in a corresponding case, it is ensured that the reflectance of the antireflective film from the silicon semiconductor substrate does not exceed 0.4% using a value of $n_{1m}$ in a corresponding case on the basis of the magnitude relation between $n_1$ and $n_{10}$, a value of $k_{1m}$ in a corresponding case on the basis of the magnitude relation between $k_1$ and $k_{10}$, a value of $d_{1m}$ in a corresponding case on the basis of the magnitude relation between $d_1$ and $d_{10}$, a value of $n_{2m}$ in a corresponding case on the basis of the magnitude relation between $n_2$ and $n_{20}$, a value of $k_{2m}$ in a corresponding case on the basis of the magnitude relation between $k_2$ and $k_{20}$, and a value of $d_{2m}$ in a corresponding case on the basis of the magnitude relation between $d_2$ and $d_{20}$. As a result, an excellent resist pattern is obtained.

Furthermore, when the numerical aperture NA is $1.2 < NA \le 1.3$, a reflectance below 0.4% is secured by selecting any one of the following combinations of values of $[n_{10}, n_{20}, k_{10}, k_{20}, d_{10}, d_{20}]$ :

Case A-01 to Case A-13 with 2 (nm) $\le$ T $\le$ 15 (nm)
Case B-01 to Case B-10 with 15 (nm) < T $\le$ 25 (nm)
Case C-01 to Case C-08 with 25 (nm) < T $\le$ 35 (nm)
Case D-01 to Case D-09 with 35 (nm) < T $\le$ 45 (nm)
Case E-01 to Case E-08 with 45 (nm) < T $\le$ 55 (nm)
Case F-01 to Case F-08 with 55 (nm) < T $\le$ 65 (nm)
Case G-01 to Case G-08 with 65 (nm) < T $\le$ 75 (nm)
Case H-01 to Case H-07 with 75 (nm) < T $\le$ 85 (nm)
Case I-01 to Case I-07 with 85 (nm) < T $\le$ 95 (nm)
Case J-01 to Case J-06 with 95 (nm) < T $\le$ 105 (nm)
Case K-01 to Case K-07 with 105 (nm) < T $\le$ 115 (nm)
Case L-01 to Case L-08 with 115 (nm) < T $\le$ 125 (nm)
Case M-01 to Case M-07 with 125 (nm) < T $\le$ 135 (nm)
Case N-01 to Case N-07 with 135 (nm) < T $\le$ 145 (nm)
Case O-01 to Case O-07 with 145 (nm) < T $\le$ 155 (nm)
Case P-01 to Case P-07 with 155 (nm) < T $\le$ 165 (nm)
Case Q-01 to Case Q-07 with 165 (nm) < T $\le$ 175 (nm)
Case R-01 to Case R-05 with 175 (nm) < T $\le$ 185 (nm)
Case S-01 to Case S-07 with 185 (nm) < T $\le$ 195 (nm)
Case T-01 to Case T-07 with 195 (nm) < T $\le$ 205 (nm)

In addition, when $n_1$ is in the range of the maximum ($n_{1-max}$) to the minimum ($n_{1-min}$) of $n_{1m}$ in a corresponding case, $k_1$ is in the range of the maximum ($k_{1-max}$) to the minimum ($k_{1-min}$) of $k_{1m}$ in a corresponding case, $d_1$ is in the range of the maximum ($d_{1-max}$) to the minimum ($d_{1-min}$) of $d_{1m}$ in a corresponding case, $n_2$ is in the range of the maximum ($n_{2-max}$) to the minimum ($n_{2-min}$) of $n_{2m}$ in a corresponding case, $k_2$ is in the range of the maximum ($k_{2-max}$) to the minimum ($k_{2-min}$) of $k_{2m}$ in a corresponding case, and $d_2$ is in the range of the maximum ($d_{2-max}$) to the minimum ($d_{2-min}$) of $d_{2m}$ in a corresponding case, it is secured that the reflectance of the antireflective film from the silicon semiconductor substrate does not exceed 0.4% using a value of $n_{1m}$ in a corresponding case on the basis of the magnitude relation between $n_1$ and $n_{10}$, a value of $k_{1m}$ in a corresponding case on the basis of the magnitude relation between $k_1$ and $k_{10}$, a value of $d_{1m}$ in a corresponding case on the basis of the magnitude relation between $d_1$ and $d_{10}$, a value of $n_{2m}$ in a corresponding case on the basis of the magnitude relation between $n_2$ and $n_{20}$, a value of $k_{2m}$ in a corresponding case on the basis of the magnitude relation between $k_2$ and $k_{20}$, and a value of $d_{2m}$ in a corresponding case on the basis of the magnitude relation between $d_2$ and $d_{20}$. As a result, an excellent resist pattern is obtained.

Furthermore, when the numerical aperture NA is $1.3 < NA \le 1.4$, a reflectance below 0.4% is secured by selecting any one of the following combinations of values of $[n_{10}, n_{20}, k_{10}, k_{20}, d_{10}, d_{20}]$ :

Case A-01 to Case A-11 with 2 (nm) $\le$ T $\le$ 15 (nm)
Case B-01 to Case B-10 with 15 (nm) < T $\le$ 25 (nm)
Case C-01 to Case C-06 with 25 (nm) < T $\le$ 35 (nm)
Case D-01 to Case D-07 with 35 (nm) < T $\le$ 45 (nm)
Case E-01 to Case E-07 with 45 (nm) < T $\le$ 55 (nm)
Case F-01 to Case F-06 with 55 (nm) < T $\le$ 65 (nm)
Case G-01 to Case G-07 with 65 (nm) < T $\le$ 75 (nm)
Case H-01 to Case H-07 with 75 (nm) < T $\le$ 85 (nm)
Case I-01 to Case I-06 with 85 (nm) < T $\le$ 95 (nm)
Case J-01 to Case J-06 with 95 (nm) < T $\le$ 105 (nm)
Case K-01 to Case K-05 with 105 (nm) < T $\le$ 115 (nm)
Case L-01 to Case L-07 with 115 (nm) < T $\le$ 125 (nm)

Case M-01 to Case M-07 with 125 (nm) < T ≤ 135 (nm)
Case N-01 to Case N-06 with 135 (nm) < T ≤ 145 (nm)
Case O-01 to Case O-06 with 145 (nm) < T ≤ 155 (nm)
Case P-01 to Case P-06 with 155 (nm) < T ≤ 165 (nm)
Case Q-01 to Case Q-04 with 165 (nm) < T ≤ 175 (nm)
Case R-01 to Case R-05 with 175 (nm) < T ≤ 185 (nm)
Case S-01 to Case S-07 with 185 (nm) < T ≤ 195 (nm)
Case T-01 to Case T-06 with 195 (nm) < T ≤ 205 (nm)

In addition, when $n_1$ is in the range of the maximum ($n_{1-max}$) to the minimum ($n_{1-min}$) of $n_{1m}$ in a corresponding case, $k_1$ is in the range of the maximum ($k_{1-max}$) to the minimum ($k_{1-min}$) of $k_{1m}$ in a corresponding case, $d_1$ is in the range of the maximum ($d_{1-max}$) to the minimum ($d_{1-min}$) of $d_{1m}$ in a corresponding case, $n_2$ is in the range of the maximum ($n_{2-max}$) to the minimum ($n_{2-min}$) of $n_{2m}$ in a corresponding case, $k_2$ is in the range of the maximum ($k_{2-max}$) to the minimum ($k_{2-min}$) of $k_{2m}$ in a corresponding case, and $d_2$ is in the range of the maximum ($d_{2-max}$) to the minimum ($d_{2-min}$) of $d_{2m}$ in a corresponding case, it is secured that the reflectance of the antireflective film from the silicon semiconductor substrate does not exceed 0.4% using a value of $n_{1m}$ in a corresponding case on the basis of the magnitude relation between $n_1$ and $n_{10}$, a value of $k_{1m}$ in a corresponding case on the basis of the magnitude relation between $k_1$ and $k_{10}$, a value of $d_{1m}$ in a corresponding case on the basis of the magnitude relation between $d_1$ and $d_{10}$, a value of $n_{2m}$ in a corresponding case on the basis of the magnitude relation between $n_2$ and $n_{20}$, a value of $k_{2m}$ in a corresponding case on the basis of the magnitude relation between $k_2$ and $k_{20}$, and a value of $d_{2m}$ in a corresponding case on the basis of the magnitude relation between $d_2$ and $d_{20}$. As a result, an excellent resist pattern is obtained.

In other words, assuming a 6-dimensional ellipsoid having the six variables of ($n_1$, $n_2$, $k_1$, $k_2$, $d_1$, $d_2$) in which the centers are ($n_{10}$, $n_{20}$, $k_{10}$, $k_{20}$, $d_{10}$, and $d_{20}$) and the diameters are absolute values of ($n_{1m}$ - $n_{10}$), ($k_{1m}$ - $k_{10}$), ($d_{1m}$ - $d_{10}$), ($n_{2m}$ - $n_{20}$), ($k_{2m}$ - $k_{20}$), and ($d_{2m}$ - $d_{20}$), the reflectance of the antireflective film may be controlled to 0.4% or less by selecting a combination of any values of ($n_1$, $n_2$, $k_1$, $k_2$, $d_1$, $d_2$) within a range present in the ellipsoid.

Examples

A two-layer antireflective film having each of the refractive indexes and thicknesses shown in Tables 22, 23, 24, and 25 was formed on a silicon oxide film formed on a surface of a silicon semiconductor substrate by the plasma-enhanced CVD method descried in Japanese Unexamined Patent Application Publication No. 2001-242630 and Proceedings of SPIE 2003, 5039, 152 (K. Babich, et al.). The silicon oxide film was deposited on the silicon substrate by a thermal CVD method. Specifically, the CVD method was performed using $SiH_4$ and $O_2$ as source gases at a reaction temperature set at 400°C.

As described in the above reference documents, the plasma-enhanced CVD method is a method for forming a film in a parallel electrode reactor in which a silicon semiconductor substrate is mounted on one of electrodes. A negative bias voltage is applied to the silicon semiconductor substrate from the electrode, and the pressure in the reactor, the type of the reaction precursor introduced into the reactor (tetramethylsilane, trimethylsilane, tetramethyltetrasiloxne, tetramethylgermane, or oxygen), the flow rate, and the substrate temperature are controlled to form layers having various complex refractive indexes.

In Tables 21, 22, 23, 24, and 25, examples are antireflective films satisfying the conditions of the invention, while comparative examples are comparative antireflective films not satisfying the conditions of the invention.

Table 21

| 0.93 ≤ NA ≤ 1.0 | | | | | | | |
|---|---|---|---|---|---|---|---|
| | Case | Upper layer | | Lower layer | | Thickness of oxide film (nm) | Section pattern |
| | | Complex refractive index | Thickness (nm) | Complex refractive index | Thickness (nm) | | |
| Example 1-1 | E-06 | 1.78-0.14i | 85 | 1.71-0.65i | 55 | 50 | A |
| Comp. Example 1-1 | | 1.90-0.21i | 85 | 1.71-0.65i | 30 | 50 | B |
| Example 1-2 | E-12 | 1.72-0.08i | 155 | 1.73-0.25i | 170 | 50 | A |

(continued)

| 0.93 ≤ NA ≤ 1.0 | | | | | | | |
|---|---|---|---|---|---|---|---|
| | Case | Upper layer | | Lower layer | | Thickness of oxide film (nm) | Section pattern |
| | | Complex refractive index | Thickness (nm) | Complex refractive index | Thickness (nm) | | |
| Comp. Example 1-2A | | 1.72-0.08i | 155 | 1.73-0.25i | 30 | 50 | B |
| Comp. Example 1-2B | | 1.71-0.65i | 155 | 1.90-0.21i | 30 | 50 | B |
| Example 1-3 | J-06 | 1.77-0.11i | 90 | 1.82-0.39i | 115 | 100 | A |
| Comp. Example 1-3 | | 1.77-0.11i | 90 | 1.82-0.39i | 40 | 100 | B |
| Example 1-4 | J-10 | 1.73-0.09i | 155 | 1.76-0.33i | 120 | 100 | A |
| Example 1-5 | O-07 | 1.78-0.14i | 90 | 1.79-0.50i | 75 | 150 | A |
| Comp. Example 1-5 | | 1.78-0.14i | 90 | 1.79-0.50i | 15 | 150 | B |
| Example 1-6 | T-04 | 1.73-0,11i | 85 | 1.62-0.30i | 155 | 200 | A |
| Comp. Example 1-6 | | 1.73-0.11i | 85 | 1.62-0.30i | 60 | 200 | B |

Table 22

| 1.0 < NA ≤ 1.1 | | | | | | | |
|---|---|---|---|---|---|---|---|
| | Case | Upper layer | | Lower layer | | Thickness of oxide film (nm) | Section pattern |
| | | Complex refractive index | Thickness (nm) | Complex refractive index | Thickness (nm) | | |
| Example 2-1 | E-05 | 1.72-0.09i | 90 | 1.64-0.25i | 180 | 50 | A |
| Comp. Example 2-1 | | 1.72-0.09i | 90 | 1.64-0.25i | 40 | 50 | B |
| Example 2-2 | E-02 | 1.93-0.15i | 20 | 1.86-0.50i | 110 | 50 | A |
| Comp. Example 2-2 | | 1.93-0.15i | 20 | 1.86-0.50i | 40 | 50 | B |
| Example 2-3 | J-06 | 1.72-0.09i | 90 | 1.64-0.25i | 170 | 60 | A |
| Comp. Example 2-3 | | 1.72-0.09i | 90 | 1.64-0.25i | 30 | 60 | B |
| Example 2-4 | J-02 | 1.93-0.15i | 16 | 1.75-0.45i | 130 | 100 | A |
| Comp. Example 2-4A | | 1.93-0.15i | 16 | 1.75-0.45i | 50 | 100 | B |
| Comp. Example 2-4B | | 1.62-0.30i | 16 | 1.75-0.45i | 130 | 100 | B |
| Example 2-5 | O-04 | 1.73-0.10i | 90 | 1.69-0.30i | 140 | 150 | A |
| Comp. Example 2-5 | | 1.73-0.10i | 90 | 1.69-0.30i | 100 | 150 | B |
| Example 2-6 | T-10 | 1.69-0.07i | 210 | 1.69-0.20i | 210 | 200 | A |

**EP 1 760 766 A2**

(continued)

|  | Case | Upper layer | | Lower layer | | Thickness of oxide film (nm) | Section pattern |
|---|---|---|---|---|---|---|---|
|  |  | Complex refractive index | Thickness (nm) | Complex refractive index | Thickness (nm) | | |
| Comp. Example 2-6 | | 1.69-0.07i | 210 | 1.69-0.20i | 80 | 200 | B |

Table 23

| 1.1 < NA ≤ 1.2 | | | | | | | |
|---|---|---|---|---|---|---|---|
|  | Case | Upper layer | | Lower layer | | Thickness of oxide film (nm) | Section pattern |
|  |  | Complex refractive index | Thickness (nm) | Complex refractive index | Thickness (nm) | | |
| Example 3-1 | E-04 | 1.72-0.09i | 95 | 1.65-0.24i | 180 | 50 | A |
| Comp. Example 3-1 | | 1.72-0.09i | 95 | 1.65-0.24i | 80 | 50 | B |
| Example 3-2 | E-06 | 1.71-0.07i | 165 | 1.67-0.23i | 170 | 50 | A |
| Comp. Example 3-2 | | 1.71-0.07i | 165 | 1.67-0.23i | 80 | 50 | B |
| Example 3-3 | J-05 | 1.73-0.08i | 95 | 1.70-0.24i | 185 | 100 | A |
| Comp. Example 3-3 | | 1.73-0.08i | 95 | 1.70-0.24i | 40 | 100 | B |
| Example 3-4 | O-01 | 1.90-0.14i | 15 | 1.71-0.39i | 150 | 150 | A |
| Comp. Example 3-4 | | 1.61-0.01i | 15 | 1.71-0.39i | 150 | 150 | B |
| Example 3-5 | S-04 | 1.72-0.08i | 95 | 1.67-0.21i | 220 | 190 | A |
| Comp. Example 3-5A | | 1.61-0.01i | 95 | 1.67-0.21i | 220 | 190 | B |
| Comp. Example 3-5B | | 1.72-0.08i | 95 | 1.67-0.21i | 90 | 190 | B |

Table 24

| 1.2 < NA ≤ 1.3 | | | | | | | |
|---|---|---|---|---|---|---|---|
|  | Case | Upper layer | | Lower layer | | Thickness of oxide film (nm) | Section pattern |
|  |  | Complex refractive index | Thickness (nm) | Complex refractive index | Thickness (nm) | | |
| Example 4-1 | E-04 | 1.94-0.21i | 23 | 1.90-0.79i | 54 | 50 | A |
| Comp. Example 4-1 | | 1.94-0.21i | 23 | 1.90-0.79i | 40 | 50 | B |
| Example 4-2 | J-01 | 1.90-0.14i | 17 | 1.72-0.40i | 135 | 100 | A |
| Comp. Example 4-2 | | 1.90-0.14i | 17 | 1.72-0.40i | 50 | 100 | B |
| Comp. Example 4-3 | | 1.94-0.21i | 17 | 1.72-0.40i | 135 | 100 | B |

(continued)

| 1.2 < NA ≤ 1.3 | | | | | | | |
|---|---|---|---|---|---|---|---|
| | Case | Upper layer | | Lower layer | | Thickness of oxide film (nm) | Section pattern |
| | | Complex refractive index | Thickness (nm) | Complex refractive index | Thickness (nm) | | |
| Example 4-3 | T-01 | 1.90-0.14i | 14 | 1.68-0.33i | 160 | 200 | A |
| Comp. Example 4-4 | | 1.90-0.14i | 14 | 1.68-0.33i | 50 | 200 | B |

Table 25

| 1.3 < NA ≤ 1.4 | | | | | | | |
|---|---|---|---|---|---|---|---|
| | Case | Upper layer | | Lower layer | | Thickness of oxide film (nm) | Section pattern |
| | | Complex refractive index | Thickness (nm) | Complex refractive index | Thickness (nm) | | |
| Example 5-1 | E-01 | 1.90-0.14i | 18 | 1.68-0.47i | 126 | 50 | A |
| Comp. Example 5-1 | | 1.90-0.15i | 18 | 1.68-0.47i | 70 | 50 | B |
| Comp. Example 5-2 | | 1.90-0.14i | 18 | 1.50-0.10i | 126 | 50 | B |
| Example 5-2 | J-01 | 1.93-0.10i | 18 | 1.82-0.40i | 126 | 100 | A |
| Comp. Example 5-3 | | 1.93-0.10i | 70 | 1.82-0.40i | 126 | 100 | B |
| Example 5-3 | O-01 | 1.90-0.12i | 16 | 1.72-0.34i | 145 | 150 | A |
| Comp. Example 5-4 | | 1.90-0.12i | 16 | 1.72-0.34i | 100 | 150 | B |
| Example 5-4 | T-01 | 1.91-0.10i | 15 | 1.75-0.33i | 155 | 200 | A |
| Comp. Example 5-5 | | 1.91-0.10i | 15 | 1.75-0.33i | 70 | 200 | B |

In further detail, in Table 21 showing the results of evaluation with 0.93 ≤ NA ≤ 1.0, Examples 1-1 and 1-2 are antireflective films satisfying the conditions of the invention with the silicon oxide film having a thickness (T) of 45 (nm) < T ≤ 55 (nm), Examples 1-3 and 1-4 are antireflective films satisfying the conditions of the invention with the silicon oxide film having a thickness (T) of 95 (nm) < T ≤ 105 (nm), Example 1-5 is an antireflective film satisfying the conditions of the invention with the silicon oxide film having a thickness (T) of 145 (nm) < T ≤ 155 (nm), and Example 1-6 is an antireflective film satisfying the conditions of the invention with the silicon oxide film having a thickness (T) of 195 (nm) < T ≤ 205 (nm). On the other hand, Comparative Examples 1-1, 1-2A, and 1-2B are antireflective films not satisfying the conditions of the invention with the silicon oxide film having a thickness (T) of 45 (nm) < T ≤ 55 (nm), Comparative Example 1-3 is an antireflective film not satisfying the conditions of the invention with the silicon oxide film having a thickness (T) of 95 (nm) < T ≤ 105 (nm), Comparative Example 1-5 is an antireflective film not satisfying the conditions of the invention with the silicon oxide film having a thickness (T) of 145 (nm) < T ≤ 155 (nm), and Comparative Example 1-6 is an antireflective film not satisfying the conditions of the invention with the silicon oxide film having a thickness (T) of 195 (nm) < T ≤ 205 (nm).

Furthermore, in Table 22 showing the results of evaluation with 1.0 < NA ≤ 1.1, Examples 2-1 and 2-2 are antireflective films satisfying the conditions of the invention with the silicon oxide film having a thickness (T) of 45 (nm) < T ≤ 55 (nm), Example 2-3 is an antireflective film satisfying the conditions of the invention with the silicon oxide film having a thickness (T) of 55 (nm) < T ≤ 65 (nm), Example 2-4 is an antireflective film satisfying the conditions of the invention with the silicon oxide film having a thickness (T) of 95 (nm) < T ≤ 105 (nm), Example 2-5 is an antireflective film satisfying the conditions of the invention with the silicon oxide film having a thickness (T) of 145 (nm) < T ≤ 155 (nm), and Example 2-6 is an antireflective film satisfying the conditions of the invention with the silicon oxide film having a thickness (T) of 195 (nm) < T ≤ 205 (nm). On the other hand, Comparative Examples 2-1 and 2-2 are antireflective films not satisfying the conditions of the invention with the silicon oxide film having a thickness (T) of 45 (nm) < T ≤ 55 (nm), Comparative Example 2-3 is an antireflective film not satisfying the conditions of the invention with the silicon oxide film having a thickness (T) of 55 (nm) < T ≤ 65 (nm), Comparative Examples 2-4A and 2-4B are antireflective films not satisfying the conditions of the invention with the silicon oxide film having a thickness (T) of 95 (nm) < T ≤ 105 (nm), Comparative Example 2-5 is an antireflective film not satisfying the conditions of the invention with the silicon oxide film having a thickness (T) of 145 (nm) < T ≤ 155 (nm), and Comparative Example 2-6 is an antireflective film not satisfying the conditions of the invention with the silicon oxide film having a thickness (T) of 195 (nm) < T ≤ 205 (nm).

Furthermore, in Table 23 showing the results of evaluation with 1.1 < NA ≤ 1.2, Examples 3-1 and 3-2 are antireflective films satisfying the conditions of the invention with the silicon oxide film having a thickness (T) of 45 (nm) < T ≤ 55 (nm), Example 3-3 is an antireflective film satisfying the conditions of the invention with the silicon oxide film having a thickness (T) of 95 (nm) < T ≤ 105 (nm), Example 3-4 is an antireflective film satisfying the conditions of the invention with the silicon oxide film having a thickness (T) of 145 (nm) < T ≤ 155 (nm), and Example 3-5 is an antireflective film satisfying the conditions of the invention with the silicon oxide film having a thickness (T) of 185 (nm) < T ≤ 195 (nm). On the other hand, Comparative Examples 3-1 and 3-2 are antireflective films not satisfying the conditions of the invention with the silicon oxide film having a thickness (T) of 45 (nm) < T ≤ 55 (nm), Comparative Example 3-3 is an antireflective film not satisfying the conditions of the invention with the silicon oxide film having a thickness (T) of 95 (nm) < T ≤ 105 (nm), Comparative Example 3-4 is an antireflective film not satisfying the conditions of the invention with the silicon oxide film having a thickness (T) of 145 (nm) < T ≤ 155 (nm), and Comparative Examples 3-5A and 3-5B are antireflective films not satisfying the conditions of the invention with the silicon oxide film having a thickness (T) of 185 (nm) < T ≤ 195 (nm).

Furthermore, in Table 24 showing the results of evaluation with 1.2 < NA ≤ 1.3, Example 4-1 is an antireflective film satisfying the conditions of the invention with the silicon oxide film having a thickness (T) of 45 (nm) < T ≤ 55 (nm), Example 4-2 is an antireflective film satisfying the conditions of the invention with the silicon oxide film having a thickness (T) of 95 (nm) < T ≤ 105 (nm), and Example 4-3 is an antireflective film satisfying the conditions of the invention with the silicon oxide film having a thickness (T) of 195 (nm) < T ≤ 205 (nm). On the other hand, Comparative Example 4-1 is an antireflective film not satisfying the conditions of the invention with the silicon oxide film having a thickness (T) of 45 (nm) < T ≤ 55 (nm), Comparative Examples 4-2 and 4-3 are antireflective films not satisfying the conditions of the invention with the silicon oxide film having a thickness (T) of 95 (nm) < T ≤ 105 (nm), and Comparative Example 4-4 is an antireflective film not satisfying the conditions of the invention with the silicon oxide film having a thickness (T) of 195 (nm) < T ≤ 205 (nm).

Furthermore, in Table 25 showing the results of evaluation with 1.3 < NA ≤ 1.4, Example 5-1 is an antireflective film satisfying the conditions of the invention with the silicon oxide film having a thickness (T) of 45 (nm) < T ≤ 55 (nm), Example 5-2 is an antireflective film satisfying the conditions of the invention with the silicon oxide film having a thickness (T) of 95 (nm) < T ≤ 105 (nm), Example 5-3 is an antireflective film satisfying the conditions of the invention with the silicon oxide film having a thickness (T) of 145 (nm) < T ≤ 155 (nm), and Example 5-4 is an antireflective film satisfying the conditions of the invention with the silicon oxide film having a thickness (T) of 195 (nm) < T ≤ 205 (nm). On the other hand, Comparative Examples 5-1 and 5-2 are antireflective films not satisfying the conditions of the invention with the silicon oxide film having a thickness (T) of 45 (nm) < T ≤ 55 (nm), Comparative Example 5-3 is an antireflective film not satisfying the conditions of the invention with the silicon oxide film having a thickness (T) of 95 (nm) < T ≤ 105 (nm), Comparative Example 5-4 is an antireflective film not satisfying the conditions of the invention with the silicon oxide film having a thickness (T) of 145 (nm) < T ≤ 155 (nm), and Comparative Example 5-5 is an antireflective film not satisfying the conditions of the invention with the silicon oxide film having a thickness (T) of 195 (nm) < T ≤ 205 (nm).

In each of the examples and comparative examples of Tables 21, 22, 22, 23, 24, and 25, the material constituting the upper and lower layers of the antireflective film was SiCOH. The refractive index of each film was measured by an ellipsometer manufactured by SOPRA Corp.

Photoresist ARX2014J manufactured by JRS Co., Ltd. was spin-coated to a thickness of 100 nm as a resist layer on each of the two-layer antireflective films and baked at 105°C for 60 seconds, and then a top coat material TCX001 manufactured by the same corporation was spin-coated to a thickness of 30 nm as a top coat layer. Then, the whole film was baked at 105°C for 30 seconds.

Each of the resultant samples was exposed to light by a two-beam interference exposure device. In the two-beam interference exposure device, an ArF excimer laser was used as a light source, and a prism having a triangular or pentagonal sectional shape was disposed on the optical path of laser. Each sample was placed at a distance of 1 mm between the sample and the bottom surface of the prism. For example, when the prism with a triangular sectional shape was used, the apex of the prism was disposed at the center of the laser optical path, and the bottom surface of the prism was opposed to the apex. When laser beams are applied above the prism in the direction to the bottom surface of the prism, the laser beams incident on the two sides of the prism are refracted depending on the angle between the each side and the incident laser beam to change the optical path. The laser beams traveling in different directions are interfered with each other at the bottom surface of the prism to obtain a periodic optical intensity distribution on the sample. As a result, the resist layer is exposed to light. The reduced numerical aperture of the prism used in evaluation with $0.93 \leq NA \leq 1.0$ was 0.99, the reduced numerical aperture NA of the prism used in evaluation with $1.0 < NA \leq 1.1$ was 1.05, the reduced numerical aperture NA of the prism used in evaluation with $1.1 < NA \leq 1.2$ was 1.15, the reduced numerical aperture NA of the prism used in evaluation with $1.2 < NA \leq 1.3$ was 1.25, and the reduced numerical aperture NA of the prism used in evaluation with $1.3 < NA \leq 1.4$ was 1.38.

Furthermore, water was introduced in the distance of 1 mm between each sample and the bottom surface of the prism by means of a capillary phenomenon, and immersion exposure was performed using the water as an immersion liquid.

Each of the samples after exposure was baked at 120°C for 90 seconds and developed with a standard developer composed of 2.38% TMAH (tetramethylammonium hydroxide) to prepare a sample for resist pattern observation. The shape of the resist layer was observed by observing a section of the broken silicon semiconductor substrate through a scanning electron microscope. At the same time, the precision of the processed shape was measured by a scattered light distribution in the range of 40 $\mu$m $\times$ 40 $\mu$m using an optical scattered light meter (SCD-100 manufactured by KLA-Tencor Corporation).

The results of the observation are summarized in Tables 21, 22, 23, 24, and 25 in which a resist pattern having a good rectangular section is shown by symbol A, and a resist pattern having a poor rectangular section is shown by symbol B.

As seen from Tables 21, 22, 23, 24, and 25, the two-layer antireflective film according to any one of the embodiments of the invention is capable of forming a good resist sectional shape, as compared with a two-layer antireflective film not satisfying the conditions of the invention.

As described above, according to any one of the embodiments of the invention, the two-layer antireflective film having a complex refractive index and a thickness within the respective specified ranges is formed between a resist layer and a silicon oxide film formed on a surface of a silicon semiconductor substrate. In this case, the reflectance from the silicon semiconductor substrate may be decreased for the antireflective film corresponding to a predetermined range of the numerical aperture NA of an exposure system, thereby producing a good resist pattern.

Although, in any one of the above-mentioned embodiments, the two-layer antireflective film formed by the plasma-enhanced CVD method is described as an example, the present invention is not limited to this. For example, the two-layer antireflective film may be formed by another method such as a spin coating method or the like.

A semiconductor device was manufactured using the two-layer antireflective film according to any one of the embodiments of the invention. A phase shift mask was used as an exposure mask, and an ArF excimer laser (wavelength $\lambda$: 193nm) was used as a light source for exposure light. Furthermore, a zone illumination method was used. The surface of the resist layer was covered with a water layer, and it was confirmed whether or not a desired pattern could be formed in a resist layer without variation in the line width and shape. As a result, it was found that in any case, a desired pattern can be formed in the resist layer without variation in the line width and shape. In addition, in any case, the reflectance was 0.4% or less.

Specifically, an element separation region having a trench structure was formed. In other words, the two-layer antireflective film was formed on a silicon oxide film formed on a surface of a silicon semiconductor substrate, and a resist layer was formed on the antireflective film and subjected to exposure and development to form the patterned resist layer. Then, the silicon semiconductor substrate on which the silicon oxide film was formed on the surface was etched to a predetermined depth by a RIE method using the patterned resist layer as an etching mask, thereby forming a trench in the silicon semiconductor substrate. Then, an insulating film was formed over the entire surface of the silicon semiconductor substrate including the trench and then removed from the surface of the silicon semiconductor substrate to form an element separation region having a trench structure in which the insulating film was buried in the trench.

Although the invention is described on the basis of the preferred embodiments, the invention is not limited to these embodiments. In each of the embodiments, the constitution of the antireflective film and the thickness and complex refractive index of each layer constituting the antireflective film may be appropriately changed.

**Claims**

1. An antireflective film used in a process for manufacturing a semiconductor device by being provided between a resist layer and a silicon oxide layer formed on a surface of a silicon semiconductor substrate and having a thickness T (unit: nm) described below, for exposure of the resist layer in an exposure system having a wavelength of 190 nm to 195 nm and a numerical aperture NA of $0.93 \leq NA \leq 1.0$, the antireflective film having a two-layer structure comprising:

an upper layer having a complex refractive index $N_1$; and

a lower layer having a complex refractive index $N_2$; the complex refractive indexes $N_1$ and $N_2$ being represented by the equations $N_1 = n_1 - k_1 i$ and $N_2 = n_2 - k_2 i$, respectively;

wherein assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1$, $k_1$, $d_1$, $n_2$, $k_2$, and $d_2$ satisfy the relational expression

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1;$$

a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$; and in the tables below, in the line of "When $n_1 \geq n_{10}$, $n_{1m} =$", each value in the right columns is "$n_{1m} - n_{10}$"; in the line of "When $n_1 < n_{10}$, $n_{1m} =$", each value in the right columns is "$n_{10} - n_{1m}$"; in the line of "When $k_1 \geq k_{10}$, $k_{1m} =$", each value in the right columns is "$k_{1m} - k_{10}$"; in the line of "When $k_1 < k_{10}$, $k_{1m} =$", each value in the right columns is "$k_{10} - k_{1m}$"; in the line of "When $d_1 \geq d_{10}$, $d_{1m}$ (nm) $=$", each value (unit: nm) in the right columns is "$d_{1m} - d_{10}$"; in the line of "When $d_1 < d_{10}$, $d_{1m}$ (nm) $=$", each value (unit: nm) in the right columns is "$d_{10} - d_{1m}$"; in the line of "When $n_2 \geq n_{20}$, $n_{2m} =$", each value in the right columns is "$n_{2m} - n_{20}$"; in the line of "When $n_2 < n_{20}$, $n_{2m} =$", each value in the right columns is "$n_{20} - n_{2m}$"; in the line of "When $k_2 \geq k_{20}$, $k_{2m} =$", each value in the right columns is "$k_{2m} - k_{20}$"; in the line of "When $k_2 < k_{20}$, $k_{2m} =$", each value in the right columns is "$k_{20} - k_{2m}$"; in the line of "When $d_2 \geq d_{20}$, $d_{2m}$ (nm) $=$", each value (unit: nm) in the right columns is "$d_{2m} - d_{20}$"; and in the line of "When $d_2 < d_{20}$, $d_{2m}$ (nm) $=$", each value (unit: nm) in the right columns is "$d_{20} - d_{2m}$".

$0.93 \leq NA \leq 1.0$

$2 \leq T \leq 15$

| Case | 1-01 | 1-02 | 1-03 | 1-04 | 1-05 |
|---|---|---|---|---|---|
| $n_{10}$ | 2.0730 | 1.8547 | 1.8612 | 1.8596 | 1.7706 |
| $k_{10}$ | 0.1156 | 0.1676 | 0.1279 | 0.0953 | 0.0916 |
| $d_{10}$ (nm) | 23.93 | 29.84 | 20.21 | 19.98 | 91.02 |
| $n_{20}$ | 2.6749 | 2.1886 | 1.8193 | 1.8569 | 1.9614 |
| $k_{20}$ | 1.5696 | 0.6118 | 0.4029 | 0.3274 | 0.4555 |
| $d_{20}$ (nm) | 9.886 | 59.76 | 139.99 | 190.30 | 69.22 |

| | 1-01 | 1-02 | 1-03 | 1-04 | 1-05 |
|---|---|---|---|---|---|
| When $n_1 \geq n_{10}$, $n_{1m} =$ | 0.0910 | 0.0882 | 0.0964 | 0.0950 | 0.0763 |
| When $n_1 < n_{10}$, $n_{1m} =$ | 0.0872 | 0.0704 | 0.0762 | 0.0765 | 0.0467 |
| When $k_1 \geq k_{10}$, $k_{1m} =$ | 0.0819 | 0.0750 | 0.0869 | 0.0875 | 0.0772 |
| When $k_1 < k_{10}$, $k_{1m} =$ | 0.0960 | 0.0840 | 0.0907 | 0.0915 | 0.0546 |
| When $d_1 \geq d_{10}$, $d_{1m}$ (nm) $=$ | 4.108 | 7.919 | 8.786 | 9.587 | 17.28 |
| When $d_1 < d_{10}$, $d_{1m}$ (nm) $=$ | 3.280 | 5.652 | 6.074 | 6.698 | 8.396 |
| When $n_2 \geq n_{20}$, $n_{2m} =$ | 0.2209 | 0.1796 | 0.1515 | 0.1552 | 0.1445 |
| When $n_2 < n_{20}$, $n_{2m} =$ | 0.2126 | 0.1920 | 0.1780 | 0.1777 | 0.1565 |
| When $k_2 \geq k_{20}$, $k_{2m} =$ | 0.2324 | 0.2171 | 0.1921 | 0.1983 | 0.1809 |
| When $k_2 < k_{20}$, $k_{2m} =$ | 0.1960 | 0.1512 | 0.1220 | 0.1107 | 0.1235 |
| When $d_2 \geq d_{20}$, $d_{2m}$ (nm) $=$ | 1.715 | 13.99 | $\infty$ | $\infty$ | 9.907 |
| When $d_2 < d_{20}$, $d_{2m}$ (nm) $=$ | 1.606 | 9.166 | 63.12 | 76.29 | 9.171 |

$0.93 \leq NA \leq 1.0$

$2 \leq T \leq 15$

| Case | 1-06 | 1-07 | 1-08 | 1-09 | 1-10 |
|---|---|---|---|---|---|
| $n_{10}$ | 1.7660 | 1.7540 | 1.7206 | 1.7312 | 1.7318 |
| $k_{10}$ | 0.0861 | 0.0810 | 0.0766 | 0.0743 | 0.0746 |
| $d_{10}$ (nm) | 89.67 | 89.26 | 163.7 | 158.4 | 156.0 |
| $n_{20}$ | 1.8683 | 1.7976 | 2.0073 | 1.9328 | 1.8226 |
| $k_{20}$ | 0.3142 | 0.2441 | 0.9100 | 0.4029 | 0.2736 |
| $d_{20}$ (nm) | 129.4 | 193.6 | 15.11 | 69.39 | 132.3 |

| | 1-06 | 1-07 | 1-08 | 1-09 | 1-10 |
|---|---|---|---|---|---|
| When $n_1 \geq n_{10}$, $n_{1m} =$ | 0.0725061 | 0.0712122 | 0.0876196 | 0.0743347 | 0.0699963 |
| When $n_1 < n_{10}$, $n_{1m} =$ | 0.0454077 | 0.0429834 | 0.0318030 | 0.0375427 | 0.0339148 |
| When $k_1 \geq k_{10}$, $k_{1m} =$ | 0.0772620 | 0.0743579 | 0.0711646 | 0.0773767 | 0.0733899 |
| When $k_1 < k_{10}$, $k_{1m} =$ | 0.0551843 | 0.0575049 | 0.0410327 | 0.0412244 | 0.0408972 |
| When $d_1 \geq d_{10}$, $d_{1m}$ (nm) $=$ | 18.782 | 23.348 | 40.469 | 35.317 | 38.161 |
| When $d_1 < d_{10}$, $d_{1m}$ (nm) $=$ | 8.456 | 8.860 | 9.958 | 10.432 | 9.052 |
| When $n_2 \geq n_{20}$, $n_{2m} =$ | 0.1498401 | 0.1584961 | 0.1682336 | 0.1348816 | 0.1376196 |
| When $n_2 < n_{20}$, $n_{2m} =$ | 0.1510144 | 0.1511060 | 0.2304688 | 0.1582874 | 0.1516028 |
| When $k_2 \geq k_{20}$, $k_{2m} =$ | 0.2049341 | 0.2252979 | 0.1710974 | 0.1537598 | 0.1868274 |
| When $k_2 < k_{20}$, $k_{2m} =$ | 0.0962390 | 0.0820935 | 0.1771240 | 0.1169067 | 0.0881860 |
| When $d_2 \geq d_{20}$, $d_{2m}$ (nm) $=$ | $\infty$ | $\infty$ | 3.180 | 8.501 | $\infty$ |
| When $d_2 < d_{20}$, $d_{2m}$ (nm) $=$ | 17.963 | 68.303 | 3.157 | 8.798 | 14.016 |

$0. 93 \leq NA \leq 1. 0$

$2 \leq T \leq 15$

| Case | 1-11 | 1-12 | 1-13 | 1-14 | 1-15 |
|---|---|---|---|---|---|
| $n_{10}$ | 1.7235310 | 1.7093992 | 1.7192548 | 1.7183512 | 1.7097773 |
| $k_{10}$ | 0.0712769 | 0.0595462 | 0.0668813 | 0.0690717 | 0.0638868 |
| $d_{10}$ (nm) | 155.759 | 237.275 | 223.222 | 220.755 | 221.916 |
| $n_{20}$ | 1.7500411 | 5.0249130 | 1.9244861 | 1.7884626 | 1.7175992 |
| $k_{20}$ | 0.2147794 | 2.4786958 | 0.3767470 | 0.2530536 | 0.2031308 |
| $d_{20}$ (nm) | 197.972 | 1.776 | 68.925 | 134.430 | 199.649 |

| | | 1-11 | 1-12 | 1-13 | 1-14 | 1-15 |
|---|---|---|---|---|---|---|
| When $n_1 \geq n_{10}$, | $n_{1m} =$ | 0.0687000 | 0.1022864 | 0.0758325 | 0.0727087 | 0.0697119 |
| When $n_1 < n_{10}$, | $n_{1m} =$ | 0.0322229 | 0.0397070 | 0.0389722 | 0.0346118 | 0.0564209 |
| When $k_1 \geq k_{10}$, | $k_{1m} =$ | 0.0698975 | 0.0795508 | 0.0762329 | 0.0700171 | 0.0722595 |
| When $k_1 < k_{10}$, | $k_{1m} =$ | 0.0415723 | 0.0393457 | 0.0338635 | 0.0308765 | 0.0321350 |
| When $d_1 \geq d_{10}$, | $d_{1m}$ (nm) $=$ | $\infty$ | $\infty$ | $\infty$ | $\infty$ | $\infty$ |
| When $d_1 < d_{10}$, | $d_{1m}$ (nm) $=$ | 9.616 | 78.998 | 12.815 | 10.464 | 72.402 |
| When $n_2 \geq n_{20}$, | $n_{2m} =$ | 0.1855957 | 0.5207629 | 0.1343335 | 0.1358569 | 0.2333704 |
| When $n_2 < n_{20}$, | $n_{2m} =$ | 0.1501331 | 0.6523560 | 0.1703552 | 0.1672083 | 0.1693542 |
| When $k_2 \geq k_{20}$, | $k_{2m} =$ | 0.2047339 | 0.5424048 | 0.1363831 | 0.1710950 | 0.1947412 |
| When $k_2 < k_{20}$, | $k_{2m} =$ | 0.0758948 | 0.5487781 | 0.1192529 | 0.0892212 | 0.0778406 |
| When $d_2 \geq d_{20}$, | $d_{2m}$ (nm) $=$ | $\infty$ | 0.325 | 8.509 | $\infty$ | $\infty$ |
| When $d_2 < d_{20}$, | $d_{2m}$ (nm) $=$ | 29.087 | 0.351 | 7.511 | 11.451 | 31.610 |

$0. 93 \leq NA \leq 1. 0$

$15 < T \leq 25$

| Case | 2-01 | 2-02 | 2-03 | 2-04 | 2-05 |
|---|---|---|---|---|---|
| $n_{10}$ | 1.8890717 | 1.8040788 | 1.8569330 | 1.8246631 | 1.8713633 |
| $k_{10}$ | 0.2231211 | 0.2224671 | 0.1887211 | 0.1852786 | 0.1359350 |
| $d_{10}$ (nm) | 31.297 | 38.783 | 31.358 | 29.866 | 20.765 |
| $n_{20}$ | 2.2536461 | 3.4285504 | 2.3482559 | 2.0267942 | 1.8449284 |
| $k_{20}$ | 1.9138327 | 0.7115044 | 0.7139401 | 0.6589875 | 0.4410677 |
| $d_{20}$ (nm) | 8.426 | 30.090 | 49.395 | 61.419 | 129.533 |

| | | 2-01 | 2-02 | 2-03 | 2-04 | 2-05 |
|---|---|---|---|---|---|---|
| When $n_1 \geq n_{10}$, | $n_{1m} =$ | 0.0874390 | 0.0895227 | 0.0867871 | 0.0862964 | 0.0944556 |
| When $n_1 < n_{10}$, | $n_{1m} =$ | 0.0734485 | 0.0679480 | 0.0711365 | 0.0665735 | 0.0748743 |
| When $k_1 \geq k_{10}$, | $k_{1m} =$ | 0.0762256 | 0.0781921 | 0.0754639 | 0.0735010 | 0.0845789 |
| When $k_1 < k_{10}$, | $k_{1m} =$ | 0.0847852 | 0.0785486 | 0.0835657 | 0.0812061 | 0.0905493 |
| When $d_1 \geq d_{10}$, | $d_{1m}$ (nm) $=$ | 5.734 | 7.070 | 7.156 | 8.156 | 8.180 |
| When $d_1 < d_{10}$, | $d_{1m}$ (nm) $=$ | 4.509 | 5.331 | 5.325 | 5.713 | 5.655 |
| When $n_2 \geq n_{20}$, | $n_{2m} =$ | 0.3151672 | 0.1904419 | 0.1878015 | 0.1893945 | 0.1561475 |
| When $n_2 < n_{20}$, | $n_{2m} =$ | 0.3095313 | 0.2189575 | 0.2044202 | 0.1933459 | 0.1801416 |
| When $k_2 \geq k_{20}$, | $k_{2m} =$ | 0.3390149 | 0.2463513 | 0.2322900 | 0.2311047 | 0.2037732 |
| When $k_2 < k_{20}$, | $k_{2m} =$ | 0.3041187 | 0.1774133 | 0.1676416 | 0.1568945 | 0.1265381 |
| When $d_2 \geq d_{20}$, | $d_{2m}$ (nm) $=$ | 1.987 | 2.182 | 8.431 | $\infty$ | $\infty$ |
| When $d_2 < d_{20}$, | $d_{2m}$ (nm) $=$ | 1.727 | 2.068 | 6.571 | 10.427 | 56.577 |

$0.93 \leq NA \leq 1.0$

$15 < T \leq 25$

| Case | 2-06 | 2-07 | 2-08 | 2-09 | 2-10 |
|---|---|---|---|---|---|
| $n_{10}$ | 1.8537764 | 1.8773918 | 1.7913209 | 1.7961812 | 1.7719309 |
| $k_{10}$ | 0.1095380 | 0.0811836 | 0.1069315 | 0.0967122 | 0.0907051 |
| $d_{10}$ (nm) | 19.190 | 15.072 | 93.104 | 91.592 | 89.644 |
| $n_{20}$ | 1.8083352 | 1.7885130 | 2.1120296 | 2.2985234 | 1.8982310 |
| $k_{20}$ | 0.3385915 | 0.2812935 | 1.5705728 | 0.5621108 | 0.3437292 |
| $d_{20}$ (nm) | 190.096 | 250.952 | 8.709 | 49.876 | 119.550 |

| | | 2-06 | 2-07 | 2-08 | 2-09 | 2-10 |
|---|---|---|---|---|---|---|
| When $n_1 \geq n_{10}$, | $n_{1m} =$ | 0.0970691 | 0.1116003 | 0.0785193 | 0.0746387 | 0.0710254 |
| When $n_1 < n_{10}$, | $n_{1m} =$ | 0.0765894 | 0.0899463 | 0.0387744 | 0.0446472 | 0.0434424 |
| When $k_1 \geq k_{10}$, | $k_{1m} =$ | 0.0900769 | 0.1037891 | 0.0704041 | 0.0743225 | 0.0753088 |
| When $k_1 < k_{10}$, | $k_{1m} =$ | 0.0922754 | 0.0811836 | 0.0518481 | 0.0540869 | 0.0544885 |
| When $d_1 \geq d_{10}$, | $d_{1m}$ (nm) $=$ | 9.442 | 8.843 | 12.610 | 13.182 | 16.111 |
| When $d_1 < d_{10}$, | $d_{1m}$ (nm) $=$ | 6.479 | 6.242 | 5.884 | 6.895 | 7.619 |
| When $n_2 \geq n_{20}$, | $n_{2m} =$ | 0.1545007 | 0.1511414 | 0.2353479 | 0.1499768 | 0.1563330 |
| When $n_2 < n_{20}$, | $n_{2m} =$ | 0.1780847 | 0.1773486 | 0.2901843 | 0.1659082 | 0.1527185 |
| When $k_2 \geq k_{20}$, | $k_{2m} =$ | 0.1867920 | 0.1671802 | 0.2909924 | 0.1840894 | 0.2027185 |
| When $k_2 < k_{20}$, | $k_{2m} =$ | 0.1126624 | 0.1034778 | 0.2557275 | 0.1387183 | 0.1013330 |
| When $d_2 \geq d_{20}$, | $d_{2m}$ (nm) $=$ | ∞ | ∞ | 1.972 | 5.095 | ∞ |
| When $d_2 < d_{20}$, | $d_{2m}$ (nm) $=$ | 76.056 | 121.855 | 1.716 | 4.880 | 15.622 |

$0.93 \leq NA \leq 1.0$

$15 < T \leq 25$

| Case | 2-11 | 2-12 | 2-13 | 2-14 | 2-15 |
|---|---|---|---|---|---|
| $n_{10}$ | 1.7573553 | 1.7321027 | 1.7251448 | 1.7347815 | 1.7337052 |
| $k_{10}$ | 0.0844391 | 0.0771807 | 0.0782108 | 0.0789970 | 0.0782079 |
| $d_{10}$ (nm) | 89.273 | 89.432 | 166.474 | 158.854 | 156.164 |
| $n_{20}$ | 1.8090385 | 1.7181480 | 2.6560327 | 2.0166404 | 1.8413069 |
| $k_{20}$ | 0.2599016 | 0.2108133 | 2.0752579 | 0.4697089 | 0.2975845 |
| $d_{20}$ (nm) | 184.203 | 254.601 | 4.495 | 58.957 | 122.955 |

| | | 2-11 | 2-12 | 2-13 | 2-14 | 2-15 |
|---|---|---|---|---|---|---|
| When $n_1 \geq n_{10}$, | $n_{1m} =$ | 0.0699780 | 0.0690137 | 0.0832959 | 0.0721558 | 0.0683105 |
| When $n_1 < n_{10}$, | $n_{1m} =$ | 0.0410315 | 0.0429553 | 0.0305981 | 0.0341260 | 0.0308228 |
| When $k_1 \geq k_{10}$, | $k_{1m} =$ | 0.0723608 | 0.0738831 | 0.0729456 | 0.0742798 | 0.0703467 |
| When $k_1 < k_{10}$, | $k_{1m} =$ | 0.0569189 | 0.0588879 | 0.0382764 | 0.0397253 | 0.0396069 |
| When $d_1 \geq d_{10}$, | $d_{1m}$ (nm) $=$ | 21.648 | 30.736 | 32.939 | 31.041 | 34.229 |
| When $d_1 < d_{10}$, | $d_{1m}$ (nm) $=$ | 8.068 | 11.084 | 9.096 | 8.972 | 7.917 |
| When $n_2 \geq n_{20}$, | $n_{2m} =$ | 0.1631897 | 0.1805151 | 0.3419739 | 0.1438672 | 0.1358447 |
| When $n_2 < n_{20}$, | $n_{2m} =$ | 0.1518018 | 0.1480249 | 0.4228455 | 0.1667273 | 0.1539514 |
| When $k_2 \geq k_{20}$, | $k_{2m} =$ | 0.2316443 | 0.1895435 | 0.3584204 | 0.1604712 | 0.1864905 |
| When $k_2 < k_{20}$, | $k_{2m} =$ | 0.0850049 | 0.0772852 | 0.3668774 | 0.1323413 | 0.0930493 |
| When $d_2 \geq d_{20}$, | $d_{2m}$ (nm) $=$ | ∞ | ∞ | 0.935 | 6.683 | 16.067 |
| When $d_2 < d_{20}$, | $d_{2m}$ (nm) $=$ | 28.321 | 80.547 | 0.940 | 6.845 | 12.170 |

0. 9 3 ≦ N A ≦ 1. 0
1 5 < T ≦ 2 5

| Case | 2-16 | 2-17 | 2-18 | 2-19 | 2-20 |
|---|---|---|---|---|---|
| $n_{10}$ | 1.7245076 | 1.7100620 | 1.7130788 | 1.7208745 | 1.7192161 |
| $k_{10}$ | 0.0739010 | 0.0639207 | 0.0658962 | 0.0708686 | 0.0720786 |
| $d_{10}$ (nm) | 155.712 | 155.553 | 233.281 | 223.560 | 220.745 |
| $n_{20}$ | 1.7533528 | 1.6863114 | 3.3653368 | 1.9877972 | 1.7983405 |
| $k_{20}$ | 0.2275719 | 0.1891021 | 2.7431658 | 0.4366658 | 0.2740582 |
| $d_{20}$ (nm) | 189.273 | 256.528 | 2.501 | 59.393 | 125.643 |

| | | 2-16 | 2-17 | 2-18 | 2-19 | 2-20 |
|---|---|---|---|---|---|---|
| When $n_1 \geq n_{10}$, | $n_{1m}=$ | 0.0671997 | 0.0648059 | 0.0864783 | 0.0735278 | 0.0707983 |
| When $n_1 < n_{10}$, | $n_{1m}=$ | 0.0293323 | 0.0484583 | 0.0327734 | 0.0316724 | 0.0279663 |
| When $k_1 \geq k_{10}$, | $k_{1m}=$ | 0.0671045 | 0.0758130 | 0.0759729 | 0.0721252 | 0.0662109 |
| When $k_1 < k_{10}$, | $k_{1m}=$ | 0.0403235 | 0.0462146 | 0.0340283 | 0.0320007 | 0.0290771 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 8.393 | 77.190 | 14.014 | 10.040 | 8.344 |
| When $n_2 \geq n_{20}$, | $n_{2m}=$ | 0.1922314 | 0.2150586 | 0.5377722 | 0.1455798 | 0.1365283 |
| When $n_2 < n_{20}$, | $n_{2m}=$ | 0.1495129 | 0.1388159 | 0.5848816 | 0.1787549 | 0.1689587 |
| When $k_2 \geq k_{20}$, | $k_{2m}=$ | 0.2035803 | 0.1600281 | 0.4555420 | 0.1361926 | 0.1635962 |
| When $k_2 < k_{20}$, | $k_{2m}=$ | 0.0785095 | 0.0698242 | 0.5466174 | 0.1332434 | 0.0942200 |
| When $d_2 \geq d_{20}$, | $d_{2m}$ (nm) $=$ | ∞ | ∞ | 0.540 | 6.979 | ∞ |
| When $d_2 < d_{20}$, | $d_{2m}$ (nm) $=$ | 26.645 | 77.267 | 0.568 | 6.255 | 9.480 |

0. 9 3 ≦ N A ≦ 1. 0
1 5 < T ≦ 2 5

| Case | 2-21 | 2-22 |
|---|---|---|
| $n_{10}$ | 1.7100814 | 1.7028062 |
| $k_{10}$ | 0.0661341 | 0.0572529 |
| $d_{10}$ (nm) | 221.783 | 219.613 |
| $n_{20}$ | 1.7179584 | 1.6741304 |
| $k_{20}$ | 0.2146738 | 0.1784680 |
| $d_{20}$ (nm) | 191.114 | 256.090 |

| | | 2-21 | 2-22 |
|---|---|---|---|
| When $n_1 \geq n_{10}$, | $n_{1m}=$ | 0.0687488 | 0.0693079 |
| When $n_1 < n_{10}$, | $n_{1m}=$ | 0.0502954 | 0.0688196 |
| When $k_1 \geq k_{10}$, | $k_{1m}=$ | 0.0691418 | 0.0820508 |
| When $k_1 < k_{10}$, | $k_{1m}=$ | 0.0305945 | 0.0409924 |
| When $d_1 \geq d_{10}$, | $d_{1m}$ (nm) $=$ | ∞ | ∞ |
| When $d_1 < d_{10}$, | $d_{1m}$ (nm) $=$ | 70.999 | 88.114 |
| When $n_2 \geq n_{20}$, | $n_{2m}=$ | 0.2426611 | 0.2482605 |
| When $n_2 < n_{20}$, | $n_{2m}=$ | 0.1649829 | 0.1563098 |
| When $k_2 \geq k_{20}$, | $k_{2m}=$ | 0.1903906 | 0.1488330 |
| When $k_2 < k_{20}$, | $k_{2m}=$ | 0.0805981 | 0.0682654 |
| When $d_2 \geq d_{20}$, | $d_{2m}$ (nm) $=$ | ∞ | ∞ |
| When $d_2 < d_{20}$, | $d_{2m}$ (nm) $=$ | 28.403 | 77.092 |

$0.93 \leq NA \leq 1.0$

$25 < T \leq 35$

| Case | 3-01 | 3-02 | 3-03 | 3-04 | 3-05 |
|---|---|---|---|---|---|
| $n_{10}$ | 1.7462297 | 1.7852920 | 1.8064124 | 1.8761841 | 1.8732427 |
| $k_{10}$ | 0.2650661 | 0.2379686 | 0.2063789 | 0.1465026 | 0.1107685 |
| $d_{10}$ (nm) | 38.584 | 38.995 | 31.400 | 22.050 | 18.888 |
| $n_{20}$ | 1.8811342 | 3.2453891 | 2.0415396 | 1.8871554 | 1.8328297 |
| $k_{20}$ | 2.5474890 | 0.8215227 | 0.7493942 | 0.4863835 | 0.3644393 |
| $d_{20}$ (nm) | 6.719 | 29.990 | 55.163 | 118.487 | 179.928 |

| | | 3-01 | 3-02 | 3-03 | 3-04 | 3-05 |
|---|---|---|---|---|---|---|
| When $n_1 \geq n_{10}$, | $n_{1m}=$ | 0.0769434 | 0.0851318 | 0.0833228 | 0.0906799 | 0.0968079 |
| When $n_1 < n_{10}$, | $n_{1m}=$ | 0.0572766 | 0.0631555 | 0.0636389 | 0.0722144 | 0.0767554 |
| When $k_1 \geq k_{10}$, | $k_{1m}=$ | 0.0723669 | 0.0784412 | 0.0735730 | 0.0819336 | 0.0896667 |
| When $k_1 < k_{10}$, | $k_{1m}=$ | 0.0683887 | 0.0725391 | 0.0776208 | 0.0882788 | 0.0940442 |
| When $d_1 \geq d_{10}$, | $d_{1m}$ (nm) $=$ | 6.007 | 6.642 | 7.652 | 7.684 | 8.502 |
| When $d_1 < d_{10}$, | $d_{1m}$ (nm) $=$ | 4.614 | 4.982 | 5.411 | 5.323 | 5.843 |
| When $n_2 \geq n_{20}$, | $n_{2m}=$ | 0.4302271 | 0.2240894 | 0.2116187 | 0.1663196 | 0.1573621 |
| When $n_2 < n_{20}$, | $n_{2m}=$ | 0.3679468 | 0.2518726 | 0.2012903 | 0.1828064 | 0.1779138 |
| When $k_2 \geq k_{20}$, | $k_{2m}=$ | 0.4458606 | 0.2938757 | 0.2488452 | 0.2239661 | 0.1924353 |
| When $k_2 < k_{20}$, | $k_{2m}=$ | 0.4071558 | 0.2090601 | 0.1700916 | 0.1317957 | 0.1155774 |
| When $d_2 \geq d_{20}$, | $d_{2m}$ (nm) $=$ | 1.849 | 2.793 | ∞ | ∞ | ∞ |
| When $d_2 < d_{20}$, | $d_{2m}$ (nm) $=$ | 1.467 | 2.486 | 8.980 | 27.259 | 71.144 |

$0.93 \leq NA \leq 1.0$

$25 < T \leq 35$

| Case | 3-06 | 3-07 | 3-08 | 3-09 | 3-10 |
|---|---|---|---|---|---|
| $n_{10}$ | 1.8809997 | 1.8353407 | 1.8107063 | 1.7800259 | 1.7589519 |
| $k_{10}$ | 0.0844859 | 0.1336488 | 0.1074834 | 0.0966903 | 0.0885227 |
| $d_{10}$ (nm) | 15.636 | 86.851 | 91.200 | 89.638 | 89.033 |
| $n_{20}$ | 1.8003278 | 1.6000470 | 2.5616901 | 1.9474319 | 1.8081258 |
| $k_{20}$ | 0.2965881 | 1.7695220 | 0.6655713 | 0.3779800 | 0.2753975 |
| $d_{20}$ (nm) | 241.202 | 10.059 | 40.111 | 109.424 | 177.335 |

| | | 3-06 | 3-07 | 3-08 | 3-09 | 3-10 |
|---|---|---|---|---|---|---|
| When $n_1 \geq n_{10}$, | $n_{1m}=$ | 0.1079370 | 0.0607556 | 0.0690979 | 0.0686230 | 0.0682776 |
| When $n_1 < n_{10}$, | $n_{1m}=$ | 0.0864404 | 0.0389355 | 0.0418872 | 0.0404956 | 0.0386047 |
| When $k_1 \geq k_{10}$, | $k_{1m}=$ | 0.0999365 | 0.0690637 | 0.0736157 | 0.0727942 | 0.0702844 |
| When $k_1 < k_{10}$, | $k_{1m}=$ | 0.0844859 | 0.0492517 | 0.0507898 | 0.0531238 | 0.0559766 |
| When $d_1 \geq d_{10}$, | $d_{1m}$ (nm) $=$ | 8.565 | 8.192 | 11.124 | 13.835 | 18.997 |
| When $d_1 < d_{10}$, | $d_{1m}$ (nm) $=$ | 5.996 | 4.465 | 5.820 | 6.603 | 7.278 |
| When $n_2 \geq n_{20}$, | $n_{2m}=$ | 0.1541260 | 0.2930249 | 0.1702905 | 0.1595251 | 0.1700037 |
| When $n_2 < n_{20}$, | $n_{2m}=$ | 0.1764270 | 0.2694421 | 0.1785315 | 0.1557800 | 0.1515491 |
| When $k_2 \geq k_{20}$, | $k_{2m}=$ | 0.1720203 | 0.3061462 | 0.2081555 | 0.2039343 | 0.2313416 |
| When $k_2 < k_{20}$, | $k_{2m}=$ | 0.1058716 | 0.3107410 | 0.1597290 | 0.1070007 | 0.0874585 |
| When $d_2 \geq d_{20}$, | $d_{2m}$ (nm) $=$ | ∞ | 2.242 | 3.729 | 17.032 | ∞ |
| When $d_2 < d_{20}$, | $d_{2m}$ (nm) $=$ | 115.662 | 2.067 | 3.416 | 13.482 | 26.550 |

$0. 93 \leq NA \leq 1. 0$
$25 < T \leq 35$

| Case | 3-11 | 3-12 | 3-13 | 3-14 | 3-15 |
|---|---|---|---|---|---|
| $n_{10}$ | 1.7385561 | 1.7392392 | 1.7355979 | 1.7252169 | 1.7185486 |
| $k_{10}$ | 0.0961686 | 0.0859424 | 0.0828161 | 0.0770491 | 0.0788457 |
| $d_{10}$ (nm) | 161.111 | 158.474 | 155.982 | 155.656 | 229.847 |
| $n_{20}$ | 1.8448216 | 2.1008270 | 1.8545146 | 1.7550901 | 3.2610273 |
| $k_{20}$ | 2.2148249 | 0.5469970 | 0.3232472 | 0.2413910 | 4.4183916 |
| $d_{20}$ (nm) | 5.861 | 50.862 | 115.179 | 181.353 | 1.558 |

| When $n_1 \geq n_{10}$, $n_{1m}=$ | 0.0629041 | 0.0674426 | 0.0657153 | 0.0649670 | 0.0703149 |
|---|---|---|---|---|---|
| When $n_1 < n_{10}$, $n_{1m}=$ | 0.0253882 | 0.0295728 | 0.0268335 | 0.0256165 | 0.0220850 |
| When $k_1 \geq k_{10}$, $k_{1m}=$ | 0.0668323 | 0.0703247 | 0.0663293 | 0.0632434 | 0.0659778 |
| When $k_1 < k_{10}$, $k_{1m}=$ | 0.0332373 | 0.0369910 | 0.0375085 | 0.0384131 | 0.0277441 |
| When $d_1 \geq d_{10}$, $d_{1m}$ (nm) $=$ | 20.469 | 26.314 | 30.753 | 47.147 | 42.683 |
| When $d_1 < d_{10}$, $d_{1m}$ (nm) $=$ | 5.969 | 7.197 | 6.584 | 7.042 | 7.213 |
| When $n_2 \geq n_{20}$, $n_{2m}=$ | 0.3836914 | 0.1608313 | 0.1425024 | 0.2021899 | 0.7624707 |
| When $n_2 < n_{20}$, $n_{2m}=$ | 0.3601526 | 0.1749219 | 0.1554919 | 0.1482849 | 0.7156897 |
| When $k_2 \geq k_{20}$, $k_{2m}=$ | 0.3156946 | 0.1638635 | 0.1816882 | 0.2013940 | 0.5159863 |
| When $k_2 < k_{20}$, $k_{2m}=$ | 0.4014783 | 0.1464551 | 0.0974072 | 0.0811682 | 0.8313574 |
| When $d_2 \geq d_{20}$, $d_{2m}$ (nm) $=$ | 1.291 | 5.616 | 13.990 | $\infty$ | 0.296 |
| When $d_2 < d_{20}$, $d_{2m}$ (nm) $=$ | 1.319 | 5.535 | 10.236 | 24.868 | 0.387 |

$0. 93 \leq NA \leq 1. 0$
$25 < T \leq 35$

| Case | 3-16 | 3-17 | 3-18 |
|---|---|---|---|
| $n_{10}$ | 1.7228369 | 1.7199449 | 1.7101979 |
| $k_{10}$ | 0.0769315 | 0.0760859 | 0.0687675 |
| $d_{10}$ (nm) | 222.858 | 220.491 | 221.639 |
| $n_{20}$ | 2.0210736 | 1.8037789 | 1.7165312 |
| $k_{20}$ | 0.5011654 | 0.2965908 | 0.2274377 |
| $d_{20}$ (nm) | 52.892 | 118.134 | 183.246 |

| When $n_1 \geq n_{10}$, $n_{1m}=$ | 0.0694470 | 0.0680798 | 0.0669543 |
|---|---|---|---|
| When $n_1 < n_{10}$, $n_{1m}=$ | 0.0241309 | 0.0211279 | 0.0442908 |
| When $k_1 \geq k_{10}$, $k_{1m}=$ | 0.0659106 | 0.0606384 | 0.0650562 |
| When $k_1 < k_{10}$, $k_{1m}=$ | 0.0287354 | 0.0259912 | 0.0284460 |
| When $d_1 \geq d_{10}$, $d_{1m}$ (nm) $=$ | $\infty$ | $\infty$ | $\infty$ |
| When $d_1 < d_{10}$, $d_{1m}$ (nm) $=$ | 7.193 | 6.146 | 69.475 |
| When $n_2 \geq n_{20}$, $n_{2m}=$ | 0.1641553 | 0.1445947 | 0.2568982 |
| When $n_2 < n_{20}$, $n_{2m}=$ | 0.1866541 | 0.1696143 | 0.1583826 |
| When $k_2 \geq k_{20}$, $k_{2m}=$ | 0.1286877 | 0.1503394 | 0.1843665 |
| When $k_2 < k_{20}$, $k_{2m}=$ | 0.1457922 | 0.0990405 | 0.0813123 |
| When $d_2 \geq d_{20}$, $d_{2m}$ (nm) $=$ | 6.290 | 17.763 | $\infty$ |
| When $d_2 < d_{20}$, $d_{2m}$ (nm) $=$ | 5.002 | 7.323 | 26.072 |

$0. 93 \leq NA \leq 1. 0$

$35 < T \leq 45$

| Case | 4-01 | 4-02 | 4-03 | 4-04 | 4-05 |
|---|---|---|---|---|---|
| $n_{10}$ | 1.8047095 | 1.8098021 | 1.8915289 | 1.8869810 | 1.8679863 |
| $k_{10}$ | 0.2694194 | 0.2379756 | 0.1677232 | 0.1583242 | 0.1633407 |
| $d_{10}$ (nm) | 36.421 | 31.711 | 26.420 | 22.598 | 22.571 |
| $n_{20}$ | 2.9911125 | 2.1295160 | 2.1348336 | 1.9270572 | 1.8682373 |
| $k_{20}$ | 1.0218786 | 0.9059492 | 0.5678980 | 0.5352831 | 0.5190358 |
| $d_{20}$ (nm) | 30.087 | 46.199 | 93.459 | 108.068 | 112.596 |

| | | 4-01 | 4-02 | 4-03 | 4-04 | 4-05 |
|---|---|---|---|---|---|---|
| When $n_1 \geq n_{10}$, | $n_{1m} =$ | 0.0783740 | 0.0796436 | 0.0844666 | 0.0882751 | 0.0886218 |
| When $n_1 < n_{10}$, | $n_{1m} =$ | 0.0596716 | 0.0601453 | 0.0678638 | 0.0698572 | 0.0685303 |
| When $k_1 \geq k_{10}$, | $k_{1m} =$ | 0.0745129 | 0.0734180 | 0.0774060 | 0.0809473 | 0.0815564 |
| When $k_1 < k_{10}$, | $k_{1m} =$ | 0.0737073 | 0.0756104 | 0.0846094 | 0.0871533 | 0.0855286 |
| When $d_1 \geq d_{10}$, | $d_{1m}$ (nm) $=$ | 5.498 | 6.440 | 6.660 | 7.044 | 7.454 |
| When $d_1 < d_{10}$, | $d_{1m}$ (nm) $=$ | 4.112 | 4.536 | 4.657 | 4.822 | 5.013 |
| When $n_2 \geq n_{20}$, | $n_{2m} =$ | 0.2827258 | 0.2488782 | 0.2107483 | 0.1777197 | 0.1733423 |
| When $n_2 < n_{20}$, | $n_{2m} =$ | 0.2979187 | 0.2268945 | 0.2048547 | 0.1904834 | 0.1888538 |
| When $k_2 \geq k_{20}$, | $k_{2m} =$ | 0.3686462 | 0.2854443 | 0.2568164 | 0.2416882 | 0.2270508 |
| When $k_2 < k_{20}$, | $k_{2m} =$ | 0.2566187 | 0.1919458 | 0.1493335 | 0.1371973 | 0.1348743 |
| When $d_2 \geq d_{20}$, | $d_{2m}$ (nm) $=$ | 4.536 | ∞ | ∞ | ∞ | ∞ |
| When $d_2 < d_{20}$, | $d_{2m}$ (nm) $=$ | 3.441 | 7.549 | 17.368 | 24.447 | 26.666 |

$0. 93 \leq NA \leq 1. 0$

$35 < T \leq 45$

| Case | 4-06 | 4-07 | 4-08 | 4-09 | 4-10 |
|---|---|---|---|---|---|
| $n_{10}$ | 1.8894047 | 1.9013640 | 1.7974174 | 1.7778270 | 1.7589001 |
| $k_{10}$ | 0.1134244 | 0.0821095 | 0.1211843 | 0.1038067 | 0.0931193 |
| $d_{10}$ (nm) | 18.623 | 14.880 | 88.331 | 88.747 | 88.775 |
| $n_{20}$ | 1.8513003 | 1.8106171 | 2.0615819 | 1.9023003 | 1.8006679 |
| $k_{20}$ | 0.3877744 | 0.3102506 | 0.7049601 | 0.4013081 | 0.2880356 |
| $d_{20}$ (nm) | 170.528 | 232.433 | 48.141 | 106.512 | 170.885 |

| | | 4-06 | 4-07 | 4-08 | 4-09 | 4-10 |
|---|---|---|---|---|---|---|
| When $n_1 \geq n_{10}$, | $n_{1m} =$ | 0.0963379 | 0.1102368 | 0.0634644 | 0.0662390 | 0.0666211 |
| When $n_1 < n_{10}$, | $n_{1m} =$ | 0.0760864 | 0.0881848 | 0.0372961 | 0.0368457 | 0.0352515 |
| When $k_1 \geq k_{10}$, | $k_{1m} =$ | 0.0891541 | 0.1015222 | 0.0717737 | 0.0709473 | 0.0673779 |
| When $k_1 < k_{10}$, | $k_{1m} =$ | 0.0954272 | 0.0821095 | 0.0478455 | 0.0509119 | 0.0546045 |
| When $d_1 \geq d_{10}$, | $d_{1m}$ (nm) $=$ | 7.796 | 7.721 | 10.517 | 12.746 | 16.898 |
| When $d_1 < d_{10}$, | $d_{1m}$ (nm) $=$ | 5.302 | 5.383 | 5.078 | 5.794 | 6.421 |
| When $n_2 \geq n_{20}$, | $n_{2m} =$ | 0.1607617 | 0.1549121 | 0.2063647 | 0.1805920 | 0.1791541 |
| When $n_2 < n_{20}$, | $n_{2m} =$ | 0.1802881 | 0.1767310 | 0.1869873 | 0.1622900 | 0.1552356 |
| When $k_2 \geq k_{20}$, | $k_{2m} =$ | 0.1971570 | 0.1718066 | 0.1998254 | 0.2205994 | 0.2284485 |
| When $k_2 < k_{20}$, | $k_{2m} =$ | 0.1177856 | 0.1071863 | 0.1537903 | 0.1082654 | 0.0890710 |
| When $d_2 \geq d_{20}$, | $d_{2m}$ (nm) $=$ | ∞ | ∞ | 7.208 | ∞ | ∞ |
| When $d_2 < d_{20}$, | $d_{2m}$ (nm) $=$ | 68.041 | 110.260 | 5.967 | 13.288 | 26.909 |

0．93 ≤ N A ≤ 1．0
35 < T ≤ 45

| Case | 4-11 | 4-12 | 4-13 | 4-14 | 4-15 |
|---|---|---|---|---|---|
| $n_{10}$ | 1.7310401 | 1.7404520 | 1.7353985 | 1.7244370 | 1.7094852 |
| $k_{10}$ | 0.0827558 | 0.0960720 | 0.0882239 | 0.0802890 | 0.0677575 |
| $d_{10}$ (nm) | 89.146 | 155.339 | 154.960 | 155.397 | 155.056 |
| $n_{20}$ | 1.7041670 | 1.9461112 | 1.8293633 | 1.7457172 | 1.6751093 |
| $k_{20}$ | 0.2282102 | 0.5942640 | 0.3421815 | 0.2519901 | 0.2044537 |
| $d_{20}$ (nm) | 240.157 | 50.887 | 110.529 | 174.646 | 241.084 |

| | | 4-11 | 4-12 | 4-13 | 4-14 | 4-15 |
|---|---|---|---|---|---|---|
| When $n_1 \geq n_{10}$, | $n_{1m} =$ | 0.0658081 | 0.0609131 | 0.0631018 | 0.0626184 | 0.0606677 |
| When $n_1 < n_{10}$, | $n_{1m} =$ | 0.0392627 | 0.0232361 | 0.0219373 | 0.0213806 | 0.0433704 |
| When $k_1 \geq k_{10}$, | $k_{1m} =$ | 0.0703406 | 0.0642554 | 0.0612463 | 0.0585852 | 0.0715100 |
| When $k_1 < k_{10}$, | $k_{1m} =$ | 0.0569983 | 0.0328662 | 0.0342212 | 0.0355737 | 0.0444800 |
| When $d_1 \geq d_{10}$, | $d_{1m}$ (nm) $=$ | 25.085 | 16.735 | 27.723 | 38.964 | ∞ |
| When $d_1 < d_{10}$, | $d_{1m}$ (nm) $=$ | 9.551 | 5.135 | 5.136 | 5.707 | 18.661 |
| When $n_2 \geq n_{20}$, | $n_{2m} =$ | 0.1952173 | 0.1934106 | 0.1684375 | 0.2170105 | 0.2364917 |
| When $n_2 < n_{20}$, | $n_{2m} =$ | 0.1461670 | 0.1873682 | 0.1611987 | 0.1494055 | 0.1341663 |
| When $k_2 \geq k_{20}$, | $k_{2m} =$ | 0.1811243 | 0.1365161 | 0.1602917 | 0.1917432 | 0.1477625 |
| When $k_2 < k_{20}$, | $k_{2m} =$ | 0.0805774 | 0.1412585 | 0.0980115 | 0.0826819 | 0.0722742 |
| When $d_2 \geq d_{20}$, | $d_{2m}$ (nm) $=$ | ∞ | 6.877 | 15.552 | ∞ | ∞ |
| When $d_2 < d_{20}$, | $d_{2m}$ (nm) $=$ | 77.061 | 5.982 | 8.340 | 24.666 | 73.559 |

0．93 ≤ N A ≤ 1．0
35 < T ≤ 45

| Case | 4-16 | 4-17 | 4-18 | 4-19 | 4-20 |
|---|---|---|---|---|---|
| $n_{10}$ | 1.7305468 | 1.7234847 | 1.7196555 | 1.7094719 | 1.7026367 |
| $k_{10}$ | 0.1083688 | 0.0859582 | 0.0809985 | 0.0713058 | 0.0605694 |
| $d_{10}$ (nm) | 224.105 | 219.529 | 219.492 | 221.454 | 219.016 |
| $n_{20}$ | 3.7612310 | 1.8940064 | 1.7865237 | 1.7085534 | 1.6670562 |
| $k_{20}$ | 9.7520181 | 0.5381566 | 0.3130643 | 0.2375210 | 0.1929642 |
| $d_{20}$ (nm) | 0.557 | 52.122 | 112.555 | 175.858 | 239.742 |

| | | 4-16 | 4-17 | 4-18 | 4-19 | 4-20 |
|---|---|---|---|---|---|---|
| When $n_1 \geq n_{10}$, | $n_{1m} =$ | 0.0498926 | 0.0642505 | 0.0656738 | 0.0636218 | 0.0649512 |
| When $n_1 < n_{10}$, | $n_{1m} =$ | 0.0031824 | 0.0153259 | 0.0138647 | 0.0294287 | 0.0615662 |
| When $k_1 \geq k_{10}$, | $k_{1m} =$ | 0.0271924 | 0.0553479 | 0.0526111 | 0.0605078 | 0.0781384 |
| When $k_1 < k_{10}$, | $k_{1m} =$ | 0.0108813 | 0.0230212 | 0.0207922 | 0.0257751 | 0.0395862 |
| When $d_1 \geq d_{10}$, | $d_{1m}$ (nm) $=$ | 12.324 | 42.526 | ∞ | ∞ | ∞ |
| When $d_1 < d_{10}$, | $d_{1m}$ (nm) $=$ | 0.823 | 4.181 | 3.891 | 14.979 | 80.387 |
| When $n_2 \geq n_{20}$, | $n_{2m} =$ | 0.4580664 | 0.1955493 | 0.1665735 | 0.2757410 | 0.2666089 |
| When $n_2 < n_{20}$, | $n_{2m} =$ | 1.0705701 | 0.1254541 | 0.1755249 | 0.1566431 | 0.1466138 |
| When $k_2 \geq k_{20}$, | $k_{2m} =$ | 0.1823242 | 0.0953308 | 0.1233594 | 0.1752612 | 0.1390967 |
| When $k_2 < k_{20}$, | $k_{2m} =$ | 1.8675439 | 0.1410535 | 0.1010315 | 0.0760974 | 0.0711597 |
| When $d_2 \geq d_{20}$, | $d_{2m}$ (nm) $=$ | 0.019 | 7.428 | ∞ | ∞ | ∞ |
| When $d_2 < d_{20}$, | $d_{2m}$ (nm) $=$ | 0.155 | 3.724 | 4.890 | 25.232 | 73.082 |

$0.93 \leq NA \leq 1.0$
$45 < T \leq 55$

| Case | 5-01 | 5-02 | 5-03 | 5-04 | 5-05 |
|------|------|------|------|------|------|
| $n_{10}$ | 1.7952075 | 1.8907711 | 1.9054716 | 1.9347861 | 1.9562331 |
| $k_{10}$ | 0.2631488 | 0.1709411 | 0.1139096 | 0.0660701 | 0.1018371 |
| $d_{10}$ (nm) | 28.407 | 22.060 | 18.051 | 14.149 | 10.504 |
| $n_{20}$ | 1.7975159 | 1.9054700 | 1.8637077 | 1.8512928 | 1.7371318 |
| $k_{20}$ | 0.9080589 | 0.5625340 | 0.4032117 | 0.3248351 | 0.3049135 |
| $d_{20}$ (nm) | 49.215 | 101.512 | 161.182 | 218.499 | 238.789 |

| | | 5-01 | 5-02 | 5-03 | 5-04 | 5-05 |
|---|---|------|------|------|------|------|
| When $n_1 \geq n_{10}$, | $n_{1m}=$ | 0.0796008 | 0.0882104 | 0.0968323 | 0.1120276 | 0.1430420 |
| When $n_1 < n_{10}$, | $n_{1m}=$ | 0.0558337 | 0.0676855 | 0.0756775 | 0.0900916 | 0.1115369 |
| When $k_1 \geq k_{10}$, | $k_{1m}=$ | 0.0737183 | 0.0824512 | 0.0899622 | 0.1015723 | 0.1322839 |
| When $k_1 < k_{10}$, | $k_{1m}=$ | 0.0714771 | 0.0859058 | 0.0970459 | 0.0660701 | 0.1018371 |
| When $d_1 \geq d_{10}$, | $d_{1m}$ (nm) = | 6.136 | 6.696 | 7.231 | 6.738 | 5.941 |
| When $d_1 < d_{10}$, | $d_{1m}$ (nm) = | 3.959 | 4.421 | 4.830 | 4.663 | 4.082 |
| When $n_2 \geq n_{20}$, | $n_{2m}=$ | 0.2206628 | 0.1836475 | 0.1640088 | 0.1560229 | 0.1493176 |
| When $n_2 < n_{20}$, | $n_{2m}=$ | 0.2514893 | 0.2026611 | 0.1850330 | 0.1781982 | 0.1793958 |
| When $k_2 \geq k_{20}$, | $k_{2m}=$ | 0.2648120 | 0.2363086 | 0.1980701 | 0.1765576 | 0.1456726 |
| When $k_2 < k_{20}$, | $k_{2m}=$ | 0.1661694 | 0.1390979 | 0.1188672 | 0.1083618 | 0.1075342 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 11.142 | 25.966 | 67.131 | 101.947 | 116.324 |

$0.93 \leq NA \leq 1.0$
$45 < T \leq 55$

| Case | 5-06 | 5-07 | 5-08 | 5-09 | 5-10 |
|------|------|------|------|------|------|
| $n_{10}$ | 1.7844085 | 1.7702622 | 1.7541370 | 1.7279592 | 1.7375980 |
| $k_{10}$ | 0.1367381 | 0.1105738 | 0.0973387 | 0.0846136 | 0.1054836 |
| $d_{10}$ (nm) | 84.299 | 87.211 | 88.132 | 88.943 | 150.710 |
| $n_{20}$ | 1.7096132 | 1.8115599 | 1.7670571 | 1.6883751 | 1.7055974 |
| $k_{20}$ | 0.6495191 | 0.4022198 | 0.2903421 | 0.2308596 | 0.5608974 |
| $d_{20}$ (nm) | 54.242 | 106.122 | 167.020 | 233.281 | 53.799 |

| | | 5-06 | 5-07 | 5-08 | 5-09 | 5-10 |
|---|---|------|------|------|------|------|
| When $n_1 \geq n_{10}$, | $n_{1m}=$ | 0.0647021 | 0.0659351 | 0.0664050 | 0.0646069 | 0.0607947 |
| When $n_1 < n_{10}$, | $n_{1m}=$ | 0.0336169 | 0.0333887 | 0.0319458 | 0.0381165 | 0.0178674 |
| When $k_1 \geq k_{10}$, | $k_{1m}=$ | 0.0728796 | 0.0707520 | 0.0653967 | 0.0692603 | 0.0616235 |
| When $k_1 < k_{10}$, | $k_{1m}=$ | 0.0421851 | 0.0477087 | 0.0524451 | 0.0553516 | 0.0270422 |
| When $d_1 \geq d_{10}$, | $d_{1m}$ (nm) = | 9.564 | 12.156 | 16.406 | 23.344 | 13.595 |
| When $d_1 < d_{10}$, | $d_{1m}$ (nm) = | 4.227 | 5.119 | 5.747 | 9.303 | 3.589 |
| When $n_2 \geq n_{20}$, | $n_{2m}=$ | 0.2254211 | 0.1928967 | 0.1889099 | 0.2061182 | 0.2563867 |
| When $n_2 < n_{20}$, | $n_{2m}=$ | 0.1907227 | 0.1764453 | 0.1616943 | 0.1463477 | 0.1201587 |
| When $k_2 \geq k_{20}$, | $k_{2m}=$ | 0.1398059 | 0.1815479 | 0.2086975 | 0.1714539 | 0.0974426 |
| When $k_2 < k_{20}$, | $k_{2m}=$ | 0.1320325 | 0.1038733 | 0.0888391 | 0.0812170 | 0.1216650 |
| When $d_2 \geq d_{20}$, | $d_{2m}$ (nm) = | 14.246 | ∞ | ∞ | ∞ | 10.184 |
| When $d_2 < d_{20}$, | $d_{2m}$ (nm) = | 7.856 | 11.965 | 30.548 | 77.806 | 4.856 |

$0.93 \leq NA \leq 1.0$

$45 < T \leq 55$

| Case | 5-11 | 5-12 | 5-13 | 5-14 | 5-15 |
|---|---|---|---|---|---|
| $n_{10}$ | 1.7329681 | 1.7221048 | 1.7083331 | 1.7220084 | 1.7182277 |
| $k_{10}$ | 0.0932680 | 0.0829100 | 0.0687145 | 0.0940320 | 0.0857940 |
| $d_{10}$ (nm) | 153.145 | 154.966 | 154.712 | 214.741 | 217.589 |
| $n_{20}$ | 1.7707311 | 1.7249696 | 1.6656993 | 1.7051250 | 1.7452872 |
| $k_{20}$ | 0.3436851 | 0.2554267 | 0.2071468 | 0.5097600 | 0.3145186 |
| $d_{20}$ (nm) | 107.979 | 168.643 | 233.037 | 53.504 | 108.615 |

| | | 5-11 | 5-12 | 5-13 | 5-14 | 5-15 |
|---|---|---|---|---|---|---|
| When $n_1 \geq n_{10}$, | $n_{1m} =$ | 0.0625659 | 0.0612402 | 0.0592444 | 0.0643567 | 0.0658276 |
| When $n_1 < n_{10}$, | $n_{1m} =$ | 0.0170984 | 0.0172632 | 0.0416833 | 0.0078064 | 0.0068054 |
| When $k_1 \geq k_{10}$, | $k_{1m} =$ | 0.0565161 | 0.0540405 | 0.0705188 | 0.0454688 | 0.0426636 |
| When $k_1 < k_{10}$, | $k_{1m} =$ | 0.0297095 | 0.0318542 | 0.0432507 | 0.0149841 | 0.0129956 |
| When $d_1 \geq d_{10}$, | $d_{1m}$ (nm) $=$ | 26.425 | 34.880 | ∞ | 35.694 | ∞ |
| When $d_1 < d_{10}$, | $d_{1m}$ (nm) $=$ | 3.834 | 4.536 | 17.051 | 1.969 | 1.835 |
| When $n_2 \geq n_{20}$, | $n_{2m} =$ | 0.2299866 | 0.2362512 | 0.2473572 | 0.2585364 | 0.2705701 |
| When $n_2 < n_{20}$, | $n_{2m} =$ | 0.1752441 | 0.1521826 | 0.1336328 | 0.0467419 | 0.0530518 |
| When $k_2 \geq k_{20}$, | $k_{2m} =$ | 0.1260229 | 0.1759094 | 0.1395569 | 0.0560938 | 0.0808508 |
| When $k_2 < k_{20}$, | $k_{2m} =$ | 0.0941040 | 0.0829492 | 0.0726111 | 0.1239917 | 0.0993604 |
| When $d_2 \geq d_{20}$, | $d_{2m}$ (nm) $=$ | ∞ | ∞ | ∞ | 10.256 | ∞ |
| When $d_2 < d_{20}$, | $d_{2m}$ (nm) $=$ | 6.312 | 26.413 | 73.432 | 2.024 | 2.346 |

$0.93 \leq NA \leq 1.0$

$45 < T \leq 55$

| Case | 5-16 | 5-17 |
|---|---|---|
| $n_{10}$ | 1.7079026 | 1.7021324 |
| $k_{10}$ | 0.0731017 | 0.0613637 |
| $d_{10}$ (nm) | 221.285 | 218.642 |
| $n_{20}$ | 1.6934483 | 1.6620357 |
| $k_{20}$ | 0.2412999 | 0.1957858 |
| $d_{20}$ (nm) | 168.585 | 230.920 |

| | | 5-16 | 5-17 |
|---|---|---|---|
| When $n_1 \geq n_{10}$, | $n_{1m} =$ | 0.0611572 | 0.0632739 |
| When $n_1 < n_{10}$, | $n_{1m} =$ | 0.0235156 | 0.0581824 |
| When $k_1 \geq k_{10}$, | $k_{1m} =$ | 0.0566406 | 0.0776050 |
| When $k_1 < k_{10}$, | $k_{1m} =$ | 0.0230566 | 0.0386719 |
| When $d_1 \geq d_{10}$, | $d_{1m}$ (nm) $=$ | ∞ | ∞ |
| When $d_1 < d_{10}$, | $d_{1m}$ (nm) $=$ | 8.641 | 78.699 |
| When $n_2 \geq n_{20}$, | $n_{2m} =$ | 0.2946387 | 0.2760742 |
| When $n_2 < n_{20}$, | $n_{2m} =$ | 0.1554272 | 0.1463647 |
| When $k_2 \geq k_{20}$, | $k_{2m} =$ | 0.1654895 | 0.1344739 |
| When $k_2 < k_{20}$, | $k_{2m} =$ | 0.0676013 | 0.0719324 |
| When $d_2 \geq d_{20}$, | $d_{2m}$ (nm) $=$ | ∞ | ∞ |
| When $d_2 < d_{20}$, | $d_{2m}$ (nm) $=$ | 26.199 | 53.085 |

$0.93 \leq NA \leq 1.0$

$55 < T \leq 65$

| Case | 6-01 | 6-02 | 6-03 | 6-04 | 6-05 |
|---|---|---|---|---|---|
| $n_{10}$ | 1.7605068 | 1.8816347 | 1.9020430 | 1.9458467 | 1.9584022 |
| $k_{10}$ | 0.2771672 | 0.1829378 | 0.1268282 | 0.0703715 | 0.1032605 |
| $d_{10}$ (nm) | 28.706 | 20.725 | 16.538 | 13.048 | 10.534 |
| $n_{20}$ | 1.6786286 | 1.8151288 | 1.7976518 | 1.8275971 | 1.7382432 |
| $k_{20}$ | 0.9008770 | 0.5496963 | 0.3935708 | 0.3251874 | 0.3086817 |
| $d_{20}$ (nm) | 43.735 | 99.755 | 160.685 | 213.311 | 229.129 |

| | | 6-01 | 6-02 | 6-03 | 6-04 | 6-05 |
|---|---|---|---|---|---|---|
| When $n_1 \geq n_{10}$, | $n_{1m} =$ | 0.0840430 | 0.0931677 | 0.1035986 | 0.1192371 | 0.1431311 |
| When $n_1 < n_{10}$, | $n_{1m} =$ | 0.0576428 | 0.0681458 | 0.0779578 | 0.0939172 | 0.1097058 |
| When $k_1 \geq k_{10}$, | $k_{1m} =$ | 0.0662097 | 0.0857654 | 0.0958630 | 0.1068726 | 0.1305750 |
| When $k_1 < k_{10}$, | $k_{1m} =$ | 0.0706262 | 0.0861902 | 0.1004041 | 0.0703715 | 0.1032605 |
| When $d_1 \geq d_{10}$, | $d_{1m}$ (nm) $=$ | 6.461 | 6.864 | 7.218 | 6.428 | 5.908 |
| When $d_1 < d_{10}$, | $d_{1m}$ (nm) $=$ | 4.241 | 4.337 | 4.665 | 4.365 | 3.988 |
| When $n_2 \geq n_{20}$, | $n_{2m} =$ | 0.2053870 | 0.1760388 | 0.1592407 | 0.1556714 | 0.1505713 |
| When $n_2 < n_{20}$, | $n_{2m} =$ | 0.2197400 | 0.2099182 | 0.1887061 | 0.1809558 | 0.1813904 |
| When $k_2 \geq k_{20}$, | $k_{2m} =$ | 0.2532373 | 0.2078381 | 0.1779785 | 0.1687073 | 0.1458105 |
| When $k_2 < k_{20}$, | $k_{2m} =$ | 0.1729968 | 0.1382983 | 0.1186841 | 0.1101477 | 0.1094250 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 9.750 | 24.367 | 71.258 | 104.445 | 116.852 |

$0.93 \leq NA \leq 1.0$

$55 < T \leq 65$

| Case | 6-06 | 6-07 | 6-08 | 6-09 | 6-10 |
|---|---|---|---|---|---|
| $n_{10}$ | 1.7915017 | 1.7682864 | 1.7517777 | 1.7257399 | 1.7391311 |
| $k_{10}$ | 0.1460711 | 0.1152280 | 0.1000283 | 0.0854213 | 0.1111219 |
| $d_{10}$ (nm) | 82.108 | 86.246 | 87.803 | 88.823 | 148.271 |
| $n_{20}$ | 1.6599684 | 1.7730752 | 1.7495420 | 1.6774661 | 1.6415570 |
| $k_{20}$ | 0.6598461 | 0.3999868 | 0.2902721 | 0.2313191 | 0.5493559 |
| $d_{20}$ (nm) | 47.036 | 100.473 | 159.986 | 224.881 | 47.977 |

| | | 6-06 | 6-07 | 6-08 | 6-09 | 6-10 |
|---|---|---|---|---|---|---|
| When $n_1 \geq n_{10}$, | $n_{1m} =$ | 0.0707507 | 0.0678174 | 0.0671436 | 0.0642444 | 0.0613611 |
| When $n_1 < n_{10}$, | $n_{1m} =$ | 0.0347034 | 0.0316797 | 0.0297241 | 0.0379114 | 0.0170081 |
| When $k_1 \geq k_{10}$, | $k_{1m} =$ | 0.0716638 | 0.0707349 | 0.0637610 | 0.0688733 | 0.0614063 |
| When $k_1 < k_{10}$, | $k_{1m} =$ | 0.0419373 | 0.0459045 | 0.0509448 | 0.0544250 | 0.0258569 |
| When $d_1 \geq d_{10}$, | $d_{1m}$ (nm) $=$ | 8.814 | 11.596 | 15.946 | 22.736 | 12.264 |
| When $d_1 < d_{10}$, | $d_{1m}$ (nm) $=$ | 3.999 | 4.706 | 5.289 | 9.347 | 3.219 |
| When $n_2 \geq n_{20}$, | $n_{2m} =$ | 0.2110352 | 0.2040027 | 0.1980566 | 0.2150256 | 0.2303101 |
| When $n_2 < n_{20}$, | $n_{2m} =$ | 0.1684949 | 0.1890479 | 0.1666223 | 0.1461719 | 0.0970691 |
| When $k_2 \geq k_{20}$, | $k_{2m} =$ | 0.1438293 | 0.1667627 | 0.2003491 | 0.1648621 | 0.0994629 |
| When $k_2 < k_{20}$, | $k_{2m} =$ | 0.1447302 | 0.1052173 | 0.0896777 | 0.0819421 | 0.1292871 |
| When $d_2 \geq d_{20}$, | $d_{2m}$ (nm) $=$ | 15.339 | ∞ | ∞ | ∞ | 12.574 |
| When $d_2 < d_{20}$, | $d_{2m}$ (nm) $=$ | 6.489 | 10.552 | 32.474 | 78.570 | 4.088 |

316

0. 9 3 ≤ N A ≤ 1. 0
5 5 < T ≤ 6 5

| Case | 6-11 | 6-12 | 6-13 | 6-14 | 6-15 |
|---|---|---|---|---|---|
| $n_{10}$ | 1.7320844 | 1.7076855 | 1.7203924 | 1.7223192 | 1.7173463 |
| $k_{10}$ | 0.0968192 | 0.0689521 | 0.0842770 | 0.0985051 | 0.0890019 |
| $d_{10}$ (nm) | 152.055 | 154.586 | 154.911 | 212.081 | 216.420 |
| $n_{20}$ | 1.7411899 | 1.6612710 | 1.7118542 | 1.6387426 | 1.7205682 |
| $k_{20}$ | 0.3409343 | 0.2081961 | 0.2561923 | 0.4904233 | 0.3116849 |
| $d_{20}$ (nm) | 101.751 | 223.547 | 160.544 | 48.284 | 102.035 |

| | | 6-11 | 6-12 | 6-13 | 6-14 | 6-15 |
|---|---|---|---|---|---|---|
| When $n_1 \geq n_{10}$, | $n_{1m}=$ | 0.0640808 | 0.0590295 | 0.0609424 | 0.0598975 | 0.0677930 |
| When $n_1 < n_{10}$, | $n_{1m}=$ | 0.0141614 | 0.0412158 | 0.0147046 | 0.0053711 | 0.0022900 |
| When $k_1 \geq k_{10}$, | $k_{1m}=$ | 0.0532275 | 0.0702893 | 0.0510400 | 0.0410706 | 0.0340332 |
| When $k_1 < k_{10}$, | $k_{1m}=$ | 0.0265625 | 0.0427490 | 0.0291602 | 0.0117297 | 0.0056226 |
| When $d_1 \geq d_{10}$, | $d_{1m}$ (nm) $=$ | 25.992 | ∞ | 33.192 | 33.998 | 50.996 |
| When $d_1 < d_{10}$, | $d_{1m}$ (nm) $=$ | 3.082 | 16.525 | 3.853 | 1.301 | 0.604 |
| When $n_2 \geq n_{20}$, | $n_{2m}=$ | 0.2268713 | 0.2531177 | 0.2476831 | 0.2556775 | 0.2704236 |
| When $n_2 < n_{20}$, | $n_{2m}=$ | 0.1878772 | 0.1338721 | 0.1536694 | 0.0287537 | 0.0146338 |
| When $k_2 \geq k_{20}$, | $k_{2m}=$ | 0.1099695 | 0.1355603 | 0.1692993 | 0.0485706 | 0.0433569 |
| When $k_2 < k_{20}$, | $k_{2m}=$ | 0.0948242 | 0.0734631 | 0.0770691 | 0.1286780 | 0.0774121 |
| When $d_2 \geq d_{20}$, | $d_{2m}$ (nm) $=$ | ∞ | ∞ | ∞ | 12.209 | ∞ |
| When $d_2 < d_{20}$, | $d_{2m}$ (nm) $=$ | 4.972 | 56.744 | 27.273 | 1.327 | 0.772 |

0. 9 3 ≤ N A ≤ 1. 0
5 5 < T ≤ 6 5

| Case | 6-16 | 6-17 |
|---|---|---|
| $n_{10}$ | 1.7068337 | 1.7019545 |
| $k_{10}$ | 0.0738736 | 0.0615388 |
| $d_{10}$ (nm) | 221.446 | 218.498 |
| $n_{20}$ | 1.6845656 | 1.6606500 |
| $k_{20}$ | 0.2425094 | 0.1970435 |
| $d_{20}$ (nm) | 159.621 | 220.941 |

| | | 6-16 | 6-17 |
|---|---|---|---|
| When $n_1 \geq n_{10}$, | $n_{1m}=$ | 0.0603540 | 0.0631677 |
| When $n_1 < n_{10}$, | $n_{1m}=$ | 0.0209692 | 0.0568018 |
| When $k_1 \geq k_{10}$, | $k_{1m}=$ | 0.0545837 | 0.0777637 |
| When $k_1 < k_{10}$, | $k_{1m}=$ | 0.0216589 | 0.0384106 |
| When $d_1 \geq d_{10}$, | $d_{1m}$ (nm) $=$ | ∞ | ∞ |
| When $d_1 < d_{10}$, | $d_{1m}$ (nm) $=$ | 7.750 | 78.234 |
| When $n_2 \geq n_{20}$, | $n_{2m}=$ | 0.3057288 | 0.2826660 |
| When $n_2 < n_{20}$, | $n_{2m}=$ | 0.1553943 | 0.1472412 |
| When $k_2 \geq k_{20}$, | $k_{2m}=$ | 0.1625220 | 0.1326501 |
| When $k_2 < k_{20}$, | $k_{2m}=$ | 0.0624280 | 0.0731104 |
| When $d_2 \geq d_{20}$, | $d_{2m}$ (nm) $=$ | ∞ | ∞ |
| When $d_2 < d_{20}$, | $d_{2m}$ (nm) $=$ | 26.805 | 48.201 |

$0.93 \leq NA \leq 1.0$

$65 < T \leq 75$

| Case | 7-01 | 7-02 | 7-03 | 7-04 | 7-05 |
|---|---|---|---|---|---|
| $n_{10}$ | 1.7659038 | 1.8645399 | 1.8986420 | 1.9431410 | 1.8260230 |
| $k_{10}$ | 0.3040912 | 0.1945245 | 0.1330684 | 0.1068639 | 0.1610409 |
| $d_{10}$ (nm) | 29.683 | 22.504 | 17.099 | 11.420 | 82.141 |
| $n_{20}$ | 1.6951746 | 1.8232494 | 1.7981378 | 1.7406778 | 1.8123655 |
| $k_{20}$ | 1.0159152 | 0.5745287 | 0.4053118 | 0.3159076 | 0.8416018 |
| $d_{20}$ (nm) | 32.660 | 88.735 | 150.314 | 217.432 | 29.750 |

| | | 7-01 | 7-02 | 7-03 | 7-04 | 7-05 |
|---|---|---|---|---|---|---|
| When $n_1 \geq n_{10}$, | $n_{1m} =$ | 0.0851306 | 0.0913562 | 0.1021387 | 0.1343896 | 0.0697156 |
| When $n_1 < n_{10}$, | $n_{1m} =$ | 0.0579541 | 0.0649255 | 0.0759912 | 0.1029980 | 0.0329614 |
| When $k_1 \geq k_{10}$, | $k_{1m} =$ | 0.0588293 | 0.0796277 | 0.0923560 | 0.1221460 | 0.0674365 |
| When $k_1 < k_{10}$, | $k_{1m} =$ | 0.0718896 | 0.0854541 | 0.0996875 | 0.1068639 | 0.0435559 |
| When $d_1 \geq d_{10}$, | $d_{1m}$ (nm) $=$ | 5.966 | 7.118 | 7.275 | 6.222 | 7.298 |
| When $d_1 < d_{10}$, | $d_{1m}$ (nm) $=$ | 4.222 | 4.395 | 4.641 | 4.200 | 3.443 |
| When $n_2 \geq n_{20}$, | $n_{2m} =$ | 0.2227673 | 0.1853540 | 0.1622253 | 0.1538269 | 0.2762463 |
| When $n_2 < n_{20}$, | $n_{2m} =$ | 0.2074731 | 0.2178162 | 0.1908838 | 0.1813525 | 0.2757544 |
| When $k_2 \geq k_{20}$, | $k_{2m} =$ | 0.3106860 | 0.2340100 | 0.1838708 | 0.1497839 | 0.2030774 |
| When $k_2 < k_{20}$, | $k_{2m} =$ | 0.2037939 | 0.1485229 | 0.1235767 | 0.1116138 | 0.1923645 |
| When $d_2 \geq d_{20}$, | $d_{2m}$ (nm) $=$ | $\infty$ | $\infty$ | $\infty$ | $\infty$ | 12.449 |
| When $d_2 < d_{20}$, | $d_{2m}$ (nm) $=$ | 7.750 | 24.931 | 70.207 | 113.565 | 5.408 |

$0.93 \leq NA \leq 1.0$

$65 < T \leq 75$

| Case | 7-06 | 7-07 | 7-08 | 7-09 | 7-10 |
|---|---|---|---|---|---|
| $n_{10}$ | 1.7771488 | 1.7544343 | 1.7270080 | 1.7474077 | 1.7344421 |
| $k_{10}$ | 0.1183021 | 0.1010010 | 0.0859818 | 0.1187907 | 0.0986199 |
| $d_{10}$ (nm) | 86.874 | 88.257 | 88.900 | 148.872 | 153.031 |
| $n_{20}$ | 1.8193233 | 1.7618403 | 1.6808707 | 1.6925268 | 1.7617910 |
| $k_{20}$ | 0.4301648 | 0.3008540 | 0.2360835 | 0.6251022 | 0.3597954 |
| $d_{20}$ (nm) | 86.325 | 147.888 | 214.142 | 34.244 | 89.143 |

| | | 7-06 | 7-07 | 7-08 | 7-09 | 7-10 |
|---|---|---|---|---|---|---|
| When $n_1 \geq n_{10}$, | $n_{1m} =$ | 0.0673694 | 0.0664294 | 0.0644080 | 0.0590649 | 0.0632410 |
| When $n_1 < n_{10}$, | $n_{1m} =$ | 0.0307617 | 0.0294727 | 0.0379211 | 0.0149548 | 0.0133545 |
| When $k_1 \geq k_{10}$, | $k_{1m} =$ | 0.0672144 | 0.0623938 | 0.0685620 | 0.0548840 | 0.0510083 |
| When $k_1 < k_{10}$, | $k_{1m} =$ | 0.0467444 | 0.0514600 | 0.0549805 | 0.0255261 | 0.0262878 |
| When $d_1 \geq d_{10}$, | $d_{1m}$ (nm) $=$ | 10.761 | 15.121 | 22.543 | 10.466 | 24.985 |
| When $d_1 < d_{10}$, | $d_{1m}$ (nm) $=$ | 4.433 | 5.189 | 9.219 | 2.761 | 2.901 |
| When $n_2 \geq n_{20}$, | $n_{2m} =$ | 0.2196216 | 0.2049475 | 0.2147473 | 0.2786914 | 0.2464575 |
| When $n_2 < n_{20}$, | $n_{2m} =$ | 0.1907739 | 0.1643323 | 0.1459814 | 0.1244519 | 0.1858276 |
| When $k_2 \geq k_{20}$, | $k_{2m} =$ | 0.1969482 | 0.2144763 | 0.1668457 | 0.1106995 | 0.1237866 |
| When $k_2 < k_{20}$, | $k_{2m} =$ | 0.1161511 | 0.0943396 | 0.0836194 | 0.1556311 | 0.1032104 |
| When $d_2 \geq d_{20}$, | $d_{2m}$ (nm) $=$ | $\infty$ | $\infty$ | $\infty$ | 9.505 | $\infty$ |
| When $d_2 < d_{20}$, | $d_{2m}$ (nm) $=$ | 10.265 | 27.730 | 76.727 | 3.667 | 4.914 |

0. 93 ≤ NA ≤ 1. 0
65 < T ≤ 75

| Case | 7-11 | 7-12 | 7-13 | 7-14 | 7-15 |
|---|---|---|---|---|---|
| $n_{10}$ | 1.7082851 | 1.7212227 | 1.7256274 | 1.7180408 | 1.7074443 |
| $k_{10}$ | 0.0693971 | 0.0845898 | 0.1038247 | 0.0895343 | 0.0742263 |
| $d_{10}$ (nm) | 154.668 | 155.411 | 212.824 | 218.202 | 221.707 |
| $n_{20}$ | 1.6632564 | 1.7183974 | 1.6530934 | 1.7315716 | 1.6896767 |
| $k_{20}$ | 0.2120421 | 0.2642962 | 0.5317369 | 0.3280557 | 0.2496384 |
| $d_{20}$ (nm) | 213.175 | 149.129 | 36.133 | 89.506 | 148.627 |

| | | 7-11 | 7-12 | 7-13 | 7-14 | 7-15 |
|---|---|---|---|---|---|---|
| When $n_1 \geq n_{10}$, | $n_{1m} =$ | 0.0593945 | 0.0606384 | 0.0541980 | 0.0647742 | 0.0609387 |
| When $n_1 < n_{10}$, | $n_{1m} =$ | 0.0413879 | 0.0149182 | 0.0029968 | 0.0021960 | 0.0208508 |
| When $k_1 \geq k_{10}$, | $k_{1m} =$ | 0.0699487 | 0.0507495 | 0.0335364 | 0.0342871 | 0.0542102 |
| When $k_1 < k_{10}$, | $k_{1m} =$ | 0.0433142 | 0.0298535 | 0.0082080 | 0.0055542 | 0.0221802 |
| When $d_1 \geq d_{10}$, | $d_{1m}$ (nm) $=$ | ∞ | 32.689 | 15.980 | 48.365 | ∞ |
| When $d_1 < d_{10}$, | $d_{1m}$ (nm) $=$ | 16.649 | 3.913 | 0.723 | 0.594 | 7.641 |
| When $n_2 \geq n_{20}$, | $n_{2m} =$ | 0.2553577 | 0.2564221 | 0.2715186 | 0.1988367 | 0.3137769 |
| When $n_2 < n_{20}$, | $n_{2m} =$ | 0.1341199 | 0.1522119 | 0.0214917 | 0.0208643 | 0.1570667 |
| When $k_2 \geq k_{20}$, | $k_{2m} =$ | 0.1361841 | 0.1775061 | 0.0327844 | 0.0526038 | 0.1632751 |
| When $k_2 < k_{20}$, | $k_{2m} =$ | 0.0749841 | 0.0809204 | 0.1462024 | 0.0801404 | 0.0667383 |
| When $d_2 \geq d_{20}$, | $d_{2m}$ (nm) $=$ | ∞ | ∞ | 9.604 | ∞ | ∞ |
| When $d_2 < d_{20}$, | $d_{2m}$ (nm) $=$ | 57.367 | 24.447 | 0.813 | 0.826 | 24.310 |

0. 93 ≤ NA ≤ 1. 0
65 < T ≤ 75

| Case | 7-16 |
|---|---|
| $n_{10}$ | 1.7023147 |
| $k_{10}$ | 0.0619030 |
| $d_{10}$ (nm) | 218.598 |
| $n_{20}$ | 1.6620389 |
| $k_{20}$ | 0.2005572 |
| $d_{20}$ (nm) | 210.752 |

| | | 7-16 |
|---|---|---|
| When $n_1 \geq n_{10}$, | $n_{1m} =$ | 0.0637036 |
| When $n_1 < n_{10}$, | $n_{1m} =$ | 0.0577161 |
| When $k_1 \geq k_{10}$, | $k_{1m} =$ | 0.0772327 |
| When $k_1 < k_{10}$, | $k_{1m} =$ | 0.0389124 |
| When $d_1 \geq d_{10}$, | $d_{1m}$ (nm) $=$ | ∞ |
| When $d_1 < d_{10}$, | $d_{1m}$ (nm) $=$ | 78.427 |
| When $n_2 \geq n_{20}$, | $n_{2m} =$ | 0.2845728 |
| When $n_2 < n_{20}$, | $n_{2m} =$ | 0.1478259 |
| When $k_2 \geq k_{20}$, | $k_{2m} =$ | 0.1321912 |
| When $k_2 < k_{20}$, | $k_{2m} =$ | 0.0745581 |
| When $d_2 \geq d_{20}$, | $d_{2m}$ (nm) $=$ | ∞ |
| When $d_2 < d_{20}$, | $d_{2m}$ (nm) $=$ | 48.632 |

$0.93 \leq NA \leq 1.0$
$75 < T \leq 85$

| Case | 8-01 | 8-02 | 8-03 | 8-04 | 8-05 |
|---|---|---|---|---|---|
| $n_{10}$ | 1.7563588 | 1.8511230 | 1.8843188 | 1.9287462 | 1.8353218 |
| $k_{10}$ | 0.3324096 | 0.2092311 | 0.1443736 | 0.1105115 | 0.1759033 |
| $d_{10}$ (nm) | 35.374 | 25.991 | 18.736 | 12.655 | 87.389 |
| $n_{20}$ | 1.9274523 | 1.9063465 | 1.8018968 | 1.7494498 | 2.1171648 |
| $k_{20}$ | 1.4642575 | 0.6506745 | 0.4300566 | 0.3311673 | 1.3140425 |
| $d_{20}$ (nm) | 17.251 | 73.686 | 139.851 | 205.772 | 13.979 |

| | | 8-01 | 8-02 | 8-03 | 8-04 | 8-05 |
|---|---|---|---|---|---|---|
| When $n_1 \geq n_{10}$, | $n_{1m} =$ | 0.0785156 | 0.0867322 | 0.0972815 | 0.1243994 | 0.0679163 |
| When $n_1 < n_{10}$, | $n_{1m} =$ | 0.0545728 | 0.0619702 | 0.0719873 | 0.0956885 | 0.0326843 |
| When $k_1 \geq k_{10}$, | $k_{1m} =$ | 0.0474365 | 0.0710938 | 0.0861206 | 0.1128003 | 0.0573657 |
| When $k_1 < k_{10}$, | $k_{1m} =$ | 0.0515906 | 0.0859790 | 0.0958850 | 0.1105115 | 0.0462488 |
| When $d_1 \geq d_{10}$, | $d_{1m}$ (nm) $=$ | 5.195 | 7.048 | 7.475 | 6.554 | 6.786 |
| When $d_1 < d_{10}$, | $d_{1m}$ (nm) $=$ | 4.054 | 4.401 | 4.771 | 4.433 | 3.439 |
| When $n_2 \geq n_{20}$, | $n_{2m} =$ | 0.3717346 | 0.2089124 | 0.1658667 | 0.1550732 | 0.3935315 |
| When $n_2 < n_{20}$, | $n_{2m} =$ | 0.2566504 | 0.2226855 | 0.1899609 | 0.1803442 | 0.3930750 |
| When $k_2 \geq k_{20}$, | $k_{2m} =$ | 0.3327271 | 0.2900549 | 0.1962512 | 0.1555261 | 0.4058423 |
| When $k_2 < k_{20}$, | $k_{2m} =$ | 0.2814465 | 0.1644043 | 0.1285254 | 0.1140686 | 0.2980408 |
| When $d_2 \geq d_{20}$, | $d_{2m}$ (nm) $=$ | 7.242 | ∞ | ∞ | ∞ | 4.246 |
| When $d_2 < d_{20}$, | $d_{2m}$ (nm) $=$ | 5.453 | 18.064 | 63.635 | 86.244 | 4.110 |

$0.93 \leq NA \leq 1.0$
$75 < T \leq 85$

| Case | 8-06 | 8-07 | 8-08 | 8-09 | 8-10 |
|---|---|---|---|---|---|
| $n_{10}$ | 1.7950810 | 1.7627960 | 1.7313791 | 1.7608801 | 1.7394221 |
| $k_{10}$ | 0.1221034 | 0.1022278 | 0.0877850 | 0.1266208 | 0.0996664 |
| $d_{10}$ (nm) | 88.670 | 88.862 | 88.999 | 153.509 | 155.305 |
| $n_{20}$ | 1.9787137 | 1.8048095 | 1.6945552 | 1.9275665 | 1.8479873 |
| $k_{20}$ | 0.5126318 | 0.3274205 | 0.2478313 | 0.9887124 | 0.4176577 |
| $d_{20}$ (nm) | 67.257 | 133.479 | 202.902 | 15.987 | 72.839 |

| | | 8-06 | 8-07 | 8-08 | 8-09 | 8-10 |
|---|---|---|---|---|---|---|
| When $n_1 \geq n_{10}$, | $n_{1m} =$ | 0.0661450 | 0.0654504 | 0.0644836 | 0.0595581 | 0.0618579 |
| When $n_1 < n_{10}$, | $n_{1m} =$ | 0.0313049 | 0.0305920 | 0.0369946 | 0.0131787 | 0.0145801 |
| When $k_1 \geq k_{10}$, | $k_{1m} =$ | 0.0629285 | 0.0615845 | 0.0676172 | 0.0466980 | 0.0504663 |
| When $k_1 < k_{10}$, | $k_{1m} =$ | 0.0495715 | 0.0531104 | 0.0563220 | 0.0260303 | 0.0287866 |
| When $d_1 \geq d_{10}$, | $d_{1m}$ (nm) $=$ | 9.764 | 13.747 | 21.746 | 9.118 | 15.633 |
| When $d_1 < d_{10}$, | $d_{1m}$ (nm) $=$ | 4.261 | 5.184 | 8.521 | 2.425 | 3.180 |
| When $n_2 \geq n_{20}$, | $n_{2m} =$ | 0.1949426 | 0.2017102 | 0.2072998 | 0.3193018 | 0.1671875 |
| When $n_2 < n_{20}$, | $n_{2m} =$ | 0.1905188 | 0.1606116 | 0.1458716 | 0.3499829 | 0.1826196 |
| When $k_2 \geq k_{20}$, | $k_{2m} =$ | 0.2324365 | 0.2397180 | 0.1749133 | 0.1658679 | 0.1587329 |
| When $k_2 < k_{20}$, | $k_{2m} =$ | 0.1375964 | 0.1005615 | 0.0861584 | 0.2502869 | 0.1212964 |
| When $d_2 \geq d_{20}$, | $d_{2m}$ (nm) $=$ | 11.495 | ∞ | ∞ | 4.383 | 10.247 |
| When $d_2 < d_{20}$, | $d_{2m}$ (nm) $=$ | 10.836 | 22.009 | 72.908 | 4.573 | 5.928 |

$0.93 \leq NA \leq 1.0$

$75 < T \leq 85$

| Case | 8-11 | 8-12 | 8-13 | 8-14 | 8-15 |
|---|---|---|---|---|---|
| $n_{10}$ | 1.7245671 | 1.7098549 | 1.7314445 | 1.7204815 | 1.7093097 |
| $k_{10}$ | 0.0857616 | 0.0711157 | 0.1087664 | 0.0894136 | 0.0755678 |
| $d_{10}$ (nm) | 155.774 | 154.844 | 218.242 | 220.453 | 221.580 |
| $n_{20}$ | 1.7414131 | 1.6689951 | 1.7862714 | 1.7885409 | 1.7021793 |
| $k_{20}$ | 0.2835597 | 0.2212317 | 0.7962122 | 0.3769446 | 0.2655853 |
| $d_{20}$ (nm) | 136.971 | 203.148 | 18.394 | 74.763 | 137.968 |

| | | 8-11 | 8-12 | 8-13 | 8-14 | 8-15 |
|---|---|---|---|---|---|---|
| When $n_1 \geq n_{10}$, | $n_{1m} =$ | 0.0606116 | 0.0594177 | 0.0511572 | 0.0630383 | 0.0616895 |
| When $n_1 < n_{10}$, | $n_{1m} =$ | 0.0160718 | 0.0405298 | 0.0015906 | 0.0046008 | 0.0190027 |
| When $k_1 \geq k_{10}$, | $k_{1m} =$ | 0.0512000 | 0.0681555 | 0.0265222 | 0.0380334 | 0.0531970 |
| When $k_1 < k_{10}$, | $k_{1m} =$ | 0.0318042 | 0.0441748 | 0.0055811 | 0.0106726 | 0.0222839 |
| When $d_1 \geq d_{10}$, | $d_{1m}$ (nm) $=$ | 31.466 | $\infty$ | 12.528 | 43.958 | $\infty$ |
| When $d_1 < d_{10}$, | $d_{1m}$ (nm) $=$ | 4.121 | 15.106 | 0.395 | 1.266 | 6.425 |
| When $n_2 \geq n_{20}$, | $n_{2m} =$ | 0.2472620 | 0.2537585 | 0.2927209 | 0.1651587 | 0.3131763 |
| When $n_2 < n_{20}$, | $n_{2m} =$ | 0.1515137 | 0.1338916 | 0.0324463 | 0.1927209 | 0.1573535 |
| When $k_2 \geq k_{20}$, | $k_{2m} =$ | 0.1857507 | 0.1391650 | 0.0225110 | 0.0800281 | 0.1575110 |
| When $k_2 < k_{20}$, | $k_{2m} =$ | 0.0929626 | 0.0771277 | 0.2211072 | 0.1242517 | 0.0780078 |
| When $d_2 \geq d_{20}$, | $d_{2m}$ (nm) $=$ | $\infty$ | $\infty$ | 5.339 | 11.602 | $\infty$ |
| When $d_2 < d_{20}$, | $d_{2m}$ (nm) $=$ | 20.462 | 30.027 | 0.679 | 1.920 | 20.783 |

$0.93 \leq NA \leq 1.0$

$75 < T \leq 85$

| Case | 8-16 |
|---|---|
| $n_{10}$ | 1.7029357 |
| $k_{10}$ | 0.0634027 |
| $d_{10}$ (nm) | 218.717 |
| $n_{20}$ | 1.6626290 |
| $k_{20}$ | 0.2083407 |
| $d_{20}$ (nm) | 201.624 |

| | | 8-16 |
|---|---|---|
| When $n_1 \geq n_{10}$, | $n_{1m} =$ | 0.0636414 |
| When $n_1 < n_{10}$, | $n_{1m} =$ | 0.0583008 |
| When $k_1 \geq k_{10}$, | $k_{1m} =$ | 0.0748706 |
| When $k_1 < k_{10}$, | $k_{1m} =$ | 0.0393835 |
| When $d_1 \geq d_{10}$, | $d_{1m}$ (nm) $=$ | $\infty$ |
| When $d_1 < d_{10}$, | $d_{1m}$ (nm) $=$ | 77.927 |
| When $n_2 \geq n_{20}$, | $n_{2m} =$ | 0.2855005 |
| When $n_2 < n_{20}$, | $n_{2m} =$ | 0.1457190 |
| When $k_2 \geq k_{20}$, | $k_{2m} =$ | 0.1308728 |
| When $k_2 < k_{20}$, | $k_{2m} =$ | 0.0761951 |
| When $d_2 \geq d_{20}$, | $d_{2m}$ (nm) $=$ | $\infty$ |
| When $d_2 < d_{20}$, | $d_{2m}$ (nm) $=$ | 30.691 |

$0.93 \leq NA \leq 1.0$

$85 < T \leq 95$

| Case | 9-01 | 9-02 | 9-03 | 9-04 | 9-05 |
|---|---|---|---|---|---|
| $n_{10}$ | 1.7289685 | 1.8452520 | 1.8988873 | 1.8877112 | 1.9267904 |
| $k_{10}$ | 0.3314086 | 0.2255929 | 0.1475831 | 0.1535471 | 0.0947520 |
| $d_{10}$ (nm) | 44.247 | 26.855 | 20.944 | 19.669 | 15.612 |
| $n_{20}$ | 5.1412592 | 1.9037614 | 1.8997324 | 1.8220692 | 1.8437835 |
| $k_{20}$ | 5.4454539 | 0.7221490 | 0.4893775 | 0.4687151 | 0.3693724 |
| $d_{20}$ (nm) | 1.484 | 66.898 | 122.094 | 129.650 | 183.529 |

| | | 9-01 | 9-02 | 9-03 | 9-04 | 9-05 |
|---|---|---|---|---|---|---|
| When $n_1 \geq n_{10}$, | $n_{1m} =$ | 0.0720642 | 0.0846375 | 0.0908557 | 0.0941199 | 0.1057788 |
| When $n_1 < n_{10}$, | $n_{1m} =$ | 0.0586633 | 0.0599194 | 0.0695422 | 0.0700256 | 0.0833301 |
| When $k_1 \geq k_{10}$, | $k_{1m} =$ | 0.0476758 | 0.0671912 | 0.0784241 | 0.0821533 | 0.0936853 |
| When $k_1 < k_{10}$, | $k_{1m} =$ | 0.0453955 | 0.0846301 | 0.0932227 | 0.0950391 | 0.0947520 |
| When $d_1 \geq d_{10}$, | $d_{1m}$ (nm) $=$ | 4.793 | 6.632 | 6.977 | 7.158 | 6.784 |
| When $d_1 < d_{10}$, | $d_{1m}$ (nm) $=$ | 4.550 | 4.181 | 4.538 | 4.591 | 4.595 |
| When $n_2 \geq n_{20}$, | $n_{2m} =$ | 1.1337476 | 0.2089880 | 0.1771472 | 0.1681067 | 0.1597327 |
| When $n_2 < n_{20}$, | $n_{2m} =$ | 1.1352368 | 0.2210583 | 0.1914734 | 0.1898022 | 0.1792920 |
| When $k_2 \geq k_{20}$, | $k_{2m} =$ | 0.8630298 | 0.2922070 | 0.2387195 | 0.2089600 | 0.1845532 |
| When $k_2 < k_{20}$, | $k_{2m} =$ | 1.0641260 | 0.1706519 | 0.1365454 | 0.1328516 | 0.1184924 |
| When $d_2 \geq d_{20}$, | $d_{2m}$ (nm) $=$ | 0.527 | $\infty$ | $\infty$ | $\infty$ | $\infty$ |
| When $d_2 < d_{20}$, | $d_{2m}$ (nm) $=$ | 0.379 | 14.827 | 35.595 | 55.475 | 73.593 |

$0.93 \leq NA \leq 1.0$

$85 < T \leq 95$

| Case | 9-06 | 9-07 | 9-08 | 9-09 | 9-10 |
|---|---|---|---|---|---|
| $n_{10}$ | 1.9311024 | 1.9377300 | 1.8321358 | 1.8340055 | 1.7711711 |
| $k_{10}$ | 0.1132645 | 0.0882760 | 0.1783607 | 0.1409526 | 0.1059247 |
| $d_{10}$ (nm) | 13.318 | 11.094 | 92.959 | 90.549 | 89.053 |
| $n_{20}$ | 1.7624681 | 1.7478213 | 3.8484718 | 2.7003837 | 1.8505388 |
| $k_{20}$ | 0.3523973 | 0.2927773 | 3.7040697 | 0.6754163 | 0.3612112 |
| $d_{20}$ (nm) | 195.472 | 252.908 | 2.442 | 40.010 | 121.432 |

| | | 9-06 | 9-07 | 9-08 | 9-09 | 9-10 |
|---|---|---|---|---|---|---|
| When $n_1 \geq n_{10}$, | $n_{1m} =$ | 0.1192212 | 0.1370740 | 0.0646143 | 0.0640906 | 0.0642236 |
| When $n_1 < n_{10}$, | $n_{1m} =$ | 0.0917322 | 0.1105750 | 0.0342749 | 0.0314893 | 0.0302832 |
| When $k_1 \geq k_{10}$, | $k_{1m} =$ | 0.1074902 | 0.1261145 | 0.0537451 | 0.0578040 | 0.0599036 |
| When $k_1 < k_{10}$, | $k_{1m} =$ | 0.1132645 | 0.0882760 | 0.0424707 | 0.0518921 | 0.0535962 |
| When $d_1 \geq d_{10}$, | $d_{1m}$ (nm) $=$ | 6.457 | 6.373 | 6.914 | 7.622 | 12.267 |
| When $d_1 < d_{10}$, | $d_{1m}$ (nm) $=$ | 4.357 | 4.610 | 3.684 | 3.553 | 4.848 |
| When $n_2 \geq n_{20}$, | $n_{2m} =$ | 0.1546643 | 0.1575439 | 0.8768713 | 0.1918994 | 0.1964832 |
| When $n_2 < n_{20}$, | $n_{2m} =$ | 0.1796094 | 0.1753381 | 0.8006409 | 0.2240674 | 0.1600745 |
| When $k_2 \geq k_{20}$, | $k_{2m} =$ | 0.1600171 | 0.1481116 | 0.9241052 | 0.2582642 | 0.2396375 |
| When $k_2 < k_{20}$, | $k_{2m} =$ | 0.1162842 | 0.1079150 | 0.8229163 | 0.1769763 | 0.1063232 |
| When $d_2 \geq d_{20}$, | $d_{2m}$ (nm) $=$ | $\infty$ | $\infty$ | 0.854 | 4.088 | $\infty$ |
| When $d_2 < d_{20}$, | $d_{2m}$ (nm) $=$ | 79.416 | 123.401 | 0.636 | 4.130 | 18.235 |

０．９３≤ＮＡ≤１．０
８５＜Ｔ≤９５

| Case | 9-11 | 9-12 | 9-13 | 9-14 | 9-15 |
|---|---|---|---|---|---|
| $n_{10}$ | 1.7360863 | 1.7197908 | 1.7660895 | 1.7439719 | 1.7279356 |
| $k_{10}$ | 0.0911204 | 0.0799131 | 0.1278221 | 0.1032091 | 0.0888807 |
| $d_{10}$ (nm) | 88.900 | 88.028 | 159.319 | 156.425 | 155.640 |
| $n_{20}$ | 1.7067614 | 1.6618119 | 4.3535883 | 1.9650733 | 1.7635448 |
| $k_{20}$ | 0.2637604 | 0.2120965 | 4.0919379 | 0.4980866 | 0.3088945 |
| $d_{20}$ (nm) | 192.941 | 257.777 | 1.526 | 59.654 | 126.749 |

| | | 9-11 | 9-12 | 9-13 | 9-14 | 9-15 |
|---|---|---|---|---|---|---|
| When $n_1 \geq n_{10}$, | $n_{1m} =$ | 0.0638330 | 0.0656592 | 0.0584094 | 0.0605725 | 0.0597937 |
| When $n_1 < n_{10}$, | $n_{1m} =$ | 0.0350525 | 0.0511377 | 0.0141675 | 0.0144019 | 0.0151697 |
| When $k_1 \geq k_{10}$, | $k_{1m} =$ | 0.0655725 | 0.0796582 | 0.0444238 | 0.0479309 | 0.0488806 |
| When $k_1 < k_{10}$, | $k_{1m} =$ | 0.0571082 | 0.0562439 | 0.0291333 | 0.0298792 | 0.0316455 |
| When $d_1 \geq d_{10}$, | $d_{1m}$ (nm) $=$ | 20.203 | 29.484 | 8.864 | 13.240 | 29.427 |
| When $d_1 < d_{10}$, | $d_{1m}$ (nm) $=$ | 7.546 | 13.995 | 2.626 | 3.070 | 3.728 |
| When $n_2 \geq n_{20}$, | $n_{2m} =$ | 0.2021118 | 0.1991125 | 0.8787561 | 0.1681836 | 0.2119507 |
| When $n_2 < n_{20}$, | $n_{2m} =$ | 0.1462866 | 0.1442920 | 0.9231299 | 0.1869897 | 0.1520459 |
| When $k_2 \geq k_{20}$, | $k_{2m} =$ | 0.1808130 | 0.1431189 | 0.6934375 | 0.1601843 | 0.1789355 |
| When $k_2 < k_{20}$, | $k_{2m} =$ | 0.0887085 | 0.0763562 | 1.0372803 | 0.1399158 | 0.0974194 |
| When $d_2 \geq d_{20}$, | $d_{2m}$ (nm) $=$ | $\infty$ | $\infty$ | 0.372 | 7.404 | $\infty$ |
| When $d_2 < d_{20}$, | $d_{2m}$ (nm) $=$ | 33.573 | 81.452 | 0.412 | 5.841 | 17.631 |

０．９３≤ＮＡ≤１．０
８５＜Ｔ≤９５

| Case | 9-16 | 9-17 | 9-18 | 9-19 | 9-20 |
|---|---|---|---|---|---|
| $n_{10}$ | 1.7114085 | 1.7070625 | 1.7347333 | 1.7230132 | 1.7111302 |
| $k_{10}$ | 0.0740744 | 0.0641745 | 0.1100034 | 0.0920219 | 0.0786417 |
| $d_{10}$ (nm) | 154.740 | 153.245 | 225.621 | 220.898 | 221.002 |
| $n_{20}$ | 1.6716288 | 1.6634512 | 4.2666617 | 1.8597675 | 1.7127614 |
| $k_{20}$ | 0.2338686 | 0.1921909 | 4.0109081 | 0.4430799 | 0.2870105 |
| $d_{20}$ (nm) | 194.347 | 254.410 | 1.346 | 63.229 | 128.848 |

| | | 9-16 | 9-17 | 9-18 | 9-19 | 9-20 |
|---|---|---|---|---|---|---|
| When $n_1 \geq n_{10}$, | $n_{1m} =$ | 0.0584460 | 0.0617004 | 0.0476050 | 0.0625842 | 0.0612109 |
| When $n_1 < n_{10}$, | $n_{1m} =$ | 0.0344641 | 0.0580713 | 0.0023816 | 0.0042908 | 0.0142651 |
| When $k_1 \geq k_{10}$, | $k_{1m} =$ | 0.0648608 | 0.0822974 | 0.0260010 | 0.0346094 | 0.0487000 |
| When $k_1 < k_{10}$, | $k_{1m} =$ | 0.0443103 | 0.0454309 | 0.0085535 | 0.0110950 | 0.0198962 |
| When $d_1 \geq d_{10}$, | $d_{1m}$ (nm) $=$ | $\infty$ | $\infty$ | 11.896 | 40.249 | $\infty$ |
| When $d_1 < d_{10}$, | $d_{1m}$ (nm) $=$ | 12.619 | 28.388 | 0.607 | 1.162 | 4.464 |
| When $n_2 \geq n_{20}$, | $n_{2m} =$ | 0.2496582 | 0.2459351 | 0.6243091 | 0.1726245 | 0.1878369 |
| When $n_2 < n_{20}$, | $n_{2m} =$ | 0.1333875 | 0.1351294 | 0.9687061 | 0.0992944 | 0.1569519 |
| When $k_2 \geq k_{20}$, | $k_{2m} =$ | 0.1378833 | 0.1234607 | 0.1299146 | 0.0597583 | 0.1385217 |
| When $k_2 < k_{20}$, | $k_{2m} =$ | 0.0791492 | 0.0682422 | 1.1651697 | 0.1405090 | 0.0853906 |
| When $d_2 \geq d_{20}$, | $d_{2m}$ (nm) $=$ | $\infty$ | $\infty$ | 0.085 | 8.765 | $\infty$ |
| When $d_2 < d_{20}$, | $d_{2m}$ (nm) $=$ | 27.415 | 76.157 | 0.398 | 1.778 | 18.221 |

0. 9 3 ≤ N A ≤ 1. 0
8 5 < T ≤ 9 5

| Case | 9-21 | 9-22 | 9-23 |
|---|---|---|---|
| $n_{10}$ | 1.7035342 | 1.7027484 | 1.7001226 |
| $k_{10}$ | 0.0659797 | 0.0572097 | 0.0542621 |
| $d_{10}$ (nm) | 218.617 | 216.627 | 277.695 |
| $n_{20}$ | 1.6615801 | 1.6695991 | 1.6762439 |
| $k_{20}$ | 0.2195726 | 0.1821496 | 0.1770375 |
| $d_{20}$ (nm) | 193.289 | 251.116 | 248.521 |

| | | 9-21 | 9-22 | 9-23 |
|---|---|---|---|---|
| When $n_1 \geq n_{10}$, | $n_{1m}=$ | 0.0623376 | 0.0678125 | 0.0799658 |
| When $n_1 < n_{10}$, | $n_{1m}=$ | 0.0535010 | 0.0686682 | 0.1014282 |
| When $k_1 \geq k_{10}$, | $k_{1m}=$ | 0.0710327 | 0.0861914 | 0.0881311 |
| When $k_1 < k_{10}$, | $k_{1m}=$ | 0.0393738 | 0.0410693 | 0.0390344 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 76.543 | 86.880 | 145.024 |
| When $n_2 \geq n_{20}$, | $n_{2m}=$ | 0.2919910 | 0.2682678 | 0.2949561 |
| When $n_2 < n_{20}$, | $n_{2m}=$ | 0.1427539 | 0.1485803 | 0.2037488 |
| When $k_2 \geq k_{20}$, | $k_{2m}=$ | 0.1267480 | 0.1253760 | 0.1874854 |
| When $k_2 < k_{20}$, | $k_{2m}=$ | 0.0781458 | 0.0670801 | 0.0719922 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 27.736 | 75.187 | 78.004 |

0. 9 3 ≤ N A ≤ 1. 0
9 5 < T ≤ 1 0 5

| Case | 10-01 | 10-02 | 10-03 | 10-04 | 10-05 |
|---|---|---|---|---|---|
| $n_{10}$ | 1.8593145 | 1.9010800 | 1.9204218 | 1.9438629 | 1.8201241 |
| $k_{10}$ | 0.2496127 | 0.1636004 | 0.1149718 | 0.1088618 | 0.1437532 |
| $d_{10}$ (nm) | 26.535 | 19.815 | 15.218 | 10.610 | 89.353 |
| $n_{20}$ | 1.9155767 | 1.8411706 | 1.7975616 | 1.7190727 | 2.3681639 |
| $k_{20}$ | 0.8329906 | 0.5121692 | 0.3794158 | 0.2999844 | 0.7410526 |
| $d_{20}$ (nm) | 59.684 | 120.535 | 182.059 | 250.015 | 43.212 |

| | | 10-01 | 10-02 | 10-03 | 10-04 | 10-05 |
|---|---|---|---|---|---|---|
| When $n_1 \geq n_{10}$, | $n_{1m}=$ | 0.0816284 | 0.0922021 | 0.1074707 | 0.1413159 | 0.0582056 |
| When $n_1 < n_{10}$, | $n_{1m}=$ | 0.0571204 | 0.0681042 | 0.0820581 | 0.1125684 | 0.0261719 |
| When $k_1 \geq k_{10}$, | $k_{1m}=$ | 0.0635767 | 0.0796045 | 0.0956897 | 0.1313098 | 0.0522705 |
| When $k_1 < k_{10}$, | $k_{1m}=$ | 0.0810986 | 0.0930249 | 0.1101465 | 0.1088618 | 0.0503638 |
| When $d_1 \geq d_{10}$, | $d_{1m}$ (nm) $=$ | 5.728 | 6.581 | 6.674 | 6.005 | 7.527 |
| When $d_1 < d_{10}$, | $d_{1m}$ (nm) $=$ | 3.587 | 4.159 | 4.431 | 4.306 | 3.047 |
| When $n_2 \geq n_{20}$, | $n_{2m}=$ | 0.2110999 | 0.1699976 | 0.1589343 | 0.1579346 | 0.2155920 |
| When $n_2 < n_{20}$, | $n_{2m}=$ | 0.2273865 | 0.1928259 | 0.1800378 | 0.1714307 | 0.2110571 |
| When $k_2 \geq k_{20}$, | $k_{2m}=$ | 0.3068860 | 0.2171289 | 0.1741077 | 0.1426062 | 0.2751843 |
| When $k_2 < k_{20}$, | $k_{2m}=$ | 0.1756396 | 0.1352295 | 0.1186548 | 0.1082129 | 0.1794531 |
| When $d_2 \geq d_{20}$, | $d_{2m}$ (nm) $=$ | ∞ | ∞ | ∞ | ∞ | 5.764 |
| When $d_2 < d_{20}$, | $d_{2m}$ (nm) $=$ | 12.732 | 34.057 | 73.872 | 121.675 | 5.150 |

$0. 93 \leq NA \leq 1. 0$

$95 < T \leq 105$

| Case | 10-06 | 10-07 | 10-08 | 10-09 | 10-10 |
|---|---|---|---|---|---|
| $n_{10}$ | 1.7719135 | 1.7372876 | 1.7204595 | 1.7445424 | 1.7286821 |
| $k_{10}$ | 0.1119845 | 0.0953951 | 0.0830085 | 0.1106490 | 0.0936244 |
| $d_{10}$ (nm) | 88.526 | 88.555 | 87.798 | 155.347 | 154.936 |
| $n_{20}$ | 1.8420973 | 1.7021944 | 1.6574450 | 1.9643384 | 1.7602486 |
| $k_{20}$ | 0.3885265 | 0.2779787 | 0.2209480 | 0.5665503 | 0.3317476 |
| $d_{20}$ (nm) | 115.256 | 185.353 | 249.744 | 53.939 | 119.649 |

| | | 10-06 | 10-07 | 10-08 | 10-09 | 10-10 |
|---|---|---|---|---|---|---|
| When $n_1 \geq n_{10}$, | $n_{1m} =$ | 0.0621143 | 0.0621887 | 0.0641711 | 0.0553430 | 0.0576575 |
| When $n_1 < n_{10}$, | $n_{1m} =$ | 0.0270313 | 0.0323645 | 0.0489441 | 0.0092163 | 0.0110840 |
| When $k_1 \geq k_{10}$, | $k_{1m} =$ | 0.0562158 | 0.0627490 | 0.0779517 | 0.0376074 | 0.0417603 |
| When $k_1 < k_{10}$, | $k_{1m} =$ | 0.0520581 | 0.0564075 | 0.0555945 | 0.0251758 | 0.0276855 |
| When $d_1 \geq d_{10}$, | $d_{1m}$ (nm) $=$ | 11.132 | 18.518 | 24.475 | 10.852 | 25.311 |
| When $d_1 < d_{10}$, | $d_{1m}$ (nm) $=$ | 4.165 | 6.637 | 12.657 | 1.885 | 2.611 |
| When $n_2 \geq n_{20}$, | $n_{2m} =$ | 0.1959729 | 0.2028772 | 0.1967151 | 0.1949902 | 0.2380078 |
| When $n_2 < n_{20}$, | $n_{2m} =$ | 0.1629126 | 0.1469397 | 0.1441541 | 0.1889697 | 0.1549414 |
| When $k_2 \geq k_{20}$, | $k_{2m} =$ | 0.2347974 | 0.1750098 | 0.1399744 | 0.1001758 | 0.1456445 |
| When $k_2 < k_{20}$, | $k_{2m} =$ | 0.1074329 | 0.0897974 | 0.0774023 | 0.1436816 | 0.0981848 |
| When $d_2 \geq d_{20}$, | $d_{2m}$ (nm) $=$ | ∞ | ∞ | ∞ | 7.077 | ∞ |
| When $d_2 < d_{20}$, | $d_{2m}$ (nm) $=$ | 17.579 | 32.188 | 79.555 | 4.014 | 9.652 |

$0. 93 \leq NA \leq 1. 0$

$95 < T \leq 105$

| Case | 10-11 | 10-12 | 10-13 | 10-14 | 10-15 |
|---|---|---|---|---|---|
| $n_{10}$ | 1.7117780 | 1.7072616 | 1.7114074 | 1.7035514 | 1.7027912 |
| $k_{10}$ | 0.0773392 | 0.0664543 | 0.0830146 | 0.0688006 | 0.0591414 |
| $d_{10}$ (nm) | 154.355 | 152.987 | 220.011 | 218.183 | 216.340 |
| $n_{20}$ | 1.6664488 | 1.6597858 | 1.7075466 | 1.6565327 | 1.6669294 |
| $k_{20}$ | 0.2460450 | 0.2000883 | 0.3068810 | 0.2307053 | 0.1896158 |
| $d_{20}$ (nm) | 186.501 | 246.239 | 121.613 | 185.316 | 242.803 |

| | | 10-11 | 10-12 | 10-13 | 10-14 | 10-15 |
|---|---|---|---|---|---|---|
| When $n_1 \geq n_{10}$, | $n_{1m} =$ | 0.0563684 | 0.0596582 | 0.0593091 | 0.0598755 | 0.0652673 |
| When $n_1 < n_{10}$, | $n_{1m} =$ | 0.0298474 | 0.0556995 | 0.0074023 | 0.0481897 | 0.0654077 |
| When $k_1 \geq k_{10}$, | $k_{1m} =$ | 0.0607349 | 0.0799170 | 0.0390686 | 0.0670154 | 0.0838220 |
| When $k_1 < k_{10}$, | $k_{1m} =$ | 0.0430676 | 0.0448303 | 0.0134863 | 0.0384473 | 0.0405530 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 9.756 | 23.688 | 2.192 | 28.661 | 83.384 |
| When $n_2 \geq n_{20}$, | $n_{2m} =$ | 0.2552490 | 0.2502368 | 0.2301306 | 0.3057727 | 0.2764221 |
| When $n_2 < n_{20}$, | $n_{2m} =$ | 0.1325989 | 0.1345728 | 0.1592334 | 0.1419543 | 0.1480603 |
| When $k_2 \geq k_{20}$, | $k_{2m} =$ | 0.1285986 | 0.1190894 | 0.0974548 | 0.1182935 | 0.1218213 |
| When $k_2 < k_{20}$, | $k_{2m} =$ | 0.0799036 | 0.0691528 | 0.0735474 | 0.0793201 | 0.0682898 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 26.413 | 74.134 | 17.074 | 26.587 | 73.152 |

$0.93 \leq NA \leq 1.0$

$105 < T \leq 115$

| Case | 11-01 | 11-02 | 11-03 | 11-04 | 11-05 |
|---|---|---|---|---|---|
| $n_{10}$ | 1.8881577 | 1.9218914 | 1.9458883 | 1.9409291 | 1.7882093 |
| $k_{10}$ | 0.2795127 | 0.1797398 | 0.1322078 | 0.1179060 | 0.1515662 |
| $d_{10}$ (nm) | 22.871 | 17.442 | 13.080 | 10.849 | 85.800 |
| $n_{20}$ | 1.7550786 | 1.7746647 | 1.7478516 | 1.7108849 | 1.7933752 |
| $k_{20}$ | 0.8705815 | 0.5227186 | 0.3833699 | 0.3088835 | 0.6703287 |
| $d_{20}$ (nm) | 60.032 | 119.813 | 181.809 | 241.776 | 55.966 |

| | | 11-01 | 11-02 | 11-03 | 11-04 | 11-05 |
|---|---|---|---|---|---|---|
| When $n_1 \geq n_{10}$, | $n_{1m} =$ | 0.0826208 | 0.0977563 | 0.1186780 | 0.1376917 | 0.0543359 |
| When $n_1 < n_{10}$, | $n_{1m} =$ | 0.0520789 | 0.0682861 | 0.0872974 | 0.1088391 | 0.0162500 |
| When $k_1 \geq k_{10}$, | $k_{1m} =$ | 0.0630823 | 0.0841675 | 0.1052368 | 0.1278345 | 0.0453015 |
| When $k_1 < k_{10}$, | $k_{1m} =$ | 0.0771240 | 0.0966394 | 0.1209399 | 0.1179060 | 0.0399414 |
| When $d_1 \geq d_{10}$, | $d_{1m}$ (nm) $=$ | 4.844 | 5.864 | 5.837 | 5.925 | 7.044 |
| When $d_1 < d_{10}$, | $d_{1m}$ (nm) $=$ | 2.746 | 3.528 | 3.770 | 4.232 | 1.998 |
| When $n_2 \geq n_{20}$, | $n_{2m} =$ | 0.1779102 | 0.1610864 | 0.1553113 | 0.1599890 | 0.1976709 |
| When $n_2 < n_{20}$, | $n_{2m} =$ | 0.2409973 | 0.1978687 | 0.1825439 | 0.1715320 | 0.2140332 |
| When $k_2 \geq k_{20}$, | $k_{2m} =$ | 0.2513745 | 0.1848108 | 0.1557214 | 0.1414282 | 0.1190186 |
| When $k_2 < k_{20}$, | $k_{2m} =$ | 0.1529724 | 0.1289783 | 0.1162878 | 0.1089014 | 0.1251477 |
| When $d_2 \geq d_{20}$, | $d_{2m}$ (nm) $=$ | $\infty$ | $\infty$ | $\infty$ | $\infty$ | 22.520 |
| When $d_2 < d_{20}$, | $d_{2m}$ (nm) $=$ | 14.459 | 47.581 | 76.951 | 118.169 | 7.215 |

$0.93 \leq NA \leq 1.0$

$105 < T \leq 115$

| Case | 11-06 | 11-07 | 11-08 | 11-09 | 11-10 |
|---|---|---|---|---|---|
| $n_{10}$ | 1.7649059 | 1.7337710 | 1.7199633 | 1.7259527 | 1.7103936 |
| $k_{10}$ | 0.1193411 | 0.0996522 | 0.0855558 | 0.0989978 | 0.0800216 |
| $d_{10}$ (nm) | 87.339 | 88.039 | 87.477 | 153.714 | 153.726 |
| $n_{20}$ | 1.7745734 | 1.6760618 | 1.6497564 | 1.7204930 | 1.6497935 |
| $k_{20}$ | 0.3964773 | 0.2847568 | 0.2267213 | 0.3415865 | 0.2528816 |
| $d_{20}$ (nm) | 113.800 | 179.842 | 241.489 | 115.571 | 179.482 |

| | | 11-06 | 11-07 | 11-08 | 11-09 | 11-10 |
|---|---|---|---|---|---|---|
| When $n_1 \geq n_{10}$, | $n_{1m} =$ | 0.0601648 | 0.0599890 | 0.0628394 | 0.0551172 | 0.0538281 |
| When $n_1 < n_{10}$, | $n_{1m} =$ | 0.0211145 | 0.0296448 | 0.0487646 | 0.0042871 | 0.0282654 |
| When $k_1 \geq k_{10}$, | $k_{1m} =$ | 0.0504663 | 0.0599475 | 0.0772742 | 0.0278052 | 0.0572974 |
| When $k_1 < k_{10}$, | $k_{1m} =$ | 0.0475183 | 0.0544922 | 0.0541711 | 0.0166541 | 0.0416528 |
| When $d_1 \geq d_{10}$, | $d_{1m}$ (nm) $=$ | 10.266 | 16.506 | 22.112 | 22.094 | 29.214 |
| When $d_1 < d_{10}$, | $d_{1m}$ (nm) $=$ | 3.195 | 5.968 | 12.188 | 0.978 | 9.029 |
| When $n_2 \geq n_{20}$, | $n_{2m} =$ | 0.1995813 | 0.2097351 | 0.1798193 | 0.2563574 | 0.2736133 |
| When $n_2 < n_{20}$, | $n_{2m} =$ | 0.1736548 | 0.1494116 | 0.1464758 | 0.1632507 | 0.1337610 |
| When $k_2 \geq k_{20}$, | $k_{2m} =$ | 0.1791345 | 0.1568970 | 0.1341675 | 0.0805750 | 0.1130872 |
| When $k_2 < k_{20}$, | $k_{2m} =$ | 0.1012146 | 0.0889111 | 0.0780908 | 0.0849402 | 0.0789160 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 14.312 | 35.616 | 79.447 | 3.314 | 27.322 |

0. 9 3 ≤ N A ≤ 1. 0
1 0 5 < T ≤ 1 1 5

| Case | 11-11 | 11-12 | 11-13 |
|---|---|---|---|
| $n_{10}$ | 1.7070930 | 1.7028018 | 1.7027432 |
| $k_{10}$ | 0.0681638 | 0.0710148 | 0.0605235 |
| $d_{10}$ (nm) | 152.585 | 217.506 | 215.929 |
| $n_{20}$ | 1.6551703 | 1.6456663 | 1.6646615 |
| $k_{20}$ | 0.2055639 | 0.2376270 | 0.1950188 |
| $d_{20}$ (nm) | 237.501 | 177.429 | 233.713 |

| | 11-11 | 11-12 | 11-13 |
|---|---|---|---|
| When $n_1 \geq n_{10}$, $n_{1m} =$ | 0.0578955 | 0.0572009 | 0.0625354 |
| When $n_1 < n_{10}$, $n_{1m} =$ | 0.0537671 | 0.0422668 | 0.0608704 |
| When $k_1 \geq k_{10}$, $k_{1m} =$ | 0.0790588 | 0.0645129 | 0.0827734 |
| When $k_1 < k_{10}$, $k_{1m} =$ | 0.0435974 | 0.0363208 | 0.0394031 |
| When $d_1 \geq d_{10}$, $d_{1m}$ (nm) $=$ | $\infty$ | $\infty$ | $\infty$ |
| When $d_1 < d_{10}$, $d_{1m}$ (nm) $=$ | 20.858 | 18.787 | 80.567 |
| When $n_2 \geq n_{20}$, $n_{2m} =$ | 0.1279260 | 0.3212610 | 0.2872583 |
| When $n_2 < n_{20}$, $n_{2m} =$ | 0.1371912 | 0.1436340 | 0.1515588 |
| When $k_2 \geq k_{20}$, $k_{2m} =$ | 0.1138037 | 0.1091870 | 0.1188855 |
| When $k_2 < k_{20}$, $k_{2m} =$ | 0.0699854 | 0.0793604 | 0.0696228 |
| When $d_2 \geq d_{20}$, $d_{2m}$ (nm) $=$ | $\infty$ | $\infty$ | $\infty$ |
| When $d_2 < d_{20}$, $d_{2m}$ (nm) $=$ | 73.529 | 27.402 | 72.558 |

0. 9 3 ≤ N A ≤ 1. 0
1 1 5 < T ≤ 1 2 5

| Case | 12-01 | 12-02 | 12-03 | 12-04 | 12-05 |
|---|---|---|---|---|---|
| $n_{10}$ | 1.8909431 | 1.9524263 | 1.9741784 | 1.9011191 | 1.7812655 |
| $k_{10}$ | 0.3085424 | 0.1909748 | 0.1389140 | 0.1449022 | 0.1647646 |
| $d_{10}$ (nm) | 20.418 | 15.444 | 11.832 | 11.795 | 82.868 |
| $n_{20}$ | 1.5964478 | 1.7414925 | 1.7353816 | 1.6673230 | 1.6154117 |
| $k_{20}$ | 0.8353138 | 0.5288169 | 0.3892797 | 0.3043383 | 0.6141968 |
| $d_{20}$ (nm) | 60.909 | 116.361 | 176.360 | 237.538 | 58.066 |

| | 12-01 | 12-02 | 12-03 | 12-04 | 12-05 |
|---|---|---|---|---|---|
| When $n_1 \geq n_{10}$, $n_{1m} =$ | 0.0896326 | 0.1058130 | 0.1273743 | 0.1294861 | 0.0526233 |
| When $n_1 < n_{10}$, $n_{1m} =$ | 0.0482068 | 0.0693359 | 0.0898755 | 0.1018958 | 0.0089111 |
| When $k_1 \geq k_{10}$, $k_{1m} =$ | 0.0687769 | 0.0897180 | 0.1101831 | 0.1230750 | 0.0397290 |
| When $k_1 < k_{10}$, $k_{1m} =$ | 0.0788684 | 0.1029199 | 0.1292102 | 0.1244238 | 0.0264612 |
| When $d_1 \geq d_{10}$, $d_{1m}$ (nm) $=$ | 4.348 | 5.029 | 5.176 | 6.485 | 6.077 |
| When $d_1 < d_{10}$, $d_{1m}$ (nm) $=$ | 2.275 | 2.981 | 3.260 | 4.641 | 1.033 |
| When $n_2 \geq n_{20}$, $n_{2m} =$ | 0.1653235 | 0.1570801 | 0.1545581 | 0.1637158 | 0.2122083 |
| When $n_2 < n_{20}$, $n_{2m} =$ | 0.1924231 | 0.2075879 | 0.1868823 | 0.1636792 | 0.1151331 |
| When $k_2 \geq k_{20}$, $k_{2m} =$ | 0.1706042 | 0.1628406 | 0.1476868 | 0.1368591 | 0.0534973 |
| When $k_2 < k_{20}$, $k_{2m} =$ | 0.1411853 | 0.1262378 | 0.1172034 | 0.1087061 | 0.1078625 |
| When $d_2 \geq d_{20}$, $d_{2m}$ (nm) $=$ | $\infty$ | $\infty$ | $\infty$ | $\infty$ | 22.263 |
| When $d_2 < d_{20}$, $d_{2m}$ (nm) $=$ | 15.932 | 41.005 | 77.327 | 119.056 | 3.631 |

$0.93 \leq NA \leq 1.0$
$115 < T \leq 125$

| Case | 12-06 | 12-07 | 12-08 | 12-09 | 12-10 |
|---|---|---|---|---|---|
| $n_{10}$ | 1.7599364 | 1.7294022 | 1.7193592 | 1.7088052 | 1.7070991 |
| $k_{10}$ | 0.1268761 | 0.1028924 | 0.0869972 | 0.0815889 | 0.0689994 |
| $d_{10}$ (nm) | 86.158 | 87.627 | 87.259 | 153.347 | 152.325 |
| $n_{20}$ | 1.7200975 | 1.6470339 | 1.6442041 | 1.6346844 | 1.6535493 |
| $k_{20}$ | 0.3928633 | 0.2862372 | 0.2301394 | 0.2563356 | 0.2091466 |
| $d_{20}$ (nm) | 111.244 | 173.600 | 231.990 | 171.193 | 227.454 |

| | | 12-06 | 12-07 | 12-08 | 12-09 | 12-10 |
|---|---|---|---|---|---|---|
| When $n_1 \geq n_{10}$, | $n_{1m} =$ | 0.0606738 | 0.0583850 | 0.0624988 | 0.0517444 | 0.0574902 |
| When $n_1 < n_{10}$, | $n_{1m} =$ | 0.0144922 | 0.0280668 | 0.0507288 | 0.0284387 | 0.0507019 |
| When $k_1 \geq k_{10}$, | $k_{1m} =$ | 0.0425989 | 0.0573376 | 0.0776721 | 0.0554700 | 0.0798230 |
| When $k_1 < k_{10}$, | $k_{1m} =$ | 0.0406250 | 0.0512256 | 0.0527991 | 0.0388428 | 0.0424304 |
| When $d_1 \geq d_{10}$, | $d_{1m}$ (nm) $=$ | 9.315 | 15.226 | 20.570 | 23.760 | $\infty$ |
| When $d_1 < d_{10}$, | $d_{1m}$ (nm) $=$ | 2.129 | 5.657 | 12.499 | 8.630 | 19.101 |
| When $n_2 \geq n_{20}$, | $n_{2m} =$ | 0.2113904 | 0.2168030 | 0.1303113 | 0.0779236 | 0.1123853 |
| When $n_2 < n_{20}$, | $n_{2m} =$ | 0.1965198 | 0.1502832 | 0.1490173 | 0.1347925 | 0.1407104 |
| When $k_2 \geq k_{20}$, | $k_{2m} =$ | 0.1312354 | 0.1404419 | 0.1299280 | 0.1034583 | 0.1115356 |
| When $k_2 < k_{20}$, | $k_{2m} =$ | 0.0975891 | 0.0892358 | 0.0798267 | 0.0797656 | 0.0721289 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 8.212 | 56.813 | 80.756 | 28.524 | 74.263 |

$0.93 \leq NA \leq 1.0$
$115 < T \leq 125$

| Case | 12-11 | 12-12 |
|---|---|---|
| $n_{10}$ | 1.7021164 | 1.7030336 |
| $k_{10}$ | 0.0722203 | 0.0611451 |
| $d_{10}$ (nm) | 217.158 | 215.722 |
| $n_{20}$ | 1.6379690 | 1.6657846 |
| $k_{20}$ | 0.2419462 | 0.1987136 |
| $d_{20}$ (nm) | 168.107 | 223.276 |

| | | 12-11 | 12-12 |
|---|---|---|---|
| When $n_1 \geq n_{10}$, | $n_{1m} =$ | 0.0559460 | 0.0616492 |
| When $n_1 < n_{10}$, | $n_{1m} =$ | 0.0369629 | 0.0571216 |
| When $k_1 \geq k_{10}$, | $k_{1m} =$ | 0.0643591 | 0.0831226 |
| When $k_1 < k_{10}$, | $k_{1m} =$ | 0.0338867 | 0.0383716 |
| When $d_1 \geq d_{10}$, | $d_{1m}$ (nm) $=$ | $\infty$ | $\infty$ |
| When $d_1 < d_{10}$, | $d_{1m}$ (nm) $=$ | 15.623 | 78.766 |
| When $n_2 \geq n_{20}$, | $n_{2m} =$ | 0.1071765 | 0.1574146 |
| When $n_2 < n_{20}$, | $n_{2m} =$ | 0.1467676 | 0.1563452 |
| When $k_2 \geq k_{20}$, | $k_{2m} =$ | 0.1072412 | 0.1188721 |
| When $k_2 < k_{20}$, | $k_{2m} =$ | 0.0815015 | 0.0722400 |
| When $d_2 \geq d_{20}$, | $d_{2m}$ (nm) $=$ | $\infty$ | $\infty$ |
| When $d_2 < d_{20}$, | $d_{2m}$ (nm) $=$ | 28.758 | 73.194 |

$0.93 \leq NA \leq 1.0$
$125 < T \leq 135$

| Case | 13-01 | 13-02 | 13-03 | 13-04 | 13-05 |
|---|---|---|---|---|---|
| $n_{10}$ | 1.8737564 | 1.9697383 | 1.9916260 | 1.9141720 | 1.7868889 |
| $k_{10}$ | 0.3367363 | 0.2020294 | 0.1477036 | 0.1461879 | 0.1795709 |
| $d_{10}$ (nm) | 20.276 | 14.764 | 11.315 | 11.459 | 80.605 |
| $n_{20}$ | 1.5133470 | 1.7299638 | 1.7257470 | 1.6683491 | 1.5409994 |
| $k_{20}$ | 0.8454522 | 0.5429087 | 0.3987910 | 0.3122132 | 0.6011754 |
| $d_{20}$ (nm) | 55.480 | 109.268 | 168.578 | 226.037 | 53.925 |

| | | 13-01 | 13-02 | 13-03 | 13-04 | 13-05 |
|---|---|---|---|---|---|---|
| When $n_1 \geq n_{10}$, | $n_{1m} =$ | 0.0919055 | 0.1108435 | 0.1324426 | 0.1321936 | 0.0477332 |
| When $n_1 < n_{10}$, | $n_{1m} =$ | 0.0465112 | 0.0677783 | 0.0890894 | 0.1050525 | 0.0054248 |
| When $k_1 \geq k_{10}$, | $k_{1m} =$ | 0.0634827 | 0.0913306 | 0.1103125 | 0.1242993 | 0.0376343 |
| When $k_1 < k_{10}$, | $k_{1m} =$ | 0.0777942 | 0.1046863 | 0.1330994 | 0.1263855 | 0.0172180 |
| When $d_1 \geq d_{10}$, | $d_{1m}$ (nm) $=$ | 4.127 | 4.585 | 4.757 | 6.157 | 5.240 |
| When $d_1 < d_{10}$, | $d_{1m}$ (nm) $=$ | 2.100 | 2.651 | 2.937 | 4.469 | 0.576 |
| When $n_2 \geq n_{20}$, | $n_{2m} =$ | 0.1485144 | 0.1609766 | 0.1572363 | 0.1614685 | 0.1647119 |
| When $n_2 < n_{20}$, | $n_{2m} =$ | 0.1669641 | 0.2206506 | 0.1915698 | 0.1618420 | 0.0427734 |
| When $k_2 \geq k_{20}$, | $k_{2m} =$ | 0.1498572 | 0.1556653 | 0.1444165 | 0.1361792 | 0.0323462 |
| When $k_2 < k_{20}$, | $k_{2m} =$ | 0.1523499 | 0.1322424 | 0.1219958 | 0.1118262 | 0.1188306 |
| When $d_2 \geq d_{20}$, | $d_{2m}$ (nm) $=$ | ∞ | ∞ | ∞ | ∞ | 20.169 |
| When $d_2 < d_{20}$, | $d_{2m}$ (nm) $=$ | 11.040 | 31.054 | 70.606 | 112.796 | 1.698 |

$0.93 \leq NA \leq 1.0$
$125 < T \leq 135$

| Case | 13-06 | 13-07 | 13-08 | 13-09 | 13-10 |
|---|---|---|---|---|---|
| $n_{10}$ | 1.7600620 | 1.7276490 | 1.7199953 | 1.7084320 | 1.7077870 |
| $k_{10}$ | 0.1342170 | 0.1044918 | 0.0874837 | 0.0820944 | 0.0691595 |
| $d_{10}$ (nm) | 85.615 | 87.663 | 87.278 | 153.448 | 152.438 |
| $n_{20}$ | 1.6974715 | 1.6338870 | 1.6452183 | 1.6304269 | 1.6574806 |
| $k_{20}$ | 0.3980869 | 0.2915200 | 0.2346970 | 0.2625567 | 0.2137196 |
| $d_{20}$ (nm) | 104.529 | 164.129 | 221.092 | 160.685 | 216.250 |

| | | 13-06 | 13-07 | 13-08 | 13-09 | 13-10 |
|---|---|---|---|---|---|---|
| When $n_1 \geq n_{10}$, | $n_{1m} =$ | 0.0556421 | 0.0573047 | 0.0630432 | 0.0509070 | 0.0582422 |
| When $n_1 < n_{10}$, | $n_{1m} =$ | 0.0086938 | 0.0280566 | 0.0524658 | 0.0272729 | 0.0496997 |
| When $k_1 \geq k_{10}$, | $k_{1m} =$ | 0.0327625 | 0.0552051 | 0.0782056 | 0.0552515 | 0.0808813 |
| When $k_1 < k_{10}$, | $k_{1m} =$ | 0.0328357 | 0.0492957 | 0.0525903 | 0.0375085 | 0.0423645 |
| When $d_1 \geq d_{10}$, | $d_{1m}$ (nm) $=$ | 8.316 | 14.598 | 20.258 | 22.646 | ∞ |
| When $d_1 < d_{10}$, | $d_{1m}$ (nm) $=$ | 1.229 | 5.725 | 12.785 | 8.439 | 18.783 |
| When $n_2 \geq n_{20}$, | $n_{2m} =$ | 0.2312317 | 0.1156555 | 0.1151941 | 0.0670740 | 0.1089307 |
| When $n_2 < n_{20}$, | $n_{2m} =$ | 0.2128992 | 0.1481116 | 0.1498755 | 0.1344946 | 0.1425024 |
| When $k_2 \geq k_{20}$, | $k_{2m} =$ | 0.1020886 | 0.1348413 | 0.1299255 | 0.1027795 | 0.1131628 |
| When $k_2 < k_{20}$, | $k_{2m} =$ | 0.1027185 | 0.0927148 | 0.0827966 | 0.0840479 | 0.0754407 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 4.085 | 34.120 | 79.786 | 26.736 | 37.465 |

$0.93 \leq NA \leq 1.0$
$125 < T \leq 135$

| Case | 13-11 | 13-12 |
|---|---|---|
| $n_{10}$ | 1.7022055 | 1.7036940 |
| $k_{10}$ | 0.0725208 | 0.0612465 |
| $d_{10}$ (nm) | 217.368 | 215.927 |
| $n_{20}$ | 1.6389178 | 1.6705104 |
| $k_{20}$ | 0.2487144 | 0.2029113 |
| $d_{20}$ (nm) | 157.041 | 212.129 |

| | | 13-11 | 13-12 |
|---|---|---|---|
| When $n_1 \geq n_{10}$, | $n_{1m} =$ | 0.0559827 | 0.0624561 |
| When $n_1 < n_{10}$, | $n_{1m} =$ | 0.0346814 | 0.0563831 |
| When $k_1 \geq k_{10}$, | $k_{1m} =$ | 0.0655139 | 0.0838672 |
| When $k_1 < k_{10}$, | $k_{1m} =$ | 0.0329700 | 0.0384436 |
| When $d_1 \geq d_{10}$, | $d_{1m}$ (nm) $=$ | $\infty$ | $\infty$ |
| When $d_1 < d_{10}$, | $d_{1m}$ (nm) $=$ | 14.691 | 78.542 |
| When $n_2 \geq n_{20}$, | $n_{2m} =$ | 0.0987000 | 0.1459375 |
| When $n_2 < n_{20}$, | $n_{2m} =$ | 0.1477222 | 0.1585510 |
| When $k_2 \geq k_{20}$, | $k_{2m} =$ | 0.1107947 | 0.1206909 |
| When $k_2 < k_{20}$, | $k_{2m} =$ | 0.0868396 | 0.0754724 |
| When $d_2 \geq d_{20}$, | $d_{2m}$ (nm) $=$ | $\infty$ | $\infty$ |
| When $d_2 < d_{20}$, | $d_{2m}$ (nm) $=$ | 26.886 | 30.205 |

$0.93 \leq NA \leq 1.0$
$135 < T \leq 145$

| Case | 14-01 | 14-02 | 14-03 | 14-04 | 14-05 |
|---|---|---|---|---|---|
| $n_{10}$ | 1.8402862 | 1.9646387 | 1.9624104 | 1.9059084 | 1.8166660 |
| $k_{10}$ | 0.3700261 | 0.2123233 | 0.1584699 | 0.1473615 | 0.1977639 |
| $d_{10}$ (nm) | 23.403 | 16.447 | 12.893 | 12.089 | 79.798 |
| $n_{20}$ | 1.4966418 | 1.7618069 | 1.7211612 | 1.6694213 | 1.5572201 |
| $k_{20}$ | 1.0039549 | 0.5971846 | 0.4176484 | 0.3203376 | 0.7204992 |
| $d_{20}$ (nm) | 41.463 | 94.995 | 156.173 | 216.011 | 40.224 |

| | | 14-01 | 14-02 | 14-03 | 14-04 | 14-05 |
|---|---|---|---|---|---|---|
| When $n_1 \geq n_{10}$, | $n_{1m} =$ | 0.0906067 | 0.1022083 | 0.1191650 | 0.1272498 | 0.0481567 |
| When $n_1 < n_{10}$, | $n_{1m} =$ | 0.0460486 | 0.0622925 | 0.0801978 | 0.1004968 | 0.0053052 |
| When $k_1 \geq k_{10}$, | $k_{1m} =$ | 0.0548682 | 0.0821582 | 0.0987952 | 0.1188953 | 0.0360181 |
| When $k_1 < k_{10}$, | $k_{1m} =$ | 0.0585999 | 0.0953162 | 0.1207214 | 0.1220581 | 0.0169287 |
| When $d_1 \geq d_{10}$, | $d_{1m}$ (nm) $=$ | 4.196 | 4.611 | 5.209 | 6.343 | 4.539 |
| When $d_1 < d_{10}$, | $d_{1m}$ (nm) $=$ | 2.216 | 2.591 | 3.134 | 4.582 | 0.509 |
| When $n_2 \geq n_{20}$, | $n_{2m} =$ | 0.1766626 | 0.1806128 | 0.1668896 | 0.1603455 | 0.2142871 |
| When $n_2 < n_{20}$, | $n_{2m} =$ | 0.1712292 | 0.2330798 | 0.1905432 | 0.1645447 | 0.0564514 |
| When $k_2 \geq k_{20}$, | $k_{2m} =$ | 0.2110498 | 0.1844238 | 0.1540930 | 0.1380908 | 0.0433691 |
| When $k_2 < k_{20}$, | $k_{2m} =$ | 0.1916614 | 0.1446765 | 0.1279346 | 0.1140405 | 0.1534607 |
| When $d_2 \geq d_{20}$, | $d_{2m}$ (nm) $=$ | $\infty$ | $\infty$ | $\infty$ | $\infty$ | 18.289 |
| When $d_2 < d_{20}$, | $d_{2m}$ (nm) $=$ | 8.143 | 21.467 | 66.145 | 96.079 | 1.264 |

0. 93 ≤ N A ≤ 1. 0
1 3 5 < T ≤ 1 4 5

| Case | 14-06 | 14-07 | 14-08 | 14-09 | 14-10 |
|---|---|---|---|---|---|
| $n_{10}$ | 1.7655719 | 1.7293285 | 1.7214396 | 1.7092770 | 1.7085071 |
| $k_{10}$ | 0.1384976 | 0.1055583 | 0.0882507 | 0.0826318 | 0.0697446 |
| $d_{10}$ (nm) | 86.596 | 87.952 | 87.451 | 153.805 | 152.663 |
| $n_{20}$ | 1.7129955 | 1.6364176 | 1.6482275 | 1.6322979 | 1.6592624 |
| $k_{20}$ | 0.4320226 | 0.3040668 | 0.2416232 | 0.2733763 | 0.2197085 |
| $d_{20}$ (nm) | 91.539 | 153.339 | 210.993 | 150.296 | 206.543 |

| | | 14-06 | 14-07 | 14-08 | 14-09 | 14-10 |
|---|---|---|---|---|---|---|
| When $n_1 \geq n_{10}$, | $n_{1m} =$ | 0.0570667 | 0.0566760 | 0.0630505 | 0.0509021 | 0.0584448 |
| When $n_1 < n_{10}$, | $n_{1m} =$ | 0.0070447 | 0.0278870 | 0.0524426 | 0.0272241 | 0.0508081 |
| When $k_1 \geq k_{10}$, | $k_{1m} =$ | 0.0284875 | 0.0544165 | 0.0773682 | 0.0546399 | 0.0801599 |
| When $k_1 < k_{10}$, | $k_{1m} =$ | 0.0304980 | 0.0499133 | 0.0532507 | 0.0383374 | 0.0431470 |
| When $d_1 \geq d_{10}$, | $d_{1m}$ (nm) = | 7.855 | 14.249 | 20.142 | 22.873 | ∞ |
| When $d_1 < d_{10}$, | $d_{1m}$ (nm) = | 0.972 | 5.625 | 12.498 | 8.268 | 18.904 |
| When $n_2 \geq n_{20}$, | $n_{2m} =$ | 0.2760107 | 0.1009705 | 0.1137622 | 0.0657813 | 0.1088953 |
| When $n_2 < n_{20}$, | $n_{2m} =$ | 0.1995349 | 0.1448511 | 0.1471863 | 0.1316589 | 0.1395239 |
| When $k_2 \geq k_{20}$, | $k_{2m} =$ | 0.1305078 | 0.1378174 | 0.1321667 | 0.1037769 | 0.1143506 |
| When $k_2 < k_{20}$, | $k_{2m} =$ | 0.1154834 | 0.0970654 | 0.0846460 | 0.0880420 | 0.0769495 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 3.137 | 27.699 | 76.164 | 22.775 | 33.816 |

0. 93 ≤ N A ≤ 1. 0
1 3 5 < T ≤ 1 4 5

| Case | 14-11 | 14-12 |
|---|---|---|
| $n_{10}$ | 1.7027802 | 1.7041709 |
| $k_{10}$ | 0.0728517 | 0.0617202 |
| $d_{10}$ (nm) | 217.779 | 216.194 |
| $n_{20}$ | 1.6405373 | 1.6719897 |
| $k_{20}$ | 0.2588103 | 0.2085423 |
| $d_{20}$ (nm) | 146.936 | 202.593 |

| | | 14-11 | 14-12 |
|---|---|---|---|
| When $n_1 \geq n_{10}$, | $n_{1m} =$ | 0.0566504 | 0.0631152 |
| When $n_1 < n_{10}$, | $n_{1m} =$ | 0.0353162 | 0.0583606 |
| When $k_1 \geq k_{10}$, | $k_{1m} =$ | 0.0649280 | 0.0832544 |
| When $k_1 < k_{10}$, | $k_{1m} =$ | 0.0337988 | 0.0392310 |
| When $d_1 \geq d_{10}$, | $d_{1m}$ (nm) = | ∞ | ∞ |
| When $d_1 < d_{10}$, | $d_{1m}$ (nm) = | 15.495 | 79.231 |
| When $n_2 \geq n_{20}$, | $n_{2m} =$ | 0.0962402 | 0.1448450 |
| When $n_2 < n_{20}$, | $n_{2m} =$ | 0.1459131 | 0.1542615 |
| When $k_2 \geq k_{20}$, | $k_{2m} =$ | 0.1100769 | 0.1205054 |
| When $k_2 < k_{20}$, | $k_{2m} =$ | 0.0901184 | 0.0767920 |
| When $d_2 \geq d_{20}$, | $d_{2m}$ (nm) = | ∞ | ∞ |
| When $d_2 < d_{20}$, | $d_{2m}$ (nm) = | 22.790 | 28.928 |

0. 9 3 ≦ N A ≦ 1. 0
1 4 5 < T ≦ 1 5 5

| Case | 15-01 | 15-02 | 15-03 | 15-04 | 15-05 |
|---|---|---|---|---|---|
| $n_{10}$ | 1.8199816 | 1.9318464 | 1.9476580 | 1.9400781 | 1.9152409 |
| $k_{10}$ | 0.4068444 | 0.2280177 | 0.1546474 | 0.1580344 | 0.1421080 |
| $d_{10}$ (nm) | 29.022 | 20.237 | 15.042 | 15.180 | 12.506 |
| $n_{20}$ | 1.5974175 | 1.8212470 | 1.7660961 | 1.7558824 | 1.6892699 |
| $k_{20}$ | 1.4701111 | 0.6871951 | 0.4559575 | 0.4525330 | 0.3391765 |
| $d_{20}$ (nm) | 24.558 | 79.181 | 140.877 | 141.749 | 204.998 |

| | | 15-01 | 15-02 | 15-03 | 15-04 | 15-05 |
|---|---|---|---|---|---|---|
| When $n_1 \geq n_{10}$, | $n_{1m} =$ | 0.0783313 | 0.0902905 | 0.1062402 | 0.1057410 | 0.1233240 |
| When $n_1 < n_{10}$, | $n_{1m} =$ | 0.0485986 | 0.0576099 | 0.0737439 | 0.0730676 | 0.0958533 |
| When $k_1 \geq k_{10}$, | $k_{1m} =$ | 0.0424463 | 0.0706348 | 0.0877539 | 0.0877856 | 0.1136047 |
| When $k_1 < k_{10}$, | $k_{1m} =$ | 0.0340247 | 0.0852002 | 0.1066162 | 0.1062646 | 0.1201245 |
| When $d_1 \geq d_{10}$, | $d_{1m}$ (nm) = | 3.673 | 5.078 | 5.535 | 5.630 | 6.208 |
| When $d_1 < d_{10}$, | $d_{1m}$ (nm) = | 2.651 | 2.819 | 3.357 | 3.413 | 4.390 |
| When $n_2 \geq n_{20}$, | $n_{2m} =$ | 0.2911646 | 0.2069556 | 0.1703650 | 0.1705981 | 0.1609875 |
| When $n_2 < n_{20}$, | $n_{2m} =$ | 0.1897607 | 0.2328674 | 0.1899780 | 0.1895239 | 0.1746619 |
| When $k_2 \geq k_{20}$, | $k_{2m} =$ | 0.2661255 | 0.2545776 | 0.1755676 | 0.1739502 | 0.1429504 |
| When $k_2 < k_{20}$, | $k_{2m} =$ | 0.2599438 | 0.1612646 | 0.1333740 | 0.1331494 | 0.1167700 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 5.427 | 21.100 | 63.576 | 64.042 | 84.536 |

0. 9 3 ≦ N A ≦ 1. 0
1 4 5 < T ≦ 1 5 5

| Case | 15-06 | 15-07 | 15-08 | 15-09 | 15-10 |
|---|---|---|---|---|---|
| $n_{10}$ | 1.8773964 | 1.7792899 | 1.7347668 | 1.7234258 | 1.7112569 |
| $k_{10}$ | 0.2151408 | 0.1408151 | 0.1082989 | 0.0907869 | 0.0850611 |
| $d_{10}$ (nm) | 81.211 | 87.880 | 88.119 | 87.442 | 153.930 |
| $n_{20}$ | 1.7568637 | 1.7944868 | 1.6522930 | 1.6482492 | 1.6361524 |
| $k_{20}$ | 1.2210655 | 0.5090378 | 0.3260600 | 0.2516544 | 0.2898839 |
| $d_{20}$ (nm) | 20.666 | 75.457 | 142.664 | 202.556 | 141.116 |

| | | 15-06 | 15-07 | 15-08 | 15-09 | 15-10 |
|---|---|---|---|---|---|---|
| When $n_1 \geq n_{10}$, | $n_{1m} =$ | 0.0535974 | 0.0567944 | 0.0566736 | 0.0621204 | 0.0507385 |
| When $n_1 < n_{10}$, | $n_{1m} =$ | 0.0100415 | 0.0103674 | 0.0259888 | 0.0480981 | 0.0259363 |
| When $k_1 \geq k_{10}$, | $k_{1m} =$ | 0.0386597 | 0.0332520 | 0.0534692 | 0.0749170 | 0.0514124 |
| When $k_1 < k_{10}$, | $k_{1m} =$ | 0.0268323 | 0.0369287 | 0.0521716 | 0.0541968 | 0.0401160 |
| When $d_1 \geq d_{10}$, | $d_{1m}$ (nm) = | 4.095 | 7.577 | 13.934 | 19.192 | 22.547 |
| When $d_1 < d_{10}$, | $d_{1m}$ (nm) = | 0.855 | 1.369 | 4.946 | 11.117 | 7.637 |
| When $n_2 \geq n_{20}$, | $n_{2m} =$ | 0.4215723 | 0.2684375 | 0.1205920 | 0.1204028 | 0.0675806 |
| When $n_2 < n_{20}$, | $n_{2m} =$ | 0.3791321 | 0.1854980 | 0.1442749 | 0.1439111 | 0.1298389 |
| When $k_2 \geq k_{20}$, | $k_{2m} =$ | 0.1639099 | 0.2106580 | 0.1452100 | 0.1328479 | 0.0998340 |
| When $k_2 < k_{20}$, | $k_{2m} =$ | 0.2423328 | 0.1335254 | 0.1007751 | 0.0850952 | 0.0900806 |
| When $d_2 \geq d_{20}$, | $d_{2m}$ (nm) = | 5.052 | 14.783 | ∞ | ∞ | ∞ |
| When $d_2 < d_{20}$, | $d_{2m}$ (nm) = | 1.977 | 4.929 | 23.591 | 72.330 | 19.479 |

$0.93 \leq NA \leq 1.0$

$145 < T \leq 155$

| Case | 15-11 | 15-12 | 15-13 |
|---|---|---|---|
| $n_{10}$ | 1.7092054 | 1.7036310 | 1.7042855 |
| $k_{10}$ | 0.0717413 | 0.0749476 | 0.0635030 |
| $d_{10}$ (nm) | 152.725 | 217.788 | 216.233 |
| $n_{20}$ | 1.6572540 | 1.6384900 | 1.6687346 |
| $k_{20}$ | 0.2283199 | 0.2727185 | 0.2164860 |
| $d_{20}$ (nm) | 198.410 | 138.609 | 194.709 |

| | | 15-11 | 15-12 | 15-13 |
|---|---|---|---|---|
| When $n_1 \geq n_{10}$, | $n_{1m} =$ | 0.0574158 | 0.0563904 | 0.0624048 |
| When $n_1 < n_{10}$, | $n_{1m} =$ | 0.0505359 | 0.0361853 | 0.0601721 |
| When $k_1 \geq k_{10}$, | $k_{1m} =$ | 0.0766162 | 0.0604248 | 0.0800598 |
| When $k_1 < k_{10}$, | $k_{1m} =$ | 0.0439771 | 0.0350879 | 0.0400427 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 17.754 | 14.415 | 78.936 |
| When $n_2 \geq n_{20}$, | $n_{2m} =$ | 0.1103052 | 0.0951196 | 0.1487622 |
| When $n_2 < n_{20}$, | $n_{2m} =$ | 0.1349475 | 0.1401550 | 0.1481909 |
| When $k_2 \geq k_{20}$, | $k_{2m} =$ | 0.1121790 | 0.1001306 | 0.1166199 |
| When $k_2 < k_{20}$, | $k_{2m} =$ | 0.0769556 | 0.0916321 | 0.0768066 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 28.953 | 19.518 | 28.644 |

$0.93 \leq NA \leq 1.0$

$155 < T \leq 165$

| Case | 16-01 | 16-02 | 16-03 | 16-04 | 16-05 |
|---|---|---|---|---|---|
| $n_{10}$ | 1.8175791 | 1.9193642 | 1.9516445 | 1.9419697 | 1.9282358 |
| $k_{10}$ | 0.4385823 | 0.2501320 | 0.1607715 | 0.1648951 | 0.1504554 |
| $d_{10}$ (nm) | 37.187 | 21.908 | 15.944 | 16.094 | 12.282 |
| $n_{20}$ | 2.9488620 | 1.8321620 | 1.7911399 | 1.7764317 | 1.6857745 |
| $k_{20}$ | 3.6605721 | 0.7789298 | 0.4964603 | 0.4910919 | 0.3551730 |
| $d_{20}$ (nm) | 5.671 | 69.456 | 129.934 | 131.139 | 198.143 |

| | | 16-01 | 16-02 | 16-03 | 16-04 | 16-05 |
|---|---|---|---|---|---|---|
| When $n_1 \geq n_{10}$, | $n_{1m} =$ | 0.0604736 | 0.0852295 | 0.1013757 | 0.1010083 | 0.1240356 |
| When $n_1 < n_{10}$, | $n_{1m} =$ | 0.0333899 | 0.0547046 | 0.0713342 | 0.0704993 | 0.0944006 |
| When $k_1 \geq k_{10}$, | $k_{1m} =$ | 0.0318896 | 0.0632361 | 0.0833032 | 0.0834521 | 0.1140308 |
| When $k_1 < k_{10}$, | $k_{1m} =$ | 0.0127527 | 0.0803174 | 0.1011133 | 0.1007434 | 0.1227710 |
| When $d_1 \geq d_{10}$, | $d_{1m}$ (nm) $=$ | 2.684 | 4.937 | 5.403 | 5.524 | 5.825 |
| When $d_1 < d_{10}$, | $d_{1m}$ (nm) $=$ | 1.056 | 2.746 | 3.284 | 3.349 | 4.015 |
| When $n_2 \geq n_{20}$, | $n_{2m} =$ | 0.8885571 | 0.1992395 | 0.1663013 | 0.1663708 | 0.1592810 |
| When $n_2 < n_{20}$, | $n_{2m} =$ | 0.4338977 | 0.2305408 | 0.1904468 | 0.1899951 | 0.1750964 |
| When $k_2 \geq k_{20}$, | $k_{2m} =$ | 0.2239417 | 0.2871423 | 0.1858569 | 0.1831470 | 0.1419360 |
| When $k_2 < k_{20}$, | $k_{2m} =$ | 0.5593811 | 0.1675525 | 0.1346912 | 0.1341003 | 0.1171777 |
| When $d_2 \geq d_{20}$, | $d_{2m}$ (nm) $=$ | 2.121 | $\infty$ | $\infty$ | $\infty$ | $\infty$ |
| When $d_2 < d_{20}$, | $d_{2m}$ (nm) $=$ | 1.497 | 16.789 | 53.787 | 54.606 | 81.510 |

$0.93 \leq NA \leq 1.0$
$155 < T \leq 165$

| Case | 16-06 | 16-07 | 16-08 | 16-09 | 16-10 |
|---|---|---|---|---|---|
| $n_{10}$ | 1.8704725 | 1.7960814 | 1.7418606 | 1.7257176 | 1.7136245 |
| $k_{10}$ | 0.2299368 | 0.1479091 | 0.1134159 | 0.0948039 | 0.0896483 |
| $d_{10}$ (nm) | 88.746 | 88.347 | 87.888 | 87.264 | 153.565 |
| $n_{20}$ | 2.8158519 | 1.9330235 | 1.6717189 | 1.6472351 | 1.6392609 |
| $k_{20}$ | 3.0739838 | 0.6225271 | 0.3550776 | 0.2650084 | 0.3111392 |
| $d_{20}$ (nm) | 4.992 | 60.492 | 132.384 | 194.269 | 132.434 |

| | | 16-06 | 16-07 | 16-08 | 16-09 | 16-10 |
|---|---|---|---|---|---|---|
| When $n_1 \geq n_{10}$, | $n_{1m}=$ | 0.0496790 | 0.0539771 | 0.0559290 | 0.0605103 | 0.0493213 |
| When $n_1 < n_{10}$, | $n_{1m}=$ | 0.0158618 | 0.0116589 | 0.0229565 | 0.0427002 | 0.0176343 |
| When $k_1 \geq k_{10}$, | $k_{1m}=$ | 0.0339600 | 0.0324597 | 0.0502661 | 0.0714246 | 0.0448999 |
| When $k_1 < k_{10}$, | $k_{1m}=$ | 0.0196045 | 0.0413477 | 0.0524426 | 0.0547058 | 0.0377209 |
| When $d_1 \geq d_{10}$, | $d_{1m}$ (nm) $=$ | 4.203 | 6.741 | 12.890 | 17.512 | 20.755 |
| When $d_1 < d_{10}$, | $d_{1m}$ (nm) $=$ | 1.412 | 1.425 | 4.045 | 9.285 | 4.775 |
| When $n_2 \geq n_{20}$, | $n_{2m}=$ | 0.7568213 | 0.2080432 | 0.1385022 | 0.1276587 | 0.0653149 |
| When $n_2 < n_{20}$, | $n_{2m}=$ | 0.6339124 | 0.1864246 | 0.1456726 | 0.1431897 | 0.1296729 |
| When $k_2 \geq k_{20}$, | $k_{2m}=$ | 0.5784314 | 0.2482080 | 0.1472144 | 0.1310840 | 0.0863611 |
| When $k_2 < k_{20}$, | $k_{2m}=$ | 0.6241199 | 0.1496924 | 0.1027478 | 0.0854395 | 0.0904016 |
| When $d_2 \geq d_{20}$, | $d_{2m}$ (nm) $=$ | 1.695 | 9.818 | ∞ | ∞ | ∞ |
| When $d_2 < d_{20}$, | $d_{2m}$ (nm) $=$ | 1.276 | 6.130 | 21.225 | 35.287 | 17.454 |

$0.93 \leq NA \leq 1.0$
$155 < T \leq 165$

| Case | 16-11 | 16-12 | 16-13 | 16-14 |
|---|---|---|---|---|
| $n_{10}$ | 1.7097149 | 1.7044725 | 1.7041849 | 1.7061658 |
| $k_{10}$ | 0.0750113 | 0.0790614 | 0.0664191 | 0.0592006 |
| $d_{10}$ (nm) | 152.537 | 217.265 | 215.910 | 215.675 |
| $n_{20}$ | 1.6527377 | 1.6350180 | 1.6625759 | 1.6951633 |
| $k_{20}$ | 0.2392317 | 0.2903973 | 0.2261823 | 0.1893046 |
| $d_{20}$ (nm) | 190.639 | 130.687 | 187.261 | 240.772 |

| | | 16-11 | 16-12 | 16-13 | 16-14 |
|---|---|---|---|---|---|
| When $n_1 \geq n_{10}$, | $n_{1m}=$ | 0.0553772 | 0.0545740 | 0.0600366 | 0.0676270 |
| When $n_1 < n_{10}$, | $n_{1m}=$ | 0.0477368 | 0.0344788 | 0.0568494 | 0.0690149 |
| When $k_1 \geq k_{10}$, | $k_{1m}=$ | 0.0715491 | 0.0525977 | 0.0752148 | 0.0835681 |
| When $k_1 < k_{10}$, | $k_{1m}=$ | 0.0443665 | 0.0337817 | 0.0404053 | 0.0425281 |
| When $d_1 \geq d_{10}$, | $d_{1m}$ (nm) $=$ | ∞ | ∞ | ∞ | ∞ |
| When $d_1 < d_{10}$, | $d_{1m}$ (nm) $=$ | 16.235 | 12.121 | 77.039 | 86.324 |
| When $n_2 \geq n_{20}$, | $n_{2m}=$ | 0.1116882 | 0.0916113 | 0.1582788 | 0.1718628 |
| When $n_2 < n_{20}$, | $n_{2m}=$ | 0.1331189 | 0.1411133 | 0.1443433 | 0.1614490 |
| When $k_2 \geq k_{20}$, | $k_{2m}=$ | 0.1061816 | 0.0827698 | 0.1097974 | 0.1248706 |
| When $k_2 < k_{20}$, | $k_{2m}=$ | 0.0766345 | 0.0918372 | 0.0766272 | 0.0699548 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 27.428 | 17.505 | 27.098 | 73.085 |

0. 9 3 ≤ N A ≤ 1. 0
1 6 5 < T ≤ 1 7 5

| Case | 17-01 | 17-02 | 17-03 | 17-04 | 17-05 |
|---|---|---|---|---|---|
| $n_{10}$ | 1.9650460 | 1.9384951 | 1.9139584 | 1.7857662 | 1.7433983 |
| $k_{10}$ | 0.1748342 | 0.1550287 | 0.1299465 | 0.1574086 | 0.1202381 |
| $d_{10}$ (nm) | 15.368 | 12.323 | 11.343 | 86.539 | 87.036 |
| $n_{20}$ | 1.7719438 | 1.6895811 | 1.6883766 | 1.7907030 | 1.6559011 |
| $k_{20}$ | 0.5219218 | 0.3734128 | 0.3007198 | 0.6497694 | 0.3733381 |
| $d_{20}$ (nm) | 124.100 | 189.293 | 246.427 | 59.718 | 125.629 |

| | | 17-01 | 17-02 | 17-03 | 17-04 | 17-05 |
|---|---|---|---|---|---|---|
| When $n_1 \geq n_{10}$, | $n_{1m}=$ | 0.1023816 | 0.1220520 | 0.1341687 | 0.0495288 | 0.0535669 |
| When $n_1 < n_{10}$, | $n_{1m}=$ | 0.0697961 | 0.0912976 | 0.1083984 | 0.0051111 | 0.0188965 |
| When $k_1 \geq k_{10}$, | $k_{1m}=$ | 0.0830420 | 0.1112122 | 0.1288184 | 0.0186707 | 0.0452673 |
| When $k_1 < k_{10}$, | $k_{1m}=$ | 0.1016052 | 0.1222986 | 0.1299465 | 0.0330212 | 0.0491577 |
| When $d_1 \geq d_{10}$, | $d_{1m}$ (nm) $=$ | 5.001 | 5.526 | 6.413 | 5.954 | 11.233 |
| When $d_1 < d_{10}$, | $d_{1m}$ (nm) $=$ | 2.956 | 3.739 | 4.697 | 0.624 | 3.144 |
| When $n_2 \geq n_{20}$, | $n_{2m}=$ | 0.1581653 | 0.1572925 | 0.1540161 | 0.0858301 | 0.1199121 |
| When $n_2 < n_{20}$, | $n_{2m}=$ | 0.1927075 | 0.1754407 | 0.1685632 | 0.1889197 | 0.1519067 |
| When $k_2 \geq k_{20}$, | $k_{2m}=$ | 0.1753381 | 0.1419458 | 0.1368945 | 0.0730774 | 0.1241467 |
| When $k_2 < k_{20}$, | $k_{2m}=$ | 0.1306897 | 0.1171997 | 0.1067334 | 0.1258240 | 0.0983862 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 51.895 | 79.651 | 119.351 | 3.741 | 21.467 |

0. 9 3 ≤ N A ≤ 1. 0
1 6 5 < T ≤ 1 7 5

| Case | 17-06 | 17-07 | 17-08 | 17-09 | 17-10 |
|---|---|---|---|---|---|
| $n_{10}$ | 1.7262549 | 1.7236673 | 1.7140199 | 1.7096017 | 1.7107217 |
| $k_{10}$ | 0.0993784 | 0.0842645 | 0.0949670 | 0.0783956 | 0.0680252 |
| $d_{10}$ (nm) | 86.812 | 87.109 | 152.601 | 152.026 | 152.100 |
| $n_{20}$ | 1.6373093 | 1.6685549 | 1.6238426 | 1.6437329 | 1.6799600 |
| $k_{20}$ | 0.2753256 | 0.2274459 | 0.3258368 | 0.2483227 | 0.2063397 |
| $d_{20}$ (nm) | 186.729 | 241.120 | 125.450 | 182.921 | 236.403 |

| | | 17-06 | 17-07 | 17-08 | 17-09 | 17-10 |
|---|---|---|---|---|---|---|
| When $n_1 \geq n_{10}$, | $n_{1m}=$ | 0.0583655 | 0.0638147 | 0.0459595 | 0.0526709 | 0.0601990 |
| When $n_1 < n_{10}$, | $n_{1m}=$ | 0.0389001 | 0.0503784 | 0.0111768 | 0.0448047 | 0.0600891 |
| When $k_1 \geq k_{10}$, | $k_{1m}=$ | 0.0685583 | 0.0805896 | 0.0359302 | 0.0672742 | 0.0800940 |
| When $k_1 < k_{10}$, | $k_{1m}=$ | 0.0538513 | 0.0560901 | 0.0310425 | 0.0434424 | 0.0457349 |
| When $d_1 \geq d_{10}$, | $d_{1m}$ (nm) $=$ | 15.725 | 22.939 | 17.229 | ∞ | ∞ |
| When $d_1 < d_{10}$, | $d_{1m}$ (nm) $=$ | 8.012 | 11.976 | 2.824 | 14.351 | 24.120 |
| When $n_2 \geq n_{20}$, | $n_{2m}=$ | 0.1242969 | 0.1275708 | 0.0486890 | 0.1084961 | 0.1263135 |
| When $n_2 < n_{20}$, | $n_{2m}=$ | 0.1456055 | 0.1521838 | 0.1337903 | 0.1356079 | 0.1464233 |
| When $k_2 \geq k_{20}$, | $k_{2m}=$ | 0.1234131 | 0.1338855 | 0.0591821 | 0.0969312 | 0.1151416 |
| When $k_2 < k_{20}$, | $k_{2m}=$ | 0.0846008 | 0.0776428 | 0.0858325 | 0.0756372 | 0.0703125 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 66.105 | 78.842 | 17.102 | 28.470 | 72.561 |

0. 9 3 ≤ N A ≤ 1. 0
1 6 5 < T ≤ 1 7 5

| Case | 17-11 | 17-12 | 17-13 |
|---|---|---|---|
| $n_{10}$ | 1.7042582 | 1.7037677 | 1.7056779 |
| $k_{10}$ | 0.0836625 | 0.0692974 | 0.0609868 |
| $d_{10}$ (nm) | 216.186 | 215.313 | 215.198 |
| $n_{20}$ | 1.6202806 | 1.6544674 | 1.6903958 |
| $k_{20}$ | 0.3033538 | 0.2346728 | 0.1952987 |
| $d_{20}$ (nm) | 123.599 | 179.446 | 232.683 |

| | | 17-11 | 17-12 | 17-13 |
|---|---|---|---|---|
| When $n_1 \geq n_{10}$, | $n_{1m} =$ | 0.0501758 | 0.0567249 | 0.0651611 |
| When $n_1 < n_{10}$, | $n_{1m} =$ | 0.0271130 | 0.0522852 | 0.0658081 |
| When $k_1 \geq k_{10}$, | $k_{1m} =$ | 0.0439600 | 0.0710352 | 0.0811584 |
| When $k_1 < k_{10}$, | $k_{1m} =$ | 0.0300366 | 0.0394434 | 0.0413635 |
| When $d_1 \geq d_{10}$, | $d_{1m}$ (nm) = | ∞ | ∞ | ∞ |
| When $d_1 < d_{10}$, | $d_{1m}$ (nm) = | 9.341 | 23.552 | 82.870 |
| When $n_2 \geq n_{20}$, | $n_{2m} =$ | 0.0785254 | 0.1613647 | 0.1758447 |
| When $n_2 < n_{20}$, | $n_{2m} =$ | 0.1457166 | 0.1478357 | 0.1648547 |
| When $k_2 \geq k_{20}$, | $k_{2m} =$ | 0.0611975 | 0.1025415 | 0.1200317 |
| When $k_2 < k_{20}$, | $k_{2m} =$ | 0.0887231 | 0.0762732 | 0.0707166 |
| When $d_2 \geq d_{20}$, | $d_{2m}$ (nm) = | ∞ | ∞ | ∞ |
| When $d_2 < d_{20}$, | $d_{2m}$ (nm) = | 17.421 | 28.206 | 71.908 |

0. 9 3 ≤ N A ≤ 1. 0
1 7 5 < T ≤ 1 8 5

| Case | 18-01 | 18-02 | 18-03 | 18-04 | 18-05 |
|---|---|---|---|---|---|
| $n_{10}$ | 1.9750220 | 1.9943589 | 1.9365478 | 1.8874503 | 1.7406539 |
| $k_{10}$ | 0.3055970 | 0.1905841 | 0.1715491 | 0.1503402 | 0.1271964 |
| $d_{10}$ (nm) | 17.312 | 13.627 | 12.200 | 12.006 | 86.109 |
| $n_{20}$ | 1.6357631 | 1.7309349 | 1.6649916 | 1.6561886 | 1.6157675 |
| $k_{20}$ | 0.8207912 | 0.5263943 | 0.3790440 | 0.2991899 | 0.3771605 |
| $d_{20}$ (nm) | 66.973 | 122.033 | 183.216 | 242.151 | 120.682 |

| | | 18-01 | 18-02 | 18-03 | 18-04 | 18-05 |
|---|---|---|---|---|---|---|
| When $n_1 \geq n_{10}$, | $n_{1m} =$ | 0.0935791 | 0.1114148 | 0.1215747 | 0.1285913 | 0.0513330 |
| When $n_1 < n_{10}$, | $n_{1m} =$ | 0.0459473 | 0.0702148 | 0.0894250 | 0.1026367 | 0.0144434 |
| When $k_1 \geq k_{10}$, | $k_{1m} =$ | 0.0590857 | 0.0871582 | 0.1112146 | 0.1261365 | 0.0386914 |
| When $k_1 < k_{10}$, | $k_{1m} =$ | 0.0823853 | 0.1098083 | 0.1208740 | 0.1243677 | 0.0453528 |
| When $d_1 \geq d_{10}$, | $d_{1m}$ (nm) = | 3.436 | 4.283 | 5.306 | 6.728 | 10.132 |
| When $d_1 < d_{10}$, | $d_{1m}$ (nm) = | 1.707 | 2.491 | 3.559 | 4.870 | 2.323 |
| When $n_2 \geq n_{20}$, | $n_{2m} =$ | 0.1368286 | 0.1494128 | 0.1559277 | 0.1523608 | 0.0829712 |
| When $n_2 < n_{20}$, | $n_{2m} =$ | 0.2106677 | 0.1994727 | 0.1768091 | 0.1649011 | 0.1612537 |
| When $k_2 \geq k_{20}$, | $k_{2m} =$ | 0.1566431 | 0.1521973 | 0.1368372 | 0.1332068 | 0.0933081 |
| When $k_2 < k_{20}$, | $k_{2m} =$ | 0.1361353 | 0.1253687 | 0.1152344 | 0.1052795 | 0.0942554 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 18.814 | 47.829 | 81.274 | 118.000 | 24.527 |

0. 9 3 ≤ N A ≤ 1. 0

1 7 5 < T ≤ 1 8 5

| Case | 18-06 | 18-07 | 18-08 | 18-09 | 18-10 |
|---|---|---|---|---|---|
| $n_{10}$ | 1.7253418 | 1.7237735 | 1.7126639 | 1.7091592 | 1.7108527 |
| $k_{10}$ | 0.1032843 | 0.0864157 | 0.0996282 | 0.0809109 | 0.0696108 |
| $d_{10}$ (nm) | 86.339 | 86.885 | 151.701 | 151.551 | 151.827 |
| $n_{20}$ | 1.6224018 | 1.6650124 | 1.5953952 | 1.6344497 | 1.6784072 |
| $k_{20}$ | 0.2809650 | 0.2327133 | 0.3310599 | 0.2545275 | 0.2111338 |
| $d_{20}$ (nm) | 178.956 | 231.784 | 118.977 | 174.271 | 226.839 |

| | | 18-06 | 18-07 | 18-08 | 18-09 | 18-10 |
|---|---|---|---|---|---|---|
| When $n_1 \geq n_{10}$, | $n_{1m} =$ | 0.0565039 | 0.0626416 | 0.0424548 | 0.0505127 | 0.0583557 |
| When $n_1 < n_{10}$, | $n_{1m} =$ | 0.0377893 | 0.0495728 | 0.0068591 | 0.0425964 | 0.0570093 |
| When $k_1 \geq k_{10}$, | $k_{1m} =$ | 0.0671277 | 0.0801477 | 0.0264331 | 0.0654321 | 0.0790332 |
| When $k_1 < k_{10}$, | $k_{1m} =$ | 0.0514600 | 0.0546265 | 0.0262610 | 0.0409290 | 0.0440662 |
| When $d_1 \geq d_{10}$, | $d_{1m}$ (nm) $=$ | 14.314 | 20.851 | 14.034 | 22.266 | ∞ |
| When $d_1 < d_{10}$, | $d_{1m}$ (nm) $=$ | 7.519 | 11.390 | 1.678 | 12.457 | 21.354 |
| When $n_2 \geq n_{20}$, | $n_{2m} =$ | 0.1133289 | 0.1230408 | 0.0286230 | 0.1046033 | 0.1258447 |
| When $n_2 < n_{20}$, | $n_{2m} =$ | 0.1506311 | 0.1572058 | 0.1416589 | 0.1413440 | 0.1529517 |
| When $k_2 \geq k_{20}$, | $k_{2m} =$ | 0.1148096 | 0.1304126 | 0.0346130 | 0.0907129 | 0.1118689 |
| When $k_2 < k_{20}$, | $k_{2m} =$ | 0.0848999 | 0.0792493 | 0.0817810 | 0.0764514 | 0.0721448 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 64.642 | 80.544 | 18.599 | 31.028 | 73.232 |

0. 9 3 ≤ N A ≤ 1. 0

1 7 5 < T ≤ 1 8 5

| Case | 18-11 | 18-12 | 18-13 |
|---|---|---|---|
| $n_{10}$ | 1.7032995 | 1.7035257 | 1.7058486 |
| $k_{10}$ | 0.0874338 | 0.0712651 | 0.0623526 |
| $d_{10}$ (nm) | 215.388 | 214.888 | 214.924 |
| $n_{20}$ | 1.6000078 | 1.6490638 | 1.6902455 |
| $k_{20}$ | 0.3100603 | 0.2413259 | 0.1999123 |
| $d_{20}$ (nm) | 116.088 | 170.219 | 222.958 |

| | | 18-11 | 18-12 | 18-13 |
|---|---|---|---|---|
| When $n_1 \geq n_{10}$, | $n_{1m} =$ | 0.0459119 | 0.0540906 | 0.0637158 |
| When $n_1 < n_{10}$, | $n_{1m} =$ | 0.0201135 | 0.0472498 | 0.0624988 |
| When $k_1 \geq k_{10}$, | $k_{1m} =$ | 0.0380823 | 0.0692078 | 0.0795654 |
| When $k_1 < k_{10}$, | $k_{1m} =$ | 0.0261584 | 0.0371997 | 0.0400098 |
| When $d_1 \geq d_{10}$, | $d_{1m}$ (nm) $=$ | 25.691 | ∞ | ∞ |
| When $d_1 < d_{10}$, | $d_{1m}$ (nm) $=$ | 6.401 | 18.086 | 80.109 |
| When $n_2 \geq n_{20}$, | $n_{2m} =$ | 0.0666833 | 0.1564661 | 0.1701733 |
| When $n_2 < n_{20}$, | $n_{2m} =$ | 0.1555847 | 0.1549194 | 0.1734229 |
| When $k_2 \geq k_{20}$, | $k_{2m} =$ | 0.0497668 | 0.0999182 | 0.1182764 |
| When $k_2 < k_{20}$, | $k_{2m} =$ | 0.0866650 | 0.0781360 | 0.0731396 |
| When $d_2 \geq d_{20}$, | $d_{2m}$ (nm) $=$ | 13.606 | ∞ | ∞ |
| When $d_2 < d_{20}$, | $d_{2m}$ (nm) $=$ | 18.924 | 29.474 | 72.740 |

$0.93 \leq NA \leq 1.0$
$185 < T \leq 195$

| Case | 19-01 | 19-02 | 19-03 | 19-04 | 19-05 |
|---|---|---|---|---|---|
| $n_{10}$ | 2.0157422 | 1.9298641 | 1.9158213 | 1.9035507 | 1.7387191 |
| $k_{10}$ | 0.3310994 | 0.1874025 | 0.1413868 | 0.0919796 | 0.1333266 |
| $d_{10}$ (nm) | 15.233 | 12.335 | 11.496 | 11.593 | 85.772 |
| $n_{20}$ | 1.5732193 | 1.6401635 | 1.6782430 | 1.7330388 | 1.5838112 |
| $k_{20}$ | 0.8191417 | 0.3856200 | 0.3150440 | 0.2716233 | 0.3839989 |
| $d_{20}$ (nm) | 66.313 | 174.874 | 226.685 | 274.138 | 113.170 |

| | | 19-01 | 19-02 | 19-03 | 19-04 | 19-05 |
|---|---|---|---|---|---|---|
| When $n_1 \geq n_{10}$, | $n_{1m} =$ | 0.0908862 | 0.1198010 | 0.1318933 | 0.1353418 | 0.0494861 |
| When $n_1 < n_{10}$, | $n_{1m} =$ | 0.0435144 | 0.0881482 | 0.1071143 | 0.1119397 | 0.0110315 |
| When $k_1 \geq k_{10}$, | $k_{1m} =$ | 0.0607654 | 0.1097412 | 0.1276587 | 0.1301843 | 0.0306482 |
| When $k_1 < k_{10}$, | $k_{1m} =$ | 0.0886279 | 0.1159265 | 0.1266907 | 0.0919796 | 0.0445325 |
| When $d_1 \geq d_{10}$, | $d_{1m}$ (nm) $=$ | 2.825 | 5.183 | 6.173 | 7.339 | 9.205 |
| When $d_1 < d_{10}$, | $d_{1m}$ (nm) $=$ | 1.353 | 3.517 | 4.556 | 5.508 | 1.748 |
| When $n_2 \geq n_{20}$, | $n_{2m} =$ | 0.1250940 | 0.1513354 | 0.1454334 | 0.1421106 | 0.0499280 |
| When $n_2 < n_{20}$, | $n_{2m} =$ | 0.1772742 | 0.1779919 | 0.1691821 | 0.1744556 | 0.1654175 |
| When $k_2 \geq k_{20}$, | $k_{2m} =$ | 0.1164954 | 0.1335864 | 0.1351135 | 0.1421582 | 0.0743848 |
| When $k_2 < k_{20}$, | $k_{2m} =$ | 0.1392041 | 0.1184119 | 0.1117639 | 0.1051697 | 0.0978845 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 17.571 | 78.501 | 112.763 | 138.595 | 25.987 |

$0.93 \leq NA \leq 1.0$
$185 < T \leq 195$

| Case | 19-06 | 19-07 | 19-08 | 19-09 | 19-10 |
|---|---|---|---|---|---|
| $n_{10}$ | 1.7256246 | 1.7253546 | 1.7287042 | 1.7096582 | 1.7121643 |
| $k_{10}$ | 0.1055723 | 0.0874820 | 0.0760165 | 0.0821714 | 0.0705329 |
| $d_{10}$ (nm) | 86.279 | 86.928 | 87.515 | 151.624 | 152.001 |
| $n_{20}$ | 1.6177137 | 1.6696157 | 1.7081188 | 1.6358848 | 1.6853812 |
| $k_{20}$ | 0.2895611 | 0.2389730 | 0.2041866 | 0.2635969 | 0.2167566 |
| $d_{20}$ (nm) | 168.375 | 220.361 | 272.150 | 162.984 | 215.233 |

| | | 19-06 | 19-07 | 19-08 | 19-09 | 19-10 |
|---|---|---|---|---|---|---|
| When $n_1 \geq n_{10}$, | $n_{1m} =$ | 0.0562903 | 0.0628687 | 0.0679712 | 0.0505103 | 0.0586621 |
| When $n_1 < n_{10}$, | $n_{1m} =$ | 0.0396094 | 0.0498669 | 0.0509912 | 0.0389160 | 0.0543164 |
| When $k_1 \geq k_{10}$, | $k_{1m} =$ | 0.0670349 | 0.0806128 | 0.0832776 | 0.0662488 | 0.0789514 |
| When $k_1 < k_{10}$, | $k_{1m} =$ | 0.0491772 | 0.0538904 | 0.0576746 | 0.0390271 | 0.0434973 |
| When $d_1 \geq d_{10}$, | $d_{1m}$ (nm) $=$ | 13.425 | 20.169 | 39.294 | 20.568 | $\infty$ |
| When $d_1 < d_{10}$, | $d_{1m}$ (nm) $=$ | 7.774 | 11.144 | 12.836 | 11.141 | 20.056 |
| When $n_2 \geq n_{20}$, | $n_{2m} =$ | 0.1053076 | 0.1213562 | 0.1287134 | 0.1062195 | 0.1257849 |
| When $n_2 < n_{20}$, | $n_{2m} =$ | 0.1536951 | 0.1604126 | 0.1670996 | 0.1450281 | 0.1574817 |
| When $k_2 \geq k_{20}$, | $k_{2m} =$ | 0.1136377 | 0.1320007 | 0.1531152 | 0.0931067 | 0.1145862 |
| When $k_2 < k_{20}$, | $k_{2m} =$ | 0.0898669 | 0.0840454 | 0.0776611 | 0.0825256 | 0.0770361 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 45.429 | 80.918 | 110.597 | 30.017 | 74.310 |

0．９３≦ＮＡ≦１．０
１８５＜Ｔ≦１９５

| Case | 19-11 | 19-12 | 19-13 | 19-14 | 19-15 |
|---|---|---|---|---|---|
| $n_{10}$ | 1.7151566 | 1.7029318 | 1.7041956 | 1.7070069 | 1.7080920 |
| $k_{10}$ | 0.0645755 | 0.0900998 | 0.0721897 | 0.0633145 | 0.0595697 |
| $d_{10}$ (nm) | 152.412 | 215.656 | 215.114 | 215.207 | 215.250 |
| $n_{20}$ | 1.7135234 | 1.5920483 | 1.6533659 | 1.6971996 | 1.7125257 |
| $k_{20}$ | 0.1842756 | 0.3226491 | 0.2502000 | 0.2048445 | 0.1741269 |
| $d_{20}$ (nm) | 268.692 | 105.543 | 158.704 | 211.558 | 267.229 |

| When $n_1 \geq n_{10}$, $n_{1m}=$ | 0.0656799 | 0.0437866 | 0.0537561 | 0.0639758 | 0.0752185 |
|---|---|---|---|---|---|
| When $n_1 < n_{10}$, $n_{1m}=$ | 0.0585193 | 0.0130481 | 0.0437659 | 0.0602637 | 0.0712415 |
| When $k_1 \geq k_{10}$, $k_{1m}=$ | 0.0803796 | 0.0379236 | 0.0696973 | 0.0785339 | 0.0793298 |
| When $k_1 < k_{10}$, $k_{1m}=$ | 0.0475867 | 0.0209644 | 0.0354407 | 0.0397900 | 0.0383728 |
| When $d_1 \geq d_{10}$, $d_{1m}$ (nm) $=$ | $\infty$ | 20.412 | $\infty$ | $\infty$ | $\infty$ |
| When $d_1 < d_{10}$, $d_{1m}$ (nm) $=$ | 76.169 | 3.912 | 15.725 | 78.897 | 136.900 |
| When $n_2 \geq n_{20}$, $n_{2m}=$ | 0.1359851 | 0.0436487 | 0.1238757 | 0.1440674 | 0.1618445 |
| When $n_2 < n_{20}$, $n_{2m}=$ | 0.1709363 | 0.1590417 | 0.1491174 | 0.1814563 | 0.2117529 |
| When $k_2 \geq k_{20}$, $k_{2m}=$ | 0.1377368 | 0.0580493 | 0.1037561 | 0.1202234 | 0.1371057 |
| When $k_2 < k_{20}$, $k_{2m}=$ | 0.0711096 | 0.0823193 | 0.0849219 | 0.0779297 | 0.0717078 |
| When $d_2 \geq d_{20}$, $d_{2m}$ (nm) $=$ | $\infty$ | 9.984 | $\infty$ | $\infty$ | $\infty$ |
| When $d_2 < d_{20}$, $d_{2m}$ (nm) $=$ | 82.771 | 19.617 | 23.813 | 73.684 | 77.607 |

０．９３≦ＮＡ≦１．０
１９５＜Ｔ≦２０５

| Case | 20-01 | 20-02 | 20-03 | 20-04 | 20-05 |
|---|---|---|---|---|---|
| $n_{10}$ | 1.9115074 | 1.9153788 | 1.8712999 | 1.7275221 | 1.7279210 |
| $k_{10}$ | 0.1960527 | 0.1490337 | 0.0897979 | 0.1065695 | 0.0881248 |
| $d_{10}$ (nm) | 13.258 | 11.515 | 14.536 | 86.590 | 87.122 |
| $n_{20}$ | 1.6255021 | 1.6682692 | 1.7614462 | 1.6227655 | 1.6778177 |
| $k_{20}$ | 0.3984556 | 0.3197853 | 0.2821612 | 0.3041284 | 0.2471127 |
| $d_{20}$ (nm) | 164.068 | 218.507 | 257.799 | 156.467 | 209.069 |

| When $n_1 \geq n_{10}$, $n_{1m}=$ | 0.1142444 | 0.1325989 | 0.1158582 | 0.0562817 | 0.0637024 |
|---|---|---|---|---|---|
| When $n_1 < n_{10}$, $n_{1m}=$ | 0.0852515 | 0.1080505 | 0.0942114 | 0.0426550 | 0.0501379 |
| When $k_1 \geq k_{10}$, $k_{1m}=$ | 0.1044482 | 0.1295020 | 0.1096521 | 0.0681348 | 0.0804810 |
| When $k_1 < k_{10}$, $k_{1m}=$ | 0.1084790 | 0.1269031 | 0.0897979 | 0.0488770 | 0.0543994 |
| When $d_1 \geq d_{10}$, $d_{1m}$ (nm) $=$ | 5.346 | 6.134 | 8.659 | 13.270 | 20.006 |
| When $d_1 < d_{10}$, $d_{1m}$ (nm) $=$ | 3.730 | 4.524 | 6.443 | 8.305 | 10.905 |
| When $n_2 \geq n_{20}$, $n_{2m}=$ | 0.1424097 | 0.1416443 | 0.1412390 | 0.1051294 | 0.1236353 |
| When $n_2 < n_{20}$, $n_{2m}=$ | 0.1779224 | 0.1667200 | 0.1823743 | 0.1526196 | 0.1593042 |
| When $k_2 \geq k_{20}$, $k_{2m}=$ | 0.1351575 | 0.1341370 | 0.1542419 | 0.1188623 | 0.1364233 |
| When $k_2 < k_{20}$, $k_{2m}=$ | 0.1244714 | 0.1144324 | 0.1102271 | 0.0976929 | 0.0887854 |
| When $d_2 \geq d_{20}$, $d_{2m}$ (nm) $=$ | $\infty$ | $\infty$ | $\infty$ | $\infty$ | $\infty$ |
| When $d_2 < d_{20}$, $d_{2m}$ (nm) $=$ | 70.107 | 105.511 | 128.903 | 31.502 | 77.053 |

0. 9 3 ≤ N A ≤ 1. 0
1 9 5 < T ≤ 2 0 5

| Case | 20-06 | 20-07 | 20-08 | 20-09 | 20-10 |
|---|---|---|---|---|---|
| $n_{10}$ | 1.7316602 | 1.7109076 | 1.7140510 | 1.7169074 | 1.7034522 |
| $k_{10}$ | 0.0769958 | 0.0825870 | 0.0712311 | 0.0659464 | 0.0912009 |
| $d_{10}$ (nm) | 87.563 | 152.078 | 152.368 | 152.739 | 216.873 |
| $n_{20}$ | 1.7153560 | 1.6429824 | 1.6947912 | 1.7201685 | 1.5969711 |
| $k_{20}$ | 0.2092703 | 0.2767726 | 0.2239389 | 0.1888883 | 0.3506487 |
| $d_{20}$ (nm) | 261.518 | 151.325 | 204.003 | 258.117 | 92.838 |

| | | 20-06 | 20-07 | 20-08 | 20-09 | 20-10 |
|---|---|---|---|---|---|---|
| When $n_1 \geq n_{10}$, | $n_{1m} =$ | 0.0685693 | 0.0512622 | 0.0601404 | 0.0671716 | 0.0436548 |
| When $n_1 < n_{10}$, | $n_{1m} =$ | 0.0495715 | 0.0375720 | 0.0532251 | 0.0484131 | 0.0089709 |
| When $k_1 \geq k_{10}$, | $k_{1m} =$ | 0.0827515 | 0.0683850 | 0.0790723 | 0.0783716 | 0.0369128 |
| When $k_1 < k_{10}$, | $k_{1m} =$ | 0.0588892 | 0.0391077 | 0.0446033 | 0.0456335 | 0.0165588 |
| When $d_1 \geq d_{10}$, | $d_{1m}$ (nm) $=$ | 35.460 | 20.848 | ∞ | ∞ | 19.781 |
| When $d_1 < d_{10}$, | $d_{1m}$ (nm) $=$ | 11.967 | 10.711 | 16.311 | 17.445 | 2.680 |
| When $n_2 \geq n_{20}$, | $n_{2m} =$ | 0.1321082 | 0.1010400 | 0.1225134 | 0.1362366 | 0.0345703 |
| When $n_2 < n_{20}$, | $n_{2m} =$ | 0.1646814 | 0.1448950 | 0.1569727 | 0.1688831 | 0.1562476 |
| When $k_2 \geq k_{20}$, | $k_{2m} =$ | 0.1585754 | 0.0998694 | 0.1194824 | 0.1443347 | 0.0797021 |
| When $k_2 < k_{20}$, | $k_{2m} =$ | 0.0798230 | 0.0905042 | 0.0814771 | 0.0735376 | 0.0638440 |
| When $d_2 \geq d_{20}$, | $d_{2m}$ (nm) $=$ | ∞ | ∞ | ∞ | ∞ | 10.032 |
| When $d_2 < d_{20}$, | $d_{2m}$ (nm) $=$ | 87.011 | 25.146 | 71.899 | 78.182 | 16.775 |

0. 9 3 ≤ N A ≤ 1. 0
1 9 5 < T ≤ 2 0 5

| Case | 20-11 | 20-12 | 20-13 |
|---|---|---|---|
| $n_{10}$ | 1.7053294 | 1.7084550 | 1.7088490 |
| $k_{10}$ | 0.0723641 | 0.0642090 | 0.0611230 |
| $d_{10}$ (nm) | 215.802 | 215.782 | 215.750 |
| $n_{20}$ | 1.6624125 | 1.7063284 | 1.7155496 |
| $k_{20}$ | 0.2625944 | 0.2112603 | 0.1784523 |
| $d_{20}$ (nm) | 147.133 | 200.541 | 257.296 |

| | | 20-11 | 20-12 | 20-13 |
|---|---|---|---|---|
| When $n_1 \geq n_{10}$, | $n_{1m} =$ | 0.0548254 | 0.0651489 | 0.0765845 |
| When $n_1 < n_{10}$, | $n_{1m} =$ | 0.0418201 | 0.0593726 | 0.0732715 |
| When $k_1 \geq k_{10}$, | $k_{1m} =$ | 0.0710583 | 0.0775024 | 0.0765796 |
| When $k_1 < k_{10}$, | $k_{1m} =$ | 0.0355750 | 0.0411511 | 0.0355579 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 15.640 | 79.525 | 76.637 |
| When $n_2 \geq n_{20}$, | $n_{2m} =$ | 0.1192065 | 0.1417981 | 0.1626379 |
| When $n_2 < n_{20}$, | $n_{2m} =$ | 0.1432642 | 0.1798657 | 0.2073511 |
| When $k_2 \geq k_{20}$, | $k_{2m} =$ | 0.1091699 | 0.1229614 | 0.1404065 |
| When $k_2 < k_{20}$, | $k_{2m} =$ | 0.0923608 | 0.0791760 | 0.0746033 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 19.545 | 71.258 | 73.210 |

2. An antireflective film used in a process for manufacturing a semiconductor device by being provided between a

**EP 1 760 766 A2**

resist layer and a silicon oxide layer formed on a surface of a silicon semiconductor substrate and having a thickness T (unit: nm) described below, for exposure of the resist layer in an exposure system having a wavelength of 190 nm to 195 nm and a numerical aperture NA of $1.0 < NA \leq 1.1$, the antireflective film having a two-layer structure comprising:

an upper layer having a complex refractive index $N_1$; and
a lower layer having a complex refractive index $N_2$; the complex refractive indexes $N_1$ and $N_2$ being represented by the equations $N_1 = n_1 - k_1 i$ and $N_2 = n_2 - k_2 i$, respectively,
wherein assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1$, $k_1$, $d_1$, $n_2$, $k_2$, and $d_2$ satisfy the relational expression

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1;$$

a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$; and in the tables below, in the line of "When $n_1 \geq n_{10}$, $n_{1m} =$", each value in the right columns is "$n_{1m} - n_{10}$"; in the line of "When $n_1 < n_{10}$, $n_{1m} =$", each value in the right columns is "$n_{10} - n_{1m}$"; in the line of "When $k_1 \geq k_{10}$, $k_{1m} =$", each value in the right columns is "$k_{1m} - k_{10}$"; in the line of "When $k_1 < k_{10}$, $k_{1m} =$", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m} =$", each value in the right columns is "$n_{2m} - n_{20}$"; in the line of "When $n_2 < n_{20}$, $n_{2m} =$", each value in the right columns is "$n_{20} - n_{2m}$"; in the line of "When $k_2 \geq k_{20}$, $k_{2m} =$", each value in the right columns is "$k_{2m} - k_{20}$"; in the line of "When $k_2 < k_{20}$, $k_{2m} =$", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

1. 0 < NA ≤ 1. 1

2 ≤ T ≤ 1 5

| Case | 1-01 | 1-02 | 1-03 | 1-04 | 1-05 |
|---|---|---|---|---|---|
| $n_{10}$ | 2.1002530 | 1.9014716 | 1.8817545 | 1.8713707 | 1.8894555 |
| $k_{10}$ | 0.0458360 | 0.1897321 | 0.1528631 | 0.1131033 | 0.1025295 |
| $d_{10}$ (nm) | 25.245 | 35.107 | 29.787 | 20.680 | 13.808 |
| $n_{20}$ | 3.6613926 | 3.6832791 | 2.2496615 | 1.8471360 | 1.7319643 |
| $k_{20}$ | 2.0917723 | 0.6232721 | 0.5909670 | 0.3799287 | 0.2879285 |
| $d_{20}$ (nm) | 4.980 | 30.030 | 58.673 | 139.609 | 214.126 |

| | | 1-01 | 1-02 | 1-03 | 1-04 | 1-05 |
|---|---|---|---|---|---|---|
| When $n_1 \geq n_{10}$, | $n_{1m} =$ | 0.0805884 | 0.0768188 | 0.0754700 | 0.0824719 | 0.1060120 |
| When $n_1 < n_{10}$, | $n_{1m} =$ | 0.0800293 | 0.0653833 | 0.0584985 | 0.0566113 | 0.0706006 |
| When $k_1 \geq k_{10}$, | $k_{1m} =$ | 0.0719092 | 0.0582312 | 0.0563574 | 0.0660449 | 0.0898218 |
| When $k_1 < k_{10}$, | $k_{1m} =$ | 0.0458360 | 0.0865906 | 0.0835730 | 0.0866101 | 0.1025295 |
| When $d_1 \geq d_{10}$, | $d_{1m}$ (nm) = | 3.502 | 5.628 | 6.909 | 7.972 | 7.080 |
| When $d_1 < d_{10}$, | $d_{1m}$ (nm) = | 2.843 | 4.121 | 4.441 | 4.574 | 4.198 |
| When $n_2 \geq n_{20}$, | $n_{2m} =$ | 0.2511194 | 0.1375208 | 0.1500757 | 0.1234998 | 0.1256079 |
| When $n_2 < n_{20}$, | $n_{2m} =$ | 0.2478674 | 0.1642285 | 0.1673572 | 0.1560254 | 0.1556494 |
| When $k_2 \geq k_{20}$, | $k_{2m} =$ | 0.2675171 | 0.1813342 | 0.1899841 | 0.1681030 | 0.1175488 |
| When $k_2 < k_{20}$, | $k_{2m} =$ | 0.2241895 | 0.1363525 | 0.1337048 | 0.1033130 | 0.0926782 |
| When $d_2 \geq d_{20}$, | $d_{2m}$ (nm) = | 0.668 | 1.453 | 8.618 | ∞ | ∞ |
| When $d_2 < d_{20}$, | $d_{2m}$ (nm) = | 0.632 | 1.466 | 7.778 | 59.745 | 82.499 |

1. 0 < NA ≤ 1. 1

2 ≤ T ≤ 1 5

| Case | 1-06 | 1-07 | 1-08 | 1-09 | 1-10 |
|---|---|---|---|---|---|
| $n_{10}$ | 1.8919474 | 1.8730447 | 1.7734811 | 1.7581396 | 1.7209511 |
| $k_{10}$ | 0.0886250 | 0.0995044 | 0.0942049 | 0.0894114 | 0.0778149 |
| $d_{10}$ (nm) | 14.825 | 12.107 | 96.210 | 94.485 | 94.005 |
| $n_{20}$ | 1.7713589 | 1.6971361 | 2.0242448 | 1.8216770 | 1.6746822 |
| $k_{20}$ | 0.2959415 | 0.2384266 | 0.4293783 | 0.2841737 | 0.2144041 |
| $d_{20}$ (nm) | 207.437 | 276.341 | 66.416 | 135.446 | 211.729 |

| | | 1-06 | 1-07 | 1-08 | 1-09 | 1-10 |
|---|---|---|---|---|---|---|
| When $n_1 \geq n_{10}$, | $n_{1m} =$ | 0.1001855 | 0.1196069 | 0.0579333 | 0.0504431 | 0.0487988 |
| When $n_1 < n_{10}$, | $n_{1m} =$ | 0.0678418 | 0.0862451 | 0.0202832 | 0.0122217 | 0.0195996 |
| When $k_1 \geq k_{10}$, | $k_{1m} =$ | 0.0828455 | 0.1086084 | 0.0429993 | 0.0327991 | 0.0449207 |
| When $k_1 < k_{10}$, | $k_{1m} =$ | 0.0886250 | 0.0995044 | 0.0440173 | 0.0383289 | 0.0441089 |
| When $d_1 \geq d_{10}$, | $d_{1m}$ (nm) = | 7.253 | 7.622 | 12.574 | 14.854 | 20.756 |
| When $d_1 < d_{10}$, | $d_{1m}$ (nm) = | 4.294 | 5.017 | 3.736 | 2.430 | 5.594 |
| When $n_2 \geq n_{20}$, | $n_{2m} =$ | 0.1250818 | 0.1274023 | 0.1038489 | 0.1178979 | 0.0654700 |
| When $n_2 < n_{20}$, | $n_{2m} =$ | 0.1542432 | 0.1390320 | 0.1236121 | 0.1075012 | 0.0984851 |
| When $k_2 \geq k_{20}$, | $k_{2m} =$ | 0.1281506 | 0.1059973 | 0.1023560 | 0.1052271 | 0.0726978 |
| When $k_2 < k_{20}$, | $k_{2m} =$ | 0.0937659 | 0.0853320 | 0.1026587 | 0.0735156 | 0.0618335 |
| When $d_2 \geq d_{20}$, | $d_{2m}$ (nm) = | ∞ | ∞ | 5.946 | 13.526 | ∞ |
| When $d_2 < d_{20}$, | $d_{2m}$ (nm) = | 79.532 | 130.356 | 6.729 | 7.895 | 26.663 |

1. 0 < N A ≤ 1. 1

2 ≤ T ≤ 1 5

| Case | 1-11 | 1-12 | 1-13 | 1-14 | 1-15 |
|---|---|---|---|---|---|
| $n_{10}$ | 1.7166765 | 1.7166130 | 1.7322234 | 1.7049421 | 1.7064564 |
| $k_{10}$ | 0.0677623 | 0.0755230 | 0.0835200 | 0.0655754 | 0.0573750 |
| $d_{10}$ (nm) | 92.667 | 182.689 | 166.765 | 163.194 | 160.636 |
| $n_{20}$ | 1.6766991 | 6.5634515 | 1.9262925 | 1.6664527 | 1.6879767 |
| $k_{20}$ | 0.1797231 | 3.2079655 | 0.3700807 | 0.1954874 | 0.1655431 |
| $d_{20}$ (nm) | 270.198 | 1.017 | 69.546 | 208.736 | 264.028 |

| | | 1-11 | 1-12 | 1-13 | 1-14 | 1-15 |
|---|---|---|---|---|---|---|
| When $n_1 \geq n_{10}$, | $n_{1m} =$ | 0.0538269 | 0.0791455 | 0.0502930 | 0.0463574 | 0.0530786 |
| When $n_1 < n_{10}$, | $n_{1m} =$ | 0.0365198 | 0.0150903 | 0.0019495 | 0.0298389 | 0.0507080 |
| When $k_1 \geq k_{10}$, | $k_{1m} =$ | 0.0633020 | 0.0382202 | 0.0176428 | 0.0426367 | 0.0606909 |
| When $k_1 < k_{10}$, | $k_{1m} =$ | 0.0490027 | 0.0352063 | 0.0101367 | 0.0363086 | 0.0412036 |
| When $d_1 \geq d_{10}$, | $d_{1m}$ (nm) $=$ | ∞ | 44.970 | 29.513 | ∞ | ∞ |
| When $d_1 < d_{10}$, | $d_{1m}$ (nm) $=$ | 11.921 | 5.503 | 0.534 | 14.465 | 82.763 |
| When $n_2 \geq n_{20}$, | $n_{2m} =$ | 0.0746594 | 0.3760779 | 0.0943127 | 0.0451807 | 0.0846008 |
| When $n_2 < n_{20}$, | $n_{2m} =$ | 0.1088159 | 0.6761377 | 0.0252344 | 0.0894604 | 0.1080103 |
| When $k_2 \geq k_{20}$, | $k_{2m} =$ | 0.0728833 | 0.4281982 | 0.0109839 | 0.0413684 | 0.0543652 |
| When $k_2 < k_{20}$, | $k_{2m} =$ | 0.0561267 | 0.6156824 | 0.0921399 | 0.0546765 | 0.0510388 |
| When $d_2 \geq d_{20}$, | $d_{2m}$ (nm) $=$ | ∞ | 0.095 | 5.760 | ∞ | ∞ |
| When $d_2 < d_{20}$, | $d_{2m}$ (nm) $=$ | 76.266 | 0.159 | 0.905 | 22.049 | 32.675 |

1. 0 < N A ≤ 1. 1

2 ≤ T ≤ 1 5

| Case | 1-16 | 1-17 | 1-18 | 1-19 | 1-20 |
|---|---|---|---|---|---|
| $n_{10}$ | 1.6929499 | 1.6905856 | 1.6919500 | 1.6995270 | 1.6946661 |
| $k_{10}$ | 0.0758677 | 0.0724871 | 0.0673580 | 0.0541447 | 0.0598692 |
| $d_{10}$ (nm) | 218.538 | 210.998 | 207.119 | 221.890 | 292.769 |
| $n_{20}$ | 1.7888879 | 1.7113381 | 1.6973679 | 1.6914313 | 5.7902895 |
| $k_{20}$ | 0.3373861 | 0.2424201 | 0.1951159 | 0.1602785 | 2.6464640 |
| $d_{20}$ (nm) | 83.914 | 155.877 | 222.394 | 261.841 | 1.370 |

| | | 1-16 | 1-17 | 1-18 | 1-19 | 1-20 |
|---|---|---|---|---|---|---|
| When $n_1 \geq n_{10}$, | $n_{1m} =$ | 0.0154590 | 0.0284326 | 0.0459937 | 0.0695007 | 0.0688428 |
| When $n_1 < n_{10}$, | $n_{1m} =$ | 0.0644519 | 0.0618115 | 0.0647253 | 0.0614612 | 0.0576074 |
| When $k_1 \geq k_{10}$, | $k_{1m} =$ | 0.0296802 | 0.0451062 | 0.0571143 | 0.0607031 | 0.0650110 |
| When $k_1 < k_{10}$, | $k_{1m} =$ | 0.0222290 | 0.0323779 | 0.0391223 | 0.0380823 | 0.0345483 |
| When $d_1 \geq d_{10}$, | $d_{1m}$ (nm) $=$ | 8.212 | ∞ | ∞ | ∞ | ∞ |
| When $d_1 < d_{10}$, | $d_{1m}$ (nm) $=$ | 25.706 | 29.733 | 39.073 | 91.262 | 43.839 |
| When $n_2 \geq n_{20}$, | $n_{2m} =$ | 0.1222742 | 0.1267554 | 0.1643848 | 0.2245898 | 0.7013342 |
| When $n_2 < n_{20}$, | $n_{2m} =$ | 0.0248633 | 0.0660693 | 0.1720679 | 0.1025806 | 0.7193848 |
| When $k_2 \geq k_{20}$, | $k_{2m} =$ | 0.0580225 | 0.0965234 | 0.1267737 | 0.1053369 | 0.5239075 |
| When $k_2 < k_{20}$, | $k_{2m} =$ | 0.0934216 | 0.0846191 | 0.0756384 | 0.0566919 | 0.6531299 |
| When $d_2 \geq d_{20}$, | $d_{2m}$ (nm) $=$ | 16.998 | ∞ | ∞ | ∞ | 0.304 |
| When $d_2 < d_{20}$, | $d_{2m}$ (nm) $=$ | 2.716 | 12.405 | 72.248 | 75.278 | 0.354 |

1. $0 < NA \le 1.1$

$2 \le T \le 15$

| Case | 1-21 | 1-22 | 1-23 | 1-24 |
|---|---|---|---|---|
| $n_{10}$ | 1.6927273 | 1.6938682 | 1.6959215 | 1.6965163 |
| $k_{10}$ | 0.0641185 | 0.0632641 | 0.0601626 | 0.0560943 |
| $d_{10}$ (nm) | 275.960 | 269.814 | 266.236 | 263.874 |
| $n_{20}$ | 1.7993913 | 1.7248410 | 1.7076727 | 1.6984359 |
| $k_{20}$ | 0.3510467 | 0.2487428 | 0.2009217 | 0.1709410 |
| $d_{20}$ (nm) | 81.101 | 150.052 | 214.823 | 277.894 |

| | | 1-21 | 1-22 | 1-23 | 1-24 |
|---|---|---|---|---|---|
| When $n_1 \ge n_{10}$, | $n_{1m}=$ | 0.0462292 | 0.0536658 | 0.0656104 | 0.0800903 |
| When $n_1 < n_{10}$, | $n_{1m}=$ | 0.0484851 | 0.0418225 | 0.0432129 | 0.0552332 |
| When $k_1 \ge k_{10}$, | $k_{1m}=$ | 0.0620630 | 0.0619458 | 0.0615613 | 0.0629382 |
| When $k_1 < k_{10}$, | $k_{1m}=$ | 0.0362708 | 0.0377515 | 0.0406262 | 0.0422571 |
| When $d_1 \ge d_{10}$, | $d_{1m}$ (nm) $=$ | $\infty$ | $\infty$ | $\infty$ | $\infty$ |
| When $d_1 < d_{10}$, | $d_{1m}$ (nm) $=$ | 29.467 | 27.448 | 97.485 | 175.134 |
| When $n_2 \ge n_{20}$, | $n_{2m}=$ | 0.1596558 | 0.1810303 | 0.3970593 | 0.3365332 |
| When $n_2 < n_{20}$, | $n_{2m}=$ | 0.1100391 | 0.2908167 | 0.2424414 | 0.2178503 |
| When $k_2 \ge k_{20}$, | $k_{2m}=$ | 0.1557141 | 0.1886804 | 0.2145630 | 0.2194727 |
| When $k_2 < k_{20}$, | $k_{2m}=$ | 0.1210901 | 0.1012720 | 0.0897449 | 0.0805957 |
| When $d_2 \ge d_{20}$, | $d_{2m}$ (nm) $=$ | 25.591 | $\infty$ | $\infty$ | $\infty$ |
| When $d_2 < d_{20}$, | $d_{2m}$ (nm) $=$ | 9.432 | 27.332 | 78.495 | 131.894 |

1. $0 < NA \leq 1.1$

$15 < T \leq 25$

| Case | 2-01 | 2-02 | 2-03 | 2-04 | 2-05 |
|---|---|---|---|---|---|
| $n_{10}$ | 1.8588603 | 1.8671897 | 1.8793061 | 1.8953035 | 1.8743725 |
| $k_{10}$ | 0.2152026 | 0.2000001 | 0.1213485 | 0.0980077 | 0.1084578 |
| $d_{10}$ (nm) | 37.726 | 35.681 | 21.414 | 14.908 | 12.201 |
| $n_{20}$ | 5.0977045 | 3.0932325 | 1.8727645 | 1.7635602 | 1.6884757 |
| $k_{20}$ | 0.6974562 | 0.7063642 | 0.4149520 | 0.3109442 | 0.2470663 |
| $d_{20}$ (nm) | 19.647 | 34.687 | 129.308 | 200.446 | 269.437 |

| | | 2-01 | 2-02 | 2-03 | 2-04 | 2-05 |
|---|---|---|---|---|---|---|
| When $n_1 \geq n_{10}$, | $n_{1m} =$ | 0.0758728 | 0.0747766 | 0.0798340 | 0.0988049 | 0.1178149 |
| When $n_1 < n_{10}$, | $n_{1m} =$ | 0.0592542 | 0.0589661 | 0.0549634 | 0.0658325 | 0.0841418 |
| When $k_1 \geq k_{10}$, | $k_{1m} =$ | 0.0598401 | 0.0578650 | 0.0632202 | 0.0814417 | 0.1076917 |
| When $k_1 < k_{10}$, | $k_{1m} =$ | 0.0788342 | 0.0811694 | 0.0865027 | 0.0980077 | 0.1084578 |
| When $d_1 \geq d_{10}$, | $d_{1m}$ (nm) $=$ | 5.593 | 5.891 | 7.449 | 6.933 | 7.359 |
| When $d_1 < d_{10}$, | $d_{1m}$ (nm) $=$ | 4.233 | 4.238 | 4.249 | 4.053 | 4.794 |
| When $n_2 \geq n_{20}$, | $n_{2m} =$ | 0.1534875 | 0.1581152 | 0.1275403 | 0.1254932 | 0.1262524 |
| When $n_2 < n_{20}$, | $n_{2m} =$ | 0.1697559 | 0.1894849 | 0.1565967 | 0.1540796 | 0.1389709 |
| When $k_2 \geq k_{20}$, | $k_{2m} =$ | 0.1955396 | 0.2168408 | 0.1812842 | 0.1267053 | 0.1044556 |
| When $k_2 < k_{20}$, | $k_{2m} =$ | 0.1505579 | 0.1602844 | 0.1066724 | 0.0950110 | 0.0860864 |
| When $d_2 \geq d_{20}$, | $d_{2m}$ (nm) $=$ | 0.659 | 2.512 | $\infty$ | $\infty$ | $\infty$ |
| When $d_2 < d_{20}$, | $d_{2m}$ (nm) $=$ | 0.674 | 2.526 | 26.047 | 76.118 | 126.536 |

1．０＜ＮＡ≦１．１
１５＜Ｔ≦２５

| Case | 2-06 | 2-07 | 2-08 | 2-09 | 2-10 |
|---|---|---|---|---|---|
| $n_{10}$ | 1.7693190 | 1.8089249 | 1.7628339 | 1.7223442 | 1.7176215 |
| $k_{10}$ | 0.1013402 | 0.1064114 | 0.0939832 | 0.0810686 | 0.0701007 |
| $d_{10}$ (nm) | 103.520 | 98.052 | 94.416 | 93.840 | 92.613 |
| $n_{20}$ | 3.2583829 | 3.5132584 | 1.8414170 | 1.6728089 | 1.6759231 |
| $k_{20}$ | 2.5781374 | 0.5501157 | 0.3092618 | 0.2260423 | 0.1876577 |
| $d_{20}$ (nm) | 3.121 | 29.615 | 125.923 | 203.086 | 261.422 |

| | | 2-06 | 2-07 | 2-08 | 2-09 | 2-10 |
|---|---|---|---|---|---|---|
| When $n_1 \geq n_{10}$, | $n_{1m}=$ | 0.0673926 | 0.0573926 | 0.0482458 | 0.0469287 | 0.0525317 |
| When $n_1 < n_{10}$, | $n_{1m}=$ | 0.0182031 | 0.0185083 | 0.0097595 | 0.0170142 | 0.0338733 |
| When $k_1 \geq k_{10}$, | $k_{1m}=$ | 0.0401636 | 0.0390552 | 0.0281750 | 0.0413513 | 0.0608655 |
| When $k_1 < k_{10}$, | $k_{1m}=$ | 0.0427917 | 0.0434326 | 0.0360242 | 0.0422778 | 0.0485864 |
| When $d_1 \geq d_{10}$, | $d_{1m}$ (nm) $=$ | 13.610 | 8.991 | 12.525 | 18.295 | 32.066 |
| When $d_1 < d_{10}$, | $d_{1m}$ (nm) $=$ | 3.396 | 2.738 | 1.840 | 4.621 | 10.547 |
| When $n_2 \geq n_{20}$, | $n_{2m}=$ | 0.2210974 | 0.0961951 | 0.1120178 | 0.0558118 | 0.0724255 |
| When $n_2 < n_{20}$, | $n_{2m}=$ | 0.3992041 | 0.1262915 | 0.1064856 | 0.0968689 | 0.1070728 |
| When $k_2 \geq k_{20}$, | $k_{2m}=$ | 0.3438342 | 0.0862598 | 0.0939502 | 0.0666077 | 0.0700989 |
| When $k_2 < k_{20}$, | $k_{2m}=$ | 0.3502100 | 0.1067542 | 0.0758923 | 0.0625208 | 0.0568274 |
| When $d_2 \geq d_{20}$, | $d_{2m}$ (nm) $=$ | 0.375 | 0.986 | 11.083 | ∞ | ∞ |
| When $d_2 < d_{20}$, | $d_{2m}$ (nm) $=$ | 0.497 | 1.167 | 5.972 | 24.056 | 73.630 |

１．０＜ＮＡ≦１．１
１５＜Ｔ≦２５

| Case | 2-11 | 2-12 | 2-13 | 2-14 | 2-15 |
|---|---|---|---|---|---|
| $n_{10}$ | 1.7053748 | 1.7067869 | 1.7234396 | 1.7309823 | 1.6924662 |
| $k_{10}$ | 0.0681661 | 0.0592936 | 0.0819972 | 0.0887627 | 0.0804140 |
| $d_{10}$ (nm) | 163.030 | 160.569 | 177.819 | 175.110 | 219.254 |
| $n_{20}$ | 1.6640911 | 1.6873274 | 5.0800961 | 9.5526510 | 1.8031504 |
| $k_{20}$ | 0.2056957 | 0.1726858 | 4.2173316 | 0.4602806 | 0.3794202 |
| $d_{20}$ (nm) | 200.113 | 255.377 | 1.054 | 10.232 | 74.951 |

| | | 2-11 | 2-12 | 2-13 | 2-14 | 2-15 |
|---|---|---|---|---|---|---|
| When $n_1 \geq n_{10}$, | $n_{1m}=$ | 0.0438354 | 0.0515637 | 0.0646301 | 0.0589197 | 0.0054749 |
| When $n_1 < n_{10}$, | $n_{1m}=$ | 0.0254907 | 0.0493457 | 0.0095056 | 0.0049573 | 0.0624841 |
| When $k_1 \geq k_{10}$, | $k_{1m}=$ | 0.0375134 | 0.0575159 | 0.0321326 | 0.0226172 | 0.0163196 |
| When $k_1 < k_{10}$, | $k_{1m}=$ | 0.0331799 | 0.0410168 | 0.0264954 | 0.0199707 | 0.0128040 |
| When $d_1 \geq d_{10}$, | $d_{1m}$ (nm) $=$ | ∞ | ∞ | 31.849 | 25.868 | 2.747 |
| When $d_1 < d_{10}$, | $d_{1m}$ (nm) $=$ | 12.067 | 30.487 | 3.026 | 1.416 | 23.308 |
| When $n_2 \geq n_{20}$, | $n_{2m}=$ | 0.0383606 | 0.0825500 | 0.3294275 | 0.0929846 | 0.1306152 |
| When $n_2 < n_{20}$, | $n_{2m}=$ | 0.0871460 | 0.1052795 | 0.6618042 | 0.0695691 | 0.0087109 |
| When $k_2 \geq k_{20}$, | $k_{2m}=$ | 0.0339417 | 0.0505530 | 0.2910742 | 0.0198328 | 0.0299487 |
| When $k_2 < k_{20}$, | $k_{2m}=$ | 0.0549512 | 0.0515552 | 0.6908167 | 0.0870068 | 0.0872510 |
| When $d_2 \geq d_{20}$, | $d_{2m}$ (nm) $=$ | ∞ | ∞ | 0.079 | 0.102 | 14.451 |
| When $d_2 < d_{20}$, | $d_{2m}$ (nm) $=$ | 19.637 | 29.589 | 0.186 | 0.076 | 0.824 |

1. 0 < N A ≤ 1. 1
1 5 < T ≤ 2 5

| Case | 2-16 | 2-17 | 2-18 | 2-19 | 2-20 |
|---|---|---|---|---|---|
| $n_{10}$ | 1.6899914 | 1.6915311 | 1.6993450 | 1.6920076 | 1.6934597 |
| $k_{10}$ | 0.0755734 | 0.0696615 | 0.0558443 | 0.0677866 | 0.0658489 |
| $d_{10}$ (nm) | 211.286 | 207.258 | 221.722 | 276.645 | 270.093 |
| $n_{20}$ | 1.7113670 | 1.6964473 | 1.6905618 | 1.8143335 | 1.7261499 |
| $k_{20}$ | 0.2592681 | 0.2049428 | 0.1670525 | 0.3967808 | 0.2668883 |
| $d_{20}$ (nm) | 147.090 | 213.635 | 253.347 | 72.378 | 141.360 |

| | | 2-16 | 2-17 | 2-18 | 2-19 | 2-20 |
|---|---|---|---|---|---|---|
| When $n_1 \geq n_{10}$, | $n_{1m} =$ | 0.0235022 | 0.0424463 | 0.0685596 | 0.0429663 | 0.0523279 |
| When $n_1 < n_{10}$, | $n_{1m} =$ | 0.0594971 | 0.0645703 | 0.0572424 | 0.0479932 | 0.0410938 |
| When $k_1 \geq k_{10}$, | $k_{1m} =$ | 0.0403162 | 0.0547461 | 0.0583691 | 0.0593103 | 0.0600049 |
| When $k_1 < k_{10}$, | $k_{1m} =$ | 0.0289734 | 0.0380127 | 0.0376013 | 0.0355176 | 0.0379749 |
| When $d_1 \geq d_{10}$, | $d_{1m}$ (nm) = | 18.036 | ∞ | ∞ | ∞ | ∞ |
| When $d_1 < d_{10}$, | $d_{1m}$ (nm) = | 26.582 | 37.673 | 84.779 | 28.006 | 25.642 |
| When $n_2 \geq n_{20}$, | $n_{2m} =$ | 0.1259094 | 0.1555469 | 0.2302234 | 0.1717712 | 0.1831995 |
| When $n_2 < n_{20}$, | $n_{2m} =$ | 0.0501526 | 0.1747144 | 0.0944592 | 0.1059167 | 0.2850769 |
| When $k_2 \geq k_{20}$, | $k_{2m} =$ | 0.0866736 | 0.1221960 | 0.1032471 | 0.1537634 | 0.1870032 |
| When $k_2 < k_{20}$, | $k_{2m} =$ | 0.0848877 | 0.0779785 | 0.0578296 | 0.1330688 | 0.1069617 |
| When $d_2 \geq d_{20}$, | $d_{2m}$ (nm) = | ∞ | ∞ | ∞ | 19.935 | ∞ |
| When $d_2 < d_{20}$, | $d_{2m}$ (nm) = | 9.771 | 69.780 | 73.090 | 7.607 | 20.837 |

1. 0 < N A ≤ 1. 1
1 5 < T ≤ 2 5

| Case | 2-21 | 2-22 |
|---|---|---|
| $n_{10}$ | 1.6956703 | 1.6963391 |
| $k_{10}$ | 0.0621151 | 0.0576411 |
| $d_{10}$ (nm) | 266.327 | 263.935 |
| $n_{20}$ | 1.7069279 | 1.6975975 |
| $k_{20}$ | 0.2113995 | 0.1780179 |
| $d_{20}$ (nm) | 206.262 | 269.259 |

| | | 2-21 | 2-22 |
|---|---|---|---|
| When $n_1 \geq n_{10}$, | $n_{1m} =$ | 0.0646936 | 0.0790869 |
| When $n_1 < n_{10}$, | $n_{1m} =$ | 0.0423181 | 0.0536755 |
| When $k_1 \geq k_{10}$, | $k_{1m} =$ | 0.0600012 | 0.0616785 |
| When $k_1 < k_{10}$, | $k_{1m} =$ | 0.0403015 | 0.0417126 |
| When $d_1 \geq d_{10}$, | $d_{1m}$ (nm) = | ∞ | ∞ |
| When $d_1 < d_{10}$, | $d_{1m}$ (nm) = | 96.199 | 173.391 |
| When $n_2 \geq n_{20}$, | $n_{2m} =$ | 0.4184778 | 0.3488293 |
| When $n_2 < n_{20}$, | $n_{2m} =$ | 0.2491736 | 0.2216455 |
| When $k_2 \geq k_{20}$, | $k_{2m} =$ | 0.2142920 | 0.2197681 |
| When $k_2 < k_{20}$, | $k_{2m} =$ | 0.0934741 | 0.0831250 |
| When $d_2 \geq d_{20}$, | $d_{2m}$ (nm) = | ∞ | ∞ |
| When $d_2 < d_{20}$, | $d_{2m}$ (nm) = | 76.168 | 129.228 |

1. 0 < N A ≤ 1. 1
2 5 < T ≤ 3 5

| Case | 3-01 | 3-02 | 3-03 | 3-04 | 3-05 |
|---|---|---|---|---|---|
| $n_{10}$ | 1.8231304 | 1.8934062 | 1.9014262 | 1.8787814 | 1.8198973 |
| $k_{10}$ | 0.2426967 | 0.1289044 | 0.1029443 | 0.1135143 | 0.1197953 |
| $d_{10}$ (nm) | 38.982 | 22.067 | 15.306 | 12.334 | 96.975 |
| $n_{20}$ | 4.7825941 | 1.9169501 | 1.7714781 | 1.6867670 | 4.7572984 |
| $k_{20}$ | 0.7852430 | 0.4577317 | 0.3309508 | 0.2583639 | 0.6218490 |
| $d_{20}$ (nm) | 19.992 | 118.684 | 191.572 | 261.269 | 20.274 |

| | | 3-01 | 3-02 | 3-03 | 3-04 | 3-05 |
|---|---|---|---|---|---|---|
| When $n_1 \geq n_{10}$, | $n_{1m} =$ | 0.0699695 | 0.0767236 | 0.0951282 | 0.1154443 | 0.0479663 |
| When $n_1 < n_{10}$, | $n_{1m} =$ | 0.0498486 | 0.0532642 | 0.0626563 | 0.0817676 | 0.0146021 |
| When $k_1 \geq k_{10}$, | $k_{1m} =$ | 0.0588489 | 0.0605774 | 0.0772998 | 0.1052600 | 0.0370215 |
| When $k_1 < k_{10}$, | $k_{1m} =$ | 0.0707385 | 0.0857886 | 0.1011462 | 0.1135143 | 0.0364331 |
| When $d_1 \geq d_{10}$, | $d_{1m}$ (nm) $=$ | 5.137 | 6.730 | 6.574 | 7.047 | 7.725 |
| When $d_1 < d_{10}$, | $d_{1m}$ (nm) $=$ | 3.775 | 3.826 | 3.782 | 4.562 | 2.005 |
| When $n_2 \geq n_{20}$, | $n_{2m} =$ | 0.1872302 | 0.1343799 | 0.1259058 | 0.1236719 | 0.1156909 |
| When $n_2 < n_{20}$, | $n_{2m} =$ | 0.2029309 | 0.1567590 | 0.1523523 | 0.1408569 | 0.1282800 |
| When $k_2 \geq k_{20}$, | $k_{2m} =$ | 0.2449841 | 0.2003137 | 0.1294177 | 0.1036865 | 0.0748242 |
| When $k_2 < k_{20}$, | $k_{2m} =$ | 0.1832959 | 0.1099609 | 0.0962476 | 0.0870068 | 0.1199268 |
| When $d_2 \geq d_{20}$, | $d_{2m}$ (nm) $=$ | 0.864 | ∞ | ∞ | ∞ | 0.532 |
| When $d_2 < d_{20}$, | $d_{2m}$ (nm) $=$ | 0.839 | 21.916 | 71.881 | 121.487 | 0.552 |

1. 0 < N A ≤ 1. 1
2 5 < T ≤ 3 5

| Case | 3-06 | 3-07 | 3-08 | 3-09 | 3-10 |
|---|---|---|---|---|---|
| $n_{10}$ | 1.7669399 | 1.7235821 | 1.7188964 | 1.7058208 | 1.7073313 |
| $k_{10}$ | 0.0997580 | 0.0847397 | 0.0726255 | 0.0710513 | 0.0613671 |
| $d_{10}$ (nm) | 94.208 | 93.618 | 92.505 | 162.764 | 160.462 |
| $n_{20}$ | 1.8558060 | 1.6692590 | 1.6760484 | 1.6616172 | 1.6880654 |
| $k_{20}$ | 0.3364471 | 0.2394056 | 0.1967286 | 0.2176394 | 0.1807904 |
| $d_{20}$ (nm) | 117.969 | 195.006 | 252.779 | 191.801 | 246.769 |

| | | 3-06 | 3-07 | 3-08 | 3-09 | 3-10 |
|---|---|---|---|---|---|---|
| When $n_1 \geq n_{10}$, | $n_{1m} =$ | 0.0449036 | 0.0442456 | 0.0506409 | 0.0405530 | 0.0497949 |
| When $n_1 < n_{10}$, | $n_{1m} =$ | 0.0058435 | 0.0142969 | 0.0314514 | 0.0176917 | 0.0472620 |
| When $k_1 \geq k_{10}$, | $k_{1m} =$ | 0.0200403 | 0.0369336 | 0.0583228 | 0.0316150 | 0.0541370 |
| When $k_1 < k_{10}$, | $k_{1m} =$ | 0.0309863 | 0.0404504 | 0.0477759 | 0.0303076 | 0.0405200 |
| When $d_1 \geq d_{10}$, | $d_{1m}$ (nm) $=$ | 10.713 | 16.167 | 24.298 | ∞ | ∞ |
| When $d_1 < d_{10}$, | $d_{1m}$ (nm) $=$ | 1.043 | 3.709 | 9.337 | 7.078 | 23.845 |
| When $n_2 \geq n_{20}$, | $n_{2m} =$ | 0.1063135 | 0.0450122 | 0.0699963 | 0.0309314 | 0.0781641 |
| When $n_2 < n_{20}$, | $n_{2m} =$ | 0.1037158 | 0.0932996 | 0.1043005 | 0.0818408 | 0.1014221 |
| When $k_2 \geq k_{20}$, | $k_{2m} =$ | 0.0686243 | 0.0581018 | 0.0668628 | 0.0258777 | 0.0465137 |
| When $k_2 < k_{20}$, | $k_{2m} =$ | 0.0768091 | 0.0625977 | 0.0574854 | 0.0546838 | 0.0521045 |
| When $d_2 \geq d_{20}$, | $d_{2m}$ (nm) $=$ | 9.637 | ∞ | ∞ | 13.452 | ∞ |
| When $d_2 < d_{20}$, | $d_{2m}$ (nm) $=$ | 3.465 | 21.705 | 32.653 | 17.168 | 25.940 |

1. 0 < N A ≤ 1. 1
2 5 < T ≤ 3 5

| Case | 3-11 | 3-12 | 3-13 | 3-14 | 3-15 |
|---|---|---|---|---|---|
| $n_{10}$ | 1.6893950 | 1.6912149 | 1.6993872 | 1.6931110 | 1.6955537 |
| $k_{10}$ | 0.0792587 | 0.0722082 | 0.0576769 | 0.0689939 | 0.0643335 |
| $d_{10}$ (nm) | 211.356 | 207.241 | 221.603 | 270.168 | 266.333 |
| $n_{20}$ | 1.7121469 | 1.6964479 | 1.6911809 | 1.7281714 | 1.7074500 |
| $k_{20}$ | 0.2795726 | 0.2163033 | 0.1749036 | 0.2885226 | 0.2235939 |
| $d_{20}$ (nm) | 139.203 | 205.754 | 244.825 | 133.446 | 198.195 |

| | | 3-11 | 3-12 | 3-13 | 3-14 | 3-15 |
|---|---|---|---|---|---|---|
| When $n_1 \geq n_{10}$, | $n_{1m} =$ | 0.0187524 | 0.0389221 | 0.0673108 | 0.0502356 | 0.0624109 |
| When $n_1 < n_{10}$, | $n_{1m} =$ | 0.0561719 | 0.0620898 | 0.0525073 | 0.0397852 | 0.0411060 |
| When $k_1 \geq k_{10}$, | $k_{1m} =$ | 0.0323267 | 0.0510889 | 0.0557678 | 0.0576538 | 0.0581616 |
| When $k_1 < k_{10}$, | $k_{1m} =$ | 0.0242261 | 0.0363989 | 0.0368542 | 0.0366370 | 0.0397400 |
| When $d_1 \geq d_{10}$, | $d_{1m}$ (nm) $=$ | 9.539 | ∞ | ∞ | ∞ | ∞ |
| When $d_1 < d_{10}$, | $d_{1m}$ (nm) $=$ | 23.792 | 36.062 | 80.743 | 23.618 | 94.755 |
| When $n_2 \geq n_{20}$, | $n_{2m} =$ | 0.1258521 | 0.1531580 | 0.2394678 | 0.1860962 | 0.4430444 |
| When $n_2 < n_{20}$, | $n_{2m} =$ | 0.0334863 | 0.1783936 | 0.0871167 | 0.1489648 | 0.2583777 |
| When $k_2 \geq k_{20}$, | $k_{2m} =$ | 0.0734656 | 0.1167761 | 0.1010718 | 0.1855286 | 0.2138647 |
| When $k_2 < k_{20}$, | $k_{2m} =$ | 0.0783704 | 0.0804089 | 0.0594067 | 0.1140149 | 0.0979895 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 6.823 | 66.025 | 33.786 | 17.363 | 72.201 |

1. 0 < N A ≤ 1. 1
2 5 < T ≤ 3 5

| Case | 3-16 |
|---|---|
| $n_{10}$ | 1.6962507 |
| $k_{10}$ | 0.0593120 |
| $d_{10}$ (nm) | 263.960 |
| $n_{20}$ | 1.6977843 |
| $k_{20}$ | 0.1860709 |
| $d_{20}$ (nm) | 261.024 |

| | | 3-16 |
|---|---|---|
| When $n_1 \geq n_{10}$, | $n_{1m} =$ | 0.0782690 |
| When $n_1 < n_{10}$, | $n_{1m} =$ | 0.0522693 |
| When $k_1 \geq k_{10}$, | $k_{1m} =$ | 0.0602515 |
| When $k_1 < k_{10}$, | $k_{1m} =$ | 0.0408899 |
| When $d_1 \geq d_{10}$, | $d_{1m}$ (nm) $=$ | ∞ |
| When $d_1 < d_{10}$, | $d_{1m}$ (nm) $=$ | 119.700 |
| When $n_2 \geq n_{20}$, | $n_{2m} =$ | 0.3636609 |
| When $n_2 < n_{20}$, | $n_{2m} =$ | 0.2256018 |
| When $k_2 \geq k_{20}$, | $k_{2m} =$ | 0.2198901 |
| When $k_2 < k_{20}$, | $k_{2m} =$ | 0.0864600 |
| When $d_2 \geq d_{20}$, | $d_{2m}$ (nm) $=$ | ∞ |
| When $d_2 < d_{20}$, | $d_{2m}$ (nm) $=$ | 97.445 |

1．0＜NA≦1．1
35＜T≦45

| Case | 4-01 | 4-02 | 4-03 | 4-04 | 4-05 |
|---|---|---|---|---|---|
| $n_{10}$ | 1.8741027 | 1.9162345 | 1.9099224 | 1.8839284 | 1.7973698 |
| $k_{10}$ | 0.2292405 | 0.1358555 | 0.1141224 | 0.1193744 | 0.1226911 |
| $d_{10}$ (nm) | 31.502 | 21.455 | 14.789 | 12.268 | 93.176 |
| $n_{20}$ | 2.4589695 | 1.9418040 | 1.7536831 | 1.6821215 | 2.1323779 |
| $k_{20}$ | 0.9273915 | 0.4998799 | 0.3442834 | 0.2672652 | 0.6525391 |
| $d_{20}$ (nm) | 39.688 | 110.373 | 186.067 | 253.238 | 46.828 |

| | | 4-01 | 4-02 | 4-03 | 4-04 | 4-05 |
|---|---|---|---|---|---|---|
| When $n_1 \geq n_{10}$, | $n_{1m}=$ | 0.0646472 | 0.0749023 | 0.0953894 | 0.1145032 | 0.0393335 |
| When $n_1 < n_{10}$, | $n_{1m}=$ | 0.0466125 | 0.0512402 | 0.0611060 | 0.0810242 | 0.0058411 |
| When $k_1 \geq k_{10}$, | $k_{1m}=$ | 0.0535095 | 0.0588599 | 0.0769971 | 0.1049219 | 0.0222083 |
| When $k_1 < k_{10}$, | $k_{1m}=$ | 0.0782300 | 0.0839917 | 0.1022253 | 0.1138464 | 0.0267273 |
| When $d_1 \geq d_{10}$, | $d_{1m}$ (nm) $=$ | 4.763 | 5.873 | 6.052 | 6.690 | 7.237 |
| When $d_1 < d_{10}$, | $d_{1m}$ (nm) $=$ | 3.092 | 3.244 | 3.414 | 4.349 | 0.847 |
| When $n_2 \geq n_{20}$, | $n_{2m}=$ | 0.2061353 | 0.1383777 | 0.1254065 | 0.1201538 | 0.0908765 |
| When $n_2 < n_{20}$, | $n_{2m}=$ | 0.1985669 | 0.1593604 | 0.1521448 | 0.1405737 | 0.1202173 |
| When $k_2 \geq k_{20}$, | $k_{2m}=$ | 0.2506677 | 0.2047961 | 0.1231897 | 0.1019714 | 0.0402307 |
| When $k_2 < k_{20}$, | $k_{2m}=$ | 0.1792896 | 0.1103943 | 0.0960205 | 0.0872583 | 0.1042542 |
| When $d_2 \geq d_{20}$, | $d_{2m}$ (nm) $=$ | 6.142 | ∞ | ∞ | ∞ | 4.028 |
| When $d_2 < d_{20}$, | $d_{2m}$ (nm) $=$ | 4.657 | 20.982 | 70.019 | 92.164 | 2.915 |

1．0＜NA≦1．1
35＜T≦45

| Case | 4-06 | 4-07 | 4-08 | 4-09 | 4-10 |
|---|---|---|---|---|---|
| $n_{10}$ | 1.7231751 | 1.7198225 | 1.7057007 | 1.7079030 | 1.6886446 |
| $k_{10}$ | 0.0881939 | 0.0748307 | 0.0735111 | 0.0631371 | 0.0826816 |
| $d_{10}$ (nm) | 93.194 | 92.273 | 162.218 | 160.241 | 210.810 |
| $n_{20}$ | 1.6583398 | 1.6753837 | 1.6560667 | 1.6895692 | 1.7077667 |
| $k_{20}$ | 0.2493789 | 0.2040438 | 0.2270715 | 0.1875698 | 0.2975930 |
| $d_{20}$ (nm) | 187.627 | 244.025 | 183.673 | 237.741 | 132.542 |

| | | 4-06 | 4-07 | 4-08 | 4-09 | 4-10 |
|---|---|---|---|---|---|---|
| When $n_1 \geq n_{10}$, | $n_{1m}=$ | 0.0413782 | 0.0488660 | 0.0374475 | 0.0482141 | 0.0106323 |
| When $n_1 < n_{10}$, | $n_{1m}=$ | 0.0123999 | 0.0300476 | 0.0153528 | 0.0446057 | 0.0519153 |
| When $k_1 \geq k_{10}$, | $k_{1m}=$ | 0.0333630 | 0.0568799 | 0.0277051 | 0.0515784 | 0.0235608 |
| When $k_1 < k_{10}$, | $k_{1m}=$ | 0.0393298 | 0.0467004 | 0.0300195 | 0.0397412 | 0.0190234 |
| When $d_1 \geq d_{10}$, | $d_{1m}$ (nm) $=$ | 13.894 | 20.818 | 24.657 | ∞ | 6.948 |
| When $d_1 < d_{10}$, | $d_{1m}$ (nm) $=$ | 3.123 | 8.547 | 5.758 | 21.149 | 21.403 |
| When $n_2 \geq n_{20}$, | $n_{2m}=$ | 0.0360730 | 0.0689490 | 0.0276392 | 0.0753564 | 0.1220337 |
| When $n_2 < n_{20}$, | $n_{2m}=$ | 0.0901636 | 0.1032593 | 0.0781885 | 0.0941541 | 0.0190320 |
| When $k_2 \geq k_{20}$, | $k_{2m}=$ | 0.0474146 | 0.0634253 | 0.0205627 | 0.0433423 | 0.0612073 |
| When $k_2 < k_{20}$, | $k_{2m}=$ | 0.0610718 | 0.0577832 | 0.0533984 | 0.0526196 | 0.0606079 |
| When $d_2 \geq d_{20}$, | $d_{2m}$ (nm) $=$ | ∞ | ∞ | 8.473 | ∞ | ∞ |
| When $d_2 < d_{20}$, | $d_{2m}$ (nm) $=$ | 20.321 | 31.703 | 15.881 | 21.519 | 3.543 |

1. 0 < N A ≤ 1. 1
3 5 < T ≤ 4 5

| Case | 4-11 | 4-12 | 4-13 | 4-14 |
|---|---|---|---|---|
| $n_{10}$ | 1.6995870 | 1.6927517 | 1.6954892 | 1.6961809 |
| $k_{10}$ | 0.0592337 | 0.0720967 | 0.0662812 | 0.0606151 |
| $d_{10}$ (nm) | 221.497 | 269.568 | 265.955 | 263.663 |
| $n_{20}$ | 1.6927290 | 1.7225076 | 1.7055518 | 1.6966094 |
| $k_{20}$ | 0.1818275 | 0.3075740 | 0.2340649 | 0.1927366 |
| $d_{20}$ (nm) | 235.781 | 126.653 | 190.864 | 253.572 |

| | | 4-11 | 4-12 | 4-13 | 4-14 |
|---|---|---|---|---|---|
| When $n_1 \geq n_{10}$, | $n_{1m} =$ | 0.0661182 | 0.0430298 | 0.0571948 | 0.0777271 |
| When $n_1 < n_{10}$, | $n_{1m} =$ | 0.0480371 | 0.0376990 | 0.0396948 | 0.0514954 |
| When $k_1 \geq k_{10}$, | $k_{1m} =$ | 0.0532056 | 0.0552930 | 0.0563965 | 0.0590613 |
| When $k_1 < k_{10}$, | $k_{1m} =$ | 0.0358557 | 0.0353455 | 0.0387683 | 0.0400696 |
| When $d_1 \geq d_{10}$, | $d_{1m}$ (nm) $=$ | ∞ | ∞ | ∞ | ∞ |
| When $d_1 < d_{10}$, | $d_{1m}$ (nm) $=$ | 78.174 | 21.398 | 89.629 | 112.221 |
| When $n_2 \geq n_{20}$, | $n_{2m} =$ | 0.2507446 | 0.1898645 | 0.4617859 | 0.3498169 |
| When $n_2 < n_{20}$, | $n_{2m} =$ | 0.0793469 | 0.1193628 | 0.2673291 | 0.2271130 |
| When $k_2 \geq k_{20}$, | $k_{2m} =$ | 0.0998633 | 0.1866309 | 0.2129163 | 0.2195020 |
| When $k_2 < k_{20}$, | $k_{2m} =$ | 0.0613184 | 0.1217163 | 0.1026648 | 0.0902368 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 33.021 | 15.026 | 69.134 | 84.327 |

1. 0 < N A ≤ 1. 1
4 5 < T ≤ 5 5

| Case | 5-01 | 5-02 | 5-03 | 5-04 | 5-05 |
|---|---|---|---|---|---|
| $n_{10}$ | 1.8808544 | 1.9316654 | 1.9082705 | 1.8785232 | 1.7211644 |
| $k_{10}$ | 0.2454152 | 0.1473610 | 0.1322705 | 0.1271526 | 0.0906139 |
| $d_{10}$ (nm) | 24.855 | 18.765 | 14.189 | 12.435 | 92.694 |
| $n_{20}$ | 1.8495394 | 1.8569906 | 1.7144055 | 1.6714546 | 1.6423304 |
| $k_{20}$ | 0.8565648 | 0.5034890 | 0.3458924 | 0.2699971 | 0.2528050 |
| $d_{20}$ (nm) | 51.788 | 110.667 | 182.182 | 245.412 | 180.257 |

| | | 5-01 | 5-02 | 5-03 | 5-04 | 5-05 |
|---|---|---|---|---|---|---|
| When $n_1 \geq n_{10}$, | $n_{1m} =$ | 0.0633093 | 0.0784436 | 0.0967798 | 0.1127563 | 0.0394434 |
| When $n_1 < n_{10}$, | $n_{1m} =$ | 0.0379272 | 0.0483252 | 0.0593640 | 0.0800098 | 0.0123450 |
| When $k_1 \geq k_{10}$, | $k_{1m} =$ | 0.0520349 | 0.0606396 | 0.0782654 | 0.1046387 | 0.0323718 |
| When $k_1 < k_{10}$, | $k_{1m} =$ | 0.0704724 | 0.0844775 | 0.1016626 | 0.1111450 | 0.0404236 |
| When $d_1 \geq d_{10}$, | $d_{1m}$ (nm) $=$ | 4.463 | 5.359 | 5.721 | 6.653 | 12.460 |
| When $d_1 < d_{10}$, | $d_{1m}$ (nm) $=$ | 2.319 | 2.677 | 3.157 | 4.357 | 3.091 |
| When $n_2 \geq n_{20}$, | $n_{2m} =$ | 0.1530676 | 0.1305420 | 0.1246069 | 0.1153186 | 0.0322009 |
| When $n_2 < n_{20}$, | $n_{2m} =$ | 0.1897241 | 0.1692273 | 0.1526025 | 0.1380359 | 0.0893225 |
| When $k_2 \geq k_{20}$, | $k_{2m} =$ | 0.1919946 | 0.1591870 | 0.1122729 | 0.0997217 | 0.0401709 |
| When $k_2 < k_{20}$, | $k_{2m} =$ | 0.1170728 | 0.1032434 | 0.0948108 | 0.0869653 | 0.0592017 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 9.182 | 23.164 | 70.833 | 93.569 | 20.376 |

1. 0 < N A ≤ 1. 1
4 5 < T ≤ 5 5

| Case | 5-06 | 5-07 | 5-08 | 5-09 | 5-10 |
|---|---|---|---|---|---|
| $n_{10}$ | 1.7204079 | 1.7050622 | 1.7085349 | 1.6878153 | 1.6980473 |
| $k_{10}$ | 0.0761160 | 0.0748972 | 0.0642166 | 0.0847734 | 0.0703784 |
| $d_{10}$ (nm) | 92.018 | 161.630 | 160.005 | 209.683 | 224.445 |
| $n_{20}$ | 1.6751968 | 1.6489715 | 1.6919631 | 1.6959203 | 1.6616204 |
| $k_{20}$ | 0.2080809 | 0.2315625 | 0.1914882 | 0.3070669 | 0.2238826 |
| $d_{20}$ (nm) | 234.537 | 175.108 | 227.913 | 127.092 | 171.370 |

| | | 5-06 | 5-07 | 5-08 | 5-09 | 5-10 |
|---|---|---|---|---|---|---|
| When $n_1 \geq n_{10}$, | $n_{1m}=$ | 0.0481116 | 0.0356750 | 0.0469714 | 0.0053320 | 0.0535730 |
| When $n_1 < n_{10}$, | $n_{1m}=$ | 0.0302478 | 0.0193359 | 0.0419556 | 0.0458972 | 0.0248047 |
| When $k_1 \geq k_{10}$, | $k_{1m}=$ | 0.0572302 | 0.0287097 | 0.0507117 | 0.0169995 | 0.0427319 |
| When $k_1 < k_{10}$, | $k_{1m}=$ | 0.0456555 | 0.0334753 | 0.0389539 | 0.0159290 | 0.0235608 |
| When $d_1 \geq d_{10}$, | $d_{1m}$ (nm) = | 19.317 | 21.414 | ∞ | 2.347 | ∞ |
| When $d_1 < d_{10}$, | $d_{1m}$ (nm) = | 8.336 | 7.128 | 19.272 | 19.688 | 12.738 |
| When $n_2 \geq n_{20}$, | $n_{2m}=$ | 0.0703723 | 0.0326379 | 0.0750854 | 0.1108911 | 0.0566052 |
| When $n_2 < n_{20}$, | $n_{2m}=$ | 0.1049292 | 0.0778333 | 0.0787329 | 0.0108118 | 0.0780139 |
| When $k_2 \geq k_{20}$, | $k_{2m}=$ | 0.0616284 | 0.0216638 | 0.0424329 | 0.0606311 | 0.0720593 |
| When $k_2 < k_{20}$, | $k_{2m}=$ | 0.0584753 | 0.0525964 | 0.0537231 | 0.0383350 | 0.0623987 |
| When $d_2 \geq d_{20}$, | $d_{2m}$ (nm) = | ∞ | 8.070 | ∞ | 32.807 | ∞ |
| When $d_2 < d_{20}$, | $d_{2m}$ (nm) = | 32.758 | 15.758 | 17.351 | 1.915 | 21.521 |

1. 0 < N A ≤ 1. 1
4 5 < T ≤ 5 5

| Case | 5-11 | 5-12 | 5-13 | 5-14 |
|---|---|---|---|---|
| $n_{10}$ | 1.6999707 | 1.6924126 | 1.6955002 | 1.6961000 |
| $k_{10}$ | 0.0601951 | 0.0742318 | 0.0674212 | 0.0611797 |
| $d_{10}$ (nm) | 221.512 | 268.357 | 265.225 | 263.146 |
| $n_{20}$ | 1.6952970 | 1.7068352 | 1.7004174 | 1.6940899 |
| $k_{20}$ | 0.1862586 | 0.3173492 | 0.2397614 | 0.1962440 |
| $d_{20}$ (nm) | 225.852 | 120.697 | 183.997 | 246.462 |

| | | 5-11 | 5-12 | 5-13 | 5-14 |
|---|---|---|---|---|---|
| When $n_1 \geq n_{10}$, | $n_{1m}=$ | 0.0654663 | 0.0386316 | 0.0536462 | 0.0776611 |
| When $n_1 < n_{10}$, | $n_{1m}=$ | 0.0445935 | 0.0350720 | 0.0381848 | 0.0515515 |
| When $k_1 \geq k_{10}$, | $k_{1m}=$ | 0.0509546 | 0.0537524 | 0.0551721 | 0.0583948 |
| When $k_1 < k_{10}$, | $k_{1m}=$ | 0.0349414 | 0.0344934 | 0.0383105 | 0.0394385 |
| When $d_1 \geq d_{10}$, | $d_{1m}$ (nm) = | ∞ | ∞ | ∞ | ∞ |
| When $d_1 < d_{10}$, | $d_{1m}$ (nm) = | 76.496 | 19.128 | 37.283 | 109.648 |
| When $n_2 \geq n_{20}$, | $n_{2m}=$ | 0.1168579 | 0.1905981 | 0.3934021 | 0.3400916 |
| When $n_2 < n_{20}$, | $n_{2m}=$ | 0.0700696 | 0.1027393 | 0.2743970 | 0.2283606 |
| When $k_2 \geq k_{20}$, | $k_{2m}=$ | 0.1002319 | 0.1933838 | 0.2120459 | 0.2188281 |
| When $k_2 < k_{20}$, | $k_{2m}=$ | 0.0624707 | 0.1168652 | 0.1050110 | 0.0926550 |
| When $d_2 \geq d_{20}$, | $d_{2m}$ (nm) = | ∞ | ∞ | ∞ | ∞ |
| When $d_2 < d_{20}$, | $d_{2m}$ (nm) = | 28.597 | 13.909 | 67.541 | 81.764 |

1. 0 < N A ≤ 1. 1
5 5 < T ≤ 6 5

| Case | 6-01 | 6-02 | 6-03 | 6-04 | 6-05 |
|---|---|---|---|---|---|
| $n_{10}$ | 1.8609133 | 1.9462238 | 1.9002376 | 1.8750233 | 1.8816918 |
| $k_{10}$ | 0.2699154 | 0.1588548 | 0.1498745 | 0.1302055 | 0.0811209 |
| $d_{10}$ (nm) | 23.275 | 16.938 | 13.880 | 12.592 | 12.084 |
| $n_{20}$ | 1.6780954 | 1.8061043 | 1.6764313 | 1.6672162 | 1.7277101 |
| $k_{20}$ | 0.8091000 | 0.4989592 | 0.3420875 | 0.2718902 | 0.2394028 |
| $d_{20}$ (nm) | 51.309 | 107.791 | 176.900 | 235.718 | 282.393 |

| | 6-01 | 6-02 | 6-03 | 6-04 | 6-05 |
|---|---|---|---|---|---|
| When $n_1 \geq n_{10}$, $n_{1m} =$ | 0.0700366 | 0.0847327 | 0.0979871 | 0.1121912 | 0.1205115 |
| When $n_1 < n_{10}$, $n_{1m} =$ | 0.0352271 | 0.0459912 | 0.0579346 | 0.0799817 | 0.0890784 |
| When $k_1 \geq k_{10}$, $k_{1m} =$ | 0.0520923 | 0.0625745 | 0.0794043 | 0.1043726 | 0.1106958 |
| When $k_1 < k_{10}$, $k_{1m} =$ | 0.0664282 | 0.0874719 | 0.0997217 | 0.1093811 | 0.0811209 |
| When $d_1 \geq d_{10}$, $d_{1m}$ (nm) = | 4.496 | 4.952 | 5.583 | 6.704 | 7.616 |
| When $d_1 < d_{10}$, $d_{1m}$ (nm) = | 2.084 | 2.260 | 3.039 | 4.426 | 5.147 |
| When $n_2 \geq n_{20}$, $n_{2m} =$ | 0.1454468 | 0.1290356 | 0.1219507 | 0.1104688 | 0.1083423 |
| When $n_2 < n_{20}$, $n_{2m} =$ | 0.1338672 | 0.1849402 | 0.1524817 | 0.1364417 | 0.1532007 |
| When $k_2 \geq k_{20}$, $k_{2m} =$ | 0.1326758 | 0.1316541 | 0.1033948 | 0.0988464 | 0.1079004 |
| When $k_2 < k_{20}$, $k_{2m} =$ | 0.1106470 | 0.1010791 | 0.0949341 | 0.0882678 | 0.0854614 |
| When $d_2 \geq d_{20}$, $d_{2m}$ (nm) = | 18.182 | ∞ | ∞ | ∞ | ∞ |
| When $d_2 < d_{20}$, $d_{2m}$ (nm) = | 8.638 | 17.532 | 68.073 | 94.482 | 130.723 |

1. 0 < N A ≤ 1. 1
5 5 < T ≤ 6 5

| Case | 6-06 | 6-07 | 6-08 | 6-09 | 6-10 |
|---|---|---|---|---|---|
| $n_{10}$ | 1.7196449 | 1.7211216 | 1.7282121 | 1.7047574 | 1.7094298 |
| $k_{10}$ | 0.0916508 | 0.0765241 | 0.0683348 | 0.0753118 | 0.0647325 |
| $d_{10}$ (nm) | 92.440 | 91.942 | 92.298 | 161.355 | 159.970 |
| $n_{20}$ | 1.6323282 | 1.6777604 | 1.7222619 | 1.6462273 | 1.6962571 |
| $k_{20}$ | 0.2539653 | 0.2105462 | 0.1825246 | 0.2341241 | 0.1938378 |
| $d_{20}$ (nm) | 171.320 | 223.941 | 274.062 | 165.232 | 217.150 |

| | 6-06 | 6-07 | 6-08 | 6-09 | 6-10 |
|---|---|---|---|---|---|
| When $n_1 \geq n_{10}$, $n_{1m} =$ | 0.0390417 | 0.0485681 | 0.0546460 | 0.0358069 | 0.0474683 |
| When $n_1 < n_{10}$, $n_{1m} =$ | 0.0139282 | 0.0313391 | 0.0292078 | 0.0174304 | 0.0407373 |
| When $k_1 \geq k_{10}$, $k_{1m} =$ | 0.0333240 | 0.0585132 | 0.0578357 | 0.0324670 | 0.0508789 |
| When $k_1 < k_{10}$, $k_{1m} =$ | 0.0406140 | 0.0454041 | 0.0481470 | 0.0321411 | 0.0389600 |
| When $d_1 \geq d_{10}$, $d_{1m}$ (nm) = | 12.043 | 19.132 | 42.010 | 19.174 | ∞ |
| When $d_1 < d_{10}$, $d_{1m}$ (nm) = | 3.525 | 8.472 | 8.190 | 6.358 | 18.590 |
| When $n_2 \geq n_{20}$, $n_{2m} =$ | 0.0324304 | 0.0734375 | 0.0906226 | 0.0327905 | 0.0764417 |
| When $n_2 < n_{20}$, $n_{2m} =$ | 0.0896448 | 0.1073743 | 0.1223853 | 0.0797839 | 0.0702637 |
| When $k_2 \geq k_{20}$, $k_{2m} =$ | 0.0391357 | 0.0623755 | 0.0817871 | 0.0268372 | 0.0433899 |
| When $k_2 < k_{20}$, $k_{2m} =$ | 0.0597375 | 0.0603992 | 0.0593811 | 0.0545007 | 0.0559253 |
| When $d_2 \geq d_{20}$, $d_{2m}$ (nm) = | ∞ | ∞ | ∞ | 9.153 | ∞ |
| When $d_2 < d_{20}$, $d_{2m}$ (nm) = | 20.788 | 29.764 | 77.892 | 16.109 | 14.325 |

1. 0 < N A ≤ 1. 1

5 5 < T ≤ 6 5

| Case | 6–11 | 6–12 | 6–13 | 6–14 | 6–15 |
|---|---|---|---|---|---|
| $n_{10}$ | 1.6870964 | 1.6986314 | 1.7003667 | 1.6951156 | 1.6955653 |
| $k_{10}$ | 0.0858972 | 0.0705958 | 0.0607285 | 0.0571177 | 0.0680298 |
| $d_{10}$ (nm) | 208.556 | 224.893 | 221.557 | 215.781 | 264.644 |
| $n_{20}$ | 1.6830399 | 1.6622291 | 1.6983916 | 1.6957463 | 1.6953987 |
| $k_{20}$ | 0.3090553 | 0.2274423 | 0.1887213 | 0.1617780 | 0.2417239 |
| $d_{20}$ (nm) | 121.249 | 160.831 | 215.383 | 277.216 | 176.078 |

| When $n_1 \geq n_{10}$, $n_{1m} =$ | 0.0051123 | 0.0520032 | 0.0662122 | 0.0842517 | 0.0515662 |
|---|---|---|---|---|---|
| When $n_1 < n_{10}$, $n_{1m} =$ | 0.0418372 | 0.0227649 | 0.0435059 | 0.0645801 | 0.0369092 |
| When $k_1 \geq k_{10}$, $k_{1m} =$ | 0.0150793 | 0.0436267 | 0.0489954 | 0.0563855 | 0.0542810 |
| When $k_1 < k_{10}$, $k_{1m} =$ | 0.0179541 | 0.0228833 | 0.0348535 | 0.0371240 | 0.0381006 |
| When $d_1 \geq d_{10}$, $d_{1m}$ (nm) $=$ | 2.247 | ∞ | ∞ | ∞ | ∞ |
| When $d_1 < d_{10}$, $d_{1m}$ (nm) $=$ | 18.385 | 11.933 | 75.920 | 58.822 | 33.649 |
| When $n_2 \geq n_{20}$, $n_{2m} =$ | 0.1010083 | 0.0477234 | 0.1065527 | 0.2254480 | 0.3829150 |
| When $n_2 < n_{20}$, $n_{2m} =$ | 0.0100110 | 0.0759302 | 0.0611096 | 0.1540564 | 0.2775842 |
| When $k_2 \geq k_{20}$, $k_{2m} =$ | 0.0726611 | 0.0766821 | 0.1015344 | 0.1236780 | 0.2119995 |
| When $k_2 < k_{20}$, $k_{2m} =$ | 0.0309253 | 0.0590527 | 0.0616418 | 0.0602039 | 0.1044287 |
| When $d_2 \geq d_{20}$, $d_{2m}$ (nm) $=$ | 25.845 | 22.079 | ∞ | ∞ | ∞ |
| When $d_2 < d_{20}$, $d_{2m}$ (nm) $=$ | 1.717 | 20.127 | 24.695 | 81.257 | 67.124 |

1. 0 < N A ≤ 1. 1

5 5 < T ≤ 6 5

| Case | 6–16 |
|---|---|
| $n_{10}$ | 1.6958377 |
| $k_{10}$ | 0.0528303 |
| $d_{10}$ (nm) | 274.984 |
| $n_{20}$ | 1.6882898 |
| $k_{20}$ | 0.1657751 |
| $d_{20}$ (nm) | 275.044 |

| When $n_1 \geq n_{10}$, $n_{1m} =$ | 0.0590991 |
|---|---|
| When $n_1 < n_{10}$, $n_{1m} =$ | 0.0581189 |
| When $k_1 \geq k_{10}$, $k_{1m} =$ | 0.0684131 |
| When $k_1 < k_{10}$, $k_{1m} =$ | 0.0375098 |
| When $d_1 \geq d_{10}$, $d_{1m}$ (nm) $=$ | ∞ |
| When $d_1 < d_{10}$, $d_{1m}$ (nm) $=$ | 113.219 |
| When $n_2 \geq n_{20}$, $n_{2m} =$ | 0.2789856 |
| When $n_2 < n_{20}$, $n_{2m} =$ | 0.2219617 |
| When $k_2 \geq k_{20}$, $k_{2m} =$ | 0.1981201 |
| When $k_2 < k_{20}$, $k_{2m} =$ | 0.0735400 |
| When $d_2 \geq d_{20}$, $d_{2m}$ (nm) $=$ | ∞ |
| When $d_2 < d_{20}$, $d_{2m}$ (nm) $=$ | 97.500 |

1. 0 < NA ≤ 1.1
6 5 < T ≤ 7 5

| ケース | 7-01 | 7-02 | 7-03 | 7-04 | 7-05 |
|---|---|---|---|---|---|
| $n_{10}$ | 1.8339628 | 1.9445237 | 1.8939902 | 1.8811858 | 1.7203230 |
| $k_{10}$ | 0.2973905 | 0.1726202 | 0.1563846 | 0.0833966 | 0.0922740 |
| $d_{10}$ (nm) | 24.925 | 17.287 | 14.253 | 12.228 | 92.527 |
| $n_{20}$ | 1.6419965 | 1.7953047 | 1.6659458 | 1.7269957 | 1.6328842 |
| $k_{20}$ | 0.8698975 | 0.5162004 | 0.3485215 | 0.2426363 | 0.2599948 |
| $d_{20}$ (nm) | 41.723 | 98.907 | 167.112 | 272.914 | 160.703 |

| | | 7-01 | 7-02 | 7-03 | 7-04 | 7-05 |
|---|---|---|---|---|---|---|
| When $n_1 \geq n_{10}$, | $n_{1m}=$ | 0.0734924 | 0.0853552 | 0.0964307 | 0.1197986 | 0.0394055 |
| When $n_1 < n_{10}$, | $n_{1m}=$ | 0.0377722 | 0.0427490 | 0.0559692 | 0.0877673 | 0.0144592 |
| When $k_1 \geq k_{10}$, | $k_{1m}=$ | 0.0448938 | 0.0589941 | 0.0770850 | 0.1096667 | 0.0331616 |
| When $k_1 < k_{10}$, | $k_{1m}=$ | 0.0453357 | 0.0848169 | 0.0975195 | 0.0833966 | 0.0410388 |
| When $d_1 \geq d_{10}$, | $d_{1m}$ (nm) $=$ | 4.571 | 4.784 | 5.590 | 7.648 | 12.091 |
| When $d_1 < d_{10}$, | $d_{1m}$ (nm) $=$ | 2.315 | 2.092 | 3.027 | 5.109 | 3.655 |
| When $n_2 \geq n_{20}$, | $n_{2m}=$ | 0.1366638 | 0.1348682 | 0.1167786 | 0.1080664 | 0.0326196 |
| When $n_2 < n_{20}$, | $n_{2m}=$ | 0.1076978 | 0.1944104 | 0.1524536 | 0.1545313 | 0.0900854 |
| When $k_2 \geq k_{20}$, | $k_{2m}=$ | 0.1648022 | 0.1338904 | 0.1021130 | 0.1080652 | 0.0396484 |
| When $k_2 < k_{20}$, | $k_{2m}=$ | 0.1324670 | 0.1078918 | 0.0977759 | 0.0865271 | 0.0625085 |
| When $d_2 \geq d_{20}$, | $d_{2m}$ (nm) $=$ | 12.499 | ∞ | ∞ | ∞ | ∞ |
| When $d_2 < d_{20}$, | $d_{2m}$ (nm) $=$ | 5.747 | 14.376 | 64.164 | 128.680 | 19.557 |

1. 0 < NA ≤ 1.1
6 5 < T ≤ 7 5

| Case | 7-06 | 7-07 | 7-08 | 7-09 | 7-10 |
|---|---|---|---|---|---|
| $n_{10}$ | 1.7224265 | 1.7294779 | 1.7053201 | 1.7102741 | 1.7133466 |
| $k_{10}$ | 0.0770592 | 0.0692299 | 0.0757255 | 0.0654045 | 0.0629386 |
| $d_{10}$ (nm) | 92.053 | 92.385 | 161.452 | 160.136 | 160.381 |
| $n_{20}$ | 1.6819841 | 1.7252879 | 1.6485370 | 1.7000507 | 1.7220503 |
| $k_{20}$ | 0.2150120 | 0.1858377 | 0.2399747 | 0.1977447 | 0.1698335 |
| $d_{20}$ (nm) | 213.162 | 263.723 | 154.588 | 206.614 | 260.757 |

| | | 7-06 | 7-07 | 7-08 | 7-09 | 7-10 |
|---|---|---|---|---|---|---|
| When $n_1 \geq n_{10}$, | $n_{1m}=$ | 0.0490625 | 0.0548535 | 0.0366443 | 0.0483020 | 0.0569666 |
| When $n_1 < n_{10}$, | $n_{1m}=$ | 0.0311902 | 0.0280200 | 0.0173645 | 0.0416309 | 0.0190027 |
| When $k_1 \geq k_{10}$, | $k_{1m}=$ | 0.0581604 | 0.0565332 | 0.0330920 | 0.0498926 | 0.0402344 |
| When $k_1 < k_{10}$, | $k_{1m}=$ | 0.0461389 | 0.0475879 | 0.0324707 | 0.0390747 | 0.0240051 |
| When $d_1 \geq d_{10}$, | $d_{1m}$ (nm) $=$ | 19.214 | 40.761 | 19.902 | ∞ | ∞ |
| When $d_1 < d_{10}$, | $d_{1m}$ (nm) $=$ | 8.328 | 7.705 | 6.285 | 18.989 | 5.694 |
| When $n_2 \geq n_{20}$, | $n_{2m}=$ | 0.0747375 | 0.0917908 | 0.0322156 | 0.0769946 | 0.1011584 |
| When $n_2 < n_{20}$, | $n_{2m}=$ | 0.1078540 | 0.1217822 | 0.0813562 | 0.0689685 | 0.1343567 |
| When $k_2 \geq k_{20}$, | $k_{2m}=$ | 0.0634705 | 0.0827625 | 0.0283752 | 0.0430542 | 0.0435730 |
| When $k_2 < k_{20}$, | $k_{2m}=$ | 0.0623401 | 0.0604163 | 0.0573535 | 0.0576453 | 0.0570081 |
| When $d_2 \geq d_{20}$, | $d_{2m}$ (nm) $=$ | ∞ | ∞ | 9.136 | 38.239 | ∞ |
| When $d_2 < d_{20}$, | $d_{2m}$ (nm) $=$ | 27.810 | 75.918 | 15.379 | 13.085 | 10.847 |

1. 0 < N A ≤ 1. 1
65 < T ≤ 75

| Case | 7-11 | 7-12 | 7-13 | 7-14 | 7-15 |
|---|---|---|---|---|---|
| $n_{10}$ | 1.6861768 | 1.6990769 | 1.7003759 | 1.6946436 | 1.6954303 |
| $k_{10}$ | 0.0881028 | 0.0709373 | 0.0613969 | 0.0577579 | 0.0690806 |
| $d_{10}$ (nm) | 208.148 | 225.005 | 221.468 | 215.315 | 264.876 |
| $n_{20}$ | 1.6733849 | 1.6647354 | 1.6998938 | 1.6946016 | 1.6937197 |
| $k_{20}$ | 0.3136681 | 0.2329033 | 0.1918751 | 0.1634050 | 0.2458138 |
| $d_{20}$ (nm) | 112.385 | 150.349 | 205.497 | 268.128 | 165.269 |

| | | 7-11 | 7-12 | 7-13 | 7-14 | 7-15 |
|---|---|---|---|---|---|---|
| When $n_1 \geq n_{10}$, | $n_{1m} =$ | 0.0025806 | 0.0529590 | 0.0676086 | 0.0859229 | 0.0516138 |
| When $n_1 < n_{10}$, | $n_{1m} =$ | 0.0409998 | 0.0231177 | 0.0444312 | 0.0666504 | 0.0367175 |
| When $k_1 \geq k_{10}$, | $k_{1m} =$ | 0.0094263 | 0.0435510 | 0.0474890 | 0.0560022 | 0.0529260 |
| When $k_1 < k_{10}$, | $k_{1m} =$ | 0.0156848 | 0.0234912 | 0.0355322 | 0.0372656 | 0.0371912 |
| When $d_1 \geq d_{10}$, | $d_{1m}$ (nm) $=$ | 1.037 | ∞ | ∞ | ∞ | ∞ |
| When $d_1 < d_{10}$, | $d_{1m}$ (nm) $=$ | 17.094 | 12.289 | 76.126 | 56.280 | 33.058 |
| When $n_2 \geq n_{20}$, | $n_{2m} =$ | 0.1039172 | 0.0468506 | 0.1077234 | 0.2240735 | 0.4022729 |
| When $n_2 < n_{20}$, | $n_{2m} =$ | 0.0058093 | 0.0753308 | 0.0576575 | 0.1556287 | 0.2760486 |
| When $k_2 \geq k_{20}$, | $k_{2m} =$ | 0.0664124 | 0.0758972 | 0.1012000 | 0.1249744 | 0.2123950 |
| When $k_2 < k_{20}$, | $k_{2m} =$ | 0.0178174 | 0.0630115 | 0.0645288 | 0.0620288 | 0.1063135 |
| When $d_2 \geq d_{20}$, | $d_{2m}$ (nm) $=$ | 26.367 | 19.187 | ∞ | ∞ | ∞ |
| When $d_2 < d_{20}$, | $d_{2m}$ (nm) $=$ | 1.017 | 18.602 | 23.769 | 80.847 | 66.469 |

1. 0 < N A ≤ 1. 1
65 < T ≤ 75

| Case | 7-16 |
|---|---|
| $n_{10}$ | 1.6957423 |
| $k_{10}$ | 0.0532811 |
| $d_{10}$ (nm) | 274.848 |
| $n_{20}$ | 1.6878755 |
| $k_{20}$ | 0.1674492 |
| $d_{20}$ (nm) | 265.685 |

| | | 7-16 |
|---|---|---|
| When $n_1 \geq n_{10}$, | $n_{1m} =$ | 0.0588110 |
| When $n_1 < n_{10}$, | $n_{1m} =$ | 0.0575696 |
| When $k_1 \geq k_{10}$, | $k_{1m} =$ | 0.0681641 |
| When $k_1 < k_{10}$, | $k_{1m} =$ | 0.0379443 |
| When $d_1 \geq d_{10}$, | $d_{1m}$ (nm) $=$ | ∞ |
| When $d_1 < d_{10}$, | $d_{1m}$ (nm) $=$ | 112.076 |
| When $n_2 \geq n_{20}$, | $n_{2m} =$ | 0.2806909 |
| When $n_2 < n_{20}$, | $n_{2m} =$ | 0.2229114 |
| When $k_2 \geq k_{20}$, | $k_{2m} =$ | 0.1986609 |
| When $k_2 < k_{20}$, | $k_{2m} =$ | 0.0745801 |
| When $d_2 \geq d_{20}$, | $d_{2m}$ (nm) $=$ | ∞ |
| When $d_2 < d_{20}$, | $d_{2m}$ (nm) $=$ | 89.270 |

1. 0 < N A ≤ 1. 1
7 5 < T ≤ 8 5

| Case | | 8-01 | 8-02 | 8-03 | 8-04 | 8-05 |
|---|---|---|---|---|---|---|
| $n_{10}$ | | 1.9187259 | 1.8967518 | 1.8757876 | 1.8806788 | 1.7234296 |
| $k_{10}$ | | 0.1881900 | 0.1527475 | 0.1318014 | 0.0899399 | 0.0945092 |
| $d_{10}$ (nm) | | 20.509 | 15.221 | 13.247 | 12.412 | 92.722 |
| $n_{20}$ | | 1.8283337 | 1.6893708 | 1.6726776 | 1.7211162 | 1.6393014 |
| $k_{20}$ | | 0.5739613 | 0.3734166 | 0.2883472 | 0.2492460 | 0.2743485 |
| $d_{20}$ (nm) | | 84.746 | 154.221 | 215.129 | 265.394 | 150.270 |

| When $n_1 \geq n_{10}$, | $n_{1m} =$ | 0.0766943 | 0.0922229 | 0.1080322 | 0.1177502 | 0.0391516 |
|---|---|---|---|---|---|---|
| When $n_1 < n_{10}$, | $n_{1m} =$ | 0.0399988 | 0.0530884 | 0.0750195 | 0.0852625 | 0.0112524 |
| When $k_1 \geq k_{10}$, | $k_{1m} =$ | 0.0507166 | 0.0712622 | 0.0980225 | 0.1073047 | 0.0289392 |
| When $k_1 < k_{10}$, | $k_{1m} =$ | 0.0771802 | 0.0964258 | 0.1069458 | 0.0899399 | 0.0412610 |
| When $d_1 \geq d_{10}$, | $d_{1m}$ (nm) = | 5.195 | 5.640 | 6.681 | 7.548 | 11.825 |
| When $d_1 < d_{10}$, | $d_{1m}$ (nm) = | 2.249 | 2.987 | 4.301 | 4.972 | 2.719 |
| When $n_2 \geq n_{20}$, | $n_{2m} =$ | 0.1444995 | 0.1155615 | 0.1091333 | 0.1093396 | 0.0288635 |
| When $n_2 < n_{20}$, | $n_{2m} =$ | 0.1897876 | 0.1532776 | 0.1435217 | 0.1541382 | 0.0890479 |
| When $k_2 \geq k_{20}$, | $k_{2m} =$ | 0.1811243 | 0.1099194 | 0.1006726 | 0.1075403 | 0.0356238 |
| When $k_2 < k_{20}$, | $k_{2m} =$ | 0.1194946 | 0.1025110 | 0.0922131 | 0.0871228 | 0.0649683 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 15.313 | 64.664 | 82.555 | 124.472 | 16.892 |

1. 0 < N A ≤ 1. 1
7 5 < T ≤ 8 5

| Case | | 8-06 | 8-07 | 8-08 | 8-09 | 8-10 |
|---|---|---|---|---|---|---|
| $n_{10}$ | | 1.7235983 | 1.7294254 | 1.7064538 | 1.7103862 | 1.7133072 |
| $k_{10}$ | | 0.0790587 | 0.0706491 | 0.0777504 | 0.0670250 | 0.0637197 |
| $d_{10}$ (nm) | | 92.129 | 92.482 | 161.668 | 160.278 | 160.467 |
| $n_{20}$ | | 1.6815454 | 1.7233644 | 1.6498826 | 1.6983722 | 1.7219131 |
| $k_{20}$ | | 0.2228770 | 0.1918670 | 0.2514894 | 0.2047961 | 0.1752501 |
| $d_{20}$ (nm) | | 204.187 | 255.172 | 145.038 | 197.922 | 251.781 |

| When $n_1 \geq n_{10}$, | $n_{1m} =$ | 0.0481958 | 0.0539050 | 0.0362122 | 0.0474792 | 0.0556775 |
|---|---|---|---|---|---|---|
| When $n_1 < n_{10}$, | $n_{1m} =$ | 0.0281580 | 0.0270288 | 0.0158582 | 0.0428101 | 0.0187244 |
| When $k_1 \geq k_{10}$, | $k_{1m} =$ | 0.0546558 | 0.0547986 | 0.0255066 | 0.0459753 | 0.0391089 |
| When $k_1 < k_{10}$, | $k_{1m} =$ | 0.0470496 | 0.0476624 | 0.0330371 | 0.0375122 | 0.0244470 |
| When $d_1 \geq d_{10}$, | $d_{1m}$ (nm) = | 18.433 | 40.484 | 19.881 | ∞ | ∞ |
| When $d_1 < d_{10}$, | $d_{1m}$ (nm) = | 7.376 | 7.380 | 6.011 | 13.737 | 5.649 |
| When $n_2 \geq n_{20}$, | $n_{2m} =$ | 0.0719336 | 0.0903259 | 0.0311267 | 0.0755847 | 0.1032422 |
| When $n_2 < n_{20}$, | $n_{2m} =$ | 0.1049182 | 0.1183936 | 0.0789893 | 0.0715295 | 0.1268079 |
| When $k_2 \geq k_{20}$, | $k_{2m} =$ | 0.0610889 | 0.0802148 | 0.0194653 | 0.0384314 | 0.0401990 |
| When $k_2 < k_{20}$, | $k_{2m} =$ | 0.0626282 | 0.0606787 | 0.0584229 | 0.0575549 | 0.0569128 |
| When $d_2 \geq d_{20}$, | $d_{2m}$ (nm) = | ∞ | ∞ | 6.414 | 35.522 | ∞ |
| When $d_2 < d_{20}$, | $d_{2m}$ (nm) = | 26.455 | 72.823 | 13.152 | 13.515 | 11.677 |

1. 0 < N A ≤ 1. 1
7 5 < T ≤ 8 5

| Case | 8-11 | 8-12 | 8-13 | 8-14 | 8-15 |
|---|---|---|---|---|---|
| $n_{10}$ | 1.6987335 | 1.6895310 | 1.6997408 | 1.6947661 | 1.6915645 |
| $k_{10}$ | 0.0728489 | 0.0798395 | 0.0628030 | 0.0583146 | 0.0796327 |
| $d_{10}$ (nm) | 224.384 | 207.056 | 221.189 | 215.749 | 269.434 |
| $n_{20}$ | 1.6635130 | 1.6873868 | 1.6972371 | 1.6943199 | 1.7013553 |
| $k_{20}$ | 0.2423517 | 0.2464201 | 0.1976117 | 0.1671130 | 0.3520060 |
| $d_{20}$ (nm) | 141.699 | 160.447 | 197.186 | 258.789 | 90.540 |

| | | 8-11 | 8-12 | 8-13 | 8-14 | 8-15 |
|---|---|---|---|---|---|---|
| When $n_1 \geq n_{10}$, | $n_{1m} =$ | 0.0550525 | 0.0211743 | 0.0680066 | 0.0840710 | 0.0339661 |
| When $n_1 < n_{10}$, | $n_{1m} =$ | 0.0214722 | 0.0563281 | 0.0446484 | 0.0653711 | 0.0319580 |
| When $k_1 \geq k_{10}$, | $k_{1m} =$ | 0.0399634 | 0.0394690 | 0.0462439 | 0.0552136 | 0.0498462 |
| When $k_1 < k_{10}$, | $k_{1m} =$ | 0.0230286 | 0.0247534 | 0.0358582 | 0.0373328 | 0.0319092 |
| When $d_1 \geq d_{10}$, | $d_{1m}$ (nm) $=$ | ∞ | 18.382 | ∞ | ∞ | 29.764 |
| When $d_1 < d_{10}$, | $d_{1m}$ (nm) $=$ | 12.181 | 26.345 | 75.416 | 56.560 | 16.533 |
| When $n_2 \geq n_{20}$, | $n_{2m} =$ | 0.0460742 | 0.1451038 | 0.1164050 | 0.2251794 | 0.2068530 |
| When $n_2 < n_{20}$, | $n_{2m} =$ | 0.0736353 | 0.0531665 | 0.0615222 | 0.1544678 | 0.0982214 |
| When $k_2 \geq k_{20}$, | $k_{2m} =$ | 0.0651685 | 0.0979858 | 0.0980493 | 0.1211584 | 0.1840808 |
| When $k_2 < k_{20}$, | $k_{2m} =$ | 0.0709375 | 0.0696692 | 0.0675049 | 0.0632251 | 0.1287793 |
| When $d_2 \geq d_{20}$, | $d_{2m}$ (nm) $=$ | 17.326 | ∞ | ∞ | ∞ | ∞ |
| When $d_2 < d_{20}$, | $d_{2m}$ (nm) $=$ | 17.676 | 13.280 | 25.586 | 81.223 | 11.833 |

1. 0 < N A ≤ 1. 1
7 5 < T ≤ 8 5

| Case | 8-16 | 8-17 |
|---|---|---|
| $n_{10}$ | 1.6950499 | 1.6956172 |
| $k_{10}$ | 0.0706693 | 0.0541668 |
| $d_{10}$ (nm) | 266.123 | 274.905 |
| $n_{20}$ | 1.6983222 | 1.6860233 |
| $k_{20}$ | 0.2573177 | 0.1712439 |
| $d_{20}$ (nm) | 152.851 | 257.337 |

| | | 8-16 | 8-17 |
|---|---|---|---|
| When $n_1 \geq n_{10}$, | $n_{1m} =$ | 0.0524487 | 0.0590308 |
| When $n_1 < n_{10}$, | $n_{1m} =$ | 0.0375452 | 0.0580872 |
| When $k_1 \geq k_{10}$, | $k_{1m} =$ | 0.0517285 | 0.0672278 |
| When $k_1 < k_{10}$, | $k_{1m} =$ | 0.0352881 | 0.0380591 |
| When $d_1 \geq d_{10}$, | $d_{1m}$ (nm) $=$ | ∞ | ∞ |
| When $d_1 < d_{10}$, | $d_{1m}$ (nm) $=$ | 33.771 | 112.404 |
| When $n_2 \geq n_{20}$, | $n_{2m} =$ | 0.2704944 | 0.2806836 |
| When $n_2 < n_{20}$, | $n_{2m} =$ | 0.2755872 | 0.2222266 |
| When $k_2 \geq k_{20}$, | $k_{2m} =$ | 0.2121143 | 0.1985229 |
| When $k_2 < k_{20}$, | $k_{2m} =$ | 0.1128918 | 0.0743774 |
| When $d_2 \geq d_{20}$, | $d_{2m}$ (nm) $=$ | ∞ | ∞ |
| When $d_2 < d_{20}$, | $d_{2m}$ (nm) $=$ | 65.292 | 85.089 |

1. 0 < N A ≤ 1. 1
8 5 < T ≤ 9 5

| Case | 9–01 | 9–02 | 9–03 | 9–04 | 9–05 |
|---|---|---|---|---|---|
| $n_{10}$ | 1.8980776 | 1.9078109 | 1.8887573 | 1.8863613 | 1.7283563 |
| $k_{10}$ | 0.2063094 | 0.1489982 | 0.1336370 | 0.0963846 | 0.0991844 |
| $d_{10}$ (nm) | 23.234 | 16.351 | 13.295 | 12.395 | 92.796 |
| $n_{20}$ | 1.8542997 | 1.7325536 | 1.6803356 | 1.7165602 | 1.6494143 |
| $k_{20}$ | 0.6486453 | 0.4126982 | 0.3065809 | 0.2596921 | 0.2975623 |
| $d_{20}$ (nm) | 73.732 | 141.036 | 205.639 | 258.147 | 140.358 |

| | | 9–01 | 9–02 | 9–03 | 9–04 | 9–05 |
|---|---|---|---|---|---|---|
| When $n_1 \geq n_{10}$, | $n_{1m} =$ | 0.0711987 | 0.0870154 | 0.1059106 | 0.1162891 | 0.0375220 |
| When $n_1 < n_{10}$, | $n_{1m} =$ | 0.0384509 | 0.0501709 | 0.0716760 | 0.0832544 | 0.0056213 |
| When $k_1 \geq k_{10}$, | $k_{1m} =$ | 0.0445569 | 0.0643555 | 0.0939661 | 0.1053198 | 0.0189441 |
| When $k_1 < k_{10}$, | $k_{1m} =$ | 0.0730103 | 0.0941223 | 0.1072681 | 0.0963846 | 0.0324854 |
| When $d_1 \geq d_{10}$, | $d_{1m}$ (nm) $=$ | 5.225 | 5.526 | 6.240 | 7.169 | 10.895 |
| When $d_1 < d_{10}$, | $d_{1m}$ (nm) $=$ | 2.347 | 2.839 | 3.908 | 4.670 | 1.261 |
| When $n_2 \geq n_{20}$, | $n_{2m} =$ | 0.1402551 | 0.1159338 | 0.1109766 | 0.1105359 | 0.0179150 |
| When $n_2 < n_{20}$, | $n_{2m} =$ | 0.1828406 | 0.1543176 | 0.1513220 | 0.1539343 | 0.0865198 |
| When $k_2 \geq k_{20}$, | $k_{2m} =$ | 0.2259802 | 0.1235034 | 0.1018750 | 0.1065100 | 0.0230737 |
| When $k_2 < k_{20}$, | $k_{2m} =$ | 0.1284644 | 0.1059631 | 0.0936096 | 0.0878577 | 0.0660486 |
| When $d_2 \geq d_{20}$, | $d_{2m}$ (nm) $=$ | ∞ | ∞ | ∞ | ∞ | 14.635 |
| When $d_2 < d_{20}$, | $d_{2m}$ (nm) $=$ | 14.747 | 31.656 | 77.584 | 118.336 | 14.252 |

1. 0 < N A ≤ 1. 1
8 5 < T ≤ 9 5

| Case | 9–06 | 9–07 | 9–08 | 9–09 | 9–10 |
|---|---|---|---|---|---|
| $n_{10}$ | 1.7247011 | 1.7288637 | 1.7100270 | 1.7129082 | 1.6894084 |
| $k_{10}$ | 0.0825295 | 0.0727638 | 0.0697395 | 0.0648353 | 0.0825836 |
| $d_{10}$ (nm) | 92.134 | 92.409 | 160.277 | 160.281 | 208.412 |
| $n_{20}$ | 1.6784446 | 1.7181265 | 1.6932584 | 1.7202855 | 1.6911413 |
| $k_{20}$ | 0.2345042 | 0.1997137 | 0.2147807 | 0.1822190 | 0.2636300 |
| $d_{20}$ (nm) | 196.220 | 247.866 | 190.362 | 243.795 | 148.443 |

| | | 9–06 | 9–07 | 9–08 | 9–09 | 9–10 |
|---|---|---|---|---|---|---|
| When $n_1 \geq n_{10}$, | $n_{1m} =$ | 0.0458069 | 0.0520715 | 0.0445874 | 0.0530676 | 0.0168896 |
| When $n_1 < n_{10}$, | $n_{1m} =$ | 0.0231628 | 0.0254517 | 0.0291443 | 0.0189783 | 0.0564331 |
| When $k_1 \geq k_{10}$, | $k_{1m} =$ | 0.0487341 | 0.0524194 | 0.0390308 | 0.0374463 | 0.0317554 |
| When $k_1 < k_{10}$, | $k_{1m} =$ | 0.0471680 | 0.0474573 | 0.0341357 | 0.0249304 | 0.0174866 |
| When $d_1 \geq d_{10}$, | $d_{1m}$ (nm) $=$ | 16.768 | 28.342 | ∞ | ∞ | 8.653 |
| When $d_1 < d_{10}$, | $d_{1m}$ (nm) $=$ | 5.875 | 6.859 | 8.481 | 5.666 | 22.933 |
| When $n_2 \geq n_{20}$, | $n_{2m} =$ | 0.0654785 | 0.0851550 | 0.0721350 | 0.0992358 | 0.1489941 |
| When $n_2 < n_{20}$, | $n_{2m} =$ | 0.0999084 | 0.1129846 | 0.0702051 | 0.1184961 | 0.0323828 |
| When $k_2 \geq k_{20}$, | $k_{2m} =$ | 0.0550916 | 0.0742688 | 0.0299036 | 0.0348145 | 0.0701428 |
| When $k_2 < k_{20}$, | $k_{2m} =$ | 0.0621350 | 0.0605774 | 0.0564990 | 0.0562878 | 0.0653857 |
| When $d_2 \geq d_{20}$, | $d_{2m}$ (nm) $=$ | ∞ | ∞ | 30.126 | ∞ | ∞ |
| When $d_2 < d_{20}$, | $d_{2m}$ (nm) $=$ | 23.369 | 34.214 | 13.997 | 12.255 | 9.630 |

1. O < N A ≤ 1. 1
8 5 < T ≤ 9 5

| Case | 9–11 | 9–12 | 9–13 | 9–14 | 9–15 |
|---|---|---|---|---|---|
| $n_{10}$ | 1.6987536 | 1.6951804 | 1.6947043 | 1.6953534 | 1.6955317 |
| $k_{10}$ | 0.0651428 | 0.0592977 | 0.0728049 | 0.0654850 | 0.0555447 |
| $d_{10}$ (nm) | 220.679 | 216.421 | 267.049 | 264.587 | 274.968 |
| $n_{20}$ | 1.6918669 | 1.6944812 | 1.7045529 | 1.6939885 | 1.6840742 |
| $k_{20}$ | 0.2062686 | 0.1733276 | 0.2758626 | 0.2171518 | 0.1777252 |
| $d_{20}$ (nm) | 189.869 | 249.686 | 142.407 | 204.731 | 249.243 |

| | | 9–11 | 9–12 | 9–13 | 9–14 | 9–15 |
|---|---|---|---|---|---|---|
| When $n_1 \geq n_{10}$, | $n_{1m} =$ | 0.0676538 | 0.0804553 | 0.0514111 | 0.0772083 | 0.0594299 |
| When $n_1 < n_{10}$, | $n_{1m} =$ | 0.0423462 | 0.0620581 | 0.0375159 | 0.0498364 | 0.0587244 |
| When $k_1 \geq k_{10}$, | $k_{1m} =$ | 0.0442505 | 0.0538220 | 0.0506982 | 0.0550830 | 0.0658191 |
| When $k_1 < k_{10}$, | $k_{1m} =$ | 0.0341040 | 0.0375916 | 0.0340894 | 0.0384644 | 0.0372644 |
| When $d_1 \geq d_{10}$, | $d_{1m}$ (nm) = | ∞ | ∞ | ∞ | ∞ | ∞ |
| When $d_1 < d_{10}$, | $d_{1m}$ (nm) = | 72.990 | 57.440 | 26.805 | 108.871 | 112.765 |
| When $n_2 \geq n_{20}$, | $n_{2m} =$ | 0.1307581 | 0.2319055 | 0.2365918 | 0.3979211 | 0.2850439 |
| When $n_2 < n_{20}$, | $n_{2m} =$ | 0.0673376 | 0.1520984 | 0.2827087 | 0.2359326 | 0.2177148 |
| When $k_2 \geq k_{20}$, | $k_{2m} =$ | 0.0940100 | 0.1156787 | 0.2079443 | 0.2187415 | 0.1980774 |
| When $k_2 < k_{20}$, | $k_{2m} =$ | 0.0673755 | 0.0629675 | 0.1183691 | 0.0982336 | 0.0755945 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 25.557 | 76.954 | 64.091 | 75.273 | 81.971 |

1. O < N A ≤ 1. 1
9 5 < T ≤ 1 0 5

| Case | 10–01 | 10–02 | 10–03 | 10–04 | 10–05 |
|---|---|---|---|---|---|
| $n_{10}$ | 1.9059589 | 1.9224042 | 1.8961620 | 1.8922593 | 1.7254583 |
| $k_{10}$ | 0.2274286 | 0.1550778 | 0.1385328 | 0.1041345 | 0.0865833 |
| $d_{10}$ (nm) | 23.462 | 16.599 | 13.501 | 12.282 | 91.876 |
| $n_{20}$ | 1.8553331 | 1.7510181 | 1.6829419 | 1.7097147 | 1.6727903 |
| $k_{20}$ | 0.7355051 | 0.4490690 | 0.3248659 | 0.2697702 | 0.2465542 |
| $d_{20}$ (nm) | 66.090 | 131.424 | 196.767 | 251.116 | 188.519 |

| | | 10–01 | 10–02 | 10–03 | 10–04 | 10–05 |
|---|---|---|---|---|---|---|
| When $n_1 \geq n_{10}$, | $n_{1m} =$ | 0.0671912 | 0.0841919 | 0.1023767 | 0.1153796 | 0.0426331 |
| When $n_1 < n_{10}$, | $n_{1m} =$ | 0.0345654 | 0.0474304 | 0.0675305 | 0.0814563 | 0.0184045 |
| When $k_1 \geq k_{10}$, | $k_{1m} =$ | 0.0380615 | 0.0598425 | 0.0894568 | 0.1045068 | 0.0426917 |
| When $k_1 < k_{10}$, | $k_{1m} =$ | 0.0683374 | 0.0902014 | 0.1054456 | 0.1041345 | 0.0441687 |
| When $d_1 \geq d_{10}$, | $d_{1m}$ (nm) = | 4.558 | 5.118 | 5.874 | 6.783 | 14.297 |
| When $d_1 < d_{10}$, | $d_{1m}$ (nm) = | 1.985 | 2.531 | 3.589 | 4.355 | 4.476 |
| When $n_2 \geq n_{20}$, | $n_{2m} =$ | 0.1216980 | 0.1117603 | 0.1100940 | 0.1104114 | 0.0579919 |
| When $n_2 < n_{20}$, | $n_{2m} =$ | 0.1802991 | 0.1554016 | 0.1498889 | 0.1534180 | 0.0956348 |
| When $k_2 \geq k_{20}$, | $k_{2m} =$ | 0.2165979 | 0.1264526 | 0.1015808 | 0.1042908 | 0.0462366 |
| When $k_2 < k_{20}$, | $k_{2m} =$ | 0.1276270 | 0.1054065 | 0.0937561 | 0.0879675 | 0.0605090 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 11.858 | 29.189 | 73.755 | 91.689 | 21.669 |

1. $0 < NA \leq 1.1$
$95 < T \leq 105$

| Case | 10-06 | 10-07 | 10-08 | 10-09 | 10-10 |
|---|---|---|---|---|---|
| $n_{10}$ | 1.7286512 | 1.7096319 | 1.7125109 | 1.6891198 | 1.6979687 |
| $k_{10}$ | 0.0752622 | 0.0728333 | 0.0665034 | 0.0853163 | 0.0677690 |
| $d_{10}$ (nm) | 92.185 | 159.923 | 159.852 | 208.173 | 220.140 |
| $n_{20}$ | 1.7137581 | 1.6877059 | 1.7181911 | 1.6918411 | 1.6871092 |
| $k_{20}$ | 0.2076205 | 0.2252670 | 0.1890952 | 0.2826173 | 0.2165239 |
| $d_{20}$ (nm) | 240.302 | 182.766 | 235.934 | 141.112 | 182.186 |

| When $n_1 \geq n_{10}$, $n_{1m} =$ | 0.0500330 | 0.0406897 | 0.0503772 | 0.0132690 | 0.0644641 |
|---|---|---|---|---|---|
| When $n_1 < n_{10}$, $n_{1m} =$ | 0.0231873 | 0.0169287 | 0.0155139 | 0.0507471 | 0.0375525 |
| When $k_1 \geq k_{10}$, $k_{1m} =$ | 0.0495398 | 0.0307520 | 0.0335327 | 0.0250305 | 0.0414893 |
| When $k_1 < k_{10}$, $k_{1m} =$ | 0.0465039 | 0.0291895 | 0.0230286 | 0.0142859 | 0.0317957 |
| When $d_1 \geq d_{10}$, $d_{1m}$ (nm) = | 22.149 | $\infty$ | $\infty$ | 5.803 | $\infty$ |
| When $d_1 < d_{10}$, $d_{1m}$ (nm) = | 6.093 | 5.010 | 4.544 | 20.171 | 66.095 |
| When $n_2 \geq n_{20}$, $n_{2m} =$ | 0.0807422 | 0.0673730 | 0.0968713 | 0.1414526 | 0.1231934 |
| When $n_2 < n_{20}$, $n_{2m} =$ | 0.1109875 | 0.0569836 | 0.1140344 | 0.0176575 | 0.0690576 |
| When $k_2 \geq k_{20}$, $k_{2m} =$ | 0.0671313 | 0.0201965 | 0.0272949 | 0.0516113 | 0.0909106 |
| When $k_2 < k_{20}$, $k_{2m} =$ | 0.0601733 | 0.0546924 | 0.0555640 | 0.0644128 | 0.0681702 |
| When $d_2 \geq d_{20}$, $d_{2m}$ (nm) = | $\infty$ | 22.678 | $\infty$ | $\infty$ | $\infty$ |
| When $d_2 < d_{20}$, $d_{2m}$ (nm) = | 33.234 | 12.401 | 9.751 | 3.545 | 24.752 |

1. $0 < NA \leq 1.1$
$95 < T \leq 105$

| Case | 10-11 | 10-12 | 10-13 |
|---|---|---|---|
| $n_{10}$ | 1.6953920 | 1.6945041 | 1.6957904 |
| $k_{10}$ | 0.0607310 | 0.0754015 | 0.0613078 |
| $d_{10}$ (nm) | 216.694 | 266.879 | 263.111 |
| $n_{20}$ | 1.6943518 | 1.7053190 | 1.6921380 |
| $k_{20}$ | 0.1805507 | 0.2962459 | 0.1886276 |
| $d_{20}$ (nm) | 240.824 | 134.581 | 257.166 |

| When $n_1 \geq n_{10}$, $n_{1m} =$ | 0.0773376 | 0.0489661 | 0.0744116 |
|---|---|---|---|
| When $n_1 < n_{10}$, $n_{1m} =$ | 0.0532397 | 0.0362244 | 0.0544775 |
| When $k_1 \geq k_{10}$, $k_{1m} =$ | 0.0520667 | 0.0490686 | 0.0595886 |
| When $k_1 < k_{10}$, $k_{1m} =$ | 0.0373279 | 0.0329797 | 0.0399255 |
| When $d_1 \geq d_{10}$, $d_{1m}$ (nm) = | $\infty$ | $\infty$ | $\infty$ |
| When $d_1 < d_{10}$, $d_{1m}$ (nm) = | 56.748 | 22.698 | 144.280 |
| When $n_2 \geq n_{20}$, $n_{2m} =$ | 0.2401196 | 0.2258960 | 0.3617542 |
| When $n_2 < n_{20}$, $n_{2m} =$ | 0.1505750 | 0.2863916 | 0.2146826 |
| When $k_2 \geq k_{20}$, $k_{2m} =$ | 0.1118237 | 0.2042285 | 0.2258594 |
| When $k_2 < k_{20}$, $k_{2m} =$ | 0.0641272 | 0.1247363 | 0.0874829 |
| When $d_2 \geq d_{20}$, $d_{2m}$ (nm) = | $\infty$ | $\infty$ | $\infty$ |
| When $d_2 < d_{20}$, $d_{2m}$ (nm) = | 74.466 | 22.579 | 121.018 |

1. 0 < N A ≤ 1. 1
1 0 5 < T ≤ 1 1 5

| Case | 11-01 | 11-02 | 11-03 | 11-04 | 11-05 |
|---|---|---|---|---|---|
| $n_{10}$ | 1.9374125 | 1.9018997 | 1.8965439 | 1.7253637 | 1.7289764 |
| $k_{10}$ | 0.1704110 | 0.1487976 | 0.1142225 | 0.0900184 | 0.0775142 |
| $d_{10}$ (nm) | 15.669 | 13.285 | 11.973 | 91.432 | 91.877 |
| $n_{20}$ | 1.7248980 | 1.6713435 | 1.6970963 | 1.6651786 | 1.7120256 |
| $k_{20}$ | 0.4663738 | 0.3352808 | 0.2748315 | 0.2549499 | 0.2134557 |
| $d_{20}$ (nm) | 126.299 | 189.496 | 244.759 | 180.505 | 231.728 |

| | | 11-01 | 11-02 | 11-03 | 11-04 | 11-05 |
|---|---|---|---|---|---|---|
| When $n_1 \geq n_{10}$, | $n_{1m} =$ | 0.0844495 | 0.1011877 | 0.1161206 | 0.0397363 | 0.0483887 |
| When $n_1 < n_{10}$, | $n_{1m} =$ | 0.0440234 | 0.0656897 | 0.0810999 | 0.0155029 | 0.0208545 |
| When $k_1 \geq k_{10}$, | $k_{1m} =$ | 0.0577478 | 0.0888123 | 0.1065247 | 0.0388269 | 0.0469031 |
| When $k_1 < k_{10}$, | $k_{1m} =$ | 0.0914417 | 0.1045447 | 0.1142225 | 0.0417639 | 0.0449243 |
| When $d_1 \geq d_{10}$, | $d_{1m}$ (nm) $=$ | 4.564 | 5.473 | 6.423 | 12.314 | 18.889 |
| When $d_1 < d_{10}$, | $d_{1m}$ (nm) $=$ | 2.111 | 3.313 | 4.088 | 3.639 | 5.309 |
| When $n_2 \geq n_{20}$, | $n_{2m} =$ | 0.1026855 | 0.1066711 | 0.1092859 | 0.0538538 | 0.0798657 |
| When $n_2 < n_{20}$, | $n_{2m} =$ | 0.1573315 | 0.1496814 | 0.1507874 | 0.0957056 | 0.1124231 |
| When $k_2 \geq k_{20}$, | $k_{2m} =$ | 0.1109265 | 0.0973877 | 0.1006897 | 0.0382251 | 0.0609106 |
| When $k_2 < k_{20}$, | $k_{2m} =$ | 0.0995313 | 0.0917126 | 0.0869214 | 0.0582397 | 0.0599487 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 32.204 | 71.551 | 94.669 | 21.979 | 35.901 |

1. 0 < N A ≤ 1. 1
1 0 5 < T ≤ 1 1 5

| Case | 11-06 | 11-07 | 11-08 | 11-09 | 11-10 |
|---|---|---|---|---|---|
| $n_{10}$ | 1.7092919 | 1.7124011 | 1.6891266 | 1.6977739 | 1.6952347 |
| $k_{10}$ | 0.0753499 | 0.0683625 | 0.0867081 | 0.0698574 | 0.0623107 |
| $d_{10}$ (nm) | 159.318 | 159.365 | 206.818 | 219.869 | 216.627 |
| $n_{20}$ | 1.6830351 | 1.7169838 | 1.6858604 | 1.6842611 | 1.6937881 |
| $k_{20}$ | 0.2331189 | 0.1941891 | 0.2953498 | 0.2258219 | 0.1869159 |
| $d_{20}$ (nm) | 174.468 | 227.412 | 138.155 | 173.345 | 231.738 |

| | | 11-06 | 11-07 | 11-08 | 11-09 | 11-10 |
|---|---|---|---|---|---|---|
| When $n_1 \geq n_{10}$, | $n_{1m} =$ | 0.0373157 | 0.0484546 | 0.0121899 | 0.0603870 | 0.0758545 |
| When $n_1 < n_{10}$, | $n_{1m} =$ | 0.0105005 | 0.0089343 | 0.0409204 | 0.0315625 | 0.0474512 |
| When $k_1 \geq k_{10}$, | $k_{1m} =$ | 0.0240833 | 0.0270752 | 0.0251843 | 0.0382471 | 0.0501941 |
| When $k_1 < k_{10}$, | $k_{1m} =$ | 0.0246826 | 0.0176978 | 0.0193188 | 0.0296948 | 0.0358765 |
| When $d_1 \geq d_{10}$, | $d_{1m}$ (nm) $=$ | 22.059 | ∞ | 5.261 | ∞ | ∞ |
| When $d_1 < d_{10}$, | $d_{1m}$ (nm) $=$ | 3.023 | 2.568 | 16.255 | 17.363 | 54.608 |
| When $n_2 \geq n_{20}$, | $n_{2m} =$ | 0.0659399 | 0.0944360 | 0.1154346 | 0.0831506 | 0.2493335 |
| When $n_2 < n_{20}$, | $n_{2m} =$ | 0.0371252 | 0.1164661 | 0.0185925 | 0.0632410 | 0.1310596 |
| When $k_2 \geq k_{20}$, | $k_{2m} =$ | 0.0133044 | 0.0180847 | 0.0609753 | 0.0891687 | 0.1103210 |
| When $k_2 < k_{20}$, | $k_{2m} =$ | 0.0529578 | 0.0555518 | 0.0785950 | 0.0680151 | 0.0652307 |
| When $d_2 \geq d_{20}$, | $d_{2m}$ (nm) $=$ | 18.030 | ∞ | ∞ | ∞ | ∞ |
| When $d_2 < d_{20}$, | $d_{2m}$ (nm) $=$ | 8.732 | 5.378 | 3.627 | 23.361 | 52.894 |

1. 0 < N A ≤ 1. 1
1 0 5 < T ≤ 1 1 5

| Case | 11-11 | 11-12 |
|---|---|---|
| $n_{10}$ | 1.6944699 | 1.6958800 |
| $k_{10}$ | 0.0775933 | 0.0528961 |
| $d_{10}$ (nm) | 265.762 | 273.317 |
| $n_{20}$ | 1.6967397 | 1.6915993 |
| $k_{20}$ | 0.3115846 | 0.1649138 |
| $d_{20}$ (nm) | 129.093 | 288.010 |

| | | 11-11 | 11-12 |
|---|---|---|---|
| When $n_1 \geq n_{10}$, | $n_{1m} =$ | 0.0466345 | 0.0703040 |
| When $n_1 < n_{10}$, | $n_{1m} =$ | 0.0341467 | 0.0549121 |
| When $k_1 \geq k_{10}$, | $k_{1m} =$ | 0.0473621 | 0.0679175 |
| When $k_1 < k_{10}$, | $k_{1m} =$ | 0.0320862 | 0.0389246 |
| When $d_1 \geq d_{10}$, | $d_{1m}$ (nm) $=$ | ∞ | ∞ |
| When $d_1 < d_{10}$, | $d_{1m}$ (nm) $=$ | 20.031 | 180.011 |
| When $n_2 \geq n_{20}$, | $n_{2m} =$ | 0.2202100 | 0.2749866 |
| When $n_2 < n_{20}$, | $n_{2m} =$ | 0.1339246 | 0.2056653 |
| When $k_2 \geq k_{20}$, | $k_{2m} =$ | 0.2018127 | 0.2031665 |
| When $k_2 < k_{20}$, | $k_{2m} =$ | 0.1244751 | 0.0729272 |
| When $d_2 \geq d_{20}$, | $d_{2m}$ (nm) $=$ | ∞ | ∞ |
| When $d_2 < d_{20}$, | $d_{2m}$ (nm) $=$ | 18.618 | 105.982 |

1. 0 < N A ≤ 1. 1
1 1 5 < T ≤ 1 2 5

| Case | 12-01 | 12-02 | 12-03 | 12-04 | 12-05 |
|---|---|---|---|---|---|
| $n_{10}$ | 1.9729972 | 1.9456051 | 1.9005953 | 1.8972956 | 1.7255330 |
| $k_{10}$ | 0.2768129 | 0.1915481 | 0.1591490 | 0.1121564 | 0.0922673 |
| $d_{10}$ (nm) | 17.524 | 14.612 | 13.217 | 12.290 | 91.102 |
| $n_{20}$ | 1.6663342 | 1.6781309 | 1.6561276 | 1.7051607 | 1.6614760 |
| $k_{20}$ | 0.7544777 | 0.4665054 | 0.3399716 | 0.2822449 | 0.2607016 |
| $d_{20}$ (nm) | 64.842 | 122.845 | 181.593 | 233.141 | 171.070 |

| | | 12-01 | 12-02 | 12-03 | 12-04 | 12-05 |
|---|---|---|---|---|---|---|
| When $n_1 \geq n_{10}$, | $n_{1m} =$ | 0.0730835 | 0.0862573 | 0.1002148 | 0.1132361 | 0.0385791 |
| When $n_1 < n_{10}$, | $n_{1m} =$ | 0.0179053 | 0.0397437 | 0.0650696 | 0.0790137 | 0.0152405 |
| When $k_1 \geq k_{10}$, | $k_{1m} =$ | 0.0247314 | 0.0556897 | 0.0891748 | 0.1035071 | 0.0386047 |
| When $k_1 < k_{10}$, | $k_{1m} =$ | 0.0592480 | 0.0960681 | 0.1016016 | 0.1121564 | 0.0414185 |
| When $d_1 \geq d_{10}$, | $d_{1m}$ (nm) $=$ | 2.961 | 4.145 | 5.266 | 6.373 | 11.328 |
| When $d_1 < d_{10}$, | $d_{1m}$ (nm) $=$ | 0.729 | 1.739 | 3.220 | 4.072 | 3.483 |
| When $n_2 \geq n_{20}$, | $n_{2m} =$ | 0.0585083 | 0.0918945 | 0.1020654 | 0.1070825 | 0.0573608 |
| When $n_2 < n_{20}$, | $n_{2m} =$ | 0.1382239 | 0.1611719 | 0.1504858 | 0.1560303 | 0.0993860 |
| When $k_2 \geq k_{20}$, | $k_{2m} =$ | 0.0616943 | 0.0914514 | 0.0935474 | 0.1016602 | 0.0359058 |
| When $k_2 < k_{20}$, | $k_{2m} =$ | 0.0899731 | 0.0957678 | 0.0910632 | 0.0886353 | 0.0590588 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 11.368 | 38.474 | 71.143 | 98.322 | 22.477 |

1. $0 < NA \leq 1. 1$

$115 < T \leq 125$

| Case | 12-06 | 12-07 | 12-08 | 12-09 | 12-10 |
|---|---|---|---|---|---|
| $n_{10}$ | 1.7304964 | 1.7097843 | 1.7129025 | 1.7059734 | 1.6983193 |
| $k_{10}$ | 0.0792452 | 0.0770210 | 0.0702809 | 0.0642321 | 0.0712405 |
| $d_{10}$ (nm) | 91.709 | 159.025 | 159.249 | 159.600 | 220.143 |
| $n_{20}$ | 1.7154952 | 1.6841289 | 1.7178163 | 1.6898319 | 1.6860819 |
| $k_{20}$ | 0.2175998 | 0.2392980 | 0.1978132 | 0.1677546 | 0.2336364 |
| $d_{20}$ (nm) | 221.560 | 164.463 | 217.770 | 279.371 | 162.903 |

| | 12-06 | 12-07 | 12-08 | 12-09 | 12-10 |
|---|---|---|---|---|---|
| When $n_1 \geq n_{10}$, $n_{1m} =$ | 0.0478430 | 0.0358972 | 0.0479553 | 0.0552173 | 0.0579871 |
| When $n_1 < n_{10}$, $n_{1m} =$ | 0.0188013 | 0.0078589 | 0.0015247 | 0.0299426 | 0.0264917 |
| When $k_1 \geq k_{10}$, $k_{1m} =$ | 0.0447290 | 0.0214099 | 0.0152087 | 0.0363110 | 0.0340515 |
| When $k_1 < k_{10}$, $k_{1m} =$ | 0.0430518 | 0.0224402 | 0.0060950 | 0.0278772 | 0.0279150 |
| When $d_1 \geq d_{10}$, $d_{1m}$ (nm) $=$ | 17.323 | 17.500 | ∞ | ∞ | ∞ |
| When $d_1 < d_{10}$, $d_{1m}$ (nm) $=$ | 4.626 | 2.208 | 0.436 | 70.406 | 11.462 |
| When $n_2 \geq n_{20}$, $n_{2m} =$ | 0.0842468 | 0.0631323 | 0.0959070 | 0.1382263 | 0.0682983 |
| When $n_2 < n_{20}$, $n_{2m} =$ | 0.1172522 | 0.0247583 | 0.0076807 | 0.1296057 | 0.0493762 |
| When $k_2 \geq k_{20}$, $k_{2m} =$ | 0.0583887 | 0.0111536 | 0.0046545 | 0.0357849 | 0.0882227 |
| When $k_2 < k_{20}$, $k_{2m} =$ | 0.0618323 | 0.0547961 | 0.0579968 | 0.0540967 | 0.0613330 |
| When $d_2 \geq d_{20}$, $d_{2m}$ (nm) $=$ | ∞ | 18.428 | ∞ | ∞ | ∞ |
| When $d_2 < d_{20}$, $d_{2m}$ (nm) $=$ | 65.102 | 5.436 | 0.894 | 57.180 | 18.177 |

1. $0 < NA \leq 1. 1$

$115 < T \leq 125$

| Case | 12-11 | 12-12 | 12-13 |
|---|---|---|---|
| $n_{10}$ | 1.6946755 | 1.6955425 | 1.6956989 |
| $k_{10}$ | 0.0639503 | 0.0535782 | 0.0539885 |
| $d_{10}$ (nm) | 216.344 | 213.248 | 272.929 |
| $n_{20}$ | 1.6931001 | 1.6937343 | 1.6917939 |
| $k_{20}$ | 0.1919118 | 0.1415462 | 0.1683287 |
| $d_{20}$ (nm) | 222.331 | 338.947 | 278.327 |

| | 12-11 | 12-12 | 12-13 |
|---|---|---|---|
| When $n_1 \geq n_{10}$, $n_{1m} =$ | 0.0359900 | 0.0869177 | 0.0714185 |
| When $n_1 < n_{10}$, $n_{1m} =$ | 0.0437024 | 0.0750378 | 0.0538635 |
| When $k_1 \geq k_{10}$, $k_{1m} =$ | 0.0485352 | 0.0653857 | 0.0669263 |
| When $k_1 < k_{10}$, $k_{1m} =$ | 0.0346851 | 0.0370959 | 0.0388916 |
| When $d_1 \geq d_{10}$, $d_{1m}$ (nm) $=$ | ∞ | ∞ | ∞ |
| When $d_1 < d_{10}$, $d_{1m}$ (nm) $=$ | 51.791 | 132.178 | 120.018 |
| When $n_2 \geq n_{20}$, $n_{2m} =$ | 0.1409949 | 0.2291467 | 0.2819873 |
| When $n_2 < n_{20}$, $n_{2m} =$ | 0.1060889 | 0.1273120 | 0.2087952 |
| When $k_2 \geq k_{20}$, $k_{2m} =$ | 0.1109827 | 0.1363989 | 0.2069556 |
| When $k_2 < k_{20}$, $k_{2m} =$ | 0.0639978 | 0.0571204 | 0.0743250 |
| When $d_2 \geq d_{20}$, $d_{2m}$ (nm) $=$ | ∞ | ∞ | ∞ |
| When $d_2 < d_{20}$, $d_{2m}$ (nm) $=$ | 35.182 | 107.512 | 95.030 |

1. 0 < N A ≤ 1. 1
1 2 5 < T ≤ 1 3 5

| Case | 13-01 | 13-02 | 13-03 | 13-04 | 13-05 |
|---|---|---|---|---|---|
| $n_{10}$ | 1.8993435 | 1.9080238 | 1.7276770 | 1.7338076 | 1.7236449 |
| $k_{10}$ | 0.1093669 | 0.0778133 | 0.0934541 | 0.0808022 | 0.0736298 |
| $d_{10}$ (nm) | 12.638 | 11.189 | 91.210 | 91.869 | 92.640 |
| $n_{20}$ | 1.7156529 | 1.7380285 | 1.6689251 | 1.7256843 | 1.7007078 |
| $k_{20}$ | 0.2903108 | 0.2474831 | 0.2700133 | 0.2232282 | 0.1887087 |
| $d_{20}$ (nm) | 220.942 | 275.866 | 159.348 | 209.944 | 271.148 |

| | | 13-01 | 13-02 | 13-03 | 13-04 | 13-05 |
|---|---|---|---|---|---|---|
| When $n_1 \geq n_{10}$, | $n_{1m}=$ | 0.1116663 | 0.1266492 | 0.0395422 | 0.0484558 | 0.0522583 |
| When $n_1 < n_{10}$, | $n_{1m}=$ | 0.0773999 | 0.0872168 | 0.0167297 | 0.0166711 | 0.0180103 |
| When $k_1 \geq k_{10}$, | $k_{1m}=$ | 0.1011877 | 0.1103088 | 0.0409973 | 0.0422058 | 0.0417761 |
| When $k_1 < k_{10}$, | $k_{1m}=$ | 0.1093669 | 0.0778133 | 0.0410583 | 0.0409119 | 0.0443518 |
| When $d_1 \geq d_{10}$, | $d_{1m}$ (nm) $=$ | 6.392 | 6.737 | 11.272 | 16.895 | 38.105 |
| When $d_1 < d_{10}$, | $d_{1m}$ (nm) $=$ | 4.063 | 4.214 | 3.733 | 3.952 | 5.177 |
| When $n_2 \geq n_{20}$, | $n_{2m}=$ | 0.1069678 | 0.1140796 | 0.0675769 | 0.0924780 | 0.1134937 |
| When $n_2 < n_{20}$, | $n_{2m}=$ | 0.1606714 | 0.1563965 | 0.1033667 | 0.1197949 | 0.1230200 |
| When $k_2 \geq k_{20}$, | $k_{2m}=$ | 0.1040991 | 0.1083496 | 0.0397278 | 0.0600330 | 0.0739392 |
| When $k_2 < k_{20}$, | $k_{2m}=$ | 0.0926990 | 0.0882825 | 0.0652539 | 0.0659766 | 0.0617065 |
| When $d_2 \geq d_{20}$, | $d_{2m}$ (nm) $=$ | ∞ | ∞ | 29.488 | ∞ | ∞ |
| When $d_2 < d_{20}$, | $d_{2m}$ (nm) $=$ | 90.398 | 130.978 | 17.688 | 16.714 | 72.265 |

1. 0 < N A ≤ 1. 1
1 2 5 < T ≤ 1 3 5

| Case | 13-06 | 13-07 | 13-08 | 13-09 | 13-10 |
|---|---|---|---|---|---|
| $n_{10}$ | 1.7117973 | 1.7052523 | 1.6990979 | 1.6936455 | 1.6937228 |
| $k_{10}$ | 0.0782334 | 0.0648564 | 0.0723627 | 0.0657466 | 0.0602088 |
| $d_{10}$ (nm) | 159.412 | 160.141 | 220.761 | 215.539 | 212.854 |
| $n_{20}$ | 1.6949465 | 1.6847092 | 1.6931390 | 1.6916565 | 1.6917935 |
| $k_{20}$ | 0.2480962 | 0.1699839 | 0.2421156 | 0.1962143 | 0.1651159 |
| $d_{20}$ (nm) | 152.577 | 269.827 | 151.650 | 213.597 | 273.449 |

| | | 13-06 | 13-07 | 13-08 | 13-09 | 13-10 |
|---|---|---|---|---|---|---|
| When $n_1 \geq n_{10}$, | $n_{1m}=$ | 0.0367346 | 0.0551233 | 0.0594092 | 0.0311401 | 0.0698511 |
| When $n_1 < n_{10}$, | $n_{1m}=$ | 0.0058984 | 0.0239478 | 0.0244397 | 0.0431714 | 0.0693030 |
| When $k_1 \geq k_{10}$, | $k_{1m}=$ | 0.0206287 | 0.0370862 | 0.0278687 | 0.0476123 | 0.0598901 |
| When $k_1 < k_{10}$, | $k_{1m}=$ | 0.0197803 | 0.0307031 | 0.0272107 | 0.0341650 | 0.0364880 |
| When $d_1 \geq d_{10}$, | $d_{1m}$ (nm) $=$ | 17.175 | ∞ | ∞ | ∞ | ∞ |
| When $d_1 < d_{10}$, | $d_{1m}$ (nm) $=$ | 1.642 | 10.322 | 10.135 | 48.593 | 59.568 |
| When $n_2 \geq n_{20}$, | $n_{2m}=$ | 0.0634509 | 0.0441370 | 0.0646301 | 0.1417163 | 0.2349500 |
| When $n_2 < n_{20}$, | $n_{2m}=$ | 0.0185107 | 0.1268359 | 0.0304773 | 0.0878235 | 0.1413928 |
| When $k_2 \geq k_{20}$, | $k_{2m}=$ | 0.0106982 | 0.0374109 | 0.0871985 | 0.1142444 | 0.1311609 |
| When $k_2 < k_{20}$, | $k_{2m}=$ | 0.0614368 | 0.0554883 | 0.0573535 | 0.0648792 | 0.0616370 |
| When $d_2 \geq d_{20}$, | $d_{2m}$ (nm) $=$ | 20.867 | ∞ | ∞ | ∞ | ∞ |
| When $d_2 < d_{20}$, | $d_{2m}$ (nm) $=$ | 3.236 | 51.950 | 7.977 | 23.183 | 75.250 |

1. $0 < NA \leq 1.1$
$125 < T \leq 135$

| Case | 13-11 |
|---|---|
| $n_{10}$ | 1.6954835 |
| $k_{10}$ | 0.0549286 |
| $d_{10}$ (nm) | 272.481 |
| $n_{20}$ | 1.6920522 |
| $k_{20}$ | 0.1709440 |
| $d_{20}$ (nm) | 269.018 |

| When $n_1 \geq n_{10}$, $n_{1m} =$ | 0.0732507 |
|---|---|
| When $n_1 < n_{10}$, $n_{1m} =$ | 0.0527002 |
| When $k_1 \geq k_{10}$, $k_{1m} =$ | 0.0659570 |
| When $k_1 < k_{10}$, $k_{1m} =$ | 0.0396948 |
| When $d_1 \geq d_{10}$, $d_{1m}$ (nm) $=$ | $\infty$ |
| When $d_1 < d_{10}$, $d_{1m}$ (nm) $=$ | 115.848 |
| When $n_2 \geq n_{20}$, $n_{2m} =$ | 0.2876270 |
| When $n_2 < n_{20}$, $n_{2m} =$ | 0.2123071 |
| When $k_2 \geq k_{20}$, $k_{2m} =$ | 0.2114355 |
| When $k_2 < k_{20}$, $k_{2m} =$ | 0.0767078 |
| When $d_2 \geq d_{20}$, $d_{2m}$ (nm) $=$ | $\infty$ |
| When $d_2 < d_{20}$, $d_{2m}$ (nm) $=$ | 91.957 |

1. $0 < NA \leq 1.1$
$135 < T \leq 145$

| Case | 14-01 | 14-02 | 14-03 | 14-04 | 14-05 |
|---|---|---|---|---|---|
| $n_{10}$ | 1.9117383 | 1.8981283 | 1.9112943 | 1.7312914 | 1.7377087 |
| $k_{10}$ | 0.2302052 | 0.1070787 | 0.0649623 | 0.0945058 | 0.0827928 |
| $d_{10}$ (nm) | 15.980 | 13.384 | 12.163 | 91.544 | 92.151 |
| $n_{20}$ | 1.5953517 | 1.7296497 | 1.7710787 | 1.6819509 | 1.7372931 |
| $k_{20}$ | 0.4940730 | 0.3022759 | 0.2605013 | 0.2846338 | 0.2321492 |
| $d_{20}$ (nm) | 105.368 | 209.053 | 259.824 | 147.702 | 198.983 |

| When $n_1 \geq n_{10}$, $n_{1m} =$ | 0.0781360 | 0.1075745 | 0.1181738 | 0.0408386 | 0.0487402 |
|---|---|---|---|---|---|
| When $n_1 < n_{10}$, $n_{1m} =$ | 0.0319177 | 0.0739868 | 0.0809961 | 0.0177930 | 0.0144653 |
| When $k_1 \geq k_{10}$, $k_{1m} =$ | 0.0436902 | 0.0964282 | 0.0995044 | 0.0430859 | 0.0389966 |
| When $k_1 < k_{10}$, $k_{1m} =$ | 0.0819202 | 0.1070787 | 0.0649623 | 0.0421533 | 0.0388171 |
| When $d_1 \geq d_{10}$, $d_{1m}$ (nm) $=$ | 3.898 | 6.524 | 6.747 | 11.475 | 16.758 |
| When $d_1 < d_{10}$, $d_{1m}$ (nm) $=$ | 1.590 | 4.095 | 4.185 | 3.862 | 3.299 |
| When $n_2 \geq n_{20}$, $n_{2m} =$ | 0.0627563 | 0.1085400 | 0.1152271 | 0.0712305 | 0.0983997 |
| When $n_2 < n_{20}$, $n_{2m} =$ | 0.1565955 | 0.1599133 | 0.1627686 | 0.1038867 | 0.1174939 |
| When $k_2 \geq k_{20}$, $k_{2m} =$ | 0.0810010 | 0.1085132 | 0.1160754 | 0.0447900 | 0.0617737 |
| When $k_2 < k_{20}$, $k_{2m} =$ | 0.1061572 | 0.0966113 | 0.0915161 | 0.0720264 | 0.0692358 |
| When $d_2 \geq d_{20}$, $d_{2m}$ (nm) $=$ | $\infty$ | $\infty$ | $\infty$ | 26.800 | $\infty$ |
| When $d_2 < d_{20}$, $d_{2m}$ (nm) $=$ | 27.538 | 81.885 | 123.147 | 14.572 | 12.208 |

1. 0 < N A ≤ 1. 1
1 3 5 < T ≤ 1 4 5

| Case | 14-06 | 14-07 | 14-08 | 14-09 | 14-10 |
|---|---|---|---|---|---|
| $n_{10}$ | 1.7228203 | 1.7144911 | 1.7050797 | 1.6925663 | 1.6991742 |
| $k_{10}$ | 0.0749158 | 0.0796518 | 0.0657099 | 0.0675694 | 0.0739382 |
| $d_{10}$ (nm) | 92.874 | 160.015 | 160.534 | 214.049 | 220.936 |
| $n_{20}$ | 1.6951594 | 1.7090445 | 1.6817729 | 1.6900690 | 1.6992675 |
| $k_{20}$ | 0.1935801 | 0.2610315 | 0.1743389 | 0.2005073 | 0.2525134 |
| $d_{20}$ (nm) | 262.590 | 141.223 | 260.739 | 206.287 | 141.832 |

| When $n_1 \geq n_{10}$, $n_{1m} =$ | 0.0517419 | 0.0380176 | 0.0550000 | 0.0300269 | 0.0099573 |
|---|---|---|---|---|---|
| When $n_1 < n_{10}$, $n_{1m} =$ | 0.0171826 | 0.0033435 | 0.0205762 | 0.0461255 | 0.0255640 |
| When $k_1 \geq k_{10}$, $k_{1m} =$ | 0.0402747 | 0.0176941 | 0.0369080 | 0.0452966 | 0.0196790 |
| When $k_1 < k_{10}$, $k_{1m} =$ | 0.0440662 | 0.0145313 | 0.0289917 | 0.0339844 | 0.0188269 |
| When $d_1 \geq d_{10}$, $d_{1m}$ (nm) $=$ | 34.339 | 18.702 | ∞ | ∞ | ∞ |
| When $d_1 < d_{10}$, $d_{1m}$ (nm) $=$ | 4.946 | 0.924 | 8.433 | 45.536 | 10.412 |
| When $n_2 \geq n_{20}$, $n_{2m} =$ | 0.1089246 | 0.0638684 | 0.0364478 | 0.1628357 | 0.0605127 |
| When $n_2 < n_{20}$, $n_{2m} =$ | 0.1178552 | 0.0117664 | 0.1214197 | 0.0809363 | 0.0143933 |
| When $k_2 \geq k_{20}$, $k_{2m} =$ | 0.0721460 | 0.0078210 | 0.0372485 | 0.1200403 | 0.0864673 |
| When $k_2 < k_{20}$, $k_{2m} =$ | 0.0629919 | 0.0624194 | 0.0562036 | 0.0635217 | 0.0436145 |
| When $d_2 \geq d_{20}$, $d_{2m}$ (nm) $=$ | ∞ | 21.562 | ∞ | ∞ | 25.612 |
| When $d_2 < d_{20}$, $d_{2m}$ (nm) $=$ | 67.089 | 1.645 | 48.128 | 21.535 | 3.107 |

1. 0 < N A ≤ 1. 1
1 3 5 < T ≤ 1 4 5

| Case | 14-11 | 14-12 |
|---|---|---|
| $n_{10}$ | 1.6955775 | 1.6953573 |
| $k_{10}$ | 0.0548747 | 0.0556511 |
| $d_{10}$ (nm) | 213.500 | 272.231 |
| $n_{20}$ | 1.6934763 | 1.6917841 |
| $k_{20}$ | 0.1457299 | 0.1736649 |
| $d_{20}$ (nm) | 319.743 | 260.476 |

| When $n_1 \geq n_{10}$, $n_{1m} =$ | 0.0884082 | 0.0714819 |
|---|---|---|
| When $n_1 < n_{10}$, $n_{1m} =$ | 0.0760022 | 0.0518335 |
| When $k_1 \geq k_{10}$, $k_{1m} =$ | 0.0634009 | 0.0652063 |
| When $k_1 < k_{10}$, $k_{1m} =$ | 0.0349133 | 0.0395740 |
| When $d_1 \geq d_{10}$, $d_{1m}$ (nm) $=$ | ∞ | ∞ |
| When $d_1 < d_{10}$, $d_{1m}$ (nm) $=$ | 128.996 | 113.518 |
| When $n_2 \geq n_{20}$, $n_{2m} =$ | 0.2359680 | 0.2895325 |
| When $n_2 < n_{20}$, $n_{2m} =$ | 0.1212769 | 0.2158911 |
| When $k_2 \geq k_{20}$, $k_{2m} =$ | 0.1345789 | 0.2124060 |
| When $k_2 < k_{20}$, $k_{2m} =$ | 0.0582837 | 0.0793396 |
| When $d_2 \geq d_{20}$, $d_{2m}$ (nm) $=$ | ∞ | ∞ |
| When $d_2 < d_{20}$, $d_{2m}$ (nm) $=$ | 94.216 | 91.728 |

1. 0 < N A ≤ 1. 1

1 4 5 < T ≤ 1 5 5

| Case | 15-01 | 15-02 | 15-03 | 15-04 | 15-05 |
|---|---|---|---|---|---|
| $n_{10}$ | 1.8842999 | 1.9020060 | 1.9176161 | 1.7347347 | 1.7402087 |
| $k_{10}$ | 0.1660082 | 0.1078045 | 0.0733974 | 0.0970436 | 0.0854812 |
| $d_{10}$ (nm) | 15.542 | 13.884 | 11.927 | 91.613 | 92.221 |
| $n_{20}$ | 1.6642092 | 1.7406676 | 1.7608162 | 1.6897518 | 1.7427648 |
| $k_{20}$ | 0.3881866 | 0.3180988 | 0.2687301 | 0.3028107 | 0.2437105 |
| $d_{20}$ (nm) | 148.595 | 199.025 | 254.127 | 138.166 | 190.058 |

| | | 15-01 | 15-02 | 15-03 | 15-04 | 15-05 |
|---|---|---|---|---|---|---|
| When $n_1 \geq n_{10}$, | $n_{1n}=$ | 0.0902356 | 0.1039673 | 0.1191321 | 0.0403284 | 0.0477295 |
| When $n_1 < n_{10}$, | $n_{1n}=$ | 0.0608057 | 0.0712415 | 0.0806982 | 0.0168616 | 0.0123145 |
| When $k_1 \geq k_{10}$, | $k_{1n}=$ | 0.0796985 | 0.0922314 | 0.1003394 | 0.0414099 | 0.0352649 |
| When $k_1 < k_{10}$, | $k_{1n}=$ | 0.0913672 | 0.1040308 | 0.0733974 | 0.0415906 | 0.0369519 |
| When $d_1 \geq d_{10}$, | $d_{1n}$ (nm) $=$ | 5.569 | 6.401 | 6.478 | 11.141 | 16.036 |
| When $d_1 < d_{10}$, | $d_{1n}$ (nm) $=$ | 3.524 | 3.984 | 3.954 | 3.546 | 2.715 |
| When $n_2 \geq n_{20}$, | $n_{2n}=$ | 0.0975891 | 0.1093347 | 0.1166919 | 0.0721533 | 0.0993201 |
| When $n_2 < n_{20}$, | $n_{2n}=$ | 0.1510022 | 0.1570532 | 0.1613013 | 0.0996582 | 0.1116626 |
| When $k_2 \geq k_{20}$, | $k_{2n}=$ | 0.1021082 | 0.1115308 | 0.1139111 | 0.0446167 | 0.0576575 |
| When $k_2 < k_{20}$, | $k_{2n}=$ | 0.1042151 | 0.0981909 | 0.0922217 | 0.0735095 | 0.0699536 |
| When $d_2 \geq d_{20}$, | $d_{2n}$ (nm) $=$ | ∞ | ∞ | ∞ | 23.089 | ∞ |
| When $d_2 < d_{20}$, | $d_{2n}$ (nm) $=$ | 36.178 | 75.817 | 118.717 | 13.060 | 9.872 |

1. 0 < N A ≤ 1. 1

1 4 5 < T ≤ 1 5 5

| Case | 15-06 | 15-07 | 15-08 | 15-09 | 15-10 |
|---|---|---|---|---|---|
| $n_{10}$ | 1.7232674 | 1.7163169 | 1.7052425 | 1.6979604 | 1.6919325 |
| $k_{10}$ | 0.0768076 | 0.0822242 | 0.0670983 | 0.0765182 | 0.0693101 |
| $d_{10}$ (nm) | 92.842 | 160.121 | 160.367 | 219.964 | 212.895 |
| $n_{20}$ | 1.6931409 | 1.7162208 | 1.6808978 | 1.6978817 | 1.6886216 |
| $k_{20}$ | 0.2010537 | 0.2770503 | 0.1806066 | 0.2641846 | 0.2063377 |
| $d_{20}$ (nm) | 254.319 | 132.120 | 252.327 | 134.431 | 199.162 |

| | | 15-06 | 15-07 | 15-08 | 15-09 | 15-10 |
|---|---|---|---|---|---|---|
| When $n_1 \geq n_{10}$, | $n_{1n}=$ | 0.0505859 | 0.0375513 | 0.0535669 | 0.0055981 | 0.0297021 |
| When $n_1 < n_{10}$, | $n_{1n}=$ | 0.0155139 | 0.0002051 | 0.0181250 | 0.0232141 | 0.0494775 |
| When $k_1 \geq k_{10}$, | $k_{1n}=$ | 0.0378564 | 0.0051208 | 0.0335376 | 0.0146118 | 0.0441443 |
| When $k_1 < k_{10}$, | $k_{1n}=$ | 0.0427637 | 0.0032507 | 0.0275378 | 0.0178613 | 0.0327478 |
| When $d_1 \geq d_{10}$, | $d_{1n}$ (nm) $=$ | 33.581 | 19.229 | ∞ | 4.817 | ∞ |
| When $d_1 < d_{10}$, | $d_{1n}$ (nm) $=$ | 4.347 | 0.056 | 6.999 | 10.286 | 43.553 |
| When $n_2 \geq n_{20}$, | $n_{2n}=$ | 0.0760803 | 0.0599353 | 0.0299109 | 0.0539575 | 0.2378027 |
| When $n_2 < n_{20}$, | $n_{2n}=$ | 0.1135510 | 0.0008435 | 0.1135376 | 0.0106042 | 0.0839368 |
| When $k_2 \geq k_{20}$, | $k_{2n}=$ | 0.0671289 | 0.0005420 | 0.0313745 | 0.0886438 | 0.1159473 |
| When $k_2 < k_{20}$, | $k_{2n}=$ | 0.0634387 | 0.0680176 | 0.0561853 | 0.0306653 | 0.0671289 |
| When $d_2 \geq d_{20}$, | $d_{2n}$ (nm) $=$ | ∞ | 12.405 | ∞ | 21.650 | ∞ |
| When $d_2 < d_{20}$, | $d_{2n}$ (nm) $=$ | 64.219 | 0.105 | 32.640 | 2.145 | 24.441 |

1. $0 < NA \leq 1.1$
$145 < T \leq 155$

| Case | 15-11 | 15-12 |
|---|---|---|
| $n_{10}$ | 1.6933082 | 1.6953110 |
| $k_{10}$ | 0.0619759 | 0.0563706 |
| $d_{10}$ (nm) | 212.839 | 272.392 |
| $n_{20}$ | 1.6904544 | 1.6905212 |
| $k_{20}$ | 0.1723582 | 0.1778331 |
| $d_{20}$ (nm) | 255.647 | 252.170 |

| | | 15-11 | 15-12 |
|---|---|---|---|
| When $n_1 \geq n_{10}$, | $n_{1m} =$ | 0.0645605 | 0.0686462 |
| When $n_1 < n_{10}$, | $n_{1m} =$ | 0.0718213 | 0.0516125 |
| When $k_1 \geq k_{10}$, | $k_{1m} =$ | 0.0578125 | 0.0646021 |
| When $k_1 < k_{10}$, | $k_{1m} =$ | 0.0349402 | 0.0400220 |
| When $d_1 \geq d_{10}$, | $d_{1m}$ (nm) $=$ | $\infty$ | $\infty$ |
| When $d_1 < d_{10}$, | $d_{1m}$ (nm) $=$ | 54.857 | 112.777 |
| When $n_2 \geq n_{20}$, | $n_{2m} =$ | 0.2345605 | 0.2885852 |
| When $n_2 < n_{20}$, | $n_{2m} =$ | 0.1388916 | 0.2180322 |
| When $k_2 \geq k_{20}$, | $k_{2m} =$ | 0.1280078 | 0.2117786 |
| When $k_2 < k_{20}$, | $k_{2m} =$ | 0.0658081 | 0.0782971 |
| When $d_2 \geq d_{20}$, | $d_{2m}$ (nm) $=$ | $\infty$ | $\infty$ |
| When $d_2 < d_{20}$, | $d_{2m}$ (nm) $=$ | 73.297 | 86.154 |

1. $0 < NA \leq 1.1$
$155 < T \leq 165$

| Case | 16-01 | 16-02 | 16-03 | 16-04 | 16-05 |
|---|---|---|---|---|---|
| $n_{10}$ | 1.9162825 | 1.8960663 | 1.9085468 | 1.9232010 | 1.7368663 |
| $k_{10}$ | 0.2485644 | 0.1719364 | 0.1144956 | 0.0848488 | 0.1019026 |
| $d_{10}$ (nm) | 18.297 | 15.704 | 13.923 | 11.624 | 91.322 |
| $n_{20}$ | 1.6104232 | 1.6708316 | 1.7385514 | 1.7455678 | 1.6869885 |
| $k_{20}$ | 0.6165991 | 0.4169686 | 0.3337318 | 0.2771185 | 0.3224919 |
| $d_{20}$ (nm) | 83.442 | 139.520 | 191.444 | 248.983 | 130.342 |

| | | 16-01 | 16-02 | 16-03 | 16-04 | 16-05 |
|---|---|---|---|---|---|---|
| When $n_1 \geq n_{10}$, | $n_{1m} =$ | 0.0684412 | 0.0871606 | 0.1018298 | 0.1200745 | 0.0372510 |
| When $n_1 < n_{10}$, | $n_{1m} =$ | 0.0186816 | 0.0568530 | 0.0690649 | 0.0803638 | 0.0125696 |
| When $k_1 \geq k_{10}$, | $k_{1m} =$ | 0.0233801 | 0.0734265 | 0.0893420 | 0.1020142 | 0.0332275 |
| When $k_1 < k_{10}$, | $k_{1m} =$ | 0.0710925 | 0.0921472 | 0.1049048 | 0.0848488 | 0.0396851 |
| When $d_1 \geq d_{10}$, | $d_{1m}$ (nm) $=$ | 3.544 | 5.170 | 6.051 | 6.159 | 10.019 |
| When $d_1 < d_{10}$, | $d_{1m}$ (nm) $=$ | 0.960 | 3.162 | 3.726 | 3.719 | 2.554 |
| When $n_2 \geq n_{20}$, | $n_{2m} =$ | 0.0392468 | 0.0938416 | 0.1080847 | 0.1165613 | 0.0639832 |
| When $n_2 < n_{20}$, | $n_{2m} =$ | 0.1557959 | 0.1481714 | 0.1540210 | 0.1601440 | 0.0923059 |
| When $k_2 \geq k_{20}$, | $k_{2m} =$ | 0.0796021 | 0.1023108 | 0.1103064 | 0.1095667 | 0.0344885 |
| When $k_2 < k_{20}$, | $k_{2m} =$ | 0.1143958 | 0.1026965 | 0.0973987 | 0.0917590 | 0.0690210 |
| When $d_2 \geq d_{20}$, | $d_{2m}$ (nm) $=$ | $\infty$ | $\infty$ | $\infty$ | $\infty$ | 16.255 |
| When $d_2 < d_{20}$, | $d_{2m}$ (nm) $=$ | 16.079 | 31.215 | 71.737 | 92.392 | 12.361 |

1．0＜NA≦1．1
155＜T≦165

| Case | 16-06 | 16-07 | 16-08 | 16-09 | 16-10 |
|---|---|---|---|---|---|
| $n_{10}$ | 1.7401611 | 1.7243481 | 1.7054586 | 1.6959475 | 1.6918299 |
| $k_{10}$ | 0.0886217 | 0.0791015 | 0.0688139 | 0.0801582 | 0.0707672 |
| $d_{10}$ (nm) | 92.017 | 92.538 | 159.721 | 218.084 | 213.401 |
| $n_{20}$ | 1.7381402 | 1.6930588 | 1.6812702 | 1.6891859 | 1.6865968 |
| $k_{20}$ | 0.2555882 | 0.2092609 | 0.1871719 | 0.2763746 | 0.2143676 |
| $d_{20}$ (nm) | 182.755 | 245.988 | 244.029 | 128.431 | 190.286 |

| | | 16-06 | 16-07 | 16-08 | 16-09 | 16-10 |
|---|---|---|---|---|---|---|
| When $n_1 \geq n_{10}$, | $n_{1m} =$ | 0.0455261 | 0.0488196 | 0.0509851 | 0.0098682 | 0.0278625 |
| When $n_1 < n_{10}$, | $n_{1m} =$ | 0.0098901 | 0.0131677 | 0.0163489 | 0.0140930 | 0.0421411 |
| When $k_1 \geq k_{10}$, | $k_{1m} =$ | 0.0306140 | 0.0345203 | 0.0271167 | 0.0171570 | 0.0425635 |
| When $k_1 < k_{10}$, | $k_{1m} =$ | 0.0347180 | 0.0404199 | 0.0257288 | 0.0171082 | 0.0318542 |
| When $d_1 \geq d_{10}$, | $d_{1m}$ (nm) $=$ | 14.632 | 33.648 | ∞ | 8.318 | ∞ |
| When $d_1 < d_{10}$, | $d_{1m}$ (nm) $=$ | 2.133 | 3.535 | 5.969 | 6.525 | 43.306 |
| When $n_2 \geq n_{20}$, | $n_{2m} =$ | 0.0895227 | 0.0573254 | 0.0211304 | 0.0441309 | 0.2430603 |
| When $n_2 < n_{20}$, | $n_{2m} =$ | 0.1067090 | 0.1098926 | 0.1107275 | 0.0233423 | 0.0869226 |
| When $k_2 \geq k_{20}$, | $k_{2m} =$ | 0.0460217 | 0.0587354 | 0.0210486 | 0.0642297 | 0.1089050 |
| When $k_2 < k_{20}$, | $k_{2m} =$ | 0.0680432 | 0.0628845 | 0.0551514 | 0.0464880 | 0.0738831 |
| When $d_2 \geq d_{20}$, | $d_{2m}$ (nm) $=$ | ∞ | ∞ | ∞ | 19.572 | ∞ |
| When $d_2 < d_{20}$, | $d_{2m}$ (nm) $=$ | 8.553 | 37.425 | 30.745 | 5.059 | 27.273 |

1．0＜NA≦1．1
155＜T≦165

| Case | 16-11 | 16-12 |
|---|---|---|
| $n_{10}$ | 1.6935501 | 1.6953216 |
| $k_{10}$ | 0.0625258 | 0.0573372 |
| $d_{10}$ (nm) | 213.666 | 272.694 |
| $n_{20}$ | 1.6897170 | 1.6885432 |
| $k_{20}$ | 0.1780108 | 0.1839003 |
| $d_{20}$ (nm) | 246.097 | 243.579 |

| | | 16-11 | 16-12 |
|---|---|---|---|
| When $n_1 \geq n_{10}$, | $n_{1m} =$ | 0.0658508 | 0.0696008 |
| When $n_1 < n_{10}$, | $n_{1m} =$ | 0.0609790 | 0.0519751 |
| When $k_1 \geq k_{10}$, | $k_{1m} =$ | 0.0564087 | 0.0639087 |
| When $k_1 < k_{10}$, | $k_{1m} =$ | 0.0340259 | 0.0390979 |
| When $d_1 \geq d_{10}$, | $d_{1m}$ (nm) $=$ | ∞ | ∞ |
| When $d_1 < d_{10}$, | $d_{1m}$ (nm) $=$ | 55.431 | 113.126 |
| When $n_2 \geq n_{20}$, | $n_{2m} =$ | 0.2425122 | 0.2917029 |
| When $n_2 < n_{20}$, | $n_{2m} =$ | 0.1355713 | 0.2189172 |
| When $k_2 \geq k_{20}$, | $k_{2m} =$ | 0.1230981 | 0.2089771 |
| When $k_2 < k_{20}$, | $k_{2m} =$ | 0.0647131 | 0.0785583 |
| When $d_2 \geq d_{20}$, | $d_{2m}$ (nm) $=$ | ∞ | ∞ |
| When $d_2 < d_{20}$, | $d_{2m}$ (nm) $=$ | 74.519 | 83.205 |

1. 0 < N A ≤ 1. 1
1 6 5 < T ≤ 1 7 5

| Case | 17–01 | 17–02 | 17–03 | 17–04 | 17–05 |
|---|---|---|---|---|---|
| $n_{10}$ | 1.9620125 | 1.9138120 | 1.9194872 | 1.9263431 | 1.7366416 |
| $k_{10}$ | 0.2671830 | 0.1838008 | 0.1265886 | 0.0918160 | 0.1083929 |
| $d_{10}$ (nm) | 17.281 | 15.160 | 13.286 | 11.575 | 90.600 |
| $n_{20}$ | 1.6251877 | 1.6631095 | 1.7204546 | 1.7389610 | 1.6676220 |
| $k_{20}$ | 0.6875073 | 0.4399257 | 0.3440475 | 0.2853240 | 0.3363185 |
| $d_{20}$ (nm) | 75.420 | 132.541 | 186.036 | 241.421 | 124.136 |

| | | 17–01 | 17–02 | 17–03 | 17–04 | 17–05 |
|---|---|---|---|---|---|---|
| When $n_1 \geq n_{10}$, | $n_{1m} =$ | 0.0681287 | 0.0852625 | 0.1025696 | 0.1184741 | 0.0323010 |
| When $n_1 < n_{10}$, | $n_{1m} =$ | 0.0103625 | 0.0516760 | 0.0678894 | 0.0788623 | 0.0048279 |
| When $k_1 \geq k_{10}$, | $k_{1m} =$ | 0.0130603 | 0.0684912 | 0.0894849 | 0.1012756 | 0.0174634 |
| When $k_1 < k_{10}$, | $k_{1m} =$ | 0.0671069 | 0.0945691 | 0.1086621 | 0.0918160 | 0.0305151 |
| When $d_1 \geq d_{10}$, | $d_{1m}$ (nm) $=$ | 3.029 | 4.576 | 5.503 | 5.915 | 7.890 |
| When $d_1 < d_{10}$, | $d_{1m}$ (nm) $=$ | 0.441 | 2.597 | 3.327 | 3.560 | 0.944 |
| When $n_2 \geq n_{20}$, | $n_{2m} =$ | 0.0235046 | 0.0887256 | 0.1055566 | 0.1147229 | 0.0355994 |
| When $n_2 < n_{20}$, | $n_{2m} =$ | 0.1565857 | 0.1459790 | 0.1532703 | 0.1591589 | 0.0840686 |
| When $k_2 \geq k_{20}$, | $k_{2m} =$ | 0.0495569 | 0.0950366 | 0.1036096 | 0.1065601 | 0.0135376 |
| When $k_2 < k_{20}$, | $k_{2m} =$ | 0.1038318 | 0.0972864 | 0.0941003 | 0.0904578 | 0.0586487 |
| When $d_2 \geq d_{20}$, | $d_{2m}$ (nm) $=$ | ∞ | ∞ | ∞ | ∞ | 9.834 |
| When $d_2 < d_{20}$, | $d_{2m}$ (nm) $=$ | 13.490 | 32.564 | 69.289 | 94.292 | 9.844 |

1. 0 < N A ≤ 1. 1
1 6 5 < T ≤ 1 7 5

| Case | 17–06 | 17–07 | 17–08 | 17–09 | 17–10 |
|---|---|---|---|---|---|
| $n_{10}$ | 1.7377165 | 1.7250070 | 1.7054487 | 1.6921136 | 1.6937452 |
| $k_{10}$ | 0.0918810 | 0.0812670 | 0.0704565 | 0.0719896 | 0.0634118 |
| $d_{10}$ (nm) | 91.516 | 92.096 | 158.889 | 214.506 | 214.086 |
| $n_{20}$ | 1.7225143 | 1.6922454 | 1.6815182 | 1.6833735 | 1.6893106 |
| $k_{20}$ | 0.2640565 | 0.2155950 | 0.1921887 | 0.2231205 | 0.1840166 |
| $d_{20}$ (nm) | 176.484 | 237.445 | 235.428 | 180.418 | 236.602 |

| | | 17–06 | 17–07 | 17–08 | 17–09 | 17–10 |
|---|---|---|---|---|---|---|
| When $n_1 \geq n_{10}$, | $n_{1m} =$ | 0.0420569 | 0.0467627 | 0.0482849 | 0.0256970 | 0.0615491 |
| When $n_1 < n_{10}$, | $n_{1m} =$ | 0.0067480 | 0.0110010 | 0.0145544 | 0.0346619 | 0.0533179 |
| When $k_1 \geq k_{10}$, | $k_{1m} =$ | 0.0242395 | 0.0311426 | 0.0191064 | 0.0402332 | 0.0548975 |
| When $k_1 < k_{10}$, | $k_{1m} =$ | 0.0306030 | 0.0379785 | 0.0179834 | 0.0315259 | 0.0339990 |
| When $d_1 \geq d_{10}$, | $d_{1m}$ (nm) $=$ | 13.053 | 20.074 | ∞ | ∞ | ∞ |
| When $d_1 < d_{10}$, | $d_{1m}$ (nm) $=$ | 1.437 | 2.846 | 5.076 | 44.014 | 52.355 |
| When $n_2 \geq n_{20}$, | $n_{2m} =$ | 0.0699756 | 0.0474695 | 0.0119531 | 0.2616345 | 0.2513293 |
| When $n_2 < n_{20}$, | $n_{2m} =$ | 0.1027979 | 0.1100684 | 0.1104504 | 0.0766565 | 0.1353430 |
| When $k_2 \geq k_{20}$, | $k_{2m} =$ | 0.0294397 | 0.0490112 | 0.0106458 | 0.1033704 | 0.1166565 |
| When $k_2 < k_{20}$, | $k_{2m} =$ | 0.0637073 | 0.0613086 | 0.0537012 | 0.0738440 | 0.0656140 |
| When $d_2 \geq d_{20}$, | $d_{2m}$ (nm) $=$ | ∞ | ∞ | 5.139 | ∞ | ∞ |
| When $d_2 < d_{20}$, | $d_{2m}$ (nm) $=$ | 7.091 | 63.320 | 32.177 | 24.892 | 75.277 |

1. 0 < N A ≤ 1. 1
165 < T ≤ 175

| Case | 17-11 | 17-12 |
|---|---|---|
| $n_{10}$ | 1.6937402 | 1.6958036 |
| $k_{10}$ | 0.0634247 | 0.0530688 |
| $d_{10}$ (nm) | 214.067 | 271.703 |
| $n_{20}$ | 1.6892020 | 1.6918593 |
| $k_{20}$ | 0.1839903 | 0.1637010 |
| $d_{20}$ (nm) | 236.644 | 291.452 |

| | | 17-11 | 17-12 |
|---|---|---|---|
| When $n_1 \geq n_{10}$, | $n_{1m} =$ | 0.0614392 | 0.0799048 |
| When $n_1 < n_{10}$, | $n_{1m} =$ | 0.0533545 | 0.0613391 |
| When $k_1 \geq k_{10}$, | $k_{1m} =$ | 0.0548865 | 0.0657874 |
| When $k_1 < k_{10}$, | $k_{1m} =$ | 0.0340295 | 0.0406555 |
| When $d_1 \geq d_{10}$, | $d_{1m}$ (nm) $=$ | ∞ | ∞ |
| When $d_1 < d_{10}$, | $d_{1m}$ (nm) $=$ | 52.349 | 186.337 |
| When $n_2 \geq n_{20}$, | $n_{2m} =$ | 0.2512048 | 0.2852795 |
| When $n_2 < n_{20}$, | $n_{2m} =$ | 0.1353552 | 0.2060364 |
| When $k_2 \geq k_{20}$, | $k_{2m} =$ | 0.1167688 | 0.2088965 |
| When $k_2 < k_{20}$, | $k_{2m} =$ | 0.0656104 | 0.0720715 |
| When $d_2 \geq d_{20}$, | $d_{2m}$ (nm) $=$ | ∞ | ∞ |
| When $d_2 < d_{20}$, | $d_{2m}$ (nm) $=$ | 75.294 | 119.308 |

1. 0 < N A ≤ 1. 1
175 < T ≤ 185

| Case | 18-01 | 18-02 | 18-03 | 18-04 | 18-05 |
|---|---|---|---|---|---|
| $n_{10}$ | 2.0247974 | 1.9282935 | 1.9213955 | 1.9262173 | 1.7355101 |
| $k_{10}$ | 0.2830183 | 0.1992550 | 0.1387890 | 0.1063571 | 0.0947091 |
| $d_{10}$ (nm) | 15.097 | 14.428 | 13.062 | 11.253 | 91.033 |
| $n_{20}$ | 1.6266898 | 1.6428403 | 1.7027750 | 1.7173021 | 1.7079959 |
| $k_{20}$ | 0.7191283 | 0.4517072 | 0.3507816 | 0.2869739 | 0.2693832 |
| $d_{20}$ (nm) | 71.681 | 126.823 | 179.475 | 236.027 | 169.192 |

| | | 18-01 | 18-02 | 18-03 | 18-04 | 18-05 |
|---|---|---|---|---|---|---|
| When $n_1 \geq n_{10}$, | $n_{1m} =$ | 0.0749963 | 0.0847278 | 0.1010168 | 0.1197595 | 0.0387598 |
| When $n_1 < n_{10}$, | $n_{1m} =$ | 0.0029248 | 0.0471021 | 0.0652051 | 0.0785376 | 0.0037976 |
| When $k_1 \geq k_{10}$, | $k_{1m} =$ | 0.0038599 | 0.0655127 | 0.0884351 | 0.1039075 | 0.0170227 |
| When $k_1 < k_{10}$, | $k_{1m} =$ | 0.0706714 | 0.0951611 | 0.1067810 | 0.1063571 | 0.0250378 |
| When $d_1 \geq d_{10}$, | $d_{1m}$ (nm) $=$ | 2.365 | 4.047 | 5.170 | 5.710 | 10.979 |
| When $d_1 < d_{10}$, | $d_{1m}$ (nm) $=$ | 0.098 | 2.142 | 3.074 | 3.403 | 0.799 |
| When $n_2 \geq n_{20}$, | $n_{2m} =$ | 0.0068848 | 0.0841113 | 0.1036328 | 0.1139966 | 0.0477551 |
| When $n_2 < n_{20}$, | $n_{2m} =$ | 0.1606787 | 0.1462891 | 0.1534180 | 0.1596240 | 0.1042908 |
| When $k_2 \geq k_{20}$, | $k_{2m} =$ | 0.0111658 | 0.0845300 | 0.0979260 | 0.1010864 | 0.0158423 |
| When $k_2 < k_{20}$, | $k_{2m} =$ | 0.0939917 | 0.0914209 | 0.0916113 | 0.0894141 | 0.0611707 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 3.000 | 39.175 | 67.597 | 105.537 | 4.807 |

1. 0 < N A ≤ 1. 1
175 < T ≤ 185

| Case | 18-06 | 18-07 | 18-08 | 18-09 | 18-10 |
|---|---|---|---|---|---|
| $n_{10}$ | 1.7251933 | 1.7054174 | 1.6937830 | 1.6952847 | 1.6957027 |
| $k_{10}$ | 0.0829804 | 0.0718367 | 0.0647049 | 0.0582261 | 0.0542195 |
| $d_{10}$ (nm) | 91.728 | 158.389 | 214.330 | 213.359 | 271.586 |
| $n_{20}$ | 1.6903561 | 1.6812041 | 1.6889835 | 1.6934588 | 1.6918383 |
| $k_{20}$ | 0.2192539 | 0.1954390 | 0.1894046 | 0.1611341 | 0.1679902 |
| $d_{20}$ (nm) | 228.367 | 226.084 | 226.812 | 284.005 | 281.728 |

| | | 18-06 | 18-07 | 18-08 | 18-09 | 18-10 |
|---|---|---|---|---|---|---|
| When $n_1 \geq n_{10}$, | $n_{1m} =$ | 0.0450793 | 0.0463184 | 0.0575061 | 0.0820801 | 0.0778577 |
| When $n_1 < n_{10}$, | $n_{1m} =$ | 0.0094861 | 0.0044336 | 0.0478479 | 0.0612256 | 0.0602185 |
| When $k_1 \geq k_{10}$, | $k_{1m} =$ | 0.0283801 | 0.0117395 | 0.0529968 | 0.0602039 | 0.0649841 |
| When $k_1 < k_{10}$, | $k_{1m} =$ | 0.0362878 | 0.0115625 | 0.0337854 | 0.0347266 | 0.0400525 |
| When $d_1 \geq d_{10}$, | $d_{1m}$ (nm) $=$ | 16.774 | ∞ | ∞ | ∞ | ∞ |
| When $d_1 < d_{10}$, | $d_{1m}$ (nm) $=$ | 2.397 | 1.386 | 50.875 | 126.709 | 185.173 |
| When $n_2 \geq n_{20}$, | $n_{2m} =$ | 0.0407971 | 0.0052539 | 0.2620386 | 0.2460583 | 0.2888794 |
| When $n_2 < n_{20}$, | $n_{2m} =$ | 0.1134692 | 0.1157361 | 0.1359692 | 0.1267810 | 0.2086084 |
| When $k_2 \geq k_{20}$, | $k_{2m} =$ | 0.0417627 | 0.0042761 | 0.1123547 | 0.1276489 | 0.2100842 |
| When $k_2 < k_{20}$, | $k_{2m} =$ | 0.0604272 | 0.0538147 | 0.0667053 | 0.0613220 | 0.0762817 |
| When $d_2 \geq d_{20}$, | $d_{2m}$ (nm) $=$ | ∞ | 1.973 | ∞ | ∞ | ∞ |
| When $d_2 < d_{20}$, | $d_{2m}$ (nm) $=$ | 63.259 | 35.408 | 73.536 | 81.916 | 101.090 |

1. 0 < N A ≤ 1. 1
185 < T ≤ 195

| Case | 19-01 | 19-02 | 19-03 | 19-04 | 19-05 |
|---|---|---|---|---|---|
| $n_{10}$ | 1.9316549 | 1.9193011 | 1.9209840 | 1.9114684 | 1.7364379 |
| $k_{10}$ | 0.2158025 | 0.1476126 | 0.1061325 | 0.1024475 | 0.0969838 |
| $d_{10}$ (nm) | 14.297 | 13.272 | 11.842 | 10.224 | 91.033 |
| $n_{20}$ | 1.6202378 | 1.6935029 | 1.7241227 | 1.6976483 | 1.7085420 |
| $k_{20}$ | 0.4645248 | 0.3598725 | 0.2946413 | 0.2438294 | 0.2774318 |
| $d_{20}$ (nm) | 119.165 | 170.049 | 224.030 | 285.021 | 158.680 |

| | | 19-01 | 19-02 | 19-03 | 19-04 | 19-05 |
|---|---|---|---|---|---|---|
| When $n_1 \geq n_{10}$, | $n_{1m} =$ | 0.0819873 | 0.0986853 | 0.1146375 | 0.1344971 | 0.0375342 |
| When $n_1 < n_{10}$, | $n_{1m} =$ | 0.0431250 | 0.0625305 | 0.0746716 | 0.0933276 | 0.0023010 |
| When $k_1 \geq k_{10}$, | $k_{1m} =$ | 0.0616553 | 0.0860156 | 0.0981763 | 0.1190894 | 0.0118958 |
| When $k_1 < k_{10}$, | $k_{1m} =$ | 0.0896899 | 0.1016528 | 0.1061325 | 0.1024475 | 0.0218677 |
| When $d_1 \geq d_{10}$, | $d_{1m}$ (nm) $=$ | 3.700 | 5.023 | 5.787 | 6.264 | 9.942 |
| When $d_1 < d_{10}$, | $d_{1m}$ (nm) $=$ | 1.892 | 2.963 | 3.440 | 3.984 | 0.476 |
| When $n_2 \geq n_{20}$, | $n_{2m} =$ | 0.0797485 | 0.1030664 | 0.1135645 | 0.1221387 | 0.0340320 |
| When $n_2 < n_{20}$, | $n_{2m} =$ | 0.1493750 | 0.1566296 | 0.1631348 | 0.1387097 | 0.1094446 |
| When $k_2 \geq k_{20}$, | $k_{2m} =$ | 0.0775891 | 0.0962708 | 0.1030847 | 0.0998328 | 0.0100928 |
| When $k_2 < k_{20}$, | $k_{2m} =$ | 0.0909656 | 0.0941418 | 0.0920776 | 0.0860498 | 0.0649939 |
| When $d_2 \geq d_{20}$, | $d_{2m}$ (nm) $=$ | ∞ | ∞ | ∞ | ∞ | 42.778 |
| When $d_2 < d_{20}$, | $d_{2m}$ (nm) $=$ | 39.461 | 66.761 | 95.735 | 134.721 | 2.964 |

1. 0 < NA ≤ 1. 1
185 < T ≤ 195

| Case | 19–06 | 19–07 | 19–08 | 19–09 | 19–10 |
|---|---|---|---|---|---|
| $n_{10}$ | 1.7258494 | 1.7176246 | 1.7057732 | 1.7053832 | 1.6928552 |
| $k_{10}$ | 0.0843222 | 0.0727056 | 0.0731106 | 0.0633918 | 0.0748243 |
| $d_{10}$ (nm) | 91.766 | 91.617 | 158.709 | 158.181 | 216.444 |
| $n_{20}$ | 1.6907525 | 1.6784161 | 1.6805392 | 1.6859880 | 1.6825267 |
| $k_{20}$ | 0.2229229 | 0.1842107 | 0.1989479 | 0.1669818 | 0.2415835 |
| $d_{20}$ (nm) | 218.067 | 277.206 | 215.842 | 272.384 | 158.548 |

| | | 19–06 | 19–07 | 19–08 | 19–09 | 19–10 |
|---|---|---|---|---|---|---|
| When $n_1 \geq n_{10}$, | $n_{1m} =$ | 0.0445569 | 0.0497937 | 0.0455957 | 0.0532361 | 0.0209436 |
| When $n_1 < n_{10}$, | $n_{1m} =$ | 0.0086951 | 0.0298450 | 0.0022034 | 0.0367859 | 0.0248157 |
| When $k_1 \geq k_{10}$, | $k_{1m} =$ | 0.0263611 | 0.0534119 | 0.0080444 | 0.0507507 | 0.0311414 |
| When $k_1 < k_{10}$, | $k_{1m} =$ | 0.0359253 | 0.0504663 | 0.0097656 | 0.0393250 | 0.0256995 |
| When $d_1 \geq d_{10}$, | $d_{1m}$ (nm) $=$ | 15.734 | 41.766 | ∞ | ∞ | 12.676 |
| When $d_1 < d_{10}$, | $d_{1m}$ (nm) $=$ | 2.168 | 9.272 | 0.695 | 75.025 | 12.180 |
| When $n_2 \geq n_{20}$, | $n_{2m} =$ | 0.0361047 | 0.0638184 | 0.0029834 | 0.0794446 | 0.0872498 |
| When $n_2 < n_{20}$, | $n_{2m} =$ | 0.1156152 | 0.1202979 | 0.1187366 | 0.1037524 | 0.0413367 |
| When $k_2 \geq k_{20}$, | $k_{2m} =$ | 0.0400842 | 0.0626270 | 0.0025122 | 0.0450354 | 0.0876147 |
| When $k_2 < k_{20}$, | $k_{2m} =$ | 0.0626514 | 0.0561853 | 0.0563074 | 0.0506238 | 0.0672510 |
| When $d_2 \geq d_{20}$, | $d_{2m}$ (nm) $=$ | ∞ | ∞ | 1.098 | ∞ | ∞ |
| When $d_2 < d_{20}$, | $d_{2m}$ (nm) $=$ | 62.415 | 80.313 | 33.556 | 35.245 | 14.500 |

1. 0 < NA ≤ 1. 1
185 < T ≤ 195

| Case | 19–11 | 19–12 | 19–13 |
|---|---|---|---|
| $n_{10}$ | 1.6935473 | 1.6950516 | 1.6954923 |
| $k_{10}$ | 0.0663823 | 0.0596605 | 0.0554795 |
| $d_{10}$ (nm) | 214.407 | 213.429 | 271.226 |
| $n_{20}$ | 1.6888366 | 1.6925794 | 1.6917166 |
| $k_{20}$ | 0.1945007 | 0.1643538 | 0.1716832 |
| $d_{20}$ (nm) | 217.060 | 274.430 | 272.356 |

| | | 19–11 | 19–12 | 19–13 |
|---|---|---|---|---|
| When $n_1 \geq n_{10}$, | $n_{1m} =$ | 0.0539099 | 0.0837012 | 0.0771448 |
| When $n_1 < n_{10}$, | $n_{1m} =$ | 0.0450378 | 0.0604199 | 0.0593555 |
| When $k_1 \geq k_{10}$, | $k_{1m} =$ | 0.0507373 | 0.0587012 | 0.0639185 |
| When $k_1 < k_{10}$, | $k_{1m} =$ | 0.0306738 | 0.0334839 | 0.0392737 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 49.334 | 125.965 | 183.474 |
| When $n_2 \geq n_{20}$, | $n_{2m} =$ | 0.1392200 | 0.1753748 | 0.2943286 |
| When $n_2 < n_{20}$, | $n_{2m} =$ | 0.1378223 | 0.1262683 | 0.2110303 |
| When $k_2 \geq k_{20}$, | $k_{2m} =$ | 0.1089429 | 0.1267468 | 0.2119958 |
| When $k_2 < k_{20}$, | $k_{2m} =$ | 0.0654358 | 0.0611353 | 0.0788904 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 37.875 | 75.613 | 93.291 |

## 1. 0 < N A ≤ 1. 1
### 1 9 5 < T ≤ 2 0 5

| Case | 20-01 | 20-02 | 20-03 | 20-04 | 20-05 |
|---|---|---|---|---|---|
| $n_{10}$ | 1.9124203 | 1.9240615 | 1.9069086 | 1.7409810 | 1.7270720 |
| $k_{10}$ | 0.1489422 | 0.1092971 | 0.1015424 | 0.0988730 | 0.0857435 |
| $d_{10}$ (nm) | 14.330 | 12.001 | 10.748 | 91.533 | 92.142 |
| $n_{20}$ | 1.7039618 | 1.7245262 | 1.7018591 | 1.7256420 | 1.6923707 |
| $k_{20}$ | 0.3787231 | 0.3026113 | 0.2499950 | 0.2922591 | 0.2292874 |
| $d_{20}$ (nm) | 157.291 | 214.201 | 273.963 | 146.253 | 207.814 |

| | | 20-01 | 20-02 | 20-03 | 20-04 | 20-05 |
|---|---|---|---|---|---|---|
| When $n_1 \geq n_{10}$, | $n_{1m}=$ | 0.0947424 | 0.1140125 | 0.1293140 | 0.0383984 | 0.0447009 |
| When $n_1 < n_{10}$, | $n_{1m}=$ | 0.0592273 | 0.0732715 | 0.0895557 | 0.0020898 | 0.0081226 |
| When $k_1 \geq k_{10}$, | $k_{1m}=$ | 0.0804358 | 0.0961365 | 0.1132190 | 0.0106335 | 0.0246362 |
| When $k_1 < k_{10}$, | $k_{1m}=$ | 0.0954272 | 0.1092971 | 0.1015424 | 0.0220923 | 0.0359277 |
| When $d_1 \geq d_{10}$, | $d_{1m}$ (nm) $=$ | 5.168 | 5.724 | 6.406 | 9.801 | 15.595 |
| When $d_1 < d_{10}$, | $d_{1m}$ (nm) $=$ | 3.029 | 3.355 | 4.072 | 0.420 | 2.001 |
| When $n_2 \geq n_{20}$, | $n_{2m}=$ | 0.1047864 | 0.1153137 | 0.1226477 | 0.0347485 | 0.0318494 |
| When $n_2 < n_{20}$, | $n_{2m}=$ | 0.1598962 | 0.1638757 | 0.1417261 | 0.1115564 | 0.1129541 |
| When $k_2 \geq k_{20}$, | $k_{2m}=$ | 0.1020288 | 0.1044775 | 0.1018286 | 0.0106042 | 0.0415295 |
| When $k_2 < k_{20}$, | $k_{2m}=$ | 0.1029260 | 0.0959216 | 0.0891724 | 0.0737659 | 0.0663513 |
| When $d_2 \geq d_{20}$, | $d_{2m}$ (nm) $=$ | ∞ | ∞ | ∞ | 37.674 | ∞ |
| When $d_2 < d_{20}$, | $d_{2m}$ (nm) $=$ | 61.016 | 86.078 | 130.875 | 2.293 | 32.252 |

## 1. 0 < N A ≤ 1. 1
### 1 9 5 < T ≤ 2 0 5

| Case | 20-06 | 20-07 | 20-08 | 20-09 | 20-10 |
|---|---|---|---|---|---|
| $n_{10}$ | 1.7180387 | 1.7063746 | 1.7058520 | 1.6924739 | 1.6928977 |
| $k_{10}$ | 0.0734703 | 0.0744769 | 0.0640895 | 0.0767908 | 0.0684401 |
| $d_{10}$ (nm) | 91.877 | 159.624 | 158.885 | 216.680 | 213.761 |
| $n_{20}$ | 1.6777924 | 1.6791348 | 1.6855365 | 1.6850078 | 1.6885850 |
| $k_{20}$ | 0.1881130 | 0.2047799 | 0.1710983 | 0.2520629 | 0.1999527 |
| $d_{20}$ (nm) | 267.481 | 205.830 | 262.479 | 148.712 | 208.689 |

| | | 20-06 | 20-07 | 20-08 | 20-09 | 20-10 |
|---|---|---|---|---|---|---|
| When $n_1 \geq n_{10}$, | $n_{1m}=$ | 0.0499475 | 0.0454993 | 0.0542188 | 0.0126501 | 0.0501160 |
| When $n_1 < n_{10}$, | $n_{1m}=$ | 0.0300122 | 0.0018469 | 0.0331775 | 0.0226819 | 0.0449377 |
| When $k_1 \geq k_{10}$, | $k_{1m}=$ | 0.0534277 | 0.0070447 | 0.0503931 | 0.0235315 | 0.0487341 |
| When $k_1 < k_{10}$, | $k_{1m}=$ | 0.0493896 | 0.0111902 | 0.0386401 | 0.0180737 | 0.0270740 |
| When $d_1 \geq d_{10}$, | $d_{1m}$ (nm) $=$ | 33.063 | ∞ | ∞ | 10.064 | ∞ |
| When $d_1 < d_{10}$, | $d_{1m}$ (nm) $=$ | 9.229 | 0.603 | 19.062 | 10.036 | 46.531 |
| When $n_2 \geq n_{20}$, | $n_{2m}=$ | 0.0633008 | 0.0027478 | 0.0774658 | 0.0675293 | 0.1390137 |
| When $n_2 < n_{20}$, | $n_{2m}=$ | 0.1171533 | 0.1127539 | 0.1100610 | 0.0218616 | 0.1442749 |
| When $k_2 \geq k_{20}$, | $k_{2m}=$ | 0.0639148 | 0.0025830 | 0.0457581 | 0.0823975 | 0.1098364 |
| When $k_2 < k_{20}$, | $k_{2m}=$ | 0.0580542 | 0.0529590 | 0.0524817 | 0.0502942 | 0.0628650 |
| When $d_2 \geq d_{20}$, | $d_{2m}$ (nm) $=$ | ∞ | 1.007 | ∞ | ∞ | ∞ |
| When $d_2 < d_{20}$, | $d_{2m}$ (nm) $=$ | 77.001 | 28.132 | 32.836 | 6.408 | 22.345 |

$$1.\ 0 < NA \leq 1.\ 1$$
$$1\ 9\ 5 < \underline{T} \leq 2\ 0\ 5$$

| Case | 20-11 | 20-12 |
|---|---|---|
| $n_{10}$ | 1.6947635 | 1.6952371 |
| $k_{10}$ | 0.0610999 | 0.0566636 |
| $d_{10}$ (nm) | 213.366 | 270.653 |
| $n_{20}$ | 1.6918971 | 1.6914186 |
| $k_{20}$ | 0.1679521 | 0.1751623 |
| $d_{20}$ (nm) | 265.388 | 263.994 |

| | | 20-11 | 20-12 |
|---|---|---|---|
| When $n_1 \geq n_{10}$, | $n_{1m} =$ | 0.0863086 | 0.0772644 |
| When $n_1 < n_{10}$, | $n_{1m} =$ | 0.0626501 | 0.0586890 |
| When $k_1 \geq k_{10}$, | $k_{1m} =$ | 0.0572302 | 0.0627917 |
| When $k_1 < k_{10}$, | $k_{1m} =$ | 0.0322180 | 0.0382104 |
| When $d_1 \geq d_{10}$, | $d_{1m}$ (nm) $=$ | $\infty$ | $\infty$ |
| When $d_1 < d_{10}$, | $d_{1m}$ (nm) $=$ | 124.819 | 121.330 |
| When $n_2 \geq n_{20}$, | $n_{2m} =$ | 0.1702917 | 0.3021582 |
| When $n_2 < n_{20}$, | $n_{2m} =$ | 0.1249365 | 0.2142798 |
| When $k_2 \geq k_{20}$, | $k_{2m} =$ | 0.1249084 | 0.2136462 |
| When $k_2 < k_{20}$, | $k_{2m} =$ | 0.0643469 | 0.0826477 |
| When $d_2 \geq d_{20}$, | $d_{2m}$ (nm) $=$ | $\infty$ | $\infty$ |
| When $d_2 < d_{20}$, | $d_{2m}$ (nm) $=$ | 66.113 | 91.025 |

**3.** An antireflective film used in a process for manufacturing a semiconductor device by being provided between a resist layer and a silicon oxide layer formed on a surface of a silicon semiconductor substrate and having a thickness T (unit: nm) described below, for exposure of the resist layer in an exposure system having a wavelength of 190 nm to 195 nm and a numerical aperture NA of $1.1 < NA \leq 1.2$, the antireflective film having a two-layer structure comprising:

an upper layer having a complex refractive index $N_1$; and
a lower layer having a complex refractive index $N_2$; the complex refractive indexes $N_1$ and $N_2$ being represented by the equations $N_1 = n_1 - k_1 i$ and $N_2 = n_2 - k_2 i$, respectively;
wherein assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1$, $k_1$, $d_1$, $n_2$, $k_2$, and $d_2$ satisfy the relational expression

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1;$$

a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a

value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$; and in the tables below, in the line of "When $n_1 \geq n_{10}$, $n_{1m}$ =", each value in the right columns is "$n_{1m} - n_{10}$"; in the line of "When $n_1 < n_{10}$, $n_{1m}$ =", each value in the right columns is "$n_{10} - n_{1m}$"; in the line of "When $k_1 \geq k_{10}$, $k_{1m}$ =", each value in the right columns is "$k_{1m} - k_{10}$"; in the line of "When $k_1 < k_{10}$, $k_{1m}$ =", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m}$ =", each value in the right columns is "$n_{2m} - n_{20}$"; in the line of "When $n_2 < n_{20}$, $n_{2m}$ =", each value in the right columns is "$n_{20} - n_{2m}$"; in the line of "When $k_2 \geq k_{20}$, $k_{2m}$ =", each value in the right columns is "$k_{2m} - k_{20}$"; in the line of "When $k_2 < k_{20}$, $k_{2m}$ =", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

1. 1 < N A ≤ 1. 2
2 ≤ T ≤ 1 5

| Case | 1-01 | 1-02 | 1-03 | 1-04 | 1-05 |
|---|---|---|---|---|---|
| $n_{10}$ | 2.0940641 | 1.9168406 | 1.8970115 | 1.8805879 | 1.8778358 |
| $k_{10}$ | 0.0325844 | 0.1807255 | 0.1529573 | 0.1098415 | 0.1082679 |
| $d_{10}$ (nm) | 26.090 | 35.662 | 31.182 | 13.577 | 19.930 |
| $n_{20}$ | 4.2290158 | 5.4932306 | 2.4318401 | 1.7032895 | 1.8340760 |
| $k_{20}$ | 2.3935124 | 0.6123354 | 0.5958382 | 0.2751108 | 0.3677230 |
| $d_{20}$ (nm) | 3.632 | 19.087 | 52.406 | 218.193 | 142.226 |

| | | 1-01 | 1-02 | 1-03 | 1-04 | 1-05 |
|---|---|---|---|---|---|---|
| When $n_1 \geq n_{10}$, | $n_{1m} =$ | 0.0779846 | 0.0720874 | 0.0701013 | 0.1012354 | 0.0784314 |
| When $n_1 < n_{10}$, | $n_{1m} =$ | 0.0750281 | 0.0636047 | 0.0555591 | 0.0635571 | 0.0497058 |
| When $k_1 \geq k_{10}$, | $k_{1m} =$ | 0.0672229 | 0.0527649 | 0.0494641 | 0.0853247 | 0.0590771 |
| When $k_1 < k_{10}$, | $k_{1m} =$ | 0.0325844 | 0.0849731 | 0.0840393 | 0.1029980 | 0.0867822 |
| When $d_1 \geq d_{10}$, | $d_{1m}$ (nm) $=$ | 3.416 | 5.199 | 6.198 | 6.716 | 7.382 |
| When $d_1 < d_{10}$, | $d_{1m}$ (nm) $=$ | 2.721 | 3.845 | 3.923 | 3.853 | 3.873 |
| When $n_2 \geq n_{20}$, | $n_{2m} =$ | 0.2775293 | 0.1187439 | 0.1333862 | 0.1147803 | 0.1115393 |
| When $n_2 < n_{20}$, | $n_{2m} =$ | 0.2711597 | 0.1202087 | 0.1603455 | 0.1449023 | 0.1457849 |
| When $k_2 \geq k_{20}$, | $k_{2m} =$ | 0.2845105 | 0.1470557 | 0.1794812 | 0.0967163 | 0.1467151 |
| When $k_2 < k_{20}$, | $k_{2m} =$ | 0.2499512 | 0.1180896 | 0.1302063 | 0.0855334 | 0.0954285 |
| When $d_2 \geq d_{20}$, | $d_{2m}$ (nm) $=$ | 0.458 | 0.467 | 5.440 | ∞ | ∞ |
| When $d_2 < d_{20}$, | $d_{2m}$ (nm) $=$ | 0.433 | 0.450 | 5.242 | 81.747 | 30.656 |

1. 1 < N A ≤ 1. 2
2 ≤ T ≤ 1 5

| Case | 1-06 | 1-07 | 1-08 | 1-09 | 1-10 |
|---|---|---|---|---|---|
| $n_{10}$ | 1.8663312 | 1.7888608 | 1.7735009 | 1.7175310 | 1.7199475 |
| $k_{10}$ | 0.0978132 | 0.1060865 | 0.0957437 | 0.0751352 | 0.0655065 |
| $d_{10}$ (nm) | 12.232 | 103.503 | 98.181 | 95.409 | 94.621 |
| $n_{20}$ | 1.6938400 | 4.4234099 | 2.0208865 | 1.6658936 | 1.6963762 |
| $k_{20}$ | 0.2288643 | 0.4526804 | 0.4158741 | 0.2054797 | 0.1762614 |
| $d_{20}$ (nm) | 277.705 | 24.164 | 66.693 | 212.937 | 266.043 |

| | | 1-06 | 1-07 | 1-08 | 1-09 | 1-10 |
|---|---|---|---|---|---|---|
| When $n_1 \geq n_{10}$, | $n_{1m} =$ | 0.1143909 | 0.0588428 | 0.0489270 | 0.0419214 | 0.0484180 |
| When $n_1 < n_{10}$, | $n_{1m} =$ | 0.0786536 | 0.0104822 | 0.0094507 | 0.0157727 | 0.0265735 |
| When $k_1 \geq k_{10}$, | $k_{1m} =$ | 0.1033447 | 0.0215918 | 0.0249109 | 0.0382361 | 0.0520056 |
| When $k_1 < k_{10}$, | $k_{1m} =$ | 0.0978132 | 0.0439624 | 0.0358655 | 0.0399121 | 0.0459387 |
| When $d_1 \geq d_{10}$, | $d_{1m}$ (nm) $=$ | 7.609 | 9.370 | 10.912 | 18.272 | 51.841 |
| When $d_1 < d_{10}$, | $d_{1m}$ (nm) $=$ | 4.794 | 1.739 | 1.766 | 4.805 | 8.596 |
| When $n_2 \geq n_{20}$, | $n_{2m} =$ | 0.1069263 | 0.0468066 | 0.0740674 | 0.0384924 | 0.0631091 |
| When $n_2 < n_{20}$, | $n_{2m} =$ | 0.1302808 | 0.1036670 | 0.1052673 | 0.0829468 | 0.0987561 |
| When $k_2 \geq k_{20}$, | $k_{2m} =$ | 0.0918579 | 0.0409717 | 0.0495154 | 0.0385596 | 0.0522119 |
| When $k_2 < k_{20}$, | $k_{2m} =$ | 0.0786169 | 0.0807788 | 0.0903577 | 0.0528296 | 0.0515430 |
| When $d_2 \geq d_{20}$, | $d_{2m}$ (nm) $=$ | ∞ | 0.296 | 4.999 | ∞ | ∞ |
| When $d_2 < d_{20}$, | $d_{2m}$ (nm) $=$ | 128.233 | 0.621 | 5.371 | 23.038 | 34.154 |

1. 1 < N A ≤ 1. 2
2 ≤ T ≤ 1 5

| Case | 1-11 | 1-12 | 1-13 | 1-14 | 1-15 |
|---|---|---|---|---|---|
| $n_{10}$ | 1.7156729 | 1.7043499 | 1.7082412 | 1.6926126 | 1.6890888 |
| $k_{10}$ | 0.0770168 | 0.0644952 | 0.0577629 | 0.0683906 | 0.0745003 |
| $d_{10}$ (nm) | 188.315 | 165.315 | 163.169 | 237.184 | 217.718 |
| $n_{20}$ | 6.9620048 | 1.6731418 | 1.7075031 | 6.7859369 | 1.7770504 |
| $k_{20}$ | 3.4231449 | 0.1899705 | 0.1626792 | 2.9992529 | 0.3401503 |
| $d_{20}$ (nm) | 0.879 | 207.250 | 259.766 | 0.993 | 84.925 |

| | | 1-11 | 1-12 | 1-13 | 1-14 | 1-15 |
|---|---|---|---|---|---|---|
| When $n_1 \geq n_{10}$, | $n_{1m} =$ | 0.0649841 | 0.0417419 | 0.0509473 | 0.0348376 | 0.0194055 |
| When $n_1 < n_{10}$, | $n_{1m} =$ | 0.0083154 | 0.0317078 | 0.0477380 | 0.0764368 | 0.0607605 |
| When $k_1 \geq k_{10}$, | $k_{1m} =$ | 0.0257251 | 0.0333704 | 0.0433435 | 0.0403589 | 0.0329480 |
| When $k_1 < k_{10}$, | $k_{1m} =$ | 0.0275232 | 0.0338538 | 0.0333484 | 0.0319214 | 0.0242554 |
| When $d_1 \geq d_{10}$, | $d_{1m}$ (nm) $=$ | 38.959 | ∞ | ∞ | 19.483 | 9.981 |
| When $d_1 < d_{10}$, | $d_{1m}$ (nm) $=$ | 3.134 | 16.146 | 77.216 | 43.463 | 24.681 |
| When $n_2 \geq n_{20}$, | $n_{2m} =$ | 0.2971887 | 0.0474377 | 0.0745630 | 0.5633252 | 0.1177502 |
| When $n_2 < n_{20}$, | $n_{2m} =$ | 0.6091602 | 0.0721411 | 0.0651379 | 0.4300269 | 0.0317639 |
| When $k_2 \geq k_{20}$, | $k_{2m} =$ | 0.2827808 | 0.0222888 | 0.0325830 | 0.2436438 | 0.0560791 |
| When $k_2 < k_{20}$, | $k_{2m} =$ | 0.6937878 | 0.0478259 | 0.0479700 | 0.5647217 | 0.0980969 |
| When $d_2 \geq d_{20}$, | $d_{2m}$ (nm) $=$ | 0.055 | 16.772 | ∞ | 0.120 | 16.691 |
| When $d_2 < d_{20}$, | $d_{2m}$ (nm) $=$ | 0.135 | 19.208 | 16.504 | 0.176 | 3.670 |

1. 1 < N A ≤ 1. 2
2 ≤ T ≤ 1 5

| Case | 1-16 | 1-17 | 1-18 | 1-19 |
|---|---|---|---|---|
| $n_{10}$ | 1.6903292 | 1.6921355 | 1.6951475 | 1.7004017 |
| $k_{10}$ | 0.0721915 | 0.0670288 | 0.0546351 | 0.0599028 |
| $d_{10}$ (nm) | 210.963 | 207.063 | 219.259 | 265.986 |
| $n_{20}$ | 1.7111030 | 1.6978167 | 1.6889102 | 1.7029410 |
| $k_{20}$ | 0.2426612 | 0.1954345 | 0.1606659 | 0.1992607 |
| $d_{20}$ (nm) | 155.846 | 222.387 | 263.728 | 214.965 |

| | | 1-16 | 1-17 | 1-18 | 1-19 |
|---|---|---|---|---|---|
| When $n_1 \geq n_{10}$, | $n_{1m} =$ | 0.0284180 | 0.0456091 | 0.0773694 | 0.0612244 |
| When $n_1 < n_{10}$, | $n_{1m} =$ | 0.0510327 | 0.0467078 | 0.0619885 | 0.0410486 |
| When $k_1 \geq k_{10}$, | $k_{1m} =$ | 0.0455554 | 0.0511133 | 0.0524768 | 0.0499927 |
| When $k_1 < k_{10}$, | $k_{1m} =$ | 0.0320984 | 0.0388074 | 0.0353687 | 0.0377380 |
| When $d_1 \geq d_{10}$, | $d_{1m}$ (nm) $=$ | 23.770 | ∞ | ∞ | ∞ |
| When $d_1 < d_{10}$, | $d_{1m}$ (nm) $=$ | 28.472 | 31.416 | 128.164 | 94.534 |
| When $n_2 \geq n_{20}$, | $n_{2m} =$ | 0.1260327 | 0.1631665 | 0.2120154 | 0.2674829 |
| When $n_2 < n_{20}$, | $n_{2m} =$ | 0.0663647 | 0.1722144 | 0.1079456 | 0.2316101 |
| When $k_2 \geq k_{20}$, | $k_{2m} =$ | 0.0960291 | 0.1259009 | 0.1121619 | 0.2074023 |
| When $k_2 < k_{20}$, | $k_{2m} =$ | 0.0846741 | 0.0757690 | 0.0591858 | 0.0894751 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 12.288 | 72.281 | 78.597 | 77.855 |

1. $1 < NA \leq 1.2$
$15 < T \leq 25$

| Case | 2-01 | 2-02 | 2-03 | 2-04 | 2-05 |
|---|---|---|---|---|---|
| $n_{10}$ | 1.8738578 | 1.8839217 | 1.8842367 | 1.8705650 | 1.7997475 |
| $k_{10}$ | 0.2051029 | 0.1169859 | 0.1130268 | 0.1010320 | 0.1076402 |
| $d_{10}$ (nm) | 37.506 | 20.540 | 14.059 | 12.433 | 101.817 |
| $n_{20}$ | 6.9151921 | 1.8488520 | 1.7087850 | 1.6946915 | 5.7702673 |
| $k_{20}$ | 0.6847654 | 0.3990514 | 0.2917115 | 0.2394813 | 0.5312541 |
| $d_{20}$ (nm) | 14.288 | 132.865 | 208.377 | 268.610 | 17.283 |

| | 2-01 | 2-02 | 2-03 | 2-04 | 2-05 |
|---|---|---|---|---|---|
| When $n_1 \geq n_{10}$, $n_{1m} =$ | 0.0713965 | 0.0757019 | 0.0971472 | 0.1115784 | 0.0520068 |
| When $n_1 < n_{10}$, $n_{1m} =$ | 0.0555054 | 0.0476453 | 0.0599609 | 0.0759399 | 0.0098120 |
| When $k_1 \geq k_{10}$, $k_{1m} =$ | 0.0541125 | 0.0561304 | 0.0804553 | 0.1002258 | 0.0237036 |
| When $k_1 < k_{10}$, $k_{1m} =$ | 0.0773486 | 0.0843945 | 0.1004919 | 0.1010320 | 0.0377808 |
| When $d_1 \geq d_{10}$, $d_{1m}$ (nm) $=$ | 5.211 | 6.923 | 6.482 | 7.316 | 8.566 |
| When $d_1 < d_{10}$, $d_{1m}$ (nm) $=$ | 3.920 | 3.580 | 3.648 | 4.569 | 1.552 |
| When $n_2 \geq n_{20}$, $n_{2m} =$ | 0.1375024 | 0.1133521 | 0.1126624 | 0.1051160 | 0.0578821 |
| When $n_2 < n_{20}$, $n_{2m} =$ | 0.1468335 | 0.1457764 | 0.1432654 | 0.1327966 | 0.1020337 |
| When $k_2 \geq k_{20}$, $k_{2m} =$ | 0.1698267 | 0.1546228 | 0.0978870 | 0.0916199 | 0.0398865 |
| When $k_2 < k_{20}$, $k_{2m} =$ | 0.1355151 | 0.0979541 | 0.0869165 | 0.0797766 | 0.0850256 |
| When $d_2 \geq d_{20}$, $d_{2m}$ (nm) $=$ | 0.302 | ∞ | ∞ | ∞ | 0.186 |
| When $d_2 < d_{20}$, $d_{2m}$ (nm) $=$ | 0.308 | 25.359 | 77.278 | 123.573 | 0.315 |

1. $1 < NA \leq 1.2$
$15 < T \leq 25$

| Case | 2-06 | 2-07 | 2-08 | 2-09 | 2-10 |
|---|---|---|---|---|---|
| $n_{10}$ | 1.7189014 | 1.7208712 | 1.7236639 | 1.7047019 | 1.7084293 |
| $k_{10}$ | 0.0782837 | 0.0678223 | 0.0843652 | 0.0670962 | 0.0597123 |
| $d_{10}$ (nm) | 95.289 | 94.558 | 181.922 | 165.192 | 163.108 |
| $n_{20}$ | 1.6643388 | 1.6960341 | 5.6387216 | 1.6715149 | 1.7074208 |
| $k_{20}$ | 0.2165956 | 0.1841027 | 4.7363270 | 0.1999125 | 0.1697699 |
| $d_{20}$ (nm) | 204.139 | 257.386 | 0.821 | 198.564 | 251.199 |

| | 2-06 | 2-07 | 2-08 | 2-09 | 2-10 |
|---|---|---|---|---|---|
| When $n_1 \geq n_{10}$, $n_{1m} =$ | 0.0400110 | 0.0468091 | 0.0526855 | 0.0398865 | 0.0490320 |
| When $n_1 < n_{10}$, $n_{1m} =$ | 0.0126721 | 0.0238684 | 0.0001306 | 0.0279565 | 0.0460034 |
| When $k_1 \geq k_{10}$, $k_{1m} =$ | 0.0335376 | 0.0489734 | 0.0020081 | 0.0268384 | 0.0389331 |
| When $k_1 < k_{10}$, $k_{1m} =$ | 0.0373218 | 0.0446973 | 0.0057251 | 0.0295178 | 0.0306982 |
| When $d_1 \geq d_{10}$, $d_{1m}$ (nm) $=$ | 16.137 | 28.984 | 27.528 | ∞ | ∞ |
| When $d_1 < d_{10}$, $d_{1m}$ (nm) $=$ | 3.682 | 7.422 | 0.042 | 13.795 | 27.544 |
| When $n_2 \geq n_{20}$, $n_{2m} =$ | 0.0331177 | 0.0610901 | 0.0075977 | 0.0397839 | 0.0734460 |
| When $n_2 < n_{20}$, $n_{2m} =$ | 0.0802783 | 0.0961804 | 0.6135461 | 0.0646704 | 0.0518091 |
| When $k_2 \geq k_{20}$, $k_{2m} =$ | 0.0326062 | 0.0485974 | 0.0047754 | 0.0159570 | 0.0275537 |
| When $k_2 < k_{20}$, $k_{2m} =$ | 0.0528589 | 0.0519092 | 0.7998767 | 0.0474854 | 0.0482410 |
| When $d_2 \geq d_{20}$, $d_{2m}$ (nm) $=$ | ∞ | ∞ | 0.001 | 11.667 | ∞ |
| When $d_2 < d_{20}$, $d_{2m}$ (nm) $=$ | 20.507 | 30.742 | 0.141 | 16.953 | 13.761 |

1. $1 < NA \leq 1.2$
$15 < T \leq 25$

| Case | 2-11 | 2-12 | 2-13 | 2-14 | 2-15 |
|---|---|---|---|---|---|
| $n_{10}$ | 1.6912240 | 1.6881032 | 1.6896993 | 1.6917374 | 1.6948846 |
| $k_{10}$ | 0.0750717 | 0.0788193 | 0.0752193 | 0.0692921 | 0.0562662 |
| $d_{10}$ (nm) | 235.933 | 218.423 | 211.247 | 207.206 | 219.172 |
| $n_{20}$ | 5.6089359 | 1.7881557 | 1.7110684 | 1.6970724 | 1.6877325 |
| $k_{20}$ | 4.1789938 | 0.3823123 | 0.2595743 | 0.2053429 | 0.1673191 |
| $d_{20}$ (nm) | 0.921 | 76.059 | 147.061 | 213.576 | 255.276 |

| | | 2-11 | 2-12 | 2-13 | 2-14 | 2-15 |
|---|---|---|---|---|---|---|
| When $n_1 \geq n_{10}$, | $n_{1m} =$ | 0.0197583 | 0.0081677 | 0.0235974 | 0.0421069 | 0.0510120 |
| When $n_1 < n_{10}$, | $n_{1m} =$ | 0.0774451 | 0.0583032 | 0.0505896 | 0.0462817 | 0.0590515 |
| When $k_1 \geq k_{10}$, | $k_{1m} =$ | 0.0246448 | 0.0223682 | 0.0406641 | 0.0495398 | 0.0510083 |
| When $k_1 < k_{10}$, | $k_{1m} =$ | 0.0218396 | 0.0175671 | 0.0286658 | 0.0376331 | 0.0343799 |
| When $d_1 \geq d_{10}$, | $d_{1m}$ (nm) $=$ | 6.504 | 3.634 | 18.131 | $\infty$ | $\infty$ |
| When $d_1 < d_{10}$, | $d_{1m}$ (nm) $=$ | 42.587 | 22.206 | 26.432 | 29.901 | 81.491 |
| When $n_2 \geq n_{20}$, | $n_{2m} =$ | 0.6544434 | 0.1247424 | 0.1252808 | 0.1545593 | 0.2162573 |
| When $n_2 < n_{20}$, | $n_{2m} =$ | 0.2325012 | 0.0171619 | 0.0503735 | 0.1749207 | 0.1048962 |
| When $k_2 \geq k_{20}$, | $k_{2m} =$ | 0.1484387 | 0.0366235 | 0.0860120 | 0.1212268 | 0.1092822 |
| When $k_2 < k_{20}$, | $k_{2m} =$ | 0.6595715 | 0.1036670 | 0.0844458 | 0.0781323 | 0.0604700 |
| When $d_2 \geq d_{20}$, | $d_{2m}$ (nm) $=$ | 0.071 | 14.060 | $\infty$ | $\infty$ | $\infty$ |
| When $d_2 < d_{20}$, | $d_{2m}$ (nm) $=$ | 0.195 | 1.711 | 9.636 | 69.774 | 76.197 |

1. $1 < NA \leq 1.2$
$15 < T \leq 25$

| Case | 2-16 | 2-17 |
|---|---|---|
| $n_{10}$ | 1.7002883 | 1.6987256 |
| $k_{10}$ | 0.0618224 | 0.0572006 |
| $d_{10}$ (nm) | 266.113 | 264.952 |
| $n_{20}$ | 1.7025341 | 1.6934905 |
| $k_{20}$ | 0.2096252 | 0.1744162 |
| $d_{20}$ (nm) | 206.193 | 266.771 |

| | | 2-16 | 2-17 |
|---|---|---|---|
| When $n_1 \geq n_{10}$, | $n_{1m} =$ | 0.0602454 | 0.0764587 |
| When $n_1 < n_{10}$, | $n_{1m} =$ | 0.0381921 | 0.0594568 |
| When $k_1 \geq k_{10}$, | $k_{1m} =$ | 0.0482422 | 0.0536096 |
| When $k_1 < k_{10}$, | $k_{1m} =$ | 0.0371497 | 0.0384741 |
| When $d_1 \geq d_{10}$, | $d_{1m}$ (nm) $=$ | $\infty$ | $\infty$ |
| When $d_1 < d_{10}$, | $d_{1m}$ (nm) $=$ | 92.805 | 173.726 |
| When $n_2 \geq n_{20}$, | $n_{2m} =$ | 0.2779004 | 0.2751611 |
| When $n_2 < n_{20}$, | $n_{2m} =$ | 0.2377234 | 0.2053577 |
| When $k_2 \geq k_{20}$, | $k_{2m} =$ | 0.2066309 | 0.2211816 |
| When $k_2 < k_{20}$, | $k_{2m} =$ | 0.0931018 | 0.0797998 |
| When $d_2 \geq d_{20}$, | $d_{2m}$ (nm) $=$ | $\infty$ | $\infty$ |
| When $d_2 < d_{20}$, | $d_{2m}$ (nm) $=$ | 73.805 | 125.295 |

1. 1 < N A ≤ 1. 2
2 5 < T ≤ 3 5

| Case | 3-01 | 3-02 | 3-03 | 3-04 | 3-05 |
|---|---|---|---|---|---|
| $n_{10}$ | 1.8384852 | 1.8997218 | 1.8867733 | 1.8774399 | 1.8168537 |
| $k_{10}$ | 0.2367471 | 0.1227276 | 0.1201944 | 0.1030917 | 0.1206742 |
| $d_{10}$ (nm) | 38.632 | 21.226 | 14.426 | 12.555 | 98.976 |
| $n_{20}$ | 4.7928214 | 1.8945709 | 1.7066853 | 1.6978346 | 5.6725781 |
| $k_{20}$ | 0.7766058 | 0.4412749 | 0.3085187 | 0.2515853 | 0.5943855 |
| $d_{20}$ (nm) | 20.034 | 121.762 | 200.277 | 259.495 | 16.950 |

| | | 3-01 | 3-02 | 3-03 | 3-04 | 3-05 |
|---|---|---|---|---|---|---|
| When $n_1 \geq n_{10}$, | $n_{1m} =$ | 0.0640527 | 0.0719128 | 0.0931812 | 0.1089819 | 0.0387244 |
| When $n_1 < n_{10}$, | $n_{1m} =$ | 0.0455762 | 0.0458093 | 0.0565320 | 0.0737622 | 0.0048828 |
| When $k_1 \geq k_{10}$, | $k_{1m} =$ | 0.0510876 | 0.0524744 | 0.0764050 | 0.0973877 | 0.0168860 |
| When $k_1 < k_{10}$, | $k_{1m} =$ | 0.0717981 | 0.0817957 | 0.0981750 | 0.1030917 | 0.0269836 |
| When $d_1 \geq d_{10}$, | $d_{1m}$ (nm) $=$ | 4.733 | 6.228 | 6.172 | 6.944 | 6.776 |
| When $d_1 < d_{10}$, | $d_{1m}$ (nm) $=$ | 3.444 | 3.186 | 3.418 | 4.320 | 0.695 |
| When $n_2 \geq n_{20}$, | $n_{2m} =$ | 0.1712317 | 0.1175342 | 0.1094324 | 0.1025208 | 0.0610400 |
| When $n_2 < n_{20}$, | $n_{2m} =$ | 0.1852917 | 0.1447205 | 0.1408899 | 0.1358679 | 0.1030127 |
| When $k_2 \geq k_{20}$, | $k_{2m} =$ | 0.2079944 | 0.1727771 | 0.0971545 | 0.0913745 | 0.0239368 |
| When $k_2 < k_{20}$, | $k_{2m} =$ | 0.1709546 | 0.1005322 | 0.0873328 | 0.0807227 | 0.0995679 |
| When $d_2 \geq d_{20}$, | $d_{2m}$ (nm) $=$ | 0.789 | ∞ | ∞ | ∞ | 0.191 |
| When $d_2 < d_{20}$, | $d_{2m}$ (nm) $=$ | 0.773 | 21.526 | 73.345 | 89.127 | 0.308 |

1. 1 < N A ≤ 1. 2
2 5 < T ≤ 3 5

| Case | 3-06 | 3-07 | 3-08 | 3-09 | 3-10 |
|---|---|---|---|---|---|
| $n_{10}$ | 1.7203847 | 1.7222308 | 1.7051744 | 1.7089344 | 1.6891179 |
| $k_{10}$ | 0.0818178 | 0.0703272 | 0.0699535 | 0.0618729 | 0.0788518 |
| $d_{10}$ (nm) | 95.097 | 94.450 | 164.924 | 162.999 | 211.328 |
| $n_{20}$ | 1.6625491 | 1.6972414 | 1.6707295 | 1.7091982 | 1.7121044 |
| $k_{20}$ | 0.2295920 | 0.1929579 | 0.2115581 | 0.1777196 | 0.2799946 |
| $d_{20}$ (nm) | 195.706 | 248.789 | 190.095 | 242.642 | 139.125 |

| | | 3-06 | 3-07 | 3-08 | 3-09 | 3-10 |
|---|---|---|---|---|---|---|
| When $n_1 \geq n_{10}$, | $n_{1m} =$ | 0.0370166 | 0.0449036 | 0.0362634 | 0.0468103 | 0.0189148 |
| When $n_1 < n_{10}$, | $n_{1m} =$ | 0.0096326 | 0.0211206 | 0.0148706 | 0.0438916 | 0.0495532 |
| When $k_1 \geq k_{10}$, | $k_{1m} =$ | 0.0279895 | 0.0455884 | 0.0190686 | 0.0333899 | 0.0327563 |
| When $k_1 < k_{10}$, | $k_{1m} =$ | 0.0346558 | 0.0433374 | 0.0247266 | 0.0269507 | 0.0238696 |
| When $d_1 \geq d_{10}$, | $d_{1m}$ (nm) $=$ | 14.187 | 22.312 | ∞ | ∞ | 9.561 |
| When $d_1 < d_{10}$, | $d_{1m}$ (nm) $=$ | 2.673 | 6.291 | 5.065 | 24.312 | 23.646 |
| When $n_2 \geq n_{20}$, | $n_{2m} =$ | 0.0267200 | 0.0590454 | 0.0307410 | 0.0721521 | 0.1253455 |
| When $n_2 < n_{20}$, | $n_{2m} =$ | 0.0766724 | 0.0932019 | 0.0523315 | 0.0386328 | 0.0336450 |
| When $k_2 \geq k_{20}$, | $k_{2m} =$ | 0.0255017 | 0.0445288 | 0.0095300 | 0.0215259 | 0.0725635 |
| When $k_2 < k_{20}$, | $k_{2m} =$ | 0.0521814 | 0.0521948 | 0.0465356 | 0.0485632 | 0.0779358 |
| When $d_2 \geq d_{20}$, | $d_{2m}$ (nm) $=$ | ∞ | ∞ | 7.007 | 43.167 | ∞ |
| When $d_2 < d_{20}$, | $d_{2m}$ (nm) $=$ | 18.077 | 28.239 | 14.543 | 10.181 | 6.908 |

## 1. $1 < NA \leqq 1.2$
### $25 < T \leqq 35$

| Case | 3-11 | 3-12 | 3-13 | 3-14 |
|---|---|---|---|---|
| $n_{10}$ | 1.6914863 | 1.6947006 | 1.7002933 | 1.6987290 |
| $k_{10}$ | 0.0717884 | 0.0580661 | 0.0640004 | 0.0588877 |
| $d_{10}$ (nm) | 207.154 | 219.137 | 266.055 | 264.992 |
| $n_{20}$ | 1.6970451 | 1.6875442 | 1.7022941 | 1.6933668 |
| $k_{20}$ | 0.2167627 | 0.1751428 | 0.2216801 | 0.1822428 |
| $d_{20}$ (nm) | 205.768 | 246.865 | 198.139 | 258.415 |

| | | 3-11 | 3-12 | 3-13 | 3-14 |
|---|---|---|---|---|---|
| When $n_1 \geqq n_{10}$, | $n_{1m} =$ | 0.0385889 | 0.0449475 | 0.0561011 | 0.0760583 |
| When $n_1 < n_{10}$, | $n_{1m} =$ | 0.0454712 | 0.0531458 | 0.0356934 | 0.0583093 |
| When $k_1 \geqq k_{10}$, | $k_{1m} =$ | 0.0478943 | 0.0493811 | 0.0460974 | 0.0520996 |
| When $k_1 < k_{10}$, | $k_{1m} =$ | 0.0361658 | 0.0330811 | 0.0363293 | 0.0375061 |
| When $d_1 \geqq d_{10}$, | $d_{1m}$ (nm) $=$ | $\infty$ | $\infty$ | $\infty$ | $\infty$ |
| When $d_1 < d_{10}$, | $d_{1m}$ (nm) $=$ | 28.219 | 77.448 | 91.180 | 121.680 |
| When $n_2 \geqq n_{20}$, | $n_{2m} =$ | 0.1522107 | 0.2230298 | 0.2904858 | 0.2858545 |
| When $n_2 < n_{20}$, | $n_{2m} =$ | 0.1781921 | 0.1009351 | 0.2457825 | 0.2068896 |
| When $k_2 \geqq k_{20}$, | $k_{2m} =$ | 0.1157642 | 0.1063892 | 0.2056812 | 0.2216101 |
| When $k_2 < k_{20}$, | $k_{2m} =$ | 0.0805957 | 0.0617065 | 0.0977039 | 0.0829004 |
| When $d_2 \geqq d_{20}$, | $d_{2m}$ (nm) $=$ | $\infty$ | $\infty$ | $\infty$ | $\infty$ |
| When $d_2 < d_{20}$, | $d_{2m}$ (nm) $=$ | 66.127 | 48.464 | 70.211 | 121.644 |

## 1. $1 < NA \leqq 1.2$
### $35 < T \leqq 45$

| Case | 4-01 | 4-02 | 4-03 | 4-04 | 4-05 |
|---|---|---|---|---|---|
| $n_{10}$ | 1.8909619 | 1.9211597 | 1.8908364 | 1.8788634 | 1.7209142 |
| $k_{10}$ | 0.2198688 | 0.1299283 | 0.1293290 | 0.1089981 | 0.0850231 |
| $d_{10}$ (nm) | 30.886 | 20.325 | 14.409 | 12.666 | 94.685 |
| $n_{20}$ | 2.4457650 | 1.8999891 | 1.6971949 | 1.6934061 | 1.6569532 |
| $k_{20}$ | 0.9042920 | 0.4762728 | 0.3219355 | 0.2597468 | 0.2398462 |
| $d_{20}$ (nm) | 40.480 | 114.977 | 192.850 | 251.595 | 187.582 |

| | | 4-01 | 4-02 | 4-03 | 4-04 | 4-05 |
|---|---|---|---|---|---|---|
| When $n_1 \geqq n_{10}$, | $n_{1m} =$ | 0.0581348 | 0.0702795 | 0.0908240 | 0.1067529 | 0.0340771 |
| When $n_1 < n_{10}$, | $n_{1m} =$ | 0.0408777 | 0.0430811 | 0.0541882 | 0.0719214 | 0.0077319 |
| When $k_1 \geqq k_{10}$, | $k_{1m} =$ | 0.0449243 | 0.0499243 | 0.0741248 | 0.0961597 | 0.0239465 |
| When $k_1 < k_{10}$, | $k_{1m} =$ | 0.0797229 | 0.0798120 | 0.0963696 | 0.1066907 | 0.0329150 |
| When $d_1 \geqq d_{10}$, | $d_{1m}$ (nm) $=$ | 4.322 | 5.448 | 5.786 | 6.719 | 11.856 |
| When $d_1 < d_{10}$, | $d_{1m}$ (nm) $=$ | 2.642 | 2.634 | 3.166 | 4.161 | 2.071 |
| When $n_2 \geqq n_{20}$, | $n_{2m} =$ | 0.1853430 | 0.1162805 | 0.1041772 | 0.0995618 | 0.0224622 |
| When $n_2 < n_{20}$, | $n_{2m} =$ | 0.1757385 | 0.1461218 | 0.1390881 | 0.1365247 | 0.0731372 |
| When $k_2 \geqq k_{20}$, | $k_{2m} =$ | 0.2033411 | 0.1671118 | 0.0936316 | 0.0897620 | 0.0193579 |
| When $k_2 < k_{20}$, | $k_{2m} =$ | 0.1615027 | 0.0988000 | 0.0865491 | 0.0806287 | 0.0502966 |
| When $d_2 \geqq d_{20}$, | $d_{2m}$ (nm) $=$ | 5.473 | $\infty$ | $\infty$ | $\infty$ | 13.590 |
| When $d_2 < d_{20}$, | $d_{2m}$ (nm) $=$ | 4.339 | 20.871 | 70.442 | 87.096 | 16.661 |

1. 1 < N A ≤ 1. 2

35 < T ≤ 4 5

| Case | | 4-06 | 4-07 | 4-08 | 4-09 | 4-10 |
|---|---|---|---|---|---|---|
| $n_{10}$ | | 1.7236493 | 1.7053690 | 1.7096103 | 1.6884398 | 1.6913141 |
| $k_{10}$ | | 0.0725136 | 0.0723352 | 0.0638708 | 0.0822671 | 0.0737244 |
| $d_{10}$ (nm) | | 94.253 | 164.385 | 162.799 | 210.788 | 206.649 |
| $n_{20}$ | | 1.6994520 | 1.6690598 | 1.7121782 | 1.7077650 | 1.6954335 |
| $k_{20}$ | | 0.2004026 | 0.2212238 | 0.1844639 | 0.2979850 | 0.2262249 |
| $d_{20}$ (nm) | | 239.752 | 181.544 | 233.616 | 132.459 | 199.430 |
| | | | | | | |
| When $n_1 \geq n_{10}$, | $n_{1m}=$ | 0.0432617 | 0.0328076 | 0.0449390 | 0.0103259 | 0.0357813 |
| When $n_1 < n_{10}$, | $n_{1m}=$ | 0.0189111 | 0.0081836 | 0.0418201 | 0.0476318 | 0.0441882 |
| When $k_1 \geq k_{10}$, | $k_{1m}=$ | 0.0428613 | 0.0134167 | 0.0270105 | 0.0240100 | 0.0467419 |
| When $k_1 < k_{10}$, | $k_{1m}=$ | 0.0419373 | 0.0221985 | 0.0217126 | 0.0186353 | 0.0353625 |
| When $d_1 \geq d_{10}$, | $d_{1m}$ (nm) = | 19.395 | 21.834 | ∞ | 7.013 | ∞ |
| When $d_1 < d_{10}$, | $d_{1m}$ (nm) = | 5.406 | 2.666 | 6.246 | 21.283 | 26.527 |
| When $n_2 \geq n_{20}$, | $n_{2m}=$ | 0.0587073 | 0.0279724 | 0.0684412 | 0.1217639 | 0.1437500 |
| When $n_2 < n_{20}$, | $n_{2m}=$ | 0.0913135 | 0.0359949 | 0.0242969 | 0.0190967 | 0.1057874 |
| When $k_2 \geq k_{20}$, | $k_{2m}=$ | 0.0407703 | 0.0058350 | 0.0150317 | 0.0602039 | 0.1122632 |
| When $k_2 < k_{20}$, | $k_{2m}=$ | 0.0523291 | 0.0449670 | 0.0490210 | 0.0601965 | 0.0826379 |
| When $d_2 \geq d_{20}$, | $d_{2m}$ (nm) = | ∞ | 4.683 | 36.767 | ∞ | ∞ |
| When $d_2 < d_{20}$, | $d_{2m}$ (nm) = | 25.916 | 13.275 | 6.151 | 3.566 | 25.291 |

1. 1 < N A ≤ 1. 2

35 < T ≤ 4 5

| Case | | 4-11 | 4-12 | 4-13 |
|---|---|---|---|---|
| $n_{10}$ | | 1.6945163 | 1.7002615 | 1.6987767 |
| $k_{10}$ | | 0.0596605 | 0.0658973 | 0.0602453 |
| $d_{10}$ (nm) | | 219.093 | 265.562 | 264.538 |
| $n_{20}$ | | 1.6879518 | 1.6991117 | 1.6924357 |
| $k_{20}$ | | 0.1823501 | 0.2320843 | 0.1888152 |
| $d_{20}$ (nm) | | 237.943 | 190.875 | 250.808 |

| When $n_1 \geq n_{10}$, | $n_{1m}=$ | 0.0400159 | 0.0514929 | 0.0760449 |
|---|---|---|---|---|
| When $n_1 < n_{10}$, | $n_{1m}=$ | 0.0454590 | 0.0339758 | 0.0578162 |
| When $k_1 \geq k_{10}$, | $k_{1m}=$ | 0.0478894 | 0.0439832 | 0.0508728 |
| When $k_1 < k_{10}$, | $k_{1m}=$ | 0.0318921 | 0.0347144 | 0.0365662 |
| When $d_1 \geq d_{10}$, | $d_{1m}$ (nm) = | ∞ | ∞ | ∞ |
| When $d_1 < d_{10}$, | $d_{1m}$ (nm) = | 53.950 | 89.870 | 117.603 |
| When $n_2 \geq n_{20}$, | $n_{2m}=$ | 0.2316992 | 0.3028357 | 0.2948633 |
| When $n_2 < n_{20}$, | $n_{2m}=$ | 0.0956519 | 0.2532336 | 0.2085193 |
| When $k_2 \geq k_{20}$, | $k_{2m}=$ | 0.1045911 | 0.2056006 | 0.2209802 |
| When $k_2 < k_{20}$, | $k_{2m}=$ | 0.0612427 | 0.1002246 | 0.0860327 |
| When $d_2 \geq d_{20}$, | $d_{2m}$ (nm) = | ∞ | ∞ | ∞ |
| When $d_2 < d_{20}$, | $d_{2m}$ (nm) = | 40.957 | 67.613 | 80.377 |

1. 1 < N A ≤ 1. 2
4 5 < T ≤ 5 5

| Case | 5–01 | 5–02 | 5–03 | 5–04 | 5–05 |
|---|---|---|---|---|---|
| $n_{10}$ | 1.9413239 | 1.8877645 | 1.8798429 | 1.7202563 | 1.7249517 |
| $k_{10}$ | 0.1405566 | 0.1445306 | 0.1135692 | 0.0870823 | 0.0739360 |
| $d_{10}$ (nm) | 18.043 | 14.095 | 12.637 | 94.214 | 94.041 |
| $n_{20}$ | 1.8442891 | 1.6688638 | 1.6888514 | 1.6489031 | 1.7027050 |
| $k_{20}$ | 0.4845639 | 0.3235014 | 0.2638544 | 0.2445724 | 0.2047377 |
| $d_{20}$ (nm) | 113.109 | 187.292 | 243.053 | 179.182 | 229.905 |

| When $n_1 \geq n_{10}$, $n_{1m}=$ | 0.0724768 | 0.0904346 | 0.1062329 | 0.0324084 | 0.0425623 |
|---|---|---|---|---|---|
| When $n_1 < n_{10}$, $n_{1m}=$ | 0.0387427 | 0.0534119 | 0.0716968 | 0.0082080 | 0.0177209 |
| When $k_1 \geq k_{10}$, $k_{1m}=$ | 0.0483630 | 0.0753357 | 0.0968298 | 0.0243140 | 0.0418030 |
| When $k_1 < k_{10}$, $k_{1m}=$ | 0.0803040 | 0.0945715 | 0.1060376 | 0.0343469 | 0.0406653 |
| When $d_1 \geq d_{10}$, $d_{1m}$ (nm) $=$ | 4.823 | 5.486 | 6.573 | 10.670 | 17.560 |
| When $d_1 < d_{10}$, $d_{1m}$ (nm) $=$ | 2.042 | 3.025 | 4.077 | 2.161 | 4.892 |
| When $n_2 \geq n_{20}$, $n_{2m}=$ | 0.1074292 | 0.0972339 | 0.0967822 | 0.0242322 | 0.0621313 |
| When $n_2 < n_{20}$, $n_{2m}=$ | 0.1555688 | 0.1383643 | 0.1358411 | 0.0727905 | 0.0930249 |
| When $k_2 \geq k_{20}$, $k_{2m}=$ | 0.1308459 | 0.0862097 | 0.0881348 | 0.0180859 | 0.0388489 |
| When $k_2 < k_{20}$, $k_{2m}=$ | 0.0911877 | 0.0843787 | 0.0806641 | 0.0488940 | 0.0530957 |
| When $d_2 \geq d_{20}$, $d_{2m}$ (nm) $=$ | ∞ | ∞ | ∞ | 10.287 | ∞ |
| When $d_2 < d_{20}$, $d_{2m}$ (nm) $=$ | 20.712 | 69.838 | 88.098 | 16.560 | 20.064 |

1. 1 < N A ≤ 1. 2
4 5 < T ≤ 5 5

| Case | 5–06 | 5–07 | 5–08 | 5–09 | 5–10 |
|---|---|---|---|---|---|
| $n_{10}$ | 1.7053831 | 1.7104785 | 1.6877471 | 1.6915115 | 1.6941672 |
| $k_{10}$ | 0.0736370 | 0.0654156 | 0.0844092 | 0.0739491 | 0.0608347 |
| $d_{10}$ (nm) | 163.843 | 162.671 | 209.661 | 205.513 | 218.889 |
| $n_{20}$ | 1.6671854 | 1.7160090 | 1.6959640 | 1.6904122 | 1.6879018 |
| $k_{20}$ | 0.2267475 | 0.1885946 | 0.3073448 | 0.2298496 | 0.1872431 |
| $d_{20}$ (nm) | 172.382 | 223.774 | 127.018 | 196.556 | 228.501 |

| When $n_1 \geq n_{10}$, $n_{1m}=$ | 0.0309619 | 0.0440515 | 0.0051978 | 0.0335425 | 0.0357227 |
|---|---|---|---|---|---|
| When $n_1 < n_{10}$, $n_{1m}=$ | 0.0112268 | 0.0078247 | 0.0453333 | 0.0430493 | 0.0410388 |
| When $k_1 \geq k_{10}$, $k_{1m}=$ | 0.0149072 | 0.0196375 | 0.0173291 | 0.0473206 | 0.0467871 |
| When $k_1 < k_{10}$, $k_{1m}=$ | 0.0262830 | 0.0141846 | 0.0154602 | 0.0372058 | 0.0305029 |
| When $d_1 \geq d_{10}$, $d_{1m}$ (nm) $=$ | 19.247 | ∞ | 2.276 | ∞ | ∞ |
| When $d_1 < d_{10}$, $d_{1m}$ (nm) $=$ | 3.447 | 2.046 | 19.587 | 24.997 | 50.391 |
| When $n_2 \geq n_{20}$, $n_{2m}=$ | 0.0348413 | 0.0672729 | 0.1107800 | 0.1391333 | 0.2394653 |
| When $n_2 < n_{20}$, $n_{2m}=$ | 0.0292676 | 0.0106921 | 0.0107263 | 0.0732312 | 0.0890649 |
| When $k_2 \geq k_{20}$, $k_{2m}=$ | 0.0073389 | 0.0081616 | 0.0597644 | 0.1152246 | 0.1047815 |
| When $k_2 < k_{20}$, $k_{2m}=$ | 0.0445459 | 0.0504346 | 0.0379138 | 0.0797473 | 0.0602527 |
| When $d_2 \geq d_{20}$, $d_{2m}$ (nm) $=$ | 6.326 | 35.781 | 32.689 | ∞ | ∞ |
| When $d_2 < d_{20}$, $d_{2m}$ (nm) $=$ | 11.802 | 2.505 | 1.901 | 20.558 | 36.515 |

1. 1 < N A ≤ 1. 2
45 < T ≤ 55

| Case | 5–11 | 5–12 | 5–13 |
|---|---|---|---|
| $n_{10}$ | 1.6941096 | 1.7000691 | 1.6987341 |
| $k_{10}$ | 0.0560046 | 0.0669711 | 0.0608862 |
| $d_{10}$ (nm) | 215.482 | 264.757 | 263.855 |
| $n_{20}$ | 1.6938988 | 1.6924460 | 1.6911373 |
| $k_{20}$ | 0.1599964 | 0.2378630 | 0.1924284 |
| $d_{20}$ (nm) | 287.470 | 184.028 | 243.250 |

| | | 5–11 | 5–12 | 5–13 |
|---|---|---|---|---|
| When $n_1 \geq n_{10}$, | $n_{1m}=$ | 0.0468335 | 0.0484424 | 0.0766663 |
| When $n_1 < n_{10}$, | $n_{1m}=$ | 0.0625427 | 0.0333350 | 0.0582520 |
| When $k_1 \geq k_{10}$, | $k_{1m}=$ | 0.0574133 | 0.0424146 | 0.0503235 |
| When $k_1 < k_{10}$, | $k_{1m}=$ | 0.0373425 | 0.0336023 | 0.0357239 |
| When $d_1 \geq d_{10}$, | $d_{1m}$ (nm) = | ∞ | ∞ | ∞ |
| When $d_1 < d_{10}$, | $d_{1m}$ (nm) = | 47.031 | 45.336 | 115.043 |
| When $n_2 \geq n_{20}$, | $n_{2m}=$ | 0.2184277 | 0.3156848 | 0.3032751 |
| When $n_2 < n_{20}$, | $n_{2m}=$ | 0.1528296 | 0.2586377 | 0.2107019 |
| When $k_2 \geq k_{20}$, | $k_{2m}=$ | 0.1238171 | 0.2073083 | 0.2191870 |
| When $k_2 < k_{20}$, | $k_{2m}=$ | 0.0588196 | 0.0981323 | 0.0862329 |
| When $d_2 \geq d_{20}$, | $d_{2m}$ (nm) = | ∞ | ∞ | ∞ |
| When $d_2 < d_{20}$, | $d_{2m}$ (nm) = | 85.352 | 66.135 | 78.131 |

1. 1 < N A ≤ 1. 2
55 < T ≤ 65

| Case | 6–01 | 6–02 | 6–03 | 6–04 | 6–05 |
|---|---|---|---|---|---|
| $n_{10}$ | 1.8998120 | 1.9599431 | 1.8792360 | 1.8920036 | 1.7198405 |
| $k_{10}$ | 0.2622743 | 0.1538418 | 0.1119058 | 0.0671877 | 0.0878543 |
| $d_{10}$ (nm) | 21.573 | 15.993 | 12.895 | 11.926 | 93.971 |
| $n_{20}$ | 1.6944131 | 1.7907917 | 1.6940206 | 1.7462722 | 1.6452515 |
| $k_{20}$ | 0.7809017 | 0.4780154 | 0.2681658 | 0.2347435 | 0.2473168 |
| $d_{20}$ (nm) | 53.320 | 111.028 | 231.714 | 280.522 | 169.419 |

| | | 6–01 | 6–02 | 6–03 | 6–04 | 6–05 |
|---|---|---|---|---|---|---|
| When $n_1 \geq n_{10}$, | $n_{1m}=$ | 0.0603137 | 0.0799158 | 0.1051331 | 0.1164221 | 0.0325574 |
| When $n_1 < n_{10}$, | $n_{1m}=$ | 0.0246228 | 0.0339001 | 0.0713818 | 0.0790796 | 0.0109656 |
| When $k_1 \geq k_{10}$, | $k_{1m}=$ | 0.0436731 | 0.0463733 | 0.0957117 | 0.1011499 | 0.0282458 |
| When $k_1 < k_{10}$, | $k_{1m}=$ | 0.0527222 | 0.0842969 | 0.1045093 | 0.0671877 | 0.0383301 |
| When $d_1 \geq d_{10}$, | $d_{1m}$ (nm) = | 3.630 | 4.315 | 6.630 | 7.111 | 10.486 |
| When $d_1 < d_{10}$, | $d_{1m}$ (nm) = | 1.338 | 1.548 | 4.149 | 4.416 | 2.879 |
| When $n_2 \geq n_{20}$, | $n_{2m}=$ | 0.1220337 | 0.0996899 | 0.0944202 | 0.0992114 | 0.0312585 |
| When $n_2 < n_{20}$, | $n_{2m}=$ | 0.0963342 | 0.1728088 | 0.1384424 | 0.1517053 | 0.0751245 |
| When $k_2 \geq k_{20}$, | $k_{2m}=$ | 0.0896167 | 0.0986731 | 0.0889478 | 0.0981226 | 0.0215662 |
| When $k_2 < k_{20}$, | $k_{2m}=$ | 0.0868945 | 0.0892566 | 0.0826782 | 0.0802551 | 0.0503503 |
| When $d_2 \geq d_{20}$, | $d_{2m}$ (nm) = | 14.581 | ∞ | ∞ | ∞ | 10.833 |
| When $d_2 < d_{20}$, | $d_{2m}$ (nm) = | 7.202 | 14.530 | 88.193 | 126.095 | 17.275 |

1. $1 < NA \leq 1.2$
$55 < T \leq 65$

| Case | 6-06 | 6-07 | 6-08 | 6-09 | 6-10 |
|---|---|---|---|---|---|
| $n_{10}$ | 1.7267515 | 1.7286377 | 1.7058235 | 1.6871196 | 1.6936372 |
| $k_{10}$ | 0.0746914 | 0.0697592 | 0.0740364 | 0.0856014 | 0.0616799 |
| $d_{10}$ (nm) | 93.982 | 94.711 | 163.674 | 208.540 | 218.466 |
| $n_{20}$ | 1.7088385 | 1.7257237 | 1.6690540 | 1.6832134 | 1.6877720 |
| $k_{20}$ | 0.2076415 | 0.1796886 | 0.2306007 | 0.3092532 | 0.1900717 |
| $d_{20}$ (nm) | 218.911 | 273.487 | 161.946 | 121.170 | 218.772 |

| | | 6-06 | 6-07 | 6-08 | 6-09 | 6-10 |
|---|---|---|---|---|---|---|
| When $n_1 \geq n_{10}$, | $n_{1m} =$ | 0.0431396 | 0.0483069 | 0.0312061 | 0.0049573 | 0.0327710 |
| When $n_1 < n_{10}$, | $n_{1m} =$ | 0.0172424 | 0.0116125 | 0.0175793 | 0.0417786 | 0.0401648 |
| When $k_1 \geq k_{10}$, | $k_{1m} =$ | 0.0418896 | 0.0318958 | 0.0202844 | 0.0152393 | 0.0462805 |
| When $k_1 < k_{10}$, | $k_{1m} =$ | 0.0396252 | 0.0362695 | 0.0328467 | 0.0174036 | 0.0298352 |
| When $d_1 \geq d_{10}$, | $d_{1m}$ (nm) $=$ | 17.247 | 40.127 | 17.394 | 2.172 | $\infty$ |
| When $d_1 < d_{10}$, | $d_{1m}$ (nm) $=$ | 4.621 | 3.300 | 5.870 | 18.309 | 47.643 |
| When $n_2 \geq n_{20}$, | $n_{2m} =$ | 0.0684570 | 0.0868091 | 0.0312744 | 0.1009155 | 0.2431030 |
| When $n_2 < n_{20}$, | $n_{2m} =$ | 0.0962207 | 0.1095422 | 0.0318677 | 0.0098169 | 0.0838513 |
| When $k_2 \geq k_{20}$, | $k_{2m} =$ | 0.0394080 | 0.0515259 | 0.0123767 | 0.0719922 | 0.1060815 |
| When $k_2 < k_{20}$, | $k_{2m} =$ | 0.0553357 | 0.0549243 | 0.0471436 | 0.0304236 | 0.0607056 |
| When $d_2 \geq d_{20}$, | $d_{2m}$ (nm) $=$ | $\infty$ | $\infty$ | 9.995 | 25.676 | $\infty$ |
| When $d_2 < d_{20}$, | $d_{2m}$ (nm) $=$ | 15.791 | 73.815 | 10.017 | 1.682 | 28.435 |

1. $1 < NA \leq 1.2$
$55 < T \leq 65$

| Case | 6-11 | 6-12 |
|---|---|---|
| $n_{10}$ | 1.6996002 | 1.6985143 |
| $k_{10}$ | 0.0674630 | 0.0611760 |
| $d_{10}$ (nm) | 264.231 | 263.586 |
| $n_{20}$ | 1.6851097 | 1.6903246 |
| $k_{20}$ | 0.2396601 | 0.1936289 |
| $d_{20}$ (nm) | 175.944 | 234.054 |

| | | 6-11 | 6-12 |
|---|---|---|---|
| When $n_1 \geq n_{10}$, | $n_{1m} =$ | 0.0469604 | 0.0772302 |
| When $n_1 < n_{10}$, | $n_{1m} =$ | 0.0345850 | 0.0600415 |
| When $k_1 \geq k_{10}$, | $k_{1m} =$ | 0.0413989 | 0.0503625 |
| When $k_1 < k_{10}$, | $k_{1m} =$ | 0.0326746 | 0.0352795 |
| When $d_1 \geq d_{10}$, | $d_{1m}$ (nm) $=$ | $\infty$ | $\infty$ |
| When $d_1 < d_{10}$, | $d_{1m}$ (nm) $=$ | 35.789 | 113.370 |
| When $n_2 \geq n_{20}$, | $n_{2m} =$ | 0.3361853 | 0.3175012 |
| When $n_2 < n_{20}$, | $n_{2m} =$ | 0.2595898 | 0.2115027 |
| When $k_2 \geq k_{20}$, | $k_{2m} =$ | 0.2087170 | 0.2189661 |
| When $k_2 < k_{20}$, | $k_{2m} =$ | 0.0954248 | 0.0859949 |
| When $d_2 \geq d_{20}$, | $d_{2m}$ (nm) $=$ | $\infty$ | $\infty$ |
| When $d_2 < d_{20}$, | $d_{2m}$ (nm) $=$ | 64.780 | 74.733 |

1. 1 < N A ≤ 1. 2
6 5 < T ≤ 7 5

| Case | 7-01 | 7-02 | 7-03 | 7-04 | 7-05 |
|---|---|---|---|---|---|
| $n_{10}$ | 1.8814830 | 1.9657443 | 1.8787154 | 1.8913468 | 1.7209187 |
| $k_{10}$ | 0.2936564 | 0.1688741 | 0.1109169 | 0.0695388 | 0.0883668 |
| $d_{10}$ (nm) | 22.098 | 15.852 | 13.263 | 12.162 | 94.055 |
| $n_{20}$ | 1.6321609 | 1.7726563 | 1.6996278 | 1.7469121 | 1.6482914 |
| $k_{20}$ | 0.8097385 | 0.4923001 | 0.2745566 | 0.2387131 | 0.2540527 |
| $d_{20}$ (nm) | 46.190 | 103.170 | 220.404 | 270.807 | 158.511 |

| | | 7-01 | 7-02 | 7-03 | 7-04 | 7-05 |
|---|---|---|---|---|---|---|
| When $n_1 \geq n_{10}$, | $n_{1m} =$ | 0.0656360 | 0.0817346 | 0.1037085 | 0.1149512 | 0.0333252 |
| When $n_1 < n_{10}$, | $n_{1m} =$ | 0.0241089 | 0.0282544 | 0.0702112 | 0.0769897 | 0.0127490 |
| When $k_1 \geq k_{10}$, | $k_{1m} =$ | 0.0378577 | 0.0400220 | 0.0934888 | 0.0991272 | 0.0301257 |
| When $k_1 < k_{10}$, | $k_{1m} =$ | 0.0323035 | 0.0824512 | 0.1025916 | 0.0695388 | 0.0388867 |
| When $d_1 \geq d_{10}$, | $d_{1m}$ (nm) $=$ | 3.610 | 3.980 | 6.711 | 7.159 | 10.691 |
| When $d_1 < d_{10}$, | $d_{1m}$ (nm) $=$ | 1.297 | 1.237 | 4.191 | 4.366 | 3.330 |
| When $n_2 \geq n_{20}$, | $n_{2m} =$ | 0.1024585 | 0.0947095 | 0.0935791 | 0.1004138 | 0.0355066 |
| When $n_2 < n_{20}$, | $n_{2m} =$ | 0.0645630 | 0.1828857 | 0.1422339 | 0.1540833 | 0.0767798 |
| When $k_2 \geq k_{20}$, | $k_{2m} =$ | 0.0898303 | 0.0894482 | 0.0904114 | 0.0989551 | 0.0244946 |
| When $k_2 < k_{20}$, | $k_{2m} =$ | 0.1003796 | 0.0949036 | 0.0851941 | 0.0816284 | 0.0535193 |
| When $d_2 \geq d_{20}$, | $d_{2m}$ (nm) $=$ | 11.613 | ∞ | ∞ | ∞ | 11.010 |
| When $d_2 < d_{20}$, | $d_{2m}$ (nm) $=$ | 4.416 | 10.112 | 84.053 | 124.915 | 16.505 |

1. 1 < N A ≤ 1. 2
6 5 < T ≤ 7 5

| Case | 7-06 | 7-07 | 7-08 | 7-09 | 7-10 |
|---|---|---|---|---|---|
| $n_{10}$ | 1.7288665 | 1.7286370 | 1.7068032 | 1.6862856 | 1.6931399 |
| $k_{10}$ | 0.0756184 | 0.0709992 | 0.0744994 | 0.0878163 | 0.0624918 |
| $d_{10}$ (nm) | 94.090 | 94.923 | 163.814 | 208.124 | 217.968 |
| $n_{20}$ | 1.7153723 | 1.7241262 | 1.6739446 | 1.6736237 | 1.6872372 |
| $k_{20}$ | 0.2125971 | 0.1831189 | 0.2371534 | 0.3138657 | 0.1926334 |
| $d_{20}$ (nm) | 207.924 | 263.961 | 151.052 | 112.320 | 209.546 |

| | | 7-06 | 7-07 | 7-08 | 7-09 | 7-10 |
|---|---|---|---|---|---|---|
| When $n_1 \geq n_{10}$, | $n_{1m} =$ | 0.0437573 | 0.0483350 | 0.0322754 | 0.0025049 | 0.0316833 |
| When $n_1 < n_{10}$, | $n_{1m} =$ | 0.0164966 | 0.0099878 | 0.0175537 | 0.0409570 | 0.0419177 |
| When $k_1 \geq k_{10}$, | $k_{1m} =$ | 0.0410425 | 0.0291785 | 0.0221094 | 0.0095605 | 0.0459827 |
| When $k_1 < k_{10}$, | $k_{1m} =$ | 0.0388428 | 0.0344531 | 0.0333215 | 0.0151172 | 0.0300720 |
| When $d_1 \geq d_{10}$, | $d_{1m}$ (nm) $=$ | 17.329 | 38.775 | 18.851 | 1.009 | ∞ |
| When $d_1 < d_{10}$, | $d_{1m}$ (nm) $=$ | 4.318 | 2.813 | 6.154 | 17.032 | 45.887 |
| When $n_2 \geq n_{20}$, | $n_{2m} =$ | 0.0710437 | 0.0893457 | 0.0302136 | 0.1037878 | 0.2406421 |
| When $n_2 < n_{20}$, | $n_{2m} =$ | 0.0969080 | 0.1083484 | 0.0331750 | 0.0056763 | 0.0830054 |
| When $k_2 \geq k_{20}$, | $k_{2m} =$ | 0.0400586 | 0.0500842 | 0.0147241 | 0.0658289 | 0.1059290 |
| When $k_2 < k_{20}$, | $k_{2m} =$ | 0.0574512 | 0.0562378 | 0.0506323 | 0.0175342 | 0.0630762 |
| When $d_2 \geq d_{20}$, | $d_{2m}$ (nm) $=$ | ∞ | ∞ | 10.293 | 26.205 | ∞ |
| When $d_2 < d_{20}$, | $d_{2m}$ (nm) $=$ | 13.701 | 72.849 | 8.984 | 0.992 | 28.220 |

388

1. 1 $<$ N A $\leq$ 1. 2
6 5 $<$ T $\leq$ 7 5

| Case | 7-11 | 7-12 | 7-13 |
|---|---|---|---|
| $n_{10}$ | 1.6935780 | 1.6987845 | 1.6982075 |
| $k_{10}$ | 0.0575917 | 0.0682876 | 0.0620058 |
| $d_{10}$ (nm) | 214.501 | 264.829 | 264.409 |
| $n_{20}$ | 1.6927449 | 1.6826884 | 1.6907687 |
| $k_{20}$ | 0.1631490 | 0.2430960 | 0.1959423 |
| $d_{20}$ (nm) | 269.036 | 164.540 | 222.065 |

| | | 7-11 | 7-12 | 7-13 |
|---|---|---|---|---|
| When $n_1 \geq n_{10}$, | $n_{1m} =$ | 0.0479456 | 0.0478223 | 0.0756042 |
| When $n_1 < n_{10}$, | $n_{1m} =$ | 0.0597888 | 0.0375256 | 0.0523840 |
| When $k_1 \geq k_{10}$, | $k_{1m} =$ | 0.0567029 | 0.0406042 | 0.0502747 |
| When $k_1 < k_{10}$, | $k_{1m} =$ | 0.0379382 | 0.0306238 | 0.0354358 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 42.775 | 36.115 | 105.289 |
| When $n_2 \geq n_{20}$, | $n_{2m} =$ | 0.2180396 | 0.3702002 | 0.3412915 |
| When $n_2 < n_{20}$, | $n_{2m} =$ | 0.1575122 | 0.2565369 | 0.2093115 |
| When $k_2 \geq k_{20}$, | $k_{2m} =$ | 0.1278589 | 0.2070850 | 0.2215063 |
| When $k_2 < k_{20}$, | $k_{2m} =$ | 0.0614197 | 0.0951270 | 0.0864294 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 81.766 | 63.144 | 76.945 |

1. 1 $<$ N A $\leq$ 1. 2
7 5 $<$ T $\leq$ 8 5

| Case | 8-01 | 8-02 | 8-03 | 8-04 | 8-05 |
|---|---|---|---|---|---|
| $n_{10}$ | 1.8508920 | 1.9432602 | 1.8788012 | 1.8809660 | 1.8914032 |
| $k_{10}$ | 0.3299462 | 0.1828608 | 0.1571474 | 0.1122948 | 0.0691945 |
| $d_{10}$ (nm) | 26.713 | 18.534 | 15.200 | 13.670 | 12.762 |
| $n_{20}$ | 1.6561984 | 1.7922587 | 1.6553949 | 1.7045069 | 1.7559855 |
| $k_{20}$ | 1.0215947 | 0.5435792 | 0.3498651 | 0.2862016 | 0.2487147 |
| $d_{20}$ (nm) | 31.481 | 89.452 | 157.519 | 210.391 | 259.753 |

| | | 8-01 | 8-02 | 8-03 | 8-04 | 8-05 |
|---|---|---|---|---|---|---|
| When $n_1 \geq n_{10}$, | $n_{1m} =$ | 0.0584900 | 0.0721143 | 0.0859290 | 0.1006885 | 0.1098987 |
| When $n_1 < n_{10}$, | $n_{1m} =$ | 0.0118384 | 0.0258594 | 0.0490076 | 0.0672168 | 0.0736646 |
| When $k_1 \geq k_{10}$, | $k_{1m} =$ | 0.0281628 | 0.0341772 | 0.0681653 | 0.0888281 | 0.0935315 |
| When $k_1 < k_{10}$, | $k_{1m} =$ | 0.0027112 | 0.0735254 | 0.0892920 | 0.1016174 | 0.0691945 |
| When $d_1 \geq d_{10}$, | $d_{1m}$ (nm) $=$ | 3.227 | 4.317 | 5.436 | 6.605 | 7.111 |
| When $d_1 < d_{10}$, | $d_{1m}$ (nm) $=$ | 0.304 | 1.291 | 2.967 | 4.063 | 4.341 |
| When $n_2 \geq n_{20}$, | $n_{2m} =$ | 0.1267358 | 0.0961279 | 0.0835156 | 0.0933350 | 0.1000793 |
| When $n_2 < n_{20}$, | $n_{2m} =$ | 0.0093018 | 0.1747852 | 0.1389221 | 0.1466003 | 0.1520386 |
| When $k_2 \geq k_{20}$, | $k_{2m} =$ | 0.0170300 | 0.1198535 | 0.0846472 | 0.0918018 | 0.1012305 |
| When $k_2 < k_{20}$, | $k_{2m} =$ | 0.1219019 | 0.1040369 | 0.0912122 | 0.0867468 | 0.0829492 |
| When $d_2 \geq d_{20}$, | $d_{2m}$ (nm) $=$ | 8.195 | $\infty$ | $\infty$ | $\infty$ | $\infty$ |
| When $d_2 < d_{20}$, | $d_{2m}$ (nm) $=$ | 0.369 | 9.559 | 36.990 | 78.480 | 119.640 |

1. 1 ＜ N A ≦ 1 . 2
7 5 ＜ T ≦ 8 5

| Case | 8-06 | 8-07 | 8-08 | 8-09 | 8-10 |
|---|---|---|---|---|---|
| $n_{10}$ | 1.7233184 | 1.7297992 | 1.7292921 | 1.7076375 | 1.6902915 |
| $k_{10}$ | 0.0905387 | 0.0774990 | 0.0722395 | 0.0765186 | 0.0790058 |
| $d_{10}$ (nm) | 94.254 | 94.232 | 94.957 | 163.992 | 206.654 |
| $n_{20}$ | 1.6520214 | 1.7157415 | 1.7247476 | 1.6752795 | 1.6879680 |
| $k_{20}$ | 0.2670378 | 0.2209454 | 0.1892941 | 0.2482558 | 0.2475793 |
| $d_{20}$ (nm) | 148.504 | 198.899 | 254.857 | 141.650 | 161.284 |

| | | 8-06 | 8-07 | 8-08 | 8-09 | 8-10 |
|---|---|---|---|---|---|---|
| When $n_1 \geq n_{10}$, | $n_{1m}=$ | 0.0327246 | 0.0427734 | 0.0473462 | 0.0318115 | 0.0212964 |
| When $n_1 < n_{10}$, | $n_{1m}=$ | 0.0093958 | 0.0147302 | 0.0094299 | 0.0087695 | 0.0407813 |
| When $k_1 \geq k_{10}$, | $k_{1m}=$ | 0.0245129 | 0.0376636 | 0.0278931 | 0.0137170 | 0.0408545 |
| When $k_1 < k_{10}$, | $k_{1m}=$ | 0.0384680 | 0.0381934 | 0.0341284 | 0.0285461 | 0.0259851 |
| When $d_1 \geq d_{10}$, | $d_{1m}$ (nm) $=$ | 10.366 | 16.607 | 38.446 | 19.131 | 18.064 |
| When $d_1 < d_{10}$, | $d_{1m}$ (nm) $=$ | 2.389 | 3.804 | 2.614 | 2.661 | 24.299 |
| When $n_2 \geq n_{20}$, | $n_{2m}=$ | 0.0285376 | 0.0673352 | 0.0815320 | 0.0313904 | 0.1426208 |
| When $n_2 < n_{20}$, | $n_{2m}=$ | 0.0743250 | 0.0929968 | 0.1051160 | 0.0237683 | 0.0535938 |
| When $k_2 \geq k_{20}$, | $k_{2m}=$ | 0.0198962 | 0.0371387 | 0.0465576 | 0.0076379 | 0.0976270 |
| When $k_2 < k_{20}$, | $k_{2m}=$ | 0.0547290 | 0.0576892 | 0.0565930 | 0.0508740 | 0.0749768 |
| When $d_2 \geq d_{20}$, | $d_{2m}$ (nm) $=$ | 8.585 | ∞ | ∞ | 6.981 | ∞ |
| When $d_2 < d_{20}$, | $d_{2m}$ (nm) $=$ | 13.959 | 13.822 | 33.284 | 7.469 | 13.904 |

1. 1 ＜ N A ≦ 1 . 2
7 5 ＜ T ≦ 8 5

| Case | 8-11 | 8-12 | 8-13 | 8-14 | 8-15 |
|---|---|---|---|---|---|
| $n_{10}$ | 1.6929156 | 1.6935338 | 1.6984313 | 1.6980068 | 1.6970347 |
| $k_{10}$ | 0.0637318 | 0.0581307 | 0.0697413 | 0.0633264 | 0.0530849 |
| $d_{10}$ (nm) | 217.693 | 214.870 | 266.256 | 265.782 | 275.682 |
| $n_{20}$ | 1.6856131 | 1.6920922 | 1.6871666 | 1.6912942 | 1.6884244 |
| $k_{20}$ | 0.1973081 | 0.1667488 | 0.2538157 | 0.2022310 | 0.1714348 |
| $d_{20}$ (nm) | 201.188 | 259.776 | 152.235 | 210.360 | 256.304 |

| | | 8-11 | 8-12 | 8-13 | 8-14 | 8-15 |
|---|---|---|---|---|---|---|
| When $n_1 \geq n_{10}$, | $n_{1m}=$ | 0.0321716 | 0.0471802 | 0.0486719 | 0.0738318 | 0.0569543 |
| When $n_1 < n_{10}$, | $n_{1m}=$ | 0.0414331 | 0.0603931 | 0.0363989 | 0.0470300 | 0.0427893 |
| When $k_1 \geq k_{10}$, | $k_{1m}=$ | 0.0451428 | 0.0559961 | 0.0398804 | 0.0494763 | 0.0598206 |
| When $k_1 < k_{10}$, | $k_{1m}=$ | 0.0289417 | 0.0378210 | 0.0291638 | 0.0345105 | 0.0376172 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 45.410 | 42.667 | 37.515 | 100.900 | 104.445 |
| When $n_2 \geq n_{20}$, | $n_{2m}=$ | 0.2377576 | 0.2179382 | 0.2594739 | 0.3590393 | 0.2768311 |
| When $n_2 < n_{20}$, | $n_{2m}=$ | 0.0859351 | 0.1565027 | 0.2556433 | 0.2089795 | 0.2197266 |
| When $k_2 \geq k_{20}$, | $k_{2m}=$ | 0.1024292 | 0.1246008 | 0.1994592 | 0.2211169 | 0.1929004 |
| When $k_2 < k_{20}$, | $k_{2m}=$ | 0.0656946 | 0.0632471 | 0.1014087 | 0.0895886 | 0.0738538 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 33.167 | 82.155 | 62.366 | 73.160 | 83.598 |

1. $1 < NA \leq 1.2$
$85 < T \leq 95$

| Case | | 9-01 | 9-02 | 9-03 | 9-04 | 9-05 |
|---|---|---|---|---|---|---|
| $n_{10}$ | | 1.9192397 | 1.8910111 | 1.8874292 | 1.8928956 | 1.7266669 |
| $k_{10}$ | | 0.1987767 | 0.1570861 | 0.1170062 | 0.0800147 | 0.0953661 |
| $d_{10}$ (nm) | | 21.654 | 15.844 | 13.907 | 12.695 | 94.323 |
| $n_{20}$ | | 1.8264016 | 1.6782576 | 1.7063011 | 1.7424852 | 1.6542284 |
| $k_{20}$ | | 0.6189774 | 0.3828036 | 0.3024107 | 0.2571531 | 0.2869718 |
| $d_{20}$ (nm) | | 76.882 | 146.288 | 201.867 | 254.323 | 139.595 |

| | | 9-01 | 9-02 | 9-03 | 9-04 | 9-05 |
|---|---|---|---|---|---|---|
| When $n_1 \geq n_{10}$, | $n_{1m}=$ | 0.0649170 | 0.0821021 | 0.0973254 | 0.1089844 | 0.0299609 |
| When $n_1 < n_{10}$, | $n_{1m}=$ | 0.0262927 | 0.0442981 | 0.0631677 | 0.0721631 | 0.0018164 |
| When $k_1 \geq k_{10}$, | $k_{1m}=$ | 0.0313647 | 0.0611023 | 0.0836865 | 0.0928955 | 0.0075598 |
| When $k_1 < k_{10}$, | $k_{1m}=$ | 0.0678699 | 0.0898816 | 0.1010254 | 0.0800147 | 0.0251917 |
| When $d_1 \geq d_{10}$, | $d_{1m}$ (nm) $=$ | 4.482 | 5.181 | 6.239 | 6.859 | 9.178 |
| When $d_1 < d_{10}$, | $d_{1m}$ (nm) $=$ | 1.480 | 2.625 | 3.732 | 4.138 | 0.436 |
| When $n_2 \geq n_{20}$, | $n_{2m}=$ | 0.0987671 | 0.0845752 | 0.0932324 | 0.0997229 | 0.0068860 |
| When $n_2 < n_{20}$, | $n_{2m}=$ | 0.1650610 | 0.1381567 | 0.1431714 | 0.1501294 | 0.0677319 |
| When $k_2 \geq k_{20}$, | $k_{2m}=$ | 0.1657446 | 0.0892700 | 0.0918542 | 0.0980688 | 0.0046692 |
| When $k_2 < k_{20}$, | $k_{2m}=$ | 0.1121045 | 0.0937854 | 0.0873950 | 0.0830798 | 0.0530042 |
| When $d_2 \geq d_{20}$, | $d_{2m}$ (nm) $=$ | ∞ | ∞ | ∞ | ∞ | 2.101 |
| When $d_2 < d_{20}$, | $d_{2m}$ (nm) $=$ | 12.789 | 29.518 | 73.873 | 87.951 | 11.267 |

1. $1 < NA \leq 1.2$
$85 < T \leq 95$

| Case | | 9-06 | 9-07 | 9-08 | 9-09 | 9-10 |
|---|---|---|---|---|---|---|
| $n_{10}$ | | 1.7296393 | 1.7299249 | 1.6899362 | 1.6928826 | 1.6935628 |
| $k_{10}$ | | 0.0805906 | 0.0737621 | 0.0817785 | 0.0657282 | 0.0590519 |
| $d_{10}$ (nm) | | 94.242 | 94.784 | 208.164 | 217.665 | 215.464 |
| $n_{20}$ | | 1.7097783 | 1.7252153 | 1.6924320 | 1.6832004 | 1.6914497 |
| $k_{20}$ | | 0.2319224 | 0.1970612 | 0.2651701 | 0.2055611 | 0.1728158 |
| $d_{20}$ (nm) | | 191.543 | 246.491 | 148.618 | 193.166 | 250.826 |

| | | 9-06 | 9-07 | 9-08 | 9-09 | 9-10 |
|---|---|---|---|---|---|---|
| When $n_1 \geq n_{10}$, | $n_{1m}=$ | 0.0403186 | 0.0454016 | 0.0167883 | 0.0332178 | 0.0456592 |
| When $n_1 < n_{10}$, | $n_{1m}=$ | 0.0112720 | 0.0089185 | 0.0424597 | 0.0374463 | 0.0611377 |
| When $k_1 \geq k_{10}$, | $k_{1m}=$ | 0.0312561 | 0.0265295 | 0.0332300 | 0.0436560 | 0.0547620 |
| When $k_1 < k_{10}$, | $k_{1m}=$ | 0.0359937 | 0.0340186 | 0.0176221 | 0.0271997 | 0.0369495 |
| When $d_1 \geq d_{10}$, | $d_{1m}$ (nm) $=$ | 14.915 | 25.988 | 8.734 | ∞ | ∞ |
| When $d_1 < d_{10}$, | $d_{1m}$ (nm) $=$ | 2.867 | 2.423 | 22.681 | 45.245 | 43.081 |
| When $n_2 \geq n_{20}$, | $n_{2m}=$ | 0.0542737 | 0.0673303 | 0.1469031 | 0.2426758 | 0.2225391 |
| When $n_2 < n_{20}$, | $n_{2m}=$ | 0.0873267 | 0.0993994 | 0.0330542 | 0.0887622 | 0.1544177 |
| When $k_2 \geq k_{20}$, | $k_{2m}=$ | 0.0292090 | 0.0400476 | 0.0700159 | 0.0962317 | 0.1187769 |
| When $k_2 < k_{20}$, | $k_{2m}=$ | 0.0563428 | 0.0561450 | 0.0687061 | 0.0675110 | 0.0629883 |
| When $d_2 \geq d_{20}$, | $d_{2m}$ (nm) $=$ | 39.648 | ∞ | ∞ | ∞ | ∞ |
| When $d_2 < d_{20}$, | $d_{2m}$ (nm) $=$ | 14.552 | 29.955 | 9.727 | 29.747 | 77.934 |

1. $1 < NA \leq 1.2$
$85 < T \leq 95$

| Case | 9-11 | 9-12 | 9-13 |
|---|---|---|---|
| $n_{10}$ | 1.6988269 | 1.6981501 | 1.6968464 |
| $k_{10}$ | 0.0719884 | 0.0650380 | 0.0544760 |
| $d_{10}$ (nm) | 266.949 | 266.102 | 275.663 |
| $n_{20}$ | 1.6930572 | 1.6910453 | 1.6860880 |
| $k_{20}$ | 0.2717519 | 0.2123559 | 0.1778694 |
| $d_{20}$ (nm) | 142.233 | 201.439 | 248.323 |

| | | 9-11 | 9-12 | 9-13 |
|---|---|---|---|---|
| When $n_1 \geq n_{10}$, | $n_{1m} =$ | 0.0467688 | 0.0728052 | 0.0574890 |
| When $n_1 < n_{10}$, | $n_{1m} =$ | 0.0315735 | 0.0440601 | 0.0431165 |
| When $k_1 \geq k_{10}$, | $k_{1m} =$ | 0.0383911 | 0.0476294 | 0.0587781 |
| When $k_1 < k_{10}$, | $k_{1m} =$ | 0.0284839 | 0.0337549 | 0.0370691 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 35.571 | 98.568 | 104.018 |
| When $n_2 \geq n_{20}$, | $n_{2m} =$ | 0.2475818 | 0.3536121 | 0.2819006 |
| When $n_2 < n_{20}$, | $n_{2m} =$ | 0.2616077 | 0.2147424 | 0.2120007 |
| When $k_2 \geq k_{20}$, | $k_{2m} =$ | 0.1929529 | 0.2177991 | 0.1925061 |
| When $k_2 < k_{20}$, | $k_{2m} =$ | 0.1103821 | 0.0937061 | 0.0749585 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 61.377 | 69.390 | 80.535 |

1. $1 < NA \leq 1.2$
$95 < T \leq 105$

| Case | 10-01 | 10-02 | 10-03 | 10-04 | 10-05 |
|---|---|---|---|---|---|
| $n_{10}$ | 1.9207610 | 1.9093240 | 1.8948938 | 1.8966282 | 1.7293323 |
| $k_{10}$ | 0.2195112 | 0.1610220 | 0.1257399 | 0.0900141 | 0.0843251 |
| $d_{10}$ (nm) | 22.312 | 16.027 | 13.855 | 12.530 | 93.974 |
| $n_{20}$ | 1.8258536 | 1.6981498 | 1.7003095 | 1.7305926 | 1.7018671 |
| $k_{20}$ | 0.6986358 | 0.4189775 | 0.3177305 | 0.2658040 | 0.2432029 |
| $d_{20}$ (nm) | 68.737 | 136.163 | 194.613 | 248.346 | 184.391 |

| | | 10-01 | 10-02 | 10-03 | 10-04 | 10-05 |
|---|---|---|---|---|---|---|
| When $n_1 \geq n_{10}$, | $n_{1m} =$ | 0.0601465 | 0.0788086 | 0.0949231 | 0.1082007 | 0.0364734 |
| When $n_1 < n_{10}$, | $n_{1m} =$ | 0.0227283 | 0.0400269 | 0.0595679 | 0.0706311 | 0.0069092 |
| When $k_1 \geq k_{10}$, | $k_{1m} =$ | 0.0253723 | 0.0545032 | 0.0804407 | 0.0926099 | 0.0227478 |
| When $k_1 < k_{10}$, | $k_{1m} =$ | 0.0628345 | 0.0889185 | 0.1005603 | 0.0900141 | 0.0311768 |
| When $d_1 \geq d_{10}$, | $d_{1m}$ (nm) $=$ | 3.994 | 4.715 | 5.765 | 6.514 | 12.891 |
| When $d_1 < d_{10}$, | $d_{1m}$ (nm) $=$ | 1.248 | 2.209 | 3.348 | 3.879 | 1.711 |
| When $n_2 \geq n_{20}$, | $n_{2m} =$ | 0.0792419 | 0.0821826 | 0.0922205 | 0.0989185 | 0.0380920 |
| When $n_2 < n_{20}$, | $n_{2m} =$ | 0.1602795 | 0.1375000 | 0.1411267 | 0.1492065 | 0.0806519 |
| When $k_2 \geq k_{20}$, | $k_{2m} =$ | 0.1589185 | 0.0905359 | 0.0891418 | 0.0944934 | 0.0182117 |
| When $k_2 < k_{20}$, | $k_{2m} =$ | 0.1093127 | 0.0931641 | 0.0864453 | 0.0826196 | 0.0535706 |
| When $d_2 \geq d_{20}$, | $d_{2m}$ (nm) $=$ | $\infty$ | $\infty$ | $\infty$ | $\infty$ | 26.631 |
| When $d_2 < d_{20}$, | $d_{2m}$ (nm) $=$ | 11.170 | 27.297 | 70.361 | 86.529 | 13.056 |

1. 1 < N A ≤ 1. 2
9 5 < T ≤ 1 0 5

| Case | 10-06 | 10-07 | 10-08 | 10-09 | 10-10 |
|---|---|---|---|---|---|
| $n_{10}$ | 1.7301568 | 1.6896128 | 1.6928686 | 1.6935394 | 1.6995193 |
| $k_{10}$ | 0.0757850 | 0.0845530 | 0.0680057 | 0.0604311 | 0.0747728 |
| $d_{10}$ (nm) | 94.458 | 207.994 | 217.789 | 215.751 | 266.467 |
| $n_{20}$ | 1.7237225 | 1.6930315 | 1.6806392 | 1.6908086 | 1.6953349 |
| $k_{20}$ | 0.2045935 | 0.2839311 | 0.2160083 | 0.1799717 | 0.2921202 |
| $d_{20}$ (nm) | 238.500 | 141.193 | 184.741 | 242.024 | 134.479 |

| | | 10-06 | 10-07 | 10-08 | 10-09 | 10-10 |
|---|---|---|---|---|---|---|
| When $n_1 \geq n_{10}$, | $n_{1m} =$ | 0.0430542 | 0.0132361 | 0.0331689 | 0.0442139 | 0.0436938 |
| When $n_1 < n_{10}$, | $n_{1m} =$ | 0.0073706 | 0.0419458 | 0.0316418 | 0.0535156 | 0.0268311 |
| When $k_1 \geq k_{10}$, | $k_{1m} =$ | 0.0232617 | 0.0264368 | 0.0418604 | 0.0531323 | 0.0358801 |
| When $k_1 < k_{10}$, | $k_{1m} =$ | 0.0323706 | 0.0142944 | 0.0250220 | 0.0355676 | 0.0274768 |
| When $d_1 \geq d_{10}$, | $d_{1m}$ (nm) $=$ | 19.826 | 5.860 | ∞ | ∞ | ∞ |
| When $d_1 < d_{10}$, | $d_{1m}$ (nm) $=$ | 1.955 | 19.840 | 44.604 | 42.829 | 18.631 |
| When $n_2 \geq n_{20}$, | $n_{2m} =$ | 0.0534583 | 0.1398230 | 0.2538293 | 0.2308789 | 0.2386206 |
| When $n_2 < n_{20}$, | $n_{2m} =$ | 0.0961475 | 0.0183801 | 0.0879700 | 0.1305579 | 0.2731067 |
| When $k_2 \geq k_{20}$, | $k_{2m} =$ | 0.0309888 | 0.0515918 | 0.0900964 | 0.1145776 | 0.1883105 |
| When $k_2 < k_{20}$, | $k_{2m} =$ | 0.0550842 | 0.0676599 | 0.0668372 | 0.0642163 | 0.1153723 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 28.701 | 3.697 | 28.484 | 75.626 | 22.552 |

1. 1 < N A ≤ 1. 2
9 5 < T ≤ 1 0 5

| Case | 10-11 | 10-12 |
|---|---|---|
| $n_{10}$ | 1.6986281 | 1.6967467 |
| $k_{10}$ | 0.0669339 | 0.0559821 |
| $d_{10}$ (nm) | 265.290 | 275.562 |
| $n_{20}$ | 1.6902923 | 1.6844237 |
| $k_{20}$ | 0.2238725 | 0.1853984 |
| $d_{20}$ (nm) | 194.429 | 239.846 |

| | | 10-11 | 10-12 |
|---|---|---|---|
| When $n_1 \geq n_{10}$, | $n_{1m} =$ | 0.0728162 | 0.0573596 |
| When $n_1 < n_{10}$, | $n_{1m} =$ | 0.0413391 | 0.0430261 |
| When $k_1 \geq k_{10}$, | $k_{1m} =$ | 0.0452283 | 0.0576135 |
| When $k_1 < k_{10}$, | $k_{1m} =$ | 0.0327722 | 0.0361206 |
| When $d_1 \geq d_{10}$, | $d_{1m}$ (nm) $=$ | ∞ | ∞ |
| When $d_1 < d_{10}$, | $d_{1m}$ (nm) $=$ | 90.187 | 103.212 |
| When $n_2 \geq n_{20}$, | $n_{2m} =$ | 0.3400000 | 0.2868152 |
| When $n_2 < n_{20}$, | $n_{2m} =$ | 0.2235767 | 0.2105566 |
| When $k_2 \geq k_{20}$, | $k_{2m} =$ | 0.2178235 | 0.1919788 |
| When $k_2 < k_{20}$, | $k_{2m} =$ | 0.0973718 | 0.0774072 |
| When $d_2 \geq d_{20}$, | $d_{2m}$ (nm) $=$ | ∞ | ∞ |
| When $d_2 < d_{20}$, | $d_{2m}$ (nm) $=$ | 66.928 | 79.000 |

1. 1 < N A ≦ 1. 2
1 0 5 < T ≦ 1 1 5

| Case | 11-01 | 11-02 | 11-03 | 11-04 | 11-05 |
|---|---|---|---|---|---|
| $n_{10}$ | 1.9214172 | 1.9009993 | 1.8999222 | 1.7289797 | 1.7301397 |
| $k_{10}$ | 0.1753360 | 0.1351301 | 0.0954510 | 0.0876375 | 0.0779683 |
| $d_{10}$ (nm) | 15.452 | 13.611 | 12.469 | 93.472 | 94.062 |
| $n_{20}$ | 1.6804411 | 1.6899586 | 1.7262130 | 1.6943958 | 1.7208177 |
| $k_{20}$ | 0.4367098 | 0.3280314 | 0.2728992 | 0.2513033 | 0.2098777 |
| $d_{20}$ (nm) | 129.893 | 187.370 | 240.318 | 176.630 | 230.281 |

| | | 11-01 | 11-02 | 11-03 | 11-04 | 11-05 |
|---|---|---|---|---|---|---|
| When $n_1 \geq n_{10}$, | $n_{1m} =$ | 0.0769006 | 0.0933704 | 0.1067993 | 0.0330078 | 0.0410352 |
| When $n_1 < n_{10}$, | $n_{1m} =$ | 0.0358716 | 0.0572852 | 0.0688867 | 0.0032751 | 0.0048413 |
| When $k_1 \geq k_{10}$, | $k_{1m} =$ | 0.0508276 | 0.0793042 | 0.0916321 | 0.0140979 | 0.0177686 |
| When $k_1 < k_{10}$, | $k_{1m} =$ | 0.0888501 | 0.0996167 | 0.0954510 | 0.0244348 | 0.0282959 |
| When $d_1 \geq d_{10}$, | $d_{1m}$ (nm) = | 4.190 | 5.335 | 6.248 | 10.623 | 16.723 |
| When $d_1 < d_{10}$, | $d_{1m}$ (nm) = | 1.818 | 3.051 | 3.681 | 0.787 | 1.251 |
| When $n_2 \geq n_{20}$, | $n_{2m} =$ | 0.0746777 | 0.0897961 | 0.0977148 | 0.0241113 | 0.0398962 |
| When $n_2 < n_{20}$, | $n_{2m} =$ | 0.1378662 | 0.1400989 | 0.1490454 | 0.0784241 | 0.0968872 |
| When $k_2 \geq k_{20}$, | $k_{2m} =$ | 0.0793188 | 0.0846436 | 0.0920837 | 0.0085193 | 0.0207715 |
| When $k_2 < k_{20}$, | $k_{2m} =$ | 0.0870862 | 0.0841199 | 0.0819739 | 0.0504102 | 0.0538818 |
| When $d_2 \geq d_{20}$, | $d_{2m}$ (nm) = | ∞ | ∞ | ∞ | 17.196 | ∞ |
| When $d_2 < d_{20}$, | $d_{2m}$ (nm) = | 28.725 | 67.570 | 87.835 | 8.245 | 10.621 |

1. 1 < N A ≦ 1. 2
1 0 5 < T ≦ 1 1 5

| Case | 11-06 | 11-07 | 11-08 | 11-09 |
|---|---|---|---|---|
| $n_{10}$ | 1.6897075 | 1.6928599 | 1.6933895 | 1.6967442 |
| $k_{10}$ | 0.0859154 | 0.0698704 | 0.0619572 | 0.0572224 |
| $d_{10}$ (nm) | 206.600 | 218.100 | 215.832 | 275.439 |
| $n_{20}$ | 1.6860653 | 1.6784557 | 1.6904996 | 1.6838077 |
| $k_{20}$ | 0.2958058 | 0.2260347 | 0.1864736 | 0.1920294 |
| $d_{20}$ (nm) | 138.770 | 175.355 | 232.785 | 230.401 |

| | | 11-06 | 11-07 | 11-08 | 11-09 |
|---|---|---|---|---|---|
| When $n_1 \geq n_{10}$, | $n_{1m} =$ | 0.0125659 | 0.0312329 | 0.0432227 | 0.0564172 |
| When $n_1 < n_{10}$, | $n_{1m} =$ | 0.0403125 | 0.0252893 | 0.0462402 | 0.0423401 |
| When $k_1 \geq k_{10}$, | $k_{1m} =$ | 0.0275024 | 0.0399890 | 0.0513623 | 0.0566272 |
| When $k_1 < k_{10}$, | $k_{1m} =$ | 0.0207617 | 0.0230298 | 0.0339783 | 0.0347253 |
| When $d_1 \geq d_{10}$, | $d_{1m}$ (nm) = | 5.565 | ∞ | ∞ | ∞ |
| When $d_1 < d_{10}$, | $d_{1m}$ (nm) = | 15.751 | 15.335 | 41.797 | 102.062 |
| When $n_2 \geq n_{20}$, | $n_{2m} =$ | 0.1134778 | 0.0778406 | 0.2416541 | 0.2945471 |
| When $n_2 < n_{20}$, | $n_{2m} =$ | 0.0212585 | 0.0821313 | 0.1144373 | 0.2197937 |
| When $k_2 \geq k_{20}$, | $k_{2m} =$ | 0.0640356 | 0.0874658 | 0.1126599 | 0.1918506 |
| When $k_2 < k_{20}$, | $k_{2m} =$ | 0.0823962 | 0.0630994 | 0.0642725 | 0.0810107 |
| When $d_2 \geq d_{20}$, | $d_{2m}$ (nm) = | ∞ | ∞ | ∞ | ∞ |
| When $d_2 < d_{20}$, | $d_{2m}$ (nm) = | 4.190 | 25.396 | 50.058 | 79.342 |

## 1. 1 < N A ≤ 1. 2
## 1 1 5 < T ≤ 1 2 5

| Case | 12-01 | 12-02 | 12-03 | 12-04 | 12-05 |
|---|---|---|---|---|---|
| $n_{10}$ | 1.9907624 | 1.9229056 | 1.9003143 | 1.9049048 | 1.7296380 |
| $k_{10}$ | 0.2658843 | 0.1943367 | 0.1434936 | 0.0972823 | 0.0899801 |
| $d_{10}$ (nm) | 16.877 | 14.896 | 13.590 | 12.362 | 93.128 |
| $n_{20}$ | 1.6777634 | 1.6435696 | 1.6791032 | 1.7269066 | 1.6935089 |
| $k_{20}$ | 0.7245088 | 0.4392836 | 0.3336019 | 0.2779612 | 0.2572784 |
| $d_{20}$ (nm) | 66.041 | 124.711 | 179.139 | 230.763 | 167.093 |

| | | 12-01 | 12-02 | 12-03 | 12-04 | 12-05 |
|---|---|---|---|---|---|---|
| When $n_1 \geq n_{10}$, | $n_{1n} =$ | 0.0641870 | 0.0750415 | 0.0917773 | 0.1066382 | 0.0315833 |
| When $n_1 < n_{10}$, | $n_{1n} =$ | 0.0020520 | 0.0319995 | 0.0559583 | 0.0680188 | 0.0015344 |
| When $k_1 \geq k_{10}$, | $k_{1n} =$ | 0.0028235 | 0.0481201 | 0.0790771 | 0.0912170 | 0.0085083 |
| When $k_1 < k_{10}$, | $k_{1n} =$ | 0.0445386 | 0.0882983 | 0.0964502 | 0.0972823 | 0.0192114 |
| When $d_1 \geq d_{10}$, | $d_{1n}$ (nm) $=$ | 2.498 | 3.792 | 5.133 | 6.031 | 9.518 |
| When $d_1 < d_{10}$, | $d_{1n}$ (nm) $=$ | 0.080 | 1.544 | 2.939 | 3.522 | 0.359 |
| When $n_2 \geq n_{20}$, | $n_{2m} =$ | 0.0064478 | 0.0655054 | 0.0877441 | 0.0975110 | 0.0182434 |
| When $n_2 < n_{20}$, | $n_{2m} =$ | 0.1131567 | 0.1382288 | 0.1415613 | 0.1512451 | 0.0817859 |
| When $k_2 \geq k_{20}$, | $k_{2m} =$ | 0.0073132 | 0.0658899 | 0.0812854 | 0.0911096 | 0.0040100 |
| When $k_2 < k_{20}$, | $k_{2m} =$ | 0.0730591 | 0.0825134 | 0.0835315 | 0.0828308 | 0.0509155 |
| When $d_2 \geq d_{20}$, | $d_{2m}$ (nm) $=$ | 10.610 | ∞ | ∞ | ∞ | 14.228 |
| When $d_2 < d_{20}$, | $d_{2m}$ (nm) $=$ | 2.901 | 33.267 | 66.014 | 90.382 | 3.593 |

## 1. 1 < N A ≤ 1. 2
## 1 1 5 < T ≤ 1 2 5

| Case | 12-06 | 12-07 | 12-08 | 12-09 | 12-10 |
|---|---|---|---|---|---|
| $n_{10}$ | 1.7305285 | 1.6927568 | 1.6930586 | 1.6939267 | 1.6970265 |
| $k_{10}$ | 0.0799609 | 0.0712762 | 0.0635805 | 0.0583165 | 0.0526106 |
| $d_{10}$ (nm) | 93.907 | 218.499 | 215.646 | 213.162 | 273.430 |
| $n_{20}$ | 1.7196209 | 1.6781695 | 1.6903056 | 1.6934648 | 1.6908020 |
| $k_{20}$ | 0.2133806 | 0.2348207 | 0.1916344 | 0.1626221 | 0.1682270 |
| $d_{20}$ (nm) | 220.978 | 164.929 | 223.237 | 282.414 | 277.869 |

| | | 12-06 | 12-07 | 12-08 | 12-09 | 12-10 |
|---|---|---|---|---|---|---|
| When $n_1 \geq n_{10}$, | $n_{1n} =$ | 0.0401038 | 0.0280627 | 0.0367090 | 0.0617249 | 0.0695837 |
| When $n_1 < n_{10}$, | $n_{1n} =$ | 0.0020569 | 0.0197937 | 0.0422595 | 0.0578455 | 0.0506836 |
| When $k_1 \geq k_{10}$, | $k_{1n} =$ | 0.0099243 | 0.0365027 | 0.0497717 | 0.0551318 | 0.0584485 |
| When $k_1 < k_{10}$, | $k_{1n} =$ | 0.0219006 | 0.0215491 | 0.0327808 | 0.0369946 | 0.0381665 |
| When $d_1 \geq d_{10}$, | $d_{1n}$ (nm) $=$ | 15.192 | ∞ | ∞ | ∞ | ∞ |
| When $d_1 < d_{10}$, | $d_{1n}$ (nm) $=$ | 0.519 | 8.747 | 40.119 | 117.750 | 120.098 |
| When $n_2 \geq n_{20}$, | $n_{2m} =$ | 0.0185596 | 0.0673242 | 0.2516089 | 0.2302490 | 0.2819116 |
| When $n_2 < n_{20}$, | $n_{2m} =$ | 0.1000403 | 0.0715613 | 0.0981323 | 0.1425830 | 0.2021863 |
| When $k_2 \geq k_{20}$, | $k_{2m} =$ | 0.0105981 | 0.0901270 | 0.1132849 | 0.1293579 | 0.1967712 |
| When $k_2 < k_{20}$, | $k_{2m} =$ | 0.0546692 | 0.0589612 | 0.0634204 | 0.0595032 | 0.0741577 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 3.602 | 19.014 | 34.397 | 79.670 | 93.763 |

1. 1 < N A ≤ 1. 2
1 2 5 < T ≤ 1 3 5

| Case | 13-01 | 13-02 | 13-03 | 13-04 | 13-05 |
|---|---|---|---|---|---|
| $n_{10}$ | 1.8968086 | 1.9070303 | 1.9016797 | 1.7329805 | 1.7161015 |
| $k_{10}$ | 0.1457981 | 0.0954881 | 0.0905797 | 0.0916823 | 0.0708259 |
| $d_{10}$ (nm) | 14.128 | 12.717 | 10.946 | 93.296 | 94.224 |
| $n_{20}$ | 1.6815336 | 1.7369802 | 1.7110902 | 1.7056329 | 1.6780965 |
| $k_{20}$ | 0.3444919 | 0.2856144 | 0.2381911 | 0.2670261 | 0.1788543 |
| $d_{20}$ (nm) | 167.613 | 218.968 | 280.601 | 155.076 | 274.399 |

| | | 13-01 | 13-02 | 13-03 | 13-04 | 13-05 |
|---|---|---|---|---|---|---|
| When $n_1 \geq n_{10}$, | $n_{1m} =$ | 0.0900439 | 0.1048657 | 0.1226746 | 0.0324280 | 0.0442737 |
| When $n_1 < n_{10}$, | $n_{1m} =$ | 0.0549670 | 0.0656934 | 0.0785547 | 0.0012561 | 0.0190796 |
| When $k_1 \geq k_{10}$, | $k_{1m} =$ | 0.0772925 | 0.0877979 | 0.1031616 | 0.0075342 | 0.0396033 |
| When $k_1 < k_{10}$, | $k_{1m} =$ | 0.0920227 | 0.0954881 | 0.0905797 | 0.0177710 | 0.0448962 |
| When $d_1 \geq d_{10}$, | $d_{1m}$ (nm) $=$ | 5.183 | 6.019 | 6.438 | 9.368 | 34.945 |
| When $d_1 < d_{10}$, | $d_{1m}$ (nm) $=$ | 2.993 | 3.453 | 3.787 | 0.285 | 6.328 |
| When $n_2 \geq n_{20}$, | $n_{2m} =$ | 0.0877783 | 0.0991382 | 0.1111206 | 0.0250049 | 0.0400305 |
| When $n_2 < n_{20}$, | $n_{2m} =$ | 0.1446509 | 0.1532288 | 0.1362280 | 0.0542139 | 0.1016638 |
| When $k_2 \geq k_{20}$, | $k_{2m} =$ | 0.0828516 | 0.0936658 | 0.0912720 | 0.0036011 | 0.0409863 |
| When $k_2 < k_{20}$, | $k_{2m} =$ | 0.0884485 | 0.0865161 | 0.0819922 | 0.0570435 | 0.0508105 |
| When $d_2 \geq d_{20}$, | $d_{2m}$ (nm) $=$ | ∞ | ∞ | ∞ | 16.698 | ∞ |
| When $d_2 < d_{20}$, | $d_{2m}$ (nm) $=$ | 63.831 | 86.162 | 129.598 | 1.884 | 53.218 |

1. 1 < N A ≤ 1. 2
1 2 5 < T ≤ 1 3 5

| Case | 13-06 | 13-07 | 13-08 | 13-09 |
|---|---|---|---|---|
| $n_{10}$ | 1.6922053 | 1.6924923 | 1.6935584 | 1.6967916 |
| $k_{10}$ | 0.0726320 | 0.0653867 | 0.0598502 | 0.0533770 |
| $d_{10}$ (nm) | 218.650 | 214.871 | 212.072 | 273.133 |
| $n_{20}$ | 1.6800076 | 1.6897434 | 1.6927128 | 1.6904661 |
| $k_{20}$ | 0.2436881 | 0.1959626 | 0.1654173 | 0.1709158 |
| $d_{20}$ (nm) | 154.426 | 214.392 | 274.211 | 268.389 |

| | | 13-06 | 13-07 | 13-08 | 13-09 |
|---|---|---|---|---|---|
| When $n_1 \geq n_{10}$, | $n_{1m} =$ | 0.0253528 | 0.0324316 | 0.0605591 | 0.0715686 |
| When $n_1 < n_{10}$, | $n_{1m} =$ | 0.0165808 | 0.0420508 | 0.0560315 | 0.0516870 |
| When $k_1 \geq k_{10}$, | $k_{1m} =$ | 0.0318250 | 0.0487207 | 0.0537805 | 0.0575159 |
| When $k_1 < k_{10}$, | $k_{1m} =$ | 0.0192969 | 0.0323987 | 0.0370093 | 0.0369739 |
| When $d_1 \geq d_{10}$, | $d_{1m}$ (nm) $=$ | 16.057 | ∞ | ∞ | ∞ |
| When $d_1 < d_{10}$, | $d_{1m}$ (nm) $=$ | 7.067 | 37.738 | 59.298 | 116.516 |
| When $n_2 \geq n_{20}$, | $n_{2m} =$ | 0.0399280 | 0.1505237 | 0.2298792 | 0.2878638 |
| When $n_2 < n_{20}$, | $n_{2m} =$ | 0.0570007 | 0.0843848 | 0.1463525 | 0.2044592 |
| When $k_2 \geq k_{20}$, | $k_{2m} =$ | 0.0949915 | 0.1174060 | 0.1308350 | 0.1989417 |
| When $k_2 < k_{20}$, | $k_{2m} =$ | 0.0566089 | 0.0642029 | 0.0608850 | 0.0765625 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 13.778 | 24.202 | 76.110 | 90.681 |

1. 1 < N A ≤ 1. 2
1 3 5 < T ≤ 1 4 5

| Case | 14-01 | 14-02 | 14-03 | 14-04 | 14-05 |
|---|---|---|---|---|---|
| $n_{10}$ | 1.8931613 | 1.9086798 | 1.8957546 | 1.7383088 | 1.7163304 |
| $k_{10}$ | 0.1437464 | 0.0925277 | 0.1021679 | 0.0935643 | 0.0717315 |
| $d_{10}$ (nm) | 15.228 | 13.463 | 11.154 | 93.735 | 94.330 |
| $n_{20}$ | 1.6981871 | 1.7547782 | 1.6965397 | 1.7255584 | 1.6763108 |
| $k_{20}$ | 0.3648670 | 0.2987738 | 0.2414267 | 0.2828024 | 0.1832109 |
| $d_{20}$ (nm) | 154.635 | 206.696 | 273.752 | 142.972 | 265.207 |

| | | 14-01 | 14-02 | 14-03 | 14-04 | 14-05 |
|---|---|---|---|---|---|---|
| When $n_1 \geq n_{10}$, | $n_{1m}=$ | 0.0870447 | 0.1008179 | 0.1206177 | 0.0337476 | 0.0440930 |
| When $n_1 < n_{10}$, | $n_{1m}=$ | 0.0533362 | 0.0620862 | 0.0768750 | 0.0007715 | 0.0201111 |
| When $k_1 \geq k_{10}$, | $k_{1m}=$ | 0.0736633 | 0.0819543 | 0.1022961 | 0.0054871 | 0.0403162 |
| When $k_1 < k_{10}$, | $k_{1m}=$ | 0.0884546 | 0.0925277 | 0.1021679 | 0.0149585 | 0.0433484 |
| When $d_1 \geq d_{10}$, | $d_{1m}$ (nm) $=$ | 5.366 | 6.051 | 6.474 | 9.539 | 32.676 |
| When $d_1 < d_{10}$, | $d_{1m}$ (nm) $=$ | 3.110 | 3.392 | 3.792 | 0.168 | 6.615 |
| When $n_2 \geq n_{20}$, | $n_{2m}=$ | 0.0905371 | 0.1017932 | 0.1131152 | 0.0305115 | 0.0401709 |
| When $n_2 < n_{20}$, | $n_{2m}=$ | 0.1457471 | 0.1521191 | 0.1323865 | 0.0291541 | 0.0974780 |
| When $k_2 \geq k_{20}$, | $k_{2m}=$ | 0.0891467 | 0.0990112 | 0.0895691 | 0.0025757 | 0.0411877 |
| When $k_2 < k_{20}$, | $k_{2m}=$ | 0.0964551 | 0.0905688 | 0.0826367 | 0.0641370 | 0.0518066 |
| | $d_{2m}$ (nm) $=$ | ∞ | ∞ | ∞ | 18.295 | ∞ |
| When $d_2 < d_{20}$, | $d_{2m}$ (nm) $=$ | 52.833 | 78.923 | 127.644 | 0.825 | 36.894 |

1. 1 < N A ≤ 1. 2
1 3 5 < T ≤ 1 4 5

| Case | 14-06 | 14-07 | 14-08 | 14-09 | 14-10 |
|---|---|---|---|---|---|
| $n_{10}$ | 1.7036586 | 1.6919166 | 1.6911838 | 1.6942185 | 1.6965335 |
| $k_{10}$ | 0.0640636 | 0.0672926 | 0.0743991 | 0.0545821 | 0.0539924 |
| $d_{10}$ (nm) | 161.836 | 213.353 | 218.060 | 211.644 | 273.036 |
| $n_{20}$ | 1.6842842 | 1.6889376 | 1.6805827 | 1.6930391 | 1.6894839 |
| $k_{20}$ | 0.1670348 | 0.2002175 | 0.2524809 | 0.1466022 | 0.1738185 |
| $d_{20}$ (nm) | 260.021 | 207.074 | 145.761 | 321.654 | 259.712 |

| | | 14-06 | 14-07 | 14-08 | 14-09 | 14-10 |
|---|---|---|---|---|---|---|
| When $n_1 \geq n_{10}$, | $n_{1m}=$ | 0.0516992 | 0.0312610 | 0.0190637 | 0.0570044 | 0.0731799 |
| When $n_1 < n_{10}$, | $n_{1m}=$ | 0.0203174 | 0.0465454 | 0.0159326 | 0.0625537 | 0.0527673 |
| When $k_1 \geq k_{10}$, | $k_{1m}=$ | 0.0380640 | 0.0462256 | 0.0279297 | 0.0552405 | 0.0568201 |
| When $k_1 < k_{10}$, | $k_{1m}=$ | 0.0285486 | 0.0325867 | 0.0168274 | 0.0356702 | 0.0362610 |
| When $d_1 \geq d_{10}$, | $d_{1m}$ (nm) $=$ | ∞ | ∞ | 14.138 | ∞ | ∞ |
| When $d_1 < d_{10}$, | $d_{1m}$ (nm) $=$ | 9.049 | 34.771 | 6.640 | 127.140 | 114.401 |
| When $n_2 \geq n_{20}$, | $n_{2m}=$ | 0.0375000 | 0.2427722 | 0.0321863 | 0.2263916 | 0.2897119 |
| When $n_2 < n_{20}$, | $n_{2m}=$ | 0.0655225 | 0.0802039 | 0.0495178 | 0.1240515 | 0.2069202 |
| When $k_2 \geq k_{20}$, | $k_{2m}=$ | 0.0303979 | 0.1193311 | 0.0877856 | 0.1337305 | 0.1994678 |
| When $k_2 < k_{20}$, | $k_{2m}=$ | 0.0483228 | 0.0645337 | 0.0566711 | 0.0596594 | 0.0781824 |
| When $d_2 \geq d_{20}$, | $d_{2m}$ (nm) $=$ | 29.338 | ∞ | 15.130 | ∞ | ∞ |
| When $d_2 < d_{20}$, | $d_{2m}$ (nm) $=$ | 27.139 | 22.617 | 11.351 | 93.024 | 88.496 |

1．1＜ＮＡ≦1．2
145＜Ｔ≦155

| Case | 15-01 | 15-02 | 15-03 | 15-04 | 15-05 |
|---|---|---|---|---|---|
| $n_{10}$ | 1.8962402 | 1.9162756 | 1.8972293 | 1.7171631 | 1.7039366 |
| $k_{10}$ | 0.1446868 | 0.0920008 | 0.1039493 | 0.0735355 | 0.0654419 |
| $d_{10}$ (nm) | 16.058 | 13.917 | 11.503 | 94.241 | 161.496 |
| $n_{20}$ | 1.7149739 | 1.7705409 | 1.6986687 | 1.6756859 | 1.6849902 |
| $k_{20}$ | 0.3909951 | 0.3160160 | 0.2516185 | 0.1901883 | 0.1728826 |
| $d_{20}$ (nm) | 143.691 | 196.340 | 264.437 | 256.660 | 251.490 |

| | | 15-01 | 15-02 | 15-03 | 15-04 | 15-05 |
|---|---|---|---|---|---|---|
| When $n_1 \geq n_{10}$, | $n_{1m}=$ | 0.0837915 | 0.0974329 | 0.1166235 | 0.0430017 | 0.0505029 |
| When $n_1 < n_{10}$, | $n_{1m}=$ | 0.0514441 | 0.0592371 | 0.0737268 | 0.0188135 | 0.0178369 |
| When $k_1 \geq k_{10}$, | $k_{1m}=$ | 0.0700403 | 0.0772290 | 0.0977893 | 0.0384546 | 0.0357764 |
| When $k_1 < k_{10}$, | $k_{1m}=$ | 0.0875134 | 0.0920008 | 0.1039493 | 0.0432324 | 0.0268848 |
| When $d_1 \geq d_{10}$, | $d_{1m}$ (nm) $=$ | 5.323 | 5.852 | 6.362 | 32.246 | $\infty$ |
| When $d_1 < d_{10}$, | $d_{1m}$ (nm) $=$ | 3.062 | 3.205 | 3.699 | 5.981 | 7.380 |
| When $n_2 \geq n_{20}$, | $n_{2m}=$ | 0.0928162 | 0.1031079 | 0.1115686 | 0.0381177 | 0.0304712 |
| When $n_2 < n_{20}$, | $n_{2m}=$ | 0.1435938 | 0.1490808 | 0.1351062 | 0.0929431 | 0.0597266 |
| When $k_2 \geq k_{20}$, | $k_{2m}=$ | 0.0944385 | 0.1027820 | 0.0897864 | 0.0382104 | 0.0277966 |
| When $k_2 < k_{20}$, | $k_{2m}=$ | 0.0995911 | 0.0924023 | 0.0838245 | 0.0518921 | 0.0482678 |
| When $d_2 \geq d_{20}$, | $d_{2m}$ (nm) $=$ | $\infty$ | $\infty$ | $\infty$ | $\infty$ | 23.493 |
| When $d_2 < d_{20}$, | $d_{2m}$ (nm) $=$ | 30.912 | 72.930 | 96.188 | 31.536 | 23.876 |

1．1＜ＮＡ≦1．2
145＜Ｔ≦155

| Case | 15-06 | 15-07 | 15-08 | 15-09 |
|---|---|---|---|---|
| $n_{10}$ | 1.6903081 | 1.6915399 | 1.6931731 | 1.6963857 |
| $k_{10}$ | 0.0771344 | 0.0690906 | 0.0615887 | 0.0546855 |
| $d_{10}$ (nm) | 216.305 | 212.338 | 211.917 | 273.170 |
| $n_{20}$ | 1.6786590 | 1.6881028 | 1.6918937 | 1.6879125 |
| $k_{20}$ | 0.2613948 | 0.2062149 | 0.1729009 | 0.1780863 |
| $d_{20}$ (nm) | 139.207 | 199.770 | 256.415 | 251.444 |

| | | 15-06 | 15-07 | 15-08 | 15-09 |
|---|---|---|---|---|---|
| When $n_1 \geq n_{10}$, | $n_{1m}=$ | 0.0195569 | 0.0307166 | 0.0591064 | 0.0699243 |
| When $n_1 < n_{10}$, | $n_{1m}=$ | 0.0132800 | 0.0523120 | 0.0554614 | 0.0530347 |
| When $k_1 \geq k_{10}$, | $k_{1m}=$ | 0.0269897 | 0.0450159 | 0.0517236 | 0.0562524 |
| When $k_1 < k_{10}$, | $k_{1m}=$ | 0.0101050 | 0.0313696 | 0.0355261 | 0.0367395 |
| When $d_1 \geq d_{10}$, | $d_{1m}$ (nm) $=$ | 14.222 | $\infty$ | $\infty$ | $\infty$ |
| When $d_1 < d_{10}$, | $d_{1m}$ (nm) $=$ | 6.108 | 32.462 | 54.157 | 113.606 |
| When $n_2 \geq n_{20}$, | $n_{2m}=$ | 0.0246814 | 0.2330432 | 0.2286047 | 0.2890198 |
| When $n_2 < n_{20}$, | $n_{2m}=$ | 0.0598340 | 0.0841870 | 0.1451465 | 0.2088098 |
| When $k_2 \geq k_{20}$, | $k_{2m}=$ | 0.0678235 | 0.1160620 | 0.1277832 | 0.1979041 |
| When $k_2 < k_{20}$, | $k_{2m}=$ | 0.0514465 | 0.0682922 | 0.0664624 | 0.0771411 |
| When $d_2 \geq d_{20}$, | $d_{2m}$ (nm) $=$ | 11.437 | $\infty$ | $\infty$ | $\infty$ |
| When $d_2 < d_{20}$, | $d_{2m}$ (nm) $=$ | 12.498 | 26.276 | 74.225 | 84.013 |

1. 1 < N A ≤ 1. 2
1 5 5 < T ≤ 1 6 5

| Case | 16-01 | 16-02 | 16-03 | 16-04 | 16-05 |
|---|---|---|---|---|---|
| $n_{10}$ | 1.9078860 | 1.9270939 | 1.9009914 | 1.7182026 | 1.7037276 |
| $k_{10}$ | 0.1508452 | 0.0963716 | 0.1079582 | 0.0759211 | 0.0670447 |
| $d_{10}$ (nm) | 16.208 | 13.863 | 11.657 | 93.910 | 160.452 |
| $n_{20}$ | 1.7232027 | 1.7738090 | 1.6981472 | 1.6754262 | 1.6860603 |
| $k_{20}$ | 0.4201511 | 0.3331580 | 0.2622250 | 0.1979303 | 0.1785858 |
| $d_{20}$ (nm) | 134.826 | 188.374 | 256.036 | 248.261 | 243.357 |

| | | 16-01 | 16-02 | 16-03 | 16-04 | 16-05 |
|---|---|---|---|---|---|---|
| When $n_1 \geq n_{10}$, | $n_{1m} =$ | 0.0807556 | 0.0955676 | 0.1136938 | 0.0410315 | 0.0482739 |
| When $n_1 < n_{10}$, | $n_{1m} =$ | 0.0492212 | 0.0570374 | 0.0706995 | 0.0157471 | 0.0155554 |
| When $k_1 \geq k_{10}$, | $k_{1m} =$ | 0.0660083 | 0.0745215 | 0.0946643 | 0.0342603 | 0.0302344 |
| When $k_1 < k_{10}$, | $k_{1m} =$ | 0.0885791 | 0.0963716 | 0.1079582 | 0.0433301 | 0.0248120 |
| When $d_1 \geq d_{10}$, | $d_{1m}$ (nm) $=$ | 4.938 | 5.477 | 6.133 | 23.554 | ∞ |
| When $d_1 < d_{10}$, | $d_{1m}$ (nm) $=$ | 2.790 | 2.920 | 3.507 | 4.784 | 6.051 |
| When $n_2 \geq n_{20}$, | $n_{2m} =$ | 0.0912793 | 0.1022461 | 0.1087073 | 0.0334387 | 0.0216223 |
| When $n_2 < n_{20}$, | $n_{2m} =$ | 0.1401233 | 0.1468384 | 0.1373413 | 0.0900842 | 0.0519312 |
| When $k_2 \geq k_{20}$, | $k_{2m} =$ | 0.0948535 | 0.1014905 | 0.0883215 | 0.0321790 | 0.0239026 |
| When $k_2 < k_{20}$, | $k_{2m} =$ | 0.0976477 | 0.0917578 | 0.0837280 | 0.0507922 | 0.0474658 |
| When $d_2 \geq d_{20}$, | $d_{2m}$ (nm) $=$ | ∞ | ∞ | ∞ | ∞ | 19.461 |
| When $d_2 < d_{20}$, | $d_{2m}$ (nm) $=$ | 27.641 | 68.596 | 90.537 | 29.710 | 21.259 |

1. 1 < N A ≤ 1. 2
1 5 5 < T ≤ 1 6 5

| Case | 16-06 | 16-07 | 16-08 | 16-09 |
|---|---|---|---|---|
| $n_{10}$ | 1.6914048 | 1.6932944 | 1.6971949 | 1.6963748 |
| $k_{10}$ | 0.0705280 | 0.0619823 | 0.0758678 | 0.0557064 |
| $d_{10}$ (nm) | 212.904 | 213.027 | 268.193 | 273.316 |
| $n_{20}$ | 1.6862460 | 1.6912789 | 1.6840809 | 1.6860970 |
| $k_{20}$ | 0.2142065 | 0.1784688 | 0.2789945 | 0.1841499 |
| $d_{20}$ (nm) | 190.804 | 246.475 | 135.240 | 242.973 |

| | | 16-06 | 16-07 | 16-08 | 16-09 |
|---|---|---|---|---|---|
| When $n_1 \geq n_{10}$, | $n_{1m} =$ | 0.0288806 | 0.0598267 | 0.0616260 | 0.0706445 |
| When $n_1 < n_{10}$, | $n_{1m} =$ | 0.0419739 | 0.0573401 | 0.0320642 | 0.0521814 |
| When $k_1 \geq k_{10}$, | $k_{1m} =$ | 0.0434460 | 0.0510059 | 0.0409424 | 0.0555554 |
| When $k_1 < k_{10}$, | $k_{1m} =$ | 0.0304883 | 0.0343054 | 0.0217456 | 0.0379871 |
| When $d_1 \geq d_{10}$, | $d_{1m}$ (nm) $=$ | ∞ | ∞ | ∞ | ∞ |
| When $d_1 < d_{10}$, | $d_{1m}$ (nm) $=$ | 31.951 | 51.898 | 19.489 | 113.780 |
| When $n_2 \geq n_{20}$, | $n_{2m} =$ | 0.2364844 | 0.2370337 | 0.2474512 | 0.2927136 |
| When $n_2 < n_{20}$, | $n_{2m} =$ | 0.0869409 | 0.1403040 | 0.2270129 | 0.2100537 |
| When $k_2 \geq k_{20}$, | $k_{2m} =$ | 0.1087354 | 0.1223047 | 0.1872974 | 0.1959326 |
| When $k_2 < k_{20}$, | $k_{2m} =$ | 0.0726953 | 0.0652295 | 0.1039441 | 0.0773071 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 34.355 | 75.037 | 36.050 | 81.214 |

1. 1 < N A ≤ 1. 2
1 6 5 < T ≤ 1 7 5

| Case | 17-01 | 17-02 | 17-03 | 17-04 | 17-05 |
|---|---|---|---|---|---|
| $n_{10}$ | 1.9345747 | 1.9100928 | 1.9218874 | 1.7188695 | 1.7031385 |
| $k_{10}$ | 0.1082213 | 0.1149883 | 0.1634556 | 0.0782891 | 0.0685384 |
| $d_{10}$ (nm) | 13.373 | 11.317 | 15.608 | 93.463 | 159.293 |
| $n_{20}$ | 1.7554016 | 1.6916658 | 1.7091703 | 1.6745648 | 1.6866422 |
| $k_{20}$ | 0.3434593 | 0.2694423 | 0.4402763 | 0.2040549 | 0.1829170 |
| $d_{20}$ (nm) | 183.042 | 248.707 | 128.647 | 239.614 | 234.977 |

| | | 17-01 | 17-02 | 17-03 | 17-04 | 17-05 |
|---|---|---|---|---|---|---|
| When $n_1 \geq n_{10}$, | $n_{1m}=$ | 0.0953882 | 0.1140894 | 0.0784595 | 0.0386694 | 0.0460681 |
| When $n_1 < n_{10}$, | $n_{1m}=$ | 0.0550098 | 0.0698865 | 0.0459766 | 0.0121814 | 0.0133398 |
| When $k_1 \geq k_{10}$, | $k_{1m}=$ | 0.0742224 | 0.0954895 | 0.0620923 | 0.0290149 | 0.0227319 |
| When $k_1 < k_{10}$, | $k_{1m}=$ | 0.1051392 | 0.1149883 | 0.0878528 | 0.0413110 | 0.0203333 |
| When $d_1 \geq d_{10}$, | $d_{1m}$ (nm) $=$ | 5.105 | 5.733 | 4.388 | 16.599 | ∞ |
| When $d_1 < d_{10}$, | $d_{1m}$ (nm) $=$ | 2.628 | 3.226 | 2.376 | 3.551 | 4.956 |
| When $n_2 \geq n_{20}$, | $n_{2m}=$ | 0.0995532 | 0.1061743 | 0.0849316 | 0.0275488 | 0.0132971 |
| When $n_2 < n_{20}$, | $n_{2m}=$ | 0.1453674 | 0.1364294 | 0.1372107 | 0.0877344 | 0.0449780 |
| When $k_2 \geq k_{20}$, | $k_{2m}=$ | 0.0936926 | 0.0848206 | 0.0864539 | 0.0249731 | 0.0152673 |
| When $k_2 < k_{20}$, | $k_{2m}=$ | 0.0884937 | 0.0821777 | 0.0909717 | 0.0487439 | 0.0459656 |
| When $d_2 \geq d_{20}$, | $d_{2m}$ (nm) $=$ | ∞ | ∞ | ∞ | ∞ | 6.034 |
| When $d_2 < d_{20}$, | $d_{2m}$ (nm) $=$ | 65.841 | 91.823 | 28.009 | 30.737 | 19.612 |

1. 1 < N A ≤ 1. 2
1 6 5 < T ≤ 1 7 5

| Case | 17-06 | 17-07 | 17-08 | 17-09 |
|---|---|---|---|---|
| $n_{10}$ | 1.6934237 | 1.6934242 | 1.6985617 | 1.6963947 |
| $k_{10}$ | 0.0627890 | 0.0627998 | 0.0777714 | 0.0569261 |
| $d_{10}$ (nm) | 213.592 | 213.572 | 264.836 | 273.344 |
| $n_{20}$ | 1.6908665 | 1.6907829 | 1.6854326 | 1.6845211 |
| $k_{20}$ | 0.1844160 | 0.1843934 | 0.2962369 | 0.1907955 |
| $d_{20}$ (nm) | 236.853 | 236.891 | 131.733 | 233.824 |

| | | 17-06 | 17-07 | 17-08 | 17-09 |
|---|---|---|---|---|---|
| When $n_1 \geq n_{10}$, | $n_{1m}=$ | 0.0574976 | 0.0574353 | 0.0522168 | 0.0698511 |
| When $n_1 < n_{10}$, | $n_{1m}=$ | 0.0521313 | 0.0521704 | 0.0296216 | 0.0506372 |
| When $k_1 \geq k_{10}$, | $k_{1m}=$ | 0.0502954 | 0.0502856 | 0.0369763 | 0.0547412 |
| When $k_1 < k_{10}$, | $k_{1m}=$ | 0.0341577 | 0.0341846 | 0.0234509 | 0.0368408 |
| When $d_1 \geq d_{10}$, | $d_{1m}$ (nm) $=$ | ∞ | ∞ | ∞ | ∞ |
| When $d_1 < d_{10}$, | $d_{1m}$ (nm) $=$ | 50.284 | 50.272 | 18.034 | 113.943 |
| When $n_2 \geq n_{20}$, | $n_{2m}=$ | 0.2442261 | 0.2441003 | 0.2108032 | 0.3045251 |
| When $n_2 < n_{20}$, | $n_{2m}=$ | 0.1394958 | 0.1395251 | 0.2567761 | 0.2115186 |
| When $k_2 \geq k_{20}$, | $k_{2m}=$ | 0.1187415 | 0.1187610 | 0.1954675 | 0.1950378 |
| When $k_2 < k_{20}$, | $k_{2m}=$ | 0.0660913 | 0.0660889 | 0.1128296 | 0.0795361 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 75.634 | 75.652 | 33.470 | 80.767 |

1. 1 < N A ≤ 1. 2
1 7 5 < T ≤ 1 8 5

| Case | 18-01 | 18-02 | 18-03 | 18-04 | 18-05 |
|---|---|---|---|---|---|
| $n_{10}$ | 1.9329388 | 1.9368237 | 1.9141366 | 1.7191879 | 1.7029035 |
| $k_{10}$ | 0.1795701 | 0.1224596 | 0.1196035 | 0.0801581 | 0.0699625 |
| $d_{10}$ (nm) | 14.789 | 12.921 | 11.206 | 93.133 | 158.805 |
| $n_{20}$ | 1.6812994 | 1.7305084 | 1.6882344 | 1.6734445 | 1.6865116 |
| $k_{20}$ | 0.4483886 | 0.3477304 | 0.2744889 | 0.2077092 | 0.1862225 |
| $d_{20}$ (nm) | 123.825 | 177.704 | 240.000 | 230.286 | 225.674 |

| | | 18-01 | 18-02 | 18-03 | 18-04 | 18-05 |
|---|---|---|---|---|---|---|
| When $n_1 \geq n_{10}$, | $n_{1m}=$ | 0.0768433 | 0.0949634 | 0.1131592 | 0.0367419 | 0.0441357 |
| When $n_1 < n_{10}$, | $n_{1m}=$ | 0.0412451 | 0.0529919 | 0.0684998 | 0.0095679 | 0.0109912 |
| When $k_1 \geq k_{10}$, | $k_{1m}=$ | 0.0578772 | 0.0744714 | 0.0949390 | 0.0247339 | 0.0167639 |
| When $k_1 < k_{10}$, | $k_{1m}=$ | 0.0896887 | 0.1065430 | 0.1185388 | 0.0386743 | 0.0152380 |
| When $d_1 \geq d_{10}$, | $d_{1m}$ (nm) $=$ | 3.840 | 4.794 | 5.495 | 14.453 | ∞ |
| When $d_1 < d_{10}$, | $d_{1m}$ (nm) $=$ | 1.946 | 2.409 | 3.066 | 2.710 | 3.941 |
| When $n_2 \geq n_{20}$, | $n_{2m}=$ | 0.0764294 | 0.0962097 | 0.1038733 | 0.0230908 | 0.0081592 |
| When $n_2 < n_{20}$, | $n_{2m}=$ | 0.1359412 | 0.1466211 | 0.1367029 | 0.0895520 | 0.0398572 |
| When $k_2 \geq k_{20}$, | $k_{2m}=$ | 0.0734753 | 0.0852112 | 0.0825085 | 0.0197388 | 0.0086536 |
| When $k_2 < k_{20}$, | $k_{2m}=$ | 0.0828125 | 0.0854419 | 0.0815332 | 0.0475061 | 0.0463342 |
| When $d_2 \geq d_{20}$, | $d_{2m}$ (nm) $=$ | ∞ | ∞ | ∞ | 20.793 | 3.280 |
| When $d_2 < d_{20}$, | $d_{2m}$ (nm) $=$ | 32.854 | 63.574 | 95.894 | 33.693 | 18.574 |

1. 1 < N A ≤ 1. 2
1 7 5 < T ≤ 1 8 5

| Case | 18-06 | 18-07 | 18-08 |
|---|---|---|---|
| $n_{10}$ | 1.6933701 | 1.6939475 | 1.6969386 |
| $k_{10}$ | 0.0640425 | 0.0576888 | 0.0533290 |
| $d_{10}$ (nm) | 213.864 | 212.435 | 271.986 |
| $n_{20}$ | 1.6904005 | 1.6925921 | 1.6924288 |
| $k_{20}$ | 0.1898312 | 0.1618810 | 0.1673219 |
| $d_{20}$ (nm) | 227.117 | 285.048 | 281.091 |

| | | 18-06 | 18-07 | 18-08 |
|---|---|---|---|---|
| When $n_1 \geq n_{10}$, | $n_{1m}=$ | 0.0547229 | 0.0510974 | 0.0676453 |
| When $n_1 < n_{10}$, | $n_{1m}=$ | 0.0462109 | 0.0603149 | 0.0497070 |
| When $k_1 \geq k_{10}$, | $k_{1m}=$ | 0.0493457 | 0.0532312 | 0.0592920 |
| When $k_1 < k_{10}$, | $k_{1m}=$ | 0.0339734 | 0.0351465 | 0.0390295 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 49.384 | 120.643 | 177.975 |
| When $n_2 \geq n_{20}$, | $n_{2m}=$ | 0.2555811 | 0.2373071 | 0.2892273 |
| When $n_2 < n_{20}$, | $n_{2m}=$ | 0.1402515 | 0.1279663 | 0.2010315 |
| When $k_2 \geq k_{20}$, | $k_{2m}=$ | 0.1146326 | 0.1254919 | 0.2051270 |
| When $k_2 < k_{20}$, | $k_{2m}=$ | 0.0655762 | 0.0607678 | 0.0750598 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 70.972 | 82.029 | 98.942 |

1. 1 < N A ≤ 1. 2
1 8 5 < T ≤ 1 9 5

| Case | 19-01 | 19-02 | 19-03 | 19-04 | 19-05 |
|---|---|---|---|---|---|
| $n_{10}$ | 1.9315873 | 1.9153217 | 1.8972445 | 1.7198506 | 1.7209927 |
| $k_{10}$ | 0.1333486 | 0.1206110 | 0.1001874 | 0.0813984 | 0.0705203 |
| $d_{10}$ (nm) | 13.169 | 11.351 | 10.604 | 93.215 | 93.408 |
| $n_{20}$ | 1.7169625 | 1.6899751 | 1.6952918 | 1.6740113 | 1.6975541 |
| $k_{20}$ | 0.3552140 | 0.2797802 | 0.2334251 | 0.2110946 | 0.1793898 |
| $d_{20}$ (nm) | 168.729 | 229.265 | 285.679 | 219.867 | 273.456 |

| | | 19-01 | 19-02 | 19-03 | 19-04 | 19-05 |
|---|---|---|---|---|---|---|
| When $n_1 \geq n_{10}$, | $n_{1m} =$ | 0.0918945 | 0.1114490 | 0.1257397 | 0.0361377 | 0.0445178 |
| When $n_1 < n_{10}$, | $n_{1m} =$ | 0.0499878 | 0.0671436 | 0.0846338 | 0.0086279 | 0.0205615 |
| When $k_1 \geq k_{10}$, | $k_{1m} =$ | 0.0714844 | 0.0926733 | 0.1116675 | 0.0228809 | 0.0433899 |
| When $k_1 < k_{10}$, | $k_{1m} =$ | 0.1000085 | 0.1179578 | 0.1001874 | 0.0379150 | 0.0444836 |
| When $d_1 \geq d_{10}$, | $d_{1m}$ (nm) $=$ | 4.647 | 5.413 | 6.402 | 13.674 | 40.701 |
| When $d_1 < d_{10}$, | $d_{1m}$ (nm) $=$ | 2.318 | 3.021 | 3.978 | 2.409 | 6.133 |
| When $n_2 \geq n_{20}$, | $n_{2m} =$ | 0.0938611 | 0.1021985 | 0.1009766 | 0.0217163 | 0.0601978 |
| When $n_2 < n_{20}$, | $n_{2m} =$ | 0.1488745 | 0.1392834 | 0.1303809 | 0.0916943 | 0.1077124 |
| When $k_2 \geq k_{20}$, | $k_{2m} =$ | 0.0821570 | 0.0826257 | 0.0865845 | 0.0185046 | 0.0416394 |
| When $k_2 < k_{20}$, | $k_{2m} =$ | 0.0869946 | 0.0832629 | 0.0782239 | 0.0491125 | 0.0501843 |
| When $d_2 \geq d_{20}$, | $d_{2m}$ (nm) $=$ | ∞ | ∞ | ∞ | 19.431 | ∞ |
| When $d_2 < d_{20}$, | $d_{2m}$ (nm) $=$ | 61.773 | 92.529 | 127.146 | 32.148 | 73.073 |

1. 1 < N A ≤ 1. 2
1 8 5 < T ≤ 1 9 5

| Case | 19-06 | 19-07 | 19-08 | 19-09 | 19-10 |
|---|---|---|---|---|---|
| $n_{10}$ | 1.7035608 | 1.6916743 | 1.6930483 | 1.6936984 | 1.6968810 |
| $k_{10}$ | 0.0713918 | 0.0742011 | 0.0657083 | 0.0591625 | 0.0544417 |
| $d_{10}$ (nm) | 159.462 | 216.137 | 213.861 | 212.273 | 271.786 |
| $n_{20}$ | 1.6857491 | 1.6815589 | 1.6902271 | 1.6918699 | 1.6922876 |
| $k_{20}$ | 0.1901066 | 0.2413942 | 0.1951191 | 0.1652801 | 0.1708476 |
| $d_{20}$ (nm) | 215.251 | 158.897 | 217.477 | 275.792 | 271.501 |

| | | 19-06 | 19-07 | 19-08 | 19-09 | 19-10 |
|---|---|---|---|---|---|---|
| When $n_1 \geq n_{10}$, | $n_{1m} =$ | 0.0427405 | 0.0223779 | 0.0519324 | 0.0514441 | 0.0684033 |
| When $n_1 < n_{10}$, | $n_{1m} =$ | 0.0090222 | 0.0227649 | 0.0431079 | 0.0594763 | 0.0491284 |
| When $k_1 \geq k_{10}$, | $k_{1m} =$ | 0.0150232 | 0.0325586 | 0.0481873 | 0.0521765 | 0.0581763 |
| When $k_1 < k_{10}$, | $k_{1m} =$ | 0.0160400 | 0.0253345 | 0.0315527 | 0.0340894 | 0.0370996 |
| When $d_1 \geq d_{10}$, | $d_{1m}$ (nm) $=$ | ∞ | 13.469 | ∞ | ∞ | ∞ |
| When $d_1 < d_{10}$, | $d_{1m}$ (nm) $=$ | 3.174 | 10.839 | 47.894 | 119.682 | 177.263 |
| When $n_2 \geq n_{20}$, | $n_{2m} =$ | 0.0074805 | 0.0854517 | 0.1377869 | 0.2440918 | 0.2955884 |
| When $n_2 < n_{20}$, | $n_{2m} =$ | 0.0361890 | 0.0461035 | 0.1429895 | 0.1282532 | 0.2018481 |
| When $k_2 \geq k_{20}$, | $k_{2m} =$ | 0.0083386 | 0.0888440 | 0.1120801 | 0.1247546 | 0.2080872 |
| When $k_2 < k_{20}$, | $k_{2m} =$ | 0.0485754 | 0.0635596 | 0.0642932 | 0.0606433 | 0.0779761 |
| When $d_2 \geq d_{20}$, | $d_{2m}$ (nm) $=$ | 3.092 | ∞ | ∞ | ∞ | ∞ |
| When $d_2 < d_{20}$, | $d_{2m}$ (nm) $=$ | 17.439 | 14.439 | 35.904 | 75.946 | 92.429 |

1. $1 < NA \leq 1.2$
$195 < T \leq 205$

| Case | 20-01 | 20-02 | 20-03 | 20-04 | 20-05 |
|------|-------|-------|-------|-------|-------|
| $n_{10}$ | 1.9249373 | 1.9134695 | 1.8970797 | 1.7208445 | 1.7215107 |
| $k_{10}$ | 0.1361664 | 0.1202777 | 0.0999072 | 0.0825059 | 0.0711590 |
| $d_{10}$ (nm) | 14.155 | 11.822 | 10.899 | 93.633 | 93.747 |
| $n_{20}$ | 1.7251855 | 1.6947701 | 1.6978665 | 1.6746972 | 1.6977852 |
| $k_{20}$ | 0.3723543 | 0.2878755 | 0.2388400 | 0.2167421 | 0.1834377 |
| $d_{20}$ (nm) | 156.237 | 218.180 | 275.054 | 209.700 | 263.540 |

| | 20-01 | 20-02 | 20-03 | 20-04 | 20-05 |
|------|-------|-------|-------|-------|-------|
| When $n_1 \geq n_{10}$, $n_{1m} =$ | 0.0879163 | 0.1083789 | 0.1230811 | 0.0362378 | 0.0448303 |
| When $n_1 < n_{10}$, $n_{1m} =$ | 0.0472876 | 0.0648938 | 0.0826709 | 0.0083032 | 0.0200745 |
| When $k_1 \geq k_{10}$, $k_{1m} =$ | 0.0660645 | 0.0884607 | 0.1084424 | 0.0221863 | 0.0429114 |
| When $k_1 < k_{10}$, $k_{1m} =$ | 0.0933167 | 0.1148511 | 0.0999072 | 0.0377161 | 0.0440771 |
| When $d_1 \geq d_{10}$, $d_{1m}$ (nm) $=$ | 4.725 | 5.477 | 6.424 | 13.579 | 31.897 |
| When $d_1 < d_{10}$, $d_{1m}$ (nm) $=$ | 2.353 | 3.040 | 3.984 | 2.294 | 5.957 |
| When $n_2 \geq n_{20}$, $n_{2m} =$ | 0.0937048 | 0.1017651 | 0.1009302 | 0.0215295 | 0.0601208 |
| When $n_2 < n_{20}$, $n_{2m} =$ | 0.1501685 | 0.1443250 | 0.1325146 | 0.0892346 | 0.1044958 |
| When $k_2 \geq k_{20}$, $k_{2m} =$ | 0.0870276 | 0.0848474 | 0.0878162 | 0.0191504 | 0.0424573 |
| When $k_2 < k_{20}$, $k_{2m} =$ | 0.0940491 | 0.0866907 | 0.0808813 | 0.0520386 | 0.0521252 |
| When $d_2 \geq d_{20}$, $d_{2m}$ (nm) $=$ | $\infty$ | $\infty$ | $\infty$ | $\infty$ | $\infty$ |
| When $d_2 < d_{20}$, $d_{2m}$ (nm) $=$ | 59.976 | 84.859 | 127.060 | 27.072 | 71.102 |

1. $1 < NA \leq 1.2$
$195 < T \leq 205$

| Case | 20-06 | 20-07 | 20-08 | 20-09 | 20-10 |
|------|-------|-------|-------|-------|-------|
| $n_{10}$ | 1.7046380 | 1.7071945 | 1.6911424 | 1.6924731 | 1.6944113 |
| $k_{10}$ | 0.0728087 | 0.0643745 | 0.0761042 | 0.0678273 | 0.0547711 |
| $d_{10}$ (nm) | 160.840 | 160.796 | 216.237 | 212.933 | 211.610 |
| $n_{20}$ | 1.6842748 | 1.7036838 | 1.6835271 | 1.6899027 | 1.6931553 |
| $k_{20}$ | 0.1961079 | 0.1674255 | 0.2518702 | 0.2006809 | 0.1468072 |
| $d_{20}$ (nm) | 204.946 | 259.158 | 149.208 | 209.434 | 323.528 |

| | 20-06 | 20-07 | 20-08 | 20-09 | 20-10 |
|------|-------|-------|-------|-------|-------|
| When $n_1 \geq n_{10}$, $n_{1m} =$ | 0.0417468 | 0.0534717 | 0.0144385 | 0.0489441 | 0.0528149 |
| When $n_1 < n_{10}$, $n_{1m} =$ | 0.0080798 | 0.0311902 | 0.0202490 | 0.0431433 | 0.0592456 |
| When $k_1 \geq k_{10}$, $k_{1m} =$ | 0.0160498 | 0.0272644 | 0.0259192 | 0.0470654 | 0.0582300 |
| When $k_1 < k_{10}$, $k_{1m} =$ | 0.0189954 | 0.0257520 | 0.0204919 | 0.0289844 | 0.0354419 |
| When $d_1 \geq d_{10}$, $d_{1m}$ (nm) $=$ | $\infty$ | $\infty$ | 11.042 | $\infty$ | $\infty$ |
| When $d_1 < d_{10}$, $d_{1m}$ (nm) $=$ | 2.830 | 21.473 | 8.826 | 44.978 | 116.569 |
| When $n_2 \geq n_{20}$, $n_{2m} =$ | 0.0092676 | 0.0660242 | 0.0583154 | 0.1383105 | 0.2397107 |
| When $n_2 < n_{20}$, $n_{2m} =$ | 0.0345349 | 0.0284167 | 0.0279346 | 0.1133557 | 0.1358362 |
| When $k_2 \geq k_{20}$, $k_{2m} =$ | 0.0098743 | 0.0192883 | 0.0839758 | 0.1160754 | 0.1327747 |
| When $k_2 < k_{20}$, $k_{2m} =$ | 0.0439319 | 0.0493506 | 0.0539001 | 0.0650562 | 0.0582056 |
| When $d_2 \geq d_{20}$, $d_{2m}$ (nm) $=$ | 4.069 | $\infty$ | $\infty$ | $\infty$ | $\infty$ |
| When $d_2 < d_{20}$, $d_{2m}$ (nm) $=$ | 16.537 | 9.202 | 10.084 | 22.297 | 94.005 |

$$1.1 < NA \leq 1.2$$
$$195 < T \leq 205$$

| Case | 20-11 |
|---|---|
| $n_{10}$ | 1.6967389 |
| $k_{10}$ | 0.0554960 |
| $d_{10}$ (nm) | 271.524 |
| $n_{20}$ | 1.6919127 |
| $k_{20}$ | 0.1743507 |
| $d_{20}$ (nm) | 262.739 |

| When $n_1 \geq n_{10}$, | $n_{1m} =$ | 0.0690857 |
|---|---|---|
| When $n_1 < n_{10}$, | $n_{1m} =$ | 0.0487012 |
| When $k_1 \geq k_{10}$, | $k_{1m} =$ | 0.0571155 |
| When $k_1 < k_{10}$, | $k_{1m} =$ | 0.0354016 |
| When $d_1 \geq d_{10}$, | $d_{1m}$ (nm) $=$ | $\infty$ |
| When $d_1 < d_{10}$, | $d_{1m}$ (nm) $=$ | 122.531 |
| When $n_2 \geq n_{20}$, | $n_{2m} =$ | 0.3042639 |
| When $n_2 < n_{20}$, | $n_{2m} =$ | 0.2009363 |
| When $k_2 \geq k_{20}$, | $k_{2m} =$ | 0.2111316 |
| When $k_2 < k_{20}$, | $k_{2m} =$ | 0.0800171 |
| When $d_2 \geq d_{20}$, | $d_{2m}$ (nm) $=$ | $\infty$ |
| When $d_2 < d_{20}$, | $d_{2m}$ (nm) $=$ | 82.974 |

**4.** An antireflective film used in a process for manufacturing a semiconductor device by being provided between a resist layer and a silicon oxide layer formed on a surface of a silicon semiconductor substrate and having a thickness T (unit: nm) described below, for exposure of the resist layer in an exposure system having a wavelength of 190 nm to 195 nm and a numerical aperture NA of $1.2 < NA \leq 1.3$, the antireflective film having a two-layer structure comprising:

an upper layer having a complex refractive index $N_1$; and
a lower layer having a complex refractive index $N_2$; the complex refractive indexes $N_1$ and $N_2$ being represented by the equations $N_1 = n_1 - k_1 i$ and $N_2 = n_2 - k_2 i$, respectively,
wherein assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1$, $k_1$, $d_1$, $n_2$, $k_2$, and $d_2$ satisfy the relational expression

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1;$$

a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$; and in the tables below, in the line of "When $n_1 \geq n_{10}$, $n_{1m} =$", each value in the right columns is "$n_{1m} - n_{10}$"; in the

line of "When $n_1 < n_{10}$, $n_{1m}$ =", each value in the right columns is "$n_{10} - n_{1m}$"; in the line of "When $k_1 \geq k_{10}$, $k_{1m}$ =", each value in the right columns is "$k_{1m} - k_{10}$"; in the line of "When $k_1 < k_{10}$, $k_{1m}$ =", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m}$ =", each value in the right columns is "$n_{2m} - n_{20}$"; in the line of "When $n_2 < n_{20}$, $n_{2m}$ =", each value in the right columns is "$n_{20} - n_{2m}$"; in the line of "When $k_2 \geq k_{20}$, $k_{2m}$ =", each value in the right columns is "$k_{2m} - k_{20}$"; in the line of "When $k_2 < k_{20}$, $k_{2m}$ =", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

1. 2 < N A ≤ 1. 3

2 ≤ T ≤ 1 5

| Case | 1-01 | 1-02 | 1-03 | 1-04 | 1-05 |
|---|---|---|---|---|---|
| $n_{10}$ | 2.070 | 1.955 | 1.895 | 1.875 | 1.870 |
| $k_{10}$ | 0.020 | 0.138 | 0.133 | 0.110 | 0.101 |
| $d_{10}$ (nm) | 27.974 | 34.826 | 29.218 | 17.990 | 13.959 |
| $n_{20}$ | 5.553 | 9.284 | 2.177 | 1.753 | 1.700 |
| $k_{20}$ | 3.053 | 0.606 | 0.543 | 0.330 | 0.255 |
| $d_{20}$ (nm) | 2.024 | 10.907 | 63.407 | 152.930 | 218.765 |

| | 1-01 | 1-02 | 1-03 | 1-04 | 1-05 |
|---|---|---|---|---|---|
| When $n_1 \geq n_{10}$, $n_{1m} =$ | 2.141 | 2.017 | 1.952 | 1.943 | 1.957 |
| When $n_1 < n_{10}$, $n_{1m} =$ | 2.006 | 1.896 | 1.854 | 1.843 | 1.821 |
| When $k_1 \geq k_{10}$, $k_{1m} =$ | 0.075 | 0.180 | 0.166 | 0.155 | 0.171 |
| When $k_1 < k_{10}$, $k_{1m} =$ | 0.000 | 0.061 | 0.055 | 0.028 | 0.009 |
| When $d_1 \geq d_{10}$, $d_{1m}$ (nm) $=$ | 31.254 | 39.247 | 35.017 | 23.926 | 20.211 |
| When $d_1 < d_{10}$, $d_{1m}$ (nm) $=$ | 25.519 | 31.618 | 26.178 | 15.560 | 10.679 |
| When $n_2 \geq n_{20}$, $n_{2m} =$ | 5.876 | 9.377 | 2.281 | 1.832 | 1.773 |
| When $n_2 < n_{20}$, $n_{2m} =$ | 5.233 | 9.207 | 2.051 | 1.635 | 1.577 |
| When $k_2 \geq k_{20}$, $k_{2m} =$ | 3.362 | 0.715 | 0.699 | 0.412 | 0.320 |
| When $k_2 < k_{20}$, $k_{2m} =$ | 2.751 | 0.513 | 0.439 | 0.253 | 0.185 |
| When $d_2 \geq d_{20}$, $d_{2m}$ (nm) $=$ | 2.251 | 11.023 | 70.023 | ∞ | ∞ |
| When $d_2 < d_{20}$, $d_{2m}$ (nm) $=$ | 1.807 | 10.812 | 58.076 | 125.396 | 142.606 |

1. 2 < N A ≤ 1. 3

2 ≤ T ≤ 1 5

| Case | 1-06 | 1-07 | 1-08 | 1-09 | 1-10 |
|---|---|---|---|---|---|
| $n_{10}$ | 1.867 | 1.699 | 1.693 | 1.692 | 1.694 |
| $k_{10}$ | 0.070 | 0.063 | 0.058 | 0.069 | 0.074 |
| $d_{10}$ (nm) | 13.235 | 165.016 | 157.920 | 236.756 | 217.672 |
| $n_{20}$ | 1.732 | 1.698 | 1.698 | 6.942 | 1.788 |
| $k_{20}$ | 0.221 | 0.180 | 0.154 | 3.076 | 0.339 |
| $d_{20}$ (nm) | 270.745 | 204.222 | 265.886 | 0.950 | 84.006 |

| | 1-06 | 1-07 | 1-08 | 1-09 | 1-10 |
|---|---|---|---|---|---|
| When $n_1 \geq n_{10}$, $n_{1m} =$ | 1.964 | 1.701 | 1.708 | 1.727 | 1.710 |
| When $n_1 < n_{10}$, $n_{1m} =$ | 1.810 | 1.683 | 1.664 | 1.662 | 1.674 |
| When $k_1 \geq k_{10}$, $k_{1m} =$ | 0.149 | 0.068 | 0.084 | 0.108 | 0.106 |
| When $k_1 < k_{10}$, $k_{1m} =$ | 0.000 | 0.043 | 0.031 | 0.039 | 0.053 |
| When $d_1 \geq d_{10}$, $d_{1m}$ (nm) $=$ | 20.519 | 166.410 | 170.845 | 255.389 | 226.062 |
| When $d_1 < d_{10}$, $d_{1m}$ (nm) $=$ | 9.259 | 155.941 | 111.504 | 217.630 | 206.257 |
| When $n_2 \geq n_{20}$, $n_{2m} =$ | 1.809 | 1.721 | 1.754 | 7.503 | 1.909 |
| When $n_2 < n_{20}$, $n_{2m} =$ | 1.603 | 1.694 | 1.667 | 6.491 | 1.763 |
| When $k_2 \geq k_{20}$, $k_{2m} =$ | 0.293 | 0.188 | 0.194 | 3.321 | 0.395 |
| When $k_2 < k_{20}$, $k_{2m} =$ | 0.152 | 0.139 | 0.113 | 2.487 | 0.243 |
| When $d_2 \geq d_{20}$, $d_{2m}$ (nm) $=$ | ∞ | 217.552 | ∞ | 1.062 | 100.609 |
| When $d_2 < d_{20}$, $d_{2m}$ (nm) $=$ | 182.495 | 202.082 | 249.694 | 0.781 | 81.237 |

$1.2 < NA \leq 1.3$

$2 \leq T \leq 15$

| Case | 1-11 | 1-12 | 1-13 |
|---|---|---|---|
| $n_{10}$ | 1.699 | 1.698 | 1.695 |
| $k_{10}$ | 0.071 | 0.065 | 0.054 |
| $d_{10}$ (nm) | 210.274 | 207.280 | 219.181 |
| $n_{20}$ | 1.718 | 1.695 | 1.688 |
| $k_{20}$ | 0.242 | 0.194 | 0.161 |
| $d_{20}$ (nm) | 154.667 | 219.490 | 263.755 |

| | | 1-11 | 1-12 | 1-13 |
|---|---|---|---|---|
| When $n_1 \geq n_{10}$, | $n_{1m} =$ | 1.720 | 1.737 | 1.738 |
| When $n_1 < n_{10}$, | $n_{1m} =$ | 1.683 | 1.675 | 1.660 |
| When $k_1 \geq k_{10}$, | $k_{1m} =$ | 0.099 | 0.097 | 0.100 |
| When $k_1 < k_{10}$, | $k_{1m} =$ | 0.045 | 0.035 | 0.019 |
| When $d_1 \geq d_{10}$, | $d_{1m}$ (nm) $=$ | 229.005 | $\infty$ | $\infty$ |
| When $d_1 < d_{10}$, | $d_{1m}$ (nm) $=$ | 200.369 | 189.200 | 189.609 |
| When $n_2 \geq n_{20}$, | $n_{2m} =$ | 1.849 | 1.855 | 1.900 |
| When $n_2 < n_{20}$, | $n_{2m} =$ | 1.670 | 1.540 | 1.583 |
| When $k_2 \geq k_{20}$, | $k_{2m} =$ | 0.332 | 0.307 | 0.271 |
| When $k_2 < k_{20}$, | $k_{2m} =$ | 0.164 | 0.122 | 0.102 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 143.819 | 154.002 | 185.363 |

1. 2 < N A ≤ 1. 3
1 < ＜ T ≤ 2 5

| Case | 2-01 | 2-02 | 2-03 | 2-04 | 2-05 |
|---|---|---|---|---|---|
| $n_{10}$ | 1.894 | 1.881 | 1.874 | 1.872 | 1.693 |
| $k_{10}$ | 0.182 | 0.116 | 0.105 | 0.074 | 0.060 |
| $d_{10}$ (nm) | 37.493 | 18.625 | 14.298 | 13.408 | 158.097 |
| $n_{20}$ | 9.246 | 1.766 | 1.701 | 1.733 | 1.697 |
| $k_{20}$ | 0.662 | 0.358 | 0.269 | 0.231 | 0.160 |
| $d_{20}$ (nm) | 10.628 | 142.939 | 209.610 | 261.989 | 257.142 |

| | | 2-01 | 2-02 | 2-03 | 2-04 | 2-05 |
|---|---|---|---|---|---|---|
| When $n_1 \geq n_{10}$, | $n_{1m} =$ | 1.954 | 1.946 | 1.957 | 1.966 | 1.703 |
| When $n_1 < n_{10}$, | $n_{1m} =$ | 1.847 | 1.852 | 1.828 | 1.817 | 1.667 |
| When $k_1 \geq k_{10}$, | $k_{1m} =$ | 0.222 | 0.156 | 0.171 | 0.149 | 0.081 |
| When $k_1 < k_{10}$, | $k_{1m} =$ | 0.111 | 0.037 | 0.015 | 0.000 | 0.035 |
| When $d_1 \geq d_{10}$, | $d_{1m}$ (nm) $=$ | 41.975 | 24.164 | 20.222 | 20.345 | 165.590 |
| When $d_1 < d_{10}$, | $d_{1m}$ (nm) $=$ | 34.168 | 16.466 | 11.264 | 9.664 | 137.726 |
| When $n_2 \geq n_{20}$, | $n_{2m} =$ | 9.356 | 1.841 | 1.772 | 1.809 | 1.744 |
| When $n_2 < n_{20}$, | $n_{2m} =$ | 9.153 | 1.650 | 1.579 | 1.602 | 1.674 |
| When $k_2 \geq k_{20}$, | $k_{2m} =$ | 0.784 | 0.442 | 0.334 | 0.302 | 0.195 |
| When $k_2 < k_{20}$, | $k_{2m} =$ | 0.549 | 0.280 | 0.198 | 0.162 | 0.120 |
| When $d_2 \geq d_{20}$, | $d_{2m}$ (nm) $=$ | 10.759 | ∞ | ∞ | ∞ | ∞ |
| When $d_2 < d_{20}$, | $d_{2m}$ (nm) $=$ | 10.519 | 119.178 | 137.341 | 178.243 | 243.996 |

1. 2 < N A ≤ 1. 3
1 < ＜ T ≤ 2 5

| Case | 2-06 | 2-07 | 2-08 | 2-09 | 2-10 |
|---|---|---|---|---|---|
| $n_{10}$ | 1.690 | 1.693 | 1.699 | 1.698 | 1.695 |
| $k_{10}$ | 0.074 | 0.078 | 0.074 | 0.067 | 0.055 |
| $d_{10}$ (nm) | 235.203 | 218.334 | 210.503 | 207.468 | 219.130 |
| $n_{20}$ | 5.632 | 1.803 | 1.719 | 1.694 | 1.687 |
| $k_{20}$ | 4.204 | 0.382 | 0.259 | 0.203 | 0.167 |
| $d_{20}$ (nm) | 0.919 | 74.994 | 145.797 | 210.546 | 255.274 |

| | | 2-06 | 2-07 | 2-08 | 2-09 | 2-10 |
|---|---|---|---|---|---|---|
| When $n_1 \geq n_{10}$, | $n_{1m} =$ | 1.708 | 1.699 | 1.715 | 1.733 | 1.737 |
| When $n_1 < n_{10}$, | $n_{1m} =$ | 1.661 | 1.675 | 1.684 | 1.676 | 1.661 |
| When $k_1 \geq k_{10}$, | $k_{1m} =$ | 0.102 | 0.098 | 0.100 | 0.097 | 0.100 |
| When $k_1 < k_{10}$, | $k_{1m} =$ | 0.051 | 0.067 | 0.052 | 0.039 | 0.022 |
| When $d_1 \geq d_{10}$, | $d_{1m}$ (nm) $=$ | 241.533 | 220.890 | 225.049 | ∞ | ∞ |
| When $d_1 < d_{10}$, | $d_{1m}$ (nm) $=$ | 217.317 | 207.766 | 201.595 | 191.244 | 190.979 |
| When $n_2 \geq n_{20}$, | $n_{2m} =$ | 6.262 | 1.931 | 1.852 | 1.853 | 1.902 |
| When $n_2 < n_{20}$, | $n_{2m} =$ | 5.366 | 1.793 | 1.684 | 1.538 | 1.584 |
| When $k_2 \geq k_{20}$, | $k_{2m} =$ | 4.338 | 0.416 | 0.339 | 0.310 | 0.275 |
| When $k_2 < k_{20}$, | $k_{2m} =$ | 3.555 | 0.288 | 0.182 | 0.132 | 0.107 |
| When $d_2 \geq d_{20}$, | $d_{2m}$ (nm) $=$ | 0.986 | 89.025 | ∞ | ∞ | ∞ |
| When $d_2 < d_{20}$, | $d_{2m}$ (nm) $=$ | 0.720 | 74.083 | 139.178 | 147.776 | 179.334 |

1. 2 < N A ≤ 1. 3
2 5 < T ≤ 3 5

| Case | 3-01 | 3-02 | 3-03 | 3-04 | 3-05 |
|---|---|---|---|---|---|
| $n_{10}$ | 1.855 | 1.894 | 1.879 | 1.879 | 1.692 |
| $k_{10}$ | 0.222 | 0.121 | 0.110 | 0.076 | 0.062 |
| $d_{10}$ (nm) | 38.795 | 19.092 | 14.598 | 13.458 | 158.198 |
| $n_{20}$ | 9.554 | 1.787 | 1.702 | 1.736 | 1.697 |
| $k_{20}$ | 0.714 | 0.392 | 0.285 | 0.242 | 0.168 |
| $d_{20}$ (nm) | 10.003 | 133.195 | 201.011 | 253.439 | 248.709 |

| | | | | | |
|---|---|---|---|---|---|
| When $n_1 \geq n_{10}$, $n_{1m} =$ | 1.905 | 1.955 | 1.958 | 1.971 | 1.699 |
| When $n_1 < n_{10}$, $n_{1m} =$ | 1.821 | 1.868 | 1.836 | 1.826 | 1.670 |
| When $k_1 \geq k_{10}$, $k_{1m} =$ | 0.258 | 0.156 | 0.172 | 0.149 | 0.078 |
| When $k_1 < k_{10}$, $k_{1m} =$ | 0.159 | 0.047 | 0.022 | 0.000 | 0.041 |
| When $d_1 \geq d_{10}$, $d_{1m}$ (nm) $=$ | 42.560 | 24.067 | 20.129 | 19.949 | 161.711 |
| When $d_1 < d_{10}$, $d_{1m}$ (nm) $=$ | 36.125 | 17.295 | 11.822 | 9.987 | 144.941 |
| When $n_2 \geq n_{20}$, $n_{2m} =$ | 9.681 | 1.856 | 1.769 | 1.811 | 1.737 |
| When $n_2 < n_{20}$, $n_{2m} =$ | 9.446 | 1.674 | 1.584 | 1.608 | 1.683 |
| When $k_2 \geq k_{20}$, $k_{2m} =$ | 0.829 | 0.479 | 0.348 | 0.313 | 0.196 |
| When $k_2 < k_{20}$, $k_{2m} =$ | 0.587 | 0.314 | 0.215 | 0.173 | 0.129 |
| When $d_2 \geq d_{20}$, $d_{2m}$ (nm) $=$ | 10.138 | ∞ | ∞ | ∞ | ∞ |
| When $d_2 < d_{20}$, $d_{2m}$ (nm) $=$ | 9.892 | 112.716 | 132.762 | 173.492 | 239.168 |

1. 2 < N A ≤ 1. 3
2 5 < T ≤ 3 5

| Case | 3-06 | 3-07 | 3-08 |
|---|---|---|---|
| $n_{10}$ | 1.699 | 1.698 | 1.695 |
| $k_{10}$ | 0.078 | 0.070 | 0.057 |
| $d_{10}$ (nm) | 210.437 | 207.381 | 219.158 |
| $n_{20}$ | 1.720 | 1.693 | 1.687 |
| $k_{20}$ | 0.280 | 0.215 | 0.175 |
| $d_{20}$ (nm) | 137.855 | 202.487 | 246.765 |

| | | | |
|---|---|---|---|
| When $n_1 \geq n_{10}$, $n_{1m} =$ | 1.710 | 1.730 | 1.737 |
| When $n_1 < n_{10}$, $n_{1m} =$ | 1.686 | 1.678 | 1.661 |
| When $k_1 \geq k_{10}$, $k_{1m} =$ | 0.100 | 0.097 | 0.101 |
| When $k_1 < k_{10}$, $k_{1m} =$ | 0.063 | 0.046 | 0.025 |
| When $d_1 \geq d_{10}$, $d_{1m}$ (nm) $=$ | 216.379 | ∞ | ∞ |
| When $d_1 < d_{10}$, $d_{1m}$ (nm) $=$ | 202.875 | 193.042 | 192.539 |
| When $n_2 \geq n_{20}$, $n_{2m} =$ | 1.855 | 1.841 | 1.910 |
| When $n_2 < n_{20}$, $n_{2m} =$ | 1.702 | 1.535 | 1.588 |
| When $k_2 \geq k_{20}$, $k_{2m} =$ | 0.336 | 0.312 | 0.280 |
| When $k_2 < k_{20}$, $k_{2m} =$ | 0.208 | 0.146 | 0.114 |
| When $d_2 \geq d_{20}$, $d_{2m}$ (nm) $=$ | ∞ | ∞ | ∞ |
| When $d_2 < d_{20}$, $d_{2m}$ (nm) $=$ | 134.716 | 142.289 | 200.270 |

1. 2 < N A ≤ 1. 3
3 5 < T ≤ 4 5

| Case | 4-01 | 4-02 | 4-03 | 4-04 | 4-05 |
|---|---|---|---|---|---|
| $n_{10}$ | 1.921 | 1.907 | 1.883 | 1.885 | 1.692 |
| $k_{10}$ | 0.198 | 0.132 | 0.117 | 0.078 | 0.064 |
| $d_{10}$ (nm) | 29.852 | 18.597 | 14.666 | 13.425 | 158.019 |
| $n_{20}$ | 2.410 | 1.779 | 1.698 | 1.738 | 1.697 |
| $k_{20}$ | 0.850 | 0.418 | 0.298 | 0.251 | 0.174 |
| $d_{20}$ (nm) | 42.336 | 126.566 | 192.788 | 244.904 | 240.368 |

| | | 4-01 | 4-02 | 4-03 | 4-04 | 4-05 |
|---|---|---|---|---|---|---|
| When $n_1 \geq n_{10}$, | $n_{1m} =$ | 1.964 | 1.964 | 1.959 | 1.975 | 1.694 |
| When $n_1 < n_{10}$, | $n_{1m} =$ | 1.894 | 1.886 | 1.843 | 1.834 | 1.673 |
| When $k_1 \geq k_{10}$, | $k_{1m} =$ | 0.224 | 0.160 | 0.175 | 0.149 | 0.073 |
| When $k_1 < k_{10}$, | $k_{1m} =$ | 0.152 | 0.061 | 0.031 | 0.000 | 0.048 |
| When $d_1 \geq d_{10}$, | $d_{1m}$ (nm) $=$ | 33.127 | 22.917 | 19.812 | 19.537 | 159.270 |
| When $d_1 < d_{10}$, | $d_{1m}$ (nm) $=$ | 28.245 | 17.267 | 12.114 | 10.202 | 147.983 |
| When $n_2 \geq n_{20}$, | $n_{2m} =$ | 2.530 | 1.833 | 1.762 | 1.812 | 1.732 |
| When $n_2 < n_{20}$, | $n_{2m} =$ | 2.288 | 1.667 | 1.583 | 1.611 | 1.691 |
| When $k_2 \geq k_{20}$, | $k_{2m} =$ | 0.928 | 0.492 | 0.359 | 0.320 | 0.195 |
| When $k_2 < k_{20}$, | $k_{2m} =$ | 0.730 | 0.344 | 0.229 | 0.182 | 0.145 |
| When $d_2 \geq d_{20}$, | $d_{2m}$ (nm) $=$ | 46.411 | ∞ | ∞ | ∞ | 274.107 |
| When $d_2 < d_{20}$, | $d_{2m}$ (nm) $=$ | 39.931 | 107.536 | 154.271 | 167.375 | 234.670 |

1. 2 < N A ≤ 1. 3
3 5 < T ≤ 4 5

| Case | 4-06 | 4-07 | 4-08 | 4-09 |
|---|---|---|---|---|
| $n_{10}$ | 1.700 | 1.698 | 1.695 | 1.705 |
| $k_{10}$ | 0.081 | 0.072 | 0.059 | 0.053 |
| $d_{10}$ (nm) | 209.560 | 206.609 | 219.174 | 283.412 |
| $n_{20}$ | 1.716 | 1.692 | 1.688 | 1.691 |
| $k_{20}$ | 0.298 | 0.225 | 0.183 | 0.185 |
| $d_{20}$ (nm) | 131.419 | 195.862 | 237.750 | 233.362 |

| | | 4-06 | 4-07 | 4-08 | 4-09 |
|---|---|---|---|---|---|
| When $n_1 \geq n_{10}$, | $n_{1m} =$ | 1.701 | 1.721 | 1.734 | 1.751 |
| When $n_1 < n_{10}$, | $n_{1m} =$ | 1.689 | 1.680 | 1.662 | 1.675 |
| When $k_1 \geq k_{10}$, | $k_{1m} =$ | 0.099 | 0.097 | 0.101 | 0.092 |
| When $k_1 < k_{10}$, | $k_{1m} =$ | 0.076 | 0.050 | 0.027 | 0.024 |
| When $d_1 \geq d_{10}$, | $d_{1m}$ (nm) $=$ | 210.753 | ∞ | ∞ | ∞ |
| When $d_1 < d_{10}$, | $d_{1m}$ (nm) $=$ | 203.620 | 194.085 | 194.045 | 189.814 |
| When $n_2 \geq n_{20}$, | $n_{2m} =$ | 1.846 | 1.812 | 1.920 | 1.889 |
| When $n_2 < n_{20}$, | $n_{2m} =$ | 1.712 | 1.528 | 1.594 | 1.515 |
| When $k_2 \geq k_{20}$, | $k_{2m} =$ | 0.319 | 0.315 | 0.285 | 0.358 |
| When $k_2 < k_{20}$, | $k_{2m} =$ | 0.257 | 0.159 | 0.121 | 0.115 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 130.894 | 179.580 | 197.417 | 162.566 |

1. 2 < N A ≤ 1. 3
4 5 < T ≤ 5 5

| Case | 5–01 | 5–02 | 5–03 | 5–04 | 5–05 |
|---|---|---|---|---|---|
| $n_{10}$ | 1.943 | 1.907 | 1.884 | 1.891 | 1.691 |
| $k_{10}$ | 0.213 | 0.153 | 0.123 | 0.078 | 0.066 |
| $d_{10}$ (nm) | 22.907 | 17.372 | 14.585 | 13.392 | 157.377 |
| $n_{20}$ | 1.902 | 1.716 | 1.691 | 1.743 | 1.696 |
| $k_{20}$ | 0.785 | 0.418 | 0.305 | 0.257 | 0.178 |
| $d_{20}$ (nm) | 53.731 | 124.143 | 184.536 | 235.129 | 232.195 |

| | | 5–01 | 5–02 | 5–03 | 5–04 | 5–05 |
|---|---|---|---|---|---|---|
| When $n_1 \geq n_{10}$, | $n_{1m} =$ | 1.979 | 1.963 | 1.959 | 1.980 | 1.692 |
| When $n_1 < n_{10}$, | $n_{1m} =$ | 1.934 | 1.892 | 1.845 | 1.841 | 1.676 |
| When $k_1 \geq k_{10}$, | $k_{1m} =$ | 0.223 | 0.175 | 0.181 | 0.148 | 0.067 |
| When $k_1 < k_{10}$, | $k_{1m} =$ | 0.198 | 0.080 | 0.039 | 0.000 | 0.057 |
| When $d_1 \geq d_{10}$, | $d_{1m}$ (nm) $=$ | 25.447 | 21.108 | 19.487 | 19.257 | 157.441 |
| When $d_1 < d_{10}$, | $d_{1m}$ (nm) $=$ | 22.431 | 16.482 | 12.133 | 10.346 | 149.670 |
| When $n_2 \geq n_{20}$, | $n_{2m} =$ | 1.937 | 1.752 | 1.753 | 1.817 | 1.727 |
| When $n_2 < n_{20}$, | $n_{2m} =$ | 1.871 | 1.605 | 1.576 | 1.616 | 1.695 |
| When $k_2 \geq k_{20}$, | $k_{2m} =$ | 0.813 | 0.464 | 0.362 | 0.326 | 0.187 |
| When $k_2 < k_{20}$, | $k_{2m} =$ | 0.724 | 0.351 | 0.237 | 0.188 | 0.173 |
| When $d_2 \geq d_{20}$, | $d_{2m}$ (nm) $=$ | 58.954 | ∞ | ∞ | ∞ | 254.885 |
| When $d_2 < d_{20}$, | $d_{2m}$ (nm) $=$ | 51.905 | 103.951 | 122.545 | 158.102 | 231.812 |

1. 2 < N A ≤ 1. 3
4 5 < T ≤ 5 5

| Case | 5–06 | 5–07 | 5–08 |
|---|---|---|---|
| $n_{10}$ | 1.699 | 1.695 | 1.704 |
| $k_{10}$ | 0.072 | 0.060 | 0.054 |
| $d_{10}$ (nm) | 204.994 | 219.095 | 283.255 |
| $n_{20}$ | 1.688 | 1.689 | 1.689 |
| $k_{20}$ | 0.231 | 0.188 | 0.189 |
| $d_{20}$ (nm) | 192.230 | 228.102 | 224.255 |

| | | 5–06 | 5–07 | 5–08 |
|---|---|---|---|---|
| When $n_1 \geq n_{10}$, | $n_{1m} =$ | 1.718 | 1.729 | 1.749 |
| When $n_1 < n_{10}$, | $n_{1m} =$ | 1.682 | 1.663 | 1.676 |
| When $k_1 \geq k_{10}$, | $k_{1m} =$ | 0.096 | 0.102 | 0.091 |
| When $k_1 < k_{10}$, | $k_{1m} =$ | 0.048 | 0.030 | 0.025 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 194.149 | 195.371 | 190.682 |
| When $n_2 \geq n_{20}$, | $n_{2m} =$ | 1.788 | 1.929 | 1.898 |
| When $n_2 < n_{20}$, | $n_{2m} =$ | 1.641 | 1.601 | 1.530 |
| When $k_2 \geq k_{20}$, | $k_{2m} =$ | 0.326 | 0.290 | 0.362 |
| When $k_2 < k_{20}$, | $k_{2m} =$ | 0.165 | 0.127 | 0.117 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 176.978 | 195.845 | 153.544 |

1．2＜NA≦1．3

5 5＜T≦6 5

| Case | 6-01 | 6-02 | 6-03 | 6-04 | 6-05 |
|---|---|---|---|---|---|
| $n_{10}$ | 1.895 | 1.882 | 1.690 | 1.701 | 1.693 |
| $k_{10}$ | 0.076 | 0.126 | 0.068 | 0.084 | 0.070 |
| $d_{10}$ (nm) | 13.537 | 14.752 | 155.845 | 206.275 | 221.382 |
| $n_{20}$ | 1.753 | 1.688 | 1.693 | 1.686 | 1.667 |
| $k_{20}$ | 0.262 | 0.309 | 0.181 | 0.310 | 0.231 |
| $d_{20}$ (nm) | 223.848 | 174.672 | 224.616 | 122.505 | 161.928 |

| | | 6-01 | 6-02 | 6-03 | 6-04 | 6-05 |
|---|---|---|---|---|---|---|
| When $n_1 \geq n_{10}$, | $n_{1m}=$ | 1.983 | 1.956 | 1.691 | 1.703 | 1.726 |
| When $n_1 < n_{10}$, | $n_{1m}=$ | 1.846 | 1.842 | 1.680 | 1.695 | 1.686 |
| When $k_1 \geq k_{10}$, | $k_{1m}=$ | 0.143 | 0.185 | 0.071 | 0.096 | 0.105 |
| When $k_1 < k_{10}$, | $k_{1m}=$ | 0.000 | 0.045 | 0.054 | 0.076 | 0.063 |
| When $d_1 \geq d_{10}$, | $d_{1m}$ (nm) $=$ | 19.333 | 19.661 | 156.188 | 207.561 | 253.974 |
| When $d_1 < d_{10}$, | $d_{1m}$ (nm) $=$ | 10.604 | 12.234 | 149.873 | 203.306 | 217.847 |
| When $n_2 \geq n_{20}$, | $n_{2m}=$ | 1.828 | 1.751 | 1.713 | 1.791 | 1.691 |
| When $n_2 < n_{20}$, | $n_{2m}=$ | 1.623 | 1.571 | 1.692 | 1.682 | 1.585 |
| When $k_2 \geq k_{20}$, | $k_{2m}=$ | 0.332 | 0.365 | 0.184 | 0.352 | 0.284 |
| When $k_2 < k_{20}$, | $k_{2m}=$ | 0.191 | 0.239 | 0.171 | 0.280 | 0.201 |
| When $d_2 \geq d_{20}$, | $d_{2m}$ (nm) $=$ | ∞ | ∞ | 244.114 | 149.549 | 170.132 |
| When $d_2 < d_{20}$, | $d_{2m}$ (nm) $=$ | 146.194 | 124.203 | 224.269 | 121.948 | 139.231 |

1．2＜NA≦1．3

5 5＜T≦6 5

| Case | 6-06 | 6-07 | 6-08 |
|---|---|---|---|
| $n_{10}$ | 1.695 | 1.695 | 1.703 |
| $k_{10}$ | 0.060 | 0.055 | 0.049 |
| $d_{10}$ (nm) | 218.851 | 215.764 | 278.302 |
| $n_{20}$ | 1.689 | 1.693 | 1.691 |
| $k_{20}$ | 0.190 | 0.162 | 0.159 |
| $d_{20}$ (nm) | 218.129 | 277.062 | 273.241 |

| | | 6-06 | 6-07 | 6-08 |
|---|---|---|---|---|
| When $n_1 \geq n_{10}$, | $n_{1m}=$ | 1.726 | 1.740 | 1.751 |
| When $n_1 < n_{10}$, | $n_{1m}=$ | 1.665 | 1.662 | 1.653 |
| When $k_1 \geq k_{10}$, | $k_{1m}=$ | 0.102 | 0.097 | 0.092 |
| When $k_1 < k_{10}$, | $k_{1m}=$ | 0.031 | 0.021 | 0.015 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 196.531 | 170.235 | 166.884 |
| When $n_2 \geq n_{20}$, | $n_{2m}=$ | 1.935 | 1.919 | 1.925 |
| When $n_2 < n_{20}$, | $n_{2m}=$ | 1.606 | 1.543 | 1.498 |
| When $k_2 \geq k_{20}$, | $k_{2m}=$ | 0.294 | 0.280 | 0.278 |
| When $k_2 < k_{20}$, | $k_{2m}=$ | 0.130 | 0.102 | 0.095 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 191.652 | 197.142 | 190.724 |

1. 2 < N A ≤ 1. 3
6 5 < T ≤ 7 5

| Case | 7-01 | 7-02 | 7-03 | 7-04 | 7-05 |
|---|---|---|---|---|---|
| $n_{10}$ | 1.881 | 1.879 | 1.898 | 1.873 | 1.715 |
| $k_{10}$ | 0.189 | 0.125 | 0.073 | 0.092 | 0.067 |
| $d_{10}$ (nm) | 17.242 | 15.444 | 14.029 | 12.003 | 99.925 |
| $n_{20}$ | 1.617 | 1.697 | 1.767 | 1.696 | 1.686 |
| $k_{20}$ | 0.409 | 0.320 | 0.271 | 0.218 | 0.167 |
| $d_{20}$ (nm) | 111.921 | 162.536 | 211.582 | 280.785 | 269.056 |

| | | 7-01 | 7-02 | 7-03 | 7-04 | 7-05 |
|---|---|---|---|---|---|---|
| When $n_1 \geq n_{10}$, | $n_{1m}=$ | 1.933 | 1.953 | 1.985 | 1.975 | 1.746 |
| When $n_1 < n_{10}$, | $n_{1m}=$ | 1.873 | 1.839 | 1.852 | 1.816 | 1.710 |
| When $k_1 \geq k_{10}$, | $k_{1m}=$ | 0.202 | 0.184 | 0.136 | 0.174 | 0.081 |
| When $k_1 < k_{10}$, | $k_{1m}=$ | 0.122 | 0.046 | 0.000 | 0.000 | 0.037 |
| When $d_1 \geq d_{10}$, | $d_{1m}$ (nm) $=$ | 20.550 | 20.523 | 19.818 | 18.551 | 136.285 |
| When $d_1 < d_{10}$, | $d_{1m}$ (nm) $=$ | 16.700 | 12.791 | 11.204 | 8.554 | 98.008 |
| When $n_2 \geq n_{20}$, | $n_{2m}=$ | 1.633 | 1.761 | 1.845 | 1.780 | 1.699 |
| When $n_2 < n_{20}$, | $n_{2m}=$ | 1.511 | 1.579 | 1.638 | 1.585 | 1.620 |
| When $k_2 \geq k_{20}$, | $k_{2m}=$ | 0.430 | 0.380 | 0.344 | 0.283 | 0.175 |
| When $k_2 < k_{20}$, | $k_{2m}=$ | 0.344 | 0.246 | 0.196 | 0.150 | 0.131 |
| When $d_2 \geq d_{20}$, | $d_{2m}$ (nm) $=$ | ∞ | ∞ | ∞ | ∞ | 278.211 |
| When $d_2 < d_{20}$, | $d_{2m}$ (nm) $=$ | 91.266 | 127.980 | 136.666 | 158.294 | 243.285 |

1. 2 < N A ≤ 1. 3
6 5 < T ≤ 7 5

| Case | 7-06 | 7-07 | 7-08 |
|---|---|---|---|
| $n_{10}$ | 1.693 | 1.695 | 1.695 |
| $k_{10}$ | 0.070 | 0.061 | 0.055 |
| $d_{10}$ (nm) | 221.230 | 218.569 | 215.552 |
| $n_{20}$ | 1.668 | 1.689 | 1.692 |
| $k_{20}$ | 0.236 | 0.193 | 0.164 |
| $d_{20}$ (nm) | 151.884 | 208.598 | 267.637 |

| | | 7-06 | 7-07 | 7-08 |
|---|---|---|---|---|
| When $n_1 \geq n_{10}$, | $n_{1m}=$ | 1.724 | 1.724 | 1.741 |
| When $n_1 < n_{10}$, | $n_{1m}=$ | 1.686 | 1.666 | 1.661 |
| When $k_1 \geq k_{10}$, | $k_{1m}=$ | 0.105 | 0.101 | 0.097 |
| When $k_1 < k_{10}$, | $k_{1m}=$ | 0.064 | 0.031 | 0.021 |
| When $d_1 \geq d_{10}$, | $d_{1m}$ (nm) $=$ | 247.645 | ∞ | ∞ |
| When $d_1 < d_{10}$, | $d_{1m}$ (nm) $=$ | 218.101 | 197.493 | 171.385 |
| When $n_2 \geq n_{20}$, | $n_{2m}=$ | 1.689 | 1.934 | 1.918 |
| When $n_2 < n_{20}$, | $n_{2m}=$ | 1.586 | 1.609 | 1.542 |
| When $k_2 \geq k_{20}$, | $k_{2m}=$ | 0.286 | 0.296 | 0.281 |
| When $k_2 < k_{20}$, | $k_{2m}=$ | 0.205 | 0.130 | 0.101 |
| When $d_2 \geq d_{20}$, | $d_{2m}$ (nm) $=$ | 159.193 | ∞ | ∞ |
| When $d_2 < d_{20}$, | $d_{2m}$ (nm) $=$ | 130.698 | 183.027 | 188.504 |

1. 2 < N A ≤ 1. 3
7 5 < T ≤ 8 5

| Case | 8-01 | 8-02 | 8-03 | 8-04 | 8-05 |
|---|---|---|---|---|---|
| $n_{10}$ | 1.880 | 1.901 | 1.874 | 1.716 | 1.692 |
| $k_{10}$ | 0.126 | 0.074 | 0.095 | 0.068 | 0.072 |
| $d_{10}$ (nm) | 16.279 | 14.624 | 12.218 | 99.848 | 220.366 |
| $n_{20}$ | 1.709 | 1.778 | 1.694 | 1.687 | 1.668 |
| $k_{20}$ | 0.340 | 0.284 | 0.225 | 0.173 | 0.244 |
| $d_{20}$ (nm) | 151.148 | 201.087 | 271.916 | 259.863 | 143.647 |

| | | 8-01 | 8-02 | 8-03 | 8-04 | 8-05 |
|---|---|---|---|---|---|---|
| When $n_1 \geq n_{10}$, | $n_{1m} =$ | 1.951 | 1.984 | 1.974 | 1.746 | 1.725 |
| When $n_1 < n_{10}$, | $n_{1m} =$ | 1.842 | 1.857 | 1.818 | 1.712 | 1.688 |
| When $k_1 \geq k_{10}$, | $k_{1m} =$ | 0.181 | 0.134 | 0.175 | 0.079 | 0.106 |
| When $k_1 < k_{10}$, | $k_{1m} =$ | 0.048 | 0.000 | 0.000 | 0.042 | 0.068 |
| When $d_1 \geq d_{10}$, | $d_{1m}$ (nm) $=$ | 21.358 | 20.311 | 18.650 | 135.917 | 245.491 |
| When $d_1 < d_{10}$, | $d_{1m}$ (nm) $=$ | 13.627 | 11.922 | 8.869 | 98.660 | 218.637 |
| When $n_2 \geq n_{20}$, | $n_{2m} =$ | 1.774 | 1.856 | 1.776 | 1.696 | 1.688 |
| When $n_2 < n_{20}$, | $n_{2m} =$ | 1.592 | 1.651 | 1.582 | 1.624 | 1.581 |
| When $k_2 \geq k_{20}$, | $k_{2m} =$ | 0.403 | 0.360 | 0.289 | 0.178 | 0.280 |
| When $k_2 < k_{20}$, | $k_{2m} =$ | 0.263 | 0.208 | 0.157 | 0.137 | 0.214 |
| When $d_2 \geq d_{20}$, | $d_{2m}$ (nm) $=$ | ∞ | ∞ | ∞ | 265.927 | 149.336 |
| When $d_2 < d_{20}$, | $d_{2m}$ (nm) $=$ | 123.537 | 130.884 | 183.486 | 237.438 | 121.404 |

1. 2 < N A ≤ 1. 3
7 5 < T ≤ 8 5

| Case | 8-06 | 8-07 |
|---|---|---|
| $n_{10}$ | 1.695 | 1.695 |
| $k_{10}$ | 0.062 | 0.056 |
| $d_{10}$ (nm) | 218.447 | 215.754 |
| $n_{20}$ | 1.688 | 1.691 |
| $k_{20}$ | 0.198 | 0.167 |
| $d_{20}$ (nm) | 200.044 | 258.621 |

| | | 8-06 | 8-07 |
|---|---|---|---|
| When $n_1 \geq n_{10}$, | $n_{1m} =$ | 1.724 | 1.740 |
| When $n_1 < n_{10}$, | $n_{1m} =$ | 1.667 | 1.661 |
| When $k_1 \geq k_{10}$, | $k_{1m} =$ | 0.102 | 0.097 |
| When $k_1 < k_{10}$, | $k_{1m} =$ | 0.033 | 0.022 |
| When $d_1 \geq d_{10}$, | $d_{1m}$ (nm) $=$ | ∞ | ∞ |
| When $d_1 < d_{10}$, | $d_{1m}$ (nm) $=$ | 198.178 | 171.868 |
| When $n_2 \geq n_{20}$, | $n_{2m} =$ | 1.931 | 1.916 |
| When $n_2 < n_{20}$, | $n_{2m} =$ | 1.605 | 1.542 |
| When $k_2 \geq k_{20}$, | $k_{2m} =$ | 0.296 | 0.282 |
| When $k_2 < k_{20}$, | $k_{2m} =$ | 0.132 | 0.105 |
| When $d_2 \geq d_{20}$, | $d_{2m}$ (nm) $=$ | ∞ | ∞ |
| When $d_2 < d_{20}$, | $d_{2m}$ (nm) $=$ | 172.147 | 178.623 |

1. 2 < N A ≤ 1. 3
8 5 < T ≤ 9 5

| Case | | 9-01 | 9-02 | 9-03 | 9-04 | 9-05 |
|---|---|---|---|---|---|---|
| $n_{10}$ | | 1.888 | 1.903 | 1.880 | 1.693 | 1.695 |
| $k_{10}$ | | 0.130 | 0.081 | 0.095 | 0.063 | 0.064 |
| $d_{10}$ (nm) | | 16.763 | 14.911 | 12.432 | 156.037 | 218.418 |
| $n_{20}$ | | 1.718 | 1.775 | 1.700 | 1.696 | 1.685 |
| $k_{20}$ | | 0.366 | 0.299 | 0.236 | 0.165 | 0.207 |
| $d_{20}$ (nm) | | 141.793 | 193.492 | 262.434 | 252.531 | 192.031 |

| | | 9-01 | 9-02 | 9-03 | 9-04 | 9-05 |
|---|---|---|---|---|---|---|
| When $n_1 \geq n_{10}$, | $n_{1m} =$ | 1.955 | 1.983 | 1.976 | 1.693 | 1.725 |
| When $n_1 < n_{10}$, | $n_{1m} =$ | 1.853 | 1.862 | 1.827 | 1.659 | 1.667 |
| When $k_1 \geq k_{10}$, | $k_{1m} =$ | 0.178 | 0.137 | 0.171 | 0.071 | 0.102 |
| When $k_1 < k_{10}$, | $k_{1m} =$ | 0.053 | 0.000 | 0.000 | 0.062 | 0.036 |
| When $d_1 \geq d_{10}$, | $d_{1m}$ (nm) $=$ | 21.482 | 20.338 | 18.582 | 156.116 | 252.664 |
| When $d_1 < d_{10}$, | $d_{1m}$ (nm) $=$ | 14.427 | 12.369 | 9.315 | 108.678 | 198.579 |
| When $n_2 \geq n_{20}$, | $n_{2m} =$ | 1.777 | 1.851 | 1.779 | 1.766 | 1.934 |
| When $n_2 < n_{20}$, | $n_{2m} =$ | 1.605 | 1.653 | 1.583 | 1.688 | 1.600 |
| When $k_2 \geq k_{20}$, | $k_{2m} =$ | 0.429 | 0.373 | 0.299 | 0.166 | 0.298 |
| When $k_2 < k_{20}$, | $k_{2m} =$ | 0.289 | 0.223 | 0.167 | 0.129 | 0.138 |
| When $d_2 \geq d_{20}$, | $d_{2m}$ (nm) $=$ | ∞ | ∞ | ∞ | 252.906 | ∞ |
| When $d_2 < d_{20}$, | $d_{2m}$ (nm) $=$ | 118.585 | 127.262 | 178.673 | 249.872 | 164.058 |

1. 2 < N A ≤ 1. 3
8 5 < T ≤ 9 5

| Case | | 9-06 | 9-07 |
|---|---|---|---|
| $n_{10}$ | | 1.695 | 1.704 |
| $k_{10}$ | | 0.057 | 0.051 |
| $d_{10}$ (nm) | | 216.093 | 278.289 |
| $n_{20}$ | | 1.691 | 1.691 |
| $k_{20}$ | | 0.173 | 0.173 |
| $d_{20}$ (nm) | | 249.945 | 246.105 |

| | | 9-06 | 9-07 |
|---|---|---|---|
| When $n_1 \geq n_{10}$, | $n_{1m} =$ | 1.738 | 1.752 |
| When $n_1 < n_{10}$, | $n_{1m} =$ | 1.662 | 1.653 |
| When $k_1 \geq k_{10}$, | $k_{1m} =$ | 0.098 | 0.092 |
| When $k_1 < k_{10}$, | $k_{1m} =$ | 0.022 | 0.016 |
| When $d_1 \geq d_{10}$, | $d_{1m}$ (nm) $=$ | ∞ | ∞ |
| When $d_1 < d_{10}$, | $d_{1m}$ (nm) $=$ | 175.267 | 172.533 |
| When $n_2 \geq n_{20}$, | $n_{2m} =$ | 1.919 | 1.830 |
| When $n_2 < n_{20}$, | $n_{2m} =$ | 1.543 | 1.507 |
| When $k_2 \geq k_{20}$, | $k_{2m} =$ | 0.284 | 0.291 |
| When $k_2 < k_{20}$, | $k_{2m} =$ | 0.111 | 0.108 |
| When $d_2 \geq d_{20}$, | $d_{2m}$ (nm) $=$ | ∞ | ∞ |
| When $d_2 < d_{20}$, | $d_{2m}$ (nm) $=$ | 173.633 | 172.262 |

1．2＜NA≦1．3
95＜T≦105

| Case | 10-01 | 10-02 | 10-03 | 10-04 | 10-05 |
|---|---|---|---|---|---|
| $n_{10}$ | 1.902 | 1.906 | 1.888 | 1.694 | 1.695 |
| $k_{10}$ | 0.140 | 0.093 | 0.096 | 0.066 | 0.059 |
| $d_{10}$ (nm) | 16.621 | 14.821 | 12.503 | 218.392 | 216.276 |
| $n_{20}$ | 1.717 | 1.761 | 1.706 | 1.682 | 1.691 |
| $k_{20}$ | 0.393 | 0.312 | 0.247 | 0.217 | 0.180 |
| $d_{20}$ (nm) | 134.110 | 187.587 | 253.021 | 183.765 | 241.184 |

| | | 10-01 | 10-02 | 10-03 | 10-04 | 10-05 |
|---|---|---|---|---|---|---|
| When $n_1 \geq n_{10}$, | $n_{1m}=$ | 1.964 | 1.983 | 1.982 | 1.725 | 1.737 |
| When $n_1 < n_{10}$, | $n_{1m}=$ | 1.874 | 1.867 | 1.838 | 1.666 | 1.663 |
| When $k_1 \geq k_{10}$, | $k_{1m}=$ | 0.179 | 0.146 | 0.168 | 0.103 | 0.098 |
| When $k_1 < k_{10}$, | $k_{1m}=$ | 0.062 | 0.004 | 0.000 | 0.041 | 0.024 |
| When $d_1 \geq d_{10}$, | $d_{1m}$ (nm) $=$ | 20.729 | 19.885 | 18.297 | 250.100 | ∞ |
| When $d_1 < d_{10}$, | $d_{1m}$ (nm) $=$ | 14.862 | 12.520 | 9.652 | 198.830 | 185.832 |
| When $n_2 \geq n_{20}$, | $n_{2m}=$ | 1.767 | 1.831 | 1.783 | 1.944 | 1.927 |
| When $n_2 < n_{20}$, | $n_{2m}=$ | 1.609 | 1.641 | 1.584 | 1.598 | 1.559 |
| When $k_2 \geq k_{20}$, | $k_{2m}=$ | 0.449 | 0.380 | 0.309 | 0.303 | 0.288 |
| When $k_2 < k_{20}$, | $k_{2m}=$ | 0.320 | 0.238 | 0.178 | 0.149 | 0.117 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 113.506 | 124.690 | 172.558 | 157.077 | 167.184 |

1．2＜NA≦1．3
95＜T≦105

| Case | 10-06 |
|---|---|
| $n_{10}$ | 1.704 |
| $k_{10}$ | 0.052 |
| $d_{10}$ (nm) | 278.098 |
| $n_{20}$ | 1.689 |
| $k_{20}$ | 0.180 |
| $d_{20}$ (nm) | 237.690 |

| | | 10-06 |
|---|---|---|
| When $n_1 \geq n_{10}$, | $n_{1m}=$ | 1.752 |
| When $n_1 < n_{10}$, | $n_{1m}=$ | 1.658 |
| When $k_1 \geq k_{10}$, | $k_{1m}=$ | 0.091 |
| When $k_1 < k_{10}$, | $k_{1m}=$ | 0.019 |
| When $d_1 \geq d_{10}$, | $d_{1m}$ (nm) $=$ | ∞ |
| When $d_1 < d_{10}$, | $d_{1m}$ (nm) $=$ | 180.136 |
| When $n_2 \geq n_{20}$, | $n_{2m}=$ | 1.847 |
| When $n_2 < n_{20}$, | $n_{2m}=$ | 1.512 |
| When $k_2 \geq k_{20}$, | $k_{2m}=$ | 0.296 |
| When $k_2 < k_{20}$, | $k_{2m}=$ | 0.113 |
| When $d_2 \geq d_{20}$, | $d_{2m}$ (nm) $=$ | ∞ |
| When $d_2 < d_{20}$, | $d_{2m}$ (nm) $=$ | 165.978 |

1. 2 < N A ≤ 1. 3
1 0 5 < T ≤ 1 1 5

| Case | 11-01 | 11-02 | 11-03 | 11-04 | 11-05 |
|---|---|---|---|---|---|
| $n_{10}$ | 1.915 | 1.908 | 1.895 | 1.692 | 1.694 |
| $k_{10}$ | 0.153 | 0.105 | 0.097 | 0.060 | 0.068 |
| $d_{10}$ (nm) | 15.972 | 14.452 | 12.386 | 153.833 | 218.491 |
| $n_{20}$ | 1.700 | 1.741 | 1.708 | 1.696 | 1.679 |
| $k_{20}$ | 0.410 | 0.319 | 0.254 | 0.152 | 0.227 |
| $d_{20}$ (nm) | 128.035 | 181.864 | 244.026 | 294.292 | 174.638 |

| | | 11-01 | 11-02 | 11-03 | 11-04 | 11-05 |
|---|---|---|---|---|---|---|
| When $n_1 \geq n_{10}$, | $n_{1m} =$ | 1.973 | 1.983 | 1.987 | 1.719 | 1.723 |
| When $n_1 < n_{10}$, | $n_{1m} =$ | 1.893 | 1.872 | 1.847 | 1.655 | 1.669 |
| When $k_1 \geq k_{10}$, | $k_{1m} =$ | 0.185 | 0.156 | 0.167 | 0.093 | 0.104 |
| When $k_1 < k_{10}$, | $k_{1m} =$ | 0.078 | 0.017 | 0.000 | 0.039 | 0.045 |
| When $d_1 \geq d_{10}$, | $d_{1m}$ (nm) = | 19.455 | 19.144 | 17.845 | ∞ | 247.764 |
| When $d_1 < d_{10}$, | $d_{1m}$ (nm) = | 14.744 | 12.421 | 9.756 | 107.765 | 205.861 |
| When $n_2 \geq n_{20}$, | $n_{2m} =$ | 1.741 | 1.806 | 1.782 | 1.782 | 1.753 |
| When $n_2 < n_{20}$, | $n_{2m} =$ | 1.596 | 1.623 | 1.583 | 1.640 | 1.603 |
| When $k_2 \geq k_{20}$, | $k_{2m} =$ | 0.453 | 0.379 | 0.315 | 0.185 | 0.311 |
| When $k_2 < k_{20}$, | $k_{2m} =$ | 0.345 | 0.249 | 0.187 | 0.106 | 0.163 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 107.965 | 122.284 | 164.682 | 240.729 | 150.727 |

1. 2 < N A ≤ 1. 3
1 0 5 < T ≤ 1 1 5

| Case | 11-06 | 11-07 |
|---|---|---|
| $n_{10}$ | 1.695 | 1.705 |
| $k_{10}$ | 0.060 | 0.054 |
| $d_{10}$ (nm) | 216.291 | 277.828 |
| $n_{20}$ | 1.691 | 1.688 |
| $k_{20}$ | 0.187 | 0.185 |
| $d_{20}$ (nm) | 231.949 | 228.622 |

| | | 11-06 | 11-07 |
|---|---|---|---|
| When $n_1 \geq n_{10}$, | $n_{1m} =$ | 1.736 | 1.751 |
| When $n_1 < n_{10}$, | $n_{1m} =$ | 1.664 | 1.660 |
| When $k_1 \geq k_{10}$, | $k_{1m} =$ | 0.099 | 0.091 |
| When $k_1 < k_{10}$, | $k_{1m} =$ | 0.026 | 0.021 |
| When $d_1 \geq d_{10}$, | $d_{1m}$ (nm) = | ∞ | ∞ |
| When $d_1 < d_{10}$, | $d_{1m}$ (nm) = | 188.964 | 182.620 |
| When $n_2 \geq n_{20}$, | $n_{2m} =$ | 1.938 | 1.860 |
| When $n_2 < n_{20}$, | $n_{2m} =$ | 1.577 | 1.505 |
| When $k_2 \geq k_{20}$, | $k_{2m} =$ | 0.293 | 0.298 |
| When $k_2 < k_{20}$, | $k_{2m} =$ | 0.122 | 0.117 |
| When $d_2 \geq d_{20}$, | $d_{2m}$ (nm) = | ∞ | ∞ |
| When $d_2 < d_{20}$, | $d_{2m}$ (nm) = | 190.206 | 157.223 |

1. 2 < N A ≤ 1. 3
1 1 5 < T ≤ 1 2 5

| Case | 12-01 | 12-02 | 12-03 | 12-04 | 12-05 |
|---|---|---|---|---|---|
| $n_{10}$ | 1.919 | 1.909 | 1.897 | 1.692 | 1.694 |
| $k_{10}$ | 0.168 | 0.114 | 0.102 | 0.061 | 0.069 |
| $d_{10}$ (nm) | 15.470 | 14.219 | 12.252 | 153.490 | 218.807 |
| $n_{20}$ | 1.675 | 1.728 | 1.703 | 1.695 | 1.679 |
| $k_{20}$ | 0.416 | 0.323 | 0.257 | 0.154 | 0.236 |
| $d_{20}$ (nm) | 121.998 | 174.431 | 235.332 | 285.775 | 164.294 |

| When $n_1 \geq n_{10}$, $n_{1m} =$ | 1.974 | 1.983 | 1.989 | 1.719 | 1.720 |
|---|---|---|---|---|---|
| When $n_1 < n_{10}$, $n_{1m} =$ | 1.903 | 1.876 | 1.851 | 1.657 | 1.674 |
| When $k_1 \geq k_{10}$, $k_{1m} =$ | 0.194 | 0.163 | 0.171 | 0.093 | 0.104 |
| When $k_1 < k_{10}$, $k_{1m} =$ | 0.095 | 0.028 | 0.000 | 0.043 | 0.048 |
| When $d_1 \geq d_{10}$, $d_{1m}$ (nm) $=$ | 18.537 | 18.641 | 17.506 | 176.125 | 245.819 |
| When $d_1 < d_{10}$, $d_{1m}$ (nm) $=$ | 14.577 | 12.379 | 9.747 | 108.056 | 210.037 |
| When $n_2 \geq n_{20}$, $n_{2m} =$ | 1.708 | 1.790 | 1.776 | 1.773 | 1.745 |
| When $n_2 < n_{20}$, $n_{2m} =$ | 1.572 | 1.608 | 1.579 | 1.640 | 1.616 |
| When $k_2 \geq k_{20}$, $k_{2m} =$ | 0.448 | 0.378 | 0.316 | 0.184 | 0.323 |
| When $k_2 < k_{20}$, $k_{2m} =$ | 0.357 | 0.255 | 0.190 | 0.115 | 0.176 |
| When $d_2 \geq d_{20}$, $d_{2m}$ (nm) $=$ | ∞ | ∞ | ∞ | ∞ | ∞ |
| When $d_2 < d_{20}$, $d_{2m}$ (nm) $=$ | 99.374 | 118.240 | 154.295 | 239.447 | 146.164 |

1. 2 < N A ≤ 1. 3
1 1 5 < T ≤ 1 2 5

| Case | 12-06 | 12-07 | 12-08 |
|---|---|---|---|
| $n_{10}$ | 1.695 | 1.696 | 1.706 |
| $k_{10}$ | 0.061 | 0.056 | 0.051 |
| $d_{10}$ (nm) | 216.166 | 214.076 | 276.333 |
| $n_{20}$ | 1.690 | 1.694 | 1.706 |
| $k_{20}$ | 0.192 | 0.163 | 0.162 |
| $d_{20}$ (nm) | 222.296 | 280.805 | 273.925 |

| When $n_1 \geq n_{10}$, $n_{1m} =$ | 1.728 | 1.750 | 1.770 |
|---|---|---|---|
| When $n_1 < n_{10}$, $n_{1m} =$ | 1.664 | 1.664 | 1.647 |
| When $k_1 \geq k_{10}$, $k_{1m} =$ | 0.099 | 0.099 | 0.090 |
| When $k_1 < k_{10}$, $k_{1m} =$ | 0.029 | 0.023 | 0.020 |
| When $d_1 \geq d_{10}$, $d_{1m}$ (nm) $=$ | ∞ | ∞ | ∞ |
| When $d_1 < d_{10}$, $d_{1m}$ (nm) $=$ | 190.492 | 185.642 | 181.694 |
| When $n_2 \geq n_{20}$, $n_{2m} =$ | 1.826 | 1.931 | 1.851 |
| When $n_2 < n_{20}$, $n_{2m} =$ | 1.594 | 1.560 | 1.519 |
| When $k_2 \geq k_{20}$, $k_{2m} =$ | 0.297 | 0.283 | 0.279 |
| When $k_2 < k_{20}$, $k_{2m} =$ | 0.128 | 0.103 | 0.095 |
| When $d_2 \geq d_{20}$, $d_{2m}$ (nm) $=$ | ∞ | ∞ | ∞ |
| When $d_2 < d_{20}$, $d_{2m}$ (nm) $=$ | 188.671 | 203.385 | 188.718 |

1. 2 < N A ≤ 1. 3
1 2 5 < T ≤ 1 3 5

| Case | 13-01 | 13-02 | 13-03 | 13-04 | 13-05 |
|---|---|---|---|---|---|
| $n_{10}$ | 1.909 | 1.895 | 1.879 | 1.694 | 1.695 |
| $k_{10}$ | 0.116 | 0.106 | 0.083 | 0.071 | 0.063 |
| $d_{10}$ (nm) | 14.671 | 12.483 | 11.828 | 219.020 | 215.746 |
| $n_{20}$ | 1.733 | 1.700 | 1.710 | 1.682 | 1.690 |
| $k_{20}$ | 0.334 | 0.261 | 0.220 | 0.245 | 0.197 |
| $d_{20}$ (nm) | 163.102 | 225.249 | 280.433 | 153.670 | 212.983 |

| | | 13-01 | 13-02 | 13-03 | 13-04 | 13-05 |
|---|---|---|---|---|---|---|
| When $n_1 \geq n_{10}$, | $n_{1m} =$ | 1.981 | 1.985 | 1.982 | 1.717 | 1.723 |
| When $n_1 < n_{10}$, | $n_{1m} =$ | 1.878 | 1.850 | 1.819 | 1.677 | 1.665 |
| When $k_1 \geq k_{10}$, | $k_{1m} =$ | 0.162 | 0.173 | 0.169 | 0.103 | 0.099 |
| When $k_1 < k_{10}$, | $k_{1m} =$ | 0.035 | 0.004 | 0.000 | 0.051 | 0.034 |
| When $d_1 \geq d_{10}$, | $d_{1m}$ (nm) $=$ | 19.040 | 17.738 | 18.242 | 233.783 | ∞ |
| When $d_1 < d_{10}$, | $d_{1m}$ (nm) $=$ | 12.910 | 9.987 | 8.329 | 211.731 | 191.269 |
| When $n_2 \geq n_{20}$, | $n_{2m} =$ | 1.795 | 1.771 | 1.785 | 1.724 | 1.797 |
| When $n_2 < n_{20}$, | $n_{2m} =$ | 1.610 | 1.575 | 1.592 | 1.634 | 1.609 |
| When $k_2 \geq k_{20}$, | $k_{2m} =$ | 0.389 | 0.319 | 0.285 | 0.337 | 0.302 |
| When $k_2 < k_{20}$, | $k_{2m} =$ | 0.261 | 0.192 | 0.153 | 0.187 | 0.133 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 109.327 | 144.773 | 164.318 | 140.585 | 192.523 |

1. 2 < N A ≤ 1. 3
1 2 5 < T ≤ 1 3 5

| Case | 13-06 | 13-07 |
|---|---|---|
| $n_{10}$ | 1.696 | 1.706 |
| $k_{10}$ | 0.057 | 0.052 |
| $d_{10}$ (nm) | 213.723 | 276.363 |
| $n_{20}$ | 1.693 | 1.706 |
| $k_{20}$ | 0.165 | 0.164 |
| $d_{20}$ (nm) | 271.596 | 264.087 |

| | | 13-06 | 13-07 |
|---|---|---|---|
| When $n_1 \geq n_{10}$, | $n_{1m} =$ | 1.749 | 1.772 |
| When $n_1 < n_{10}$, | $n_{1m} =$ | 1.664 | 1.645 |
| When $k_1 \geq k_{10}$, | $k_{1m} =$ | 0.099 | 0.090 |
| When $k_1 < k_{10}$, | $k_{1m} =$ | 0.026 | 0.022 |
| When $d_1 \geq d_{10}$, | $d_{1m}$ (nm) $=$ | ∞ | ∞ |
| When $d_1 < d_{10}$, | $d_{1m}$ (nm) $=$ | 186.782 | 182.830 |
| When $n_2 \geq n_{20}$, | $n_{2m} =$ | 1.934 | 1.851 |
| When $n_2 < n_{20}$, | $n_{2m} =$ | 1.561 | 1.521 |
| When $k_2 \geq k_{20}$, | $k_{2m} =$ | 0.285 | 0.282 |
| When $k_2 < k_{20}$, | $k_{2m} =$ | 0.104 | 0.097 |
| When $d_2 \geq d_{20}$, | $d_{2m}$ (nm) $=$ | ∞ | ∞ |
| When $d_2 < d_{20}$, | $d_{2m}$ (nm) $=$ | 198.444 | 183.298 |

1. 2 < N A ≤ 1. 3
1 3 5 < T ≤ 1 4 5

| Case | 14-01 | 14-02 | 14-03 | 14-04 | 14-05 |
|---|---|---|---|---|---|
| $n_{10}$ | 1.910 | 1.892 | 1.879 | 1.694 | 1.694 |
| $k_{10}$ | 0.115 | 0.109 | 0.084 | 0.072 | 0.064 |
| $d_{10}$ (nm) | 15.725 | 12.960 | 12.187 | 218.706 | 215.091 |
| $n_{20}$ | 1.755 | 1.698 | 1.712 | 1.684 | 1.689 |
| $k_{20}$ | 0.355 | 0.268 | 0.226 | 0.254 | 0.201 |
| $d_{20}$ (nm) | 150.207 | 215.505 | 270.397 | 144.577 | 204.614 |

| | | 14-01 | 14-02 | 14-03 | 14-04 | 14-05 |
|---|---|---|---|---|---|---|
| When $n_1 \geq n_{10}$, | $n_{1m} =$ | 1.980 | 1.980 | 1.979 | 1.708 | 1.720 |
| When $n_1 < n_{10}$, | $n_{1m} =$ | 1.881 | 1.848 | 1.820 | 1.676 | 1.666 |
| When $k_1 \geq k_{10}$, | $k_{1m} =$ | 0.157 | 0.174 | 0.167 | 0.100 | 0.099 |
| When $k_1 < k_{10}$, | $k_{1m} =$ | 0.036 | 0.011 | 0.000 | 0.054 | 0.038 |
| When $d_1 \geq d_{10}$, | $d_{1m}$ (nm) $=$ | 20.158 | 18.254 | 18.627 | 231.071 | ∞ |
| When $d_1 < d_{10}$, | $d_{1m}$ (nm) $=$ | 14.003 | 10.450 | 8.694 | 211.497 | 191.698 |
| When $n_2 \geq n_{20}$, | $n_{2m} =$ | 1.818 | 1.767 | 1.787 | 1.721 | 1.802 |
| When $n_2 < n_{20}$, | $n_{2m} =$ | 1.632 | 1.571 | 1.592 | 1.649 | 1.619 |
| When $k_2 \geq k_{20}$, | $k_{2m} =$ | 0.415 | 0.327 | 0.291 | 0.345 | 0.308 |
| When $k_2 < k_{20}$, | $k_{2m} =$ | 0.275 | 0.197 | 0.157 | 0.200 | 0.145 |
| When $d_2 \geq d_{20}$, | $d_{2m}$ (nm) $=$ | ∞ | ∞ | ∞ | 160.527 | ∞ |
| When $d_2 < d_{20}$, | $d_{2m}$ (nm) $=$ | 119.641 | 139.482 | 181.534 | 134.106 | 186.758 |

1. 2 < N A ≤ 1. 3
1 3 5 < T ≤ 1 4 5

| Case | 14-06 | 14-07 |
|---|---|---|
| $n_{10}$ | 1.696 | 1.706 |
| $k_{10}$ | 0.058 | 0.052 |
| $d_{10}$ (nm) | 213.482 | 276.472 |
| $n_{20}$ | 1.692 | 1.707 |
| $k_{20}$ | 0.169 | 0.168 |
| $d_{20}$ (nm) | 262.678 | 254.823 |

| | | 14-06 | 14-07 |
|---|---|---|---|
| When $n_1 \geq n_{10}$, | $n_{1m} =$ | 1.748 | 1.771 |
| When $n_1 < n_{10}$, | $n_{1m} =$ | 1.665 | 1.644 |
| When $k_1 \geq k_{10}$, | $k_{1m} =$ | 0.100 | 0.090 |
| When $k_1 < k_{10}$, | $k_{1m} =$ | 0.028 | 0.024 |
| When $d_1 \geq d_{10}$, | $d_{1m}$ (nm) $=$ | ∞ | ∞ |
| When $d_1 < d_{10}$, | $d_{1m}$ (nm) $=$ | 188.144 | 184.314 |
| When $n_2 \geq n_{20}$, | $n_{2m} =$ | 1.933 | 1.854 |
| When $n_2 < n_{20}$, | $n_{2m} =$ | 1.561 | 1.522 |
| When $k_2 \geq k_{20}$, | $k_{2m} =$ | 0.288 | 0.286 |
| When $k_2 < k_{20}$, | $k_{2m} =$ | 0.109 | 0.100 |
| When $d_2 \geq d_{20}$, | $d_{2m}$ (nm) $=$ | ∞ | ∞ |
| When $d_2 < d_{20}$, | $d_{2m}$ (nm) $=$ | 191.540 | 174.816 |

1. 2 < N A ≤ 1. 3
1 4 5 < T ≤ 1 5 5

| Case | 15-01 | 15-02 | 15-03 | 15-04 | 15-05 |
|---|---|---|---|---|---|
| $n_{10}$ | 1.919 | 1.893 | 1.882 | 1.694 | 1.694 |
| $k_{10}$ | 0.115 | 0.113 | 0.085 | 0.074 | 0.065 |
| $d_{10}$ (nm) | 16.638 | 13.413 | 12.438 | 217.741 | 214.737 |
| $n_{20}$ | 1.785 | 1.697 | 1.715 | 1.683 | 1.687 |
| $k_{20}$ | 0.385 | 0.281 | 0.235 | 0.264 | 0.207 |
| $d_{20}$ (nm) | 138.580 | 206.656 | 261.237 | 137.032 | 196.488 |

| | | 15-01 | 15-02 | 15-03 | 15-04 | 15-05 |
|---|---|---|---|---|---|---|
| When $n_1 \geq n_{10}$, | $n_{1m} =$ | 1.986 | 1.976 | 1.980 | 1.705 | 1.718 |
| When $n_1 < n_{10}$, | $n_{1m} =$ | 1.892 | 1.851 | 1.826 | 1.676 | 1.666 |
| When $k_1 \geq k_{10}$, | $k_{1m} =$ | 0.151 | 0.174 | 0.165 | 0.099 | 0.100 |
| When $k_1 < k_{10}$, | $k_{1m} =$ | 0.037 | 0.018 | 0.000 | 0.060 | 0.040 |
| When $d_1 \geq d_{10}$, | $d_{1m}$ (nm) $=$ | 20.946 | 18.588 | 18.692 | 227.547 | ∞ |
| When $d_1 < d_{10}$, | $d_{1m}$ (nm) $=$ | 15.073 | 10.996 | 9.087 | 210.480 | 192.120 |
| When $n_2 \geq n_{20}$, | $n_{2m} =$ | 1.846 | 1.763 | 1.789 | 1.722 | 1.834 |
| When $n_2 < n_{20}$, | $n_{2m} =$ | 1.665 | 1.571 | 1.591 | 1.652 | 1.629 |
| When $k_2 \geq k_{20}$, | $k_{2m} =$ | 0.451 | 0.339 | 0.301 | 0.337 | 0.312 |
| When $k_2 < k_{20}$, | $k_{2m} =$ | 0.301 | 0.209 | 0.166 | 0.217 | 0.151 |
| When $d_2 \geq d_{20}$, | $d_{2m}$ (nm) $=$ | ∞ | ∞ | ∞ | 149.574 | ∞ |
| When $d_2 < d_{20}$, | $d_{2m}$ (nm) $=$ | 113.921 | 135.398 | 177.745 | 128.876 | 178.069 |

1. 2 < N A ≤ 1. 3
1 4 5 < T ≤ 1 5 5

| Case | 15-06 | 15-07 |
|---|---|---|
| $n_{10}$ | 1.695 | 1.707 |
| $k_{10}$ | 0.059 | 0.053 |
| $d_{10}$ (nm) | 213.710 | 276.548 |
| $n_{20}$ | 1.692 | 1.707 |
| $k_{20}$ | 0.173 | 0.174 |
| $d_{20}$ (nm) | 253.675 | 246.168 |

| | | 15-06 | 15-07 |
|---|---|---|---|
| When $n_1 \geq n_{10}$, | $n_{1m} =$ | 1.747 | 1.770 |
| When $n_1 < n_{10}$, | $n_{1m} =$ | 1.665 | 1.645 |
| When $k_1 \geq k_{10}$, | $k_{1m} =$ | 0.100 | 0.089 |
| When $k_1 < k_{10}$, | $k_{1m} =$ | 0.029 | 0.025 |
| When $d_1 \geq d_{10}$, | $d_{1m}$ (nm) $=$ | ∞ | ∞ |
| When $d_1 < d_{10}$, | $d_{1m}$ (nm) $=$ | 189.864 | 185.926 |
| When $n_2 \geq n_{20}$, | $n_{2m} =$ | 1.910 | 1.858 |
| When $n_2 < n_{20}$, | $n_{2m} =$ | 1.562 | 1.520 |
| When $k_2 \geq k_{20}$, | $k_{2m} =$ | 0.289 | 0.291 |
| When $k_2 < k_{20}$, | $k_{2m} =$ | 0.109 | 0.103 |
| When $d_2 \geq d_{20}$, | $d_{2m}$ (nm) $=$ | ∞ | ∞ |
| When $d_2 < d_{20}$, | $d_{2m}$ (nm) $=$ | 189.584 | 169.414 |

1. 2 < N A ≤ 1. 3
1 5 5 < T ≤ 1 6 5

| Case | 16-01 | 16-02 | 16-03 | 16-04 | 16-05 |
|---|---|---|---|---|---|
| $n_{10}$ | 1.937 | 1.898 | 1.890 | 1.694 | 1.694 |
| $k_{10}$ | 0.118 | 0.119 | 0.087 | 0.077 | 0.067 |
| $d_{10}$ (nm) | 16.771 | 13.576 | 12.460 | 216.630 | 214.866 |
| $n_{20}$ | 1.806 | 1.695 | 1.718 | 1.679 | 1.684 |
| $k_{20}$ | 0.418 | 0.295 | 0.246 | 0.277 | 0.215 |
| $d_{20}$ (nm) | 129.251 | 198.434 | 252.589 | 129.875 | 188.027 |

| | | 16-01 | 16-02 | 16-03 | 16-04 | 16-05 |
|---|---|---|---|---|---|---|
| When $n_1 \geq n_{10}$, | $n_{1m} =$ | 2.001 | 1.978 | 1.985 | 1.707 | 1.716 |
| When $n_1 < n_{10}$, | $n_{1m} =$ | 1.914 | 1.859 | 1.836 | 1.685 | 1.666 |
| When $k_1 \geq k_{10}$, | $k_{1m} =$ | 0.148 | 0.176 | 0.164 | 0.101 | 0.100 |
| When $k_1 < k_{10}$, | $k_{1m} =$ | 0.045 | 0.025 | 0.000 | 0.067 | 0.040 |
| When $d_1 \geq d_{10}$, | $d_{1m}$ (nm) $=$ | 20.691 | 18.424 | 18.356 | 225.238 | 231.093 |
| When $d_1 < d_{10}$, | $d_{1m}$ (nm) $=$ | 15.556 | 11.376 | 9.363 | 212.673 | 192.697 |
| When $n_2 \geq n_{20}$, | $n_{2m} =$ | 1.861 | 1.756 | 1.791 | 1.715 | 1.840 |
| When $n_2 < n_{20}$, | $n_{2m} =$ | 1.690 | 1.574 | 1.591 | 1.643 | 1.628 |
| When $k_2 \geq k_{20}$, | $k_{2m} =$ | 0.481 | 0.351 | 0.310 | 0.328 | 0.314 |
| When $k_2 < k_{20}$, | $k_{2m} =$ | 0.336 | 0.225 | 0.176 | 0.223 | 0.151 |
| When $d_2 \geq d_{20}$, | $d_{2m}$ (nm) $=$ | ∞ | ∞ | ∞ | 139.199 | ∞ |
| When $d_2 < d_{20}$, | $d_{2m}$ (nm) $=$ | 109.768 | 131.712 | 172.718 | 120.241 | 167.595 |

1. 2 < N A ≤ 1. 3
1 5 5 < T ≤ 1 6 5

| Case | 16-06 | 16-07 |
|---|---|---|
| $n_{10}$ | 1.695 | 1.707 |
| $k_{10}$ | 0.060 | 0.054 |
| $d_{10}$ (nm) | 214.034 | 276.376 |
| $n_{20}$ | 1.692 | 1.707 |
| $k_{20}$ | 0.179 | 0.181 |
| $d_{20}$ (nm) | 244.657 | 237.806 |

| | | 16-06 | 16-07 |
|---|---|---|---|
| When $n_1 \geq n_{10}$, | $n_{1m} =$ | 1.745 | 1.770 |
| When $n_1 < n_{10}$, | $n_{1m} =$ | 1.666 | 1.653 |
| When $k_1 \geq k_{10}$, | $k_{1m} =$ | 0.101 | 0.089 |
| When $k_1 < k_{10}$, | $k_{1m} =$ | 0.030 | 0.027 |
| When $d_1 \geq d_{10}$, | $d_{1m}$ (nm) $=$ | ∞ | ∞ |
| When $d_1 < d_{10}$, | $d_{1m}$ (nm) $=$ | 191.630 | 187.468 |
| When $n_2 \geq n_{20}$, | $n_{2m} =$ | 1.889 | 1.864 |
| When $n_2 < n_{20}$, | $n_{2m} =$ | 1.562 | 1.515 |
| When $k_2 \geq k_{20}$, | $k_{2m} =$ | 0.290 | 0.295 |
| When $k_2 < k_{20}$, | $k_{2m} =$ | 0.115 | 0.110 |
| When $d_2 \geq d_{20}$, | $d_{2m}$ (nm) $=$ | ∞ | ∞ |
| When $d_2 < d_{20}$, | $d_{2m}$ (nm) $=$ | 179.119 | 164.223 |

1．2 ＜ N A ≦ 1．3
165 ＜ T ≦ 175

| Case | 17-01 | 17-02 | 17-03 | 17-04 | 17-05 |
|---|---|---|---|---|---|
| $n_{10}$ | 1.958 | 1.903 | 1.898 | 1.694 | 1.694 |
| $k_{10}$ | 0.128 | 0.127 | 0.090 | 0.080 | 0.068 |
| $d_{10}$ (nm) | 15.815 | 13.420 | 12.296 | 215.821 | 215.165 |
| $n_{20}$ | 1.794 | 1.688 | 1.719 | 1.668 | 1.681 |
| $k_{20}$ | 0.439 | 0.307 | 0.254 | 0.290 | 0.224 |
| $d_{20}$ (nm) | 123.830 | 190.984 | 244.231 | 122.663 | 179.093 |

| | | 17-01 | 17-02 | 17-03 | 17-04 | 17-05 |
|---|---|---|---|---|---|---|
| When $n_1 \geq n_{10}$, | $n_{1m} =$ | 2.020 | 1.981 | 1.991 | 1.707 | 1.716 |
| When $n_1 < n_{10}$, | $n_{1m} =$ | 1.942 | 1.867 | 1.846 | 1.692 | 1.665 |
| When $k_1 \geq k_{10}$, | $k_{1m} =$ | 0.150 | 0.182 | 0.165 | 0.103 | 0.101 |
| When $k_1 < k_{10}$, | $k_{1m} =$ | 0.058 | 0.033 | 0.000 | 0.077 | 0.041 |
| When $d_1 \geq d_{10}$, | $d_{1m}$ (nm) $=$ | 19.257 | 17.848 | 17.802 | 223.701 | 230.268 |
| When $d_1 < d_{10}$, | $d_{1m}$ (nm) $=$ | 15.087 | 11.461 | 9.465 | 215.120 | 195.890 |
| When $n_2 \geq n_{20}$, | $n_{2m} =$ | 1.832 | 1.743 | 1.790 | 1.677 | 1.826 |
| When $n_2 < n_{20}$, | $n_{2m} =$ | 1.680 | 1.570 | 1.590 | 1.625 | 1.625 |
| When $k_2 \geq k_{20}$, | $k_{2m} =$ | 0.483 | 0.357 | 0.316 | 0.321 | 0.315 |
| When $k_2 < k_{20}$, | $k_{2m} =$ | 0.365 | 0.239 | 0.186 | 0.252 | 0.151 |
| When $d_2 \geq d_{20}$, | $d_{2m}$ (nm) $=$ | $\infty$ | $\infty$ | $\infty$ | 127.631 | $\infty$ |
| When $d_2 < d_{20}$, | $d_{2m}$ (nm) $=$ | 111.992 | 128.672 | 166.465 | 109.461 | 158.121 |

1．2 ＜ N A ≦ 1．3
165 ＜ T ≦ 175

| Case | 17-06 | 17-07 |
|---|---|---|
| $n_{10}$ | 1.696 | 1.707 |
| $k_{10}$ | 0.061 | 0.056 |
| $d_{10}$ (nm) | 214.210 | 275.996 |
| $n_{20}$ | 1.692 | 1.705 |
| $k_{20}$ | 0.185 | 0.187 |
| $d_{20}$ (nm) | 235.479 | 229.352 |

| | | 17-06 | 17-07 |
|---|---|---|---|
| When $n_1 \geq n_{10}$, | $n_{1m} =$ | 1.744 | 1.770 |
| When $n_1 < n_{10}$, | $n_{1m} =$ | 1.667 | 1.657 |
| When $k_1 \geq k_{10}$, | $k_{1m} =$ | 0.101 | 0.088 |
| When $k_1 < k_{10}$, | $k_{1m} =$ | 0.031 | 0.030 |
| When $d_1 \geq d_{10}$, | $d_{1m}$ (nm) $=$ | $\infty$ | $\infty$ |
| When $d_1 < d_{10}$, | $d_{1m}$ (nm) $=$ | 193.216 | 188.863 |
| When $n_2 \geq n_{20}$, | $n_{2m} =$ | 1.887 | 1.872 |
| When $n_2 < n_{20}$, | $n_{2m} =$ | 1.561 | 1.509 |
| When $k_2 \geq k_{20}$, | $k_{2m} =$ | 0.292 | 0.295 |
| When $k_2 < k_{20}$, | $k_{2m} =$ | 0.120 | 0.115 |
| When $d_2 \geq d_{20}$, | $d_{2m}$ (nm) $=$ | $\infty$ | $\infty$ |
| When $d_2 < d_{20}$, | $d_{2m}$ (nm) $=$ | 161.210 | 156.975 |

1. 2 < N A ≤ 1. 3
1 7 5 < T ≤ 1 8 5

| Case | 18-01 | 18-02 | 18-03 | 18-04 | 18-05 |
|---|---|---|---|---|---|
| $n_{10}$ | 1.907 | 1.904 | 1.694 | 1.696 | 1.704 |
| $k_{10}$ | 0.135 | 0.092 | 0.070 | 0.062 | 0.051 |
| $d_{10}$ (nm) | 13.188 | 12.121 | 215.718 | 214.371 | 274.345 |
| $n_{20}$ | 1.679 | 1.720 | 1.679 | 1.692 | 1.687 |
| $k_{20}$ | 0.313 | 0.260 | 0.233 | 0.190 | 0.159 |
| $d_{20}$ (nm) | 183.151 | 235.214 | 169.072 | 225.802 | 280.556 |

| | | 18-01 | 18-02 | 18-03 | 18-04 | 18-05 |
|---|---|---|---|---|---|---|
| When $n_1 \geq n_{10}$, | $n_{1m} =$ | 1.982 | 1.997 | 1.715 | 1.743 | 1.760 |
| When $n_1 < n_{10}$, | $n_{1m} =$ | 1.873 | 1.854 | 1.666 | 1.668 | 1.658 |
| When $k_1 \geq k_{10}$, | $k_{1m} =$ | 0.188 | 0.166 | 0.102 | 0.102 | 0.090 |
| When $k_1 < k_{10}$, | $k_{1m} =$ | 0.044 | 0.000 | 0.044 | 0.032 | 0.018 |
| When $d_1 \geq d_{10}$, | $d_{1m}$ (nm) $=$ | 17.244 | 17.308 | 229.740 | ∞ | ∞ |
| When $d_1 < d_{10}$, | $d_{1m}$ (nm) $=$ | 11.395 | 9.486 | 201.461 | 194.630 | 174.558 |
| When $n_2 \geq n_{20}$, | $n_{2m} =$ | 1.730 | 1.790 | 1.771 | 1.836 | 1.900 |
| When $n_2 < n_{20}$, | $n_{2m} =$ | 1.562 | 1.589 | 1.630 | 1.559 | 1.518 |
| When $k_2 \geq k_{20}$, | $k_{2m} =$ | 0.359 | 0.319 | 0.318 | 0.293 | 0.259 |
| When $k_2 < k_{20}$, | $k_{2m} =$ | 0.249 | 0.193 | 0.159 | 0.124 | 0.097 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 128.127 | 156.903 | 151.088 | 157.464 | 192.992 |

1. 2 < N A ≤ 1. 3
1 8 5 < T ≤ 1 9 5

| Case | 19-01 | 19-02 | 19-03 | 19-04 | 19-05 |
|---|---|---|---|---|---|
| $n_{10}$ | 1.908 | 1.906 | 1.889 | 1.693 | 1.696 |
| $k_{10}$ | 0.140 | 0.092 | 0.087 | 0.071 | 0.064 |
| $d_{10}$ (nm) | 13.288 | 12.370 | 11.418 | 216.427 | 214.510 |
| $n_{20}$ | 1.676 | 1.726 | 1.707 | 1.681 | 1.692 |
| $k_{20}$ | 0.321 | 0.266 | 0.223 | 0.243 | 0.195 |
| $d_{20}$ (nm) | 172.696 | 223.910 | 283.898 | 158.126 | 215.938 |

| | | 19-01 | 19-02 | 19-03 | 19-04 | 19-05 |
|---|---|---|---|---|---|---|
| When $n_1 \geq n_{10}$, | $n_{1m}=$ | 1.981 | 1.996 | 1.994 | 1.713 | 1.742 |
| When $n_1 < n_{10}$, | $n_{1m}=$ | 1.875 | 1.857 | 1.834 | 1.670 | 1.669 |
| When $k_1 \geq k_{10}$, | $k_{1m}=$ | 0.190 | 0.163 | 0.168 | 0.103 | 0.102 |
| When $k_1 < k_{10}$, | $k_{1m}=$ | 0.055 | 0.000 | 0.000 | 0.051 | 0.037 |
| When $d_1 \geq d_{10}$, | $d_{1m}$ (nm) $=$ | 17.148 | 17.446 | 17.407 | 228.093 | ∞ |
| When $d_1 < d_{10}$, | $d_{1m}$ (nm) $=$ | 11.532 | 9.791 | 8.458 | 205.012 | 195.805 |
| When $n_2 \geq n_{20}$, | $n_{2m}=$ | 1.725 | 1.797 | 1.791 | 1.767 | 1.825 |
| When $n_2 < n_{20}$, | $n_{2m}=$ | 1.558 | 1.592 | 1.590 | 1.647 | 1.558 |
| When $k_2 \geq k_{20}$, | $k_{2m}=$ | 0.365 | 0.327 | 0.286 | 0.323 | 0.294 |
| When $k_2 < k_{20}$, | $k_{2m}=$ | 0.256 | 0.198 | 0.157 | 0.178 | 0.130 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 125.060 | 143.864 | 171.207 | 144.997 | 180.034 |

1. 2 < N A ≤ 1. 3
1 8 5 < T ≤ 1 9 5

| Case | 19-06 | 19-07 |
|---|---|---|
| $n_{10}$ | 1.696 | 1.704 |
| $k_{10}$ | 0.057 | 0.052 |
| $d_{10}$ (nm) | 213.492 | 274.677 |
| $n_{20}$ | 1.691 | 1.687 |
| $k_{20}$ | 0.166 | 0.162 |
| $d_{20}$ (nm) | 273.809 | 270.432 |

| | | 19-06 | 19-07 |
|---|---|---|---|
| When $n_1 \geq n_{10}$, | $n_{1m}=$ | 1.742 | 1.760 |
| When $n_1 < n_{10}$, | $n_{1m}=$ | 1.666 | 1.659 |
| When $k_1 \geq k_{10}$, | $k_{1m}=$ | 0.097 | 0.090 |
| When $k_1 < k_{10}$, | $k_{1m}=$ | 0.026 | 0.022 |
| When $d_1 \geq d_{10}$, | $d_{1m}$ (nm) $=$ | ∞ | ∞ |
| When $d_1 < d_{10}$, | $d_{1m}$ (nm) $=$ | 178.602 | 175.003 |
| When $n_2 \geq n_{20}$, | $n_{2m}=$ | 1.857 | 1.904 |
| When $n_2 < n_{20}$, | $n_{2m}=$ | 1.570 | 1.518 |
| When $k_2 \geq k_{20}$, | $k_{2m}=$ | 0.281 | 0.262 |
| When $k_2 < k_{20}$, | $k_{2m}=$ | 0.104 | 0.096 |
| When $d_2 \geq d_{20}$, | $d_{2m}$ (nm) $=$ | ∞ | ∞ |
| When $d_2 < d_{20}$, | $d_{2m}$ (nm) $=$ | 199.693 | 186.949 |

1.2 < NA ≤ 1.3
195 < T ≤ 205

| Case | 20-01 | 20-02 | 20-03 | 20-04 | 20-05 |
|---|---|---|---|---|---|
| $n_{10}$ | 1.907 | 1.904 | 1.887 | 1.693 | 1.696 |
| $k_{10}$ | 0.139 | 0.091 | 0.088 | 0.073 | 0.065 |
| $d_{10}$ (nm) | 13.915 | 13.010 | 11.752 | 216.656 | 214.259 |
| $n_{20}$ | 1.684 | 1.734 | 1.707 | 1.683 | 1.692 |
| $k_{20}$ | 0.334 | 0.275 | 0.227 | 0.253 | 0.201 |
| $d_{20}$ (nm) | 160.500 | 212.141 | 273.737 | 148.279 | 206.980 |

| | | 20-01 | 20-02 | 20-03 | 20-04 | 20-05 |
|---|---|---|---|---|---|---|
| When $n_1 \geq n_{10}$, | $n_{1m} =$ | 1.978 | 1.992 | 1.990 | 1.700 | 1.743 |
| When $n_1 < n_{10}$, | $n_{1m} =$ | 1.874 | 1.857 | 1.833 | 1.671 | 1.670 |
| When $k_1 \geq k_{10}$, | $k_{1m} =$ | 0.186 | 0.158 | 0.167 | 0.098 | 0.102 |
| When $k_1 < k_{10}$, | $k_{1m} =$ | 0.059 | 0.000 | 0.000 | 0.062 | 0.044 |
| When $d_1 \geq d_{10}$, | $d_{1m}$ (nm) $=$ | 17.817 | 18.151 | 17.811 | 226.068 | 265.367 |
| When $d_1 < d_{10}$, | $d_{1m}$ (nm) $=$ | 12.124 | 10.391 | 8.783 | 207.088 | 196.420 |
| When $n_2 \geq n_{20}$, | $n_{2m} =$ | 1.731 | 1.806 | 1.791 | 1.746 | 1.815 |
| When $n_2 < n_{20}$, | $n_{2m} =$ | 1.564 | 1.602 | 1.588 | 1.669 | 1.556 |
| When $k_2 \geq k_{20}$, | $k_{2m} =$ | 0.381 | 0.338 | 0.291 | 0.321 | 0.294 |
| When $k_2 < k_{20}$, | $k_{2m} =$ | 0.265 | 0.202 | 0.159 | 0.212 | 0.142 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 125.465 | 136.447 | 180.411 | 144.423 | 187.001 |

1.2 < NA ≤ 1.3
195 < T ≤ 205

| Case | 20-06 | 20-07 |
|---|---|---|
| $n_{10}$ | 1.696 | 1.704 |
| $k_{10}$ | 0.058 | 0.053 |
| $d_{10}$ (nm) | 213.637 | 275.120 |
| $n_{20}$ | 1.690 | 1.687 |
| $k_{20}$ | 0.169 | 0.165 |
| $d_{20}$ (nm) | 264.528 | 260.887 |

| | | 20-06 | 20-07 |
|---|---|---|---|
| When $n_1 \geq n_{10}$, | $n_{1m} =$ | 1.742 | 1.760 |
| When $n_1 < n_{10}$, | $n_{1m} =$ | 1.666 | 1.661 |
| When $k_1 \geq k_{10}$, | $k_{1m} =$ | 0.097 | 0.090 |
| When $k_1 < k_{10}$, | $k_{1m} =$ | 0.030 | 0.025 |
| When $d_1 \geq d_{10}$, | $d_{1m}$ (nm) $=$ | ∞ | ∞ |
| When $d_1 < d_{10}$, | $d_{1m}$ (nm) $=$ | 183.526 | 175.348 |
| When $n_2 \geq n_{20}$, | $n_{2m} =$ | 1.856 | 1.912 |
| When $n_2 < n_{20}$, | $n_{2m} =$ | 1.571 | 1.519 |
| When $k_2 \geq k_{20}$, | $k_{2m} =$ | 0.282 | 0.268 |
| When $k_2 < k_{20}$, | $k_{2m} =$ | 0.108 | 0.102 |
| When $d_2 \geq d_{20}$, | $d_{2m}$ (nm) $=$ | ∞ | ∞ |
| When $d_2 < d_{20}$, | $d_{2m}$ (nm) $=$ | 202.896 | 181.779 |

5. An antireflective film used in a process for manufacturing a semiconductor device by being provided between a resist layer and a silicon oxide layer formed on a surface of a silicon semiconductor substrate and having a thickness T (unit: nm) described below, for exposure of the resist layer in an exposure system having a wavelength of 190 nm to 195 nm and a numerical aperture NA of $1.3 < NA \leq 1.4$, the antireflective film having a two-layer structure comprising:

an upper layer having a complex refractive index $N_1$; and
a lower layer having a complex refractive index $N_2$; the complex refractive indexes $N_1$ and $N_2$ being represented by the equations $N_1 = n_1 - k_1 i$ and $N_2 = n_2 - k_2 i$, respectively;
wherein assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1$, $k_1$, $d_1$, $n_2$, $k_2$, and $d_2$ satisfy the relational expression

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1;$$

a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$; and in the tables below, in the line of "When $n_1 \geq n_{10}$, $n_{1m} =$", each value in the right columns is "$n_{1m} - n_{10}$"; in the line of "When $n_1 < n_{10}$, $n_{1m} =$", each value in the right columns is "$n_{10} - n_{1m}$"; in the line of "When $k_1 \geq k_{10}$, $k_{1m} =$", each value in the right columns is "$k_{1m} - k_{10}$"; in the line of "When $k_1 < k_{10}$, $k_{1m} =$", each value in the right columns is "$k_{10} - k_{1m}$"; in the line of "When $d_1 \geq d_{10}$, $d_{1m}$ (nm) $=$", each value (unit: nm) in the right columns is "$d_{1m} - d_{10}$"; in the line of "When $d_1 < d_{10}$, $d_{1m}$ (nm) $=$", each value (unit: nm) in the right columns is "$d_{10} - d_{1m}$"; in the line of "When $n_2 \geq n_{20}$, $n_{2m} =$", each value in the right columns is "$n_{2m} - n_{20}$"; in the line of "When $n_2 < n_{20}$, $n_{2m} =$", each value in the right columns is "$n_{20} - n_{2m}$"; in the line of "When $k_2 \geq k_{20}$, $k_{2m} =$", each value in the right columns is "$k_{2m} - k_{20}$"; in the line of "When $k_2 < k_{20}$, $k_{2m} =$", each value in the right columns is "$k_{20} - k_{2m}$"; in the line of "When $d_2 \geq d_{20}$, $d_{2m}$ (nm) $=$", each value (unit: nm) in the right columns is "$d_{2m} - d_{20}$"; and in the line of "When $d_2 < d_{20}$, $d_{2m}$ (nm) $=$", each value (unit: nm) in the right columns is "$d_{20} - d_{2m}$".

1 . 3 < N A ≤ 1 . 4

2 ≤ T ≤ 1 5

| Case | 1-01 | 1-02 | 1-03 | 1-04 | 1-05 |
|---|---|---|---|---|---|
| $n_{10}$ | 2.047 | 1.887 | 1.871 | 1.868 | 1.862 |
| $k_{10}$ | 0.012 | 0.120 | 0.106 | 0.075 | 0.065 |
| $d_{10}$ (nm) | 29.751 | 26.980 | 17.106 | 15.339 | 13.830 |
| $n_{20}$ | 6.274 | 1.973 | 1.713 | 1.738 | 1.730 |
| $k_{20}$ | 3.305 | 0.477 | 0.298 | 0.245 | 0.208 |
| $d_{20}$ (nm) | 1.566 | 76.285 | 158.161 | 212.612 | 271.884 |

| | | 1-01 | 1-02 | 1-03 | 1-04 | 1-05 |
|---|---|---|---|---|---|---|
| When $n_1 \geq n_{10}$, | $n_{1m} =$ | 2.109 | 1.929 | 1.924 | 1.935 | 1.940 |
| When $n_1 < n_{10}$, | $n_{1m} =$ | 1.990 | 1.877 | 1.852 | 1.835 | 1.823 |
| When $k_1 \geq k_{10}$, | $k_{1m} =$ | 0.055 | 0.138 | 0.136 | 0.123 | 0.124 |
| When $k_1 < k_{10}$, | $k_{1m} =$ | 0.000 | 0.089 | 0.036 | 0.000 | 0.000 |
| When $d_1 \geq d_{10}$, | $d_{1m}$ (nm) $=$ | 32.767 | 31.708 | 21.551 | 20.868 | 20.183 |
| When $d_1 < d_{10}$, | $d_{1m}$ (nm) $=$ | 27.509 | 26.309 | 15.640 | 12.771 | 10.913 |
| When $n_2 \geq n_{20}$, | $n_{2m} =$ | 6.594 | 2.028 | 1.750 | 1.789 | 1.793 |
| When $n_2 < n_{20}$, | $n_{2m} =$ | 5.978 | 1.933 | 1.627 | 1.639 | 1.618 |
| When $k_2 \geq k_{20}$, | $k_{2m} =$ | 3.556 | 0.507 | 0.335 | 0.292 | 0.258 |
| When $k_2 < k_{20}$, | $k_{2m} =$ | 3.013 | 0.403 | 0.242 | 0.188 | 0.152 |
| When $d_2 \geq d_{20}$, | $d_{2m}$ (nm) $=$ | 1.715 | 83.056 | ∞ | ∞ | ∞ |
| When $d_2 < d_{20}$, | $d_{2m}$ (nm) $=$ | 1.418 | 75.266 | 136.202 | 175.723 | 191.206 |

1 . 3 < N A ≤ 1 . 4

2 ≤ T ≤ 1 5

| Case | 1-06 | 1-07 | 1-08 | 1-09 | 1-10 |
|---|---|---|---|---|---|
| $n_{10}$ | 1.691 | 1.692 | 1.711 | 1.704 | 1.705 |
| $k_{10}$ | 0.062 | 0.057 | 0.070 | 0.057 | 0.050 |
| $d_{10}$ (nm) | 161.852 | 157.460 | 239.891 | 226.155 | 221.451 |
| $n_{20}$ | 1.688 | 1.697 | 7.420 | 1.689 | 1.695 |
| $k_{20}$ | 0.179 | 0.154 | 3.291 | 0.187 | 0.158 |
| $d_{20}$ (nm) | 207.262 | 266.043 | 0.810 | 202.908 | 261.182 |

| | | 1-06 | 1-07 | 1-08 | 1-09 | 1-10 |
|---|---|---|---|---|---|---|
| When $n_1 \geq n_{10}$, | $n_{1m} =$ | 1.703 | 1.707 | 1.725 | 1.738 | 1.736 |
| When $n_1 < n_{10}$, | $n_{1m} =$ | 1.685 | 1.664 | 1.704 | 1.690 | 1.688 |
| When $k_1 \geq k_{10}$, | $k_{1m} =$ | 0.080 | 0.084 | 0.082 | 0.082 | 0.079 |
| When $k_1 < k_{10}$, | $k_{1m} =$ | 0.051 | 0.029 | 0.049 | 0.029 | 0.022 |
| When $d_1 \geq d_{10}$, | $d_{1m}$ (nm) $=$ | 169.125 | 171.143 | 250.745 | ∞ | ∞ |
| When $d_1 < d_{10}$, | $d_{1m}$ (nm) $=$ | 157.974 | 129.944 | 235.697 | 215.124 | 204.319 |
| When $n_2 \geq n_{20}$, | $n_{2m} =$ | 1.696 | 1.748 | 7.849 | 1.818 | 1.809 |
| When $n_2 < n_{20}$, | $n_{2m} =$ | 1.666 | 1.665 | 7.185 | 1.613 | 1.611 |
| When $k_2 \geq k_{20}$, | $k_{2m} =$ | 0.202 | 0.195 | 3.465 | 0.264 | 0.246 |
| When $k_2 < k_{20}$, | $k_{2m} =$ | 0.150 | 0.115 | 2.625 | 0.129 | 0.105 |
| When $d_2 \geq d_{20}$, | $d_{2m}$ (nm) $=$ | 213.501 | ∞ | 0.893 | ∞ | ∞ |
| When $d_2 < d_{20}$, | $d_{2m}$ (nm) $=$ | 194.001 | 249.665 | 0.721 | 179.167 | 225.188 |

$1.3 \; NA \le 1.4$

$2 \le T \le 15$

| Case | 1-11 |
|---|---|
| $n_{10}$ | 1.695 |
| $k_{10}$ | 0.054 |
| $d_{10}$ (nm) | 267.286 |
| $n_{20}$ | 1.705 |
| $k_{20}$ | 0.184 |
| $d_{20}$ (nm) | 212.751 |

| | | |
|---|---|---|
| When $n_1 \ge n_{10}$, | $n_{1m} =$ | 1.731 |
| When $n_1 < n_{10}$, | $n_{1m} =$ | 1.655 |
| When $k_1 \ge k_{10}$, | $k_{1m} =$ | 0.080 |
| When $k_1 < k_{10}$, | $k_{1m} =$ | 0.025 |
| When $d_1 \ge d_{10}$, | $d_{1m}$ (nm) $=$ | $\infty$ |
| When $d_1 < d_{10}$, | $d_{1m}$ (nm) $=$ | 220.771 |
| When $n_2 \ge n_{20}$, | $n_{2m} =$ | 1.808 |
| When $n_2 < n_{20}$, | $n_{2m} =$ | 1.623 |
| When $k_2 \ge k_{20}$, | $k_{2m} =$ | 0.237 |
| When $k_2 < k_{20}$, | $k_{2m} =$ | 0.115 |
| When $d_2 \ge d_{20}$, | $d_{2m}$ (nm) $=$ | $\infty$ |
| When $d_2 < d_{20}$, | $d_{2m}$ (nm) $=$ | 175.645 |

1. 3 < N A ≤ 1. 4
1 5 < T ≤ 2 5

| Case | 2-01 | 2-02 | 2-03 | 2-04 | 2-05 |
|---|---|---|---|---|---|
| $n_{10}$ | 1.943 | 1.876 | 1.873 | 1.866 | 1.691 |
| $k_{10}$ | 0.121 | 0.112 | 0.080 | 0.068 | 0.064 |
| $d_{10}$ (nm) | 34.905 | 17.699 | 15.588 | 14.042 | 161.844 |
| $n_{20}$ | 6.149 | 1.719 | 1.739 | 1.732 | 1.687 |
| $k_{20}$ | 4.965 | 0.321 | 0.258 | 0.217 | 0.188 |
| $d_{20}$ (nm) | 1.046 | 148.502 | 203.950 | 262.757 | 198.716 |

| | | 2-01 | 2-02 | 2-03 | 2-04 | 2-05 |
|---|---|---|---|---|---|---|
| When $n_1 \geq n_{10}$, | $n_{1m}=$ | 1.997 | 1.925 | 1.936 | 1.942 | 1.700 |
| When $n_1 < n_{10}$, | $n_{1m}=$ | 1.902 | 1.861 | 1.842 | 1.830 | 1.690 |
| When $k_1 \geq k_{10}$, | $k_{1m}=$ | 0.155 | 0.135 | 0.124 | 0.122 | 0.079 |
| When $k_1 < k_{10}$, | $k_{1m}=$ | 0.064 | 0.044 | 0.004 | 0.000 | 0.061 |
| When $d_1 \geq d_{10}$, | $d_{1m}$ (nm) $=$ | 38.478 | 21.745 | 20.735 | 20.064 | 166.973 |
| When $d_1 < d_{10}$, | $d_{1m}$ (nm) $=$ | 32.365 | 16.569 | 13.305 | 11.354 | 161.165 |
| When $n_2 \geq n_{20}$, | $n_{2m}=$ | 6.640 | 1.749 | 1.787 | 1.793 | 1.688 |
| When $n_2 < n_{20}$, | $n_{2m}=$ | 5.695 | 1.636 | 1.643 | 1.623 | 1.668 |
| When $k_2 \geq k_{20}$, | $k_{2m}=$ | 5.267 | 0.354 | 0.304 | 0.266 | 0.197 |
| When $k_2 < k_{20}$, | $k_{2m}=$ | 4.500 | 0.266 | 0.202 | 0.162 | 0.165 |
| When $d_2 \geq d_{20}$, | $d_{2m}$ (nm) $=$ | 1.189 | ∞ | ∞ | ∞ | 199.493 |
| When $d_2 < d_{20}$, | $d_{2m}$ (nm) $=$ | 0.912 | 129.925 | 173.046 | 186.094 | 188.055 |

1. 3 < N A ≤ 1. 4
1 5 < T ≤ 2 5

| Case | 2-06 | 2-07 | 2-08 | 2-09 | 2-10 |
|---|---|---|---|---|---|
| $n_{10}$ | 1.692 | 1.706 | 1.711 | 1.704 | 1.695 |
| $k_{10}$ | 0.059 | 0.052 | 0.075 | 0.059 | 0.056 |
| $d_{10}$ (nm) | 157.652 | 221.303 | 235.815 | 225.762 | 267.452 |
| $n_{20}$ | 1.696 | 1.695 | 6.235 | 1.687 | 1.705 |
| $k_{20}$ | 0.161 | 0.165 | 4.691 | 0.197 | 0.194 |
| $d_{20}$ (nm) | 257.279 | 252.591 | 0.724 | 194.502 | 204.028 |

| | | 2-06 | 2-07 | 2-08 | 2-09 | 2-10 |
|---|---|---|---|---|---|---|
| When $n_1 \geq n_{10}$, | $n_{1m}=$ | 1.703 | 1.736 | 1.711 | 1.737 | 1.730 |
| When $n_1 < n_{10}$, | $n_{1m}=$ | 1.667 | 1.690 | 1.709 | 1.692 | 1.658 |
| When $k_1 \geq k_{10}$, | $k_{1m}=$ | 0.082 | 0.079 | 0.079 | 0.082 | 0.080 |
| When $k_1 < k_{10}$, | $k_{1m}=$ | 0.033 | 0.024 | 0.074 | 0.033 | 0.029 |
| When $d_1 \geq d_{10}$, | $d_{1m}$ (nm) $=$ | 165.499 | ∞ | 235.852 | ∞ | ∞ |
| When $d_1 < d_{10}$, | $d_{1m}$ (nm) $=$ | 138.474 | 207.206 | 234.721 | 216.211 | 222.458 |
| When $n_2 \geq n_{20}$, | $n_{2m}=$ | 1.740 | 1.797 | 6.407 | 1.814 | 1.798 |
| When $n_2 < n_{20}$, | $n_{2m}=$ | 1.670 | 1.616 | 6.233 | 1.613 | 1.629 |
| When $k_2 \geq k_{20}$, | $k_{2m}=$ | 0.196 | 0.249 | 4.693 | 0.270 | 0.240 |
| When $k_2 < k_{20}$, | $k_{2m}=$ | 0.121 | 0.111 | 3.940 | 0.138 | 0.122 |
| When $d_2 \geq d_{20}$, | $d_{2m}$ (nm) $=$ | ∞ | ∞ | 0.732 | ∞ | ∞ |
| When $d_2 < d_{20}$, | $d_{2m}$ (nm) $=$ | 244.077 | 220.690 | 0.720 | 173.495 | 171.776 |

1．3＜ＮＡ≦1．4
25＜Ｔ≦35

| Case | 3-01 | 3-02 | 3-03 | 3-04 | 3-05 |
|---|---|---|---|---|---|
| $n_{10}$ | 1.883 | 1.879 | 1.872 | 1.692 | 1.705 |
| $k_{10}$ | 0.119 | 0.084 | 0.069 | 0.061 | 0.061 |
| $d_{10}$ (nm) | 18.157 | 15.746 | 14.214 | 157.790 | 225.478 |
| $n_{20}$ | 1.723 | 1.741 | 1.737 | 1.697 | 1.687 |
| $k_{20}$ | 0.349 | 0.274 | 0.228 | 0.168 | 0.209 |
| $d_{20}$ (nm) | 139.788 | 195.542 | 253.893 | 248.784 | 186.105 |

| When $n_1 \geq n_{10}$, | $n_{1m} =$ | 1.927 | 1.939 | 1.945 | 1.699 | 1.735 |
|---|---|---|---|---|---|---|
| When $n_1 < n_{10}$, | $n_{1m} =$ | 1.873 | 1.852 | 1.839 | 1.671 | 1.694 |
| When $k_1 \geq k_{10}$, | $k_{1m} =$ | 0.135 | 0.123 | 0.119 | 0.079 | 0.082 |
| When $k_1 < k_{10}$, | $k_{1m} =$ | 0.055 | 0.011 | 0.000 | 0.039 | 0.038 |
| When $d_1 \geq d_{10}$, | $d_{1m}$ (nm) $=$ | 21.683 | 20.446 | 19.836 | 161.921 | 270.295 |
| When $d_1 < d_{10}$, | $d_{1m}$ (nm) $=$ | 17.423 | 13.775 | 11.786 | 145.560 | 217.505 |
| When $n_2 \geq n_{20}$, | $n_{2m} =$ | 1.744 | 1.786 | 1.794 | 1.735 | 1.754 |
| When $n_2 < n_{20}$, | $n_{2m} =$ | 1.647 | 1.650 | 1.632 | 1.679 | 1.615 |
| When $k_2 \geq k_{20}$, | $k_{2m} =$ | 0.374 | 0.316 | 0.276 | 0.196 | 0.276 |
| When $k_2 < k_{20}$, | $k_{2m} =$ | 0.295 | 0.218 | 0.173 | 0.130 | 0.149 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 124.317 | 167.810 | 181.193 | 239.270 | 167.329 |

1．3＜ＮＡ≦1．4
25＜Ｔ≦35

| Case | 3-06 |
|---|---|
| $n_{10}$ | 1.706 |
| $k_{10}$ | 0.054 |
| $d_{10}$ (nm) | 221.123 |
| $n_{20}$ | 1.695 |
| $k_{20}$ | 0.173 |
| $d_{20}$ (nm) | 244.149 |

| When $n_1 \geq n_{10}$, | $n_{1m} =$ | 1.735 |
|---|---|---|
| When $n_1 < n_{10}$, | $n_{1m} =$ | 1.692 |
| When $k_1 \geq k_{10}$, | $k_{1m} =$ | 0.078 |
| When $k_1 < k_{10}$, | $k_{1m} =$ | 0.026 |
| When $d_1 \geq d_{10}$, | $d_{1m}$ (nm) $=$ | ∞ |
| When $d_1 < d_{10}$, | $d_{1m}$ (nm) $=$ | 209.346 |
| When $n_2 \geq n_{20}$, | $n_{2m} =$ | 1.781 |
| When $n_2 < n_{20}$, | $n_{2m} =$ | 1.622 |
| When $k_2 \geq k_{20}$, | $k_{2m} =$ | 0.252 |
| When $k_2 < k_{20}$, | $k_{2m} =$ | 0.118 |
| When $d_2 \geq d_{20}$, | $d_{2m}$ (nm) $=$ | ∞ |
| When $d_2 < d_{20}$, | $d_{2m}$ (nm) $=$ | 214.946 |

1. 3 < N A ≤ 1. 4
35 < T ≤ 45

| Case | 4-01 | 4-02 | 4-03 | 4-04 | 4-05 |
|---|---|---|---|---|---|
| $n_{10}$ | 1.890 | 1.886 | 1.877 | 1.692 | 1.705 |
| $k_{10}$ | 0.130 | 0.088 | 0.073 | 0.062 | 0.063 |
| $d_{10}$ (nm) | 18.083 | 15.723 | 14.196 | 157.690 | 225.284 |
| $n_{20}$ | 1.714 | 1.743 | 1.736 | 1.697 | 1.687 |
| $k_{20}$ | 0.371 | 0.287 | 0.236 | 0.175 | 0.220 |
| $d_{20}$ (nm) | 132.495 | 187.112 | 245.779 | 240.328 | 177.345 |

| | | 4-01 | 4-02 | 4-03 | 4-04 | 4-05 |
|---|---|---|---|---|---|---|
| When $n_1 \geq n_{10}$, | $n_{1m} =$ | 1.928 | 1.943 | 1.947 | 1.695 | 1.732 |
| When $n_1 < n_{10}$, | $n_{1m} =$ | 1.886 | 1.862 | 1.846 | 1.674 | 1.696 |
| When $k_1 \geq k_{10}$, | $k_{1m} =$ | 0.137 | 0.123 | 0.120 | 0.075 | 0.081 |
| When $k_1 < k_{10}$, | $k_{1m} =$ | 0.069 | 0.018 | 0.000 | 0.046 | 0.042 |
| When $d_1 \geq d_{10}$, | $d_{1m}$ (nm) $=$ | 21.026 | 19.960 | 19.411 | 159.493 | 266.580 |
| When $d_1 < d_{10}$, | $d_{1m}$ (nm) $=$ | 17.768 | 14.046 | 12.019 | 148.447 | 218.746 |
| When $n_2 \geq n_{20}$, | $n_{2m} =$ | 1.723 | 1.784 | 1.789 | 1.731 | 1.745 |
| When $n_2 < n_{20}$, | $n_{2m} =$ | 1.643 | 1.655 | 1.634 | 1.687 | 1.620 |
| When $k_2 \geq k_{20}$, | $k_{2m} =$ | 0.382 | 0.326 | 0.281 | 0.195 | 0.283 |
| When $k_2 < k_{20}$, | $k_{2m} =$ | 0.323 | 0.234 | 0.182 | 0.141 | 0.159 |
| When $d_2 \geq d_{20}$, | $d_{2m}$ (nm) $=$ | ∞ | ∞ | ∞ | 273.632 | ∞ |
| When $d_2 < d_{20}$, | $d_{2m}$ (nm) $=$ | 119.322 | 160.895 | 176.028 | 234.699 | 160.070 |

1. 3 < N A ≤ 1. 4
35 < T ≤ 45

| Case | 4-06 | 4-07 |
|---|---|---|
| $n_{10}$ | 1.706 | 1.695 |
| $k_{10}$ | 0.055 | 0.055 |
| $d_{10}$ (nm) | 220.863 | 262.917 |
| $n_{20}$ | 1.695 | 1.705 |
| $k_{20}$ | 0.180 | 0.178 |
| $d_{20}$ (nm) | 235.453 | 255.408 |

| | | 4-06 | 4-07 |
|---|---|---|---|
| When $n_1 \geq n_{10}$, | $n_{1m} =$ | 1.734 | 1.723 |
| When $n_1 < n_{10}$, | $n_{1m} =$ | 1.693 | 1.660 |
| When $k_1 \geq k_{10}$, | $k_{1m} =$ | 0.078 | 0.082 |
| When $k_1 < k_{10}$, | $k_{1m} =$ | 0.027 | 0.031 |
| When $d_1 \geq d_{10}$, | $d_{1m}$ (nm) $=$ | ∞ | ∞ |
| When $d_1 < d_{10}$, | $d_{1m}$ (nm) $=$ | 210.617 | 221.552 |
| When $n_2 \geq n_{20}$, | $n_{2m} =$ | 1.767 | 1.832 |
| When $n_2 < n_{20}$, | $n_{2m} =$ | 1.630 | 1.613 |
| When $k_2 \geq k_{20}$, | $k_{2m} =$ | 0.252 | 0.241 |
| When $k_2 < k_{20}$, | $k_{2m} =$ | 0.123 | 0.108 |
| When $d_2 \geq d_{20}$, | $d_{2m}$ (nm) $=$ | ∞ | ∞ |
| When $d_2 < d_{20}$, | $d_{2m}$ (nm) $=$ | 206.982 | 177.439 |

$1.3 < NA \leq 1.4$

$45 < T \leq 55$

| Case | 5-01 | 5-02 | 5-03 | 5-04 | 5-05 |
|---|---|---|---|---|---|
| $n_{10}$ | 1.891 | 1.892 | 1.878 | 1.691 | 1.705 |
| $k_{10}$ | 0.144 | 0.091 | 0.079 | 0.064 | 0.064 |
| $d_{10}$ (nm) | 17.530 | 15.545 | 14.050 | 157.168 | 225.395 |
| $n_{20}$ | 1.686 | 1.744 | 1.728 | 1.696 | 1.686 |
| $k_{20}$ | 0.376 | 0.296 | 0.240 | 0.179 | 0.227 |
| $d_{20}$ (nm) | 126.586 | 178.253 | 238.151 | 231.953 | 167.881 |

| | | 5-01 | 5-02 | 5-03 | 5-04 | 5-05 |
|---|---|---|---|---|---|---|
| When $n_1 \geq n_{10}$, | $n_{1m} =$ | 1.925 | 1.947 | 1.947 | 1.692 | 1.729 |
| When $n_1 < n_{10}$, | $n_{1m} =$ | 1.891 | 1.870 | 1.849 | 1.677 | 1.698 |
| When $k_1 \geq k_{10}$, | $k_{1m} =$ | 0.144 | 0.124 | 0.124 | 0.069 | 0.080 |
| When $k_1 < k_{10}$, | $k_{1m} =$ | 0.087 | 0.024 | 0.000 | 0.054 | 0.044 |
| When $d_1 \geq d_{10}$, | $d_{1m}$ (nm) $=$ | 19.955 | 19.462 | 18.998 | 157.553 | 251.532 |
| When $d_1 < d_{10}$, | $d_{1m}$ (nm) $=$ | 17.523 | 14.081 | 12.045 | 150.032 | 219.912 |
| When $n_2 \geq n_{20}$, | $n_{2m} =$ | 1.686 | 1.783 | 1.778 | 1.727 | 1.728 |
| When $n_2 < n_{20}$, | $n_{2m} =$ | 1.619 | 1.656 | 1.625 | 1.693 | 1.628 |
| When $k_2 \geq k_{20}$, | $k_{2m} =$ | 0.377 | 0.330 | 0.281 | 0.190 | 0.292 |
| When $k_2 < k_{20}$, | $k_{2m} =$ | 0.336 | 0.244 | 0.186 | 0.164 | 0.167 |
| When $d_2 \geq d_{20}$, | $d_{2m}$ (nm) $=$ | 127.104 | ∞ | ∞ | 253.769 | ∞ |
| When $d_2 < d_{20}$, | $d_{2m}$ (nm) $=$ | 114.397 | 150.903 | 169.614 | 229.862 | 150.571 |

$1.3 < NA \leq 1.4$

$45 < T \leq 55$

| Case | 5-06 | 5-07 |
|---|---|---|
| $n_{10}$ | 1.706 | 1.697 |
| $k_{10}$ | 0.056 | 0.047 |
| $d_{10}$ (nm) | 220.607 | 278.691 |
| $n_{20}$ | 1.694 | 1.700 |
| $k_{20}$ | 0.184 | 0.152 |
| $d_{20}$ (nm) | 226.210 | 281.986 |

| | | 5-06 | 5-07 |
|---|---|---|---|
| When $n_1 \geq n_{10}$, | $n_{1m} =$ | 1.728 | 1.753 |
| When $n_1 < n_{10}$, | $n_{1m} =$ | 1.694 | 1.654 |
| When $k_1 \geq k_{10}$, | $k_{1m} =$ | 0.077 | 0.078 |
| When $k_1 < k_{10}$, | $k_{1m} =$ | 0.029 | 0.021 |
| When $d_1 \geq d_{10}$, | $d_{1m}$ (nm) $=$ | ∞ | ∞ |
| When $d_1 < d_{10}$, | $d_{1m}$ (nm) $=$ | 210.961 | 211.857 |
| When $n_2 \geq n_{20}$, | $n_{2m} =$ | 1.757 | 1.912 |
| When $n_2 < n_{20}$, | $n_{2m} =$ | 1.639 | 1.611 |
| When $k_2 \geq k_{20}$, | $k_{2m} =$ | 0.250 | 0.220 |
| When $k_2 < k_{20}$, | $k_{2m} =$ | 0.125 | 0.096 |
| When $d_2 \geq d_{20}$, | $d_{2m}$ (nm) $=$ | ∞ | ∞ |
| When $d_2 < d_{20}$, | $d_{2m}$ (nm) $=$ | 199.775 | 202.106 |

1．3＜NA≦1．4

55＜T≦65

| Case | 6-01 | 6-02 | 6-03 | 6-04 | 6-05 |
|---|---|---|---|---|---|
| $n_{10}$ | 1.896 | 1.875 | 1.705 | 1.705 | 1.708 |
| $k_{10}$ | 0.091 | 0.087 | 0.064 | 0.057 | 0.053 |
| $d_{10}$ (nm) | 15.652 | 14.019 | 225.606 | 220.354 | 218.289 |
| $n_{20}$ | 1.752 | 1.715 | 1.687 | 1.694 | 1.707 |
| $k_{20}$ | 0.303 | 0.239 | 0.232 | 0.186 | 0.158 |
| $d_{20}$ (nm) | 167.408 | 230.256 | 157.678 | 216.433 | 272.538 |

| | | 6-01 | 6-02 | 6-03 | 6-04 | 6-05 |
|---|---|---|---|---|---|---|
| When $n_1 \geq n_{10}$, | $n_{1m}=$ | 1.950 | 1.943 | 1.724 | 1.723 | 1.740 |
| When $n_1 < n_{10}$, | $n_{1m}=$ | 1.875 | 1.846 | 1.699 | 1.693 | 1.693 |
| When $k_1 \geq k_{10}$, | $k_{1m}=$ | 0.122 | 0.132 | 0.079 | 0.077 | 0.077 |
| When $k_1 < k_{10}$, | $k_{1m}=$ | 0.025 | 0.004 | 0.045 | 0.033 | 0.030 |
| When $d_1 \geq d_{10}$, | $d_{1m}$ (nm) $=$ | 19.494 | 18.898 | 247.964 | ∞ | ∞ |
| When $d_1 < d_{10}$, | $d_{1m}$ (nm) $=$ | 14.295 | 12.042 | 221.101 | 210.599 | 206.669 |
| When $n_2 \geq n_{20}$, | $n_{2m}=$ | 1.792 | 1.763 | 1.721 | 1.752 | 1.799 |
| When $n_2 < n_{20}$, | $n_{2m}=$ | 1.662 | 1.612 | 1.638 | 1.648 | 1.579 |
| When $k_2 \geq k_{20}$, | $k_{2m}=$ | 0.337 | 0.279 | 0.301 | 0.247 | 0.230 |
| When $k_2 < k_{20}$, | $k_{2m}=$ | 0.249 | 0.186 | 0.176 | 0.128 | 0.106 |
| When $d_2 \geq d_{20}$, | $d_{2m}$ (nm) $=$ | ∞ | ∞ | 172.085 | ∞ | ∞ |
| When $d_2 < d_{20}$, | $d_{2m}$ (nm) $=$ | 138.575 | 161.008 | 143.974 | 199.200 | 203.487 |

1．3＜NA≦1．4

55＜T≦65

| Case | 6-06 |
|---|---|
| $n_{10}$ | 1.697 |
| $k_{10}$ | 0.047 |
| $d_{10}$ (nm) | 278.413 |
| $n_{20}$ | 1.701 |
| $k_{20}$ | 0.154 |
| $d_{20}$ (nm) | 271.867 |

| | | 6-06 |
|---|---|---|
| When $n_1 \geq n_{10}$, | $n_{1m}=$ | 1.750 |
| When $n_1 < n_{10}$, | $n_{1m}=$ | 1.656 |
| When $k_1 \geq k_{10}$, | $k_{1m}=$ | 0.078 |
| When $k_1 < k_{10}$, | $k_{1m}=$ | 0.022 |
| When $d_1 \geq d_{10}$, | $d_{1m}$ (nm) $=$ | ∞ |
| When $d_1 < d_{10}$, | $d_{1m}$ (nm) $=$ | 213.947 |
| When $n_2 \geq n_{20}$, | $n_{2m}=$ | 1.923 |
| When $n_2 < n_{20}$, | $n_{2m}=$ | 1.614 |
| When $k_2 \geq k_{20}$, | $k_{2m}=$ | 0.223 |
| When $k_2 < k_{20}$, | $k_{2m}=$ | 0.097 |
| When $d_2 \geq d_{20}$, | $d_{2m}$ (nm) $=$ | ∞ |
| When $d_2 < d_{20}$, | $d_{2m}$ (nm) $=$ | 191.019 |

1. 3 < N A ≤ 1. 4

6 5 < T ≤ 7 5

| Case | 7-01 | 7-02 | 7-03 | 7-04 | 7-05 |
|---|---|---|---|---|---|
| $n_{10}$ | 1.901 | 1.871 | 1.866 | 1.706 | 1.705 |
| $k_{10}$ | 0.088 | 0.093 | 0.067 | 0.065 | 0.057 |
| $d_{10}$ (nm) | 16.388 | 14.267 | 13.172 | 225.317 | 220.112 |
| $n_{20}$ | 1.774 | 1.706 | 1.724 | 1.687 | 1.694 |
| $k_{20}$ | 0.318 | 0.241 | 0.206 | 0.238 | 0.188 |
| $d_{20}$ (nm) | 154.194 | 221.319 | 275.098 | 147.740 | 206.685 |

| Case | 7-01 | 7-02 | 7-03 | 7-04 | 7-05 |
|---|---|---|---|---|---|
| When $n_1 \geq n_{10}$, $n_{1m} =$ | 1.955 | 1.937 | 1.947 | 1.721 | 1.721 |
| When $n_1 < n_{10}$, $n_{1m} =$ | 1.881 | 1.842 | 1.823 | 1.701 | 1.693 |
| When $k_1 \geq k_{10}$, $k_{1m} =$ | 0.116 | 0.138 | 0.131 | 0.077 | 0.077 |
| When $k_1 < k_{10}$, $k_{1m} =$ | 0.024 | 0.011 | 0.000 | 0.045 | 0.035 |
| When $d_1 \geq d_{10}$, $d_{1m}$ (nm) $=$ | 20.279 | 19.161 | 19.228 | 239.263 | 245.793 |
| When $d_1 < d_{10}$, $d_{1m}$ (nm) $=$ | 15.118 | 12.240 | 10.142 | 222.197 | 210.312 |
| When $n_2 \geq n_{20}$, $n_{2m} =$ | 1.816 | 1.751 | 1.783 | 1.720 | 1.752 |
| When $n_2 < n_{20}$, $n_{2m} =$ | 1.683 | 1.603 | 1.616 | 1.644 | 1.651 |
| When $k_2 \geq k_{20}$, $k_{2m} =$ | 0.355 | 0.280 | 0.254 | 0.305 | 0.246 |
| When $k_2 < k_{20}$, $k_{2m} =$ | 0.259 | 0.188 | 0.151 | 0.177 | 0.133 |
| When $d_2 \geq d_{20}$, $d_{2m}$ (nm) $=$ | ∞ | ∞ | ∞ | 161.062 | ∞ |
| When $d_2 < d_{20}$, $d_{2m}$ (nm) $=$ | 132.898 | 152.054 | 192.936 | 136.808 | 191.952 |

1. 3 < N A ≤ 1. 4

6 5 < T ≤ 7 5

| Case | 7-06 | 7-07 |
|---|---|---|
| $n_{10}$ | 1.708 | 1.697 |
| $k_{10}$ | 0.053 | 0.047 |
| $d_{10}$ (nm) | 218.342 | 278.070 |
| $n_{20}$ | 1.707 | 1.702 |
| $k_{20}$ | 0.161 | 0.156 |
| $d_{20}$ (nm) | 262.805 | 262.294 |

| Case | 7-06 | 7-07 |
|---|---|---|
| When $n_1 \geq n_{10}$, $n_{1m} =$ | 1.740 | 1.735 |
| When $n_1 < n_{10}$, $n_{1m} =$ | 1.695 | 1.657 |
| When $k_1 \geq k_{10}$, $k_{1m} =$ | 0.077 | 0.077 |
| When $k_1 < k_{10}$, $k_{1m} =$ | 0.032 | 0.024 |
| When $d_1 \geq d_{10}$, $d_{1m}$ (nm) $=$ | ∞ | ∞ |
| When $d_1 < d_{10}$, $d_{1m}$ (nm) $=$ | 208.328 | 215.902 |
| When $n_2 \geq n_{20}$, $n_{2m} =$ | 1.805 | 1.806 |
| When $n_2 < n_{20}$, $n_{2m} =$ | 1.580 | 1.618 |
| When $k_2 \geq k_{20}$, $k_{2m} =$ | 0.232 | 0.224 |
| When $k_2 < k_{20}$, $k_{2m} =$ | 0.108 | 0.097 |
| When $d_2 \geq d_{20}$, $d_{2m}$ (nm) $=$ | ∞ | ∞ |
| When $d_2 < d_{20}$, $d_{2m}$ (nm) $=$ | 195.570 | 182.960 |

1．3＜ＮＡ≦1．4
75＜Ｔ≦85

| Case | 8-01 | 8-02 | 8-03 | 8-04 | 8-05 |
|---|---|---|---|---|---|
| $n_{10}$ | 1.908 | 1.871 | 1.869 | 1.706 | 1.705 |
| $k_{10}$ | 0.087 | 0.097 | 0.067 | 0.067 | 0.058 |
| $d_{10}$ (nm) | 17.362 | 14.654 | 13.479 | 224.641 | 220.026 |
| $n_{20}$ | 1.802 | 1.704 | 1.729 | 1.684 | 1.694 |
| $k_{20}$ | 0.342 | 0.250 | 0.214 | 0.248 | 0.194 |
| $d_{20}$ (nm) | 141.959 | 212.121 | 265.153 | 139.263 | 197.616 |

| | | 8-01 | 8-02 | 8-03 | 8-04 | 8-05 |
|---|---|---|---|---|---|---|
| When $n_1 \geq n_{10}$, | $n_{1m} =$ | 1.960 | 1.935 | 1.947 | 1.720 | 1.721 |
| When $n_1 < n_{10}$, | $n_{1m} =$ | 1.891 | 1.843 | 1.828 | 1.704 | 1.694 |
| When $k_1 \geq k_{10}$, | $k_{1m} =$ | 0.111 | 0.140 | 0.128 | 0.074 | 0.078 |
| When $k_1 < k_{10}$, | $k_{1m} =$ | 0.023 | 0.016 | 0.000 | 0.049 | 0.035 |
| When $d_1 \geq d_{10}$, | $d_{1m}$ (nm) $=$ | 21.165 | 19.437 | 19.380 | 236.042 | 243.446 |
| When $d_1 < d_{10}$, | $d_{1m}$ (nm) $=$ | 16.261 | 12.685 | 10.599 | 223.100 | 210.844 |
| When $n_2 \geq n_{20}$, | $n_{2m} =$ | 1.843 | 1.746 | 1.787 | 1.711 | 1.754 |
| When $n_2 < n_{20}$, | $n_{2m} =$ | 1.713 | 1.604 | 1.618 | 1.641 | 1.649 |
| When $k_2 \geq k_{20}$, | $k_{2m} =$ | 0.382 | 0.288 | 0.262 | 0.299 | 0.249 |
| When $k_2 < k_{20}$, | $k_{2m} =$ | 0.279 | 0.196 | 0.159 | 0.184 | 0.134 |
| When $d_2 \geq d_{20}$, | $d_{2m}$ (nm) $=$ | $\infty$ | $\infty$ | $\infty$ | 151.104 | $\infty$ |
| When $d_2 < d_{20}$, | $d_{2m}$ (nm) $=$ | 126.652 | 177.678 | 187.664 | 128.169 | 181.064 |

1．3＜ＮＡ≦1．4
75＜Ｔ≦85

| Case | 8-06 | 8-07 |
|---|---|---|
| $n_{10}$ | 1.708 | 1.697 |
| $k_{10}$ | 0.054 | 0.048 |
| $d_{10}$ (nm) | 218.429 | 277.999 |
| $n_{20}$ | 1.707 | 1.702 |
| $k_{20}$ | 0.165 | 0.160 |
| $d_{20}$ (nm) | 253.768 | 253.663 |

| | | 8-06 | 8-07 |
|---|---|---|---|
| When $n_1 \geq n_{10}$, | $n_{1m} =$ | 1.739 | 1.730 |
| When $n_1 < n_{10}$, | $n_{1m} =$ | 1.697 | 1.656 |
| When $k_1 \geq k_{10}$, | $k_{1m} =$ | 0.076 | 0.076 |
| When $k_1 < k_{10}$, | $k_{1m} =$ | 0.032 | 0.027 |
| When $d_1 \geq d_{10}$, | $d_{1m}$ (nm) $=$ | $\infty$ | $\infty$ |
| When $d_1 < d_{10}$, | $d_{1m}$ (nm) $=$ | 209.931 | 217.650 |
| When $n_2 \geq n_{20}$, | $n_{2m} =$ | 1.810 | 1.804 |
| When $n_2 < n_{20}$, | $n_{2m} =$ | 1.580 | 1.625 |
| When $k_2 \geq k_{20}$, | $k_{2m} =$ | 0.235 | 0.225 |
| When $k_2 < k_{20}$, | $k_{2m} =$ | 0.109 | 0.100 |
| When $d_2 \geq d_{20}$, | $d_{2m}$ (nm) $=$ | $\infty$ | $\infty$ |
| When $d_2 < d_{20}$, | $d_{2m}$ (nm) $=$ | 216.664 | 177.272 |

$1.3 < NA \leq 1.4$

$85 < T \leq 95$

| Case | 9-01 | 9-02 | 9-03 | 9-04 | 9-05 |
|---|---|---|---|---|---|
| $n_{10}$ | 1.918 | 1.876 | 1.874 | 1.706 | 1.709 |
| $k_{10}$ | 0.092 | 0.100 | 0.069 | 0.060 | 0.055 |
| $d_{10}$ (nm) | 17.977 | 14.944 | 13.674 | 219.996 | 218.382 |
| $n_{20}$ | 1.822 | 1.706 | 1.733 | 1.694 | 1.707 |
| $k_{20}$ | 0.371 | 0.265 | 0.224 | 0.203 | 0.172 |
| $d_{20}$ (nm) | 132.466 | 203.140 | 256.300 | 189.146 | 245.309 |

| | | 9-01 | 9-02 | 9-03 | 9-04 | 9-05 |
|---|---|---|---|---|---|---|
| When $n_1 \geq n_{10}$, | $n_{1m} =$ | 1.966 | 1.936 | 1.950 | 1.723 | 1.738 |
| When $n_1 < n_{10}$, | $n_{1m} =$ | 1.905 | 1.851 | 1.836 | 1.696 | 1.699 |
| When $k_1 \geq k_{10}$, | $k_{1m} =$ | 0.109 | 0.138 | 0.126 | 0.078 | 0.075 |
| When $k_1 < k_{10}$, | $k_{1m} =$ | 0.028 | 0.021 | 0.000 | 0.035 | 0.032 |
| When $d_1 \geq d_{10}$, | $d_{1m}$ (nm) $=$ | 21.461 | 19.418 | 19.237 | 242.566 | $\infty$ |
| When $d_1 < d_{10}$, | $d_{1m}$ (nm) $=$ | 17.167 | 13.206 | 11.040 | 212.120 | 211.373 |
| When $n_2 \geq n_{20}$, | $n_{2m} =$ | 1.855 | 1.745 | 1.789 | 1.754 | 1.811 |
| When $n_2 < n_{20}$, | $n_{2m} =$ | 1.737 | 1.611 | 1.626 | 1.644 | 1.579 |
| When $k_2 \geq k_{20}$, | $k_{2m} =$ | 0.407 | 0.300 | 0.271 | 0.255 | 0.237 |
| When $k_2 < k_{20}$, | $k_{2m} =$ | 0.308 | 0.211 | 0.169 | 0.143 | 0.115 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 121.537 | 173.052 | 183.002 | 168.954 | 213.072 |

$1.3 < NA \leq 1.4$

$85 < T \leq 95$

| Case | 9-06 |
|---|---|
| $n_{10}$ | 1.697 |
| $k_{10}$ | 0.050 |
| $d_{10}$ (nm) | 278.074 |
| $n_{20}$ | 1.701 |
| $k_{20}$ | 0.166 |
| $d_{20}$ (nm) | 245.468 |

| | | 9-06 |
|---|---|---|
| When $n_1 \geq n_{10}$, | $n_{1m} =$ | 1.728 |
| When $n_1 < n_{10}$, | $n_{1m} =$ | 1.655 |
| When $k_1 \geq k_{10}$, | $k_{1m} =$ | 0.075 |
| When $k_1 < k_{10}$, | $k_{1m} =$ | 0.029 |
| When $d_1 \geq d_{10}$, | $d_{1m}$ (nm) $=$ | $\infty$ |
| When $d_1 < d_{10}$, | $d_{1m}$ (nm) $=$ | 219.101 |
| When $n_2 \geq n_{20}$, | $n_{2m} =$ | 1.805 |
| When $n_2 < n_{20}$, | $n_{2m} =$ | 1.636 |
| When $k_2 \geq k_{20}$, | $k_{2m} =$ | 0.226 |
| When $k_2 < k_{20}$, | $k_{2m} =$ | 0.106 |
| When $d_2 \geq d_{20}$, | $d_{2m}$ (nm) $=$ | $\infty$ |
| When $d_2 < d_{20}$, | $d_{2m}$ (nm) $=$ | 172.052 |

1. 3 < N A ≤ 1. 4
9 5 < T ≤ 1 0 5

| | 10-01 | 10-02 | 10-03 | 10-04 | 10-05 |
|---|---|---|---|---|---|
| $n_{10}$ | 1.929 | 1.883 | 1.880 | 1.707 | 1.709 |
| $k_{10}$ | 0.101 | 0.103 | 0.071 | 0.062 | 0.057 |
| $d_{10}$ (nm) | 17.864 | 14.973 | 13.709 | 219.774 | 218.071 |
| $n_{20}$ | 1.821 | 1.709 | 1.736 | 1.693 | 1.706 |
| $k_{20}$ | 0.398 | 0.279 | 0.234 | 0.214 | 0.179 |
| $d_{20}$ (nm) | 125.532 | 194.479 | 247.823 | 180.753 | 237.020 |

| | | 10-01 | 10-02 | 10-03 | 10-04 | 10-05 |
|---|---|---|---|---|---|---|
| When $n_1 \geq n_{10}$, | $n_{1m} =$ | 1.973 | 1.940 | 1.953 | 1.724 | 1.737 |
| When $n_1 < n_{10}$, | $n_{1m} =$ | 1.922 | 1.863 | 1.845 | 1.698 | 1.701 |
| When $k_1 \geq k_{10}$, | $k_{1m} =$ | 0.111 | 0.136 | 0.124 | 0.077 | 0.074 |
| When $k_1 < k_{10}$, | $k_{1m} =$ | 0.042 | 0.027 | 0.000 | 0.035 | 0.034 |
| When $d_1 \geq d_{10}$, | $d_{1m}$ (nm) $=$ | 20.839 | 19.023 | 18.857 | 241.722 | ∞ |
| When $d_1 < d_{10}$, | $d_{1m}$ (nm) $=$ | 17.465 | 13.566 | 11.352 | 213.515 | 212.546 |
| When $n_2 \geq n_{20}$, | $n_{2m} =$ | 1.840 | 1.742 | 1.789 | 1.751 | 1.807 |
| When $n_2 < n_{20}$, | $n_{2m} =$ | 1.743 | 1.619 | 1.632 | 1.642 | 1.577 |
| When $k_2 \geq k_{20}$, | $k_{2m} =$ | 0.418 | 0.310 | 0.278 | 0.260 | 0.236 |
| When $k_2 < k_{20}$, | $k_{2m} =$ | 0.340 | 0.227 | 0.180 | 0.155 | 0.122 |
| When $d_2 \geq d_{20}$, | $d_{2m}$ (nm) $=$ | 161.544 | ∞ | ∞ | ∞ | ∞ |
| When $d_2 < d_{20}$, | $d_{2m}$ (nm) $=$ | 119.422 | 166.497 | 178.361 | 161.067 | 205.891 |

1. 3 < N A ≤ 1. 4
9 5 < T ≤ 1 0 5

| Case | 10-06 |
|---|---|
| $n_{10}$ | 1.697 |
| $k_{10}$ | 0.047 |
| $d_{10}$ (nm) | 275.083 |
| $n_{20}$ | 1.700 |
| $k_{20}$ | 0.148 |
| $d_{20}$ (nm) | 295.680 |

| | | 10-06 |
|---|---|---|
| When $n_1 \geq n_{10}$, | $n_{1m} =$ | 1.768 |
| When $n_1 < n_{10}$, | $n_{1m} =$ | 1.650 |
| When $k_1 \geq k_{10}$, | $k_{1m} =$ | 0.079 |
| When $k_1 < k_{10}$, | $k_{1m} =$ | 0.023 |
| When $d_1 \geq d_{10}$, | $d_{1m}$ (nm) $=$ | ∞ |
| When $d_1 < d_{10}$, | $d_{1m}$ (nm) $=$ | 200.276 |
| When $n_2 \geq n_{20}$, | $n_{2m} =$ | 1.849 |
| When $n_2 < n_{20}$, | $n_{2m} =$ | 1.604 |
| When $k_2 \geq k_{20}$, | $k_{2m} =$ | 0.227 |
| When $k_2 < k_{20}$, | $k_{2m} =$ | 0.093 |
| When $d_2 \geq d_{20}$, | $d_{2m}$ (nm) $=$ | ∞ |
| When $d_2 < d_{20}$, | $d_{2m}$ (nm) $=$ | 212.971 |

$1.3 < NA \leq 1.4$

$105 < T \leq 115$

| Case | 11-01 | 11-02 | 11-03 | 11-04 | 11-05 |
|---|---|---|---|---|---|
| $n_{10}$ | 1.891 | 1.885 | 1.707 | 1.709 | 1.697 |
| $k_{10}$ | 0.108 | 0.074 | 0.064 | 0.058 | 0.048 |
| $d_{10}$ (nm) | 14.702 | 13.594 | 219.485 | 217.678 | 275.043 |
| $n_{20}$ | 1.707 | 1.735 | 1.692 | 1.705 | 1.701 |
| $k_{20}$ | 0.289 | 0.241 | 0.223 | 0.184 | 0.152 |
| $d_{20}$ (nm) | 186.368 | 239.426 | 171.867 | 228.411 | 286.426 |

| | | 11-01 | 11-02 | 11-03 | 11-04 | 11-05 |
|---|---|---|---|---|---|---|
| When $n_1 \geq n_{10}$, | $n_{1m} =$ | 1.944 | 1.955 | 1.723 | 1.736 | 1.767 |
| When $n_1 < n_{10}$, | $n_{1m} =$ | 1.874 | 1.853 | 1.700 | 1.703 | 1.650 |
| When $k_1 \geq k_{10}$, | $k_{1m} =$ | 0.135 | 0.124 | 0.077 | 0.073 | 0.078 |
| When $k_1 < k_{10}$, | $k_{1m} =$ | 0.035 | 0.000 | 0.037 | 0.036 | 0.023 |
| When $d_1 \geq d_{10}$, | $d_{1m}$ (nm) $=$ | 18.320 | 18.363 | 240.271 | ∞ | ∞ |
| When $d_1 < d_{10}$, | $d_{1m}$ (nm) $=$ | 13.618 | 11.476 | 214.658 | 213.396 | 201.239 |
| When $n_2 \geq n_{20}$, | $n_{2m} =$ | 1.733 | 1.786 | 1.744 | 1.797 | 1.850 |
| When $n_2 < n_{20}$, | $n_{2m} =$ | 1.620 | 1.632 | 1.646 | 1.574 | 1.606 |
| When $k_2 \geq k_{20}$, | $k_{2m} =$ | 0.314 | 0.282 | 0.261 | 0.232 | 0.229 |
| When $k_2 < k_{20}$, | $k_{2m} =$ | 0.241 | 0.188 | 0.163 | 0.126 | 0.094 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 157.397 | 173.024 | 156.390 | 195.169 | 202.551 |

1.3 < NA ≤ 1.4
115 < T ≤ 125

| Case | | 12-01 | 12-02 | 12-03 | 12-04 | 12-05 |
|---|---|---|---|---|---|---|
| $n_{10}$ | | 1.896 | 1.887 | 1.692 | 1.707 | 1.709 |
| $k_{10}$ | | 0.113 | 0.078 | 0.059 | 0.065 | 0.059 |
| $d_{10}$ (nm) | | 14.435 | 13.577 | 153.772 | 219.581 | 217.561 |
| $n_{20}$ | | 1.703 | 1.733 | 1.694 | 1.692 | 1.702 |
| $k_{20}$ | | 0.295 | 0.244 | 0.154 | 0.231 | 0.188 |
| $d_{20}$ (nm) | | 177.615 | 230.253 | 284.837 | 161.904 | 219.131 |

| When $n_1 \geq n_{10}$, | $n_{1m}=$ | 1.947 | 1.955 | 1.718 | 1.720 | 1.728 |
|---|---|---|---|---|---|---|
| When $n_1 < n_{10}$, | $n_{1m}=$ | 1.882 | 1.856 | 1.664 | 1.701 | 1.703 |
| When $k_1 \geq k_{10}$, | $k_{1m}=$ | 0.136 | 0.126 | 0.090 | 0.076 | 0.072 |
| When $k_1 < k_{10}$, | $k_{1m}=$ | 0.044 | 0.000 | 0.044 | 0.041 | 0.040 |
| When $d_1 \geq d_{10}$, | $d_{1m}$ (nm) $=$ | 17.718 | 18.125 | 175.199 | 231.299 | ∞ |
| When $d_1 < d_{10}$, | $d_{1m}$ (nm) $=$ | 13.578 | 11.595 | 128.388 | 215.799 | 214.049 |
| When $n_2 \geq n_{20}$, | $n_{2m}=$ | 1.725 | 1.783 | 1.772 | 1.738 | 1.784 |
| When $n_2 < n_{20}$, | $n_{2m}=$ | 1.617 | 1.629 | 1.642 | 1.658 | 1.629 |
| When $k_2 \geq k_{20}$, | $k_{2m}=$ | 0.315 | 0.284 | 0.182 | 0.262 | 0.229 |
| When $k_2 < k_{20}$, | $k_{2m}=$ | 0.249 | 0.192 | 0.119 | 0.174 | 0.128 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 145.196 | 165.335 | 240.440 | 152.266 | 193.496 |

1.3 < NA ≤ 1.4
115 < T ≤ 125

| Case | | 12-06 | 12-07 |
|---|---|---|---|
| $n_{10}$ | | 1.707 | 1.697 |
| $k_{10}$ | | 0.053 | 0.048 |
| $d_{10}$ (nm) | | 216.484 | 274.812 |
| $n_{20}$ | | 1.695 | 1.701 |
| $k_{20}$ | | 0.157 | 0.154 |
| $d_{20}$ (nm) | | 278.062 | 276.656 |

| When $n_1 \geq n_{10}$, | $n_{1m}=$ | 1.748 | 1.768 |
|---|---|---|---|
| When $n_1 < n_{10}$, | $n_{1m}=$ | 1.689 | 1.651 |
| When $k_1 \geq k_{10}$, | $k_{1m}=$ | 0.077 | 0.078 |
| When $k_1 < k_{10}$, | $k_{1m}=$ | 0.030 | 0.024 |
| When $d_1 \geq d_{10}$, | $d_{1m}$ (nm) $=$ | ∞ | ∞ |
| When $d_1 < d_{10}$, | $d_{1m}$ (nm) $=$ | 199.849 | 201.932 |
| When $n_2 \geq n_{20}$, | $n_{2m}=$ | 1.761 | 1.850 |
| When $n_2 < n_{20}$, | $n_{2m}=$ | 1.583 | 1.607 |
| When $k_2 \geq k_{20}$, | $k_{2m}=$ | 0.215 | 0.229 |
| When $k_2 < k_{20}$, | $k_{2m}=$ | 0.104 | 0.098 |
| When $d_2 \geq d_{20}$, | $d_{2m}$ (nm) $=$ | ∞ | ∞ |
| When $d_2 < d_{20}$, | $d_{2m}$ (nm) $=$ | 212.463 | 192.106 |

1. 3 < N A ≤ 1. 4
1 2 5 < T ≤ 1 3 5

| Case | 13-01 | 13-02 | 13-03 | 13-04 | 13-05 |
|---|---|---|---|---|---|
| $n_{10}$ | 1.898 | 1.885 | 1.868 | 1.707 | 1.708 |
| $k_{10}$ | 0.115 | 0.081 | 0.075 | 0.067 | 0.060 |
| $d_{10}$ (nm) | 14.632 | 13.917 | 12.752 | 219.938 | 217.756 |
| $n_{20}$ | 1.705 | 1.732 | 1.713 | 1.695 | 1.701 |
| $k_{20}$ | 0.303 | 0.248 | 0.206 | 0.239 | 0.192 |
| $d_{20}$ (nm) | 166.646 | 219.851 | 279.921 | 151.390 | 209.457 |

| | | 13-01 | 13-02 | 13-03 | 13-04 | 13-05 |
|---|---|---|---|---|---|---|
| When $n_1 \geq n_{10}$, | $n_{1m}=$ | 1.949 | 1.951 | 1.949 | 1.716 | 1.721 |
| When $n_1 < n_{10}$, | $n_{1m}=$ | 1.886 | 1.855 | 1.830 | 1.703 | 1.704 |
| When $k_1 \geq k_{10}$, | $k_{1m}=$ | 0.135 | 0.127 | 0.135 | 0.075 | 0.072 |
| When $k_1 < k_{10}$, | $k_{1m}=$ | 0.050 | 0.002 | 0.000 | 0.050 | 0.045 |
| When $d_1 \geq d_{10}$, | $d_{1m}$ (nm) $=$ | 17.809 | 18.468 | 18.469 | 226.140 | ∞ |
| When $d_1 < d_{10}$, | $d_{1m}$ (nm) $=$ | 13.869 | 11.960 | 10.161 | 217.246 | 214.692 |
| When $n_2 \geq n_{20}$, | $n_{2m}=$ | 1.725 | 1.781 | 1.771 | 1.731 | 1.769 |
| When $n_2 < n_{20}$, | $n_{2m}=$ | 1.618 | 1.628 | 1.611 | 1.678 | 1.659 |
| When $k_2 \geq k_{20}$, | $k_{2m}=$ | 0.322 | 0.288 | 0.250 | 0.263 | 0.228 |
| When $k_2 < k_{20}$, | $k_{2m}=$ | 0.256 | 0.194 | 0.153 | 0.185 | 0.138 |
| When $d_2 \geq d_{20}$, | $d_{2m}$ (nm) $=$ | ∞ | ∞ | ∞ | 179.041 | ∞ |
| When $d_2 < d_{20}$, | $d_{2m}$ (nm) $=$ | 136.370 | 153.796 | 194.427 | 147.510 | 199.403 |

1. 3 < N A ≤ 1. 4
1 2 5 < T ≤ 1 3 5

| Case | 13-06 | 13-07 |
|---|---|---|
| $n_{10}$ | 1.706 | 1.696 |
| $k_{10}$ | 0.054 | 0.049 |
| $d_{10}$ (nm) | 217.065 | 274.075 |
| $n_{20}$ | 1.694 | 1.702 |
| $k_{20}$ | 0.160 | 0.157 |
| $d_{20}$ (nm) | 268.021 | 267.366 |

| | | 13-06 | 13-07 |
|---|---|---|---|
| When $n_1 \geq n_{10}$, | $n_{1m}=$ | 1.746 | 1.770 |
| When $n_1 < n_{10}$, | $n_{1m}=$ | 1.690 | 1.651 |
| When $k_1 \geq k_{10}$, | $k_{1m}=$ | 0.077 | 0.078 |
| When $k_1 < k_{10}$, | $k_{1m}=$ | 0.033 | 0.026 |
| When $d_1 \geq d_{10}$, | $d_{1m}$ (nm) $=$ | ∞ | ∞ |
| When $d_1 < d_{10}$, | $d_{1m}$ (nm) $=$ | 202.380 | 202.716 |
| When $n_2 \geq n_{20}$, | $n_{2m}=$ | 1.761 | 1.853 |
| When $n_2 < n_{20}$, | $n_{2m}=$ | 1.586 | 1.608 |
| When $k_2 \geq k_{20}$, | $k_{2m}=$ | 0.219 | 0.227 |
| When $k_2 < k_{20}$, | $k_{2m}=$ | 0.106 | 0.099 |
| When $d_2 \geq d_{20}$, | $d_{2m}$ (nm) $=$ | ∞ | ∞ |
| When $d_2 < d_{20}$, | $d_{2m}$ (nm) $=$ | 208.129 | 186.947 |

1. 3 < N A ≤ 1. 4
1 3 5 < T ≤ 1 4 5

| Case | 14-01 | 14-02 | 14-03 | 14-04 | 14-05 |
|---|---|---|---|---|---|
| $n_{10}$ | 1.899 | 1.882 | 1.870 | 1.708 | 1.707 |
| $k_{10}$ | 0.115 | 0.083 | 0.074 | 0.062 | 0.055 |
| $d_{10}$ (nm) | 15.367 | 14.477 | 13.063 | 217.887 | 217.378 |
| $n_{20}$ | 1.714 | 1.732 | 1.717 | 1.700 | 1.693 |
| $k_{20}$ | 0.318 | 0.256 | 0.212 | 0.197 | 0.164 |
| $d_{20}$ (nm) | 155.141 | 209.893 | 269.637 | 200.272 | 258.646 |

| | | 14-01 | 14-02 | 14-03 | 14-04 | 14-05 |
|---|---|---|---|---|---|---|
| When $n_1 \geq n_{10}$, | $n_{1m} =$ | 1.949 | 1.947 | 1.949 | 1.716 | 1.744 |
| When $n_1 < n_{10}$, | $n_{1m} =$ | 1.888 | 1.854 | 1.833 | 1.704 | 1.691 |
| When $k_1 \geq k_{10}$, | $k_{1m} =$ | 0.132 | 0.127 | 0.132 | 0.071 | 0.077 |
| When $k_1 < k_{10}$, | $k_{1m} =$ | 0.051 | 0.006 | 0.000 | 0.050 | 0.036 |
| When $d_1 \geq d_{10}$, | $d_{1m}$ (nm) $=$ | 18.581 | 19.085 | 18.767 | ∞ | ∞ |
| When $d_1 < d_{10}$, | $d_{1m}$ (nm) $=$ | 14.660 | 12.539 | 10.533 | 215.374 | 204.778 |
| When $n_2 \geq n_{20}$, | $n_{2m} =$ | 1.733 | 1.780 | 1.774 | 1.754 | 1.760 |
| When $n_2 < n_{20}$, | $n_{2m} =$ | 1.627 | 1.630 | 1.611 | 1.677 | 1.592 |
| When $k_2 \geq k_{20}$, | $k_{2m} =$ | 0.337 | 0.296 | 0.256 | 0.228 | 0.223 |
| When $k_2 < k_{20}$, | $k_{2m} =$ | 0.266 | 0.200 | 0.157 | 0.152 | 0.109 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 131.038 | 171.650 | 189.575 | 195.166 | 202.001 |

1. 3 < N A ≤ 1. 4
1 3 5 < T ≤ 1 4 5

| Case | 14-06 |
|---|---|
| $n_{10}$ | 1.696 |
| $k_{10}$ | 0.050 |
| $d_{10}$ (nm) | 273.384 |
| $n_{20}$ | 1.702 |
| $k_{20}$ | 0.160 |
| $d_{20}$ (nm) | 258.714 |

| | | 14-06 |
|---|---|---|
| When $n_1 \geq n_{10}$, | $n_{1m} =$ | 1.741 |
| When $n_1 < n_{10}$, | $n_{1m} =$ | 1.652 |
| When $k_1 \geq k_{10}$, | $k_{1m} =$ | 0.078 |
| When $k_1 < k_{10}$, | $k_{1m} =$ | 0.028 |
| When $d_1 \geq d_{10}$, | $d_{1m}$ (nm) $=$ | ∞ |
| When $d_1 < d_{10}$, | $d_{1m}$ (nm) $=$ | 209.881 |
| When $n_2 \geq n_{20}$, | $n_{2m} =$ | 1.859 |
| When $n_2 < n_{20}$, | $n_{2m} =$ | 1.608 |
| When $k_2 \geq k_{20}$, | $k_{2m} =$ | 0.226 |
| When $k_2 < k_{20}$, | $k_{2m} =$ | 0.098 |
| When $d_2 \geq d_{20}$, | $d_{2m}$ (nm) $=$ | ∞ |
| When $d_2 < d_{20}$, | $d_{2m}$ (nm) $=$ | 178.700 |

1. 3 < N A ≤ 1. 4
1 4 5 < T ≤ 1 5 5

| Case | 15-01 | 15-02 | 15-03 | 15-04 | 15-05 |
|---|---|---|---|---|---|
| $n_{10}$ | 1.903 | 1.884 | 1.874 | 1.708 | 1.707 |
| $k_{10}$ | 0.118 | 0.087 | 0.075 | 0.063 | 0.056 |
| $d_{10}$ (nm) | 16.130 | 14.896 | 13.357 | 217.693 | 217.044 |
| $n_{20}$ | 1.723 | 1.733 | 1.722 | 1.700 | 1.694 |
| $k_{20}$ | 0.340 | 0.268 | 0.221 | 0.205 | 0.169 |
| $d_{20}$ (nm) | 145.164 | 201.113 | 260.240 | 191.744 | 250.083 |

| | | 15-01 | 15-02 | 15-03 | 15-04 | 15-05 |
|---|---|---|---|---|---|---|
| When $n_1 \geq n_{10}$, | $n_{1m} =$ | 1.950 | 1.946 | 1.951 | 1.714 | 1.742 |
| When $n_1 < n_{10}$, | $n_{1m} =$ | 1.895 | 1.858 | 1.839 | 1.706 | 1.694 |
| When $k_1 \geq k_{10}$, | $k_{1m} =$ | 0.130 | 0.127 | 0.128 | 0.070 | 0.076 |
| When $k_1 < k_{10}$, | $k_{1m} =$ | 0.053 | 0.010 | 0.000 | 0.053 | 0.038 |
| When $d_1 \geq d_{10}$, | $d_{1m}$ (nm) $=$ | 19.240 | 19.361 | 18.857 | 222.035 | ∞ |
| When $d_1 < d_{10}$, | $d_{1m}$ (nm) $=$ | 15.619 | 13.105 | 10.992 | 216.109 | 206.771 |
| When $n_2 \geq n_{20}$, | $n_{2m} =$ | 1.737 | 1.779 | 1.777 | 1.735 | 1.755 |
| When $n_2 < n_{20}$, | $n_{2m} =$ | 1.641 | 1.636 | 1.612 | 1.682 | 1.595 |
| When $k_2 \geq k_{20}$, | $k_{2m} =$ | 0.356 | 0.307 | 0.265 | 0.225 | 0.223 |
| When $k_2 < k_{20}$, | $k_{2m} =$ | 0.286 | 0.211 | 0.166 | 0.161 | 0.114 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 126.286 | 170.199 | 185.156 | 187.971 | 215.684 |

1. 3 < N A ≤ 1. 4
1 4 5 < T ≤ 1 5 5

| Case | 15-06 |
|---|---|
| $n_{10}$ | 1.696 |
| $k_{10}$ | 0.051 |
| $d_{10}$ (nm) | 273.493 |
| $n_{20}$ | 1.702 |
| $k_{20}$ | 0.165 |
| $d_{20}$ (nm) | 250.180 |

| | | 15-06 |
|---|---|---|
| When $n_1 \geq n_{10}$, | $n_{1m} =$ | 1.738 |
| When $n_1 < n_{10}$, | $n_{1m} =$ | 1.652 |
| When $k_1 \geq k_{10}$, | $k_{1m} =$ | 0.078 |
| When $k_1 < k_{10}$, | $k_{1m} =$ | 0.031 |
| When $d_1 \geq d_{10}$, | $d_{1m}$ (nm) $=$ | ∞ |
| When $d_1 < d_{10}$, | $d_{1m}$ (nm) $=$ | 213.326 |
| When $n_2 \geq n_{20}$, | $n_{2m} =$ | 1.839 |
| When $n_2 < n_{20}$, | $n_{2m} =$ | 1.609 |
| When $k_2 \geq k_{20}$, | $k_{2m} =$ | 0.227 |
| When $k_2 < k_{20}$, | $k_{2m} =$ | 0.102 |
| When $d_2 \geq d_{20}$, | $d_{2m}$ (nm) $=$ | ∞ |
| When $d_2 < d_{20}$, | $d_{2m}$ (nm) $=$ | 171.738 |

1．3＜ＮＡ≦1．4
155＜Ｔ≦165

| Case | 16-01 | 16-02 | 16-03 | 16-04 | 16-05 |
|---|---|---|---|---|---|
| $n_{10}$ | 1.913 | 1.891 | 1.879 | 1.709 | 1.708 |
| $k_{10}$ | 0.125 | 0.091 | 0.077 | 0.064 | 0.057 |
| $d_{10}$ (nm) | 16.406 | 14.954 | 13.440 | 217.197 | 216.333 |
| $n_{20}$ | 1.727 | 1.734 | 1.724 | 1.700 | 1.694 |
| $k_{20}$ | 0.366 | 0.282 | 0.231 | 0.214 | 0.175 |
| $d_{20}$ (nm) | 136.777 | 193.024 | 251.802 | 183.446 | 241.739 |

| | | 16-01 | 16-02 | 16-03 | 16-04 | 16-05 |
|---|---|---|---|---|---|---|
| When $n_1 \geq n_{10}$, | $n_{1m} =$ | 1.955 | 1.950 | 1.953 | 1.714 | 1.742 |
| When $n_1 < n_{10}$, | $n_{1m} =$ | 1.910 | 1.868 | 1.847 | 1.708 | 1.697 |
| When $k_1 \geq k_{10}$, | $k_{1m} =$ | 0.129 | 0.127 | 0.127 | 0.066 | 0.075 |
| When $k_1 < k_{10}$, | $k_{1m} =$ | 0.064 | 0.016 | 0.000 | 0.055 | 0.039 |
| When $d_1 \geq d_{10}$, | $d_{1m}$ (nm) $=$ | 19.185 | 19.061 | 18.574 | 220.596 | ∞ |
| When $d_1 < d_{10}$, | $d_{1m}$ (nm) $=$ | 16.268 | 13.452 | 11.329 | 216.874 | 208.223 |
| When $n_2 \geq n_{20}$, | $n_{2m} =$ | 1.731 | 1.774 | 1.776 | 1.707 | 1.748 |
| When $n_2 < n_{20}$, | $n_{2m} =$ | 1.651 | 1.642 | 1.618 | 1.678 | 1.595 |
| When $k_2 \geq k_{20}$, | $k_{2m} =$ | 0.371 | 0.317 | 0.273 | 0.218 | 0.220 |
| When $k_2 < k_{20}$, | $k_{2m} =$ | 0.314 | 0.227 | 0.177 | 0.165 | 0.120 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 121.662 | 164.818 | 180.821 | 179.468 | 209.260 |

1．3＜ＮＡ≦1．4
155＜Ｔ≦165

| Case | 16-06 |
|---|---|
| $n_{10}$ | 1.696 |
| $k_{10}$ | 0.052 |
| $d_{10}$ (nm) | 274.035 |
| $n_{20}$ | 1.700 |
| $k_{20}$ | 0.171 |
| $d_{20}$ (nm) | 241.498 |

| | | 16-06 |
|---|---|---|
| When $n_1 \geq n_{10}$, | $n_{1m} =$ | 1.735 |
| When $n_1 < n_{10}$, | $n_{1m} =$ | 1.651 |
| When $k_1 \geq k_{10}$, | $k_{1m} =$ | 0.077 |
| When $k_1 < k_{10}$, | $k_{1m} =$ | 0.034 |
| When $d_1 \geq d_{10}$, | $d_{1m}$ (nm) $=$ | ∞ |
| When $d_1 < d_{10}$, | $d_{1m}$ (nm) $=$ | 215.451 |
| When $n_2 \geq n_{20}$, | $n_{2m} =$ | 1.840 |
| When $n_2 < n_{20}$, | $n_{2m} =$ | 1.612 |
| When $k_2 \geq k_{20}$, | $k_{2m} =$ | 0.229 |
| When $k_2 < k_{20}$, | $k_{2m} =$ | 0.108 |
| When $d_2 \geq d_{20}$, | $d_{2m}$ (nm) $=$ | ∞ |
| When $d_2 < d_{20}$, | $d_{2m}$ (nm) $=$ | 166.208 |

1. 3 < N A ≤ 1. 4
1 6 5 < T ≤ 1 7 5

| Case | 17-01 | 17-02 | 17-03 | 17-04 |
|---|---|---|---|---|
| $n_{10}$ | 1.900 | 1.885 | 1.708 | 1.697 |
| $k_{10}$ | 0.097 | 0.082 | 0.058 | 0.048 |
| $d_{10}$ (nm) | 14.674 | 13.311 | 215.615 | 273.453 |
| $n_{20}$ | 1.732 | 1.722 | 1.694 | 1.699 |
| $k_{20}$ | 0.294 | 0.239 | 0.180 | 0.151 |
| $d_{20}$ (nm) | 185.336 | 243.911 | 233.152 | 289.720 |

| | | 17-01 | 17-02 | 17-03 | 17-04 |
|---|---|---|---|---|---|
| When $n_1 \geq n_{10}$, | $n_{1m} =$ | 1.955 | 1.956 | 1.741 | 1.736 |
| When $n_1 < n_{10}$, | $n_{1m} =$ | 1.881 | 1.856 | 1.699 | 1.650 |
| When $k_1 \geq k_{10}$, | $k_{1m} =$ | 0.126 | 0.128 | 0.074 | 0.080 |
| When $k_1 < k_{10}$, | $k_{1m} =$ | 0.023 | 0.000 | 0.039 | 0.020 |
| When $d_1 \geq d_{10}$, | $d_{1m}$ (nm) $=$ | 18.346 | 18.029 | ∞ | ∞ |
| When $d_1 < d_{10}$, | $d_{1m}$ (nm) $=$ | 13.519 | 11.467 | 209.091 | 211.222 |
| When $n_2 \geq n_{20}$, | $n_{2m} =$ | 1.767 | 1.769 | 1.740 | 1.868 |
| When $n_2 < n_{20}$, | $n_{2m} =$ | 1.645 | 1.618 | 1.591 | 1.614 |
| When $k_2 \geq k_{20}$, | $k_{2m} =$ | 0.322 | 0.277 | 0.217 | 0.224 |
| When $k_2 < k_{20}$, | $k_{2m} =$ | 0.243 | 0.187 | 0.126 | 0.094 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 156.774 | 176.585 | 198.961 | 204.980 |

1. 3 < N A ≤ 1. 4
1 7 5 < T ≤ 1 8 5

| Case | 18-01 | 18-02 | 18-03 | 18-04 | 18-05 |
|---|---|---|---|---|---|
| $n_{10}$ | 1.908 | 1.888 | 1.708 | 1.709 | 1.697 |
| $k_{10}$ | 0.102 | 0.088 | 0.059 | 0.054 | 0.049 |
| $d_{10}$ (nm) | 14.316 | 13.163 | 215.377 | 215.137 | 273.522 |
| $n_{20}$ | 1.730 | 1.716 | 1.693 | 1.702 | 1.700 |
| $k_{20}$ | 0.303 | 0.243 | 0.185 | 0.158 | 0.154 |
| $d_{20}$ (nm) | 177.238 | 235.819 | 223.802 | 279.418 | 279.960 |

| | | 18-01 | 18-02 | 18-03 | 18-04 | 18-05 |
|---|---|---|---|---|---|---|
| When $n_1 \geq n_{10}$, | $n_{1m} =$ | 1.960 | 1.956 | 1.740 | 1.745 | 1.734 |
| When $n_1 < n_{10}$, | $n_{1m} =$ | 1.893 | 1.861 | 1.700 | 1.696 | 1.657 |
| When $k_1 \geq k_{10}$, | $k_{1m} =$ | 0.126 | 0.131 | 0.073 | 0.075 | 0.079 |
| When $k_1 < k_{10}$, | $k_{1m} =$ | 0.031 | 0.002 | 0.041 | 0.028 | 0.020 |
| When $d_1 \geq d_{10}$, | $d_{1m}$ (nm) $=$ | 17.569 | 17.540 | ∞ | ∞ | ∞ |
| When $d_1 < d_{10}$, | $d_{1m}$ (nm) $=$ | 13.467 | 11.504 | 209.546 | 205.939 | 213.387 |
| When $n_2 \geq n_{20}$, | $n_{2m} =$ | 1.759 | 1.759 | 1.736 | 1.790 | 1.874 |
| When $n_2 < n_{20}$, | $n_{2m} =$ | 1.644 | 1.611 | 1.587 | 1.604 | 1.617 |
| When $k_2 \geq k_{20}$, | $k_{2m} =$ | 0.325 | 0.278 | 0.217 | 0.211 | 0.226 |
| When $k_2 < k_{20}$, | $k_{2m} =$ | 0.256 | 0.193 | 0.129 | 0.105 | 0.095 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 143.259 | 171.381 | 185.714 | 201.921 | 193.505 |

1．3 ＜ N A ≦ 1．4
1 8 5 ＜ T ≦ 1 9 5

| Case | 19-01 | 19-02 | 19-03 | 19-04 | 19-05 |
|---|---|---|---|---|---|
| $n_{10}$ | 1.914 | 1.886 | 1.873 | 1.692 | 1.708 |
| $k_{10}$ | 0.104 | 0.093 | 0.070 | 0.060 | 0.060 |
| $d_{10}$ (nm) | 14.390 | 13.299 | 12.581 | 152.854 | 215.913 |
| $n_{20}$ | 1.735 | 1.710 | 1.721 | 1.693 | 1.692 |
| $k_{20}$ | 0.314 | 0.247 | 0.208 | 0.157 | 0.189 |
| $d_{20}$ (nm) | 166.400 | 226.131 | 280.628 | 278.359 | 213.567 |

| | | 19-01 | 19-02 | 19-03 | 19-04 | 19-05 |
|---|---|---|---|---|---|---|
| When $n_1 \geq n_{10}$, | $n_{1m} =$ | 1.964 | 1.952 | 1.955 | 1.709 | 1.739 |
| When $n_1 < n_{10}$, | $n_{1m} =$ | 1.903 | 1.860 | 1.833 | 1.664 | 1.699 |
| When $k_1 \geq k_{10}$, | $k_{1m} =$ | 0.123 | 0.135 | 0.133 | 0.092 | 0.074 |
| When $k_1 < k_{10}$, | $k_{1m} =$ | 0.040 | 0.012 | 0.000 | 0.042 | 0.044 |
| When $d_1 \geq d_{10}$, | $d_{1m}$ (nm) $=$ | 17.353 | 17.539 | 18.087 | 163.046 | $\infty$ |
| When $d_1 < d_{10}$, | $d_{1m}$ (nm) $=$ | 13.759 | 11.668 | 9.947 | 129.659 | 210.046 |
| When $n_2 \geq n_{20}$, | $n_{2m} =$ | 1.759 | 1.750 | 1.778 | 1.784 | 1.739 |
| When $n_2 < n_{20}$, | $n_{2m} =$ | 1.648 | 1.604 | 1.614 | 1.659 | 1.586 |
| When $k_2 \geq k_{20}$, | $k_{2m} =$ | 0.331 | 0.280 | 0.252 | 0.196 | 0.222 |
| When $k_2 < k_{20}$, | $k_{2m} =$ | 0.267 | 0.196 | 0.156 | 0.120 | 0.129 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 144.756 | 162.922 | 193.262 | 243.485 | 177.669 |

1．3 ＜ N A ≦ 1．4
1 8 5 ＜ T ≦ 1 9 5

| Case | 19-06 | 19-07 |
|---|---|---|
| $n_{10}$ | 1.708 | 1.697 |
| $k_{10}$ | 0.054 | 0.050 |
| $d_{10}$ (nm) | 215.905 | 273.350 |
| $n_{20}$ | 1.701 | 1.701 |
| $k_{20}$ | 0.161 | 0.157 |
| $d_{20}$ (nm) | 269.362 | 270.178 |

| | | 19-06 | 19-07 |
|---|---|---|---|
| When $n_1 \geq n_{10}$, | $n_{1m} =$ | 1.744 | 1.732 |
| When $n_1 < n_{10}$, | $n_{1m} =$ | 1.697 | 1.658 |
| When $k_1 \geq k_{10}$, | $k_{1m} =$ | 0.075 | 0.078 |
| When $k_1 < k_{10}$, | $k_{1m} =$ | 0.029 | 0.021 |
| When $d_1 \geq d_{10}$, | $d_{1m}$ (nm) $=$ | $\infty$ | $\infty$ |
| When $d_1 < d_{10}$, | $d_{1m}$ (nm) $=$ | 207.633 | 215.326 |
| When $n_2 \geq n_{20}$, | $n_{2m} =$ | 1.795 | 1.877 |
| When $n_2 < n_{20}$, | $n_{2m} =$ | 1.605 | 1.619 |
| When $k_2 \geq k_{20}$, | $k_{2m} =$ | 0.216 | 0.228 |
| When $k_2 < k_{20}$, | $k_{2m} =$ | 0.105 | 0.098 |
| When $d_2 \geq d_{20}$, | $d_{2m}$ (nm) $=$ | $\infty$ | $\infty$ |
| When $d_2 < d_{20}$, | $d_{2m}$ (nm) $=$ | 205.481 | 189.945 |

1. 3 < N A ≤ 1. 4
1 9 5 < T ≤ 2 0 5

| Case | 20-01 | 20-02 | 20-03 | 20-04 | 20-05 |
|---|---|---|---|---|---|
| $n_{10}$ | 1.918 | 1.883 | 1.874 | 1.707 | 1.708 |
| $k_{10}$ | 0.103 | 0.095 | 0.068 | 0.061 | 0.055 |
| $d_{10}$ (nm) | 15.177 | 13.742 | 12.955 | 216.749 | 216.874 |
| $n_{20}$ | 1.753 | 1.708 | 1.728 | 1.693 | 1.699 |
| $k_{20}$ | 0.331 | 0.252 | 0.214 | 0.194 | 0.165 |
| $d_{20}$ (nm) | 153.467 | 215.835 | 269.400 | 203.628 | 259.716 |

| | | 20-01 | 20-02 | 20-03 | 20-04 | 20-05 |
|---|---|---|---|---|---|---|
| When $n_1 \geq n_{10}$, | $n_{1m}=$ | 1.966 | 1.948 | 1.955 | 1.739 | 1.743 |
| When $n_1 < n_{10}$, | $n_{1m}=$ | 1.909 | 1.857 | 1.835 | 1.699 | 1.698 |
| When $k_1 \geq k_{10}$, | $k_{1m}=$ | 0.117 | 0.137 | 0.128 | 0.075 | 0.075 |
| When $k_1 < k_{10}$, | $k_{1m}=$ | 0.043 | 0.016 | 0.000 | 0.048 | 0.030 |
| When $d_1 \geq d_{10}$, | $d_{1m}$ (nm) $=$ | 18.089 | 18.051 | 18.523 | 256.743 | ∞ |
| When $d_1 < d_{10}$, | $d_{1m}$ (nm) $=$ | 14.663 | 12.041 | 10.348 | 210.937 | 209.294 |
| When $n_2 \geq n_{20}$, | $n_{2m}=$ | 1.773 | 1.748 | 1.785 | 1.744 | 1.800 |
| When $n_2 < n_{20}$, | $n_{2m}=$ | 1.665 | 1.604 | 1.616 | 1.589 | 1.608 |
| When $k_2 \geq k_{20}$, | $k_{2m}=$ | 0.348 | 0.285 | 0.259 | 0.230 | 0.223 |
| When $k_2 < k_{20}$, | $k_{2m}=$ | 0.278 | 0.199 | 0.159 | 0.145 | 0.109 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 140.260 | 150.984 | 188.160 | 180.549 | 200.943 |

1. 3 < N A ≤ 1. 4
1 9 5 < T ≤ 2 0 5

| Case | 20-06 |
|---|---|
| $n_{10}$ | 1.697 |
| $k_{10}$ | 0.050 |
| $d_{10}$ (nm) | 272.522 |
| $n_{20}$ | 1.701 |
| $k_{20}$ | 0.160 |
| $d_{20}$ (nm) | 261.468 |

| | | 20-06 |
|---|---|---|
| When $n_1 \geq n_{10}$, | $n_{1m}=$ | 1.731 |
| When $n_1 < n_{10}$, | $n_{1m}=$ | 1.652 |
| When $k_1 \geq k_{10}$, | $k_{1m}=$ | 0.078 |
| When $k_1 < k_{10}$, | $k_{1m}=$ | 0.022 |
| When $d_1 \geq d_{10}$, | $d_{1m}$ (nm) $=$ | ∞ |
| When $d_1 < d_{10}$, | $d_{1m}$ (nm) $=$ | 217.122 |
| When $n_2 \geq n_{20}$, | $n_{2m}=$ | 1.874 |
| When $n_2 < n_{20}$, | $n_{2m}=$ | 1.620 |
| When $k_2 \geq k_{20}$, | $k_{2m}=$ | 0.227 |
| When $k_2 < k_{20}$, | $k_{2m}=$ | 0.100 |
| When $d_2 \geq d_{20}$, | $d_{2m}$ (nm) $=$ | ∞ |
| When $d_2 < d_{20}$, | $d_{2m}$ (nm) $=$ | 184.530 |

6. The antireflective film according to any one of claims 1 to 5, wherein the relations $d_1 \leq 250$ and $d_2 \leq 250$ are satisfied.

7. The antireflective film according to any one of claims 1 to 5, wherein the refractive index of the resist layer is 1.60 to 1.80.

8. An exposure method used in a process for manufacturing a semiconductor device, the method comprising the steps of:

providing an antireflective film having a two-layer structure between a resist layer and a silicon oxide layer formed on a surface of a silicon semiconductor substrate and having a thickness T (unit: nm) described below; and exposing the resist layer in an exposure system having a wavelength of 190 nm to 195 nm and a numerical aperture NA of $0.93 \leq NA \leq 1.0$, the antireflective film including an upper layer having a complex refractive index $N_1$, and a lower layer having a complex refractive index $N_2$, the complex refractive indexes $N_1$ and $N_2$ being represented by the equations $N_1 = n_1 - k_1 i$ and $N_2 = n_2 - k_2 i$, respectively;
wherein assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1$, $k_1$, $d_1$, $n_2$, $k_2$, and $d_2$ satisfy the relational expression

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{2c})/(d_{2m} - d_{20})\}^2 \leq 1;$$

a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$; and in the tables below, in the line of "When $n_1 \geq n_{10}$, $n_{1m}$ =", each value in the right columns is "$n_{1m} - n_{10}$"; in the line of "When $n_1 < n_{10}$, $n_{1m}$ =", each value in the right columns is "$n_{10} - n_{1m}$"; in the line of "When $k_1 \geq k_{10}$, $k_{1m}$ =", each value in the right columns is "$k_{1m} - k_{10}$"; in the line of "When $k_1 < k_{10}$, $k_{1m}$ =", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m}$ =", each value in the right columns is "$n_{2m} - n_{20}$"; in the line of "When $n_2 < n_{20}$, $n_{2m}$ =", each value in the right columns is "$n_{20} - n_{2m}$"; in the line of "When $k_2 \geq k_{20}$, $k_{2m}$ =", each value in the right columns is "$k_{2m} - k_{20}$"; in the line of "When $k_2 < k_{20}$, $k_{2m}$ =", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

$0.93 \leq NA \leq 1.0$

$2 \leq T \leq 15$

| Case | | 1-01 | 1-02 | 1-03 | 1-04 | 1-05 |
|---|---|---|---|---|---|---|
| $n_{10}$ | | 2.0730 | 1.8547 | 1.8612 | 1.8596 | 1.7706 |
| $k_{10}$ | | 0.1156 | 0.1676 | 0.1279 | 0.0953 | 0.0916 |
| $d_{10}$ (nm) | | 23.93 | 29.84 | 20.21 | 19.98 | 91.02 |
| $n_{20}$ | | 2.6749 | 2.1886 | 1.8193 | 1.8569 | 1.9614 |
| $k_{20}$ | | 1.5696 | 0.6118 | 0.4029 | 0.3274 | 0.4555 |
| $d_{20}$ (nm) | | 9.886 | 59.76 | 139.99 | 190.30 | 69.22 |

| | | 1-01 | 1-02 | 1-03 | 1-04 | 1-05 |
|---|---|---|---|---|---|---|
| When $n_1 \geq n_{10}$, | $n_{1m} =$ | 0.0910 | 0.0882 | 0.0964 | 0.0950 | 0.0763 |
| When $n_1 < n_{10}$, | $n_{1m} =$ | 0.0872 | 0.0704 | 0.0762 | 0.0765 | 0.0467 |
| When $k_1 \geq k_{10}$, | $k_{1m} =$ | 0.0819 | 0.0750 | 0.0869 | 0.0875 | 0.0772 |
| When $k_1 < k_{10}$, | $k_{1m} =$ | 0.0960 | 0.0840 | 0.0907 | 0.0915 | 0.0546 |
| When $d_1 \geq d_{10}$, | $d_{1m}$ (nm) $=$ | 4.108 | 7.919 | 8.786 | 9.587 | 17.28 |
| When $d_1 < d_{10}$, | $d_{1m}$ (nm) $=$ | 3.280 | 5.652 | 6.074 | 6.698 | 8.396 |
| When $n_2 \geq n_{20}$, | $n_{2m} =$ | 0.2209 | 0.1796 | 0.1515 | 0.1552 | 0.1445 |
| When $n_2 < n_{20}$, | $n_{2m} =$ | 0.2126 | 0.1920 | 0.1780 | 0.1777 | 0.1565 |
| When $k_2 \geq k_{20}$, | $k_{2m} =$ | 0.2324 | 0.2171 | 0.1921 | 0.1983 | 0.1809 |
| When $k_2 < k_{20}$, | $k_{2m} =$ | 0.1960 | 0.1512 | 0.1220 | 0.1107 | 0.1235 |
| When $d_2 \geq d_{20}$, | $d_{2m}$ (nm) $=$ | 1.715 | 13.99 | $\infty$ | $\infty$ | 9.907 |
| When $d_2 < d_{20}$, | $d_{2m}$ (nm) $=$ | 1.606 | 9.166 | 63.12 | 76.29 | 9.171 |

$0.93 \leq NA \leq 1.0$

$2 \leq T \leq 15$

| Case | | 1-06 | 1-07 | 1-08 | 1-09 | 1-10 |
|---|---|---|---|---|---|---|
| $n_{10}$ | | 1.7660 | 1.7540 | 1.7206 | 1.7312 | 1.7318 |
| $k_{10}$ | | 0.0861 | 0.0810 | 0.0766 | 0.0743 | 0.0746 |
| $d_{10}$ (nm) | | 89.67 | 89.26 | 163.7 | 158.4 | 156.0 |
| $n_{20}$ | | 1.8683 | 1.7976 | 2.0073 | 1.9328 | 1.8226 |
| $k_{20}$ | | 0.3142 | 0.2441 | 0.9100 | 0.4029 | 0.2736 |
| $d_{20}$ (nm) | | 129.4 | 193.6 | 15.11 | 69.39 | 132.3 |

| | | 1-06 | 1-07 | 1-08 | 1-09 | 1-10 |
|---|---|---|---|---|---|---|
| When $n_1 \geq n_{10}$, | $n_{1m} =$ | 0.0725061 | 0.0712122 | 0.0876196 | 0.0743347 | 0.0699963 |
| When $n_1 < n_{10}$, | $n_{1m} =$ | 0.0454077 | 0.0429834 | 0.0318030 | 0.0375427 | 0.0339148 |
| When $k_1 \geq k_{10}$, | $k_{1m} =$ | 0.0772620 | 0.0743579 | 0.0711646 | 0.0773767 | 0.0733899 |
| When $k_1 < k_{10}$, | $k_{1m} =$ | 0.0551843 | 0.0575049 | 0.0410327 | 0.0412244 | 0.0408972 |
| When $d_1 \geq d_{10}$, | $d_{1m}$ (nm) $=$ | 18.782 | 23.348 | 40.469 | 35.317 | 38.161 |
| When $d_1 < d_{10}$, | $d_{1m}$ (nm) $=$ | 8.456 | 8.860 | 9.958 | 10.432 | 9.052 |
| When $n_2 \geq n_{20}$, | $n_{2m} =$ | 0.1498401 | 0.1584961 | 0.1682336 | 0.1348816 | 0.1376196 |
| When $n_2 < n_{20}$, | $n_{2m} =$ | 0.1510144 | 0.1511060 | 0.2304688 | 0.1582874 | 0.1516028 |
| When $k_2 \geq k_{20}$, | $k_{2m} =$ | 0.2049341 | 0.2252979 | 0.1710974 | 0.1537598 | 0.1868274 |
| When $k_2 < k_{20}$, | $k_{2m} =$ | 0.0962390 | 0.0820935 | 0.1771240 | 0.1169067 | 0.0881860 |
| When $d_2 \geq d_{20}$, | $d_{2m}$ (nm) $=$ | $\infty$ | $\infty$ | 3.180 | 8.501 | $\infty$ |
| When $d_2 < d_{20}$, | $d_{2m}$ (nm) $=$ | 17.963 | 68.303 | 3.157 | 8.798 | 14.016 |

$0.93 \leq NA \leq 1.0$

$2 \leq T \leq 15$

| Case | 1-11 | 1-12 | 1-13 | 1-14 | 1-15 |
|---|---|---|---|---|---|
| $n_{10}$ | 1.7235310 | 1.7093992 | 1.7192548 | 1.7183512 | 1.7097773 |
| $k_{10}$ | 0.0712769 | 0.0595462 | 0.0668813 | 0.0690717 | 0.0638868 |
| $d_{10}$ (nm) | 155.759 | 237.275 | 223.222 | 220.755 | 221.916 |
| $n_{20}$ | 1.7500411 | 5.0249130 | 1.9244861 | 1.7884626 | 1.7175992 |
| $k_{20}$ | 0.2147794 | 2.4786958 | 0.3767470 | 0.2530536 | 0.2031308 |
| $d_{20}$ (nm) | 197.972 | 1.776 | 68.925 | 134.430 | 199.649 |

| | | 1-11 | 1-12 | 1-13 | 1-14 | 1-15 |
|---|---|---|---|---|---|---|
| When $n_1 \geq n_{10}$, | $n_{1m} =$ | 0.0687000 | 0.1022864 | 0.0758325 | 0.0727087 | 0.0697119 |
| When $n_1 < n_{10}$, | $n_{1m} =$ | 0.0322229 | 0.0397070 | 0.0389722 | 0.0346118 | 0.0564209 |
| When $k_1 \geq k_{10}$, | $k_{1m} =$ | 0.0698975 | 0.0795508 | 0.0762329 | 0.0700171 | 0.0722595 |
| When $k_1 < k_{10}$, | $k_{1m} =$ | 0.0415723 | 0.0393457 | 0.0338635 | 0.0308765 | 0.0321350 |
| When $d_1 \geq d_{10}$, | $d_{1m}$ (nm) $=$ | $\infty$ | $\infty$ | $\infty$ | $\infty$ | $\infty$ |
| When $d_1 < d_{10}$, | $d_{1m}$ (nm) $=$ | 9.616 | 78.998 | 12.815 | 10.464 | 72.402 |
| When $n_2 \geq n_{20}$, | $n_{2m} =$ | 0.1855957 | 0.5207629 | 0.1343335 | 0.1358569 | 0.2333704 |
| When $n_2 < n_{20}$, | $n_{2m} =$ | 0.1501331 | 0.6523560 | 0.1703552 | 0.1672083 | 0.1693542 |
| When $k_2 \geq k_{20}$, | $k_{2m} =$ | 0.2047339 | 0.5424048 | 0.1363831 | 0.1710950 | 0.1947412 |
| When $k_2 < k_{20}$, | $k_{2m} =$ | 0.0758948 | 0.5487781 | 0.1192529 | 0.0892212 | 0.0778406 |
| When $d_2 \geq d_{20}$, | $d_{2m}$ (nm) $=$ | $\infty$ | 0.325 | 8.509 | $\infty$ | $\infty$ |
| When $d_2 < d_{20}$, | $d_{2m}$ (nm) $=$ | 29.087 | 0.351 | 7.511 | 11.451 | 31.610 |

$0.93 \leq NA \leq 1.0$

$15 < T \leq 25$

| Case | 2-01 | 2-02 | 2-03 | 2-04 | 2-05 |
|---|---|---|---|---|---|
| $n_{10}$ | 1.8890717 | 1.8040788 | 1.8569330 | 1.8246631 | 1.8713633 |
| $k_{10}$ | 0.2231211 | 0.2224671 | 0.1887211 | 0.1852786 | 0.1359350 |
| $d_{10}$ (nm) | 31.297 | 38.783 | 31.358 | 29.866 | 20.765 |
| $n_{20}$ | 2.2536461 | 3.4285504 | 2.3482559 | 2.0267942 | 1.8449284 |
| $k_{20}$ | 1.9138327 | 0.7115044 | 0.7139401 | 0.6589875 | 0.4410677 |
| $d_{20}$ (nm) | 8.426 | 30.090 | 49.395 | 61.419 | 129.533 |

| | | 2-01 | 2-02 | 2-03 | 2-04 | 2-05 |
|---|---|---|---|---|---|---|
| When $n_1 \geq n_{10}$, | $n_{1m} =$ | 0.0874390 | 0.0895227 | 0.0867871 | 0.0862964 | 0.0944556 |
| When $n_1 < n_{10}$, | $n_{1m} =$ | 0.0734485 | 0.0679480 | 0.0711365 | 0.0665735 | 0.0748743 |
| When $k_1 \geq k_{10}$, | $k_{1m} =$ | 0.0762256 | 0.0781921 | 0.0754639 | 0.0735010 | 0.0845789 |
| When $k_1 < k_{10}$, | $k_{1m} =$ | 0.0847852 | 0.0785486 | 0.0835657 | 0.0812061 | 0.0905493 |
| When $d_1 \geq d_{10}$, | $d_{1m}$ (nm) $=$ | 5.734 | 7.070 | 7.156 | 8.156 | 8.180 |
| When $d_1 < d_{10}$, | $d_{1m}$ (nm) $=$ | 4.509 | 5.331 | 5.325 | 5.713 | 5.655 |
| When $n_2 \geq n_{20}$, | $n_{2m} =$ | 0.3151672 | 0.1904419 | 0.1878015 | 0.1893945 | 0.1561475 |
| When $n_2 < n_{20}$, | $n_{2m} =$ | 0.3095313 | 0.2189575 | 0.2044202 | 0.1933459 | 0.1801416 |
| When $k_2 \geq k_{20}$, | $k_{2m} =$ | 0.3390149 | 0.2463513 | 0.2322900 | 0.2311047 | 0.2037732 |
| When $k_2 < k_{20}$, | $k_{2m} =$ | 0.3041187 | 0.1774133 | 0.1676416 | 0.1568945 | 0.1265381 |
| When $d_2 \geq d_{20}$, | $d_{2m}$ (nm) $=$ | 1.987 | 2.182 | 8.431 | $\infty$ | $\infty$ |
| When $d_2 < d_{20}$, | $d_{2m}$ (nm) $=$ | 1.727 | 2.068 | 6.571 | 10.427 | 56.577 |

$0.93 \leq NA \leq 1.0$

$15 < T \leq 25$

| Case | 2-06 | 2-07 | 2-08 | 2-09 | 2-10 |
|---|---|---|---|---|---|
| $n_{10}$ | 1.8537764 | 1.8773918 | 1.7913209 | 1.7961812 | 1.7719309 |
| $k_{10}$ | 0.1095380 | 0.0811836 | 0.1069315 | 0.0967122 | 0.0907051 |
| $d_{10}$ (nm) | 19.190 | 15.072 | 93.104 | 91.592 | 89.644 |
| $n_{20}$ | 1.8083352 | 1.7885130 | 2.1120296 | 2.2985234 | 1.8982310 |
| $k_{20}$ | 0.3385915 | 0.2812935 | 1.5705728 | 0.5621108 | 0.3437292 |
| $d_{20}$ (nm) | 190.096 | 250.952 | 8.709 | 49.876 | 119.550 |

| | | 2-06 | 2-07 | 2-08 | 2-09 | 2-10 |
|---|---|---|---|---|---|---|
| When $n_1 \geq n_{10}$, | $n_{1m} =$ | 0.0970691 | 0.1116003 | 0.0785193 | 0.0746387 | 0.0710254 |
| When $n_1 < n_{10}$, | $n_{1m} =$ | 0.0765894 | 0.0899463 | 0.0387744 | 0.0446472 | 0.0434424 |
| When $k_1 \geq k_{10}$, | $k_{1m} =$ | 0.0900769 | 0.1037891 | 0.0704041 | 0.0743225 | 0.0753088 |
| When $k_1 < k_{10}$, | $k_{1m} =$ | 0.0922754 | 0.0811836 | 0.0518481 | 0.0540869 | 0.0544885 |
| When $d_1 \geq d_{10}$, | $d_{1m}$ (nm) $=$ | 9.442 | 8.843 | 12.610 | 13.182 | 16.111 |
| When $d_1 < d_{10}$, | $d_{1m}$ (nm) $=$ | 6.479 | 6.242 | 5.884 | 6.895 | 7.619 |
| When $n_2 \geq n_{20}$, | $n_{2m} =$ | 0.1545007 | 0.1511414 | 0.2353479 | 0.1499768 | 0.1563330 |
| When $n_2 < n_{20}$, | $n_{2m} =$ | 0.1780847 | 0.1773486 | 0.2901843 | 0.1659082 | 0.1527185 |
| When $k_2 \geq k_{20}$, | $k_{2m} =$ | 0.1867920 | 0.1671802 | 0.2909924 | 0.1840894 | 0.2027185 |
| When $k_2 < k_{20}$, | $k_{2m} =$ | 0.1126624 | 0.1034778 | 0.2557275 | 0.1387183 | 0.1013330 |
| When $d_2 \geq d_{20}$, | $d_{2m}$ (nm) $=$ | $\infty$ | $\infty$ | 1.972 | 5.095 | $\infty$ |
| When $d_2 < d_{20}$, | $d_{2m}$ (nm) $=$ | 76.056 | 121.855 | 1.716 | 4.880 | 15.622 |

$0.93 \leq NA \leq 1.0$

$15 < T \leq 25$

| Case | 2-11 | 2-12 | 2-13 | 2-14 | 2-15 |
|---|---|---|---|---|---|
| $n_{10}$ | 1.7573553 | 1.7321027 | 1.7251448 | 1.7347815 | 1.7337052 |
| $k_{10}$ | 0.0844391 | 0.0771807 | 0.0782108 | 0.0789970 | 0.0782079 |
| $d_{10}$ (nm) | 89.273 | 89.432 | 166.474 | 158.854 | 156.164 |
| $n_{20}$ | 1.8090385 | 1.7181480 | 2.6560327 | 2.0166404 | 1.8413069 |
| $k_{20}$ | 0.2599016 | 0.2108133 | 2.0752579 | 0.4697089 | 0.2975845 |
| $d_{20}$ (nm) | 184.203 | 254.601 | 4.495 | 58.957 | 122.955 |

| | | 2-11 | 2-12 | 2-13 | 2-14 | 2-15 |
|---|---|---|---|---|---|---|
| When $n_1 \geq n_{10}$, | $n_{1m} =$ | 0.0699780 | 0.0690137 | 0.0832959 | 0.0721558 | 0.0683105 |
| When $n_1 < n_{10}$, | $n_{1m} =$ | 0.0410315 | 0.0429553 | 0.0305981 | 0.0341260 | 0.0308228 |
| When $k_1 \geq k_{10}$, | $k_{1m} =$ | 0.0723608 | 0.0738831 | 0.0729456 | 0.0742798 | 0.0703467 |
| When $k_1 < k_{10}$, | $k_{1m} =$ | 0.0569189 | 0.0588879 | 0.0382764 | 0.0397253 | 0.0396069 |
| When $d_1 \geq d_{10}$, | $d_{1m}$ (nm) $=$ | 21.648 | 30.736 | 32.939 | 31.041 | 34.229 |
| When $d_1 < d_{10}$, | $d_{1m}$ (nm) $=$ | 8.068 | 11.084 | 9.096 | 8.972 | 7.917 |
| When $n_2 \geq n_{20}$, | $n_{2m} =$ | 0.1631897 | 0.1805151 | 0.3419739 | 0.1438672 | 0.1358447 |
| When $n_2 < n_{20}$, | $n_{2m} =$ | 0.1518018 | 0.1480249 | 0.4228455 | 0.1667273 | 0.1539514 |
| When $k_2 \geq k_{20}$, | $k_{2m} =$ | 0.2316443 | 0.1895435 | 0.3584204 | 0.1604712 | 0.1864905 |
| When $k_2 < k_{20}$, | $k_{2m} =$ | 0.0850049 | 0.0772852 | 0.3668774 | 0.1323413 | 0.0930493 |
| When $d_2 \geq d_{20}$, | $d_{2m}$ (nm) $=$ | $\infty$ | $\infty$ | 0.935 | 6.683 | 16.067 |
| When $d_2 < d_{20}$, | $d_{2m}$ (nm) $=$ | 28.321 | 80.547 | 0.940 | 6.845 | 12.170 |

$0.93 \leq NA \quad 1.0$
$15 < T \leq 25$

| Case | 2-16 | 2-17 | 2-18 | 2-19 | 2-20 |
|---|---|---|---|---|---|
| $n_{10}$ | 1.7245076 | 1.7100620 | 1.7130788 | 1.7208745 | 1.7192161 |
| $k_{10}$ | 0.0739010 | 0.0639207 | 0.0658962 | 0.0708686 | 0.0720786 |
| $d_{10}$ (nm) | 155.712 | 155.553 | 233.281 | 223.560 | 220.745 |
| $n_{20}$ | 1.7533528 | 1.6863114 | 3.3653368 | 1.9877972 | 1.7983405 |
| $k_{20}$ | 0.2275719 | 0.1891021 | 2.7431658 | 0.4366658 | 0.2740582 |
| $d_{20}$ (nm) | 189.273 | 256.528 | 2.501 | 59.393 | 125.643 |

| | | 2-16 | 2-17 | 2-18 | 2-19 | 2-20 |
|---|---|---|---|---|---|---|
| When $n_1 \geq n_{10}$, | $n_{1m} =$ | 0.0671997 | 0.0648059 | 0.0864783 | 0.0735278 | 0.0707983 |
| When $n_1 < n_{10}$, | $n_{1m} =$ | 0.0293323 | 0.0484583 | 0.0327734 | 0.0316724 | 0.0279663 |
| When $k_1 \geq k_{10}$, | $k_{1m} =$ | 0.0671045 | 0.0758130 | 0.0759729 | 0.0721252 | 0.0662109 |
| When $k_1 < k_{10}$, | $k_{1m} =$ | 0.0403235 | 0.0462146 | 0.0340283 | 0.0320007 | 0.0290771 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 8.393 | 77.190 | 14.014 | 10.040 | 8.344 |
| When $n_2 \geq n_{20}$, | $n_{2m} =$ | 0.1922314 | 0.2150586 | 0.5377722 | 0.1455798 | 0.1365283 |
| When $n_2 < n_{20}$, | $n_{2m} =$ | 0.1495129 | 0.1388159 | 0.5848816 | 0.1787549 | 0.1689587 |
| When $k_2 \geq k_{20}$, | $k_{2m} =$ | 0.2035803 | 0.1600281 | 0.4555420 | 0.1361926 | 0.1635962 |
| When $k_2 < k_{20}$, | $k_{2m} =$ | 0.0785095 | 0.0698242 | 0.5466174 | 0.1332434 | 0.0942200 |
| When $d_2 \geq d_{20}$, | $d_{2m}$ (nm) $=$ | ∞ | ∞ | 0.540 | 6.979 | ∞ |
| When $d_2 < d_{20}$, | $d_{2m}$ (nm) $=$ | 26.645 | 77.267 | 0.568 | 6.255 | 9.480 |

$0.93 \leq NA \leq 1.0$
$15 < T \leq 25$

| Case | 2-21 | 2-22 |
|---|---|---|
| $n_{10}$ | 1.7100814 | 1.7028062 |
| $k_{10}$ | 0.0661341 | 0.0572529 |
| $d_{10}$ (nm) | 221.783 | 219.613 |
| $n_{20}$ | 1.7179584 | 1.6741304 |
| $k_{20}$ | 0.2146738 | 0.1784680 |
| $d_{20}$ (nm) | 191.114 | 256.090 |

| | | 2-21 | 2-22 |
|---|---|---|---|
| When $n_1 \geq n_{10}$, | $n_{1m} =$ | 0.0687488 | 0.0693079 |
| When $n_1 < n_{10}$, | $n_{1m} =$ | 0.0502954 | 0.0688196 |
| When $k_1 \geq k_{10}$, | $k_{1m} =$ | 0.0691418 | 0.0820508 |
| When $k_1 < k_{10}$, | $k_{1m} =$ | 0.0305945 | 0.0409924 |
| When $d_1 \geq d_{10}$, | $d_{1m}$ (nm) $=$ | ∞ | ∞ |
| When $d_1 < d_{10}$, | $d_{1m}$ (nm) $=$ | 70.999 | 88.114 |
| When $n_2 \geq n_{20}$, | $n_{2m} =$ | 0.2426611 | 0.2482605 |
| When $n_2 < n_{20}$, | $n_{2m} =$ | 0.1649829 | 0.1563098 |
| When $k_2 \geq k_{20}$, | $k_{2m} =$ | 0.1903906 | 0.1488330 |
| When $k_2 < k_{20}$, | $k_{2m} =$ | 0.0805981 | 0.0682654 |
| When $d_2 \geq d_{20}$, | $d_{2m}$ (nm) $=$ | ∞ | ∞ |
| When $d_2 < d_{20}$, | $d_{2m}$ (nm) $=$ | 28.403 | 77.092 |

$0.93 \leq NA \leq 1.0$
$25 < T \leq 35$

| Case | 3-01 | 3-02 | 3-03 | 3-04 | 3-05 |
|---|---|---|---|---|---|
| $n_{10}$ | 1.7462297 | 1.7852920 | 1.8064124 | 1.8761841 | 1.8732427 |
| $k_{10}$ | 0.2650661 | 0.2379686 | 0.2063789 | 0.1465026 | 0.1107685 |
| $d_{10}$ (nm) | 38.584 | 38.995 | 31.400 | 22.050 | 18.888 |
| $n_{20}$ | 1.8811342 | 3.2453891 | 2.0415396 | 1.8871554 | 1.8328297 |
| $k_{20}$ | 2.5474890 | 0.8215227 | 0.7493942 | 0.4863835 | 0.3644393 |
| $d_{20}$ (nm) | 6.719 | 29.990 | 55.163 | 118.487 | 179.928 |

| | | 3-01 | 3-02 | 3-03 | 3-04 | 3-05 |
|---|---|---|---|---|---|---|
| When $n_1 \geq n_{10}$, | $n_{1m} =$ | 0.0769434 | 0.0851318 | 0.0833228 | 0.0906799 | 0.0968079 |
| When $n_1 < n_{10}$, | $n_{1m} =$ | 0.0572766 | 0.0631555 | 0.0636389 | 0.0722144 | 0.0767554 |
| When $k_1 \geq k_{10}$, | $k_{1m} =$ | 0.0723669 | 0.0784412 | 0.0735730 | 0.0819336 | 0.0896667 |
| When $k_1 < k_{10}$, | $k_{1m} =$ | 0.0683887 | 0.0725391 | 0.0776208 | 0.0882788 | 0.0940442 |
| When $d_1 \geq d_{10}$, | $d_{1m}$ (nm) $=$ | 6.007 | 6.642 | 7.652 | 7.684 | 8.502 |
| When $d_1 < d_{10}$, | $d_{1m}$ (nm) $=$ | 4.614 | 4.982 | 5.411 | 5.323 | 5.843 |
| When $n_2 \geq n_{20}$, | $n_{2m} =$ | 0.4302271 | 0.2240894 | 0.2116187 | 0.1663196 | 0.1573621 |
| When $n_2 < n_{20}$, | $n_{2m} =$ | 0.3679468 | 0.2518726 | 0.2012903 | 0.1828064 | 0.1779138 |
| When $k_2 \geq k_{20}$, | $k_{2m} =$ | 0.4458606 | 0.2938757 | 0.2488452 | 0.2239661 | 0.1924353 |
| When $k_2 < k_{20}$, | $k_{2m} =$ | 0.4071558 | 0.2090601 | 0.1700916 | 0.1317957 | 0.1155774 |
| When $d_2 \geq d_{20}$, | $d_{2m}$ (nm) $=$ | 1.849 | 2.793 | $\infty$ | $\infty$ | $\infty$ |
| When $d_2 < d_{20}$, | $d_{2m}$ (nm) $=$ | 1.467 | 2.486 | 8.980 | 27.259 | 71.144 |

$0.93 \leq NA \leq 1.0$
$25 < T \leq 35$

| Case | 3-06 | 3-07 | 3-08 | 3-09 | 3-10 |
|---|---|---|---|---|---|
| $n_{10}$ | 1.8809997 | 1.8353407 | 1.8107063 | 1.7800259 | 1.7589519 |
| $k_{10}$ | 0.0844859 | 0.1336488 | 0.1074834 | 0.0966903 | 0.0885227 |
| $d_{10}$ (nm) | 15.636 | 86.851 | 91.200 | 89.638 | 89.033 |
| $n_{20}$ | 1.8003278 | 1.6000470 | 2.5616901 | 1.9474319 | 1.8081258 |
| $k_{20}$ | 0.2965881 | 1.7695220 | 0.6655713 | 0.3779800 | 0.2753975 |
| $d_{20}$ (nm) | 241.202 | 10.059 | 40.111 | 109.424 | 177.335 |

| | | 3-06 | 3-07 | 3-08 | 3-09 | 3-10 |
|---|---|---|---|---|---|---|
| When $n_1 \geq n_{10}$, | $n_{1m} =$ | 0.1079370 | 0.0607556 | 0.0690979 | 0.0686230 | 0.0682776 |
| When $n_1 < n_{10}$, | $n_{1m} =$ | 0.0864404 | 0.0389355 | 0.0418872 | 0.0404956 | 0.0386047 |
| When $k_1 \geq k_{10}$, | $k_{1m} =$ | 0.0999365 | 0.0690637 | 0.0736157 | 0.0727942 | 0.0702844 |
| When $k_1 < k_{10}$, | $k_{1m} =$ | 0.0844859 | 0.0492517 | 0.0507898 | 0.0531238 | 0.0559766 |
| When $d_1 \geq d_{10}$, | $d_{1m}$ (nm) $=$ | 8.565 | 8.192 | 11.124 | 13.835 | 18.997 |
| When $d_1 < d_{10}$, | $d_{1m}$ (nm) $=$ | 5.996 | 4.465 | 5.820 | 6.603 | 7.278 |
| When $n_2 \geq n_{20}$, | $n_{2m} =$ | 0.1541260 | 0.2930249 | 0.1702905 | 0.1595251 | 0.1700037 |
| When $n_2 < n_{20}$, | $n_{2m} =$ | 0.1764270 | 0.2694421 | 0.1785315 | 0.1557800 | 0.1515491 |
| When $k_2 \geq k_{20}$, | $k_{2m} =$ | 0.1720203 | 0.3061462 | 0.2081555 | 0.2039343 | 0.2313416 |
| When $k_2 < k_{20}$, | $k_{2m} =$ | 0.1058716 | 0.3107410 | 0.1597290 | 0.1070007 | 0.0874585 |
| When $d_2 \geq d_{20}$, | $d_{2m}$ (nm) $=$ | $\infty$ | 2.242 | 3.729 | 17.032 | $\infty$ |
| When $d_2 < d_{20}$, | $d_{2m}$ (nm) $=$ | 115.662 | 2.067 | 3.416 | 13.482 | 26.550 |

$0. 9 3 \leq N A \leq 1. 0$

$2 5 < T \leq 3 5$

| Case | 3-11 | 3-12 | 3-13 | 3-14 | 3-15 |
|---|---|---|---|---|---|
| $n_{10}$ | 1.7385561 | 1.7392392 | 1.7355979 | 1.7252169 | 1.7185486 |
| $k_{10}$ | 0.0961686 | 0.0859424 | 0.0828161 | 0.0770491 | 0.0788457 |
| $d_{10}$ (nm) | 161.111 | 158.474 | 155.982 | 155.656 | 229.847 |
| $n_{20}$ | 1.8448216 | 2.1008270 | 1.8545146 | 1.7550901 | 3.2610273 |
| $k_{20}$ | 2.2148249 | 0.5469970 | 0.3232472 | 0.2413910 | 4.4183916 |
| $d_{20}$ (nm) | 5.861 | 50.862 | 115.179 | 181.353 | 1.558 |

| | | 3-11 | 3-12 | 3-13 | 3-14 | 3-15 |
|---|---|---|---|---|---|---|
| When $n_1 \geq n_{10}$, | $n_{1m} =$ | 0.0629041 | 0.0674426 | 0.0657153 | 0.0649670 | 0.0703149 |
| When $n_1 < n_{10}$, | $n_{1m} =$ | 0.0253882 | 0.0295728 | 0.0268335 | 0.0256165 | 0.0220850 |
| When $k_1 \geq k_{10}$, | $k_{1m} =$ | 0.0668323 | 0.0703247 | 0.0663293 | 0.0632434 | 0.0659778 |
| When $k_1 < k_{10}$, | $k_{1m} =$ | 0.0332373 | 0.0369910 | 0.0375085 | 0.0384131 | 0.0277441 |
| When $d_1 \geq d_{10}$, | $d_{1m}$ (nm) $=$ | 20.469 | 26.314 | 30.753 | 47.147 | 42.683 |
| When $d_1 < d_{10}$, | $d_{1m}$ (nm) $=$ | 5.969 | 7.197 | 6.584 | 7.042 | 7.213 |
| When $n_2 \geq n_{20}$, | $n_{2m} =$ | 0.3836914 | 0.1608313 | 0.1425024 | 0.2021899 | 0.7624707 |
| When $n_2 < n_{20}$, | $n_{2m} =$ | 0.3601526 | 0.1749219 | 0.1554919 | 0.1482849 | 0.7156897 |
| When $k_2 \geq k_{20}$, | $k_{2m} =$ | 0.3156946 | 0.1638635 | 0.1816882 | 0.2013940 | 0.5159863 |
| When $k_2 < k_{20}$, | $k_{2m} =$ | 0.4014783 | 0.1464551 | 0.0974072 | 0.0811682 | 0.8313574 |
| When $d_2 \geq d_{20}$, | $d_{2m}$ (nm) $=$ | 1.291 | 5.616 | 13.990 | $\infty$ | 0.296 |
| When $d_2 < d_{20}$, | $d_{2m}$ (nm) $=$ | 1.319 | 5.535 | 10.236 | 24.868 | 0.387 |

$0. 9 3 \leq N A \leq 1. 0$

$2 5 < T \leq 3 5$

| Case | 3-16 | 3-17 | 3-18 |
|---|---|---|---|
| $n_{10}$ | 1.7228369 | 1.7199449 | 1.7101979 |
| $k_{10}$ | 0.0769315 | 0.0760859 | 0.0687675 |
| $d_{10}$ (nm) | 222.858 | 220.491 | 221.639 |
| $n_{20}$ | 2.0210736 | 1.8037789 | 1.7165312 |
| $k_{20}$ | 0.5011654 | 0.2965908 | 0.2274377 |
| $d_{20}$ (nm) | 52.892 | 118.134 | 183.246 |

| | | 3-16 | 3-17 | 3-18 |
|---|---|---|---|---|
| When $n_1 \geq n_{10}$, | $n_{1m} =$ | 0.0694470 | 0.0680798 | 0.0669543 |
| When $n_1 < n_{10}$, | $n_{1m} =$ | 0.0241309 | 0.0211279 | 0.0442908 |
| When $k_1 \geq k_{10}$, | $k_{1m} =$ | 0.0659106 | 0.0606384 | 0.0650562 |
| When $k_1 < k_{10}$, | $k_{1m} =$ | 0.0287354 | 0.0259912 | 0.0284460 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 7.193 | 6.146 | 69.475 |
| When $n_2 \geq n_{20}$, | $n_{2m} =$ | 0.1641553 | 0.1445947 | 0.2568982 |
| When $n_2 < n_{20}$, | $n_{2m} =$ | 0.1866541 | 0.1696143 | 0.1583826 |
| When $k_2 \geq k_{20}$, | $k_{2m} =$ | 0.1286877 | 0.1503394 | 0.1843665 |
| When $k_2 < k_{20}$, | $k_{2m} =$ | 0.1457922 | 0.0990405 | 0.0813123 |
| When $d_2 \geq d_{20}$, | $d_{2m}$ (nm) $=$ | 6.290 | 17.763 | $\infty$ |
| When $d_2 < d_{20}$, | $d_{2m}$ (nm) $=$ | 5.002 | 7.323 | 26.072 |

$0. 9 3 \leq N A \leq 1. 0$
$3 5 < T \leq 4 5$

| Case | | 4-01 | 4-02 | 4-03 | 4-04 | 4-05 |
|---|---|---|---|---|---|---|
| $n_{10}$ | | 1.8047095 | 1.8098021 | 1.8915289 | 1.8869810 | 1.8679863 |
| $k_{10}$ | | 0.2694194 | 0.2379756 | 0.1677232 | 0.1583242 | 0.1633407 |
| $d_{10}$ (nm) | | 36.421 | 31.711 | 26.420 | 22.598 | 22.571 |
| $n_{20}$ | | 2.9911125 | 2.1295160 | 2.1348336 | 1.9270572 | 1.8682373 |
| $k_{20}$ | | 1.0218786 | 0.9059492 | 0.5678980 | 0.5352831 | 0.5190358 |
| $d_{20}$ (nm) | | 30.087 | 46.199 | 93.459 | 108.068 | 112.596 |

| When $n_1 \geq n_{10}$, | $n_{1m} =$ | 0.0783740 | 0.0796436 | 0.0844666 | 0.0882751 | 0.0886218 |
|---|---|---|---|---|---|---|
| When $n_1 < n_{10}$, | $n_{1m} =$ | 0.0596716 | 0.0601453 | 0.0678638 | 0.0698572 | 0.0685303 |
| When $k_1 \geq k_{10}$, | $k_{1m} =$ | 0.0745129 | 0.0734180 | 0.0774060 | 0.0809473 | 0.0815564 |
| When $k_1 < k_{10}$, | $k_{1m} =$ | 0.0737073 | 0.0756104 | 0.0846094 | 0.0871533 | 0.0855286 |
| When $d_1 \geq d_{10}$, | $d_{1m}$ (nm) $=$ | 5.498 | 6.440 | 6.660 | 7.044 | 7.454 |
| When $d_1 < d_{10}$, | $d_{1m}$ (nm) $=$ | 4.112 | 4.536 | 4.657 | 4.822 | 5.013 |
| When $n_2 \geq n_{20}$, | $n_{2m} =$ | 0.2827258 | 0.2488782 | 0.2107483 | 0.1777197 | 0.1733423 |
| When $n_2 < n_{20}$, | $n_{2m} =$ | 0.2979187 | 0.2268945 | 0.2048547 | 0.1904834 | 0.1888538 |
| When $k_2 \geq k_{20}$, | $k_{2m} =$ | 0.3686462 | 0.2854443 | 0.2568164 | 0.2416882 | 0.2270508 |
| When $k_2 < k_{20}$, | $k_{2m} =$ | 0.2566187 | 0.1919458 | 0.1493335 | 0.1371973 | 0.1348743 |
| When $d_2 \geq d_{20}$, | $d_{2m}$ (nm) $=$ | 4.536 | ∞ | ∞ | ∞ | ∞ |
| When $d_2 < d_{20}$, | $d_{2m}$ (nm) $=$ | 3.441 | 7.549 | 17.368 | 24.447 | 26.666 |

$0. 9 3 \leq N A \leq 1. 0$
$3 5 < T \leq 4 5$

| Case | | 4-06 | 4-07 | 4-08 | 4-09 | 4-10 |
|---|---|---|---|---|---|---|
| $n_{10}$ | | 1.8894047 | 1.9013640 | 1.7974174 | 1.7778270 | 1.7589001 |
| $k_{10}$ | | 0.1134244 | 0.0821095 | 0.1211843 | 0.1038067 | 0.0931193 |
| $d_{10}$ (nm) | | 18.623 | 14.880 | 88.331 | 88.747 | 88.775 |
| $n_{20}$ | | 1.8513003 | 1.8106171 | 2.0615819 | 1.9023003 | 1.8006679 |
| $k_{20}$ | | 0.3877744 | 0.3102506 | 0.7049601 | 0.4013081 | 0.2880356 |
| $d_{20}$ (nm) | | 170.528 | 232.433 | 48.141 | 106.512 | 170.885 |

| When $n_1 \geq n_{10}$, | $n_{1m} =$ | 0.0963379 | 0.1102368 | 0.0634644 | 0.0662390 | 0.0666211 |
|---|---|---|---|---|---|---|
| When $n_1 < n_{10}$, | $n_{1m} =$ | 0.0760864 | 0.0881848 | 0.0372961 | 0.0368457 | 0.0352515 |
| When $k_1 \geq k_{10}$, | $k_{1m} =$ | 0.0891541 | 0.1015222 | 0.0717737 | 0.0709473 | 0.0673779 |
| When $k_1 < k_{10}$, | $k_{1m} =$ | 0.0954272 | 0.0821095 | 0.0478455 | 0.0509119 | 0.0546045 |
| When $d_1 \geq d_{10}$, | $d_{1m}$ (nm) $=$ | 7.796 | 7.721 | 10.517 | 12.746 | 16.898 |
| When $d_1 < d_{10}$, | $d_{1m}$ (nm) $=$ | 5.302 | 5.383 | 5.078 | 5.794 | 6.421 |
| When $n_2 \geq n_{20}$, | $n_{2m} =$ | 0.1607617 | 0.1549121 | 0.2063647 | 0.1805920 | 0.1791541 |
| When $n_2 < n_{20}$, | $n_{2m} =$ | 0.1802881 | 0.1767310 | 0.1869873 | 0.1622900 | 0.1552356 |
| When $k_2 \geq k_{20}$, | $k_{2m} =$ | 0.1971570 | 0.1718066 | 0.1998254 | 0.2205994 | 0.2284485 |
| When $k_2 < k_{20}$, | $k_{2m} =$ | 0.1177856 | 0.1071863 | 0.1537903 | 0.1082654 | 0.0890710 |
| When $d_2 \geq d_{20}$, | $d_{2m}$ (nm) $=$ | ∞ | ∞ | 7.208 | ∞ | ∞ |
| When $d_2 < d_{20}$, | $d_{2m}$ (nm) $=$ | 68.041 | 110.260 | 5.967 | 13.288 | 26.909 |

0. 9 3 ≤ N A ≤ 1. 0
3 5 < T ≤ 4 5

| Case | | 4-11 | 4-12 | 4-13 | 4-14 | 4-15 |
|------|------|------|------|------|------|------|
| $n_{10}$ | | 1.7310401 | 1.7404520 | 1.7353985 | 1.7244370 | 1.7094852 |
| $k_{10}$ | | 0.0827558 | 0.0960720 | 0.0882239 | 0.0802890 | 0.0677575 |
| $d_{10}$ (nm) | | 89.146 | 155.339 | 154.960 | 155.397 | 155.056 |
| $n_{20}$ | | 1.7041670 | 1.9461112 | 1.8293633 | 1.7457172 | 1.6751093 |
| $k_{20}$ | | 0.2282102 | 0.5942640 | 0.3421815 | 0.2519901 | 0.2044537 |
| $d_{20}$ (nm) | | 240.157 | 50.887 | 110.529 | 174.646 | 241.084 |

| | | 4-11 | 4-12 | 4-13 | 4-14 | 4-15 |
|------|------|------|------|------|------|------|
| When $n_1 \geq n_{10}$, | $n_{1m} =$ | 0.0658081 | 0.0609131 | 0.0631018 | 0.0626184 | 0.0606677 |
| When $n_1 < n_{10}$, | $n_{1m} =$ | 0.0392627 | 0.0232361 | 0.0219373 | 0.0213806 | 0.0433704 |
| When $k_1 \geq k_{10}$, | $k_{1m} =$ | 0.0703406 | 0.0642554 | 0.0612463 | 0.0585852 | 0.0715100 |
| When $k_1 < k_{10}$, | $k_{1m} =$ | 0.0569983 | 0.0328662 | 0.0342212 | 0.0355737 | 0.0444800 |
| When $d_1 \geq d_{10}$, | $d_{1m}$ (nm) $=$ | 25.085 | 16.735 | 27.723 | 38.964 | ∞ |
| When $d_1 < d_{10}$, | $d_{1m}$ (nm) $=$ | 9.551 | 5.135 | 5.136 | 5.707 | 18.661 |
| When $n_2 \geq n_{20}$, | $n_{2m} =$ | 0.1952173 | 0.1934106 | 0.1684375 | 0.2170105 | 0.2364917 |
| When $n_2 < n_{20}$, | $n_{2m} =$ | 0.1461670 | 0.1873682 | 0.1611987 | 0.1494055 | 0.1341663 |
| When $k_2 \geq k_{20}$, | $k_{2m} =$ | 0.1811243 | 0.1365161 | 0.1602917 | 0.1917432 | 0.1477625 |
| When $k_2 < k_{20}$, | $k_{2m} =$ | 0.0805774 | 0.1412585 | 0.0980115 | 0.0826819 | 0.0722742 |
| When $d_2 \geq d_{20}$, | $d_{2m}$ (nm) $=$ | ∞ | 6.877 | 15.552 | ∞ | ∞ |
| When $d_2 < d_{20}$, | $d_{2m}$ (nm) $=$ | 77.061 | 5.982 | 8.340 | 24.666 | 73.559 |

0. 9 3 ≤ N A ≤ 1. 0
3 5 < T ≤ 4 5

| Case | | 4-16 | 4-17 | 4-18 | 4-19 | 4-20 |
|------|------|------|------|------|------|------|
| $n_{10}$ | | 1.7305468 | 1.7234847 | 1.7196555 | 1.7094719 | 1.7026367 |
| $k_{10}$ | | 0.1083688 | 0.0859582 | 0.0809985 | 0.0713058 | 0.0605694 |
| $d_{10}$ (nm) | | 224.105 | 219.529 | 219.492 | 221.454 | 219.016 |
| $n_{20}$ | | 3.7612310 | 1.8940064 | 1.7865237 | 1.7085534 | 1.6670562 |
| $k_{20}$ | | 9.7520181 | 0.5381566 | 0.3130643 | 0.2375210 | 0.1929642 |
| $d_{20}$ (nm) | | 0.557 | 52.122 | 112.555 | 175.858 | 239.742 |

| | | 4-16 | 4-17 | 4-18 | 4-19 | 4-20 |
|------|------|------|------|------|------|------|
| When $n_1 \geq n_{10}$, | $n_{1m} =$ | 0.0498926 | 0.0642505 | 0.0656738 | 0.0636218 | 0.0649512 |
| When $n_1 < n_{10}$, | $n_{1m} =$ | 0.0031824 | 0.0153259 | 0.0138647 | 0.0294287 | 0.0615662 |
| When $k_1 \geq k_{10}$, | $k_{1m} =$ | 0.0271924 | 0.0553479 | 0.0526111 | 0.0605078 | 0.0781384 |
| When $k_1 < k_{10}$, | $k_{1m} =$ | 0.0108813 | 0.0230212 | 0.0207922 | 0.0257751 | 0.0395862 |
| When $d_1 \geq d_{10}$, | $d_{1m}$ (nm) $=$ | 12.324 | 42.526 | ∞ | ∞ | ∞ |
| When $d_1 < d_{10}$, | $d_{1m}$ (nm) $=$ | 0.823 | 4.181 | 3.891 | 14.979 | 80.387 |
| When $n_2 \geq n_{20}$, | $n_{2m} =$ | 0.4580664 | 0.1955493 | 0.1665735 | 0.2757410 | 0.2666089 |
| When $n_2 < n_{20}$, | $n_{2m} =$ | 1.0705701 | 0.1254541 | 0.1755249 | 0.1566431 | 0.1466138 |
| When $k_2 \geq k_{20}$, | $k_{2m} =$ | 0.1823242 | 0.0953308 | 0.1233594 | 0.1752612 | 0.1390967 |
| When $k_2 < k_{20}$, | $k_{2m} =$ | 1.8675439 | 0.1410535 | 0.1010315 | 0.0760974 | 0.0711597 |
| When $d_2 \geq d_{20}$, | $d_{2m}$ (nm) $=$ | 0.019 | 7.428 | ∞ | ∞ | ∞ |
| When $d_2 < d_{20}$, | $d_{2m}$ (nm) $=$ | 0.155 | 3.724 | 4.890 | 25.232 | 73.082 |

$0.93 \leq NA \leq 1.0$

$45 < T \leq 55$

| Case | 5-01 | 5-02 | 5-03 | 5-04 | 5-05 |
|---|---|---|---|---|---|
| $n_{10}$ | 1.7952075 | 1.8907711 | 1.9054716 | 1.9347861 | 1.9562331 |
| $k_{10}$ | 0.2631488 | 0.1709411 | 0.1139096 | 0.0660701 | 0.1018371 |
| $d_{10}$ (nm) | 28.407 | 22.060 | 18.051 | 14.149 | 10.504 |
| $n_{20}$ | 1.7975159 | 1.9054700 | 1.8637077 | 1.8512928 | 1.7371318 |
| $k_{20}$ | 0.9080589 | 0.5625340 | 0.4032117 | 0.3248351 | 0.3049135 |
| $d_{20}$ (nm) | 49.215 | 101.512 | 161.182 | 218.499 | 238.789 |

| | | 5-01 | 5-02 | 5-03 | 5-04 | 5-05 |
|---|---|---|---|---|---|---|
| When $n_1 \geq n_{10}$, | $n_{1m} =$ | 0.0796008 | 0.0882104 | 0.0968323 | 0.1120276 | 0.1430420 |
| When $n_1 < n_{10}$, | $n_{1m} =$ | 0.0558337 | 0.0676855 | 0.0756775 | 0.0900916 | 0.1115369 |
| When $k_1 \geq k_{10}$, | $k_{1m} =$ | 0.0737183 | 0.0824512 | 0.0899622 | 0.1015723 | 0.1322839 |
| When $k_1 < k_{10}$, | $k_{1m} =$ | 0.0714771 | 0.0859058 | 0.0970459 | 0.0660701 | 0.1018371 |
| When $d_1 \geq d_{10}$, | $d_{1m}$ (nm) $=$ | 6.136 | 6.696 | 7.231 | 6.738 | 5.941 |
| When $d_1 < d_{10}$, | $d_{1m}$ (nm) $=$ | 3.959 | 4.421 | 4.830 | 4.663 | 4.082 |
| When $n_2 \geq n_{20}$, | $n_{2m} =$ | 0.2206628 | 0.1836475 | 0.1640088 | 0.1560229 | 0.1493176 |
| When $n_2 < n_{20}$, | $n_{2m} =$ | 0.2514893 | 0.2026611 | 0.1850330 | 0.1781982 | 0.1793958 |
| When $k_2 \geq k_{20}$, | $k_{2m} =$ | 0.2648120 | 0.2363086 | 0.1980701 | 0.1765576 | 0.1456726 |
| When $k_2 < k_{20}$, | $k_{2m} =$ | 0.1661694 | 0.1390979 | 0.1188672 | 0.1083618 | 0.1075342 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 11.142 | 25.966 | 67.131 | 101.947 | 116.324 |

$0.93 \leq NA \leq 1.0$

$45 < T \leq 55$

| Case | 5-06 | 5-07 | 5-08 | 5-09 | 5-10 |
|---|---|---|---|---|---|
| $n_{10}$ | 1.7844085 | 1.7702622 | 1.7541370 | 1.7279592 | 1.7375980 |
| $k_{10}$ | 0.1367381 | 0.1105738 | 0.0973387 | 0.0846136 | 0.1054836 |
| $d_{10}$ (nm) | 84.299 | 87.211 | 88.132 | 88.943 | 150.710 |
| $n_{20}$ | 1.7096132 | 1.8115599 | 1.7670571 | 1.6883751 | 1.7055974 |
| $k_{20}$ | 0.6495191 | 0.4022198 | 0.2903421 | 0.2308596 | 0.5608974 |
| $d_{20}$ (nm) | 54.242 | 106.122 | 167.020 | 233.281 | 53.799 |

| | | 5-06 | 5-07 | 5-08 | 5-09 | 5-10 |
|---|---|---|---|---|---|---|
| When $n_1 \geq n_{10}$, | $n_{1m} =$ | 0.0647021 | 0.0659351 | 0.0664050 | 0.0646069 | 0.0607947 |
| When $n_1 < n_{10}$, | $n_{1m} =$ | 0.0336169 | 0.0333887 | 0.0319458 | 0.0381165 | 0.0178674 |
| When $k_1 \geq k_{10}$, | $k_{1m} =$ | 0.0728796 | 0.0707520 | 0.0653967 | 0.0692603 | 0.0616235 |
| When $k_1 < k_{10}$, | $k_{1m} =$ | 0.0421851 | 0.0477087 | 0.0524451 | 0.0553516 | 0.0270422 |
| When $d_1 \geq d_{10}$, | $d_{1m}$ (nm) $=$ | 9.564 | 12.156 | 16.406 | 23.344 | 13.595 |
| When $d_1 < d_{10}$, | $d_{1m}$ (nm) $=$ | 4.227 | 5.119 | 5.747 | 9.303 | 3.589 |
| When $n_2 \geq n_{20}$, | $n_{2m} =$ | 0.2254211 | 0.1928967 | 0.1889099 | 0.2061182 | 0.2563867 |
| When $n_2 < n_{20}$, | $n_{2m} =$ | 0.1907227 | 0.1764453 | 0.1616943 | 0.1463477 | 0.1201587 |
| When $k_2 \geq k_{20}$, | $k_{2m} =$ | 0.1398059 | 0.1815479 | 0.2086975 | 0.1714539 | 0.0974426 |
| When $k_2 < k_{20}$, | $k_{2m} =$ | 0.1320325 | 0.1038733 | 0.0888391 | 0.0812170 | 0.1216650 |
| When $d_2 \geq d_{20}$, | $d_{2m}$ (nm) $=$ | 14.246 | $\infty$ | $\infty$ | $\infty$ | 10.184 |
| When $d_2 < d_{20}$, | $d_{2m}$ (nm) $=$ | 7.856 | 11.965 | 30.548 | 77.806 | 4.856 |

$0.93 \leq NA \leq 1.0$

$45 < T \leq 55$

| Case | 5-11 | 5-12 | 5-13 | 5-14 | 5-15 |
|---|---|---|---|---|---|
| $n_{10}$ | 1.7329681 | 1.7221048 | 1.7083331 | 1.7220084 | 1.7182277 |
| $k_{10}$ | 0.0932680 | 0.0829100 | 0.0687145 | 0.0940320 | 0.0857940 |
| $d_{10}$ (nm) | 153.145 | 154.966 | 154.712 | 214.741 | 217.589 |
| $n_{20}$ | 1.7707311 | 1.7249696 | 1.6656993 | 1.7051250 | 1.7452872 |
| $k_{20}$ | 0.3436851 | 0.2554267 | 0.2071468 | 0.5097600 | 0.3145186 |
| $d_{20}$ (nm) | 107.979 | 168.643 | 233.037 | 53.504 | 108.615 |

| | | 5-11 | 5-12 | 5-13 | 5-14 | 5-15 |
|---|---|---|---|---|---|---|
| When $n_1 \geq n_{10}$, | $n_{1m} =$ | 0.0625659 | 0.0612402 | 0.0592444 | 0.0643567 | 0.0658276 |
| When $n_1 < n_{10}$, | $n_{1m} =$ | 0.0170984 | 0.0172632 | 0.0416833 | 0.0078064 | 0.0068054 |
| When $k_1 \geq k_{10}$, | $k_{1m} =$ | 0.0565161 | 0.0540405 | 0.0705188 | 0.0454688 | 0.0426636 |
| When $k_1 < k_{10}$, | $k_{1m} =$ | 0.0297095 | 0.0318542 | 0.0432507 | 0.0149841 | 0.0129956 |
| When $d_1 \geq d_{10}$, | $d_{1m}$ (nm) $=$ | 26.425 | 34.880 | $\infty$ | 35.694 | $\infty$ |
| When $d_1 < d_{10}$, | $d_{1m}$ (nm) $=$ | 3.834 | 4.536 | 17.051 | 1.969 | 1.835 |
| When $n_2 \geq n_{20}$, | $n_{2m} =$ | 0.2299866 | 0.2362512 | 0.2473572 | 0.2585364 | 0.2705701 |
| When $n_2 < n_{20}$, | $n_{2m} =$ | 0.1752441 | 0.1521826 | 0.1336328 | 0.0467419 | 0.0530518 |
| When $k_2 \geq k_{20}$, | $k_{2m} =$ | 0.1260229 | 0.1759094 | 0.1395569 | 0.0560938 | 0.0808508 |
| When $k_2 < k_{20}$, | $k_{2m} =$ | 0.0941040 | 0.0829492 | 0.0726111 | 0.1239917 | 0.0993604 |
| When $d_2 \geq d_{20}$, | $d_{2m}$ (nm) $=$ | $\infty$ | $\infty$ | $\infty$ | 10.256 | $\infty$ |
| When $d_2 < d_{20}$, | $d_{2m}$ (nm) $=$ | 6.312 | 26.413 | 73.432 | 2.024 | 2.346 |

$0.93 \leq NA \leq 1.0$

$45 < T \leq 55$

| Case | 5-16 | 5-17 |
|---|---|---|
| $n_{10}$ | 1.7079026 | 1.7021324 |
| $k_{10}$ | 0.0731017 | 0.0613637 |
| $d_{10}$ (nm) | 221.285 | 218.642 |
| $n_{20}$ | 1.6934483 | 1.6620357 |
| $k_{20}$ | 0.2412999 | 0.1957858 |
| $d_{20}$ (nm) | 168.585 | 230.920 |

| | | 5-16 | 5-17 |
|---|---|---|---|
| When $n_1 \geq n_{10}$, | $n_{1m} =$ | 0.0611572 | 0.0632739 |
| When $n_1 < n_{10}$, | $n_{1m} =$ | 0.0235156 | 0.0581824 |
| When $k_1 \geq k_{10}$, | $k_{1m} =$ | 0.0566406 | 0.0776050 |
| When $k_1 < k_{10}$, | $k_{1m} =$ | 0.0230566 | 0.0386719 |
| When $d_1 \geq d_{10}$, | $d_{1m}$ (nm) $=$ | $\infty$ | $\infty$ |
| When $d_1 < d_{10}$, | $d_{1m}$ (nm) $=$ | 8.641 | 78.699 |
| When $n_2 \geq n_{20}$, | $n_{2m} =$ | 0.2946387 | 0.2760742 |
| When $n_2 < n_{20}$, | $n_{2m} =$ | 0.1554272 | 0.1463647 |
| When $k_2 \geq k_{20}$, | $k_{2m} =$ | 0.1654895 | 0.1344739 |
| When $k_2 < k_{20}$, | $k_{2m} =$ | 0.0676013 | 0.0719324 |
| When $d_2 \geq d_{20}$, | $d_{2m}$ (nm) $=$ | $\infty$ | $\infty$ |
| When $d_2 < d_{20}$, | $d_{2m}$ (nm) $=$ | 26.199 | 53.085 |

$0. \ 93 \le NA \le 1. \ 0$

$55 < T \le 65$

| Case | | 6-01 | 6-02 | 6-03 | 6-04 | 6-05 |
|---|---|---|---|---|---|---|
| $n_{10}$ | | 1.7605068 | 1.8816347 | 1.9020430 | 1.9458467 | 1.9584022 |
| $k_{10}$ | | 0.2771672 | 0.1829378 | 0.1268282 | 0.0703715 | 0.1032605 |
| $d_{10}$ (nm) | | 28.706 | 20.725 | 16.538 | 13.048 | 10.534 |
| $n_{20}$ | | 1.6786286 | 1.8151288 | 1.7976518 | 1.8275971 | 1.7382432 |
| $k_{20}$ | | 0.9008770 | 0.5496963 | 0.3935708 | 0.3251874 | 0.3086817 |
| $d_{20}$ (nm) | | 43.735 | 99.755 | 160.685 | 213.311 | 229.129 |

| | | 6-01 | 6-02 | 6-03 | 6-04 | 6-05 |
|---|---|---|---|---|---|---|
| When $n_1 \ge n_{10}$, | $n_{1m}=$ | 0.0840430 | 0.0931677 | 0.1035986 | 0.1192371 | 0.1431311 |
| When $n_1 < n_{10}$, | $n_{1m}=$ | 0.0576428 | 0.0681458 | 0.0779578 | 0.0939172 | 0.1097058 |
| When $k_1 \ge k_{10}$, | $k_{1m}=$ | 0.0662097 | 0.0857654 | 0.0958630 | 0.1068726 | 0.1305750 |
| When $k_1 < k_{10}$, | $k_{1m}=$ | 0.0706262 | 0.0861902 | 0.1004041 | 0.0703715 | 0.1032605 |
| When $d_1 \ge d_{10}$, | $d_{1m}$ (nm) $=$ | 6.461 | 6.864 | 7.218 | 6.428 | 5.908 |
| When $d_1 < d_{10}$, | $d_{1m}$ (nm) $=$ | 4.241 | 4.337 | 4.665 | 4.365 | 3.988 |
| When $n_2 \ge n_{20}$, | $n_{2m}=$ | 0.2053870 | 0.1760388 | 0.1592407 | 0.1556714 | 0.1505713 |
| When $n_2 < n_{20}$, | $n_{2m}=$ | 0.2197400 | 0.2099182 | 0.1887061 | 0.1809558 | 0.1813904 |
| When $k_2 \ge k_{20}$, | $k_{2m}=$ | 0.2532373 | 0.2078381 | 0.1779785 | 0.1687073 | 0.1458105 |
| When $k_2 < k_{20}$, | $k_{2m}=$ | 0.1729968 | 0.1382983 | 0.1186841 | 0.1101477 | 0.1094250 |
| When $d_2 \ge d_{20}$, | $d_{2m}$ (nm) $=$ | ∞ | ∞ | ∞ | ∞ | ∞ |
| When $d_2 < d_{20}$, | $d_{2m}$ (nm) $=$ | 9.750 | 24.367 | 71.258 | 104.445 | 116.852 |

$0. \ 93 \le NA \le 1. \ 0$

$55 < T \le 65$

| Case | | 6-06 | 6-07 | 6-08 | 6-09 | 6-10 |
|---|---|---|---|---|---|---|
| $n_{10}$ | | 1.7915017 | 1.7682864 | 1.7517777 | 1.7257399 | 1.7391311 |
| $k_{10}$ | | 0.1460711 | 0.1152280 | 0.1000283 | 0.0854213 | 0.1111219 |
| $d_{10}$ (nm) | | 82.108 | 86.246 | 87.803 | 88.823 | 148.271 |
| $n_{20}$ | | 1.6599684 | 1.7730752 | 1.7495420 | 1.6774661 | 1.6415570 |
| $k_{20}$ | | 0.6598461 | 0.3999868 | 0.2902721 | 0.2313191 | 0.5493559 |
| $d_{20}$ (nm) | | 47.036 | 100.473 | 159.986 | 224.881 | 47.977 |

| | | 6-06 | 6-07 | 6-08 | 6-09 | 6-10 |
|---|---|---|---|---|---|---|
| When $n_1 \ge n_{10}$, | $n_{1m}=$ | 0.0707507 | 0.0678174 | 0.0671436 | 0.0642444 | 0.0613611 |
| When $n_1 < n_{10}$, | $n_{1m}=$ | 0.0347034 | 0.0316797 | 0.0297241 | 0.0379114 | 0.0170081 |
| When $k_1 \ge k_{10}$, | $k_{1m}=$ | 0.0716638 | 0.0707349 | 0.0637610 | 0.0688733 | 0.0614063 |
| When $k_1 < k_{10}$, | $k_{1m}=$ | 0.0419373 | 0.0459045 | 0.0509448 | 0.0544250 | 0.0258569 |
| When $d_1 \ge d_{10}$, | $d_{1m}$ (nm) $=$ | 8.814 | 11.596 | 15.946 | 22.736 | 12.264 |
| When $d_1 < d_{10}$, | $d_{1m}$ (nm) $=$ | 3.999 | 4.706 | 5.289 | 9.347 | 3.219 |
| When $n_2 \ge n_{20}$, | $n_{2m}=$ | 0.2110352 | 0.2040027 | 0.1980566 | 0.2150256 | 0.2303101 |
| When $n_2 < n_{20}$, | $n_{2m}=$ | 0.1684949 | 0.1890479 | 0.1666223 | 0.1461719 | 0.0970691 |
| When $k_2 \ge k_{20}$, | $k_{2m}=$ | 0.1438293 | 0.1667627 | 0.2003491 | 0.1648621 | 0.0994629 |
| When $k_2 < k_{20}$, | $k_{2m}=$ | 0.1447302 | 0.1052173 | 0.0896777 | 0.0819421 | 0.1292871 |
| When $d_2 \ge d_{20}$, | $d_{2m}$ (nm) $=$ | 15.339 | ∞ | ∞ | ∞ | 12.574 |
| When $d_2 < d_{20}$, | $d_{2m}$ (nm) $=$ | 6.489 | 10.552 | 32.474 | 78.570 | 4.088 |

$0.93 \leq NA \leq 1.0$

$55 < T \leq 65$

| Case | 6-11 | 6-12 | 6-13 | 6-14 | 6-15 |
|---|---|---|---|---|---|
| $n_{10}$ | 1.7320844 | 1.7076855 | 1.7203924 | 1.7223192 | 1.7173463 |
| $k_{10}$ | 0.0968192 | 0.0689521 | 0.0842770 | 0.0985051 | 0.0890019 |
| $d_{10}$ (nm) | 152.055 | 154.586 | 154.911 | 212.081 | 216.420 |
| $n_{20}$ | 1.7411899 | 1.6612710 | 1.7118542 | 1.6387426 | 1.7205682 |
| $k_{20}$ | 0.3409343 | 0.2081961 | 0.2561923 | 0.4904233 | 0.3116849 |
| $d_{20}$ (nm) | 101.751 | 223.547 | 160.544 | 48.284 | 102.035 |

| | | 6-11 | 6-12 | 6-13 | 6-14 | 6-15 |
|---|---|---|---|---|---|---|
| When $n_1 \geq n_{10}$, | $n_{1m} =$ | 0.0640808 | 0.0590295 | 0.0609424 | 0.0598975 | 0.0677930 |
| When $n_1 < n_{10}$, | $n_{1m} =$ | 0.0141614 | 0.0412158 | 0.0147046 | 0.0053711 | 0.0022900 |
| When $k_1 \geq k_{10}$, | $k_{1m} =$ | 0.0532275 | 0.0702893 | 0.0510400 | 0.0410706 | 0.0340332 |
| When $k_1 < k_{10}$, | $k_{1m} =$ | 0.0265625 | 0.0427490 | 0.0291602 | 0.0117297 | 0.0056226 |
| When $d_1 \geq d_{10}$, | $d_{1m}$ (nm) $=$ | 25.992 | ∞ | 33.192 | 33.998 | 50.996 |
| When $d_1 < d_{10}$, | $d_{1m}$ (nm) $=$ | 3.082 | 16.525 | 3.853 | 1.301 | 0.604 |
| When $n_2 \geq n_{20}$, | $n_{2m} =$ | 0.2268713 | 0.2531177 | 0.2476831 | 0.2556775 | 0.2704236 |
| When $n_2 < n_{20}$, | $n_{2m} =$ | 0.1878772 | 0.1338721 | 0.1536694 | 0.0287537 | 0.0146338 |
| When $k_2 \geq k_{20}$, | $k_{2m} =$ | 0.1099695 | 0.1355603 | 0.1692993 | 0.0485706 | 0.0433569 |
| When $k_2 < k_{20}$, | $k_{2m} =$ | 0.0948242 | 0.0734631 | 0.0770691 | 0.1286780 | 0.0774121 |
| When $d_2 \geq d_{20}$, | $d_{2m}$ (nm) $=$ | ∞ | ∞ | ∞ | 12.209 | ∞ |
| When $d_2 < d_{20}$, | $d_{2m}$ (nm) $=$ | 4.972 | 56.744 | 27.273 | 1.327 | 0.772 |

$0.93 \leq NA \leq 1.0$

$55 < T \leq 65$

| Case | 6-16 | 6-17 |
|---|---|---|
| $n_{10}$ | 1.7068337 | 1.7019545 |
| $k_{10}$ | 0.0738736 | 0.0615388 |
| $d_{10}$ (nm) | 221.446 | 218.498 |
| $n_{20}$ | 1.6845656 | 1.6606500 |
| $k_{20}$ | 0.2425094 | 0.1970435 |
| $d_{20}$ (nm) | 159.621 | 220.941 |

| | | 6-16 | 6-17 |
|---|---|---|---|
| When $n_1 \geq n_{10}$, | $n_{1m} =$ | 0.0603540 | 0.0631677 |
| When $n_1 < n_{10}$, | $n_{1m} =$ | 0.0209692 | 0.0568018 |
| When $k_1 \geq k_{10}$, | $k_{1m} =$ | 0.0545837 | 0.0777637 |
| When $k_1 < k_{10}$, | $k_{1m} =$ | 0.0216589 | 0.0384106 |
| When $d_1 \geq d_{10}$, | $d_{1m}$ (nm) $=$ | ∞ | ∞ |
| When $d_1 < d_{10}$, | $d_{1m}$ (nm) $=$ | 7.750 | 78.234 |
| When $n_2 \geq n_{20}$, | $n_{2m} =$ | 0.3057288 | 0.2826660 |
| When $n_2 < n_{20}$, | $n_{2m} =$ | 0.1553943 | 0.1472412 |
| When $k_2 \geq k_{20}$, | $k_{2m} =$ | 0.1625220 | 0.1326501 |
| When $k_2 < k_{20}$, | $k_{2m} =$ | 0.0624280 | 0.0731104 |
| When $d_2 \geq d_{20}$, | $d_{2m}$ (nm) $=$ | ∞ | ∞ |
| When $d_2 < d_{20}$, | $d_{2m}$ (nm) $=$ | 26.805 | 48.201 |

$0.93 \leq NA \leq 1.0$
$65 < T \leq 75$

| Case | | 7-01 | 7-02 | 7-03 | 7-04 | 7-05 |
|---|---|---|---|---|---|---|
| $n_{10}$ | | 1.7659038 | 1.8645399 | 1.8986420 | 1.9431410 | 1.8260230 |
| $k_{10}$ | | 0.3040912 | 0.1945245 | 0.1330684 | 0.1068639 | 0.1610409 |
| $d_{10}$ (nm) | | 29.683 | 22.504 | 17.099 | 11.420 | 82.141 |
| $n_{20}$ | | 1.6951746 | 1.8232494 | 1.7981378 | 1.7406778 | 1.8123655 |
| $k_{20}$ | | 1.0159152 | 0.5745287 | 0.4053118 | 0.3159076 | 0.8416018 |
| $d_{20}$ (nm) | | 32.660 | 88.735 | 150.314 | 217.432 | 29.750 |

| | | | | | | |
|---|---|---|---|---|---|---|
| When $n_1 \geq n_{10}$, | $n_{1m} =$ | 0.0851306 | 0.0913562 | 0.1021387 | 0.1343896 | 0.0697156 |
| When $n_1 < n_{10}$, | $n_{1m} =$ | 0.0579541 | 0.0649255 | 0.0759912 | 0.1029980 | 0.0329614 |
| When $k_1 \geq k_{10}$, | $k_{1m} =$ | 0.0588293 | 0.0796277 | 0.0923560 | 0.1221460 | 0.0674365 |
| When $k_1 < k_{10}$, | $k_{1m} =$ | 0.0718896 | 0.0854541 | 0.0996875 | 0.1068639 | 0.0435559 |
| When $d_1 \geq d_{10}$, | $d_{1m}$ (nm) $=$ | 5.966 | 7.118 | 7.275 | 6.222 | 7.298 |
| When $d_1 < d_{10}$, | $d_{1m}$ (nm) $=$ | 4.222 | 4.395 | 4.641 | 4.200 | 3.443 |
| When $n_2 \geq n_{20}$, | $n_{2m} =$ | 0.2227673 | 0.1853540 | 0.1622253 | 0.1538269 | 0.2762463 |
| When $n_2 < n_{20}$, | $n_{2m} =$ | 0.2074731 | 0.2178162 | 0.1908838 | 0.1813525 | 0.2757544 |
| When $k_2 \geq k_{20}$, | $k_{2m} =$ | 0.3106860 | 0.2340100 | 0.1838708 | 0.1497839 | 0.2030774 |
| When $k_2 < k_{20}$, | $k_{2m} =$ | 0.2037939 | 0.1485229 | 0.1235767 | 0.1116138 | 0.1923645 |
| When $d_2 \geq d_{20}$, | $d_{2m}$ (nm) $=$ | ∞ | ∞ | ∞ | ∞ | 12.449 |
| When $d_2 < d_{20}$, | $d_{2m}$ (nm) $=$ | 7.750 | 24.931 | 70.207 | 113.565 | 5.408 |

$0.93 \leq NA \leq 1.0$
$65 < T \leq 75$

| Case | | 7-06 | 7-07 | 7-08 | 7-09 | 7-10 |
|---|---|---|---|---|---|---|
| $n_{10}$ | | 1.7771488 | 1.7544343 | 1.7270080 | 1.7474077 | 1.7344421 |
| $k_{10}$ | | 0.1183021 | 0.1010010 | 0.0859818 | 0.1187907 | 0.0986199 |
| $d_{10}$ (nm) | | 86.874 | 88.257 | 88.900 | 148.872 | 153.031 |
| $n_{20}$ | | 1.8193233 | 1.7618403 | 1.6808707 | 1.6925268 | 1.7617910 |
| $k_{20}$ | | 0.4301648 | 0.3008540 | 0.2360835 | 0.6251022 | 0.3597954 |
| $d_{20}$ (nm) | | 86.325 | 147.888 | 214.142 | 34.244 | 89.143 |

| | | | | | | |
|---|---|---|---|---|---|---|
| When $n_1 \geq n_{10}$, | $n_{1m} =$ | 0.0673694 | 0.0664294 | 0.0644080 | 0.0590649 | 0.0632410 |
| When $n_1 < n_{10}$, | $n_{1m} =$ | 0.0307617 | 0.0294727 | 0.0379211 | 0.0149548 | 0.0133545 |
| When $k_1 \geq k_{10}$, | $k_{1m} =$ | 0.0672144 | 0.0623938 | 0.0685620 | 0.0548840 | 0.0510083 |
| When $k_1 < k_{10}$, | $k_{1m} =$ | 0.0467444 | 0.0514600 | 0.0549805 | 0.0255261 | 0.0262878 |
| When $d_1 \geq d_{10}$, | $d_{1m}$ (nm) $=$ | 10.761 | 15.121 | 22.543 | 10.466 | 24.985 |
| When $d_1 < d_{10}$, | $d_{1m}$ (nm) $=$ | 4.433 | 5.189 | 9.219 | 2.761 | 2.901 |
| When $n_2 \geq n_{20}$, | $n_{2m} =$ | 0.2196216 | 0.2049475 | 0.2147473 | 0.2786914 | 0.2464575 |
| When $n_2 < n_{20}$, | $n_{2m} =$ | 0.1907739 | 0.1643323 | 0.1459814 | 0.1244519 | 0.1858276 |
| When $k_2 \geq k_{20}$, | $k_{2m} =$ | 0.1969482 | 0.2144763 | 0.1668457 | 0.1106995 | 0.1237866 |
| When $k_2 < k_{20}$, | $k_{2m} =$ | 0.1161511 | 0.0943396 | 0.0836194 | 0.1556311 | 0.1032104 |
| When $d_2 \geq d_{20}$, | $d_{2m}$ (nm) $=$ | ∞ | ∞ | ∞ | 9.505 | ∞ |
| When $d_2 < d_{20}$, | $d_{2m}$ (nm) $=$ | 10.265 | 27.730 | 76.727 | 3.667 | 4.914 |

$0.93 \leq NA \leq 1.0$
$65 < T \leq 75$

| Case | 7-11 | 7-12 | 7-13 | 7-14 | 7-15 |
|---|---|---|---|---|---|
| $n_{10}$ | 1.7082851 | 1.7212227 | 1.7256274 | 1.7180408 | 1.7074443 |
| $k_{10}$ | 0.0693971 | 0.0845898 | 0.1038247 | 0.0895343 | 0.0742263 |
| $d_{10}$ (nm) | 154.668 | 155.411 | 212.824 | 218.202 | 221.707 |
| $n_{20}$ | 1.6632564 | 1.7183974 | 1.6530934 | 1.7315716 | 1.6896767 |
| $k_{20}$ | 0.2120421 | 0.2642962 | 0.5317369 | 0.3280557 | 0.2496384 |
| $d_{20}$ (nm) | 213.175 | 149.129 | 36.133 | 89.506 | 148.627 |

| | | 7-11 | 7-12 | 7-13 | 7-14 | 7-15 |
|---|---|---|---|---|---|---|
| When $n_1 \geq n_{10}$, | $n_{1m} =$ | 0.0593945 | 0.0606384 | 0.0541980 | 0.0647742 | 0.0609387 |
| When $n_1 < n_{10}$, | $n_{1m} =$ | 0.0413879 | 0.0149182 | 0.0029968 | 0.0021960 | 0.0208508 |
| When $k_1 \geq k_{10}$, | $k_{1m} =$ | 0.0699487 | 0.0507495 | 0.0335364 | 0.0342871 | 0.0542102 |
| When $k_1 < k_{10}$, | $k_{1m} =$ | 0.0433142 | 0.0298535 | 0.0082080 | 0.0055542 | 0.0221802 |
| When $d_1 \geq d_{10}$, | $d_{1m}$ (nm) $=$ | $\infty$ | 32.689 | 15.980 | 48.365 | $\infty$ |
| When $d_1 < d_{10}$, | $d_{1m}$ (nm) $=$ | 16.649 | 3.913 | 0.723 | 0.594 | 7.641 |
| When $n_2 \geq n_{20}$, | $n_{2m} =$ | 0.2553577 | 0.2564221 | 0.2715186 | 0.1988367 | 0.3137769 |
| When $n_2 < n_{20}$, | $n_{2m} =$ | 0.1341199 | 0.1522119 | 0.0214917 | 0.0208643 | 0.1570667 |
| When $k_2 \geq k_{20}$, | $k_{2m} =$ | 0.1361841 | 0.1775061 | 0.0327844 | 0.0526038 | 0.1632751 |
| When $k_2 < k_{20}$, | $k_{2m} =$ | 0.0749841 | 0.0809204 | 0.1462024 | 0.0801404 | 0.0667383 |
| When $d_2 \geq d_{20}$, | $d_{2m}$ (nm) $=$ | $\infty$ | $\infty$ | 9.604 | $\infty$ | $\infty$ |
| When $d_2 < d_{20}$, | $d_{2m}$ (nm) $=$ | 57.367 | 24.447 | 0.813 | 0.826 | 24.310 |

$0.93 \leq NA \leq 1.0$
$65 < T \leq 75$

| Case | 7-16 |
|---|---|
| $n_{10}$ | 1.7023147 |
| $k_{10}$ | 0.0619030 |
| $d_{10}$ (nm) | 218.598 |
| $n_{20}$ | 1.6620389 |
| $k_{20}$ | 0.2005572 |
| $d_{20}$ (nm) | 210.752 |

| | | 7-16 |
|---|---|---|
| When $n_1 \geq n_{10}$, | $n_{1m} =$ | 0.0637036 |
| When $n_1 < n_{10}$, | $n_{1m} =$ | 0.0577161 |
| When $k_1 \geq k_{10}$, | $k_{1m} =$ | 0.0772327 |
| When $k_1 < k_{10}$, | $k_{1m} =$ | 0.0389124 |
| When $d_1 \geq d_{10}$, | $d_{1m}$ (nm) $=$ | $\infty$ |
| When $d_1 < d_{10}$, | $d_{1m}$ (nm) $=$ | 78.427 |
| When $n_2 \geq n_{20}$, | $n_{2m} =$ | 0.2845728 |
| When $n_2 < n_{20}$, | $n_{2m} =$ | 0.1478259 |
| When $k_2 \geq k_{20}$, | $k_{2m} =$ | 0.1321912 |
| When $k_2 < k_{20}$, | $k_{2m} =$ | 0.0745581 |
| When $d_2 \geq d_{20}$, | $d_{2m}$ (nm) $=$ | $\infty$ |
| When $d_2 < d_{20}$, | $d_{2m}$ (nm) $=$ | 48.632 |

EP 1 760 766 A2

0. 9 3 ≤ N A ≤ 1. 0
7 5 < T ≤ 8 5

| Case | 8-01 | 8-02 | 8-03 | 8-04 | 8-05 |
|---|---|---|---|---|---|
| $n_{10}$ | 1.7563588 | 1.8511230 | 1.8843188 | 1.9287462 | 1.8353218 |
| $k_{10}$ | 0.3324096 | 0.2092311 | 0.1443736 | 0.1105115 | 0.1759033 |
| $d_{10}$ (nm) | 35.374 | 25.991 | 18.736 | 12.655 | 87.389 |
| $n_{20}$ | 1.9274523 | 1.9063465 | 1.8018968 | 1.7494498 | 2.1171648 |
| $k_{20}$ | 1.4642575 | 0.6506745 | 0.4300566 | 0.3311673 | 1.3140425 |
| $d_{20}$ (nm) | 17.251 | 73.686 | 139.851 | 205.772 | 13.979 |

| | | 8-01 | 8-02 | 8-03 | 8-04 | 8-05 |
|---|---|---|---|---|---|---|
| When $n_1 \geq n_{10}$, | $n_{1m}=$ | 0.0785156 | 0.0867322 | 0.0972815 | 0.1243994 | 0.0679163 |
| When $n_1 < n_{10}$, | $n_{1m}=$ | 0.0545728 | 0.0619702 | 0.0719873 | 0.0956885 | 0.0326843 |
| When $k_1 \geq k_{10}$, | $k_{1m}=$ | 0.0474365 | 0.0710938 | 0.0861206 | 0.1128003 | 0.0573657 |
| When $k_1 < k_{10}$, | $k_{1m}=$ | 0.0515906 | 0.0859790 | 0.0958850 | 0.1105115 | 0.0462488 |
| When $d_1 \geq d_{10}$, | $d_{1m}$ (nm) $=$ | 5.195 | 7.048 | 7.475 | 6.554 | 6.786 |
| When $d_1 < d_{10}$, | $d_{1m}$ (nm) $=$ | 4.054 | 4.401 | 4.771 | 4.433 | 3.439 |
| When $n_2 \geq n_{20}$, | $n_{2m}=$ | 0.3717346 | 0.2089124 | 0.1658667 | 0.1550732 | 0.3935315 |
| When $n_2 < n_{20}$, | $n_{2m}=$ | 0.2566504 | 0.2226855 | 0.1899609 | 0.1803442 | 0.3930750 |
| When $k_2 \geq k_{20}$, | $k_{2m}=$ | 0.3327271 | 0.2900549 | 0.1962512 | 0.1555261 | 0.4058423 |
| When $k_2 < k_{20}$, | $k_{2m}=$ | 0.2814465 | 0.1644043 | 0.1285254 | 0.1140686 | 0.2980408 |
| When $d_2 \geq d_{20}$, | $d_{2m}$ (nm) $=$ | 7.242 | $\infty$ | $\infty$ | $\infty$ | 4.246 |
| When $d_2 < d_{20}$, | $d_{2m}$ (nm) $=$ | 5.453 | 18.064 | 63.635 | 86.244 | 4.110 |

0. 9 3 ≤ N A ≤ 1. 0
7 5 < T ≤ 8 5

| Case | 8-06 | 8-07 | 8-08 | 8-09 | 8-10 |
|---|---|---|---|---|---|
| $n_{10}$ | 1.7950810 | 1.7627960 | 1.7313791 | 1.7608801 | 1.7394221 |
| $k_{10}$ | 0.1221034 | 0.1022278 | 0.0877850 | 0.1266208 | 0.0996664 |
| $d_{10}$ (nm) | 88.670 | 88.862 | 88.999 | 153.509 | 155.305 |
| $n_{20}$ | 1.9787137 | 1.8048095 | 1.6945552 | 1.9275665 | 1.8479873 |
| $k_{20}$ | 0.5126318 | 0.3274205 | 0.2478313 | 0.9887124 | 0.4176577 |
| $d_{20}$ (nm) | 67.257 | 133.479 | 202.902 | 15.987 | 72.839 |

| | | 8-06 | 8-07 | 8-08 | 8-09 | 8-10 |
|---|---|---|---|---|---|---|
| When $n_1 \geq n_{10}$, | $n_{1m}=$ | 0.0661450 | 0.0654504 | 0.0644836 | 0.0595581 | 0.0618579 |
| When $n_1 < n_{10}$, | $n_{1m}=$ | 0.0313049 | 0.0305920 | 0.0369946 | 0.0131787 | 0.0145801 |
| When $k_1 \geq k_{10}$, | $k_{1m}=$ | 0.0629285 | 0.0615845 | 0.0676172 | 0.0466980 | 0.0504663 |
| When $k_1 < k_{10}$, | $k_{1m}=$ | 0.0495715 | 0.0531104 | 0.0563220 | 0.0260303 | 0.0287866 |
| When $d_1 \geq d_{10}$, | $d_{1m}$ (nm) $=$ | 9.764 | 13.747 | 21.746 | 9.118 | 15.633 |
| When $d_1 < d_{10}$, | $d_{1m}$ (nm) $=$ | 4.261 | 5.184 | 8.521 | 2.425 | 3.180 |
| When $n_2 \geq n_{20}$, | $n_{2m}=$ | 0.1949426 | 0.2017102 | 0.2072998 | 0.3193018 | 0.1671875 |
| When $n_2 < n_{20}$, | $n_{2m}=$ | 0.1905188 | 0.1606116 | 0.1458716 | 0.3499829 | 0.1826196 |
| When $k_2 \geq k_{20}$, | $k_{2m}=$ | 0.2324365 | 0.2397180 | 0.1749133 | 0.1658679 | 0.1587329 |
| When $k_2 < k_{20}$, | $k_{2m}=$ | 0.1375964 | 0.1005615 | 0.0861584 | 0.2502869 | 0.1212964 |
| When $d_2 \geq d_{20}$, | $d_{2m}$ (nm) $=$ | 11.495 | $\infty$ | $\infty$ | 4.383 | 10.247 |
| When $d_2 < d_{20}$, | $d_{2m}$ (nm) $=$ | 10.836 | 22.009 | 72.908 | 4.573 | 5.928 |

0．93 ≤ N A ≤ 1．0
7 5 < T ≤ 8 5

| Case | 8-11 | 8-12 | 8-13 | 8-14 | 8-15 |
|---|---|---|---|---|---|
| $n_{10}$ | 1.7245671 | 1.7098549 | 1.7314445 | 1.7204815 | 1.7093097 |
| $k_{10}$ | 0.0857616 | 0.0711157 | 0.1087664 | 0.0894136 | 0.0755678 |
| $d_{10}$ (nm) | 155.774 | 154.844 | 218.242 | 220.453 | 221.580 |
| $n_{20}$ | 1.7414131 | 1.6689951 | 1.7862714 | 1.7885409 | 1.7021793 |
| $k_{20}$ | 0.2835597 | 0.2212317 | 0.7962122 | 0.3769446 | 0.2655853 |
| $d_{20}$ (nm) | 136.971 | 203.148 | 18.394 | 74.763 | 137.968 |

| | | 8-11 | 8-12 | 8-13 | 8-14 | 8-15 |
|---|---|---|---|---|---|---|
| When $n_1 \geq n_{10}$, | $n_{1m}=$ | 0.0606116 | 0.0594177 | 0.0511572 | 0.0630383 | 0.0616895 |
| When $n_1 < n_{10}$, | $n_{1m}=$ | 0.0160718 | 0.0405298 | 0.0015906 | 0.0046008 | 0.0190027 |
| When $k_1 \geq k_{10}$, | $k_{1m}=$ | 0.0512000 | 0.0681555 | 0.0265222 | 0.0380334 | 0.0531970 |
| When $k_1 < k_{10}$, | $k_{1m}=$ | 0.0318042 | 0.0441748 | 0.0055811 | 0.0106726 | 0.0222839 |
| When $d_1 \geq d_{10}$, | $d_{1m}$ (nm) $=$ | 31.466 | ∞ | 12.528 | 43.958 | ∞ |
| When $d_1 < d_{10}$, | $d_{1m}$ (nm) $=$ | 4.121 | 15.106 | 0.395 | 1.266 | 6.425 |
| When $n_2 \geq n_{20}$, | $n_{2m}=$ | 0.2472620 | 0.2537585 | 0.2927209 | 0.1651587 | 0.3131763 |
| When $n_2 < n_{20}$, | $n_{2m}=$ | 0.1515137 | 0.1338916 | 0.0324463 | 0.1927209 | 0.1573535 |
| When $k_2 \geq k_{20}$, | $k_{2m}=$ | 0.1857507 | 0.1391650 | 0.0225110 | 0.0800281 | 0.1575110 |
| When $k_2 < k_{20}$, | $k_{2m}=$ | 0.0929626 | 0.0771277 | 0.2211072 | 0.1242517 | 0.0780078 |
| When $d_2 \geq d_{20}$, | $d_{2m}$ (nm) $=$ | ∞ | ∞ | 5.339 | 11.602 | ∞ |
| When $d_2 < d_{20}$, | $d_{2m}$ (nm) $=$ | 20.462 | 30.027 | 0.679 | 1.920 | 20.783 |

0．93 ≤ N A ≤ 1．0
7 5 < T ≤ 8 5

| Case | 8-16 |
|---|---|
| $n_{10}$ | 1.7029357 |
| $k_{10}$ | 0.0634027 |
| $d_{10}$ (nm) | 218.717 |
| $n_{20}$ | 1.6626290 |
| $k_{20}$ | 0.2083407 |
| $d_{20}$ (nm) | 201.624 |

| | | 8-16 |
|---|---|---|
| When $n_1 \geq n_{10}$, | $n_{1m}=$ | 0.0636414 |
| When $n_1 < n_{10}$, | $n_{1m}=$ | 0.0583008 |
| When $k_1 \geq k_{10}$, | $k_{1m}=$ | 0.0748706 |
| When $k_1 < k_{10}$, | $k_{1m}=$ | 0.0393835 |
| When $d_1 \geq d_{10}$, | $d_{1m}$ (nm) $=$ | ∞ |
| When $d_1 < d_{10}$, | $d_{1m}$ (nm) $=$ | 77.927 |
| When $n_2 \geq n_{20}$, | $n_{2m}=$ | 0.2855005 |
| When $n_2 < n_{20}$, | $n_{2m}=$ | 0.1457190 |
| When $k_2 \geq k_{20}$, | $k_{2m}=$ | 0.1308728 |
| When $k_2 < k_{20}$, | $k_{2m}=$ | 0.0761951 |
| When $d_2 \geq d_{20}$, | $d_{2m}$ (nm) $=$ | ∞ |
| When $d_2 < d_{20}$, | $d_{2m}$ (nm) $=$ | 30.691 |

$0.93 \leq NA \leq 1.0$
$85 < T \leq 95$

| Case | 9-01 | 9-02 | 9-03 | 9-04 | 9-05 |
|---|---|---|---|---|---|
| $n_{10}$ | 1.7289685 | 1.8452520 | 1.8988873 | 1.8877112 | 1.9267904 |
| $k_{10}$ | 0.3314086 | 0.2255929 | 0.1475831 | 0.1535471 | 0.0947520 |
| $d_{10}$ (nm) | 44.247 | 26.855 | 20.944 | 19.669 | 15.612 |
| $n_{20}$ | 5.1412592 | 1.9037614 | 1.8997324 | 1.8220692 | 1.8437835 |
| $k_{20}$ | 5.4454539 | 0.7221490 | 0.4893775 | 0.4687151 | 0.3693724 |
| $d_{20}$ (nm) | 1.484 | 66.898 | 122.094 | 129.650 | 183.529 |

| | | 9-01 | 9-02 | 9-03 | 9-04 | 9-05 |
|---|---|---|---|---|---|---|
| When $n_1 \geq n_{10}$, | $n_{1m} =$ | 0.0720642 | 0.0846375 | 0.0908557 | 0.0941199 | 0.1057788 |
| When $n_1 < n_{10}$, | $n_{1m} =$ | 0.0586633 | 0.0599194 | 0.0695422 | 0.0700256 | 0.0833301 |
| When $k_1 \geq k_{10}$, | $k_{1m} =$ | 0.0476758 | 0.0671912 | 0.0784241 | 0.0821533 | 0.0936853 |
| When $k_1 < k_{10}$, | $k_{1m} =$ | 0.0453955 | 0.0846301 | 0.0932227 | 0.0950391 | 0.0947520 |
| When $d_1 \geq d_{10}$, | $d_{1m}$ (nm) = | 4.793 | 6.632 | 6.977 | 7.158 | 6.784 |
| When $d_1 < d_{10}$, | $d_{1m}$ (nm) = | 4.550 | 4.181 | 4.538 | 4.591 | 4.595 |
| When $n_2 \geq n_{20}$, | $n_{2m} =$ | 1.1337476 | 0.2089880 | 0.1771472 | 0.1681067 | 0.1597327 |
| When $n_2 < n_{20}$, | $n_{2m} =$ | 1.1352368 | 0.2210583 | 0.1914734 | 0.1898022 | 0.1792920 |
| When $k_2 \geq k_{20}$, | $k_{2m} =$ | 0.8630298 | 0.2922070 | 0.2387195 | 0.2089600 | 0.1845532 |
| When $k_2 < k_{20}$, | $k_{2m} =$ | 1.0641260 | 0.1706519 | 0.1365454 | 0.1328516 | 0.1184924 |
| When $d_2 \geq d_{20}$, | $d_{2m}$ (nm) = | 0.527 | ∞ | ∞ | ∞ | ∞ |
| When $d_2 < d_{20}$, | $d_{2m}$ (nm) = | 0.379 | 14.827 | 35.595 | 55.475 | 73.593 |

$0.93 \leq NA \leq 1.0$
$85 < T \leq 95$

| Case | 9-06 | 9-07 | 9-08 | 9-09 | 9-10 |
|---|---|---|---|---|---|
| $n_{10}$ | 1.9311024 | 1.9377300 | 1.8321358 | 1.8340055 | 1.7711711 |
| $k_{10}$ | 0.1132645 | 0.0882760 | 0.1783607 | 0.1409526 | 0.1059247 |
| $d_{10}$ (nm) | 13.318 | 11.094 | 92.959 | 90.549 | 89.053 |
| $n_{20}$ | 1.7624681 | 1.7478213 | 3.8484718 | 2.7003837 | 1.8505388 |
| $k_{20}$ | 0.3523973 | 0.2927773 | 3.7040697 | 0.6754163 | 0.3612112 |
| $d_{20}$ (nm) | 195.472 | 252.908 | 2.442 | 40.010 | 121.432 |

| | | 9-06 | 9-07 | 9-08 | 9-09 | 9-10 |
|---|---|---|---|---|---|---|
| When $n_1 \geq n_{10}$, | $n_{1m} =$ | 0.1192212 | 0.1370740 | 0.0646143 | 0.0640906 | 0.0642236 |
| When $n_1 < n_{10}$, | $n_{1m} =$ | 0.0917322 | 0.1105750 | 0.0342749 | 0.0314893 | 0.0302832 |
| When $k_1 \geq k_{10}$, | $k_{1m} =$ | 0.1074902 | 0.1261145 | 0.0537451 | 0.0578040 | 0.0599036 |
| When $k_1 < k_{10}$, | $k_{1m} =$ | 0.1132645 | 0.0882760 | 0.0424707 | 0.0518921 | 0.0535962 |
| When $d_1 \geq d_{10}$, | $d_{1m}$ (nm) = | 6.457 | 6.373 | 6.914 | 7.622 | 12.267 |
| When $d_1 < d_{10}$, | $d_{1m}$ (nm) = | 4.357 | 4.610 | 3.684 | 3.553 | 4.848 |
| When $n_2 \geq n_{20}$, | $n_{2m} =$ | 0.1546643 | 0.1575439 | 0.8768713 | 0.1918994 | 0.1964832 |
| When $n_2 < n_{20}$, | $n_{2m} =$ | 0.1796094 | 0.1753381 | 0.8006409 | 0.2240674 | 0.1600745 |
| When $k_2 \geq k_{20}$, | $k_{2m} =$ | 0.1600171 | 0.1481116 | 0.9241052 | 0.2582642 | 0.2396375 |
| When $k_2 < k_{20}$, | $k_{2m} =$ | 0.1162842 | 0.1079150 | 0.8229163 | 0.1769763 | 0.1063232 |
| When $d_2 \geq d_{20}$, | $d_{2m}$ (nm) = | ∞ | ∞ | 0.854 | 4.088 | ∞ |
| When $d_2 < d_{20}$, | $d_{2m}$ (nm) = | 79.416 | 123.401 | 0.636 | 4.130 | 18.235 |

$0. 93 \leq NA \leq 1. 0$
$85 < T \leq 95$

| Case | 9-11 | 9-12 | 9-13 | 9-14 | 9-15 |
|---|---|---|---|---|---|
| $n_{10}$ | 1.7360863 | 1.7197908 | 1.7660895 | 1.7439719 | 1.7279356 |
| $k_{10}$ | 0.0911204 | 0.0799131 | 0.1278221 | 0.1032091 | 0.0888807 |
| $d_{10}$ (nm) | 88.900 | 88.028 | 159.319 | 156.425 | 155.640 |
| $n_{20}$ | 1.7067614 | 1.6618119 | 4.3535883 | 1.9650733 | 1.7635448 |
| $k_{20}$ | 0.2637604 | 0.2120965 | 4.0919379 | 0.4980866 | 0.3088945 |
| $d_{20}$ (nm) | 192.941 | 257.777 | 1.526 | 59.654 | 126.749 |

| | | 9-11 | 9-12 | 9-13 | 9-14 | 9-15 |
|---|---|---|---|---|---|---|
| When $n_1 \geq n_{10}$, | $n_{1m} =$ | 0.0638330 | 0.0656592 | 0.0584094 | 0.0605725 | 0.0597937 |
| When $n_1 < n_{10}$, | $n_{1m} =$ | 0.0350525 | 0.0511377 | 0.0141675 | 0.0144019 | 0.0151697 |
| When $k_1 \geq k_{10}$, | $k_{1m} =$ | 0.0655725 | 0.0796582 | 0.0444238 | 0.0479309 | 0.0488806 |
| When $k_1 < k_{10}$, | $k_{1m} =$ | 0.0571082 | 0.0562439 | 0.0291333 | 0.0298792 | 0.0316455 |
| When $d_1 \geq d_{10}$, | $d_{1m}$ (nm) $=$ | 20.203 | 29.484 | 8.864 | 13.240 | 29.427 |
| When $d_1 < d_{10}$, | $d_{1m}$ (nm) $=$ | 7.546 | 13.995 | 2.626 | 3.070 | 3.728 |
| When $n_2 \geq n_{20}$, | $n_{2m} =$ | 0.2021118 | 0.1991125 | 0.8787561 | 0.1681836 | 0.2119507 |
| When $n_2 < n_{20}$, | $n_{2m} =$ | 0.1462866 | 0.1442920 | 0.9231299 | 0.1869897 | 0.1520459 |
| When $k_2 \geq k_{20}$, | $k_{2m} =$ | 0.1808130 | 0.1431189 | 0.6934375 | 0.1601843 | 0.1789355 |
| When $k_2 < k_{20}$, | $k_{2m} =$ | 0.0887085 | 0.0763562 | 1.0372803 | 0.1399158 | 0.0974194 |
| When $d_2 \geq d_{20}$, | $d_{2m}$ (nm) $=$ | $\infty$ | $\infty$ | 0.372 | 7.404 | $\infty$ |
| When $d_2 < d_{20}$, | $d_{2m}$ (nm) $=$ | 33.573 | 81.452 | 0.412 | 5.841 | 17.631 |

$0. 93 \leq NA \leq 1. 0$
$85 < T \leq 95$

| Case | 9-16 | 9-17 | 9-18 | 9-19 | 9-20 |
|---|---|---|---|---|---|
| $n_{10}$ | 1.7114085 | 1.7070625 | 1.7347333 | 1.7230132 | 1.7111302 |
| $k_{10}$ | 0.0740744 | 0.0641745 | 0.1100034 | 0.0920219 | 0.0786417 |
| $d_{10}$ (nm) | 154.740 | 153.245 | 225.621 | 220.898 | 221.002 |
| $n_{20}$ | 1.6716288 | 1.6634512 | 4.2666617 | 1.8597675 | 1.7127614 |
| $k_{20}$ | 0.2338686 | 0.1921909 | 4.0109081 | 0.4430799 | 0.2870105 |
| $d_{20}$ (nm) | 194.347 | 254.410 | 1.346 | 63.229 | 128.848 |

| | | 9-16 | 9-17 | 9-18 | 9-19 | 9-20 |
|---|---|---|---|---|---|---|
| When $n_1 \geq n_{10}$, | $n_{1m} =$ | 0.0584460 | 0.0617004 | 0.0476050 | 0.0625842 | 0.0612109 |
| When $n_1 < n_{10}$, | $n_{1m} =$ | 0.0344641 | 0.0580713 | 0.0023816 | 0.0042908 | 0.0142651 |
| When $k_1 \geq k_{10}$, | $k_{1m} =$ | 0.0648608 | 0.0822974 | 0.0260010 | 0.0346094 | 0.0487000 |
| When $k_1 < k_{10}$, | $k_{1m} =$ | 0.0443103 | 0.0454309 | 0.0085535 | 0.0110950 | 0.0198962 |
| When $d_1 \geq d_{10}$, | $d_{1m}$ (nm) $=$ | $\infty$ | $\infty$ | 11.896 | 40.249 | $\infty$ |
| When $d_1 < d_{10}$, | $d_{1m}$ (nm) $=$ | 12.619 | 28.388 | 0.607 | 1.162 | 4.464 |
| When $n_2 \geq n_{20}$, | $n_{2m} =$ | 0.2496582 | 0.2459351 | 0.6243091 | 0.1726245 | 0.1878369 |
| When $n_2 < n_{20}$, | $n_{2m} =$ | 0.1333875 | 0.1351294 | 0.9687061 | 0.0992944 | 0.1569519 |
| When $k_2 \geq k_{20}$, | $k_{2m} =$ | 0.1378833 | 0.1234607 | 0.1299146 | 0.0597583 | 0.1385217 |
| When $k_2 < k_{20}$, | $k_{2m} =$ | 0.0791492 | 0.0682422 | 1.1651697 | 0.1405090 | 0.0853906 |
| When $d_2 \geq d_{20}$, | $d_{2m}$ (nm) $=$ | $\infty$ | $\infty$ | 0.085 | 8.765 | $\infty$ |
| When $d_2 < d_{20}$, | $d_{2m}$ (nm) $=$ | 27.415 | 76.157 | 0.398 | 1.778 | 18.221 |

$0.93 \leq NA \leq 1.0$

$85 < T \leq 95$

| Case | 9-21 | 9-22 | 9-23 |
|---|---|---|---|
| $n_{10}$ | 1.7035342 | 1.7027484 | 1.7001226 |
| $k_{10}$ | 0.0659797 | 0.0572097 | 0.0542621 |
| $d_{10}$ (nm) | 218.617 | 216.627 | 277.695 |
| $n_{20}$ | 1.6615801 | 1.6695991 | 1.6762439 |
| $k_{20}$ | 0.2195726 | 0.1821496 | 0.1770375 |
| $d_{20}$ (nm) | 193.289 | 251.116 | 248.521 |

| | | 9-21 | 9-22 | 9-23 |
|---|---|---|---|---|
| When $n_1 \geq n_{10}$, | $n_{1m}=$ | 0.0623376 | 0.0678125 | 0.0799658 |
| When $n_1 < n_{10}$, | $n_{1m}=$ | 0.0535010 | 0.0686682 | 0.1014282 |
| When $k_1 \geq k_{10}$, | $k_{1m}=$ | 0.0710327 | 0.0861914 | 0.0881311 |
| When $k_1 < k_{10}$, | $k_{1m}=$ | 0.0393738 | 0.0410693 | 0.0390344 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 76.543 | 86.880 | 145.024 |
| When $n_2 \geq n_{20}$, | $n_{2m}=$ | 0.2919910 | 0.2682678 | 0.2949561 |
| When $n_2 < n_{20}$, | $n_{2m}=$ | 0.1427539 | 0.1485803 | 0.2037488 |
| When $k_2 \geq k_{20}$, | $k_{2m}=$ | 0.1267480 | 0.1253760 | 0.1874854 |
| When $k_2 < k_{20}$, | $k_{2m}=$ | 0.0781458 | 0.0670801 | 0.0719922 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 27.736 | 75.187 | 78.004 |

$0.93 \leq NA \leq 1.0$

$95 < T \leq 105$

| Case | 10-01 | 10-02 | 10-03 | 10-04 | 10-05 |
|---|---|---|---|---|---|
| $n_{10}$ | 1.8593145 | 1.9010800 | 1.9204218 | 1.9438629 | 1.8201241 |
| $k_{10}$ | 0.2496127 | 0.1636004 | 0.1149718 | 0.1088618 | 0.1437532 |
| $d_{10}$ (nm) | 26.535 | 19.815 | 15.218 | 10.610 | 89.353 |
| $n_{20}$ | 1.9155767 | 1.8411706 | 1.7975616 | 1.7190727 | 2.3681639 |
| $k_{20}$ | 0.8329906 | 0.5121692 | 0.3794158 | 0.2999844 | 0.7410526 |
| $d_{20}$ (nm) | 59.684 | 120.535 | 182.059 | 250.015 | 43.212 |

| | | 10-01 | 10-02 | 10-03 | 10-04 | 10-05 |
|---|---|---|---|---|---|---|
| When $n_1 \geq n_{10}$, | $n_{1m}=$ | 0.0816284 | 0.0922021 | 0.1074707 | 0.1413159 | 0.0582056 |
| When $n_1 < n_{10}$, | $n_{1m}=$ | 0.0571204 | 0.0681042 | 0.0820581 | 0.1125684 | 0.0261719 |
| When $k_1 \geq k_{10}$, | $k_{1m}=$ | 0.0635767 | 0.0796045 | 0.0956897 | 0.1313098 | 0.0522705 |
| When $k_1 < k_{10}$, | $k_{1m}=$ | 0.0810986 | 0.0930249 | 0.1101465 | 0.1088618 | 0.0503638 |
| When $d_1 \geq d_{10}$, | $d_{1m}$ (nm) $=$ | 5.728 | 6.581 | 6.674 | 6.005 | 7.527 |
| When $d_1 < d_{10}$, | $d_{1m}$ (nm) $=$ | 3.587 | 4.159 | 4.431 | 4.306 | 3.047 |
| When $n_2 \geq n_{20}$, | $n_{2m}=$ | 0.2110999 | 0.1699976 | 0.1589343 | 0.1579346 | 0.2155920 |
| When $n_2 < n_{20}$, | $n_{2m}=$ | 0.2273865 | 0.1928259 | 0.1800378 | 0.1714307 | 0.2110571 |
| When $k_2 \geq k_{20}$, | $k_{2m}=$ | 0.3068860 | 0.2171289 | 0.1741077 | 0.1426062 | 0.2751843 |
| When $k_2 < k_{20}$, | $k_{2m}=$ | 0.1756396 | 0.1352295 | 0.1186548 | 0.1082129 | 0.1794531 |
| When $d_2 \geq d_{20}$, | $d_{2m}$ (nm) $=$ | ∞ | ∞ | ∞ | ∞ | 5.764 |
| When $d_2 < d_{20}$, | $d_{2m}$ (nm) $=$ | 12.732 | 34.057 | 73.872 | 121.675 | 5.150 |

$0.93 \leq NA \leq 1.0$
$95 < T \leq 105$

| Case | 10-06 | 10-07 | 10-08 | 10-09 | 10-10 |
|---|---|---|---|---|---|
| $n_{10}$ | 1.7719135 | 1.7372876 | 1.7204595 | 1.7445424 | 1.7286821 |
| $k_{10}$ | 0.1119845 | 0.0953951 | 0.0830085 | 0.1106490 | 0.0936244 |
| $d_{10}$ (nm) | 88.526 | 88.555 | 87.798 | 155.347 | 154.936 |
| $n_{20}$ | 1.8420973 | 1.7021944 | 1.6574450 | 1.9643384 | 1.7602486 |
| $k_{20}$ | 0.3885265 | 0.2779787 | 0.2209480 | 0.5665503 | 0.3317476 |
| $d_{20}$ (nm) | 115.256 | 185.353 | 249.744 | 53.939 | 119.649 |

| | | 10-06 | 10-07 | 10-08 | 10-09 | 10-10 |
|---|---|---|---|---|---|---|
| When $n_1 \geq n_{10}$, | $n_{1m} =$ | 0.0621143 | 0.0621887 | 0.0641711 | 0.0553430 | 0.0576575 |
| When $n_1 < n_{10}$, | $n_{1m} =$ | 0.0270313 | 0.0323645 | 0.0489441 | 0.0092163 | 0.0110840 |
| When $k_1 \geq k_{10}$, | $k_{1m} =$ | 0.0562158 | 0.0627490 | 0.0779517 | 0.0376074 | 0.0417603 |
| When $k_1 < k_{10}$, | $k_{1m} =$ | 0.0520581 | 0.0564075 | 0.0555945 | 0.0251758 | 0.0276855 |
| When $d_1 \geq d_{10}$, | $d_{1m}$ (nm) $=$ | 11.132 | 18.518 | 24.475 | 10.852 | 25.311 |
| When $d_1 < d_{10}$, | $d_{1m}$ (nm) $=$ | 4.165 | 6.637 | 12.657 | 1.885 | 2.611 |
| When $n_2 \geq n_{20}$, | $n_{2m} =$ | 0.1959729 | 0.2028772 | 0.1967151 | 0.1949902 | 0.2380078 |
| When $n_2 < n_{20}$, | $n_{2m} =$ | 0.1629126 | 0.1469397 | 0.1441541 | 0.1889697 | 0.1549414 |
| When $k_2 \geq k_{20}$, | $k_{2m} =$ | 0.2347974 | 0.1750098 | 0.1399744 | 0.1001758 | 0.1456445 |
| When $k_2 < k_{20}$, | $k_{2m} =$ | 0.1074329 | 0.0897974 | 0.0774023 | 0.1436816 | 0.0981848 |
| When $d_2 \geq d_{20}$, | $d_{2m}$ (nm) $=$ | ∞ | ∞ | ∞ | 7.077 | ∞ |
| When $d_2 < d_{20}$, | $d_{2m}$ (nm) $=$ | 17.579 | 32.188 | 79.555 | 4.014 | 9.652 |

$0.93 \leq NA \leq 1.0$
$95 < T \leq 105$

| Case | 10-11 | 10-12 | 10-13 | 10-14 | 10-15 |
|---|---|---|---|---|---|
| $n_{10}$ | 1.7117780 | 1.7072616 | 1.7114074 | 1.7035514 | 1.7027912 |
| $k_{10}$ | 0.0773392 | 0.0664543 | 0.0830146 | 0.0688006 | 0.0591414 |
| $d_{10}$ (nm) | 154.355 | 152.987 | 220.011 | 218.183 | 216.340 |
| $n_{20}$ | 1.6664488 | 1.6597858 | 1.7075466 | 1.6565327 | 1.6669294 |
| $k_{20}$ | 0.2460450 | 0.2000883 | 0.3068810 | 0.2307053 | 0.1896158 |
| $d_{20}$ (nm) | 186.501 | 246.239 | 121.613 | 185.316 | 242.803 |

| | | 10-11 | 10-12 | 10-13 | 10-14 | 10-15 |
|---|---|---|---|---|---|---|
| When $n_1 \geq n_{10}$, | $n_{1m} =$ | 0.0563684 | 0.0596582 | 0.0593091 | 0.0598755 | 0.0652673 |
| When $n_1 < n_{10}$, | $n_{1m} =$ | 0.0298474 | 0.0556995 | 0.0074023 | 0.0481897 | 0.0654077 |
| When $k_1 \geq k_{10}$, | $k_{1m} =$ | 0.0607349 | 0.0799170 | 0.0390686 | 0.0670154 | 0.0838220 |
| When $k_1 < k_{10}$, | $k_{1m} =$ | 0.0430676 | 0.0448303 | 0.0134863 | 0.0384473 | 0.0405530 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 9.756 | 23.688 | 2.192 | 28.661 | 83.384 |
| When $n_2 \geq n_{20}$, | $n_{2m} =$ | 0.2552490 | 0.2502368 | 0.2301306 | 0.3057727 | 0.2764221 |
| When $n_2 < n_{20}$, | $n_{2m} =$ | 0.1325989 | 0.1345728 | 0.1592334 | 0.1419543 | 0.1480603 |
| When $k_2 \geq k_{20}$, | $k_{2m} =$ | 0.1285986 | 0.1190894 | 0.0974548 | 0.1182935 | 0.1218213 |
| When $k_2 < k_{20}$, | $k_{2m} =$ | 0.0799036 | 0.0691528 | 0.0735474 | 0.0793201 | 0.0682898 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 26.413 | 74.134 | 17.074 | 26.587 | 73.152 |

$0.93 \le NA \le 1.0$
$105 < T \le 115$

| Case | 11-01 | 11-02 | 11-03 | 11-04 | 11-05 |
|---|---|---|---|---|---|
| $n_{10}$ | 1.8881577 | 1.9218914 | 1.9458883 | 1.9409291 | 1.7882093 |
| $k_{10}$ | 0.2795127 | 0.1797398 | 0.1322078 | 0.1179060 | 0.1515662 |
| $d_{10}$ (nm) | 22.871 | 17.442 | 13.080 | 10.849 | 85.800 |
| $n_{20}$ | 1.7550786 | 1.7746647 | 1.7478516 | 1.7108849 | 1.7933752 |
| $k_{20}$ | 0.8705815 | 0.5227186 | 0.3833699 | 0.3088835 | 0.6703287 |
| $d_{20}$ (nm) | 60.032 | 119.813 | 181.809 | 241.776 | 55.966 |

| | | 11-01 | 11-02 | 11-03 | 11-04 | 11-05 |
|---|---|---|---|---|---|---|
| When $n_1 \ge n_{10}$, | $n_{1m} =$ | 0.0826208 | 0.0977563 | 0.1186780 | 0.1376917 | 0.0543359 |
| When $n_1 < n_{10}$, | $n_{1m} =$ | 0.0520789 | 0.0682861 | 0.0872974 | 0.1088391 | 0.0162500 |
| When $k_1 \ge k_{10}$, | $k_{1m} =$ | 0.0630823 | 0.0841675 | 0.1052368 | 0.1278345 | 0.0453015 |
| When $k_1 < k_{10}$, | $k_{1m} =$ | 0.0771240 | 0.0966394 | 0.1209399 | 0.1179060 | 0.0399414 |
| When $d_1 \ge d_{10}$, | $d_{1m}$ (nm) $=$ | 4.844 | 5.864 | 5.837 | 5.925 | 7.044 |
| When $d_1 < d_{10}$, | $d_{1m}$ (nm) $=$ | 2.746 | 3.528 | 3.770 | 4.232 | 1.998 |
| When $n_2 \ge n_{20}$, | $n_{2m} =$ | 0.1779102 | 0.1610864 | 0.1553113 | 0.1599890 | 0.1976709 |
| When $n_2 < n_{20}$, | $n_{2m} =$ | 0.2409973 | 0.1978687 | 0.1825439 | 0.1715320 | 0.2140332 |
| When $k_2 \ge k_{20}$, | $k_{2m} =$ | 0.2513745 | 0.1848108 | 0.1557214 | 0.1414282 | 0.1190186 |
| When $k_2 < k_{20}$, | $k_{2m} =$ | 0.1529724 | 0.1289783 | 0.1162878 | 0.1089014 | 0.1251477 |
| When $d_2 \ge d_{20}$, | $d_{2m}$ (nm) $=$ | $\infty$ | $\infty$ | $\infty$ | $\infty$ | 22.520 |
| When $d_2 < d_{20}$, | $d_{2m}$ (nm) $=$ | 14.459 | 47.581 | 76.951 | 118.169 | 7.215 |

$0.93 \le NA \le 1.0$
$105 < T \le 115$

| Case | 11-06 | 11-07 | 11-08 | 11-09 | 11-10 |
|---|---|---|---|---|---|
| $n_{10}$ | 1.7649059 | 1.7337710 | 1.7199633 | 1.7259527 | 1.7103936 |
| $k_{10}$ | 0.1193411 | 0.0996522 | 0.0855558 | 0.0989978 | 0.0800216 |
| $d_{10}$ (nm) | 87.339 | 88.039 | 87.477 | 153.714 | 153.726 |
| $n_{20}$ | 1.7745734 | 1.6760618 | 1.6497564 | 1.7204930 | 1.6497935 |
| $k_{20}$ | 0.3964773 | 0.2847568 | 0.2267213 | 0.3415865 | 0.2528816 |
| $d_{20}$ (nm) | 113.800 | 179.842 | 241.489 | 115.571 | 179.482 |

| | | 11-06 | 11-07 | 11-08 | 11-09 | 11-10 |
|---|---|---|---|---|---|---|
| When $n_1 \ge n_{10}$, | $n_{1m} =$ | 0.0601648 | 0.0599890 | 0.0628394 | 0.0551172 | 0.0538281 |
| When $n_1 < n_{10}$, | $n_{1m} =$ | 0.0211145 | 0.0296448 | 0.0487646 | 0.0042871 | 0.0282654 |
| When $k_1 \ge k_{10}$, | $k_{1m} =$ | 0.0504663 | 0.0599475 | 0.0772742 | 0.0278052 | 0.0572974 |
| When $k_1 < k_{10}$, | $k_{1m} =$ | 0.0475183 | 0.0544922 | 0.0541711 | 0.0166541 | 0.0416528 |
| When $d_1 \ge d_{10}$, | $d_{1m}$ (nm) $=$ | 10.266 | 16.506 | 22.112 | 22.094 | 29.214 |
| When $d_1 < d_{10}$, | $d_{1m}$ (nm) $=$ | 3.195 | 5.968 | 12.188 | 0.978 | 9.029 |
| When $n_2 \ge n_{20}$, | $n_{2m} =$ | 0.1995813 | 0.2097351 | 0.1798193 | 0.2563574 | 0.2736133 |
| When $n_2 < n_{20}$, | $n_{2m} =$ | 0.1736548 | 0.1494116 | 0.1464758 | 0.1632507 | 0.1337610 |
| When $k_2 \ge k_{20}$, | $k_{2m} =$ | 0.1791345 | 0.1568970 | 0.1341675 | 0.0805750 | 0.1130872 |
| When $k_2 < k_{20}$, | $k_{2m} =$ | 0.1012146 | 0.0889111 | 0.0780908 | 0.0849402 | 0.0789160 |
| When $d_2 \ge d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 14.312 | 35.616 | 79.447 | 3.314 | 27.322 |

$0. 93 \leq NA \leq 1. 0$

$105 < T \leq 115$

| Case | 11-11 | 11-12 | 11-13 |
|---|---|---|---|
| $n_{10}$ | 1.7070930 | 1.7028018 | 1.7027432 |
| $k_{10}$ | 0.0681638 | 0.0710148 | 0.0605235 |
| $d_{10}$ (nm) | 152.585 | 217.506 | 215.929 |
| $n_{20}$ | 1.6551703 | 1.6456663 | 1.6646615 |
| $k_{20}$ | 0.2055639 | 0.2376270 | 0.1950188 |
| $d_{20}$ (nm) | 237.501 | 177.429 | 233.713 |

| | | 11-11 | 11-12 | 11-13 |
|---|---|---|---|---|
| When $n_1 \geq n_{10}$, | $n_{1m} =$ | 0.0578955 | 0.0572009 | 0.0625354 |
| When $n_1 < n_{10}$, | $n_{1m} =$ | 0.0537671 | 0.0422668 | 0.0608704 |
| When $k_1 \geq k_{10}$, | $k_{1m} =$ | 0.0790588 | 0.0645129 | 0.0827734 |
| When $k_1 < k_{10}$, | $k_{1m} =$ | 0.0435974 | 0.0363208 | 0.0394031 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 20.858 | 18.787 | 80.567 |
| When $n_2 \geq n_{20}$, | $n_{2m} =$ | 0.1279260 | 0.3212610 | 0.2872583 |
| When $n_2 < n_{20}$, | $n_{2m} =$ | 0.1371912 | 0.1436340 | 0.1515588 |
| When $k_2 \geq k_{20}$, | $k_{2m} =$ | 0.1138037 | 0.1091870 | 0.1188855 |
| When $k_2 < k_{20}$, | $k_{2m} =$ | 0.0699854 | 0.0793604 | 0.0696228 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 73.529 | 27.402 | 72.558 |

$0.93 \leq NA \leq 1.0$

$115 < T \leq 125$

| Case | 12-01 | 12-02 | 12-03 | 12-04 | 12-05 |
|---|---|---|---|---|---|
| $n_{10}$ | 1.8909431 | 1.9524263 | 1.9741784 | 1.9011191 | 1.7812655 |
| $k_{10}$ | 0.3085424 | 0.1909748 | 0.1389140 | 0.1449022 | 0.1647646 |
| $d_{10}$ (nm) | 20.418 | 15.444 | 11.832 | 11.795 | 82.868 |
| $n_{20}$ | 1.5964478 | 1.7414925 | 1.7353816 | 1.6673230 | 1.6154117 |
| $k_{20}$ | 0.8353138 | 0.5288169 | 0.3892797 | 0.3043383 | 0.6141968 |
| $d_{20}$ (nm) | 60.909 | 116.361 | 176.360 | 237.538 | 58.066 |

| | | 12-01 | 12-02 | 12-03 | 12-04 | 12-05 |
|---|---|---|---|---|---|---|
| When $n_1 \geq n_{10}$, | $n_{1m} =$ | 0.0896326 | 0.1058130 | 0.1273743 | 0.1294861 | 0.0526233 |
| When $n_1 < n_{10}$, | $n_{1m} =$ | 0.0482068 | 0.0693359 | 0.0898755 | 0.1018958 | 0.0089111 |
| When $k_1 \geq k_{10}$, | $k_{1m} =$ | 0.0687769 | 0.0897180 | 0.1101831 | 0.1230750 | 0.0397290 |
| When $k_1 < k_{10}$, | $k_{1m} =$ | 0.0788684 | 0.1029199 | 0.1292102 | 0.1244238 | 0.0264612 |
| When $d_1 \geq d_{10}$, | $d_{1m}$ (nm) $=$ | 4.348 | 5.029 | 5.176 | 6.485 | 6.077 |
| When $d_1 < d_{10}$, | $d_{1m}$ (nm) $=$ | 2.275 | 2.981 | 3.260 | 4.641 | 1.033 |
| When $n_2 \geq n_{20}$, | $n_{2m} =$ | 0.1653235 | 0.1570801 | 0.1545581 | 0.1637158 | 0.2122083 |
| When $n_2 < n_{20}$, | $n_{2m} =$ | 0.1924231 | 0.2075879 | 0.1868823 | 0.1636792 | 0.1151331 |
| When $k_2 \geq k_{20}$, | $k_{2m} =$ | 0.1706042 | 0.1628406 | 0.1476868 | 0.1368591 | 0.0534973 |
| When $k_2 < k_{20}$, | $k_{2m} =$ | 0.1411853 | 0.1262378 | 0.1172034 | 0.1087061 | 0.1078625 |
| When $d_2 \geq d_{20}$, | $d_{2m}$ (nm) $=$ | ∞ | ∞ | ∞ | ∞ | 22.263 |
| When $d_2 < d_{20}$, | $d_{2m}$ (nm) $=$ | 15.932 | 41.005 | 77.327 | 119.056 | 3.631 |

$0.93 \leq NA \leq 1.0$

$115 < T \leq 125$

| Case | 12-06 | 12-07 | 12-08 | 12-09 | 12-10 |
|---|---|---|---|---|---|
| $n_{10}$ | 1.7599364 | 1.7294022 | 1.7193592 | 1.7088052 | 1.7070991 |
| $k_{10}$ | 0.1268761 | 0.1028924 | 0.0869972 | 0.0815889 | 0.0689994 |
| $d_{10}$ (nm) | 86.158 | 87.627 | 87.259 | 153.347 | 152.325 |
| $n_{20}$ | 1.7200975 | 1.6470339 | 1.6442041 | 1.6346844 | 1.6535493 |
| $k_{20}$ | 0.3928633 | 0.2862372 | 0.2301394 | 0.2563356 | 0.2091466 |
| $d_{20}$ (nm) | 111.244 | 173.600 | 231.990 | 171.193 | 227.454 |

| | | 12-06 | 12-07 | 12-08 | 12-09 | 12-10 |
|---|---|---|---|---|---|---|
| When $n_1 \geq n_{10}$, | $n_{1m}=$ | 0.0606738 | 0.0583850 | 0.0624988 | 0.0517444 | 0.0574902 |
| When $n_1 < n_{10}$, | $n_{1m}=$ | 0.0144922 | 0.0280688 | 0.0507288 | 0.0284387 | 0.0507019 |
| When $k_1 \geq k_{10}$, | $k_{1m}=$ | 0.0425989 | 0.0573376 | 0.0776721 | 0.0554700 | 0.0798230 |
| When $k_1 < k_{10}$, | $k_{1m}=$ | 0.0406250 | 0.0512256 | 0.0527991 | 0.0388428 | 0.0424304 |
| When $d_1 \geq d_{10}$, | $d_{1m}$ (nm) $=$ | 9.315 | 15.226 | 20.570 | 23.760 | ∞ |
| When $d_1 < d_{10}$, | $d_{1m}$ (nm) $=$ | 2.129 | 5.657 | 12.499 | 8.630 | 19.101 |
| When $n_2 \geq n_{20}$, | $n_{2m}=$ | 0.2113904 | 0.2168030 | 0.1303113 | 0.0779236 | 0.1123853 |
| When $n_2 < n_{20}$, | $n_{2m}=$ | 0.1965198 | 0.1502832 | 0.1490173 | 0.1347925 | 0.1407104 |
| When $k_2 \geq k_{20}$, | $k_{2m}=$ | 0.1312354 | 0.1404419 | 0.1299280 | 0.1034583 | 0.1115356 |
| When $k_2 < k_{20}$, | $k_{2m}=$ | 0.0975891 | 0.0892358 | 0.0798267 | 0.0797656 | 0.0721289 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 8.212 | 56.813 | 80.756 | 28.524 | 74.263 |

$0.93 \leq NA \leq 1.0$

$115 < T \leq 125$

| Case | 12-11 | 12-12 |
|---|---|---|
| $n_{10}$ | 1.7021164 | 1.7030336 |
| $k_{10}$ | 0.0722203 | 0.0611451 |
| $d_{10}$ (nm) | 217.158 | 215.722 |
| $n_{20}$ | 1.6379690 | 1.6657846 |
| $k_{20}$ | 0.2419462 | 0.1987136 |
| $d_{20}$ (nm) | 168.107 | 223.276 |

| | | 12-11 | 12-12 |
|---|---|---|---|
| When $n_1 \geq n_{10}$, | $n_{1m}=$ | 0.0559460 | 0.0616492 |
| When $n_1 < n_{10}$, | $n_{1m}=$ | 0.0369629 | 0.0571216 |
| When $k_1 \geq k_{10}$, | $k_{1m}=$ | 0.0643591 | 0.0831226 |
| When $k_1 < k_{10}$, | $k_{1m}=$ | 0.0338867 | 0.0383716 |
| When $d_1 \geq d_{10}$, | $d_{1m}$ (nm) $=$ | ∞ | ∞ |
| When $d_1 < d_{10}$, | $d_{1m}$ (nm) $=$ | 15.623 | 78.766 |
| When $n_2 \geq n_{20}$, | $n_{2m}=$ | 0.1071765 | 0.1574146 |
| When $n_2 < n_{20}$, | $n_{2m}=$ | 0.1467676 | 0.1563452 |
| When $k_2 \geq k_{20}$, | $k_{2m}=$ | 0.1072412 | 0.1188721 |
| When $k_2 < k_{20}$, | $k_{2m}=$ | 0.0815015 | 0.0722400 |
| When $d_2 \geq d_{20}$, | $d_{2m}$ (nm) $=$ | ∞ | ∞ |
| When $d_2 < d_{20}$, | $d_{2m}$ (nm) $=$ | 28.758 | 73.194 |

EP 1 760 766 A2

$0.93 \leq NA \leq 1.0$
$125 < T \leq 135$

| Case | 13-01 | 13-02 | 13-03 | 13-04 | 13-05 |
|---|---|---|---|---|---|
| $n_{10}$ | 1.8737564 | 1.9697383 | 1.9916260 | 1.9141720 | 1.7868889 |
| $k_{10}$ | 0.3367363 | 0.2020294 | 0.1477036 | 0.1461879 | 0.1795709 |
| $d_{10}$ (nm) | 20.276 | 14.764 | 11.315 | 11.459 | 80.605 |
| $n_{20}$ | 1.5133470 | 1.7299638 | 1.7257470 | 1.6683491 | 1.5409994 |
| $k_{20}$ | 0.8454522 | 0.5429087 | 0.3987910 | 0.3122132 | 0.6011754 |
| $d_{20}$ (nm) | 55.480 | 109.268 | 168.578 | 226.037 | 53.925 |

| | | 13-01 | 13-02 | 13-03 | 13-04 | 13-05 |
|---|---|---|---|---|---|---|
| When $n_1 \geq n_{10}$, | $n_{1m} =$ | 0.0919055 | 0.1108435 | 0.1324426 | 0.1321936 | 0.0477332 |
| When $n_1 < n_{10}$, | $n_{1m} =$ | 0.0465112 | 0.0677783 | 0.0890894 | 0.1050525 | 0.0054248 |
| When $k_1 \geq k_{10}$, | $k_{1m} =$ | 0.0634827 | 0.0913306 | 0.1103125 | 0.1242993 | 0.0376343 |
| When $k_1 < k_{10}$, | $k_{1m} =$ | 0.0777942 | 0.1046863 | 0.1330994 | 0.1263855 | 0.0172180 |
| When $d_1 \geq d_{10}$, | $d_{1m}$ (nm) $=$ | 4.127 | 4.585 | 4.757 | 6.157 | 5.240 |
| When $d_1 < d_{10}$, | $d_{1m}$ (nm) $=$ | 2.100 | 2.651 | 2.937 | 4.469 | 0.576 |
| When $n_2 \geq n_{20}$, | $n_{2m} =$ | 0.1485144 | 0.1609766 | 0.1572363 | 0.1614685 | 0.1647119 |
| When $n_2 < n_{20}$, | $n_{2m} =$ | 0.1669641 | 0.2206506 | 0.1915698 | 0.1618420 | 0.0427734 |
| When $k_2 \geq k_{20}$, | $k_{2m} =$ | 0.1498572 | 0.1556653 | 0.1444165 | 0.1361792 | 0.0323462 |
| When $k_2 < k_{20}$, | $k_{2m} =$ | 0.1523499 | 0.1322424 | 0.1219958 | 0.1118262 | 0.1188306 |
| When $d_2 \geq d_{20}$, | $d_{2m}$ (nm) $=$ | $\infty$ | $\infty$ | $\infty$ | $\infty$ | 20.169 |
| When $d_2 < d_{20}$, | $d_{2m}$ (nm) $=$ | 11.040 | 31.054 | 70.606 | 112.796 | 1.698 |

$0.93 \leq NA \leq 1.0$
$125 < T \leq 135$

| Case | 13-06 | 13-07 | 13-08 | 13-09 | 13-10 |
|---|---|---|---|---|---|
| $n_{10}$ | 1.7600620 | 1.7276490 | 1.7199953 | 1.7084320 | 1.7077870 |
| $k_{10}$ | 0.1342170 | 0.1044918 | 0.0874837 | 0.0820944 | 0.0691595 |
| $d_{10}$ (nm) | 85.615 | 87.663 | 87.278 | 153.448 | 152.438 |
| $n_{20}$ | 1.6974715 | 1.6338870 | 1.6452183 | 1.6304269 | 1.6574806 |
| $k_{20}$ | 0.3980869 | 0.2915200 | 0.2346970 | 0.2625567 | 0.2137196 |
| $d_{20}$ (nm) | 104.529 | 164.129 | 221.092 | 160.685 | 216.250 |

| | | 13-06 | 13-07 | 13-08 | 13-09 | 13-10 |
|---|---|---|---|---|---|---|
| When $n_1 \geq n_{10}$, | $n_{1m} =$ | 0.0556421 | 0.0573047 | 0.0630432 | 0.0509070 | 0.0582422 |
| When $n_1 < n_{10}$, | $n_{1m} =$ | 0.0086938 | 0.0280566 | 0.0524658 | 0.0272729 | 0.0496997 |
| When $k_1 \geq k_{10}$, | $k_{1m} =$ | 0.0327625 | 0.0552051 | 0.0782056 | 0.0552515 | 0.0808813 |
| When $k_1 < k_{10}$, | $k_{1m} =$ | 0.0328357 | 0.0492957 | 0.0525903 | 0.0375085 | 0.0423645 |
| When $d_1 \geq d_{10}$, | $d_{1m}$ (nm) $=$ | 8.316 | 14.598 | 20.258 | 22.646 | $\infty$ |
| When $d_1 < d_{10}$, | $d_{1m}$ (nm) $=$ | 1.229 | 5.725 | 12.785 | 8.439 | 18.783 |
| When $n_2 \geq n_{20}$, | $n_{2m} =$ | 0.2312317 | 0.1156555 | 0.1151941 | 0.0670740 | 0.1089307 |
| When $n_2 < n_{20}$, | $n_{2m} =$ | 0.2128992 | 0.1481116 | 0.1498755 | 0.1344946 | 0.1425024 |
| When $k_2 \geq k_{20}$, | $k_{2m} =$ | 0.1020886 | 0.1348413 | 0.1299255 | 0.1027795 | 0.1131628 |
| When $k_2 < k_{20}$, | $k_{2m} =$ | 0.1027185 | 0.0927148 | 0.0827966 | 0.0840479 | 0.0754407 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 4.085 | 34.120 | 79.786 | 26.736 | 37.465 |

474

$0.93 \leq NA \leq 1.0$

$125 < T \leq 135$

| Case | 13-11 | 13-12 |
|---|---|---|
| $n_{10}$ | 1.7022055 | 1.7036940 |
| $k_{10}$ | 0.0725208 | 0.0612465 |
| $d_{10}$ (nm) | 217.368 | 215.927 |
| $n_{20}$ | 1.6389178 | 1.6705104 |
| $k_{20}$ | 0.2487144 | 0.2029113 |
| $d_{20}$ (nm) | 157.041 | 212.129 |

| | | 13-11 | 13-12 |
|---|---|---|---|
| When $n_1 \geq n_{10}$, | $n_{1m} =$ | 0.0559827 | 0.0624561 |
| When $n_1 < n_{10}$, | $n_{1m} =$ | 0.0346814 | 0.0563831 |
| When $k_1 \geq k_{10}$, | $k_{1m} =$ | 0.0655139 | 0.0838672 |
| When $k_1 < k_{10}$, | $k_{1m} =$ | 0.0329700 | 0.0384436 |
| When $d_1 \geq d_{10}$, | $d_{1m}$ (nm) $=$ | $\infty$ | $\infty$ |
| When $d_1 < d_{10}$, | $d_{1m}$ (nm) $=$ | 14.691 | 78.542 |
| When $n_2 \geq n_{20}$, | $n_{2m} =$ | 0.0987000 | 0.1459375 |
| When $n_2 < n_{20}$, | $n_{2m} =$ | 0.1477222 | 0.1585510 |
| When $k_2 \geq k_{20}$, | $k_{2m} =$ | 0.1107947 | 0.1206909 |
| When $k_2 < k_{20}$, | $k_{2m} =$ | 0.0868396 | 0.0754724 |
| When $d_2 \geq d_{20}$, | $d_{2m}$ (nm) $=$ | $\infty$ | $\infty$ |
| When $d_2 < d_{20}$, | $d_{2m}$ (nm) $=$ | 26.886 | 30.205 |

$0.93 \leq NA \leq 1.0$
$135 < T \leq 145$

| Case | 14-01 | 14-02 | 14-03 | 14-04 | 14-05 |
|---|---|---|---|---|---|
| $n_{10}$ | 1.8402862 | 1.9646387 | 1.9624104 | 1.9059084 | 1.8166660 |
| $k_{10}$ | 0.3700261 | 0.2123233 | 0.1584699 | 0.1473615 | 0.1977639 |
| $d_{10}$ (nm) | 23.403 | 16.447 | 12.893 | 12.089 | 79.798 |
| $n_{20}$ | 1.4966418 | 1.7618069 | 1.7211612 | 1.6694213 | 1.5572201 |
| $k_{20}$ | 1.0039549 | 0.5971846 | 0.4176484 | 0.3203376 | 0.7204992 |
| $d_{20}$ (nm) | 41.463 | 94.995 | 156.173 | 216.011 | 40.224 |

| | | 14-01 | 14-02 | 14-03 | 14-04 | 14-05 |
|---|---|---|---|---|---|---|
| When $n_1 \geq n_{10}$, | $n_{1m} =$ | 0.0906067 | 0.1022083 | 0.1191650 | 0.1272498 | 0.0481567 |
| When $n_1 < n_{10}$, | $n_{1m} =$ | 0.0460486 | 0.0622925 | 0.0801978 | 0.1004968 | 0.0053052 |
| When $k_1 \geq k_{10}$, | $k_{1m} =$ | 0.0548682 | 0.0821582 | 0.0987952 | 0.1188953 | 0.0360181 |
| When $k_1 < k_{10}$, | $k_{1m} =$ | 0.0585999 | 0.0953162 | 0.1207214 | 0.1220581 | 0.0169287 |
| When $d_1 \geq d_{10}$, | $d_{1m}$ (nm) $=$ | 4.196 | 4.611 | 5.209 | 6.343 | 4.539 |
| When $d_1 < d_{10}$, | $d_{1m}$ (nm) $=$ | 2.216 | 2.591 | 3.134 | 4.582 | 0.509 |
| When $n_2 \geq n_{20}$, | $n_{2m} =$ | 0.1766626 | 0.1806128 | 0.1668896 | 0.1603455 | 0.2142871 |
| When $n_2 < n_{20}$, | $n_{2m} =$ | 0.1712292 | 0.2330798 | 0.1905432 | 0.1645447 | 0.0564514 |
| When $k_2 \geq k_{20}$, | $k_{2m} =$ | 0.2110498 | 0.1844238 | 0.1540930 | 0.1380908 | 0.0433691 |
| When $k_2 < k_{20}$, | $k_{2m} =$ | 0.1916614 | 0.1446765 | 0.1279346 | 0.1140405 | 0.1534607 |
| When $d_2 \geq d_{20}$, | $d_{2m}$ (nm) $=$ | $\infty$ | $\infty$ | $\infty$ | $\infty$ | 18.289 |
| When $d_2 < d_{20}$, | $d_{2m}$ (nm) $=$ | 8.143 | 21.467 | 66.145 | 96.079 | 1.264 |

$0.93 \leq NA \leq 1.0$
$135 < T \leq 145$

| Case | | 14-06 | 14-07 | 14-08 | 14-09 | 14-10 |
|---|---|---|---|---|---|---|
| $n_{10}$ | | 1.7655719 | 1.7293285 | 1.7214396 | 1.7092770 | 1.7085071 |
| $k_{10}$ | | 0.1384976 | 0.1055583 | 0.0882507 | 0.0826318 | 0.0697446 |
| $d_{10}$ (nm) | | 86.596 | 87.952 | 87.451 | 153.805 | 152.663 |
| $n_{20}$ | | 1.7129955 | 1.6364176 | 1.6482275 | 1.6322979 | 1.6592624 |
| $k_{20}$ | | 0.4320226 | 0.3040668 | 0.2416232 | 0.2733763 | 0.2197085 |
| $d_{20}$ (nm) | | 91.539 | 153.339 | 210.993 | 150.296 | 206.543 |

| When $n_1 \geq n_{10}$, | $n_{1m} =$ | 0.0570667 | 0.0566760 | 0.0630505 | 0.0509021 | 0.0584448 |
|---|---|---|---|---|---|---|
| When $n_1 < n_{10}$, | $n_{1m} =$ | 0.0070447 | 0.0278870 | 0.0524426 | 0.0272241 | 0.0508081 |
| When $k_1 \geq k_{10}$, | $k_{1m} =$ | 0.0284875 | 0.0544165 | 0.0773682 | 0.0546399 | 0.0801599 |
| When $k_1 < k_{10}$, | $k_{1m} =$ | 0.0304980 | 0.0499133 | 0.0532507 | 0.0383374 | 0.0431470 |
| When $d_1 \geq d_{10}$, | $d_{1m}$ (nm) = | 7.855 | 14.249 | 20.142 | 22.873 | $\infty$ |
| When $d_1 < d_{10}$, | $d_{1m}$ (nm) = | 0.972 | 5.625 | 12.498 | 8.268 | 18.904 |
| When $n_2 \geq n_{20}$, | $n_{2m} =$ | 0.2760107 | 0.1009705 | 0.1137622 | 0.0657813 | 0.1088953 |
| When $n_2 < n_{20}$, | $n_{2m} =$ | 0.1995349 | 0.1448511 | 0.1471863 | 0.1316589 | 0.1395239 |
| When $k_2 \geq k_{20}$, | $k_{2m} =$ | 0.1305078 | 0.1378174 | 0.1321667 | 0.1037769 | 0.1143506 |
| When $k_2 < k_{20}$, | $k_{2m} =$ | 0.1154834 | 0.0970654 | 0.0846460 | 0.0880420 | 0.0769495 |
| When $d_2 \geq d_{20}$, | $d_{2m}$ (nm) = | $\infty$ | $\infty$ | $\infty$ | $\infty$ | $\infty$ |
| When $d_2 < d_{20}$, | $d_{2m}$ (nm) = | 3.137 | 27.699 | 76.164 | 22.775 | 33.816 |

$0.93 \leq NA \leq 1.0$
$135 < T \leq 145$

| Case | | 14-11 | 14-12 |
|---|---|---|---|
| $n_{10}$ | | 1.7027802 | 1.7041709 |
| $k_{10}$ | | 0.0728517 | 0.0617202 |
| $d_{10}$ (nm) | | 217.779 | 216.194 |
| $n_{20}$ | | 1.6405373 | 1.6719897 |
| $k_{20}$ | | 0.2588103 | 0.2085423 |
| $d_{20}$ (nm) | | 146.936 | 202.593 |

| When $n_1 \geq n_{10}$, | $n_{1m} =$ | 0.0566504 | 0.0631152 |
|---|---|---|---|
| When $n_1 < n_{10}$, | $n_{1m} =$ | 0.0353162 | 0.0583606 |
| When $k_1 \geq k_{10}$, | $k_{1m} =$ | 0.0649280 | 0.0832544 |
| When $k_1 < k_{10}$, | $k_{1m} =$ | 0.0337988 | 0.0392310 |
| When $d_1 \geq d_{10}$, | $d_{1m}$ (nm) = | $\infty$ | $\infty$ |
| When $d_1 < d_{10}$, | $d_{1m}$ (nm) = | 15.495 | 79.231 |
| When $n_2 \geq n_{20}$, | $n_{2m} =$ | 0.0962402 | 0.1448450 |
| When $n_2 < n_{20}$, | $n_{2m} =$ | 0.1459131 | 0.1542615 |
| When $k_2 \geq k_{20}$, | $k_{2m} =$ | 0.1100769 | 0.1205054 |
| When $k_2 < k_{20}$, | $k_{2m} =$ | 0.0901184 | 0.0767920 |
| When $d_2 \geq d_{20}$, | $d_{2m}$ (nm) = | $\infty$ | $\infty$ |
| When $d_2 < d_{20}$, | $d_{2m}$ (nm) = | 22.790 | 28.928 |

$0.93 \leq NA \leq 1.0$

$145 < T \leq 155$

| Case | 15-01 | 15-02 | 15-03 | 15-04 | 15-05 |
|---|---|---|---|---|---|
| $n_{10}$ | 1.8199816 | 1.9318464 | 1.9476580 | 1.9400781 | 1.9152409 |
| $k_{10}$ | 0.4068444 | 0.2280177 | 0.1546474 | 0.1580344 | 0.1421080 |
| $d_{10}$ (nm) | 29.022 | 20.237 | 15.042 | 15.180 | 12.506 |
| $n_{20}$ | 1.5974175 | 1.8212470 | 1.7660961 | 1.7558824 | 1.6892699 |
| $k_{20}$ | 1.4701111 | 0.6871951 | 0.4559575 | 0.4525330 | 0.3391765 |
| $d_{20}$ (nm) | 24.558 | 79.181 | 140.877 | 141.749 | 204.998 |

| | | 15-01 | 15-02 | 15-03 | 15-04 | 15-05 |
|---|---|---|---|---|---|---|
| When $n_1 \geq n_{10}$, | $n_{1m} =$ | 0.0783313 | 0.0902905 | 0.1062402 | 0.1057410 | 0.1233240 |
| When $n_1 < n_{10}$, | $n_{1m} =$ | 0.0485986 | 0.0576099 | 0.0737439 | 0.0730676 | 0.0958533 |
| When $k_1 \geq k_{10}$, | $k_{1m} =$ | 0.0424463 | 0.0706348 | 0.0877539 | 0.0877856 | 0.1136047 |
| When $k_1 < k_{10}$, | $k_{1m} =$ | 0.0340247 | 0.0852002 | 0.1066162 | 0.1062646 | 0.1201245 |
| When $d_1 \geq d_{10}$, | $d_{1m}$ (nm) $=$ | 3.673 | 5.078 | 5.535 | 5.630 | 6.208 |
| When $d_1 < d_{10}$, | $d_{1m}$ (nm) $=$ | 2.651 | 2.819 | 3.357 | 3.413 | 4.390 |
| When $n_2 \geq n_{20}$, | $n_{2m} =$ | 0.2911646 | 0.2069556 | 0.1703650 | 0.1705981 | 0.1609875 |
| When $n_2 < n_{20}$, | $n_{2m} =$ | 0.1897607 | 0.2328674 | 0.1899780 | 0.1895239 | 0.1746619 |
| When $k_2 \geq k_{20}$, | $k_{2m} =$ | 0.2661255 | 0.2545776 | 0.1755676 | 0.1739502 | 0.1429504 |
| When $k_2 < k_{20}$, | $k_{2m} =$ | 0.2599438 | 0.1612646 | 0.1333740 | 0.1331494 | 0.1167700 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 5.427 | 21.100 | 63.576 | 64.042 | 84.536 |

$0.93 \leq NA \leq 1.0$

$145 < T \leq 155$

| Case | 15-06 | 15-07 | 15-08 | 15-09 | 15-10 |
|---|---|---|---|---|---|
| $n_{10}$ | 1.8773964 | 1.7792899 | 1.7347668 | 1.7234258 | 1.7112569 |
| $k_{10}$ | 0.2151408 | 0.1408151 | 0.1082989 | 0.0907869 | 0.0850611 |
| $d_{10}$ (nm) | 81.211 | 87.880 | 88.119 | 87.442 | 153.930 |
| $n_{20}$ | 1.7568637 | 1.7944868 | 1.6522930 | 1.6482492 | 1.6361524 |
| $k_{20}$ | 1.2210655 | 0.5090378 | 0.3260600 | 0.2516544 | 0.2898839 |
| $d_{20}$ (nm) | 20.666 | 75.457 | 142.664 | 202.556 | 141.116 |

| | | 15-06 | 15-07 | 15-08 | 15-09 | 15-10 |
|---|---|---|---|---|---|---|
| When $n_1 \geq n_{10}$, | $n_{1m} =$ | 0.0535974 | 0.0567944 | 0.0566736 | 0.0621204 | 0.0507385 |
| When $n_1 < n_{10}$, | $n_{1m} =$ | 0.0100415 | 0.0103674 | 0.0259888 | 0.0480981 | 0.0259363 |
| When $k_1 \geq k_{10}$, | $k_{1m} =$ | 0.0386597 | 0.0332520 | 0.0534692 | 0.0749170 | 0.0514124 |
| When $k_1 < k_{10}$, | $k_{1m} =$ | 0.0268323 | 0.0369287 | 0.0521716 | 0.0541968 | 0.0401160 |
| When $d_1 \geq d_{10}$, | $d_{1m}$ (nm) $=$ | 4.095 | 7.577 | 13.934 | 19.192 | 22.547 |
| When $d_1 < d_{10}$, | $d_{1m}$ (nm) $=$ | 0.855 | 1.369 | 4.946 | 11.117 | 7.637 |
| When $n_2 \geq n_{20}$, | $n_{2m} =$ | 0.4215723 | 0.2684375 | 0.1205920 | 0.1204028 | 0.0675806 |
| When $n_2 < n_{20}$, | $n_{2m} =$ | 0.3791321 | 0.1854980 | 0.1442749 | 0.1439111 | 0.1298389 |
| When $k_2 \geq k_{20}$, | $k_{2m} =$ | 0.1639099 | 0.2106580 | 0.1452100 | 0.1328479 | 0.0998340 |
| When $k_2 < k_{20}$, | $k_{2m} =$ | 0.2423328 | 0.1335254 | 0.1007751 | 0.0850952 | 0.0900806 |
| When $d_2 \geq d_{20}$, | $d_{2m}$ (nm) $=$ | 5.052 | 14.783 | ∞ | ∞ | ∞ |
| When $d_2 < d_{20}$, | $d_{2m}$ (nm) $=$ | 1.977 | 4.929 | 23.591 | 72.330 | 19.479 |

$0.93 \leq NA \leq 1.0$

$145 < T \leq 155$

| Case | 15-11 | 15-12 | 15-13 |
|---|---|---|---|
| $n_{10}$ | 1.7092054 | 1.7036310 | 1.7042855 |
| $k_{10}$ | 0.0717413 | 0.0749476 | 0.0635030 |
| $d_{10}$ (nm) | 152.725 | 217.788 | 216.233 |
| $n_{20}$ | 1.6572540 | 1.6384900 | 1.6687346 |
| $k_{20}$ | 0.2283199 | 0.2727185 | 0.2164860 |
| $d_{20}$ (nm) | 198.410 | 138.609 | 194.709 |

| | | 15-11 | 15-12 | 15-13 |
|---|---|---|---|---|
| When $n_1 \geq n_{10}$, | $n_{1m}=$ | 0.0574158 | 0.0563904 | 0.0624048 |
| When $n_1 < n_{10}$, | $n_{1m}=$ | 0.0505359 | 0.0361853 | 0.0601721 |
| When $k_1 \geq k_{10}$, | $k_{1m}=$ | 0.0766162 | 0.0604248 | 0.0800598 |
| When $k_1 < k_{10}$, | $k_{1m}=$ | 0.0439771 | 0.0350879 | 0.0400427 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 17.754 | 14.415 | 78.936 |
| When $n_2 \geq n_{20}$, | $n_{2m}=$ | 0.1103052 | 0.0951196 | 0.1487622 |
| When $n_2 < n_{20}$, | $n_{2m}=$ | 0.1349475 | 0.1401550 | 0.1481909 |
| When $k_2 \geq k_{20}$, | $k_{2m}=$ | 0.1121790 | 0.1001306 | 0.1166199 |
| When $k_2 < k_{20}$, | $k_{2m}=$ | 0.0769556 | 0.0916321 | 0.0768066 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 28.953 | 19.518 | 28.644 |

$0.93 \leq NA \leq 1.0$

$155 < T \leq 165$

| Case | | 16-01 | 16-02 | 16-03 | 16-04 | 16-05 |
|---|---|---|---|---|---|---|
| $n_{10}$ | | 1.8175791 | 1.9193642 | 1.9516445 | 1.9419697 | 1.9282358 |
| $k_{10}$ | | 0.4385823 | 0.2501320 | 0.1607715 | 0.1648951 | 0.1504554 |
| $d_{10}$ (nm) | | 37.187 | 21.908 | 15.944 | 16.094 | 12.282 |
| $n_{20}$ | | 2.9488620 | 1.8321620 | 1.7911399 | 1.7764317 | 1.6857745 |
| $k_{20}$ | | 3.6605721 | 0.7789298 | 0.4964603 | 0.4910919 | 0.3551730 |
| $d_{20}$ (nm) | | 5.671 | 69.456 | 129.934 | 131.139 | 198.143 |

| | | 16-01 | 16-02 | 16-03 | 16-04 | 16-05 |
|---|---|---|---|---|---|---|
| When $n_1 \geq n_{10}$, | $n_{1m}=$ | 0.0604736 | 0.0852295 | 0.1013757 | 0.1010083 | 0.1240356 |
| When $n_1 < n_{10}$, | $n_{1m}=$ | 0.0333899 | 0.0547046 | 0.0713342 | 0.0704993 | 0.0944006 |
| When $k_1 \geq k_{10}$, | $k_{1m}=$ | 0.0318896 | 0.0632361 | 0.0833032 | 0.0834521 | 0.1140308 |
| When $k_1 < k_{10}$, | $k_{1m}=$ | 0.0127527 | 0.0803174 | 0.1011133 | 0.1007434 | 0.1227710 |
| When $d_1 \geq d_{10}$, | $d_{1m}$ (nm) $=$ | 2.684 | 4.937 | 5.403 | 5.524 | 5.825 |
| When $d_1 < d_{10}$, | $d_{1m}$ (nm) $=$ | 1.056 | 2.746 | 3.284 | 3.349 | 4.015 |
| When $n_2 \geq n_{20}$, | $n_{2m}=$ | 0.8885571 | 0.1992395 | 0.1663013 | 0.1663708 | 0.1592810 |
| When $n_2 < n_{20}$, | $n_{2m}=$ | 0.4338977 | 0.2305408 | 0.1904468 | 0.1899951 | 0.1750964 |
| When $k_2 \geq k_{20}$, | $k_{2m}=$ | 0.2239417 | 0.2871423 | 0.1858569 | 0.1831470 | 0.1419360 |
| When $k_2 < k_{20}$, | $k_{2m}=$ | 0.5593811 | 0.1675525 | 0.1346912 | 0.1341003 | 0.1171777 |
| When $d_2 \geq d_{20}$, | $d_{2m}$ (nm) $=$ | 2.121 | $\infty$ | $\infty$ | $\infty$ | $\infty$ |
| When $d_2 < d_{20}$, | $d_{2m}$ (nm) $=$ | 1.497 | 16.789 | 53.787 | 54.606 | 81.510 |

$0. 9 3 \leq N A \leq 1. 0$

$1 5 5 < T \leq 1 6 5$

| Case | 16-06 | 16-07 | 16-08 | 16-09 | 16-10 |
|---|---|---|---|---|---|
| $n_{10}$ | 1.8704725 | 1.7960814 | 1.7418606 | 1.7257176 | 1.7136245 |
| $k_{10}$ | 0.2299368 | 0.1479091 | 0.1134159 | 0.0948039 | 0.0896483 |
| $d_{10}$ (nm) | 88.746 | 88.347 | 87.888 | 87.264 | 153.565 |
| $n_{20}$ | 2.8158519 | 1.9330235 | 1.6717189 | 1.6472351 | 1.6392609 |
| $k_{20}$ | 3.0739838 | 0.6225271 | 0.3550776 | 0.2650084 | 0.3111392 |
| $d_{20}$ (nm) | 4.992 | 60.492 | 132.384 | 194.269 | 132.434 |

| | | 16-06 | 16-07 | 16-08 | 16-09 | 16-10 |
|---|---|---|---|---|---|---|
| When $n_1 \geq n_{10}$, | $n_{1m}=$ | 0.0496790 | 0.0539771 | 0.0559290 | 0.0605103 | 0.0493213 |
| When $n_1 < n_{10}$, | $n_{1m}=$ | 0.0158618 | 0.0116589 | 0.0229565 | 0.0427002 | 0.0176343 |
| When $k_1 \geq k_{10}$, | $k_{1m}=$ | 0.0339600 | 0.0324597 | 0.0502661 | 0.0714246 | 0.0448999 |
| When $k_1 < k_{10}$, | $k_{1m}=$ | 0.0196045 | 0.0413477 | 0.0524426 | 0.0547058 | 0.0377209 |
| When $d_1 \geq d_{10}$, | $d_{1m}$ (nm) $=$ | 4.203 | 6.741 | 12.890 | 17.512 | 20.755 |
| When $d_1 < d_{10}$, | $d_{1m}$ (nm) $=$ | 1.412 | 1.425 | 4.045 | 9.285 | 4.775 |
| When $n_2 \geq n_{20}$, | $n_{2m}=$ | 0.7568213 | 0.2080432 | 0.1385022 | 0.1276587 | 0.0653149 |
| When $n_2 < n_{20}$, | $n_{2m}=$ | 0.6339124 | 0.1864246 | 0.1456726 | 0.1431897 | 0.1296729 |
| When $k_2 \geq k_{20}$, | $k_{2m}=$ | 0.5784314 | 0.2482080 | 0.1472144 | 0.1310840 | 0.0863611 |
| When $k_2 < k_{20}$, | $k_{2m}=$ | 0.6241199 | 0.1496924 | 0.1027478 | 0.0854395 | 0.0904016 |
| When $d_2 \geq d_{20}$, | $d_{2m}$ (nm) $=$ | 1.695 | 9.818 | $\infty$ | $\infty$ | $\infty$ |
| When $d_2 < d_{20}$, | $d_{2m}$ (nm) $=$ | 1.276 | 6.130 | 21.225 | 35.287 | 17.454 |

$0. 9 3 \leq N A \leq 1. 0$

$1 5 5 < T \leq 1 6 5$

| Case | 16-11 | 16-12 | 16-13 | 16-14 |
|---|---|---|---|---|
| $n_{10}$ | 1.7097149 | 1.7044725 | 1.7041849 | 1.7061658 |
| $k_{10}$ | 0.0750113 | 0.0790614 | 0.0664191 | 0.0592006 |
| $d_{10}$ (nm) | 152.537 | 217.265 | 215.910 | 215.675 |
| $n_{20}$ | 1.6527377 | 1.6350180 | 1.6625759 | 1.6951633 |
| $k_{20}$ | 0.2392317 | 0.2903973 | 0.2261823 | 0.1893046 |
| $d_{20}$ (nm) | 190.639 | 130.687 | 187.261 | 240.772 |

| | | 16-11 | 16-12 | 16-13 | 16-14 |
|---|---|---|---|---|---|
| When $n_1 \geq n_{10}$, | $n_{1m}=$ | 0.0553772 | 0.0545740 | 0.0600366 | 0.0676270 |
| When $n_1 < n_{10}$, | $n_{1m}=$ | 0.0477368 | 0.0344788 | 0.0568494 | 0.0690149 |
| When $k_1 \geq k_{10}$, | $k_{1m}=$ | 0.0715491 | 0.0525977 | 0.0752148 | 0.0835681 |
| When $k_1 < k_{10}$, | $k_{1m}=$ | 0.0443665 | 0.0337817 | 0.0404053 | 0.0425281 |
| When $d_1 \geq d_{10}$, | $d_{1m}$ (nm) $=$ | $\infty$ | $\infty$ | $\infty$ | $\infty$ |
| When $d_1 < d_{10}$, | $d_{1m}$ (nm) $=$ | 16.235 | 12.121 | 77.039 | 86.324 |
| When $n_2 \geq n_{20}$, | $n_{2m}=$ | 0.1116882 | 0.0916113 | 0.1582788 | 0.1718628 |
| When $n_2 < n_{20}$, | $n_{2m}=$ | 0.1331189 | 0.1411133 | 0.1443433 | 0.1614490 |
| When $k_2 \geq k_{20}$, | $k_{2m}=$ | 0.1061816 | 0.0827698 | 0.1097974 | 0.1248706 |
| When $k_2 < k_{20}$, | $k_{2m}=$ | 0.0766345 | 0.0918372 | 0.0766272 | 0.0699548 |
| When $d_2 \geq d_{20}$, | $d_{2m}$ (nm) $=$ | $\infty$ | $\infty$ | $\infty$ | $\infty$ |
| When $d_2 < d_{20}$, | $d_{2m}$ (nm) $=$ | 27.428 | 17.505 | 27.098 | 73.085 |

$0.93 \leq NA \leq 1.0$
$165 < T \leq 175$

| Case | 17-01 | 17-02 | 17-03 | 17-04 | 17-05 |
|---|---|---|---|---|---|
| $n_{10}$ | 1.9650460 | 1.9384951 | 1.9139584 | 1.7857662 | 1.7433983 |
| $k_{10}$ | 0.1748342 | 0.1550287 | 0.1299465 | 0.1574086 | 0.1202381 |
| $d_{10}$ (nm) | 15.368 | 12.323 | 11.343 | 86.539 | 87.036 |
| $n_{20}$ | 1.7719438 | 1.6895811 | 1.6883766 | 1.7907030 | 1.6559011 |
| $k_{20}$ | 0.5219218 | 0.3734128 | 0.3007198 | 0.6497694 | 0.3733381 |
| $d_{20}$ (nm) | 124.100 | 189.293 | 246.427 | 59.718 | 125.629 |

| | | 17-01 | 17-02 | 17-03 | 17-04 | 17-05 |
|---|---|---|---|---|---|---|
| When $n_1 \geq n_{10}$, | $n_{1m} =$ | 0.1023816 | 0.1220520 | 0.1341687 | 0.0495288 | 0.0535669 |
| When $n_1 < n_{10}$, | $n_{1m} =$ | 0.0697961 | 0.0912976 | 0.1083984 | 0.0051111 | 0.0188965 |
| When $k_1 \geq k_{10}$, | $k_{1m} =$ | 0.0830420 | 0.1112122 | 0.1288184 | 0.0186707 | 0.0452673 |
| When $k_1 < k_{10}$, | $k_{1m} =$ | 0.1016052 | 0.1222986 | 0.1299465 | 0.0330212 | 0.0491577 |
| When $d_1 \geq d_{10}$, | $d_{1m}$ (nm) $=$ | 5.001 | 5.526 | 6.413 | 5.954 | 11.233 |
| When $d_1 < d_{10}$, | $d_{1m}$ (nm) $=$ | 2.956 | 3.739 | 4.697 | 0.624 | 3.144 |
| When $n_2 \geq n_{20}$, | $n_{2m} =$ | 0.1581653 | 0.1572925 | 0.1540161 | 0.0858301 | 0.1199121 |
| When $n_2 < n_{20}$, | $n_{2m} =$ | 0.1927075 | 0.1754407 | 0.1685632 | 0.1889197 | 0.1519067 |
| When $k_2 \geq k_{20}$, | $k_{2m} =$ | 0.1753381 | 0.1419458 | 0.1368945 | 0.0730774 | 0.1241467 |
| When $k_2 < k_{20}$, | $k_{2m} =$ | 0.1306897 | 0.1171997 | 0.1067334 | 0.1258240 | 0.0983862 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 51.895 | 79.651 | 119.351 | 3.741 | 21.467 |

$0.93 \leq NA \leq 1.0$
$165 < T \leq 175$

| Case | 17-06 | 17-07 | 17-08 | 17-09 | 17-10 |
|---|---|---|---|---|---|
| $n_{10}$ | 1.7262549 | 1.7236673 | 1.7140199 | 1.7096017 | 1.7107217 |
| $k_{10}$ | 0.0993784 | 0.0842645 | 0.0949670 | 0.0783956 | 0.0680252 |
| $d_{10}$ (nm) | 86.812 | 87.109 | 152.601 | 152.026 | 152.100 |
| $n_{20}$ | 1.6373093 | 1.6685549 | 1.6238426 | 1.6437329 | 1.6799600 |
| $k_{20}$ | 0.2753256 | 0.2274459 | 0.3258368 | 0.2483227 | 0.2063397 |
| $d_{20}$ (nm) | 186.729 | 241.120 | 125.450 | 182.921 | 236.403 |

| | | 17-06 | 17-07 | 17-08 | 17-09 | 17-10 |
|---|---|---|---|---|---|---|
| When $n_1 \geq n_{10}$, | $n_{1m} =$ | 0.0583655 | 0.0638147 | 0.0459595 | 0.0526709 | 0.0601990 |
| When $n_1 < n_{10}$, | $n_{1m} =$ | 0.0389001 | 0.0503784 | 0.0111768 | 0.0448047 | 0.0600891 |
| When $k_1 \geq k_{10}$, | $k_{1m} =$ | 0.0685583 | 0.0805896 | 0.0359302 | 0.0672742 | 0.0800940 |
| When $k_1 < k_{10}$, | $k_{1m} =$ | 0.0538513 | 0.0560901 | 0.0310425 | 0.0434424 | 0.0457349 |
| When $d_1 \geq d_{10}$, | $d_{1m}$ (nm) $=$ | 15.725 | 22.939 | 17.229 | $\infty$ | $\infty$ |
| When $d_1 < d_{10}$, | $d_{1m}$ (nm) $=$ | 8.012 | 11.976 | 2.824 | 14.351 | 24.120 |
| When $n_2 \geq n_{20}$, | $n_{2m} =$ | 0.1242969 | 0.1275708 | 0.0486890 | 0.1084961 | 0.1263135 |
| When $n_2 < n_{20}$, | $n_{2m} =$ | 0.1456055 | 0.1521838 | 0.1337903 | 0.1356079 | 0.1464233 |
| When $k_2 \geq k_{20}$, | $k_{2m} =$ | 0.1234131 | 0.1338855 | 0.0591821 | 0.0969312 | 0.1151416 |
| When $k_2 < k_{20}$, | $k_{2m} =$ | 0.0846008 | 0.0776428 | 0.0858325 | 0.0756372 | 0.0703125 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 66.105 | 78.842 | 17.102 | 28.470 | 72.561 |

$0.93 \leq NA \leq 1.0$

$165 < T \leq 175$

| Case | 17-11 | 17-12 | 17-13 |
|---|---|---|---|
| $n_{10}$ | 1.7042582 | 1.7037677 | 1.7056779 |
| $k_{10}$ | 0.0836625 | 0.0692974 | 0.0609868 |
| $d_{10}$ (nm) | 216.186 | 215.313 | 215.198 |
| $n_{20}$ | 1.6202806 | 1.6544674 | 1.6903958 |
| $k_{20}$ | 0.3033538 | 0.2346728 | 0.1952987 |
| $d_{20}$ (nm) | 123.599 | 179.446 | 232.683 |

| | | 17-11 | 17-12 | 17-13 |
|---|---|---|---|---|
| When $n_1 \geq n_{10}$, | $n_{1m} =$ | 0.0501758 | 0.0567249 | 0.0651611 |
| When $n_1 < n_{10}$, | $n_{1m} =$ | 0.0271130 | 0.0522852 | 0.0658081 |
| When $k_1 \geq k_{10}$, | $k_{1m} =$ | 0.0439600 | 0.0710352 | 0.0811584 |
| When $k_1 < k_{10}$, | $k_{1m} =$ | 0.0300366 | 0.0394434 | 0.0413635 |
| When $d_1 \geq d_{10}$, | $d_{1m}$ (nm) = | ∞ | ∞ | ∞ |
| When $d_1 < d_{10}$, | $d_{1m}$ (nm) = | 9.341 | 23.552 | 82.870 |
| When $n_2 \geq n_{20}$, | $n_{2m} =$ | 0.0785254 | 0.1613647 | 0.1758447 |
| When $n_2 < n_{20}$, | $n_{2m} =$ | 0.1457166 | 0.1478357 | 0.1648547 |
| When $k_2 \geq k_{20}$, | $k_{2m} =$ | 0.0611975 | 0.1025415 | 0.1200317 |
| When $k_2 < k_{20}$, | $k_{2m} =$ | 0.0887231 | 0.0762732 | 0.0707166 |
| When $d_2 \geq d_{20}$, | $d_{2m}$ (nm) = | ∞ | ∞ | ∞ |
| When $d_2 < d_{20}$, | $d_{2m}$ (nm) = | 17.421 | 28.206 | 71.908 |

$0.93 \leq NA \leq 1.0$

$175 < T \leq 185$

| Case | 18-01 | 18-02 | 18-03 | 18-04 | 18-05 |
|---|---|---|---|---|---|
| $n_{10}$ | 1.9750220 | 1.9943589 | 1.9365478 | 1.8874503 | 1.7406539 |
| $k_{10}$ | 0.3055970 | 0.1905841 | 0.1715491 | 0.1503402 | 0.1271964 |
| $d_{10}$ (nm) | 17.312 | 13.627 | 12.200 | 12.006 | 86.109 |
| $n_{20}$ | 1.6357631 | 1.7309349 | 1.6649916 | 1.6561886 | 1.6157675 |
| $k_{20}$ | 0.8207912 | 0.5263943 | 0.3790440 | 0.2991899 | 0.3771605 |
| $d_{20}$ (nm) | 66.973 | 122.033 | 183.216 | 242.151 | 120.682 |

| | | 18-01 | 18-02 | 18-03 | 18-04 | 18-05 |
|---|---|---|---|---|---|---|
| When $n_1 \geq n_{10}$, | $n_{1m}=$ | 0.0935791 | 0.1114148 | 0.1215747 | 0.1285913 | 0.0513330 |
| When $n_1 < n_{10}$, | $n_{1m}=$ | 0.0459473 | 0.0702148 | 0.0894250 | 0.1026367 | 0.0144434 |
| When $k_1 \geq k_{10}$, | $k_{1m}=$ | 0.0590857 | 0.0871582 | 0.1112146 | 0.1261365 | 0.0386914 |
| When $k_1 < k_{10}$, | $k_{1m}=$ | 0.0823853 | 0.1098083 | 0.1208740 | 0.1243677 | 0.0453528 |
| When $d_1 \geq d_{10}$, | $d_{1m}$ (nm) $=$ | 3.436 | 4.283 | 5.306 | 6.728 | 10.132 |
| When $d_1 < d_{10}$, | $d_{1m}$ (nm) $=$ | 1.707 | 2.491 | 3.559 | 4.870 | 2.323 |
| When $n_2 \geq n_{20}$, | $n_{2m}=$ | 0.1368286 | 0.1494128 | 0.1559277 | 0.1523608 | 0.0829712 |
| When $n_2 < n_{20}$, | $n_{2m}=$ | 0.2106677 | 0.1994727 | 0.1768091 | 0.1649011 | 0.1612537 |
| When $k_2 \geq k_{20}$, | $k_{2m}=$ | 0.1566431 | 0.1521973 | 0.1368372 | 0.1332068 | 0.0933081 |
| When $k_2 < k_{20}$, | $k_{2m}=$ | 0.1361353 | 0.1253687 | 0.1152344 | 0.1052795 | 0.0942554 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 18.814 | 47.829 | 81.274 | 118.000 | 24.527 |

$0.93 \leq NA \leq 1.0$

$175 < T \leq 185$

| Case | 18-06 | 18-07 | 18-08 | 18-09 | 18-10 |
|---|---|---|---|---|---|
| $n_{10}$ | 1.7253418 | 1.7237735 | 1.7126639 | 1.7091592 | 1.7108527 |
| $k_{10}$ | 0.1032843 | 0.0864157 | 0.0996282 | 0.0809109 | 0.0696108 |
| $d_{10}$ (nm) | 86.339 | 86.885 | 151.701 | 151.551 | 151.827 |
| $n_{20}$ | 1.6224018 | 1.6650124 | 1.5953952 | 1.6344497 | 1.6784072 |
| $k_{20}$ | 0.2809650 | 0.2327133 | 0.3310599 | 0.2545275 | 0.2111338 |
| $d_{20}$ (nm) | 178.956 | 231.784 | 118.977 | 174.271 | 226.839 |

| | | 18-06 | 18-07 | 18-08 | 18-09 | 18-10 |
|---|---|---|---|---|---|---|
| When $n_1 \geq n_{10}$, | $n_{1m} =$ | 0.0565039 | 0.0626416 | 0.0424548 | 0.0505127 | 0.0583557 |
| When $n_1 < n_{10}$, | $n_{1m} =$ | 0.0377893 | 0.0495728 | 0.0068591 | 0.0425964 | 0.0570093 |
| When $k_1 \geq k_{10}$, | $k_{1m} =$ | 0.0671277 | 0.0801477 | 0.0264331 | 0.0654321 | 0.0790332 |
| When $k_1 < k_{10}$, | $k_{1m} =$ | 0.0514600 | 0.0546265 | 0.0262610 | 0.0409290 | 0.0440662 |
| When $d_1 \geq d_{10}$, | $d_{1m}$ (nm) $=$ | 14.314 | 20.851 | 14.034 | 22.266 | $\infty$ |
| When $d_1 < d_{10}$, | $d_{1m}$ (nm) $=$ | 7.519 | 11.390 | 1.678 | 12.457 | 21.354 |
| When $n_2 \geq n_{20}$, | $n_{2m} =$ | 0.1133289 | 0.1230408 | 0.0286230 | 0.1046033 | 0.1258447 |
| When $n_2 < n_{20}$, | $n_{2m} =$ | 0.1506311 | 0.1572058 | 0.1416589 | 0.1413440 | 0.1529517 |
| When $k_2 \geq k_{20}$, | $k_{2m} =$ | 0.1148096 | 0.1304126 | 0.0346130 | 0.0907129 | 0.1118689 |
| When $k_2 < k_{20}$, | $k_{2m} =$ | 0.0848999 | 0.0792493 | 0.0817810 | 0.0764514 | 0.0721448 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 64.642 | 80.544 | 18.599 | 31.028 | 73.232 |

$0.93 \leq NA \leq 1.0$

$175 < T \leq 185$

| Case | 18-11 | 18-12 | 18-13 |
|---|---|---|---|
| $n_{10}$ | 1.7032995 | 1.7035257 | 1.7058486 |
| $k_{10}$ | 0.0874338 | 0.0712651 | 0.0623526 |
| $d_{10}$ (nm) | 215.388 | 214.888 | 214.924 |
| $n_{20}$ | 1.6000078 | 1.6490638 | 1.6902455 |
| $k_{20}$ | 0.3100603 | 0.2413259 | 0.1999123 |
| $d_{20}$ (nm) | 116.088 | 170.219 | 222.958 |

| | | 18-11 | 18-12 | 18-13 |
|---|---|---|---|---|
| When $n_1 \geq n_{10}$, | $n_{1m} =$ | 0.0459119 | 0.0540906 | 0.0637158 |
| When $n_1 < n_{10}$, | $n_{1m} =$ | 0.0201135 | 0.0472498 | 0.0624988 |
| When $k_1 \geq k_{10}$, | $k_{1m} =$ | 0.0380823 | 0.0692078 | 0.0795654 |
| When $k_1 < k_{10}$, | $k_{1m} =$ | 0.0261584 | 0.0371997 | 0.0400098 |
| When $d_1 \geq d_{10}$, | $d_{1m}$ (nm) $=$ | 25.691 | $\infty$ | $\infty$ |
| When $d_1 < d_{10}$, | $d_{1m}$ (nm) $=$ | 6.401 | 18.086 | 80.109 |
| When $n_2 \geq n_{20}$, | $n_{2m} =$ | 0.0666833 | 0.1564661 | 0.1701733 |
| When $n_2 < n_{20}$, | $n_{2m} =$ | 0.1555847 | 0.1549194 | 0.1734229 |
| When $k_2 \geq k_{20}$, | $k_{2m} =$ | 0.0497668 | 0.0999182 | 0.1182764 |
| When $k_2 < k_{20}$, | $k_{2m} =$ | 0.0866650 | 0.0781360 | 0.0731396 |
| When $d_2 \geq d_{20}$, | $d_{2m}$ (nm) $=$ | 13.606 | $\infty$ | $\infty$ |
| When $d_2 < d_{20}$, | $d_{2m}$ (nm) $=$ | 18.924 | 29.474 | 72.740 |

$0.93 \leq NA \leq 1.0$

$185 < T \leq 195$

| Case | 19-01 | 19-02 | 19-03 | 19-04 | 19-05 |
|---|---|---|---|---|---|
| $n_{10}$ | 2.0157422 | 1.9298641 | 1.9158213 | 1.9035507 | 1.7387191 |
| $k_{10}$ | 0.3310994 | 0.1874025 | 0.1413868 | 0.0919796 | 0.1333266 |
| $d_{10}$ (nm) | 15.233 | 12.335 | 11.496 | 11.593 | 85.772 |
| $n_{20}$ | 1.5732193 | 1.6401635 | 1.6782430 | 1.7330388 | 1.5838112 |
| $k_{20}$ | 0.8191417 | 0.3856200 | 0.3150440 | 0.2716233 | 0.3839989 |
| $d_{20}$ (nm) | 66.313 | 174.874 | 226.685 | 274.138 | 113.170 |

| | | 19-01 | 19-02 | 19-03 | 19-04 | 19-05 |
|---|---|---|---|---|---|---|
| When $n_1 \geq n_{10}$, | $n_{1m} =$ | 0.0908862 | 0.1198010 | 0.1318933 | 0.1353418 | 0.0494861 |
| When $n_1 < n_{10}$, | $n_{1m} =$ | 0.0435144 | 0.0881482 | 0.1071143 | 0.1119397 | 0.0110315 |
| When $k_1 \geq k_{10}$, | $k_{1m} =$ | 0.0607654 | 0.1097412 | 0.1276587 | 0.1301843 | 0.0306482 |
| When $k_1 < k_{10}$, | $k_{1m} =$ | 0.0886279 | 0.1159265 | 0.1266907 | 0.0919796 | 0.0445325 |
| When $d_1 \geq d_{10}$, | $d_{1m}$ (nm) $=$ | 2.825 | 5.183 | 6.173 | 7.339 | 9.205 |
| When $d_1 < d_{10}$, | $d_{1m}$ (nm) $=$ | 1.353 | 3.517 | 4.556 | 5.508 | 1.748 |
| When $n_2 \geq n_{20}$, | $n_{2m} =$ | 0.1250940 | 0.1513354 | 0.1454334 | 0.1421106 | 0.0499280 |
| When $n_2 < n_{20}$, | $n_{2m} =$ | 0.1772742 | 0.1779919 | 0.1691821 | 0.1744556 | 0.1654175 |
| When $k_2 \geq k_{20}$, | $k_{2m} =$ | 0.1164954 | 0.1335864 | 0.1351135 | 0.1421582 | 0.0743848 |
| When $k_2 < k_{20}$, | $k_{2m} =$ | 0.1392041 | 0.1184119 | 0.1117639 | 0.1051697 | 0.0978845 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 17.571 | 78.501 | 112.763 | 138.595 | 25.987 |

$0.93 \leq NA \leq 1.0$

$185 < T \leq 195$

| Case | 19-06 | 19-07 | 19-08 | 19-09 | 19-10 |
|---|---|---|---|---|---|
| $n_{10}$ | 1.7256246 | 1.7253546 | 1.7287042 | 1.7096582 | 1.7121643 |
| $k_{10}$ | 0.1055723 | 0.0874820 | 0.0760165 | 0.0821714 | 0.0705329 |
| $d_{10}$ (nm) | 86.279 | 86.928 | 87.515 | 151.624 | 152.001 |
| $n_{20}$ | 1.6177137 | 1.6696157 | 1.7081188 | 1.6358848 | 1.6853812 |
| $k_{20}$ | 0.2895611 | 0.2389730 | 0.2041866 | 0.2635969 | 0.2167566 |
| $d_{20}$ (nm) | 168.375 | 220.361 | 272.150 | 162.984 | 215.233 |

| | | 19-06 | 19-07 | 19-08 | 19-09 | 19-10 |
|---|---|---|---|---|---|---|
| When $n_1 \geq n_{10}$, | $n_{1m} =$ | 0.0562903 | 0.0628687 | 0.0679712 | 0.0505103 | 0.0586621 |
| When $n_1 < n_{10}$, | $n_{1m} =$ | 0.0396094 | 0.0498669 | 0.0509912 | 0.0389160 | 0.0543164 |
| When $k_1 \geq k_{10}$, | $k_{1m} =$ | 0.0670349 | 0.0806128 | 0.0832776 | 0.0662488 | 0.0789514 |
| When $k_1 < k_{10}$, | $k_{1m} =$ | 0.0491772 | 0.0538904 | 0.0576746 | 0.0390271 | 0.0434973 |
| When $d_1 \geq d_{10}$, | $d_{1m}$ (nm) $=$ | 13.425 | 20.169 | 39.294 | 20.568 | $\infty$ |
| When $d_1 < d_{10}$, | $d_{1m}$ (nm) $=$ | 7.774 | 11.144 | 12.836 | 11.141 | 20.056 |
| When $n_2 \geq n_{20}$, | $n_{2m} =$ | 0.1053076 | 0.1213562 | 0.1287134 | 0.1062195 | 0.1257849 |
| When $n_2 < n_{20}$, | $n_{2m} =$ | 0.1536951 | 0.1604126 | 0.1670996 | 0.1450281 | 0.1574817 |
| When $k_2 \geq k_{20}$, | $k_{2m} =$ | 0.1136377 | 0.1320007 | 0.1531152 | 0.0931067 | 0.1145862 |
| When $k_2 < k_{20}$, | $k_{2m} =$ | 0.0898669 | 0.0840454 | 0.0776611 | 0.0825256 | 0.0770361 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 45.429 | 80.918 | 110.597 | 30.017 | 74.310 |

$0. 93 \leq NA \leq 1. 0$

$185 < T \leq 195$

| Case | 19-11 | 19-12 | 19-13 | 19-14 | 19-15 |
|---|---|---|---|---|---|
| $n_{10}$ | 1.7151566 | 1.7029318 | 1.7041956 | 1.7070069 | 1.7080920 |
| $k_{10}$ | 0.0645755 | 0.0900998 | 0.0721897 | 0.0633145 | 0.0595697 |
| $d_{10}$ (nm) | 152.412 | 215.656 | 215.114 | 215.207 | 215.250 |
| $n_{20}$ | 1.7135234 | 1.5920483 | 1.6533659 | 1.6971996 | 1.7125257 |
| $k_{20}$ | 0.1842756 | 0.3226491 | 0.2502000 | 0.2048445 | 0.1741269 |
| $d_{20}$ (nm) | 268.692 | 105.543 | 158.704 | 211.558 | 267.229 |

| | | 19-11 | 19-12 | 19-13 | 19-14 | 19-15 |
|---|---|---|---|---|---|---|
| When $n_1 \geq n_{10}$, | $n_{1m} =$ | 0.0656799 | 0.0437866 | 0.0537561 | 0.0639758 | 0.0752185 |
| When $n_1 < n_{10}$, | $n_{1m} =$ | 0.0585193 | 0.0130481 | 0.0437659 | 0.0602637 | 0.0712415 |
| When $k_1 \geq k_{10}$, | $k_{1m} =$ | 0.0803796 | 0.0379236 | 0.0696973 | 0.0785339 | 0.0793298 |
| When $k_1 < k_{10}$, | $k_{1m} =$ | 0.0475867 | 0.0209644 | 0.0354407 | 0.0397900 | 0.0383728 |
| When $d_1 \geq d_{10}$, | $d_{1m}$ (nm) $=$ | ∞ | 20.412 | ∞ | ∞ | ∞ |
| When $d_1 < d_{10}$, | $d_{1m}$ (nm) $=$ | 76.169 | 3.912 | 15.725 | 78.897 | 136.900 |
| When $n_2 \geq n_{20}$, | $n_{2m} =$ | 0.1359851 | 0.0436487 | 0.1238757 | 0.1440674 | 0.1618445 |
| When $n_2 < n_{20}$, | $n_{2m} =$ | 0.1709363 | 0.1590417 | 0.1491174 | 0.1814563 | 0.2117529 |
| When $k_2 \geq k_{20}$, | $k_{2m} =$ | 0.1377368 | 0.0580493 | 0.1037561 | 0.1202234 | 0.1371057 |
| When $k_2 < k_{20}$, | $k_{2m} =$ | 0.0711096 | 0.0823193 | 0.0849219 | 0.0779297 | 0.0717078 |
| When $d_2 \geq d_{20}$, | $d_{2m}$ (nm) $=$ | ∞ | 9.984 | ∞ | ∞ | ∞ |
| When $d_2 < d_{20}$, | $d_{2m}$ (nm) $=$ | 82.771 | 19.617 | 23.813 | 73.684 | 77.607 |

$0.93 \leq NA \leq 1.0$
$195 < T \leq 205$

| Case | 20-01 | 20-02 | 20-03 | 20-04 | 20-05 |
|---|---|---|---|---|---|
| $n_{10}$ | 1.9115074 | 1.9153788 | 1.8712999 | 1.7275221 | 1.7279210 |
| $k_{10}$ | 0.1960527 | 0.1490337 | 0.0897979 | 0.1065695 | 0.0881248 |
| $d_{10}$ (nm) | 13.258 | 11.515 | 14.536 | 86.590 | 87.122 |
| $n_{20}$ | 1.6255021 | 1.6682692 | 1.7614462 | 1.6227655 | 1.6778177 |
| $k_{20}$ | 0.3984556 | 0.3197853 | 0.2821612 | 0.3041284 | 0.2471127 |
| $d_{20}$ (nm) | 164.068 | 218.507 | 257.799 | 156.467 | 209.069 |

| | | 20-01 | 20-02 | 20-03 | 20-04 | 20-05 |
|---|---|---|---|---|---|---|
| When $n_1 \geq n_{10}$, | $n_{1m} =$ | 0.1142444 | 0.1325989 | 0.1158582 | 0.0562817 | 0.0637024 |
| When $n_1 < n_{10}$, | $n_{1m} =$ | 0.0852515 | 0.1080505 | 0.0942114 | 0.0426550 | 0.0501379 |
| When $k_1 \geq k_{10}$, | $k_{1m} =$ | 0.1044482 | 0.1295020 | 0.1096521 | 0.0681348 | 0.0804810 |
| When $k_1 < k_{10}$, | $k_{1m} =$ | 0.1084790 | 0.1269031 | 0.0897979 | 0.0488770 | 0.0543994 |
| When $d_1 \geq d_{10}$, | $d_{1m}$ (nm) $=$ | 5.346 | 6.134 | 8.659 | 13.270 | 20.006 |
| When $d_1 < d_{10}$, | $d_{1m}$ (nm) $=$ | 3.730 | 4.524 | 6.443 | 8.305 | 10.905 |
| When $n_2 \geq n_{20}$, | $n_{2m} =$ | 0.1424097 | 0.1416443 | 0.1412390 | 0.1051294 | 0.1236353 |
| When $n_2 < n_{20}$, | $n_{2m} =$ | 0.1779224 | 0.1667200 | 0.1823743 | 0.1526196 | 0.1593042 |
| When $k_2 \geq k_{20}$, | $k_{2m} =$ | 0.1351575 | 0.1341370 | 0.1542419 | 0.1188623 | 0.1364233 |
| When $k_2 < k_{20}$, | $k_{2m} =$ | 0.1244714 | 0.1144324 | 0.1102271 | 0.0976929 | 0.0887854 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 70.107 | 105.511 | 128.903 | 31.502 | 77.053 |

$0.93 \leq NA \leq 1.0$
$195 < T \leq 205$

| Case | 20–06 | 20–07 | 20–08 | 20–09 | 20–10 |
|---|---|---|---|---|---|
| $n_{10}$ | 1.7316602 | 1.7109076 | 1.7140510 | 1.7169074 | 1.7034522 |
| $k_{10}$ | 0.0769958 | 0.0825870 | 0.0712311 | 0.0659464 | 0.0912009 |
| $d_{10}$ (nm) | 87.563 | 152.078 | 152.368 | 152.739 | 216.873 |
| $n_{20}$ | 1.7153560 | 1.6429824 | 1.6947912 | 1.7201685 | 1.5969711 |
| $k_{20}$ | 0.2092703 | 0.2767726 | 0.2239389 | 0.1888883 | 0.3506487 |
| $d_{20}$ (nm) | 261.518 | 151.325 | 204.003 | 258.117 | 92.838 |

| | | 20–06 | 20–07 | 20–08 | 20–09 | 20–10 |
|---|---|---|---|---|---|---|
| When $n_1 \geq n_{10}$, | $n_{1m} =$ | 0.0685693 | 0.0512622 | 0.0601404 | 0.0671716 | 0.0436548 |
| When $n_1 < n_{10}$, | $n_{1m} =$ | 0.0495715 | 0.0375720 | 0.0532251 | 0.0484131 | 0.0089709 |
| When $k_1 \geq k_{10}$, | $k_{1m} =$ | 0.0827515 | 0.0683850 | 0.0790723 | 0.0783716 | 0.0369128 |
| When $k_1 < k_{10}$, | $k_{1m} =$ | 0.0588892 | 0.0391077 | 0.0446033 | 0.0456335 | 0.0165588 |
| When $d_1 \geq d_{10}$, | $d_{1m}$ (nm) $=$ | 35.460 | 20.848 | ∞ | ∞ | 19.781 |
| When $d_1 < d_{10}$, | $d_{1m}$ (nm) $=$ | 11.967 | 10.711 | 16.311 | 17.445 | 2.680 |
| When $n_2 \geq n_{20}$, | $n_{2m} =$ | 0.1321082 | 0.1010400 | 0.1225134 | 0.1362366 | 0.0345703 |
| When $n_2 < n_{20}$, | $n_{2m} =$ | 0.1646814 | 0.1448950 | 0.1569727 | 0.1688831 | 0.1562476 |
| When $k_2 \geq k_{20}$, | $k_{2m} =$ | 0.1585754 | 0.0998694 | 0.1194824 | 0.1443347 | 0.0797021 |
| When $k_2 < k_{20}$, | $k_{2m} =$ | 0.0798230 | 0.0905042 | 0.0814771 | 0.0735376 | 0.0638440 |
| When $d_2 \geq d_{20}$, | $d_{2m}$ (nm) $=$ | ∞ | ∞ | ∞ | ∞ | 10.032 |
| When $d_2 < d_{20}$, | $d_{2m}$ (nm) $=$ | 87.011 | 25.146 | 71.899 | 78.182 | 16.775 |

$0.93 \leq NA \leq 1.0$
$195 < T \leq 205$

| Case | 20–11 | 20–12 | 20–13 |
|---|---|---|---|
| $n_{10}$ | 1.7053294 | 1.7084550 | 1.7088490 |
| $k_{10}$ | 0.0723641 | 0.0642090 | 0.0611230 |
| $d_{10}$ (nm) | 215.802 | 215.782 | 215.750 |
| $n_{20}$ | 1.6624125 | 1.7063284 | 1.7155496 |
| $k_{20}$ | 0.2625944 | 0.2112603 | 0.1784523 |
| $d_{20}$ (nm) | 147.133 | 200.541 | 257.296 |

| | | 20–11 | 20–12 | 20–13 |
|---|---|---|---|---|
| When $n_1 \geq n_{10}$, | $n_{1m} =$ | 0.0548254 | 0.0651489 | 0.0765845 |
| When $n_1 < n_{10}$, | $n_{1m} =$ | 0.0418201 | 0.0593726 | 0.0732715 |
| When $k_1 \geq k_{10}$, | $k_{1m} =$ | 0.0710583 | 0.0775024 | 0.0765796 |
| When $k_1 < k_{10}$, | $k_{1m} =$ | 0.0355750 | 0.0411511 | 0.0355579 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 15.640 | 79.525 | 76.637 |
| When $n_2 \geq n_{20}$, | $n_{2m} =$ | 0.1192065 | 0.1417981 | 0.1626379 |
| When $n_2 < n_{20}$, | $n_{2m} =$ | 0.1432642 | 0.1798657 | 0.2073511 |
| When $k_2 \geq k_{20}$, | $k_{2m} =$ | 0.1091699 | 0.1229614 | 0.1404065 |
| When $k_2 < k_{20}$, | $k_{2m} =$ | 0.0923608 | 0.0791760 | 0.0746033 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 19.545 | 71.258 | 73.210 |

9. An exposure method used in a process for manufacturing a semiconductor device, the method comprising the steps of:

providing an antireflective film having a two-layer structure between a resist layer and a silicon oxide layer formed on a surface of a silicon semiconductor substrate and having a thickness T (unit: nm) described below; and exposing the resist layer in an exposure system having a wavelength of 190 nm to 195 nm and a numerical aperture NA of $1.0 < NA \leq 1.1$, the antireflective film including an upper layer having a complex refractive index $N_1$, and a lower layer having a complex refractive index $N_2$, the complex refractive indexes $N_1$ and $N_2$ being represented by the equations $N_1 = n_1 - k_1 i$ and $N_2 = n_2 - k_2 i$, respectively;

wherein assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1, k_1, d_1, n_2, k_2,$ and $d_2$ satisfy the relational expression

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1;$$

a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$; and in the tables below, in the line of "When $n_1 \geq n_{10}$, $n_{1m} =$", each value in the right columns is "$n_{1m} - n_{10}$"; in the line of "When $n_1 < n_{10}$, $n_{1m} =$", each value in the right columns is "$n_{10} - n_{1m}$"; in the line of "When $k_1 \geq k_{10}$, $k_{1m} =$", each value in the right columns is "$k_{1m} - k_{10}$"; in the line of "When $k_1 < k_{10}$, $k_{1m} =$", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m} =$", each value in the right columns is "$n_{2m} - n_{20}$"; in the line of "When $n_2 < n_{20}$, $n_{2m} =$", each value in the right columns is "$n_{20} - n_{2m}$"; in the line of "When $k_2 \geq k_{20}$, $k_{2m} =$", each value in the right columns is "$k_{2m} - k_{20}$"; in the line of "When $k_2 < k_{20}$, $k_{2m} =$", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

## 1. 0 < N A ≤ 1. 1
### 2 ≤ T ≤ 1 5

| Case | 1-01 | 1-02 | 1-03 | 1-04 | 1-05 |
|---|---|---|---|---|---|
| $n_{10}$ | 2.1002530 | 1.9014716 | 1.8817545 | 1.8713707 | 1.8894555 |
| $k_{10}$ | 0.0458360 | 0.1897321 | 0.1528631 | 0.1131033 | 0.1025295 |
| $d_{10}$ (nm) | 25.245 | 35.107 | 29.787 | 20.680 | 13.808 |
| $n_{20}$ | 3.6613926 | 3.6832791 | 2.2496615 | 1.8471360 | 1.7319643 |
| $k_{20}$ | 2.0917723 | 0.6232721 | 0.5909670 | 0.3799287 | 0.2879285 |
| $d_{20}$ (nm) | 4.980 | 30.030 | 58.673 | 139.609 | 214.126 |

| | | 1-01 | 1-02 | 1-03 | 1-04 | 1-05 |
|---|---|---|---|---|---|---|
| When $n_1 \geq n_{10}$, | $n_{1m} =$ | 0.0805884 | 0.0768188 | 0.0754700 | 0.0824719 | 0.1060120 |
| When $n_1 < n_{10}$, | $n_{1m} =$ | 0.0800293 | 0.0653833 | 0.0584985 | 0.0566113 | 0.0706006 |
| When $k_1 \geq k_{10}$, | $k_{1m} =$ | 0.0719092 | 0.0582312 | 0.0563574 | 0.0660449 | 0.0898218 |
| When $k_1 < k_{10}$, | $k_{1m} =$ | 0.0458360 | 0.0865906 | 0.0835730 | 0.0866101 | 0.1025295 |
| When $d_1 \geq d_{10}$, | $d_{1m}$ (nm) $=$ | 3.502 | 5.628 | 6.909 | 7.972 | 7.080 |
| When $d_1 < d_{10}$, | $d_{1m}$ (nm) $=$ | 2.843 | 4.121 | 4.441 | 4.574 | 4.198 |
| When $n_2 \geq n_{20}$, | $n_{2m} =$ | 0.2511194 | 0.1375208 | 0.1500757 | 0.1234998 | 0.1256079 |
| When $n_2 < n_{20}$, | $n_{2m} =$ | 0.2478674 | 0.1642285 | 0.1673572 | 0.1560254 | 0.1556494 |
| When $k_2 \geq k_{20}$, | $k_{2m} =$ | 0.2675171 | 0.1813342 | 0.1899841 | 0.1681030 | 0.1175488 |
| When $k_2 < k_{20}$, | $k_{2m} =$ | 0.2241895 | 0.1363525 | 0.1337048 | 0.1033130 | 0.0926782 |
| When $d_2 \geq d_{20}$, | $d_{2m}$ (nm) $=$ | 0.668 | 1.453 | 8.618 | ∞ | ∞ |
| When $d_2 < d_{20}$, | $d_{2m}$ (nm) $=$ | 0.632 | 1.466 | 7.778 | 59.745 | 82.499 |

## 1. 0 < N A ≤ 1. 1
### 2 ≤ T ≤ 1 5

| Case | 1-06 | 1-07 | 1-08 | 1-09 | 1-10 |
|---|---|---|---|---|---|
| $n_{10}$ | 1.8919474 | 1.8730447 | 1.7734811 | 1.7581396 | 1.7209511 |
| $k_{10}$ | 0.0886250 | 0.0995044 | 0.0942049 | 0.0894114 | 0.0778149 |
| $d_{10}$ (nm) | 14.825 | 12.107 | 96.210 | 94.485 | 94.005 |
| $n_{20}$ | 1.7713589 | 1.6971361 | 2.0242448 | 1.8216770 | 1.6746822 |
| $k_{20}$ | 0.2959415 | 0.2384266 | 0.4293783 | 0.2841737 | 0.2144041 |
| $d_{20}$ (nm) | 207.437 | 276.341 | 66.416 | 135.446 | 211.729 |

| | | 1-06 | 1-07 | 1-08 | 1-09 | 1-10 |
|---|---|---|---|---|---|---|
| When $n_1 \geq n_{10}$, | $n_{1m} =$ | 0.1001855 | 0.1196069 | 0.0579333 | 0.0504431 | 0.0487988 |
| When $n_1 < n_{10}$, | $n_{1m} =$ | 0.0678418 | 0.0862451 | 0.0202832 | 0.0122217 | 0.0195996 |
| When $k_1 \geq k_{10}$, | $k_{1m} =$ | 0.0828455 | 0.1086084 | 0.0429993 | 0.0327991 | 0.0449207 |
| When $k_1 < k_{10}$, | $k_{1m} =$ | 0.0886250 | 0.0995044 | 0.0440173 | 0.0383289 | 0.0441089 |
| When $d_1 \geq d_{10}$, | $d_{1m}$ (nm) $=$ | 7.253 | 7.622 | 12.574 | 14.854 | 20.756 |
| When $d_1 < d_{10}$, | $d_{1m}$ (nm) $=$ | 4.294 | 5.017 | 3.736 | 2.430 | 5.594 |
| When $n_2 \geq n_{20}$, | $n_{2m} =$ | 0.1250818 | 0.1274023 | 0.1038489 | 0.1178979 | 0.0654700 |
| When $n_2 < n_{20}$, | $n_{2m} =$ | 0.1542432 | 0.1390320 | 0.1236121 | 0.1075012 | 0.0984851 |
| When $k_2 \geq k_{20}$, | $k_{2m} =$ | 0.1281506 | 0.1059973 | 0.1023560 | 0.1052271 | 0.0726978 |
| When $k_2 < k_{20}$, | $k_{2m} =$ | 0.0937659 | 0.0853320 | 0.1026587 | 0.0735156 | 0.0618335 |
| When $d_2 \geq d_{20}$, | $d_{2m}$ (nm) $=$ | ∞ | ∞ | 5.946 | 13.526 | ∞ |
| When $d_2 < d_{20}$, | $d_{2m}$ (nm) $=$ | 79.532 | 130.356 | 6.729 | 7.895 | 26.663 |

1. 0 < N A ≤ 1 . 1
2 ≤ T ≤ 1 5

| Case | 1-11 | 1-12 | 1-13 | 1-14 | 1-15 |
|---|---|---|---|---|---|
| $n_{10}$ | 1.7166765 | 1.7166130 | 1.7322234 | 1.7049421 | 1.7064564 |
| $k_{10}$ | 0.0677623 | 0.0755230 | 0.0835200 | 0.0655754 | 0.0573750 |
| $d_{10}$ (nm) | 92.667 | 182.689 | 166.765 | 163.194 | 160.636 |
| $n_{20}$ | 1.6766991 | 6.5634515 | 1.9262925 | 1.6664527 | 1.6879767 |
| $k_{20}$ | 0.1797231 | 3.2079655 | 0.3700807 | 0.1954874 | 0.1655431 |
| $d_{20}$ (nm) | 270.198 | 1.017 | 69.546 | 208.736 | 264.028 |

| | | 1-11 | 1-12 | 1-13 | 1-14 | 1-15 |
|---|---|---|---|---|---|---|
| When $n_1 \geq n_{10}$, | $n_{1m} =$ | 0.0538269 | 0.0791455 | 0.0502930 | 0.0463574 | 0.0530786 |
| When $n_1 < n_{10}$, | $n_{1m} =$ | 0.0365198 | 0.0150903 | 0.0019495 | 0.0298389 | 0.0507080 |
| When $k_1 \geq k_{10}$, | $k_{1m} =$ | 0.0633020 | 0.0382202 | 0.0176428 | 0.0426367 | 0.0606909 |
| When $k_1 < k_{10}$, | $k_{1m} =$ | 0.0490027 | 0.0352063 | 0.0101367 | 0.0363086 | 0.0412036 |
| When $d_1 \geq d_{10}$, | $d_{1m}$ (nm) = | ∞ | 44.970 | 29.513 | ∞ | ∞ |
| When $d_1 < d_{10}$, | $d_{1m}$ (nm) = | 11.921 | 5.503 | 0.534 | 14.465 | 82.763 |
| When $n_2 \geq n_{20}$, | $n_{2m} =$ | 0.0746594 | 0.3760779 | 0.0943127 | 0.0451807 | 0.0846008 |
| When $n_2 < n_{20}$, | $n_{2m} =$ | 0.1088159 | 0.6761377 | 0.0252344 | 0.0894604 | 0.1080103 |
| When $k_2 \geq k_{20}$, | $k_{2m} =$ | 0.0728833 | 0.4281982 | 0.0109839 | 0.0413684 | 0.0543652 |
| When $k_2 < k_{20}$, | $k_{2m} =$ | 0.0561267 | 0.6156824 | 0.0921399 | 0.0546765 | 0.0510388 |
| When $d_2 \geq d_{20}$, | $d_{2m}$ (nm) = | ∞ | 0.095 | 5.760 | ∞ | ∞ |
| When $d_2 < d_{20}$, | $d_{2m}$ (nm) = | 76.266 | 0.159 | 0.905 | 22.049 | 32.675 |

1. 0 < N A ≤ 1 . 1
2 ≤ T ≤ 1 5

| Case | 1-16 | 1-17 | 1-18 | 1-19 | 1-20 |
|---|---|---|---|---|---|
| $n_{10}$ | 1.6929499 | 1.6905856 | 1.6919500 | 1.6995270 | 1.6946661 |
| $k_{10}$ | 0.0758677 | 0.0724871 | 0.0673580 | 0.0541447 | 0.0598692 |
| $d_{10}$ (nm) | 218.538 | 210.998 | 207.119 | 221.890 | 292.769 |
| $n_{20}$ | 1.7888879 | 1.7113381 | 1.6973679 | 1.6914313 | 5.7902895 |
| $k_{20}$ | 0.3373861 | 0.2424201 | 0.1951159 | 0.1602785 | 2.6464640 |
| $d_{20}$ (nm) | 83.914 | 155.877 | 222.394 | 261.841 | 1.370 |

| | | 1-16 | 1-17 | 1-18 | 1-19 | 1-20 |
|---|---|---|---|---|---|---|
| When $n_1 \geq n_{10}$, | $n_{1m} =$ | 0.0154590 | 0.0284326 | 0.0459937 | 0.0695007 | 0.0688428 |
| When $n_1 < n_{10}$, | $n_{1m} =$ | 0.0644519 | 0.0618115 | 0.0647253 | 0.0614612 | 0.0576074 |
| When $k_1 \geq k_{10}$, | $k_{1m} =$ | 0.0296802 | 0.0451062 | 0.0571143 | 0.0607031 | 0.0650110 |
| When $k_1 < k_{10}$, | $k_{1m} =$ | 0.0222290 | 0.0323779 | 0.0391223 | 0.0380823 | 0.0345483 |
| When $d_1 \geq d_{10}$, | $d_{1m}$ (nm) = | 8.212 | ∞ | ∞ | ∞ | ∞ |
| When $d_1 < d_{10}$, | $d_{1m}$ (nm) = | 25.706 | 29.733 | 39.073 | 91.262 | 43.839 |
| When $n_2 \geq n_{20}$, | $n_{2m} =$ | 0.1222742 | 0.1267554 | 0.1643848 | 0.2245898 | 0.7013342 |
| When $n_2 < n_{20}$, | $n_{2m} =$ | 0.0248633 | 0.0660693 | 0.1720679 | 0.1025806 | 0.7193848 |
| When $k_2 \geq k_{20}$, | $k_{2m} =$ | 0.0580225 | 0.0965234 | 0.1267737 | 0.1053369 | 0.5239075 |
| When $k_2 < k_{20}$, | $k_{2m} =$ | 0.0934216 | 0.0846191 | 0.0756384 | 0.0566919 | 0.6531299 |
| When $d_2 \geq d_{20}$, | $d_{2m}$ (nm) = | 16.998 | ∞ | ∞ | ∞ | 0.304 |
| When $d_2 < d_{20}$, | $d_{2m}$ (nm) = | 2.716 | 12.405 | 72.248 | 75.278 | 0.354 |

1. $0 < NA \leq 1.1$
$2 \leq T \leq 15$

| Case | 1-21 | 1-22 | 1-23 | 1-24 |
|------|------|------|------|------|
| $n_{10}$ | 1.6927273 | 1.6938682 | 1.6959215 | 1.6965163 |
| $k_{10}$ | 0.0641185 | 0.0632641 | 0.0601626 | 0.0560943 |
| $d_{10}$ (nm) | 275.960 | 269.814 | 266.236 | 263.874 |
| $n_{20}$ | 1.7993913 | 1.7248410 | 1.7076727 | 1.6984359 |
| $k_{20}$ | 0.3510467 | 0.2487428 | 0.2009217 | 0.1709410 |
| $d_{20}$ (nm) | 81.101 | 150.052 | 214.823 | 277.894 |

| | | 1-21 | 1-22 | 1-23 | 1-24 |
|---|---|------|------|------|------|
| When $n_1 \geq n_{10}$, | $n_{1m} =$ | 0.0462292 | 0.0536658 | 0.0656104 | 0.0800903 |
| When $n_1 < n_{10}$, | $n_{1m} =$ | 0.0484851 | 0.0418225 | 0.0432129 | 0.0552332 |
| When $k_1 \geq k_{10}$, | $k_{1m} =$ | 0.0620630 | 0.0619458 | 0.0615613 | 0.0629382 |
| When $k_1 < k_{10}$, | $k_{1m} =$ | 0.0362708 | 0.0377515 | 0.0406262 | 0.0422571 |
| When $d_1 \geq d_{10}$, | $d_{1m}$ (nm) $=$ | $\infty$ | $\infty$ | $\infty$ | $\infty$ |
| When $d_1 < d_{10}$, | $d_{1m}$ (nm) $=$ | 29.467 | 27.448 | 97.485 | 175.134 |
| When $n_2 \geq n_{20}$, | $n_{2m} =$ | 0.1596558 | 0.1810303 | 0.3970593 | 0.3365332 |
| When $n_2 < n_{20}$, | $n_{2m} =$ | 0.1100391 | 0.2908167 | 0.2424414 | 0.2178503 |
| When $k_2 \geq k_{20}$, | $k_{2m} =$ | 0.1557141 | 0.1886804 | 0.2145630 | 0.2194727 |
| When $k_2 < k_{20}$, | $k_{2m} =$ | 0.1210901 | 0.1012720 | 0.0897449 | 0.0805957 |
| When $d_2 \geq d_{20}$, | $d_{2m}$ (nm) $=$ | 25.591 | $\infty$ | $\infty$ | $\infty$ |
| When $d_2 < d_{20}$, | $d_{2m}$ (nm) $=$ | 9.432 | 27.332 | 78.495 | 131.894 |

1. $0 < NA \leq 1.1$
$15 < T \leq 25$

| Case | 2-01 | 2-02 | 2-03 | 2-04 | 2-05 |
|------|------|------|------|------|------|
| $n_{10}$ | 1.8588603 | 1.8671897 | 1.8793061 | 1.8953035 | 1.8743725 |
| $k_{10}$ | 0.2152026 | 0.2000001 | 0.1213485 | 0.0980077 | 0.1084578 |
| $d_{10}$ (nm) | 37.726 | 35.681 | 21.414 | 14.908 | 12.201 |
| $n_{20}$ | 5.0977045 | 3.0932325 | 1.8727645 | 1.7635602 | 1.6884757 |
| $k_{20}$ | 0.6974562 | 0.7063642 | 0.4149520 | 0.3109442 | 0.2470663 |
| $d_{20}$ (nm) | 19.647 | 34.687 | 129.308 | 200.446 | 269.437 |

| | | 2-01 | 2-02 | 2-03 | 2-04 | 2-05 |
|---|---|------|------|------|------|------|
| When $n_1 \geq n_{10}$, | $n_{1m} =$ | 0.0758728 | 0.0747766 | 0.0798340 | 0.0988049 | 0.1178149 |
| When $n_1 < n_{10}$, | $n_{1m} =$ | 0.0592542 | 0.0589661 | 0.0549634 | 0.0658325 | 0.0841418 |
| When $k_1 \geq k_{10}$, | $k_{1m} =$ | 0.0598401 | 0.0578650 | 0.0632202 | 0.0814417 | 0.1076917 |
| When $k_1 < k_{10}$, | $k_{1m} =$ | 0.0788342 | 0.0811694 | 0.0865027 | 0.0980077 | 0.1084578 |
| When $d_1 \geq d_{10}$, | $d_{1m}$ (nm) $=$ | 5.593 | 5.891 | 7.449 | 6.933 | 7.359 |
| When $d_1 < d_{10}$, | $d_{1m}$ (nm) $=$ | 4.233 | 4.238 | 4.249 | 4.053 | 4.794 |
| When $n_2 \geq n_{20}$, | $n_{2m} =$ | 0.1534875 | 0.1581152 | 0.1275403 | 0.1254932 | 0.1262524 |
| When $n_2 < n_{20}$, | $n_{2m} =$ | 0.1697559 | 0.1894849 | 0.1565967 | 0.1540796 | 0.1389709 |
| When $k_2 \geq k_{20}$, | $k_{2m} =$ | 0.1955396 | 0.2168408 | 0.1812842 | 0.1267053 | 0.1044556 |
| When $k_2 < k_{20}$, | $k_{2m} =$ | 0.1505579 | 0.1602844 | 0.1066724 | 0.0950110 | 0.0860864 |
| When $d_2 \geq d_{20}$, | $d_{2m}$ (nm) $=$ | 0.659 | 2.512 | $\infty$ | $\infty$ | $\infty$ |
| When $d_2 < d_{20}$, | $d_{2m}$ (nm) $=$ | 0.674 | 2.526 | 26.047 | 76.118 | 126.536 |

1．０＜ＮＡ≦１．１
１５＜Ｔ≦２５

| Case | 2-06 | 2-07 | 2-08 | 2-09 | 2-10 |
|---|---|---|---|---|---|
| $n_{10}$ | 1.7693190 | 1.8089249 | 1.7628339 | 1.7223442 | 1.7176215 |
| $k_{10}$ | 0.1013402 | 0.1064114 | 0.0939832 | 0.0810686 | 0.0701007 |
| $d_{10}$ (nm) | 103.520 | 98.052 | 94.416 | 93.840 | 92.613 |
| $n_{20}$ | 3.2583829 | 3.5132584 | 1.8414170 | 1.6728089 | 1.6759231 |
| $k_{20}$ | 2.5781374 | 0.5501157 | 0.3092618 | 0.2260423 | 0.1876577 |
| $d_{20}$ (nm) | 3.121 | 29.615 | 125.923 | 203.086 | 261.422 |

| | | 2-06 | 2-07 | 2-08 | 2-09 | 2-10 |
|---|---|---|---|---|---|---|
| When $n_1 \geq n_{10}$, | $n_{1m} =$ | 0.0673926 | 0.0573926 | 0.0482458 | 0.0469287 | 0.0525317 |
| When $n_1 < n_{10}$, | $n_{1m} =$ | 0.0182031 | 0.0185083 | 0.0097595 | 0.0170142 | 0.0338733 |
| When $k_1 \geq k_{10}$, | $k_{1m} =$ | 0.0401636 | 0.0390552 | 0.0281750 | 0.0413513 | 0.0608655 |
| When $k_1 < k_{10}$, | $k_{1m} =$ | 0.0427917 | 0.0434326 | 0.0360242 | 0.0422778 | 0.0485864 |
| When $d_1 \geq d_{10}$, | $d_{1m}$ (nm) $=$ | 13.610 | 8.991 | 12.525 | 18.295 | 32.066 |
| When $d_1 < d_{10}$, | $d_{1m}$ (nm) $=$ | 3.396 | 2.738 | 1.840 | 4.621 | 10.547 |
| When $n_2 \geq n_{20}$, | $n_{2m} =$ | 0.2210974 | 0.0961951 | 0.1120178 | 0.0558118 | 0.0724255 |
| When $n_2 < n_{20}$, | $n_{2m} =$ | 0.3992041 | 0.1262915 | 0.1064856 | 0.0968689 | 0.1070728 |
| When $k_2 \geq k_{20}$, | $k_{2m} =$ | 0.3438342 | 0.0862598 | 0.0939502 | 0.0666077 | 0.0700989 |
| When $k_2 < k_{20}$, | $k_{2m} =$ | 0.3502100 | 0.1067542 | 0.0758923 | 0.0625208 | 0.0568274 |
| When $d_2 \geq d_{20}$, | $d_{2m}$ (nm) $=$ | 0.375 | 0.986 | 11.083 | ∞ | ∞ |
| When $d_2 < d_{20}$, | $d_{2m}$ (nm) $=$ | 0.497 | 1.167 | 5.972 | 24.056 | 73.630 |

1．０＜ＮＡ≦１．１
１５＜Ｔ≦２５

| Case | 2-11 | 2-12 | 2-13 | 2-14 | 2-15 |
|---|---|---|---|---|---|
| $n_{10}$ | 1.7053748 | 1.7067869 | 1.7234396 | 1.7309823 | 1.6924662 |
| $k_{10}$ | 0.0681661 | 0.0592936 | 0.0819972 | 0.0887627 | 0.0804140 |
| $d_{10}$ (nm) | 163.030 | 160.569 | 177.819 | 175.110 | 219.254 |
| $n_{20}$ | 1.6640911 | 1.6873274 | 5.0800961 | 9.5526510 | 1.8031504 |
| $k_{20}$ | 0.2056957 | 0.1726858 | 4.2173316 | 0.4602806 | 0.3794202 |
| $d_{20}$ (nm) | 200.113 | 255.377 | 1.054 | 10.232 | 74.951 |

| | | 2-11 | 2-12 | 2-13 | 2-14 | 2-15 |
|---|---|---|---|---|---|---|
| When $n_1 \geq n_{10}$, | $n_{1m} =$ | 0.0438354 | 0.0515637 | 0.0646301 | 0.0589197 | 0.0054749 |
| When $n_1 < n_{10}$, | $n_{1m} =$ | 0.0254907 | 0.0493457 | 0.0095056 | 0.0049573 | 0.0624841 |
| When $k_1 \geq k_{10}$, | $k_{1m} =$ | 0.0375134 | 0.0575159 | 0.0321326 | 0.0226172 | 0.0163196 |
| When $k_1 < k_{10}$, | $k_{1m} =$ | 0.0331799 | 0.0410168 | 0.0264954 | 0.0199707 | 0.0128040 |
| When $d_1 \geq d_{10}$, | $d_{1m}$ (nm) $=$ | ∞ | ∞ | 31.849 | 25.868 | 2.747 |
| When $d_1 < d_{10}$, | $d_{1m}$ (nm) $=$ | 12.067 | 30.487 | 3.026 | 1.416 | 23.308 |
| When $n_2 \geq n_{20}$, | $n_{2m} =$ | 0.0383606 | 0.0825500 | 0.3294275 | 0.0929846 | 0.1306152 |
| When $n_2 < n_{20}$, | $n_{2m} =$ | 0.0871460 | 0.1052795 | 0.6618042 | 0.0695691 | 0.0087109 |
| When $k_2 \geq k_{20}$, | $k_{2m} =$ | 0.0339417 | 0.0505530 | 0.2910742 | 0.0198328 | 0.0299487 |
| When $k_2 < k_{20}$, | $k_{2m} =$ | 0.0549512 | 0.0515552 | 0.6908167 | 0.0870068 | 0.0872510 |
| When $d_2 \geq d_{20}$, | $d_{2m}$ (nm) $=$ | ∞ | ∞ | 0.079 | 0.102 | 14.451 |
| When $d_2 < d_{20}$, | $d_{2m}$ (nm) $=$ | 19.637 | 29.589 | 0.186 | 0.076 | 0.824 |

1. 0 < N A ≤ 1. 1
1 5 < T ≤ 2 5

| Case | 2-16 | 2-17 | 2-18 | 2-19 | 2-20 |
|---|---|---|---|---|---|
| $n_{10}$ | 1.6899914 | 1.6915311 | 1.6993450 | 1.6920076 | 1.6934597 |
| $k_{10}$ | 0.0755734 | 0.0696615 | 0.0558443 | 0.0677866 | 0.0658489 |
| $d_{10}$ (nm) | 211.286 | 207.258 | 221.722 | 276.645 | 270.093 |
| $n_{20}$ | 1.7113670 | 1.6964473 | 1.6905618 | 1.8143335 | 1.7261499 |
| $k_{20}$ | 0.2592681 | 0.2049428 | 0.1670525 | 0.3967808 | 0.2668883 |
| $d_{20}$ (nm) | 147.090 | 213.635 | 253.347 | 72.378 | 141.360 |

| | | 2-16 | 2-17 | 2-18 | 2-19 | 2-20 |
|---|---|---|---|---|---|---|
| When $n_1 \geq n_{10}$, | $n_{1m} =$ | 0.0235022 | 0.0424463 | 0.0685596 | 0.0429663 | 0.0523279 |
| When $n_1 < n_{10}$, | $n_{1m} =$ | 0.0594971 | 0.0645703 | 0.0572424 | 0.0479932 | 0.0410938 |
| When $k_1 \geq k_{10}$, | $k_{1m} =$ | 0.0403162 | 0.0547461 | 0.0583691 | 0.0593103 | 0.0600049 |
| When $k_1 < k_{10}$, | $k_{1m} =$ | 0.0289734 | 0.0380127 | 0.0376013 | 0.0355176 | 0.0379749 |
| When $d_1 \geq d_{10}$, | $d_{1m}$ (nm) $=$ | 18.036 | ∞ | ∞ | ∞ | ∞ |
| When $d_1 < d_{10}$, | $d_{1m}$ (nm) $=$ | 26.582 | 37.673 | 84.779 | 28.006 | 25.642 |
| When $n_2 \geq n_{20}$, | $n_{2m} =$ | 0.1259094 | 0.1555469 | 0.2302234 | 0.1717712 | 0.1831995 |
| When $n_2 < n_{20}$, | $n_{2m} =$ | 0.0501526 | 0.1747144 | 0.0944592 | 0.1059167 | 0.2850769 |
| When $k_2 \geq k_{20}$, | $k_{2m} =$ | 0.0866736 | 0.1221960 | 0.1032471 | 0.1537634 | 0.1870032 |
| When $k_2 < k_{20}$, | $k_{2m} =$ | 0.0848877 | 0.0779785 | 0.0578296 | 0.1330688 | 0.1069617 |
| When $d_2 \geq d_{20}$, | $d_{2m}$ (nm) $=$ | ∞ | ∞ | ∞ | 19.935 | ∞ |
| When $d_2 < d_{20}$, | $d_{2m}$ (nm) $=$ | 9.771 | 69.780 | 73.090 | 7.607 | 20.837 |

1. 0 < N A ≤ 1. 1
1 5 < T ≤ 2 5

| Case | 2-21 | 2-22 |
|---|---|---|
| $n_{10}$ | 1.6956703 | 1.6963391 |
| $k_{10}$ | 0.0621151 | 0.0576411 |
| $d_{10}$ (nm) | 266.327 | 263.935 |
| $n_{20}$ | 1.7069279 | 1.6975975 |
| $k_{20}$ | 0.2113995 | 0.1780179 |
| $d_{20}$ (nm) | 206.262 | 269.259 |

| | | 2-21 | 2-22 |
|---|---|---|---|
| When $n_1 \geq n_{10}$, | $n_{1m} =$ | 0.0646936 | 0.0790869 |
| When $n_1 < n_{10}$, | $n_{1m} =$ | 0.0423181 | 0.0536755 |
| When $k_1 \geq k_{10}$, | $k_{1m} =$ | 0.0600012 | 0.0616785 |
| When $k_1 < k_{10}$, | $k_{1m} =$ | 0.0403015 | 0.0417126 |
| When $d_1 \geq d_{10}$, | $d_{1m}$ (nm) $=$ | ∞ | ∞ |
| When $d_1 < d_{10}$, | $d_{1m}$ (nm) $=$ | 96.199 | 173.391 |
| When $n_2 \geq n_{20}$, | $n_{2m} =$ | 0.4184778 | 0.3488293 |
| When $n_2 < n_{20}$, | $n_{2m} =$ | 0.2491736 | 0.2216455 |
| When $k_2 \geq k_{20}$, | $k_{2m} =$ | 0.2142920 | 0.2197681 |
| When $k_2 < k_{20}$, | $k_{2m} =$ | 0.0934741 | 0.0831250 |
| When $d_2 \geq d_{20}$, | $d_{2m}$ (nm) $=$ | ∞ | ∞ |
| When $d_2 < d_{20}$, | $d_{2m}$ (nm) $=$ | 76.168 | 129.228 |

1. 0 <N A ≤ 1. 1
2 5 < T ≤ 3 5

| Case | 3-01 | 3-02 | 3-03 | 3-04 | 3-05 |
|---|---|---|---|---|---|
| $n_{10}$ | 1.8231304 | 1.8934062 | 1.9014262 | 1.8787814 | 1.8198973 |
| $k_{10}$ | 0.2426967 | 0.1289044 | 0.1029443 | 0.1135143 | 0.1197953 |
| $d_{10}$ (nm) | 38.982 | 22.067 | 15.306 | 12.334 | 96.975 |
| $n_{20}$ | 4.7825941 | 1.9169501 | 1.7714781 | 1.6867670 | 4.7572984 |
| $k_{20}$ | 0.7852430 | 0.4577317 | 0.3309508 | 0.2583639 | 0.6218490 |
| $d_{20}$ (nm) | 19.992 | 118.684 | 191.572 | 261.269 | 20.274 |

| | | 3-01 | 3-02 | 3-03 | 3-04 | 3-05 |
|---|---|---|---|---|---|---|
| When $n_1 \geq n_{10}$, | $n_{1m}=$ | 0.0699695 | 0.0767236 | 0.0951282 | 0.1154443 | 0.0479663 |
| When $n_1 < n_{10}$, | $n_{1m}=$ | 0.0498486 | 0.0532642 | 0.0626563 | 0.0817676 | 0.0146021 |
| When $k_1 \geq k_{10}$, | $k_{1m}=$ | 0.0588489 | 0.0605774 | 0.0772998 | 0.1052600 | 0.0370215 |
| When $k_1 < k_{10}$, | $k_{1m}=$ | 0.0707385 | 0.0857886 | 0.1011462 | 0.1135143 | 0.0364331 |
| When $d_1 \geq d_{10}$, | $d_{1m}$ (nm) $=$ | 5.137 | 6.730 | 6.574 | 7.047 | 7.725 |
| When $d_1 < d_{10}$, | $d_{1m}$ (nm) $=$ | 3.775 | 3.826 | 3.782 | 4.562 | 2.005 |
| When $n_2 \geq n_{20}$, | $n_{2m}=$ | 0.1872302 | 0.1343799 | 0.1259058 | 0.1236719 | 0.1156909 |
| When $n_2 < n_{20}$, | $n_{2m}=$ | 0.2029309 | 0.1567590 | 0.1523523 | 0.1408569 | 0.1282800 |
| When $k_2 \geq k_{20}$, | $k_{2m}=$ | 0.2449841 | 0.2003137 | 0.1294177 | 0.1036865 | 0.0748242 |
| When $k_2 < k_{20}$, | $k_{2m}=$ | 0.1832959 | 0.1099609 | 0.0962476 | 0.0870068 | 0.1199268 |
| When $d_2 \geq d_{20}$, | $d_{2m}$ (nm) $=$ | 0.864 | ∞ | ∞ | ∞ | 0.532 |
| When $d_2 < d_{20}$, | $d_{2m}$ (nm) $=$ | 0.839 | 21.916 | 71.881 | 121.487 | 0.552 |

1. 0 <N A ≤ 1. 1
2 5 < T ≤ 3 5

| Case | 3-06 | 3-07 | 3-08 | 3-09 | 3-10 |
|---|---|---|---|---|---|
| $n_{10}$ | 1.7669399 | 1.7235821 | 1.7188964 | 1.7058208 | 1.7073313 |
| $k_{10}$ | 0.0997580 | 0.0847397 | 0.0726255 | 0.0710513 | 0.0613671 |
| $d_{10}$ (nm) | 94.208 | 93.618 | 92.505 | 162.764 | 160.462 |
| $n_{20}$ | 1.8558060 | 1.6692590 | 1.6760484 | 1.6616172 | 1.6880654 |
| $k_{20}$ | 0.3364471 | 0.2394056 | 0.1967286 | 0.2176394 | 0.1807904 |
| $d_{20}$ (nm) | 117.969 | 195.006 | 252.779 | 191.801 | 246.769 |

| | | 3-06 | 3-07 | 3-08 | 3-09 | 3-10 |
|---|---|---|---|---|---|---|
| When $n_1 \geq n_{10}$, | $n_{1m}=$ | 0.0449036 | 0.0442456 | 0.0506409 | 0.0405530 | 0.0497949 |
| When $n_1 < n_{10}$, | $n_{1m}=$ | 0.0058435 | 0.0142969 | 0.0314514 | 0.0176917 | 0.0472620 |
| When $k_1 \geq k_{10}$, | $k_{1m}=$ | 0.0200403 | 0.0369336 | 0.0583228 | 0.0316150 | 0.0541370 |
| When $k_1 < k_{10}$, | $k_{1m}=$ | 0.0309863 | 0.0404504 | 0.0477759 | 0.0303076 | 0.0405200 |
| When $d_1 \geq d_{10}$, | $d_{1m}$ (nm) $=$ | 10.713 | 16.167 | 24.298 | ∞ | ∞ |
| When $d_1 < d_{10}$, | $d_{1m}$ (nm) $=$ | 1.043 | 3.709 | 9.337 | 7.078 | 23.845 |
| When $n_2 \geq n_{20}$, | $n_{2m}=$ | 0.1063135 | 0.0450122 | 0.0699963 | 0.0309314 | 0.0781641 |
| When $n_2 < n_{20}$, | $n_{2m}=$ | 0.1037158 | 0.0932996 | 0.1043005 | 0.0818408 | 0.1014221 |
| When $k_2 \geq k_{20}$, | $k_{2m}=$ | 0.0686243 | 0.0581018 | 0.0668628 | 0.0258777 | 0.0465137 |
| When $k_2 < k_{20}$, | $k_{2m}=$ | 0.0768091 | 0.0625977 | 0.0574854 | 0.0546838 | 0.0521045 |
| When $d_2 \geq d_{20}$, | $d_{2m}$ (nm) $=$ | 9.637 | ∞ | ∞ | 13.452 | ∞ |
| When $d_2 < d_{20}$, | $d_{2m}$ (nm) $=$ | 3.465 | 21.705 | 32.653 | 17.168 | 25.940 |

1. 0 < N A ≤ 1. 1
2 5 < T ≤ 3 5

| Case | 3-11 | 3-12 | 3-13 | 3-14 | 3-15 |
|---|---|---|---|---|---|
| $n_{10}$ | 1.6893950 | 1.6912149 | 1.6993872 | 1.6931110 | 1.6955537 |
| $k_{10}$ | 0.0792587 | 0.0722082 | 0.0576769 | 0.0689939 | 0.0643335 |
| $d_{10}$ (nm) | 211.356 | 207.241 | 221.603 | 270.168 | 266.333 |
| $n_{20}$ | 1.7121469 | 1.6964479 | 1.6911809 | 1.7281714 | 1.7074500 |
| $k_{20}$ | 0.2795726 | 0.2163033 | 0.1749036 | 0.2885226 | 0.2235939 |
| $d_{20}$ (nm) | 139.203 | 205.754 | 244.825 | 133.446 | 198.195 |

| | | 3-11 | 3-12 | 3-13 | 3-14 | 3-15 |
|---|---|---|---|---|---|---|
| When $n_1 \geq n_{10}$, | $n_{1m}=$ | 0.0187524 | 0.0389221 | 0.0673108 | 0.0502356 | 0.0624109 |
| When $n_1 < n_{10}$, | $n_{1m}=$ | 0.0561719 | 0.0620898 | 0.0525073 | 0.0397852 | 0.0411060 |
| When $k_1 \geq k_{10}$, | $k_{1m}=$ | 0.0323267 | 0.0510889 | 0.0557678 | 0.0576538 | 0.0581616 |
| When $k_1 < k_{10}$, | $k_{1m}=$ | 0.0242261 | 0.0363989 | 0.0368542 | 0.0366370 | 0.0397400 |
| When $d_1 \geq d_{10}$, | $d_{1m}$ (nm) $=$ | 9.539 | ∞ | ∞ | ∞ | ∞ |
| When $d_1 < d_{10}$, | $d_{1m}$ (nm) $=$ | 23.792 | 36.062 | 80.743 | 23.618 | 94.755 |
| When $n_2 \geq n_{20}$, | $n_{2m}=$ | 0.1258521 | 0.1531580 | 0.2394678 | 0.1860962 | 0.4430444 |
| When $n_2 < n_{20}$, | $n_{2m}=$ | 0.0334863 | 0.1783936 | 0.0871167 | 0.1489648 | 0.2583777 |
| When $k_2 \geq k_{20}$, | $k_{2m}=$ | 0.0734656 | 0.1167761 | 0.1010718 | 0.1855286 | 0.2138647 |
| When $k_2 < k_{20}$, | $k_{2m}=$ | 0.0783704 | 0.0804089 | 0.0594067 | 0.1140149 | 0.0979895 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 6.823 | 66.025 | 33.786 | 17.363 | 72.201 |

1. 0 < N A ≤ 1. 1
2 5 < T ≤ 3 5

| Case | 3-16 |
|---|---|
| $n_{10}$ | 1.6962507 |
| $k_{10}$ | 0.0593120 |
| $d_{10}$ (nm) | 263.960 |
| $n_{20}$ | 1.6977843 |
| $k_{20}$ | 0.1860709 |
| $d_{20}$ (nm) | 261.024 |

| | | 3-16 |
|---|---|---|
| When $n_1 \geq n_{10}$, | $n_{1m}=$ | 0.0782690 |
| When $n_1 < n_{10}$, | $n_{1m}=$ | 0.0522693 |
| When $k_1 \geq k_{10}$, | $k_{1m}=$ | 0.0602515 |
| When $k_1 < k_{10}$, | $k_{1m}=$ | 0.0408899 |
| When $d_1 \geq d_{10}$, | $d_{1m}$ (nm) $=$ | ∞ |
| When $d_1 < d_{10}$, | $d_{1m}$ (nm) $=$ | 119.700 |
| When $n_2 \geq n_{20}$, | $n_{2m}=$ | 0.3636609 |
| When $n_2 < n_{20}$, | $n_{2m}=$ | 0.2256018 |
| When $k_2 \geq k_{20}$, | $k_{2m}=$ | 0.2198901 |
| When $k_2 < k_{20}$, | $k_{2m}=$ | 0.0864600 |
| When $d_2 \geq d_{20}$, | $d_{2m}$ (nm) $=$ | ∞ |
| When $d_2 < d_{20}$, | $d_{2m}$ (nm) $=$ | 97.445 |

1. $0 < NA \leq 1.1$

$35 < T \leq 45$

| Case | 4-01 | 4-02 | 4-03 | 4-04 | 4-05 |
|---|---|---|---|---|---|
| $n_{10}$ | 1.8741027 | 1.9162345 | 1.9099224 | 1.8839284 | 1.7973698 |
| $k_{10}$ | 0.2292405 | 0.1358555 | 0.1141224 | 0.1193744 | 0.1226911 |
| $d_{10}$ (nm) | 31.502 | 21.455 | 14.789 | 12.268 | 93.176 |
| $n_{20}$ | 2.4589695 | 1.9418040 | 1.7536831 | 1.6821215 | 2.1323779 |
| $k_{20}$ | 0.9273915 | 0.4998799 | 0.3442834 | 0.2672652 | 0.6525391 |
| $d_{20}$ (nm) | 39.688 | 110.373 | 186.067 | 253.238 | 46.828 |

| | | 4-01 | 4-02 | 4-03 | 4-04 | 4-05 |
|---|---|---|---|---|---|---|
| When $n_1 \geq n_{10}$, | $n_{1m} =$ | 0.0646472 | 0.0749023 | 0.0953894 | 0.1145032 | 0.0393335 |
| When $n_1 < n_{10}$, | $n_{1m} =$ | 0.0466125 | 0.0512402 | 0.0611060 | 0.0810242 | 0.0058411 |
| When $k_1 \geq k_{10}$, | $k_{1m} =$ | 0.0535095 | 0.0588599 | 0.0769971 | 0.1049219 | 0.0222083 |
| When $k_1 < k_{10}$, | $k_{1m} =$ | 0.0782300 | 0.0839917 | 0.1022253 | 0.1138464 | 0.0267273 |
| When $d_1 \geq d_{10}$, | $d_{1m}$ (nm) $=$ | 4.763 | 5.873 | 6.052 | 6.690 | 7.237 |
| When $d_1 < d_{10}$, | $d_{1m}$ (nm) $=$ | 3.092 | 3.244 | 3.414 | 4.349 | 0.847 |
| When $n_2 \geq n_{20}$, | $n_{2m} =$ | 0.2061353 | 0.1383777 | 0.1254065 | 0.1201538 | 0.0908765 |
| When $n_2 < n_{20}$, | $n_{2m} =$ | 0.1985669 | 0.1593604 | 0.1521448 | 0.1405737 | 0.1202173 |
| When $k_2 \geq k_{20}$, | $k_{2m} =$ | 0.2506677 | 0.2047961 | 0.1231897 | 0.1019714 | 0.0402307 |
| When $k_2 < k_{20}$, | $k_{2m} =$ | 0.1792896 | 0.1103943 | 0.0960205 | 0.0872583 | 0.1042542 |
| When $d_2 \geq d_{20}$, | $d_{2m}$ (nm) $=$ | 6.142 | ∞ | ∞ | ∞ | 4.028 |
| When $d_2 < d_{20}$, | $d_{2m}$ (nm) $=$ | 4.657 | 20.982 | 70.019 | 92.164 | 2.915 |

1. $0 < NA \leq 1.1$

$35 < T \leq 45$

| Case | 4-06 | 4-07 | 4-08 | 4-09 | 4-10 |
|---|---|---|---|---|---|
| $n_{10}$ | 1.7231751 | 1.7198225 | 1.7057007 | 1.7079030 | 1.6886446 |
| $k_{10}$ | 0.0881939 | 0.0748307 | 0.0735111 | 0.0631371 | 0.0826816 |
| $d_{10}$ (nm) | 93.194 | 92.273 | 162.218 | 160.241 | 210.810 |
| $n_{20}$ | 1.6583398 | 1.6753837 | 1.6560667 | 1.6895692 | 1.7077667 |
| $k_{20}$ | 0.2493789 | 0.2040438 | 0.2270715 | 0.1875698 | 0.2975930 |
| $d_{20}$ (nm) | 187.627 | 244.025 | 183.673 | 237.741 | 132.542 |

| | | 4-06 | 4-07 | 4-08 | 4-09 | 4-10 |
|---|---|---|---|---|---|---|
| When $n_1 \geq n_{10}$, | $n_{1m} =$ | 0.0413782 | 0.0488660 | 0.0374475 | 0.0482141 | 0.0106323 |
| When $n_1 < n_{10}$, | $n_{1m} =$ | 0.0123999 | 0.0300476 | 0.0153528 | 0.0446057 | 0.0519153 |
| When $k_1 \geq k_{10}$, | $k_{1m} =$ | 0.0333630 | 0.0568799 | 0.0277051 | 0.0515784 | 0.0235608 |
| When $k_1 < k_{10}$, | $k_{1m} =$ | 0.0393298 | 0.0467004 | 0.0300195 | 0.0397412 | 0.0190234 |
| When $d_1 \geq d_{10}$, | $d_{1m}$ (nm) $=$ | 13.894 | 20.818 | 24.657 | ∞ | 6.948 |
| When $d_1 < d_{10}$, | $d_{1m}$ (nm) $=$ | 3.123 | 8.547 | 5.758 | 21.149 | 21.403 |
| When $n_2 \geq n_{20}$, | $n_{2m} =$ | 0.0360730 | 0.0689490 | 0.0276392 | 0.0753564 | 0.1220337 |
| When $n_2 < n_{20}$, | $n_{2m} =$ | 0.0901636 | 0.1032593 | 0.0781885 | 0.0941541 | 0.0190320 |
| When $k_2 \geq k_{20}$, | $k_{2m} =$ | 0.0474146 | 0.0634253 | 0.0205627 | 0.0433423 | 0.0612073 |
| When $k_2 < k_{20}$, | $k_{2m} =$ | 0.0610718 | 0.0577832 | 0.0533984 | 0.0526196 | 0.0606079 |
| When $d_2 \geq d_{20}$, | $d_{2m}$ (nm) $=$ | ∞ | ∞ | 8.473 | ∞ | ∞ |
| When $d_2 < d_{20}$, | $d_{2m}$ (nm) $=$ | 20.321 | 31.703 | 15.881 | 21.519 | 3.543 |

1. $0 < NA \leq 1.1$

$35 < T \leq 45$

| Case | 4-11 | 4-12 | 4-13 | 4-14 |
|---|---|---|---|---|
| $n_{10}$ | 1.6995870 | 1.6927517 | 1.6954892 | 1.6961809 |
| $k_{10}$ | 0.0592337 | 0.0720967 | 0.0662812 | 0.0606151 |
| $d_{10}$ (nm) | 221.497 | 269.568 | 265.955 | 263.663 |
| $n_{20}$ | 1.6927290 | 1.7225076 | 1.7055518 | 1.6966094 |
| $k_{20}$ | 0.1818275 | 0.3075740 | 0.2340649 | 0.1927366 |
| $d_{20}$ (nm) | 235.781 | 126.653 | 190.864 | 253.572 |

| | | 4-11 | 4-12 | 4-13 | 4-14 |
|---|---|---|---|---|---|
| When $n_1 \geq n_{10}$, | $n_{1m} =$ | 0.0661182 | 0.0430298 | 0.0571948 | 0.0777271 |
| When $n_1 < n_{10}$, | $n_{1m} =$ | 0.0480371 | 0.0376990 | 0.0396948 | 0.0514954 |
| When $k_1 \geq k_{10}$, | $k_{1m} =$ | 0.0532056 | 0.0552930 | 0.0563965 | 0.0590613 |
| When $k_1 < k_{10}$, | $k_{1m} =$ | 0.0358557 | 0.0353455 | 0.0387683 | 0.0400696 |
| When $d_1 \geq d_{10}$, | $d_{1m}$ (nm) $=$ | ∞ | ∞ | ∞ | ∞ |
| When $d_1 < d_{10}$, | $d_{1m}$ (nm) $=$ | 78.174 | 21.398 | 89.629 | 112.221 |
| When $n_2 \geq n_{20}$, | $n_{2m} =$ | 0.2507446 | 0.1898645 | 0.4617859 | 0.3498169 |
| When $n_2 < n_{20}$, | $n_{2m} =$ | 0.0793469 | 0.1193628 | 0.2673291 | 0.2271130 |
| When $k_2 \geq k_{20}$, | $k_{2m} =$ | 0.0998633 | 0.1866309 | 0.2129163 | 0.2195020 |
| When $k_2 < k_{20}$, | $k_{2m} =$ | 0.0613184 | 0.1217163 | 0.1026648 | 0.0902368 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 33.021 | 15.026 | 69.134 | 84.327 |

1. $0 < NA \leq 1.1$

$45 < T \leq 55$

| Case | 5-01 | 5-02 | 5-03 | 5-04 | 5-05 |
|---|---|---|---|---|---|
| $n_{10}$ | 1.8808544 | 1.9316654 | 1.9082705 | 1.8785232 | 1.7211644 |
| $k_{10}$ | 0.2454152 | 0.1473610 | 0.1322705 | 0.1271526 | 0.0906139 |
| $d_{10}$ (nm) | 24.855 | 18.765 | 14.189 | 12.435 | 92.694 |
| $n_{20}$ | 1.8495394 | 1.8569906 | 1.7144055 | 1.6714546 | 1.6423304 |
| $k_{20}$ | 0.8565648 | 0.5034890 | 0.3458924 | 0.2699971 | 0.2528050 |
| $d_{20}$ (nm) | 51.788 | 110.667 | 182.182 | 245.412 | 180.257 |

| | | 5-01 | 5-02 | 5-03 | 5-04 | 5-05 |
|---|---|---|---|---|---|---|
| When $n_1 \geq n_{10}$, | $n_{1m} =$ | 0.0633093 | 0.0784436 | 0.0967798 | 0.1127563 | 0.0394434 |
| When $n_1 < n_{10}$, | $n_{1m} =$ | 0.0379272 | 0.0483252 | 0.0593640 | 0.0800098 | 0.0123450 |
| When $k_1 \geq k_{10}$, | $k_{1m} =$ | 0.0520349 | 0.0606396 | 0.0782654 | 0.1046387 | 0.0323718 |
| When $k_1 < k_{10}$, | $k_{1m} =$ | 0.0704724 | 0.0844775 | 0.1016626 | 0.1111450 | 0.0404236 |
| When $d_1 \geq d_{10}$, | $d_{1m}$ (nm) $=$ | 4.463 | 5.359 | 5.721 | 6.653 | 12.460 |
| When $d_1 < d_{10}$, | $d_{1m}$ (nm) $=$ | 2.319 | 2.677 | 3.157 | 4.357 | 3.091 |
| When $n_2 \geq n_{20}$, | $n_{2m} =$ | 0.1530676 | 0.1305420 | 0.1246069 | 0.1153186 | 0.0322009 |
| When $n_2 < n_{20}$, | $n_{2m} =$ | 0.1897241 | 0.1692273 | 0.1526025 | 0.1380359 | 0.0893225 |
| When $k_2 \geq k_{20}$, | $k_{2m} =$ | 0.1919946 | 0.1591870 | 0.1122729 | 0.0997217 | 0.0401709 |
| When $k_2 < k_{20}$, | $k_{2m} =$ | 0.1170728 | 0.1032434 | 0.0948108 | 0.0869653 | 0.0592017 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 9.182 | 23.164 | 70.833 | 93.569 | 20.376 |

1. $0 < NA \leq 1.1$

$45 < T \leq 55$

| Case | 5-06 | 5-07 | 5-08 | 5-09 | 5-10 |
|---|---|---|---|---|---|
| $n_{10}$ | 1.7204079 | 1.7050622 | 1.7085349 | 1.6878153 | 1.6980473 |
| $k_{10}$ | 0.0761160 | 0.0748972 | 0.0642166 | 0.0847734 | 0.0703784 |
| $d_{10}$ (nm) | 92.018 | 161.630 | 160.005 | 209.683 | 224.445 |
| $n_{20}$ | 1.6751968 | 1.6489715 | 1.6919631 | 1.6959203 | 1.6616204 |
| $k_{20}$ | 0.2080809 | 0.2315625 | 0.1914882 | 0.3070669 | 0.2238826 |
| $d_{20}$ (nm) | 234.537 | 175.108 | 227.913 | 127.092 | 171.370 |

| | | 5-06 | 5-07 | 5-08 | 5-09 | 5-10 |
|---|---|---|---|---|---|---|
| When $n_1 \geq n_{10}$, | $n_{1m} =$ | 0.0481116 | 0.0356750 | 0.0469714 | 0.0053320 | 0.0535730 |
| When $n_1 < n_{10}$, | $n_{1m} =$ | 0.0302478 | 0.0193359 | 0.0419556 | 0.0458972 | 0.0248047 |
| When $k_1 \geq k_{10}$, | $k_{1m} =$ | 0.0572302 | 0.0287097 | 0.0507117 | 0.0169995 | 0.0427319 |
| When $k_1 < k_{10}$, | $k_{1m} =$ | 0.0456555 | 0.0334753 | 0.0389539 | 0.0159290 | 0.0235608 |
| When $d_1 \geq d_{10}$, | $d_{1m}$ (nm) $=$ | 19.317 | 21.414 | $\infty$ | 2.347 | $\infty$ |
| When $d_1 < d_{10}$, | $d_{1m}$ (nm) $=$ | 8.336 | 7.128 | 19.272 | 19.688 | 12.738 |
| When $n_2 \geq n_{20}$, | $n_{2m} =$ | 0.0703723 | 0.0326379 | 0.0750854 | 0.1108911 | 0.0566052 |
| When $n_2 < n_{20}$, | $n_{2m} =$ | 0.1049292 | 0.0778333 | 0.0787329 | 0.0108118 | 0.0780139 |
| When $k_2 \geq k_{20}$, | $k_{2m} =$ | 0.0616284 | 0.0216638 | 0.0424329 | 0.0606311 | 0.0720593 |
| When $k_2 < k_{20}$, | $k_{2m} =$ | 0.0584753 | 0.0525964 | 0.0537231 | 0.0383350 | 0.0623987 |
| When $d_2 \geq d_{20}$, | $d_{2m}$ (nm) $=$ | $\infty$ | 8.070 | $\infty$ | 32.807 | $\infty$ |
| When $d_2 < d_{20}$, | $d_{2m}$ (nm) $=$ | 32.758 | 15.758 | 17.351 | 1.915 | 21.521 |

1. $0 < NA \leq 1.1$

$45 < T \leq 55$

| Case | 5-11 | 5-12 | 5-13 | 5-14 |
|---|---|---|---|---|
| $n_{10}$ | 1.6999707 | 1.6924126 | 1.6955002 | 1.6961000 |
| $k_{10}$ | 0.0601951 | 0.0742318 | 0.0674212 | 0.0611797 |
| $d_{10}$ (nm) | 221.512 | 268.357 | 265.225 | 263.146 |
| $n_{20}$ | 1.6952970 | 1.7068352 | 1.7004174 | 1.6940899 |
| $k_{20}$ | 0.1862586 | 0.3173492 | 0.2397614 | 0.1962440 |
| $d_{20}$ (nm) | 225.852 | 120.697 | 183.997 | 246.462 |

| | | 5-11 | 5-12 | 5-13 | 5-14 |
|---|---|---|---|---|---|
| When $n_1 \geq n_{10}$, | $n_{1m} =$ | 0.0654663 | 0.0386316 | 0.0536462 | 0.0776611 |
| When $n_1 < n_{10}$, | $n_{1m} =$ | 0.0445935 | 0.0350720 | 0.0381848 | 0.0515515 |
| When $k_1 \geq k_{10}$, | $k_{1m} =$ | 0.0509546 | 0.0537524 | 0.0551721 | 0.0583948 |
| When $k_1 < k_{10}$, | $k_{1m} =$ | 0.0349414 | 0.0344934 | 0.0383105 | 0.0394385 |
| When $d_1 \geq d_{10}$, | $d_{1m}$ (nm) $=$ | $\infty$ | $\infty$ | $\infty$ | $\infty$ |
| When $d_1 < d_{10}$, | $d_{1m}$ (nm) $=$ | 76.496 | 19.128 | 37.283 | 109.648 |
| When $n_2 \geq n_{20}$, | $n_{2m} =$ | 0.1168579 | 0.1905981 | 0.3934021 | 0.3400916 |
| When $n_2 < n_{20}$, | $n_{2m} =$ | 0.0700696 | 0.1027393 | 0.2743970 | 0.2283606 |
| When $k_2 \geq k_{20}$, | $k_{2m} =$ | 0.1002319 | 0.1933838 | 0.2120459 | 0.2188281 |
| When $k_2 < k_{20}$, | $k_{2m} =$ | 0.0624707 | 0.1168652 | 0.1050110 | 0.0926550 |
| When $d_2 \geq d_{20}$, | $d_{2m}$ (nm) $=$ | $\infty$ | $\infty$ | $\infty$ | $\infty$ |
| When $d_2 < d_{20}$, | $d_{2m}$ (nm) $=$ | 28.597 | 13.909 | 67.541 | 81.764 |

1. 0 < N A ≦ 1. 1
5 5 < T ≦ 6 5

| Case | 6-01 | 6-02 | 6-03 | 6-04 | 6-05 |
|---|---|---|---|---|---|
| $n_{10}$ | 1.8609133 | 1.9462238 | 1.9002376 | 1.8750233 | 1.8816918 |
| $k_{10}$ | 0.2699154 | 0.1588548 | 0.1498745 | 0.1302055 | 0.0811209 |
| $d_{10}$ (nm) | 23.275 | 16.938 | 13.880 | 12.592 | 12.084 |
| $n_{20}$ | 1.6780954 | 1.8061043 | 1.6764313 | 1.6672162 | 1.7277101 |
| $k_{20}$ | 0.8091000 | 0.4989592 | 0.3420875 | 0.2718902 | 0.2394028 |
| $d_{20}$ (nm) | 51.309 | 107.791 | 176.900 | 235.718 | 282.393 |

| | | 6-01 | 6-02 | 6-03 | 6-04 | 6-05 |
|---|---|---|---|---|---|---|
| When $n_1 \geq n_{10}$, | $n_{1m} =$ | 0.0700366 | 0.0847327 | 0.0979871 | 0.1121912 | 0.1205115 |
| When $n_1 < n_{10}$, | $n_{1m} =$ | 0.0352271 | 0.0459912 | 0.0579346 | 0.0799817 | 0.0890784 |
| When $k_1 \geq k_{10}$, | $k_{1m} =$ | 0.0520923 | 0.0625745 | 0.0794043 | 0.1043726 | 0.1106958 |
| When $k_1 < k_{10}$, | $k_{1m} =$ | 0.0664282 | 0.0874719 | 0.0997217 | 0.1093811 | 0.0811209 |
| When $d_1 \geq d_{10}$, | $d_{1m}$ (nm) $=$ | 4.496 | 4.952 | 5.583 | 6.704 | 7.616 |
| When $d_1 < d_{10}$, | $d_{1m}$ (nm) $=$ | 2.084 | 2.260 | 3.039 | 4.426 | 5.147 |
| When $n_2 \geq n_{20}$, | $n_{2m} =$ | 0.1454468 | 0.1290356 | 0.1219507 | 0.1104688 | 0.1083423 |
| When $n_2 < n_{20}$, | $n_{2m} =$ | 0.1338672 | 0.1849402 | 0.1524817 | 0.1364417 | 0.1532007 |
| When $k_2 \geq k_{20}$, | $k_{2m} =$ | 0.1326758 | 0.1316541 | 0.1033948 | 0.0988464 | 0.1079004 |
| When $k_2 < k_{20}$, | $k_{2m} =$ | 0.1106470 | 0.1010791 | 0.0949341 | 0.0882678 | 0.0854614 |
| When $d_2 \geq d_{20}$, | $d_{2m}$ (nm) $=$ | 18.182 | ∞ | ∞ | ∞ | ∞ |
| When $d_2 < d_{20}$, | $d_{2m}$ (nm) $=$ | 8.638 | 17.532 | 68.073 | 94.482 | 130.723 |

1. 0 < N A ≦ 1. 1
5 5 < T ≦ 6 5

| Case | 6-06 | 6-07 | 6-08 | 6-09 | 6-10 |
|---|---|---|---|---|---|
| $n_{10}$ | 1.7196449 | 1.7211216 | 1.7282121 | 1.7047574 | 1.7094298 |
| $k_{10}$ | 0.0916508 | 0.0765241 | 0.0683348 | 0.0753118 | 0.0647325 |
| $d_{10}$ (nm) | 92.440 | 91.942 | 92.298 | 161.355 | 159.970 |
| $n_{20}$ | 1.6323282 | 1.6777604 | 1.7222619 | 1.6462273 | 1.6962571 |
| $k_{20}$ | 0.2539653 | 0.2105462 | 0.1825246 | 0.2341241 | 0.1938378 |
| $d_{20}$ (nm) | 171.320 | 223.941 | 274.062 | 165.232 | 217.150 |

| | | 6-06 | 6-07 | 6-08 | 6-09 | 6-10 |
|---|---|---|---|---|---|---|
| When $n_1 \geq n_{10}$, | $n_{1m} =$ | 0.0390417 | 0.0485681 | 0.0546460 | 0.0358069 | 0.0474683 |
| When $n_1 < n_{10}$, | $n_{1m} =$ | 0.0139282 | 0.0313391 | 0.0292078 | 0.0174304 | 0.0407373 |
| When $k_1 \geq k_{10}$, | $k_{1m} =$ | 0.0333240 | 0.0585132 | 0.0578357 | 0.0324670 | 0.0508789 |
| When $k_1 < k_{10}$, | $k_{1m} =$ | 0.0406140 | 0.0454041 | 0.0481470 | 0.0321411 | 0.0389600 |
| When $d_1 \geq d_{10}$, | $d_{1m}$ (nm) $=$ | 12.043 | 19.132 | 42.010 | 19.174 | ∞ |
| When $d_1 < d_{10}$, | $d_{1m}$ (nm) $=$ | 3.525 | 8.472 | 8.190 | 6.358 | 18.590 |
| When $n_2 \geq n_{20}$, | $n_{2m} =$ | 0.0324304 | 0.0734375 | 0.0906226 | 0.0327905 | 0.0764417 |
| When $n_2 < n_{20}$, | $n_{2m} =$ | 0.0896448 | 0.1073743 | 0.1223853 | 0.0797839 | 0.0702637 |
| When $k_2 \geq k_{20}$, | $k_{2m} =$ | 0.0391357 | 0.0623755 | 0.0817871 | 0.0268372 | 0.0433899 |
| When $k_2 < k_{20}$, | $k_{2m} =$ | 0.0597375 | 0.0603992 | 0.0593811 | 0.0545007 | 0.0559253 |
| When $d_2 \geq d_{20}$, | $d_{2m}$ (nm) $=$ | ∞ | ∞ | ∞ | 9.153 | ∞ |
| When $d_2 < d_{20}$, | $d_{2m}$ (nm) $=$ | 20.788 | 29.764 | 77.892 | 16.109 | 14.325 |

1. $0 < NA \leq 1.1$
$55 < T \leq 65$

| Case | 6-11 | 6-12 | 6-13 | 6-14 | 6-15 |
|---|---|---|---|---|---|
| $n_{10}$ | 1.6870964 | 1.6986314 | 1.7003667 | 1.6951156 | 1.6955653 |
| $k_{10}$ | 0.0858972 | 0.0705958 | 0.0607285 | 0.0571177 | 0.0680298 |
| $d_{10}$ (nm) | 208.556 | 224.893 | 221.557 | 215.781 | 264.644 |
| $n_{20}$ | 1.6830399 | 1.6622291 | 1.6983916 | 1.6957463 | 1.6953987 |
| $k_{20}$ | 0.3090553 | 0.2274423 | 0.1887213 | 0.1617780 | 0.2417239 |
| $d_{20}$ (nm) | 121.249 | 160.831 | 215.383 | 277.216 | 176.078 |

| | | 6-11 | 6-12 | 6-13 | 6-14 | 6-15 |
|---|---|---|---|---|---|---|
| When $n_1 \geq n_{10}$, | $n_{1m} =$ | 0.0051123 | 0.0520032 | 0.0662122 | 0.0842517 | 0.0515662 |
| When $n_1 < n_{10}$, | $n_{1m} =$ | 0.0418372 | 0.0227649 | 0.0435059 | 0.0645801 | 0.0369092 |
| When $k_1 \geq k_{10}$, | $k_{1m} =$ | 0.0150793 | 0.0436267 | 0.0489954 | 0.0563855 | 0.0542810 |
| When $k_1 < k_{10}$, | $k_{1m} =$ | 0.0179541 | 0.0228833 | 0.0348535 | 0.0371240 | 0.0381006 |
| When $d_1 \geq d_{10}$, | $d_{1m}$ (nm) = | 2.247 | ∞ | ∞ | ∞ | ∞ |
| When $d_1 < d_{10}$, | $d_{1m}$ (nm) = | 18.385 | 11.933 | 75.920 | 58.822 | 33.649 |
| When $n_2 \geq n_{20}$, | $n_{2m} =$ | 0.1010083 | 0.0477234 | 0.1065527 | 0.2254480 | 0.3829150 |
| When $n_2 < n_{20}$, | $n_{2m} =$ | 0.0100110 | 0.0759302 | 0.0611096 | 0.1540564 | 0.2775842 |
| When $k_2 \geq k_{20}$, | $k_{2m} =$ | 0.0726611 | 0.0766821 | 0.1015344 | 0.1236780 | 0.2119995 |
| When $k_2 < k_{20}$, | $k_{2m} =$ | 0.0309253 | 0.0590527 | 0.0616418 | 0.0602039 | 0.1044287 |
| When $d_2 \geq d_{20}$, | $d_{2m}$ (nm) = | 25.845 | 22.079 | ∞ | ∞ | ∞ |
| When $d_2 < d_{20}$, | $d_{2m}$ (nm) = | 1.717 | 20.127 | 24.695 | 81.257 | 67.124 |

1. $0 < NA \leq 1.1$
$55 < T \leq 65$

| Case | 6-16 |
|---|---|
| $n_{10}$ | 1.6958377 |
| $k_{10}$ | 0.0528303 |
| $d_{10}$ (nm) | 274.984 |
| $n_{20}$ | 1.6882898 |
| $k_{20}$ | 0.1657751 |
| $d_{20}$ (nm) | 275.044 |

| | | 6-16 |
|---|---|---|
| When $n_1 \geq n_{10}$, | $n_{1m} =$ | 0.0590991 |
| When $n_1 < n_{10}$, | $n_{1m} =$ | 0.0581189 |
| When $k_1 \geq k_{10}$, | $k_{1m} =$ | 0.0684131 |
| When $k_1 < k_{10}$, | $k_{1m} =$ | 0.0375098 |
| When $d_1 \geq d_{10}$, | $d_{1m}$ (nm) = | ∞ |
| When $d_1 < d_{10}$, | $d_{1m}$ (nm) = | 113.219 |
| When $n_2 \geq n_{20}$, | $n_{2m} =$ | 0.2789856 |
| When $n_2 < n_{20}$, | $n_{2m} =$ | 0.2219617 |
| When $k_2 \geq k_{20}$, | $k_{2m} =$ | 0.1981201 |
| When $k_2 < k_{20}$, | $k_{2m} =$ | 0.0735400 |
| When $d_2 \geq d_{20}$, | $d_{2m}$ (nm) = | ∞ |
| When $d_2 < d_{20}$, | $d_{2m}$ (nm) = | 97.500 |

1. $0 < NA \leq 1.1$

$65 < T \leq 75$

| Case | 7-01 | 7-02 | 7-03 | 7-04 | 7-05 |
|---|---|---|---|---|---|
| $n_{10}$ | 1.8339628 | 1.9445237 | 1.8939902 | 1.8811858 | 1.7203230 |
| $k_{10}$ | 0.2973905 | 0.1726202 | 0.1563846 | 0.0833966 | 0.0922740 |
| $d_{10}$ (nm) | 24.925 | 17.287 | 14.253 | 12.228 | 92.527 |
| $n_{20}$ | 1.6419965 | 1.7953047 | 1.6659458 | 1.7269957 | 1.6328842 |
| $k_{20}$ | 0.8698975 | 0.5162004 | 0.3485215 | 0.2426363 | 0.2599948 |
| $d_{20}$ (nm) | 41.723 | 98.907 | 167.112 | 272.914 | 160.703 |

| | | 7-01 | 7-02 | 7-03 | 7-04 | 7-05 |
|---|---|---|---|---|---|---|
| When $n_1 \geq n_{10}$, | $n_{1m}=$ | 0.0734924 | 0.0853552 | 0.0964307 | 0.1197986 | 0.0394055 |
| When $n_1 < n_{10}$, | $n_{1m}=$ | 0.0377722 | 0.0427490 | 0.0559692 | 0.0877673 | 0.0144592 |
| When $k_1 \geq k_{10}$, | $k_{1m}=$ | 0.0448938 | 0.0589941 | 0.0770850 | 0.1096667 | 0.0331616 |
| When $k_1 < k_{10}$, | $k_{1m}=$ | 0.0453357 | 0.0848169 | 0.0975195 | 0.0833966 | 0.0410388 |
| When $d_1 \geq d_{10}$, | $d_{1m}$ (nm) $=$ | 4.571 | 4.784 | 5.590 | 7.648 | 12.091 |
| When $d_1 < d_{10}$, | $d_{1m}$ (nm) $=$ | 2.315 | 2.092 | 3.027 | 5.109 | 3.655 |
| When $n_2 \geq n_{20}$, | $n_{2m}=$ | 0.1366638 | 0.1348682 | 0.1167786 | 0.1080664 | 0.0326196 |
| When $n_2 < n_{20}$, | $n_{2m}=$ | 0.1076978 | 0.1944104 | 0.1524536 | 0.1545313 | 0.0900854 |
| When $k_2 \geq k_{20}$, | $k_{2m}=$ | 0.1648022 | 0.1338904 | 0.1021130 | 0.1080652 | 0.0396484 |
| When $k_2 < k_{20}$, | $k_{2m}=$ | 0.1324670 | 0.1078918 | 0.0977759 | 0.0865271 | 0.0625085 |
| When $d_2 \geq d_{20}$, | $d_{2m}$ (nm) $=$ | 12.499 | ∞ | ∞ | ∞ | ∞ |
| When $d_2 < d_{20}$, | $d_{2m}$ (nm) $=$ | 5.747 | 14.376 | 64.164 | 128.680 | 19.557 |

1. $0 < NA \leq 1.1$

$65 < T \leq 75$

| Case | 7-06 | 7-07 | 7-08 | 7-09 | 7-10 |
|---|---|---|---|---|---|
| $n_{10}$ | 1.7224265 | 1.7294779 | 1.7053201 | 1.7102741 | 1.7133466 |
| $k_{10}$ | 0.0770592 | 0.0692299 | 0.0757255 | 0.0654045 | 0.0629386 |
| $d_{10}$ (nm) | 92.053 | 92.385 | 161.452 | 160.136 | 160.381 |
| $n_{20}$ | 1.6819841 | 1.7252879 | 1.6485370 | 1.7000507 | 1.7220503 |
| $k_{20}$ | 0.2150120 | 0.1858377 | 0.2399747 | 0.1977447 | 0.1698335 |
| $d_{20}$ (nm) | 213.162 | 263.723 | 154.588 | 206.614 | 260.757 |

| | | 7-06 | 7-07 | 7-08 | 7-09 | 7-10 |
|---|---|---|---|---|---|---|
| When $n_1 \geq n_{10}$, | $n_{1m}=$ | 0.0490625 | 0.0548535 | 0.0366443 | 0.0483020 | 0.0569666 |
| When $n_1 < n_{10}$, | $n_{1m}=$ | 0.0311902 | 0.0280200 | 0.0173645 | 0.0416309 | 0.0190027 |
| When $k_1 \geq k_{10}$, | $k_{1m}=$ | 0.0581604 | 0.0565332 | 0.0330920 | 0.0498926 | 0.0402344 |
| When $k_1 < k_{10}$, | $k_{1m}=$ | 0.0461389 | 0.0475879 | 0.0324707 | 0.0390747 | 0.0240051 |
| When $d_1 \geq d_{10}$, | $d_{1m}$ (nm) $=$ | 19.214 | 40.761 | 19.902 | ∞ | ∞ |
| When $d_1 < d_{10}$, | $d_{1m}$ (nm) $=$ | 8.328 | 7.705 | 6.285 | 18.989 | 5.694 |
| When $n_2 \geq n_{20}$, | $n_{2m}=$ | 0.0747375 | 0.0917908 | 0.0322156 | 0.0769946 | 0.1011584 |
| When $n_2 < n_{20}$, | $n_{2m}=$ | 0.1078540 | 0.1217822 | 0.0813562 | 0.0689685 | 0.1343567 |
| When $k_2 \geq k_{20}$, | $k_{2m}=$ | 0.0634705 | 0.0827625 | 0.0283752 | 0.0430542 | 0.0435730 |
| When $k_2 < k_{20}$, | $k_{2m}=$ | 0.0623401 | 0.0604163 | 0.0573535 | 0.0576453 | 0.0570081 |
| When $d_2 \geq d_{20}$, | $d_{2m}$ (nm) $=$ | ∞ | ∞ | 9.136 | 38.239 | ∞ |
| When $d_2 < d_{20}$, | $d_{2m}$ (nm) $=$ | 27.810 | 75.918 | 15.379 | 13.085 | 10.847 |

1. 0 < N A ≤ 1. 1
6 5 < T ≤ 7 5

| Case | | 7-11 | 7-12 | 7-13 | 7-14 | 7-15 |
|---|---|---|---|---|---|---|
| $n_{10}$ | | 1.6861768 | 1.6990769 | 1.7003759 | 1.6946436 | 1.6954303 |
| $k_{10}$ | | 0.0881028 | 0.0709373 | 0.0613969 | 0.0577579 | 0.0690806 |
| $d_{10}$ (nm) | | 208.148 | 225.005 | 221.468 | 215.315 | 264.876 |
| $n_{20}$ | | 1.6733849 | 1.6647354 | 1.6998938 | 1.6946016 | 1.6937197 |
| $k_{20}$ | | 0.3136681 | 0.2329033 | 0.1918751 | 0.1634050 | 0.2458138 |
| $d_{20}$ (nm) | | 112.385 | 150.349 | 205.497 | 268.128 | 165.269 |

| | | | | | | |
|---|---|---|---|---|---|---|
| When $n_1 \geq n_{10}$, | $n_{1m}=$ | 0.0025806 | 0.0529590 | 0.0676086 | 0.0859229 | 0.0516138 |
| When $n_1 < n_{10}$, | $n_{1m}=$ | 0.0409998 | 0.0231177 | 0.0444312 | 0.0666504 | 0.0367175 |
| When $k_1 \geq k_{10}$, | $k_{1m}=$ | 0.0094263 | 0.0435510 | 0.0474890 | 0.0560022 | 0.0529260 |
| When $k_1 < k_{10}$, | $k_{1m}=$ | 0.0156848 | 0.0234912 | 0.0355322 | 0.0372656 | 0.0371912 |
| When $d_1 \geq d_{10}$, | $d_{1m}$ (nm) $=$ | 1.037 | ∞ | ∞ | ∞ | ∞ |
| When $d_1 < d_{10}$, | $d_{1m}$ (nm) $=$ | 17.094 | 12.289 | 76.126 | 56.280 | 33.058 |
| When $n_2 \geq n_{20}$, | $n_{2m}=$ | 0.1039172 | 0.0468506 | 0.1077234 | 0.2240735 | 0.4022729 |
| When $n_2 < n_{20}$, | $n_{2m}=$ | 0.0058093 | 0.0753308 | 0.0576575 | 0.1556287 | 0.2760486 |
| When $k_2 \geq k_{20}$, | $k_{2m}=$ | 0.0664124 | 0.0758972 | 0.1012000 | 0.1249744 | 0.2123950 |
| When $k_2 < k_{20}$, | $k_{2m}=$ | 0.0178174 | 0.0630115 | 0.0645288 | 0.0620288 | 0.1063135 |
| When $d_2 \geq d_{20}$, | $d_{2m}$ (nm) $=$ | 26.367 | 19.187 | ∞ | ∞ | ∞ |
| When $d_2 < d_{20}$, | $d_{2m}$ (nm) $=$ | 1.017 | 18.602 | 23.769 | 80.847 | 66.469 |

1. 0 < N A ≤ 1. 1
6 5 < T ≤ 7 5

| Case | | 7-16 |
|---|---|---|
| $n_{10}$ | | 1.6957423 |
| $k_{10}$ | | 0.0532811 |
| $d_{10}$ (nm) | | 274.848 |
| $n_{20}$ | | 1.6878755 |
| $k_{20}$ | | 0.1674492 |
| $d_{20}$ (nm) | | 265.685 |

| | | |
|---|---|---|
| When $n_1 \geq n_{10}$, | $n_{1m}=$ | 0.0588110 |
| When $n_1 < n_{10}$, | $n_{1m}=$ | 0.0575696 |
| When $k_1 \geq k_{10}$, | $k_{1m}=$ | 0.0681641 |
| When $k_1 < k_{10}$, | $k_{1m}=$ | 0.0379443 |
| When $d_1 \geq d_{10}$, | $d_{1m}$ (nm) $=$ | ∞ |
| When $d_1 < d_{10}$, | $d_{1m}$ (nm) $=$ | 112.076 |
| When $n_2 \geq n_{20}$, | $n_{2m}=$ | 0.2806909 |
| When $n_2 < n_{20}$, | $n_{2m}=$ | 0.2229114 |
| When $k_2 \geq k_{20}$, | $k_{2m}=$ | 0.1986609 |
| When $k_2 < k_{20}$, | $k_{2m}=$ | 0.0745801 |
| When $d_2 \geq d_{20}$, | $d_{2m}$ (nm) $=$ | ∞ |
| When $d_2 < d_{20}$, | $d_{2m}$ (nm) $=$ | 89.270 |

1. 0 < N A ≦ 1. 1
7 5 < T ≦ 8 5

| Case | | 8-01 | 8-02 | 8-03 | 8-04 | 8-05 |
|---|---|---|---|---|---|---|
| $n_{10}$ | | 1.9187259 | 1.8967518 | 1.8757876 | 1.8806788 | 1.7234296 |
| $k_{10}$ | | 0.1881900 | 0.1527475 | 0.1318014 | 0.0899399 | 0.0945092 |
| $d_{10}$ (nm) | | 20.509 | 15.221 | 13.247 | 12.412 | 92.722 |
| $n_{20}$ | | 1.8283337 | 1.6893708 | 1.6726776 | 1.7211162 | 1.6393014 |
| $k_{20}$ | | 0.5739613 | 0.3734166 | 0.2883472 | 0.2492460 | 0.2743485 |
| $d_{20}$ (nm) | | 84.746 | 154.221 | 215.129 | 265.394 | 150.270 |

| | | 8-01 | 8-02 | 8-03 | 8-04 | 8-05 |
|---|---|---|---|---|---|---|
| When $n_1 \geq n_{10}$, | $n_{1m}=$ | 0.0766943 | 0.0922229 | 0.1080322 | 0.1177502 | 0.0391516 |
| When $n_1 < n_{10}$, | $n_{1m}=$ | 0.0399988 | 0.0530884 | 0.0750195 | 0.0852625 | 0.0112524 |
| When $k_1 \geq k_{10}$, | $k_{1m}=$ | 0.0507166 | 0.0712622 | 0.0980225 | 0.1073047 | 0.0289392 |
| When $k_1 < k_{10}$, | $k_{1m}=$ | 0.0771802 | 0.0964258 | 0.1069458 | 0.0899399 | 0.0412610 |
| When $d_1 \geq d_{10}$, | $d_{1m}$ (nm) $=$ | 5.195 | 5.640 | 6.681 | 7.548 | 11.825 |
| When $d_1 < d_{10}$, | $d_{1m}$ (nm) $=$ | 2.249 | 2.987 | 4.301 | 4.972 | 2.719 |
| When $n_2 \geq n_{20}$, | $n_{2m}=$ | 0.1444995 | 0.1155615 | 0.1091333 | 0.1093396 | 0.0288635 |
| When $n_2 < n_{20}$, | $n_{2m}=$ | 0.1897876 | 0.1532776 | 0.1435217 | 0.1541382 | 0.0890479 |
| When $k_2 \geq k_{20}$, | $k_{2m}=$ | 0.1811243 | 0.1099194 | 0.1006726 | 0.1075403 | 0.0356238 |
| When $k_2 < k_{20}$, | $k_{2m}=$ | 0.1194946 | 0.1025110 | 0.0922131 | 0.0871228 | 0.0649683 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 15.313 | 64.664 | 82.555 | 124.472 | 16.892 |

1. 0 < N A ≦ 1. 1
7 5 < T ≦ 8 5

| Case | | 8-06 | 8-07 | 8-08 | 8-09 | 8-10 |
|---|---|---|---|---|---|---|
| $n_{10}$ | | 1.7235983 | 1.7294254 | 1.7064538 | 1.7103862 | 1.7133072 |
| $k_{10}$ | | 0.0790587 | 0.0706491 | 0.0777504 | 0.0670250 | 0.0637197 |
| $d_{10}$ (nm) | | 92.129 | 92.482 | 161.668 | 160.278 | 160.467 |
| $n_{20}$ | | 1.6815454 | 1.7233644 | 1.6498826 | 1.6983722 | 1.7219131 |
| $k_{20}$ | | 0.2228770 | 0.1918670 | 0.2514894 | 0.2047961 | 0.1752501 |
| $d_{20}$ (nm) | | 204.187 | 255.172 | 145.038 | 197.922 | 251.781 |

| | | 8-06 | 8-07 | 8-08 | 8-09 | 8-10 |
|---|---|---|---|---|---|---|
| When $n_1 \geq n_{10}$, | $n_{1m}=$ | 0.0481958 | 0.0539050 | 0.0362122 | 0.0474792 | 0.0556775 |
| When $n_1 < n_{10}$, | $n_{1m}=$ | 0.0281580 | 0.0270288 | 0.0158582 | 0.0428101 | 0.0187244 |
| When $k_1 \geq k_{10}$, | $k_{1m}=$ | 0.0546558 | 0.0547986 | 0.0255066 | 0.0459753 | 0.0391089 |
| When $k_1 < k_{10}$, | $k_{1m}=$ | 0.0470496 | 0.0476624 | 0.0330371 | 0.0375122 | 0.0244470 |
| When $d_1 \geq d_{10}$, | $d_{1m}$ (nm) $=$ | 18.433 | 40.484 | 19.881 | ∞ | ∞ |
| When $d_1 < d_{10}$, | $d_{1m}$ (nm) $=$ | 7.376 | 7.380 | 6.011 | 13.737 | 5.649 |
| When $n_2 \geq n_{20}$, | $n_{2m}=$ | 0.0719336 | 0.0903259 | 0.0311267 | 0.0755847 | 0.1032422 |
| When $n_2 < n_{20}$, | $n_{2m}=$ | 0.1049182 | 0.1183936 | 0.0789893 | 0.0715295 | 0.1268079 |
| When $k_2 \geq k_{20}$, | $k_{2m}=$ | 0.0610889 | 0.0802148 | 0.0194653 | 0.0384314 | 0.0401990 |
| When $k_2 < k_{20}$, | $k_{2m}=$ | 0.0626282 | 0.0606787 | 0.0584229 | 0.0575549 | 0.0569128 |
| When $d_2 \geq d_{20}$, | $d_{2m}$ (nm) $=$ | ∞ | ∞ | 6.414 | 35.522 | ∞ |
| When $d_2 < d_{20}$, | $d_{2m}$ (nm) $=$ | 26.455 | 72.823 | 13.152 | 13.515 | 11.677 |

1. 0 < N A ≤ 1. 1
7 5 < T ≤ 8 5

| Case | 8-11 | 8-12 | 8-13 | 8-14 | 8-15 |
|---|---|---|---|---|---|
| $n_{10}$ | 1.6987335 | 1.6895310 | 1.6997408 | 1.6947661 | 1.6915645 |
| $k_{10}$ | 0.0728489 | 0.0798395 | 0.0628030 | 0.0583146 | 0.0796327 |
| $d_{10}$ (nm) | 224.384 | 207.056 | 221.189 | 215.749 | 269.434 |
| $n_{20}$ | 1.6635130 | 1.6873868 | 1.6972371 | 1.6943199 | 1.7013553 |
| $k_{20}$ | 0.2423517 | 0.2464201 | 0.1976117 | 0.1671130 | 0.3520060 |
| $d_{20}$ (nm) | 141.699 | 160.447 | 197.186 | 258.789 | 90.540 |

| | | 8-11 | 8-12 | 8-13 | 8-14 | 8-15 |
|---|---|---|---|---|---|---|
| When $n_1 \geq n_{10}$, | $n_{1m}=$ | 0.0550525 | 0.0211743 | 0.0680066 | 0.0840710 | 0.0339661 |
| When $n_1 < n_{10}$, | $n_{1m}=$ | 0.0214722 | 0.0563281 | 0.0446484 | 0.0653711 | 0.0319580 |
| When $k_1 \geq k_{10}$, | $k_{1m}=$ | 0.0399634 | 0.0394690 | 0.0462439 | 0.0552136 | 0.0498462 |
| When $k_1 < k_{10}$, | $k_{1m}=$ | 0.0230286 | 0.0247534 | 0.0358582 | 0.0373328 | 0.0319092 |
| When $d_1 \geq d_{10}$, | $d_{1m}$ (nm) = | ∞ | 18.382 | ∞ | ∞ | 29.764 |
| When $d_1 < d_{10}$, | $d_{1m}$ (nm) = | 12.181 | 26.345 | 75.416 | 56.560 | 16.533 |
| When $n_2 \geq n_{20}$, | $n_{2m}=$ | 0.0460742 | 0.1451038 | 0.1164050 | 0.2251794 | 0.2068530 |
| When $n_2 < n_{20}$, | $n_{2m}=$ | 0.0736353 | 0.0531665 | 0.0615222 | 0.1544678 | 0.0982214 |
| When $k_2 \geq k_{20}$, | $k_{2m}=$ | 0.0651685 | 0.0979858 | 0.0980493 | 0.1211584 | 0.1840808 |
| When $k_2 < k_{20}$, | $k_{2m}=$ | 0.0709375 | 0.0696692 | 0.0675049 | 0.0632251 | 0.1287793 |
| When $d_2 \geq d_{20}$, | $d_{2m}$ (nm) = | 17.326 | ∞ | ∞ | ∞ | ∞ |
| When $d_2 < d_{20}$, | $d_{2m}$ (nm) = | 17.676 | 13.280 | 25.586 | 81.223 | 11.833 |

1. 0 < N A ≤ 1. 1
7 5 < T ≤ 8 5

| Case | 8-16 | 8-17 |
|---|---|---|
| $n_{10}$ | 1.6950499 | 1.6956172 |
| $k_{10}$ | 0.0706693 | 0.0541668 |
| $d_{10}$ (nm) | 266.123 | 274.905 |
| $n_{20}$ | 1.6983222 | 1.6860233 |
| $k_{20}$ | 0.2573177 | 0.1712439 |
| $d_{20}$ (nm) | 152.851 | 257.337 |

| | | 8-16 | 8-17 |
|---|---|---|---|
| When $n_1 \geq n_{10}$, | $n_{1m}=$ | 0.0524487 | 0.0590308 |
| When $n_1 < n_{10}$, | $n_{1m}=$ | 0.0375452 | 0.0580872 |
| When $k_1 \geq k_{10}$, | $k_{1m}=$ | 0.0517285 | 0.0672278 |
| When $k_1 < k_{10}$, | $k_{1m}=$ | 0.0352881 | 0.0380591 |
| When $d_1 \geq d_{10}$, | $d_{1m}$ (nm) = | ∞ | ∞ |
| When $d_1 < d_{10}$, | $d_{1m}$ (nm) = | 33.771 | 112.404 |
| When $n_2 \geq n_{20}$, | $n_{2m}=$ | 0.2704944 | 0.2806836 |
| When $n_2 < n_{20}$, | $n_{2m}=$ | 0.2755872 | 0.2222266 |
| When $k_2 \geq k_{20}$, | $k_{2m}=$ | 0.2121143 | 0.1985229 |
| When $k_2 < k_{20}$, | $k_{2m}=$ | 0.1128918 | 0.0743774 |
| When $d_2 \geq d_{20}$, | $d_{2m}$ (nm) = | ∞ | ∞ |
| When $d_2 < d_{20}$, | $d_{2m}$ (nm) = | 65.292 | 85.089 |

1. $0 < NA \leqq 1. 1$
$85 < T \leqq 95$

| Case | 9-01 | 9-02 | 9-03 | 9-04 | 9-05 |
|---|---|---|---|---|---|
| $n_{10}$ | 1.8980776 | 1.9078109 | 1.8887573 | 1.8863613 | 1.7283563 |
| $k_{10}$ | 0.2063094 | 0.1489982 | 0.1336370 | 0.0963846 | 0.0991844 |
| $d_{10}$ (nm) | 23.234 | 16.351 | 13.295 | 12.395 | 92.796 |
| $n_{20}$ | 1.8542997 | 1.7325536 | 1.6803356 | 1.7165602 | 1.6494143 |
| $k_{20}$ | 0.6486453 | 0.4126982 | 0.3065809 | 0.2596921 | 0.2975623 |
| $d_{20}$ (nm) | 73.732 | 141.036 | 205.639 | 258.147 | 140.358 |

| | | 9-01 | 9-02 | 9-03 | 9-04 | 9-05 |
|---|---|---|---|---|---|---|
| When $n_1 \geqq n_{10}$, | $n_{1m} =$ | 0.0711987 | 0.0870154 | 0.1059106 | 0.1162891 | 0.0375220 |
| When $n_1 < n_{10}$, | $n_{1m} =$ | 0.0384509 | 0.0501709 | 0.0716760 | 0.0832544 | 0.0056213 |
| When $k_1 \geqq k_{10}$, | $k_{1m} =$ | 0.0445569 | 0.0643555 | 0.0939661 | 0.1053198 | 0.0189441 |
| When $k_1 < k_{10}$, | $k_{1m} =$ | 0.0730103 | 0.0941223 | 0.1072681 | 0.0963846 | 0.0324854 |
| When $d_1 \geqq d_{10}$, | $d_{1m}$ (nm) $=$ | 5.225 | 5.526 | 6.240 | 7.169 | 10.895 |
| When $d_1 < d_{10}$, | $d_{1m}$ (nm) $=$ | 2.347 | 2.839 | 3.908 | 4.670 | 1.261 |
| When $n_2 \geqq n_{20}$, | $n_{2m} =$ | 0.1402551 | 0.1159338 | 0.1109766 | 0.1105359 | 0.0179150 |
| When $n_2 < n_{20}$, | $n_{2m} =$ | 0.1828406 | 0.1543176 | 0.1513220 | 0.1539343 | 0.0865198 |
| When $k_2 \geqq k_{20}$, | $k_{2m} =$ | 0.2259802 | 0.1235034 | 0.1018750 | 0.1065100 | 0.0230737 |
| When $k_2 < k_{20}$, | $k_{2m} =$ | 0.1284644 | 0.1059631 | 0.0936096 | 0.0878577 | 0.0660486 |
| When $d_2 \geqq d_{20}$, | $d_{2m}$ (nm) $=$ | ∞ | ∞ | ∞ | ∞ | 14.635 |
| When $d_2 < d_{20}$, | $d_{2m}$ (nm) $=$ | 14.747 | 31.656 | 77.584 | 118.336 | 14.252 |

1. $0 < NA \leqq 1. 1$
$85 < T \leqq 95$

| Case | 9-06 | 9-07 | 9-08 | 9-09 | 9-10 |
|---|---|---|---|---|---|
| $n_{10}$ | 1.7247011 | 1.7288637 | 1.7100270 | 1.7129082 | 1.6894084 |
| $k_{10}$ | 0.0825295 | 0.0727638 | 0.0697395 | 0.0648353 | 0.0825836 |
| $d_{10}$ (nm) | 92.134 | 92.409 | 160.277 | 160.281 | 208.412 |
| $n_{20}$ | 1.6784446 | 1.7181265 | 1.6932584 | 1.7202855 | 1.6911413 |
| $k_{20}$ | 0.2345042 | 0.1997137 | 0.2147807 | 0.1822190 | 0.2636300 |
| $d_{20}$ (nm) | 196.220 | 247.866 | 190.362 | 243.795 | 148.443 |

| | | 9-06 | 9-07 | 9-08 | 9-09 | 9-10 |
|---|---|---|---|---|---|---|
| When $n_1 \geqq n_{10}$, | $n_{1m} =$ | 0.0458069 | 0.0520715 | 0.0445874 | 0.0530676 | 0.0168896 |
| When $n_1 < n_{10}$, | $n_{1m} =$ | 0.0231628 | 0.0254517 | 0.0291443 | 0.0189783 | 0.0564331 |
| When $k_1 \geqq k_{10}$, | $k_{1m} =$ | 0.0487341 | 0.0524194 | 0.0390308 | 0.0374463 | 0.0317554 |
| When $k_1 < k_{10}$, | $k_{1m} =$ | 0.0471680 | 0.0474573 | 0.0341357 | 0.0249304 | 0.0174866 |
| When $d_1 \geqq d_{10}$, | $d_{1m}$ (nm) $=$ | 16.768 | 28.342 | ∞ | ∞ | 8.653 |
| When $d_1 < d_{10}$, | $d_{1m}$ (nm) $=$ | 5.875 | 6.859 | 8.481 | 5.666 | 22.933 |
| When $n_2 \geqq n_{20}$, | $n_{2m} =$ | 0.0654785 | 0.0851550 | 0.0721350 | 0.0992358 | 0.1489941 |
| When $n_2 < n_{20}$, | $n_{2m} =$ | 0.0999084 | 0.1129846 | 0.0702051 | 0.1184961 | 0.0323828 |
| When $k_2 \geqq k_{20}$, | $k_{2m} =$ | 0.0550916 | 0.0742688 | 0.0299036 | 0.0348145 | 0.0701428 |
| When $k_2 < k_{20}$, | $k_{2m} =$ | 0.0621350 | 0.0605774 | 0.0564990 | 0.0562878 | 0.0653857 |
| When $d_2 \geqq d_{20}$, | $d_{2m}$ (nm) $=$ | ∞ | ∞ | 30.126 | ∞ | ∞ |
| When $d_2 < d_{20}$, | $d_{2m}$ (nm) $=$ | 23.369 | 34.214 | 13.997 | 12.255 | 9.630 |

## 1. 0 < N A ≤ 1. 1
### 8 5 < T ≤ 9 5

| Case | 9–11 | 9–12 | 9–13 | 9–14 | 9–15 |
|---|---|---|---|---|---|
| $n_{10}$ | 1.6987536 | 1.6951804 | 1.6947043 | 1.6953534 | 1.6955317 |
| $k_{10}$ | 0.0651428 | 0.0592977 | 0.0728049 | 0.0654850 | 0.0555447 |
| $d_{10}$ (nm) | 220.679 | 216.421 | 267.049 | 264.587 | 274.968 |
| $n_{20}$ | 1.6918669 | 1.6944812 | 1.7045529 | 1.6939885 | 1.6840742 |
| $k_{20}$ | 0.2062686 | 0.1733276 | 0.2758626 | 0.2171518 | 0.1777252 |
| $d_{20}$ (nm) | 189.869 | 249.686 | 142.407 | 204.731 | 249.243 |

| | | 9–11 | 9–12 | 9–13 | 9–14 | 9–15 |
|---|---|---|---|---|---|---|
| When $n_1 \geq n_{10}$, | $n_{1m} =$ | 0.0676538 | 0.0804553 | 0.0514111 | 0.0772083 | 0.0594299 |
| When $n_1 < n_{10}$, | $n_{1m} =$ | 0.0423462 | 0.0620581 | 0.0375159 | 0.0498364 | 0.0587244 |
| When $k_1 \geq k_{10}$, | $k_{1m} =$ | 0.0442505 | 0.0538220 | 0.0506982 | 0.0550830 | 0.0658191 |
| When $k_1 < k_{10}$, | $k_{1m} =$ | 0.0341040 | 0.0375916 | 0.0340894 | 0.0384644 | 0.0372644 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 72.990 | 57.440 | 26.805 | 108.871 | 112.765 |
| When $n_2 \geq n_{20}$, | $n_{2m} =$ | 0.1307581 | 0.2319055 | 0.2365918 | 0.3979211 | 0.2850439 |
| When $n_2 < n_{20}$, | $n_{2m} =$ | 0.0673376 | 0.1520984 | 0.2827087 | 0.2359326 | 0.2177148 |
| When $k_2 \geq k_{20}$, | $k_{2m} =$ | 0.0940100 | 0.1156787 | 0.2079443 | 0.2187415 | 0.1980774 |
| When $k_2 < k_{20}$, | $k_{2m} =$ | 0.0673755 | 0.0629675 | 0.1183691 | 0.0982336 | 0.0755945 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 25.557 | 76.954 | 64.091 | 75.273 | 81.971 |

## 1. 0 < N A ≤ 1. 1
### 9 5 < T ≤ 1 0 5

| Case | 10–01 | 10–02 | 10–03 | 10–04 | 10–05 |
|---|---|---|---|---|---|
| $n_{10}$ | 1.9059589 | 1.9224042 | 1.8961620 | 1.8922593 | 1.7254583 |
| $k_{10}$ | 0.2274286 | 0.1550778 | 0.1385328 | 0.1041345 | 0.0865833 |
| $d_{10}$ (nm) | 23.462 | 16.599 | 13.501 | 12.282 | 91.876 |
| $n_{20}$ | 1.8553331 | 1.7510181 | 1.6829419 | 1.7097147 | 1.6727903 |
| $k_{20}$ | 0.7355051 | 0.4490690 | 0.3248659 | 0.2697702 | 0.2465542 |
| $d_{20}$ (nm) | 66.090 | 131.424 | 196.767 | 251.116 | 188.519 |

| | | 10–01 | 10–02 | 10–03 | 10–04 | 10–05 |
|---|---|---|---|---|---|---|
| When $n_1 \geq n_{10}$, | $n_{1m} =$ | 0.0671912 | 0.0841919 | 0.1023767 | 0.1153796 | 0.0426331 |
| When $n_1 < n_{10}$, | $n_{1m} =$ | 0.0345654 | 0.0474304 | 0.0675305 | 0.0814563 | 0.0184045 |
| When $k_1 \geq k_{10}$, | $k_{1m} =$ | 0.0380615 | 0.0598425 | 0.0894568 | 0.1045068 | 0.0426917 |
| When $k_1 < k_{10}$, | $k_{1m} =$ | 0.0683374 | 0.0902014 | 0.1054456 | 0.1041345 | 0.0441687 |
| When $d_1 \geq d_{10}$, | $d_{1m}$ (nm) $=$ | 4.558 | 5.118 | 5.874 | 6.783 | 14.297 |
| When $d_1 < d_{10}$, | $d_{1m}$ (nm) $=$ | 1.985 | 2.531 | 3.589 | 4.355 | 4.476 |
| When $n_2 \geq n_{20}$, | $n_{2m} =$ | 0.1216980 | 0.1117603 | 0.1100940 | 0.1104114 | 0.0579919 |
| When $n_2 < n_{20}$, | $n_{2m} =$ | 0.1802991 | 0.1554016 | 0.1498889 | 0.1534180 | 0.0956348 |
| When $k_2 \geq k_{20}$, | $k_{2m} =$ | 0.2165979 | 0.1264526 | 0.1015808 | 0.1042908 | 0.0462366 |
| When $k_2 < k_{20}$, | $k_{2m} =$ | 0.1276270 | 0.1054065 | 0.0937561 | 0.0879675 | 0.0605090 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 11.858 | 29.189 | 73.755 | 91.689 | 21.669 |

1. 0 < N A ≤ 1. 1
9 5 < T ≤ 1 0 5

| Case | 10-06 | 10-07 | 10-08 | 10-09 | 10-10 |
|---|---|---|---|---|---|
| $n_{10}$ | 1.7286512 | 1.7096319 | 1.7125109 | 1.6891198 | 1.6979687 |
| $k_{10}$ | 0.0752622 | 0.0728333 | 0.0665034 | 0.0853163 | 0.0677690 |
| $d_{10}$ (nm) | 92.185 | 159.923 | 159.852 | 208.173 | 220.140 |
| $n_{20}$ | 1.7137581 | 1.6877059 | 1.7181911 | 1.6918411 | 1.6871092 |
| $k_{20}$ | 0.2076205 | 0.2252670 | 0.1890952 | 0.2826173 | 0.2165239 |
| $d_{20}$ (nm) | 240.302 | 182.766 | 235.934 | 141.112 | 182.186 |

| | | 10-06 | 10-07 | 10-08 | 10-09 | 10-10 |
|---|---|---|---|---|---|---|
| When $n_1 \geq n_{10}$, | $n_{1m}=$ | 0.0500330 | 0.0406897 | 0.0503772 | 0.0132690 | 0.0644641 |
| When $n_1 < n_{10}$, | $n_{1m}=$ | 0.0231873 | 0.0169287 | 0.0155139 | 0.0507471 | 0.0375525 |
| When $k_1 \geq k_{10}$, | $k_{1m}=$ | 0.0495398 | 0.0307520 | 0.0335327 | 0.0250305 | 0.0414893 |
| When $k_1 < k_{10}$, | $k_{1m}=$ | 0.0465039 | 0.0291895 | 0.0230286 | 0.0142859 | 0.0317957 |
| When $d_1 \geq d_{10}$, | $d_{1m}$ (nm) = | 22.149 | ∞ | ∞ | 5.803 | ∞ |
| When $d_1 < d_{10}$, | $d_{1m}$ (nm) = | 6.093 | 5.010 | 4.544 | 20.171 | 66.095 |
| When $n_2 \geq n_{20}$, | $n_{2m}=$ | 0.0807422 | 0.0673730 | 0.0968713 | 0.1414526 | 0.1231934 |
| When $n_2 < n_{20}$, | $n_{2m}=$ | 0.1109875 | 0.0569836 | 0.1140344 | 0.0176575 | 0.0690576 |
| When $k_2 \geq k_{20}$, | $k_{2m}=$ | 0.0671313 | 0.0201965 | 0.0272949 | 0.0516113 | 0.0909106 |
| When $k_2 < k_{20}$, | $k_{2m}=$ | 0.0601733 | 0.0546924 | 0.0555640 | 0.0644128 | 0.0681702 |
| When $d_2 \geq d_{20}$, | $d_{2m}$ (nm) = | ∞ | 22.678 | ∞ | ∞ | ∞ |
| When $d_2 < d_{20}$, | $d_{2m}$ (nm) = | 33.234 | 12.401 | 9.751 | 3.545 | 24.752 |

1. 0 < N A ≤ 1. 1
9 5 < T ≤ 1 0 5

| Case | 10-11 | 10-12 | 10-13 |
|---|---|---|---|
| $n_{10}$ | 1.6953920 | 1.6945041 | 1.6957904 |
| $k_{10}$ | 0.0607310 | 0.0754015 | 0.0613078 |
| $d_{10}$ (nm) | 216.694 | 266.879 | 263.111 |
| $n_{20}$ | 1.6943518 | 1.7053190 | 1.6921380 |
| $k_{20}$ | 0.1805507 | 0.2962459 | 0.1886276 |
| $d_{20}$ (nm) | 240.824 | 134.581 | 257.166 |

| | | 10-11 | 10-12 | 10-13 |
|---|---|---|---|---|
| When $n_1 \geq n_{10}$, | $n_{1m}=$ | 0.0773376 | 0.0489661 | 0.0744116 |
| When $n_1 < n_{10}$, | $n_{1m}=$ | 0.0532397 | 0.0362244 | 0.0544775 |
| When $k_1 \geq k_{10}$, | $k_{1m}=$ | 0.0520667 | 0.0490686 | 0.0595886 |
| When $k_1 < k_{10}$, | $k_{1m}=$ | 0.0373279 | 0.0329797 | 0.0399255 |
| When $d_1 \geq d_{10}$, | $d_{1m}$ (nm) = | ∞ | ∞ | ∞ |
| When $d_1 < d_{10}$, | $d_{1m}$ (nm) = | 56.748 | 22.698 | 144.280 |
| When $n_2 \geq n_{20}$, | $n_{2m}=$ | 0.2401196 | 0.2258960 | 0.3617542 |
| When $n_2 < n_{20}$, | $n_{2m}=$ | 0.1505750 | 0.2863916 | 0.2146826 |
| When $k_2 \geq k_{20}$, | $k_{2m}=$ | 0.1118237 | 0.2042285 | 0.2258594 |
| When $k_2 < k_{20}$, | $k_{2m}=$ | 0.0641272 | 0.1247363 | 0.0874829 |
| When $d_2 \geq d_{20}$, | $d_{2m}$ (nm) = | ∞ | ∞ | ∞ |
| When $d_2 < d_{20}$, | $d_{2m}$ (nm) = | 74.466 | 22.579 | 121.018 |

1. 0 < N A ≤ 1. 1
1 0 5 < T ≤ 1 1 5

| Case | 11-01 | 11-02 | 11-03 | 11-04 | 11-05 |
|---|---|---|---|---|---|
| $n_{10}$ | 1.9374125 | 1.9018997 | 1.8965439 | 1.7253637 | 1.7289764 |
| $k_{10}$ | 0.1704110 | 0.1487976 | 0.1142225 | 0.0900184 | 0.0775142 |
| $d_{10}$ (nm) | 15.669 | 13.285 | 11.973 | 91.432 | 91.877 |
| $n_{20}$ | 1.7248980 | 1.6713435 | 1.6970963 | 1.6651786 | 1.7120256 |
| $k_{20}$ | 0.4663738 | 0.3352808 | 0.2748315 | 0.2549499 | 0.2134557 |
| $d_{20}$ (nm) | 126.299 | 189.496 | 244.759 | 180.505 | 231.728 |

| | | 11-01 | 11-02 | 11-03 | 11-04 | 11-05 |
|---|---|---|---|---|---|---|
| When $n_1 \geq n_{10}$, | $n_{1n} =$ | 0.0844495 | 0.1011877 | 0.1161206 | 0.0397363 | 0.0483887 |
| When $n_1 < n_{10}$, | $n_{1n} =$ | 0.0440234 | 0.0656897 | 0.0810999 | 0.0155029 | 0.0208545 |
| When $k_1 \geq k_{10}$, | $k_{1n} =$ | 0.0577478 | 0.0888123 | 0.1065247 | 0.0388269 | 0.0469031 |
| When $k_1 < k_{10}$, | $k_{1n} =$ | 0.0914417 | 0.1045447 | 0.1142225 | 0.0417639 | 0.0449243 |
| When $d_1 \geq d_{10}$, | $d_{1n}$ (nm) $=$ | 4.564 | 5.473 | 6.423 | 12.314 | 18.889 |
| When $d_1 < d_{10}$, | $d_{1n}$ (nm) $=$ | 2.111 | 3.313 | 4.088 | 3.639 | 5.309 |
| When $n_2 \geq n_{20}$, | $n_{2n} =$ | 0.1026855 | 0.1066711 | 0.1092859 | 0.0538538 | 0.0798657 |
| When $n_2 < n_{20}$, | $n_{2n} =$ | 0.1573315 | 0.1496814 | 0.1507874 | 0.0957056 | 0.1124231 |
| When $k_2 \geq k_{20}$, | $k_{2n} =$ | 0.1109265 | 0.0973877 | 0.1006897 | 0.0382251 | 0.0609106 |
| When $k_2 < k_{20}$, | $k_{2n} =$ | 0.0995313 | 0.0917126 | 0.0869214 | 0.0582397 | 0.0599487 |
| When $d_2 \geq d_{20}$, | $d_{2n}$ (nm) $=$ | ∞ | ∞ | ∞ | ∞ | ∞ |
| When $d_2 < d_{20}$, | $d_{2n}$ (nm) $=$ | 32.204 | 71.551 | 94.669 | 21.979 | 35.901 |

1. 0 < N A ≤ 1. 1
1 0 5 < T ≤ 1 1 5

| Case | 11-06 | 11-07 | 11-08 | 11-09 | 11-10 |
|---|---|---|---|---|---|
| $n_{10}$ | 1.7092919 | 1.7124011 | 1.6891266 | 1.6977739 | 1.6952347 |
| $k_{10}$ | 0.0753499 | 0.0683625 | 0.0867081 | 0.0698574 | 0.0623107 |
| $d_{10}$ (nm) | 159.318 | 159.365 | 206.818 | 219.869 | 216.627 |
| $n_{20}$ | 1.6830351 | 1.7169838 | 1.6858604 | 1.6842611 | 1.6937881 |
| $k_{20}$ | 0.2331189 | 0.1941891 | 0.2953498 | 0.2258219 | 0.1869159 |
| $d_{20}$ (nm) | 174.468 | 227.412 | 138.155 | 173.345 | 231.738 |

| | | 11-06 | 11-07 | 11-08 | 11-09 | 11-10 |
|---|---|---|---|---|---|---|
| When $n_1 \geq n_{10}$, | $n_{1n} =$ | 0.0373157 | 0.0484546 | 0.0121899 | 0.0603870 | 0.0758545 |
| When $n_1 < n_{10}$, | $n_{1n} =$ | 0.0105005 | 0.0089343 | 0.0409204 | 0.0315625 | 0.0474512 |
| When $k_1 \geq k_{10}$, | $k_{1n} =$ | 0.0240833 | 0.0270752 | 0.0251843 | 0.0382471 | 0.0501941 |
| When $k_1 < k_{10}$, | $k_{1n} =$ | 0.0246826 | 0.0176978 | 0.0193188 | 0.0296948 | 0.0358765 |
| When $d_1 \geq d_{10}$, | $d_{1n}$ (nm) $=$ | 22.059 | ∞ | 5.261 | ∞ | ∞ |
| When $d_1 < d_{10}$, | $d_{1n}$ (nm) $=$ | 3.023 | 2.568 | 16.255 | 17.363 | 54.608 |
| When $n_2 \geq n_{20}$, | $n_{2n} =$ | 0.0659399 | 0.0944360 | 0.1154346 | 0.0831506 | 0.2493335 |
| When $n_2 < n_{20}$, | $n_{2n} =$ | 0.0371252 | 0.1164661 | 0.0185925 | 0.0632410 | 0.1310596 |
| When $k_2 \geq k_{20}$, | $k_{2n} =$ | 0.0133044 | 0.0180847 | 0.0609753 | 0.0891687 | 0.1103210 |
| When $k_2 < k_{20}$, | $k_{2n} =$ | 0.0529578 | 0.0555518 | 0.0785950 | 0.0680151 | 0.0652307 |
| When $d_2 \geq d_{20}$, | $d_{2n}$ (nm) $=$ | 18.030 | ∞ | ∞ | ∞ | ∞ |
| When $d_2 < d_{20}$, | $d_{2n}$ (nm) $=$ | 8.732 | 5.378 | 3.627 | 23.361 | 52.894 |

1. 0 < N A ≤ 1. 1
1 0 5 < T ≤ 1 1 5

| Case | 11-11 | 11-12 |
|---|---|---|
| $n_{10}$ | 1.6944699 | 1.6958800 |
| $k_{10}$ | 0.0775933 | 0.0528961 |
| $d_{10}$ (nm) | 265.762 | 273.317 |
| $n_{20}$ | 1.6967397 | 1.6915993 |
| $k_{20}$ | 0.3115846 | 0.1649138 |
| $d_{20}$ (nm) | 129.093 | 288.010 |

| | | 11-11 | 11-12 |
|---|---|---|---|
| When $n_1 \geq n_{10}$, | $n_{1m} =$ | 0.0466345 | 0.0703040 |
| When $n_1 < n_{10}$, | $n_{1m} =$ | 0.0341467 | 0.0549121 |
| When $k_1 \geq k_{10}$, | $k_{1m} =$ | 0.0473621 | 0.0679175 |
| When $k_1 < k_{10}$, | $k_{1m} =$ | 0.0320862 | 0.0389246 |
| When $d_1 \geq d_{10}$, | $d_{1m}$ (nm) $=$ | ∞ | ∞ |
| When $d_1 < d_{10}$, | $d_{1m}$ (nm) $=$ | 20.031 | 180.011 |
| When $n_2 \geq n_{20}$, | $n_{2m} =$ | 0.2202100 | 0.2749866 |
| When $n_2 < n_{20}$, | $n_{2m} =$ | 0.1339246 | 0.2056653 |
| When $k_2 \geq k_{20}$, | $k_{2m} =$ | 0.2018127 | 0.2031665 |
| When $k_2 < k_{20}$, | $k_{2m} =$ | 0.1244751 | 0.0729272 |
| When $d_2 \geq d_{20}$, | $d_{2m}$ (nm) $=$ | ∞ | ∞ |
| When $d_2 < d_{20}$, | $d_{2m}$ (nm) $=$ | 18.618 | 105.982 |

1. 0 < N A ≤ 1. 1
1 1 5 < T ≤ 1 2 5

| Case | 12-01 | 12-02 | 12-03 | 12-04 | 12-05 |
|---|---|---|---|---|---|
| $n_{10}$ | 1.9729972 | 1.9456051 | 1.9005953 | 1.8972956 | 1.7255330 |
| $k_{10}$ | 0.2768129 | 0.1915481 | 0.1591490 | 0.1121564 | 0.0922673 |
| $d_{10}$ (nm) | 17.524 | 14.612 | 13.217 | 12.290 | 91.102 |
| $n_{20}$ | 1.6663342 | 1.6781309 | 1.6561276 | 1.7051607 | 1.6614760 |
| $k_{20}$ | 0.7544777 | 0.4665054 | 0.3399716 | 0.2822449 | 0.2607016 |
| $d_{20}$ (nm) | 64.842 | 122.845 | 181.593 | 233.141 | 171.070 |

| | | 12-01 | 12-02 | 12-03 | 12-04 | 12-05 |
|---|---|---|---|---|---|---|
| When $n_1 \geq n_{10}$, | $n_{1m} =$ | 0.0730835 | 0.0862573 | 0.1002148 | 0.1132361 | 0.0385791 |
| When $n_1 < n_{10}$, | $n_{1m} =$ | 0.0179053 | 0.0397437 | 0.0650696 | 0.0790137 | 0.0152405 |
| When $k_1 \geq k_{10}$, | $k_{1m} =$ | 0.0247314 | 0.0556897 | 0.0891748 | 0.1035071 | 0.0386047 |
| When $k_1 < k_{10}$, | $k_{1m} =$ | 0.0592480 | 0.0960681 | 0.1016016 | 0.1121564 | 0.0414185 |
| When $d_1 \geq d_{10}$, | $d_{1m}$ (nm) $=$ | 2.961 | 4.145 | 5.266 | 6.373 | 11.328 |
| When $d_1 < d_{10}$, | $d_{1m}$ (nm) $=$ | 0.729 | 1.739 | 3.220 | 4.072 | 3.483 |
| When $n_2 \geq n_{20}$, | $n_{2m} =$ | 0.0585083 | 0.0918945 | 0.1020654 | 0.1070825 | 0.0573608 |
| When $n_2 < n_{20}$, | $n_{2m} =$ | 0.1382239 | 0.1611719 | 0.1504858 | 0.1560303 | 0.0993860 |
| When $k_2 \geq k_{20}$, | $k_{2m} =$ | 0.0616943 | 0.0914514 | 0.0935474 | 0.1016602 | 0.0359058 |
| When $k_2 < k_{20}$, | $k_{2m} =$ | 0.0899731 | 0.0957678 | 0.0910632 | 0.0886353 | 0.0590588 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 11.368 | 38.474 | 71.143 | 98.322 | 22.477 |

1. 0 < N A ≤ 1. 1
1 1 5 < T ≤ 1 2 5

| Case | 12-06 | 12-07 | 12-08 | 12-09 | 12-10 |
|---|---|---|---|---|---|
| $n_{10}$ | 1.7304964 | 1.7097843 | 1.7129025 | 1.7059734 | 1.6983193 |
| $k_{10}$ | 0.0792452 | 0.0770210 | 0.0702809 | 0.0642321 | 0.0712405 |
| $d_{10}$ (nm) | 91.709 | 159.025 | 159.249 | 159.600 | 220.143 |
| $n_{20}$ | 1.7154952 | 1.6841289 | 1.7178163 | 1.6898319 | 1.6860819 |
| $k_{20}$ | 0.2175998 | 0.2392980 | 0.1978132 | 0.1677546 | 0.2336364 |
| $d_{20}$ (nm) | 221.560 | 164.463 | 217.770 | 279.371 | 162.903 |

| | | 12-06 | 12-07 | 12-08 | 12-09 | 12-10 |
|---|---|---|---|---|---|---|
| When $n_1 \geq n_{10}$, | $n_{1m} =$ | 0.0478430 | 0.0358972 | 0.0479553 | 0.0552173 | 0.0579871 |
| When $n_1 < n_{10}$, | $n_{1m} =$ | 0.0188013 | 0.0078589 | 0.0015247 | 0.0299426 | 0.0264917 |
| When $k_1 \geq k_{10}$, | $k_{1m} =$ | 0.0447290 | 0.0214099 | 0.0152087 | 0.0363110 | 0.0340515 |
| When $k_1 < k_{10}$, | $k_{1m} =$ | 0.0430518 | 0.0224402 | 0.0060950 | 0.0278772 | 0.0279150 |
| When $d_1 \geq d_{10}$, | $d_{1m}$ (nm) $=$ | 17.323 | 17.500 | ∞ | ∞ | ∞ |
| When $d_1 < d_{10}$, | $d_{1m}$ (nm) $=$ | 4.626 | 2.208 | 0.436 | 70.406 | 11.462 |
| When $n_2 \geq n_{20}$, | $n_{2m} =$ | 0.0842468 | 0.0631323 | 0.0959070 | 0.1382263 | 0.0682983 |
| When $n_2 < n_{20}$, | $n_{2m} =$ | 0.1172522 | 0.0247583 | 0.0076807 | 0.1296057 | 0.0493762 |
| When $k_2 \geq k_{20}$, | $k_{2m} =$ | 0.0583887 | 0.0111536 | 0.0046545 | 0.0357849 | 0.0882227 |
| When $k_2 < k_{20}$, | $k_{2m} =$ | 0.0618323 | 0.0547961 | 0.0579968 | 0.0540967 | 0.0613330 |
| When $d_2 \geq d_{20}$, | $d_{2m}$ (nm) $=$ | ∞ | 18.428 | ∞ | ∞ | ∞ |
| When $d_2 < d_{20}$, | $d_{2m}$ (nm) $=$ | 65.102 | 5.436 | 0.894 | 57.180 | 18.177 |

1. 0 < N A ≤ 1. 1
1 1 5 < T ≤ 1 2 5

| Case | 12-11 | 12-12 | 12-13 |
|---|---|---|---|
| $n_{10}$ | 1.6946755 | 1.6955425 | 1.6956989 |
| $k_{10}$ | 0.0639503 | 0.0535782 | 0.0539885 |
| $d_{10}$ (nm) | 216.344 | 213.248 | 272.929 |
| $n_{20}$ | 1.6931001 | 1.6937343 | 1.6917939 |
| $k_{20}$ | 0.1919118 | 0.1415462 | 0.1683287 |
| $d_{20}$ (nm) | 222.331 | 338.947 | 278.327 |

| | | 12-11 | 12-12 | 12-13 |
|---|---|---|---|---|
| When $n_1 \geq n_{10}$, | $n_{1m} =$ | 0.0359900 | 0.0869177 | 0.0714185 |
| When $n_1 < n_{10}$, | $n_{1m} =$ | 0.0437024 | 0.0750378 | 0.0538635 |
| When $k_1 \geq k_{10}$, | $k_{1m} =$ | 0.0485352 | 0.0653857 | 0.0669263 |
| When $k_1 < k_{10}$, | $k_{1m} =$ | 0.0346851 | 0.0370959 | 0.0388916 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 51.791 | 132.178 | 120.018 |
| When $n_2 \geq n_{20}$, | $n_{2m} =$ | 0.1409949 | 0.2291467 | 0.2819873 |
| When $n_2 < n_{20}$, | $n_{2m} =$ | 0.1060889 | 0.1273120 | 0.2087952 |
| When $k_2 \geq k_{20}$, | $k_{2m} =$ | 0.1109827 | 0.1363989 | 0.2069556 |
| When $k_2 < k_{20}$, | $k_{2m} =$ | 0.0639978 | 0.0571204 | 0.0743250 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 35.182 | 107.512 | 95.030 |

1. 0 < N A ≤ 1. 1

1 2 5 < T ≤ 1 3 5

| Case | 13-01 | 13-02 | 13-03 | 13-04 | 13-05 |
|---|---|---|---|---|---|
| $n_{10}$ | 1.8993435 | 1.9080238 | 1.7276770 | 1.7338076 | 1.7236449 |
| $k_{10}$ | 0.1093669 | 0.0778133 | 0.0934541 | 0.0808022 | 0.0736298 |
| $d_{10}$ (nm) | 12.638 | 11.189 | 91.210 | 91.869 | 92.640 |
| $n_{20}$ | 1.7156529 | 1.7380285 | 1.6689251 | 1.7256843 | 1.7007078 |
| $k_{20}$ | 0.2903108 | 0.2474831 | 0.2700133 | 0.2232282 | 0.1887087 |
| $d_{20}$ (nm) | 220.942 | 275.866 | 159.348 | 209.944 | 271.148 |

| | | 13-01 | 13-02 | 13-03 | 13-04 | 13-05 |
|---|---|---|---|---|---|---|
| When $n_1 \geq n_{10}$, | $n_{1m} =$ | 0.1116663 | 0.1266492 | 0.0395422 | 0.0484558 | 0.0522583 |
| When $n_1 < n_{10}$, | $n_{1m} =$ | 0.0773999 | 0.0872168 | 0.0167297 | 0.0166711 | 0.0180103 |
| When $k_1 \geq k_{10}$, | $k_{1m} =$ | 0.1011877 | 0.1103088 | 0.0409973 | 0.0422058 | 0.0417761 |
| When $k_1 < k_{10}$, | $k_{1m} =$ | 0.1093669 | 0.0778133 | 0.0410583 | 0.0409119 | 0.0443518 |
| When $d_1 \geq d_{10}$, | $d_{1m}$ (nm) $=$ | 6.392 | 6.737 | 11.272 | 16.895 | 38.105 |
| When $d_1 < d_{10}$, | $d_{1m}$ (nm) $=$ | 4.063 | 4.214 | 3.733 | 3.952 | 5.177 |
| When $n_2 \geq n_{20}$, | $n_{2m} =$ | 0.1069678 | 0.1140796 | 0.0675769 | 0.0924780 | 0.1134937 |
| When $n_2 < n_{20}$, | $n_{2m} =$ | 0.1606714 | 0.1563965 | 0.1033667 | 0.1197949 | 0.1230200 |
| When $k_2 \geq k_{20}$, | $k_{2m} =$ | 0.1040991 | 0.1083496 | 0.0397278 | 0.0600330 | 0.0739392 |
| When $k_2 < k_{20}$, | $k_{2m} =$ | 0.0926990 | 0.0882825 | 0.0652539 | 0.0659766 | 0.0617065 |
| When $d_2 \geq d_{20}$, | $d_{2m}$ (nm) $=$ | ∞ | ∞ | 29.488 | ∞ | ∞ |
| When $d_2 < d_{20}$, | $d_{2m}$ (nm) $=$ | 90.398 | 130.978 | 17.688 | 16.714 | 72.265 |

1. 0 < N A ≤ 1. 1

1 2 5 < T ≤ 1 3 5

| Case | 13-06 | 13-07 | 13-08 | 13-09 | 13-10 |
|---|---|---|---|---|---|
| $n_{10}$ | 1.7117973 | 1.7052523 | 1.6990979 | 1.6936455 | 1.6937228 |
| $k_{10}$ | 0.0782334 | 0.0648564 | 0.0723627 | 0.0657466 | 0.0602088 |
| $d_{10}$ (nm) | 159.412 | 160.141 | 220.761 | 215.539 | 212.854 |
| $n_{20}$ | 1.6949465 | 1.6847092 | 1.6931390 | 1.6916565 | 1.6917935 |
| $k_{20}$ | 0.2480962 | 0.1699839 | 0.2421156 | 0.1962143 | 0.1651159 |
| $d_{20}$ (nm) | 152.577 | 269.827 | 151.650 | 213.597 | 273.449 |

| | | 13-06 | 13-07 | 13-08 | 13-09 | 13-10 |
|---|---|---|---|---|---|---|
| When $n_1 \geq n_{10}$, | $n_{1m} =$ | 0.0367346 | 0.0551233 | 0.0594092 | 0.0311401 | 0.0698511 |
| When $n_1 < n_{10}$, | $n_{1m} =$ | 0.0058984 | 0.0239478 | 0.0244397 | 0.0431714 | 0.0693030 |
| When $k_1 \geq k_{10}$, | $k_{1m} =$ | 0.0206287 | 0.0370862 | 0.0278687 | 0.0476123 | 0.0598901 |
| When $k_1 < k_{10}$, | $k_{1m} =$ | 0.0197803 | 0.0307031 | 0.0272107 | 0.0341650 | 0.0364880 |
| When $d_1 \geq d_{10}$, | $d_{1m}$ (nm) $=$ | 17.175 | ∞ | ∞ | ∞ | ∞ |
| When $d_1 < d_{10}$, | $d_{1m}$ (nm) $=$ | 1.642 | 10.322 | 10.135 | 48.593 | 59.568 |
| When $n_2 \geq n_{20}$, | $n_{2m} =$ | 0.0634509 | 0.0441370 | 0.0646301 | 0.1417163 | 0.2349500 |
| When $n_2 < n_{20}$, | $n_{2m} =$ | 0.0185107 | 0.1268359 | 0.0304773 | 0.0878235 | 0.1413928 |
| When $k_2 \geq k_{20}$, | $k_{2m} =$ | 0.0106982 | 0.0374109 | 0.0871985 | 0.1142444 | 0.1311609 |
| When $k_2 < k_{20}$, | $k_{2m} =$ | 0.0614368 | 0.0554883 | 0.0573535 | 0.0648792 | 0.0616370 |
| When $d_2 \geq d_{20}$, | $d_{2m}$ (nm) $=$ | 20.867 | ∞ | ∞ | ∞ | ∞ |
| When $d_2 < d_{20}$, | $d_{2m}$ (nm) $=$ | 3.236 | 51.950 | 7.977 | 23.183 | 75.250 |

1. 0 < N A ≤ 1. 1
1 2 5 < T ≤ 1 3 5

| Case | 13-11 |
|---|---|
| $n_{10}$ | 1.6954835 |
| $k_{10}$ | 0.0549286 |
| $d_{10}$ (nm) | 272.481 |
| $n_{20}$ | 1.6920522 |
| $k_{20}$ | 0.1709440 |
| $d_{20}$ (nm) | 269.018 |

| | | 13-11 |
|---|---|---|
| When $n_1 \geq n_{10}$, | $n_{1m} =$ | 0.0732507 |
| When $n_1 < n_{10}$, | $n_{1m} =$ | 0.0527002 |
| When $k_1 \geq k_{10}$, | $k_{1m} =$ | 0.0659570 |
| When $k_1 < k_{10}$, | $k_{1m} =$ | 0.0396948 |
| When $d_1 \geq d_{10}$, | $d_{1m}$ (nm) $=$ | ∞ |
| When $d_1 < d_{10}$, | $d_{1m}$ (nm) $=$ | 115.848 |
| When $n_2 \geq n_{20}$, | $n_{2m} =$ | 0.2876270 |
| When $n_2 < n_{20}$, | $n_{2m} =$ | 0.2123071 |
| When $k_2 \geq k_{20}$, | $k_{2m} =$ | 0.2114355 |
| When $k_2 < k_{20}$, | $k_{2m} =$ | 0.0767078 |
| When $d_2 \geq d_{20}$, | $d_{2m}$ (nm) $=$ | ∞ |
| When $d_2 < d_{20}$, | $d_{2m}$ (nm) $=$ | 91.957 |

1. 0 < N A ≤ 1. 1
1 3 5 < T ≤ 1 4 5

| Case | 14-01 | 14-02 | 14-03 | 14-04 | 14-05 |
|---|---|---|---|---|---|
| $n_{10}$ | 1.9117383 | 1.8981283 | 1.9112943 | 1.7312914 | 1.7377087 |
| $k_{10}$ | 0.2302052 | 0.1070787 | 0.0649623 | 0.0945058 | 0.0827928 |
| $d_{10}$ (nm) | 15.980 | 13.384 | 12.163 | 91.544 | 92.151 |
| $n_{20}$ | 1.5953517 | 1.7296497 | 1.7710787 | 1.6819509 | 1.7372931 |
| $k_{20}$ | 0.4940730 | 0.3022759 | 0.2605013 | 0.2846338 | 0.2321492 |
| $d_{20}$ (nm) | 105.368 | 209.053 | 259.824 | 147.702 | 198.983 |

| | | 14-01 | 14-02 | 14-03 | 14-04 | 14-05 |
|---|---|---|---|---|---|---|
| When $n_1 \geq n_{10}$, | $n_{1m} =$ | 0.0781360 | 0.1075745 | 0.1181738 | 0.0408386 | 0.0487402 |
| When $n_1 < n_{10}$, | $n_{1m} =$ | 0.0319177 | 0.0739868 | 0.0809961 | 0.0177930 | 0.0144653 |
| When $k_1 \geq k_{10}$, | $k_{1m} =$ | 0.0436902 | 0.0964282 | 0.0995044 | 0.0430859 | 0.0389966 |
| When $k_1 < k_{10}$, | $k_{1m} =$ | 0.0819202 | 0.1070787 | 0.0649623 | 0.0421533 | 0.0388171 |
| When $d_1 \geq d_{10}$, | $d_{1m}$ (nm) $=$ | 3.898 | 6.524 | 6.747 | 11.475 | 16.758 |
| When $d_1 < d_{10}$, | $d_{1m}$ (nm) $=$ | 1.590 | 4.095 | 4.185 | 3.862 | 3.299 |
| When $n_2 \geq n_{20}$, | $n_{2m} =$ | 0.0627563 | 0.1085400 | 0.1152271 | 0.0712305 | 0.0983997 |
| When $n_2 < n_{20}$, | $n_{2m} =$ | 0.1565955 | 0.1599133 | 0.1627686 | 0.1038867 | 0.1174939 |
| When $k_2 \geq k_{20}$, | $k_{2m} =$ | 0.0810010 | 0.1085132 | 0.1160754 | 0.0447900 | 0.0617737 |
| When $k_2 < k_{20}$, | $k_{2m} =$ | 0.1061572 | 0.0966113 | 0.0915161 | 0.0720264 | 0.0692358 |
| When $d_2 \geq d_{20}$, | $d_{2m}$ (nm) $=$ | ∞ | ∞ | ∞ | 26.800 | ∞ |
| When $d_2 < d_{20}$, | $d_{2m}$ (nm) $=$ | 27.538 | 81.885 | 123.147 | 14.572 | 12.208 |

1. 0 < N A ≤ 1. 1
1 3 5 < T ≤ 1 4 5

| Case | 14-06 | 14-07 | 14-08 | 14-09 | 14-10 |
|---|---|---|---|---|---|
| $n_{10}$ | 1.7228203 | 1.7144911 | 1.7050797 | 1.6925663 | 1.6991742 |
| $k_{10}$ | 0.0749158 | 0.0796518 | 0.0657099 | 0.0675694 | 0.0739382 |
| $d_{10}$ (nm) | 92.874 | 160.015 | 160.534 | 214.049 | 220.936 |
| $n_{20}$ | 1.6951594 | 1.7090445 | 1.6817729 | 1.6900690 | 1.6992675 |
| $k_{20}$ | 0.1935801 | 0.2610315 | 0.1743389 | 0.2005073 | 0.2525134 |
| $d_{20}$ (nm) | 262.590 | 141.223 | 260.739 | 206.287 | 141.832 |

| | | 14-06 | 14-07 | 14-08 | 14-09 | 14-10 |
|---|---|---|---|---|---|---|
| When $n_1 \geq n_{10}$, | $n_{1n} =$ | 0.0517419 | 0.0380176 | 0.0550000 | 0.0300269 | 0.0099573 |
| When $n_1 < n_{10}$, | $n_{1n} =$ | 0.0171826 | 0.0033435 | 0.0205762 | 0.0461255 | 0.0255640 |
| When $k_1 \geq k_{10}$, | $k_{1n} =$ | 0.0402747 | 0.0176941 | 0.0369080 | 0.0452966 | 0.0196790 |
| When $k_1 < k_{10}$, | $k_{1n} =$ | 0.0440662 | 0.0145313 | 0.0289917 | 0.0339844 | 0.0188269 |
| When $d_1 \geq d_{10}$, | $d_{1n}$ (nm) $=$ | 34.339 | 18.702 | ∞ | ∞ | ∞ |
| When $d_1 < d_{10}$, | $d_{1n}$ (nm) $=$ | 4.946 | 0.924 | 8.433 | 45.536 | 10.412 |
| When $n_2 \geq n_{20}$, | $n_{2n} =$ | 0.1089246 | 0.0638684 | 0.0364478 | 0.1628357 | 0.0605127 |
| When $n_2 < n_{20}$, | $n_{2n} =$ | 0.1178552 | 0.0117664 | 0.1214197 | 0.0809363 | 0.0143933 |
| When $k_2 \geq k_{20}$, | $k_{2n} =$ | 0.0721460 | 0.0078210 | 0.0372485 | 0.1200403 | 0.0864673 |
| When $k_2 < k_{20}$, | $k_{2n} =$ | 0.0629919 | 0.0624194 | 0.0562036 | 0.0635217 | 0.0436145 |
| When $d_2 \geq d_{20}$, | $d_{2n}$ (nm) $=$ | ∞ | 21.562 | ∞ | ∞ | 25.612 |
| When $d_2 < d_{20}$, | $d_{2n}$ (nm) $=$ | 67.089 | 1.645 | 48.128 | 21.535 | 3.107 |

1. 0 < N A ≤ 1. 1
1 3 5 < T ≤ 1 4 5

| Case | 14-11 | 14-12 |
|---|---|---|
| $n_{10}$ | 1.6955775 | 1.6953573 |
| $k_{10}$ | 0.0548747 | 0.0556511 |
| $d_{10}$ (nm) | 213.500 | 272.231 |
| $n_{20}$ | 1.6934763 | 1.6917841 |
| $k_{20}$ | 0.1457299 | 0.1736649 |
| $d_{20}$ (nm) | 319.743 | 260.476 |

| | | 14-11 | 14-12 |
|---|---|---|---|
| When $n_1 \geq n_{10}$, | $n_{1n} =$ | 0.0884082 | 0.0714819 |
| When $n_1 < n_{10}$, | $n_{1n} =$ | 0.0760022 | 0.0518335 |
| When $k_1 \geq k_{10}$, | $k_{1n} =$ | 0.0634009 | 0.0652063 |
| When $k_1 < k_{10}$, | $k_{1n} =$ | 0.0349133 | 0.0395740 |
| When $d_1 \geq d_{10}$, | $d_{1n}$ (nm) $=$ | ∞ | ∞ |
| When $d_1 < d_{10}$, | $d_{1n}$ (nm) $=$ | 128.996 | 113.518 |
| When $n_2 \geq n_{20}$, | $n_{2n} =$ | 0.2359680 | 0.2895325 |
| When $n_2 < n_{20}$, | $n_{2n} =$ | 0.1212769 | 0.2158911 |
| When $k_2 \geq k_{20}$, | $k_{2n} =$ | 0.1345789 | 0.2124060 |
| When $k_2 < k_{20}$, | $k_{2n} =$ | 0.0582837 | 0.0793396 |
| When $d_2 \geq d_{20}$, | $d_{2n}$ (nm) $=$ | ∞ | ∞ |
| When $d_2 < d_{20}$, | $d_{2n}$ (nm) $=$ | 94.216 | 91.728 |

1. $0 < NA \leq 1.1$
$145 < T \leq 155$

| Case | 15-01 | 15-02 | 15-03 | 15-04 | 15-05 |
|---|---|---|---|---|---|
| $n_{10}$ | 1.8842999 | 1.9020060 | 1.9176161 | 1.7347347 | 1.7402087 |
| $k_{10}$ | 0.1660082 | 0.1078045 | 0.0733974 | 0.0970436 | 0.0854812 |
| $d_{10}$ (nm) | 15.542 | 13.884 | 11.927 | 91.613 | 92.221 |
| $n_{20}$ | 1.6642092 | 1.7406676 | 1.7608162 | 1.6897518 | 1.7427648 |
| $k_{20}$ | 0.3881866 | 0.3180988 | 0.2687301 | 0.3028107 | 0.2437105 |
| $d_{20}$ (nm) | 148.595 | 199.025 | 254.127 | 138.166 | 190.058 |

| | | 15-01 | 15-02 | 15-03 | 15-04 | 15-05 |
|---|---|---|---|---|---|---|
| When $n_1 \geq n_{10}$, | $n_{1m} =$ | 0.0902356 | 0.1039673 | 0.1191321 | 0.0403284 | 0.0477295 |
| When $n_1 < n_{10}$, | $n_{1m} =$ | 0.0608057 | 0.0712415 | 0.0806982 | 0.0168616 | 0.0123145 |
| When $k_1 \geq k_{10}$, | $k_{1m} =$ | 0.0796985 | 0.0922314 | 0.1003394 | 0.0414099 | 0.0352649 |
| When $k_1 < k_{10}$, | $k_{1m} =$ | 0.0913672 | 0.1040308 | 0.0733974 | 0.0415906 | 0.0369519 |
| When $d_1 \geq d_{10}$, | $d_{1m}$ (nm) $=$ | 5.569 | 6.401 | 6.478 | 11.141 | 16.036 |
| When $d_1 < d_{10}$, | $d_{1m}$ (nm) $=$ | 3.524 | 3.984 | 3.954 | 3.546 | 2.715 |
| When $n_2 \geq n_{20}$, | $n_{2m} =$ | 0.0975891 | 0.1093347 | 0.1166919 | 0.0721533 | 0.0993201 |
| When $n_2 < n_{20}$, | $n_{2m} =$ | 0.1510022 | 0.1570532 | 0.1613013 | 0.0996582 | 0.1116626 |
| When $k_2 \geq k_{20}$, | $k_{2m} =$ | 0.1021082 | 0.1115308 | 0.1139111 | 0.0446167 | 0.0576575 |
| When $k_2 < k_{20}$, | $k_{2m} =$ | 0.1042151 | 0.0981909 | 0.0922217 | 0.0735095 | 0.0699536 |
| When $d_2 \geq d_{20}$, | $d_{2m}$ (nm) $=$ | $\infty$ | $\infty$ | $\infty$ | 23.089 | $\infty$ |
| When $d_2 < d_{20}$, | $d_{2m}$ (nm) $=$ | 36.178 | 75.817 | 118.717 | 13.060 | 9.872 |

1. $0 < NA \leq 1.1$
$145 < T \leq 155$

| Case | 15-06 | 15-07 | 15-08 | 15-09 | 15-10 |
|---|---|---|---|---|---|
| $n_{10}$ | 1.7232674 | 1.7163169 | 1.7052425 | 1.6979604 | 1.6919325 |
| $k_{10}$ | 0.0768076 | 0.0822242 | 0.0670983 | 0.0765182 | 0.0693101 |
| $d_{10}$ (nm) | 92.842 | 160.121 | 160.367 | 219.964 | 212.895 |
| $n_{20}$ | 1.6931409 | 1.7162208 | 1.6808978 | 1.6978817 | 1.6886216 |
| $k_{20}$ | 0.2010537 | 0.2770503 | 0.1806066 | 0.2641846 | 0.2063377 |
| $d_{20}$ (nm) | 254.319 | 132.120 | 252.327 | 134.431 | 199.162 |

| | | 15-06 | 15-07 | 15-08 | 15-09 | 15-10 |
|---|---|---|---|---|---|---|
| When $n_1 \geq n_{10}$, | $n_{1m} =$ | 0.0505859 | 0.0375513 | 0.0535669 | 0.0055981 | 0.0297021 |
| When $n_1 < n_{10}$, | $n_{1m} =$ | 0.0155139 | 0.0002051 | 0.0181250 | 0.0232141 | 0.0494775 |
| When $k_1 \geq k_{10}$, | $k_{1m} =$ | 0.0378564 | 0.0051208 | 0.0335376 | 0.0146118 | 0.0441443 |
| When $k_1 < k_{10}$, | $k_{1m} =$ | 0.0427637 | 0.0032507 | 0.0275378 | 0.0178613 | 0.0327478 |
| When $d_1 \geq d_{10}$, | $d_{1m}$ (nm) $=$ | 33.581 | 19.229 | $\infty$ | 4.817 | $\infty$ |
| When $d_1 < d_{10}$, | $d_{1m}$ (nm) $=$ | 4.347 | 0.056 | 6.999 | 10.286 | 43.553 |
| When $n_2 \geq n_{20}$, | $n_{2m} =$ | 0.0760803 | 0.0599353 | 0.0299109 | 0.0539575 | 0.2378027 |
| When $n_2 < n_{20}$, | $n_{2m} =$ | 0.1135510 | 0.0008435 | 0.1135376 | 0.0106042 | 0.0839368 |
| When $k_2 \geq k_{20}$, | $k_{2m} =$ | 0.0671289 | 0.0005420 | 0.0313745 | 0.0886438 | 0.1159473 |
| When $k_2 < k_{20}$, | $k_{2m} =$ | 0.0634387 | 0.0680176 | 0.0561853 | 0.0306653 | 0.0671289 |
| When $d_2 \geq d_{20}$, | $d_{2m}$ (nm) $=$ | $\infty$ | 12.405 | $\infty$ | 21.650 | $\infty$ |
| When $d_2 < d_{20}$, | $d_{2m}$ (nm) $=$ | 64.219 | 0.105 | 32.640 | 2.145 | 24.441 |

1. $0 < NA \leq 1.1$
$145 < T \leq 155$

| Case | 15-11 | 15-12 |
|---|---|---|
| $n_{10}$ | 1.6933082 | 1.6953110 |
| $k_{10}$ | 0.0619759 | 0.0563706 |
| $d_{10}$ (nm) | 212.839 | 272.392 |
| $n_{20}$ | 1.6904544 | 1.6905212 |
| $k_{20}$ | 0.1723582 | 0.1778331 |
| $d_{20}$ (nm) | 255.647 | 252.170 |

| | | 15-11 | 15-12 |
|---|---|---|---|
| When $n_1 \geq n_{10}$, | $n_{1m} =$ | 0.0645605 | 0.0686462 |
| When $n_1 < n_{10}$, | $n_{1m} =$ | 0.0718213 | 0.0516125 |
| When $k_1 \geq k_{10}$, | $k_{1m} =$ | 0.0578125 | 0.0646021 |
| When $k_1 < k_{10}$, | $k_{1m} =$ | 0.0349402 | 0.0400220 |
| When $d_1 \geq d_{10}$, | $d_{1m}$ (nm) $=$ | $\infty$ | $\infty$ |
| When $d_1 < d_{10}$, | $d_{1m}$ (nm) $=$ | 54.857 | 112.777 |
| When $n_2 \geq n_{20}$, | $n_{2m} =$ | 0.2345605 | 0.2885852 |
| When $n_2 < n_{20}$, | $n_{2m} =$ | 0.1388916 | 0.2180322 |
| When $k_2 \geq k_{20}$, | $k_{2m} =$ | 0.1280078 | 0.2117786 |
| When $k_2 < k_{20}$, | $k_{2m} =$ | 0.0658081 | 0.0782971 |
| When $d_2 \geq d_{20}$, | $d_{2m}$ (nm) $=$ | $\infty$ | $\infty$ |
| When $d_2 < d_{20}$, | $d_{2m}$ (nm) $=$ | 73.297 | 86.154 |

1. $0 < NA \leq 1.1$
$155 < T \leq 165$

| Case | 16-01 | 16-02 | 16-03 | 16-04 | 16-05 |
|---|---|---|---|---|---|
| $n_{10}$ | 1.9162825 | 1.8960663 | 1.9085468 | 1.9232010 | 1.7368663 |
| $k_{10}$ | 0.2485644 | 0.1719364 | 0.1144956 | 0.0848488 | 0.1019026 |
| $d_{10}$ (nm) | 18.297 | 15.704 | 13.923 | 11.624 | 91.322 |
| $n_{20}$ | 1.6104232 | 1.6708316 | 1.7385514 | 1.7455678 | 1.6869885 |
| $k_{20}$ | 0.6165991 | 0.4169686 | 0.3337318 | 0.2771185 | 0.3224919 |
| $d_{20}$ (nm) | 83.442 | 139.520 | 191.444 | 248.983 | 130.342 |

| | | 16-01 | 16-02 | 16-03 | 16-04 | 16-05 |
|---|---|---|---|---|---|---|
| When $n_1 \geq n_{10}$, | $n_{1m} =$ | 0.0684412 | 0.0871606 | 0.1018298 | 0.1200745 | 0.0372510 |
| When $n_1 < n_{10}$, | $n_{1m} =$ | 0.0186816 | 0.0568530 | 0.0690649 | 0.0803638 | 0.0125696 |
| When $k_1 \geq k_{10}$, | $k_{1m} =$ | 0.0233801 | 0.0734265 | 0.0893420 | 0.1020142 | 0.0332275 |
| When $k_1 < k_{10}$, | $k_{1m} =$ | 0.0710925 | 0.0921472 | 0.1049048 | 0.0848488 | 0.0396851 |
| When $d_1 \geq d_{10}$, | $d_{1m}$ (nm) $=$ | 3.544 | 5.170 | 6.051 | 6.159 | 10.019 |
| When $d_1 < d_{10}$, | $d_{1m}$ (nm) $=$ | 0.960 | 3.162 | 3.726 | 3.719 | 2.554 |
| When $n_2 \geq n_{20}$, | $n_{2m} =$ | 0.0392468 | 0.0938416 | 0.1080847 | 0.1165613 | 0.0639832 |
| When $n_2 < n_{20}$, | $n_{2m} =$ | 0.1557959 | 0.1481714 | 0.1540210 | 0.1601440 | 0.0923059 |
| When $k_2 \geq k_{20}$, | $k_{2m} =$ | 0.0796021 | 0.1023108 | 0.1103064 | 0.1095667 | 0.0344885 |
| When $k_2 < k_{20}$, | $k_{2m} =$ | 0.1143958 | 0.1026965 | 0.0973987 | 0.0917590 | 0.0690210 |
| When $d_2 \geq d_{20}$, | $d_{2m}$ (nm) $=$ | $\infty$ | $\infty$ | $\infty$ | $\infty$ | 16.255 |
| When $d_2 < d_{20}$, | $d_{2m}$ (nm) $=$ | 16.079 | 31.215 | 71.737 | 92.392 | 12.361 |

1. 0 < N A ≦ 1. 1
1 5 5 < T ≦ 1 6 5

| Case | 16-06 | 16-07 | 16-08 | 16-09 | 16-10 |
|---|---|---|---|---|---|
| $n_{10}$ | 1.7401611 | 1.7243481 | 1.7054586 | 1.6959475 | 1.6918299 |
| $k_{10}$ | 0.0886217 | 0.0791015 | 0.0688139 | 0.0801582 | 0.0707672 |
| $d_{10}$ (nm) | 92.017 | 92.538 | 159.721 | 218.084 | 213.401 |
| $n_{20}$ | 1.7381402 | 1.6930588 | 1.6812702 | 1.6891859 | 1.6865968 |
| $k_{20}$ | 0.2555882 | 0.2092609 | 0.1871719 | 0.2763746 | 0.2143676 |
| $d_{20}$ (nm) | 182.755 | 245.988 | 244.029 | 128.431 | 190.286 |

| | | 16-06 | 16-07 | 16-08 | 16-09 | 16-10 |
|---|---|---|---|---|---|---|
| When $n_1 \geq n_{10}$, | $n_{1m} =$ | 0.0455261 | 0.0488196 | 0.0509851 | 0.0098682 | 0.0278625 |
| When $n_1 < n_{10}$, | $n_{1m} =$ | 0.0098901 | 0.0131677 | 0.0163489 | 0.0140930 | 0.0421411 |
| When $k_1 \geq k_{10}$, | $k_{1m} =$ | 0.0306140 | 0.0345203 | 0.0271167 | 0.0171570 | 0.0425635 |
| When $k_1 < k_{10}$, | $k_{1m} =$ | 0.0347180 | 0.0404199 | 0.0257288 | 0.0171082 | 0.0318542 |
| When $d_1 \geq d_{10}$, | $d_{1m}$ (nm) $=$ | 14.632 | 33.648 | ∞ | 8.318 | ∞ |
| When $d_1 < d_{10}$, | $d_{1m}$ (nm) $=$ | 2.133 | 3.535 | 5.969 | 6.525 | 43.306 |
| When $n_2 \geq n_{20}$, | $n_{2m} =$ | 0.0895227 | 0.0573254 | 0.0211304 | 0.0441309 | 0.2430603 |
| When $n_2 < n_{20}$, | $n_{2m} =$ | 0.1067090 | 0.1098926 | 0.1107275 | 0.0233423 | 0.0869226 |
| When $k_2 \geq k_{20}$, | $k_{2m} =$ | 0.0460217 | 0.0587354 | 0.0210486 | 0.0642297 | 0.1089050 |
| When $k_2 < k_{20}$, | $k_{2m} =$ | 0.0680432 | 0.0628845 | 0.0551514 | 0.0464880 | 0.0738831 |
| When $d_2 \geq d_{20}$, | $d_{2m}$ (nm) $=$ | ∞ | ∞ | ∞ | 19.572 | ∞ |
| When $d_2 < d_{20}$, | $d_{2m}$ (nm) $=$ | 8.553 | 37.425 | 30.745 | 5.059 | 27.273 |

1. 0 < N A ≦ 1. 1
1 5 5 < T ≦ 1 6 5

| Case | 16-11 | 16-12 |
|---|---|---|
| $n_{10}$ | 1.6935501 | 1.6953216 |
| $k_{10}$ | 0.0625258 | 0.0573372 |
| $d_{10}$ (nm) | 213.666 | 272.694 |
| $n_{20}$ | 1.6897170 | 1.6885432 |
| $k_{20}$ | 0.1780108 | 0.1839003 |
| $d_{20}$ (nm) | 246.097 | 243.579 |

| | | 16-11 | 16-12 |
|---|---|---|---|
| When $n_1 \geq n_{10}$, | $n_{1m} =$ | 0.0658508 | 0.0696008 |
| When $n_1 < n_{10}$, | $n_{1m} =$ | 0.0609790 | 0.0519751 |
| When $k_1 \geq k_{10}$, | $k_{1m} =$ | 0.0564087 | 0.0639087 |
| When $k_1 < k_{10}$, | $k_{1m} =$ | 0.0340259 | 0.0390979 |
| When $d_1 \geq d_{10}$, | $d_{1m}$ (nm) $=$ | ∞ | ∞ |
| When $d_1 < d_{10}$, | $d_{1m}$ (nm) $=$ | 55.431 | 113.126 |
| When $n_2 \geq n_{20}$, | $n_{2m} =$ | 0.2425122 | 0.2917029 |
| When $n_2 < n_{20}$, | $n_{2m} =$ | 0.1355713 | 0.2189172 |
| When $k_2 \geq k_{20}$, | $k_{2m} =$ | 0.1230981 | 0.2089771 |
| When $k_2 < k_{20}$, | $k_{2m} =$ | 0.0647131 | 0.0785583 |
| When $d_2 \geq d_{20}$, | $d_{2m}$ (nm) $=$ | ∞ | ∞ |
| When $d_2 < d_{20}$, | $d_{2m}$ (nm) $=$ | 74.519 | 83.205 |

1. 0 < N A ≤ 1. 1
1 6 5 < T ≤ 1 7 5

| Case | 17-01 | 17-02 | 17-03 | 17-04 | 17-05 |
|---|---|---|---|---|---|
| $n_{10}$ | 1.9620125 | 1.9138120 | 1.9194872 | 1.9263431 | 1.7366416 |
| $k_{10}$ | 0.2671830 | 0.1838008 | 0.1265886 | 0.0918160 | 0.1083929 |
| $d_{10}$ (nm) | 17.281 | 15.160 | 13.286 | 11.575 | 90.600 |
| $n_{20}$ | 1.6251877 | 1.6631095 | 1.7204546 | 1.7389610 | 1.6676220 |
| $k_{20}$ | 0.6875073 | 0.4399257 | 0.3440475 | 0.2853240 | 0.3363185 |
| $d_{20}$ (nm) | 75.420 | 132.541 | 186.036 | 241.421 | 124.136 |

| | | 17-01 | 17-02 | 17-03 | 17-04 | 17-05 |
|---|---|---|---|---|---|---|
| When $n_1 \geq n_{10}$, | $n_{1m} =$ | 0.0681287 | 0.0852625 | 0.1025696 | 0.1184741 | 0.0323010 |
| When $n_1 < n_{10}$, | $n_{1m} =$ | 0.0103625 | 0.0516760 | 0.0678894 | 0.0788623 | 0.0048279 |
| When $k_1 \geq k_{10}$, | $k_{1m} =$ | 0.0130603 | 0.0684912 | 0.0894849 | 0.1012756 | 0.0174634 |
| When $k_1 < k_{10}$, | $k_{1m} =$ | 0.0671069 | 0.0945691 | 0.1086621 | 0.0918160 | 0.0305151 |
| When $d_1 \geq d_{10}$, | $d_{1m}$ (nm) = | 3.029 | 4.576 | 5.503 | 5.915 | 7.890 |
| When $d_1 < d_{10}$, | $d_{1m}$ (nm) = | 0.441 | 2.597 | 3.327 | 3.560 | 0.944 |
| When $n_2 \geq n_{20}$, | $n_{2m} =$ | 0.0235046 | 0.0887256 | 0.1055566 | 0.1147229 | 0.0355994 |
| When $n_2 < n_{20}$, | $n_{2m} =$ | 0.1565857 | 0.1459790 | 0.1532703 | 0.1591589 | 0.0840686 |
| When $k_2 \geq k_{20}$, | $k_{2m} =$ | 0.0495569 | 0.0950366 | 0.1036096 | 0.1065601 | 0.0135376 |
| When $k_2 < k_{20}$, | $k_{2m} =$ | 0.1038318 | 0.0972864 | 0.0941003 | 0.0904578 | 0.0586487 |
| When $d_2 \geq d_{20}$, | $d_{2m}$ (nm) = | ∞ | ∞ | ∞ | ∞ | 9.834 |
| When $d_2 < d_{20}$, | $d_{2m}$ (nm) = | 13.490 | 32.564 | 69.289 | 94.292 | 9.844 |

1. 0 < N A ≤ 1. 1
1 6 5 < T ≤ 1 7 5

| Case | 17-06 | 17-07 | 17-08 | 17-09 | 17-10 |
|---|---|---|---|---|---|
| $n_{10}$ | 1.7377165 | 1.7250070 | 1.7054487 | 1.6921136 | 1.6937452 |
| $k_{10}$ | 0.0918810 | 0.0812670 | 0.0704565 | 0.0719896 | 0.0634118 |
| $d_{10}$ (nm) | 91.516 | 92.096 | 158.889 | 214.506 | 214.086 |
| $n_{20}$ | 1.7225143 | 1.6922454 | 1.6815182 | 1.6833735 | 1.6893106 |
| $k_{20}$ | 0.2640565 | 0.2155950 | 0.1921887 | 0.2231205 | 0.1840166 |
| $d_{20}$ (nm) | 176.484 | 237.445 | 235.428 | 180.418 | 236.602 |

| | | 17-06 | 17-07 | 17-08 | 17-09 | 17-10 |
|---|---|---|---|---|---|---|
| When $n_1 \geq n_{10}$, | $n_{1m} =$ | 0.0420569 | 0.0467627 | 0.0482849 | 0.0256970 | 0.0615491 |
| When $n_1 < n_{10}$, | $n_{1m} =$ | 0.0067480 | 0.0110010 | 0.0145544 | 0.0346619 | 0.0533179 |
| When $k_1 \geq k_{10}$, | $k_{1m} =$ | 0.0242395 | 0.0311426 | 0.0191064 | 0.0402332 | 0.0548975 |
| When $k_1 < k_{10}$, | $k_{1m} =$ | 0.0306030 | 0.0379785 | 0.0179834 | 0.0315259 | 0.0339990 |
| When $d_1 \geq d_{10}$, | $d_{1m}$ (nm) = | 13.053 | 20.074 | ∞ | ∞ | ∞ |
| When $d_1 < d_{10}$, | $d_{1m}$ (nm) = | 1.437 | 2.846 | 5.076 | 44.014 | 52.355 |
| When $n_2 \geq n_{20}$, | $n_{2m} =$ | 0.0699756 | 0.0474695 | 0.0119531 | 0.2616345 | 0.2513293 |
| When $n_2 < n_{20}$, | $n_{2m} =$ | 0.1027979 | 0.1100684 | 0.1104504 | 0.0766565 | 0.1353430 |
| When $k_2 \geq k_{20}$, | $k_{2m} =$ | 0.0294397 | 0.0490112 | 0.0106458 | 0.1033704 | 0.1166565 |
| When $k_2 < k_{20}$, | $k_{2m} =$ | 0.0637073 | 0.0613086 | 0.0537012 | 0.0738440 | 0.0656140 |
| When $d_2 \geq d_{20}$, | $d_{2m}$ (nm) = | ∞ | ∞ | 5.139 | ∞ | ∞ |
| When $d_2 < d_{20}$, | $d_{2m}$ (nm) = | 7.091 | 63.320 | 32.177 | 24.892 | 75.277 |

1. 0 < N A ≤ 1. 1
1 6 5 < T ≤ 1 7 5

| Case | 17–11 | 17–12 |
|---|---|---|
| $n_{10}$ | 1.6937402 | 1.6958036 |
| $k_{10}$ | 0.0634247 | 0.0530688 |
| $d_{10}$ (nm) | 214.067 | 271.703 |
| $n_{20}$ | 1.6892020 | 1.6918593 |
| $k_{20}$ | 0.1839903 | 0.1637010 |
| $d_{20}$ (nm) | 236.644 | 291.452 |

| | | 17–11 | 17–12 |
|---|---|---|---|
| When $n_1 \geq n_{10}$, | $n_{1m} =$ | 0.0614392 | 0.0799048 |
| When $n_1 < n_{10}$, | $n_{1m} =$ | 0.0533545 | 0.0613391 |
| When $k_1 \geq k_{10}$, | $k_{1m} =$ | 0.0548865 | 0.0657874 |
| When $k_1 < k_{10}$, | $k_{1m} =$ | 0.0340295 | 0.0406555 |
| When $d_1 \geq d_{10}$, | $d_{1m}$ (nm) $=$ | ∞ | ∞ |
| When $d_1 < d_{10}$, | $d_{1m}$ (nm) $=$ | 52.349 | 186.337 |
| When $n_2 \geq n_{20}$, | $n_{2m} =$ | 0.2512048 | 0.2852795 |
| When $n_2 < n_{20}$, | $n_{2m} =$ | 0.1353552 | 0.2060364 |
| When $k_2 \geq k_{20}$, | $k_{2m} =$ | 0.1167688 | 0.2088965 |
| When $k_2 < k_{20}$, | $k_{2m} =$ | 0.0656104 | 0.0720715 |
| When $d_2 \geq d_{20}$, | $d_{2m}$ (nm) $=$ | ∞ | ∞ |
| When $d_2 < d_{20}$, | $d_{2m}$ (nm) $=$ | 75.294 | 119.308 |

1. 0 < N A ≤ 1. 1
1 7 5 < T ≤ 1 8 5

| Case | 18–01 | 18–02 | 18–03 | 18–04 | 18–05 |
|---|---|---|---|---|---|
| $n_{10}$ | 2.0247974 | 1.9282935 | 1.9213955 | 1.9262173 | 1.7355101 |
| $k_{10}$ | 0.2830183 | 0.1992550 | 0.1387890 | 0.1063571 | 0.0947091 |
| $d_{10}$ (nm) | 15.097 | 14.428 | 13.062 | 11.253 | 91.033 |
| $n_{20}$ | 1.6266898 | 1.6428403 | 1.7027750 | 1.7173021 | 1.7079959 |
| $k_{20}$ | 0.7191283 | 0.4517072 | 0.3507816 | 0.2869739 | 0.2693832 |
| $d_{20}$ (nm) | 71.681 | 126.823 | 179.475 | 236.027 | 169.192 |

| | | 18–01 | 18–02 | 18–03 | 18–04 | 18–05 |
|---|---|---|---|---|---|---|
| When $n_1 \geq n_{10}$, | $n_{1m} =$ | 0.0749963 | 0.0847278 | 0.1010168 | 0.1197595 | 0.0387598 |
| When $n_1 < n_{10}$, | $n_{1m} =$ | 0.0029248 | 0.0471021 | 0.0652051 | 0.0785376 | 0.0037976 |
| When $k_1 \geq k_{10}$, | $k_{1m} =$ | 0.0038599 | 0.0655127 | 0.0884351 | 0.1039075 | 0.0170227 |
| When $k_1 < k_{10}$, | $k_{1m} =$ | 0.0706714 | 0.0951611 | 0.1067810 | 0.1063571 | 0.0250378 |
| When $d_1 \geq d_{10}$, | $d_{1m}$ (nm) $=$ | 2.365 | 4.047 | 5.170 | 5.710 | 10.979 |
| When $d_1 < d_{10}$, | $d_{1m}$ (nm) $=$ | 0.098 | 2.142 | 3.074 | 3.403 | 0.799 |
| When $n_2 \geq n_{20}$, | $n_{2m} =$ | 0.0068848 | 0.0841113 | 0.1036328 | 0.1139966 | 0.0477551 |
| When $n_2 < n_{20}$, | $n_{2m} =$ | 0.1606787 | 0.1462891 | 0.1534180 | 0.1596240 | 0.1042908 |
| When $k_2 \geq k_{20}$, | $k_{2m} =$ | 0.0111658 | 0.0845300 | 0.0979260 | 0.1010864 | 0.0158423 |
| When $k_2 < k_{20}$, | $k_{2m} =$ | 0.0939917 | 0.0914209 | 0.0916113 | 0.0894141 | 0.0611707 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 3.000 | 39.175 | 67.597 | 105.537 | 4.807 |

1. 0 < N A ≤ 1. 1
1 7 5 < T ≤ 1 8 5

| Case | 18–06 | 18–07 | 18–08 | 18–09 | 18–10 |
|---|---|---|---|---|---|
| $n_{10}$ | 1.7251933 | 1.7054174 | 1.6937830 | 1.6952847 | 1.6957027 |
| $k_{10}$ | 0.0829804 | 0.0718367 | 0.0647049 | 0.0582261 | 0.0542195 |
| $d_{10}$ (nm) | 91.728 | 158.389 | 214.330 | 213.359 | 271.586 |
| $n_{20}$ | 1.6903561 | 1.6812041 | 1.6889835 | 1.6934588 | 1.6918383 |
| $k_{20}$ | 0.2192539 | 0.1954390 | 0.1894046 | 0.1611341 | 0.1679902 |
| $d_{20}$ (nm) | 228.367 | 226.084 | 226.812 | 284.005 | 281.728 |

| | | 18–06 | 18–07 | 18–08 | 18–09 | 18–10 |
|---|---|---|---|---|---|---|
| When $n_1 \geq n_{10}$, | $n_{1m} =$ | 0.0450793 | 0.0463184 | 0.0575061 | 0.0820801 | 0.0778577 |
| When $n_1 < n_{10}$, | $n_{1m} =$ | 0.0094861 | 0.0044336 | 0.0478479 | 0.0612256 | 0.0602185 |
| When $k_1 \geq k_{10}$, | $k_{1m} =$ | 0.0283801 | 0.0117395 | 0.0529968 | 0.0602039 | 0.0649841 |
| When $k_1 < k_{10}$, | $k_{1m} =$ | 0.0362878 | 0.0115625 | 0.0337854 | 0.0347266 | 0.0400525 |
| When $d_1 \geq d_{10}$, | $d_{1m}$ (nm) = | 16.774 | ∞ | ∞ | ∞ | ∞ |
| When $d_1 < d_{10}$, | $d_{1m}$ (nm) = | 2.397 | 1.386 | 50.875 | 126.709 | 185.173 |
| When $n_2 \geq n_{20}$, | $n_{2m} =$ | 0.0407971 | 0.0052539 | 0.2620386 | 0.2460583 | 0.2888794 |
| When $n_2 < n_{20}$, | $n_{2m} =$ | 0.1134692 | 0.1157361 | 0.1359692 | 0.1267810 | 0.2086084 |
| When $k_2 \geq k_{20}$, | $k_{2m} =$ | 0.0417627 | 0.0042761 | 0.1123547 | 0.1276489 | 0.2100842 |
| When $k_2 < k_{20}$, | $k_{2m} =$ | 0.0604272 | 0.0538147 | 0.0667053 | 0.0613220 | 0.0762817 |
| When $d_2 \geq d_{20}$, | $d_{2m}$ (nm) = | ∞ | 1.973 | ∞ | ∞ | ∞ |
| When $d_2 < d_{20}$, | $d_{2m}$ (nm) = | 63.259 | 35.408 | 73.536 | 81.916 | 101.090 |

1. 0 < N A ≤ 1. 1
1 8 5 < T ≤ 1 9 5

| Case | 19–01 | 19–02 | 19–03 | 19–04 | 19–05 |
|---|---|---|---|---|---|
| $n_{10}$ | 1.9316549 | 1.9193011 | 1.9209840 | 1.9114684 | 1.7364379 |
| $k_{10}$ | 0.2158025 | 0.1476126 | 0.1061325 | 0.1024475 | 0.0969838 |
| $d_{10}$ (nm) | 14.297 | 13.272 | 11.842 | 10.224 | 91.033 |
| $n_{20}$ | 1.6202378 | 1.6935029 | 1.7241227 | 1.6976483 | 1.7085420 |
| $k_{20}$ | 0.4645248 | 0.3598725 | 0.2946413 | 0.2438294 | 0.2774318 |
| $d_{20}$ (nm) | 119.165 | 170.049 | 224.030 | 285.021 | 158.680 |

| | | 19–01 | 19–02 | 19–03 | 19–04 | 19–05 |
|---|---|---|---|---|---|---|
| When $n_1 \geq n_{10}$, | $n_{1m} =$ | 0.0819873 | 0.0986853 | 0.1146375 | 0.1344971 | 0.0375342 |
| When $n_1 < n_{10}$, | $n_{1m} =$ | 0.0431250 | 0.0625305 | 0.0746716 | 0.0933276 | 0.0023010 |
| When $k_1 \geq k_{10}$, | $k_{1m} =$ | 0.0616553 | 0.0860156 | 0.0981763 | 0.1190894 | 0.0118958 |
| When $k_1 < k_{10}$, | $k_{1m} =$ | 0.0896899 | 0.1016528 | 0.1061325 | 0.1024475 | 0.0218677 |
| When $d_1 \geq d_{10}$, | $d_{1m}$ (nm) = | 3.700 | 5.023 | 5.787 | 6.264 | 9.942 |
| When $d_1 < d_{10}$, | $d_{1m}$ (nm) = | 1.892 | 2.963 | 3.440 | 3.984 | 0.476 |
| When $n_2 \geq n_{20}$, | $n_{2m} =$ | 0.0797485 | 0.1030664 | 0.1135645 | 0.1221387 | 0.0340320 |
| When $n_2 < n_{20}$, | $n_{2m} =$ | 0.1493750 | 0.1566296 | 0.1631348 | 0.1387097 | 0.1094446 |
| When $k_2 \geq k_{20}$, | $k_{2m} =$ | 0.0775891 | 0.0962708 | 0.1030847 | 0.0998328 | 0.0100928 |
| When $k_2 < k_{20}$, | $k_{2m} =$ | 0.0909656 | 0.0941418 | 0.0920776 | 0.0860498 | 0.0649939 |
| When $d_2 \geq d_{20}$, | $d_{2m}$ (nm) = | ∞ | ∞ | ∞ | ∞ | 42.778 |
| When $d_2 < d_{20}$, | $d_{2m}$ (nm) = | 39.461 | 66.761 | 95.735 | 134.721 | 2.964 |

1. 0 < N A ≤ 1. 1
185 < T ≤ 195

| Case | 19–06 | 19–07 | 19–08 | 19–09 | 19–10 |
|---|---|---|---|---|---|
| $n_{10}$ | 1.7258494 | 1.7176246 | 1.7057732 | 1.7053832 | 1.6928552 |
| $k_{10}$ | 0.0843222 | 0.0727056 | 0.0731106 | 0.0633918 | 0.0748243 |
| $d_{10}$ (nm) | 91.766 | 91.617 | 158.709 | 158.181 | 216.444 |
| $n_{20}$ | 1.6907525 | 1.6784161 | 1.6805392 | 1.6859880 | 1.6825267 |
| $k_{20}$ | 0.2229229 | 0.1842107 | 0.1989479 | 0.1669818 | 0.2415835 |
| $d_{20}$ (nm) | 218.067 | 277.206 | 215.842 | 272.384 | 158.548 |

| | | 19–06 | 19–07 | 19–08 | 19–09 | 19–10 |
|---|---|---|---|---|---|---|
| When $n_1 \geq n_{10}$, | $n_{1m} =$ | 0.0445569 | 0.0497937 | 0.0455957 | 0.0532361 | 0.0209436 |
| When $n_1 < n_{10}$, | $n_{1m} =$ | 0.0086951 | 0.0298450 | 0.0022034 | 0.0367859 | 0.0248157 |
| When $k_1 \geq k_{10}$, | $k_{1m} =$ | 0.0263611 | 0.0534119 | 0.0080444 | 0.0507507 | 0.0311414 |
| When $k_1 < k_{10}$, | $k_{1m} =$ | 0.0359253 | 0.0504663 | 0.0097656 | 0.0393250 | 0.0256995 |
| When $d_1 \geq d_{10}$, | $d_{1m}$ (nm) $=$ | 15.734 | 41.766 | ∞ | ∞ | 12.676 |
| When $d_1 < d_{10}$, | $d_{1m}$ (nm) $=$ | 2.168 | 9.272 | 0.695 | 75.025 | 12.180 |
| When $n_2 \geq n_{20}$, | $n_{2m} =$ | 0.0361047 | 0.0638184 | 0.0029834 | 0.0794446 | 0.0872498 |
| When $n_2 < n_{20}$, | $n_{2m} =$ | 0.1156152 | 0.1202979 | 0.1187366 | 0.1037524 | 0.0413367 |
| When $k_2 \geq k_{20}$, | $k_{2m} =$ | 0.0400842 | 0.0626270 | 0.0025122 | 0.0450354 | 0.0876147 |
| When $k_2 < k_{20}$, | $k_{2m} =$ | 0.0626514 | 0.0561853 | 0.0563074 | 0.0506238 | 0.0672510 |
| When $d_2 \geq d_{20}$, | $d_{2m}$ (nm) $=$ | ∞ | ∞ | 1.098 | ∞ | ∞ |
| When $d_2 < d_{20}$, | $d_{2m}$ (nm) $=$ | 62.415 | 80.313 | 33.556 | 35.245 | 14.500 |

1. 0 < N A ≤ 1. 1
185 < T ≤ 195

| Case | 19–11 | 19–12 | 19–13 |
|---|---|---|---|
| $n_{10}$ | 1.6935473 | 1.6950516 | 1.6954923 |
| $k_{10}$ | 0.0663823 | 0.0596605 | 0.0554795 |
| $d_{10}$ (nm) | 214.407 | 213.429 | 271.226 |
| $n_{20}$ | 1.6888366 | 1.6925794 | 1.6917166 |
| $k_{20}$ | 0.1945007 | 0.1643538 | 0.1716832 |
| $d_{20}$ (nm) | 217.060 | 274.430 | 272.356 |

| | | 19–11 | 19–12 | 19–13 |
|---|---|---|---|---|
| When $n_1 \geq n_{10}$, | $n_{1m} =$ | 0.0539099 | 0.0837012 | 0.0771448 |
| When $n_1 < n_{10}$, | $n_{1m} =$ | 0.0450378 | 0.0604199 | 0.0593555 |
| When $k_1 \geq k_{10}$, | $k_{1m} =$ | 0.0507373 | 0.0587012 | 0.0639185 |
| When $k_1 < k_{10}$, | $k_{1m} =$ | 0.0306738 | 0.0334839 | 0.0392737 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 49.334 | 125.965 | 183.474 |
| When $n_2 \geq n_{20}$, | $n_{2m} =$ | 0.1392200 | 0.1753748 | 0.2943286 |
| When $n_2 < n_{20}$, | $n_{2m} =$ | 0.1378223 | 0.1262683 | 0.2110303 |
| When $k_2 \geq k_{20}$, | $k_{2m} =$ | 0.1089429 | 0.1267468 | 0.2119958 |
| When $k_2 < k_{20}$, | $k_{2m} =$ | 0.0654358 | 0.0611353 | 0.0788904 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 37.875 | 75.613 | 93.291 |

1. 0 < N A ≤ 1. 1
195 < T ≤ 205

| Case | 20-01 | 20-02 | 20-03 | 20-04 | 20-05 |
|---|---|---|---|---|---|
| $n_{10}$ | 1.9124203 | 1.9240615 | 1.9069086 | 1.7409810 | 1.7270720 |
| $k_{10}$ | 0.1489422 | 0.1092971 | 0.1015424 | 0.0988730 | 0.0857435 |
| $d_{10}$ (nm) | 14.330 | 12.001 | 10.748 | 91.533 | 92.142 |
| $n_{20}$ | 1.7039618 | 1.7245262 | 1.7018591 | 1.7256420 | 1.6923707 |
| $k_{20}$ | 0.3787231 | 0.3026113 | 0.2499950 | 0.2922591 | 0.2292874 |
| $d_{20}$ (nm) | 157.291 | 214.201 | 273.963 | 146.253 | 207.814 |

| | | 20-01 | 20-02 | 20-03 | 20-04 | 20-05 |
|---|---|---|---|---|---|---|
| When $n_1 \geq n_{10}$, | $n_{1n} =$ | 0.0947424 | 0.1140125 | 0.1293140 | 0.0383984 | 0.0447009 |
| When $n_1 < n_{10}$, | $n_{1n} =$ | 0.0592273 | 0.0732715 | 0.0895557 | 0.0020898 | 0.0081226 |
| When $k_1 \geq k_{10}$, | $k_{1n} =$ | 0.0804358 | 0.0961365 | 0.1132190 | 0.0106335 | 0.0246362 |
| When $k_1 < k_{10}$, | $k_{1n} =$ | 0.0954272 | 0.1092971 | 0.1015424 | 0.0220923 | 0.0359277 |
| When $d_1 \geq d_{10}$, | $d_{1n}$ (nm) $=$ | 5.168 | 5.724 | 6.406 | 9.801 | 15.595 |
| When $d_1 < d_{10}$, | $d_{1n}$ (nm) $=$ | 3.029 | 3.355 | 4.072 | 0.420 | 2.001 |
| When $n_2 \geq n_{20}$, | $n_{2n} =$ | 0.1047864 | 0.1153137 | 0.1226477 | 0.0347485 | 0.0318494 |
| When $n_2 < n_{20}$, | $n_{2n} =$ | 0.1598962 | 0.1638757 | 0.1417261 | 0.1115564 | 0.1129541 |
| When $k_2 \geq k_{20}$, | $k_{2n} =$ | 0.1020288 | 0.1044775 | 0.1018286 | 0.0106042 | 0.0415295 |
| When $k_2 < k_{20}$, | $k_{2n} =$ | 0.1029260 | 0.0959216 | 0.0891724 | 0.0737659 | 0.0663513 |
| When $d_2 \geq d_{20}$, | $d_{2n}$ (nm) $=$ | ∞ | ∞ | ∞ | 37.674 | ∞ |
| When $d_2 < d_{20}$, | $d_{2n}$ (nm) $=$ | 61.016 | 86.078 | 130.875 | 2.293 | 32.252 |

1. 0 < N A ≤ 1. 1
195 < T ≤ 205

| Case | 20-06 | 20-07 | 20-08 | 20-09 | 20-10 |
|---|---|---|---|---|---|
| $n_{10}$ | 1.7180387 | 1.7063746 | 1.7058520 | 1.6924739 | 1.6928977 |
| $k_{10}$ | 0.0734703 | 0.0744769 | 0.0640895 | 0.0767908 | 0.0684401 |
| $d_{10}$ (nm) | 91.877 | 159.624 | 158.885 | 216.680 | 213.761 |
| $n_{20}$ | 1.6777924 | 1.6791348 | 1.6855365 | 1.6850078 | 1.6885850 |
| $k_{20}$ | 0.1881130 | 0.2047799 | 0.1710983 | 0.2520629 | 0.1999527 |
| $d_{20}$ (nm) | 267.481 | 205.830 | 262.479 | 148.712 | 208.689 |

| | | 20-06 | 20-07 | 20-08 | 20-09 | 20-10 |
|---|---|---|---|---|---|---|
| When $n_1 \geq n_{10}$, | $n_{1n} =$ | 0.0499475 | 0.0454993 | 0.0542188 | 0.0126501 | 0.0501160 |
| When $n_1 < n_{10}$, | $n_{1n} =$ | 0.0300122 | 0.0018469 | 0.0331775 | 0.0226819 | 0.0449377 |
| When $k_1 \geq k_{10}$, | $k_{1n} =$ | 0.0534277 | 0.0070447 | 0.0503931 | 0.0235315 | 0.0487341 |
| When $k_1 < k_{10}$, | $k_{1n} =$ | 0.0493896 | 0.0111902 | 0.0386401 | 0.0180737 | 0.0270740 |
| When $d_1 \geq d_{10}$, | $d_{1n}$ (nm) $=$ | 33.063 | ∞ | ∞ | 10.064 | ∞ |
| When $d_1 < d_{10}$, | $d_{1n}$ (nm) $=$ | 9.229 | 0.603 | 19.062 | 10.036 | 46.531 |
| When $n_2 \geq n_{20}$, | $n_{2n} =$ | 0.0633008 | 0.0027478 | 0.0774658 | 0.0675293 | 0.1390137 |
| When $n_2 < n_{20}$, | $n_{2n} =$ | 0.1171533 | 0.1127539 | 0.1100610 | 0.0218616 | 0.1442749 |
| When $k_2 \geq k_{20}$, | $k_{2n} =$ | 0.0639148 | 0.0025830 | 0.0457581 | 0.0823975 | 0.1098364 |
| When $k_2 < k_{20}$, | $k_{2n} =$ | 0.0580542 | 0.0529590 | 0.0524817 | 0.0502942 | 0.0628650 |
| When $d_2 \geq d_{20}$, | $d_{2n}$ (nm) $=$ | ∞ | 1.007 | ∞ | ∞ | ∞ |
| When $d_2 < d_{20}$, | $d_{2n}$ (nm) $=$ | 77.001 | 28.132 | 32.836 | 6.408 | 22.345 |

1．0＜NA≤1．1
195＜T≤205

| Case | 20-11 | 20-12 |
|---|---|---|
| $n_{10}$ | 1.6947635 | 1.6952371 |
| $k_{10}$ | 0.0610999 | 0.0566636 |
| $d_{10}$ (nm) | 213.366 | 270.653 |
| $n_{20}$ | 1.6918971 | 1.6914186 |
| $k_{20}$ | 0.1679521 | 0.1751623 |
| $d_{20}$ (nm) | 265.388 | 263.994 |

| | | 20-11 | 20-12 |
|---|---|---|---|
| When $n_1 \geq n_{10}$, | $n_{1m} =$ | 0.0863086 | 0.0772644 |
| When $n_1 < n_{10}$, | $n_{1m} =$ | 0.0626501 | 0.0586890 |
| When $k_1 \geq k_{10}$, | $k_{1m} =$ | 0.0572302 | 0.0627917 |
| When $k_1 < k_{10}$, | $k_{1m} =$ | 0.0322180 | 0.0382104 |
| When $d_1 \geq d_{10}$, | $d_{1m}$ (nm) $=$ | ∞ | ∞ |
| When $d_1 < d_{10}$, | $d_{1m}$ (nm) $=$ | 124.819 | 121.330 |
| When $n_2 \geq n_{20}$, | $n_{2m} =$ | 0.1702917 | 0.3021582 |
| When $n_2 < n_{20}$, | $n_{2m} =$ | 0.1249365 | 0.2142798 |
| When $k_2 \geq k_{20}$, | $k_{2m} =$ | 0.1249084 | 0.2136462 |
| When $k_2 < k_{20}$, | $k_{2m} =$ | 0.0643469 | 0.0826477 |
| When $d_2 \geq d_{20}$, | $d_{2m}$ (nm) $=$ | ∞ | ∞ |
| When $d_2 < d_{20}$, | $d_{2m}$ (nm) $=$ | 66.113 | 91.025 |

10. An exposure method used in a process for manufacturing a semiconductor device, the method comprising the steps of:

providing an antireflective film having a two-layer structure between a resist layer and a silicon oxide layer formed on a surface of a silicon semiconductor substrate and having a thickness T (unit: nm) described below; and exposing the resist layer in an exposure system having a wavelength of 190 nm to 195 nm and a numerical aperture NA of $1.1 < NA \leq 1.2$, the antireflective film including an upper layer having a complex refractive index $N_1$, and a lower layer having a complex refractive index $N_2$, the complex refractive indexes $N_1$ and $N_2$ being represented by the equations $N_1 = n_1 - k_1 i$ and $N_2 = n_2 - k_2 i$, respectively;
wherein assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1$, $k_1$, $d_1$, $n_2$, $k_2$, and $d_2$ satisfy the relational expression

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1;$$

a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a

value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$; and in the tables below, in the line of "When $n_1 \geq n_{10}$, $n_{1m}$ =", each value in the right columns is "$n_{1m} - n_{10}$"; in the line of "When $n_1 < n_{10}$, $n_{1m}$ =", each value in the right columns is "$n_{10} - n_{1m}$"; in the line of "When $k_1 \geq k_{10}$, $k_{1m}$ =", each value in the right columns is "$k_{1m} - k_{10}$"; in the line of "When $k_1 < k_{10}$, $k_{1m}$ =", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m}$ =", each value in the right columns is "$n_{2m} - n_{20}$"; in the line of "When $n_2 < n_{20}$, $n_{2m}$ =", each value in the right columns is "$n_{20} - n_{2m}$"; in the line of "When $k_2 \geq k_{20}$, $k_{2m}$ =", each value in the right columns is "$k_{2m} - k_{20}$"; in the line of "When $k_2 < k_{20}$, $k_{2m}$ =", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

1. 1 < N A ≤ 1. 2

2 ≤ T ≤ 1 5

| Case | 1-01 | 1-02 | 1-03 | 1-04 | 1-05 |
|---|---|---|---|---|---|
| $n_{10}$ | 2.0940641 | 1.9168406 | 1.8970115 | 1.8805879 | 1.8778358 |
| $k_{10}$ | 0.0325844 | 0.1807255 | 0.1529573 | 0.1098415 | 0.1082679 |
| $d_{10}$ (nm) | 26.090 | 35.662 | 31.182 | 13.577 | 19.930 |
| $n_{20}$ | 4.2290158 | 5.4932306 | 2.4318401 | 1.7032895 | 1.8340760 |
| $k_{20}$ | 2.3935124 | 0.6123354 | 0.5958382 | 0.2751108 | 0.3677230 |
| $d_{20}$ (nm) | 3.632 | 19.087 | 52.406 | 218.193 | 142.226 |

| | | 1-01 | 1-02 | 1-03 | 1-04 | 1-05 |
|---|---|---|---|---|---|---|
| When $n_1 \geq n_{10}$, | $n_{1m}=$ | 0.0779846 | 0.0720874 | 0.0701013 | 0.1012354 | 0.0784314 |
| When $n_1 < n_{10}$, | $n_{1m}=$ | 0.0750281 | 0.0636047 | 0.0555591 | 0.0635571 | 0.0497058 |
| When $k_1 \geq k_{10}$, | $k_{1m}=$ | 0.0672229 | 0.0527649 | 0.0494641 | 0.0853247 | 0.0590771 |
| When $k_1 < k_{10}$, | $k_{1m}=$ | 0.0325844 | 0.0849731 | 0.0840393 | 0.1029980 | 0.0867822 |
| When $d_1 \geq d_{10}$, | $d_{1m}$ (nm) = | 3.416 | 5.199 | 6.198 | 6.716 | 7.382 |
| When $d_1 < d_{10}$, | $d_{1m}$ (nm) = | 2.721 | 3.845 | 3.923 | 3.853 | 3.873 |
| When $n_2 \geq n_{20}$, | $n_{2m}=$ | 0.2775293 | 0.1187439 | 0.1333862 | 0.1147803 | 0.1115393 |
| When $n_2 < n_{20}$, | $n_{2m}=$ | 0.2711597 | 0.1202087 | 0.1603455 | 0.1449023 | 0.1457849 |
| When $k_2 \geq k_{20}$, | $k_{2m}=$ | 0.2845105 | 0.1470557 | 0.1794812 | 0.0967163 | 0.1467151 |
| When $k_2 < k_{20}$, | $k_{2m}=$ | 0.2499512 | 0.1180896 | 0.1302063 | 0.0855334 | 0.0954285 |
| When $d_2 \geq d_{20}$, | $d_{2m}$ (nm) = | 0.458 | 0.467 | 5.440 | ∞ | ∞ |
| When $d_2 < d_{20}$, | $d_{2m}$ (nm) = | 0.433 | 0.450 | 5.242 | 81.747 | 30.656 |

1. 1 < N A ≤ 1. 2

2 ≤ T ≤ 1 5

| Case | 1-06 | 1-07 | 1-08 | 1-09 | 1-10 |
|---|---|---|---|---|---|
| $n_{10}$ | 1.8663312 | 1.7888608 | 1.7735009 | 1.7175310 | 1.7199475 |
| $k_{10}$ | 0.0978132 | 0.1060865 | 0.0957437 | 0.0751352 | 0.0655065 |
| $d_{10}$ (nm) | 12.232 | 103.503 | 98.181 | 95.409 | 94.621 |
| $n_{20}$ | 1.6938400 | 4.4234099 | 2.0208865 | 1.6658936 | 1.6963762 |
| $k_{20}$ | 0.2288643 | 0.4526804 | 0.4158741 | 0.2054797 | 0.1762614 |
| $d_{20}$ (nm) | 277.705 | 24.164 | 66.693 | 212.937 | 266.043 |

| | | 1-06 | 1-07 | 1-08 | 1-09 | 1-10 |
|---|---|---|---|---|---|---|
| When $n_1 \geq n_{10}$, | $n_{1m}=$ | 0.1143909 | 0.0588428 | 0.0489270 | 0.0419214 | 0.0484180 |
| When $n_1 < n_{10}$, | $n_{1m}=$ | 0.0786536 | 0.0104822 | 0.0094507 | 0.0157727 | 0.0265735 |
| When $k_1 \geq k_{10}$, | $k_{1m}=$ | 0.1033447 | 0.0215918 | 0.0249109 | 0.0382361 | 0.0520056 |
| When $k_1 < k_{10}$, | $k_{1m}=$ | 0.0978132 | 0.0439624 | 0.0358655 | 0.0399121 | 0.0459387 |
| When $d_1 \geq d_{10}$, | $d_{1m}$ (nm) = | 7.609 | 9.370 | 10.912 | 18.272 | 51.841 |
| When $d_1 < d_{10}$, | $d_{1m}$ (nm) = | 4.794 | 1.739 | 1.766 | 4.805 | 8.596 |
| When $n_2 \geq n_{20}$, | $n_{2m}=$ | 0.1069263 | 0.0468066 | 0.0740674 | 0.0384924 | 0.0631091 |
| When $n_2 < n_{20}$, | $n_{2m}=$ | 0.1302808 | 0.1036670 | 0.1052673 | 0.0829468 | 0.0987561 |
| When $k_2 \geq k_{20}$, | $k_{2m}=$ | 0.0918579 | 0.0409717 | 0.0495154 | 0.0385596 | 0.0522119 |
| When $k_2 < k_{20}$, | $k_{2m}=$ | 0.0786169 | 0.0807788 | 0.0903577 | 0.0528296 | 0.0515430 |
| When $d_2 \geq d_{20}$, | $d_{2m}$ (nm) = | ∞ | 0.296 | 4.999 | ∞ | ∞ |
| When $d_2 < d_{20}$, | $d_{2m}$ (nm) = | 128.233 | 0.621 | 5.371 | 23.038 | 34.154 |

1. 1 < N A ≤ 1. 2

2 ≤ T ≤ 1 5

| Case | 1-11 | 1-12 | 1-13 | 1-14 | 1-15 |
|---|---|---|---|---|---|
| $n_{10}$ | 1.7156729 | 1.7043499 | 1.7082412 | 1.6926126 | 1.6890888 |
| $k_{10}$ | 0.0770168 | 0.0644952 | 0.0577629 | 0.0683906 | 0.0745003 |
| $d_{10}$ (nm) | 188.315 | 165.315 | 163.169 | 237.184 | 217.718 |
| $n_{20}$ | 6.9620048 | 1.6731418 | 1.7075031 | 6.7859369 | 1.7770504 |
| $k_{20}$ | 3.4231449 | 0.1899705 | 0.1626792 | 2.9992529 | 0.3401503 |
| $d_{20}$ (nm) | 0.879 | 207.250 | 259.766 | 0.993 | 84.925 |

| | | 1-11 | 1-12 | 1-13 | 1-14 | 1-15 |
|---|---|---|---|---|---|---|
| When $n_1 \geq n_{10}$, | $n_{1m} =$ | 0.0649841 | 0.0417419 | 0.0509473 | 0.0348376 | 0.0194055 |
| When $n_1 < n_{10}$, | $n_{1m} =$ | 0.0083154 | 0.0317078 | 0.0477380 | 0.0764368 | 0.0607605 |
| When $k_1 \geq k_{10}$, | $k_{1m} =$ | 0.0257251 | 0.0333704 | 0.0433435 | 0.0403589 | 0.0329480 |
| When $k_1 < k_{10}$, | $k_{1m} =$ | 0.0275232 | 0.0338538 | 0.0333484 | 0.0319214 | 0.0242554 |
| When $d_1 \geq d_{10}$, | $d_{1m}$ (nm) $=$ | 38.959 | ∞ | ∞ | 19.483 | 9.981 |
| When $d_1 < d_{10}$, | $d_{1m}$ (nm) $=$ | 3.134 | 16.146 | 77.216 | 43.463 | 24.681 |
| When $n_2 \geq n_{20}$, | $n_{2m} =$ | 0.2971887 | 0.0474377 | 0.0745630 | 0.5633252 | 0.1177502 |
| When $n_2 < n_{20}$, | $n_{2m} =$ | 0.6091602 | 0.0721411 | 0.0651379 | 0.4300269 | 0.0317639 |
| When $k_2 \geq k_{20}$, | $k_{2m} =$ | 0.2827808 | 0.0222888 | 0.0325830 | 0.2436438 | 0.0560791 |
| When $k_2 < k_{20}$, | $k_{2m} =$ | 0.6937878 | 0.0478259 | 0.0479700 | 0.5647217 | 0.0980969 |
| When $d_2 \geq d_{20}$, | $d_{2m}$ (nm) $=$ | 0.055 | 16.772 | ∞ | 0.120 | 16.691 |
| When $d_2 < d_{20}$, | $d_{2m}$ (nm) $=$ | 0.135 | 19.208 | 16.504 | 0.176 | 3.670 |

1. 1 < N A ≤ 1. 2

2 ≤ T ≤ 1 5

| Case | 1-16 | 1-17 | 1-18 | 1-19 |
|---|---|---|---|---|
| $n_{10}$ | 1.6903292 | 1.6921355 | 1.6951475 | 1.7004017 |
| $k_{10}$ | 0.0721915 | 0.0670288 | 0.0546351 | 0.0599028 |
| $d_{10}$ (nm) | 210.963 | 207.063 | 219.259 | 265.986 |
| $n_{20}$ | 1.7111030 | 1.6978167 | 1.6889102 | 1.7029410 |
| $k_{20}$ | 0.2426612 | 0.1954345 | 0.1606659 | 0.1992607 |
| $d_{20}$ (nm) | 155.846 | 222.387 | 263.728 | 214.965 |

| | | 1-16 | 1-17 | 1-18 | 1-19 |
|---|---|---|---|---|---|
| When $n_1 \geq n_{10}$, | $n_{1m} =$ | 0.0284180 | 0.0456091 | 0.0773694 | 0.0612244 |
| When $n_1 < n_{10}$, | $n_{1m} =$ | 0.0510327 | 0.0467078 | 0.0619885 | 0.0410486 |
| When $k_1 \geq k_{10}$, | $k_{1m} =$ | 0.0455554 | 0.0511133 | 0.0524768 | 0.0499927 |
| When $k_1 < k_{10}$, | $k_{1m} =$ | 0.0320984 | 0.0388074 | 0.0353687 | 0.0377380 |
| When $d_1 \geq d_{10}$, | $d_{1m}$ (nm) $=$ | 23.770 | ∞ | ∞ | ∞ |
| When $d_1 < d_{10}$, | $d_{1m}$ (nm) $=$ | 28.472 | 31.416 | 128.164 | 94.534 |
| When $n_2 \geq n_{20}$, | $n_{2m} =$ | 0.1260327 | 0.1631665 | 0.2120154 | 0.2674829 |
| When $n_2 < n_{20}$, | $n_{2m} =$ | 0.0663647 | 0.1722144 | 0.1079456 | 0.2316101 |
| When $k_2 \geq k_{20}$, | $k_{2m} =$ | 0.0960291 | 0.1259009 | 0.1121619 | 0.2074023 |
| When $k_2 < k_{20}$, | $k_{2m} =$ | 0.0846741 | 0.0757690 | 0.0591858 | 0.0894751 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 12.288 | 72.281 | 78.597 | 77.855 |

1. 1 < N A ≤ 1. 2
1 5 < T ≤ 2 5

| Case | 2-01 | 2-02 | 2-03 | 2-04 | 2-05 |
|---|---|---|---|---|---|
| $n_{10}$ | 1.8738578 | 1.8839217 | 1.8842367 | 1.8705650 | 1.7997475 |
| $k_{10}$ | 0.2051029 | 0.1169859 | 0.1130268 | 0.1010320 | 0.1076402 |
| $d_{10}$ (nm) | 37.506 | 20.540 | 14.059 | 12.433 | 101.817 |
| $n_{20}$ | 6.9151921 | 1.8488520 | 1.7087850 | 1.6946915 | 5.7702673 |
| $k_{20}$ | 0.6847654 | 0.3990514 | 0.2917115 | 0.2394813 | 0.5312541 |
| $d_{20}$ (nm) | 14.288 | 132.865 | 208.377 | 268.610 | 17.283 |

| | | 2-01 | 2-02 | 2-03 | 2-04 | 2-05 |
|---|---|---|---|---|---|---|
| When $n_1 \geq n_{10}$, | $n_{1m}=$ | 0.0713965 | 0.0757019 | 0.0971472 | 0.1115784 | 0.0520068 |
| When $n_1 < n_{10}$, | $n_{1m}=$ | 0.0555054 | 0.0476453 | 0.0599609 | 0.0759399 | 0.0098120 |
| When $k_1 \geq k_{10}$, | $k_{1m}=$ | 0.0541125 | 0.0561304 | 0.0804553 | 0.1002258 | 0.0237036 |
| When $k_1 < k_{10}$, | $k_{1m}=$ | 0.0773486 | 0.0843945 | 0.1004919 | 0.1010320 | 0.0377808 |
| When $d_1 \geq d_{10}$, | $d_{1m}$ (nm) $=$ | 5.211 | 6.923 | 6.482 | 7.316 | 8.566 |
| When $d_1 < d_{10}$, | $d_{1m}$ (nm) $=$ | 3.920 | 3.580 | 3.648 | 4.569 | 1.552 |
| When $n_2 \geq n_{20}$, | $n_{2m}=$ | 0.1375024 | 0.1133521 | 0.1126624 | 0.1051160 | 0.0578821 |
| When $n_2 < n_{20}$, | $n_{2m}=$ | 0.1468335 | 0.1457764 | 0.1432654 | 0.1327966 | 0.1020337 |
| When $k_2 \geq k_{20}$, | $k_{2m}=$ | 0.1698267 | 0.1546228 | 0.0978870 | 0.0916199 | 0.0398865 |
| When $k_2 < k_{20}$, | $k_{2m}=$ | 0.1355151 | 0.0979541 | 0.0869165 | 0.0797766 | 0.0850256 |
| When $d_2 \geq d_{20}$, | $d_{2m}$ (nm) $=$ | 0.302 | ∞ | ∞ | ∞ | 0.186 |
| When $d_2 < d_{20}$, | $d_{2m}$ (nm) $=$ | 0.308 | 25.359 | 77.278 | 123.573 | 0.315 |

1. 1 < N A ≤ 1. 2
1 5 < T ≤ 2 5

| Case | 2-06 | 2-07 | 2-08 | 2-09 | 2-10 |
|---|---|---|---|---|---|
| $n_{10}$ | 1.7189014 | 1.7208712 | 1.7236639 | 1.7047019 | 1.7084293 |
| $k_{10}$ | 0.0782837 | 0.0678223 | 0.0843652 | 0.0670962 | 0.0597123 |
| $d_{10}$ (nm) | 95.289 | 94.558 | 181.922 | 165.192 | 163.108 |
| $n_{20}$ | 1.6643388 | 1.6960341 | 5.6387216 | 1.6715149 | 1.7074208 |
| $k_{20}$ | 0.2165956 | 0.1841027 | 4.7363270 | 0.1999125 | 0.1697699 |
| $d_{20}$ (nm) | 204.139 | 257.386 | 0.821 | 198.564 | 251.199 |

| | | 2-06 | 2-07 | 2-08 | 2-09 | 2-10 |
|---|---|---|---|---|---|---|
| When $n_1 \geq n_{10}$, | $n_{1m}=$ | 0.0400110 | 0.0468091 | 0.0526855 | 0.0398865 | 0.0490320 |
| When $n_1 < n_{10}$, | $n_{1m}=$ | 0.0126721 | 0.0238684 | 0.0001306 | 0.0279565 | 0.0460034 |
| When $k_1 \geq k_{10}$, | $k_{1m}=$ | 0.0335376 | 0.0489734 | 0.0020081 | 0.0268384 | 0.0389331 |
| When $k_1 < k_{10}$, | $k_{1m}=$ | 0.0373218 | 0.0446973 | 0.0057251 | 0.0295178 | 0.0306982 |
| When $d_1 \geq d_{10}$, | $d_{1m}$ (nm) $=$ | 16.137 | 28.984 | 27.528 | ∞ | ∞ |
| When $d_1 < d_{10}$, | $d_{1m}$ (nm) $=$ | 3.682 | 7.422 | 0.042 | 13.795 | 27.544 |
| When $n_2 \geq n_{20}$, | $n_{2m}=$ | 0.0331177 | 0.0610901 | 0.0075977 | 0.0397839 | 0.0734460 |
| When $n_2 < n_{20}$, | $n_{2m}=$ | 0.0802783 | 0.0961804 | 0.6135461 | 0.0646704 | 0.0518091 |
| When $k_2 \geq k_{20}$, | $k_{2m}=$ | 0.0326062 | 0.0485974 | 0.0047754 | 0.0159570 | 0.0275537 |
| When $k_2 < k_{20}$, | $k_{2m}=$ | 0.0528589 | 0.0519092 | 0.7998767 | 0.0474854 | 0.0482410 |
| When $d_2 \geq d_{20}$, | $d_{2m}$ (nm) $=$ | ∞ | ∞ | 0.001 | 11.667 | ∞ |
| When $d_2 < d_{20}$, | $d_{2m}$ (nm) $=$ | 20.507 | 30.742 | 0.141 | 16.953 | 13.761 |

1. 1 < N A ≤ 1. 2
1 5 < T ≤ 2 5

| Case | 2−11 | 2−12 | 2−13 | 2−14 | 2−15 |
|---|---|---|---|---|---|
| $n_{10}$ | 1.6912240 | 1.6881032 | 1.6896993 | 1.6917374 | 1.6948846 |
| $k_{10}$ | 0.0750717 | 0.0788193 | 0.0752193 | 0.0692921 | 0.0562662 |
| $d_{10}$ (nm) | 235.933 | 218.423 | 211.247 | 207.206 | 219.172 |
| $n_{20}$ | 5.6089359 | 1.7881557 | 1.7110684 | 1.6970724 | 1.6877325 |
| $k_{20}$ | 4.1789938 | 0.3823123 | 0.2595743 | 0.2053429 | 0.1673191 |
| $d_{20}$ (nm) | 0.921 | 76.059 | 147.061 | 213.576 | 255.276 |

| | | 2−11 | 2−12 | 2−13 | 2−14 | 2−15 |
|---|---|---|---|---|---|---|
| When $n_1 \geq n_{10}$, | $n_{1m} =$ | 0.0197583 | 0.0081677 | 0.0235974 | 0.0421069 | 0.0510120 |
| When $n_1 < n_{10}$, | $n_{1m} =$ | 0.0774451 | 0.0583032 | 0.0505896 | 0.0462817 | 0.0590515 |
| When $k_1 \geq k_{10}$, | $k_{1m} =$ | 0.0246448 | 0.0223682 | 0.0406641 | 0.0495398 | 0.0510083 |
| When $k_1 < k_{10}$, | $k_{1m} =$ | 0.0218396 | 0.0175671 | 0.0286658 | 0.0376331 | 0.0343799 |
| When $d_1 \geq d_{10}$, | $d_{1m}$ (nm) $=$ | 6.504 | 3.634 | 18.131 | ∞ | ∞ |
| When $d_1 < d_{10}$, | $d_{1m}$ (nm) $=$ | 42.587 | 22.206 | 26.432 | 29.901 | 81.491 |
| When $n_2 \geq n_{20}$, | $n_{2m} =$ | 0.6544434 | 0.1247424 | 0.1252808 | 0.1545593 | 0.2162573 |
| When $n_2 < n_{20}$, | $n_{2m} =$ | 0.2325012 | 0.0171619 | 0.0503735 | 0.1749207 | 0.1048962 |
| When $k_2 \geq k_{20}$, | $k_{2m} =$ | 0.1484387 | 0.0366235 | 0.0860120 | 0.1212268 | 0.1092822 |
| When $k_2 < k_{20}$, | $k_{2m} =$ | 0.6595715 | 0.1036670 | 0.0844458 | 0.0781323 | 0.0604700 |
| When $d_2 \geq d_{20}$, | $d_{2m}$ (nm) $=$ | 0.071 | 14.060 | ∞ | ∞ | ∞ |
| When $d_2 < d_{20}$, | $d_{2m}$ (nm) $=$ | 0.195 | 1.711 | 9.636 | 69.774 | 76.197 |

1. 1 < N A ≤ 1. 2
1 5 < T ≤ 2 5

| Case | 2−16 | 2−17 |
|---|---|---|
| $n_{10}$ | 1.7002883 | 1.6987256 |
| $k_{10}$ | 0.0618224 | 0.0572006 |
| $d_{10}$ (nm) | 266.113 | 264.952 |
| $n_{20}$ | 1.7025341 | 1.6934905 |
| $k_{20}$ | 0.2096252 | 0.1744162 |
| $d_{20}$ (nm) | 206.193 | 266.771 |

| | | 2−16 | 2−17 |
|---|---|---|---|
| When $n_1 \geq n_{10}$, | $n_{1m} =$ | 0.0602454 | 0.0764587 |
| When $n_1 < n_{10}$, | $n_{1m} =$ | 0.0381921 | 0.0594568 |
| When $k_1 \geq k_{10}$, | $k_{1m} =$ | 0.0482422 | 0.0536096 |
| When $k_1 < k_{10}$, | $k_{1m} =$ | 0.0371497 | 0.0384741 |
| When $d_1 \geq d_{10}$, | $d_{1m}$ (nm) $=$ | ∞ | ∞ |
| When $d_1 < d_{10}$, | $d_{1m}$ (nm) $=$ | 92.805 | 173.726 |
| When $n_2 \geq n_{20}$, | $n_{2m} =$ | 0.2779004 | 0.2751611 |
| When $n_2 < n_{20}$, | $n_{2m} =$ | 0.2377234 | 0.2053577 |
| When $k_2 \geq k_{20}$, | $k_{2m} =$ | 0.2066309 | 0.2211816 |
| When $k_2 < k_{20}$, | $k_{2m} =$ | 0.0931018 | 0.0797998 |
| When $d_2 \geq d_{20}$, | $d_{2m}$ (nm) $=$ | ∞ | ∞ |
| When $d_2 < d_{20}$, | $d_{2m}$ (nm) $=$ | 73.805 | 125.295 |

1. 1 < N A ≤ 1. 2
2 5 < T ≤ 3 5

| Case | 3-01 | 3-02 | 3-03 | 3-04 | 3-05 |
|---|---|---|---|---|---|
| $n_{10}$ | 1.8384852 | 1.8997218 | 1.8867733 | 1.8774399 | 1.8168537 |
| $k_{10}$ | 0.2367471 | 0.1227276 | 0.1201944 | 0.1030917 | 0.1206742 |
| $d_{10}$ (nm) | 38.632 | 21.226 | 14.426 | 12.555 | 98.976 |
| $n_{20}$ | 4.7928214 | 1.8945709 | 1.7066853 | 1.6978346 | 5.6725781 |
| $k_{20}$ | 0.7766058 | 0.4412749 | 0.3085187 | 0.2515853 | 0.5943855 |
| $d_{20}$ (nm) | 20.034 | 121.762 | 200.277 | 259.495 | 16.950 |

| | | 3-01 | 3-02 | 3-03 | 3-04 | 3-05 |
|---|---|---|---|---|---|---|
| When $n_1 \geq n_{10}$, | $n_{1m} =$ | 0.0640527 | 0.0719128 | 0.0931812 | 0.1089819 | 0.0387244 |
| When $n_1 < n_{10}$, | $n_{1m} =$ | 0.0455762 | 0.0458093 | 0.0565320 | 0.0737622 | 0.0048828 |
| When $k_1 \geq k_{10}$, | $k_{1m} =$ | 0.0510876 | 0.0524744 | 0.0764050 | 0.0973877 | 0.0168860 |
| When $k_1 < k_{10}$, | $k_{1m} =$ | 0.0717981 | 0.0817957 | 0.0981750 | 0.1030917 | 0.0269836 |
| When $d_1 \geq d_{10}$, | $d_{1m}$ (nm) $=$ | 4.733 | 6.228 | 6.172 | 6.944 | 6.776 |
| When $d_1 < d_{10}$, | $d_{1m}$ (nm) $=$ | 3.444 | 3.186 | 3.418 | 4.320 | 0.695 |
| When $n_2 \geq n_{20}$, | $n_{2m} =$ | 0.1712317 | 0.1175342 | 0.1094324 | 0.1025208 | 0.0610400 |
| When $n_2 < n_{20}$, | $n_{2m} =$ | 0.1852917 | 0.1447205 | 0.1408899 | 0.1358679 | 0.1030127 |
| When $k_2 \geq k_{20}$, | $k_{2m} =$ | 0.2079944 | 0.1727771 | 0.0971545 | 0.0913745 | 0.0239368 |
| When $k_2 < k_{20}$, | $k_{2m} =$ | 0.1709546 | 0.1005322 | 0.0873328 | 0.0807227 | 0.0995679 |
| When $d_2 \geq d_{20}$, | $d_{2m}$ (nm) $=$ | 0.789 | ∞ | ∞ | ∞ | 0.191 |
| When $d_2 < d_{20}$, | $d_{2m}$ (nm) $=$ | 0.773 | 21.526 | 73.345 | 89.127 | 0.308 |

1. 1 < N A ≤ 1. 2
2 5 < T ≤ 3 5

| Case | 3-06 | 3-07 | 3-08 | 3-09 | 3-10 |
|---|---|---|---|---|---|
| $n_{10}$ | 1.7203847 | 1.7222308 | 1.7051744 | 1.7089344 | 1.6891179 |
| $k_{10}$ | 0.0818178 | 0.0703272 | 0.0699535 | 0.0618729 | 0.0788518 |
| $d_{10}$ (nm) | 95.097 | 94.450 | 164.924 | 162.999 | 211.328 |
| $n_{20}$ | 1.6625491 | 1.6972414 | 1.6707295 | 1.7091982 | 1.7121044 |
| $k_{20}$ | 0.2295920 | 0.1929579 | 0.2115581 | 0.1777196 | 0.2799946 |
| $d_{20}$ (nm) | 195.706 | 248.789 | 190.095 | 242.642 | 139.125 |

| | | 3-06 | 3-07 | 3-08 | 3-09 | 3-10 |
|---|---|---|---|---|---|---|
| When $n_1 \geq n_{10}$, | $n_{1m} =$ | 0.0370166 | 0.0449036 | 0.0362634 | 0.0468103 | 0.0189148 |
| When $n_1 < n_{10}$, | $n_{1m} =$ | 0.0096326 | 0.0211206 | 0.0148706 | 0.0438916 | 0.0495532 |
| When $k_1 \geq k_{10}$, | $k_{1m} =$ | 0.0279895 | 0.0455884 | 0.0190686 | 0.0333899 | 0.0327563 |
| When $k_1 < k_{10}$, | $k_{1m} =$ | 0.0346558 | 0.0433374 | 0.0247266 | 0.0269507 | 0.0238696 |
| When $d_1 \geq d_{10}$, | $d_{1m}$ (nm) $=$ | 14.187 | 22.312 | ∞ | ∞ | 9.561 |
| When $d_1 < d_{10}$, | $d_{1m}$ (nm) $=$ | 2.673 | 6.291 | 5.065 | 24.312 | 23.646 |
| When $n_2 \geq n_{20}$, | $n_{2m} =$ | 0.0267200 | 0.0590454 | 0.0307410 | 0.0721521 | 0.1253455 |
| When $n_2 < n_{20}$, | $n_{2m} =$ | 0.0766724 | 0.0932019 | 0.0523315 | 0.0386328 | 0.0336450 |
| When $k_2 \geq k_{20}$, | $k_{2m} =$ | 0.0255017 | 0.0445288 | 0.0095300 | 0.0215259 | 0.0725635 |
| When $k_2 < k_{20}$, | $k_{2m} =$ | 0.0521814 | 0.0521948 | 0.0465356 | 0.0485632 | 0.0779358 |
| When $d_2 \geq d_{20}$, | $d_{2m}$ (nm) $=$ | ∞ | ∞ | 7.007 | 43.167 | ∞ |
| When $d_2 < d_{20}$, | $d_{2m}$ (nm) $=$ | 18.077 | 28.239 | 14.543 | 10.181 | 6.908 |

# EP 1 760 766 A2

1. 1 < N A ≤ 1. 2
2 5 < T ≤ 3 5

| Case | 3-11 | 3-12 | 3-13 | 3-14 |
|---|---|---|---|---|
| $n_{10}$ | 1.6914863 | 1.6947006 | 1.7002933 | 1.6987290 |
| $k_{10}$ | 0.0717884 | 0.0580661 | 0.0640004 | 0.0588877 |
| $d_{10}$ (nm) | 207.154 | 219.137 | 266.055 | 264.992 |
| $n_{20}$ | 1.6970451 | 1.6875442 | 1.7022941 | 1.6933668 |
| $k_{20}$ | 0.2167627 | 0.1751428 | 0.2216801 | 0.1822428 |
| $d_{20}$ (nm) | 205.768 | 246.865 | 198.139 | 258.415 |

| | | 3-11 | 3-12 | 3-13 | 3-14 |
|---|---|---|---|---|---|
| When $n_1 \geq n_{10}$, | $n_{1m}=$ | 0.0385889 | 0.0449475 | 0.0561011 | 0.0760583 |
| When $n_1 < n_{10}$, | $n_{1m}=$ | 0.0454712 | 0.0531458 | 0.0356934 | 0.0583093 |
| When $k_1 \geq k_{10}$, | $k_{1m}=$ | 0.0478943 | 0.0493811 | 0.0460974 | 0.0520996 |
| When $k_1 < k_{10}$, | $k_{1m}=$ | 0.0361658 | 0.0330811 | 0.0363293 | 0.0375061 |
| When $d_1 \geq d_{10}$, | $d_{1m}$ (nm) $=$ | ∞ | ∞ | ∞ | ∞ |
| When $d_1 < d_{10}$, | $d_{1m}$ (nm) $=$ | 28.219 | 77.448 | 91.180 | 121.680 |
| When $n_2 \geq n_{20}$, | $n_{2m}=$ | 0.1522107 | 0.2230298 | 0.2904858 | 0.2858545 |
| When $n_2 < n_{20}$, | $n_{2m}=$ | 0.1781921 | 0.1009351 | 0.2457825 | 0.2068896 |
| When $k_2 \geq k_{20}$, | $k_{2m}=$ | 0.1157642 | 0.1063892 | 0.2056812 | 0.2216101 |
| When $k_2 < k_{20}$, | $k_{2m}=$ | 0.0805957 | 0.0617065 | 0.0977039 | 0.0829004 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 66.127 | 48.464 | 70.211 | 121.644 |

1. 1 < N A ≤ 1. 2
3 5 < T ≤ 4 5

| Case | 4-01 | 4-02 | 4-03 | 4-04 | 4-05 |
|---|---|---|---|---|---|
| $n_{10}$ | 1.8909619 | 1.9211597 | 1.8908364 | 1.8788634 | 1.7209142 |
| $k_{10}$ | 0.2198688 | 0.1299283 | 0.1293290 | 0.1089981 | 0.0850231 |
| $d_{10}$ (nm) | 30.886 | 20.325 | 14.409 | 12.666 | 94.685 |
| $n_{20}$ | 2.4457650 | 1.8999891 | 1.6971949 | 1.6934061 | 1.6569532 |
| $k_{20}$ | 0.9042920 | 0.4762728 | 0.3219355 | 0.2597468 | 0.2398462 |
| $d_{20}$ (nm) | 40.480 | 114.977 | 192.850 | 251.595 | 187.582 |

| | | 4-01 | 4-02 | 4-03 | 4-04 | 4-05 |
|---|---|---|---|---|---|---|
| When $n_1 \geq n_{10}$, | $n_{1m}=$ | 0.0581348 | 0.0702795 | 0.0908240 | 0.1067529 | 0.0340771 |
| When $n_1 < n_{10}$, | $n_{1m}=$ | 0.0408777 | 0.0430811 | 0.0541882 | 0.0719214 | 0.0077319 |
| When $k_1 \geq k_{10}$, | $k_{1m}=$ | 0.0449243 | 0.0499243 | 0.0741248 | 0.0961597 | 0.0239465 |
| When $k_1 < k_{10}$, | $k_{1m}=$ | 0.0797229 | 0.0798120 | 0.0963696 | 0.1066907 | 0.0329150 |
| When $d_1 \geq d_{10}$, | $d_{1m}$ (nm) $=$ | 4.322 | 5.448 | 5.786 | 6.719 | 11.856 |
| When $d_1 < d_{10}$, | $d_{1m}$ (nm) $=$ | 2.642 | 2.634 | 3.166 | 4.161 | 2.071 |
| When $n_2 \geq n_{20}$, | $n_{2m}=$ | 0.1853430 | 0.1162805 | 0.1041772 | 0.0995618 | 0.0224622 |
| When $n_2 < n_{20}$, | $n_{2m}=$ | 0.1757385 | 0.1461218 | 0.1390881 | 0.1365247 | 0.0731372 |
| When $k_2 \geq k_{20}$, | $k_{2m}=$ | 0.2033411 | 0.1671118 | 0.0936316 | 0.0897620 | 0.0193579 |
| When $k_2 < k_{20}$, | $k_{2m}=$ | 0.1615027 | 0.0988000 | 0.0865491 | 0.0806287 | 0.0502966 |
| When $d_2 \geq d_{20}$, | $d_{2m}$ (nm) $=$ | 5.473 | ∞ | ∞ | ∞ | 13.590 |
| When $d_2 < d_{20}$, | $d_{2m}$ (nm) $=$ | 4.339 | 20.871 | 70.442 | 87.096 | 16.661 |

531

1．1＜ＮＡ≦1．2
3 5＜Ｔ≦4 5

| Case | 4-06 | 4-07 | 4-08 | 4-09 | 4-10 |
|---|---|---|---|---|---|
| $n_{10}$ | 1.7236493 | 1.7053690 | 1.7096103 | 1.6884398 | 1.6913141 |
| $k_{10}$ | 0.0725136 | 0.0723352 | 0.0638708 | 0.0822671 | 0.0737244 |
| $d_{10}$ (nm) | 94.253 | 164.385 | 162.799 | 210.788 | 206.649 |
| $n_{20}$ | 1.6994520 | 1.6690598 | 1.7121782 | 1.7077650 | 1.6954335 |
| $k_{20}$ | 0.2004026 | 0.2212238 | 0.1844639 | 0.2979850 | 0.2262249 |
| $d_{20}$ (nm) | 239.752 | 181.544 | 233.616 | 132.459 | 199.430 |
|  |  |  |  |  |  |
| When $n_1 \geq n_{10}$, $n_{1m}=$ | 0.0432617 | 0.0328076 | 0.0449390 | 0.0103259 | 0.0357813 |
| When $n_1 < n_{10}$, $n_{1m}=$ | 0.0189111 | 0.0081836 | 0.0418201 | 0.0476318 | 0.0441882 |
| When $k_1 \geq k_{10}$, $k_{1m}=$ | 0.0428613 | 0.0134167 | 0.0270105 | 0.0240100 | 0.0467419 |
| When $k_1 < k_{10}$, $k_{1m}=$ | 0.0419373 | 0.0221985 | 0.0217126 | 0.0186353 | 0.0353625 |
| When $d_1 \geq d_{10}$, $d_{1m}$ (nm) $=$ | 19.395 | 21.834 | ∞ | 7.013 | ∞ |
| When $d_1 < d_{10}$, $d_{1m}$ (nm) $=$ | 5.406 | 2.666 | 6.246 | 21.283 | 26.527 |
| When $n_2 \geq n_{20}$, $n_{2m}=$ | 0.0587073 | 0.0279724 | 0.0684412 | 0.1217639 | 0.1437500 |
| When $n_2 < n_{20}$, $n_{2m}=$ | 0.0913135 | 0.0359949 | 0.0242969 | 0.0190967 | 0.1057874 |
| When $k_2 \geq k_{20}$, $k_{2m}=$ | 0.0407703 | 0.0058350 | 0.0150317 | 0.0602039 | 0.1122632 |
| When $k_2 < k_{20}$, $k_{2m}=$ | 0.0523291 | 0.0449670 | 0.0490210 | 0.0601965 | 0.0826379 |
| When $d_2 \geq d_{20}$, $d_{2m}$ (nm) $=$ | ∞ | 4.683 | 36.767 | ∞ | ∞ |
| When $d_2 < d_{20}$, $d_{2m}$ (nm) $=$ | 25.916 | 13.275 | 6.151 | 3.566 | 25.291 |

1．1＜ＮＡ≦1．2
3 5＜Ｔ≦4 5

| Case | 4-11 | 4-12 | 4-13 |
|---|---|---|---|
| $n_{10}$ | 1.6945163 | 1.7002615 | 1.6987767 |
| $k_{10}$ | 0.0596605 | 0.0658973 | 0.0602453 |
| $d_{10}$ (nm) | 219.093 | 265.562 | 264.538 |
| $n_{20}$ | 1.6879518 | 1.6991117 | 1.6924357 |
| $k_{20}$ | 0.1823501 | 0.2320843 | 0.1888152 |
| $d_{20}$ (nm) | 237.943 | 190.875 | 250.808 |

| When $n_1 \geq n_{10}$, $n_{1m}=$ | 0.0400159 | 0.0514929 | 0.0760449 |
|---|---|---|---|
| When $n_1 < n_{10}$, $n_{1m}=$ | 0.0454590 | 0.0339758 | 0.0578162 |
| When $k_1 \geq k_{10}$, $k_{1m}=$ | 0.0478894 | 0.0439832 | 0.0508728 |
| When $k_1 < k_{10}$, $k_{1m}=$ | 0.0318921 | 0.0347144 | 0.0365662 |
| When $d_1 \geq d_{10}$, $d_{1m}$ (nm) $=$ | ∞ | ∞ | ∞ |
| When $d_1 < d_{10}$, $d_{1m}$ (nm) $=$ | 53.950 | 89.870 | 117.603 |
| When $n_2 \geq n_{20}$, $n_{2m}=$ | 0.2316992 | 0.3028357 | 0.2948633 |
| When $n_2 < n_{20}$, $n_{2m}=$ | 0.0956519 | 0.2532336 | 0.2085193 |
| When $k_2 \geq k_{20}$, $k_{2m}=$ | 0.1045911 | 0.2056006 | 0.2209802 |
| When $k_2 < k_{20}$, $k_{2m}=$ | 0.0612427 | 0.1002246 | 0.0860327 |
| When $d_2 \geq d_{20}$, $d_{2m}$ (nm) $=$ | ∞ | ∞ | ∞ |
| When $d_2 < d_{20}$, $d_{2m}$ (nm) $=$ | 40.957 | 67.613 | 80.377 |

1. 1 < N A ≦ 1. 2
4 5 < T ≦ 5 5

| Case | 5-01 | 5-02 | 5-03 | 5-04 | 5-05 |
|---|---|---|---|---|---|
| $n_{10}$ | 1.9413239 | 1.8877645 | 1.8798429 | 1.7202563 | 1.7249517 |
| $k_{10}$ | 0.1405566 | 0.1445306 | 0.1135692 | 0.0870823 | 0.0739360 |
| $d_{10}$ (nm) | 18.043 | 14.095 | 12.637 | 94.214 | 94.041 |
| $n_{20}$ | 1.8442891 | 1.6688638 | 1.6888514 | 1.6489031 | 1.7027050 |
| $k_{20}$ | 0.4845639 | 0.3235014 | 0.2638544 | 0.2445724 | 0.2047377 |
| $d_{20}$ (nm) | 113.109 | 187.292 | 243.053 | 179.182 | 229.905 |

| | 5-01 | 5-02 | 5-03 | 5-04 | 5-05 |
|---|---|---|---|---|---|
| When $n_1 \geq n_{10}$, $n_{1m}=$ | 0.0724768 | 0.0904346 | 0.1062329 | 0.0324084 | 0.0425623 |
| When $n_1 < n_{10}$, $n_{1m}=$ | 0.0387427 | 0.0534119 | 0.0716968 | 0.0082080 | 0.0177209 |
| When $k_1 \geq k_{10}$, $k_{1m}=$ | 0.0483630 | 0.0753357 | 0.0968298 | 0.0243140 | 0.0418030 |
| When $k_1 < k_{10}$, $k_{1m}=$ | 0.0803040 | 0.0945715 | 0.1060376 | 0.0343469 | 0.0406653 |
| When $d_1 \geq d_{10}$, $d_{1m}$ (nm) = | 4.823 | 5.486 | 6.573 | 10.670 | 17.560 |
| When $d_1 < d_{10}$, $d_{1m}$ (nm) = | 2.042 | 3.025 | 4.077 | 2.161 | 4.892 |
| When $n_2 \geq n_{20}$, $n_{2m}=$ | 0.1074292 | 0.0972339 | 0.0967822 | 0.0242322 | 0.0621313 |
| When $n_2 < n_{20}$, $n_{2m}=$ | 0.1555688 | 0.1383643 | 0.1358411 | 0.0727905 | 0.0930249 |
| When $k_2 \geq k_{20}$, $k_{2m}=$ | 0.1308459 | 0.0862097 | 0.0881348 | 0.0180859 | 0.0388489 |
| When $k_2 < k_{20}$, $k_{2m}=$ | 0.0911877 | 0.0843787 | 0.0806641 | 0.0488940 | 0.0530957 |
| When $d_2 \geq d_{20}$, $d_{2m}$ (nm) = | ∞ | ∞ | ∞ | 10.287 | ∞ |
| When $d_2 < d_{20}$, $d_{2m}$ (nm) = | 20.712 | 69.838 | 88.098 | 16.560 | 20.064 |

1. 1 < N A ≦ 1. 2
4 5 < T ≦ 5 5

| Case | 5-06 | 5-07 | 5-08 | 5-09 | 5-10 |
|---|---|---|---|---|---|
| $n_{10}$ | 1.7053831 | 1.7104785 | 1.6877471 | 1.6915115 | 1.6941672 |
| $k_{10}$ | 0.0736370 | 0.0654156 | 0.0844092 | 0.0739491 | 0.0608347 |
| $d_{10}$ (nm) | 163.843 | 162.671 | 209.661 | 205.513 | 218.889 |
| $n_{20}$ | 1.6671854 | 1.7160090 | 1.6959640 | 1.6904122 | 1.6879018 |
| $k_{20}$ | 0.2267475 | 0.1885946 | 0.3073448 | 0.2298496 | 0.1872431 |
| $d_{20}$ (nm) | 172.382 | 223.774 | 127.018 | 196.556 | 228.501 |

| | 5-06 | 5-07 | 5-08 | 5-09 | 5-10 |
|---|---|---|---|---|---|
| When $n_1 \geq n_{10}$, $n_{1m}=$ | 0.0309619 | 0.0440515 | 0.0051978 | 0.0335425 | 0.0357227 |
| When $n_1 < n_{10}$, $n_{1m}=$ | 0.0112268 | 0.0078247 | 0.0453333 | 0.0430493 | 0.0410388 |
| When $k_1 \geq k_{10}$, $k_{1m}=$ | 0.0149072 | 0.0196375 | 0.0173291 | 0.0473206 | 0.0467871 |
| When $k_1 < k_{10}$, $k_{1m}=$ | 0.0262830 | 0.0141846 | 0.0154602 | 0.0372058 | 0.0305029 |
| When $d_1 \geq d_{10}$, $d_{1m}$ (nm) = | 19.247 | ∞ | 2.276 | ∞ | ∞ |
| When $d_1 < d_{10}$, $d_{1m}$ (nm) = | 3.447 | 2.046 | 19.587 | 24.997 | 50.391 |
| When $n_2 \geq n_{20}$, $n_{2m}=$ | 0.0348413 | 0.0672729 | 0.1107800 | 0.1391333 | 0.2394653 |
| When $n_2 < n_{20}$, $n_{2m}=$ | 0.0292676 | 0.0106921 | 0.0107263 | 0.0732312 | 0.0890649 |
| When $k_2 \geq k_{20}$, $k_{2m}=$ | 0.0073389 | 0.0081616 | 0.0597644 | 0.1152246 | 0.1047815 |
| When $k_2 < k_{20}$, $k_{2m}=$ | 0.0445459 | 0.0504346 | 0.0379138 | 0.0797473 | 0.0602527 |
| When $d_2 \geq d_{20}$, $d_{2m}$ (nm) = | 6.326 | 35.781 | 32.689 | ∞ | ∞ |
| When $d_2 < d_{20}$, $d_{2m}$ (nm) = | 11.802 | 2.505 | 1.901 | 20.558 | 36.515 |

1. 1 < N A ≤ 1. 2
45 < T ≤ 55

| Case | 5-11 | 5-12 | 5-13 |
|---|---|---|---|
| $n_{10}$ | 1.6941096 | 1.7000691 | 1.6987341 |
| $k_{10}$ | 0.0560046 | 0.0669711 | 0.0608862 |
| $d_{10}$ (nm) | 215.482 | 264.757 | 263.855 |
| $n_{20}$ | 1.6938988 | 1.6924460 | 1.6911373 |
| $k_{20}$ | 0.1599964 | 0.2378630 | 0.1924284 |
| $d_{20}$ (nm) | 287.470 | 184.028 | 243.250 |

| | | 5-11 | 5-12 | 5-13 |
|---|---|---|---|---|
| When $n_1 \geq n_{10}$, | $n_{1m}=$ | 0.0468335 | 0.0484424 | 0.0766663 |
| When $n_1 < n_{10}$, | $n_{1m}=$ | 0.0625427 | 0.0333350 | 0.0582520 |
| When $k_1 \geq k_{10}$, | $k_{1m}=$ | 0.0574133 | 0.0424146 | 0.0503235 |
| When $k_1 < k_{10}$, | $k_{1m}=$ | 0.0373425 | 0.0336023 | 0.0357239 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 47.031 | 45.336 | 115.043 |
| When $n_2 \geq n_{20}$, | $n_{2m}=$ | 0.2184277 | 0.3156848 | 0.3032751 |
| When $n_2 < n_{20}$, | $n_{2m}=$ | 0.1528296 | 0.2586377 | 0.2107019 |
| When $k_2 \geq k_{20}$, | $k_{2m}=$ | 0.1238171 | 0.2073083 | 0.2191870 |
| When $k_2 < k_{20}$, | $k_{2m}=$ | 0.0588196 | 0.0981323 | 0.0862329 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 85.352 | 66.135 | 78.131 |

1. 1 < N A ≤ 1. 2
55 < T ≤ 65

| Case | 6-01 | 6-02 | 6-03 | 6-04 | 6-05 |
|---|---|---|---|---|---|
| $n_{10}$ | 1.8998120 | 1.9599431 | 1.8792360 | 1.8920036 | 1.7198405 |
| $k_{10}$ | 0.2622743 | 0.1538418 | 0.1119058 | 0.0671877 | 0.0878543 |
| $d_{10}$ (nm) | 21.573 | 15.993 | 12.895 | 11.926 | 93.971 |
| $n_{20}$ | 1.6944131 | 1.7907917 | 1.6940206 | 1.7462722 | 1.6452515 |
| $k_{20}$ | 0.7809017 | 0.4780154 | 0.2681658 | 0.2347435 | 0.2473168 |
| $d_{20}$ (nm) | 53.320 | 111.028 | 231.714 | 280.522 | 169.419 |

| | | 6-01 | 6-02 | 6-03 | 6-04 | 6-05 |
|---|---|---|---|---|---|---|
| When $n_1 \geq n_{10}$, | $n_{1m}=$ | 0.0603137 | 0.0799158 | 0.1051331 | 0.1164221 | 0.0325574 |
| When $n_1 < n_{10}$, | $n_{1m}=$ | 0.0246228 | 0.0339001 | 0.0713818 | 0.0790796 | 0.0109656 |
| When $k_1 \geq k_{10}$, | $k_{1m}=$ | 0.0436731 | 0.0463733 | 0.0957117 | 0.1011499 | 0.0282458 |
| When $k_1 < k_{10}$, | $k_{1m}=$ | 0.0527222 | 0.0842969 | 0.1045093 | 0.0671877 | 0.0383301 |
| When $d_1 \geq d_{10}$, | $d_{1m}$ (nm) $=$ | 3.630 | 4.315 | 6.630 | 7.111 | 10.486 |
| When $d_1 < d_{10}$, | $d_{1m}$ (nm) $=$ | 1.338 | 1.548 | 4.149 | 4.416 | 2.879 |
| When $n_2 \geq n_{20}$, | $n_{2m}=$ | 0.1220337 | 0.0996899 | 0.0944202 | 0.0992114 | 0.0312585 |
| When $n_2 < n_{20}$, | $n_{2m}=$ | 0.0963342 | 0.1728088 | 0.1384424 | 0.1517053 | 0.0751245 |
| When $k_2 \geq k_{20}$, | $k_{2m}=$ | 0.0896167 | 0.0986731 | 0.0889478 | 0.0981226 | 0.0215662 |
| When $k_2 < k_{20}$, | $k_{2m}=$ | 0.0868945 | 0.0892566 | 0.0826782 | 0.0802551 | 0.0503503 |
| When $d_2 \geq d_{20}$, | $d_{2m}$ (nm) $=$ | 14.581 | ∞ | ∞ | ∞ | 10.833 |
| When $d_2 < d_{20}$, | $d_{2m}$ (nm) $=$ | 7.202 | 14.530 | 88.193 | 126.095 | 17.275 |

1. 1 < N A ≤ 1. 2
5 5 < T ≤ 6 5

| Case | 6-06 | 6-07 | 6-08 | 6-09 | 6-10 |
|---|---|---|---|---|---|
| $n_{10}$ | 1.7267515 | 1.7286377 | 1.7058235 | 1.6871196 | 1.6936372 |
| $k_{10}$ | 0.0746914 | 0.0697592 | 0.0740364 | 0.0856014 | 0.0616799 |
| $d_{10}$ (nm) | 93.982 | 94.711 | 163.674 | 208.540 | 218.466 |
| $n_{20}$ | 1.7088385 | 1.7257237 | 1.6690540 | 1.6832134 | 1.6877720 |
| $k_{20}$ | 0.2076415 | 0.1796886 | 0.2306007 | 0.3092532 | 0.1900717 |
| $d_{20}$ (nm) | 218.911 | 273.487 | 161.946 | 121.170 | 218.772 |

| | | 6-06 | 6-07 | 6-08 | 6-09 | 6-10 |
|---|---|---|---|---|---|---|
| When $n_1 \geq n_{10}$, | $n_{1m}=$ | 0.0431396 | 0.0483069 | 0.0312061 | 0.0049573 | 0.0327710 |
| When $n_1 < n_{10}$, | $n_{1m}=$ | 0.0172424 | 0.0116125 | 0.0175793 | 0.0417786 | 0.0401648 |
| When $k_1 \geq k_{10}$, | $k_{1m}=$ | 0.0418896 | 0.0318958 | 0.0202844 | 0.0152393 | 0.0462805 |
| When $k_1 < k_{10}$, | $k_{1m}=$ | 0.0396252 | 0.0362695 | 0.0328467 | 0.0174036 | 0.0298352 |
| When $d_1 \geq d_{10}$, | $d_{1m}$ (nm) $=$ | 17.247 | 40.127 | 17.394 | 2.172 | ∞ |
| When $d_1 < d_{10}$, | $d_{1m}$ (nm) $=$ | 4.621 | 3.300 | 5.870 | 18.309 | 47.643 |
| When $n_2 \geq n_{20}$, | $n_{2m}=$ | 0.0684570 | 0.0868091 | 0.0312744 | 0.1009155 | 0.2431030 |
| When $n_2 < n_{20}$, | $n_{2m}=$ | 0.0962207 | 0.1095422 | 0.0318677 | 0.0098169 | 0.0838513 |
| When $k_2 \geq k_{20}$, | $k_{2m}=$ | 0.0394080 | 0.0515259 | 0.0123767 | 0.0719922 | 0.1060815 |
| When $k_2 < k_{20}$, | $k_{2m}=$ | 0.0553357 | 0.0549243 | 0.0471436 | 0.0304236 | 0.0607056 |
| When $d_2 \geq d_{20}$, | $d_{2m}$ (nm) $=$ | ∞ | ∞ | 9.995 | 25.676 | ∞ |
| When $d_2 < d_{20}$, | $d_{2m}$ (nm) $=$ | 15.791 | 73.815 | 10.017 | 1.682 | 28.435 |

1. 1 < N A ≤ 1. 2
5 5 < T ≤ 6 5

| Case | 6-11 | 6-12 |
|---|---|---|
| $n_{10}$ | 1.6996002 | 1.6985143 |
| $k_{10}$ | 0.0674630 | 0.0611760 |
| $d_{10}$ (nm) | 264.231 | 263.586 |
| $n_{20}$ | 1.6851097 | 1.6903246 |
| $k_{20}$ | 0.2396601 | 0.1936289 |
| $d_{20}$ (nm) | 175.944 | 234.054 |

| | | 6-11 | 6-12 |
|---|---|---|---|
| When $n_1 \geq n_{10}$, | $n_{1m}=$ | 0.0469604 | 0.0772302 |
| When $n_1 < n_{10}$, | $n_{1m}=$ | 0.0345850 | 0.0600415 |
| When $k_1 \geq k_{10}$, | $k_{1m}=$ | 0.0413989 | 0.0503625 |
| When $k_1 < k_{10}$, | $k_{1m}=$ | 0.0326746 | 0.0352795 |
| When $d_1 \geq d_{10}$, | $d_{1m}$ (nm) $=$ | ∞ | ∞ |
| When $d_1 < d_{10}$, | $d_{1m}$ (nm) $=$ | 35.789 | 113.370 |
| When $n_2 \geq n_{20}$, | $n_{2m}=$ | 0.3361853 | 0.3175012 |
| When $n_2 < n_{20}$, | $n_{2m}=$ | 0.2595898 | 0.2115027 |
| When $k_2 \geq k_{20}$, | $k_{2m}=$ | 0.2087170 | 0.2189661 |
| When $k_2 < k_{20}$, | $k_{2m}=$ | 0.0954248 | 0.0859949 |
| When $d_2 \geq d_{20}$, | $d_{2m}$ (nm) $=$ | ∞ | ∞ |
| When $d_2 < d_{20}$, | $d_{2m}$ (nm) $=$ | 64.780 | 74.733 |

1. 1 < N A ≤ 1. 2
6 5 < T ≤ 7 5

| Case | 7-01 | 7-02 | 7-03 | 7-04 | 7-05 |
|---|---|---|---|---|---|
| $n_{10}$ | 1.8814830 | 1.9657443 | 1.8787154 | 1.8913468 | 1.7209187 |
| $k_{10}$ | 0.2936564 | 0.1688741 | 0.1109169 | 0.0695388 | 0.0883668 |
| $d_{10}$ (nm) | 22.098 | 15.852 | 13.263 | 12.162 | 94.055 |
| $n_{20}$ | 1.6321609 | 1.7726563 | 1.6996278 | 1.7469121 | 1.6482914 |
| $k_{20}$ | 0.8097385 | 0.4923001 | 0.2745566 | 0.2387131 | 0.2540527 |
| $d_{20}$ (nm) | 46.190 | 103.170 | 220.404 | 270.807 | 158.511 |

| | | 7-01 | 7-02 | 7-03 | 7-04 | 7-05 |
|---|---|---|---|---|---|---|
| When $n_1 \geq n_{10}$, | $n_{1m} =$ | 0.0656360 | 0.0817346 | 0.1037085 | 0.1149512 | 0.0333252 |
| When $n_1 < n_{10}$, | $n_{1m} =$ | 0.0241089 | 0.0282544 | 0.0702112 | 0.0769897 | 0.0127490 |
| When $k_1 \geq k_{10}$, | $k_{1m} =$ | 0.0378577 | 0.0400220 | 0.0934888 | 0.0991272 | 0.0301257 |
| When $k_1 < k_{10}$, | $k_{1m} =$ | 0.0323035 | 0.0824512 | 0.1025916 | 0.0695388 | 0.0388867 |
| When $d_1 \geq d_{10}$, | $d_{1m}$ (nm) $=$ | 3.610 | 3.980 | 6.711 | 7.159 | 10.691 |
| When $d_1 < d_{10}$, | $d_{1m}$ (nm) $=$ | 1.297 | 1.237 | 4.191 | 4.366 | 3.330 |
| When $n_2 \geq n_{20}$, | $n_{2m} =$ | 0.1024585 | 0.0947095 | 0.0935791 | 0.1004138 | 0.0355066 |
| When $n_2 < n_{20}$, | $n_{2m} =$ | 0.0645630 | 0.1828857 | 0.1422339 | 0.1540833 | 0.0767798 |
| When $k_2 \geq k_{20}$, | $k_{2m} =$ | 0.0898303 | 0.0894482 | 0.0904114 | 0.0989551 | 0.0244946 |
| When $k_2 < k_{20}$, | $k_{2m} =$ | 0.1003796 | 0.0949036 | 0.0851941 | 0.0816284 | 0.0535193 |
| When $d_2 \geq d_{20}$, | $d_{2m}$ (nm) $=$ | 11.613 | ∞ | ∞ | ∞ | 11.010 |
| When $d_2 < d_{20}$, | $d_{2m}$ (nm) $=$ | 4.416 | 10.112 | 84.053 | 124.915 | 16.505 |

1. 1 < N A ≤ 1. 2
6 5 < T ≤ 7 5

| Case | 7-06 | 7-07 | 7-08 | 7-09 | 7-10 |
|---|---|---|---|---|---|
| $n_{10}$ | 1.7288665 | 1.7286370 | 1.7068032 | 1.6862856 | 1.6931399 |
| $k_{10}$ | 0.0756184 | 0.0709992 | 0.0744994 | 0.0878163 | 0.0624918 |
| $d_{10}$ (nm) | 94.090 | 94.923 | 163.814 | 208.124 | 217.968 |
| $n_{20}$ | 1.7153723 | 1.7241262 | 1.6739446 | 1.6736237 | 1.6872372 |
| $k_{20}$ | 0.2125971 | 0.1831189 | 0.2371534 | 0.3138657 | 0.1926334 |
| $d_{20}$ (nm) | 207.924 | 263.961 | 151.052 | 112.320 | 209.546 |

| | | 7-06 | 7-07 | 7-08 | 7-09 | 7-10 |
|---|---|---|---|---|---|---|
| When $n_1 \geq n_{10}$, | $n_{1m} =$ | 0.0437573 | 0.0483350 | 0.0322754 | 0.0025049 | 0.0316833 |
| When $n_1 < n_{10}$, | $n_{1m} =$ | 0.0164966 | 0.0099878 | 0.0175537 | 0.0409570 | 0.0419177 |
| When $k_1 \geq k_{10}$, | $k_{1m} =$ | 0.0410425 | 0.0291785 | 0.0221094 | 0.0095605 | 0.0459827 |
| When $k_1 < k_{10}$, | $k_{1m} =$ | 0.0388428 | 0.0344531 | 0.0333215 | 0.0151172 | 0.0300720 |
| When $d_1 \geq d_{10}$, | $d_{1m}$ (nm) $=$ | 17.329 | 38.775 | 18.851 | 1.009 | ∞ |
| When $d_1 < d_{10}$, | $d_{1m}$ (nm) $=$ | 4.318 | 2.813 | 6.154 | 17.032 | 45.887 |
| When $n_2 \geq n_{20}$, | $n_{2m} =$ | 0.0710437 | 0.0893457 | 0.0302136 | 0.1037878 | 0.2406421 |
| When $n_2 < n_{20}$, | $n_{2m} =$ | 0.0969080 | 0.1083484 | 0.0331750 | 0.0056763 | 0.0830054 |
| When $k_2 \geq k_{20}$, | $k_{2m} =$ | 0.0400586 | 0.0500842 | 0.0147241 | 0.0658289 | 0.1059290 |
| When $k_2 < k_{20}$, | $k_{2m} =$ | 0.0574512 | 0.0562378 | 0.0506323 | 0.0175342 | 0.0630762 |
| When $d_2 \geq d_{20}$, | $d_{2m}$ (nm) $=$ | ∞ | ∞ | 10.293 | 26.205 | ∞ |
| When $d_2 < d_{20}$, | $d_{2m}$ (nm) $=$ | 13.701 | 72.849 | 8.984 | 0.992 | 28.220 |

## 1. $1 < NA \leq 1.2$
### $65 < T \leq 75$

| Case | 7-11 | 7-12 | 7-13 |
|---|---|---|---|
| $n_{10}$ | 1.6935780 | 1.6987845 | 1.6982075 |
| $k_{10}$ | 0.0575917 | 0.0682876 | 0.0620058 |
| $d_{10}$ (nm) | 214.501 | 264.829 | 264.409 |
| $n_{20}$ | 1.6927449 | 1.6826884 | 1.6907687 |
| $k_{20}$ | 0.1631490 | 0.2430960 | 0.1959423 |
| $d_{20}$ (nm) | 269.036 | 164.540 | 222.065 |

| | 7-11 | 7-12 | 7-13 |
|---|---|---|---|
| When $n_1 \geq n_{10}$, $n_{1m} =$ | 0.0479456 | 0.0478223 | 0.0756042 |
| When $n_1 < n_{10}$, $n_{1m} =$ | 0.0597888 | 0.0375256 | 0.0523840 |
| When $k_1 \geq k_{10}$, $k_{1m} =$ | 0.0567029 | 0.0406042 | 0.0502747 |
| When $k_1 < k_{10}$, $k_{1m} =$ | 0.0379382 | 0.0306238 | 0.0354358 |
| When $d_1 \geq d_{10}$, $d_{1m}$ (nm) $=$ | ∞ | ∞ | ∞ |
| When $d_1 < d_{10}$, $d_{1m}$ (nm) $=$ | 42.775 | 36.115 | 105.289 |
| When $n_2 \geq n_{20}$, $n_{2m} =$ | 0.2180396 | 0.3702002 | 0.3412915 |
| When $n_2 < n_{20}$, $n_{2m} =$ | 0.1575122 | 0.2565369 | 0.2093115 |
| When $k_2 \geq k_{20}$, $k_{2m} =$ | 0.1278589 | 0.2070850 | 0.2215063 |
| When $k_2 < k_{20}$, $k_{2m} =$ | 0.0614197 | 0.0951270 | 0.0864294 |
| When $d_2 \geq d_{20}$, $d_{2m}$ (nm) $=$ | ∞ | ∞ | ∞ |
| When $d_2 < d_{20}$, $d_{2m}$ (nm) $=$ | 81.766 | 63.144 | 76.945 |

## 1. $1 < NA \leq 1.2$
### $75 < T \leq 85$

| Case | 8-01 | 8-02 | 8-03 | 8-04 | 8-05 |
|---|---|---|---|---|---|
| $n_{10}$ | 1.8508920 | 1.9432602 | 1.8788012 | 1.8809660 | 1.8914032 |
| $k_{10}$ | 0.3299462 | 0.1828608 | 0.1571474 | 0.1122948 | 0.0691945 |
| $d_{10}$ (nm) | 26.713 | 18.534 | 15.200 | 13.670 | 12.762 |
| $n_{20}$ | 1.6561984 | 1.7922587 | 1.6553949 | 1.7045069 | 1.7559855 |
| $k_{20}$ | 1.0215947 | 0.5435792 | 0.3498651 | 0.2862016 | 0.2487147 |
| $d_{20}$ (nm) | 31.481 | 89.452 | 157.519 | 210.391 | 259.753 |

| | 8-01 | 8-02 | 8-03 | 8-04 | 8-05 |
|---|---|---|---|---|---|
| When $n_1 \geq n_{10}$, $n_{1m} =$ | 0.0584900 | 0.0721143 | 0.0859290 | 0.1006885 | 0.1098987 |
| When $n_1 < n_{10}$, $n_{1m} =$ | 0.0118384 | 0.0258594 | 0.0490076 | 0.0672168 | 0.0736646 |
| When $k_1 \geq k_{10}$, $k_{1m} =$ | 0.0281628 | 0.0341772 | 0.0681653 | 0.0888281 | 0.0935315 |
| When $k_1 < k_{10}$, $k_{1m} =$ | 0.0027112 | 0.0735254 | 0.0892920 | 0.1016174 | 0.0691945 |
| When $d_1 \geq d_{10}$, $d_{1m}$ (nm) $=$ | 3.227 | 4.317 | 5.436 | 6.605 | 7.111 |
| When $d_1 < d_{10}$, $d_{1m}$ (nm) $=$ | 0.304 | 1.291 | 2.967 | 4.063 | 4.341 |
| When $n_2 \geq n_{20}$, $n_{2m} =$ | 0.1267358 | 0.0961279 | 0.0835156 | 0.0933350 | 0.1000793 |
| When $n_2 < n_{20}$, $n_{2m} =$ | 0.0093018 | 0.1747852 | 0.1389221 | 0.1466003 | 0.1520386 |
| When $k_2 \geq k_{20}$, $k_{2m} =$ | 0.0170300 | 0.1198535 | 0.0846472 | 0.0918018 | 0.1012305 |
| When $k_2 < k_{20}$, $k_{2m} =$ | 0.1219019 | 0.1040369 | 0.0912122 | 0.0867468 | 0.0829492 |
| When $d_2 \geq d_{20}$, $d_{2m}$ (nm) $=$ | 8.195 | ∞ | ∞ | ∞ | ∞ |
| When $d_2 < d_{20}$, $d_{2m}$ (nm) $=$ | 0.369 | 9.559 | 36.990 | 78.480 | 119.640 |

1. 1 < N A ≦ 1 . 2
7 5 < T ≦ 8 5

| Case | 8-06 | 8-07 | 8-08 | 8-09 | 8-10 |
|---|---|---|---|---|---|
| $n_{10}$ | 1.7233184 | 1.7297992 | 1.7292921 | 1.7076375 | 1.6902915 |
| $k_{10}$ | 0.0905387 | 0.0774990 | 0.0722395 | 0.0765186 | 0.0790058 |
| $d_{10}$ (nm) | 94.254 | 94.232 | 94.957 | 163.992 | 206.654 |
| $n_{20}$ | 1.6520214 | 1.7157415 | 1.7247476 | 1.6752795 | 1.6879680 |
| $k_{20}$ | 0.2670378 | 0.2209454 | 0.1892941 | 0.2482558 | 0.2475793 |
| $d_{20}$ (nm) | 148.504 | 198.899 | 254.857 | 141.650 | 161.284 |

| | | 8-06 | 8-07 | 8-08 | 8-09 | 8-10 |
|---|---|---|---|---|---|---|
| When $n_1 \geq n_{10}$, | $n_{1m} =$ | 0.0327246 | 0.0427734 | 0.0473462 | 0.0318115 | 0.0212964 |
| When $n_1 < n_{10}$, | $n_{1m} =$ | 0.0093958 | 0.0147302 | 0.0094299 | 0.0087695 | 0.0407813 |
| When $k_1 \geq k_{10}$, | $k_{1m} =$ | 0.0245129 | 0.0376636 | 0.0278931 | 0.0137170 | 0.0408545 |
| When $k_1 < k_{10}$, | $k_{1m} =$ | 0.0384680 | 0.0381934 | 0.0341284 | 0.0285461 | 0.0259851 |
| When $d_1 \geq d_{10}$, | $d_{1m}$ (nm) $=$ | 10.366 | 16.607 | 38.446 | 19.131 | 18.064 |
| When $d_1 < d_{10}$, | $d_{1m}$ (nm) $=$ | 2.389 | 3.804 | 2.614 | 2.661 | 24.299 |
| When $n_2 \geq n_{20}$, | $n_{2m} =$ | 0.0285376 | 0.0673352 | 0.0815320 | 0.0313904 | 0.1426208 |
| When $n_2 < n_{20}$, | $n_{2m} =$ | 0.0743250 | 0.0929968 | 0.1051160 | 0.0237683 | 0.0535938 |
| When $k_2 \geq k_{20}$, | $k_{2m} =$ | 0.0198962 | 0.0371387 | 0.0465576 | 0.0076379 | 0.0976270 |
| When $k_2 < k_{20}$, | $k_{2m} =$ | 0.0547290 | 0.0576892 | 0.0565930 | 0.0508740 | 0.0749768 |
| When $d_2 \geq d_{20}$, | $d_{2m}$ (nm) $=$ | 8.585 | ∞ | ∞ | 6.981 | ∞ |
| When $d_2 < d_{20}$, | $d_{2m}$ (nm) $=$ | 13.959 | 13.822 | 33.284 | 7.469 | 13.904 |

1. 1 < N A ≦ 1 . 2
7 5 < T ≦ 8 5

| Case | 8-11 | 8-12 | 8-13 | 8-14 | 8-15 |
|---|---|---|---|---|---|
| $n_{10}$ | 1.6929156 | 1.6935338 | 1.6984313 | 1.6980068 | 1.6970347 |
| $k_{10}$ | 0.0637318 | 0.0581307 | 0.0697413 | 0.0633264 | 0.0530849 |
| $d_{10}$ (nm) | 217.693 | 214.870 | 266.256 | 265.782 | 275.682 |
| $n_{20}$ | 1.6856131 | 1.6920922 | 1.6871666 | 1.6912942 | 1.6884244 |
| $k_{20}$ | 0.1973081 | 0.1667488 | 0.2538157 | 0.2022310 | 0.1714348 |
| $d_{20}$ (nm) | 201.188 | 259.776 | 152.235 | 210.360 | 256.304 |

| | | 8-11 | 8-12 | 8-13 | 8-14 | 8-15 |
|---|---|---|---|---|---|---|
| When $n_1 \geq n_{10}$, | $n_{1m} =$ | 0.0321716 | 0.0471802 | 0.0486719 | 0.0738318 | 0.0569543 |
| When $n_1 < n_{10}$, | $n_{1m} =$ | 0.0414331 | 0.0603931 | 0.0363989 | 0.0470300 | 0.0427893 |
| When $k_1 \geq k_{10}$, | $k_{1m} =$ | 0.0451428 | 0.0559961 | 0.0398804 | 0.0494763 | 0.0598206 |
| When $k_1 < k_{10}$, | $k_{1m} =$ | 0.0289417 | 0.0378210 | 0.0291638 | 0.0345105 | 0.0376172 |
| When $d_1 \geq d_{10}$, | $d_{1m}$ (nm) $=$ | ∞ | ∞ | ∞ | ∞ | ∞ |
| When $d_1 < d_{10}$, | $d_{1m}$ (nm) $=$ | 45.410 | 42.667 | 37.515 | 100.900 | 104.445 |
| When $n_2 \geq n_{20}$, | $n_{2m} =$ | 0.2377576 | 0.2179382 | 0.2594739 | 0.3590393 | 0.2768311 |
| When $n_2 < n_{20}$, | $n_{2m} =$ | 0.0859351 | 0.1565027 | 0.2556433 | 0.2089795 | 0.2197266 |
| When $k_2 \geq k_{20}$, | $k_{2m} =$ | 0.1024292 | 0.1246008 | 0.1994592 | 0.2211169 | 0.1929004 |
| When $k_2 < k_{20}$, | $k_{2m} =$ | 0.0656946 | 0.0632471 | 0.1014087 | 0.0895886 | 0.0738538 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 33.167 | 82.155 | 62.366 | 73.160 | 83.598 |

1. 1 < N A ≦ 1. 2
8 5 < T ≦ 9 5

| Case | 9-01 | 9-02 | 9-03 | 9-04 | 9-05 |
|---|---|---|---|---|---|
| $n_{10}$ | 1.9192397 | 1.8910111 | 1.8874292 | 1.8928956 | 1.7266669 |
| $k_{10}$ | 0.1987767 | 0.1570861 | 0.1170062 | 0.0800147 | 0.0953661 |
| $d_{10}$ (nm) | 21.654 | 15.844 | 13.907 | 12.695 | 94.323 |
| $n_{20}$ | 1.8264016 | 1.6782576 | 1.7063011 | 1.7424852 | 1.6542284 |
| $k_{20}$ | 0.6189774 | 0.3828036 | 0.3024107 | 0.2571531 | 0.2869718 |
| $d_{20}$ (nm) | 76.882 | 146.288 | 201.867 | 254.323 | 139.595 |

| | | 9-01 | 9-02 | 9-03 | 9-04 | 9-05 |
|---|---|---|---|---|---|---|
| When $n_1 \geq n_{10}$, | $n_{1m} =$ | 0.0649170 | 0.0821021 | 0.0973254 | 0.1089844 | 0.0299609 |
| When $n_1 < n_{10}$, | $n_{1m} =$ | 0.0262927 | 0.0442981 | 0.0631677 | 0.0721631 | 0.0018164 |
| When $k_1 \geq k_{10}$, | $k_{1m} =$ | 0.0313647 | 0.0611023 | 0.0836865 | 0.0928955 | 0.0075598 |
| When $k_1 < k_{10}$, | $k_{1m} =$ | 0.0678699 | 0.0898816 | 0.1010254 | 0.0800147 | 0.0251917 |
| When $d_1 \geq d_{10}$, | $d_{1m}$ (nm) $=$ | 4.482 | 5.181 | 6.239 | 6.859 | 9.178 |
| When $d_1 < d_{10}$, | $d_{1m}$ (nm) $=$ | 1.480 | 2.625 | 3.732 | 4.138 | 0.436 |
| When $n_2 \geq n_{20}$, | $n_{2m} =$ | 0.0987671 | 0.0845752 | 0.0932324 | 0.0997229 | 0.0068860 |
| When $n_2 < n_{20}$, | $n_{2m} =$ | 0.1650610 | 0.1381567 | 0.1431714 | 0.1501294 | 0.0677319 |
| When $k_2 \geq k_{20}$, | $k_{2m} =$ | 0.1657446 | 0.0892700 | 0.0918542 | 0.0980688 | 0.0046692 |
| When $k_2 < k_{20}$, | $k_{2m} =$ | 0.1121045 | 0.0937854 | 0.0873950 | 0.0830798 | 0.0530042 |
| When $d_2 \geq d_{20}$, | $d_{2m}$ (nm) $=$ | ∞ | ∞ | ∞ | ∞ | 2.101 |
| When $d_2 < d_{20}$, | $d_{2m}$ (nm) $=$ | 12.789 | 29.518 | 73.873 | 87.951 | 11.267 |

1. 1 < N A ≦ 1. 2
8 5 < T ≦ 9 5

| Case | 9-06 | 9-07 | 9-08 | 9-09 | 9-10 |
|---|---|---|---|---|---|
| $n_{10}$ | 1.7296393 | 1.7299249 | 1.6899362 | 1.6928826 | 1.6935628 |
| $k_{10}$ | 0.0805906 | 0.0737621 | 0.0817785 | 0.0657282 | 0.0590519 |
| $d_{10}$ (nm) | 94.242 | 94.784 | 208.164 | 217.665 | 215.464 |
| $n_{20}$ | 1.7097783 | 1.7252153 | 1.6924320 | 1.6832004 | 1.6914497 |
| $k_{20}$ | 0.2319224 | 0.1970612 | 0.2651701 | 0.2055611 | 0.1728158 |
| $d_{20}$ (nm) | 191.543 | 246.491 | 148.618 | 193.166 | 250.826 |

| | | 9-06 | 9-07 | 9-08 | 9-09 | 9-10 |
|---|---|---|---|---|---|---|
| When $n_1 \geq n_{10}$, | $n_{1m} =$ | 0.0403186 | 0.0454016 | 0.0167883 | 0.0332178 | 0.0456592 |
| When $n_1 < n_{10}$, | $n_{1m} =$ | 0.0112720 | 0.0089185 | 0.0424597 | 0.0374463 | 0.0611377 |
| When $k_1 \geq k_{10}$, | $k_{1m} =$ | 0.0312561 | 0.0265295 | 0.0332300 | 0.0436560 | 0.0547620 |
| When $k_1 < k_{10}$, | $k_{1m} =$ | 0.0359937 | 0.0340186 | 0.0176221 | 0.0271997 | 0.0369495 |
| When $d_1 \geq d_{10}$, | $d_{1m}$ (nm) $=$ | 14.915 | 25.988 | 8.734 | ∞ | ∞ |
| When $d_1 < d_{10}$, | $d_{1m}$ (nm) $=$ | 2.867 | 2.423 | 22.681 | 45.245 | 43.081 |
| When $n_2 \geq n_{20}$, | $n_{2m} =$ | 0.0542737 | 0.0673303 | 0.1469031 | 0.2426758 | 0.2225391 |
| When $n_2 < n_{20}$, | $n_{2m} =$ | 0.0873267 | 0.0993994 | 0.0330542 | 0.0887622 | 0.1544177 |
| When $k_2 \geq k_{20}$, | $k_{2m} =$ | 0.0292090 | 0.0400476 | 0.0700159 | 0.0962317 | 0.1187769 |
| When $k_2 < k_{20}$, | $k_{2m} =$ | 0.0563428 | 0.0561450 | 0.0687061 | 0.0675110 | 0.0629883 |
| When $d_2 \geq d_{20}$, | $d_{2m}$ (nm) $=$ | 39.648 | ∞ | ∞ | ∞ | ∞ |
| When $d_2 < d_{20}$, | $d_{2m}$ (nm) $=$ | 14.552 | 29.955 | 9.727 | 29.747 | 77.934 |

1. 1 < N A ≤ 1. 2
8 5 < T ≤ 9 5

| Case | 9-11 | 9-12 | 9-13 |
|---|---|---|---|
| $n_{10}$ | 1.6988269 | 1.6981501 | 1.6968464 |
| $k_{10}$ | 0.0719884 | 0.0650380 | 0.0544760 |
| $d_{10}$ (nm) | 266.949 | 266.102 | 275.663 |
| $n_{20}$ | 1.6930572 | 1.6910453 | 1.6860880 |
| $k_{20}$ | 0.2717519 | 0.2123559 | 0.1778694 |
| $d_{20}$ (nm) | 142.233 | 201.439 | 248.323 |

| | | 9-11 | 9-12 | 9-13 |
|---|---|---|---|---|
| When $n_1 \geq n_{10}$, | $n_{1m} =$ | 0.0467688 | 0.0728052 | 0.0574890 |
| When $n_1 < n_{10}$, | $n_{1m} =$ | 0.0315735 | 0.0440601 | 0.0431165 |
| When $k_1 \geq k_{10}$, | $k_{1m} =$ | 0.0383911 | 0.0476294 | 0.0587781 |
| When $k_1 < k_{10}$, | $k_{1m} =$ | 0.0284839 | 0.0337549 | 0.0370691 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 35.571 | 98.568 | 104.018 |
| When $n_2 \geq n_{20}$, | $n_{2m} =$ | 0.2475818 | 0.3536121 | 0.2819006 |
| When $n_2 < n_{20}$, | $n_{2m} =$ | 0.2616077 | 0.2147424 | 0.2120007 |
| When $k_2 \geq k_{20}$, | $k_{2m} =$ | 0.1929529 | 0.2177991 | 0.1925061 |
| When $k_2 < k_{20}$, | $k_{2m} =$ | 0.1103821 | 0.0937061 | 0.0749585 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 61.377 | 69.390 | 80.535 |

1. 1 < N A ≤ 1. 2
9 5 < T ≤ 1 0 5

| Case | 10-01 | 10-02 | 10-03 | 10-04 | 10-05 |
|---|---|---|---|---|---|
| $n_{10}$ | 1.9207610 | 1.9093240 | 1.8948938 | 1.8966282 | 1.7293323 |
| $k_{10}$ | 0.2195112 | 0.1610220 | 0.1257399 | 0.0900141 | 0.0843251 |
| $d_{10}$ (nm) | 22.312 | 16.027 | 13.855 | 12.530 | 93.974 |
| $n_{20}$ | 1.8258536 | 1.6981498 | 1.7003095 | 1.7305926 | 1.7018671 |
| $k_{20}$ | 0.6986358 | 0.4189775 | 0.3177305 | 0.2658040 | 0.2432029 |
| $d_{20}$ (nm) | 68.737 | 136.163 | 194.613 | 248.346 | 184.391 |

| | | 10-01 | 10-02 | 10-03 | 10-04 | 10-05 |
|---|---|---|---|---|---|---|
| When $n_1 \geq n_{10}$, | $n_{1m} =$ | 0.0601465 | 0.0788086 | 0.0949231 | 0.1082007 | 0.0364734 |
| When $n_1 < n_{10}$, | $n_{1m} =$ | 0.0227283 | 0.0400269 | 0.0595679 | 0.0706311 | 0.0069092 |
| When $k_1 \geq k_{10}$, | $k_{1m} =$ | 0.0253723 | 0.0545032 | 0.0804407 | 0.0926099 | 0.0227478 |
| When $k_1 < k_{10}$, | $k_{1m} =$ | 0.0628345 | 0.0889185 | 0.1005603 | 0.0900141 | 0.0311768 |
| When $d_1 \geq d_{10}$, | $d_{1m}$ (nm) $=$ | 3.994 | 4.715 | 5.765 | 6.514 | 12.891 |
| When $d_1 < d_{10}$, | $d_{1m}$ (nm) $=$ | 1.248 | 2.209 | 3.348 | 3.879 | 1.711 |
| When $n_2 \geq n_{20}$, | $n_{2m} =$ | 0.0792419 | 0.0821826 | 0.0922205 | 0.0989185 | 0.0380920 |
| When $n_2 < n_{20}$, | $n_{2m} =$ | 0.1602795 | 0.1375000 | 0.1411267 | 0.1492065 | 0.0806519 |
| When $k_2 \geq k_{20}$, | $k_{2m} =$ | 0.1589185 | 0.0905359 | 0.0891418 | 0.0944934 | 0.0182117 |
| When $k_2 < k_{20}$, | $k_{2m} =$ | 0.1093127 | 0.0931641 | 0.0864453 | 0.0826196 | 0.0535706 |
| When $d_2 \geq d_{20}$, | $d_{2m}$ (nm) $=$ | $\infty$ | $\infty$ | $\infty$ | $\infty$ | 26.631 |
| When $d_2 < d_{20}$, | $d_{2m}$ (nm) $=$ | 11.170 | 27.297 | 70.361 | 86.529 | 13.056 |

1. 1 < N A ≤ 1. 2
9 5 < T ≤ 1 0 5

| Case | 10-06 | 10-07 | 10-08 | 10-09 | 10-10 |
|---|---|---|---|---|---|
| $n_{10}$ | 1.7301568 | 1.6896128 | 1.6928686 | 1.6935394 | 1.6995193 |
| $k_{10}$ | 0.0757850 | 0.0845530 | 0.0680057 | 0.0604311 | 0.0747728 |
| $d_{10}$ (nm) | 94.458 | 207.994 | 217.789 | 215.751 | 266.467 |
| $n_{20}$ | 1.7237225 | 1.6930315 | 1.6806392 | 1.6908086 | 1.6953349 |
| $k_{20}$ | 0.2045935 | 0.2839311 | 0.2160083 | 0.1799717 | 0.2921202 |
| $d_{20}$ (nm) | 238.500 | 141.193 | 184.741 | 242.024 | 134.479 |

| | | 10-06 | 10-07 | 10-08 | 10-09 | 10-10 |
|---|---|---|---|---|---|---|
| When $n_1 \geq n_{10}$, | $n_{1m}=$ | 0.0430542 | 0.0132361 | 0.0331689 | 0.0442139 | 0.0436938 |
| When $n_1 < n_{10}$, | $n_{1m}=$ | 0.0073706 | 0.0419458 | 0.0316418 | 0.0535156 | 0.0268311 |
| When $k_1 \geq k_{10}$, | $k_{1m}=$ | 0.0232617 | 0.0264368 | 0.0418604 | 0.0531323 | 0.0358801 |
| When $k_1 < k_{10}$, | $k_{1m}=$ | 0.0323706 | 0.0142944 | 0.0250220 | 0.0355676 | 0.0274768 |
| When $d_1 \geq d_{10}$, | $d_{1m}$ (nm) $=$ | 19.826 | 5.860 | ∞ | ∞ | ∞ |
| When $d_1 < d_{10}$, | $d_{1m}$ (nm) $=$ | 1.955 | 19.840 | 44.604 | 42.829 | 18.631 |
| When $n_2 \geq n_{20}$, | $n_{2m}=$ | 0.0534583 | 0.1398230 | 0.2538293 | 0.2308789 | 0.2386206 |
| When $n_2 < n_{20}$, | $n_{2m}=$ | 0.0961475 | 0.0183801 | 0.0879700 | 0.1305579 | 0.2731067 |
| When $k_2 \geq k_{20}$, | $k_{2m}=$ | 0.0309888 | 0.0515918 | 0.0900964 | 0.1145776 | 0.1883105 |
| When $k_2 < k_{20}$, | $k_{2m}=$ | 0.0550842 | 0.0676599 | 0.0668372 | 0.0642163 | 0.1153723 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 28.701 | 3.697 | 28.484 | 75.626 | 22.552 |

1. 1 < N A ≤ 1. 2
9 5 < T ≤ 1 0 5

| Case | 10-11 | 10-12 |
|---|---|---|
| $n_{10}$ | 1.6986281 | 1.6967467 |
| $k_{10}$ | 0.0669339 | 0.0559821 |
| $d_{10}$ (nm) | 265.290 | 275.562 |
| $n_{20}$ | 1.6902923 | 1.6844237 |
| $k_{20}$ | 0.2238725 | 0.1853984 |
| $d_{20}$ (nm) | 194.429 | 239.846 |

| | | 10-11 | 10-12 |
|---|---|---|---|
| When $n_1 \geq n_{10}$, | $n_{1m}=$ | 0.0728162 | 0.0573596 |
| When $n_1 < n_{10}$, | $n_{1m}=$ | 0.0413391 | 0.0430261 |
| When $k_1 \geq k_{10}$, | $k_{1m}=$ | 0.0452283 | 0.0576135 |
| When $k_1 < k_{10}$, | $k_{1m}=$ | 0.0327722 | 0.0361206 |
| When $d_1 \geq d_{10}$, | $d_{1m}$ (nm) $=$ | ∞ | ∞ |
| When $d_1 < d_{10}$, | $d_{1m}$ (nm) $=$ | 90.187 | 103.212 |
| When $n_2 \geq n_{20}$, | $n_{2m}=$ | 0.3400000 | 0.2868152 |
| When $n_2 < n_{20}$, | $n_{2m}=$ | 0.2235767 | 0.2105566 |
| When $k_2 \geq k_{20}$, | $k_{2m}=$ | 0.2178235 | 0.1919788 |
| When $k_2 < k_{20}$, | $k_{2m}=$ | 0.0973718 | 0.0774072 |
| When $d_2 \geq d_{20}$, | $d_{2m}$ (nm) $=$ | ∞ | ∞ |
| When $d_2 < d_{20}$, | $d_{2m}$ (nm) $=$ | 66.928 | 79.000 |

1. $1 < NA \leq 1.2$
$105 < T \leq 115$

| Case | 11-01 | 11-02 | 11-03 | 11-04 | 11-05 |
|---|---|---|---|---|---|
| $n_{10}$ | 1.9214172 | 1.9009993 | 1.8999222 | 1.7289797 | 1.7301397 |
| $k_{10}$ | 0.1753360 | 0.1351301 | 0.0954510 | 0.0876375 | 0.0779683 |
| $d_{10}$ (nm) | 15.452 | 13.611 | 12.469 | 93.472 | 94.062 |
| $n_{20}$ | 1.6804411 | 1.6899586 | 1.7262130 | 1.6943958 | 1.7208177 |
| $k_{20}$ | 0.4367098 | 0.3280314 | 0.2728992 | 0.2513033 | 0.2098777 |
| $d_{20}$ (nm) | 129.893 | 187.370 | 240.318 | 176.630 | 230.281 |

| | | 11-01 | 11-02 | 11-03 | 11-04 | 11-05 |
|---|---|---|---|---|---|---|
| When $n_1 \geq n_{10}$, | $n_{1m}=$ | 0.0769006 | 0.0933704 | 0.1067993 | 0.0330078 | 0.0410352 |
| When $n_1 < n_{10}$, | $n_{1m}=$ | 0.0358716 | 0.0572852 | 0.0688867 | 0.0032751 | 0.0048413 |
| When $k_1 \geq k_{10}$, | $k_{1m}=$ | 0.0508276 | 0.0793042 | 0.0916321 | 0.0140979 | 0.0177686 |
| When $k_1 < k_{10}$, | $k_{1m}=$ | 0.0888501 | 0.0996167 | 0.0954510 | 0.0244348 | 0.0282959 |
| When $d_1 \geq d_{10}$, | $d_{1m}$ (nm) $=$ | 4.190 | 5.335 | 6.248 | 10.623 | 16.723 |
| When $d_1 < d_{10}$, | $d_{1m}$ (nm) $=$ | 1.818 | 3.051 | 3.681 | 0.787 | 1.251 |
| When $n_2 \geq n_{20}$, | $n_{2m}=$ | 0.0746777 | 0.0897961 | 0.0977148 | 0.0241113 | 0.0398962 |
| When $n_2 < n_{20}$, | $n_{2m}=$ | 0.1378662 | 0.1400989 | 0.1490454 | 0.0784241 | 0.0968872 |
| When $k_2 \geq k_{20}$, | $k_{2m}=$ | 0.0793188 | 0.0846436 | 0.0920837 | 0.0085193 | 0.0207715 |
| When $k_2 < k_{20}$, | $k_{2m}=$ | 0.0870862 | 0.0841199 | 0.0819739 | 0.0504102 | 0.0538818 |
| When $d_2 \geq d_{20}$, | $d_{2m}$ (nm) $=$ | $\infty$ | $\infty$ | $\infty$ | 17.196 | $\infty$ |
| When $d_2 < d_{20}$, | $d_{2m}$ (nm) $=$ | 28.725 | 67.570 | 87.835 | 8.245 | 10.621 |

1. $1 < NA \leq 1.2$
$105 < T \leq 115$

| Case | 11-06 | 11-07 | 11-08 | 11-09 |
|---|---|---|---|---|
| $n_{10}$ | 1.6897075 | 1.6928599 | 1.6933895 | 1.6967442 |
| $k_{10}$ | 0.0859154 | 0.0698704 | 0.0619572 | 0.0572224 |
| $d_{10}$ (nm) | 206.600 | 218.100 | 215.832 | 275.439 |
| $n_{20}$ | 1.6860653 | 1.6784557 | 1.6904996 | 1.6838077 |
| $k_{20}$ | 0.2958058 | 0.2260347 | 0.1864736 | 0.1920294 |
| $d_{20}$ (nm) | 138.770 | 175.355 | 232.785 | 230.401 |

| | | 11-06 | 11-07 | 11-08 | 11-09 |
|---|---|---|---|---|---|
| When $n_1 \geq n_{10}$, | $n_{1m}=$ | 0.0125659 | 0.0312329 | 0.0432227 | 0.0564172 |
| When $n_1 < n_{10}$, | $n_{1m}=$ | 0.0403125 | 0.0252893 | 0.0462402 | 0.0423401 |
| When $k_1 \geq k_{10}$, | $k_{1m}=$ | 0.0275024 | 0.0399890 | 0.0513623 | 0.0566272 |
| When $k_1 < k_{10}$, | $k_{1m}=$ | 0.0207617 | 0.0230298 | 0.0339783 | 0.0347253 |
| When $d_1 \geq d_{10}$, | $d_{1m}$ (nm) $=$ | 5.565 | $\infty$ | $\infty$ | $\infty$ |
| When $d_1 < d_{10}$, | $d_{1m}$ (nm) $=$ | 15.751 | 15.335 | 41.797 | 102.062 |
| When $n_2 \geq n_{20}$, | $n_{2m}=$ | 0.1134778 | 0.0778406 | 0.2416541 | 0.2945471 |
| When $n_2 < n_{20}$, | $n_{2m}=$ | 0.0212585 | 0.0821313 | 0.1144373 | 0.2197937 |
| When $k_2 \geq k_{20}$, | $k_{2m}=$ | 0.0640356 | 0.0874658 | 0.1126599 | 0.1918506 |
| When $k_2 < k_{20}$, | $k_{2m}=$ | 0.0823962 | 0.0630994 | 0.0642725 | 0.0810107 |
| When $d_2 \geq d_{20}$, | $d_{2m}$ (nm) $=$ | $\infty$ | $\infty$ | $\infty$ | $\infty$ |
| When $d_2 < d_{20}$, | $d_{2m}$ (nm) $=$ | 4.190 | 25.396 | 50.058 | 79.342 |

1. 1 < N A ≤ 1. 2
1 1 5 < T ≤ 1 2 5

| Case | | 12−01 | 12−02 | 12−03 | 12−04 | 12−05 |
|---|---|---|---|---|---|---|
| $n_{10}$ | | 1.9907624 | 1.9229056 | 1.9003143 | 1.9049048 | 1.7296380 |
| $k_{10}$ | | 0.2658843 | 0.1943367 | 0.1434936 | 0.0972823 | 0.0899801 |
| $d_{10}$ (nm) | | 16.877 | 14.896 | 13.590 | 12.362 | 93.128 |
| $n_{20}$ | | 1.6777634 | 1.6435696 | 1.6791032 | 1.7269066 | 1.6935089 |
| $k_{20}$ | | 0.7245088 | 0.4392836 | 0.3336019 | 0.2779612 | 0.2572784 |
| $d_{20}$ (nm) | | 66.041 | 124.711 | 179.139 | 230.763 | 167.093 |

| | | 12−01 | 12−02 | 12−03 | 12−04 | 12−05 |
|---|---|---|---|---|---|---|
| When $n_1 \geq n_{10}$, | $n_{1m} =$ | 0.0641870 | 0.0750415 | 0.0917773 | 0.1066382 | 0.0315833 |
| When $n_1 < n_{10}$, | $n_{1m} =$ | 0.0020520 | 0.0319995 | 0.0559583 | 0.0680188 | 0.0015344 |
| When $k_1 \geq k_{10}$, | $k_{1m} =$ | 0.0028235 | 0.0481201 | 0.0790771 | 0.0912170 | 0.0085083 |
| When $k_1 < k_{10}$, | $k_{1m} =$ | 0.0445386 | 0.0882983 | 0.0964502 | 0.0972823 | 0.0192114 |
| When $d_1 \geq d_{10}$, | $d_{1m}$ (nm) $=$ | 2.498 | 3.792 | 5.133 | 6.031 | 9.518 |
| When $d_1 < d_{10}$, | $d_{1m}$ (nm) $=$ | 0.080 | 1.544 | 2.939 | 3.522 | 0.359 |
| When $n_2 \geq n_{20}$, | $n_{2m} =$ | 0.0064478 | 0.0655054 | 0.0877441 | 0.0975110 | 0.0182434 |
| When $n_2 < n_{20}$, | $n_{2m} =$ | 0.1131567 | 0.1382288 | 0.1415613 | 0.1512451 | 0.0817859 |
| When $k_2 \geq k_{20}$, | $k_{2m} =$ | 0.0073132 | 0.0658899 | 0.0812854 | 0.0911096 | 0.0040100 |
| When $k_2 < k_{20}$, | $k_{2m} =$ | 0.0730591 | 0.0825134 | 0.0835315 | 0.0828308 | 0.0509155 |
| When $d_2 \geq d_{20}$, | $d_{2m}$ (nm) $=$ | 10.610 | ∞ | ∞ | ∞ | 14.228 |
| When $d_2 < d_{20}$, | $d_{2m}$ (nm) $=$ | 2.901 | 33.267 | 66.014 | 90.382 | 3.593 |

1. 1 < N A ≤ 1. 2
1 1 5 < T ≤ 1 2 5

| Case | | 12−06 | 12−07 | 12−08 | 12−09 | 12−10 |
|---|---|---|---|---|---|---|
| $n_{10}$ | | 1.7305285 | 1.6927568 | 1.6930586 | 1.6939267 | 1.6970265 |
| $k_{10}$ | | 0.0799609 | 0.0712762 | 0.0635805 | 0.0583165 | 0.0526106 |
| $d_{10}$ (nm) | | 93.907 | 218.499 | 215.646 | 213.162 | 273.430 |
| $n_{20}$ | | 1.7196209 | 1.6781695 | 1.6903056 | 1.6934648 | 1.6908020 |
| $k_{20}$ | | 0.2133806 | 0.2348207 | 0.1916344 | 0.1626221 | 0.1682270 |
| $d_{20}$ (nm) | | 220.978 | 164.929 | 223.237 | 282.414 | 277.869 |

| | | 12−06 | 12−07 | 12−08 | 12−09 | 12−10 |
|---|---|---|---|---|---|---|
| When $n_1 \geq n_{10}$, | $n_{1m} =$ | 0.0401038 | 0.0280627 | 0.0367090 | 0.0617249 | 0.0695837 |
| When $n_1 < n_{10}$, | $n_{1m} =$ | 0.0020569 | 0.0197937 | 0.0422595 | 0.0578455 | 0.0506836 |
| When $k_1 \geq k_{10}$, | $k_{1m} =$ | 0.0099243 | 0.0365027 | 0.0497717 | 0.0551318 | 0.0584485 |
| When $k_1 < k_{10}$, | $k_{1m} =$ | 0.0219006 | 0.0215491 | 0.0327808 | 0.0369946 | 0.0381665 |
| When $d_1 \geq d_{10}$, | $d_{1m}$ (nm) $=$ | 15.192 | ∞ | ∞ | ∞ | ∞ |
| When $d_1 < d_{10}$, | $d_{1m}$ (nm) $=$ | 0.519 | 8.747 | 40.119 | 117.750 | 120.098 |
| When $n_2 \geq n_{20}$, | $n_{2m} =$ | 0.0185596 | 0.0673242 | 0.2516089 | 0.2302490 | 0.2819116 |
| When $n_2 < n_{20}$, | $n_{2m} =$ | 0.1000403 | 0.0715613 | 0.0981323 | 0.1425830 | 0.2021863 |
| When $k_2 \geq k_{20}$, | $k_{2m} =$ | 0.0105981 | 0.0901270 | 0.1132849 | 0.1293579 | 0.1967712 |
| When $k_2 < k_{20}$, | $k_{2m} =$ | 0.0546692 | 0.0589612 | 0.0634204 | 0.0595032 | 0.0741577 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 3.602 | 19.014 | 34.397 | 79.670 | 93.763 |

1. 1 < N A ≤ 1. 2
1 2 5 < T ≤ 1 3 5

| Case | 13-01 | 13-02 | 13-03 | 13-04 | 13-05 |
|---|---|---|---|---|---|
| $n_{10}$ | 1.8968086 | 1.9070303 | 1.9016797 | 1.7329805 | 1.7161015 |
| $k_{10}$ | 0.1457981 | 0.0954881 | 0.0905797 | 0.0916823 | 0.0708259 |
| $d_{10}$ (nm) | 14.128 | 12.717 | 10.946 | 93.296 | 94.224 |
| $n_{20}$ | 1.6815336 | 1.7369802 | 1.7110902 | 1.7056329 | 1.6780965 |
| $k_{20}$ | 0.3444919 | 0.2856144 | 0.2381911 | 0.2670261 | 0.1788543 |
| $d_{20}$ (nm) | 167.613 | 218.968 | 280.601 | 155.076 | 274.399 |

| | | 13-01 | 13-02 | 13-03 | 13-04 | 13-05 |
|---|---|---|---|---|---|---|
| When $n_1 \geq n_{10}$, | $n_{1m} =$ | 0.0900439 | 0.1048657 | 0.1226746 | 0.0324280 | 0.0442737 |
| When $n_1 < n_{10}$, | $n_{1m} =$ | 0.0549670 | 0.0656934 | 0.0785547 | 0.0012561 | 0.0190796 |
| When $k_1 \geq k_{10}$, | $k_{1m} =$ | 0.0772925 | 0.0877979 | 0.1031616 | 0.0075342 | 0.0396033 |
| When $k_1 < k_{10}$, | $k_{1m} =$ | 0.0920227 | 0.0954881 | 0.0905797 | 0.0177710 | 0.0448962 |
| When $d_1 \geq d_{10}$, | $d_{1m}$ (nm) $=$ | 5.183 | 6.019 | 6.438 | 9.368 | 34.945 |
| When $d_1 < d_{10}$, | $d_{1m}$ (nm) $=$ | 2.993 | 3.453 | 3.787 | 0.285 | 6.328 |
| When $n_2 \geq n_{20}$, | $n_{2m} =$ | 0.0877783 | 0.0991382 | 0.1111206 | 0.0250049 | 0.0400305 |
| When $n_2 < n_{20}$, | $n_{2m} =$ | 0.1446509 | 0.1532288 | 0.1362280 | 0.0542139 | 0.1016638 |
| When $k_2 \geq k_{20}$, | $k_{2m} =$ | 0.0828516 | 0.0936658 | 0.0912720 | 0.0036011 | 0.0409863 |
| When $k_2 < k_{20}$, | $k_{2m} =$ | 0.0884485 | 0.0865161 | 0.0819922 | 0.0570435 | 0.0508105 |
| When $d_2 \geq d_{20}$, | $d_{2m}$ (nm) $=$ | ∞ | ∞ | ∞ | 16.698 | ∞ |
| When $d_2 < d_{20}$, | $d_{2m}$ (nm) $=$ | 63.831 | 86.162 | 129.598 | 1.884 | 53.218 |

1. 1 < N A ≤ 1. 2
1 2 5 < T ≤ 1 3 5

| Case | 13-06 | 13-07 | 13-08 | 13-09 |
|---|---|---|---|---|
| $n_{10}$ | 1.6922053 | 1.6924923 | 1.6935584 | 1.6967916 |
| $k_{10}$ | 0.0726320 | 0.0653867 | 0.0598502 | 0.0533770 |
| $d_{10}$ (nm) | 218.650 | 214.871 | 212.072 | 273.133 |
| $n_{20}$ | 1.6800076 | 1.6897434 | 1.6927128 | 1.6904661 |
| $k_{20}$ | 0.2436881 | 0.1959626 | 0.1654173 | 0.1709158 |
| $d_{20}$ (nm) | 154.426 | 214.392 | 274.211 | 268.389 |

| | | 13-06 | 13-07 | 13-08 | 13-09 |
|---|---|---|---|---|---|
| When $n_1 \geq n_{10}$, | $n_{1m} =$ | 0.0253528 | 0.0324316 | 0.0605591 | 0.0715686 |
| When $n_1 < n_{10}$, | $n_{1m} =$ | 0.0165808 | 0.0420508 | 0.0560315 | 0.0516870 |
| When $k_1 \geq k_{10}$, | $k_{1m} =$ | 0.0318250 | 0.0487207 | 0.0537805 | 0.0575159 |
| When $k_1 < k_{10}$, | $k_{1m} =$ | 0.0192969 | 0.0323987 | 0.0370093 | 0.0369739 |
| When $d_1 \geq d_{10}$, | $d_{1m}$ (nm) $=$ | 16.057 | ∞ | ∞ | ∞ |
| When $d_1 < d_{10}$, | $d_{1m}$ (nm) $=$ | 7.067 | 37.738 | 59.298 | 116.516 |
| When $n_2 \geq n_{20}$, | $n_{2m} =$ | 0.0399280 | 0.1505237 | 0.2298792 | 0.2878638 |
| When $n_2 < n_{20}$, | $n_{2m} =$ | 0.0570007 | 0.0843848 | 0.1463525 | 0.2044592 |
| When $k_2 \geq k_{20}$, | $k_{2m} =$ | 0.0949915 | 0.1174060 | 0.1308350 | 0.1989417 |
| When $k_2 < k_{20}$, | $k_{2m} =$ | 0.0566089 | 0.0642029 | 0.0608850 | 0.0765625 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 13.778 | 24.202 | 76.110 | 90.681 |

1. 1 < N A ≦ 1. 2
135 < T ≦ 145

| Case | 14-01 | 14-02 | 14-03 | 14-04 | 14-05 |
|---|---|---|---|---|---|
| $n_{10}$ | 1.8931613 | 1.9086798 | 1.8957546 | 1.7383088 | 1.7163304 |
| $k_{10}$ | 0.1437464 | 0.0925277 | 0.1021679 | 0.0935643 | 0.0717315 |
| $d_{10}$ (nm) | 15.228 | 13.463 | 11.154 | 93.735 | 94.330 |
| $n_{20}$ | 1.6981871 | 1.7547782 | 1.6965397 | 1.7255584 | 1.6763108 |
| $k_{20}$ | 0.3648670 | 0.2987738 | 0.2414267 | 0.2828024 | 0.1832109 |
| $d_{20}$ (nm) | 154.635 | 206.696 | 273.752 | 142.972 | 265.207 |

| | | 14-01 | 14-02 | 14-03 | 14-04 | 14-05 |
|---|---|---|---|---|---|---|
| When $n_1 \geq n_{10}$, | $n_{1m} =$ | 0.0870447 | 0.1008179 | 0.1206177 | 0.0337476 | 0.0440930 |
| When $n_1 < n_{10}$, | $n_{1m} =$ | 0.0533362 | 0.0620862 | 0.0768750 | 0.0007715 | 0.0201111 |
| When $k_1 \geq k_{10}$, | $k_{1m} =$ | 0.0736633 | 0.0819543 | 0.1022961 | 0.0054871 | 0.0403162 |
| When $k_1 < k_{10}$, | $k_{1m} =$ | 0.0884546 | 0.0925277 | 0.1021679 | 0.0149585 | 0.0433484 |
| When $d_1 \geq d_{10}$, | $d_{1m}$ (nm) $=$ | 5.366 | 6.051 | 6.474 | 9.539 | 32.676 |
| When $d_1 < d_{10}$, | $d_{1m}$ (nm) $=$ | 3.110 | 3.392 | 3.792 | 0.168 | 6.615 |
| When $n_2 \geq n_{20}$, | $n_{2m} =$ | 0.0905371 | 0.1017932 | 0.1131152 | 0.0305115 | 0.0401709 |
| When $n_2 < n_{20}$, | $n_{2m} =$ | 0.1457471 | 0.1521191 | 0.1323865 | 0.0291541 | 0.0974780 |
| When $k_2 \geq k_{20}$, | $k_{2m} =$ | 0.0891467 | 0.0990112 | 0.0895691 | 0.0025757 | 0.0411877 |
| When $k_2 < k_{20}$, | $k_{2m} =$ | 0.0964551 | 0.0905688 | 0.0826367 | 0.0641370 | 0.0518066 |
| When $d_2 \geq d_{20}$, | $d_{2m}$ (nm) $=$ | ∞ | ∞ | ∞ | 18.295 | ∞ |
| When $d_2 < d_{20}$, | $d_{2m}$ (nm) $=$ | 52.833 | 78.923 | 127.644 | 0.825 | 36.894 |

1. 1 < N A ≦ 1. 2
135 < T ≦ 145

| Case | 14-06 | 14-07 | 14-08 | 14-09 | 14-10 |
|---|---|---|---|---|---|
| $n_{10}$ | 1.7036586 | 1.6919166 | 1.6911838 | 1.6942185 | 1.6965335 |
| $k_{10}$ | 0.0640636 | 0.0672926 | 0.0743991 | 0.0545821 | 0.0539924 |
| $d_{10}$ (nm) | 161.836 | 213.353 | 218.060 | 211.644 | 273.036 |
| $n_{20}$ | 1.6842842 | 1.6889376 | 1.6805827 | 1.6930391 | 1.6894839 |
| $k_{20}$ | 0.1670348 | 0.2002175 | 0.2524809 | 0.1466022 | 0.1738185 |
| $d_{20}$ (nm) | 260.021 | 207.074 | 145.761 | 321.654 | 259.712 |

| | | 14-06 | 14-07 | 14-08 | 14-09 | 14-10 |
|---|---|---|---|---|---|---|
| When $n_1 \geq n_{10}$, | $n_{1m} =$ | 0.0516992 | 0.0312610 | 0.0190637 | 0.0570044 | 0.0731799 |
| When $n_1 < n_{10}$, | $n_{1m} =$ | 0.0203174 | 0.0465454 | 0.0159326 | 0.0625537 | 0.0527673 |
| When $k_1 \geq k_{10}$, | $k_{1m} =$ | 0.0380640 | 0.0462256 | 0.0279297 | 0.0552405 | 0.0568201 |
| When $k_1 < k_{10}$, | $k_{1m} =$ | 0.0285486 | 0.0325867 | 0.0168274 | 0.0356702 | 0.0362610 |
| When $d_1 \geq d_{10}$, | $d_{1m}$ (nm) $=$ | ∞ | ∞ | 14.138 | ∞ | ∞ |
| When $d_1 < d_{10}$, | $d_{1m}$ (nm) $=$ | 9.049 | 34.771 | 6.640 | 127.140 | 114.401 |
| When $n_2 \geq n_{20}$, | $n_{2m} =$ | 0.0375000 | 0.2427722 | 0.0321863 | 0.2263916 | 0.2897119 |
| When $n_2 < n_{20}$, | $n_{2m} =$ | 0.0655225 | 0.0802039 | 0.0495178 | 0.1240515 | 0.2069202 |
| When $k_2 \geq k_{20}$, | $k_{2m} =$ | 0.0303979 | 0.1193311 | 0.0877856 | 0.1337305 | 0.1994678 |
| When $k_2 < k_{20}$, | $k_{2m} =$ | 0.0483228 | 0.0645337 | 0.0566711 | 0.0596594 | 0.0781824 |
| When $d_2 \geq d_{20}$, | $d_{2m}$ (nm) $=$ | 29.338 | ∞ | 15.130 | ∞ | ∞ |
| When $d_2 < d_{20}$, | $d_{2m}$ (nm) $=$ | 27.139 | 22.617 | 11.351 | 93.024 | 88.496 |

1. 1 < N A ≦ 1. 2
1 4 5 < T ≦ 1 5 5

| Case | 15-01 | 15-02 | 15-03 | 15-04 | 15-05 |
|---|---|---|---|---|---|
| $n_{10}$ | 1.8962402 | 1.9162756 | 1.8972293 | 1.7171631 | 1.7039366 |
| $k_{10}$ | 0.1446868 | 0.0920008 | 0.1039493 | 0.0735355 | 0.0654419 |
| $d_{10}$ (nm) | 16.058 | 13.917 | 11.503 | 94.241 | 161.496 |
| $n_{20}$ | 1.7149739 | 1.7705409 | 1.6986687 | 1.6756859 | 1.6849902 |
| $k_{20}$ | 0.3909951 | 0.3160160 | 0.2516185 | 0.1901883 | 0.1728826 |
| $d_{20}$ (nm) | 143.691 | 196.340 | 264.437 | 256.660 | 251.490 |

| | | 15-01 | 15-02 | 15-03 | 15-04 | 15-05 |
|---|---|---|---|---|---|---|
| When $n_1 \geq n_{10}$, | $n_{1m} =$ | 0.0837915 | 0.0974329 | 0.1166235 | 0.0430017 | 0.0505029 |
| When $n_1 < n_{10}$, | $n_{1m} =$ | 0.0514441 | 0.0592371 | 0.0737268 | 0.0188135 | 0.0178369 |
| When $k_1 \geq k_{10}$, | $k_{1m} =$ | 0.0700403 | 0.0772290 | 0.0977893 | 0.0384546 | 0.0357764 |
| When $k_1 < k_{10}$, | $k_{1m} =$ | 0.0875134 | 0.0920008 | 0.1039493 | 0.0432324 | 0.0268848 |
| When $d_1 \geq d_{10}$, | $d_{1m}$ (nm) $=$ | 5.323 | 5.852 | 6.362 | 32.246 | ∞ |
| When $d_1 < d_{10}$, | $d_{1m}$ (nm) $=$ | 3.062 | 3.205 | 3.699 | 5.981 | 7.380 |
| When $n_2 \geq n_{20}$, | $n_{2m} =$ | 0.0928162 | 0.1031079 | 0.1115686 | 0.0381177 | 0.0304712 |
| When $n_2 < n_{20}$, | $n_{2m} =$ | 0.1435938 | 0.1490808 | 0.1351062 | 0.0929431 | 0.0597266 |
| When $k_2 \geq k_{20}$, | $k_{2m} =$ | 0.0944385 | 0.1027820 | 0.0897864 | 0.0382104 | 0.0277966 |
| When $k_2 < k_{20}$, | $k_{2m} =$ | 0.0995911 | 0.0924023 | 0.0838245 | 0.0518921 | 0.0482678 |
| When $d_2 \geq d_{20}$, | $d_{2m}$ (nm) $=$ | ∞ | ∞ | ∞ | ∞ | 23.493 |
| When $d_2 < d_{20}$, | $d_{2m}$ (nm) $=$ | 30.912 | 72.930 | 96.188 | 31.536 | 23.876 |

1. 1 < N A ≦ 1. 2
1 4 5 < T ≦ 1 5 5

| Case | 15-06 | 15-07 | 15-08 | 15-09 |
|---|---|---|---|---|
| $n_{10}$ | 1.6903081 | 1.6915399 | 1.6931731 | 1.6963857 |
| $k_{10}$ | 0.0771344 | 0.0690906 | 0.0615887 | 0.0546855 |
| $d_{10}$ (nm) | 216.305 | 212.338 | 211.917 | 273.170 |
| $n_{20}$ | 1.6786590 | 1.6881028 | 1.6918937 | 1.6879125 |
| $k_{20}$ | 0.2613948 | 0.2062149 | 0.1729009 | 0.1780863 |
| $d_{20}$ (nm) | 139.207 | 199.770 | 256.415 | 251.444 |

| | | 15-06 | 15-07 | 15-08 | 15-09 |
|---|---|---|---|---|---|
| When $n_1 \geq n_{10}$, | $n_{1m} =$ | 0.0195569 | 0.0307166 | 0.0591064 | 0.0699243 |
| When $n_1 < n_{10}$, | $n_{1m} =$ | 0.0132800 | 0.0523120 | 0.0554614 | 0.0530347 |
| When $k_1 \geq k_{10}$, | $k_{1m} =$ | 0.0269897 | 0.0450159 | 0.0517236 | 0.0562524 |
| When $k_1 < k_{10}$, | $k_{1m} =$ | 0.0101050 | 0.0313696 | 0.0355261 | 0.0367395 |
| When $d_1 \geq d_{10}$, | $d_{1m}$ (nm) $=$ | 14.222 | ∞ | ∞ | ∞ |
| When $d_1 < d_{10}$, | $d_{1m}$ (nm) $=$ | 6.108 | 32.462 | 54.157 | 113.606 |
| When $n_2 \geq n_{20}$, | $n_{2m} =$ | 0.0246814 | 0.2330432 | 0.2286047 | 0.2890198 |
| When $n_2 < n_{20}$, | $n_{2m} =$ | 0.0598340 | 0.0841870 | 0.1451465 | 0.2088098 |
| When $k_2 \geq k_{20}$, | $k_{2m} =$ | 0.0678235 | 0.1160620 | 0.1277832 | 0.1979041 |
| When $k_2 < k_{20}$, | $k_{2m} =$ | 0.0514465 | 0.0682922 | 0.0664624 | 0.0771411 |
| When $d_2 \geq d_{20}$, | $d_{2m}$ (nm) $=$ | 11.437 | ∞ | ∞ | ∞ |
| When $d_2 < d_{20}$, | $d_{2m}$ (nm) $=$ | 12.498 | 26.276 | 74.225 | 84.013 |

1. 1 < N A ≤ 1. 2
1 5 5 < T ≤ 1 6 5

| Case | 16-01 | 16-02 | 16-03 | 16-04 | 16-05 |
|---|---|---|---|---|---|
| $n_{10}$ | 1.9078860 | 1.9270939 | 1.9009914 | 1.7182026 | 1.7037276 |
| $k_{10}$ | 0.1508452 | 0.0963716 | 0.1079582 | 0.0759211 | 0.0670447 |
| $d_{10}$ (nm) | 16.208 | 13.863 | 11.657 | 93.910 | 160.452 |
| $n_{20}$ | 1.7232027 | 1.7738090 | 1.6981472 | 1.6754262 | 1.6860603 |
| $k_{20}$ | 0.4201511 | 0.3331580 | 0.2622250 | 0.1979303 | 0.1785858 |
| $d_{20}$ (nm) | 134.826 | 188.374 | 256.036 | 248.261 | 243.357 |

| | | 16-01 | 16-02 | 16-03 | 16-04 | 16-05 |
|---|---|---|---|---|---|---|
| When $n_1 \geq n_{10}$, | $n_{1m} =$ | 0.0807556 | 0.0955676 | 0.1136938 | 0.0410315 | 0.0482739 |
| When $n_1 < n_{10}$, | $n_{1m} =$ | 0.0492212 | 0.0570374 | 0.0706995 | 0.0157471 | 0.0155554 |
| When $k_1 \geq k_{10}$, | $k_{1m} =$ | 0.0660083 | 0.0745215 | 0.0946643 | 0.0342603 | 0.0302344 |
| When $k_1 < k_{10}$, | $k_{1m} =$ | 0.0885791 | 0.0963716 | 0.1079582 | 0.0433301 | 0.0248120 |
| When $d_1 \geq d_{10}$, | $d_{1m}$ (nm) $=$ | 4.938 | 5.477 | 6.133 | 23.554 | ∞ |
| When $d_1 < d_{10}$, | $d_{1m}$ (nm) $=$ | 2.790 | 2.920 | 3.507 | 4.784 | 6.051 |
| When $n_2 \geq n_{20}$, | $n_{2m} =$ | 0.0912793 | 0.1022461 | 0.1087073 | 0.0334387 | 0.0216223 |
| When $n_2 < n_{20}$, | $n_{2m} =$ | 0.1401233 | 0.1468384 | 0.1373413 | 0.0900842 | 0.0519312 |
| When $k_2 \geq k_{20}$, | $k_{2m} =$ | 0.0948535 | 0.1014905 | 0.0883215 | 0.0321790 | 0.0239026 |
| When $k_2 < k_{20}$, | $k_{2m} =$ | 0.0976477 | 0.0917578 | 0.0837280 | 0.0507922 | 0.0474658 |
| When $d_2 \geq d_{20}$, | $d_{2m}$ (nm) $=$ | ∞ | ∞ | ∞ | ∞ | 19.461 |
| When $d_2 < d_{20}$, | $d_{2m}$ (nm) $=$ | 27.641 | 68.596 | 90.537 | 29.710 | 21.259 |

1. 1 < N A ≤ 1. 2
1 5 5 < T ≤ 1 6 5

| Case | 16-06 | 16-07 | 16-08 | 16-09 |
|---|---|---|---|---|
| $n_{10}$ | 1.6914048 | 1.6932944 | 1.6971949 | 1.6963748 |
| $k_{10}$ | 0.0705280 | 0.0619823 | 0.0758678 | 0.0557064 |
| $d_{10}$ (nm) | 212.904 | 213.027 | 268.193 | 273.316 |
| $n_{20}$ | 1.6862460 | 1.6912789 | 1.6840809 | 1.6860970 |
| $k_{20}$ | 0.2142065 | 0.1784688 | 0.2789945 | 0.1841499 |
| $d_{20}$ (nm) | 190.804 | 246.475 | 135.240 | 242.973 |

| | | 16-06 | 16-07 | 16-08 | 16-09 |
|---|---|---|---|---|---|
| When $n_1 \geq n_{10}$, | $n_{1m} =$ | 0.0288806 | 0.0598267 | 0.0616260 | 0.0706445 |
| When $n_1 < n_{10}$, | $n_{1m} =$ | 0.0419739 | 0.0573401 | 0.0320642 | 0.0521814 |
| When $k_1 \geq k_{10}$, | $k_{1m} =$ | 0.0434460 | 0.0510059 | 0.0409424 | 0.0555554 |
| When $k_1 < k_{10}$, | $k_{1m} =$ | 0.0304883 | 0.0343054 | 0.0217456 | 0.0379871 |
| When $d_1 \geq d_{10}$, | $d_{1m}$ (nm) $=$ | ∞ | ∞ | ∞ | ∞ |
| When $d_1 < d_{10}$, | $d_{1m}$ (nm) $=$ | 31.951 | 51.898 | 19.489 | 113.780 |
| When $n_2 \geq n_{20}$, | $n_{2m} =$ | 0.2364844 | 0.2370337 | 0.2474512 | 0.2927136 |
| When $n_2 < n_{20}$, | $n_{2m} =$ | 0.0869409 | 0.1403040 | 0.2270129 | 0.2100537 |
| When $k_2 \geq k_{20}$, | $k_{2m} =$ | 0.1087354 | 0.1223047 | 0.1872974 | 0.1959326 |
| When $k_2 < k_{20}$, | $k_{2m} =$ | 0.0726953 | 0.0652295 | 0.1039441 | 0.0773071 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 34.355 | 75.037 | 36.050 | 81.214 |

1. $1 < NA \leq 1.2$
$165 < T \leq 175$

| Case | 17-01 | 17-02 | 17-03 | 17-04 | 17-05 |
|---|---|---|---|---|---|
| $n_{10}$ | 1.9345747 | 1.9100928 | 1.9218874 | 1.7188695 | 1.7031385 |
| $k_{10}$ | 0.1082213 | 0.1149883 | 0.1634556 | 0.0782891 | 0.0685384 |
| $d_{10}$ (nm) | 13.373 | 11.317 | 15.608 | 93.463 | 159.293 |
| $n_{20}$ | 1.7554016 | 1.6916658 | 1.7091703 | 1.6745648 | 1.6866422 |
| $k_{20}$ | 0.3434593 | 0.2694423 | 0.4402763 | 0.2040549 | 0.1829170 |
| $d_{20}$ (nm) | 183.042 | 248.707 | 128.647 | 239.614 | 234.977 |

| | 17-01 | 17-02 | 17-03 | 17-04 | 17-05 |
|---|---|---|---|---|---|
| When $n_1 \geq n_{10}$, $n_{1m}=$ | 0.0953882 | 0.1140894 | 0.0784595 | 0.0386694 | 0.0460681 |
| When $n_1 < n_{10}$, $n_{1m}=$ | 0.0550098 | 0.0698865 | 0.0459766 | 0.0121814 | 0.0133398 |
| When $k_1 \geq k_{10}$, $k_{1m}=$ | 0.0742224 | 0.0954895 | 0.0620923 | 0.0290149 | 0.0227319 |
| When $k_1 < k_{10}$, $k_{1m}=$ | 0.1051392 | 0.1149883 | 0.0878528 | 0.0413110 | 0.0203333 |
| When $d_1 \geq d_{10}$, $d_{1m}$ (nm) $=$ | 5.105 | 5.733 | 4.388 | 16.599 | $\infty$ |
| When $d_1 < d_{10}$, $d_{1m}$ (nm) $=$ | 2.628 | 3.226 | 2.376 | 3.551 | 4.956 |
| When $n_2 \geq n_{20}$, $n_{2m}=$ | 0.0995532 | 0.1061743 | 0.0849316 | 0.0275488 | 0.0132971 |
| When $n_2 < n_{20}$, $n_{2m}=$ | 0.1453674 | 0.1364294 | 0.1372107 | 0.0877344 | 0.0449780 |
| When $k_2 \geq k_{20}$, $k_{2m}=$ | 0.0936926 | 0.0848206 | 0.0864539 | 0.0249731 | 0.0152673 |
| When $k_2 < k_{20}$, $k_{2m}=$ | 0.0884937 | 0.0821777 | 0.0909717 | 0.0487439 | 0.0459656 |
| When $d_2 \geq d_{20}$, $d_{2m}$ (nm) $=$ | $\infty$ | $\infty$ | $\infty$ | $\infty$ | 6.034 |
| When $d_2 < d_{20}$, $d_{2m}$ (nm) $=$ | 65.841 | 91.823 | 28.009 | 30.737 | 19.612 |

1. $1 < NA \leq 1.2$
$165 < T \leq 175$

| Case | 17-06 | 17-07 | 17-08 | 17-09 |
|---|---|---|---|---|
| $n_{10}$ | 1.6934237 | 1.6934242 | 1.6985617 | 1.6963947 |
| $k_{10}$ | 0.0627890 | 0.0627998 | 0.0777714 | 0.0569261 |
| $d_{10}$ (nm) | 213.592 | 213.572 | 264.836 | 273.344 |
| $n_{20}$ | 1.6908665 | 1.6907829 | 1.6854326 | 1.6845211 |
| $k_{20}$ | 0.1844160 | 0.1843934 | 0.2962369 | 0.1907955 |
| $d_{20}$ (nm) | 236.853 | 236.891 | 131.733 | 233.824 |

| | 17-06 | 17-07 | 17-08 | 17-09 |
|---|---|---|---|---|
| When $n_1 \geq n_{10}$, $n_{1m}=$ | 0.0574976 | 0.0574353 | 0.0522168 | 0.0698511 |
| When $n_1 < n_{10}$, $n_{1m}=$ | 0.0521313 | 0.0521704 | 0.0296216 | 0.0506372 |
| When $k_1 \geq k_{10}$, $k_{1m}=$ | 0.0502954 | 0.0502856 | 0.0369763 | 0.0547412 |
| When $k_1 < k_{10}$, $k_{1m}=$ | 0.0341577 | 0.0341846 | 0.0234509 | 0.0368408 |
| When $d_1 \geq d_{10}$, $d_{1m}$ (nm) $=$ | $\infty$ | $\infty$ | $\infty$ | $\infty$ |
| When $d_1 < d_{10}$, $d_{1m}$ (nm) $=$ | 50.284 | 50.272 | 18.034 | 113.943 |
| When $n_2 \geq n_{20}$, $n_{2m}=$ | 0.2442261 | 0.2441003 | 0.2108032 | 0.3045251 |
| When $n_2 < n_{20}$, $n_{2m}=$ | 0.1394958 | 0.1395251 | 0.2567761 | 0.2115186 |
| When $k_2 \geq k_{20}$, $k_{2m}=$ | 0.1187415 | 0.1187610 | 0.1954675 | 0.1950378 |
| When $k_2 < k_{20}$, $k_{2m}=$ | 0.0660913 | 0.0660889 | 0.1128296 | 0.0795361 |
| When $d_2 \geq d_{20}$, $d_{2m}$ (nm) $=$ | $\infty$ | $\infty$ | $\infty$ | $\infty$ |
| When $d_2 < d_{20}$, $d_{2m}$ (nm) $=$ | 75.634 | 75.652 | 33.470 | 80.767 |

1. 1 < N A ≦ 1. 2
1 7 5 < T ≦ 1 8 5

| Case | 18-01 | 18-02 | 18-03 | 18-04 | 18-05 |
|---|---|---|---|---|---|
| $n_{10}$ | 1.9329388 | 1.9368237 | 1.9141366 | 1.7191879 | 1.7029035 |
| $k_{10}$ | 0.1795701 | 0.1224596 | 0.1196035 | 0.0801581 | 0.0699625 |
| $d_{10}$ (nm) | 14.789 | 12.921 | 11.206 | 93.133 | 158.805 |
| $n_{20}$ | 1.6812994 | 1.7305084 | 1.6882344 | 1.6734445 | 1.6865116 |
| $k_{20}$ | 0.4483886 | 0.3477304 | 0.2744889 | 0.2077092 | 0.1862225 |
| $d_{20}$ (nm) | 123.825 | 177.704 | 240.000 | 230.286 | 225.674 |

| | | 18-01 | 18-02 | 18-03 | 18-04 | 18-05 |
|---|---|---|---|---|---|---|
| When $n_1 \geq n_{10}$, | $n_{1m} =$ | 0.0768433 | 0.0949634 | 0.1131592 | 0.0367419 | 0.0441357 |
| When $n_1 < n_{10}$, | $n_{1m} =$ | 0.0412451 | 0.0529919 | 0.0684998 | 0.0095679 | 0.0109912 |
| When $k_1 \geq k_{10}$, | $k_{1m} =$ | 0.0578772 | 0.0744714 | 0.0949390 | 0.0247339 | 0.0167639 |
| When $k_1 < k_{10}$, | $k_{1m} =$ | 0.0896887 | 0.1065430 | 0.1185388 | 0.0386743 | 0.0152380 |
| When $d_1 \geq d_{10}$, | $d_{1m}$ (nm) $=$ | 3.840 | 4.794 | 5.495 | 14.453 | ∞ |
| When $d_1 < d_{10}$, | $d_{1m}$ (nm) $=$ | 1.946 | 2.409 | 3.066 | 2.710 | 3.941 |
| When $n_2 \geq n_{20}$, | $n_{2m} =$ | 0.0764294 | 0.0962097 | 0.1038733 | 0.0230908 | 0.0081592 |
| When $n_2 < n_{20}$, | $n_{2m} =$ | 0.1359412 | 0.1466211 | 0.1367029 | 0.0895520 | 0.0398572 |
| When $k_2 \geq k_{20}$, | $k_{2m} =$ | 0.0734753 | 0.0852112 | 0.0825085 | 0.0197388 | 0.0086536 |
| When $k_2 < k_{20}$, | $k_{2m} =$ | 0.0828125 | 0.0854419 | 0.0815332 | 0.0475061 | 0.0463342 |
| When $d_2 \geq d_{20}$, | $d_{2m}$ (nm) $=$ | ∞ | ∞ | ∞ | 20.793 | 3.280 |
| When $d_2 < d_{20}$, | $d_{2m}$ (nm) $=$ | 32.854 | 63.574 | 95.894 | 33.693 | 18.574 |

1. 1 < N A ≦ 1. 2
1 7 5 < T ≦ 1 8 5

| Case | 18-06 | 18-07 | 18-08 |
|---|---|---|---|
| $n_{10}$ | 1.6933701 | 1.6939475 | 1.6969386 |
| $k_{10}$ | 0.0640425 | 0.0576888 | 0.0533290 |
| $d_{10}$ (nm) | 213.864 | 212.435 | 271.986 |
| $n_{20}$ | 1.6904005 | 1.6925921 | 1.6924288 |
| $k_{20}$ | 0.1898312 | 0.1618810 | 0.1673219 |
| $d_{20}$ (nm) | 227.117 | 285.048 | 281.091 |

| | | 18-06 | 18-07 | 18-08 |
|---|---|---|---|---|
| When $n_1 \geq n_{10}$, | $n_{1m} =$ | 0.0547229 | 0.0510974 | 0.0676453 |
| When $n_1 < n_{10}$, | $n_{1m} =$ | 0.0462109 | 0.0603149 | 0.0497070 |
| When $k_1 \geq k_{10}$, | $k_{1m} =$ | 0.0493457 | 0.0532312 | 0.0592920 |
| When $k_1 < k_{10}$, | $k_{1m} =$ | 0.0339734 | 0.0351465 | 0.0390295 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 49.384 | 120.643 | 177.975 |
| When $n_2 \geq n_{20}$, | $n_{2m} =$ | 0.2555811 | 0.2373071 | 0.2892273 |
| When $n_2 < n_{20}$, | $n_{2m} =$ | 0.1402515 | 0.1279663 | 0.2010315 |
| When $k_2 \geq k_{20}$, | $k_{2m} =$ | 0.1146326 | 0.1254919 | 0.2051270 |
| When $k_2 < k_{20}$, | $k_{2m} =$ | 0.0655762 | 0.0607678 | 0.0750598 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 70.972 | 82.029 | 98.942 |

1. 1 < N A ≤ 1. 2
1 8 5 < T ≤ 1 9 5

| Case | 19-01 | 19-02 | 19-03 | 19-04 | 19-05 |
|---|---|---|---|---|---|
| $n_{10}$ | 1.9315873 | 1.9153217 | 1.8972445 | 1.7198506 | 1.7209927 |
| $k_{10}$ | 0.1333486 | 0.1206110 | 0.1001874 | 0.0813984 | 0.0705203 |
| $d_{10}$ (nm) | 13.169 | 11.351 | 10.604 | 93.215 | 93.408 |
| $n_{20}$ | 1.7169625 | 1.6899751 | 1.6952918 | 1.6740113 | 1.6975541 |
| $k_{20}$ | 0.3552140 | 0.2797802 | 0.2334251 | 0.2110946 | 0.1793898 |
| $d_{20}$ (nm) | 168.729 | 229.265 | 285.679 | 219.867 | 273.456 |

| | | 19-01 | 19-02 | 19-03 | 19-04 | 19-05 |
|---|---|---|---|---|---|---|
| When $n_1 \geq n_{10}$, | $n_{1m} =$ | 0.0918945 | 0.1114490 | 0.1257397 | 0.0361377 | 0.0445178 |
| When $n_1 < n_{10}$, | $n_{1m} =$ | 0.0499878 | 0.0671436 | 0.0846338 | 0.0086279 | 0.0205615 |
| When $k_1 \geq k_{10}$, | $k_{1m} =$ | 0.0714844 | 0.0926733 | 0.1116675 | 0.0228809 | 0.0433899 |
| When $k_1 < k_{10}$, | $k_{1m} =$ | 0.1000085 | 0.1179578 | 0.1001874 | 0.0379150 | 0.0444836 |
| When $d_1 \geq d_{10}$, | $d_{1m}$ (nm) $=$ | 4.647 | 5.413 | 6.402 | 13.674 | 40.701 |
| When $d_1 < d_{10}$, | $d_{1m}$ (nm) $=$ | 2.318 | 3.021 | 3.978 | 2.409 | 6.133 |
| When $n_2 \geq n_{20}$, | $n_{2m} =$ | 0.0938611 | 0.1021985 | 0.1009766 | 0.0217163 | 0.0601978 |
| When $n_2 < n_{20}$, | $n_{2m} =$ | 0.1488745 | 0.1392834 | 0.1303809 | 0.0916943 | 0.1077124 |
| When $k_2 \geq k_{20}$, | $k_{2m} =$ | 0.0821570 | 0.0826257 | 0.0865845 | 0.0185046 | 0.0416394 |
| When $k_2 < k_{20}$, | $k_{2m} =$ | 0.0869946 | 0.0832629 | 0.0782239 | 0.0491125 | 0.0501843 |
| When $d_2 \geq d_{20}$, | $d_{2m}$ (nm) $=$ | ∞ | ∞ | ∞ | 19.431 | ∞ |
| When $d_2 < d_{20}$, | $d_{2m}$ (nm) $=$ | 61.773 | 92.529 | 127.146 | 32.148 | 73.073 |

1. 1 < N A ≤ 1. 2
1 8 5 < T ≤ 1 9 5

| Case | 19-06 | 19-07 | 19-08 | 19-09 | 19-10 |
|---|---|---|---|---|---|
| $n_{10}$ | 1.7035608 | 1.6916743 | 1.6930483 | 1.6936984 | 1.6968810 |
| $k_{10}$ | 0.0713918 | 0.0742011 | 0.0657083 | 0.0591625 | 0.0544417 |
| $d_{10}$ (nm) | 159.462 | 216.137 | 213.861 | 212.273 | 271.786 |
| $n_{20}$ | 1.6857491 | 1.6815589 | 1.6902271 | 1.6918699 | 1.6922876 |
| $k_{20}$ | 0.1901066 | 0.2413942 | 0.1951191 | 0.1652801 | 0.1708476 |
| $d_{20}$ (nm) | 215.251 | 158.897 | 217.477 | 275.792 | 271.501 |

| | | 19-06 | 19-07 | 19-08 | 19-09 | 19-10 |
|---|---|---|---|---|---|---|
| When $n_1 \geq n_{10}$, | $n_{1m} =$ | 0.0427405 | 0.0223779 | 0.0519324 | 0.0514441 | 0.0684033 |
| When $n_1 < n_{10}$, | $n_{1m} =$ | 0.0090222 | 0.0227649 | 0.0431079 | 0.0594763 | 0.0491284 |
| When $k_1 \geq k_{10}$, | $k_{1m} =$ | 0.0150232 | 0.0325586 | 0.0481873 | 0.0521765 | 0.0581763 |
| When $k_1 < k_{10}$, | $k_{1m} =$ | 0.0160400 | 0.0253345 | 0.0315527 | 0.0340894 | 0.0370996 |
| When $d_1 \geq d_{10}$, | $d_{1m}$ (nm) $=$ | ∞ | 13.469 | ∞ | ∞ | ∞ |
| When $d_1 < d_{10}$, | $d_{1m}$ (nm) $=$ | 3.174 | 10.839 | 47.894 | 119.682 | 177.263 |
| When $n_2 \geq n_{20}$, | $n_{2m} =$ | 0.0074805 | 0.0854517 | 0.1377869 | 0.2440918 | 0.2955884 |
| When $n_2 < n_{20}$, | $n_{2m} =$ | 0.0361890 | 0.0461035 | 0.1429895 | 0.1282532 | 0.2018481 |
| When $k_2 \geq k_{20}$, | $k_{2m} =$ | 0.0083386 | 0.0888440 | 0.1120801 | 0.1247546 | 0.2080872 |
| When $k_2 < k_{20}$, | $k_{2m} =$ | 0.0485754 | 0.0635596 | 0.0642932 | 0.0606433 | 0.0779761 |
| When $d_2 \geq d_{20}$, | $d_{2m}$ (nm) $=$ | 3.092 | ∞ | ∞ | ∞ | ∞ |
| When $d_2 < d_{20}$, | $d_{2m}$ (nm) $=$ | 17.439 | 14.439 | 35.904 | 75.946 | 92.429 |

1. $1 < NA \leq 1.2$
$195 < T \leq 205$

| Case | 20-01 | 20-02 | 20-03 | 20-04 | 20-05 |
|---|---|---|---|---|---|
| $n_{10}$ | 1.9249373 | 1.9134695 | 1.8970797 | 1.7208445 | 1.7215107 |
| $k_{10}$ | 0.1361664 | 0.1202777 | 0.0999072 | 0.0825059 | 0.0711590 |
| $d_{10}$ (nm) | 14.155 | 11.822 | 10.899 | 93.633 | 93.747 |
| $n_{20}$ | 1.7251855 | 1.6947701 | 1.6978665 | 1.6746972 | 1.6977852 |
| $k_{20}$ | 0.3723543 | 0.2878755 | 0.2388400 | 0.2167421 | 0.1834377 |
| $d_{20}$ (nm) | 156.237 | 218.180 | 275.054 | 209.700 | 263.540 |

| | | 20-01 | 20-02 | 20-03 | 20-04 | 20-05 |
|---|---|---|---|---|---|---|
| When $n_1 \geq n_{10}$, | $n_{1m} =$ | 0.0879163 | 0.1083789 | 0.1230811 | 0.0362378 | 0.0448303 |
| When $n_1 < n_{10}$, | $n_{1m} =$ | 0.0472876 | 0.0648938 | 0.0826709 | 0.0083032 | 0.0200745 |
| When $k_1 \geq k_{10}$, | $k_{1m} =$ | 0.0660645 | 0.0884607 | 0.1084424 | 0.0221863 | 0.0429114 |
| When $k_1 < k_{10}$, | $k_{1m} =$ | 0.0933167 | 0.1148511 | 0.0999072 | 0.0377161 | 0.0440771 |
| When $d_1 \geq d_{10}$, | $d_{1m}$ (nm) $=$ | 4.725 | 5.477 | 6.424 | 13.579 | 31.897 |
| When $d_1 < d_{10}$, | $d_{1m}$ (nm) $=$ | 2.353 | 3.040 | 3.984 | 2.294 | 5.957 |
| When $n_2 \geq n_{20}$, | $n_{2m} =$ | 0.0937048 | 0.1017651 | 0.1009302 | 0.0215295 | 0.0601208 |
| When $n_2 < n_{20}$, | $n_{2m} =$ | 0.1501685 | 0.1443250 | 0.1325146 | 0.0892346 | 0.1044958 |
| When $k_2 \geq k_{20}$, | $k_{2m} =$ | 0.0870276 | 0.0848474 | 0.0878162 | 0.0191504 | 0.0424573 |
| When $k_2 < k_{20}$, | $k_{2m} =$ | 0.0940491 | 0.0866907 | 0.0808813 | 0.0520386 | 0.0521252 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 59.976 | 84.859 | 127.060 | 27.072 | 71.102 |

1. $1 < NA \leq 1.2$
$195 < T \leq 205$

| Case | 20-06 | 20-07 | 20-08 | 20-09 | 20-10 |
|---|---|---|---|---|---|
| $n_{10}$ | 1.7046380 | 1.7071945 | 1.6911424 | 1.6924731 | 1.6944113 |
| $k_{10}$ | 0.0728087 | 0.0643745 | 0.0761042 | 0.0678273 | 0.0547711 |
| $d_{10}$ (nm) | 160.840 | 160.796 | 216.237 | 212.933 | 211.610 |
| $n_{20}$ | 1.6842748 | 1.7036838 | 1.6835271 | 1.6899027 | 1.6931553 |
| $k_{20}$ | 0.1961079 | 0.1674255 | 0.2518702 | 0.2006809 | 0.1468072 |
| $d_{20}$ (nm) | 204.946 | 259.158 | 149.208 | 209.434 | 323.528 |

| | | 20-06 | 20-07 | 20-08 | 20-09 | 20-10 |
|---|---|---|---|---|---|---|
| When $n_1 \geq n_{10}$, | $n_{1m} =$ | 0.0417468 | 0.0534717 | 0.0144385 | 0.0489441 | 0.0528149 |
| When $n_1 < n_{10}$, | $n_{1m} =$ | 0.0080798 | 0.0311902 | 0.0202490 | 0.0431433 | 0.0592456 |
| When $k_1 \geq k_{10}$, | $k_{1m} =$ | 0.0160498 | 0.0272644 | 0.0259192 | 0.0470654 | 0.0582300 |
| When $k_1 < k_{10}$, | $k_{1m} =$ | 0.0189954 | 0.0257520 | 0.0204919 | 0.0289844 | 0.0354419 |
| When $d_1 \geq d_{10}$, | $d_{1m}$ (nm) $=$ | $\infty$ | $\infty$ | 11.042 | $\infty$ | $\infty$ |
| When $d_1 < d_{10}$, | $d_{1m}$ (nm) $=$ | 2.830 | 21.473 | 8.826 | 44.978 | 116.569 |
| When $n_2 \geq n_{20}$, | $n_{2m} =$ | 0.0092676 | 0.0660242 | 0.0583154 | 0.1383105 | 0.2397107 |
| When $n_2 < n_{20}$, | $n_{2m} =$ | 0.0345349 | 0.0284167 | 0.0279346 | 0.1133557 | 0.1358362 |
| When $k_2 \geq k_{20}$, | $k_{2m} =$ | 0.0098743 | 0.0192883 | 0.0839758 | 0.1160754 | 0.1327747 |
| When $k_2 < k_{20}$, | $k_{2m} =$ | 0.0439319 | 0.0493506 | 0.0539001 | 0.0650562 | 0.0582056 |
| When $d_2 \geq d_{20}$, | $d_{2m}$ (nm) $=$ | 4.069 | $\infty$ | $\infty$ | $\infty$ | $\infty$ |
| When $d_2 < d_{20}$, | $d_{2m}$ (nm) $=$ | 16.537 | 9.202 | 10.084 | 22.297 | 94.005 |

$1.1 < NA \leq 1.2$

$195 < T \leq 205$

| Case | 20-11 |
|---|---|
| $n_{10}$ | 1.6967389 |
| $k_{10}$ | 0.0554960 |
| $d_{10}$ (nm) | 271.524 |
| $n_{20}$ | 1.6919127 |
| $k_{20}$ | 0.1743507 |
| $d_{20}$ (nm) | 262.739 |

| | | |
|---|---|---|
| When $n_1 \geq n_{10}$, | $n_{1m} =$ | 0.0690857 |
| When $n_1 < n_{10}$, | $n_{1m} =$ | 0.0487012 |
| When $k_1 \geq k_{10}$, | $k_{1m} =$ | 0.0571155 |
| When $k_1 < k_{10}$, | $k_{1m} =$ | 0.0354016 |
| When $d_1 \geq d_{10}$, | $d_{1m}$ (nm) $=$ | $\infty$ |
| When $d_1 < d_{10}$, | $d_{1m}$ (nm) $=$ | 122.531 |
| When $n_2 \geq n_{20}$, | $n_{2m} =$ | 0.3042639 |
| When $n_2 < n_{20}$, | $n_{2m} =$ | 0.2009363 |
| When $k_2 \geq k_{20}$, | $k_{2m} =$ | 0.2111316 |
| When $k_2 < k_{20}$, | $k_{2m} =$ | 0.0800171 |
| When $d_2 \geq d_{20}$, | $d_{2m}$ (nm) $=$ | $\infty$ |
| When $d_2 < d_{20}$, | $d_{2m}$ (nm) $=$ | 82.974 |

11. An exposure method used in a process for manufacturing a semiconductor device, the method comprising the steps of:

providing an antireflective film having a two-layer structure between a resist layer and a silicon oxide layer formed on a surface of a silicon semiconductor substrate having a thickness T (unit: nm) described below; and exposing the resist layer in an exposure system having a wavelength of 190 nm to 195 nm and a numerical aperture NA of $1.2 < NA \leq 1.3$, the antireflective film including an upper layer having a complex refractive index $N_1$, and a lower layer having a complex refractive index $N_2$, the complex refractive indexes $N_1$ and $N_2$ being represented by the equations $N_1 = n_1 - k_1 i$ and $N_2 = n_2 - k_2 i$, respectively;
wherein assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1, k_1, d_1, n_2, k_2,$ and $d_2$ satisfy the relational expression

$$\{(n_1 - n_{10}) / (n_{1m} - n_{10})\}^2 + \{(k_1 - k_{10}) / (k_{1m} - k_{10})\}^2 + \{(d_1 - d_{10}) / (d_{1m} - d_{10})\}^2 + \{(n_2 - n_{20}) / (n_{2m} - n_{20})\}^2 + \{(k_2 - k_{20}) / (k_{2m} - k_{20})\}^2 + \{(d_2 - d_{20}) / (d_{2m} - d_{20})\}^2 \leq 1;$$

a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a

value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$; and in the tables below, in the line of "When $n_1 \geq n_{10}$, $n_{1m}$ =", each value in the right columns is "$n_{1m} - n_{10}$"; in the line of "When $n_1 < n_{10}$, $n_{1m}$ =", each value in the right columns is "$n_{10} - n_{1m}$"; in the line of "When $k_1 \geq k_{10}$, $k_{1m}$ =", each value in the right columns is "$k_{1m} - k_{10}$"; in the line of "When $k_1 < k_{10}$, $k_{1m}$ =", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m}$ =", each value in the right columns is "$n_{2m} - n_{20}$"; in the line of "When $n_2 < n_{20}$, $n_{2m}$ =", each value in the right columns is "$n_{20} - n_{2m}$"; in the line of "When $k_2 \geq k_{20}$, $k_{2m}$ =", each value in the right columns is "$k_{2m} - k_{20}$"; in the line of "When $k_2 < k_{20}$, $k_{2m}$ =", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

1. 2 < N A ≤ 1. 3

2 ≤ T ≤ 1 5

| Case | I-01 | I-02 | I-03 | I-04 | I-05 |
|---|---|---|---|---|---|
| $n_{10}$ | 2.070 | 1.955 | 1.895 | 1.875 | 1.870 |
| $k_{10}$ | 0.020 | 0.138 | 0.133 | 0.110 | 0.101 |
| $d_{10}$ (nm) | 27.974 | 34.826 | 29.218 | 17.990 | 13.959 |
| $n_{20}$ | 5.553 | 9.284 | 2.177 | 1.753 | 1.700 |
| $k_{20}$ | 3.053 | 0.606 | 0.543 | 0.330 | 0.255 |
| $d_{20}$ (nm) | 2.024 | 10.907 | 63.407 | 152.930 | 218.765 |

| | | I-01 | I-02 | I-03 | I-04 | I-05 |
|---|---|---|---|---|---|---|
| When $n_1 \geq n_{10}$, | $n_{1m} =$ | 2.141 | 2.017 | 1.952 | 1.943 | 1.957 |
| When $n_1 < n_{10}$, | $n_{1m} =$ | 2.006 | 1.896 | 1.854 | 1.843 | 1.821 |
| When $k_1 \geq k_{10}$, | $k_{1m} =$ | 0.075 | 0.180 | 0.166 | 0.155 | 0.171 |
| When $k_1 < k_{10}$, | $k_{1m} =$ | 0.000 | 0.061 | 0.055 | 0.028 | 0.009 |
| When $d_1 \geq d_{10}$, | $d_{1m}$ (nm) $=$ | 31.254 | 39.247 | 35.017 | 23.926 | 20.211 |
| When $d_1 < d_{10}$, | $d_{1m}$ (nm) $=$ | 25.519 | 31.618 | 26.178 | 15.560 | 10.679 |
| When $n_2 \geq n_{20}$, | $n_{2m} =$ | 5.876 | 9.377 | 2.281 | 1.832 | 1.773 |
| When $n_2 < n_{20}$, | $n_{2m} =$ | 5.233 | 9.207 | 2.051 | 1.635 | 1.577 |
| When $k_2 \geq k_{20}$, | $k_{2m} =$ | 3.362 | 0.715 | 0.699 | 0.412 | 0.320 |
| When $k_2 < k_{20}$, | $k_{2m} =$ | 2.751 | 0.513 | 0.439 | 0.253 | 0.185 |
| When $d_2 \geq d_{20}$, | $d_{2m}$ (nm) $=$ | 2.251 | 11.023 | 70.023 | ∞ | ∞ |
| When $d_2 < d_{20}$, | $d_{2m}$ (nm) $=$ | 1.807 | 10.812 | 58.076 | 125.396 | 142.606 |

1. 2 < N A ≤ 1. 3

2 ≤ T ≤ 1 5

| Case | I-06 | I-07 | I-08 | I-09 | I-10 |
|---|---|---|---|---|---|
| $n_{10}$ | 1.867 | 1.699 | 1.693 | 1.692 | 1.694 |
| $k_{10}$ | 0.070 | 0.063 | 0.058 | 0.069 | 0.074 |
| $d_{10}$ (nm) | 13.235 | 165.016 | 157.920 | 236.756 | 217.672 |
| $n_{20}$ | 1.732 | 1.698 | 1.698 | 6.942 | 1.788 |
| $k_{20}$ | 0.221 | 0.180 | 0.154 | 3.076 | 0.339 |
| $d_{20}$ (nm) | 270.745 | 204.222 | 265.886 | 0.950 | 84.006 |

| | | I-06 | I-07 | I-08 | I-09 | I-10 |
|---|---|---|---|---|---|---|
| When $n_1 \geq n_{10}$, | $n_{1m} =$ | 1.964 | 1.701 | 1.708 | 1.727 | 1.710 |
| When $n_1 < n_{10}$, | $n_{1m} =$ | 1.810 | 1.683 | 1.664 | 1.662 | 1.674 |
| When $k_1 \geq k_{10}$, | $k_{1m} =$ | 0.149 | 0.068 | 0.084 | 0.108 | 0.106 |
| When $k_1 < k_{10}$, | $k_{1m} =$ | 0.000 | 0.043 | 0.031 | 0.039 | 0.053 |
| When $d_1 \geq d_{10}$, | $d_{1m}$ (nm) $=$ | 20.519 | 166.410 | 170.845 | 255.389 | 226.062 |
| When $d_1 < d_{10}$, | $d_{1m}$ (nm) $=$ | 9.259 | 155.941 | 111.504 | 217.630 | 206.257 |
| When $n_2 \geq n_{20}$, | $n_{2m} =$ | 1.809 | 1.721 | 1.754 | 7.503 | 1.909 |
| When $n_2 < n_{20}$, | $n_{2m} =$ | 1.603 | 1.694 | 1.667 | 6.491 | 1.763 |
| When $k_2 \geq k_{20}$, | $k_{2m} =$ | 0.293 | 0.188 | 0.194 | 3.321 | 0.395 |
| When $k_2 < k_{20}$, | $k_{2m} =$ | 0.152 | 0.139 | 0.113 | 2.487 | 0.243 |
| When $d_2 \geq d_{20}$, | $d_{2m}$ (nm) $=$ | ∞ | 217.552 | ∞ | 1.062 | 100.609 |
| When $d_2 < d_{20}$, | $d_{2m}$ (nm) $=$ | 182.495 | 202.082 | 249.694 | 0.781 | 81.237 |

1．2 < N A ≤ 1．3

2 ≤ T ≤ 1 5

| Case | 1-11 | 1-12 | 1-13 |
|---|---|---|---|
| $n_{10}$ | 1.699 | 1.698 | 1.695 |
| $k_{10}$ | 0.071 | 0.065 | 0.054 |
| $d_{10}$ (nm) | 210.274 | 207.280 | 219.181 |
| $n_{20}$ | 1.718 | 1.695 | 1.688 |
| $k_{20}$ | 0.242 | 0.194 | 0.161 |
| $d_{20}$ (nm) | 154.667 | 219.490 | 263.755 |

| | 1-11 | 1-12 | 1-13 |
|---|---|---|---|
| When $n_1 \geq n_{10}$, $n_{1m} =$ | 1.720 | 1.737 | 1.738 |
| When $n_1 < n_{10}$, $n_{1m} =$ | 1.683 | 1.675 | 1.660 |
| When $k_1 \geq k_{10}$, $k_{1m} =$ | 0.099 | 0.097 | 0.100 |
| When $k_1 < k_{10}$, $k_{1m} =$ | 0.045 | 0.035 | 0.019 |
| When $d_1 \geq d_{10}$, $d_{1m}$ (nm) $=$ | 229.005 | ∞ | ∞ |
| When $d_1 < d_{10}$, $d_{1m}$ (nm) $=$ | 200.369 | 189.200 | 189.609 |
| When $n_2 \geq n_{20}$, $n_{2m} =$ | 1.849 | 1.855 | 1.900 |
| When $n_2 < n_{20}$, $n_{2m} =$ | 1.670 | 1.540 | 1.583 |
| When $k_2 \geq k_{20}$, $k_{2m} =$ | 0.332 | 0.307 | 0.271 |
| When $k_2 < k_{20}$, $k_{2m} =$ | 0.164 | 0.122 | 0.102 |
| When $d_2 \geq d_{20}$, $d_{2m}$ (nm) $=$ | ∞ | ∞ | ∞ |
| When $d_2 < d_{20}$, $d_{2m}$ (nm) $=$ | 143.819 | 154.002 | 185.363 |

1. 2 < N A ≤ 1. 3
15 < T ≤ 25

| Case | 2-01 | 2-02 | 2-03 | 2-04 | 2-05 |
|---|---|---|---|---|---|
| $n_{10}$ | 1.894 | 1.881 | 1.874 | 1.872 | 1.693 |
| $k_{10}$ | 0.182 | 0.116 | 0.105 | 0.074 | 0.060 |
| $d_{10}$ (nm) | 37.493 | 18.625 | 14.298 | 13.408 | 158.097 |
| $n_{20}$ | 9.246 | 1.766 | 1.701 | 1.733 | 1.697 |
| $k_{20}$ | 0.662 | 0.358 | 0.269 | 0.231 | 0.160 |
| $d_{20}$ (nm) | 10.628 | 142.939 | 209.610 | 261.989 | 257.142 |

| | | 2-01 | 2-02 | 2-03 | 2-04 | 2-05 |
|---|---|---|---|---|---|---|
| When $n_1 \geq n_{10}$, | $n_{1m} =$ | 1.954 | 1.946 | 1.957 | 1.966 | 1.703 |
| When $n_1 < n_{10}$, | $n_{1m} =$ | 1.847 | 1.852 | 1.828 | 1.817 | 1.667 |
| When $k_1 \geq k_{10}$, | $k_{1m} =$ | 0.222 | 0.156 | 0.171 | 0.149 | 0.081 |
| When $k_1 < k_{10}$, | $k_{1m} =$ | 0.111 | 0.037 | 0.015 | 0.000 | 0.035 |
| When $d_1 \geq d_{10}$, | $d_{1m}$ (nm) $=$ | 41.975 | 24.164 | 20.222 | 20.345 | 165.590 |
| When $d_1 < d_{10}$, | $d_{1m}$ (nm) $=$ | 34.168 | 16.466 | 11.264 | 9.664 | 137.726 |
| When $n_2 \geq n_{20}$, | $n_{2m} =$ | 9.356 | 1.841 | 1.772 | 1.809 | 1.744 |
| When $n_2 < n_{20}$, | $n_{2m} =$ | 9.153 | 1.650 | 1.579 | 1.602 | 1.674 |
| When $k_2 \geq k_{20}$, | $k_{2m} =$ | 0.784 | 0.442 | 0.334 | 0.302 | 0.195 |
| When $k_2 < k_{20}$, | $k_{2m} =$ | 0.549 | 0.280 | 0.198 | 0.162 | 0.120 |
| When $d_2 \geq d_{20}$, | $d_{2m}$ (nm) $=$ | 10.759 | ∞ | ∞ | ∞ | ∞ |
| When $d_2 < d_{20}$, | $d_{2m}$ (nm) $=$ | 10.519 | 119.178 | 137.341 | 178.243 | 243.996 |

1. 2 < N A ≤ 1. 3
15 < T ≤ 25

| Case | 2-06 | 2-07 | 2-08 | 2-09 | 2-10 |
|---|---|---|---|---|---|
| $n_{10}$ | 1.690 | 1.693 | 1.699 | 1.698 | 1.695 |
| $k_{10}$ | 0.074 | 0.078 | 0.074 | 0.067 | 0.055 |
| $d_{10}$ (nm) | 235.203 | 218.334 | 210.503 | 207.468 | 219.130 |
| $n_{20}$ | 5.632 | 1.803 | 1.719 | 1.694 | 1.687 |
| $k_{20}$ | 4.204 | 0.382 | 0.259 | 0.203 | 0.167 |
| $d_{20}$ (nm) | 0.919 | 74.994 | 145.797 | 210.546 | 255.274 |

| | | 2-06 | 2-07 | 2-08 | 2-09 | 2-10 |
|---|---|---|---|---|---|---|
| When $n_1 \geq n_{10}$, | $n_{1m} =$ | 1.708 | 1.699 | 1.715 | 1.733 | 1.737 |
| When $n_1 < n_{10}$, | $n_{1m} =$ | 1.661 | 1.675 | 1.684 | 1.676 | 1.661 |
| When $k_1 \geq k_{10}$, | $k_{1m} =$ | 0.102 | 0.098 | 0.100 | 0.097 | 0.100 |
| When $k_1 < k_{10}$, | $k_{1m} =$ | 0.051 | 0.067 | 0.052 | 0.039 | 0.022 |
| When $d_1 \geq d_{10}$, | $d_{1m}$ (nm) $=$ | 241.533 | 220.890 | 225.049 | ∞ | ∞ |
| When $d_1 < d_{10}$, | $d_{1m}$ (nm) $=$ | 217.317 | 207.766 | 201.595 | 191.244 | 190.979 |
| When $n_2 \geq n_{20}$, | $n_{2m} =$ | 6.262 | 1.931 | 1.852 | 1.853 | 1.902 |
| When $n_2 < n_{20}$, | $n_{2m} =$ | 5.366 | 1.793 | 1.684 | 1.538 | 1.584 |
| When $k_2 \geq k_{20}$, | $k_{2m} =$ | 4.338 | 0.416 | 0.339 | 0.310 | 0.275 |
| When $k_2 < k_{20}$, | $k_{2m} =$ | 3.555 | 0.288 | 0.182 | 0.132 | 0.107 |
| When $d_2 \geq d_{20}$, | $d_{2m}$ (nm) $=$ | 0.986 | 89.025 | ∞ | ∞ | ∞ |
| When $d_2 < d_{20}$, | $d_{2m}$ (nm) $=$ | 0.720 | 74.083 | 139.178 | 147.776 | 179.334 |

1. 2 < N A ≤ 1. 3
2 5 < T ≤ 3 5

| Case | 3-01 | 3-02 | 3-03 | 3-04 | 3-05 |
|---|---|---|---|---|---|
| $n_{10}$ | 1.855 | 1.894 | 1.879 | 1.879 | 1.692 |
| $k_{10}$ | 0.222 | 0.121 | 0.110 | 0.076 | 0.062 |
| $d_{10}$ (nm) | 38.795 | 19.092 | 14.598 | 13.458 | 158.198 |
| $n_{20}$ | 9.554 | 1.787 | 1.702 | 1.736 | 1.697 |
| $k_{20}$ | 0.714 | 0.392 | 0.285 | 0.242 | 0.168 |
| $d_{20}$ (nm) | 10.003 | 133.195 | 201.011 | 253.439 | 248.709 |

| | | 3-01 | 3-02 | 3-03 | 3-04 | 3-05 |
|---|---|---|---|---|---|---|
| When $n_1 \geq n_{10}$, | $n_{1m} =$ | 1.905 | 1.955 | 1.958 | 1.971 | 1.699 |
| When $n_1 < n_{10}$, | $n_{1m} =$ | 1.821 | 1.868 | 1.836 | 1.826 | 1.670 |
| When $k_1 \geq k_{10}$, | $k_{1m} =$ | 0.258 | 0.156 | 0.172 | 0.149 | 0.078 |
| When $k_1 < k_{10}$, | $k_{1m} =$ | 0.159 | 0.047 | 0.022 | 0.000 | 0.041 |
| When $d_1 \geq d_{10}$, | $d_{1m}$ (nm) $=$ | 42.560 | 24.067 | 20.129 | 19.949 | 161.711 |
| When $d_1 < d_{10}$, | $d_{1m}$ (nm) $=$ | 36.125 | 17.295 | 11.822 | 9.987 | 144.941 |
| When $n_2 \geq n_{20}$, | $n_{2m} =$ | 9.681 | 1.856 | 1.769 | 1.811 | 1.737 |
| When $n_2 < n_{20}$, | $n_{2m} =$ | 9.446 | 1.674 | 1.584 | 1.608 | 1.683 |
| When $k_2 \geq k_{20}$, | $k_{2m} =$ | 0.829 | 0.479 | 0.348 | 0.313 | 0.196 |
| When $k_2 < k_{20}$, | $k_{2m} =$ | 0.587 | 0.314 | 0.215 | 0.173 | 0.129 |
| When $d_2 \geq d_{20}$, | $d_{2m}$ (nm) $=$ | 10.138 | ∞ | ∞ | ∞ | ∞ |
| When $d_2 < d_{20}$, | $d_{2m}$ (nm) $=$ | 9.892 | 112.716 | 132.762 | 173.492 | 239.168 |

1. 2 < N A ≤ 1. 3
2 5 < T ≤ 3 5

| Case | 3-06 | 3-07 | 3-08 |
|---|---|---|---|
| $n_{10}$ | 1.699 | 1.698 | 1.695 |
| $k_{10}$ | 0.078 | 0.070 | 0.057 |
| $d_{10}$ (nm) | 210.437 | 207.381 | 219.158 |
| $n_{20}$ | 1.720 | 1.693 | 1.687 |
| $k_{20}$ | 0.280 | 0.215 | 0.175 |
| $d_{20}$ (nm) | 137.855 | 202.487 | 246.765 |

| | | 3-06 | 3-07 | 3-08 |
|---|---|---|---|---|
| When $n_1 \geq n_{10}$, | $n_{1m} =$ | 1.710 | 1.730 | 1.737 |
| When $n_1 < n_{10}$, | $n_{1m} =$ | 1.686 | 1.678 | 1.661 |
| When $k_1 \geq k_{10}$, | $k_{1m} =$ | 0.100 | 0.097 | 0.101 |
| When $k_1 < k_{10}$, | $k_{1m} =$ | 0.063 | 0.046 | 0.025 |
| When $d_1 \geq d_{10}$, | $d_{1m}$ (nm) $=$ | 216.379 | ∞ | ∞ |
| When $d_1 < d_{10}$, | $d_{1m}$ (nm) $=$ | 202.875 | 193.042 | 192.539 |
| When $n_2 \geq n_{20}$, | $n_{2m} =$ | 1.855 | 1.841 | 1.910 |
| When $n_2 < n_{20}$, | $n_{2m} =$ | 1.702 | 1.535 | 1.588 |
| When $k_2 \geq k_{20}$, | $k_{2m} =$ | 0.336 | 0.312 | 0.280 |
| When $k_2 < k_{20}$, | $k_{2m} =$ | 0.208 | 0.146 | 0.114 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 134.716 | 142.289 | 200.270 |

1. $2 < NA \leq 1.3$
$35 < T \leq 45$

| Case | 4-01 | 4-02 | 4-03 | 4-04 | 4-05 |
|---|---|---|---|---|---|
| $n_{10}$ | 1.921 | 1.907 | 1.883 | 1.885 | 1.692 |
| $k_{10}$ | 0.198 | 0.132 | 0.117 | 0.078 | 0.064 |
| $d_{10}$ (nm) | 29.852 | 18.597 | 14.666 | 13.425 | 158.019 |
| $n_{20}$ | 2.410 | 1.779 | 1.698 | 1.738 | 1.697 |
| $k_{20}$ | 0.850 | 0.418 | 0.298 | 0.251 | 0.174 |
| $d_{20}$ (nm) | 42.336 | 126.566 | 192.788 | 244.904 | 240.368 |

| | | 4-01 | 4-02 | 4-03 | 4-04 | 4-05 |
|---|---|---|---|---|---|---|
| When $n_1 \geq n_{10}$, | $n_{1m} =$ | 1.964 | 1.964 | 1.959 | 1.975 | 1.694 |
| When $n_1 < n_{10}$, | $n_{1m} =$ | 1.894 | 1.886 | 1.843 | 1.834 | 1.673 |
| When $k_1 \geq k_{10}$, | $k_{1m} =$ | 0.224 | 0.160 | 0.175 | 0.149 | 0.073 |
| When $k_1 < k_{10}$, | $k_{1m} =$ | 0.152 | 0.061 | 0.031 | 0.000 | 0.048 |
| When $d_1 \geq d_{10}$, | $d_{1m}$ (nm) = | 33.127 | 22.917 | 19.812 | 19.537 | 159.270 |
| When $d_1 < d_{10}$, | $d_{1m}$ (nm) = | 28.245 | 17.267 | 12.114 | 10.202 | 147.983 |
| When $n_2 \geq n_{20}$, | $n_{2m} =$ | 2.530 | 1.833 | 1.762 | 1.812 | 1.732 |
| When $n_2 < n_{20}$, | $n_{2m} =$ | 2.288 | 1.667 | 1.583 | 1.611 | 1.691 |
| When $k_2 \geq k_{20}$, | $k_{2m} =$ | 0.928 | 0.492 | 0.359 | 0.320 | 0.195 |
| When $k_2 < k_{20}$, | $k_{2m} =$ | 0.730 | 0.344 | 0.229 | 0.182 | 0.145 |
| When $d_2 \geq d_{20}$, | $d_{2m}$ (nm) = | 46.411 | ∞ | ∞ | ∞ | 274.107 |
| When $d_2 < d_{20}$, | $d_{2m}$ (nm) = | 39.931 | 107.536 | 154.271 | 167.375 | 234.670 |

1. $2 < NA \leq 1.3$
$35 < T \leq 45$

| Case | 4-06 | 4-07 | 4-08 | 4-09 |
|---|---|---|---|---|
| $n_{10}$ | 1.700 | 1.698 | 1.695 | 1.705 |
| $k_{10}$ | 0.081 | 0.072 | 0.059 | 0.053 |
| $d_{10}$ (nm) | 209.560 | 206.609 | 219.174 | 283.412 |
| $n_{20}$ | 1.716 | 1.692 | 1.688 | 1.691 |
| $k_{20}$ | 0.298 | 0.225 | 0.183 | 0.185 |
| $d_{20}$ (nm) | 131.419 | 195.862 | 237.750 | 233.362 |

| | | 4-06 | 4-07 | 4-08 | 4-09 |
|---|---|---|---|---|---|
| When $n_1 \geq n_{10}$, | $n_{1m} =$ | 1.701 | 1.721 | 1.734 | 1.751 |
| When $n_1 < n_{10}$, | $n_{1m} =$ | 1.689 | 1.680 | 1.662 | 1.675 |
| When $k_1 \geq k_{10}$, | $k_{1m} =$ | 0.099 | 0.097 | 0.101 | 0.092 |
| When $k_1 < k_{10}$, | $k_{1m} =$ | 0.076 | 0.050 | 0.027 | 0.024 |
| When $d_1 \geq d_{10}$, | $d_{1m}$ (nm) = | 210.753 | ∞ | ∞ | ∞ |
| When $d_1 < d_{10}$, | $d_{1m}$ (nm) = | 203.620 | 194.085 | 194.045 | 189.814 |
| When $n_2 \geq n_{20}$, | $n_{2m} =$ | 1.846 | 1.812 | 1.920 | 1.889 |
| When $n_2 < n_{20}$, | $n_{2m} =$ | 1.712 | 1.528 | 1.594 | 1.515 |
| When $k_2 \geq k_{20}$, | $k_{2m} =$ | 0.319 | 0.315 | 0.285 | 0.358 |
| When $k_2 < k_{20}$, | $k_{2m} =$ | 0.257 | 0.159 | 0.121 | 0.115 |
| When $d_2 \geq d_{20}$, | $d_{2m}$ (nm) = | ∞ | ∞ | ∞ | ∞ |
| When $d_2 < d_{20}$, | $d_{2m}$ (nm) = | 130.894 | 179.580 | 197.417 | 162.566 |

1. 2 < N A ≤ 1. 3
4 5 < T ≤ 5 5

| Case | 5-01 | 5-02 | 5-03 | 5-04 | 5-05 |
|---|---|---|---|---|---|
| $n_{10}$ | 1.943 | 1.907 | 1.884 | 1.891 | 1.691 |
| $k_{10}$ | 0.213 | 0.153 | 0.123 | 0.078 | 0.066 |
| $d_{10}$ (nm) | 22.907 | 17.372 | 14.585 | 13.392 | 157.377 |
| $n_{20}$ | 1.902 | 1.716 | 1.691 | 1.743 | 1.696 |
| $k_{20}$ | 0.785 | 0.418 | 0.305 | 0.257 | 0.178 |
| $d_{20}$ (nm) | 53.731 | 124.143 | 184.536 | 235.129 | 232.195 |

| | | 5-01 | 5-02 | 5-03 | 5-04 | 5-05 |
|---|---|---|---|---|---|---|
| When $n_1 \geq n_{10}$, | $n_{1m} =$ | 1.979 | 1.963 | 1.959 | 1.980 | 1.692 |
| When $n_1 < n_{10}$, | $n_{1m} =$ | 1.934 | 1.892 | 1.845 | 1.841 | 1.676 |
| When $k_1 \geq k_{10}$, | $k_{1m} =$ | 0.223 | 0.175 | 0.181 | 0.148 | 0.067 |
| When $k_1 < k_{10}$, | $k_{1m} =$ | 0.198 | 0.080 | 0.039 | 0.000 | 0.057 |
| When $d_1 \geq d_{10}$, | $d_{1m}$ (nm) $=$ | 25.447 | 21.108 | 19.487 | 19.257 | 157.441 |
| When $d_1 < d_{10}$, | $d_{1m}$ (nm) $=$ | 22.431 | 16.482 | 12.133 | 10.346 | 149.670 |
| When $n_2 \geq n_{20}$, | $n_{2m} =$ | 1.937 | 1.752 | 1.753 | 1.817 | 1.727 |
| When $n_2 < n_{20}$, | $n_{2m} =$ | 1.871 | 1.605 | 1.576 | 1.616 | 1.695 |
| When $k_2 \geq k_{20}$, | $k_{2m} =$ | 0.813 | 0.464 | 0.362 | 0.326 | 0.187 |
| When $k_2 < k_{20}$, | $k_{2m} =$ | 0.724 | 0.351 | 0.237 | 0.188 | 0.173 |
| When $d_2 \geq d_{20}$, | $d_{2m}$ (nm) $=$ | 58.954 | ∞ | ∞ | ∞ | 254.885 |
| When $d_2 < d_{20}$, | $d_{2m}$ (nm) $=$ | 51.905 | 103.951 | 122.545 | 158.102 | 231.812 |

1. 2 < N A ≤ 1. 3
4 5 < T ≤ 5 5

| Case | 5-06 | 5-07 | 5-08 |
|---|---|---|---|
| $n_{10}$ | 1.699 | 1.695 | 1.704 |
| $k_{10}$ | 0.072 | 0.060 | 0.054 |
| $d_{10}$ (nm) | 204.994 | 219.095 | 283.255 |
| $n_{20}$ | 1.688 | 1.689 | 1.689 |
| $k_{20}$ | 0.231 | 0.188 | 0.189 |
| $d_{20}$ (nm) | 192.230 | 228.102 | 224.255 |

| | | 5-06 | 5-07 | 5-08 |
|---|---|---|---|---|
| When $n_1 \geq n_{10}$, | $n_{1m} =$ | 1.718 | 1.729 | 1.749 |
| When $n_1 < n_{10}$, | $n_{1m} =$ | 1.682 | 1.663 | 1.676 |
| When $k_1 \geq k_{10}$, | $k_{1m} =$ | 0.096 | 0.102 | 0.091 |
| When $k_1 < k_{10}$, | $k_{1m} =$ | 0.048 | 0.030 | 0.025 |
| When $d_1 \geq d_{10}$, | $d_{1m}$ (nm) $=$ | ∞ | ∞ | ∞ |
| When $d_1 < d_{10}$, | $d_{1m}$ (nm) $=$ | 194.149 | 195.371 | 190.682 |
| When $n_2 \geq n_{20}$, | $n_{2m} =$ | 1.788 | 1.929 | 1.898 |
| When $n_2 < n_{20}$, | $n_{2m} =$ | 1.641 | 1.601 | 1.530 |
| When $k_2 \geq k_{20}$, | $k_{2m} =$ | 0.326 | 0.290 | 0.362 |
| When $k_2 < k_{20}$, | $k_{2m} =$ | 0.165 | 0.127 | 0.117 |
| When $d_2 \geq d_{20}$, | $d_{2m}$ (nm) $=$ | ∞ | ∞ | ∞ |
| When $d_2 < d_{20}$, | $d_{2m}$ (nm) $=$ | 176.978 | 195.845 | 153.544 |

$1. 2 < NA \leq 1. 3$

$55 < T \leq 65$

| Case | 6-01 | 6-02 | 6-03 | 6-04 | 6-05 |
|---|---|---|---|---|---|
| $n_{10}$ | 1.895 | 1.882 | 1.690 | 1.701 | 1.693 |
| $k_{10}$ | 0.076 | 0.126 | 0.068 | 0.084 | 0.070 |
| $d_{10}$ (nm) | 13.537 | 14.752 | 155.845 | 206.275 | 221.382 |
| $n_{20}$ | 1.753 | 1.688 | 1.693 | 1.686 | 1.667 |
| $k_{20}$ | 0.262 | 0.309 | 0.181 | 0.310 | 0.231 |
| $d_{20}$ (nm) | 223.848 | 174.672 | 224.616 | 122.505 | 161.928 |

| | | 6-01 | 6-02 | 6-03 | 6-04 | 6-05 |
|---|---|---|---|---|---|---|
| When $n_1 \geq n_{10}$, | $n_{1m} =$ | 1.983 | 1.956 | 1.691 | 1.703 | 1.726 |
| When $n_1 < n_{10}$, | $n_{1m} =$ | 1.846 | 1.842 | 1.680 | 1.695 | 1.686 |
| When $k_1 \geq k_{10}$, | $k_{1m} =$ | 0.143 | 0.185 | 0.071 | 0.096 | 0.105 |
| When $k_1 < k_{10}$, | $k_{1m} =$ | 0.000 | 0.045 | 0.054 | 0.076 | 0.063 |
| When $d_1 \geq d_{10}$, | $d_{1m}$ (nm) $=$ | 19.333 | 19.661 | 156.188 | 207.561 | 253.974 |
| When $d_1 < d_{10}$, | $d_{1m}$ (nm) $=$ | 10.604 | 12.234 | 149.873 | 203.306 | 217.847 |
| When $n_2 \geq n_{20}$, | $n_{2m} =$ | 1.828 | 1.751 | 1.713 | 1.791 | 1.691 |
| When $n_2 < n_{20}$, | $n_{2m} =$ | 1.623 | 1.571 | 1.692 | 1.682 | 1.585 |
| When $k_2 \geq k_{20}$, | $k_{2m} =$ | 0.332 | 0.365 | 0.184 | 0.352 | 0.284 |
| When $k_2 < k_{20}$, | $k_{2m} =$ | 0.191 | 0.239 | 0.171 | 0.280 | 0.201 |
| When $d_2 \geq d_{20}$, | $d_{2m}$ (nm) $=$ | $\infty$ | $\infty$ | 244.114 | 149.549 | 170.132 |
| When $d_2 < d_{20}$, | $d_{2m}$ (nm) $=$ | 146.194 | 124.203 | 224.269 | 121.948 | 139.231 |

$1. 2 < NA \leq 1. 3$

$55 < T \leq 65$

| Case | 6-06 | 6-07 | 6-08 |
|---|---|---|---|
| $n_{10}$ | 1.695 | 1.695 | 1.703 |
| $k_{10}$ | 0.060 | 0.055 | 0.049 |
| $d_{10}$ (nm) | 218.851 | 215.764 | 278.302 |
| $n_{20}$ | 1.689 | 1.693 | 1.691 |
| $k_{20}$ | 0.190 | 0.162 | 0.159 |
| $d_{20}$ (nm) | 218.129 | 277.062 | 273.241 |

| | | 6-06 | 6-07 | 6-08 |
|---|---|---|---|---|
| When $n_1 \geq n_{10}$, | $n_{1m} =$ | 1.726 | 1.740 | 1.751 |
| When $n_1 < n_{10}$, | $n_{1m} =$ | 1.665 | 1.662 | 1.653 |
| When $k_1 \geq k_{10}$, | $k_{1m} =$ | 0.102 | 0.097 | 0.092 |
| When $k_1 < k_{10}$, | $k_{1m} =$ | 0.031 | 0.021 | 0.015 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 196.531 | 170.235 | 166.884 |
| When $n_2 \geq n_{20}$, | $n_{2m} =$ | 1.935 | 1.919 | 1.925 |
| When $n_2 < n_{20}$, | $n_{2m} =$ | 1.606 | 1.543 | 1.498 |
| When $k_2 \geq k_{20}$, | $k_{2m} =$ | 0.294 | 0.280 | 0.278 |
| When $k_2 < k_{20}$, | $k_{2m} =$ | 0.130 | 0.102 | 0.095 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 191.652 | 197.142 | 190.724 |

1. 2 < N A ≤ 1. 3
6 5 < T ≤ 7 5

| Case | 7-01 | 7-02 | 7-03 | 7-04 | 7-05 |
|---|---|---|---|---|---|
| $n_{10}$ | 1.881 | 1.879 | 1.898 | 1.873 | 1.715 |
| $k_{10}$ | 0.189 | 0.125 | 0.073 | 0.092 | 0.067 |
| $d_{10}$ (nm) | 17.242 | 15.444 | 14.029 | 12.003 | 99.925 |
| $n_{20}$ | 1.617 | 1.697 | 1.767 | 1.696 | 1.686 |
| $k_{20}$ | 0.409 | 0.320 | 0.271 | 0.218 | 0.167 |
| $d_{20}$ (nm) | 111.921 | 162.536 | 211.582 | 280.785 | 269.056 |

| | | 7-01 | 7-02 | 7-03 | 7-04 | 7-05 |
|---|---|---|---|---|---|---|
| When $n_1 \geq n_{10}$, | $n_{1m} =$ | 1.933 | 1.953 | 1.985 | 1.975 | 1.746 |
| When $n_1 < n_{10}$, | $n_{1m} =$ | 1.873 | 1.839 | 1.852 | 1.816 | 1.710 |
| When $k_1 \geq k_{10}$, | $k_{1m} =$ | 0.202 | 0.184 | 0.136 | 0.174 | 0.081 |
| When $k_1 < k_{10}$, | $k_{1m} =$ | 0.122 | 0.046 | 0.000 | 0.000 | 0.037 |
| When $d_1 \geq d_{10}$, | $d_{1m}$ (nm) $=$ | 20.550 | 20.523 | 19.818 | 18.551 | 136.285 |
| When $d_1 < d_{10}$, | $d_{1m}$ (nm) $=$ | 16.700 | 12.791 | 11.204 | 8.554 | 98.008 |
| When $n_2 \geq n_{20}$, | $n_{2m} =$ | 1.633 | 1.761 | 1.845 | 1.780 | 1.699 |
| When $n_2 < n_{20}$, | $n_{2m} =$ | 1.511 | 1.579 | 1.638 | 1.585 | 1.620 |
| When $k_2 \geq k_{20}$, | $k_{2m} =$ | 0.430 | 0.380 | 0.344 | 0.283 | 0.175 |
| When $k_2 < k_{20}$, | $k_{2m} =$ | 0.344 | 0.246 | 0.196 | 0.150 | 0.131 |
| When $d_2 \geq d_{20}$, | $d_{2m}$ (nm) $=$ | ∞ | ∞ | ∞ | ∞ | 278.211 |
| When $d_2 < d_{20}$, | $d_{2m}$ (nm) $=$ | 91.266 | 127.980 | 136.666 | 158.294 | 243.285 |

1. 2 < N A ≤ 1. 3
6 5 < T ≤ 7 5

| Case | 7-06 | 7-07 | 7-08 |
|---|---|---|---|
| $n_{10}$ | 1.693 | 1.695 | 1.695 |
| $k_{10}$ | 0.070 | 0.061 | 0.055 |
| $d_{10}$ (nm) | 221.230 | 218.569 | 215.552 |
| $n_{20}$ | 1.668 | 1.689 | 1.692 |
| $k_{20}$ | 0.236 | 0.193 | 0.164 |
| $d_{20}$ (nm) | 151.884 | 208.598 | 267.637 |

| | | 7-06 | 7-07 | 7-08 |
|---|---|---|---|---|
| When $n_1 \geq n_{10}$, | $n_{1m} =$ | 1.724 | 1.724 | 1.741 |
| When $n_1 < n_{10}$, | $n_{1m} =$ | 1.686 | 1.666 | 1.661 |
| When $k_1 \geq k_{10}$, | $k_{1m} =$ | 0.105 | 0.101 | 0.097 |
| When $k_1 < k_{10}$, | $k_{1m} =$ | 0.064 | 0.031 | 0.021 |
| When $d_1 \geq d_{10}$, | $d_{1m}$ (nm) $=$ | 247.645 | ∞ | ∞ |
| When $d_1 < d_{10}$, | $d_{1m}$ (nm) $=$ | 218.101 | 197.493 | 171.385 |
| When $n_2 \geq n_{20}$, | $n_{2m} =$ | 1.689 | 1.934 | 1.918 |
| When $n_2 < n_{20}$, | $n_{2m} =$ | 1.586 | 1.609 | 1.542 |
| When $k_2 \geq k_{20}$, | $k_{2m} =$ | 0.286 | 0.296 | 0.281 |
| When $k_2 < k_{20}$, | $k_{2m} =$ | 0.205 | 0.130 | 0.101 |
| When $d_2 \geq d_{20}$, | $d_{2m}$ (nm) $=$ | 159.193 | ∞ | ∞ |
| When $d_2 < d_{20}$, | $d_{2m}$ (nm) $=$ | 130.698 | 183.027 | 188.504 |

1. 2 < N A ≤ 1. 3
7 5 < T ≤ 8 5

| Case | 8-01 | 8-02 | 8-03 | 8-04 | 8-05 |
|---|---|---|---|---|---|
| $n_{10}$ | 1.880 | 1.901 | 1.874 | 1.716 | 1.692 |
| $k_{10}$ | 0.126 | 0.074 | 0.095 | 0.068 | 0.072 |
| $d_{10}$ (nm) | 16.279 | 14.624 | 12.218 | 99.848 | 220.366 |
| $n_{20}$ | 1.709 | 1.778 | 1.694 | 1.687 | 1.668 |
| $k_{20}$ | 0.340 | 0.284 | 0.225 | 0.173 | 0.244 |
| $d_{20}$ (nm) | 151.148 | 201.087 | 271.916 | 259.863 | 143.647 |

| | | 8-01 | 8-02 | 8-03 | 8-04 | 8-05 |
|---|---|---|---|---|---|---|
| When $n_1 \geq n_{10}$, | $n_{1m} =$ | 1.951 | 1.984 | 1.974 | 1.746 | 1.725 |
| When $n_1 < n_{10}$, | $n_{1m} =$ | 1.842 | 1.857 | 1.818 | 1.712 | 1.688 |
| When $k_1 \geq k_{10}$, | $k_{1m} =$ | 0.181 | 0.134 | 0.175 | 0.079 | 0.106 |
| When $k_1 < k_{10}$, | $k_{1m} =$ | 0.048 | 0.000 | 0.000 | 0.042 | 0.068 |
| When $d_1 \geq d_{10}$, | $d_{1m}$ (nm) $=$ | 21.358 | 20.311 | 18.650 | 135.917 | 245.491 |
| When $d_1 < d_{10}$, | $d_{1m}$ (nm) $=$ | 13.627 | 11.922 | 8.869 | 98.660 | 218.637 |
| When $n_2 \geq n_{20}$, | $n_{2m} =$ | 1.774 | 1.856 | 1.776 | 1.696 | 1.688 |
| When $n_2 < n_{20}$, | $n_{2m} =$ | 1.592 | 1.651 | 1.582 | 1.624 | 1.581 |
| When $k_2 \geq k_{20}$, | $k_{2m} =$ | 0.403 | 0.360 | 0.289 | 0.178 | 0.280 |
| When $k_2 < k_{20}$, | $k_{2m} =$ | 0.263 | 0.208 | 0.157 | 0.137 | 0.214 |
| When $d_2 \geq d_{20}$, | $d_{2m}$ (nm) $=$ | ∞ | ∞ | ∞ | 265.927 | 149.336 |
| When $d_2 < d_{20}$, | $d_{2m}$ (nm) $=$ | 123.537 | 130.884 | 183.486 | 237.438 | 121.404 |

1. 2 < N A ≤ 1. 3
7 5 < T ≤ 8 5

| Case | 8-06 | 8-07 |
|---|---|---|
| $n_{10}$ | 1.695 | 1.695 |
| $k_{10}$ | 0.062 | 0.056 |
| $d_{10}$ (nm) | 218.447 | 215.754 |
| $n_{20}$ | 1.688 | 1.691 |
| $k_{20}$ | 0.198 | 0.167 |
| $d_{20}$ (nm) | 200.044 | 258.621 |

| | | 8-06 | 8-07 |
|---|---|---|---|
| When $n_1 \geq n_{10}$, | $n_{1m} =$ | 1.724 | 1.740 |
| When $n_1 < n_{10}$, | $n_{1m} =$ | 1.667 | 1.661 |
| When $k_1 \geq k_{10}$, | $k_{1m} =$ | 0.102 | 0.097 |
| When $k_1 < k_{10}$, | $k_{1m} =$ | 0.033 | 0.022 |
| When $d_1 \geq d_{10}$, | $d_{1m}$ (nm) $=$ | ∞ | ∞ |
| When $d_1 < d_{10}$, | $d_{1m}$ (nm) $=$ | 198.178 | 171.868 |
| When $n_2 \geq n_{20}$, | $n_{2m} =$ | 1.931 | 1.916 |
| When $n_2 < n_{20}$, | $n_{2m} =$ | 1.605 | 1.542 |
| When $k_2 \geq k_{20}$, | $k_{2m} =$ | 0.296 | 0.282 |
| When $k_2 < k_{20}$, | $k_{2m} =$ | 0.132 | 0.105 |
| When $d_2 \geq d_{20}$, | $d_{2m}$ (nm) $=$ | ∞ | ∞ |
| When $d_2 < d_{20}$, | $d_{2m}$ (nm) $=$ | 172.147 | 178.623 |

1. 2 < N A ≤ 1. 3
8 5 < T ≤ 9 5

| Case | 9-01 | 9-02 | 9-03 | 9-04 | 9-05 |
|---|---|---|---|---|---|
| $n_{10}$ | 1.888 | 1.903 | 1.880 | 1.693 | 1.695 |
| $k_{10}$ | 0.130 | 0.081 | 0.095 | 0.063 | 0.064 |
| $d_{10}$ (nm) | 16.763 | 14.911 | 12.432 | 156.037 | 218.418 |
| $n_{20}$ | 1.718 | 1.775 | 1.700 | 1.696 | 1.685 |
| $k_{20}$ | 0.366 | 0.299 | 0.236 | 0.165 | 0.207 |
| $d_{20}$ (nm) | 141.793 | 193.492 | 262.434 | 252.531 | 192.031 |

| | | 9-01 | 9-02 | 9-03 | 9-04 | 9-05 |
|---|---|---|---|---|---|---|
| When $n_1 \geq n_{10}$, | $n_{1m} =$ | 1.955 | 1.983 | 1.976 | 1.693 | 1.725 |
| When $n_1 < n_{10}$, | $n_{1m} =$ | 1.853 | 1.862 | 1.827 | 1.659 | 1.667 |
| When $k_1 \geq k_{10}$, | $k_{1m} =$ | 0.178 | 0.137 | 0.171 | 0.071 | 0.102 |
| When $k_1 < k_{10}$, | $k_{1m} =$ | 0.053 | 0.000 | 0.000 | 0.062 | 0.036 |
| When $d_1 \geq d_{10}$, | $d_{1m}$ (nm) $=$ | 21.482 | 20.338 | 18.582 | 156.116 | 252.664 |
| When $d_1 < d_{10}$, | $d_{1m}$ (nm) $=$ | 14.427 | 12.369 | 9.315 | 108.678 | 198.579 |
| When $n_2 \geq n_{20}$, | $n_{2m} =$ | 1.777 | 1.851 | 1.779 | 1.766 | 1.934 |
| When $n_2 < n_{20}$, | $n_{2m} =$ | 1.605 | 1.653 | 1.583 | 1.688 | 1.600 |
| When $k_2 \geq k_{20}$, | $k_{2m} =$ | 0.429 | 0.373 | 0.299 | 0.166 | 0.298 |
| When $k_2 < k_{20}$, | $k_{2m} =$ | 0.289 | 0.223 | 0.167 | 0.129 | 0.138 |
| When $d_2 \geq d_{20}$, | $d_{2m}$ (nm) $=$ | ∞ | ∞ | ∞ | 252.906 | ∞ |
| When $d_2 < d_{20}$, | $d_{2m}$ (nm) $=$ | 118.585 | 127.262 | 178.673 | 249.872 | 164.058 |

1. 2 < N A ≤ 1. 3
8 5 < T ≤ 9 5

| Case | 9-06 | 9-07 |
|---|---|---|
| $n_{10}$ | 1.695 | 1.704 |
| $k_{10}$ | 0.057 | 0.051 |
| $d_{10}$ (nm) | 216.093 | 278.289 |
| $n_{20}$ | 1.691 | 1.691 |
| $k_{20}$ | 0.173 | 0.173 |
| $d_{20}$ (nm) | 249.945 | 246.105 |

| | | 9-06 | 9-07 |
|---|---|---|---|
| When $n_1 \geq n_{10}$, | $n_{1m} =$ | 1.738 | 1.752 |
| When $n_1 < n_{10}$, | $n_{1m} =$ | 1.662 | 1.653 |
| When $k_1 \geq k_{10}$, | $k_{1m} =$ | 0.098 | 0.092 |
| When $k_1 < k_{10}$, | $k_{1m} =$ | 0.022 | 0.016 |
| When $d_1 \geq d_{10}$, | $d_{1m}$ (nm) $=$ | ∞ | ∞ |
| When $d_1 < d_{10}$, | $d_{1m}$ (nm) $=$ | 175.267 | 172.533 |
| When $n_2 \geq n_{20}$, | $n_{2m} =$ | 1.919 | 1.830 |
| When $n_2 < n_{20}$, | $n_{2m} =$ | 1.543 | 1.507 |
| When $k_2 \geq k_{20}$, | $k_{2m} =$ | 0.284 | 0.291 |
| When $k_2 < k_{20}$, | $k_{2m} =$ | 0.111 | 0.108 |
| When $d_2 \geq d_{20}$, | $d_{2m}$ (nm) $=$ | ∞ | ∞ |
| When $d_2 < d_{20}$, | $d_{2m}$ (nm) $=$ | 173.633 | 172.262 |

1. 2 < N A ≦ 1. 3
9 5 < T ≦ 1 0 5

| Case | 10-01 | 10-02 | 10-03 | 10-04 | 10-05 |
|---|---|---|---|---|---|
| $n_{10}$ | 1.902 | 1.906 | 1.888 | 1.694 | 1.695 |
| $k_{10}$ | 0.140 | 0.093 | 0.096 | 0.066 | 0.059 |
| $d_{10}$ (nm) | 16.621 | 14.821 | 12.503 | 218.392 | 216.276 |
| $n_{20}$ | 1.717 | 1.761 | 1.706 | 1.682 | 1.691 |
| $k_{20}$ | 0.393 | 0.312 | 0.247 | 0.217 | 0.180 |
| $d_{20}$ (nm) | 134.110 | 187.587 | 253.021 | 183.765 | 241.184 |

| | | 10-01 | 10-02 | 10-03 | 10-04 | 10-05 |
|---|---|---|---|---|---|---|
| When $n_1 \geq n_{10}$, | $n_{1m} =$ | 1.964 | 1.983 | 1.982 | 1.725 | 1.737 |
| When $n_1 < n_{10}$, | $n_{1m} =$ | 1.874 | 1.867 | 1.838 | 1.666 | 1.663 |
| When $k_1 \geq k_{10}$, | $k_{1m} =$ | 0.179 | 0.146 | 0.168 | 0.103 | 0.098 |
| When $k_1 < k_{10}$, | $k_{1m} =$ | 0.062 | 0.004 | 0.000 | 0.041 | 0.024 |
| When $d_1 \geq d_{10}$, | $d_{1m}$ (nm) $=$ | 20.729 | 19.885 | 18.297 | 250.100 | ∞ |
| When $d_1 < d_{10}$, | $d_{1m}$ (nm) $=$ | 14.862 | 12.520 | 9.652 | 198.830 | 185.832 |
| When $n_2 \geq n_{20}$, | $n_{2m} =$ | 1.767 | 1.831 | 1.783 | 1.944 | 1.927 |
| When $n_2 < n_{20}$, | $n_{2m} =$ | 1.609 | 1.641 | 1.584 | 1.598 | 1.559 |
| When $k_2 \geq k_{20}$, | $k_{2m} =$ | 0.449 | 0.380 | 0.309 | 0.303 | 0.288 |
| When $k_2 < k_{20}$, | $k_{2m} =$ | 0.320 | 0.238 | 0.178 | 0.149 | 0.117 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 113.506 | 124.690 | 172.558 | 157.077 | 167.184 |

1. 2 < N A ≦ 1. 3
9 5 < T ≦ 1 0 5

| Case | 10-06 |
|---|---|
| $n_{10}$ | 1.704 |
| $k_{10}$ | 0.052 |
| $d_{10}$ (nm) | 278.098 |
| $n_{20}$ | 1.689 |
| $k_{20}$ | 0.180 |
| $d_{20}$ (nm) | 237.690 |

| | | 10-06 |
|---|---|---|
| When $n_1 \geq n_{10}$, | $n_{1m} =$ | 1.752 |
| When $n_1 < n_{10}$, | $n_{1m} =$ | 1.658 |
| When $k_1 \geq k_{10}$, | $k_{1m} =$ | 0.091 |
| When $k_1 < k_{10}$, | $k_{1m} =$ | 0.019 |
| When $d_1 \geq d_{10}$, | $d_{1m}$ (nm) $=$ | ∞ |
| When $d_1 < d_{10}$, | $d_{1m}$ (nm) $=$ | 180.136 |
| When $n_2 \geq n_{20}$, | $n_{2m} =$ | 1.847 |
| When $n_2 < n_{20}$, | $n_{2m} =$ | 1.512 |
| When $k_2 \geq k_{20}$, | $k_{2m} =$ | 0.296 |
| When $k_2 < k_{20}$, | $k_{2m} =$ | 0.113 |
| When $d_2 \geq d_{20}$, | $d_{2m}$ (nm) $=$ | ∞ |
| When $d_2 < d_{20}$, | $d_{2m}$ (nm) $=$ | 165.978 |

1 . 2 < N A ≤ 1 . 3
1 0 5 < T ≤ 1 1 5

| Case | 11-01 | 11-02 | 11-03 | 11-04 | 11-05 |
|---|---|---|---|---|---|
| $n_{10}$ | 1.915 | 1.908 | 1.895 | 1.692 | 1.694 |
| $k_{10}$ | 0.153 | 0.105 | 0.097 | 0.060 | 0.068 |
| $d_{10}$ (nm) | 15.972 | 14.452 | 12.386 | 153.833 | 218.491 |
| $n_{20}$ | 1.700 | 1.741 | 1.708 | 1.696 | 1.679 |
| $k_{20}$ | 0.410 | 0.319 | 0.254 | 0.152 | 0.227 |
| $d_{20}$ (nm) | 128.035 | 181.864 | 244.026 | 294.292 | 174.638 |

| | | 11-01 | 11-02 | 11-03 | 11-04 | 11-05 |
|---|---|---|---|---|---|---|
| When $n_1 \geq n_{10}$, | $n_{1m} =$ | 1.973 | 1.983 | 1.987 | 1.719 | 1.723 |
| When $n_1 < n_{10}$, | $n_{1m} =$ | 1.893 | 1.872 | 1.847 | 1.655 | 1.669 |
| When $k_1 \geq k_{10}$, | $k_{1m} =$ | 0.185 | 0.156 | 0.167 | 0.093 | 0.104 |
| When $k_1 < k_{10}$, | $k_{1m} =$ | 0.078 | 0.017 | 0.000 | 0.039 | 0.045 |
| When $d_1 \geq d_{10}$, | $d_{1m}$ (nm) $=$ | 19.455 | 19.144 | 17.845 | ∞ | 247.764 |
| When $d_1 < d_{10}$, | $d_{1m}$ (nm) $=$ | 14.744 | 12.421 | 9.756 | 107.765 | 205.861 |
| When $n_2 \geq n_{20}$, | $n_{2m} =$ | 1.741 | 1.806 | 1.782 | 1.782 | 1.753 |
| When $n_2 < n_{20}$, | $n_{2m} =$ | 1.596 | 1.623 | 1.583 | 1.640 | 1.603 |
| When $k_2 \geq k_{20}$, | $k_{2m} =$ | 0.453 | 0.379 | 0.315 | 0.185 | 0.311 |
| When $k_2 < k_{20}$, | $k_{2m} =$ | 0.345 | 0.249 | 0.187 | 0.106 | 0.163 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 107.965 | 122.284 | 164.682 | 240.729 | 150.727 |

1 . 2 < N A ≤ 1 . 3
1 0 5 < T ≤ 1 1 5

| Case | 11-06 | 11-07 |
|---|---|---|
| $n_{10}$ | 1.695 | 1.705 |
| $k_{10}$ | 0.060 | 0.054 |
| $d_{10}$ (nm) | 216.291 | 277.828 |
| $n_{20}$ | 1.691 | 1.688 |
| $k_{20}$ | 0.187 | 0.185 |
| $d_{20}$ (nm) | 231.949 | 228.622 |

| | | 11-06 | 11-07 |
|---|---|---|---|
| When $n_1 \geq n_{10}$, | $n_{1m} =$ | 1.736 | 1.751 |
| When $n_1 < n_{10}$, | $n_{1m} =$ | 1.664 | 1.660 |
| When $k_1 \geq k_{10}$, | $k_{1m} =$ | 0.099 | 0.091 |
| When $k_1 < k_{10}$, | $k_{1m} =$ | 0.026 | 0.021 |
| When $d_1 \geq d_{10}$, | $d_{1m}$ (nm) $=$ | ∞ | ∞ |
| When $d_1 < d_{10}$, | $d_{1m}$ (nm) $=$ | 188.964 | 182.620 |
| When $n_2 \geq n_{20}$, | $n_{2m} =$ | 1.938 | 1.860 |
| When $n_2 < n_{20}$, | $n_{2m} =$ | 1.577 | 1.505 |
| When $k_2 \geq k_{20}$, | $k_{2m} =$ | 0.293 | 0.298 |
| When $k_2 < k_{20}$, | $k_{2m} =$ | 0.122 | 0.117 |
| When $d_2 \geq d_{20}$, | $d_{2m}$ (nm) $=$ | ∞ | ∞ |
| When $d_2 < d_{20}$, | $d_{2m}$ (nm) $=$ | 190.206 | 157.223 |

1．2＜NA≦1．3
115＜T≦125

| Case | 12-01 | 12-02 | 12-03 | 12-04 | 12-05 |
|------|-------|-------|-------|-------|-------|
| $n_{10}$ | 1.919 | 1.909 | 1.897 | 1.692 | 1.694 |
| $k_{10}$ | 0.168 | 0.114 | 0.102 | 0.061 | 0.069 |
| $d_{10}$ (nm) | 15.470 | 14.219 | 12.252 | 153.490 | 218.807 |
| $n_{20}$ | 1.675 | 1.728 | 1.703 | 1.695 | 1.679 |
| $k_{20}$ | 0.416 | 0.323 | 0.257 | 0.154 | 0.236 |
| $d_{20}$ (nm) | 121.998 | 174.431 | 235.332 | 285.775 | 164.294 |

| | | 12-01 | 12-02 | 12-03 | 12-04 | 12-05 |
|---|---|-------|-------|-------|-------|-------|
| When $n_1 \geq n_{10}$, | $n_{1m} =$ | 1.974 | 1.983 | 1.989 | 1.719 | 1.720 |
| When $n_1 < n_{10}$, | $n_{1m} =$ | 1.903 | 1.876 | 1.851 | 1.657 | 1.674 |
| When $k_1 \geq k_{10}$, | $k_{1m} =$ | 0.194 | 0.163 | 0.171 | 0.093 | 0.104 |
| When $k_1 < k_{10}$, | $k_{1m} =$ | 0.095 | 0.028 | 0.000 | 0.043 | 0.048 |
| When $d_1 \geq d_{10}$, | $d_{1m}$ (nm) $=$ | 18.537 | 18.641 | 17.506 | 176.125 | 245.819 |
| When $d_1 < d_{10}$, | $d_{1m}$ (nm) $=$ | 14.577 | 12.379 | 9.747 | 108.056 | 210.037 |
| When $n_2 \geq n_{20}$, | $n_{2m} =$ | 1.708 | 1.790 | 1.776 | 1.773 | 1.745 |
| When $n_2 < n_{20}$, | $n_{2m} =$ | 1.572 | 1.608 | 1.579 | 1.640 | 1.616 |
| When $k_2 \geq k_{20}$, | $k_{2m} =$ | 0.448 | 0.378 | 0.316 | 0.184 | 0.323 |
| When $k_2 < k_{20}$, | $k_{2m} =$ | 0.357 | 0.255 | 0.190 | 0.115 | 0.176 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 99.374 | 118.240 | 154.295 | 239.447 | 146.164 |

1．2＜NA≦1．3
115＜T≦125

| Case | 12-06 | 12-07 | 12-08 |
|------|-------|-------|-------|
| $n_{10}$ | 1.695 | 1.696 | 1.706 |
| $k_{10}$ | 0.061 | 0.056 | 0.051 |
| $d_{10}$ (nm) | 216.166 | 214.076 | 276.333 |
| $n_{20}$ | 1.690 | 1.694 | 1.706 |
| $k_{20}$ | 0.192 | 0.163 | 0.162 |
| $d_{20}$ (nm) | 222.296 | 280.805 | 273.925 |

| | | 12-06 | 12-07 | 12-08 |
|---|---|-------|-------|-------|
| When $n_1 \geq n_{10}$, | $n_{1m} =$ | 1.728 | 1.750 | 1.770 |
| When $n_1 < n_{10}$, | $n_{1m} =$ | 1.664 | 1.664 | 1.647 |
| When $k_1 \geq k_{10}$, | $k_{1m} =$ | 0.099 | 0.099 | 0.090 |
| When $k_1 < k_{10}$, | $k_{1m} =$ | 0.029 | 0.023 | 0.020 |
| When $d_1 \geq d_{10}$, | $d_{1m}$ (nm) $=$ | $\infty$ | $\infty$ | $\infty$ |
| When $d_1 < d_{10}$, | $d_{1m}$ (nm) $=$ | 190.492 | 185.642 | 181.694 |
| When $n_2 \geq n_{20}$, | $n_{2m} =$ | 1.826 | 1.931 | 1.851 |
| When $n_2 < n_{20}$, | $n_{2m} =$ | 1.594 | 1.560 | 1.519 |
| When $k_2 \geq k_{20}$, | $k_{2m} =$ | 0.297 | 0.283 | 0.279 |
| When $k_2 < k_{20}$, | $k_{2m} =$ | 0.128 | 0.103 | 0.095 |
| When $d_2 \geq d_{20}$, | $d_{2m}$ (nm) $=$ | $\infty$ | $\infty$ | $\infty$ |
| When $d_2 < d_{20}$, | $d_{2m}$ (nm) $=$ | 188.671 | 203.385 | 188.718 |

1. 2 < N A ≤ 1. 3
1 2 5 < T ≤ 1 3 5

| Case | 13-01 | 13-02 | 13-03 | 13-04 | 13-05 |
|---|---|---|---|---|---|
| $n_{10}$ | 1.909 | 1.895 | 1.879 | 1.694 | 1.695 |
| $k_{10}$ | 0.116 | 0.106 | 0.083 | 0.071 | 0.063 |
| $d_{10}$ (nm) | 14.671 | 12.483 | 11.828 | 219.020 | 215.746 |
| $n_{20}$ | 1.733 | 1.700 | 1.710 | 1.682 | 1.690 |
| $k_{20}$ | 0.334 | 0.261 | 0.220 | 0.245 | 0.197 |
| $d_{20}$ (nm) | 163.102 | 225.249 | 280.433 | 153.670 | 212.983 |

| | | 13-01 | 13-02 | 13-03 | 13-04 | 13-05 |
|---|---|---|---|---|---|---|
| When $n_1 \geq n_{10}$, | $n_{1m} =$ | 1.981 | 1.985 | 1.982 | 1.717 | 1.723 |
| When $n_1 < n_{10}$, | $n_{1m} =$ | 1.878 | 1.850 | 1.819 | 1.677 | 1.665 |
| When $k_1 \geq k_{10}$, | $k_{1m} =$ | 0.162 | 0.173 | 0.169 | 0.103 | 0.099 |
| When $k_1 < k_{10}$, | $k_{1m} =$ | 0.035 | 0.004 | 0.000 | 0.051 | 0.034 |
| When $d_1 \geq d_{10}$, | $d_{1m}$ (nm) $=$ | 19.040 | 17.738 | 18.242 | 233.783 | ∞ |
| When $d_1 < d_{10}$, | $d_{1m}$ (nm) $=$ | 12.910 | 9.987 | 8.329 | 211.731 | 191.269 |
| When $n_2 \geq n_{20}$, | $n_{2m} =$ | 1.795 | 1.771 | 1.785 | 1.724 | 1.797 |
| When $n_2 < n_{20}$, | $n_{2m} =$ | 1.610 | 1.575 | 1.592 | 1.634 | 1.609 |
| When $k_2 \geq k_{20}$, | $k_{2m} =$ | 0.389 | 0.319 | 0.285 | 0.337 | 0.302 |
| When $k_2 < k_{20}$, | $k_{2m} =$ | 0.261 | 0.192 | 0.153 | 0.187 | 0.133 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 109.327 | 144.773 | 164.318 | 140.585 | 192.523 |

1. 2 < N A ≤ 1. 3
1 2 5 < T ≤ 1 3 5

| Case | 13-06 | 13-07 |
|---|---|---|
| $n_{10}$ | 1.696 | 1.706 |
| $k_{10}$ | 0.057 | 0.052 |
| $d_{10}$ (nm) | 213.723 | 276.363 |
| $n_{20}$ | 1.693 | 1.706 |
| $k_{20}$ | 0.165 | 0.164 |
| $d_{20}$ (nm) | 271.596 | 264.087 |

| | | 13-06 | 13-07 |
|---|---|---|---|
| When $n_1 \geq n_{10}$, | $n_{1m} =$ | 1.749 | 1.772 |
| When $n_1 < n_{10}$, | $n_{1m} =$ | 1.664 | 1.645 |
| When $k_1 \geq k_{10}$, | $k_{1m} =$ | 0.099 | 0.090 |
| When $k_1 < k_{10}$, | $k_{1m} =$ | 0.026 | 0.022 |
| When $d_1 \geq d_{10}$, | $d_{1m}$ (nm) $=$ | ∞ | ∞ |
| When $d_1 < d_{10}$, | $d_{1m}$ (nm) $=$ | 186.782 | 182.830 |
| When $n_2 \geq n_{20}$, | $n_{2m} =$ | 1.934 | 1.851 |
| When $n_2 < n_{20}$, | $n_{2m} =$ | 1.561 | 1.521 |
| When $k_2 \geq k_{20}$, | $k_{2m} =$ | 0.285 | 0.282 |
| When $k_2 < k_{20}$, | $k_{2m} =$ | 0.104 | 0.097 |
| When $d_2 \geq d_{20}$, | $d_{2m}$ (nm) $=$ | ∞ | ∞ |
| When $d_2 < d_{20}$, | $d_{2m}$ (nm) $=$ | 198.444 | 183.298 |

1. 2 < N A ≤ 1. 3
1 3 5 < T ≤ 1 4 5

| Case | 14-01 | 14-02 | 14-03 | 14-04 | 14-05 |
|---|---|---|---|---|---|
| $n_{10}$ | 1.910 | 1.892 | 1.879 | 1.694 | 1.694 |
| $k_{10}$ | 0.115 | 0.109 | 0.084 | 0.072 | 0.064 |
| $d_{10}$ (nm) | 15.725 | 12.960 | 12.187 | 218.706 | 215.091 |
| $n_{20}$ | 1.755 | 1.698 | 1.712 | 1.684 | 1.689 |
| $k_{20}$ | 0.355 | 0.268 | 0.226 | 0.254 | 0.201 |
| $d_{20}$ (nm) | 150.207 | 215.505 | 270.397 | 144.577 | 204.614 |

| | | 14-01 | 14-02 | 14-03 | 14-04 | 14-05 |
|---|---|---|---|---|---|---|
| When $n_1 \geq n_{10}$, | $n_{1m} =$ | 1.980 | 1.980 | 1.979 | 1.708 | 1.720 |
| When $n_1 < n_{10}$, | $n_{1m} =$ | 1.881 | 1.848 | 1.820 | 1.676 | 1.666 |
| When $k_1 \geq k_{10}$, | $k_{1m} =$ | 0.157 | 0.174 | 0.167 | 0.100 | 0.099 |
| When $k_1 < k_{10}$, | $k_{1m} =$ | 0.036 | 0.011 | 0.000 | 0.054 | 0.038 |
| When $d_1 \geq d_{10}$, | $d_{1m}$ (nm) $=$ | 20.158 | 18.254 | 18.627 | 231.071 | ∞ |
| When $d_1 < d_{10}$, | $d_{1m}$ (nm) $=$ | 14.003 | 10.450 | 8.694 | 211.497 | 191.698 |
| When $n_2 \geq n_{20}$, | $n_{2m} =$ | 1.818 | 1.767 | 1.787 | 1.721 | 1.802 |
| When $n_2 < n_{20}$, | $n_{2m} =$ | 1.632 | 1.571 | 1.592 | 1.649 | 1.619 |
| When $k_2 \geq k_{20}$, | $k_{2m} =$ | 0.415 | 0.327 | 0.291 | 0.345 | 0.308 |
| When $k_2 < k_{20}$, | $k_{2m} =$ | 0.275 | 0.197 | 0.157 | 0.200 | 0.145 |
| When $d_2 \geq d_{20}$, | $d_{2m}$ (nm) $=$ | ∞ | ∞ | ∞ | 160.527 | ∞ |
| When $d_2 < d_{20}$, | $d_{2m}$ (nm) $=$ | 119.641 | 139.482 | 181.534 | 134.106 | 186.758 |

1. 2 < N A ≤ 1. 3
1 3 5 < T ≤ 1 4 5

| Case | 14-06 | 14-07 |
|---|---|---|
| $n_{10}$ | 1.696 | 1.706 |
| $k_{10}$ | 0.058 | 0.052 |
| $d_{10}$ (nm) | 213.482 | 276.472 |
| $n_{20}$ | 1.692 | 1.707 |
| $k_{20}$ | 0.169 | 0.168 |
| $d_{20}$ (nm) | 262.678 | 254.823 |

| | | 14-06 | 14-07 |
|---|---|---|---|
| When $n_1 \geq n_{10}$, | $n_{1m} =$ | 1.748 | 1.771 |
| When $n_1 < n_{10}$, | $n_{1m} =$ | 1.665 | 1.644 |
| When $k_1 \geq k_{10}$, | $k_{1m} =$ | 0.100 | 0.090 |
| When $k_1 < k_{10}$, | $k_{1m} =$ | 0.028 | 0.024 |
| When $d_1 \geq d_{10}$, | $d_{1m}$ (nm) $=$ | ∞ | ∞ |
| When $d_1 < d_{10}$, | $d_{1m}$ (nm) $=$ | 188.144 | 184.314 |
| When $n_2 \geq n_{20}$, | $n_{2m} =$ | 1.933 | 1.854 |
| When $n_2 < n_{20}$, | $n_{2m} =$ | 1.561 | 1.522 |
| When $k_2 \geq k_{20}$, | $k_{2m} =$ | 0.288 | 0.286 |
| When $k_2 < k_{20}$, | $k_{2m} =$ | 0.109 | 0.100 |
| When $d_2 \geq d_{20}$, | $d_{2m}$ (nm) $=$ | ∞ | ∞ |
| When $d_2 < d_{20}$, | $d_{2m}$ (nm) $=$ | 191.540 | 174.816 |

1. 2 < N A ≤ 1. 3
1 4 5 < T ≤ 1 5 5

| Case | 15-01 | 15-02 | 15-03 | 15-04 | 15-05 |
|---|---|---|---|---|---|
| $n_{10}$ | 1.919 | 1.893 | 1.882 | 1.694 | 1.694 |
| $k_{10}$ | 0.115 | 0.113 | 0.085 | 0.074 | 0.065 |
| $d_{10}$ (nm) | 16.638 | 13.413 | 12.438 | 217.741 | 214.737 |
| $n_{20}$ | 1.785 | 1.697 | 1.715 | 1.683 | 1.687 |
| $k_{20}$ | 0.385 | 0.281 | 0.235 | 0.264 | 0.207 |
| $d_{20}$ (nm) | 138.580 | 206.656 | 261.237 | 137.032 | 196.488 |

| | | 15-01 | 15-02 | 15-03 | 15-04 | 15-05 |
|---|---|---|---|---|---|---|
| When $n_1 \geq n_{10}$, | $n_{1m} =$ | 1.986 | 1.976 | 1.980 | 1.705 | 1.718 |
| When $n_1 < n_{10}$, | $n_{1m} =$ | 1.892 | 1.851 | 1.826 | 1.676 | 1.666 |
| When $k_1 \geq k_{10}$, | $k_{1m} =$ | 0.151 | 0.174 | 0.165 | 0.099 | 0.100 |
| When $k_1 < k_{10}$, | $k_{1m} =$ | 0.037 | 0.018 | 0.000 | 0.060 | 0.040 |
| When $d_1 \geq d_{10}$, | $d_{1m}$ (nm) $=$ | 20.946 | 18.588 | 18.692 | 227.547 | ∞ |
| When $d_1 < d_{10}$, | $d_{1m}$ (nm) $=$ | 15.073 | 10.996 | 9.087 | 210.480 | 192.120 |
| When $n_2 \geq n_{20}$, | $n_{2m} =$ | 1.846 | 1.763 | 1.789 | 1.722 | 1.834 |
| When $n_2 < n_{20}$, | $n_{2m} =$ | 1.665 | 1.571 | 1.591 | 1.652 | 1.629 |
| When $k_2 \geq k_{20}$, | $k_{2m} =$ | 0.451 | 0.339 | 0.301 | 0.337 | 0.312 |
| When $k_2 < k_{20}$, | $k_{2m} =$ | 0.301 | 0.209 | 0.166 | 0.217 | 0.151 |
| When $d_2 \geq d_{20}$, | $d_{2m}$ (nm) $=$ | ∞ | ∞ | ∞ | 149.574 | ∞ |
| When $d_2 < d_{20}$, | $d_{2m}$ (nm) $=$ | 113.921 | 135.398 | 177.745 | 128.876 | 178.069 |

1. 2 < N A ≤ 1. 3
1 4 5 < T ≤ 1 5 5

| Case | 15-06 | 15-07 |
|---|---|---|
| $n_{10}$ | 1.695 | 1.707 |
| $k_{10}$ | 0.059 | 0.053 |
| $d_{10}$ (nm) | 213.710 | 276.548 |
| $n_{20}$ | 1.692 | 1.707 |
| $k_{20}$ | 0.173 | 0.174 |
| $d_{20}$ (nm) | 253.675 | 246.168 |

| | | 15-06 | 15-07 |
|---|---|---|---|
| When $n_1 \geq n_{10}$, | $n_{1m} =$ | 1.747 | 1.770 |
| When $n_1 < n_{10}$, | $n_{1m} =$ | 1.665 | 1.645 |
| When $k_1 \geq k_{10}$, | $k_{1m} =$ | 0.100 | 0.089 |
| When $k_1 < k_{10}$, | $k_{1m} =$ | 0.029 | 0.025 |
| When $d_1 \geq d_{10}$, | $d_{1m}$ (nm) $=$ | ∞ | ∞ |
| When $d_1 < d_{10}$, | $d_{1m}$ (nm) $=$ | 189.864 | 185.926 |
| When $n_2 \geq n_{20}$, | $n_{2m} =$ | 1.910 | 1.858 |
| When $n_2 < n_{20}$, | $n_{2m} =$ | 1.562 | 1.520 |
| When $k_2 \geq k_{20}$, | $k_{2m} =$ | 0.289 | 0.291 |
| When $k_2 < k_{20}$, | $k_{2m} =$ | 0.109 | 0.103 |
| When $d_2 \geq d_{20}$, | $d_{2m}$ (nm) $=$ | ∞ | ∞ |
| When $d_2 < d_{20}$, | $d_{2m}$ (nm) $=$ | 189.584 | 169.414 |

1. 2 < N A ≦ 1. 3
155 < T ≦ 165

| Case | 16-01 | 16-02 | 16-03 | 16-04 | 16-05 |
|---|---|---|---|---|---|
| $n_{10}$ | 1.937 | 1.898 | 1.890 | 1.694 | 1.694 |
| $k_{10}$ | 0.118 | 0.119 | 0.087 | 0.077 | 0.067 |
| $d_{10}$ (nm) | 16.771 | 13.576 | 12.460 | 216.630 | 214.866 |
| $n_{20}$ | 1.806 | 1.695 | 1.718 | 1.679 | 1.684 |
| $k_{20}$ | 0.418 | 0.295 | 0.246 | 0.277 | 0.215 |
| $d_{20}$ (nm) | 129.251 | 198.434 | 252.589 | 129.875 | 188.027 |

| | | 16-01 | 16-02 | 16-03 | 16-04 | 16-05 |
|---|---|---|---|---|---|---|
| When $n_1 \geq n_{10}$, | $n_{1m} =$ | 2.001 | 1.978 | 1.985 | 1.707 | 1.716 |
| When $n_1 < n_{10}$, | $n_{1m} =$ | 1.914 | 1.859 | 1.836 | 1.685 | 1.666 |
| When $k_1 \geq k_{10}$, | $k_{1m} =$ | 0.148 | 0.176 | 0.164 | 0.101 | 0.100 |
| When $k_1 < k_{10}$, | $k_{1m} =$ | 0.045 | 0.025 | 0.000 | 0.067 | 0.040 |
| When $d_1 \geq d_{10}$, | $d_{1m}$ (nm) $=$ | 20.691 | 18.424 | 18.356 | 225.238 | 231.093 |
| When $d_1 < d_{10}$, | $d_{1m}$ (nm) $=$ | 15.556 | 11.376 | 9.363 | 212.673 | 192.697 |
| When $n_2 \geq n_{20}$, | $n_{2m} =$ | 1.861 | 1.756 | 1.791 | 1.715 | 1.840 |
| When $n_2 < n_{20}$, | $n_{2m} =$ | 1.690 | 1.574 | 1.591 | 1.643 | 1.628 |
| When $k_2 \geq k_{20}$, | $k_{2m} =$ | 0.481 | 0.351 | 0.310 | 0.328 | 0.314 |
| When $k_2 < k_{20}$, | $k_{2m} =$ | 0.336 | 0.225 | 0.176 | 0.223 | 0.151 |
| When $d_2 \geq d_{20}$, | $d_{2m}$ (nm) $=$ | ∞ | ∞ | ∞ | 139.199 | ∞ |
| When $d_2 < d_{20}$, | $d_{2m}$ (nm) $=$ | 109.768 | 131.712 | 172.718 | 120.241 | 167.595 |

1. 2 < N A ≦ 1. 3
155 < T ≦ 165

| Case | 16-06 | 16-07 |
|---|---|---|
| $n_{10}$ | 1.695 | 1.707 |
| $k_{10}$ | 0.060 | 0.054 |
| $d_{10}$ (nm) | 214.034 | 276.376 |
| $n_{20}$ | 1.692 | 1.707 |
| $k_{20}$ | 0.179 | 0.181 |
| $d_{20}$ (nm) | 244.657 | 237.806 |

| | | 16-06 | 16-07 |
|---|---|---|---|
| When $n_1 \geq n_{10}$, | $n_{1m} =$ | 1.745 | 1.770 |
| When $n_1 < n_{10}$, | $n_{1m} =$ | 1.666 | 1.653 |
| When $k_1 \geq k_{10}$, | $k_{1m} =$ | 0.101 | 0.089 |
| When $k_1 < k_{10}$, | $k_{1m} =$ | 0.030 | 0.027 |
| When $d_1 \geq d_{10}$, | $d_{1m}$ (nm) $=$ | ∞ | ∞ |
| When $d_1 < d_{10}$, | $d_{1m}$ (nm) $=$ | 191.630 | 187.468 |
| When $n_2 \geq n_{20}$, | $n_{2m} =$ | 1.889 | 1.864 |
| When $n_2 < n_{20}$, | $n_{2m} =$ | 1.562 | 1.515 |
| When $k_2 \geq k_{20}$, | $k_{2m} =$ | 0.290 | 0.295 |
| When $k_2 < k_{20}$, | $k_{2m} =$ | 0.115 | 0.110 |
| When $d_2 \geq d_{20}$, | $d_{2m}$ (nm) $=$ | ∞ | ∞ |
| When $d_2 < d_{20}$, | $d_{2m}$ (nm) $=$ | 179.119 | 164.223 |

570

1．2＜NA≦1．3
165＜T≦175

| Case | 17-01 | 17-02 | 17-03 | 17-04 | 17-05 |
|---|---|---|---|---|---|
| $n_{10}$ | 1.958 | 1.903 | 1.898 | 1.694 | 1.694 |
| $k_{10}$ | 0.128 | 0.127 | 0.090 | 0.080 | 0.068 |
| $d_{10}$ (nm) | 15.815 | 13.420 | 12.296 | 215.821 | 215.165 |
| $n_{20}$ | 1.794 | 1.688 | 1.719 | 1.668 | 1.681 |
| $k_{20}$ | 0.439 | 0.307 | 0.254 | 0.290 | 0.224 |
| $d_{20}$ (nm) | 123.830 | 190.984 | 244.231 | 122.663 | 179.093 |

| | | 17-01 | 17-02 | 17-03 | 17-04 | 17-05 |
|---|---|---|---|---|---|---|
| When $n_1 \geq n_{10}$, | $n_{1m} =$ | 2.020 | 1.981 | 1.991 | 1.707 | 1.716 |
| When $n_1 < n_{10}$, | $n_{1m} =$ | 1.942 | 1.867 | 1.846 | 1.692 | 1.665 |
| When $k_1 \geq k_{10}$, | $k_{1m} =$ | 0.150 | 0.182 | 0.165 | 0.103 | 0.101 |
| When $k_1 < k_{10}$, | $k_{1m} =$ | 0.058 | 0.033 | 0.000 | 0.077 | 0.041 |
| When $d_1 \geq d_{10}$, | $d_{1m}$ (nm) $=$ | 19.257 | 17.848 | 17.802 | 223.701 | 230.268 |
| When $d_1 < d_{10}$, | $d_{1m}$ (nm) $=$ | 15.087 | 11.461 | 9.465 | 215.120 | 195.890 |
| When $n_2 \geq n_{20}$, | $n_{2m} =$ | 1.832 | 1.743 | 1.790 | 1.677 | 1.826 |
| When $n_2 < n_{20}$, | $n_{2m} =$ | 1.680 | 1.570 | 1.590 | 1.625 | 1.625 |
| When $k_2 \geq k_{20}$, | $k_{2m} =$ | 0.483 | 0.357 | 0.316 | 0.321 | 0.315 |
| When $k_2 < k_{20}$, | $k_{2m} =$ | 0.365 | 0.239 | 0.186 | 0.252 | 0.151 |
| When $d_2 \geq d_{20}$, | $d_{2m}$ (nm) $=$ | ∞ | ∞ | ∞ | 127.631 | ∞ |
| When $d_2 < d_{20}$, | $d_{2m}$ (nm) $=$ | 111.992 | 128.672 | 166.465 | 109.461 | 158.121 |

1．2＜NA≦1．3
165＜T≦175

| Case | 17-06 | 17-07 |
|---|---|---|
| $n_{10}$ | 1.696 | 1.707 |
| $k_{10}$ | 0.061 | 0.056 |
| $d_{10}$ (nm) | 214.210 | 275.996 |
| $n_{20}$ | 1.692 | 1.705 |
| $k_{20}$ | 0.185 | 0.187 |
| $d_{20}$ (nm) | 235.479 | 229.352 |

| | | 17-06 | 17-07 |
|---|---|---|---|
| When $n_1 \geq n_{10}$, | $n_{1m} =$ | 1.744 | 1.770 |
| When $n_1 < n_{10}$, | $n_{1m} =$ | 1.667 | 1.657 |
| When $k_1 \geq k_{10}$, | $k_{1m} =$ | 0.101 | 0.088 |
| When $k_1 < k_{10}$, | $k_{1m} =$ | 0.031 | 0.030 |
| When $d_1 \geq d_{10}$, | $d_{1m}$ (nm) $=$ | ∞ | ∞ |
| When $d_1 < d_{10}$, | $d_{1m}$ (nm) $=$ | 193.216 | 188.863 |
| When $n_2 \geq n_{20}$, | $n_{2m} =$ | 1.887 | 1.872 |
| When $n_2 < n_{20}$, | $n_{2m} =$ | 1.561 | 1.509 |
| When $k_2 \geq k_{20}$, | $k_{2m} =$ | 0.292 | 0.295 |
| When $k_2 < k_{20}$, | $k_{2m} =$ | 0.120 | 0.115 |
| When $d_2 \geq d_{20}$, | $d_{2m}$ (nm) $=$ | ∞ | ∞ |
| When $d_2 < d_{20}$, | $d_{2m}$ (nm) $=$ | 161.210 | 156.975 |

1．2＜ＮＡ≦1．3
175＜Ｔ≦185

| Case | 18-01 | 18-02 | 18-03 | 18-04 | 18-05 |
|---|---|---|---|---|---|
| $n_{10}$ | 1.907 | 1.904 | 1.694 | 1.696 | 1.704 |
| $k_{10}$ | 0.135 | 0.092 | 0.070 | 0.062 | 0.051 |
| $d_{10}$ (nm) | 13.188 | 12.121 | 215.718 | 214.371 | 274.345 |
| $n_{20}$ | 1.679 | 1.720 | 1.679 | 1.692 | 1.687 |
| $k_{20}$ | 0.313 | 0.260 | 0.233 | 0.190 | 0.159 |
| $d_{20}$ (nm) | 183.151 | 235.214 | 169.072 | 225.802 | 280.556 |

| | | 18-01 | 18-02 | 18-03 | 18-04 | 18-05 |
|---|---|---|---|---|---|---|
| When $n_1 \geq n_{10}$, | $n_{1m} =$ | 1.982 | 1.997 | 1.715 | 1.743 | 1.760 |
| When $n_1 < n_{10}$, | $n_{1m} =$ | 1.873 | 1.854 | 1.666 | 1.668 | 1.658 |
| When $k_1 \geq k_{10}$, | $k_{1m} =$ | 0.188 | 0.166 | 0.102 | 0.102 | 0.090 |
| When $k_1 < k_{10}$, | $k_{1m} =$ | 0.044 | 0.000 | 0.044 | 0.032 | 0.018 |
| When $d_1 \geq d_{10}$, | $d_{1m}$ (nm) $=$ | 17.244 | 17.308 | 229.740 | ∞ | ∞ |
| When $d_1 < d_{10}$, | $d_{1m}$ (nm) $=$ | 11.395 | 9.486 | 201.461 | 194.630 | 174.558 |
| When $n_2 \geq n_{20}$, | $n_{2m} =$ | 1.730 | 1.790 | 1.771 | 1.836 | 1.900 |
| When $n_2 < n_{20}$, | $n_{2m} =$ | 1.562 | 1.589 | 1.630 | 1.559 | 1.518 |
| When $k_2 \geq k_{20}$, | $k_{2m} =$ | 0.359 | 0.319 | 0.318 | 0.293 | 0.259 |
| When $k_2 < k_{20}$, | $k_{2m} =$ | 0.249 | 0.193 | 0.159 | 0.124 | 0.097 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 128.127 | 156.903 | 151.088 | 157.464 | 192.992 |

1. 2 < N A ≤ 1. 3
185 < T ≤ 195

| Case | 19-01 | 19-02 | 19-03 | 19-04 | 19-05 |
|---|---|---|---|---|---|
| $n_{10}$ | 1.908 | 1.906 | 1.889 | 1.693 | 1.696 |
| $k_{10}$ | 0.140 | 0.092 | 0.087 | 0.071 | 0.064 |
| $d_{10}$ (nm) | 13.288 | 12.370 | 11.418 | 216.427 | 214.510 |
| $n_{20}$ | 1.676 | 1.726 | 1.707 | 1.681 | 1.692 |
| $k_{20}$ | 0.321 | 0.266 | 0.223 | 0.243 | 0.195 |
| $d_{20}$ (nm) | 172.696 | 223.910 | 283.898 | 158.126 | 215.938 |

| | | 19-01 | 19-02 | 19-03 | 19-04 | 19-05 |
|---|---|---|---|---|---|---|
| When $n_1 \geq n_{10}$, | $n_{1m} =$ | 1.981 | 1.996 | 1.994 | 1.713 | 1.742 |
| When $n_1 < n_{10}$, | $n_{1m} =$ | 1.875 | 1.857 | 1.834 | 1.670 | 1.669 |
| When $k_1 \geq k_{10}$, | $k_{1m} =$ | 0.190 | 0.163 | 0.168 | 0.103 | 0.102 |
| When $k_1 < k_{10}$, | $k_{1m} =$ | 0.055 | 0.000 | 0.000 | 0.051 | 0.037 |
| When $d_1 \geq d_{10}$, | $d_{1m}$ (nm) $=$ | 17.148 | 17.446 | 17.407 | 228.093 | ∞ |
| When $d_1 < d_{10}$, | $d_{1m}$ (nm) $=$ | 11.532 | 9.791 | 8.458 | 205.012 | 195.805 |
| When $n_2 \geq n_{20}$, | $n_{2m} =$ | 1.725 | 1.797 | 1.791 | 1.767 | 1.825 |
| When $n_2 < n_{20}$, | $n_{2m} =$ | 1.558 | 1.592 | 1.590 | 1.647 | 1.558 |
| When $k_2 \geq k_{20}$, | $k_{2m} =$ | 0.365 | 0.327 | 0.286 | 0.323 | 0.294 |
| When $k_2 < k_{20}$, | $k_{2m} =$ | 0.256 | 0.198 | 0.157 | 0.178 | 0.130 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 125.060 | 143.864 | 171.207 | 144.997 | 180.034 |

1. 2 < N A ≤ 1. 3
185 < T ≤ 195

| Case | 19-06 | 19-07 |
|---|---|---|
| $n_{10}$ | 1.696 | 1.704 |
| $k_{10}$ | 0.057 | 0.052 |
| $d_{10}$ (nm) | 213.492 | 274.677 |
| $n_{20}$ | 1.691 | 1.687 |
| $k_{20}$ | 0.166 | 0.162 |
| $d_{20}$ (nm) | 273.809 | 270.432 |

| | | 19-06 | 19-07 |
|---|---|---|---|
| When $n_1 \geq n_{10}$, | $n_{1m} =$ | 1.742 | 1.760 |
| When $n_1 < n_{10}$, | $n_{1m} =$ | 1.666 | 1.659 |
| When $k_1 \geq k_{10}$, | $k_{1m} =$ | 0.097 | 0.090 |
| When $k_1 < k_{10}$, | $k_{1m} =$ | 0.026 | 0.022 |
| When $d_1 \geq d_{10}$, | $d_{1m}$ (nm) $=$ | ∞ | ∞ |
| When $d_1 < d_{10}$, | $d_{1m}$ (nm) $=$ | 178.602 | 175.003 |
| When $n_2 \geq n_{20}$, | $n_{2m} =$ | 1.857 | 1.904 |
| When $n_2 < n_{20}$, | $n_{2m} =$ | 1.570 | 1.518 |
| When $k_2 \geq k_{20}$, | $k_{2m} =$ | 0.281 | 0.262 |
| When $k_2 < k_{20}$, | $k_{2m} =$ | 0.104 | 0.096 |
| When $d_2 \geq d_{20}$, | $d_{2m}$ (nm) $=$ | ∞ | ∞ |
| When $d_2 < d_{20}$, | $d_{2m}$ (nm) $=$ | 199.693 | 186.949 |

1. 2 < N A ≤ 1. 3
195 < T ≤ 205

| Case | 20-01 | 20-02 | 20-03 | 20-04 | 20-05 |
|---|---|---|---|---|---|
| $n_{10}$ | 1.907 | 1.904 | 1.887 | 1.693 | 1.696 |
| $k_{10}$ | 0.139 | 0.091 | 0.088 | 0.073 | 0.065 |
| $d_{10}$ (nm) | 13.915 | 13.010 | 11.752 | 216.656 | 214.259 |
| $n_{20}$ | 1.684 | 1.734 | 1.707 | 1.683 | 1.692 |
| $k_{20}$ | 0.334 | 0.275 | 0.227 | 0.253 | 0.201 |
| $d_{20}$ (nm) | 160.500 | 212.141 | 273.737 | 148.279 | 206.980 |

| | | 20-01 | 20-02 | 20-03 | 20-04 | 20-05 |
|---|---|---|---|---|---|---|
| When $n_1 \geq n_{10}$, | $n_{1m} =$ | 1.978 | 1.992 | 1.990 | 1.700 | 1.743 |
| When $n_1 < n_{10}$, | $n_{1m} =$ | 1.874 | 1.857 | 1.833 | 1.671 | 1.670 |
| When $k_1 \geq k_{10}$, | $k_{1m} =$ | 0.186 | 0.158 | 0.167 | 0.098 | 0.102 |
| When $k_1 < k_{10}$, | $k_{1m} =$ | 0.059 | 0.000 | 0.000 | 0.062 | 0.044 |
| When $d_1 \geq d_{10}$, | $d_{1m}$ (nm) = | 17.817 | 18.151 | 17.811 | 226.068 | 265.367 |
| When $d_1 < d_{10}$, | $d_{1m}$ (nm) = | 12.124 | 10.391 | 8.783 | 207.088 | 196.420 |
| When $n_2 \geq n_{20}$, | $n_{2m} =$ | 1.731 | 1.806 | 1.791 | 1.746 | 1.815 |
| When $n_2 < n_{20}$, | $n_{2m} =$ | 1.564 | 1.602 | 1.588 | 1.669 | 1.556 |
| When $k_2 \geq k_{20}$, | $k_{2m} =$ | 0.381 | 0.338 | 0.291 | 0.321 | 0.294 |
| When $k_2 < k_{20}$, | $k_{2m} =$ | 0.265 | 0.202 | 0.159 | 0.212 | 0.142 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 125.465 | 136.447 | 180.411 | 144.423 | 187.001 |

1. 2 < N A ≤ 1. 3
195 < T ≤ 205

| Case | 20-06 | 20-07 |
|---|---|---|
| $n_{10}$ | 1.696 | 1.704 |
| $k_{10}$ | 0.058 | 0.053 |
| $d_{10}$ (nm) | 213.637 | 275.120 |
| $n_{20}$ | 1.690 | 1.687 |
| $k_{20}$ | 0.169 | 0.165 |
| $d_{20}$ (nm) | 264.528 | 260.887 |

| | | 20-06 | 20-07 |
|---|---|---|---|
| When $n_1 \geq n_{10}$, | $n_{1m} =$ | 1.742 | 1.760 |
| When $n_1 < n_{10}$, | $n_{1m} =$ | 1.666 | 1.661 |
| When $k_1 \geq k_{10}$, | $k_{1m} =$ | 0.097 | 0.090 |
| When $k_1 < k_{10}$, | $k_{1m} =$ | 0.030 | 0.025 |
| When $d_1 \geq d_{10}$, | $d_{1m}$ (nm) = | ∞ | ∞ |
| When $d_1 < d_{10}$, | $d_{1m}$ (nm) = | 183.526 | 175.348 |
| When $n_2 \geq n_{20}$, | $n_{2m} =$ | 1.856 | 1.912 |
| When $n_2 < n_{20}$, | $n_{2m} =$ | 1.571 | 1.519 |
| When $k_2 \geq k_{20}$, | $k_{2m} =$ | 0.282 | 0.268 |
| When $k_2 < k_{20}$, | $k_{2m} =$ | 0.108 | 0.102 |
| When $d_2 \geq d_{20}$, | $d_{2m}$ (nm) = | ∞ | ∞ |
| When $d_2 < d_{20}$, | $d_{2m}$ (nm) = | 202.896 | 181.779 |

**12.** An exposure method used in a process for manufacturing a semiconductor device, the method comprising the steps of:

providing an antireflective film having a two-layer structure between a resist layer and a silicon oxide layer formed on a surface of a silicon semiconductor substrate and having a thickness T (unit: nm) described below; and exposing the resist layer in an exposure system having a wavelength of 190 nm to 195 nm and a numerical aperture NA of $1.3 < NA \leq 1.4$, the antireflective film including an upper layer having a complex refractive index $N_1$, and a lower layer having a complex refractive index $N_2$, the complex refractive indexes $N_1$ and $N_2$ being represented by the equations $N_1 = n_1 - k_1 i$ and $N_2 = n_2 - k_2 i$, respectively;

wherein assuming that the thickness of the upper layer is $d_1$ (unit: nm) and the thickness of the lower layer is $d_2$ (unit: nm), when any one of the combinations of values of $[n_{10}, k_{10}, d_{10}, n_{20}, k_{20}, d_{20}]$ described below is selected depending on the thickness T of the silicon oxide film, $n_1$, $k_1$, $d_1$, $n_2$, $k_2$, and $d_2$ satisfy the relational expression

$$\{(n_1 - n_{10})/(n_{1m} - n_{10})\}^2 + \{(k_1 - k_{10})/(k_{1m} - k_{10})\}^2 + \{(d_1 - d_{10})/(d_{1m} - d_{10})\}^2 + \{(n_2 - n_{20})/(n_{2m} - n_{20})\}^2 + \{(k_2 - k_{20})/(k_{2m} - k_{20})\}^2 + \{(d_2 - d_{20})/(d_{2m} - d_{20})\}^2 \leq 1;$$

a value of $n_{1m}$ in a corresponding case is selected on the basis of a magnitude relation between $n_1$ and $n_{10}$; a value of $k_{1m}$ in a corresponding case is selected on the basis of a magnitude relation between $k_1$ and $k_{10}$; a value of $d_{1m}$ in a corresponding case is selected on the basis of a magnitude relation between $d_1$ and $d_{10}$; a value of $n_{2m}$ in a corresponding case is selected on the basis of a magnitude relation between $n_2$ and $n_{20}$; a value of $k_{2m}$ in a corresponding case is selected on the basis of a magnitude relation between $k_2$ and $k_{20}$; and a value of $d_{2m}$ in a corresponding case is selected on the basis of a magnitude relation between $d_2$ and $d_{20}$; and in the tables below, in the line of "When $n_1 \geq n_{10}$, $n_{1m} =$", each value in the right columns is "$n_{1m} - n_{10}$"; in the line of "When $n_1 < n_{10}$, $n_{1m} =$", each value in the right columns is "$n_{10} - n_{1m}$"; in the line of "When $k_1 \geq k_{10}$, $k_{1m} =$", each value in the right columns is "$k_{1m} - k_{10}$"; in the line of "When $k_1 < k_{10}$, $k_{1m} =$", each value in the right columns is "$k_{10} - k_{1m}$"; in the line of "When $d_1 \geq d_{10}$, $d_{1m}$ (nm) =", each value (unit: nm) in the right columns is "$d_{1m} - d_{10}$"; in the line of "When $d_1 < d_{10}$, $d_{1m}$ (nm) =", each value (unit: nm) in the right columns is "$d_{10} - d_{1m}$"; in the line of "When $n_2 \geq n_{20}$, $n_{2m} =$", each value in the right columns is "$n_{2m} - n_{20}$"; in the line of "When $n_2 < n_{20}$, $n_{2m} =$", each value in the right columns is "$n_{20} - n_{2m}$"; in the line of "When $k_2 \geq k_{20}$, $k_{2m} =$", each value in the right columns is "$k_{2m} - k_{20}$"; in the line of "When $k_2 < k_{20}$, $k_{2m} =$", each value in the right columns is "$k_{20} - k_{2m}$"; in the line of "When $d_2 \geq d_{20}$, $d_{2m}$ (nm) =", each value (unit: nm) in the right columns is "$d_{2m} - d_{20}$"; and in the line of "When $d_2 < d_{20}$, $d_{2m}$ (nm) =", each value (unit: nm) in the right columns is "$d_{20} - d_{2m}$".

1．3＜ＮＡ≦1．4

2 ≤ T ≤ 1 5

| Case | 1-01 | 1-02 | 1-03 | 1-04 | 1-05 |
|---|---|---|---|---|---|
| $n_{10}$ | 2.047 | 1.887 | 1.871 | 1.868 | 1.862 |
| $k_{10}$ | 0.012 | 0.120 | 0.106 | 0.075 | 0.065 |
| $d_{10}$ (nm) | 29.751 | 26.980 | 17.106 | 15.339 | 13.830 |
| $n_{20}$ | 6.274 | 1.973 | 1.713 | 1.738 | 1.730 |
| $k_{20}$ | 3.305 | 0.477 | 0.298 | 0.245 | 0.208 |
| $d_{20}$ (nm) | 1.566 | 76.285 | 158.161 | 212.612 | 271.884 |

| | | 1-01 | 1-02 | 1-03 | 1-04 | 1-05 |
|---|---|---|---|---|---|---|
| When $n_1 \geq n_{10}$, | $n_{1m} =$ | 2.109 | 1.929 | 1.924 | 1.935 | 1.940 |
| When $n_1 < n_{10}$, | $n_{1m} =$ | 1.990 | 1.877 | 1.852 | 1.835 | 1.823 |
| When $k_1 \geq k_{10}$, | $k_{1m} =$ | 0.055 | 0.138 | 0.136 | 0.123 | 0.124 |
| When $k_1 < k_{10}$, | $k_{1m} =$ | 0.000 | 0.089 | 0.036 | 0.000 | 0.000 |
| When $d_1 \geq d_{10}$, | $d_{1m}$ (nm) $=$ | 32.767 | 31.708 | 21.551 | 20.868 | 20.183 |
| When $d_1 < d_{10}$, | $d_{1m}$ (nm) $=$ | 27.509 | 26.309 | 15.640 | 12.771 | 10.913 |
| When $n_2 \geq n_{20}$, | $n_{2m} =$ | 6.594 | 2.028 | 1.750 | 1.789 | 1.793 |
| When $n_2 < n_{20}$, | $n_{2m} =$ | 5.978 | 1.933 | 1.627 | 1.639 | 1.618 |
| When $k_2 \geq k_{20}$, | $k_{2m} =$ | 3.556 | 0.507 | 0.335 | 0.292 | 0.258 |
| When $k_2 < k_{20}$, | $k_{2m} =$ | 3.013 | 0.403 | 0.242 | 0.188 | 0.152 |
| When $d_2 \geq d_{20}$, | $d_{2m}$ (nm) $=$ | 1.715 | 83.056 | ∞ | ∞ | ∞ |
| When $d_2 < d_{20}$, | $d_{2m}$ (nm) $=$ | 1.418 | 75.266 | 136.202 | 175.723 | 191.206 |

1．3＜ＮＡ≦1．4

2 ≤ T ≤ 1 5

| Case | 1-06 | 1-07 | 1-08 | 1-09 | 1-10 |
|---|---|---|---|---|---|
| $n_{10}$ | 1.691 | 1.692 | 1.711 | 1.704 | 1.705 |
| $k_{10}$ | 0.062 | 0.057 | 0.070 | 0.057 | 0.050 |
| $d_{10}$ (nm) | 161.852 | 157.460 | 239.891 | 226.155 | 221.451 |
| $n_{20}$ | 1.688 | 1.697 | 7.420 | 1.689 | 1.695 |
| $k_{20}$ | 0.179 | 0.154 | 3.291 | 0.187 | 0.158 |
| $d_{20}$ (nm) | 207.262 | 266.043 | 0.810 | 202.908 | 261.182 |

| | | 1-06 | 1-07 | 1-08 | 1-09 | 1-10 |
|---|---|---|---|---|---|---|
| When $n_1 \geq n_{10}$, | $n_{1m} =$ | 1.703 | 1.707 | 1.725 | 1.738 | 1.736 |
| When $n_1 < n_{10}$, | $n_{1m} =$ | 1.685 | 1.664 | 1.704 | 1.690 | 1.688 |
| When $k_1 \geq k_{10}$, | $k_{1m} =$ | 0.080 | 0.084 | 0.082 | 0.082 | 0.079 |
| When $k_1 < k_{10}$, | $k_{1m} =$ | 0.051 | 0.029 | 0.049 | 0.029 | 0.022 |
| When $d_1 \geq d_{10}$, | $d_{1m}$ (nm) $=$ | 169.125 | 171.143 | 250.745 | ∞ | ∞ |
| When $d_1 < d_{10}$, | $d_{1m}$ (nm) $=$ | 157.974 | 129.944 | 235.697 | 215.124 | 204.319 |
| When $n_2 \geq n_{20}$, | $n_{2m} =$ | 1.696 | 1.748 | 7.849 | 1.818 | 1.809 |
| When $n_2 < n_{20}$, | $n_{2m} =$ | 1.666 | 1.665 | 7.185 | 1.613 | 1.611 |
| When $k_2 \geq k_{20}$, | $k_{2m} =$ | 0.202 | 0.195 | 3.465 | 0.264 | 0.246 |
| When $k_2 < k_{20}$, | $k_{2m} =$ | 0.150 | 0.115 | 2.625 | 0.129 | 0.105 |
| When $d_2 \geq d_{20}$, | $d_{2m}$ (nm) $=$ | 213.501 | ∞ | 0.893 | ∞ | ∞ |
| When $d_2 < d_{20}$, | $d_{2m}$ (nm) $=$ | 194.001 | 249.665 | 0.721 | 179.167 | 225.188 |

$1.3 < NA \leq 1.4$

$2 \leq T \leq 15$

| Case | 1-11 |
|---|---|
| $n_{10}$ | 1.695 |
| $k_{10}$ | 0.054 |
| $d_{10}$ (nm) | 267.286 |
| $n_{20}$ | 1.705 |
| $k_{20}$ | 0.184 |
| $d_{20}$ (nm) | 212.751 |

| | | |
|---|---|---|
| When $n_1 \geq n_{10}$, | $n_{1m} =$ | 1.731 |
| When $n_1 < n_{10}$, | $n_{1m} =$ | 1.655 |
| When $k_1 \geq k_{10}$, | $k_{1m} =$ | 0.080 |
| When $k_1 < k_{10}$, | $k_{1m} =$ | 0.025 |
| When $d_1 \geq d_{10}$, | $d_{1m}$ (nm) $=$ | $\infty$ |
| When $d_1 < d_{10}$, | $d_{1m}$ (nm) $=$ | 220.771 |
| When $n_2 \geq n_{20}$, | $n_{2m} =$ | 1.808 |
| When $n_2 < n_{20}$, | $n_{2m} =$ | 1.623 |
| When $k_2 \geq k_{20}$, | $k_{2m} =$ | 0.237 |
| When $k_2 < k_{20}$, | $k_{2m} =$ | 0.115 |
| When $d_2 \geq d_{20}$, | $d_{2m}$ (nm) $=$ | $\infty$ |
| When $d_2 < d_{20}$, | $d_{2m}$ (nm) $=$ | 175.645 |

1. 3 < N A ≦ 1. 4
1 5 < T ≦ 2 5

| Case | 2-01 | 2-02 | 2-03 | 2-04 | 2-05 |
|---|---|---|---|---|---|
| $n_{10}$ | 1.943 | 1.876 | 1.873 | 1.866 | 1.691 |
| $k_{10}$ | 0.121 | 0.112 | 0.080 | 0.068 | 0.064 |
| $d_{10}$ (nm) | 34.905 | 17.699 | 15.588 | 14.042 | 161.844 |
| $n_{20}$ | 6.149 | 1.719 | 1.739 | 1.732 | 1.687 |
| $k_{20}$ | 4.965 | 0.321 | 0.258 | 0.217 | 0.188 |
| $d_{20}$ (nm) | 1.046 | 148.502 | 203.950 | 262.757 | 198.716 |

| | | 2-01 | 2-02 | 2-03 | 2-04 | 2-05 |
|---|---|---|---|---|---|---|
| When $n_1 \geq n_{10}$, | $n_{1m} =$ | 1.997 | 1.925 | 1.936 | 1.942 | 1.700 |
| When $n_1 < n_{10}$, | $n_{1m} =$ | 1.902 | 1.861 | 1.842 | 1.830 | 1.690 |
| When $k_1 \geq k_{10}$, | $k_{1m} =$ | 0.155 | 0.135 | 0.124 | 0.122 | 0.079 |
| When $k_1 < k_{10}$, | $k_{1m} =$ | 0.064 | 0.044 | 0.004 | 0.000 | 0.061 |
| When $d_1 \geq d_{10}$, | $d_{1m}$ (nm) $=$ | 38.478 | 21.745 | 20.735 | 20.064 | 166.973 |
| When $d_1 < d_{10}$, | $d_{1m}$ (nm) $=$ | 32.365 | 16.569 | 13.305 | 11.354 | 161.165 |
| When $n_2 \geq n_{20}$, | $n_{2m} =$ | 6.640 | 1.749 | 1.787 | 1.793 | 1.688 |
| When $n_2 < n_{20}$, | $n_{2m} =$ | 5.695 | 1.636 | 1.643 | 1.623 | 1.668 |
| When $k_2 \geq k_{20}$, | $k_{2m} =$ | 5.267 | 0.354 | 0.304 | 0.266 | 0.197 |
| When $k_2 < k_{20}$, | $k_{2m} =$ | 4.500 | 0.266 | 0.202 | 0.162 | 0.165 |
| When $d_2 \geq d_{20}$, | $d_{2m}$ (nm) $=$ | 1.189 | ∞ | ∞ | ∞ | 199.493 |
| When $d_2 < d_{20}$, | $d_{2m}$ (nm) $=$ | 0.912 | 129.925 | 173.046 | 186.094 | 188.055 |

1. 3 < N A ≦ 1. 4
1 5 < T ≦ 2 5

| Case | 2-06 | 2-07 | 2-08 | 2-09 | 2-10 |
|---|---|---|---|---|---|
| $n_{10}$ | 1.692 | 1.706 | 1.711 | 1.704 | 1.695 |
| $k_{10}$ | 0.059 | 0.052 | 0.075 | 0.059 | 0.056 |
| $d_{10}$ (nm) | 157.652 | 221.303 | 235.815 | 225.762 | 267.452 |
| $n_{20}$ | 1.696 | 1.695 | 6.235 | 1.687 | 1.705 |
| $k_{20}$ | 0.161 | 0.165 | 4.691 | 0.197 | 0.194 |
| $d_{20}$ (nm) | 257.279 | 252.591 | 0.724 | 194.502 | 204.028 |

| | | 2-06 | 2-07 | 2-08 | 2-09 | 2-10 |
|---|---|---|---|---|---|---|
| When $n_1 \geq n_{10}$, | $n_{1m} =$ | 1.703 | 1.736 | 1.711 | 1.737 | 1.730 |
| When $n_1 < n_{10}$, | $n_{1m} =$ | 1.667 | 1.690 | 1.709 | 1.692 | 1.658 |
| When $k_1 \geq k_{10}$, | $k_{1m} =$ | 0.082 | 0.079 | 0.079 | 0.082 | 0.080 |
| When $k_1 < k_{10}$, | $k_{1m} =$ | 0.033 | 0.024 | 0.074 | 0.033 | 0.029 |
| When $d_1 \geq d_{10}$, | $d_{1m}$ (nm) $=$ | 165.499 | ∞ | 235.852 | ∞ | ∞ |
| When $d_1 < d_{10}$, | $d_{1m}$ (nm) $=$ | 138.474 | 207.206 | 234.721 | 216.211 | 222.458 |
| When $n_2 \geq n_{20}$, | $n_{2m} =$ | 1.740 | 1.797 | 6.407 | 1.814 | 1.798 |
| When $n_2 < n_{20}$, | $n_{2m} =$ | 1.670 | 1.616 | 6.233 | 1.613 | 1.629 |
| When $k_2 \geq k_{20}$, | $k_{2m} =$ | 0.196 | 0.249 | 4.693 | 0.270 | 0.240 |
| When $k_2 < k_{20}$, | $k_{2m} =$ | 0.121 | 0.111 | 3.940 | 0.138 | 0.122 |
| When $d_2 \geq d_{20}$, | $d_{2m}$ (nm) $=$ | ∞ | ∞ | 0.732 | ∞ | ∞ |
| When $d_2 < d_{20}$, | $d_{2m}$ (nm) $=$ | 244.077 | 220.690 | 0.720 | 173.495 | 171.776 |

1. 3 < N A ≤ 1. 4

2 5 < T ≤ 3 5

| Case | 3-01 | 3-02 | 3-03 | 3-04 | 3-05 |
|---|---|---|---|---|---|
| $n_{10}$ | 1.883 | 1.879 | 1.872 | 1.692 | 1.705 |
| $k_{10}$ | 0.119 | 0.084 | 0.069 | 0.061 | 0.061 |
| $d_{10}$ (nm) | 18.157 | 15.746 | 14.214 | 157.790 | 225.478 |
| $n_{20}$ | 1.723 | 1.741 | 1.737 | 1.697 | 1.687 |
| $k_{20}$ | 0.349 | 0.274 | 0.228 | 0.168 | 0.209 |
| $d_{20}$ (nm) | 139.788 | 195.542 | 253.893 | 248.784 | 186.105 |

| | | 3-01 | 3-02 | 3-03 | 3-04 | 3-05 |
|---|---|---|---|---|---|---|
| When $n_1 \geq n_{10}$, | $n_{1m}=$ | 1.927 | 1.939 | 1.945 | 1.699 | 1.735 |
| When $n_1 < n_{10}$, | $n_{1m}=$ | 1.873 | 1.852 | 1.839 | 1.671 | 1.694 |
| When $k_1 \geq k_{10}$, | $k_{1m}=$ | 0.135 | 0.123 | 0.119 | 0.079 | 0.082 |
| When $k_1 < k_{10}$, | $k_{1m}=$ | 0.055 | 0.011 | 0.000 | 0.039 | 0.038 |
| When $d_1 \geq d_{10}$, | $d_{1m}$ (nm) $=$ | 21.683 | 20.446 | 19.836 | 161.921 | 270.295 |
| When $d_1 < d_{10}$, | $d_{1m}$ (nm) $=$ | 17.423 | 13.775 | 11.786 | 145.560 | 217.505 |
| When $n_2 \geq n_{20}$, | $n_{2m}=$ | 1.744 | 1.786 | 1.794 | 1.735 | 1.754 |
| When $n_2 < n_{20}$, | $n_{2m}=$ | 1.647 | 1.650 | 1.632 | 1.679 | 1.615 |
| When $k_2 \geq k_{20}$, | $k_{2m}=$ | 0.374 | 0.316 | 0.276 | 0.196 | 0.276 |
| When $k_2 < k_{20}$, | $k_{2m}=$ | 0.295 | 0.218 | 0.173 | 0.130 | 0.149 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 124.317 | 167.810 | 181.193 | 239.270 | 167.329 |

1. 3 < N A ≤ 1. 4

2 5 < T ≤ 3 5

| Case | 3-06 |
|---|---|
| $n_{10}$ | 1.706 |
| $k_{10}$ | 0.054 |
| $d_{10}$ (nm) | 221.123 |
| $n_{20}$ | 1.695 |
| $k_{20}$ | 0.173 |
| $d_{20}$ (nm) | 244.149 |

| | | 3-06 |
|---|---|---|
| When $n_1 \geq n_{10}$, | $n_{1m}=$ | 1.735 |
| When $n_1 < n_{10}$, | $n_{1m}=$ | 1.692 |
| When $k_1 \geq k_{10}$, | $k_{1m}=$ | 0.078 |
| When $k_1 < k_{10}$, | $k_{1m}=$ | 0.026 |
| When $d_1 \geq d_{10}$, | $d_{1m}$ (nm) $=$ | ∞ |
| When $d_1 < d_{10}$, | $d_{1m}$ (nm) $=$ | 209.346 |
| When $n_2 \geq n_{20}$, | $n_{2m}=$ | 1.781 |
| When $n_2 < n_{20}$, | $n_{2m}=$ | 1.622 |
| When $k_2 \geq k_{20}$, | $k_{2m}=$ | 0.252 |
| When $k_2 < k_{20}$, | $k_{2m}=$ | 0.118 |
| When $d_2 \geq d_{20}$, | $d_{2m}$ (nm) $=$ | ∞ |
| When $d_2 < d_{20}$, | $d_{2m}$ (nm) $=$ | 214.946 |

1. 3 < N A ≤ 1. 4

3 5 < T ≤ 4 5

| Case | 4-01 | 4-02 | 4-03 | 4-04 | 4-05 |
|---|---|---|---|---|---|
| $n_{10}$ | 1.890 | 1.886 | 1.877 | 1.692 | 1.705 |
| $k_{10}$ | 0.130 | 0.088 | 0.073 | 0.062 | 0.063 |
| $d_{10}$ (nm) | 18.083 | 15.723 | 14.196 | 157.690 | 225.284 |
| $n_{20}$ | 1.714 | 1.743 | 1.736 | 1.697 | 1.687 |
| $k_{20}$ | 0.371 | 0.287 | 0.236 | 0.175 | 0.220 |
| $d_{20}$ (nm) | 132.495 | 187.112 | 245.779 | 240.328 | 177.345 |

| | | 4-01 | 4-02 | 4-03 | 4-04 | 4-05 |
|---|---|---|---|---|---|---|
| When $n_1 \geq n_{10}$, | $n_{1m} =$ | 1.928 | 1.943 | 1.947 | 1.695 | 1.732 |
| When $n_1 < n_{10}$, | $n_{1m} =$ | 1.886 | 1.862 | 1.846 | 1.674 | 1.696 |
| When $k_1 \geq k_{10}$, | $k_{1m} =$ | 0.137 | 0.123 | 0.120 | 0.075 | 0.081 |
| When $k_1 < k_{10}$, | $k_{1m} =$ | 0.069 | 0.018 | 0.000 | 0.046 | 0.042 |
| When $d_1 \geq d_{10}$, | $d_{1m}$ (nm) $=$ | 21.026 | 19.960 | 19.411 | 159.493 | 266.580 |
| When $d_1 < d_{10}$, | $d_{1m}$ (nm) $=$ | 17.768 | 14.046 | 12.019 | 148.447 | 218.746 |
| When $n_2 \geq n_{20}$, | $n_{2m} =$ | 1.723 | 1.784 | 1.789 | 1.731 | 1.745 |
| When $n_2 < n_{20}$, | $n_{2m} =$ | 1.643 | 1.655 | 1.634 | 1.687 | 1.620 |
| When $k_2 \geq k_{20}$, | $k_{2m} =$ | 0.382 | 0.326 | 0.281 | 0.195 | 0.283 |
| When $k_2 < k_{20}$, | $k_{2m} =$ | 0.323 | 0.234 | 0.182 | 0.141 | 0.159 |
| When $d_2 \geq d_{20}$, | $d_{2m}$ (nm) $=$ | ∞ | ∞ | ∞ | 273.632 | ∞ |
| When $d_2 < d_{20}$, | $d_{2m}$ (nm) $=$ | 119.322 | 160.895 | 176.028 | 234.699 | 160.070 |

1. 3 < N A ≤ 1. 4

3 5 < T ≤ 4 5

| Case | 4-06 | 4-07 |
|---|---|---|
| $n_{10}$ | 1.706 | 1.695 |
| $k_{10}$ | 0.055 | 0.055 |
| $d_{10}$ (nm) | 220.863 | 262.917 |
| $n_{20}$ | 1.695 | 1.705 |
| $k_{20}$ | 0.180 | 0.178 |
| $d_{20}$ (nm) | 235.453 | 255.408 |

| | | 4-06 | 4-07 |
|---|---|---|---|
| When $n_1 \geq n_{10}$, | $n_{1m} =$ | 1.734 | 1.723 |
| When $n_1 < n_{10}$, | $n_{1m} =$ | 1.693 | 1.660 |
| When $k_1 \geq k_{10}$, | $k_{1m} =$ | 0.078 | 0.082 |
| When $k_1 < k_{10}$, | $k_{1m} =$ | 0.027 | 0.031 |
| When $d_1 \geq d_{10}$, | $d_{1m}$ (nm) $=$ | ∞ | ∞ |
| When $d_1 < d_{10}$, | $d_{1m}$ (nm) $=$ | 210.617 | 221.552 |
| When $n_2 \geq n_{20}$, | $n_{2m} =$ | 1.767 | 1.832 |
| When $n_2 < n_{20}$, | $n_{2m} =$ | 1.630 | 1.613 |
| When $k_2 \geq k_{20}$, | $k_{2m} =$ | 0.252 | 0.241 |
| When $k_2 < k_{20}$, | $k_{2m} =$ | 0.123 | 0.108 |
| When $d_2 \geq d_{20}$, | $d_{2m}$ (nm) $=$ | ∞ | ∞ |
| When $d_2 < d_{20}$, | $d_{2m}$ (nm) $=$ | 206.982 | 177.439 |

1. 3 < N A ≤ 1. 4
4 5 < T ≤ 5 5

| Case | 5-01 | 5-02 | 5-03 | 5-04 | 5-05 |
|---|---|---|---|---|---|
| $n_{10}$ | 1.891 | 1.892 | 1.878 | 1.691 | 1.705 |
| $k_{10}$ | 0.144 | 0.091 | 0.079 | 0.064 | 0.064 |
| $d_{10}$ (nm) | 17.530 | 15.545 | 14.050 | 157.168 | 225.395 |
| $n_{20}$ | 1.686 | 1.744 | 1.728 | 1.696 | 1.686 |
| $k_{20}$ | 0.376 | 0.296 | 0.240 | 0.179 | 0.227 |
| $d_{20}$ (nm) | 126.586 | 178.253 | 238.151 | 231.953 | 167.881 |

| | | 5-01 | 5-02 | 5-03 | 5-04 | 5-05 |
|---|---|---|---|---|---|---|
| When $n_1 \geq n_{10}$, | $n_{1m} =$ | 1.925 | 1.947 | 1.947 | 1.692 | 1.729 |
| When $n_1 < n_{10}$, | $n_{1m} =$ | 1.891 | 1.870 | 1.849 | 1.677 | 1.698 |
| When $k_1 \geq k_{10}$, | $k_{1m} =$ | 0.144 | 0.124 | 0.124 | 0.069 | 0.080 |
| When $k_1 < k_{10}$, | $k_{1m} =$ | 0.087 | 0.024 | 0.000 | 0.054 | 0.044 |
| When $d_1 \geq d_{10}$, | $d_{1m}$ (nm) $=$ | 19.955 | 19.462 | 18.998 | 157.553 | 251.532 |
| When $d_1 < d_{10}$, | $d_{1m}$ (nm) $=$ | 17.523 | 14.081 | 12.045 | 150.032 | 219.912 |
| When $n_2 \geq n_{20}$, | $n_{2m} =$ | 1.686 | 1.783 | 1.778 | 1.727 | 1.728 |
| When $n_2 < n_{20}$, | $n_{2m} =$ | 1.619 | 1.656 | 1.625 | 1.693 | 1.628 |
| When $k_2 \geq k_{20}$, | $k_{2m} =$ | 0.377 | 0.330 | 0.281 | 0.190 | 0.292 |
| When $k_2 < k_{20}$, | $k_{2m} =$ | 0.336 | 0.244 | 0.186 | 0.164 | 0.167 |
| When $d_2 \geq d_{20}$, | $d_{2m}$ (nm) $=$ | 127.104 | ∞ | ∞ | 253.769 | ∞ |
| When $d_2 < d_{20}$, | $d_{2m}$ (nm) $=$ | 114.397 | 150.903 | 169.614 | 229.862 | 150.571 |

1. 3 < N A ≤ 1. 4
4 5 < T ≤ 5 5

| Case | 5-06 | 5-07 |
|---|---|---|
| $n_{10}$ | 1.706 | 1.697 |
| $k_{10}$ | 0.056 | 0.047 |
| $d_{10}$ (nm) | 220.607 | 278.691 |
| $n_{20}$ | 1.694 | 1.700 |
| $k_{20}$ | 0.184 | 0.152 |
| $d_{20}$ (nm) | 226.210 | 281.986 |

| | | 5-06 | 5-07 |
|---|---|---|---|
| When $n_1 \geq n_{10}$, | $n_{1m} =$ | 1.728 | 1.753 |
| When $n_1 < n_{10}$, | $n_{1m} =$ | 1.694 | 1.654 |
| When $k_1 \geq k_{10}$, | $k_{1m} =$ | 0.077 | 0.078 |
| When $k_1 < k_{10}$, | $k_{1m} =$ | 0.029 | 0.021 |
| When $d_1 \geq d_{10}$, | $d_{1m}$ (nm) $=$ | ∞ | ∞ |
| When $d_1 < d_{10}$, | $d_{1m}$ (nm) $=$ | 210.961 | 211.857 |
| When $n_2 \geq n_{20}$, | $n_{2m} =$ | 1.757 | 1.912 |
| When $n_2 < n_{20}$, | $n_{2m} =$ | 1.639 | 1.611 |
| When $k_2 \geq k_{20}$, | $k_{2m} =$ | 0.250 | 0.220 |
| When $k_2 < k_{20}$, | $k_{2m} =$ | 0.125 | 0.096 |
| When $d_2 \geq d_{20}$, | $d_{2m}$ (nm) $=$ | ∞ | ∞ |
| When $d_2 < d_{20}$, | $d_{2m}$ (nm) $=$ | 199.775 | 202.106 |

1 . 3 < N A ≦ 1 . 4

5 5 < T ≦ 6 5

| Case | 6-01 | 6-02 | 6-03 | 6-04 | 6-05 |
|---|---|---|---|---|---|
| $n_{10}$ | 1.896 | 1.875 | 1.705 | 1.705 | 1.708 |
| $k_{10}$ | 0.091 | 0.087 | 0.064 | 0.057 | 0.053 |
| $d_{10}$ (nm) | 15.652 | 14.019 | 225.606 | 220.354 | 218.289 |
| $n_{20}$ | 1.752 | 1.715 | 1.687 | 1.694 | 1.707 |
| $k_{20}$ | 0.303 | 0.239 | 0.232 | 0.186 | 0.158 |
| $d_{20}$ (nm) | 167.408 | 230.256 | 157.678 | 216.433 | 272.538 |

| | | 6-01 | 6-02 | 6-03 | 6-04 | 6-05 |
|---|---|---|---|---|---|---|
| When $n_1 \geq n_{10}$, | $n_{1m} =$ | 1.950 | 1.943 | 1.724 | 1.723 | 1.740 |
| When $n_1 < n_{10}$, | $n_{1m} =$ | 1.875 | 1.846 | 1.699 | 1.693 | 1.693 |
| When $k_1 \geq k_{10}$, | $k_{1m} =$ | 0.122 | 0.132 | 0.079 | 0.077 | 0.077 |
| When $k_1 < k_{10}$, | $k_{1m} =$ | 0.025 | 0.004 | 0.045 | 0.033 | 0.030 |
| When $d_1 \geq d_{10}$, | $d_{1m}$ (nm) $=$ | 19.494 | 18.898 | 247.964 | ∞ | ∞ |
| When $d_1 < d_{10}$, | $d_{1m}$ (nm) $=$ | 14.295 | 12.042 | 221.101 | 210.599 | 206.669 |
| When $n_2 \geq n_{20}$, | $n_{2m} =$ | 1.792 | 1.763 | 1.721 | 1.752 | 1.799 |
| When $n_2 < n_{20}$, | $n_{2m} =$ | 1.662 | 1.612 | 1.638 | 1.648 | 1.579 |
| When $k_2 \geq k_{20}$, | $k_{2m} =$ | 0.337 | 0.279 | 0.301 | 0.247 | 0.230 |
| When $k_2 < k_{20}$, | $k_{2m} =$ | 0.249 | 0.186 | 0.176 | 0.128 | 0.106 |
| When $d_2 \geq d_{20}$, | $d_{2m}$ (nm) $=$ | ∞ | ∞ | 172.085 | ∞ | ∞ |
| When $d_2 < d_{20}$, | $d_{2m}$ (nm) $=$ | 138.575 | 161.008 | 143.974 | 199.200 | 203.487 |

1 . 3 < N A ≦ 1 . 4

5 5 < T ≦ 6 5

| Case | 6-06 |
|---|---|
| $n_{10}$ | 1.697 |
| $k_{10}$ | 0.047 |
| $d_{10}$ (nm) | 278.413 |
| $n_{20}$ | 1.701 |
| $k_{20}$ | 0.154 |
| $d_{20}$ (nm) | 271.867 |

| | | 6-06 |
|---|---|---|
| When $n_1 \geq n_{10}$, | $n_{1m} =$ | 1.750 |
| When $n_1 < n_{10}$, | $n_{1m} =$ | 1.656 |
| When $k_1 \geq k_{10}$, | $k_{1m} =$ | 0.078 |
| When $k_1 < k_{10}$, | $k_{1m} =$ | 0.022 |
| When $d_1 \geq d_{10}$, | $d_{1m}$ (nm) $=$ | ∞ |
| When $d_1 < d_{10}$, | $d_{1m}$ (nm) $=$ | 213.947 |
| When $n_2 \geq n_{20}$, | $n_{2m} =$ | 1.923 |
| When $n_2 < n_{20}$, | $n_{2m} =$ | 1.614 |
| When $k_2 \geq k_{20}$, | $k_{2m} =$ | 0.223 |
| When $k_2 < k_{20}$, | $k_{2m} =$ | 0.097 |
| When $d_2 \geq d_{20}$, | $d_{2m}$ (nm) $=$ | ∞ |
| When $d_2 < d_{20}$, | $d_{2m}$ (nm) $=$ | 191.019 |

1. 3 < N A ≤ 1. 4
6 5 < T ≤ 7 5

| Case | 7-01 | 7-02 | 7-03 | 7-04 | 7-05 |
|---|---|---|---|---|---|
| $n_{10}$ | 1.901 | 1.871 | 1.866 | 1.706 | 1.705 |
| $k_{10}$ | 0.088 | 0.093 | 0.067 | 0.065 | 0.057 |
| $d_{10}$ (nm) | 16.388 | 14.267 | 13.172 | 225.317 | 220.112 |
| $n_{20}$ | 1.774 | 1.706 | 1.724 | 1.687 | 1.694 |
| $k_{20}$ | 0.318 | 0.241 | 0.206 | 0.238 | 0.188 |
| $d_{20}$ (nm) | 154.194 | 221.319 | 275.098 | 147.740 | 206.685 |

| | | 7-01 | 7-02 | 7-03 | 7-04 | 7-05 |
|---|---|---|---|---|---|---|
| When $n_1 \geq n_{10}$, | $n_{1m} =$ | 1.955 | 1.937 | 1.947 | 1.721 | 1.721 |
| When $n_1 < n_{10}$, | $n_{1m} =$ | 1.881 | 1.842 | 1.823 | 1.701 | 1.693 |
| When $k_1 \geq k_{10}$, | $k_{1m} =$ | 0.116 | 0.138 | 0.131 | 0.077 | 0.077 |
| When $k_1 < k_{10}$, | $k_{1m} =$ | 0.024 | 0.011 | 0.000 | 0.045 | 0.035 |
| When $d_1 \geq d_{10}$, | $d_{1m}$ (nm) $=$ | 20.279 | 19.161 | 19.228 | 239.263 | 245.793 |
| When $d_1 < d_{10}$, | $d_{1m}$ (nm) $=$ | 15.118 | 12.240 | 10.142 | 222.197 | 210.312 |
| When $n_2 \geq n_{20}$, | $n_{2m} =$ | 1.816 | 1.751 | 1.783 | 1.720 | 1.752 |
| When $n_2 < n_{20}$, | $n_{2m} =$ | 1.683 | 1.603 | 1.616 | 1.644 | 1.651 |
| When $k_2 \geq k_{20}$, | $k_{2m} =$ | 0.355 | 0.280 | 0.254 | 0.305 | 0.246 |
| When $k_2 < k_{20}$, | $k_{2m} =$ | 0.259 | 0.188 | 0.151 | 0.177 | 0.133 |
| When $d_2 \geq d_{20}$, | $d_{2m}$ (nm) $=$ | ∞ | ∞ | ∞ | 161.062 | ∞ |
| When $d_2 < d_{20}$, | $d_{2m}$ (nm) $=$ | 132.898 | 152.054 | 192.936 | 136.808 | 191.952 |

1. 3 < N A ≤ 1. 4
6 5 < T ≤ 7 5

| Case | 7-06 | 7-07 |
|---|---|---|
| $n_{10}$ | 1.708 | 1.697 |
| $k_{10}$ | 0.053 | 0.047 |
| $d_{10}$ (nm) | 218.342 | 278.070 |
| $n_{20}$ | 1.707 | 1.702 |
| $k_{20}$ | 0.161 | 0.156 |
| $d_{20}$ (nm) | 262.805 | 262.294 |

| | | 7-06 | 7-07 |
|---|---|---|---|
| When $n_1 \geq n_{10}$, | $n_{1m} =$ | 1.740 | 1.735 |
| When $n_1 < n_{10}$, | $n_{1m} =$ | 1.695 | 1.657 |
| When $k_1 \geq k_{10}$, | $k_{1m} =$ | 0.077 | 0.077 |
| When $k_1 < k_{10}$, | $k_{1m} =$ | 0.032 | 0.024 |
| When $d_1 \geq d_{10}$, | $d_{1m}$ (nm) $=$ | ∞ | ∞ |
| When $d_1 < d_{10}$, | $d_{1m}$ (nm) $=$ | 208.328 | 215.902 |
| When $n_2 \geq n_{20}$, | $n_{2m} =$ | 1.805 | 1.806 |
| When $n_2 < n_{20}$, | $n_{2m} =$ | 1.580 | 1.618 |
| When $k_2 \geq k_{20}$, | $k_{2m} =$ | 0.232 | 0.224 |
| When $k_2 < k_{20}$, | $k_{2m} =$ | 0.108 | 0.097 |
| When $d_2 \geq d_{20}$, | $d_{2m}$ (nm) $=$ | ∞ | ∞ |
| When $d_2 < d_{20}$, | $d_{2m}$ (nm) $=$ | 195.570 | 182.960 |

1. 3 < N A ≤ 1. 4
7 5 < T ≤ 8 5

| Case | 8-01 | 8-02 | 8-03 | 8-04 | 8-05 |
|---|---|---|---|---|---|
| $n_{10}$ | 1.908 | 1.871 | 1.869 | 1.706 | 1.705 |
| $k_{10}$ | 0.087 | 0.097 | 0.067 | 0.067 | 0.058 |
| $d_{10}$ (nm) | 17.362 | 14.654 | 13.479 | 224.641 | 220.026 |
| $n_{20}$ | 1.802 | 1.704 | 1.729 | 1.684 | 1.694 |
| $k_{20}$ | 0.342 | 0.250 | 0.214 | 0.248 | 0.194 |
| $d_{20}$ (nm) | 141.959 | 212.121 | 265.153 | 139.263 | 197.616 |

| | | 8-01 | 8-02 | 8-03 | 8-04 | 8-05 |
|---|---|---|---|---|---|---|
| When $n_1 \geq n_{10}$, | $n_{1m}=$ | 1.960 | 1.935 | 1.947 | 1.720 | 1.721 |
| When $n_1 < n_{10}$, | $n_{1m}=$ | 1.891 | 1.843 | 1.828 | 1.704 | 1.694 |
| When $k_1 \geq k_{10}$, | $k_{1m}=$ | 0.111 | 0.140 | 0.128 | 0.074 | 0.078 |
| When $k_1 < k_{10}$, | $k_{1m}=$ | 0.023 | 0.016 | 0.000 | 0.049 | 0.035 |
| When $d_1 \geq d_{10}$, | $d_{1m}$ (nm) $=$ | 21.165 | 19.437 | 19.380 | 236.042 | 243.446 |
| When $d_1 < d_{10}$, | $d_{1m}$ (nm) $=$ | 16.261 | 12.685 | 10.599 | 223.100 | 210.844 |
| When $n_2 \geq n_{20}$, | $n_{2m}=$ | 1.843 | 1.746 | 1.787 | 1.711 | 1.754 |
| When $n_2 < n_{20}$, | $n_{2m}=$ | 1.713 | 1.604 | 1.618 | 1.641 | 1.649 |
| When $k_2 \geq k_{20}$, | $k_{2m}=$ | 0.382 | 0.288 | 0.262 | 0.299 | 0.249 |
| When $k_2 < k_{20}$, | $k_{2m}=$ | 0.279 | 0.196 | 0.159 | 0.184 | 0.134 |
| When $d_2 \geq d_{20}$, | $d_{2m}$ (nm) $=$ | ∞ | ∞ | ∞ | 151.104 | ∞ |
| When $d_2 < d_{20}$, | $d_{2m}$ (nm) $=$ | 126.652 | 177.678 | 187.664 | 128.169 | 181.064 |

1. 3 < N A ≤ 1. 4
7 5 < T ≤ 8 5

| Case | 8-06 | 8-07 |
|---|---|---|
| $n_{10}$ | 1.708 | 1.697 |
| $k_{10}$ | 0.054 | 0.048 |
| $d_{10}$ (nm) | 218.429 | 277.999 |
| $n_{20}$ | 1.707 | 1.702 |
| $k_{20}$ | 0.165 | 0.160 |
| $d_{20}$ (nm) | 253.768 | 253.663 |

| | | 8-06 | 8-07 |
|---|---|---|---|
| When $n_1 \geq n_{10}$, | $n_{1m}=$ | 1.739 | 1.730 |
| When $n_1 < n_{10}$, | $n_{1m}=$ | 1.697 | 1.656 |
| When $k_1 \geq k_{10}$, | $k_{1m}=$ | 0.076 | 0.076 |
| When $k_1 < k_{10}$, | $k_{1m}=$ | 0.032 | 0.027 |
| When $d_1 \geq d_{10}$, | $d_{1m}$ (nm) $=$ | ∞ | ∞ |
| When $d_1 < d_{10}$, | $d_{1m}$ (nm) $=$ | 209.931 | 217.650 |
| When $n_2 \geq n_{20}$, | $n_{2m}=$ | 1.810 | 1.804 |
| When $n_2 < n_{20}$, | $n_{2m}=$ | 1.580 | 1.625 |
| When $k_2 \geq k_{20}$, | $k_{2m}=$ | 0.235 | 0.225 |
| When $k_2 < k_{20}$, | $k_{2m}=$ | 0.109 | 0.100 |
| When $d_2 \geq d_{20}$, | $d_{2m}$ (nm) $=$ | ∞ | ∞ |
| When $d_2 < d_{20}$, | $d_{2m}$ (nm) $=$ | 216.664 | 177.272 |

1. 3 < N A ≤ 1. 4

85 < T ≤ 95

| Case | 9-01 | 9-02 | 9-03 | 9-04 | 9-05 |
|---|---|---|---|---|---|
| $n_{10}$ | 1.918 | 1.876 | 1.874 | 1.706 | 1.709 |
| $k_{10}$ | 0.092 | 0.100 | 0.069 | 0.060 | 0.055 |
| $d_{10}$ (nm) | 17.977 | 14.944 | 13.674 | 219.996 | 218.382 |
| $n_{20}$ | 1.822 | 1.706 | 1.733 | 1.694 | 1.707 |
| $k_{20}$ | 0.371 | 0.265 | 0.224 | 0.203 | 0.172 |
| $d_{20}$ (nm) | 132.466 | 203.140 | 256.300 | 189.146 | 245.309 |

| | | 9-01 | 9-02 | 9-03 | 9-04 | 9-05 |
|---|---|---|---|---|---|---|
| When $n_1 \geq n_{10}$, | $n_{1m}=$ | 1.966 | 1.936 | 1.950 | 1.723 | 1.738 |
| When $n_1 < n_{10}$, | $n_{1m}=$ | 1.905 | 1.851 | 1.836 | 1.696 | 1.699 |
| When $k_1 \geq k_{10}$, | $k_{1m}=$ | 0.109 | 0.138 | 0.126 | 0.078 | 0.075 |
| When $k_1 < k_{10}$, | $k_{1m}=$ | 0.028 | 0.021 | 0.000 | 0.035 | 0.032 |
| When $d_1 \geq d_{10}$, | $d_{1m}$ (nm) $=$ | 21.461 | 19.418 | 19.237 | 242.566 | ∞ |
| When $d_1 < d_{10}$, | $d_{1m}$ (nm) $=$ | 17.167 | 13.206 | 11.040 | 212.120 | 211.373 |
| When $n_2 \geq n_{20}$, | $n_{2m}=$ | 1.855 | 1.745 | 1.789 | 1.754 | 1.811 |
| When $n_2 < n_{20}$, | $n_{2m}=$ | 1.737 | 1.611 | 1.626 | 1.644 | 1.579 |
| When $k_2 \geq k_{20}$, | $k_{2m}=$ | 0.407 | 0.300 | 0.271 | 0.255 | 0.237 |
| When $k_2 < k_{20}$, | $k_{2m}=$ | 0.308 | 0.211 | 0.169 | 0.143 | 0.115 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 121.537 | 173.052 | 183.002 | 168.954 | 213.072 |

1. 3 < N A ≤ 1. 4

85 < T ≤ 95

| Case | 9-06 |
|---|---|
| $n_{10}$ | 1.697 |
| $k_{10}$ | 0.050 |
| $d_{10}$ (nm) | 278.074 |
| $n_{20}$ | 1.701 |
| $k_{20}$ | 0.166 |
| $d_{20}$ (nm) | 245.468 |

| | | 9-06 |
|---|---|---|
| When $n_1 \geq n_{10}$, | $n_{1m}=$ | 1.728 |
| When $n_1 < n_{10}$, | $n_{1m}=$ | 1.655 |
| When $k_1 \geq k_{10}$, | $k_{1m}=$ | 0.075 |
| When $k_1 < k_{10}$, | $k_{1m}=$ | 0.029 |
| When $d_1 \geq d_{10}$, | $d_{1m}$ (nm) $=$ | ∞ |
| When $d_1 < d_{10}$, | $d_{1m}$ (nm) $=$ | 219.101 |
| When $n_2 \geq n_{20}$, | $n_{2m}=$ | 1.805 |
| When $n_2 < n_{20}$, | $n_{2m}=$ | 1.636 |
| When $k_2 \geq k_{20}$, | $k_{2m}=$ | 0.226 |
| When $k_2 < k_{20}$, | $k_{2m}=$ | 0.106 |
| When $d_2 \geq d_{20}$, | $d_{2m}$ (nm) $=$ | ∞ |
| When $d_2 < d_{20}$, | $d_{2m}$ (nm) $=$ | 172.052 |

1. 3 < N A ≤ 1. 4
9 5 < T ≤ 1 0 5

| Case | 10-01 | 10-02 | 10-03 | 10-04 | 10-05 |
|---|---|---|---|---|---|
| $n_{10}$ | 1.929 | 1.883 | 1.880 | 1.707 | 1.709 |
| $k_{10}$ | 0.101 | 0.103 | 0.071 | 0.062 | 0.057 |
| $d_{10}$ (nm) | 17.864 | 14.973 | 13.709 | 219.774 | 218.071 |
| $n_{20}$ | 1.821 | 1.709 | 1.736 | 1.693 | 1.706 |
| $k_{20}$ | 0.398 | 0.279 | 0.234 | 0.214 | 0.179 |
| $d_{20}$ (nm) | 125.532 | 194.479 | 247.823 | 180.753 | 237.020 |

| | | 10-01 | 10-02 | 10-03 | 10-04 | 10-05 |
|---|---|---|---|---|---|---|
| When $n_1 \geq n_{10}$, | $n_{1m} =$ | 1.973 | 1.940 | 1.953 | 1.724 | 1.737 |
| When $n_1 < n_{10}$, | $n_{1m} =$ | 1.922 | 1.863 | 1.845 | 1.698 | 1.701 |
| When $k_1 \geq k_{10}$, | $k_{1m} =$ | 0.111 | 0.136 | 0.124 | 0.077 | 0.074 |
| When $k_1 < k_{10}$, | $k_{1m} =$ | 0.042 | 0.027 | 0.000 | 0.035 | 0.034 |
| When $d_1 \geq d_{10}$, | $d_{1m}$ (nm) $=$ | 20.839 | 19.023 | 18.857 | 241.722 | ∞ |
| When $d_1 < d_{10}$, | $d_{1m}$ (nm) $=$ | 17.465 | 13.566 | 11.352 | 213.515 | 212.546 |
| When $n_2 \geq n_{20}$, | $n_{2m} =$ | 1.840 | 1.742 | 1.789 | 1.751 | 1.807 |
| When $n_2 < n_{20}$, | $n_{2m} =$ | 1.743 | 1.619 | 1.632 | 1.642 | 1.577 |
| When $k_2 \geq k_{20}$, | $k_{2m} =$ | 0.418 | 0.310 | 0.278 | 0.260 | 0.236 |
| When $k_2 < k_{20}$, | $k_{2m} =$ | 0.340 | 0.227 | 0.180 | 0.155 | 0.122 |
| When $d_2 \geq d_{20}$, | $d_{2m}$ (nm) $=$ | 161.544 | ∞ | ∞ | ∞ | ∞ |
| When $d_2 < d_{20}$, | $d_{2m}$ (nm) $=$ | 119.422 | 166.497 | 178.361 | 161.067 | 205.891 |

1. 3 < N A ≤ 1. 4
9 5 < T ≤ 1 0 5

| Case | 10-06 |
|---|---|
| $n_{10}$ | 1.697 |
| $k_{10}$ | 0.047 |
| $d_{10}$ (nm) | 275.083 |
| $n_{20}$ | 1.700 |
| $k_{20}$ | 0.148 |
| $d_{20}$ (nm) | 295.680 |

| | | 10-06 |
|---|---|---|
| When $n_1 \geq n_{10}$, | $n_{1m} =$ | 1.768 |
| When $n_1 < n_{10}$, | $n_{1m} =$ | 1.650 |
| When $k_1 \geq k_{10}$, | $k_{1m} =$ | 0.079 |
| When $k_1 < k_{10}$, | $k_{1m} =$ | 0.023 |
| When $d_1 \geq d_{10}$, | $d_{1m}$ (nm) $=$ | ∞ |
| When $d_1 < d_{10}$, | $d_{1m}$ (nm) $=$ | 200.276 |
| When $n_2 \geq n_{20}$, | $n_{2m} =$ | 1.849 |
| When $n_2 < n_{20}$, | $n_{2m} =$ | 1.604 |
| When $k_2 \geq k_{20}$, | $k_{2m} =$ | 0.227 |
| When $k_2 < k_{20}$, | $k_{2m} =$ | 0.093 |
| When $d_2 \geq d_{20}$, | $d_{2m}$ (nm) $=$ | ∞ |
| When $d_2 < d_{20}$, | $d_{2m}$ (nm) $=$ | 212.971 |

$1 . 3 < N A \leq 1 . 4$

$1 0 5 < T \leq 1 1 5$

| Case | 11-01 | 11-02 | 11-03 | 11-04 | 11-05 |
|---|---|---|---|---|---|
| $n_{10}$ | 1.891 | 1.885 | 1.707 | 1.709 | 1.697 |
| $k_{10}$ | 0.108 | 0.074 | 0.064 | 0.058 | 0.048 |
| $d_{10}$ (nm) | 14.702 | 13.594 | 219.485 | 217.678 | 275.043 |
| $n_{20}$ | 1.707 | 1.735 | 1.692 | 1.705 | 1.701 |
| $k_{20}$ | 0.289 | 0.241 | 0.223 | 0.184 | 0.152 |
| $d_{20}$ (nm) | 186.368 | 239.426 | 171.867 | 228.411 | 286.426 |

| | | 11-01 | 11-02 | 11-03 | 11-04 | 11-05 |
|---|---|---|---|---|---|---|
| When $n_1 \geq n_{10}$, | $n_{1m} =$ | 1.944 | 1.955 | 1.723 | 1.736 | 1.767 |
| When $n_1 < n_{10}$, | $n_{1m} =$ | 1.874 | 1.853 | 1.700 | 1.703 | 1.650 |
| When $k_1 \geq k_{10}$, | $k_{1m} =$ | 0.135 | 0.124 | 0.077 | 0.073 | 0.078 |
| When $k_1 < k_{10}$, | $k_{1m} =$ | 0.035 | 0.000 | 0.037 | 0.036 | 0.023 |
| When $d_1 \geq d_{10}$, | $d_{1m}$ (nm) $=$ | 18.320 | 18.363 | 240.271 | $\infty$ | $\infty$ |
| When $d_1 < d_{10}$, | $d_{1m}$ (nm) $=$ | 13.618 | 11.476 | 214.658 | 213.396 | 201.239 |
| When $n_2 \geq n_{20}$, | $n_{2m} =$ | 1.733 | 1.786 | 1.744 | 1.797 | 1.850 |
| When $n_2 < n_{20}$, | $n_{2m} =$ | 1.620 | 1.632 | 1.646 | 1.574 | 1.606 |
| When $k_2 \geq k_{20}$, | $k_{2m} =$ | 0.314 | 0.282 | 0.261 | 0.232 | 0.229 |
| When $k_2 < k_{20}$, | $k_{2m} =$ | 0.241 | 0.188 | 0.163 | 0.126 | 0.094 |
| When $d_2 \geq d_{20}$, | $d_{2m}$ (nm) $=$ | $\infty$ | $\infty$ | $\infty$ | $\infty$ | $\infty$ |
| When $d_2 < d_{20}$, | $d_{2m}$ (nm) $=$ | 157.397 | 173.024 | 156.390 | 195.169 | 202.551 |

1. 3 < N A ≤ 1. 4
115 < T ≤ 125

| Case | 12-01 | 12-02 | 12-03 | 12-04 | 12-05 |
|---|---|---|---|---|---|
| $n_{10}$ | 1.896 | 1.887 | 1.692 | 1.707 | 1.709 |
| $k_{10}$ | 0.113 | 0.078 | 0.059 | 0.065 | 0.059 |
| $d_{10}$ (nm) | 14.435 | 13.577 | 153.772 | 219.581 | 217.561 |
| $n_{20}$ | 1.703 | 1.733 | 1.694 | 1.692 | 1.702 |
| $k_{20}$ | 0.295 | 0.244 | 0.154 | 0.231 | 0.188 |
| $d_{20}$ (nm) | 177.615 | 230.253 | 284.837 | 161.904 | 219.131 |

| | | 12-01 | 12-02 | 12-03 | 12-04 | 12-05 |
|---|---|---|---|---|---|---|
| When $n_1 \geq n_{10}$, | $n_{1m} =$ | 1.947 | 1.955 | 1.718 | 1.720 | 1.728 |
| When $n_1 < n_{10}$, | $n_{1m} =$ | 1.882 | 1.856 | 1.664 | 1.701 | 1.703 |
| When $k_1 \geq k_{10}$, | $k_{1m} =$ | 0.136 | 0.126 | 0.090 | 0.076 | 0.072 |
| When $k_1 < k_{10}$, | $k_{1m} =$ | 0.044 | 0.000 | 0.044 | 0.041 | 0.040 |
| When $d_1 \geq d_{10}$, | $d_{1m}$ (nm) $=$ | 17.718 | 18.125 | 175.199 | 231.299 | ∞ |
| When $d_1 < d_{10}$, | $d_{1m}$ (nm) $=$ | 13.578 | 11.595 | 128.388 | 215.799 | 214.049 |
| When $n_2 \geq n_{20}$, | $n_{2m} =$ | 1.725 | 1.783 | 1.772 | 1.738 | 1.784 |
| When $n_2 < n_{20}$, | $n_{2m} =$ | 1.617 | 1.629 | 1.642 | 1.658 | 1.629 |
| When $k_2 \geq k_{20}$, | $k_{2m} =$ | 0.315 | 0.284 | 0.182 | 0.262 | 0.229 |
| When $k_2 < k_{20}$, | $k_{2m} =$ | 0.249 | 0.192 | 0.119 | 0.174 | 0.128 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 145.196 | 165.335 | 240.440 | 152.266 | 193.496 |

1. 3 < N A ≤ 1. 4
115 < T ≤ 125

| Case | 12-06 | 12-07 |
|---|---|---|
| $n_{10}$ | 1.707 | 1.697 |
| $k_{10}$ | 0.053 | 0.048 |
| $d_{10}$ (nm) | 216.484 | 274.812 |
| $n_{20}$ | 1.695 | 1.701 |
| $k_{20}$ | 0.157 | 0.154 |
| $d_{20}$ (nm) | 278.062 | 276.656 |

| | | 12-06 | 12-07 |
|---|---|---|---|
| When $n_1 \geq n_{10}$, | $n_{1m} =$ | 1.748 | 1.768 |
| When $n_1 < n_{10}$, | $n_{1m} =$ | 1.689 | 1.651 |
| When $k_1 \geq k_{10}$, | $k_{1m} =$ | 0.077 | 0.078 |
| When $k_1 < k_{10}$, | $k_{1m} =$ | 0.030 | 0.024 |
| When $d_1 \geq d_{10}$, | $d_{1m}$ (nm) $=$ | ∞ | ∞ |
| When $d_1 < d_{10}$, | $d_{1m}$ (nm) $=$ | 199.849 | 201.932 |
| When $n_2 \geq n_{20}$, | $n_{2m} =$ | 1.761 | 1.850 |
| When $n_2 < n_{20}$, | $n_{2m} =$ | 1.583 | 1.607 |
| When $k_2 \geq k_{20}$, | $k_{2m} =$ | 0.215 | 0.229 |
| When $k_2 < k_{20}$, | $k_{2m} =$ | 0.104 | 0.098 |
| When $d_2 \geq d_{20}$, | $d_{2m}$ (nm) $=$ | ∞ | ∞ |
| When $d_2 < d_{20}$, | $d_{2m}$ (nm) $=$ | 212.463 | 192.106 |

1 . 3 < N A ≦ 1 . 4
1 2 5 < T ≦ 1 3 5

| Case | 13-01 | 13-02 | 13-03 | 13-04 | 13-05 |
|---|---|---|---|---|---|
| $n_{10}$ | 1.898 | 1.885 | 1.868 | 1.707 | 1.708 |
| $k_{10}$ | 0.115 | 0.081 | 0.075 | 0.067 | 0.060 |
| $d_{10}$ (nm) | 14.632 | 13.917 | 12.752 | 219.938 | 217.756 |
| $n_{20}$ | 1.705 | 1.732 | 1.713 | 1.695 | 1.701 |
| $k_{20}$ | 0.303 | 0.248 | 0.206 | 0.239 | 0.192 |
| $d_{20}$ (nm) | 166.646 | 219.851 | 279.921 | 151.390 | 209.457 |

| | | 13-01 | 13-02 | 13-03 | 13-04 | 13-05 |
|---|---|---|---|---|---|---|
| When $n_1 \geq n_{10}$, | $n_{1m}=$ | 1.949 | 1.951 | 1.949 | 1.716 | 1.721 |
| When $n_1 < n_{10}$, | $n_{1m}=$ | 1.886 | 1.855 | 1.830 | 1.703 | 1.704 |
| When $k_1 \geq k_{10}$, | $k_{1m}=$ | 0.135 | 0.127 | 0.135 | 0.075 | 0.072 |
| When $k_1 < k_{10}$, | $k_{1m}=$ | 0.050 | 0.002 | 0.000 | 0.050 | 0.045 |
| When $d_1 \geq d_{10}$, | $d_{1m}$ (nm) $=$ | 17.809 | 18.468 | 18.469 | 226.140 | ∞ |
| When $d_1 < d_{10}$, | $d_{1m}$ (nm) $=$ | 13.869 | 11.960 | 10.161 | 217.246 | 214.692 |
| When $n_2 \geq n_{20}$, | $n_{2m}=$ | 1.725 | 1.781 | 1.771 | 1.731 | 1.769 |
| When $n_2 < n_{20}$, | $n_{2m}=$ | 1.618 | 1.628 | 1.611 | 1.678 | 1.659 |
| When $k_2 \geq k_{20}$, | $k_{2m}=$ | 0.322 | 0.288 | 0.250 | 0.263 | 0.228 |
| When $k_2 < k_{20}$, | $k_{2m}=$ | 0.256 | 0.194 | 0.153 | 0.185 | 0.138 |
| When $d_2 \geq d_{20}$, | $d_{2m}$ (nm) $=$ | ∞ | ∞ | ∞ | 179.041 | ∞ |
| When $d_2 < d_{20}$, | $d_{2m}$ (nm) $=$ | 136.370 | 153.796 | 194.427 | 147.510 | 199.403 |

1 . 3 < N A ≦ 1 . 4
1 2 5 < T ≦ 1 3 5

| Case | 13-06 | 13-07 |
|---|---|---|
| $n_{10}$ | 1.706 | 1.696 |
| $k_{10}$ | 0.054 | 0.049 |
| $d_{10}$ (nm) | 217.065 | 274.075 |
| $n_{20}$ | 1.694 | 1.702 |
| $k_{20}$ | 0.160 | 0.157 |
| $d_{20}$ (nm) | 268.021 | 267.366 |

| | | 13-06 | 13-07 |
|---|---|---|---|
| When $n_1 \geq n_{10}$, | $n_{1m}=$ | 1.746 | 1.770 |
| When $n_1 < n_{10}$, | $n_{1m}=$ | 1.690 | 1.651 |
| When $k_1 \geq k_{10}$, | $k_{1m}=$ | 0.077 | 0.078 |
| When $k_1 < k_{10}$, | $k_{1m}=$ | 0.033 | 0.026 |
| When $d_1 \geq d_{10}$, | $d_{1m}$ (nm) $=$ | ∞ | ∞ |
| When $d_1 < d_{10}$, | $d_{1m}$ (nm) $=$ | 202.380 | 202.716 |
| When $n_2 \geq n_{20}$, | $n_{2m}=$ | 1.761 | 1.853 |
| When $n_2 < n_{20}$, | $n_{2m}=$ | 1.586 | 1.608 |
| When $k_2 \geq k_{20}$, | $k_{2m}=$ | 0.219 | 0.227 |
| When $k_2 < k_{20}$, | $k_{2m}=$ | 0.106 | 0.099 |
| When $d_2 \geq d_{20}$, | $d_{2m}$ (nm) $=$ | ∞ | ∞ |
| When $d_2 < d_{20}$, | $d_{2m}$ (nm) $=$ | 208.129 | 186.947 |

1. 3 < N A ≤ 1. 4
1 3 5 < T ≤ 1 4 5

| Case | 14-01 | 14-02 | 14-03 | 14-04 | 14-05 |
|---|---|---|---|---|---|
| $n_{10}$ | 1.899 | 1.882 | 1.870 | 1.708 | 1.707 |
| $k_{10}$ | 0.115 | 0.083 | 0.074 | 0.062 | 0.055 |
| $d_{10}$ (nm) | 15.367 | 14.477 | 13.063 | 217.887 | 217.378 |
| $n_{20}$ | 1.714 | 1.732 | 1.717 | 1.700 | 1.693 |
| $k_{20}$ | 0.318 | 0.256 | 0.212 | 0.197 | 0.164 |
| $d_{20}$ (nm) | 155.141 | 209.893 | 269.637 | 200.272 | 258.646 |

| | | 14-01 | 14-02 | 14-03 | 14-04 | 14-05 |
|---|---|---|---|---|---|---|
| When $n_1 \geq n_{10}$, | $n_{1m}=$ | 1.949 | 1.947 | 1.949 | 1.716 | 1.744 |
| When $n_1 < n_{10}$, | $n_{1m}=$ | 1.888 | 1.854 | 1.833 | 1.704 | 1.691 |
| When $k_1 \geq k_{10}$, | $k_{1m}=$ | 0.132 | 0.127 | 0.132 | 0.071 | 0.077 |
| When $k_1 < k_{10}$, | $k_{1m}=$ | 0.051 | 0.006 | 0.000 | 0.050 | 0.036 |
| When $d_1 \geq d_{10}$, | $d_{1m}$ (nm) $=$ | 18.581 | 19.085 | 18.767 | ∞ | ∞ |
| When $d_1 < d_{10}$, | $d_{1m}$ (nm) $=$ | 14.660 | 12.539 | 10.533 | 215.374 | 204.778 |
| When $n_2 \geq n_{20}$, | $n_{2m}=$ | 1.733 | 1.780 | 1.774 | 1.754 | 1.760 |
| When $n_2 < n_{20}$, | $n_{2m}=$ | 1.627 | 1.630 | 1.611 | 1.677 | 1.592 |
| When $k_2 \geq k_{20}$, | $k_{2m}=$ | 0.337 | 0.296 | 0.256 | 0.228 | 0.223 |
| When $k_2 < k_{20}$, | $k_{2m}=$ | 0.266 | 0.200 | 0.157 | 0.152 | 0.109 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 131.038 | 171.650 | 189.575 | 195.166 | 202.001 |

1. 3 < N A ≤ 1. 4
1 3 5 < T ≤ 1 4 5

| Case | 14-06 |
|---|---|
| $n_{10}$ | 1.696 |
| $k_{10}$ | 0.050 |
| $d_{10}$ (nm) | 273.384 |
| $n_{20}$ | 1.702 |
| $k_{20}$ | 0.160 |
| $d_{20}$ (nm) | 258.714 |

| | | 14-06 |
|---|---|---|
| When $n_1 \geq n_{10}$, | $n_{1m}=$ | 1.741 |
| When $n_1 < n_{10}$, | $n_{1m}=$ | 1.652 |
| When $k_1 \geq k_{10}$, | $k_{1m}=$ | 0.078 |
| When $k_1 < k_{10}$, | $k_{1m}=$ | 0.028 |
| When $d_1 \geq d_{10}$, | $d_{1m}$ (nm) $=$ | ∞ |
| When $d_1 < d_{10}$, | $d_{1m}$ (nm) $=$ | 209.881 |
| When $n_2 \geq n_{20}$, | $n_{2m}=$ | 1.859 |
| When $n_2 < n_{20}$, | $n_{2m}=$ | 1.608 |
| When $k_2 \geq k_{20}$, | $k_{2m}=$ | 0.226 |
| When $k_2 < k_{20}$, | $k_{2m}=$ | 0.098 |
| When $d_2 \geq d_{20}$, | $d_{2m}$ (nm) $=$ | ∞ |
| When $d_2 < d_{20}$, | $d_{2m}$ (nm) $=$ | 178.700 |

1．3＜ＮＡ≤1．4
145＜Ｔ≤155

| Case | 15-01 | 15-02 | 15-03 | 15-04 | 15-05 |
|---|---|---|---|---|---|
| $n_{10}$ | 1.903 | 1.884 | 1.874 | 1.708 | 1.707 |
| $k_{10}$ | 0.118 | 0.087 | 0.075 | 0.063 | 0.056 |
| $d_{10}$ (nm) | 16.130 | 14.896 | 13.357 | 217.693 | 217.044 |
| $n_{20}$ | 1.723 | 1.733 | 1.722 | 1.700 | 1.694 |
| $k_{20}$ | 0.340 | 0.268 | 0.221 | 0.205 | 0.169 |
| $d_{20}$ (nm) | 145.164 | 201.113 | 260.240 | 191.744 | 250.083 |

| | | 15-01 | 15-02 | 15-03 | 15-04 | 15-05 |
|---|---|---|---|---|---|---|
| When $n_1 \geq n_{10}$, | $n_{1m} =$ | 1.950 | 1.946 | 1.951 | 1.714 | 1.742 |
| When $n_1 < n_{10}$, | $n_{1m} =$ | 1.895 | 1.858 | 1.839 | 1.706 | 1.694 |
| When $k_1 \geq k_{10}$, | $k_{1m} =$ | 0.130 | 0.127 | 0.128 | 0.070 | 0.076 |
| When $k_1 < k_{10}$, | $k_{1m} =$ | 0.053 | 0.010 | 0.000 | 0.053 | 0.038 |
| When $d_1 \geq d_{10}$, | $d_{1m}$ (nm) = | 19.240 | 19.361 | 18.857 | 222.035 | $\infty$ |
| When $d_1 < d_{10}$, | $d_{1m}$ (nm) = | 15.619 | 13.105 | 10.992 | 216.109 | 206.771 |
| When $n_2 \geq n_{20}$, | $n_{2m} =$ | 1.737 | 1.779 | 1.777 | 1.735 | 1.755 |
| When $n_2 < n_{20}$, | $n_{2m} =$ | 1.641 | 1.636 | 1.612 | 1.682 | 1.595 |
| When $k_2 \geq k_{20}$, | $k_{2m} =$ | 0.356 | 0.307 | 0.265 | 0.225 | 0.223 |
| When $k_2 < k_{20}$, | $k_{2m} =$ | 0.286 | 0.211 | 0.166 | 0.161 | 0.114 |
| When $d_2 \geq d_{20}$, | $d_{2m}$ (nm) = | $\infty$ | $\infty$ | $\infty$ | $\infty$ | $\infty$ |
| When $d_2 < d_{20}$, | $d_{2m}$ (nm) = | 126.286 | 170.199 | 185.156 | 187.971 | 215.684 |

1．3＜ＮＡ≤1．4
145＜Ｔ≤155

| Case | 15-06 |
|---|---|
| $n_{10}$ | 1.696 |
| $k_{10}$ | 0.051 |
| $d_{10}$ (nm) | 273.493 |
| $n_{20}$ | 1.702 |
| $k_{20}$ | 0.165 |
| $d_{20}$ (nm) | 250.180 |

| | | 15-06 |
|---|---|---|
| When $n_1 \geq n_{10}$, | $n_{1m} =$ | 1.738 |
| When $n_1 < n_{10}$, | $n_{1m} =$ | 1.652 |
| When $k_1 \geq k_{10}$, | $k_{1m} =$ | 0.078 |
| When $k_1 < k_{10}$, | $k_{1m} =$ | 0.031 |
| When $d_1 \geq d_{10}$, | $d_{1m}$ (nm) = | $\infty$ |
| When $d_1 < d_{10}$, | $d_{1m}$ (nm) = | 213.326 |
| When $n_2 \geq n_{20}$, | $n_{2m} =$ | 1.839 |
| When $n_2 < n_{20}$, | $n_{2m} =$ | 1.609 |
| When $k_2 \geq k_{20}$, | $k_{2m} =$ | 0.227 |
| When $k_2 < k_{20}$, | $k_{2m} =$ | 0.102 |
| When $d_2 \geq d_{20}$, | $d_{2m}$ (nm) = | $\infty$ |
| When $d_2 < d_{20}$, | $d_{2m}$ (nm) = | 171.738 |

1. 3 < NA ≦ 1. 4
155 < T ≦ 165

| Case | 16-01 | 16-02 | 16-03 | 16-04 | 16-05 |
|---|---|---|---|---|---|
| $n_{10}$ | 1.913 | 1.891 | 1.879 | 1.709 | 1.708 |
| $k_{10}$ | 0.125 | 0.091 | 0.077 | 0.064 | 0.057 |
| $d_{10}$ (nm) | 16.406 | 14.954 | 13.440 | 217.197 | 216.333 |
| $n_{20}$ | 1.727 | 1.734 | 1.724 | 1.700 | 1.694 |
| $k_{20}$ | 0.366 | 0.282 | 0.231 | 0.214 | 0.175 |
| $d_{20}$ (nm) | 136.777 | 193.024 | 251.802 | 183.446 | 241.739 |

| When $n_1 \geq n_{10}$, | $n_{1m} =$ | 1.955 | 1.950 | 1.953 | 1.714 | 1.742 |
|---|---|---|---|---|---|---|
| When $n_1 < n_{10}$, | $n_{1m} =$ | 1.910 | 1.868 | 1.847 | 1.708 | 1.697 |
| When $k_1 \geq k_{10}$, | $k_{1m} =$ | 0.129 | 0.127 | 0.127 | 0.066 | 0.075 |
| When $k_1 < k_{10}$, | $k_{1m} =$ | 0.064 | 0.016 | 0.000 | 0.055 | 0.039 |
| When $d_1 \geq d_{10}$, | $d_{1m}$ (nm) = | 19.185 | 19.061 | 18.574 | 220.596 | ∞ |
| When $d_1 < d_{10}$, | $d_{1m}$ (nm) = | 16.268 | 13.452 | 11.329 | 216.874 | 208.223 |
| When $n_2 \geq n_{20}$, | $n_{2m} =$ | 1.731 | 1.774 | 1.776 | 1.707 | 1.748 |
| When $n_2 < n_{20}$, | $n_{2m} =$ | 1.651 | 1.642 | 1.618 | 1.678 | 1.595 |
| When $k_2 \geq k_{20}$, | $k_{2m} =$ | 0.371 | 0.317 | 0.273 | 0.218 | 0.220 |
| When $k_2 < k_{20}$, | $k_{2m} =$ | 0.314 | 0.227 | 0.177 | 0.165 | 0.120 |
| When $d_2 \geq d_{20}$, | $d_{2m}$ (nm) = | ∞ | ∞ | ∞ | ∞ | ∞ |
| When $d_2 < d_{20}$, | $d_{2m}$ (nm) = | 121.662 | 164.818 | 180.821 | 179.468 | 209.260 |

1. 3 < NA ≦ 1. 4
155 < T ≦ 165

| Case | 16-06 |
|---|---|
| $n_{10}$ | 1.696 |
| $k_{10}$ | 0.052 |
| $d_{10}$ (nm) | 274.035 |
| $n_{20}$ | 1.700 |
| $k_{20}$ | 0.171 |
| $d_{20}$ (nm) | 241.498 |

| When $n_1 \geq n_{10}$, | $n_{1m} =$ | 1.735 |
|---|---|---|
| When $n_1 < n_{10}$, | $n_{1m} =$ | 1.651 |
| When $k_1 \geq k_{10}$, | $k_{1m} =$ | 0.077 |
| When $k_1 < k_{10}$, | $k_{1m} =$ | 0.034 |
| When $d_1 \geq d_{10}$, | $d_{1m}$ (nm) = | ∞ |
| When $d_1 < d_{10}$, | $d_{1m}$ (nm) = | 215.451 |
| When $n_2 \geq n_{20}$, | $n_{2m} =$ | 1.840 |
| When $n_2 < n_{20}$, | $n_{2m} =$ | 1.612 |
| When $k_2 \geq k_{20}$, | $k_{2m} =$ | 0.229 |
| When $k_2 < k_{20}$, | $k_{2m} =$ | 0.108 |
| When $d_2 \geq d_{20}$, | $d_{2m}$ (nm) = | ∞ |
| When $d_2 < d_{20}$, | $d_{2m}$ (nm) = | 166.208 |

1．3＜NA≦1．4
165＜T≦175

| Case | 17-01 | 17-02 | 17-03 | 17-04 |
|---|---|---|---|---|
| $n_{10}$ | 1.900 | 1.885 | 1.708 | 1.697 |
| $k_{10}$ | 0.097 | 0.082 | 0.058 | 0.048 |
| $d_{10}$ (nm) | 14.674 | 13.311 | 215.615 | 273.453 |
| $n_{20}$ | 1.732 | 1.722 | 1.694 | 1.699 |
| $k_{20}$ | 0.294 | 0.239 | 0.180 | 0.151 |
| $d_{20}$ (nm) | 185.336 | 243.911 | 233.152 | 289.720 |

| | | 17-01 | 17-02 | 17-03 | 17-04 |
|---|---|---|---|---|---|
| When $n_1 \geq n_{10}$, | $n_{1m} =$ | 1.955 | 1.956 | 1.741 | 1.736 |
| When $n_1 < n_{10}$, | $n_{1m} =$ | 1.881 | 1.856 | 1.699 | 1.650 |
| When $k_1 \geq k_{10}$, | $k_{1m} =$ | 0.126 | 0.128 | 0.074 | 0.080 |
| When $k_1 < k_{10}$, | $k_{1m} =$ | 0.023 | 0.000 | 0.039 | 0.020 |
| When $d_1 \geq d_{10}$, | $d_{1m}$ (nm) $=$ | 18.346 | 18.029 | ∞ | ∞ |
| When $d_1 < d_{10}$, | $d_{1m}$ (nm) $=$ | 13.519 | 11.467 | 209.091 | 211.222 |
| When $n_2 \geq n_{20}$, | $n_{2m} =$ | 1.767 | 1.769 | 1.740 | 1.868 |
| When $n_2 < n_{20}$, | $n_{2m} =$ | 1.645 | 1.618 | 1.591 | 1.614 |
| When $k_2 \geq k_{20}$, | $k_{2m} =$ | 0.322 | 0.277 | 0.217 | 0.224 |
| When $k_2 < k_{20}$, | $k_{2m} =$ | 0.243 | 0.187 | 0.126 | 0.094 |
| When $d_2 \geq d_{20}$, | $d_{2m}$ (nm) $=$ | ∞ | ∞ | ∞ | ∞ |
| When $d_2 < d_{20}$, | $d_{2m}$ (nm) $=$ | 156.774 | 176.585 | 198.961 | 204.980 |

1．3＜NA≦1．4
175＜T≦185

| Case | 18-01 | 18-02 | 18-03 | 18-04 | 18-05 |
|---|---|---|---|---|---|
| $n_{10}$ | 1.908 | 1.888 | 1.708 | 1.709 | 1.697 |
| $k_{10}$ | 0.102 | 0.088 | 0.059 | 0.054 | 0.049 |
| $d_{10}$ (nm) | 14.316 | 13.163 | 215.377 | 215.137 | 273.522 |
| $n_{20}$ | 1.730 | 1.716 | 1.693 | 1.702 | 1.700 |
| $k_{20}$ | 0.303 | 0.243 | 0.185 | 0.158 | 0.154 |
| $d_{20}$ (nm) | 177.238 | 235.819 | 223.802 | 279.418 | 279.960 |

| | | 18-01 | 18-02 | 18-03 | 18-04 | 18-05 |
|---|---|---|---|---|---|---|
| When $n_1 \geq n_{10}$, | $n_{1m} =$ | 1.960 | 1.956 | 1.740 | 1.745 | 1.734 |
| When $n_1 < n_{10}$, | $n_{1m} =$ | 1.893 | 1.861 | 1.700 | 1.696 | 1.657 |
| When $k_1 \geq k_{10}$, | $k_{1m} =$ | 0.126 | 0.131 | 0.073 | 0.075 | 0.079 |
| When $k_1 < k_{10}$, | $k_{1m} =$ | 0.031 | 0.002 | 0.041 | 0.028 | 0.020 |
| When $d_1 \geq d_{10}$, | $d_{1m}$ (nm) $=$ | 17.569 | 17.540 | ∞ | ∞ | ∞ |
| When $d_1 < d_{10}$, | $d_{1m}$ (nm) $=$ | 13.467 | 11.504 | 209.546 | 205.939 | 213.387 |
| When $n_2 \geq n_{20}$, | $n_{2m} =$ | 1.759 | 1.759 | 1.736 | 1.790 | 1.874 |
| When $n_2 < n_{20}$, | $n_{2m} =$ | 1.644 | 1.611 | 1.587 | 1.604 | 1.617 |
| When $k_2 \geq k_{20}$, | $k_{2m} =$ | 0.325 | 0.278 | 0.217 | 0.211 | 0.226 |
| When $k_2 < k_{20}$, | $k_{2m} =$ | 0.256 | 0.193 | 0.129 | 0.105 | 0.095 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 143.259 | 171.381 | 185.714 | 201.921 | 193.505 |

1. 3 < N A ≤ 1. 4
1 8 5 < T ≤ 1 9 5

| Case | 19-01 | 19-02 | 19-03 | 19-04 | 19-05 |
|---|---|---|---|---|---|
| $n_{10}$ | 1.914 | 1.886 | 1.873 | 1.692 | 1.708 |
| $k_{10}$ | 0.104 | 0.093 | 0.070 | 0.060 | 0.060 |
| $d_{10}$ (nm) | 14.390 | 13.299 | 12.581 | 152.854 | 215.913 |
| $n_{20}$ | 1.735 | 1.710 | 1.721 | 1.693 | 1.692 |
| $k_{20}$ | 0.314 | 0.247 | 0.208 | 0.157 | 0.189 |
| $d_{20}$ (nm) | 166.400 | 226.131 | 280.628 | 278.359 | 213.567 |

| | | 19-01 | 19-02 | 19-03 | 19-04 | 19-05 |
|---|---|---|---|---|---|---|
| When $n_1 \geq n_{10}$, | $n_{1m}=$ | 1.964 | 1.952 | 1.955 | 1.709 | 1.739 |
| When $n_1 < n_{10}$, | $n_{1m}=$ | 1.903 | 1.860 | 1.833 | 1.664 | 1.699 |
| When $k_1 \geq k_{10}$, | $k_{1m}=$ | 0.123 | 0.135 | 0.133 | 0.092 | 0.074 |
| When $k_1 < k_{10}$, | $k_{1m}=$ | 0.040 | 0.012 | 0.000 | 0.042 | 0.044 |
| When $d_1 \geq d_{10}$, | $d_{1m}$ (nm) $=$ | 17.353 | 17.539 | 18.087 | 163.046 | ∞ |
| When $d_1 < d_{10}$, | $d_{1m}$ (nm) $=$ | 13.759 | 11.668 | 9.947 | 129.659 | 210.046 |
| When $n_2 \geq n_{20}$, | $n_{2m}=$ | 1.759 | 1.750 | 1.778 | 1.784 | 1.739 |
| When $n_2 < n_{20}$, | $n_{2m}=$ | 1.648 | 1.604 | 1.614 | 1.659 | 1.586 |
| When $k_2 \geq k_{20}$, | $k_{2m}=$ | 0.331 | 0.280 | 0.252 | 0.196 | 0.222 |
| When $k_2 < k_{20}$, | $k_{2m}=$ | 0.267 | 0.196 | 0.156 | 0.120 | 0.129 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 144.756 | 162.922 | 193.262 | 243.485 | 177.669 |

1. 3 < N A ≤ 1. 4
1 8 5 < T ≤ 1 9 5

| Case | 19-06 | 19-07 |
|---|---|---|
| $n_{10}$ | 1.708 | 1.697 |
| $k_{10}$ | 0.054 | 0.050 |
| $d_{10}$ (nm) | 215.905 | 273.350 |
| $n_{20}$ | 1.701 | 1.701 |
| $k_{20}$ | 0.161 | 0.157 |
| $d_{20}$ (nm) | 269.362 | 270.178 |

| | | 19-06 | 19-07 |
|---|---|---|---|
| When $n_1 \geq n_{10}$, | $n_{1m}=$ | 1.744 | 1.732 |
| When $n_1 < n_{10}$, | $n_{1m}=$ | 1.697 | 1.658 |
| When $k_1 \geq k_{10}$, | $k_{1m}=$ | 0.075 | 0.078 |
| When $k_1 < k_{10}$, | $k_{1m}=$ | 0.029 | 0.021 |
| When $d_1 \geq d_{10}$, | $d_{1m}$ (nm) $=$ | ∞ | ∞ |
| When $d_1 < d_{10}$, | $d_{1m}$ (nm) $=$ | 207.633 | 215.326 |
| When $n_2 \geq n_{20}$, | $n_{2m}=$ | 1.795 | 1.877 |
| When $n_2 < n_{20}$, | $n_{2m}=$ | 1.605 | 1.619 |
| When $k_2 \geq k_{20}$, | $k_{2m}=$ | 0.216 | 0.228 |
| When $k_2 < k_{20}$, | $k_{2m}=$ | 0.105 | 0.098 |
| When $d_2 \geq d_{20}$, | $d_{2m}$ (nm) $=$ | ∞ | ∞ |
| When $d_2 < d_{20}$, | $d_{2m}$ (nm) $=$ | 205.481 | 189.945 |

1. 3 < N A ≤ 1. 4
1 9 5 < T ≤ 2 0 5

| Case | 20-01 | 20-02 | 20-03 | 20-04 | 20-05 |
|---|---|---|---|---|---|
| $n_{10}$ | 1.918 | 1.883 | 1.874 | 1.707 | 1.708 |
| $k_{10}$ | 0.103 | 0.095 | 0.068 | 0.061 | 0.055 |
| $d_{10}$ (nm) | 15.177 | 13.742 | 12.955 | 216.749 | 216.874 |
| $n_{20}$ | 1.753 | 1.708 | 1.728 | 1.693 | 1.699 |
| $k_{20}$ | 0.331 | 0.252 | 0.214 | 0.194 | 0.165 |
| $d_{20}$ (nm) | 153.467 | 215.835 | 269.400 | 203.628 | 259.716 |

| | | 20-01 | 20-02 | 20-03 | 20-04 | 20-05 |
|---|---|---|---|---|---|---|
| When $n_1 \geq n_{10}$, | $n_{1m} =$ | 1.966 | 1.948 | 1.955 | 1.739 | 1.743 |
| When $n_1 < n_{10}$, | $n_{1m} =$ | 1.909 | 1.857 | 1.835 | 1.699 | 1.698 |
| When $k_1 \geq k_{10}$, | $k_{1m} =$ | 0.117 | 0.137 | 0.128 | 0.075 | 0.075 |
| When $k_1 < k_{10}$, | $k_{1m} =$ | 0.043 | 0.016 | 0.000 | 0.048 | 0.030 |
| When $d_1 \geq d_{10}$, | $d_{1m}$ (nm) $=$ | 18.089 | 18.051 | 18.523 | 256.743 | ∞ |
| When $d_1 < d_{10}$, | $d_{1m}$ (nm) $=$ | 14.663 | 12.041 | 10.348 | 210.937 | 209.294 |
| When $n_2 \geq n_{20}$, | $n_{2m} =$ | 1.773 | 1.748 | 1.785 | 1.744 | 1.800 |
| When $n_2 < n_{20}$, | $n_{2m} =$ | 1.665 | 1.604 | 1.616 | 1.589 | 1.608 |
| When $k_2 \geq k_{20}$, | $k_{2m} =$ | 0.348 | 0.285 | 0.259 | 0.230 | 0.223 |
| When $k_2 < k_{20}$, | $k_{2m} =$ | 0.278 | 0.199 | 0.159 | 0.145 | 0.109 |
| When $d_2 \geq d_{20}$, | $d_{2m}$ (nm) $=$ | ∞ | ∞ | ∞ | ∞ | ∞ |
| When $d_2 < d_{20}$, | $d_{2m}$ (nm) $=$ | 140.260 | 150.984 | 188.160 | 180.549 | 200.943 |

1. 3 < N A ≤ 1. 4
1 9 5 < T ≤ 2 0 5

| Case | 20-06 |
|---|---|
| $n_{10}$ | 1.697 |
| $k_{10}$ | 0.050 |
| $d_{10}$ (nm) | 272.522 |
| $n_{20}$ | 1.701 |
| $k_{20}$ | 0.160 |
| $d_{20}$ (nm) | 261.468 |

| | | 20-06 |
|---|---|---|
| When $n_1 \geq n_{10}$, | $n_{1m} =$ | 1.731 |
| When $n_1 < n_{10}$, | $n_{1m} =$ | 1.652 |
| When $k_1 \geq k_{10}$, | $k_{1m} =$ | 0.078 |
| When $k_1 < k_{10}$, | $k_{1m} =$ | 0.022 |
| When $d_1 \geq d_{10}$, | $d_{1m}$ (nm) $=$ | ∞ |
| When $d_1 < d_{10}$, | $d_{1m}$ (nm) $=$ | 217.122 |
| When $n_2 \geq n_{20}$, | $n_{2m} =$ | 1.874 |
| When $n_2 < n_{20}$, | $n_{2m} =$ | 1.620 |
| When $k_2 \geq k_{20}$, | $k_{2m} =$ | 0.227 |
| When $k_2 < k_{20}$, | $k_{2m} =$ | 0.100 |
| When $d_2 \geq d_{20}$, | $d_{2m}$ (nm) $=$ | ∞ |
| When $d_2 < d_{20}$, | $d_{2m}$ (nm) $=$ | 184.530 |

13. The exposure method according to any one of claims 8 to 12, wherein the relations $d_1 \leq 250$ and $d_2 \leq 250$ are satisfied.

14. The exposure method according to any one of claims 8 to 12, wherein the refractive index of the resist layer is 1.60 to 1.80.

15. The exposure method according to any one of claims 8 to 14, wherein a topcoat layer is formed on the resist layer.

16. The exposure method according to any one of claims 8 to 14, wherein the space between the resist layer and the exposure system is filled with a medium having a refractive index of 1.44 $\pm$0.02.

17. The exposure method according to claim 16, wherein the medium is water.

# FIGURE

**EP 1 760 766 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005257626 A
- JP 2006092240 A

- JP 2001242630 A

### Non-patent literature cited in the description

- Basic Theory of Optical Thin Film. Optronics Inc, 2003
- Nonlinear Optimization Problems. Baifukan, 1970

- **K. BABICH.** *Proceedings of SPIE,* 2003, vol. 152, 5039